(19) Europäisches Patentamt
European Patent Office
Office européen des brevets

(11) Publication number: **0 273 261**
**A2**

(12) **EUROPEAN PATENT APPLICATION**

(21) Application number: **87118270.5**

(51) Int. Cl.4: **G06F 15/60**

(22) Date of filing: **09.12.87**

(30) Priority: **18.12.86 US 944689**

(43) Date of publication of application:
**06.07.88 Bulletin 88/27**

(84) Designated Contracting States:
**DE FR GB NL**

(71) Applicant: **CAE Systems, Inc.**
**12212A Technology Boulevard**
**Austin Texas 78727(US)**

(72) Inventor: **Parmar, Kirtikumar M.**
**1406 Beth Lane**
**Round Rock Texas 78664(US)**
Inventor: **Freuler, Thomas A.**
**606 Russet Valley Drive**
**Cedar Park Texas 78613(US)**
Inventor: **Cobb, Deborah Dee**
**6307 Shadow Mountain Drive**
**Austin Texas 78731(US)**

(74) Representative: **Liska, Horst, Dr. et al**
**Patentanwälte H. Weickmann, Dr. K. Fincke,**
**F.A. Weickmann, B. Huber, Dr. H. Liska, Dr. J.**
**Prechtel Möhlstrasse 22 Postfach 86 08 20**
**D-8000 München 86(DE)**

(54) **A method of routing connections among blocks on a carrier.**

(57) Detail routing of connections among blocks on a carrier is accomplished by determining an initial placement for first, second and third blocks with respect to a stationary frame of reference. The initial placement is such that the three blocks do not overlap and the first block is separated from the second block by a first channel and the third block is separated from the first block by a second channel. The first channel abuts at a one end with one side of the second channel. Each channel has real terminals along its sides. The position of a real terminal in the longitudinal direction of the channel is defined before detail routing of the channel takes place. The first channel has virtual terminals at the end at which it abuts the second channel. The path followed by connections among terminals of the first channel are then defined and the width of the first channel is adjusted to accommodate the connections by adjusting the position of the second block in a direction perpendicular to the longitudinal direction of the first channel and without altering the position of the first block. The positions in the transverse direction of the first channel of the virtual terminals at the end of the first channel are defined, and these virtual terminals thereby become real terminals with respect to the second channel. The paths followed by connections among the terminals of the second channel are subsequently defined.

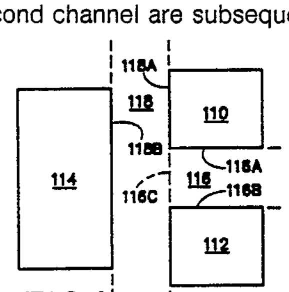


**FIG.1**

EP 0 273 261 A2

Xerox Copy Centre

## A METHOD OF ROUTING CONNECTIONS AMONG BLOCKS ON A CARRIER

This invention relates to a method of routing connections among blocks on a carrier.

### Background of the Invention

The application of computer-aided design (CAD) to fabrication of an integrated circuit employing multiple functionally distinct circuit blocks, such as standard cells and custom and semi-custom circuits, has two major stages - system design and implementation. In the system design stage, the blocks that are to be used are selected (or are themselves designed in the case of custom and semi-custom circuits) and the connections that are required among the terminals of the blocks are defined. Data defining various attributes of the blocks, including the shape and size of each block and the locations of terminals of the block, and the connections that are required among the terminals of the blocks is specified to a CAD system. Implementation is concerned with bringing the product of the system design stage to practical application. Implementation itself has several phases. First, knowing the sizes and shapes of the blocks, an initial placement phase takes place. In the initial placement phase, data base files are created in which trial locations of the blocks on the integrated circuit die are defined such that there are no overlaps of blocks and economical use is made of the die area. Open spaces between blocks are reserved for channels to accommodate wiring connections among the terminals. After the initial placement phase is complete, the global routing phase takes place. In the global routing phase, the connections among the terminals are assigned to specific channels and the data base files are updated with data reflecting these channel assignments. The precise route that a connection takes through a channel is thereafter defined in the detail routing phase, and the data base files are updated accordingly. Thus, at the end of the detail routing phase the data base files of the CAD system contain information defining the positions of the blocks on the die, the positions of the terminals of the blocks, and the paths followed by the connections among the blocks. These data base files are used when making the masks that are used in fabrication of the integrated circuit.

Generally, a channel between circuit blocks is defined as a rectangular object of specific width and length and having terminals about its periphery. In the detail routing phase, the paths of the connections among these terminals are defined. The length dimensions of the channels are defined as being parallel to one or other of two rectangular Cartesian coordinate axes, and a channel is referred to as being horizontal or vertical depending on the orientation of its length dimension. The two sets of channels (horizontal and vertical) are formed by metal layers at different levels in the integrated circuit and connections can be made between these levels by conductive vias. The path followed by each connection in a channel is generally composed of several rectilinear tracks which are connected together in series. For the purpose of this description, a track that extends parallel to the length dimension of the channel in which it lies is referred to as a trunk and a track that extends perpendicular to the length dimension of the channel is referred to as a stub or branch. Most connections are formed of at least two stubs and at least one trunk. A crossing between two connection paths in a given, e.g. horizontal, channel may be accomplished by placing a stub in the vertical channel level so that it crosses a trunk in the horizontal channel level.

Each trunk is of finite width and must be separated by a finite distance from other trunks in the same channel. Therefore, the width of a channel depends on the number of connections that need to be accommodated by the channel and on the paths followed by the connections as determined by detail routing.

The problems encountered in detail routing are discussed in numerous articles, including W. Dai, T. Asano and E. Kuh, "Routing Region Definition and Ordering Scheme for Building-Block Layout," IEEE Trans. Computer-Aided Design, vol. CAD 4, 189-197 (1985); S. Kimura, N. Kubo, T. Chiba and I. Nishioka, "An Automatic Routing Scheme for General Cell LSI," IEEE Trans. Computer-Aided Design, vol. CAD 2, 285-291 (1983); Y. Kajitani, "Order of Channels for Safe Routing and Optimal Compaction of Routing Area," IEEE Trans. Computer-Aided Design, vol. CAD 2, 293-300 (1983); B. T. Preas and W. M. van Cleemput, "Placement Algorithms for Arbitrarily Shaped Blocks," Proceedings of 16th Design Automation Conference, San Diego, California (1979); and M. J. Ciesielski, "A New Approach to Routing in Irregular Channels for the SILC Silicon Compiler," Digest of Papers, IEEE Conference in Computer Aided Design, 66-68 (November 1984).

One of the problems that arises in detail routing is the problem of channel sizing. Thus, in the detail routing phase a track assignment program is used to assign the connections in a channel to appropriate tracks, and if the width of channel required to accommodate all the tracks is greater than the width established in the initial placement phase, the initial placement must be adjusted to accommodate the increase in width of the channel. This implies that the relationships among channels that were established by the channel definition program might be disturbed. It might then be necessary to re-route channels that have previously been routed, and this adds to the time necessary to complete the implementation stage.

## Summary of the Invention

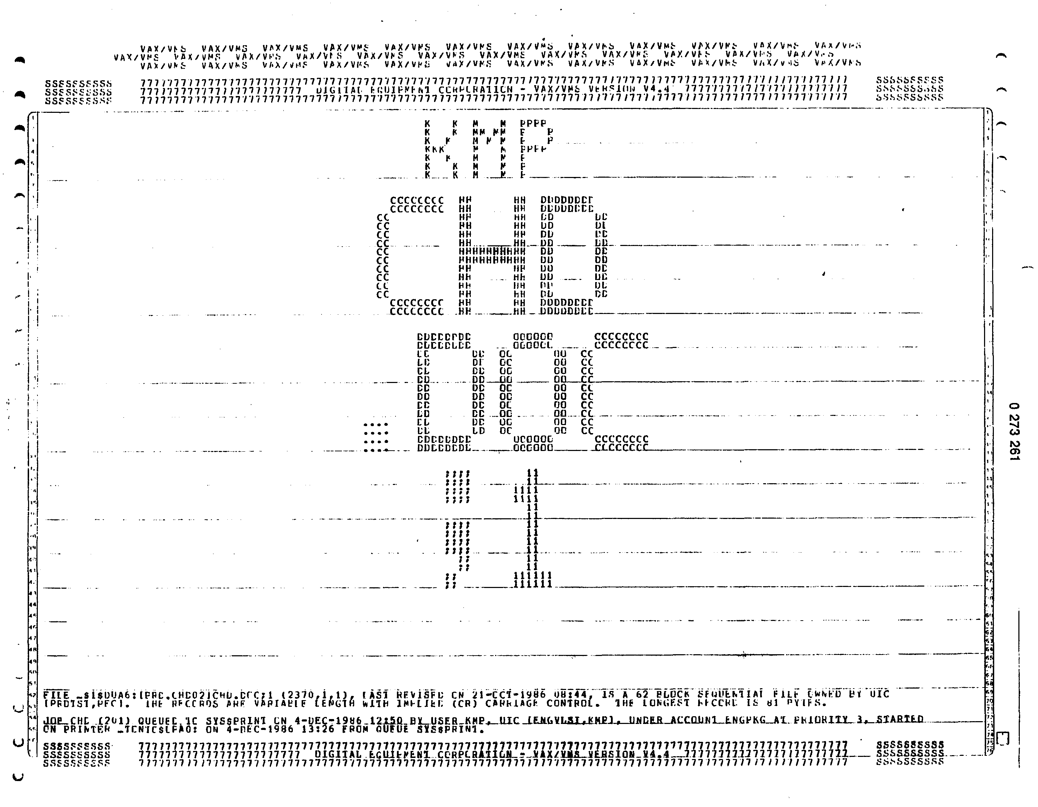

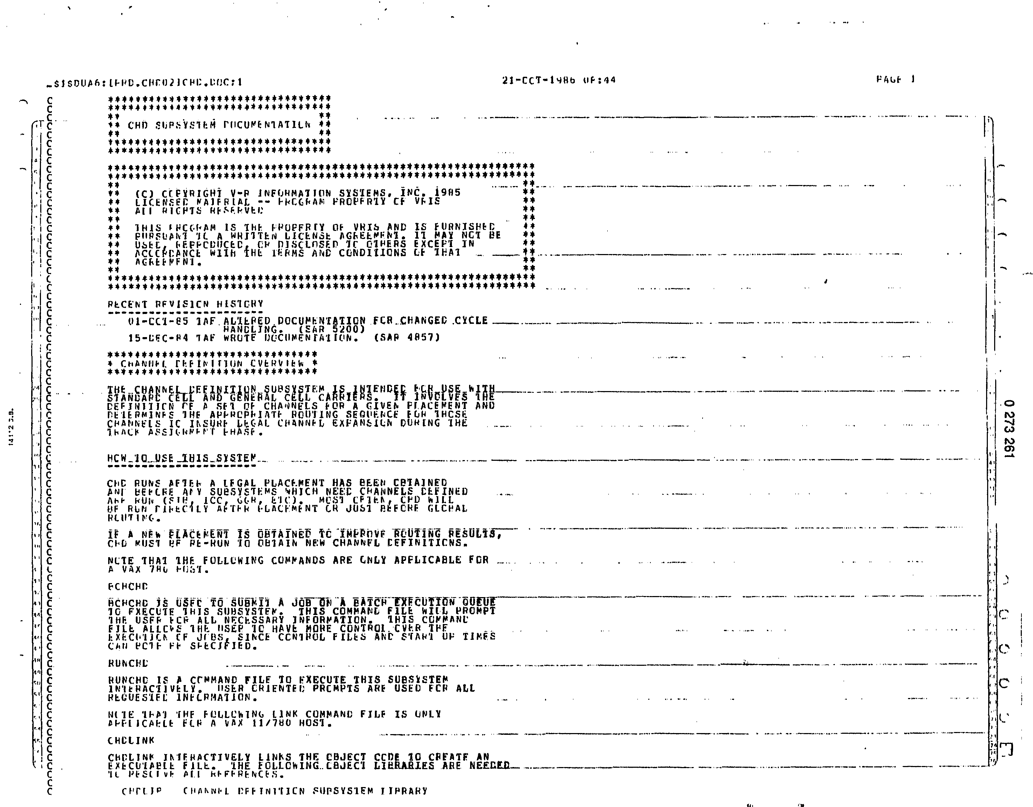

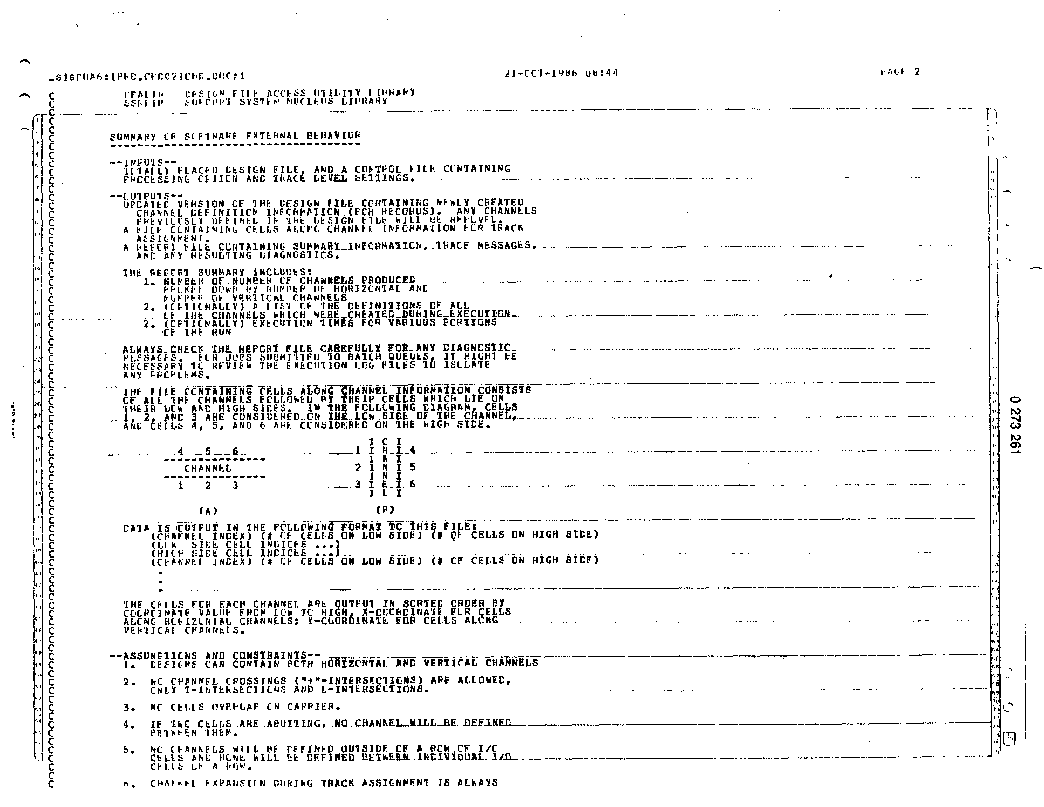

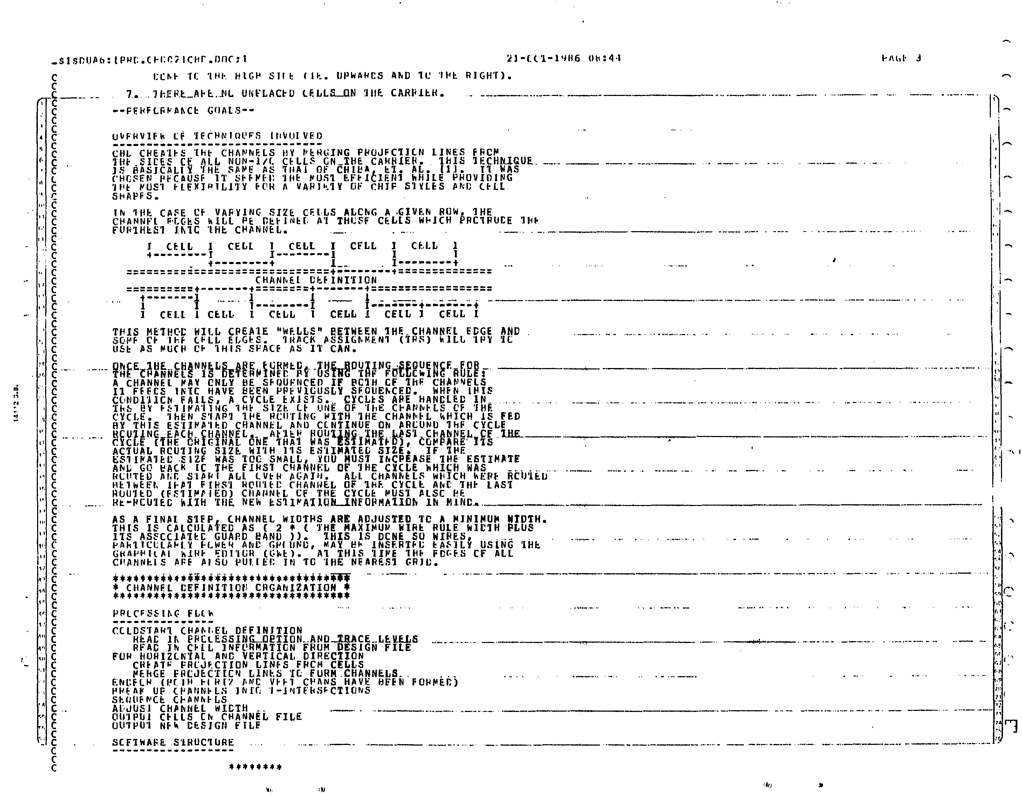

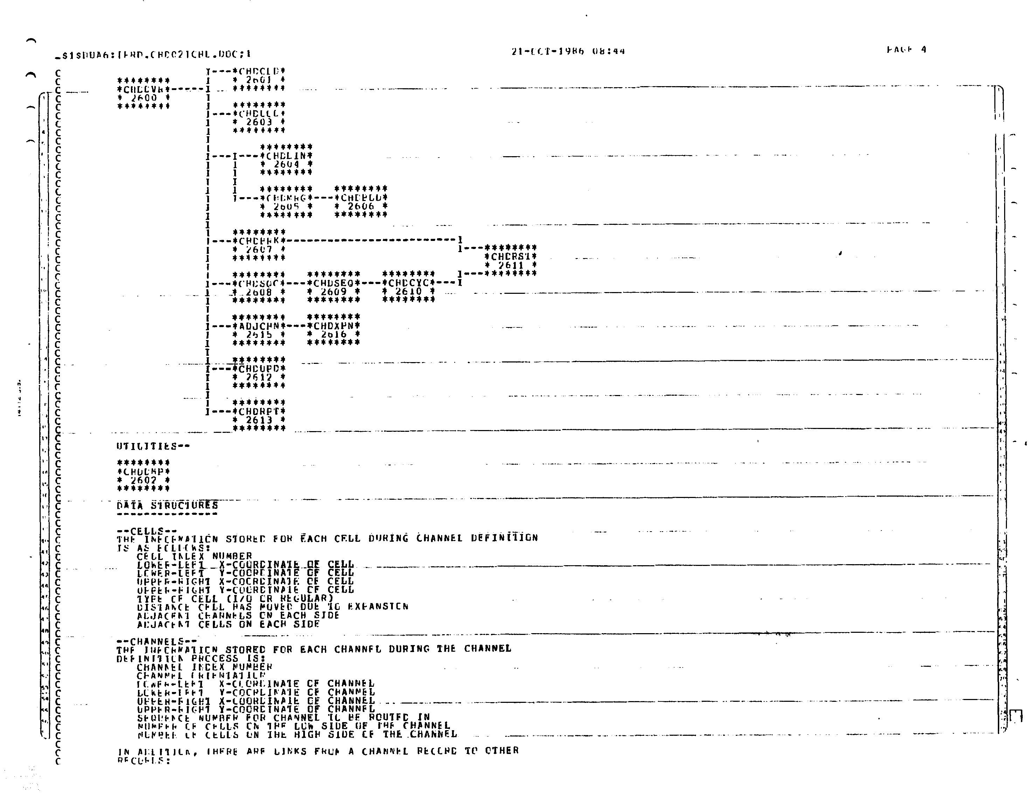

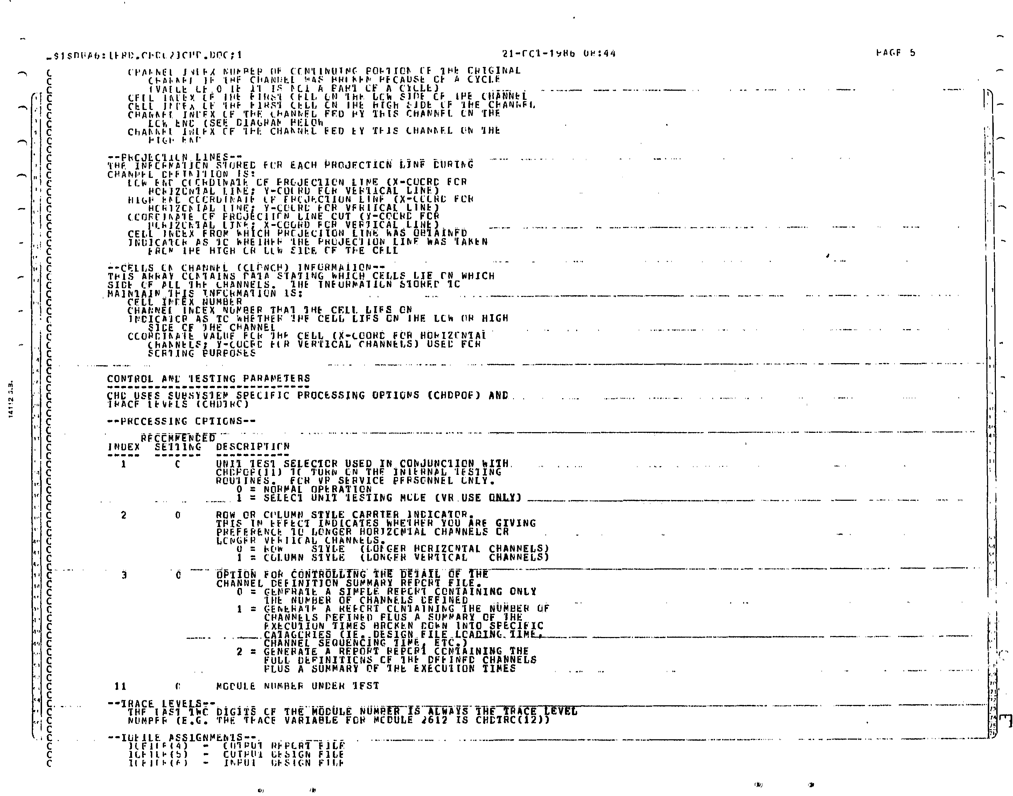

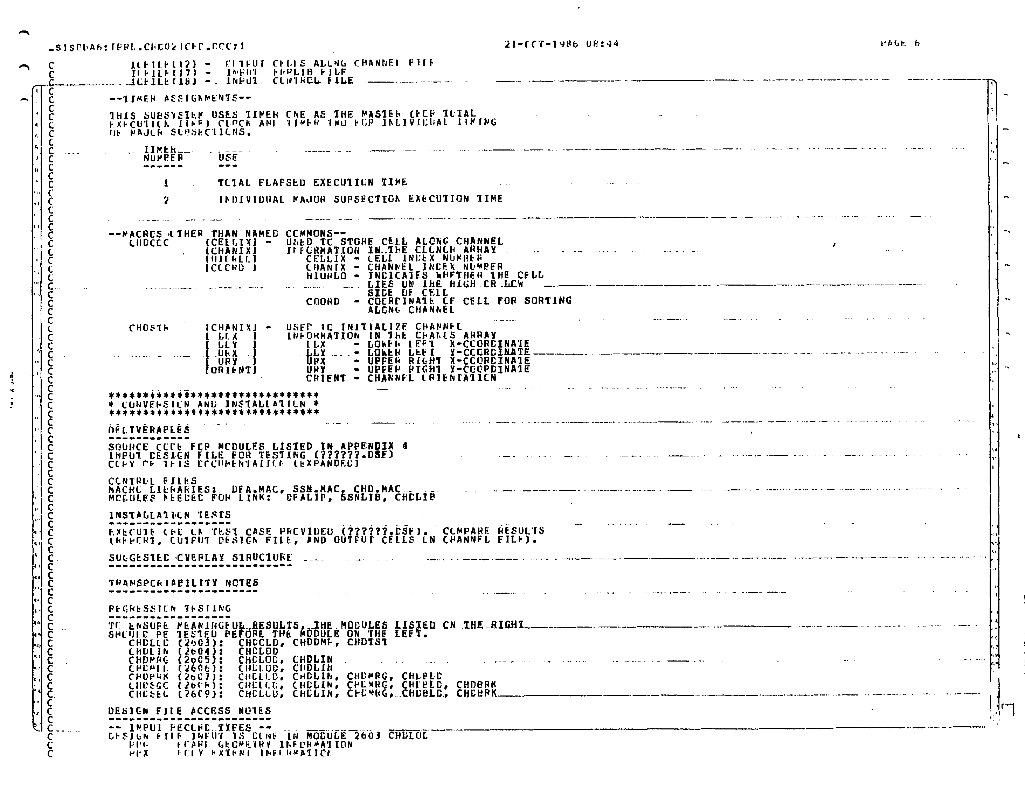

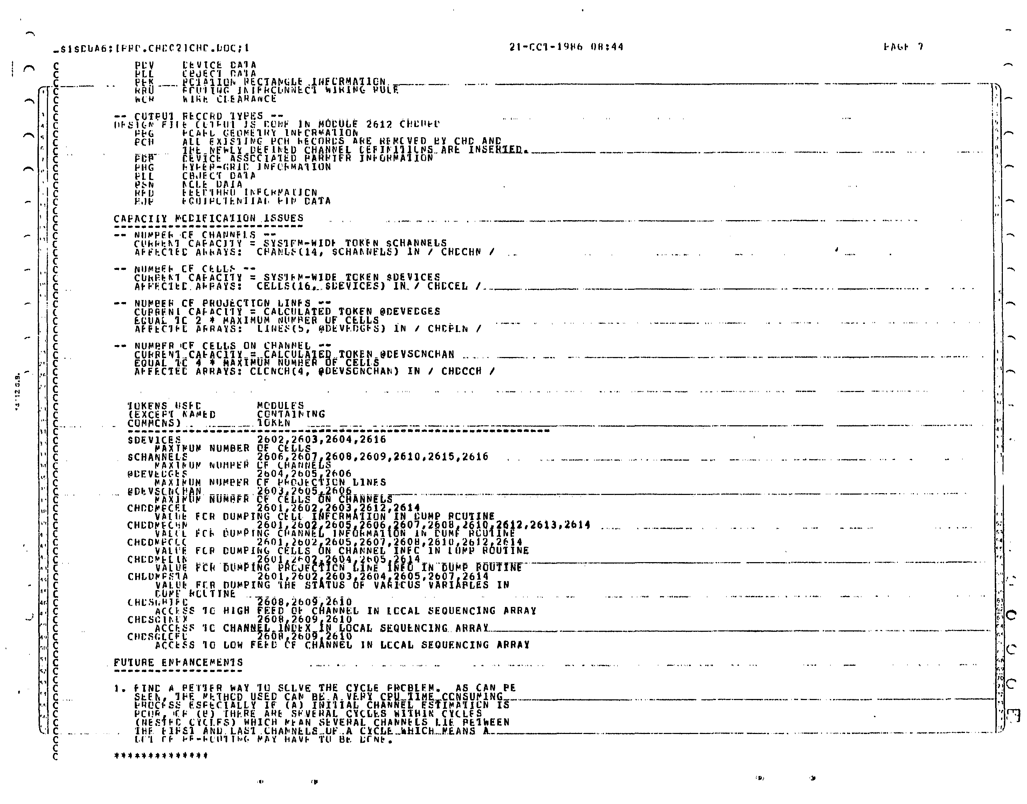

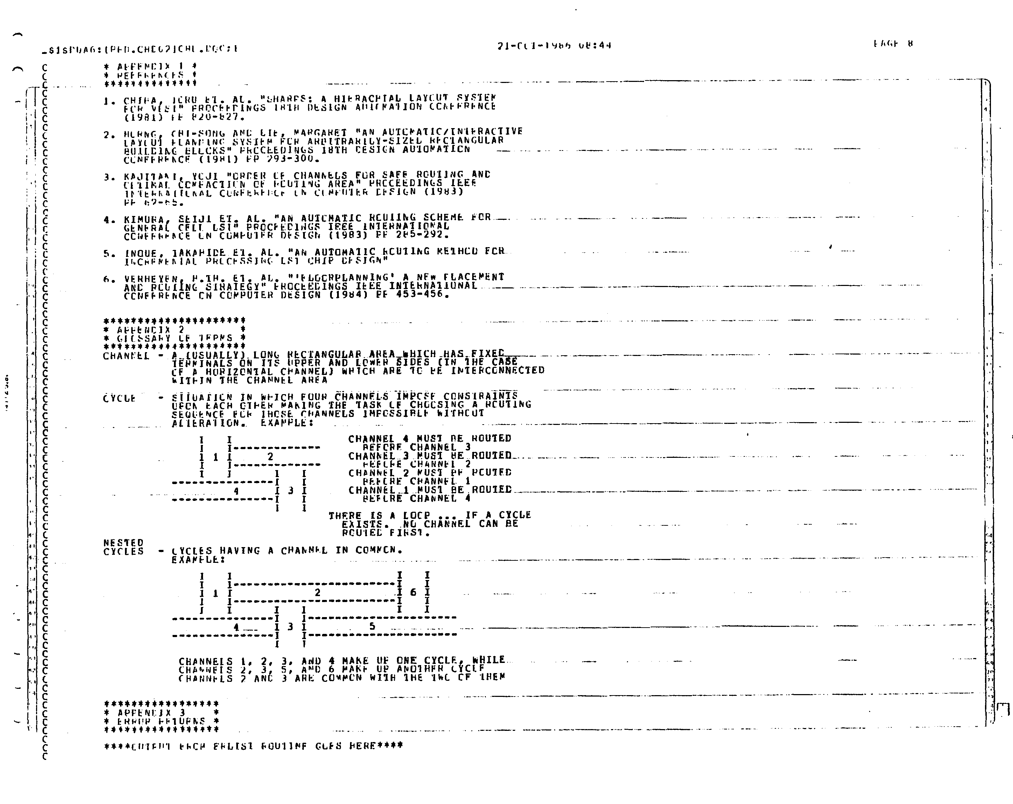

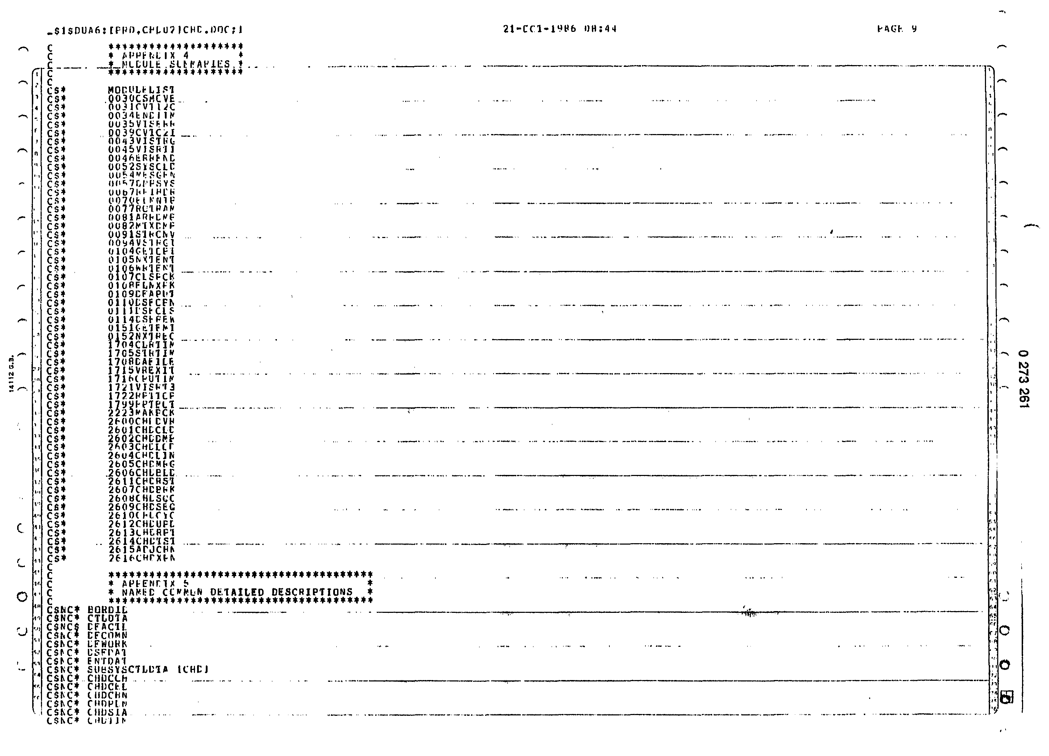

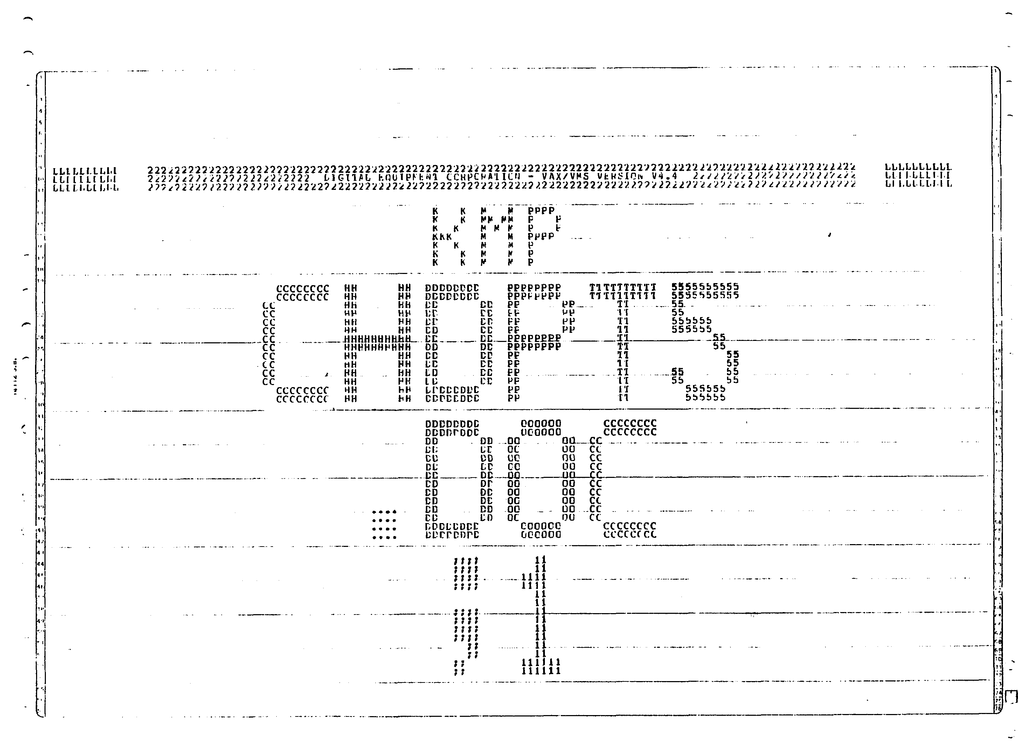

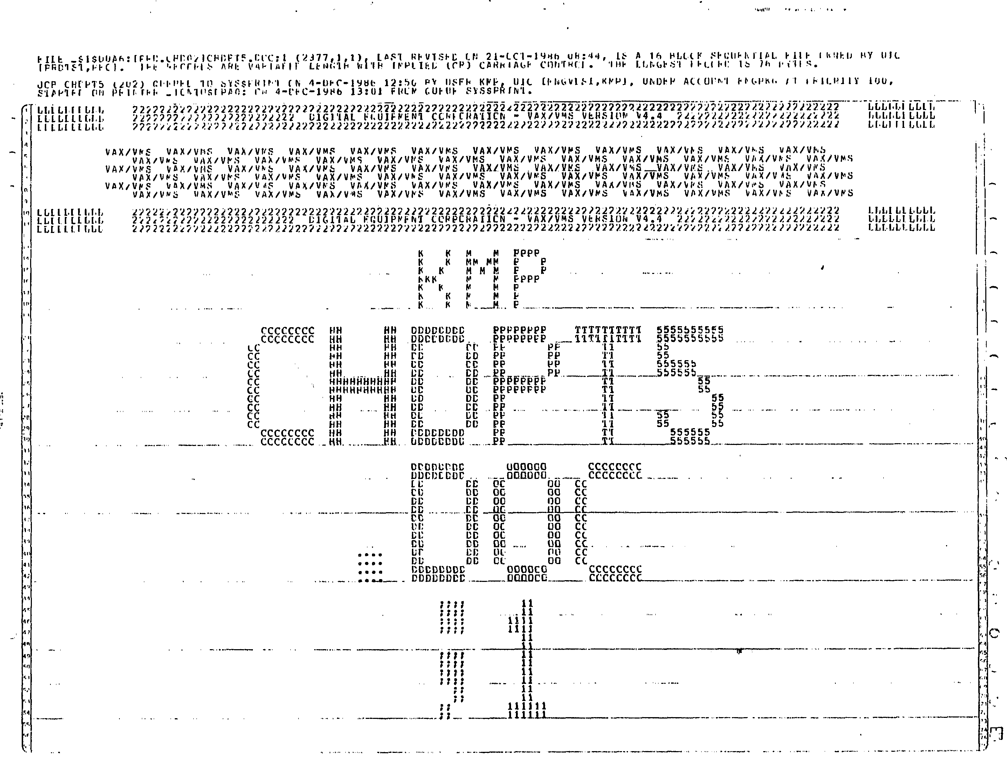

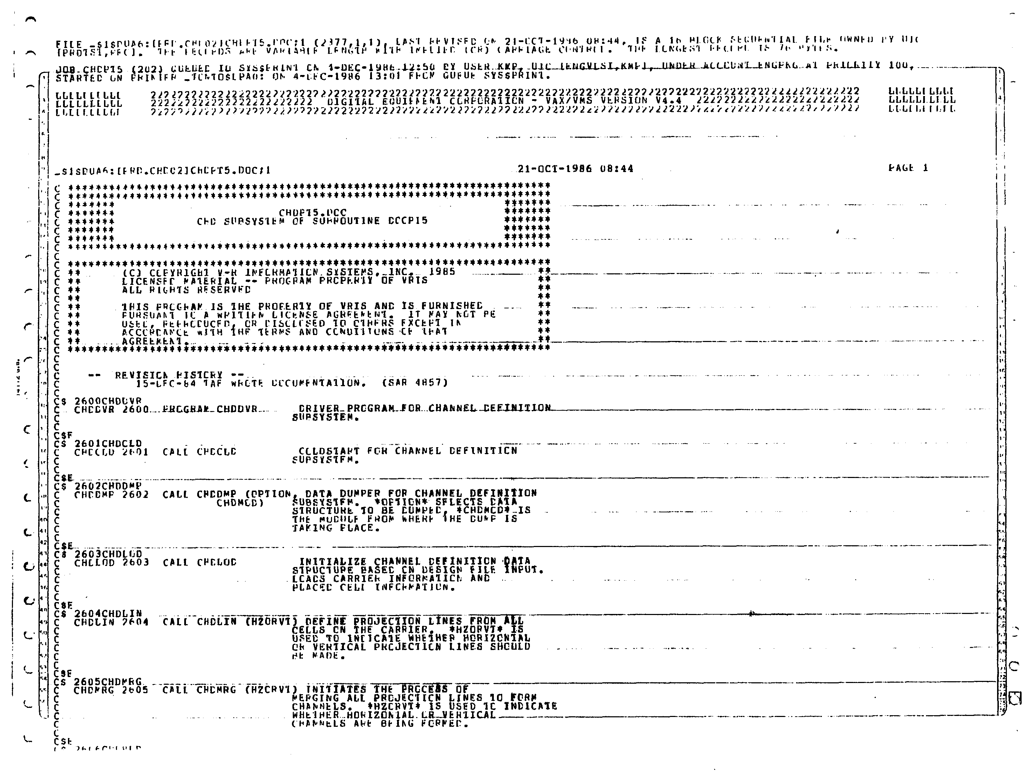

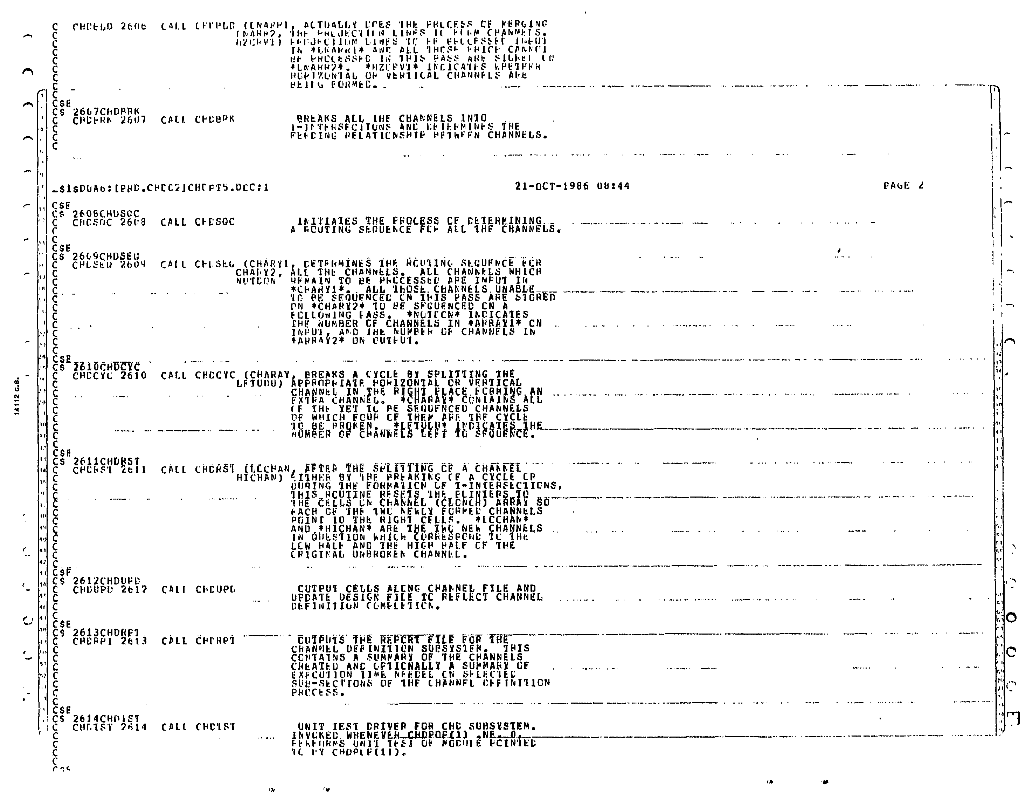

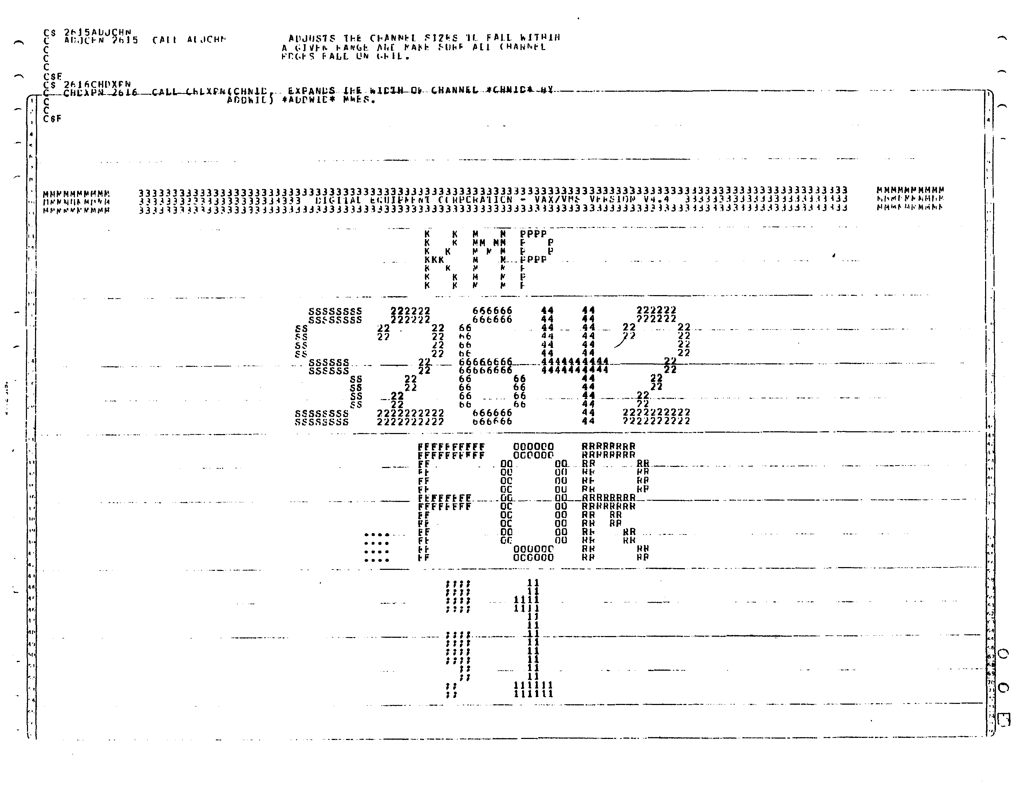

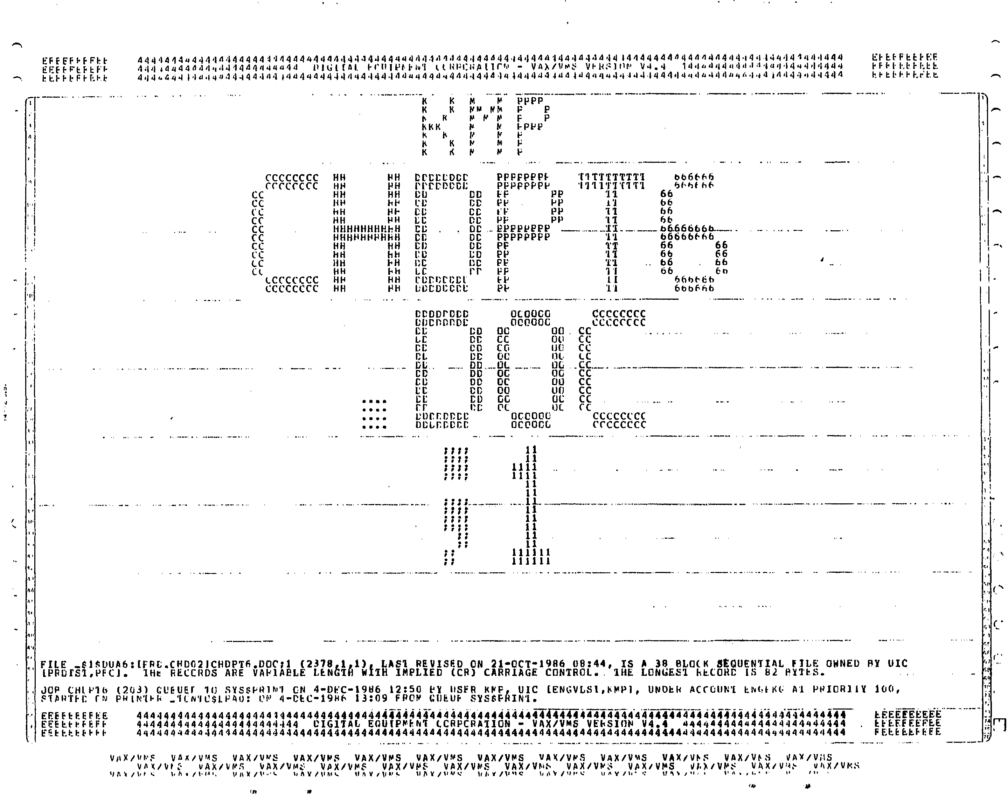

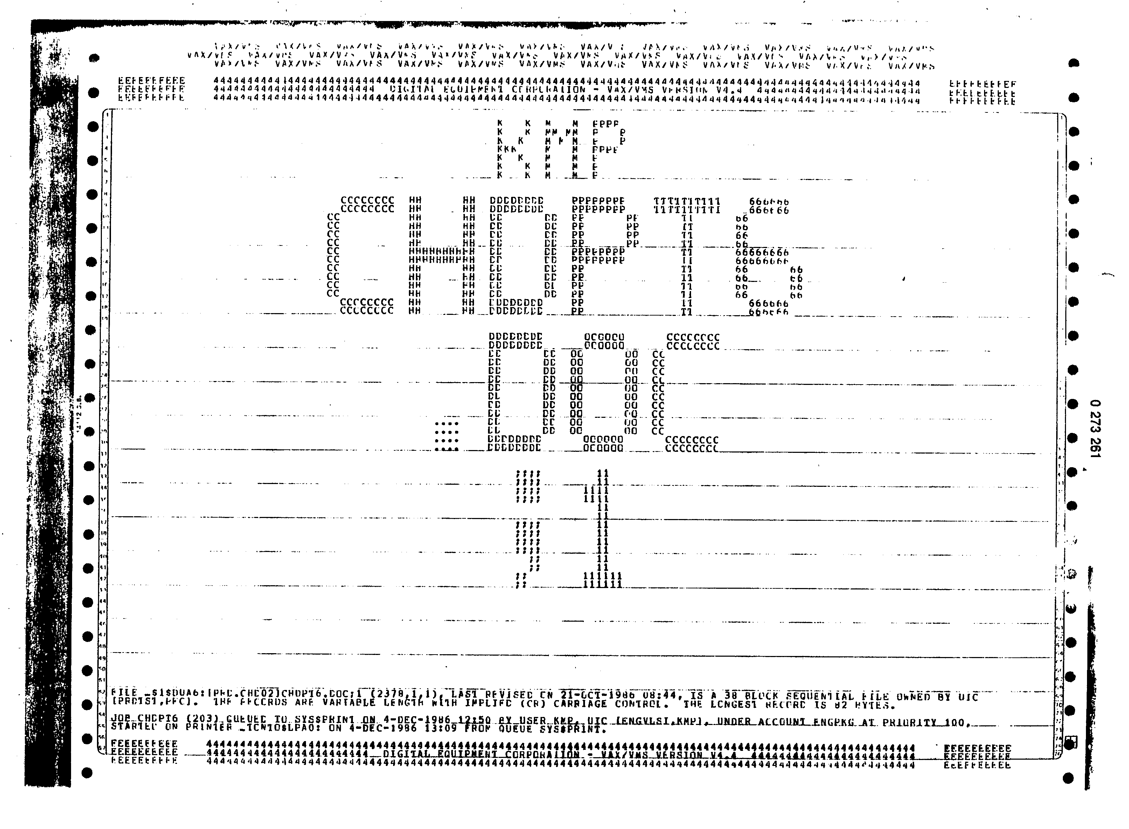

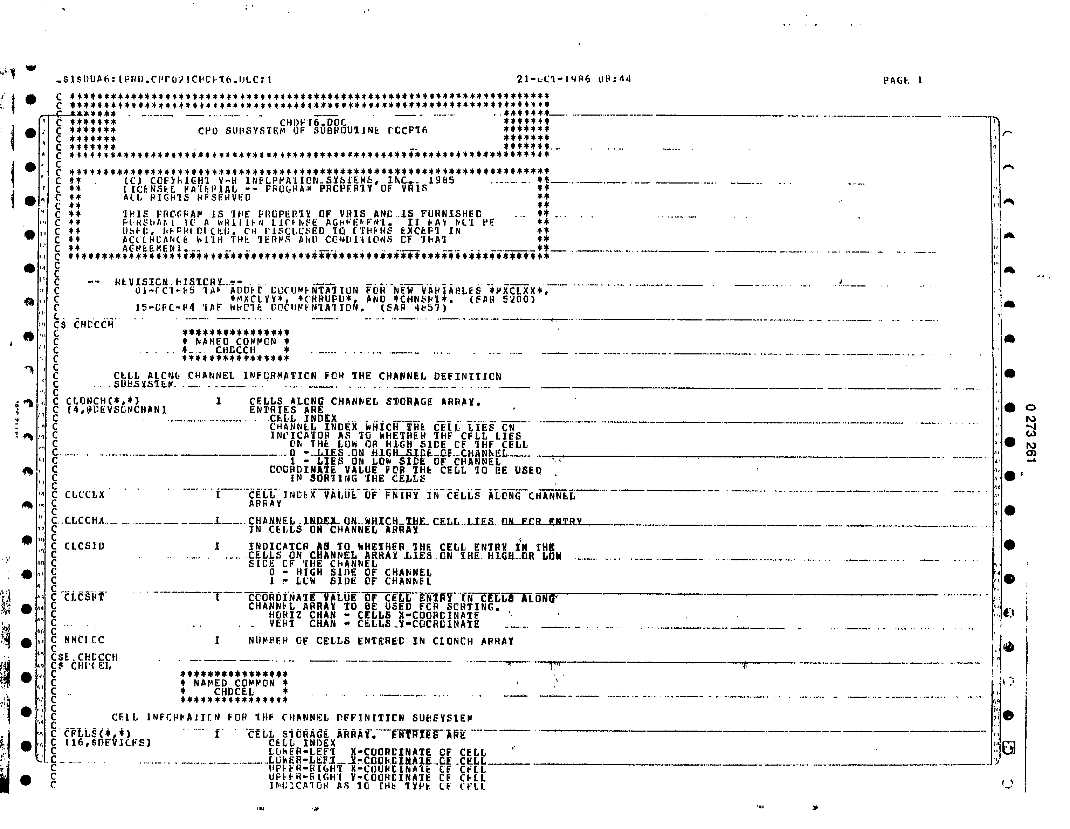

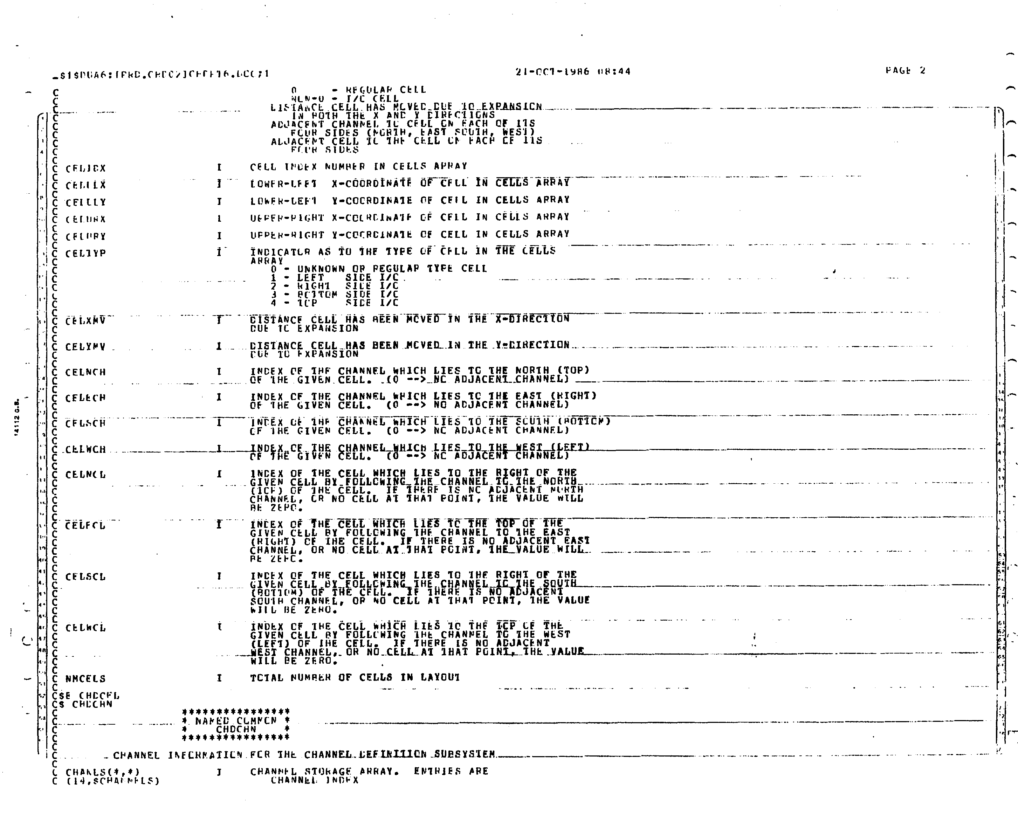

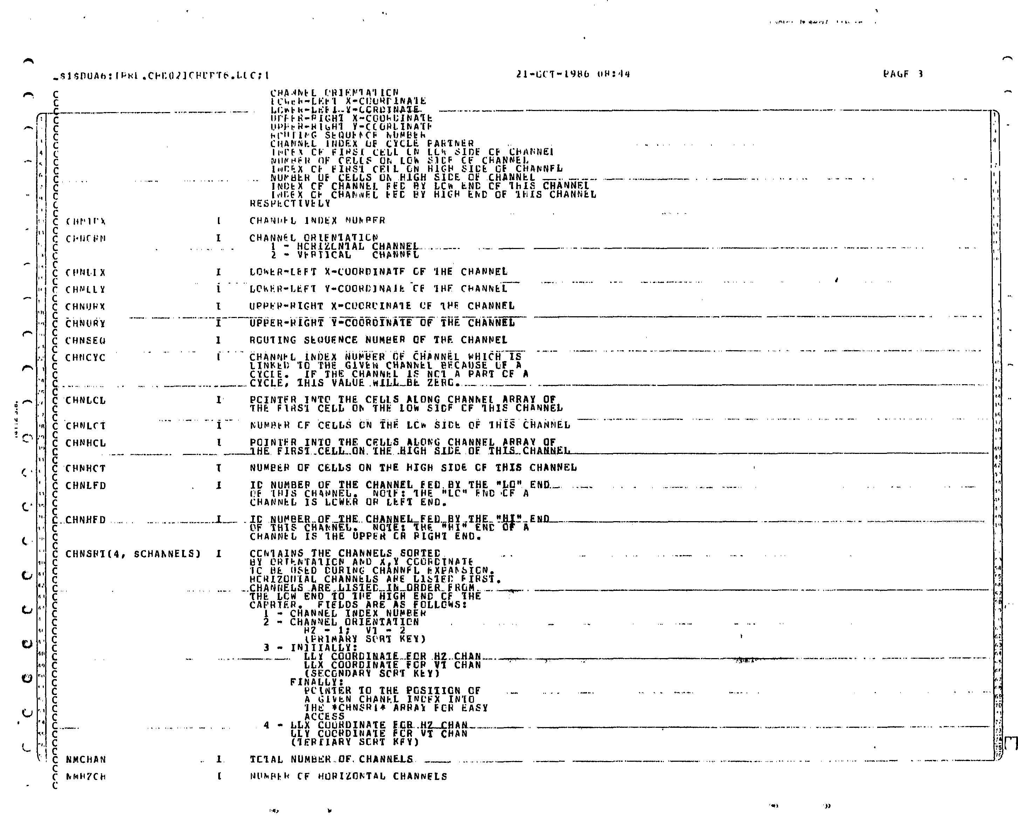

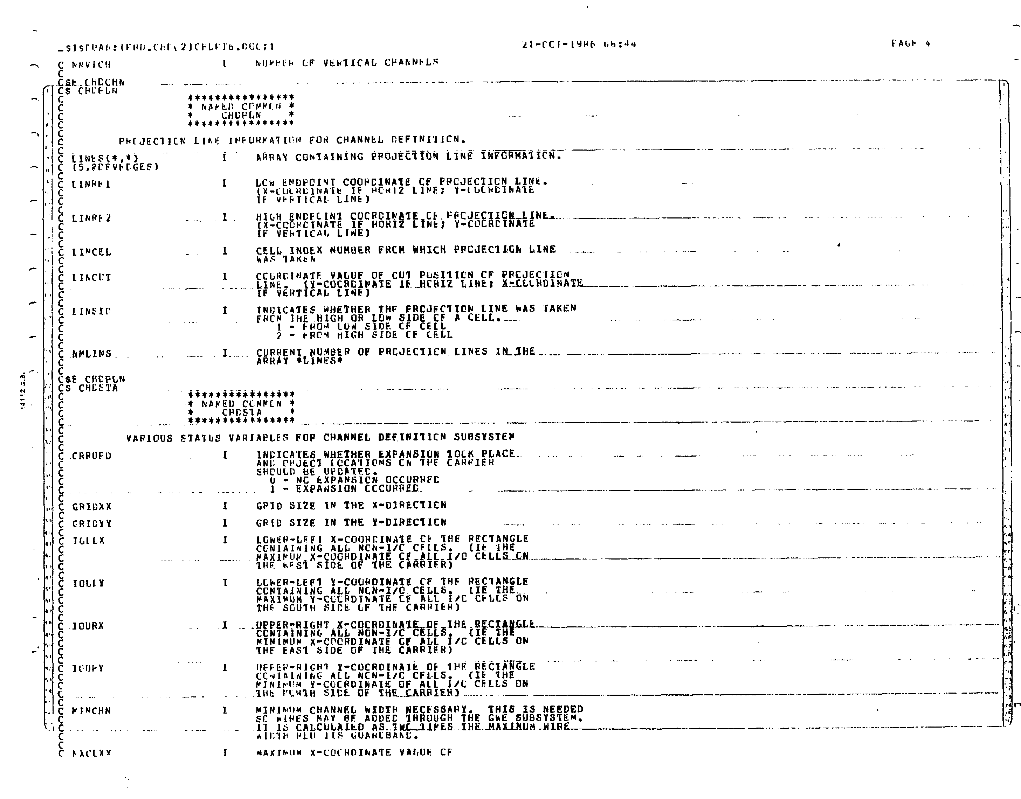

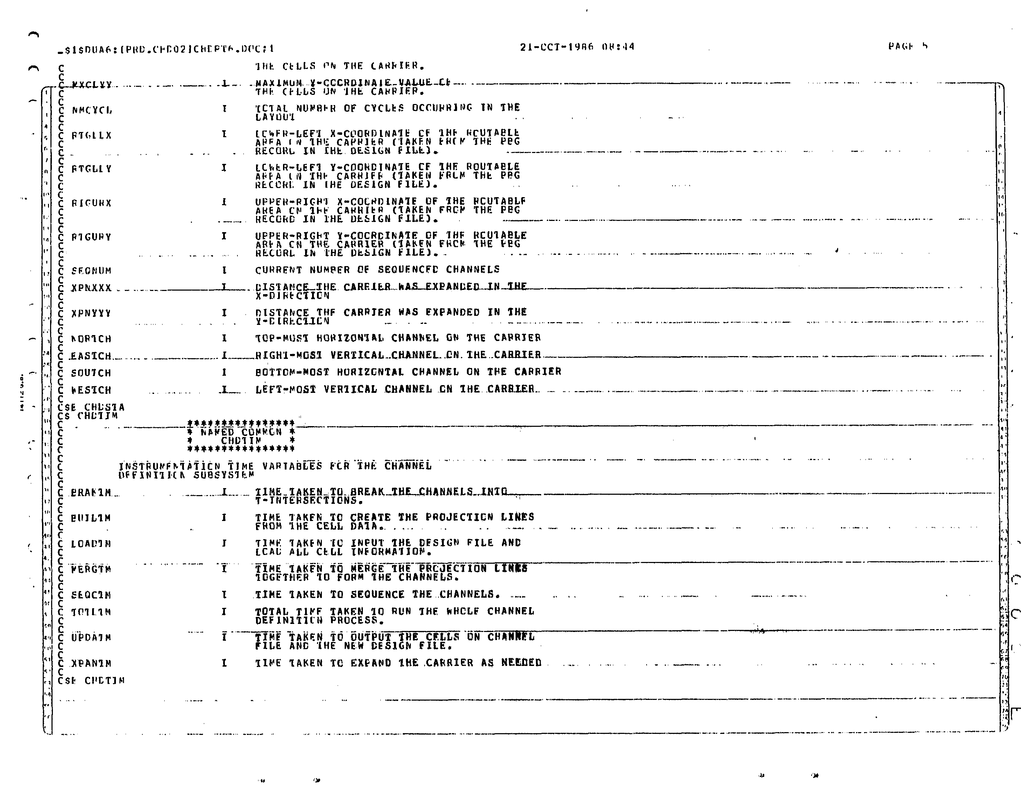

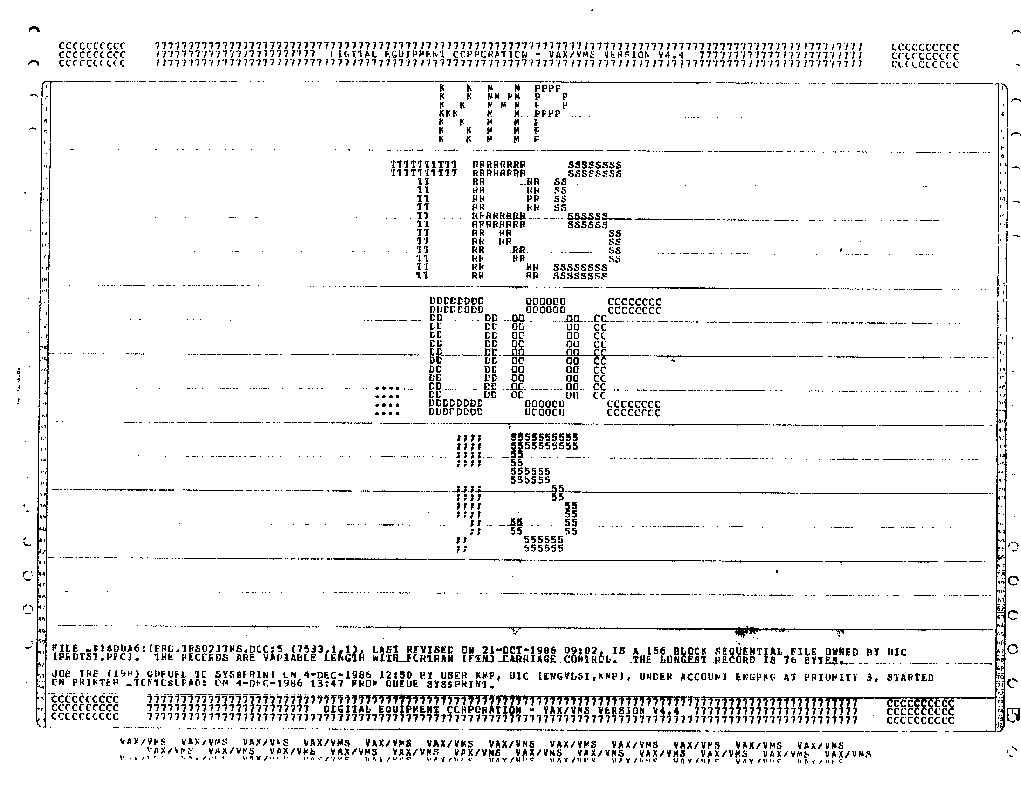

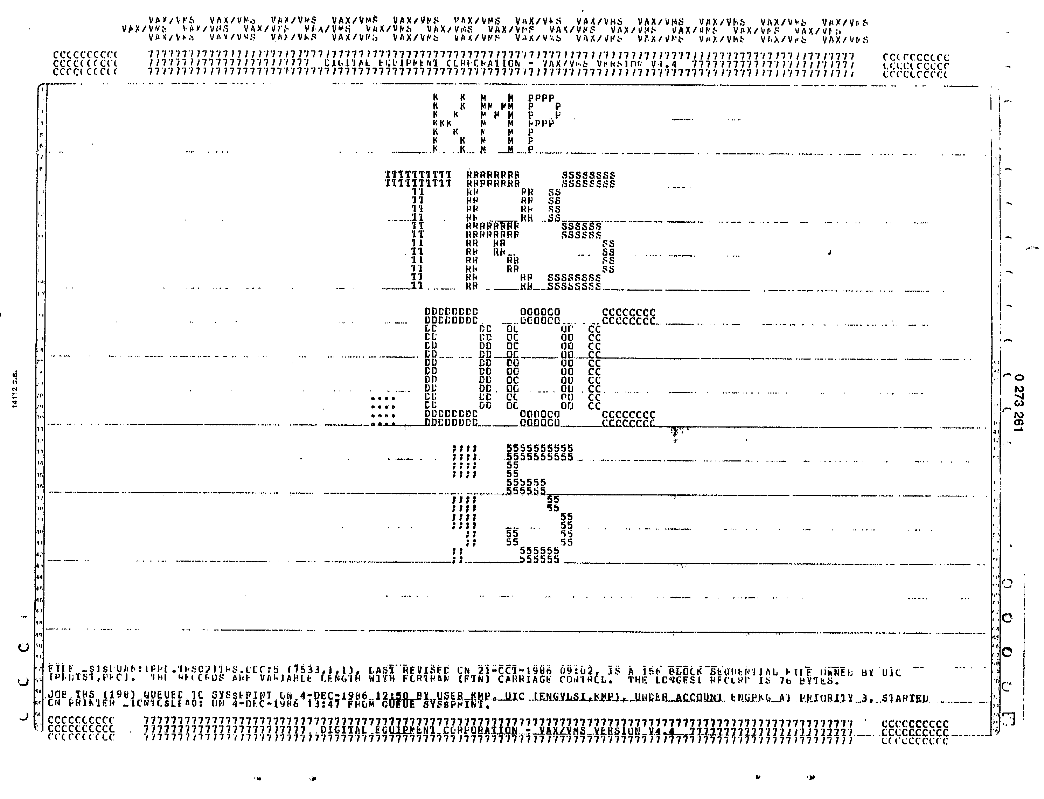

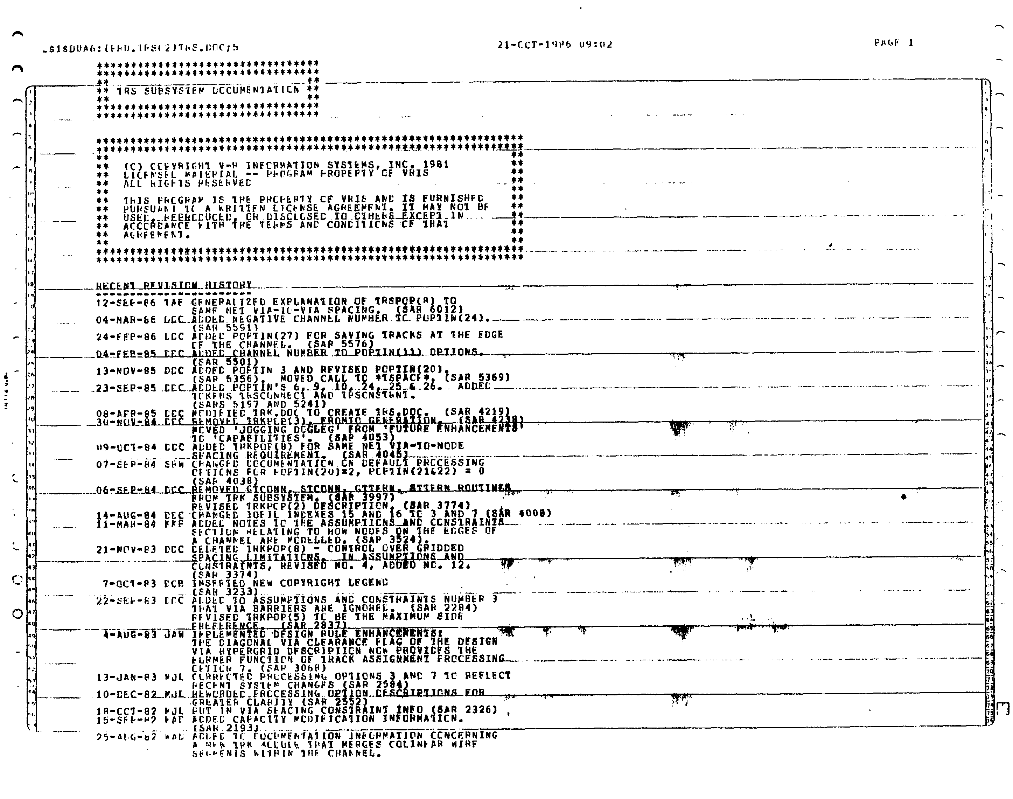

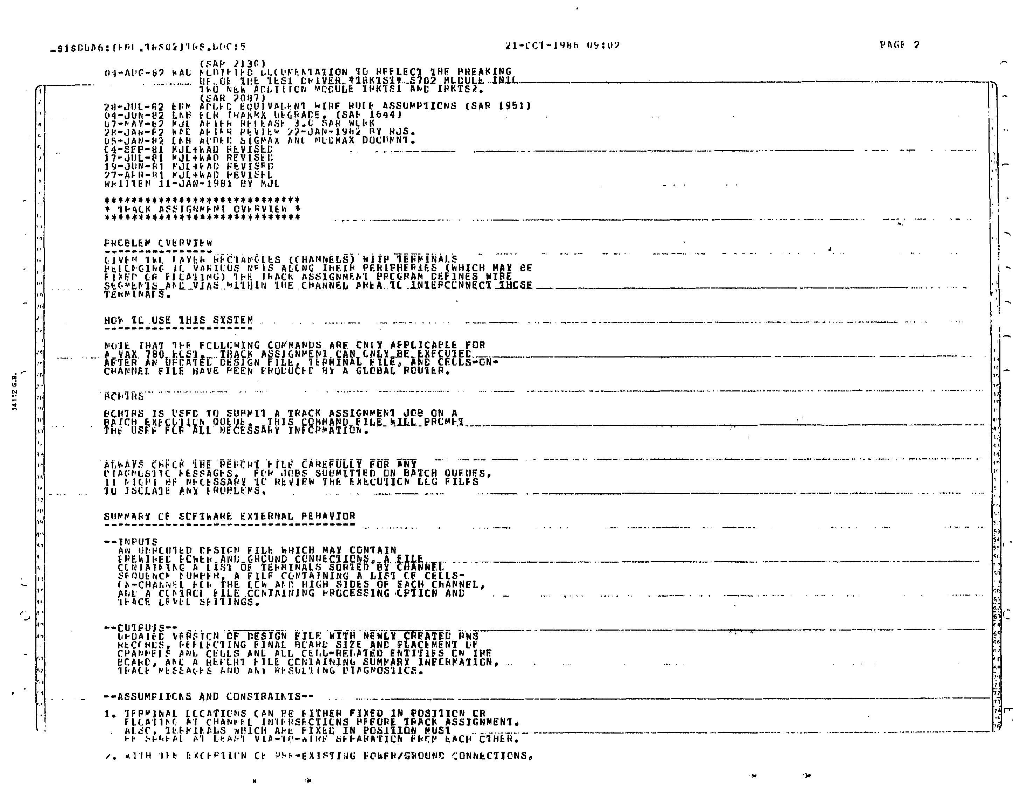

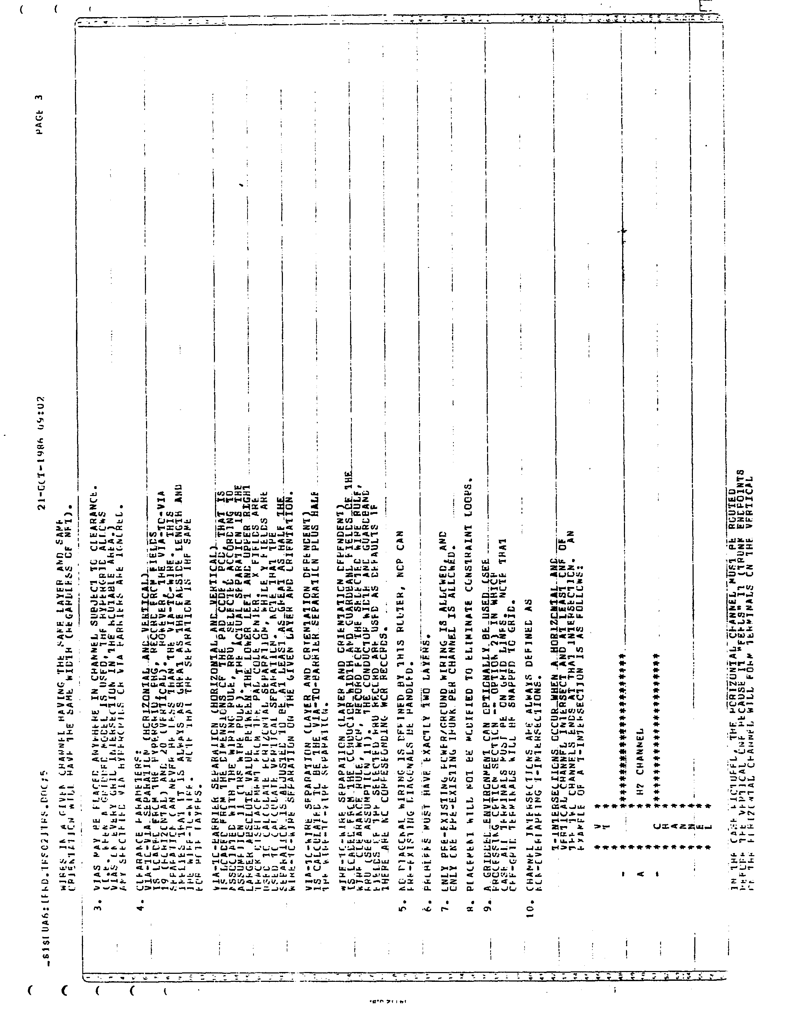

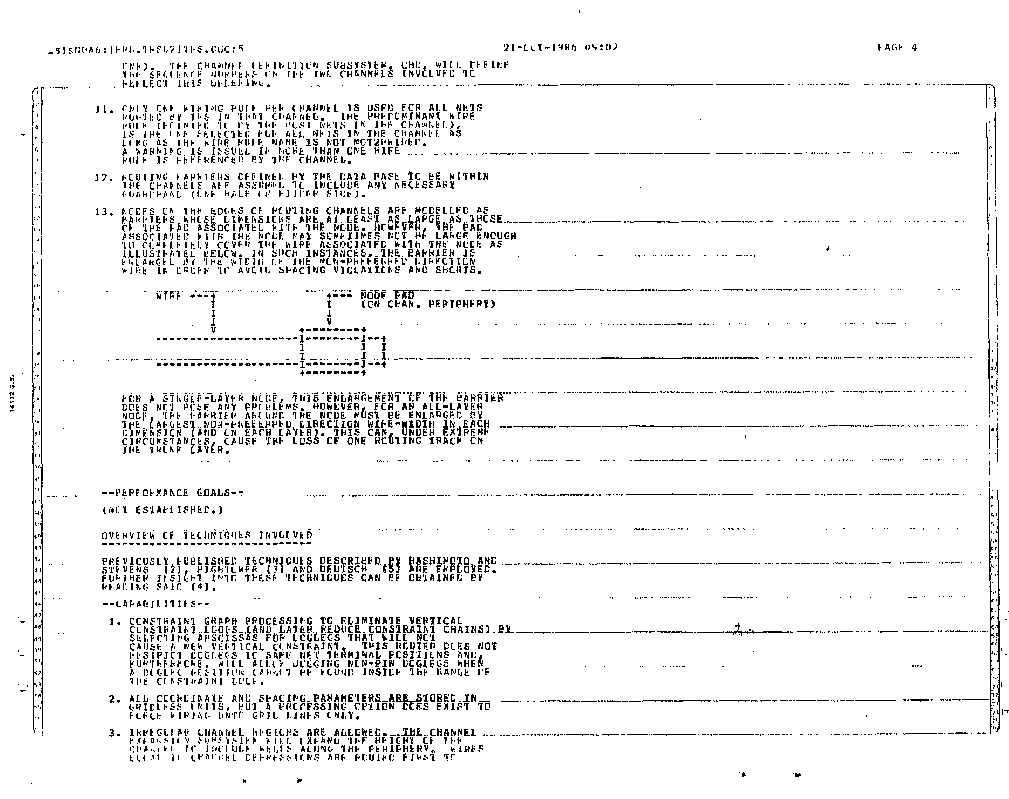

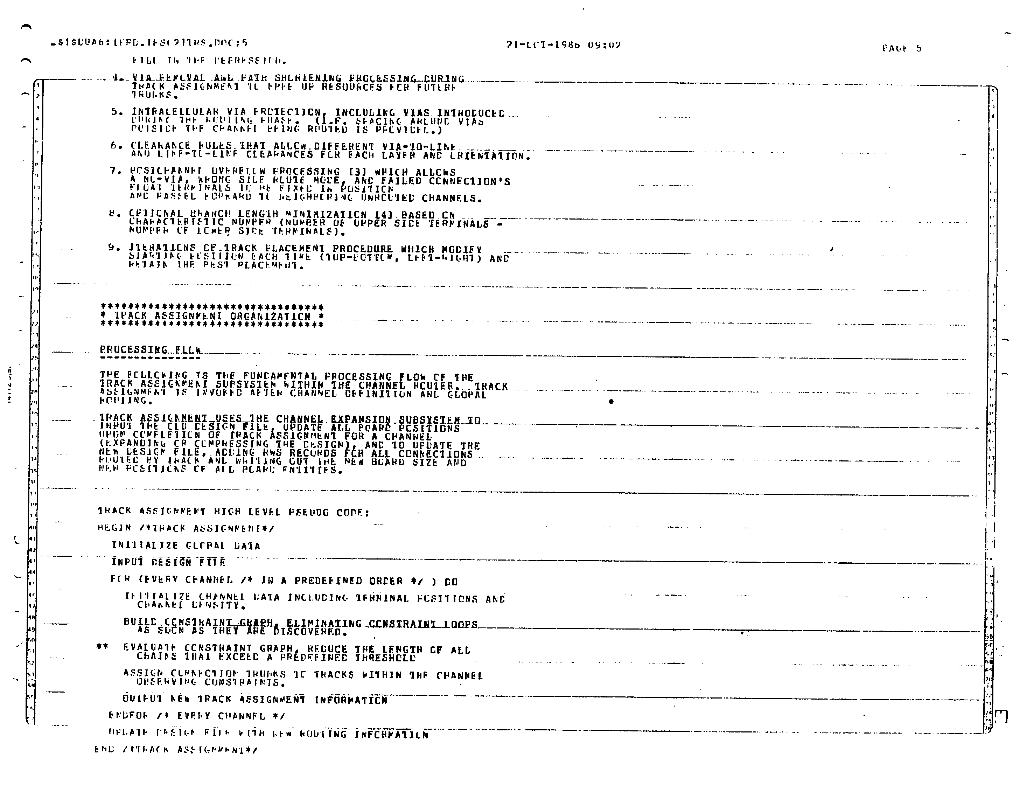

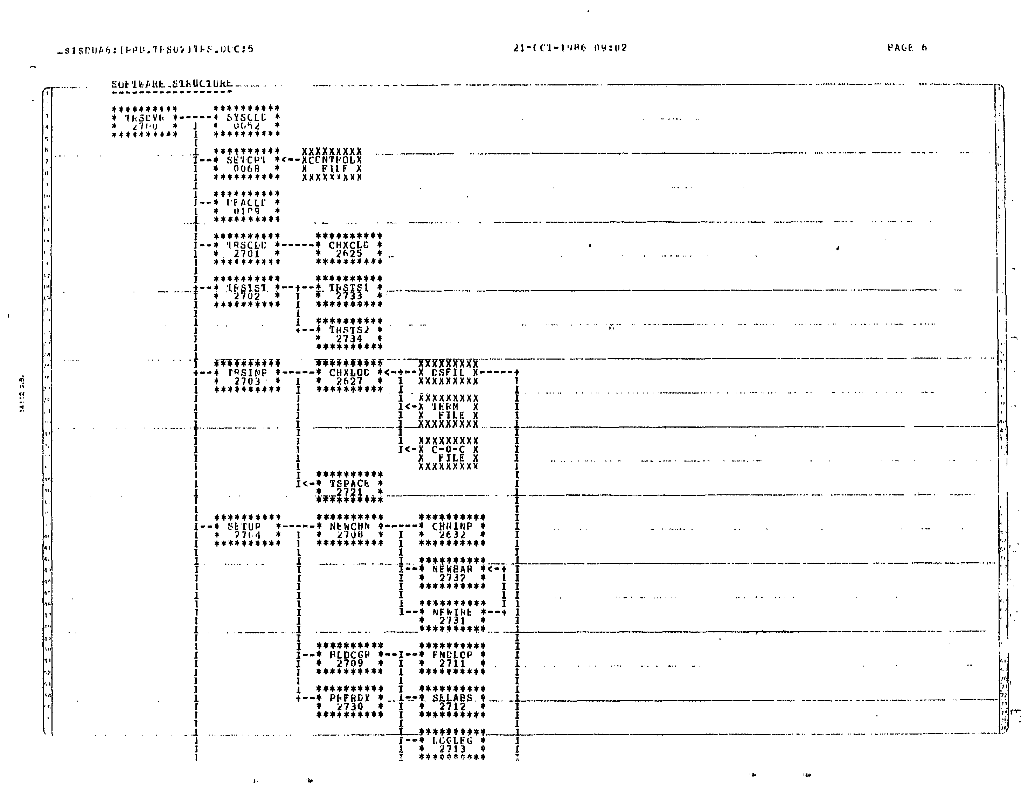

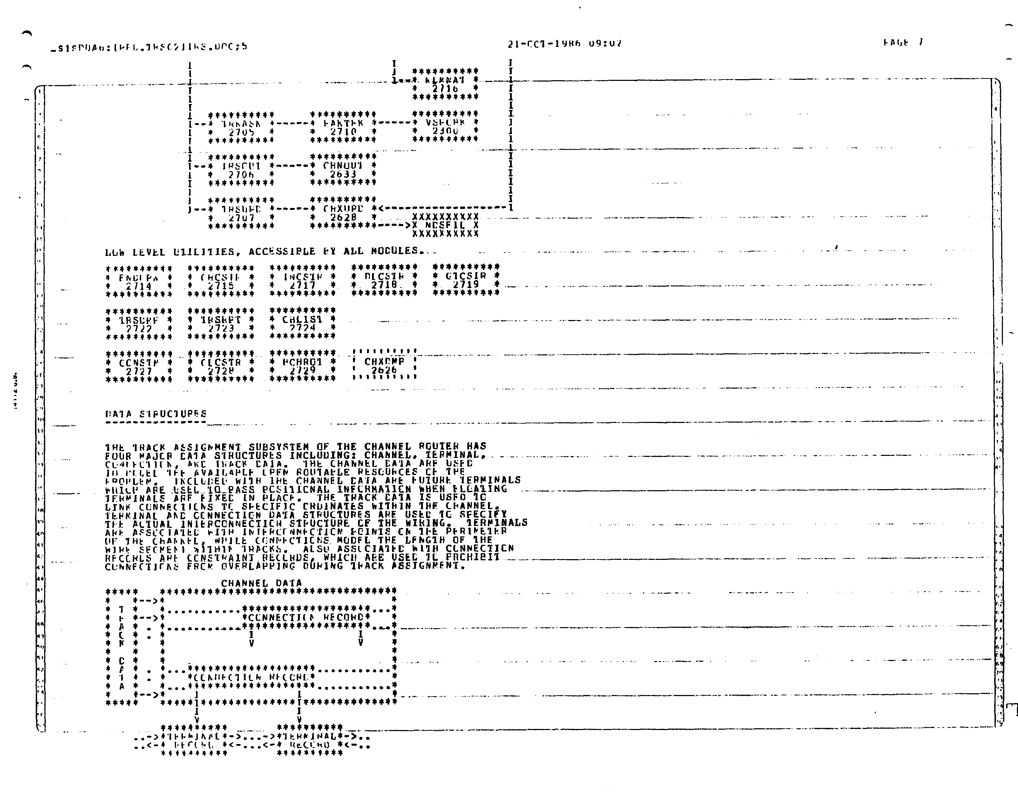

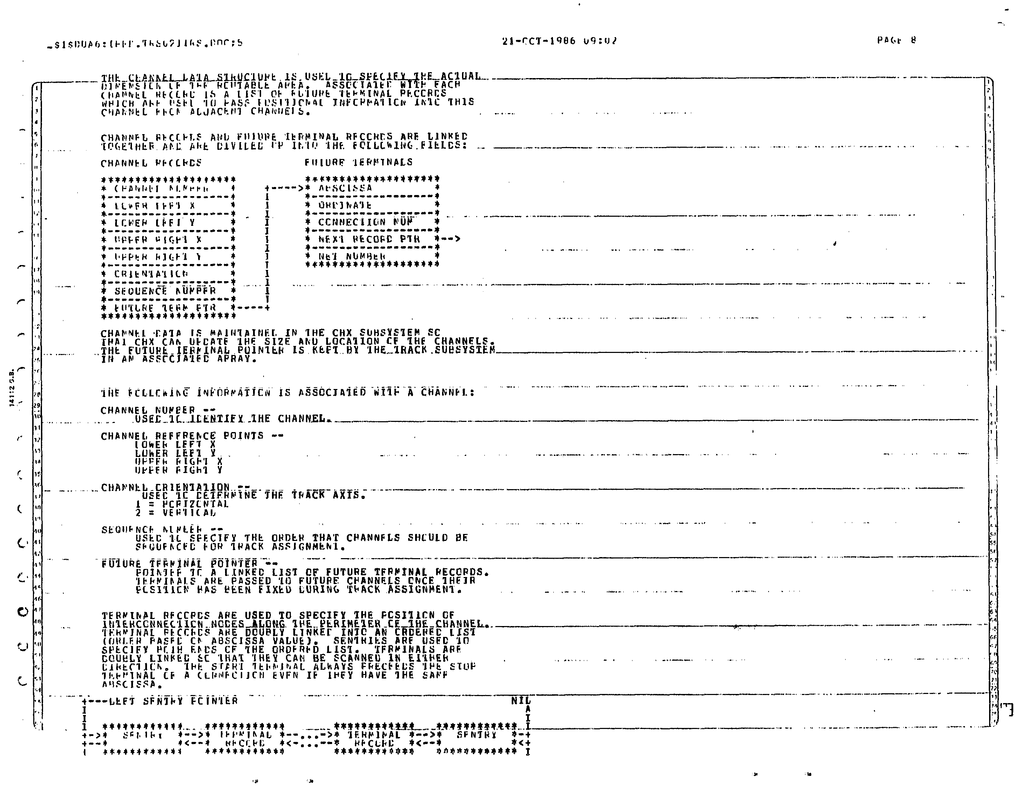

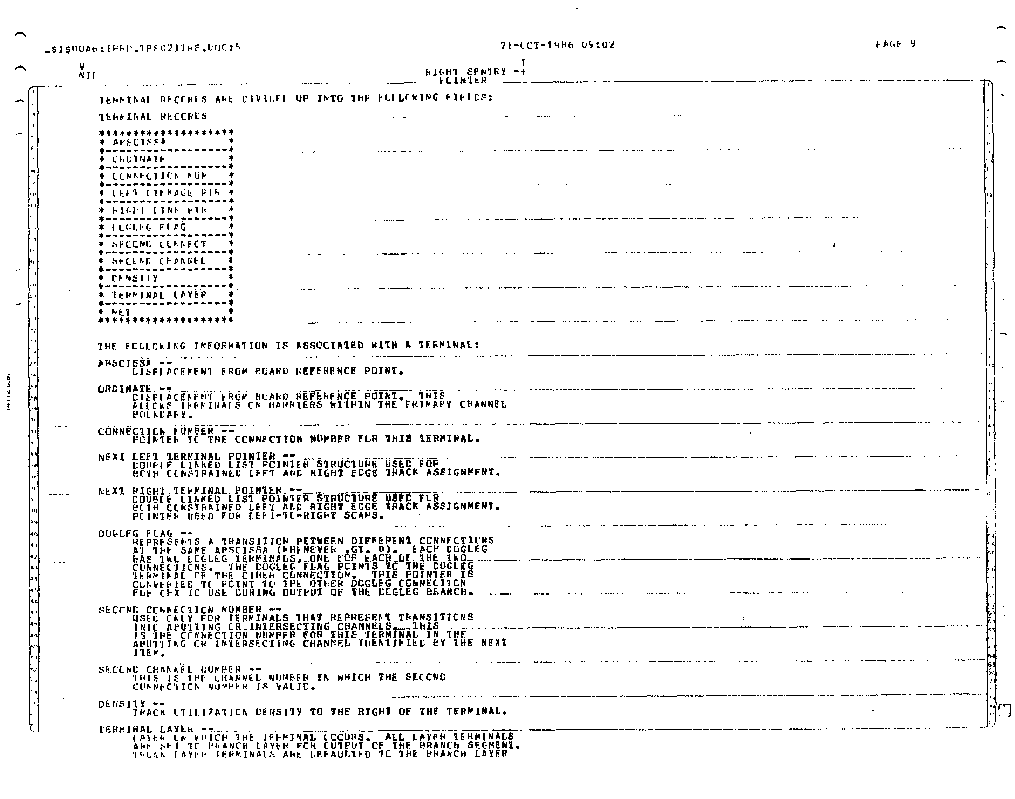

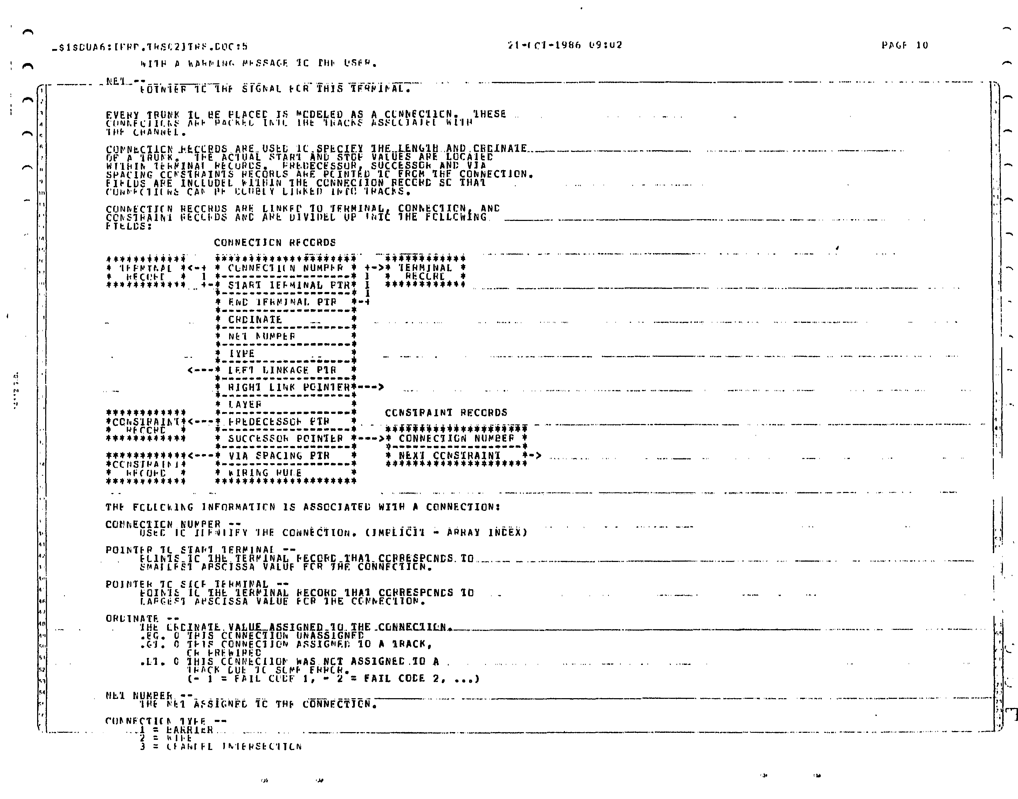

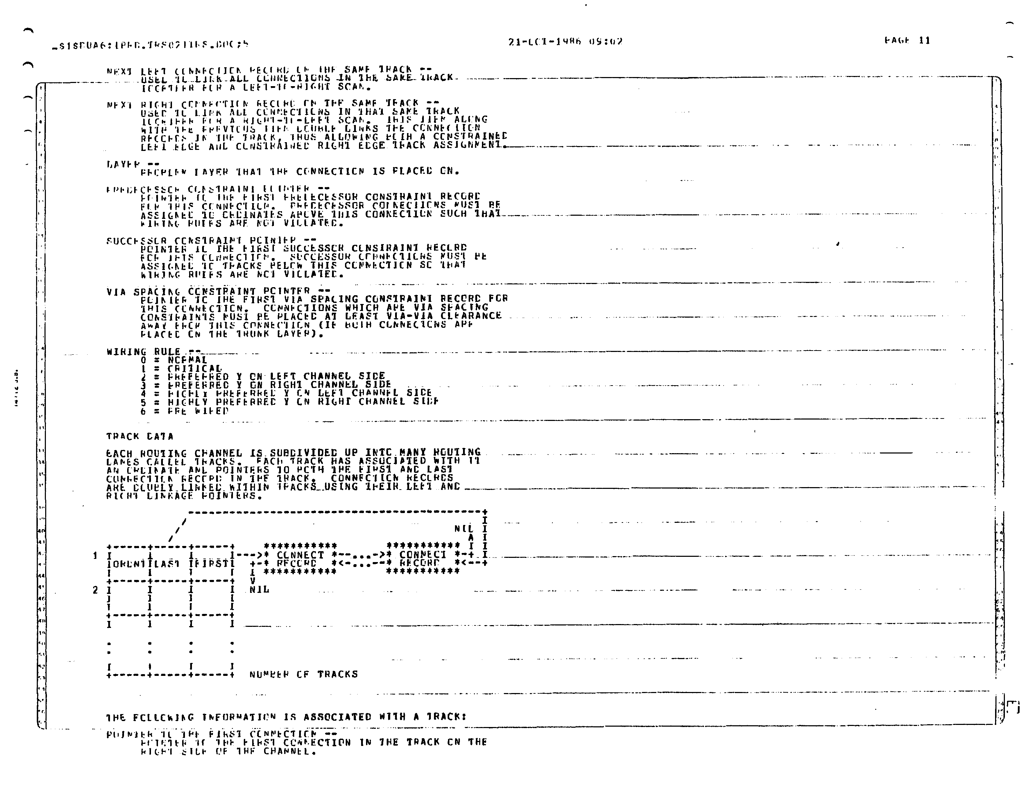

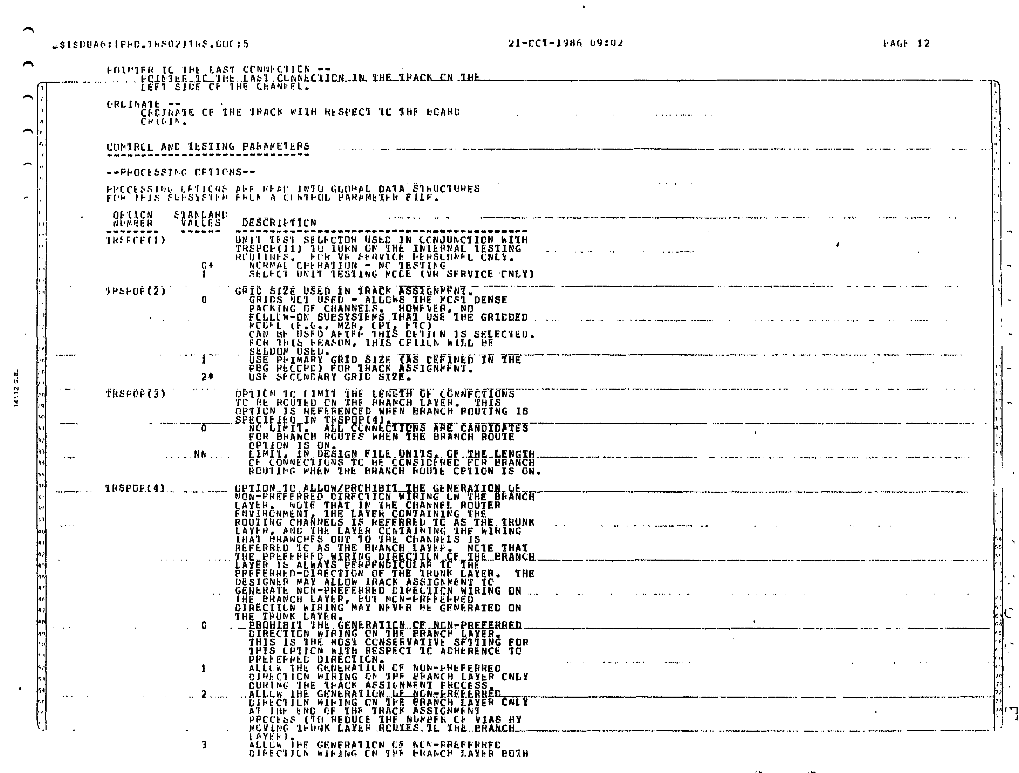

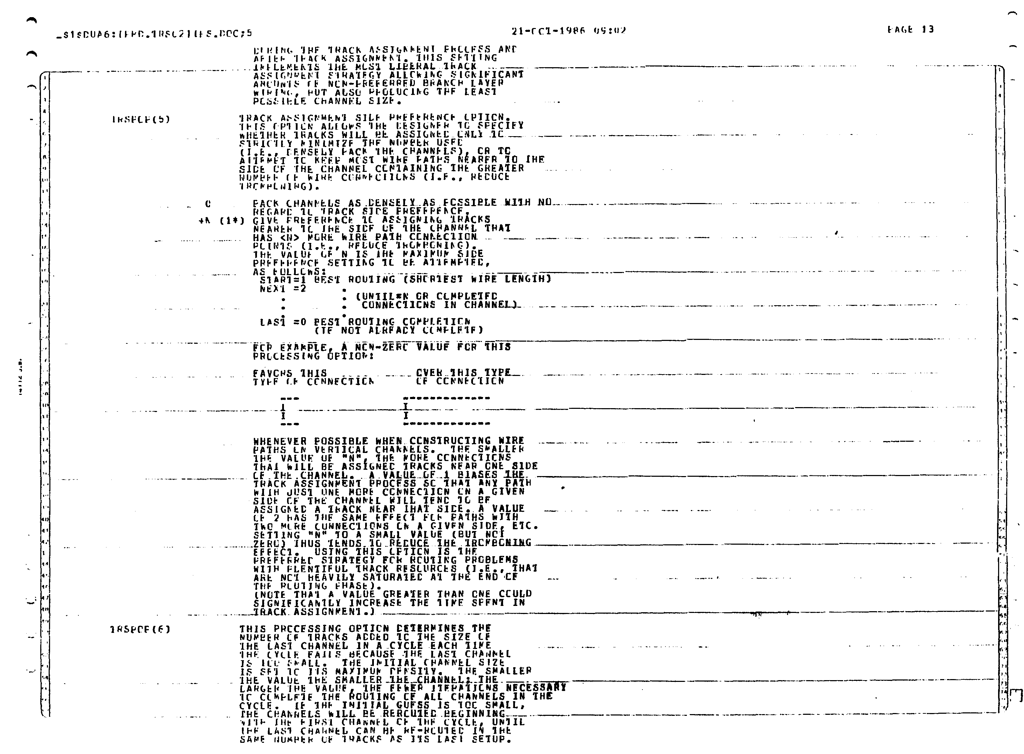

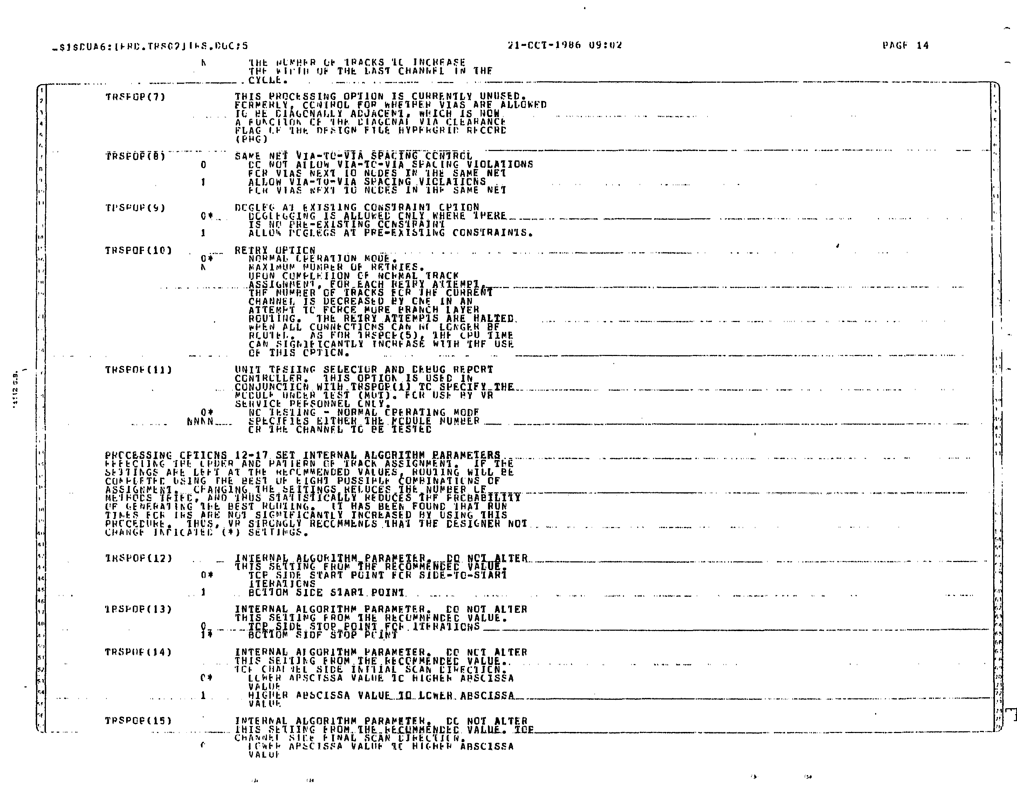

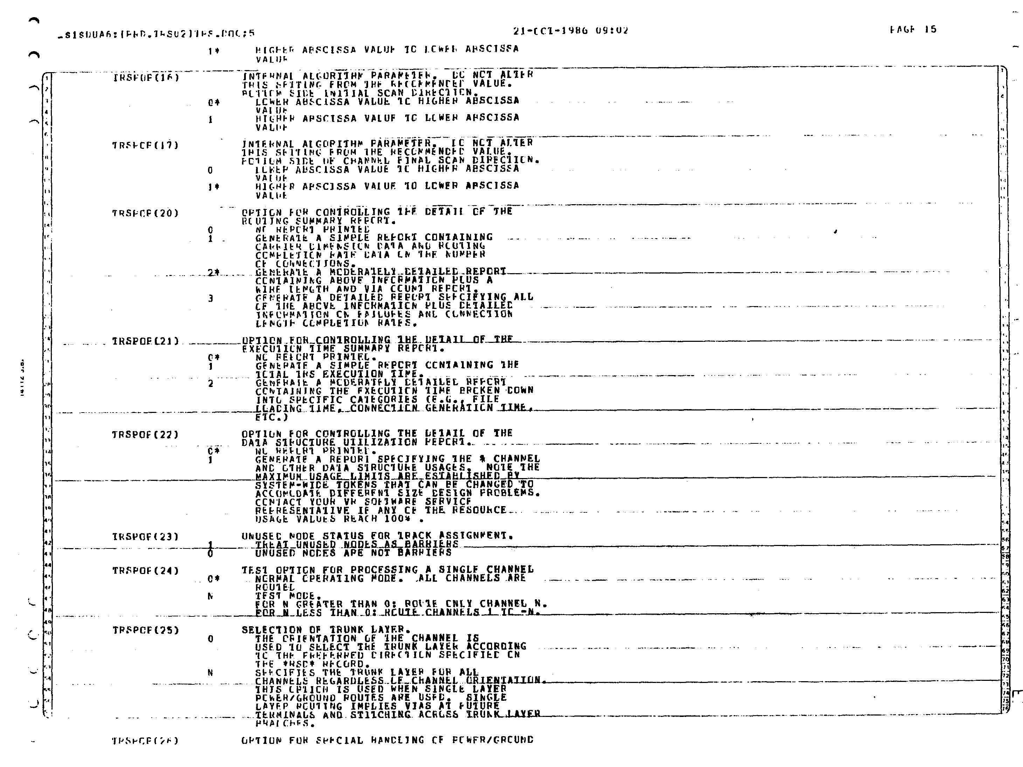

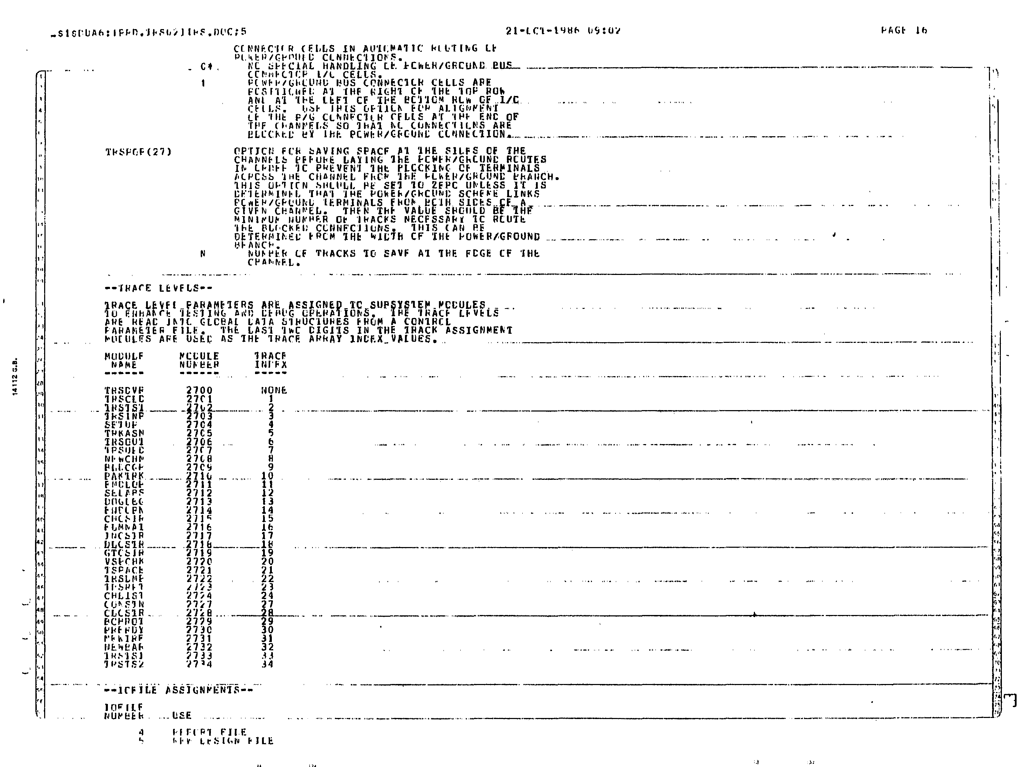

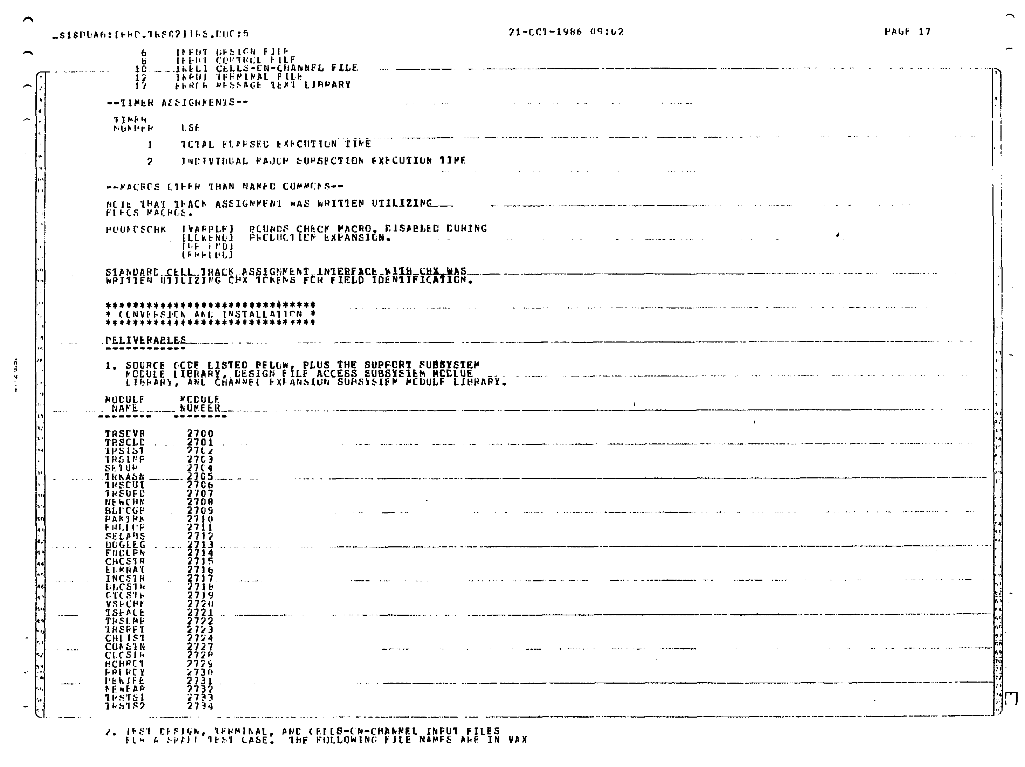

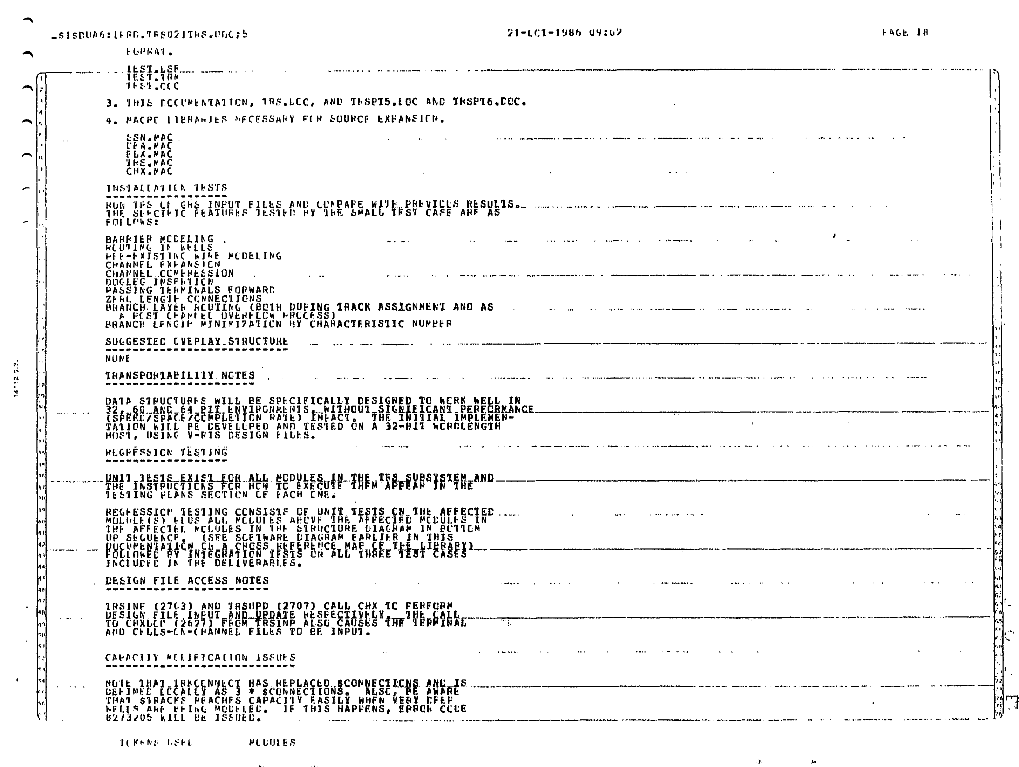

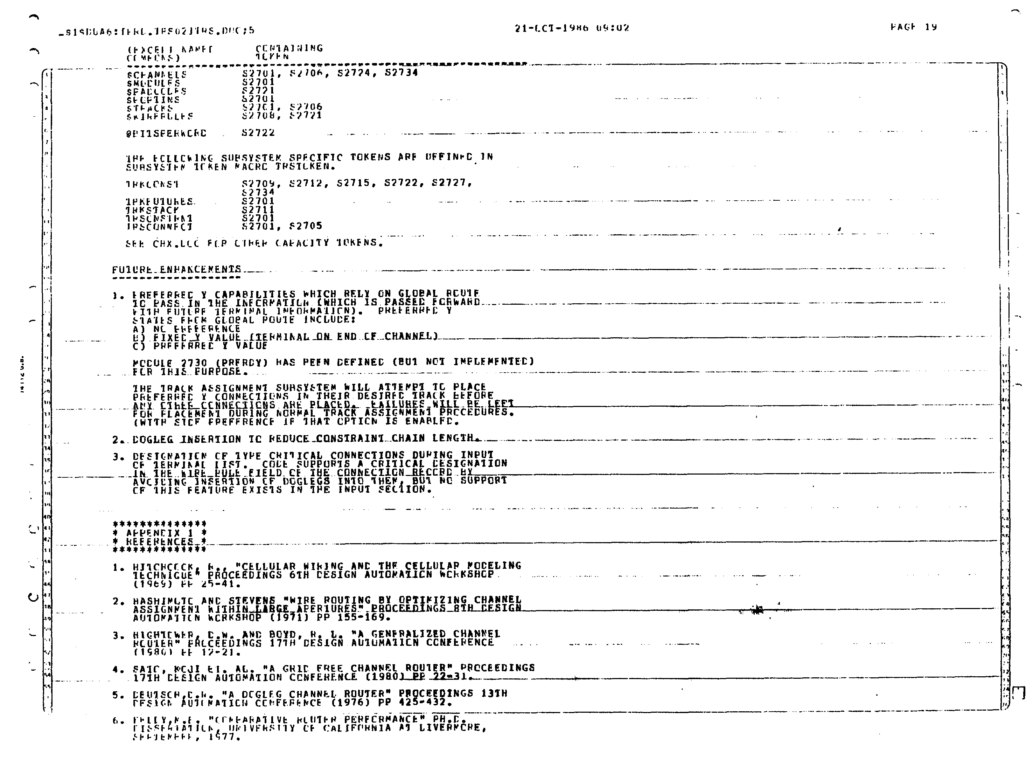

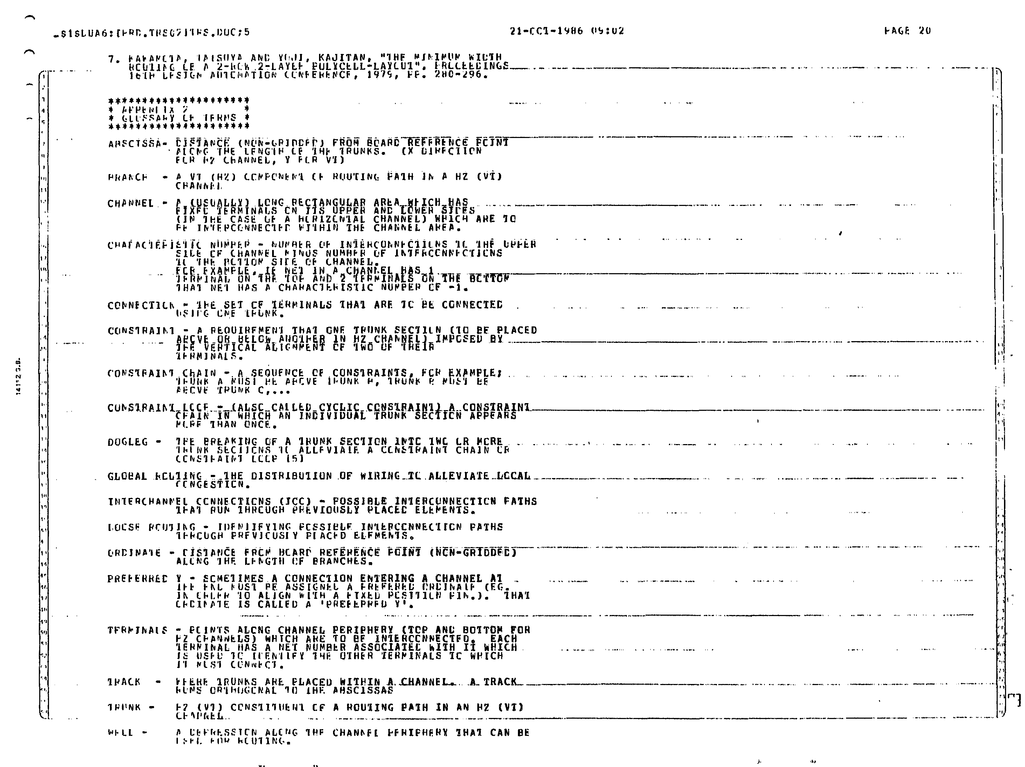

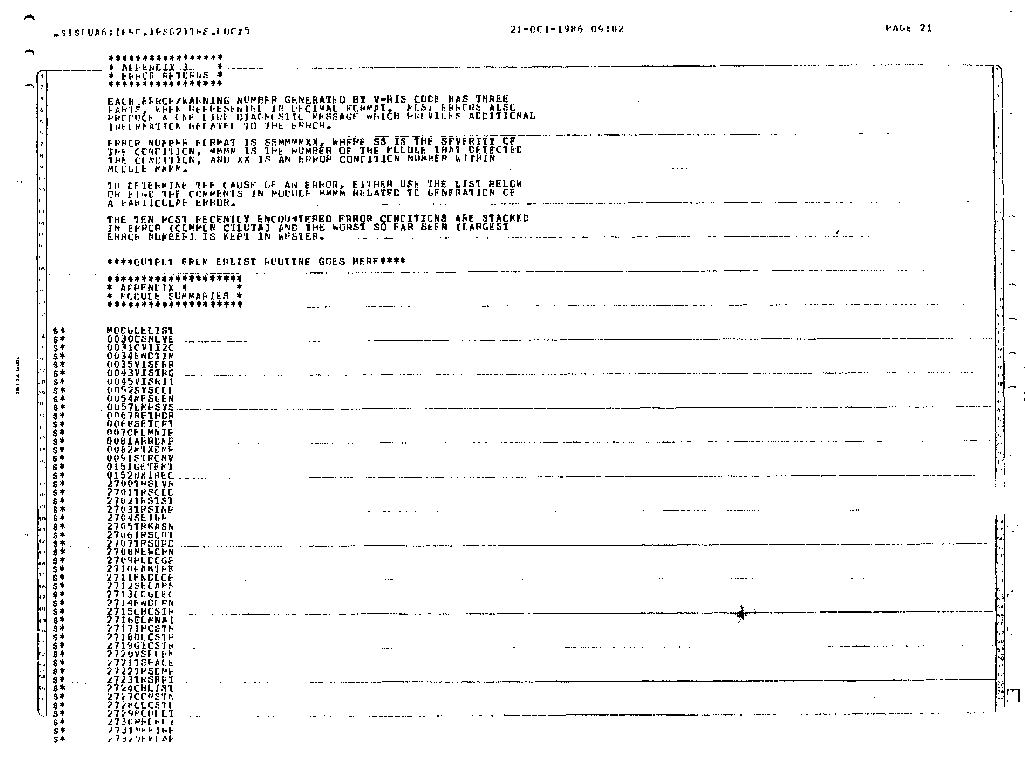

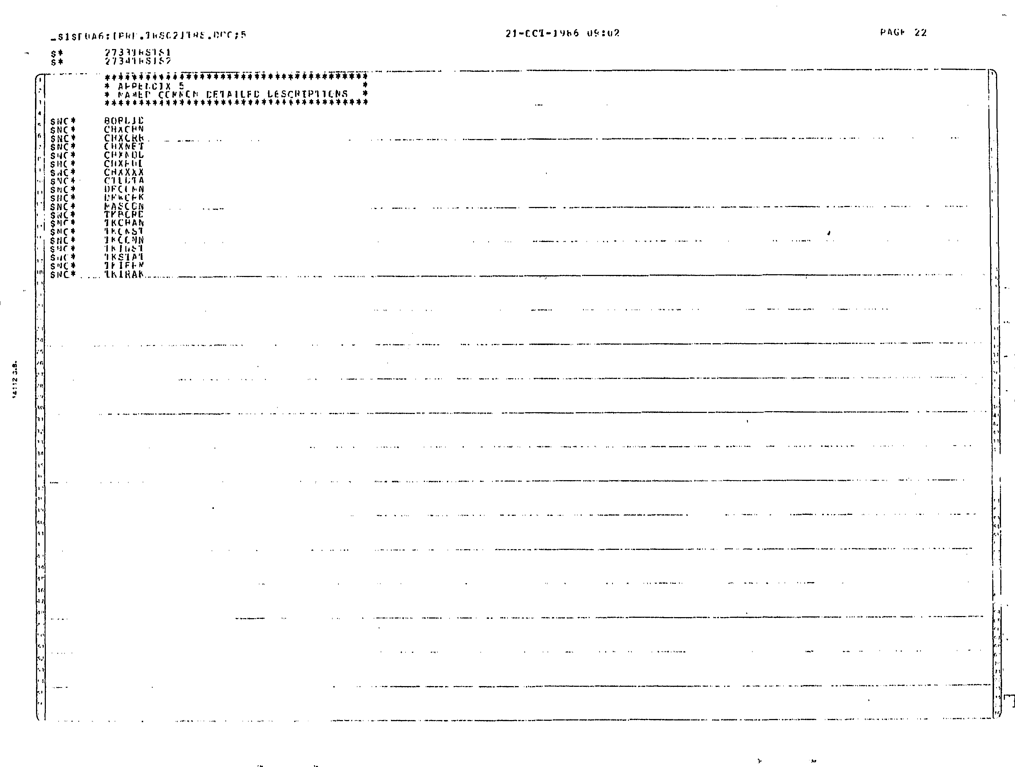

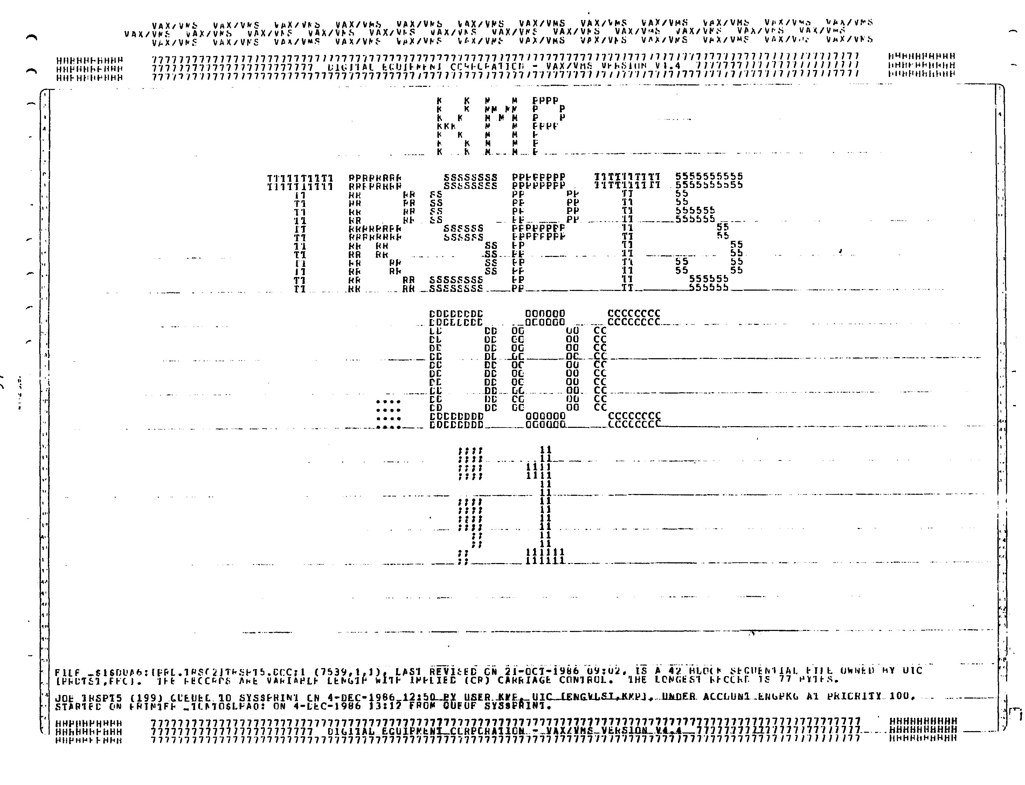

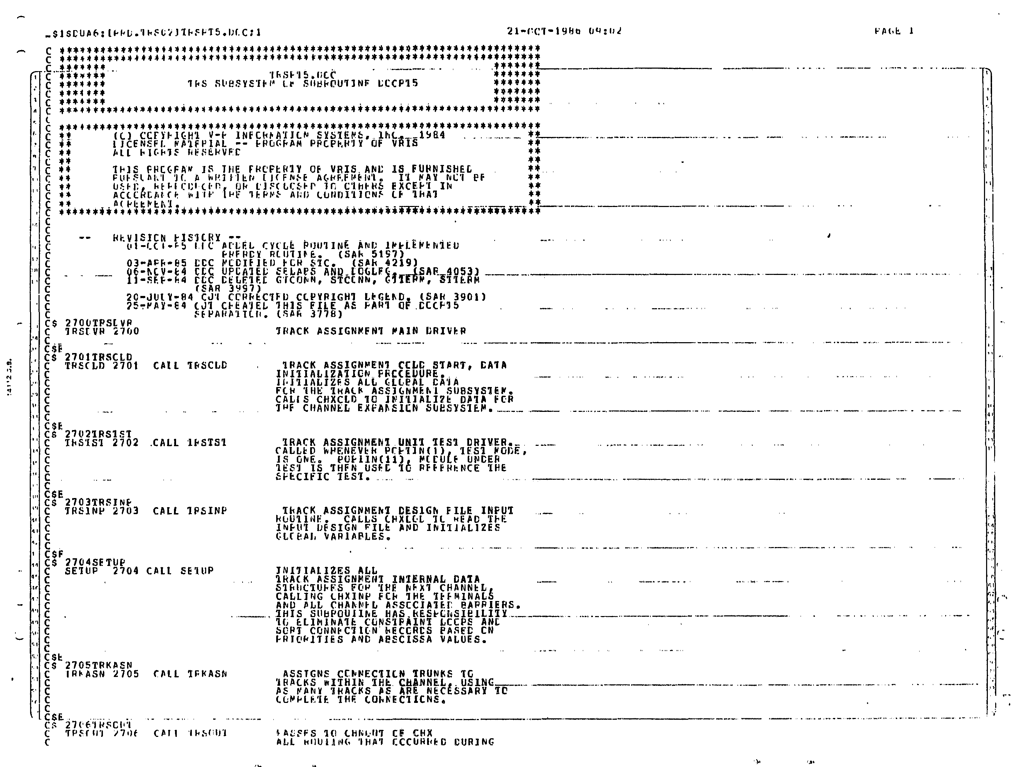

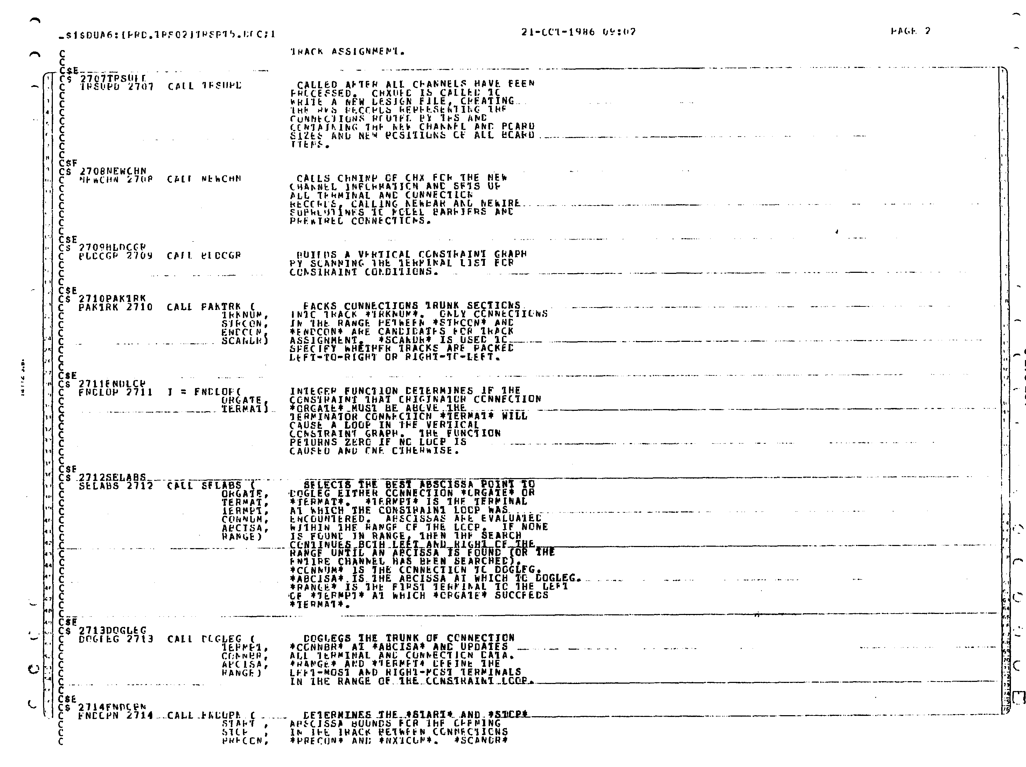

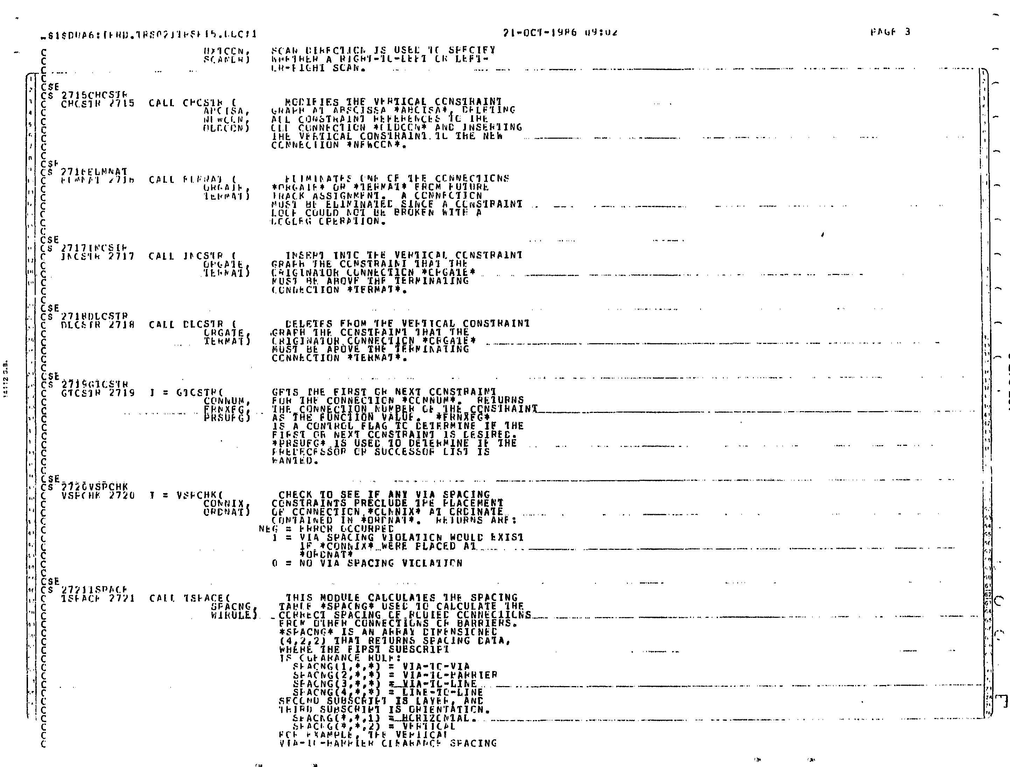

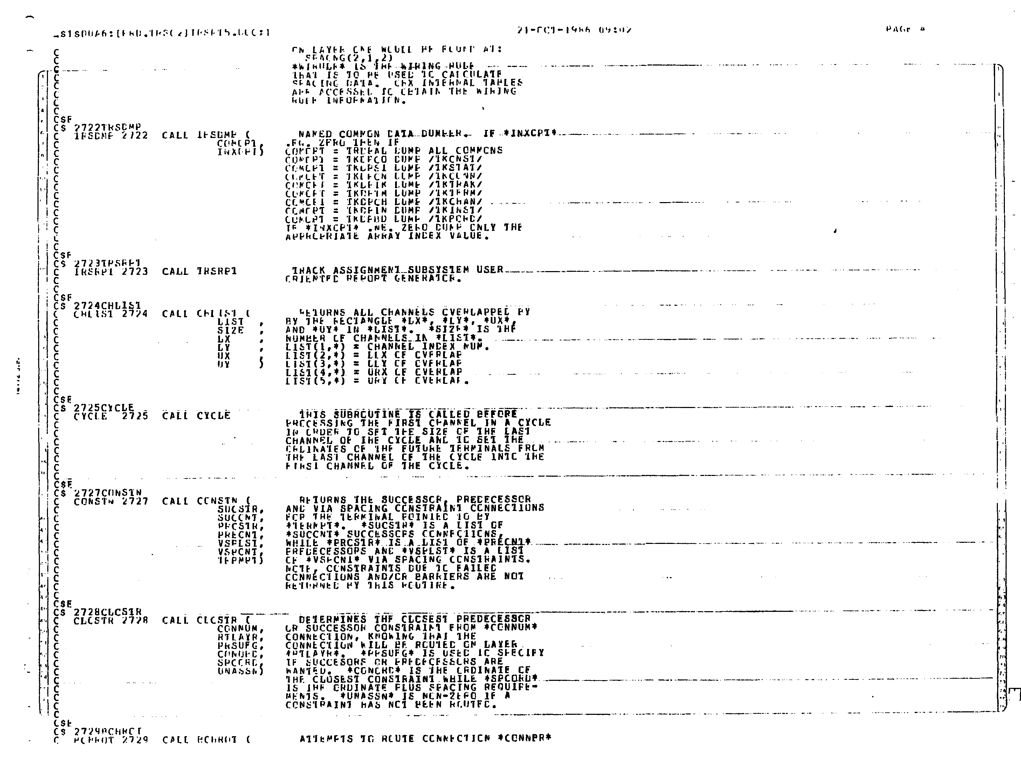

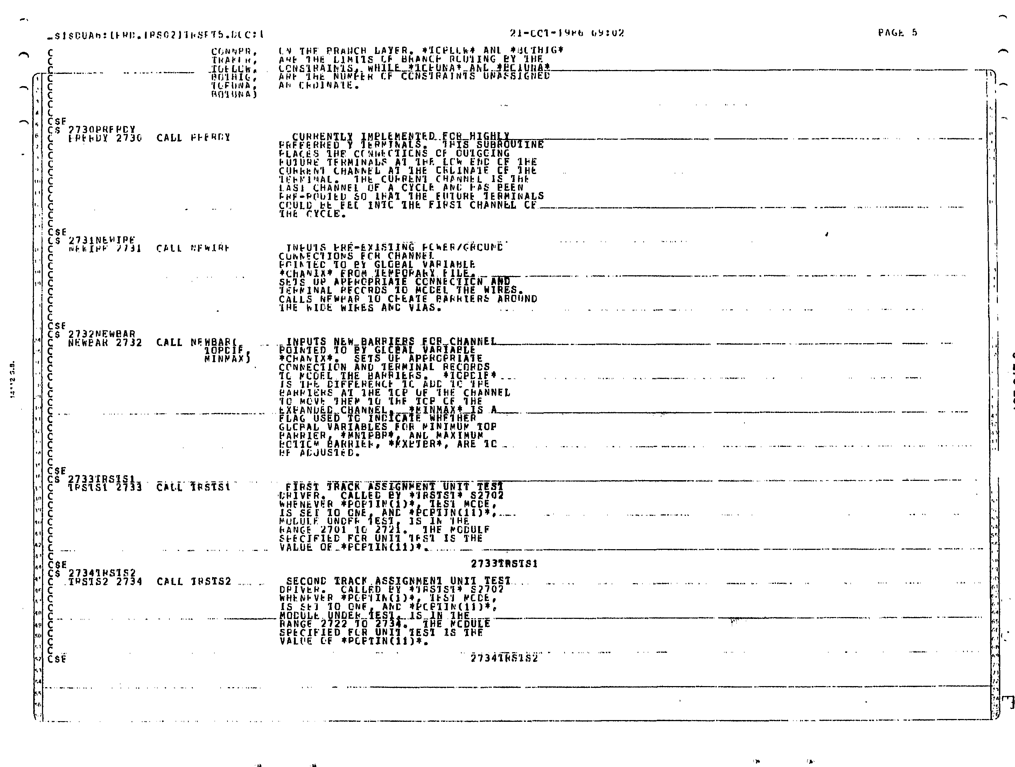

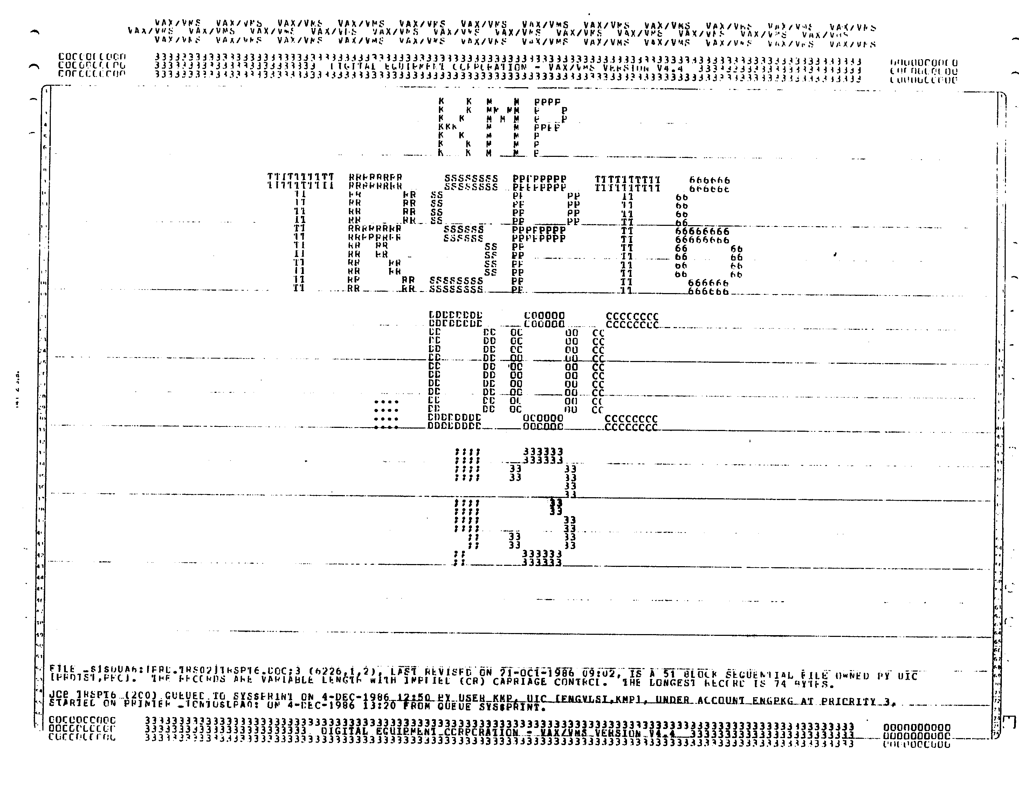

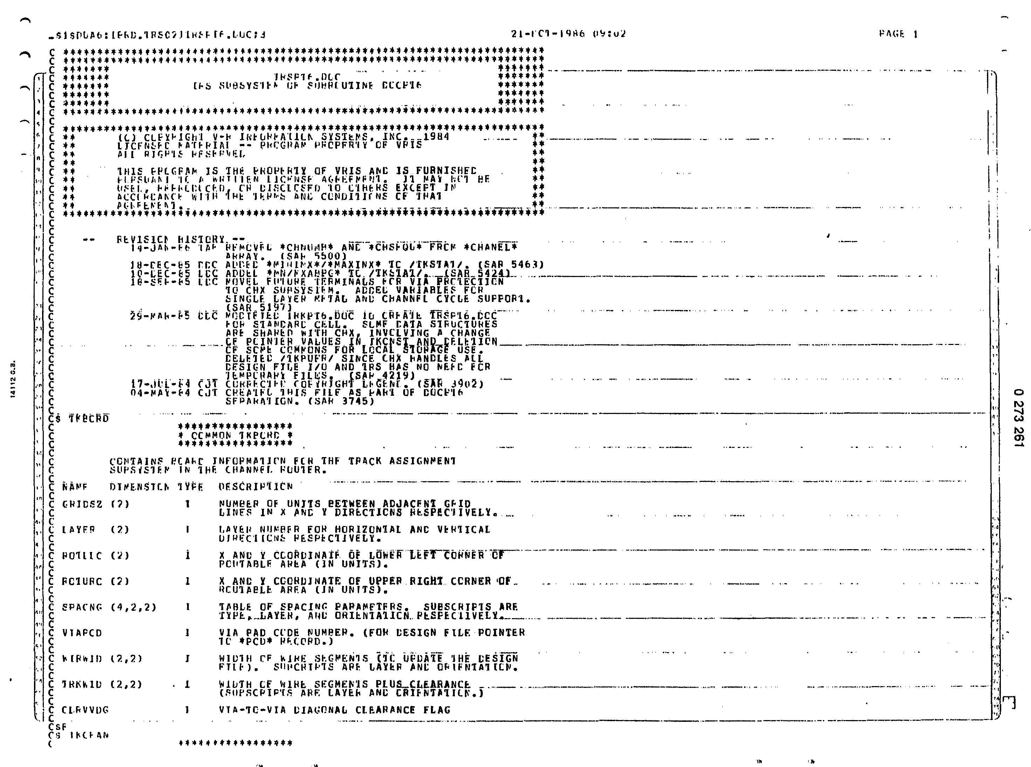

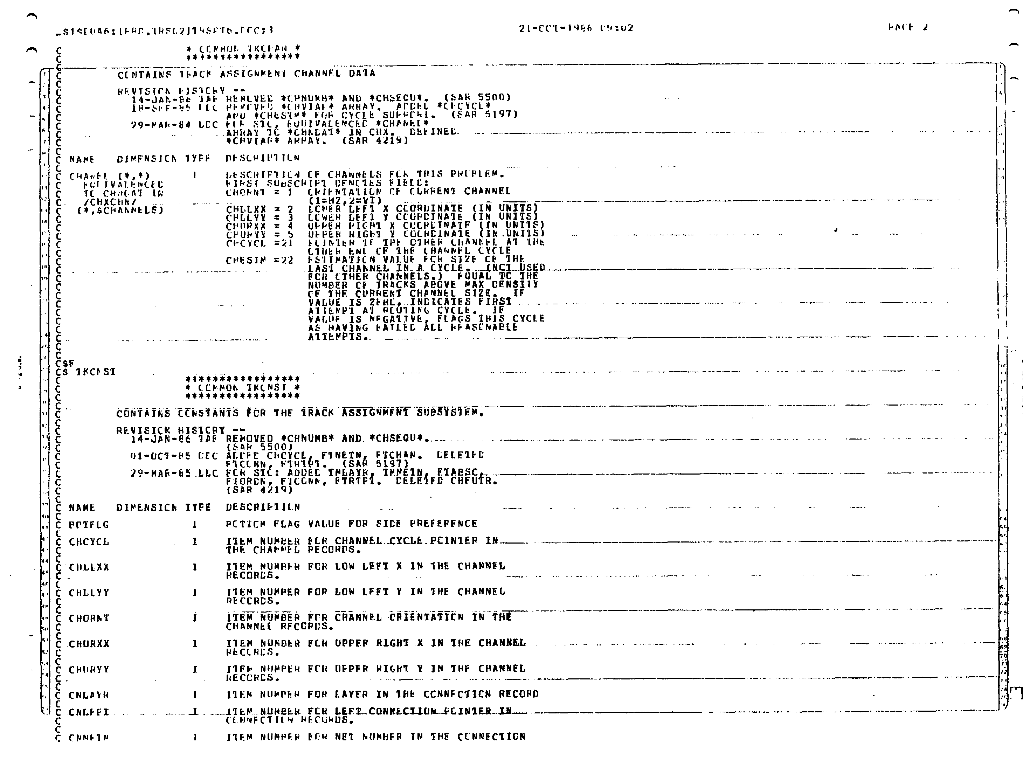

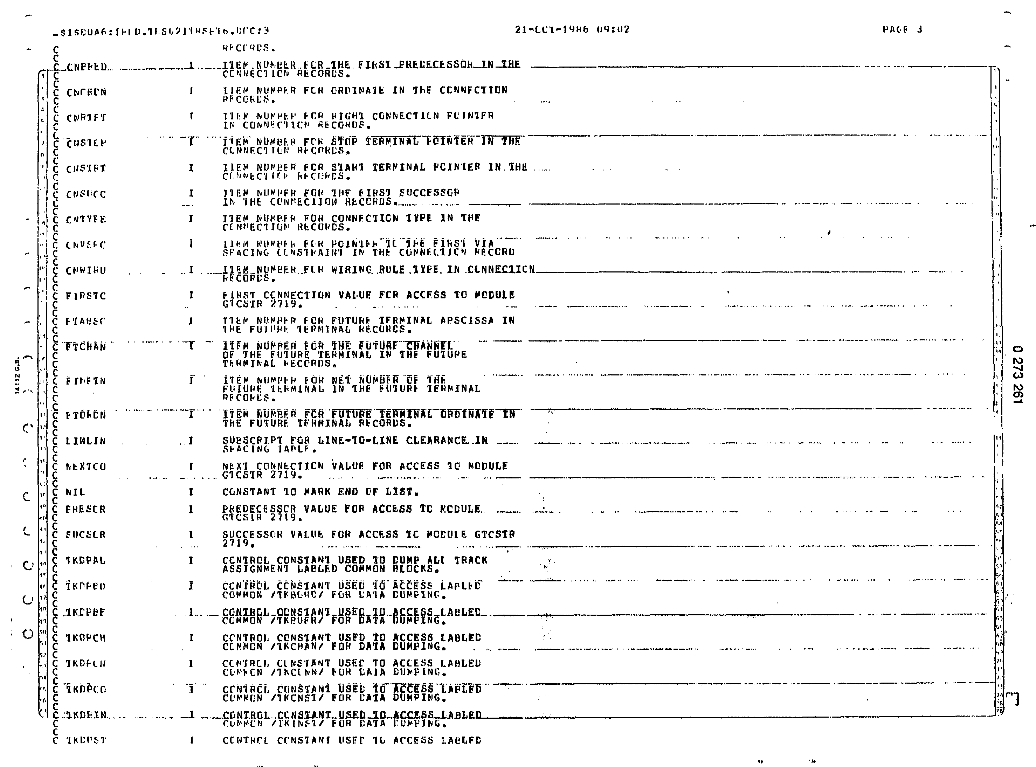

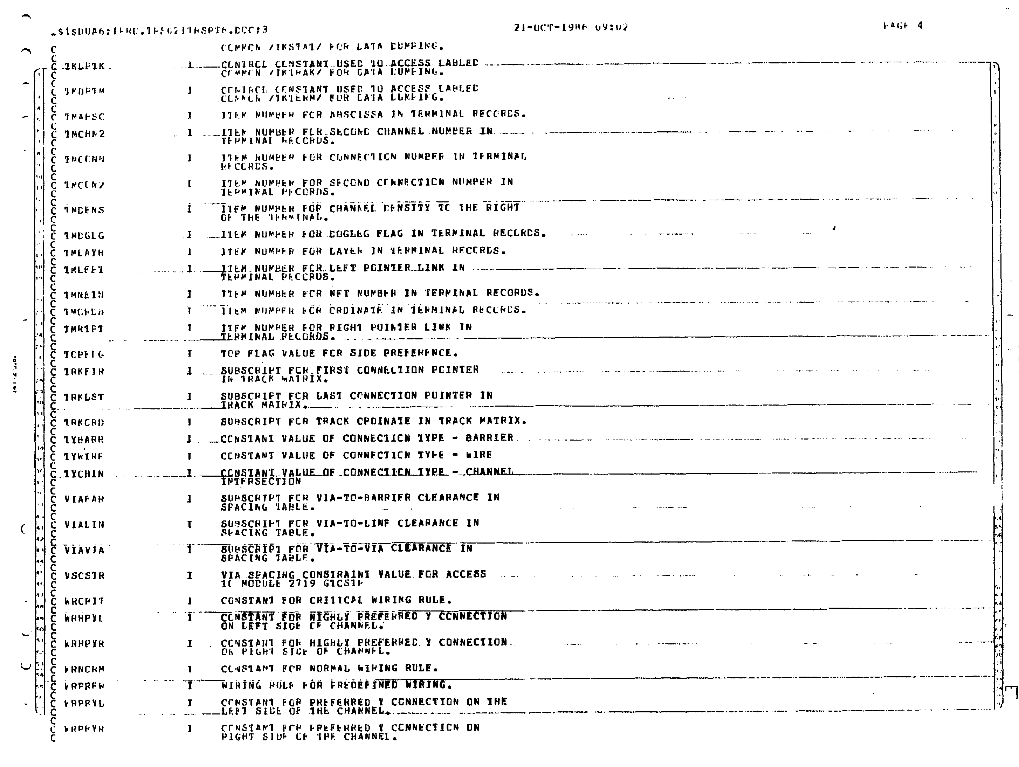

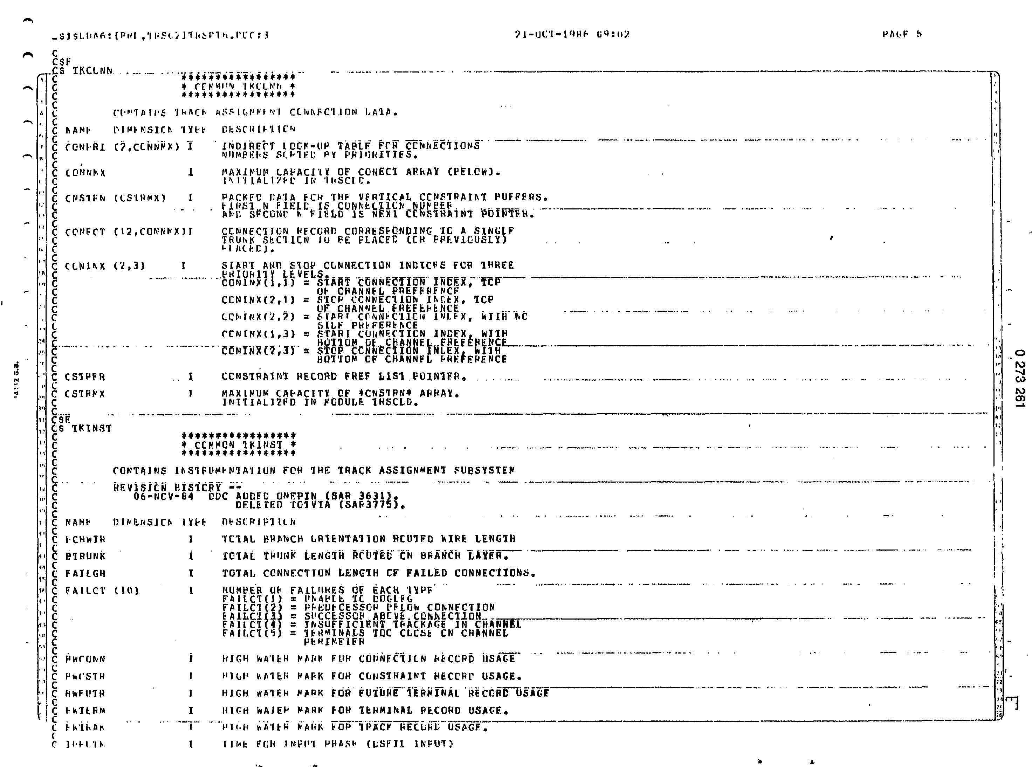

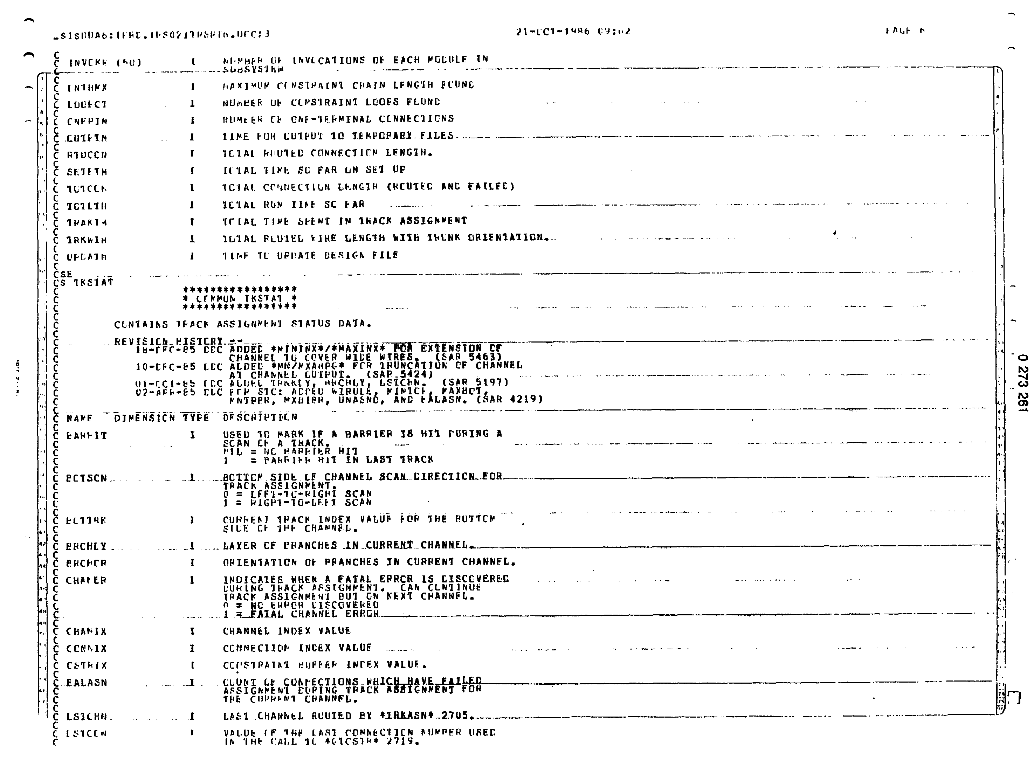

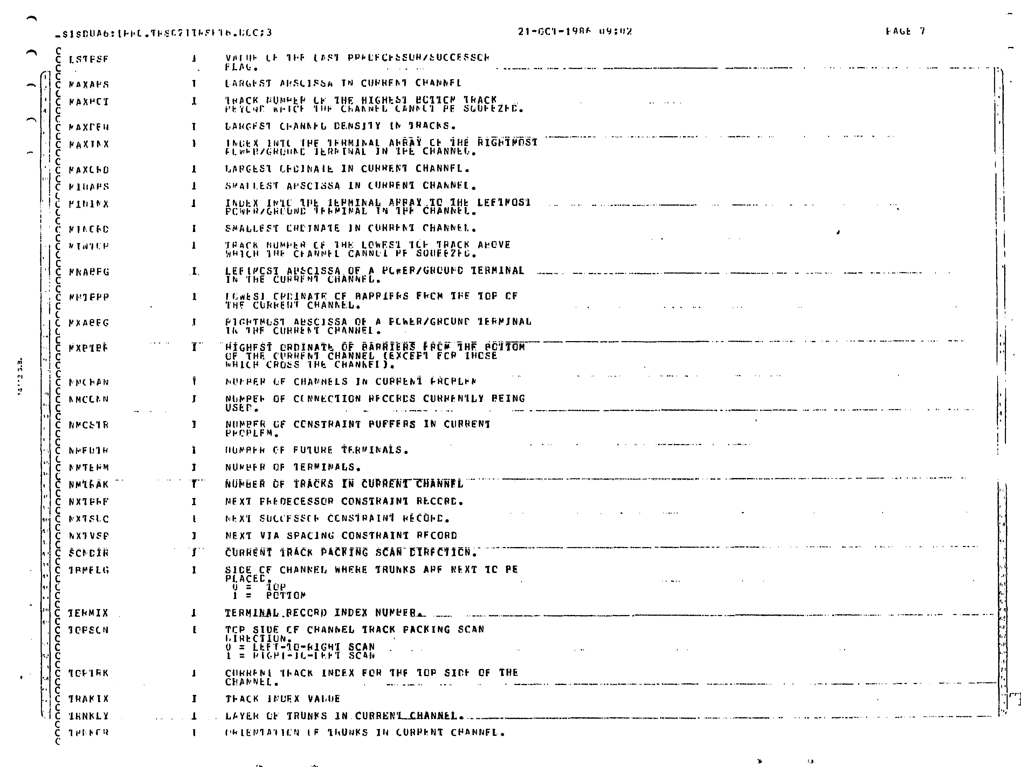

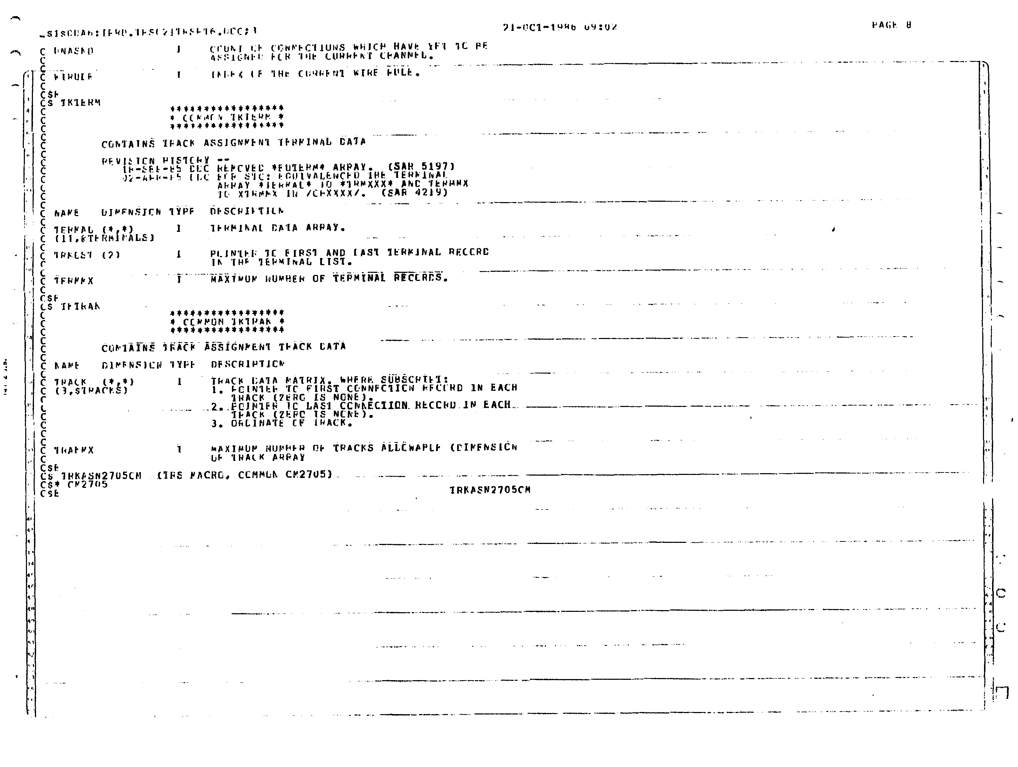

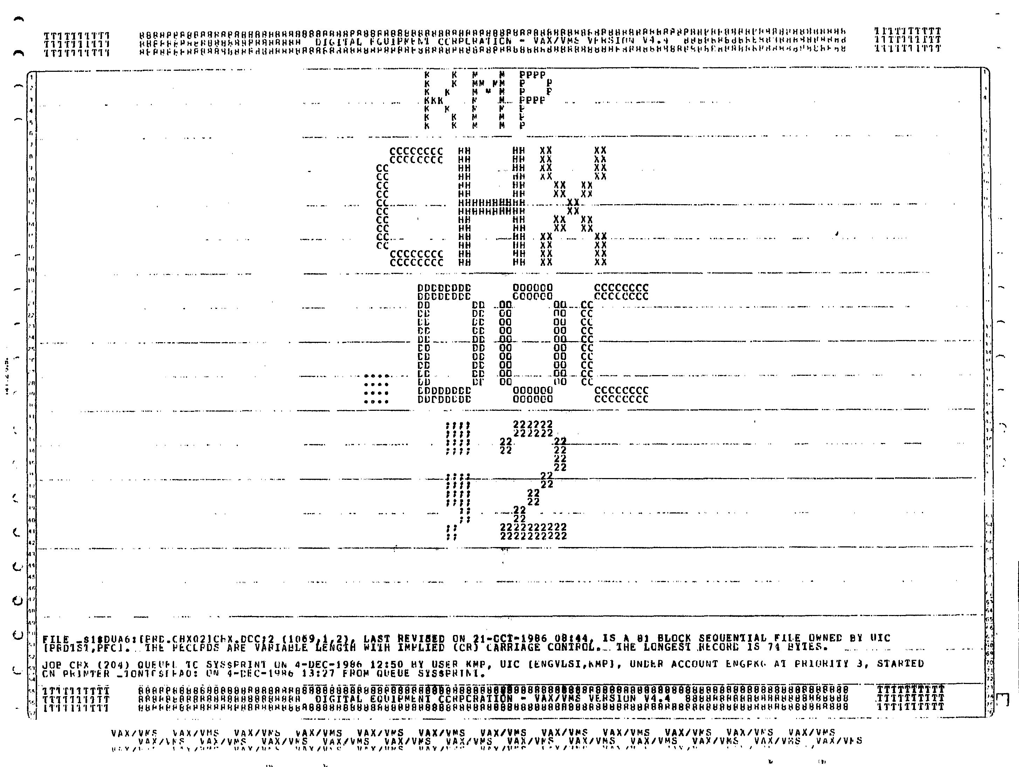

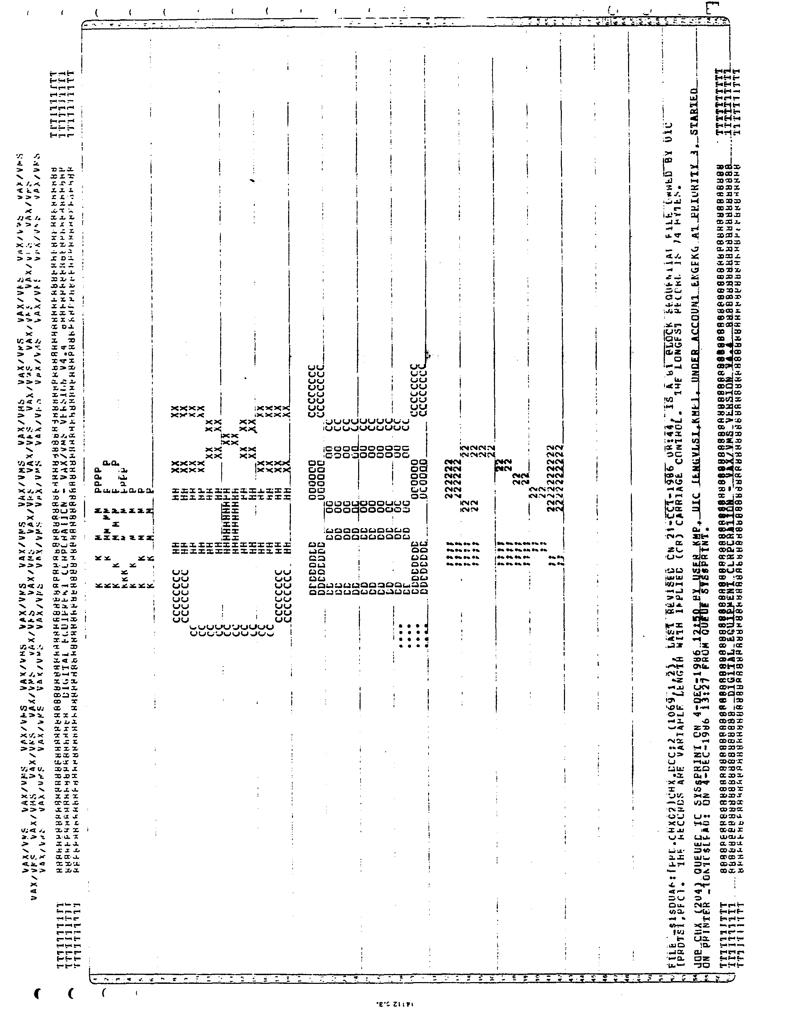

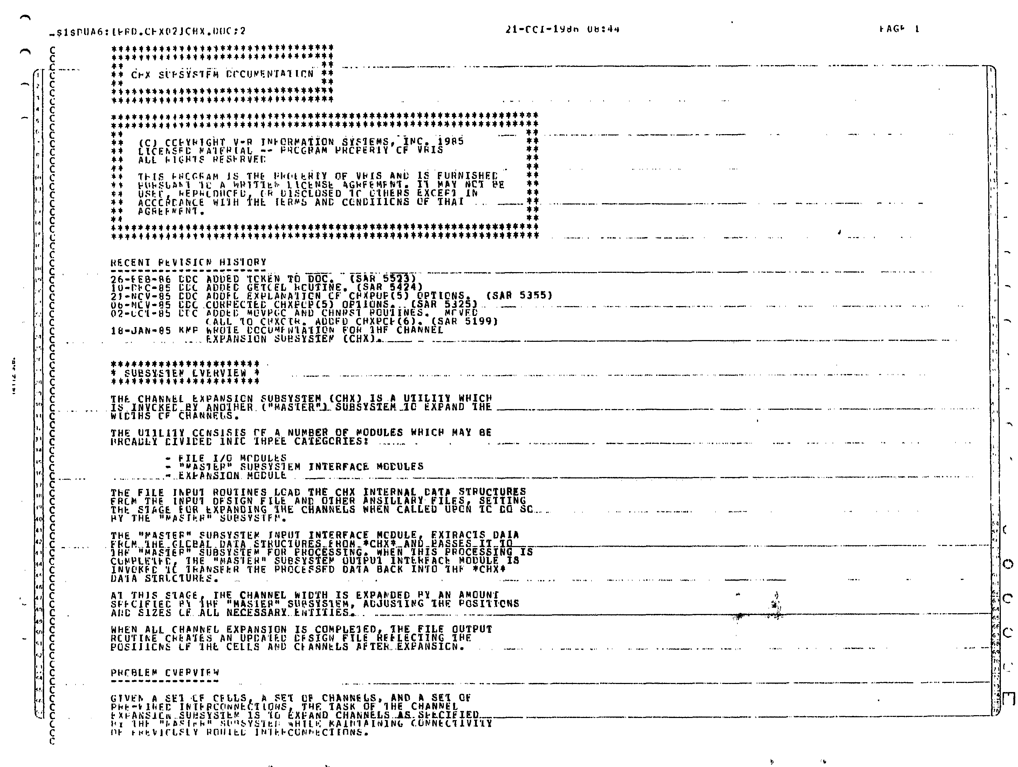

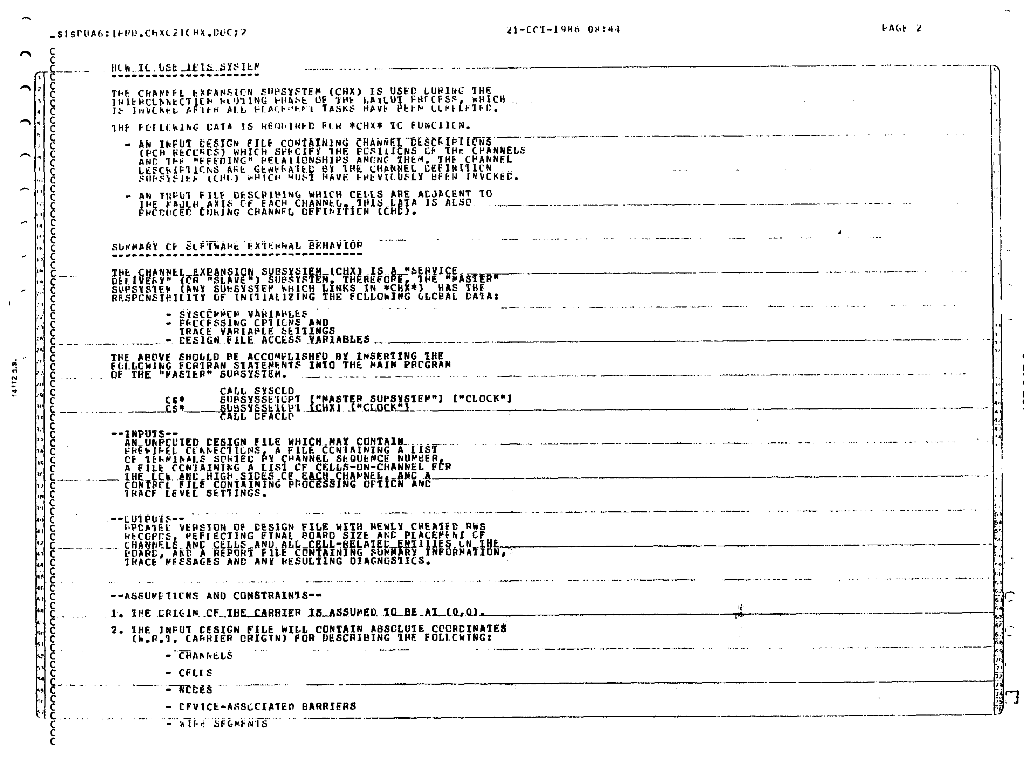

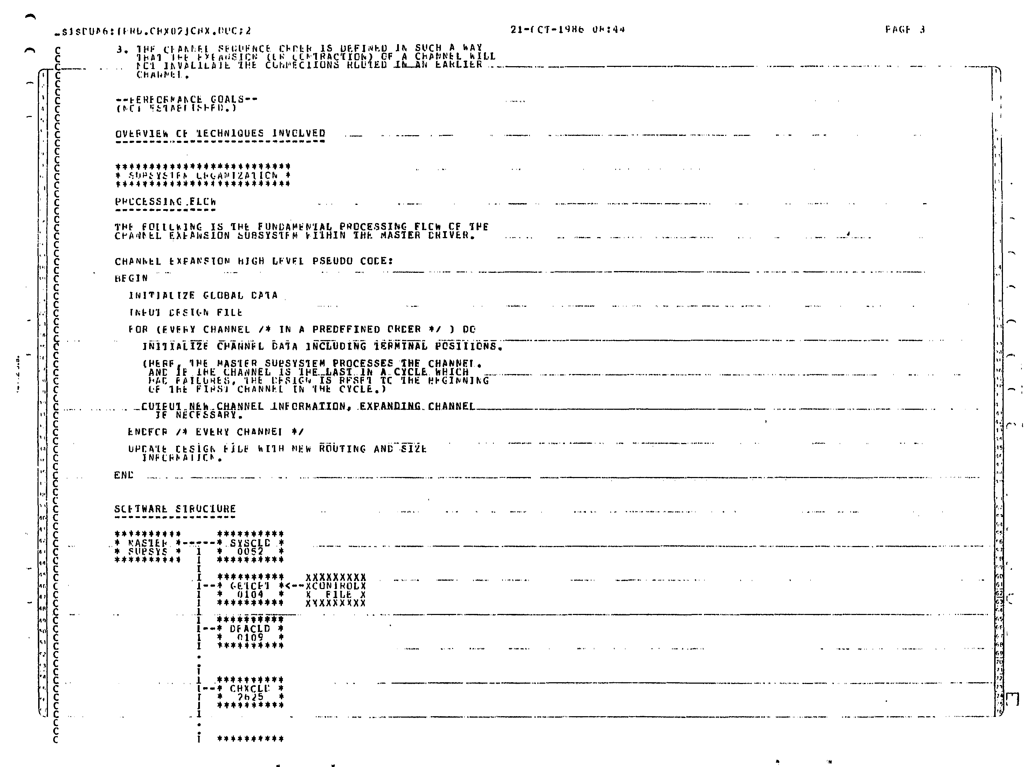

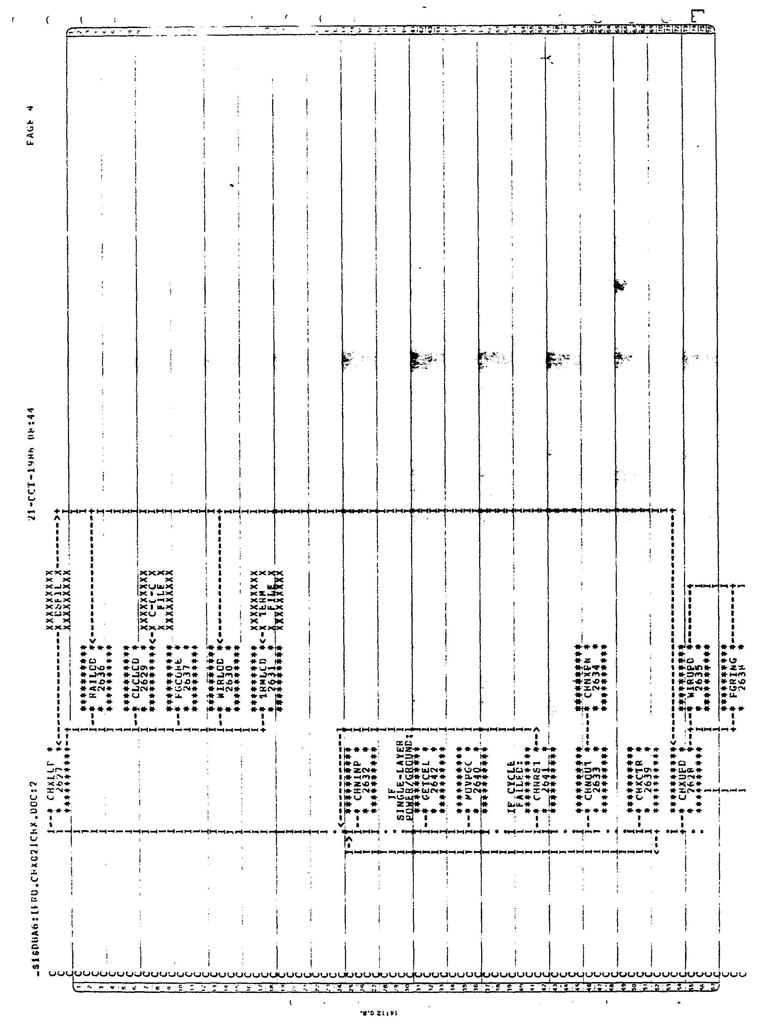

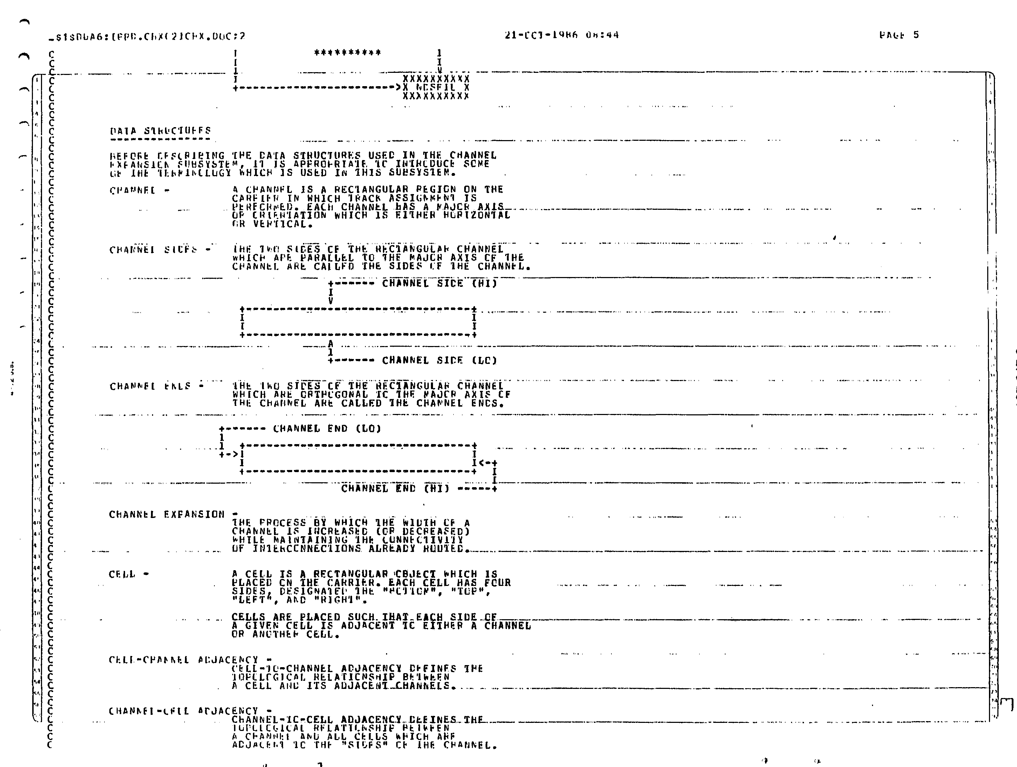

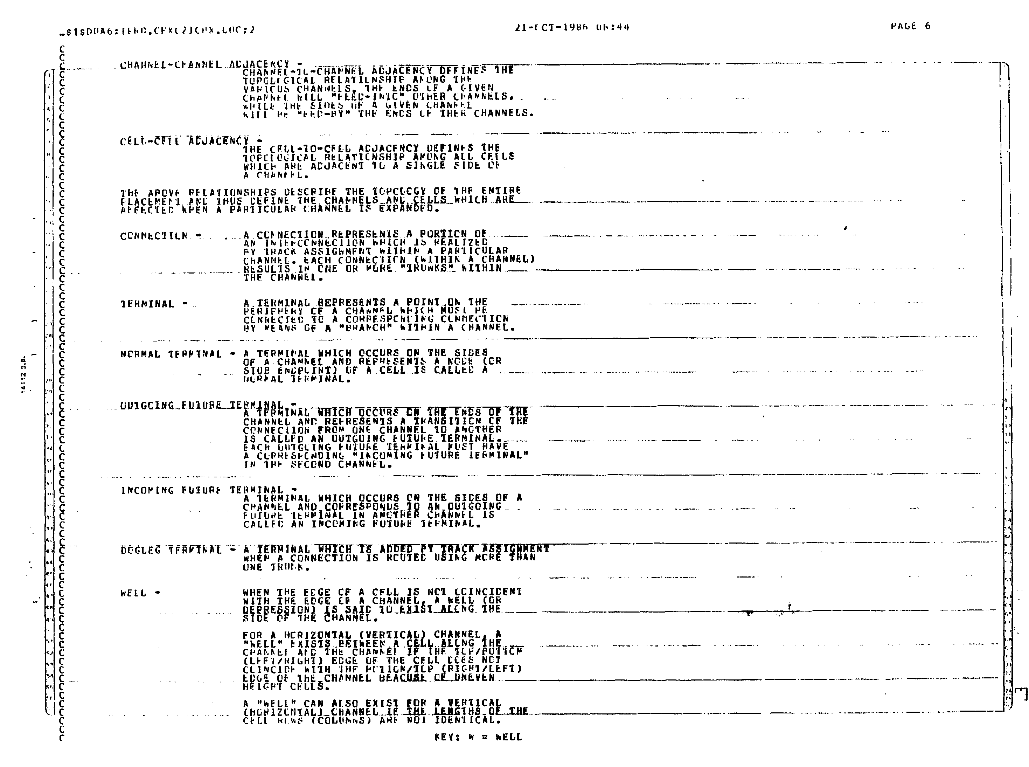

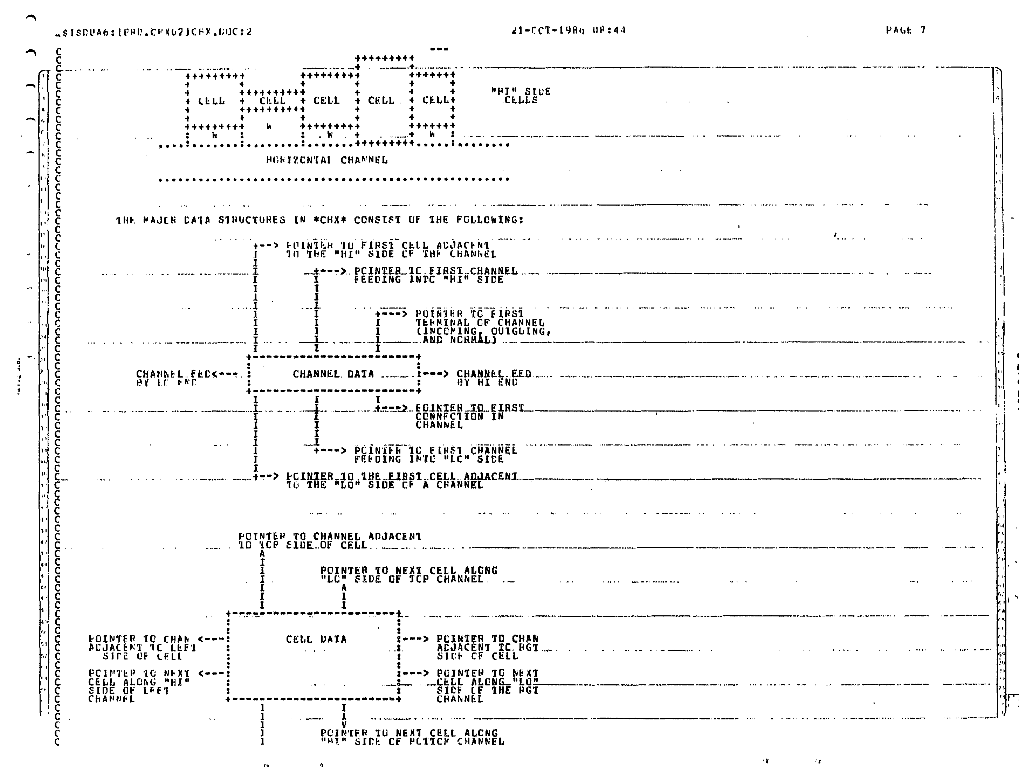

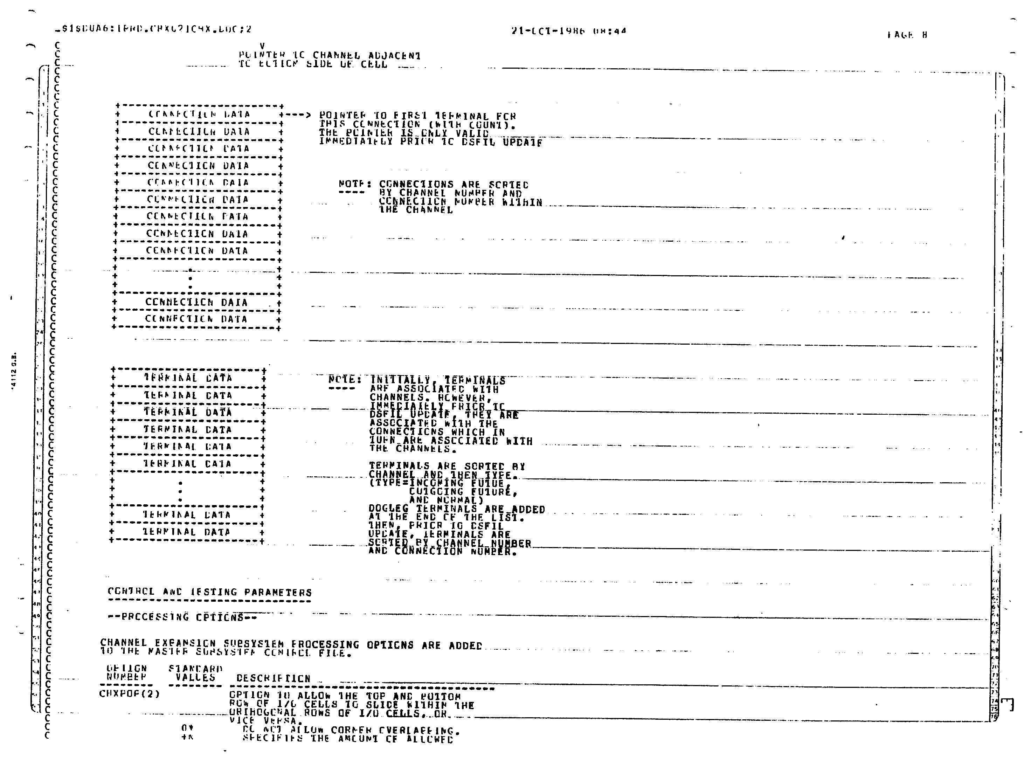

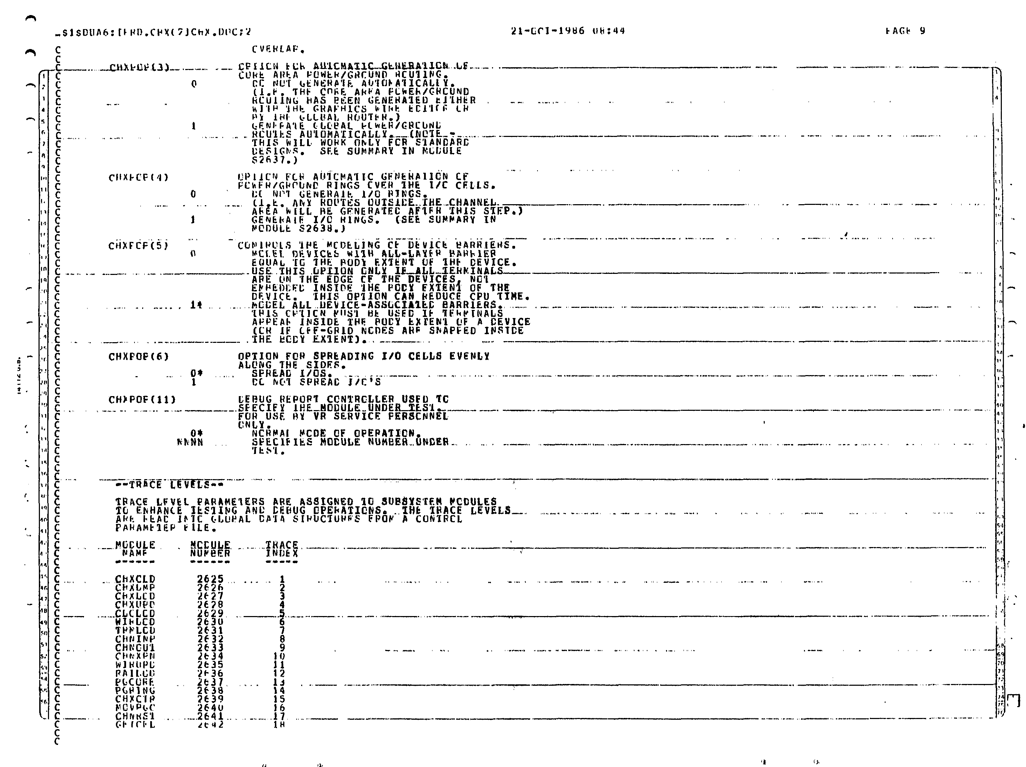

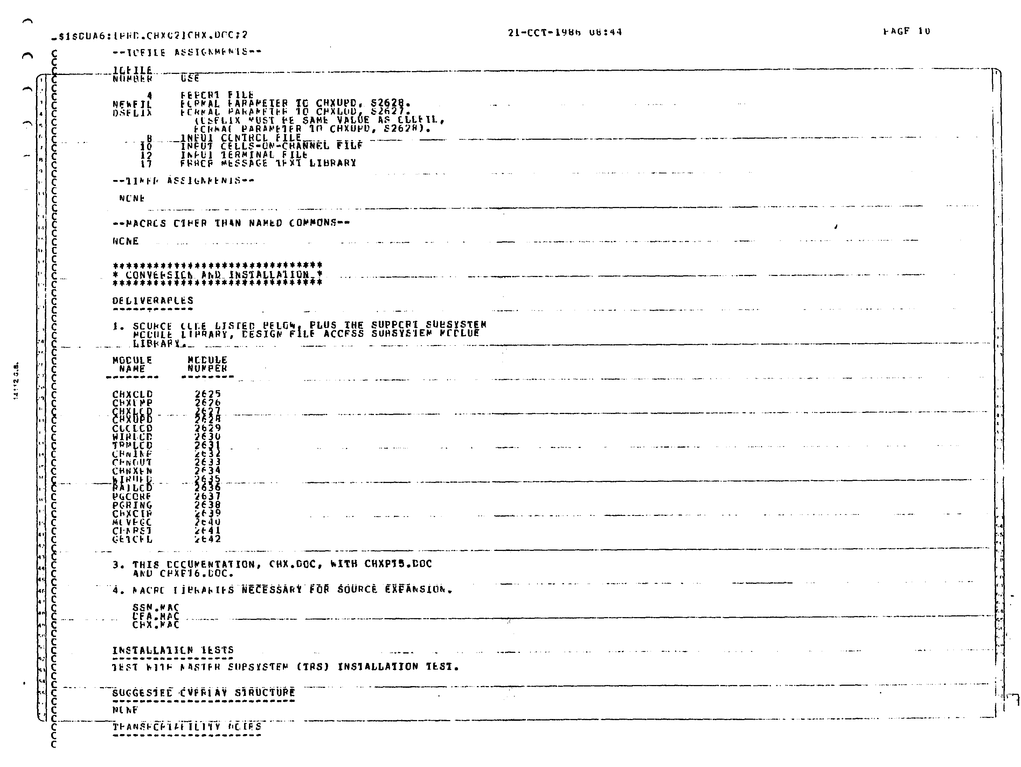

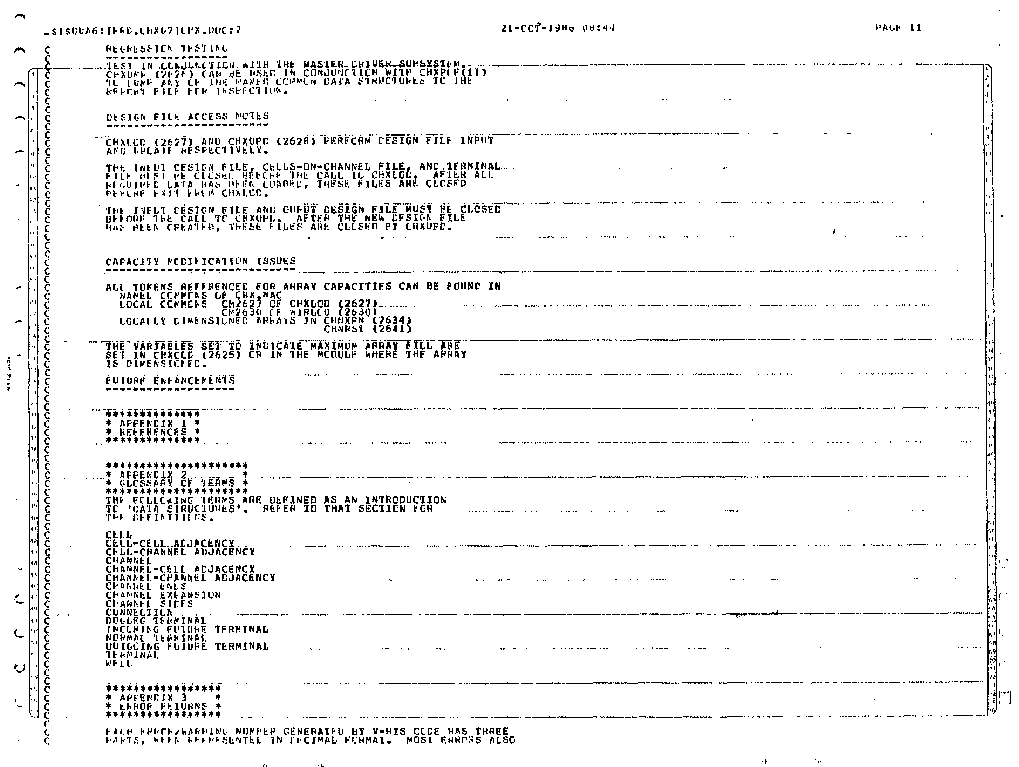

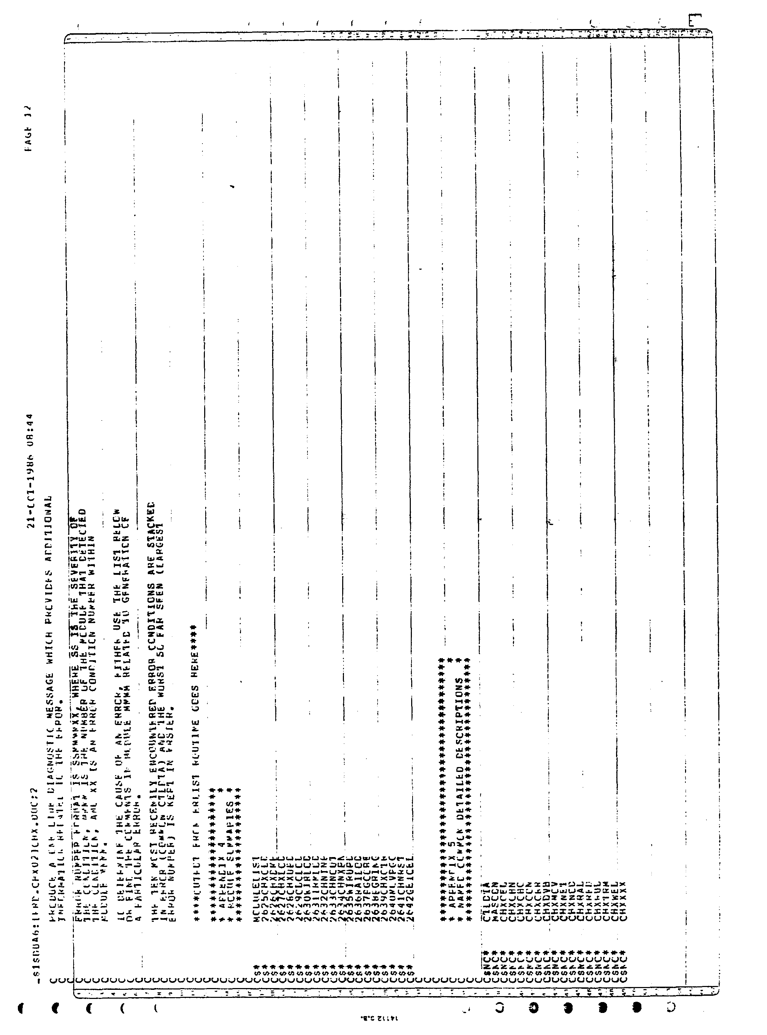

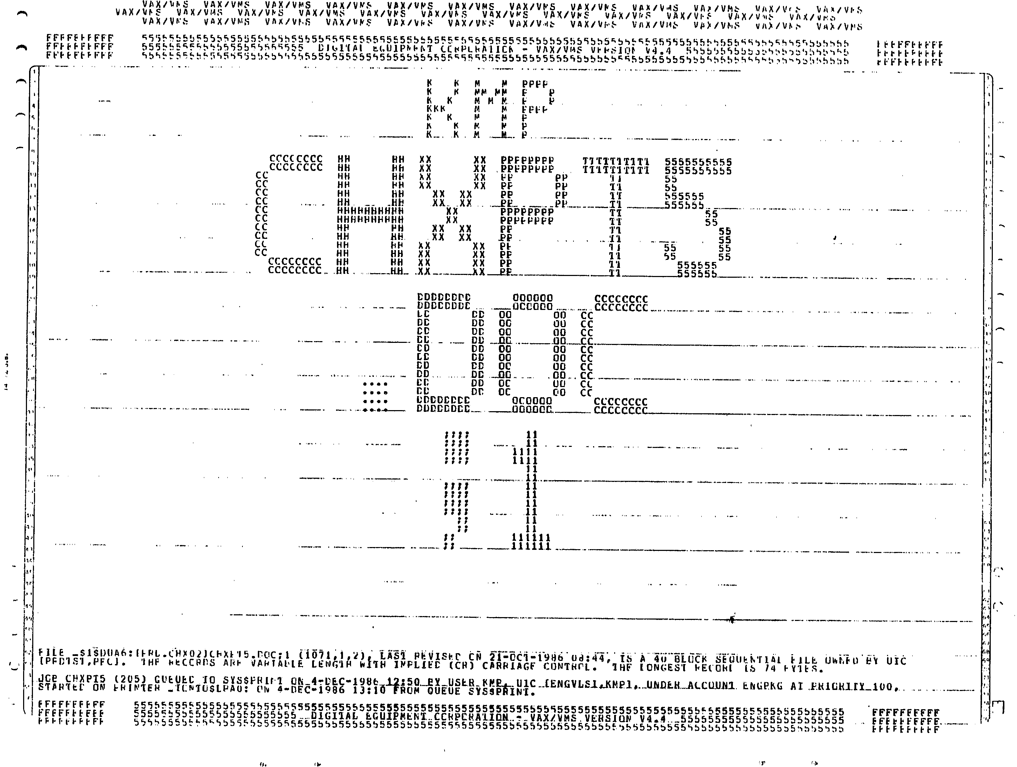

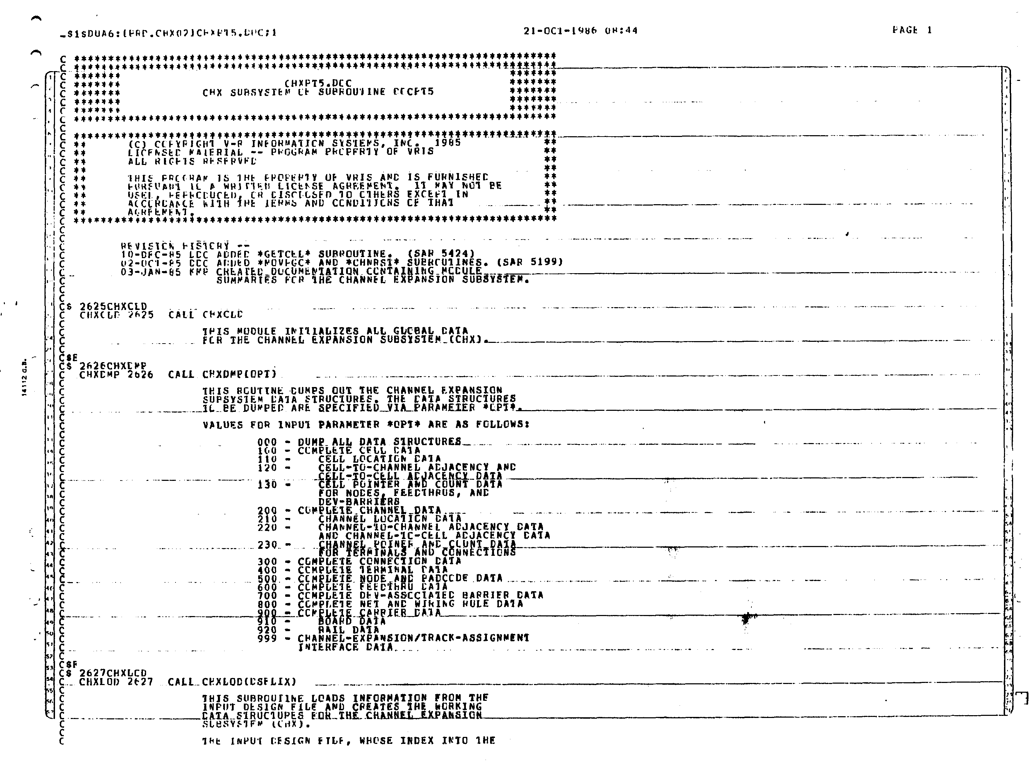

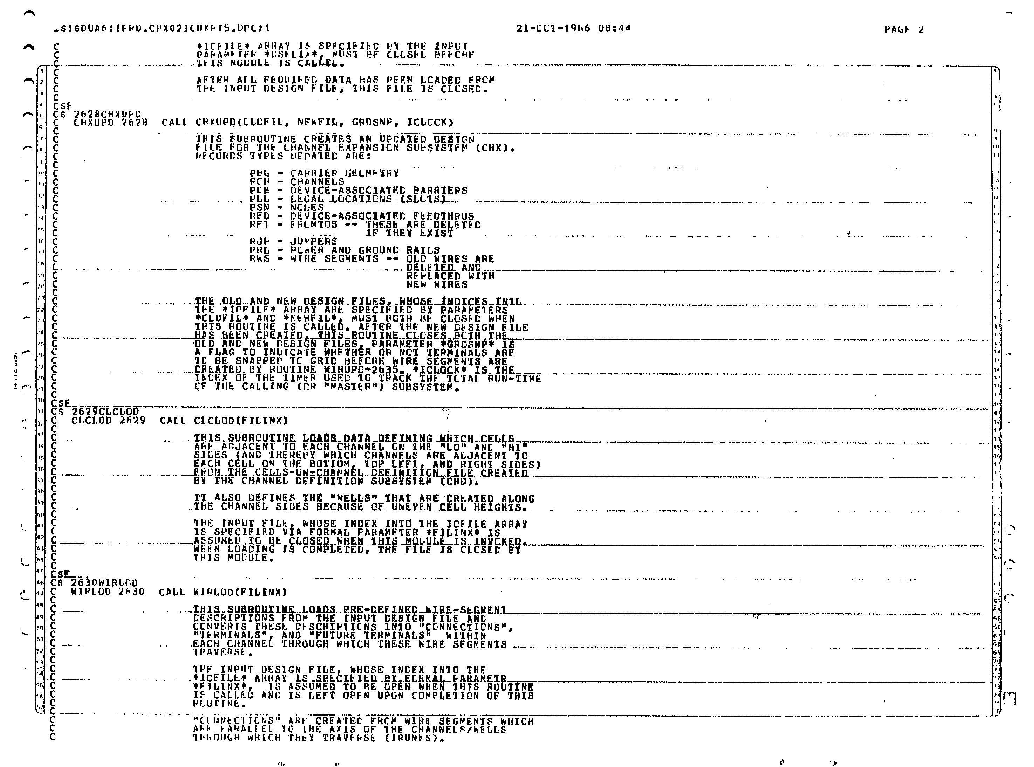

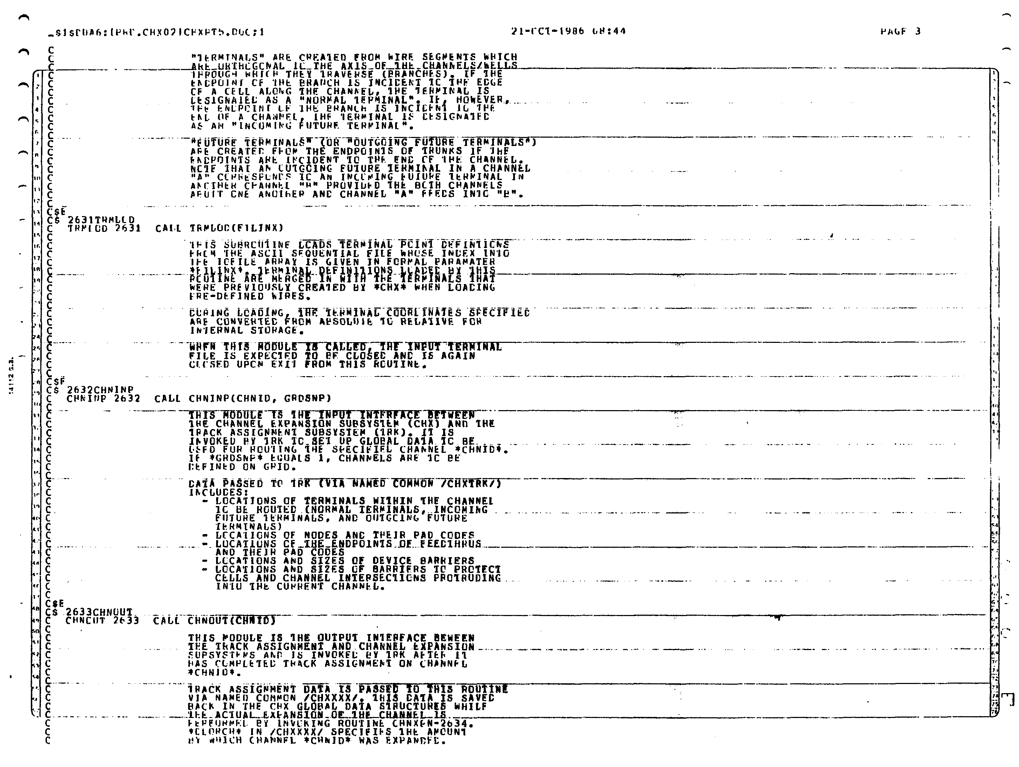

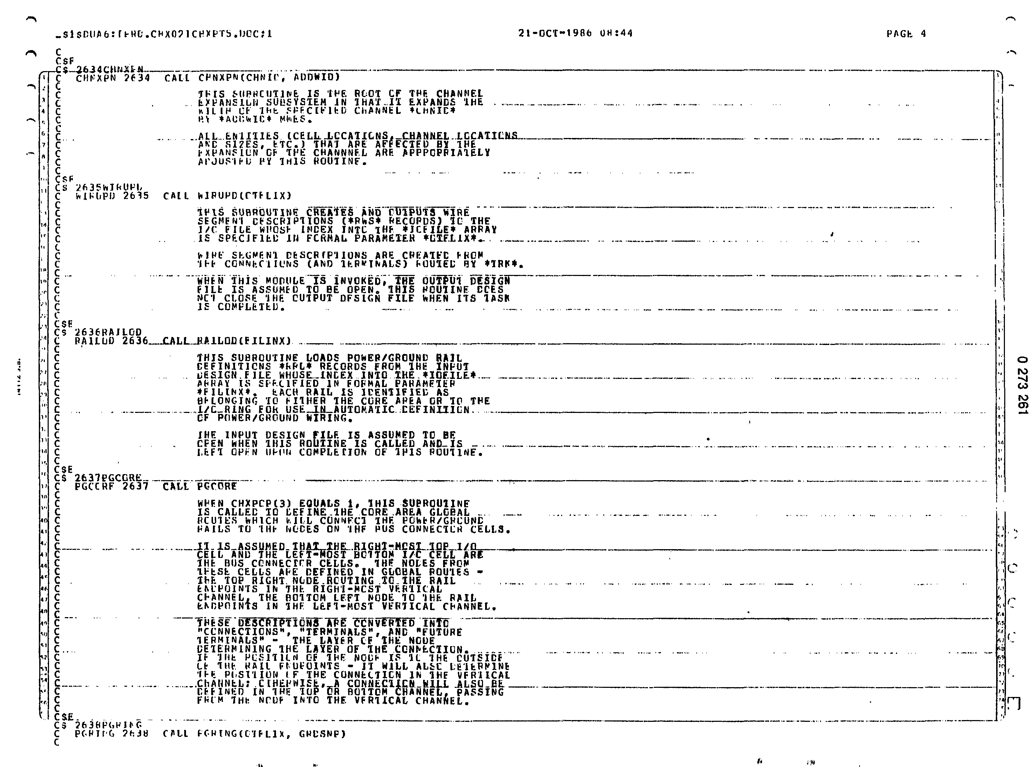

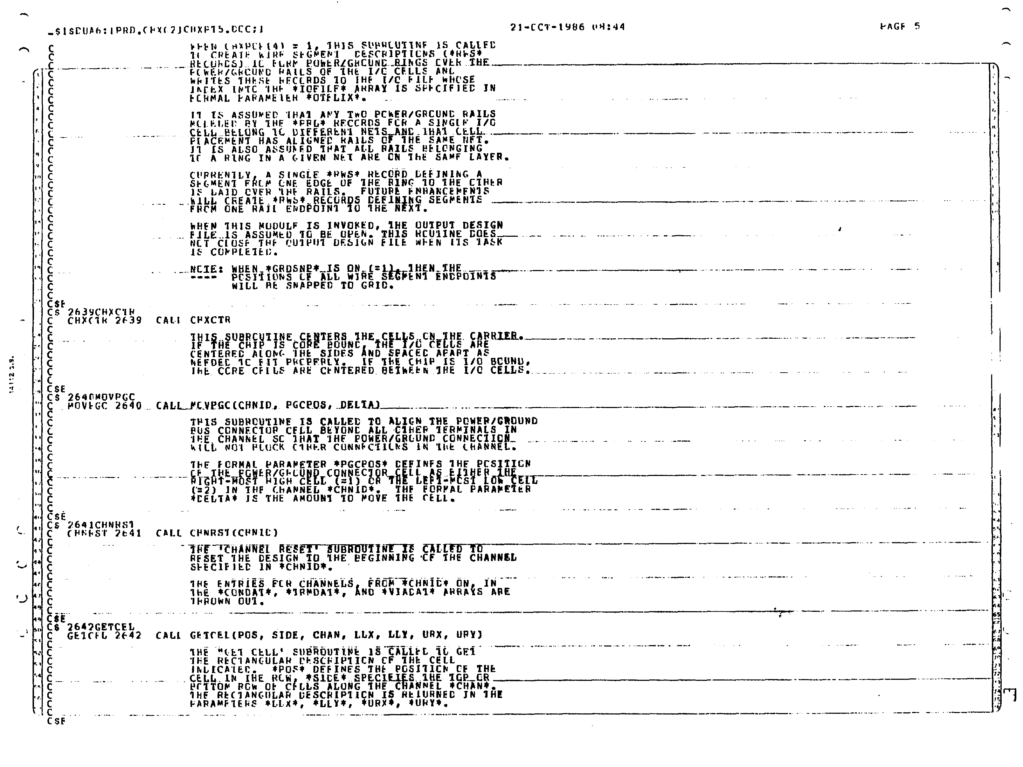

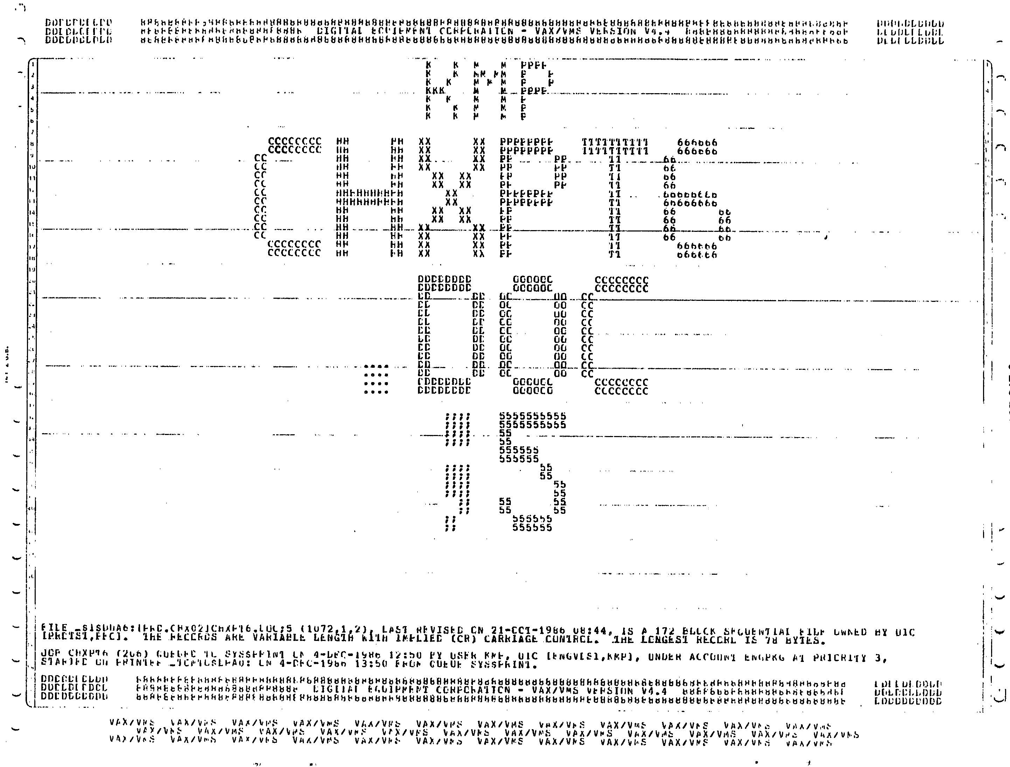

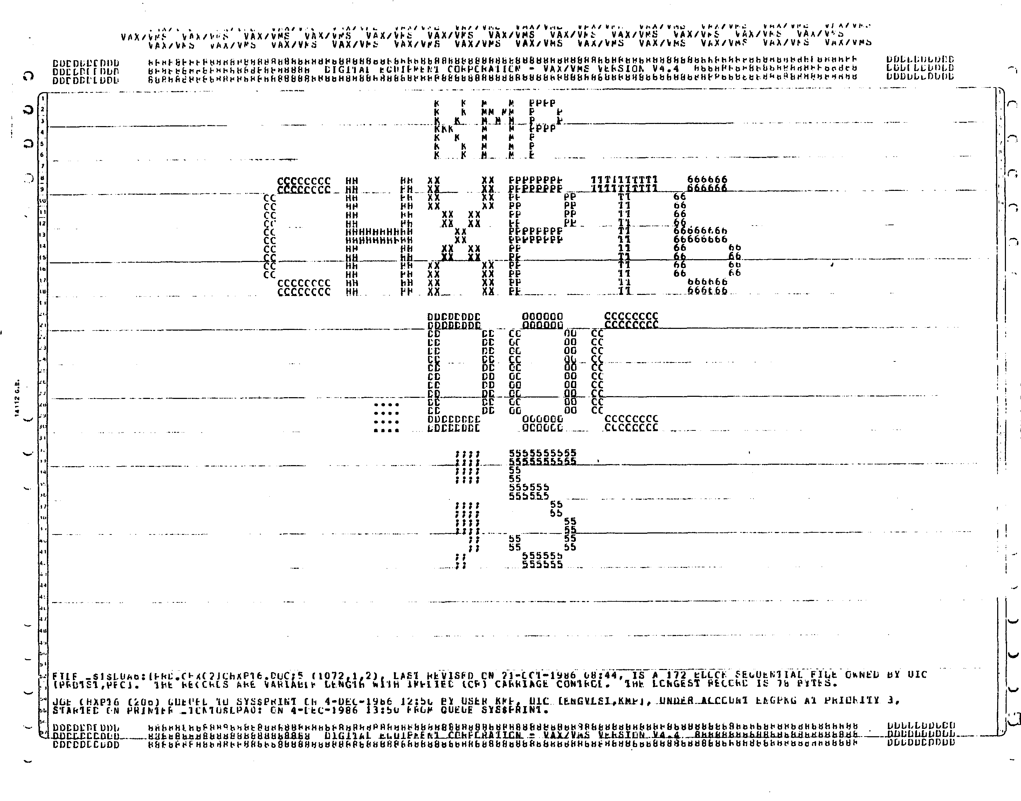

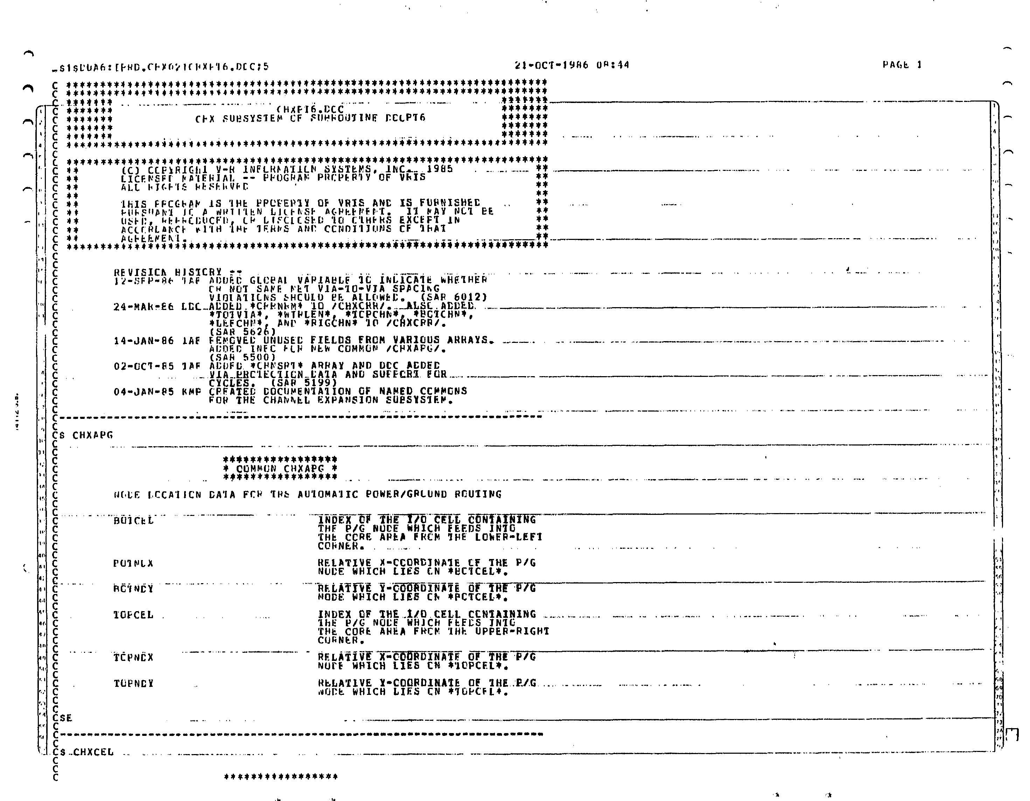

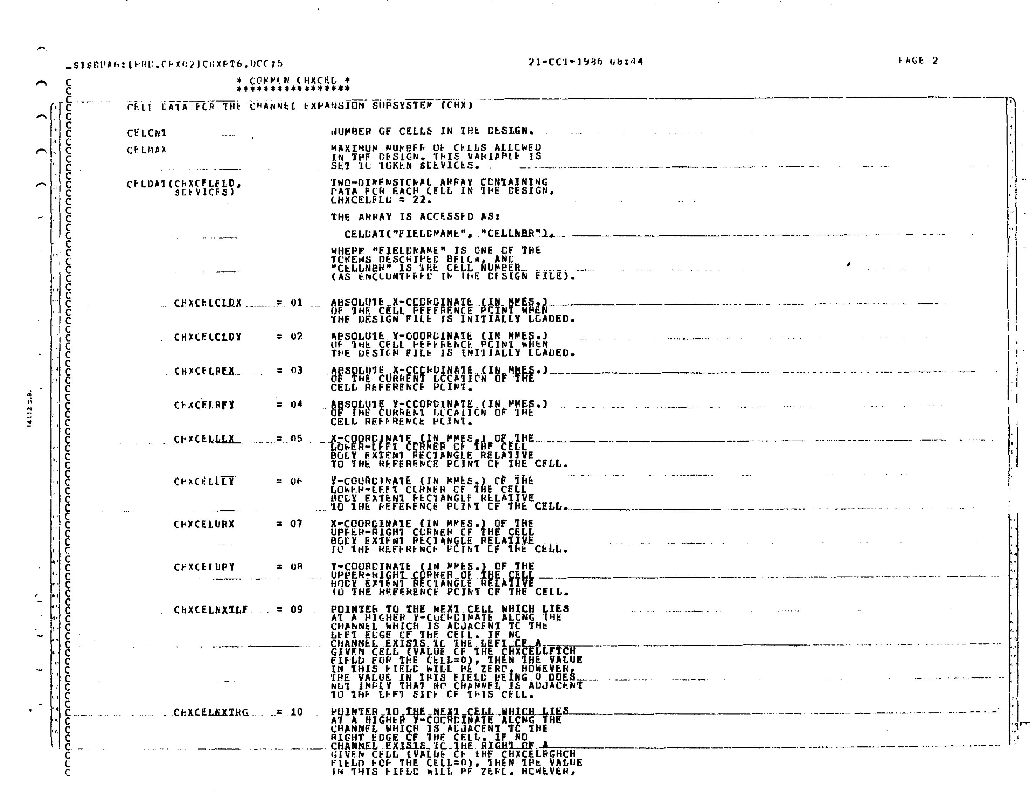

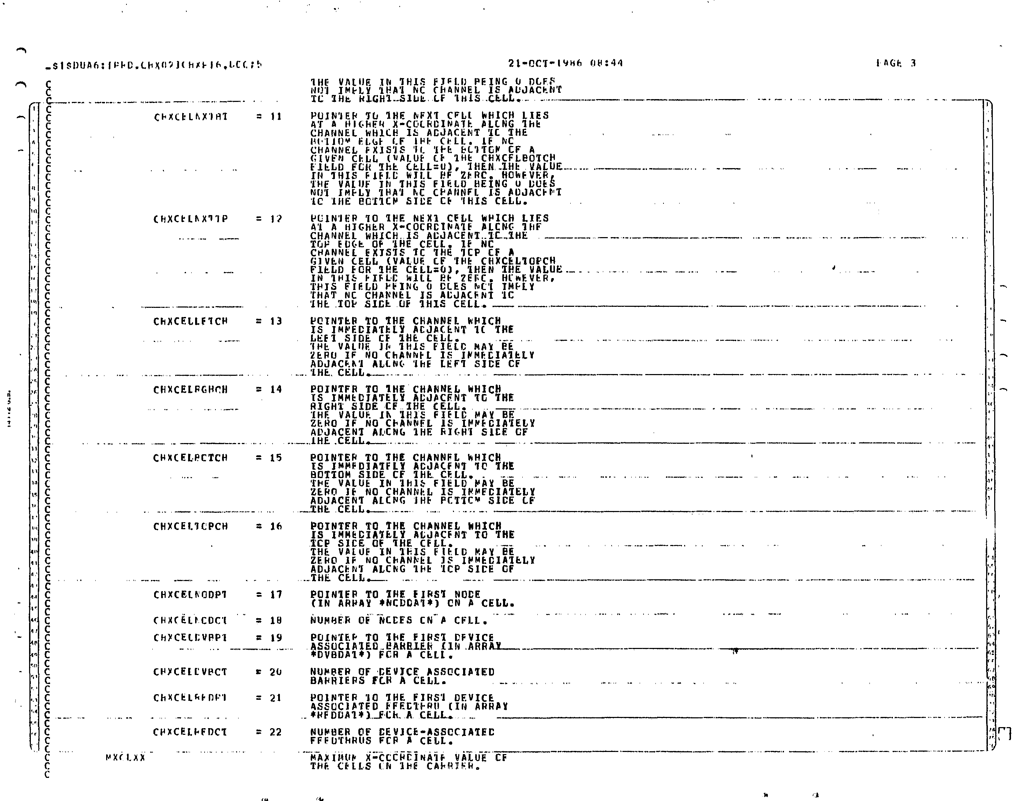

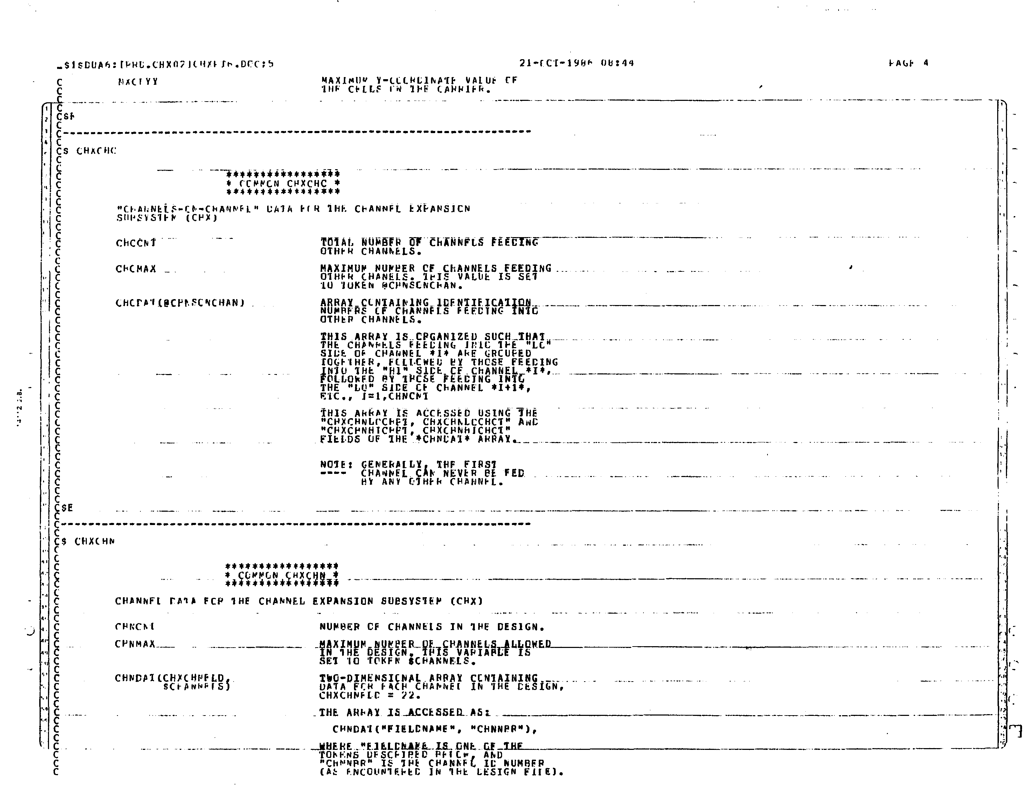

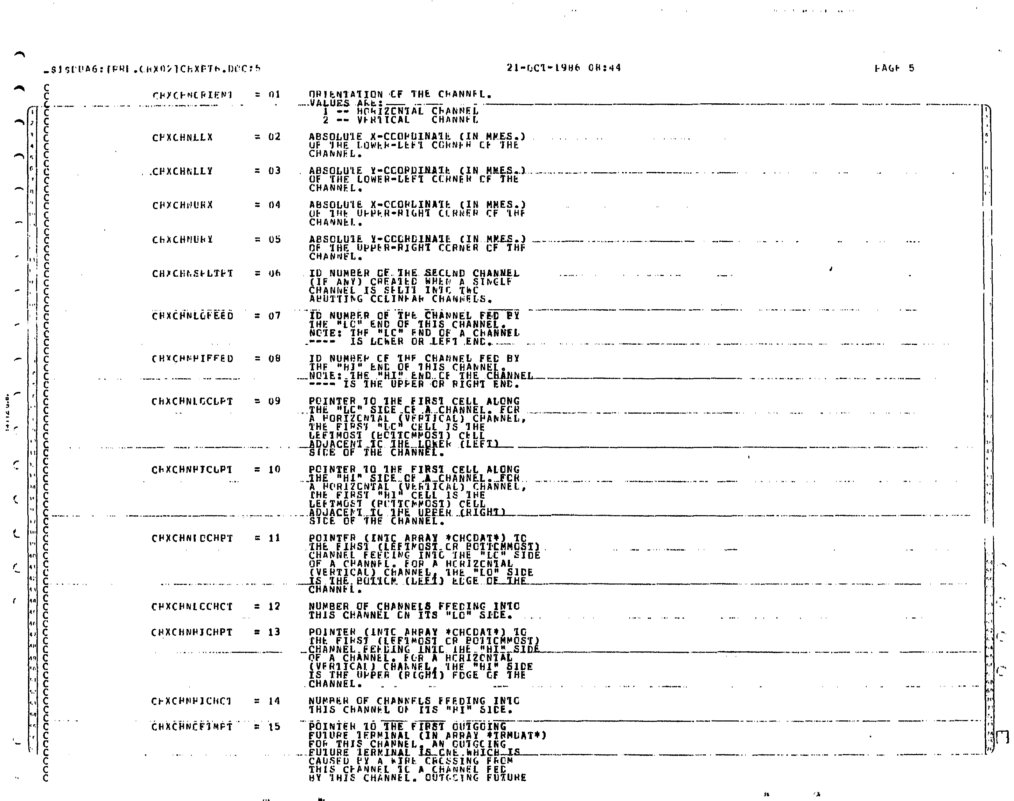

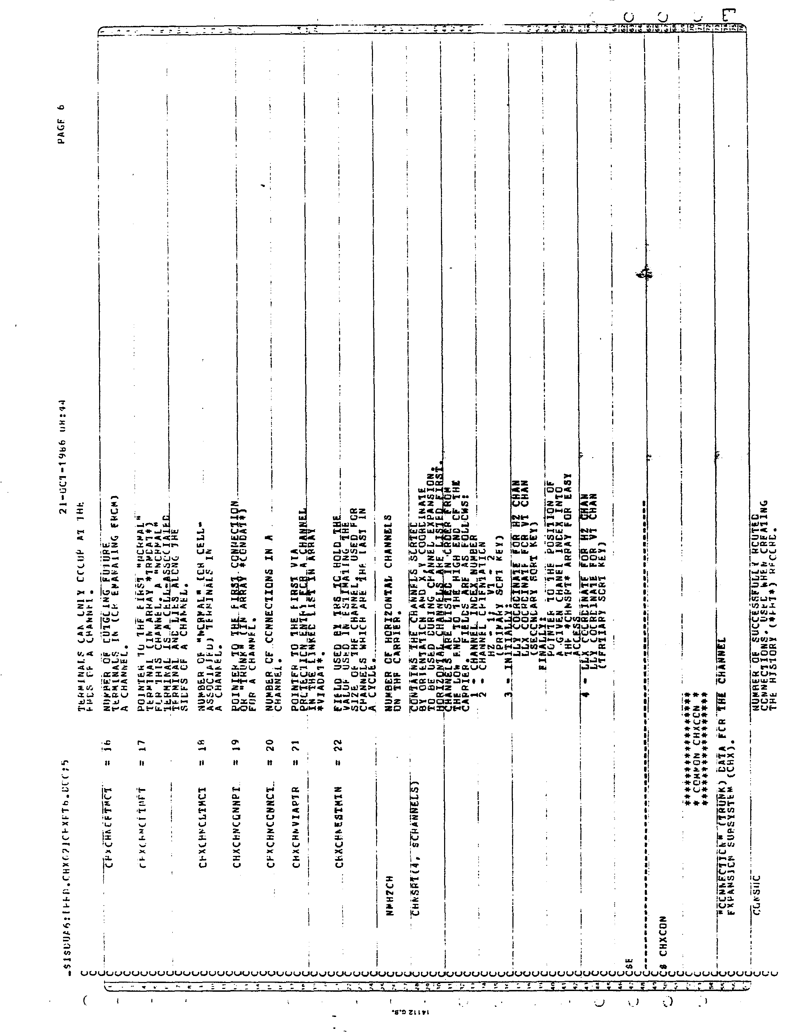

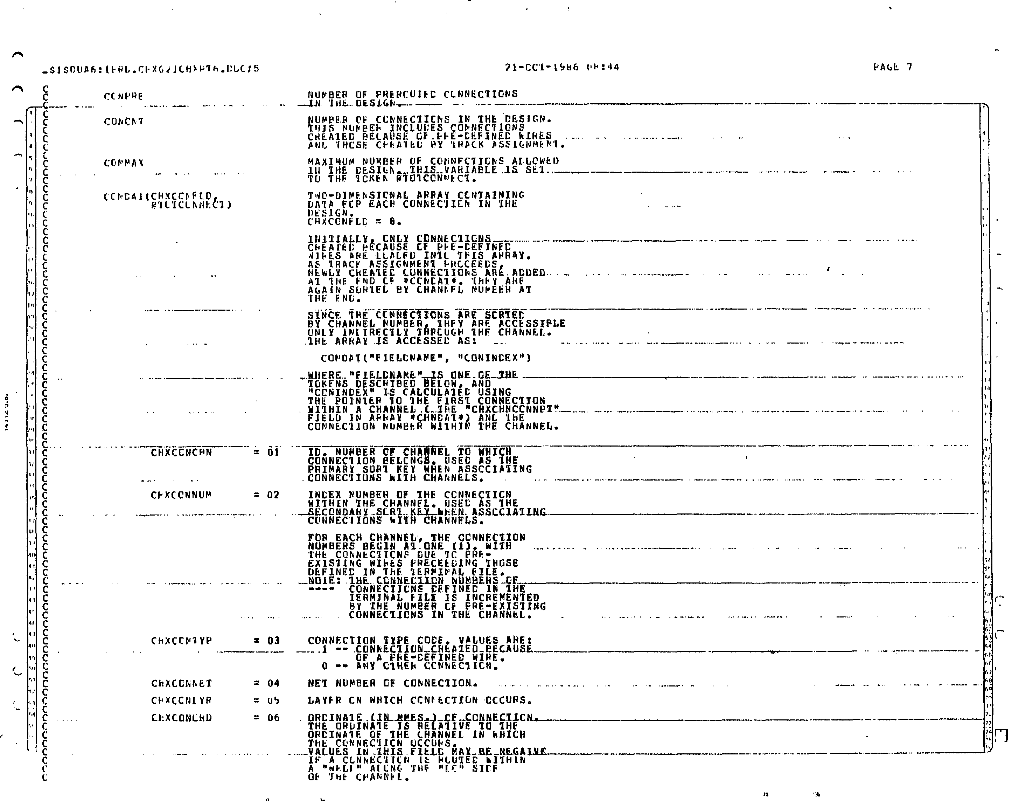

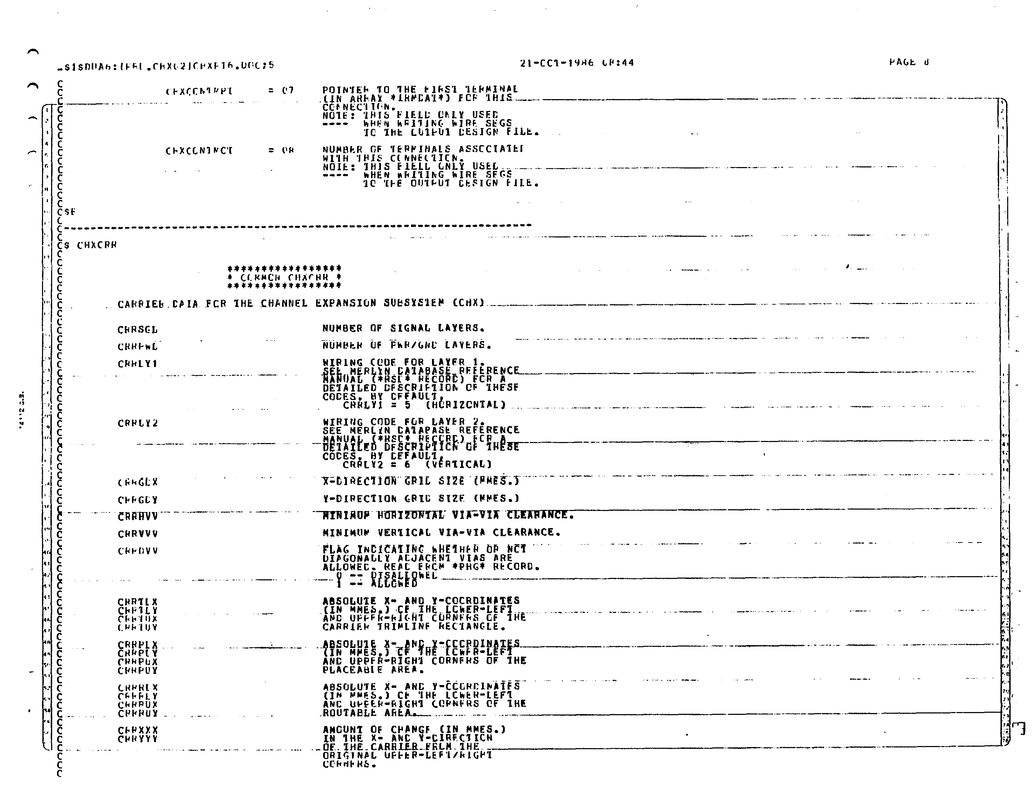

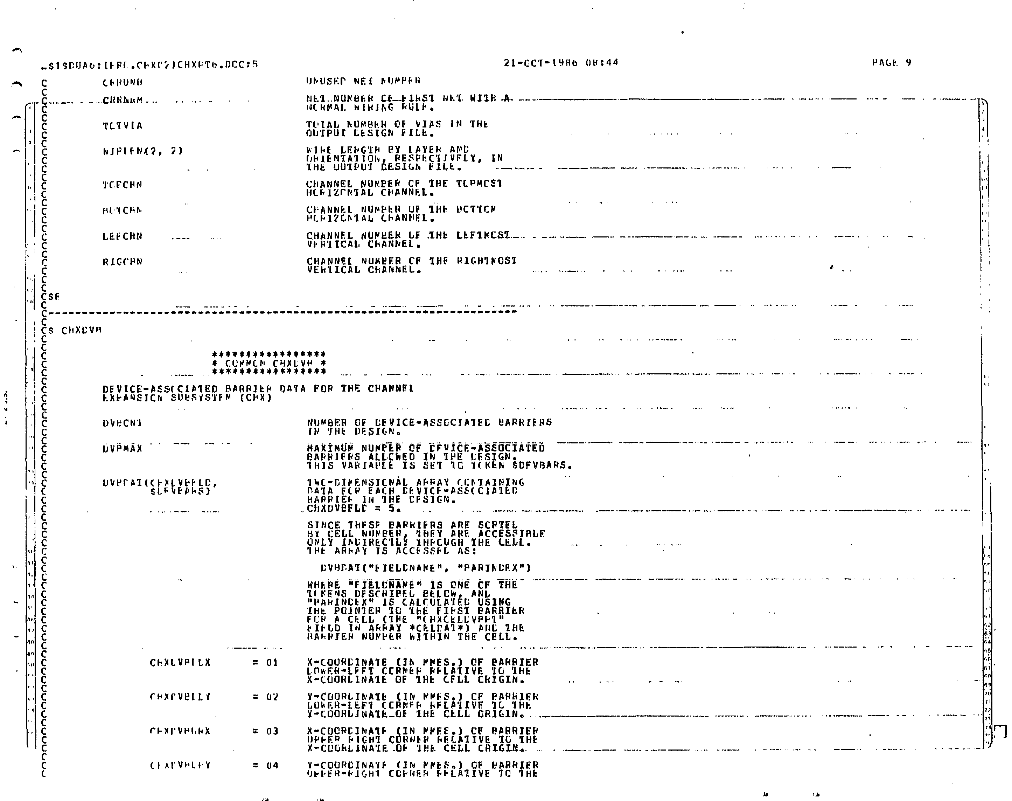

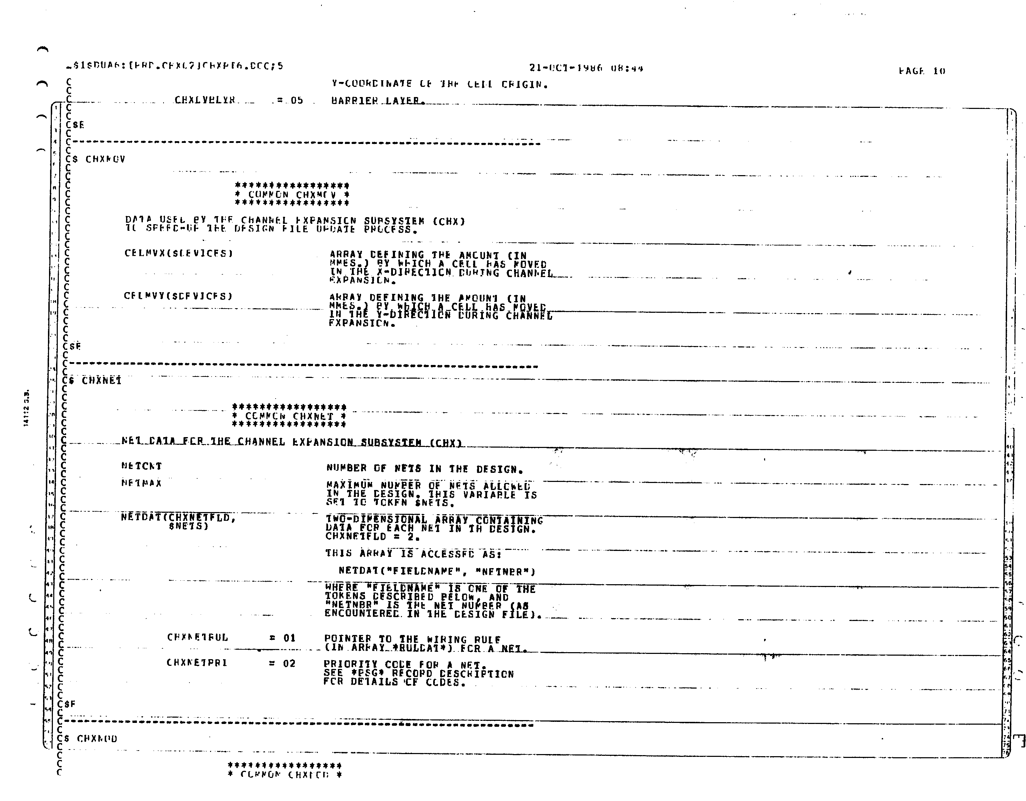

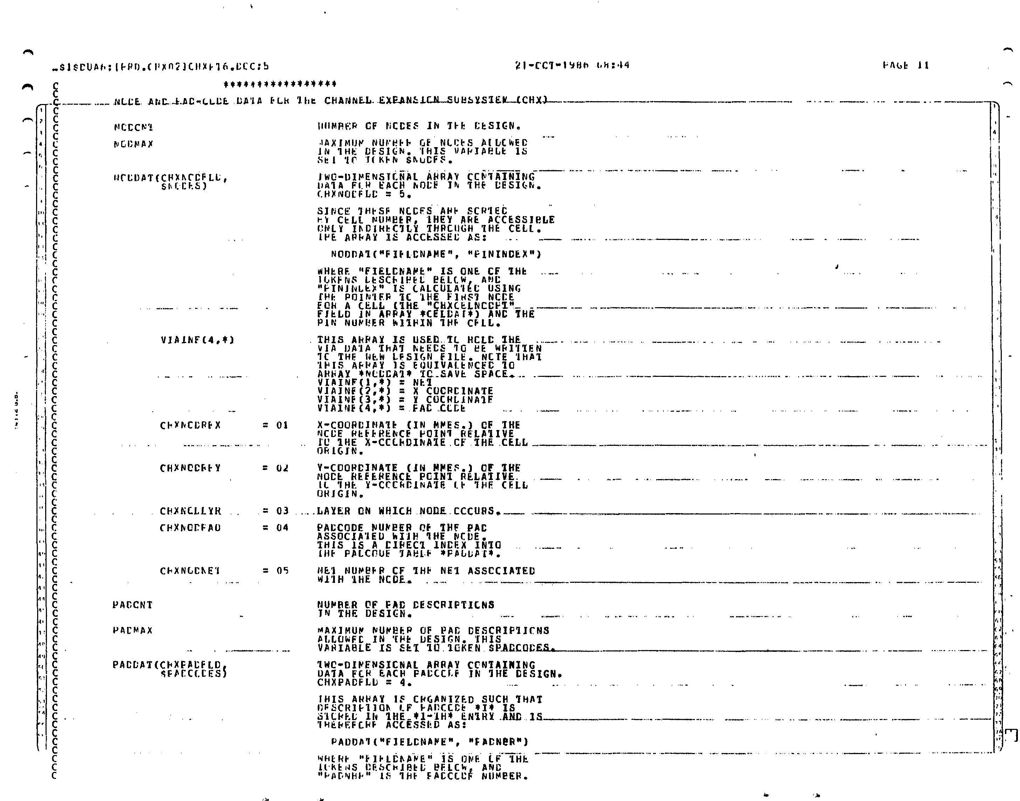

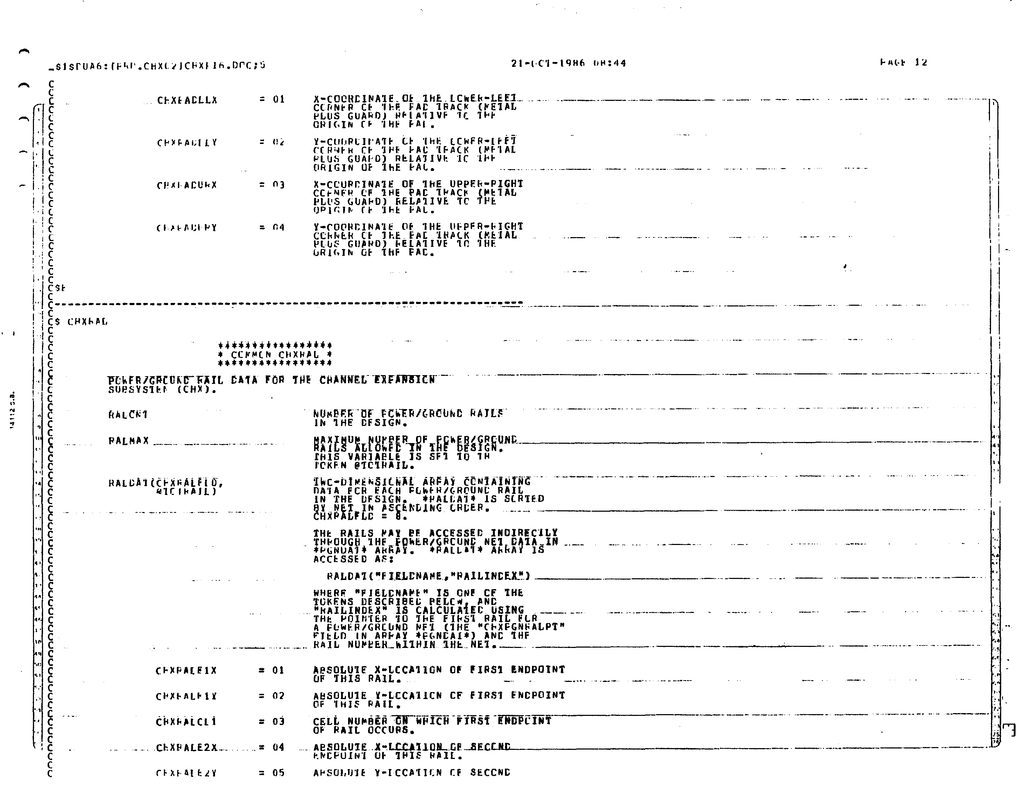

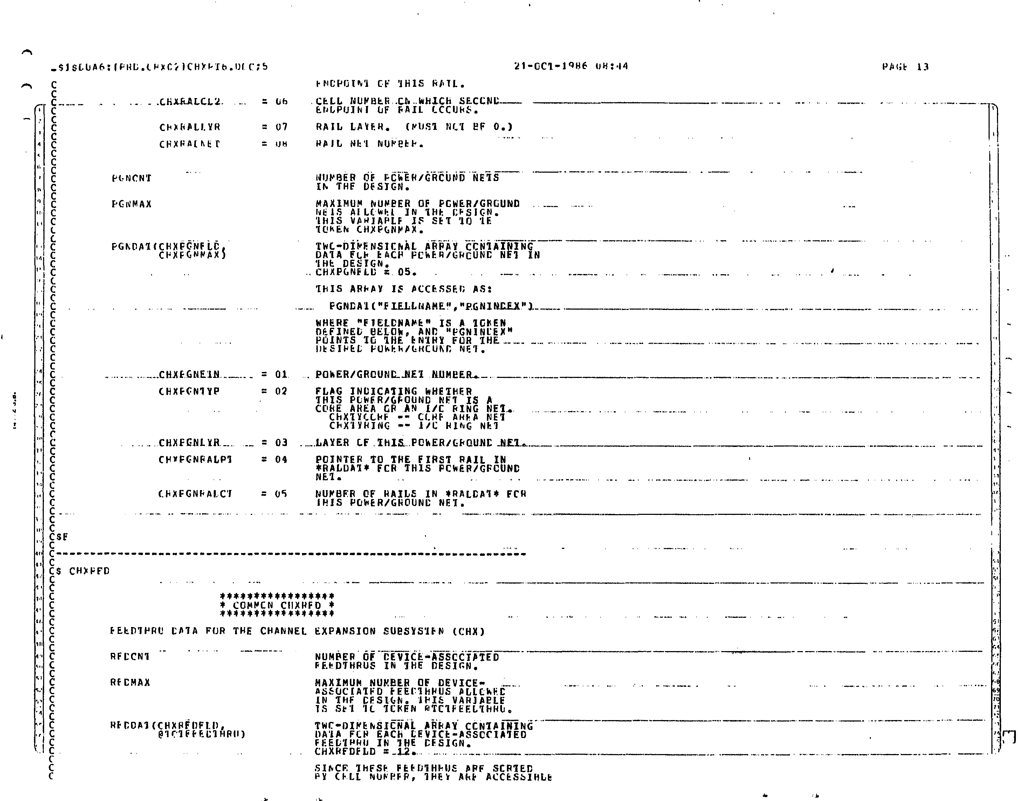

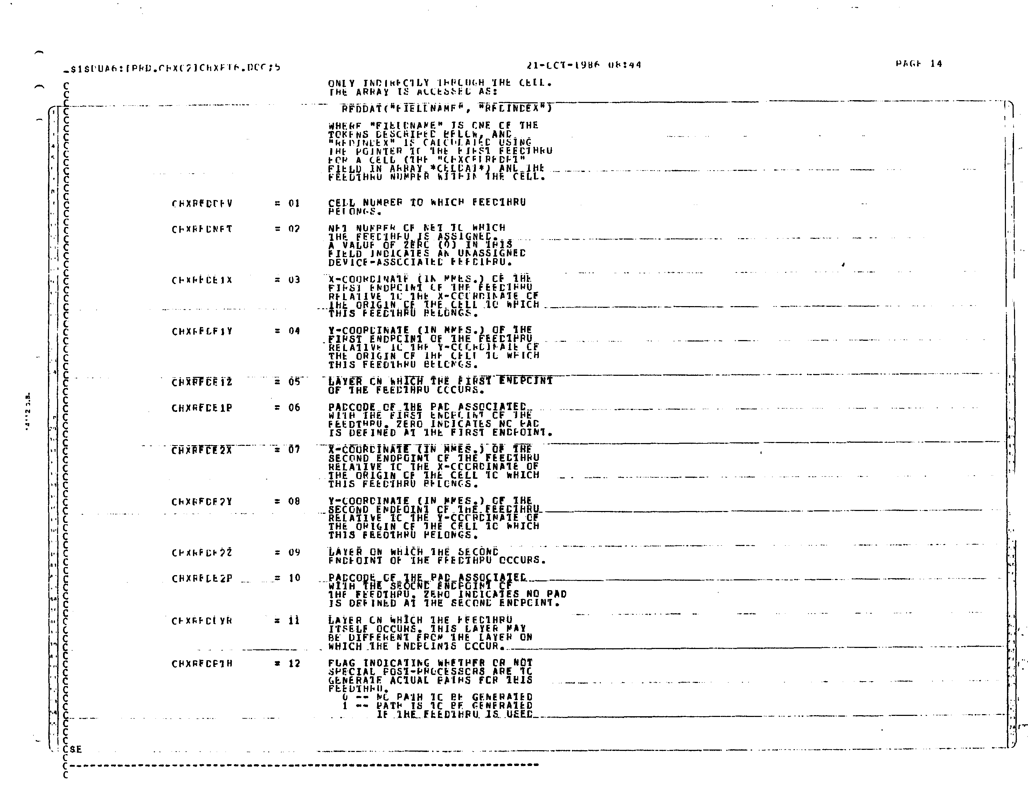

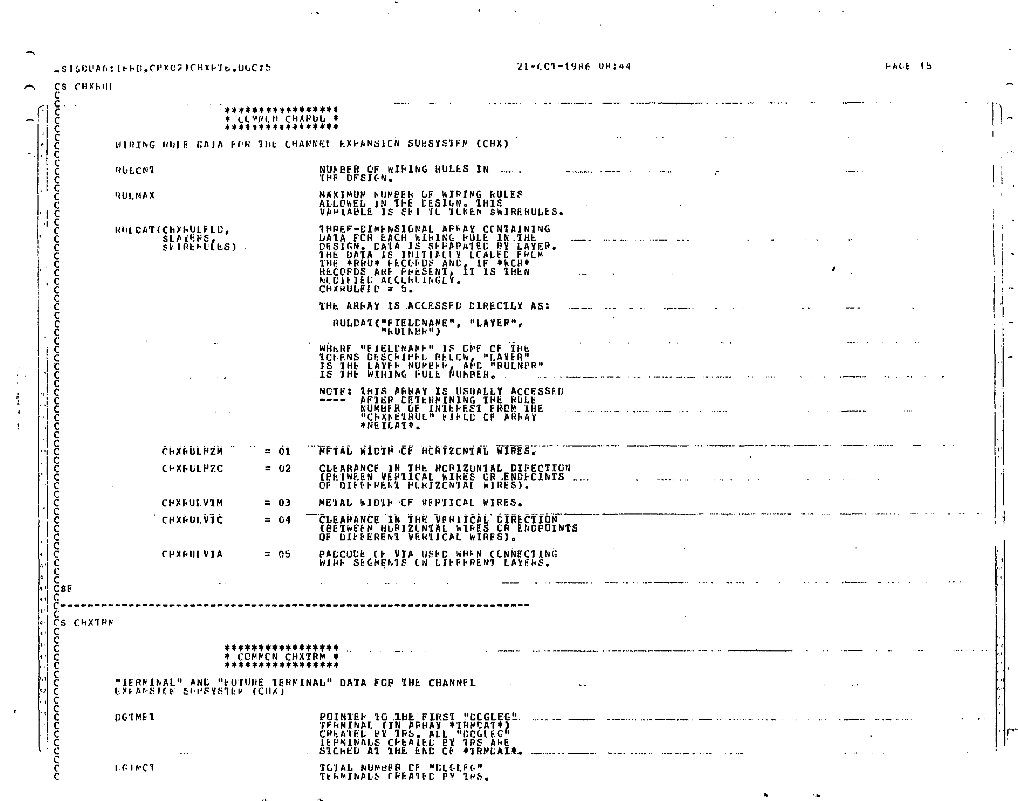

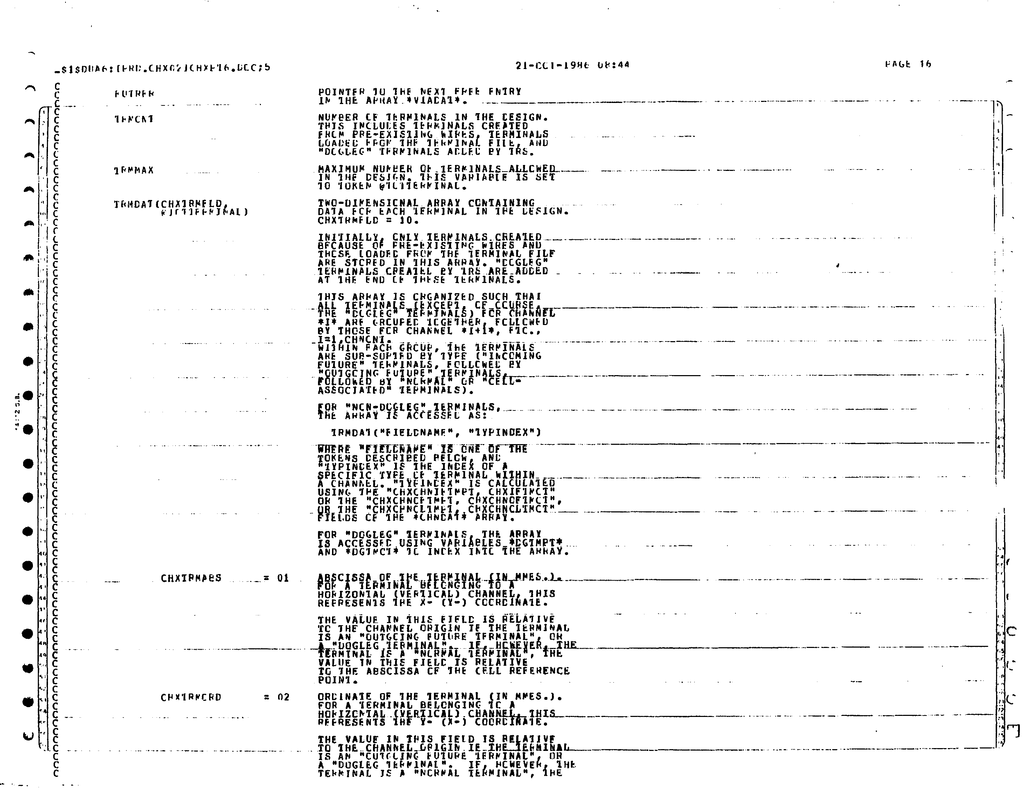

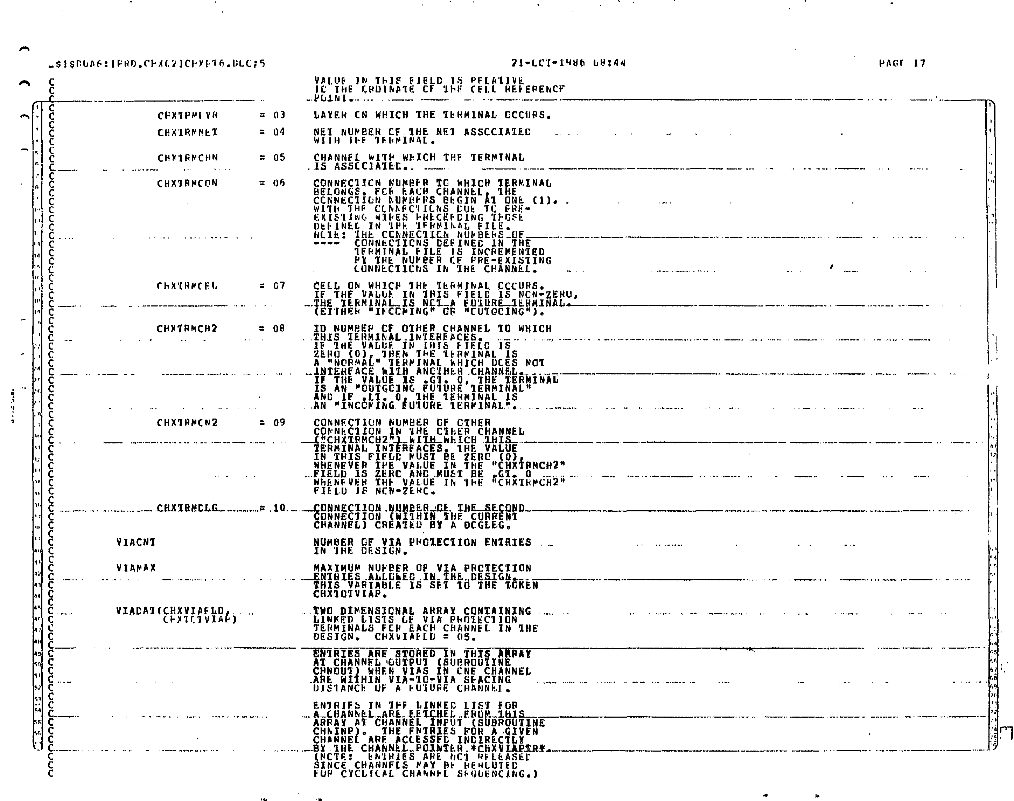

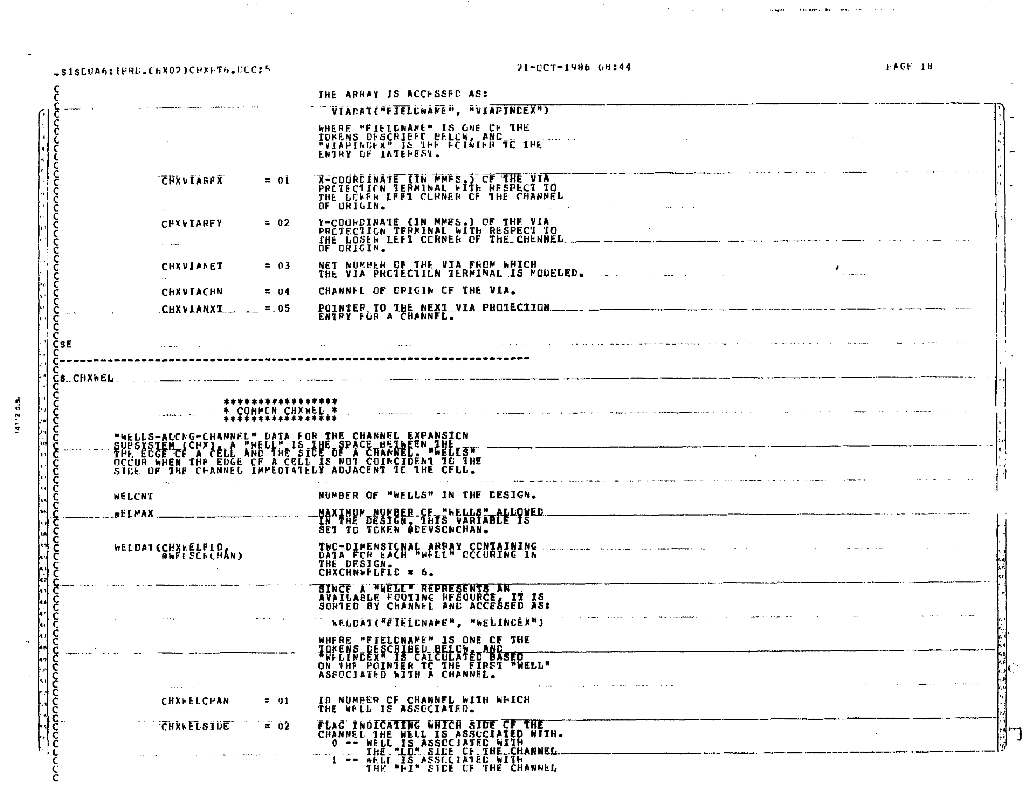

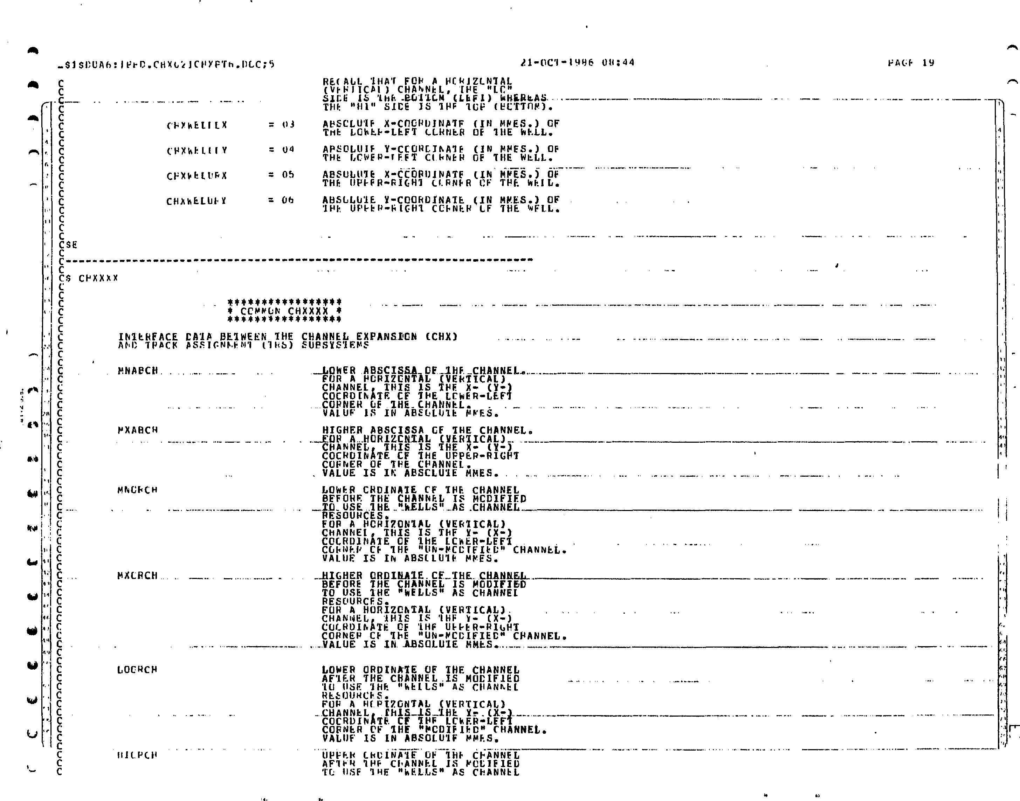

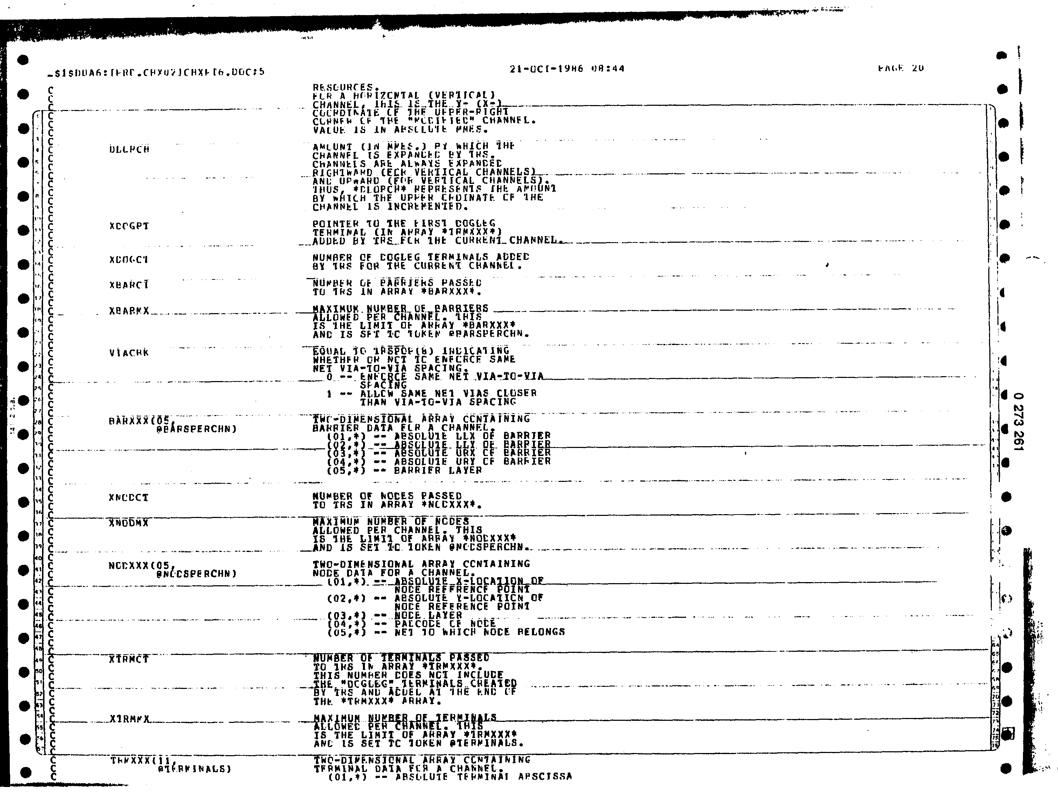

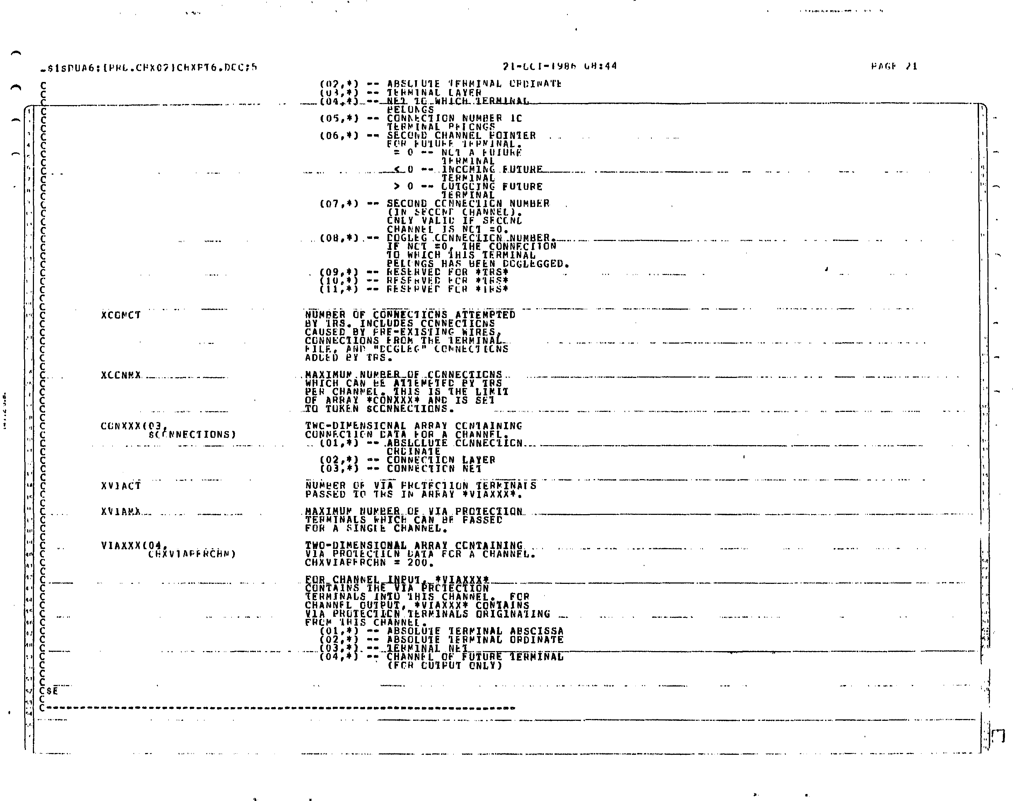

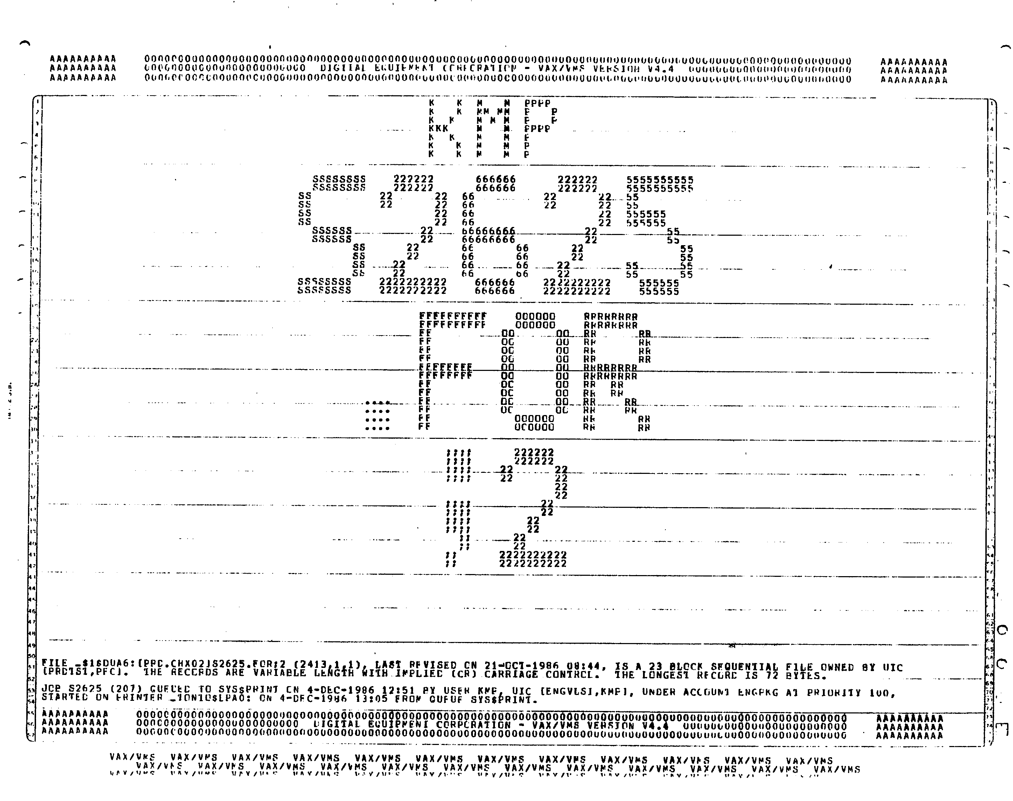

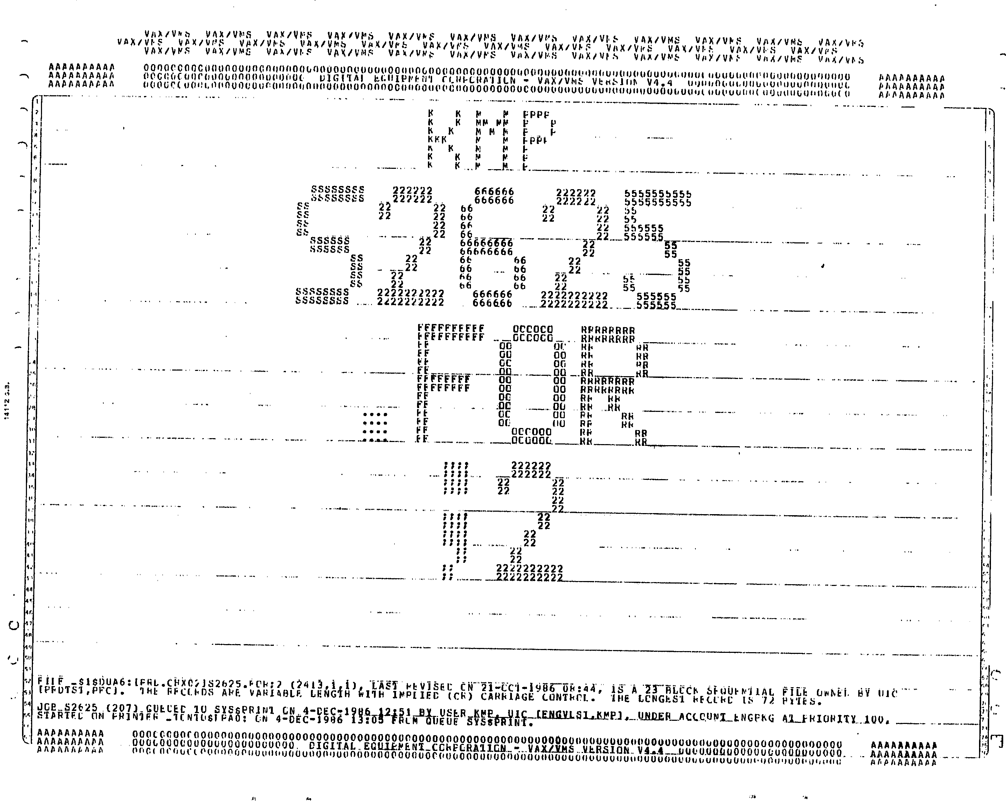

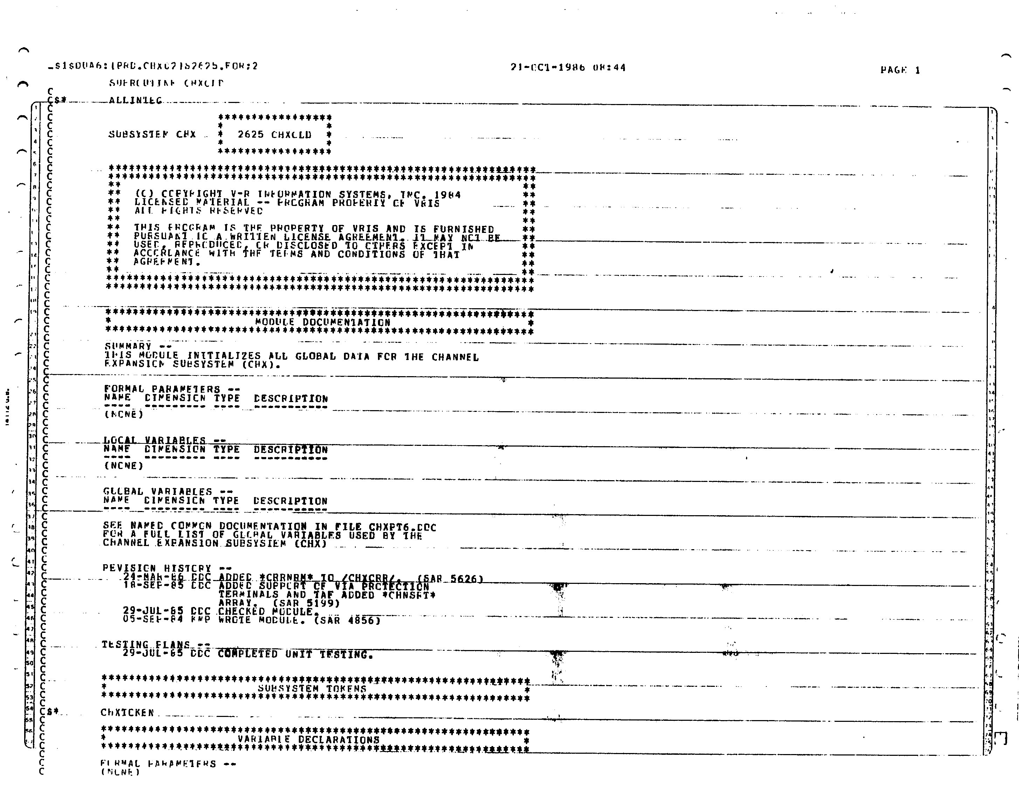

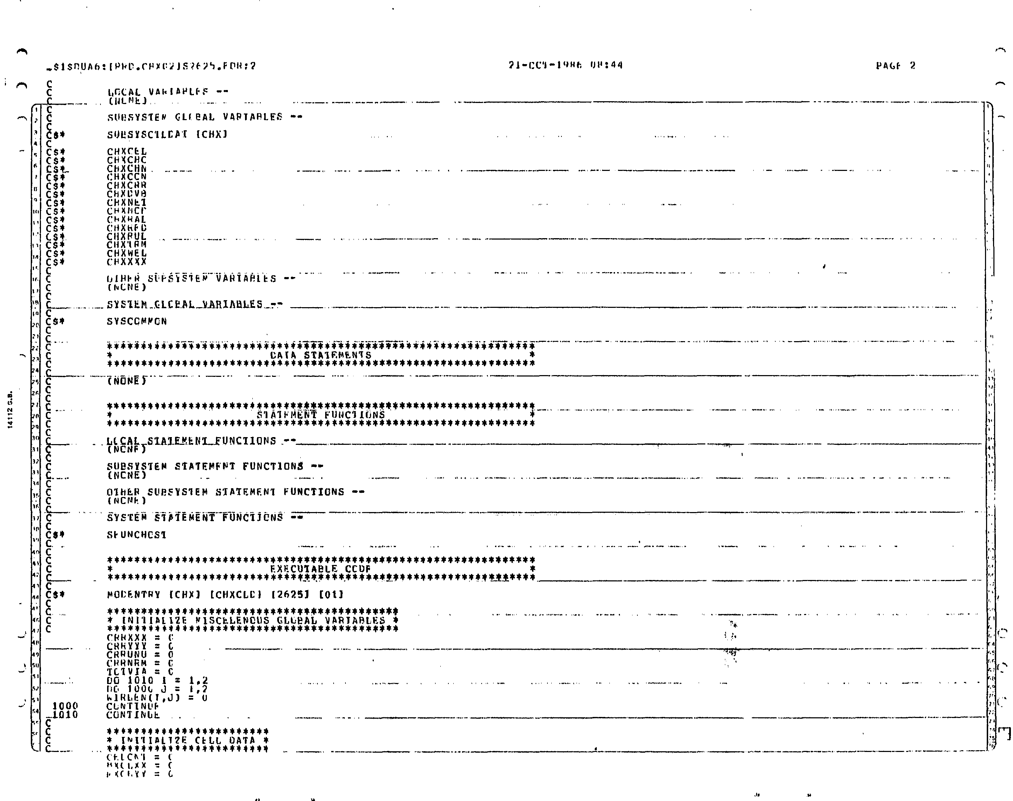

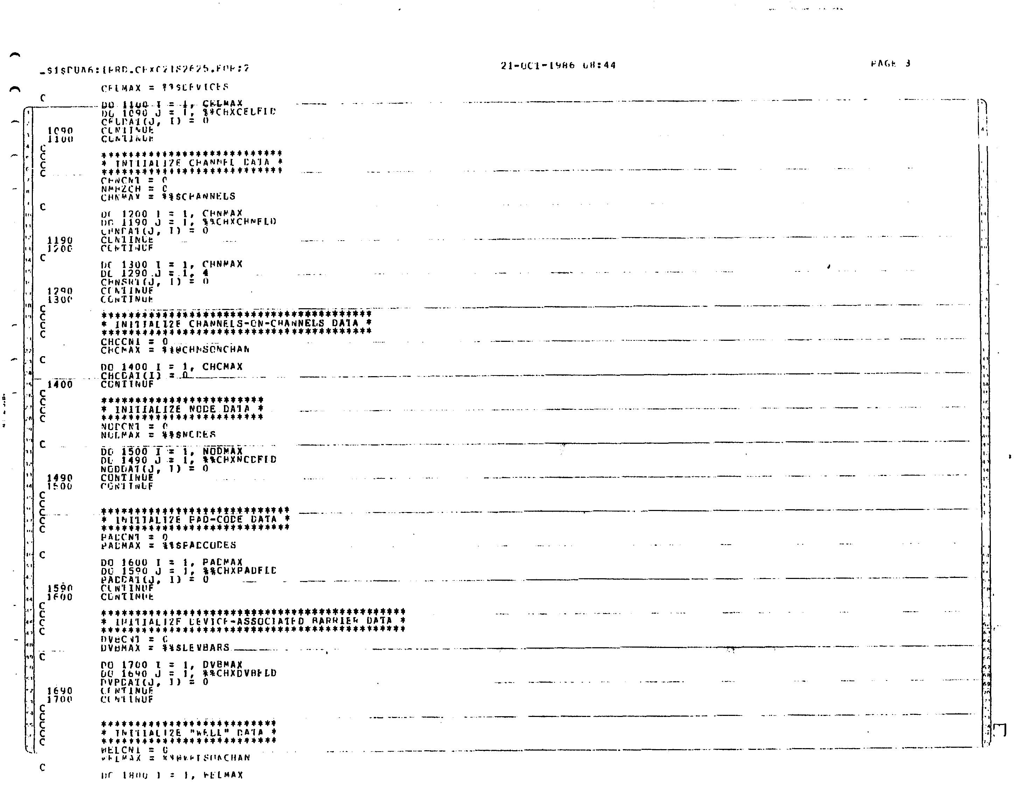

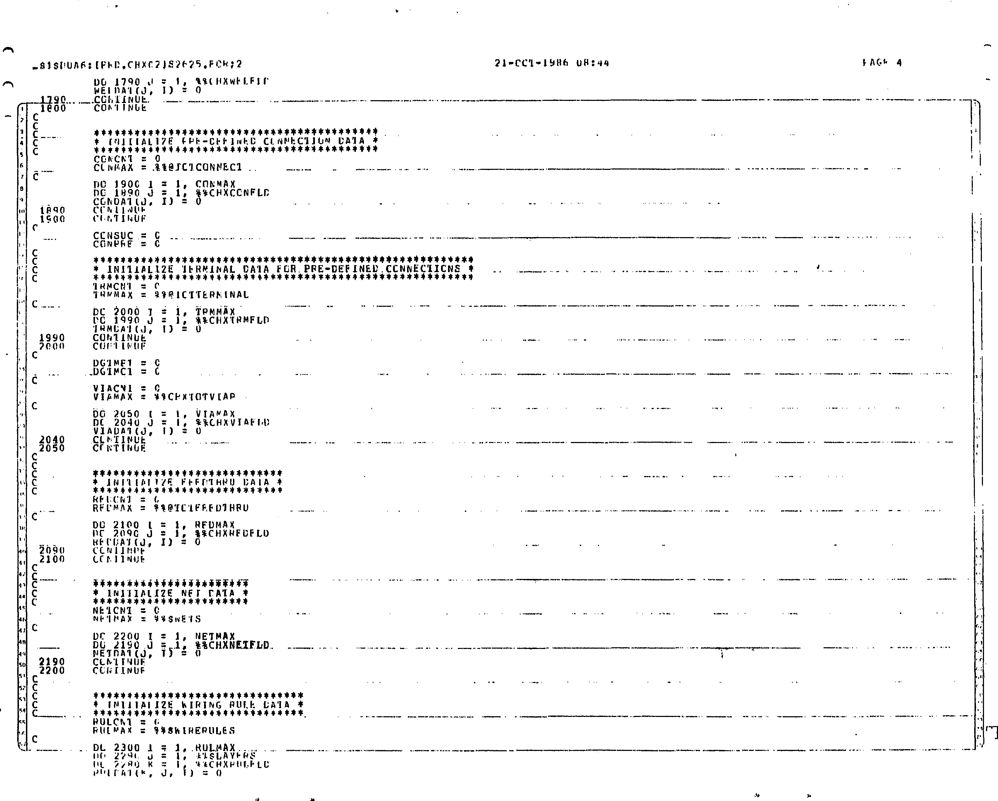

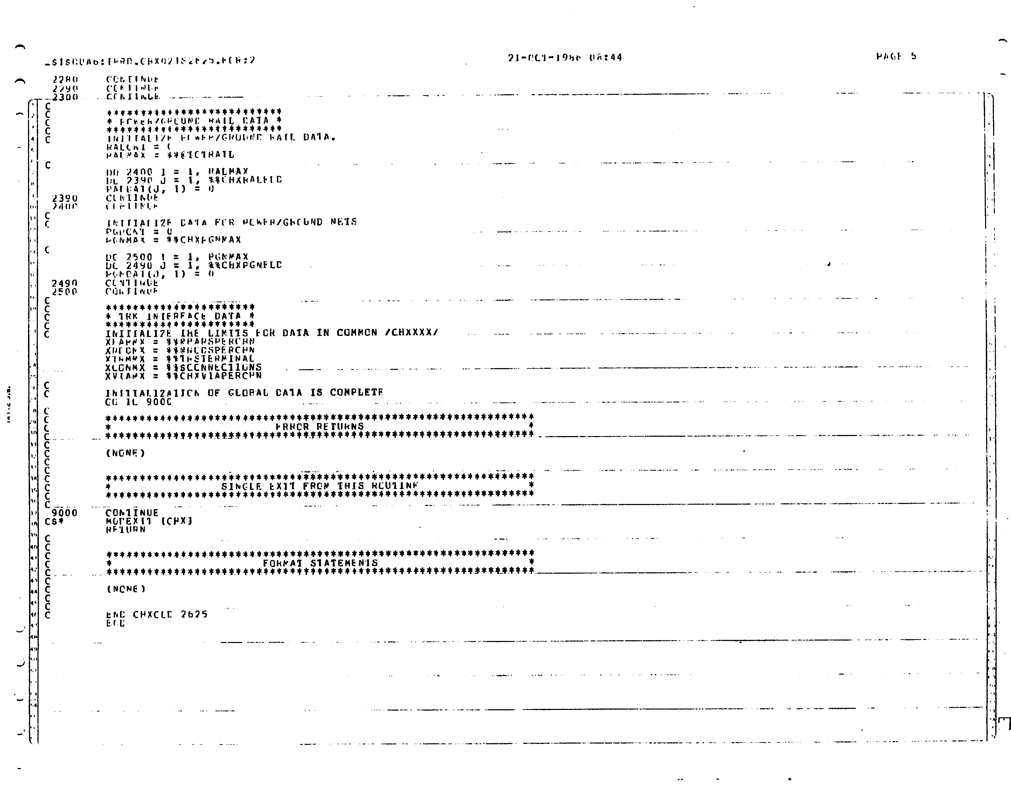

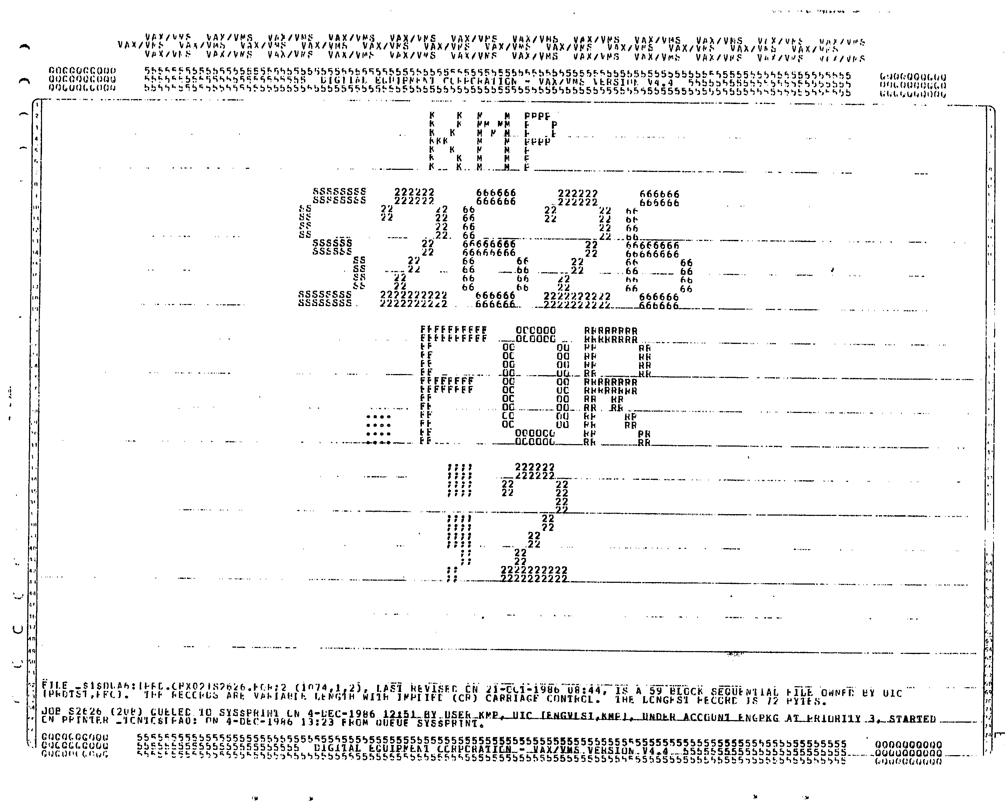

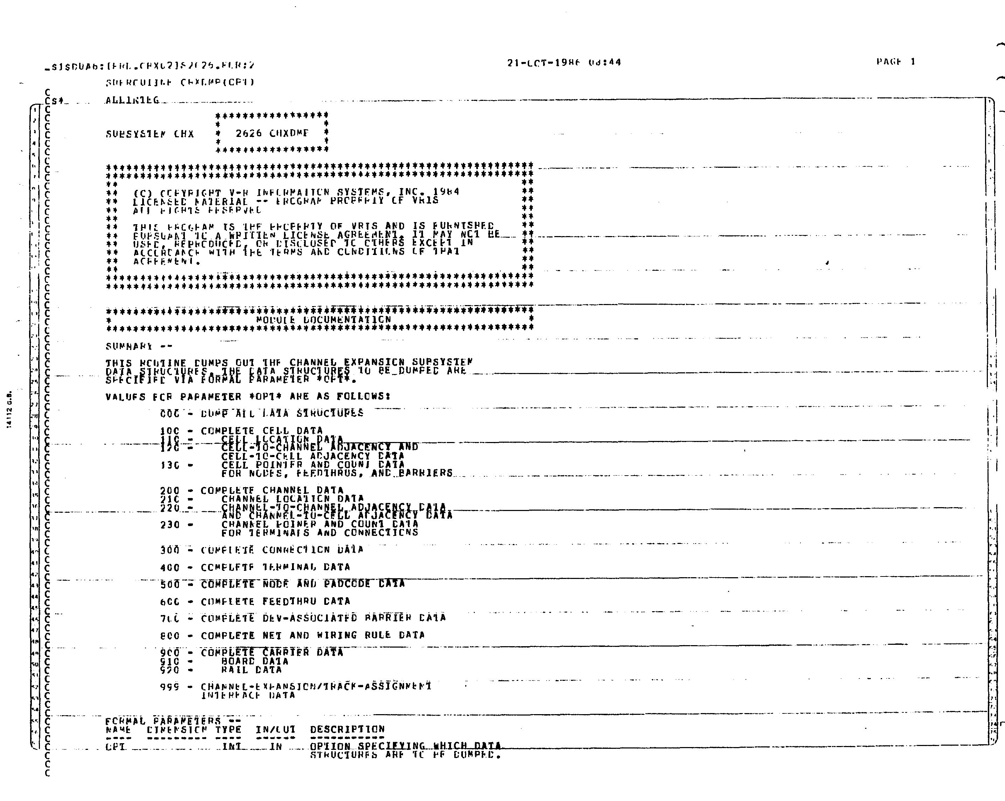

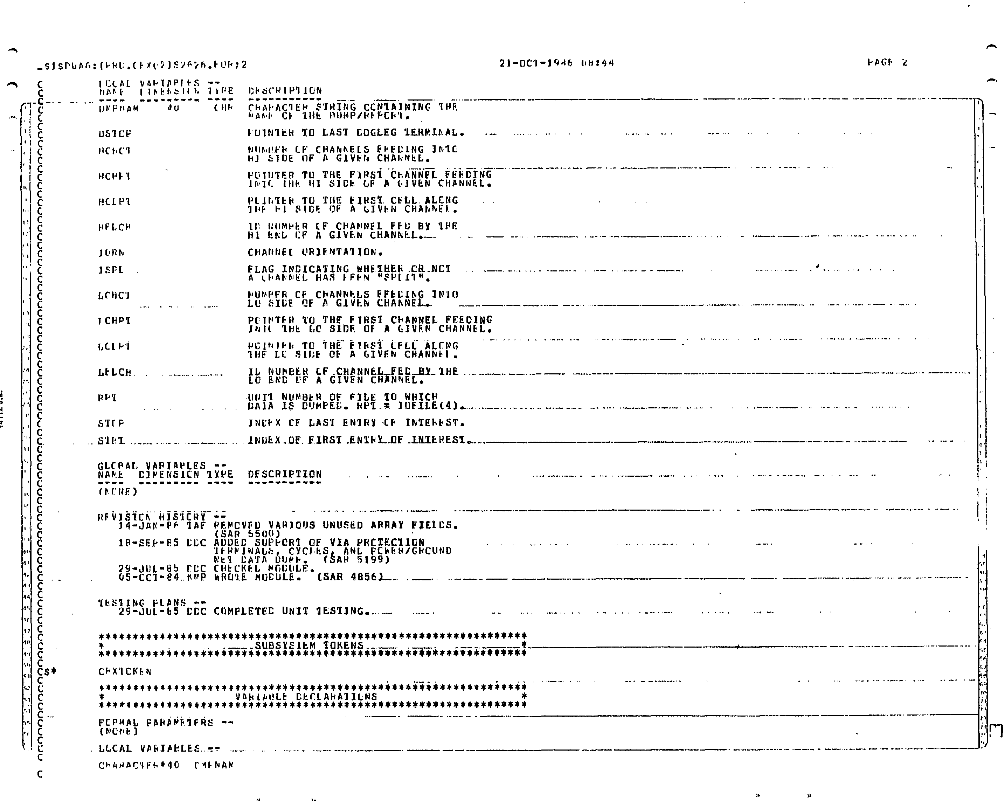

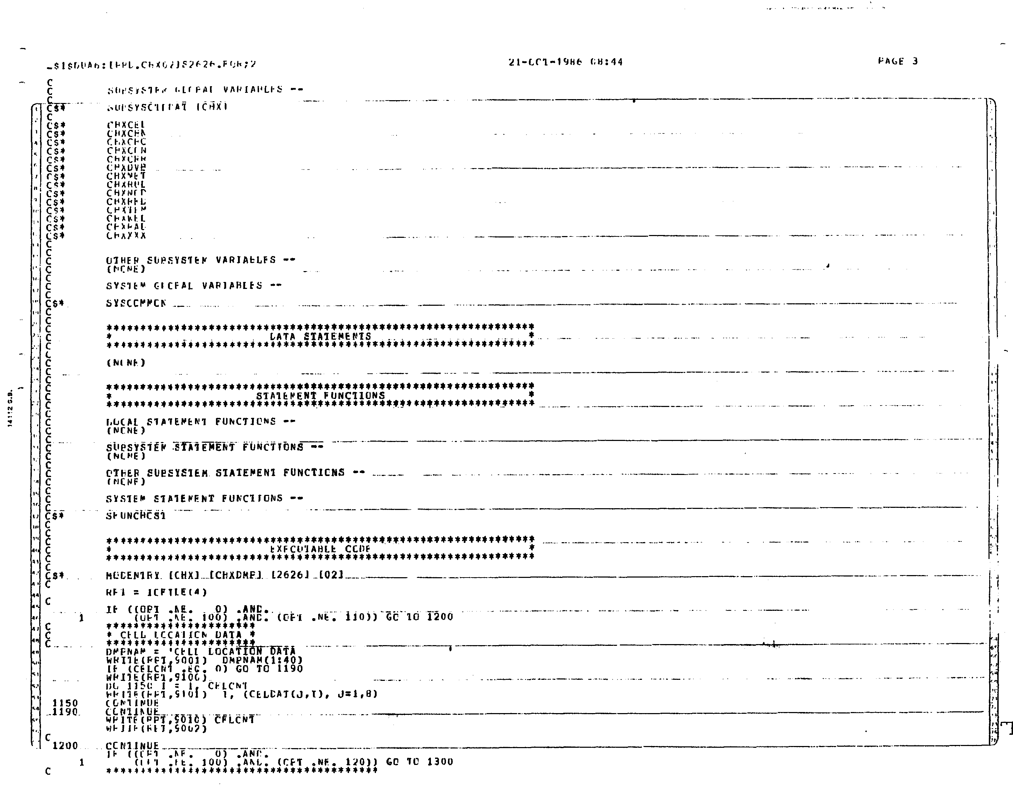

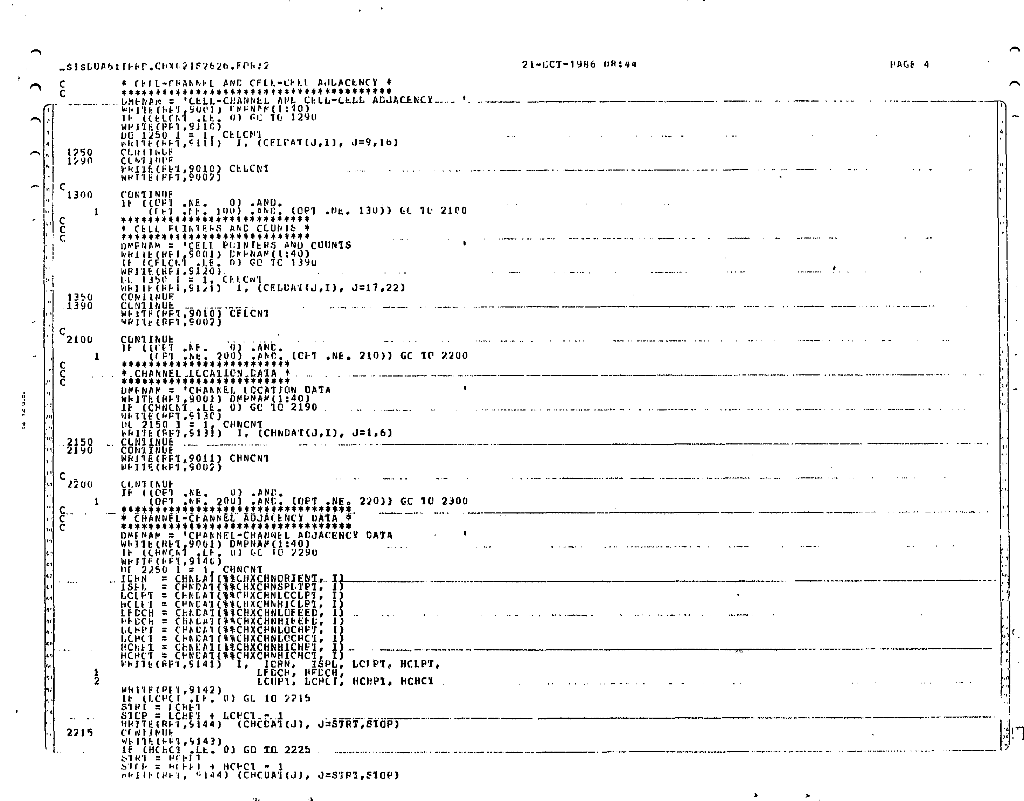

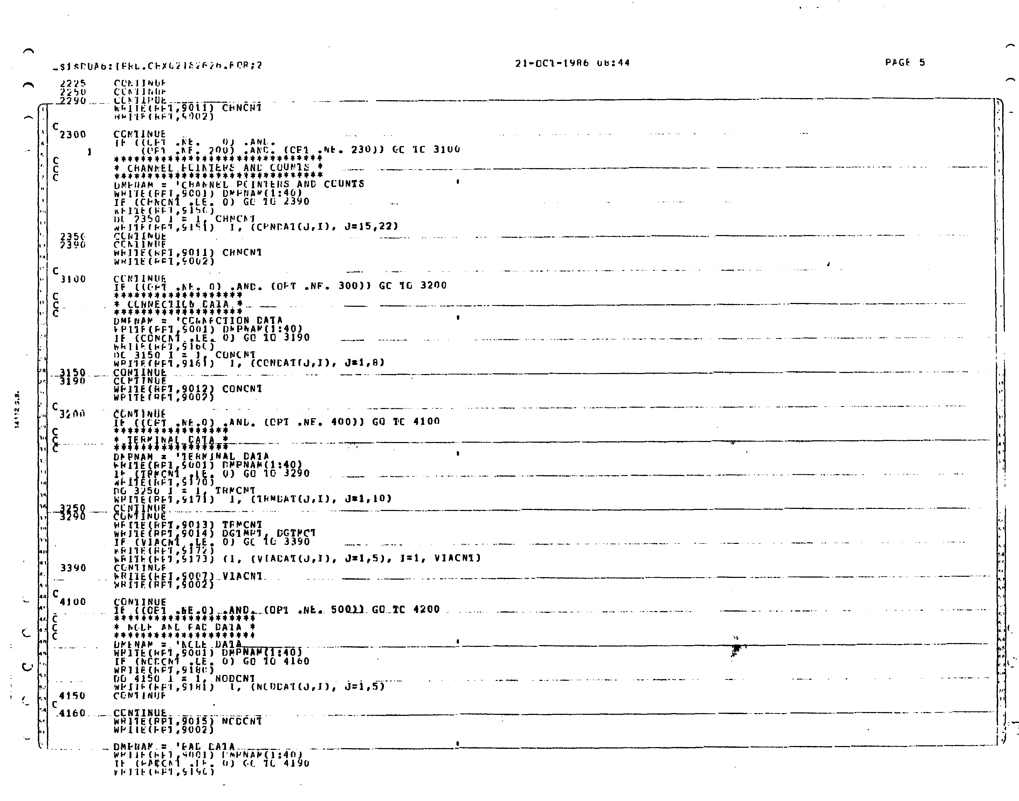

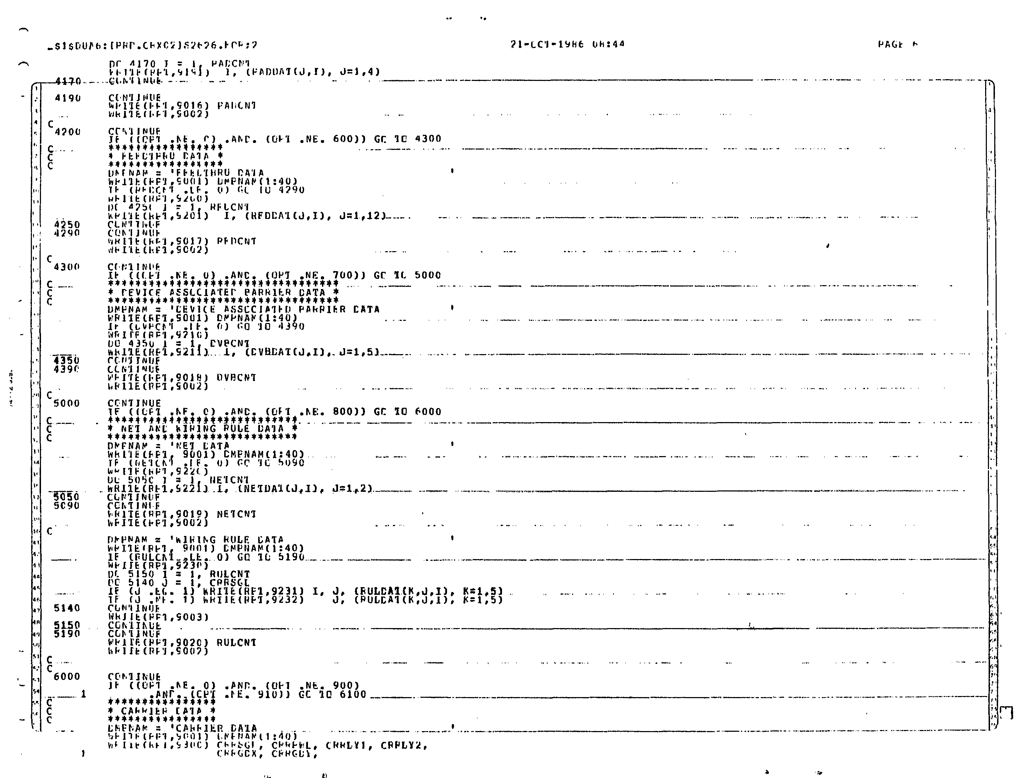

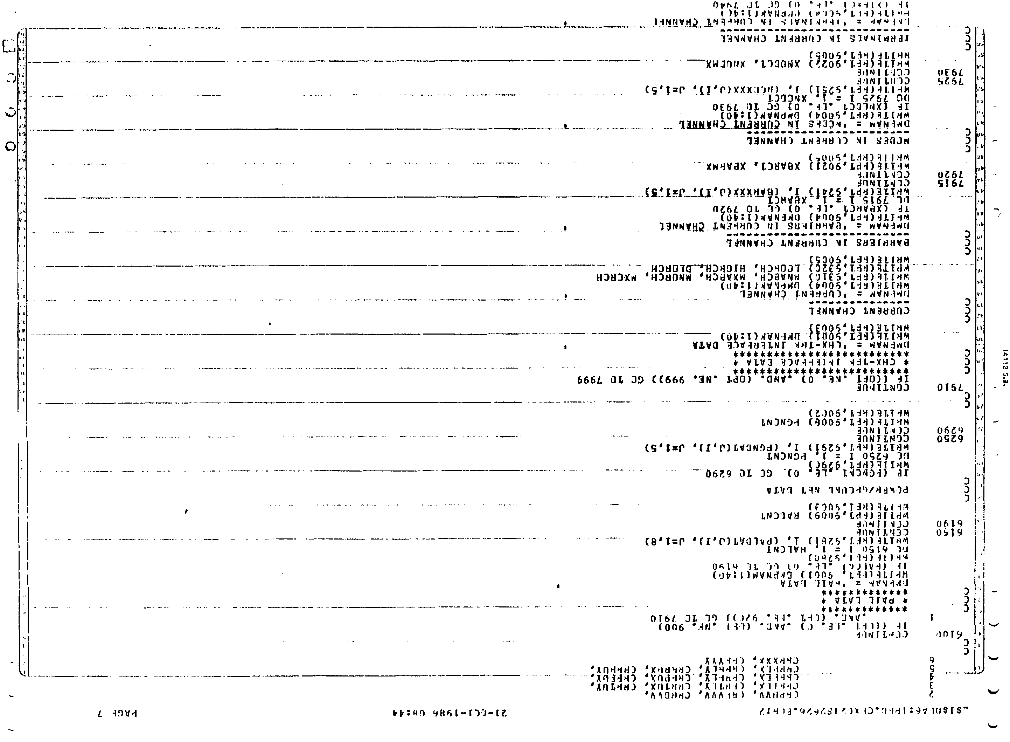

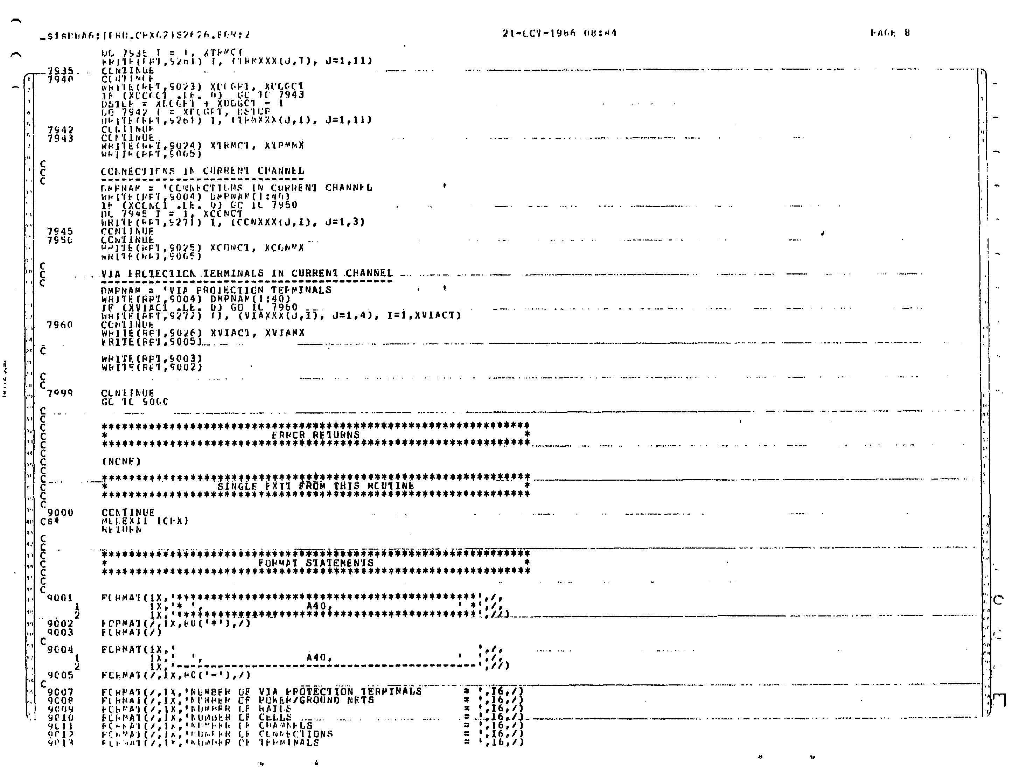

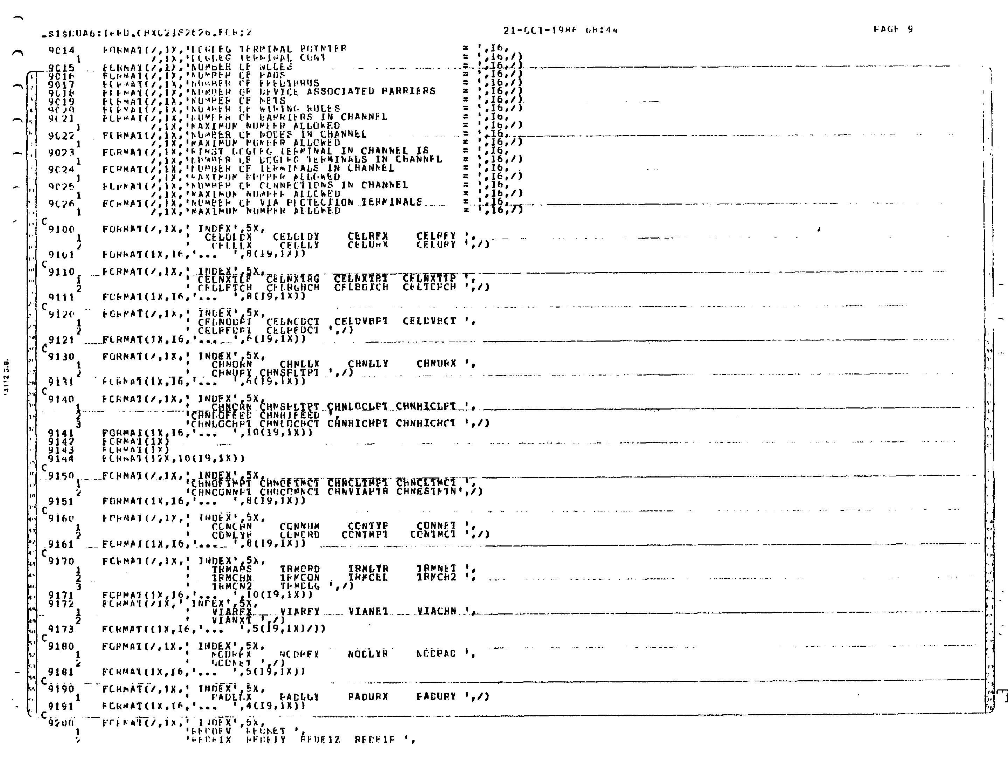

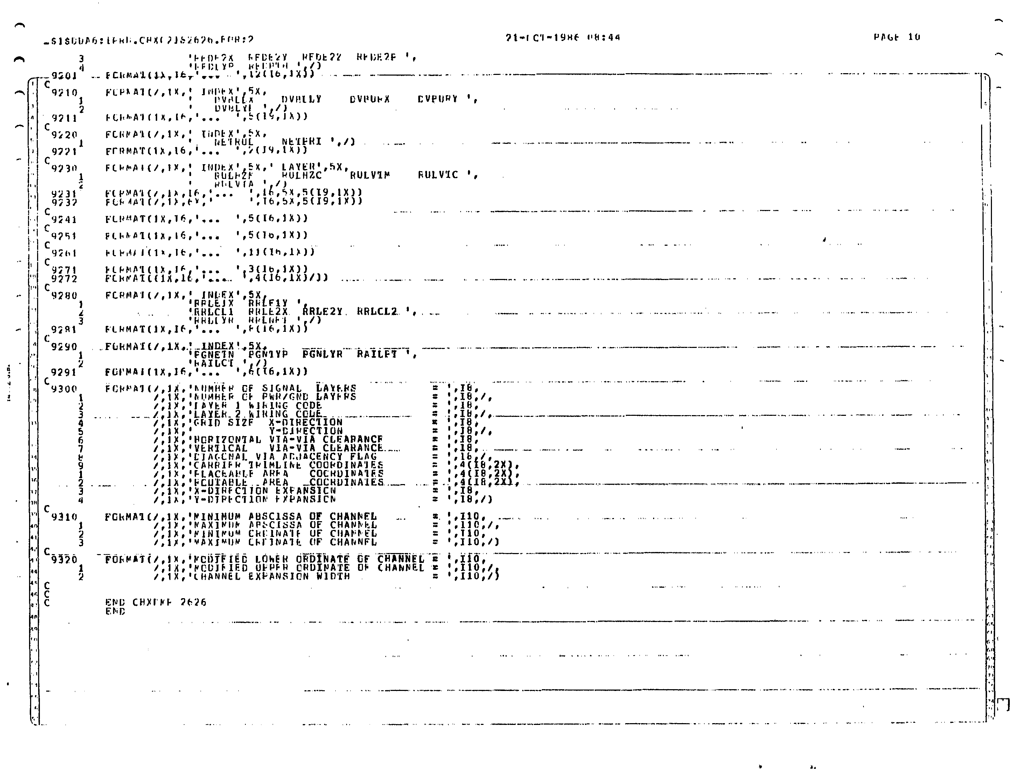

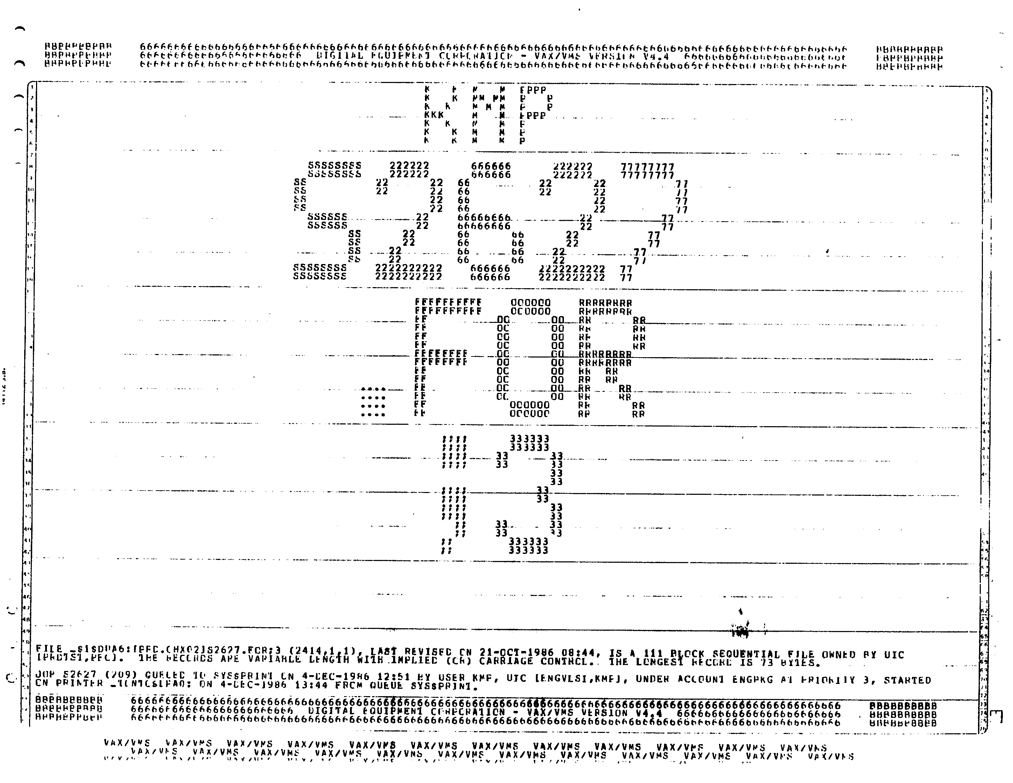

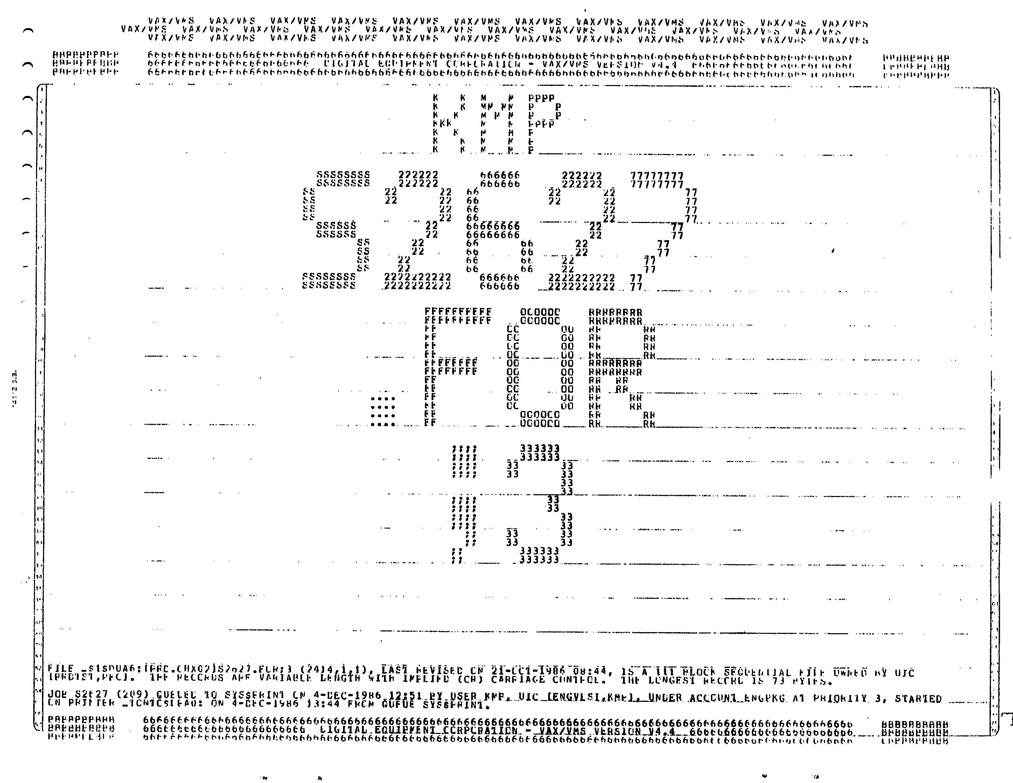

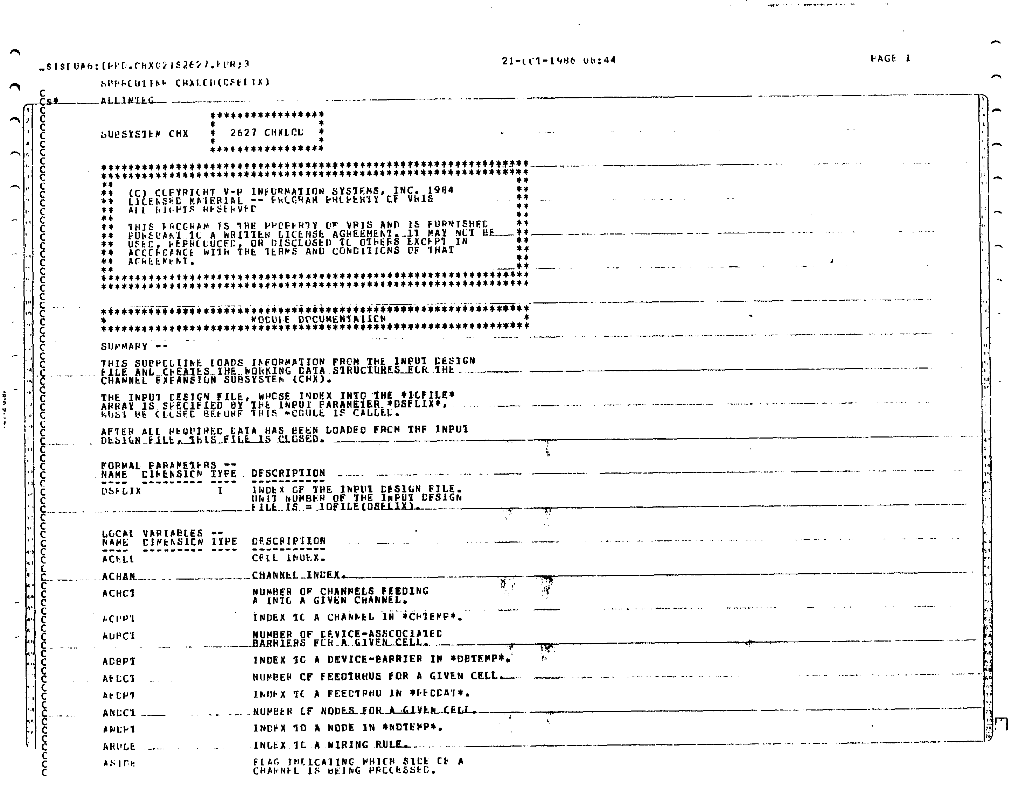

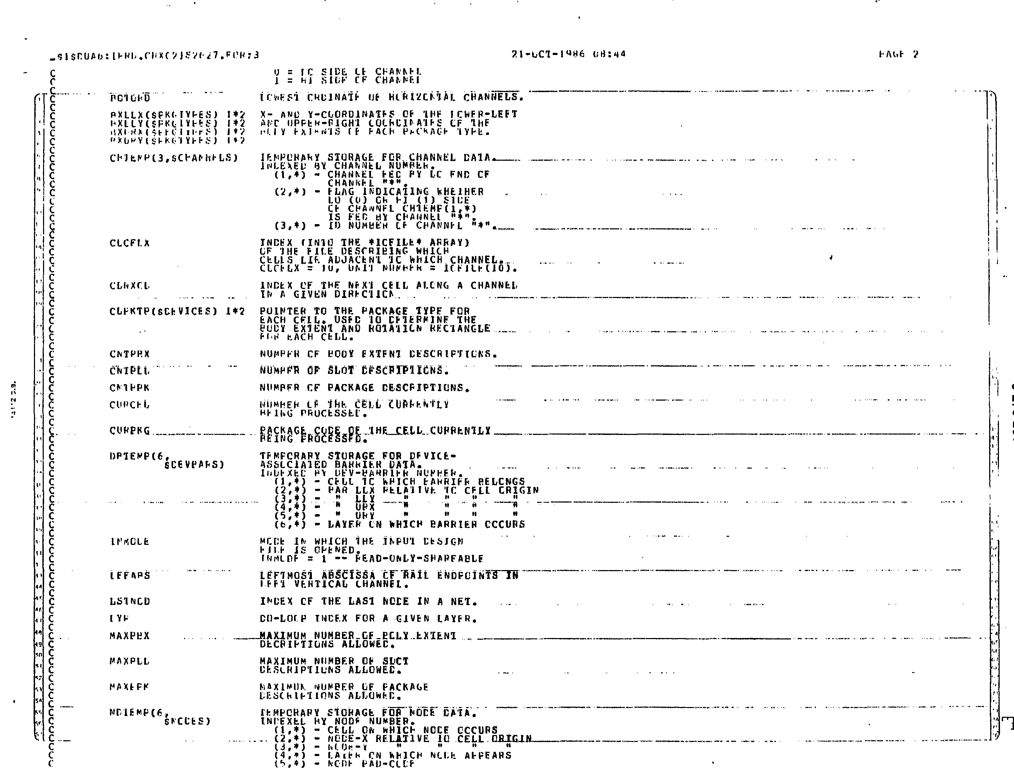

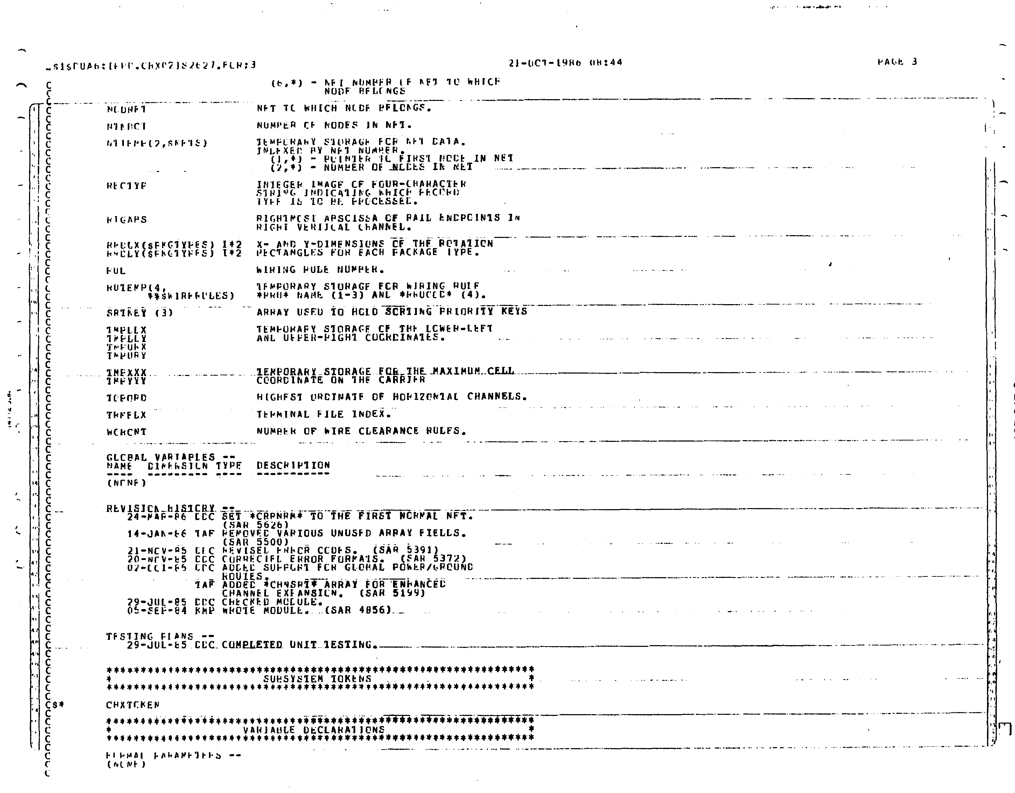

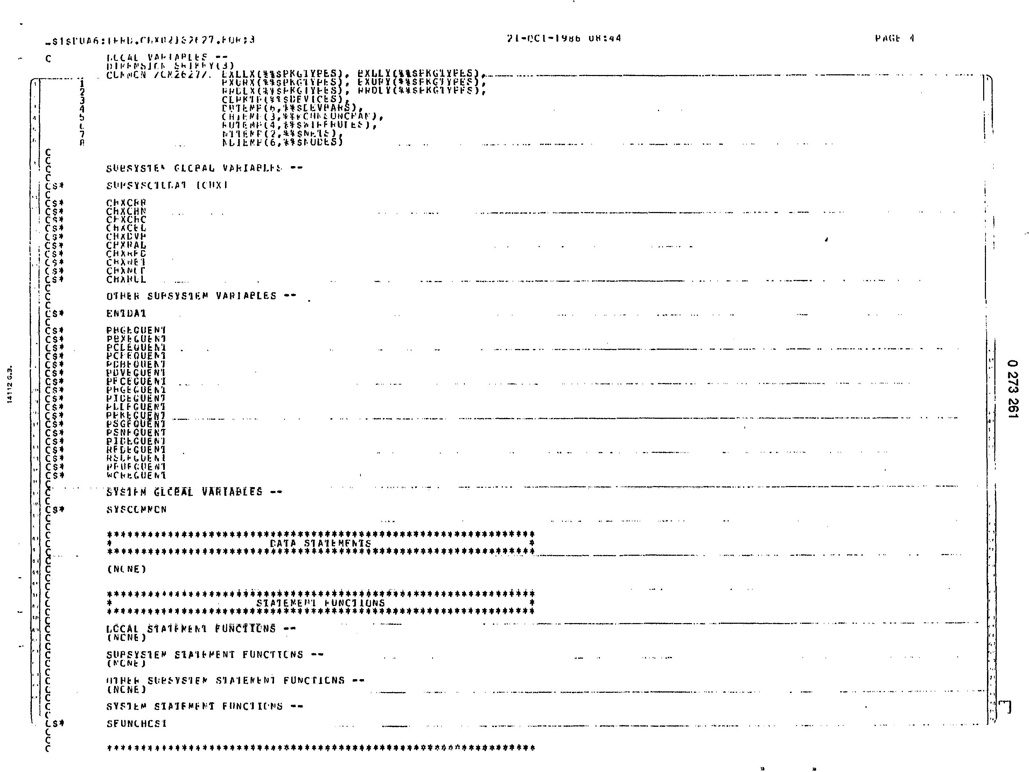

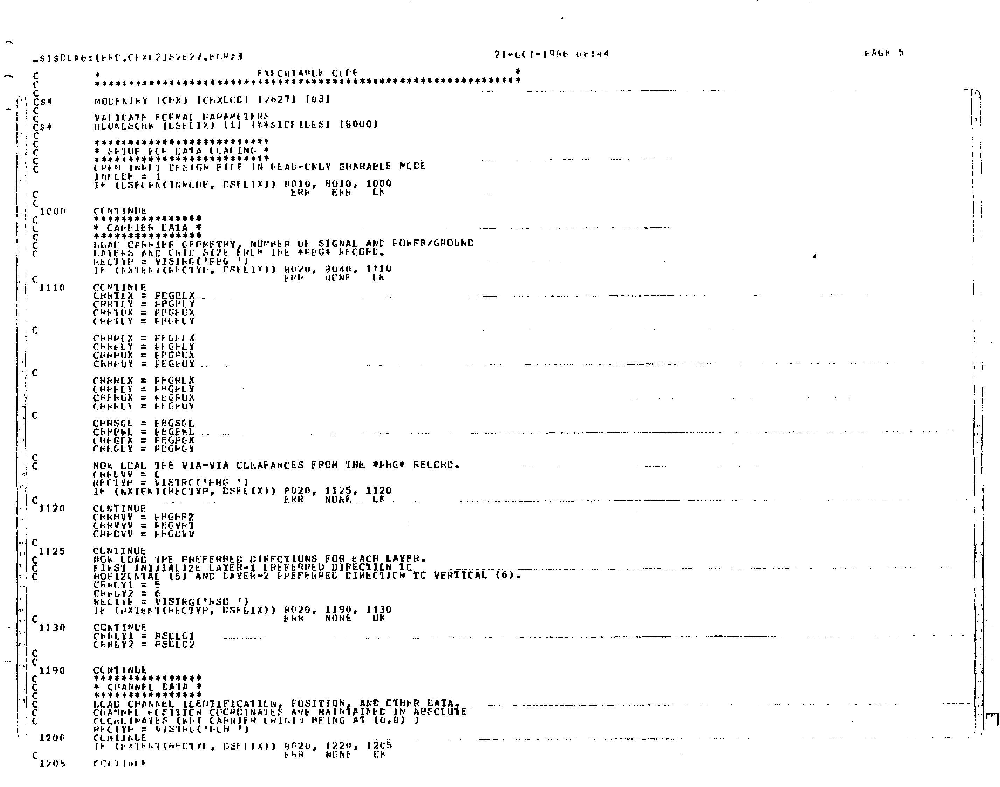

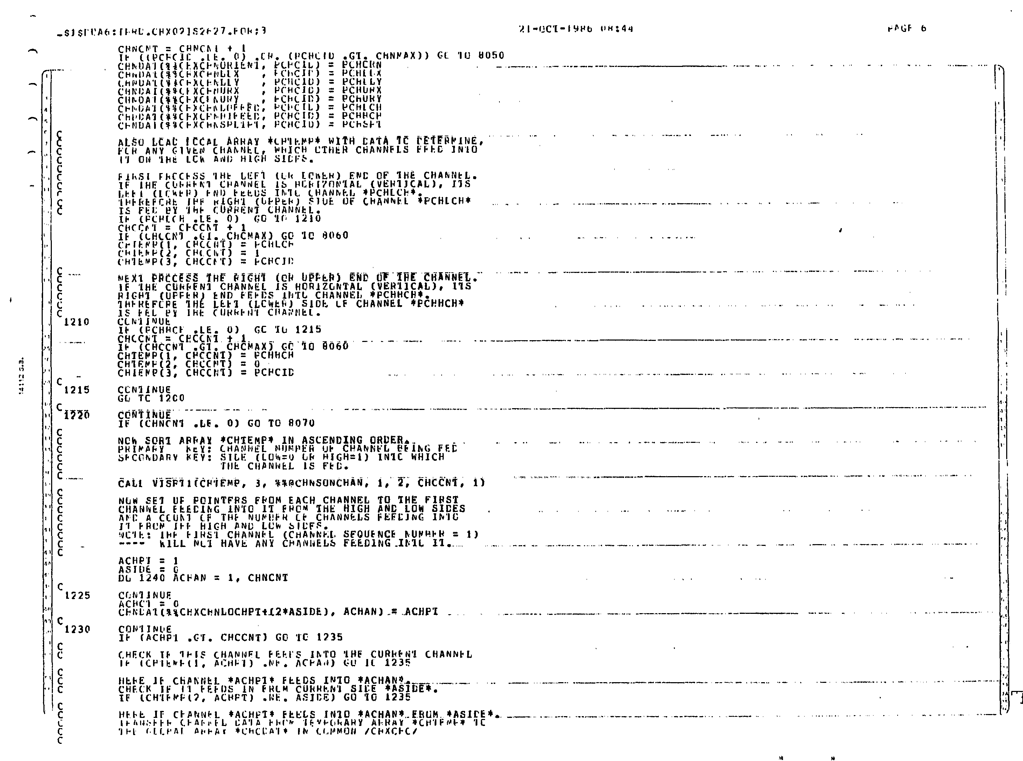

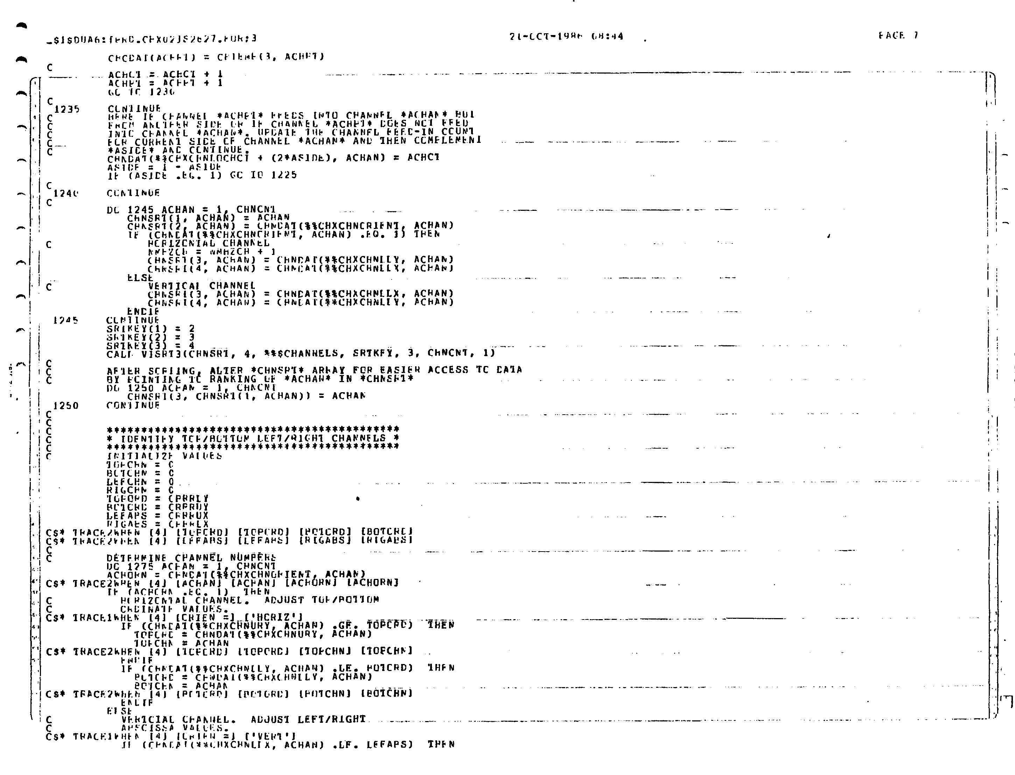

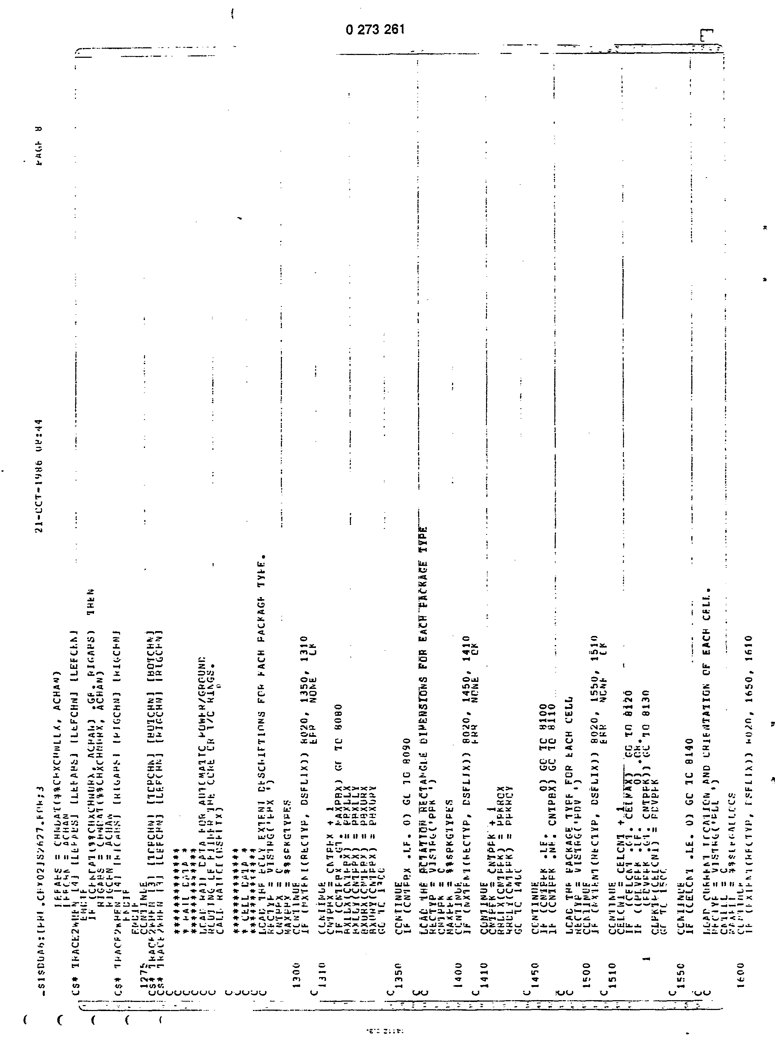

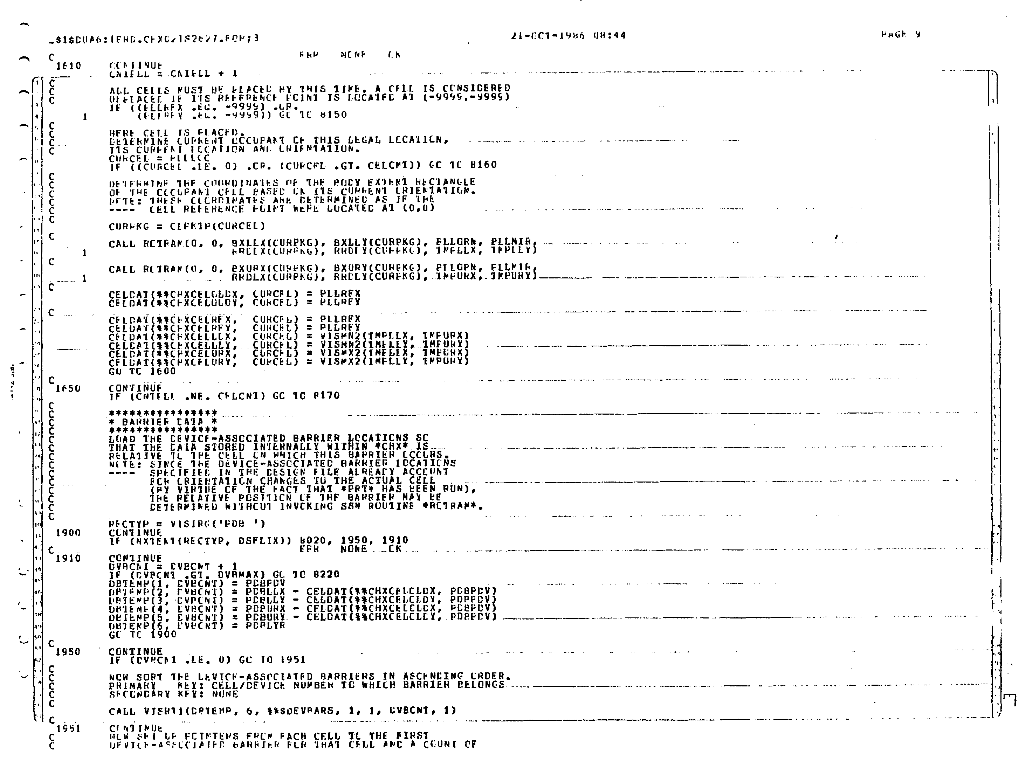

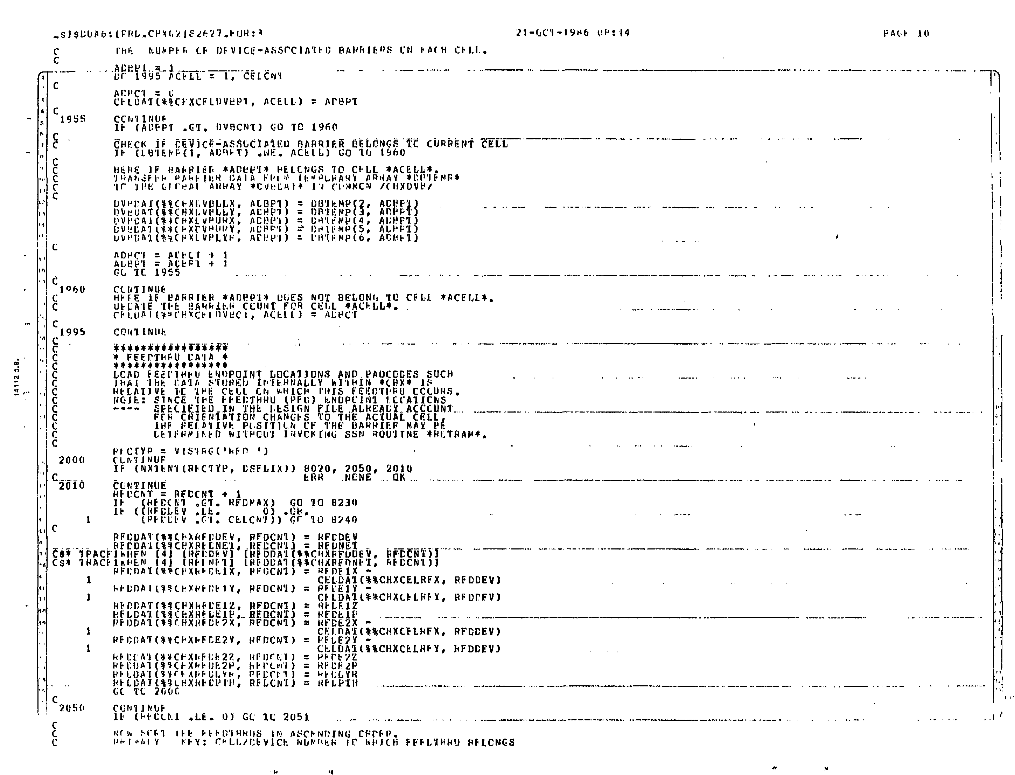

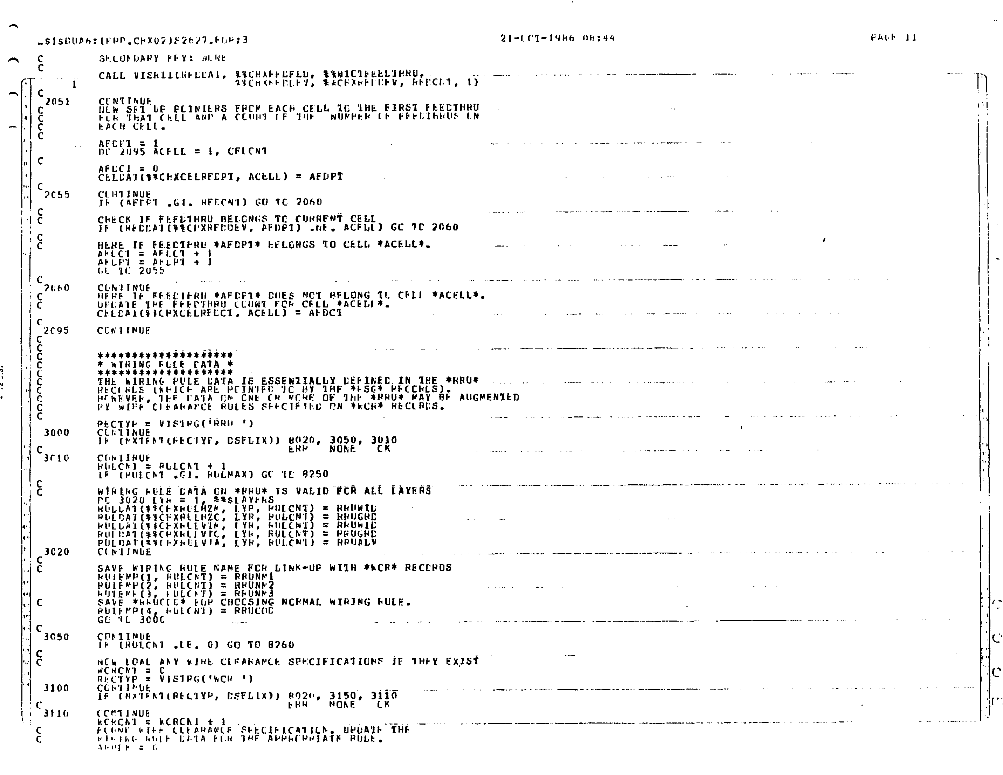

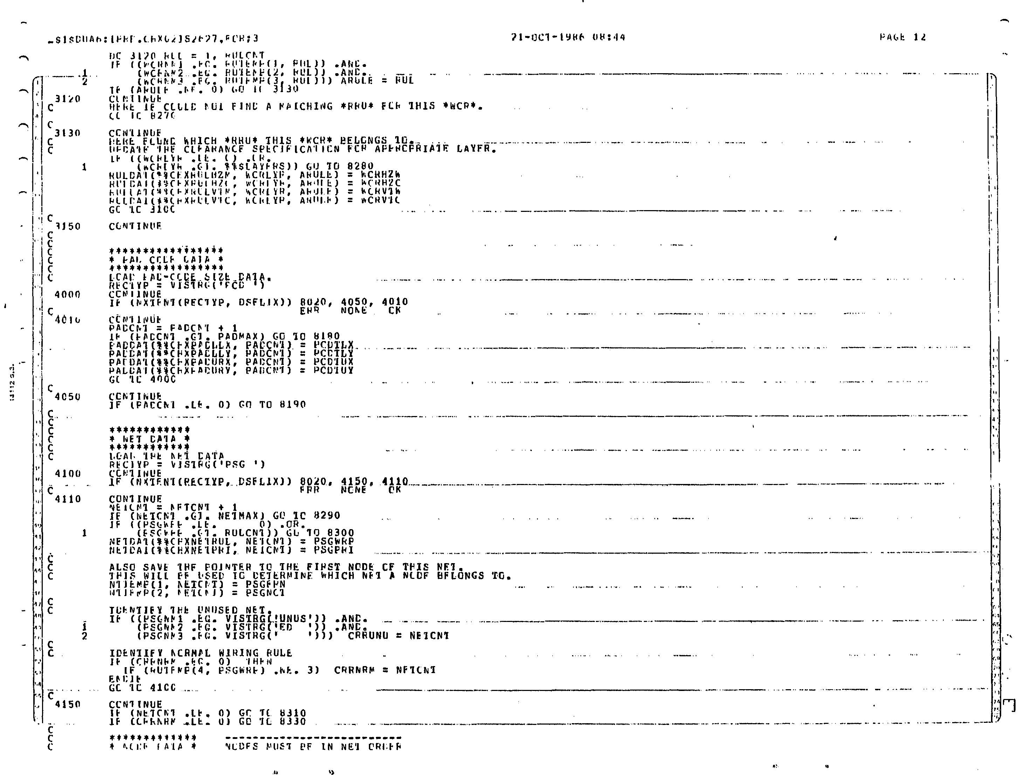

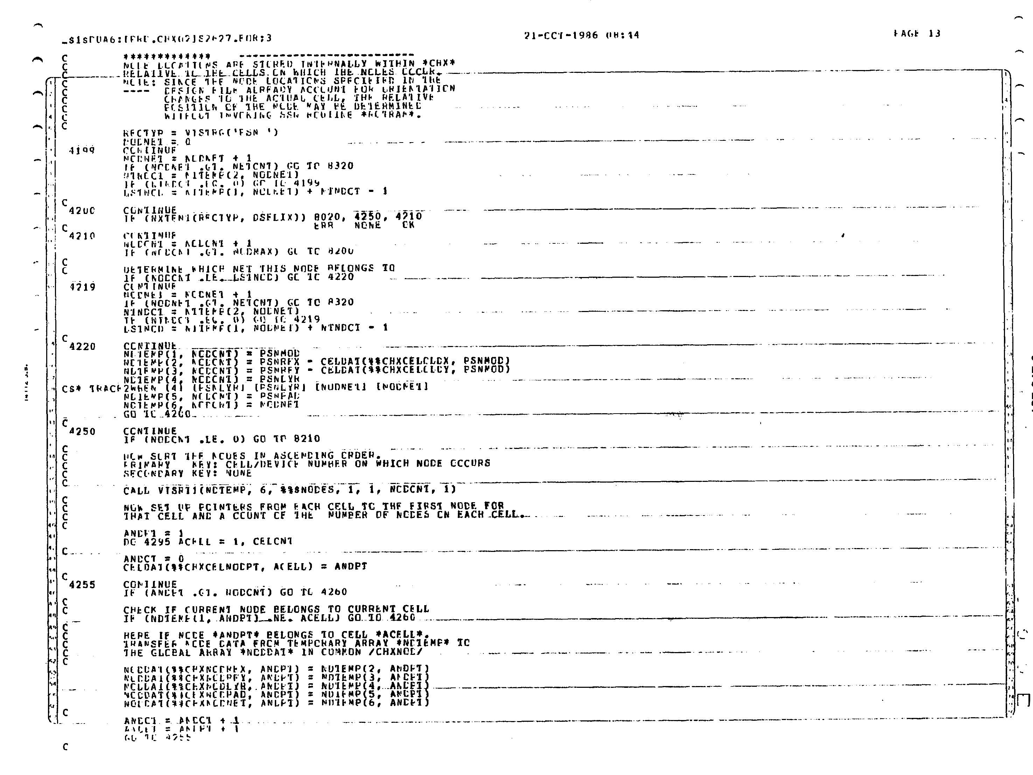

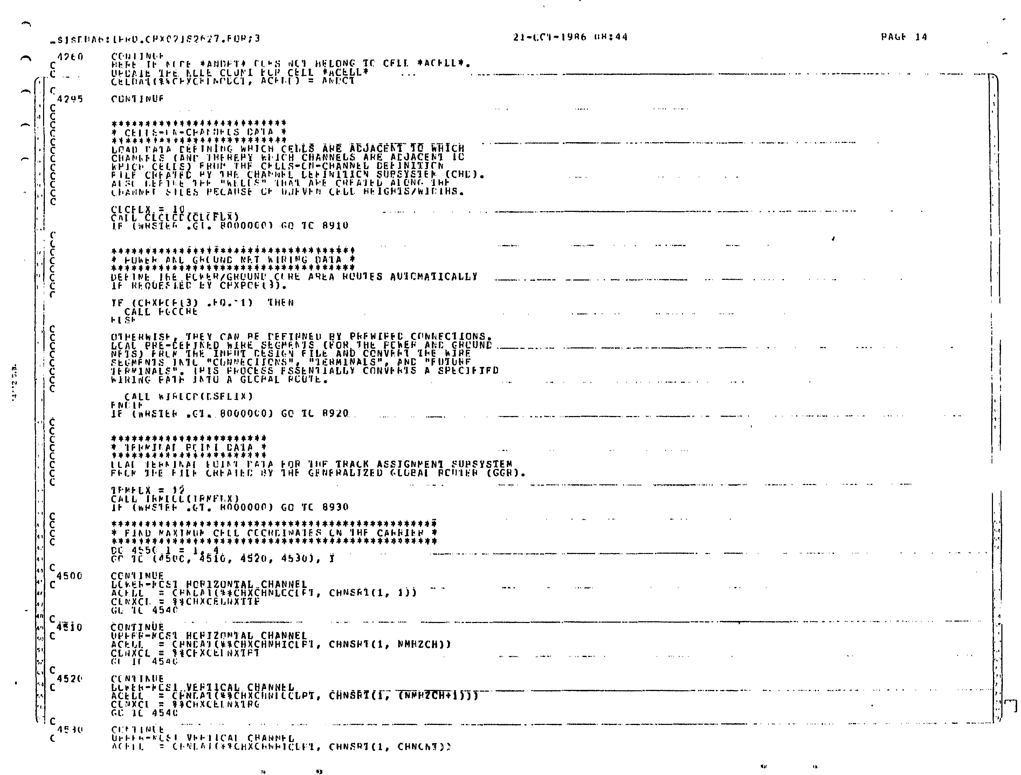

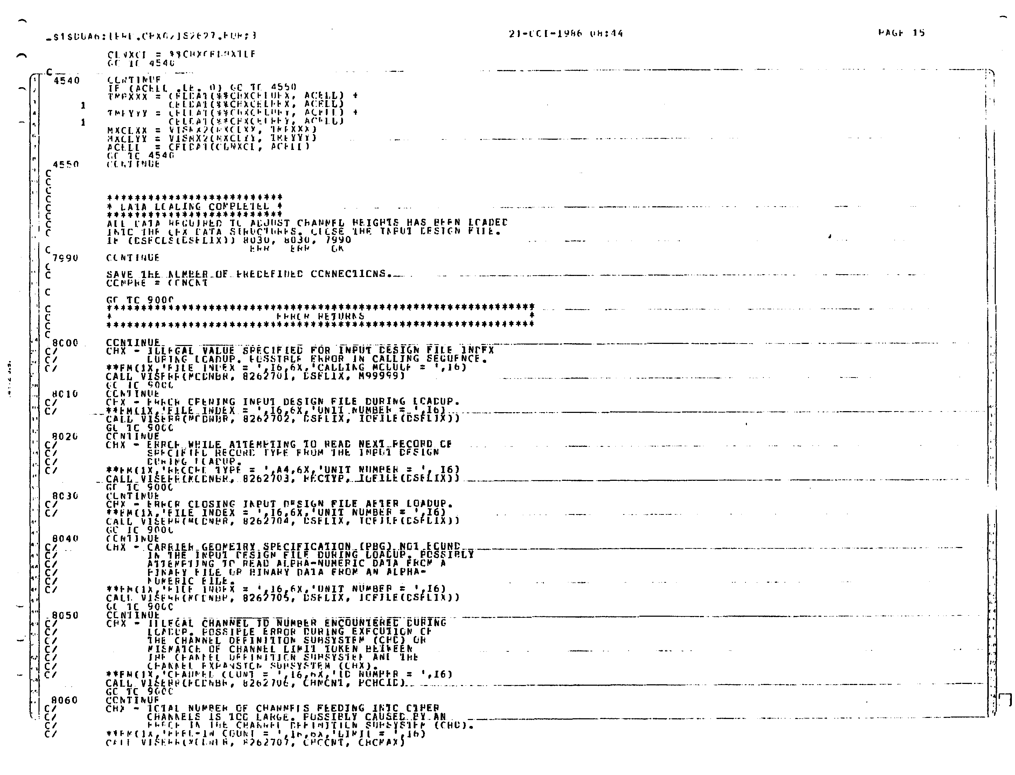

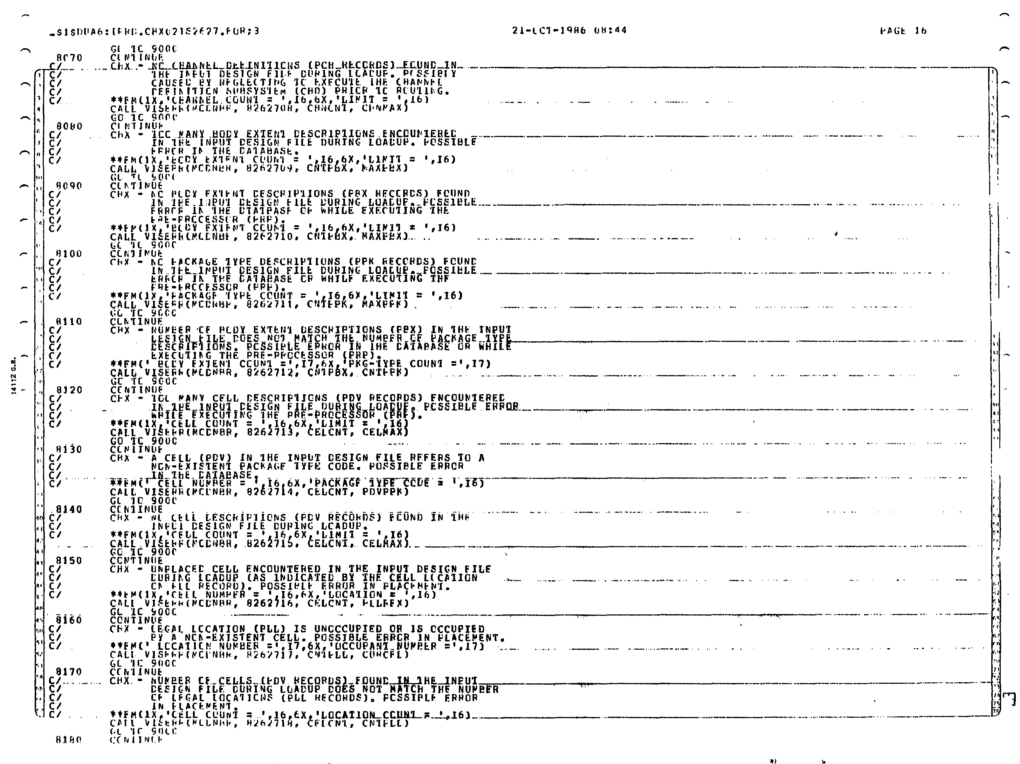

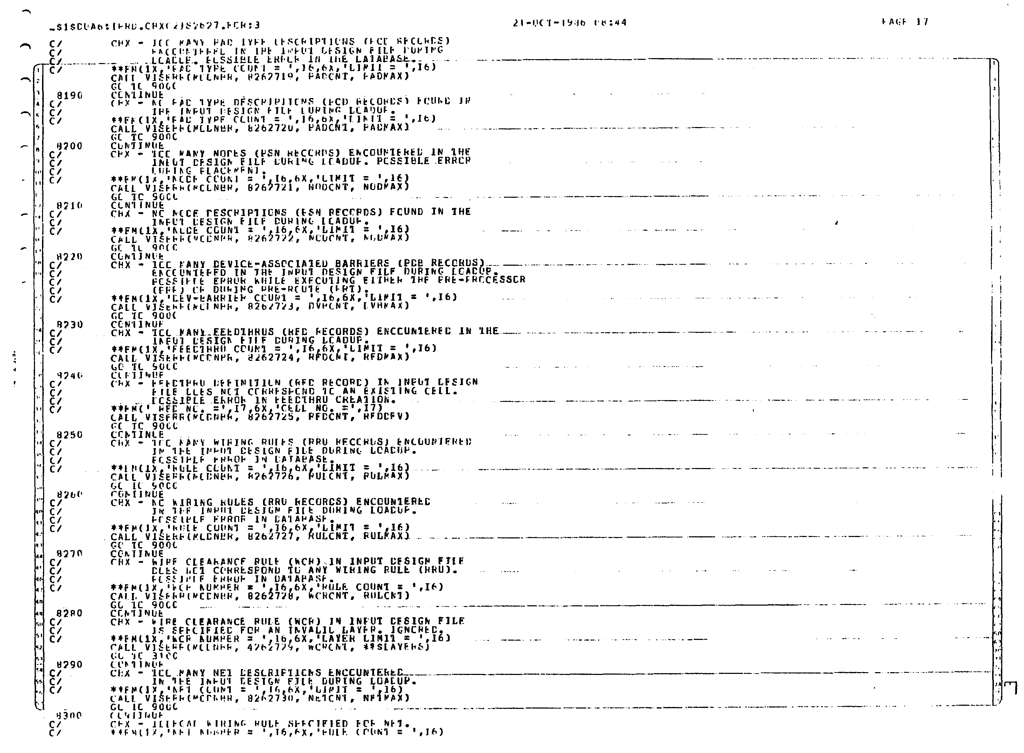

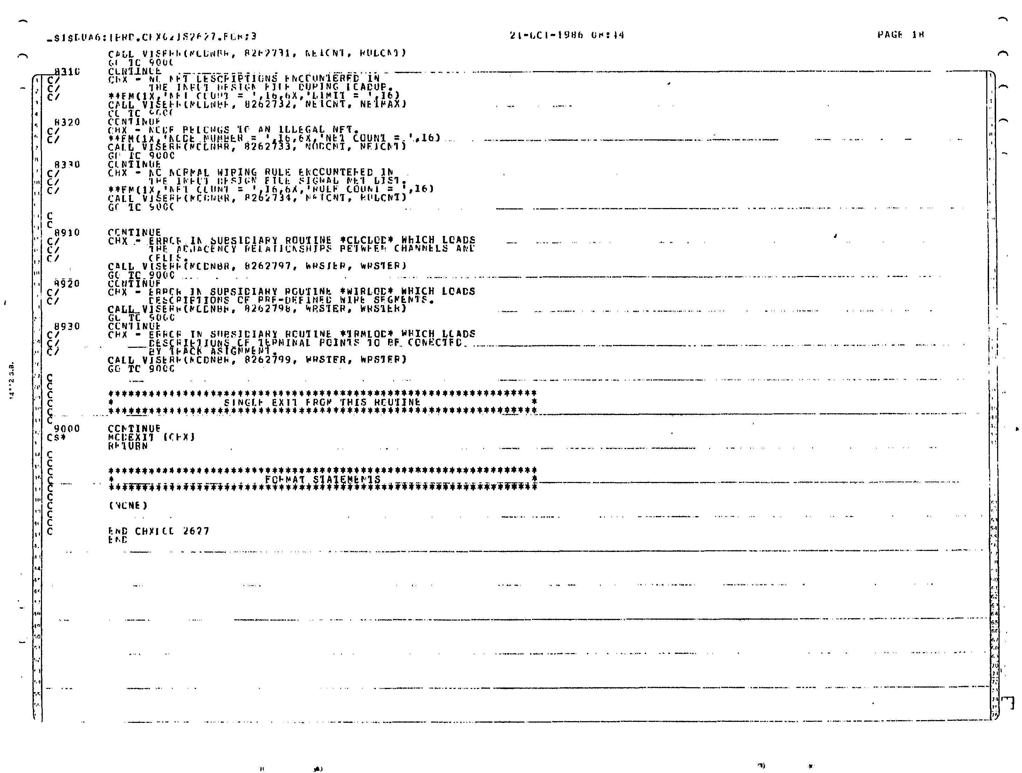

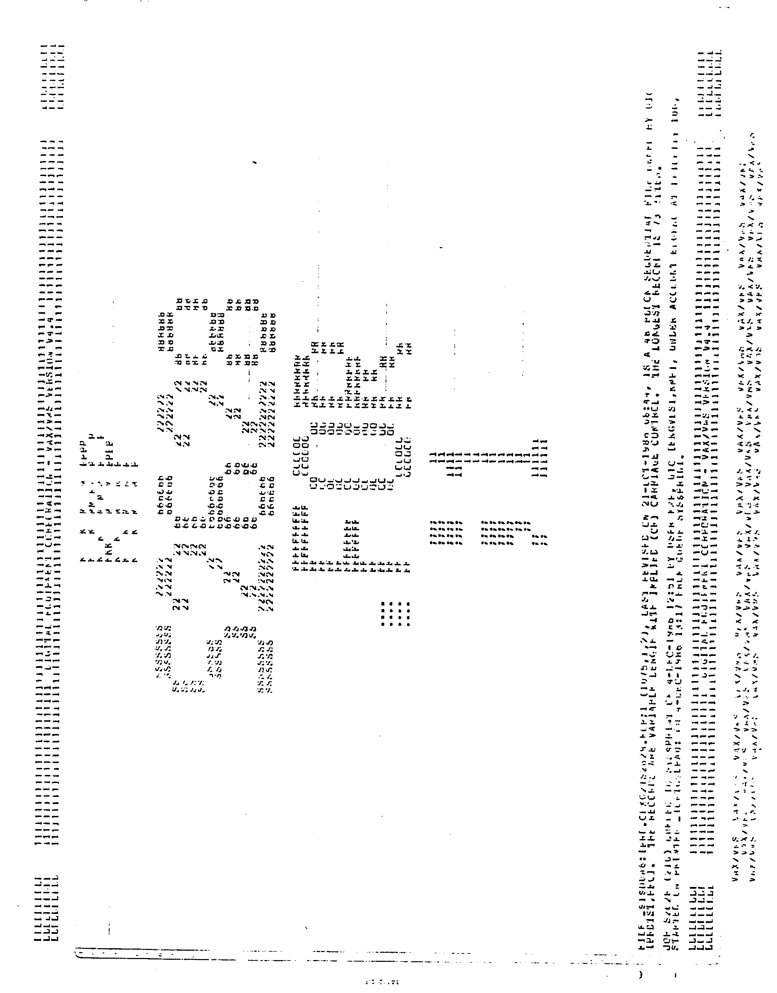

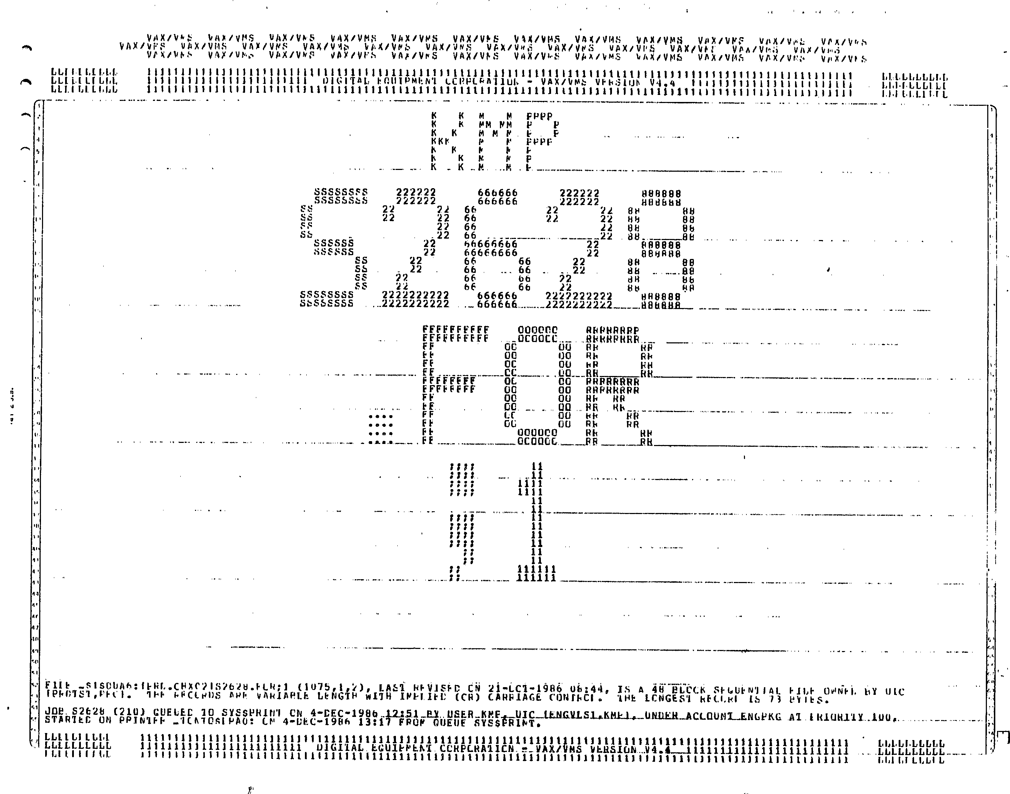

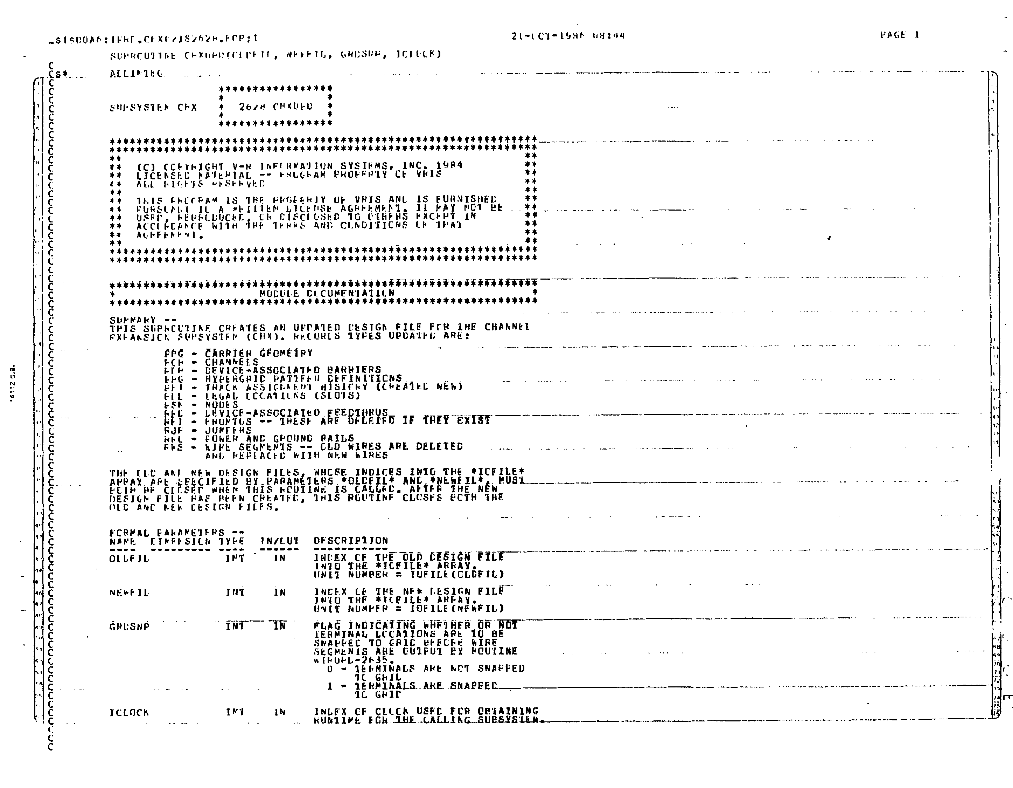

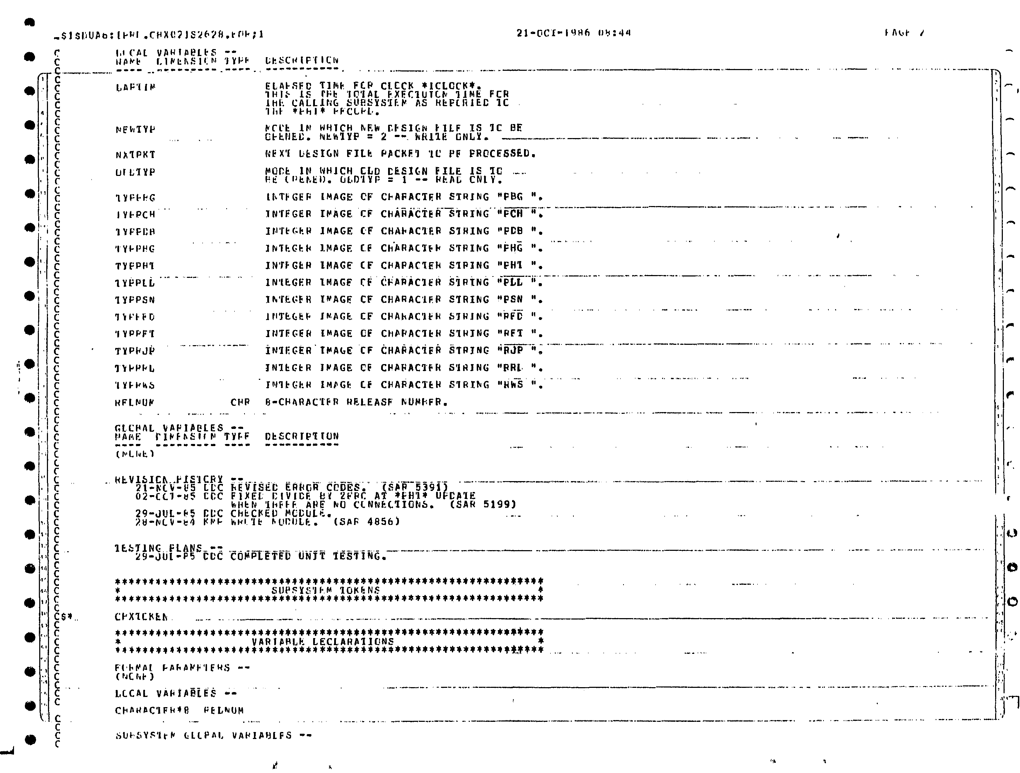

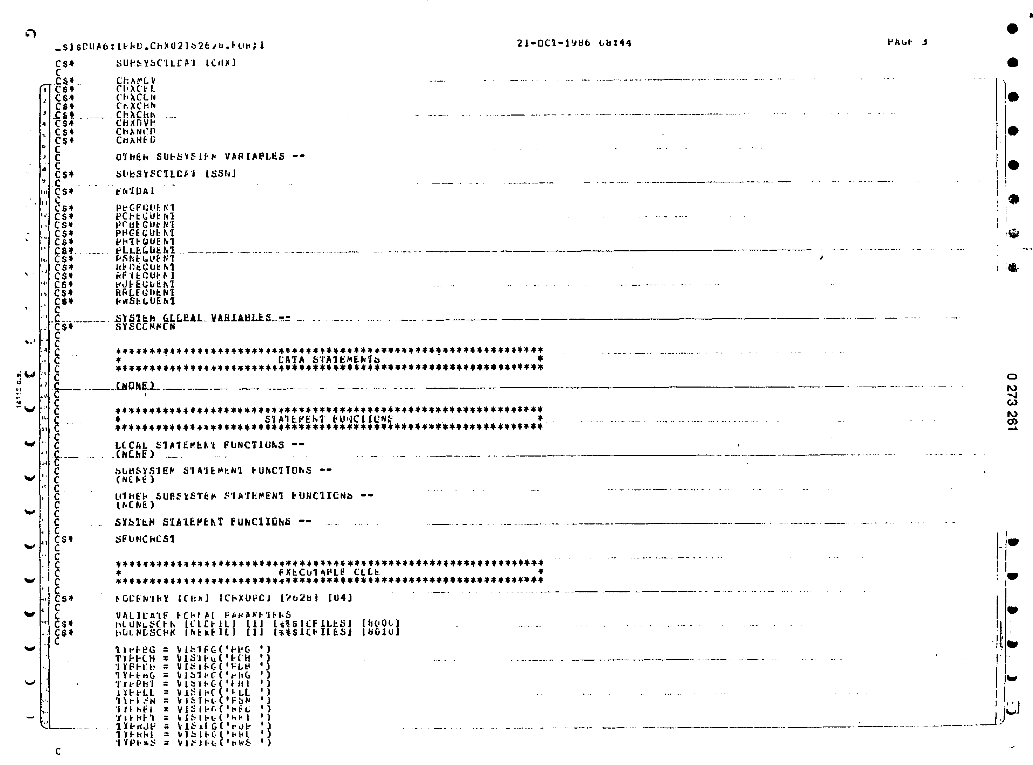

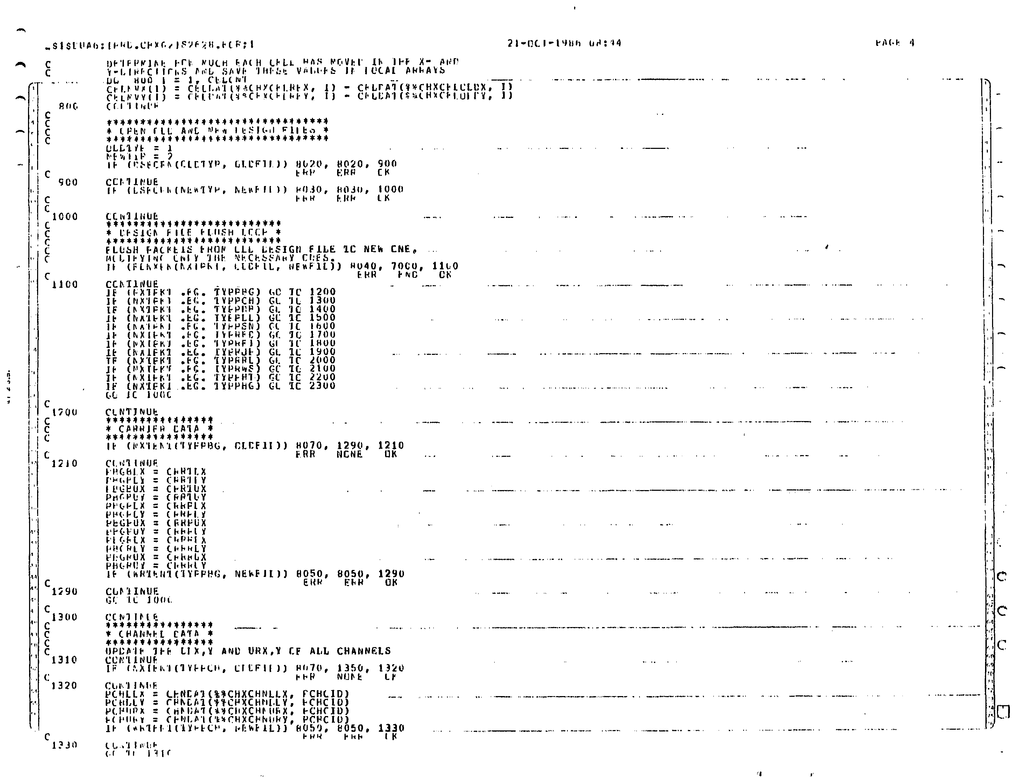

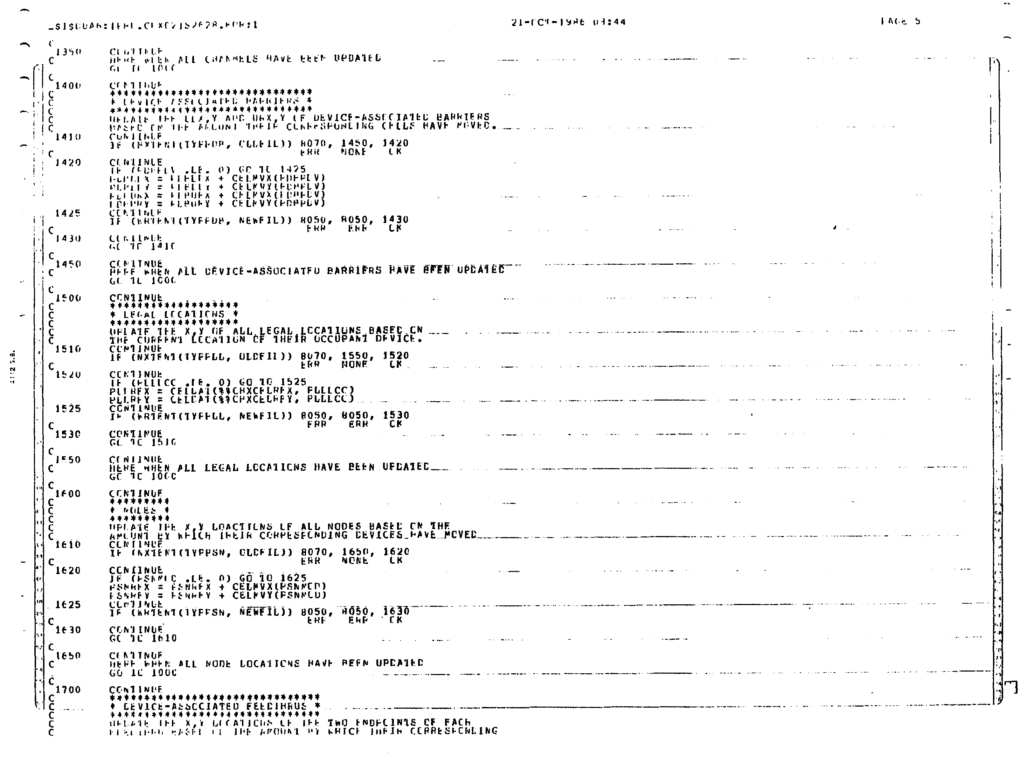

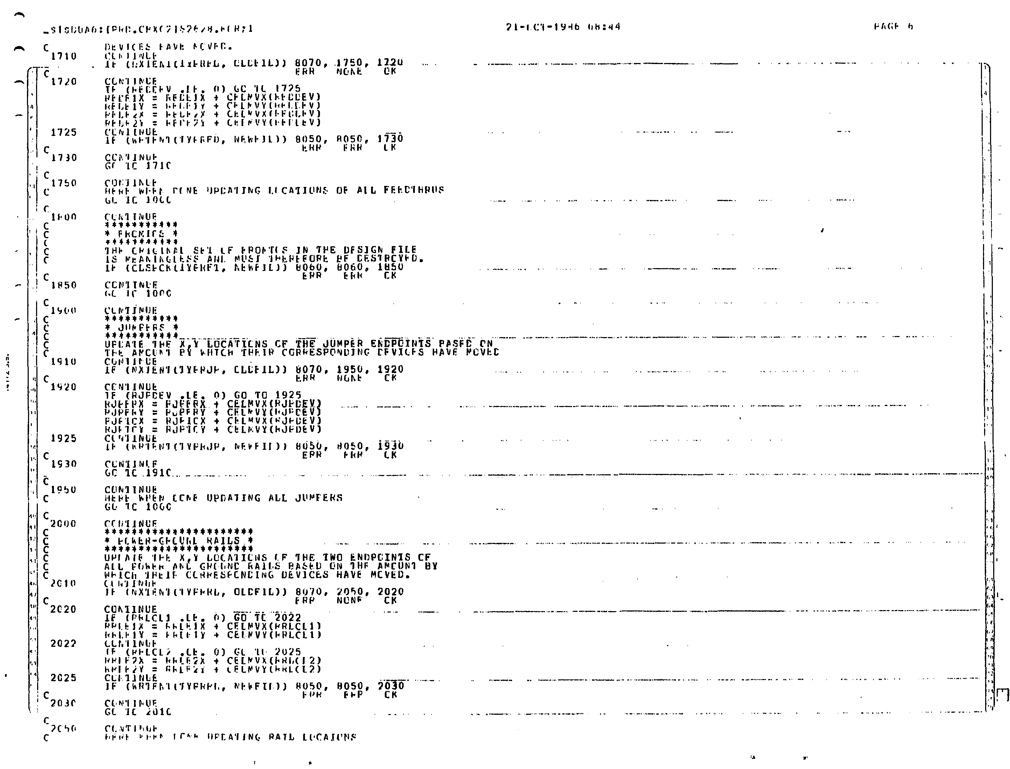

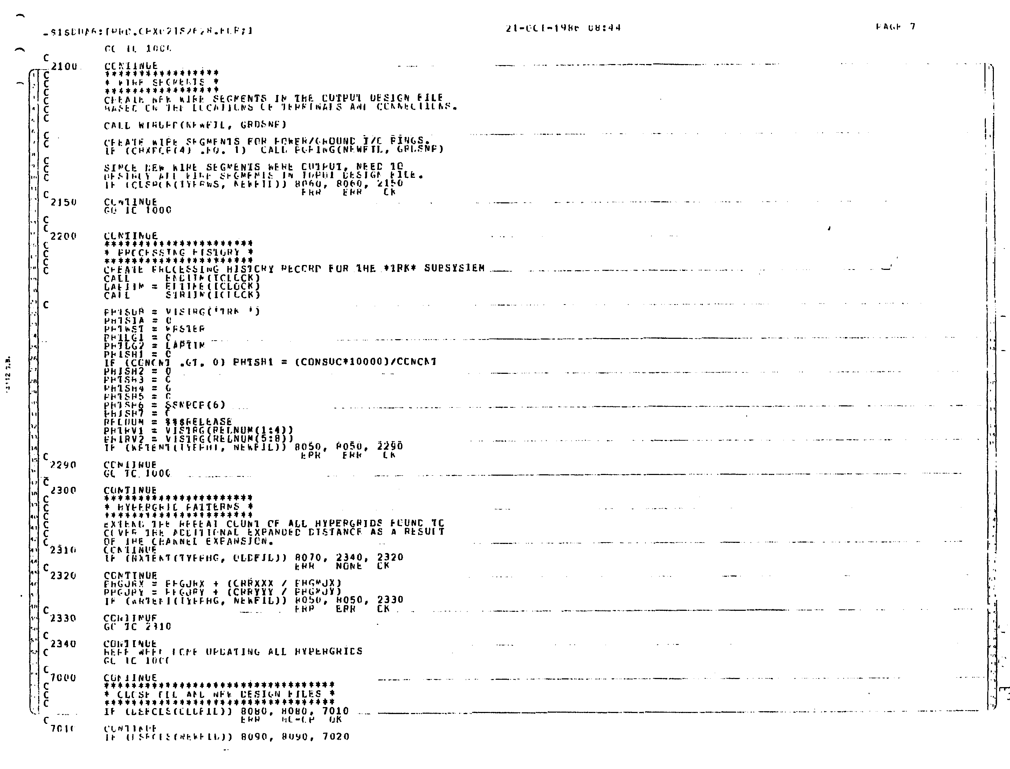

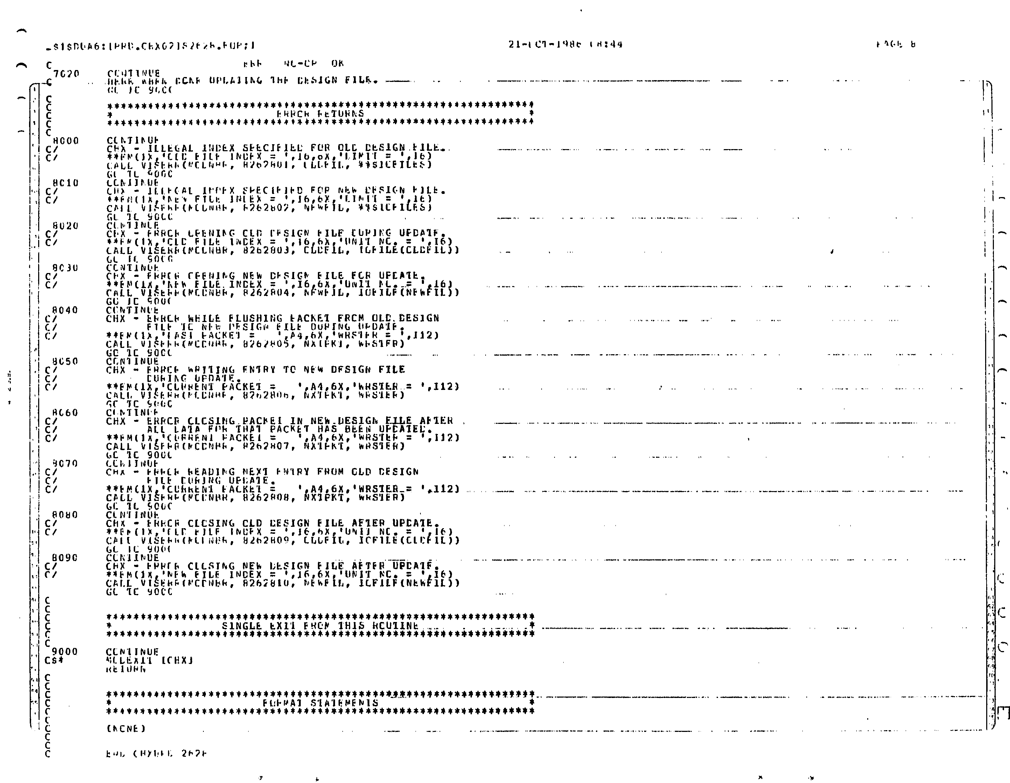

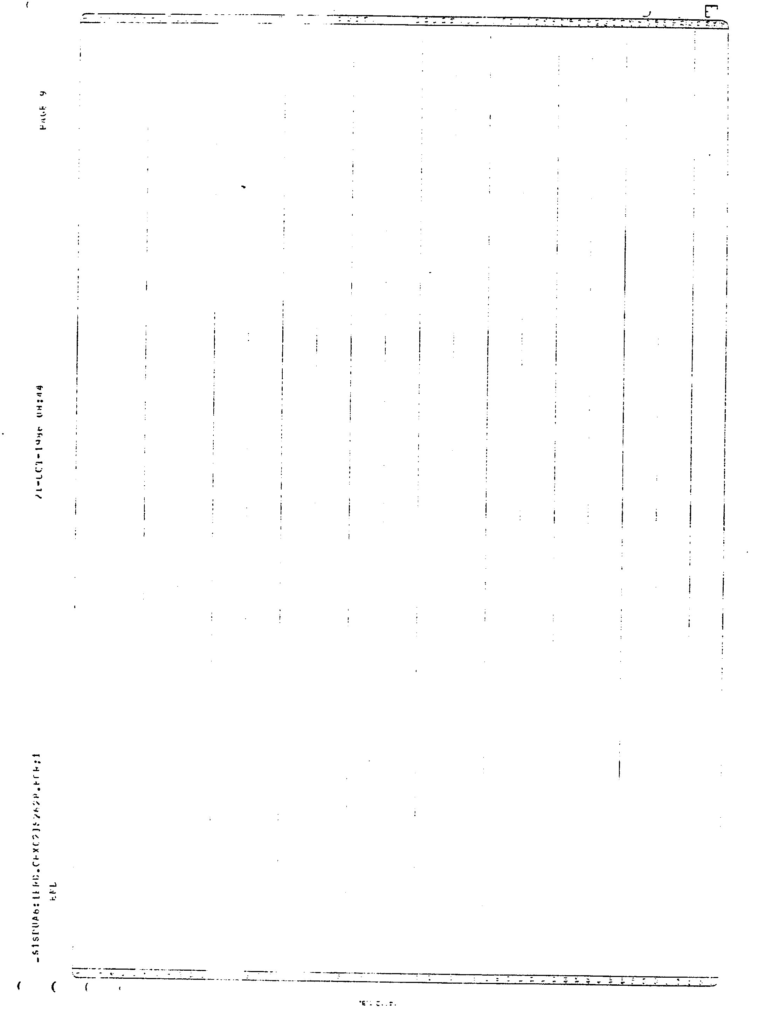

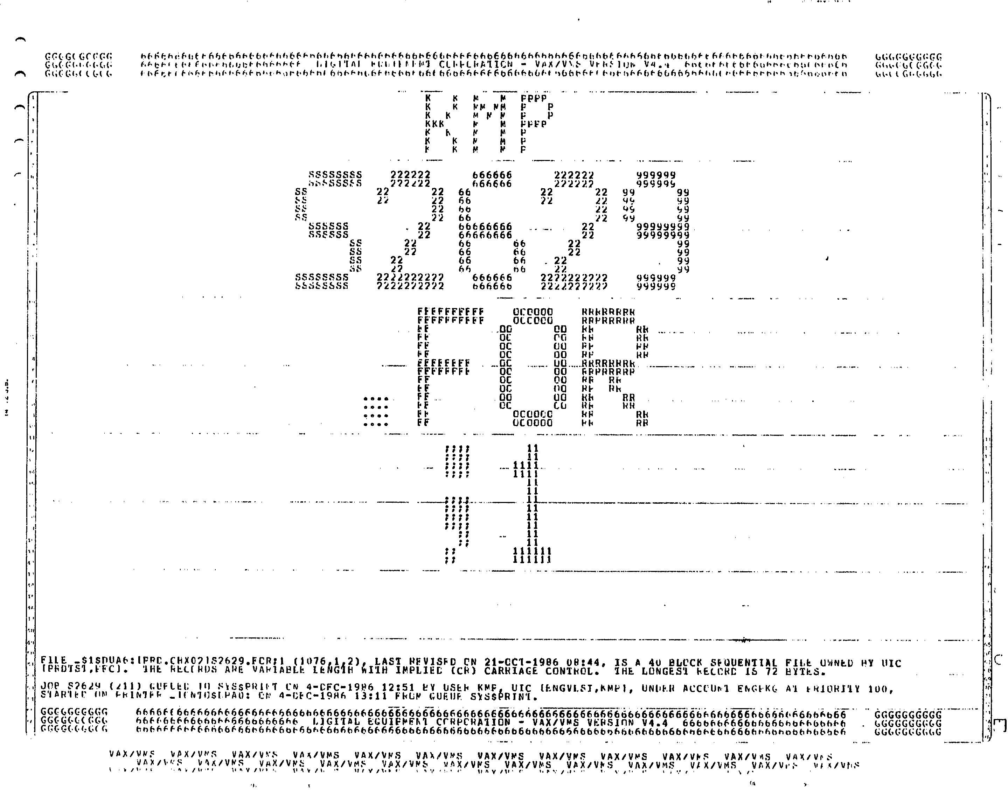

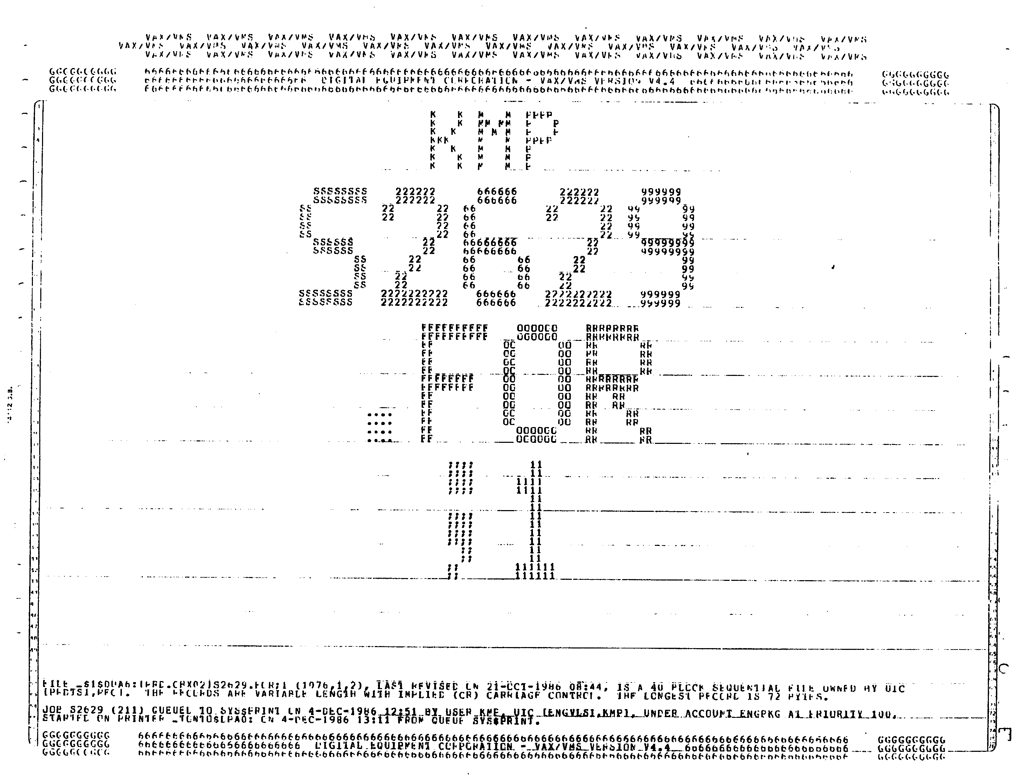

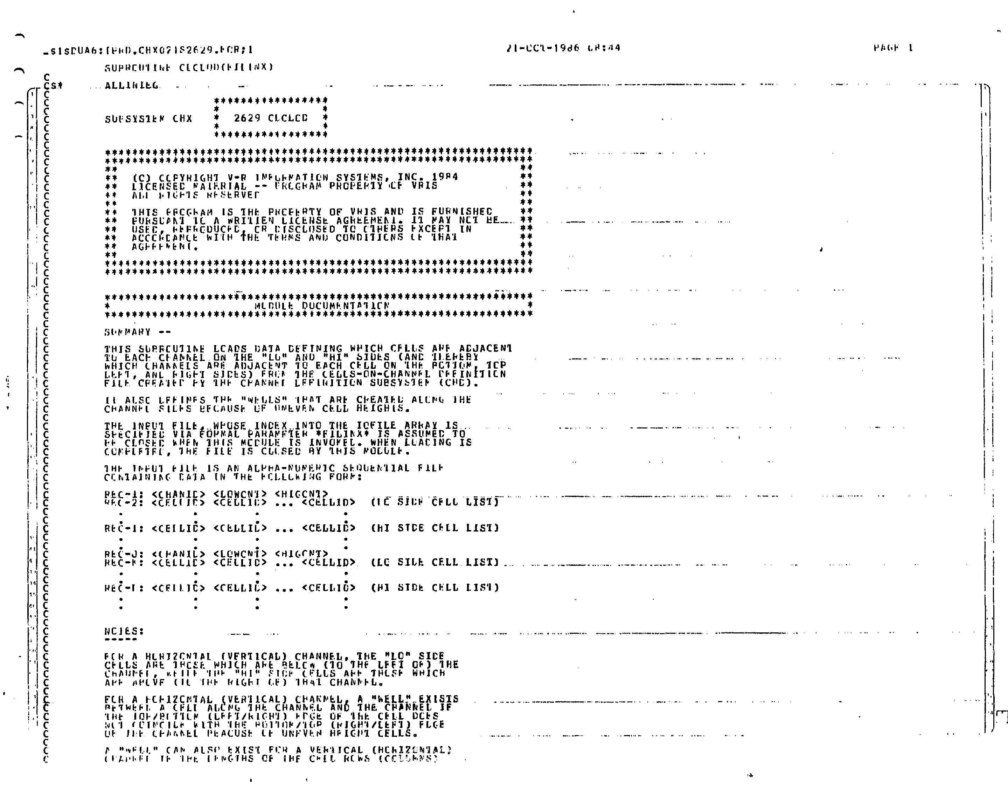

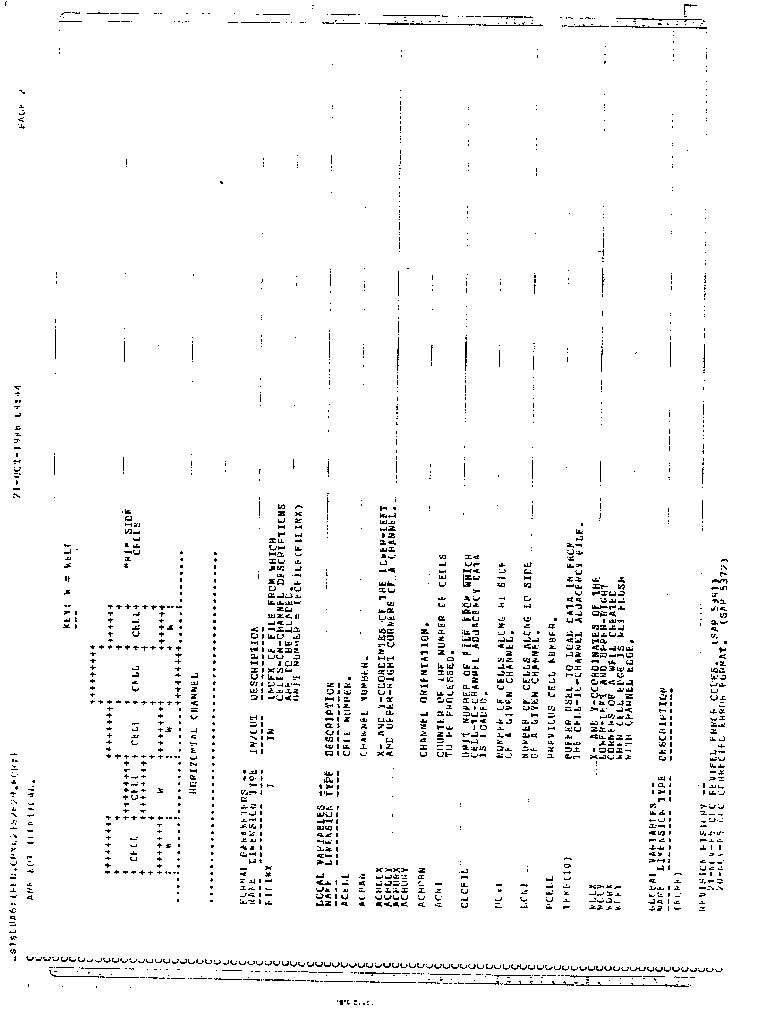

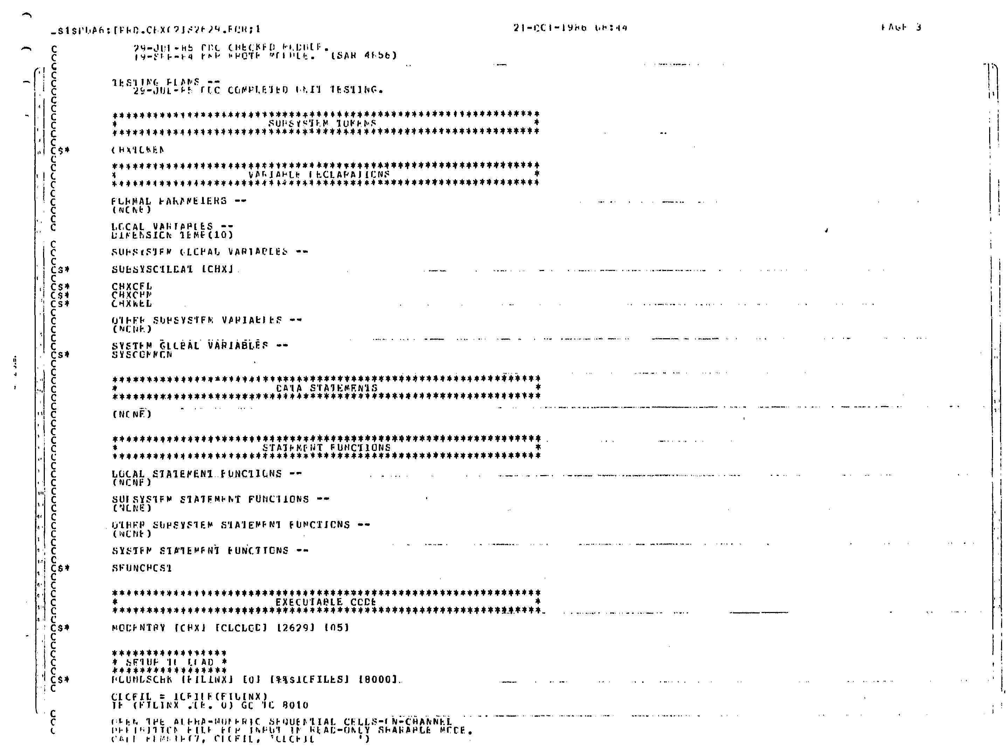

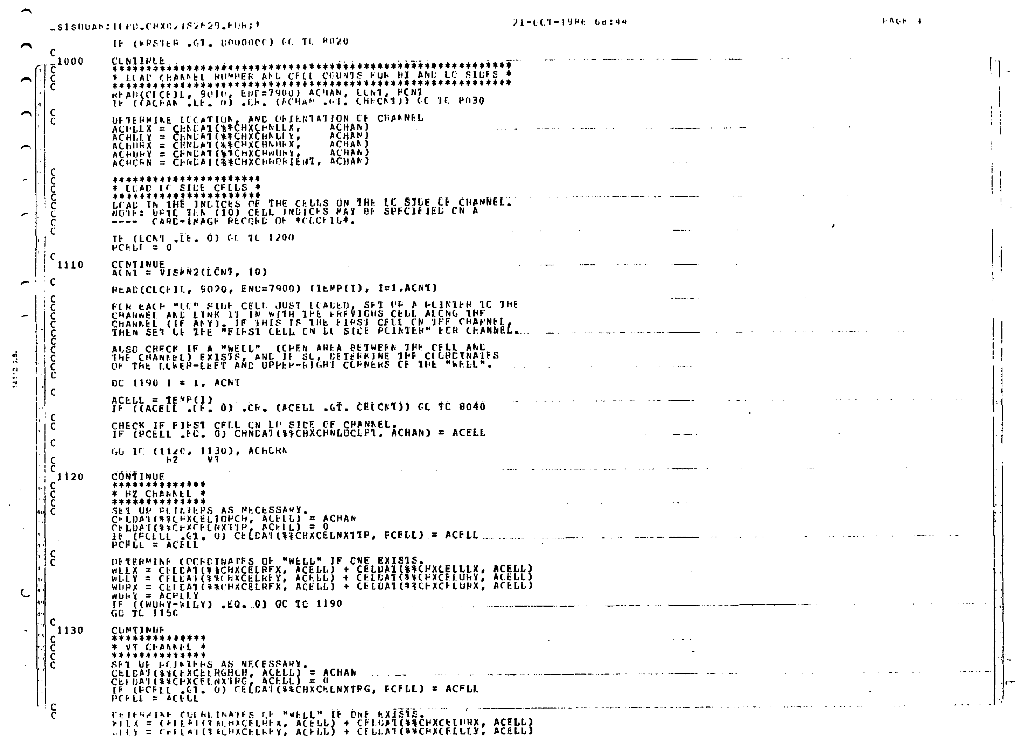

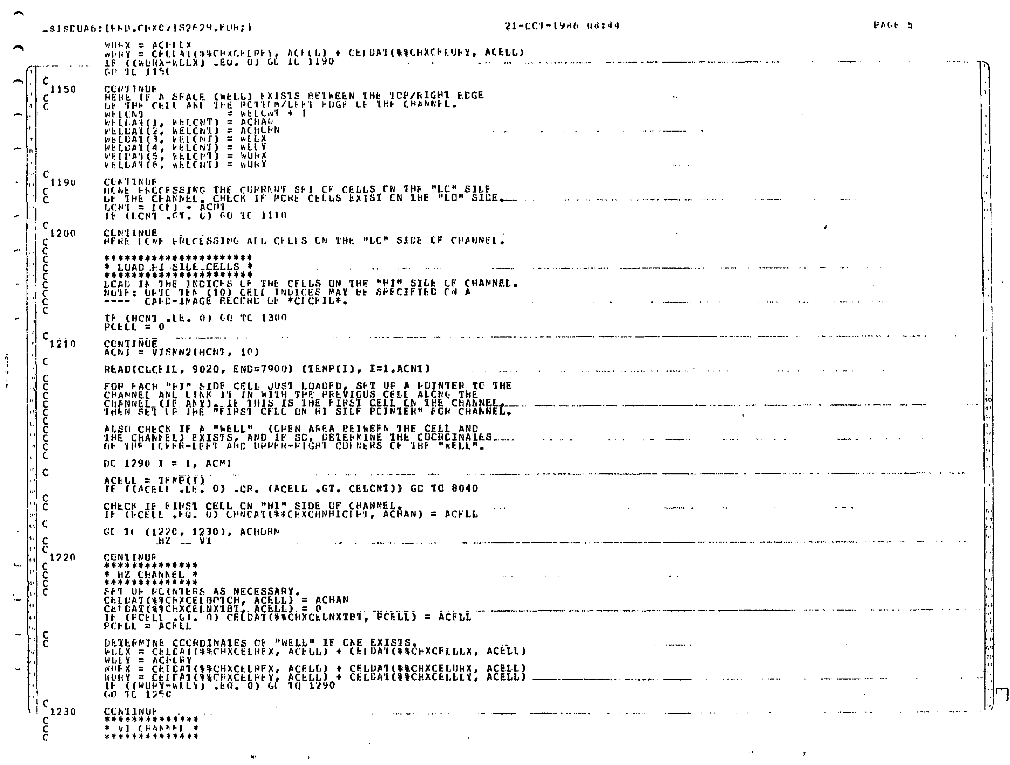

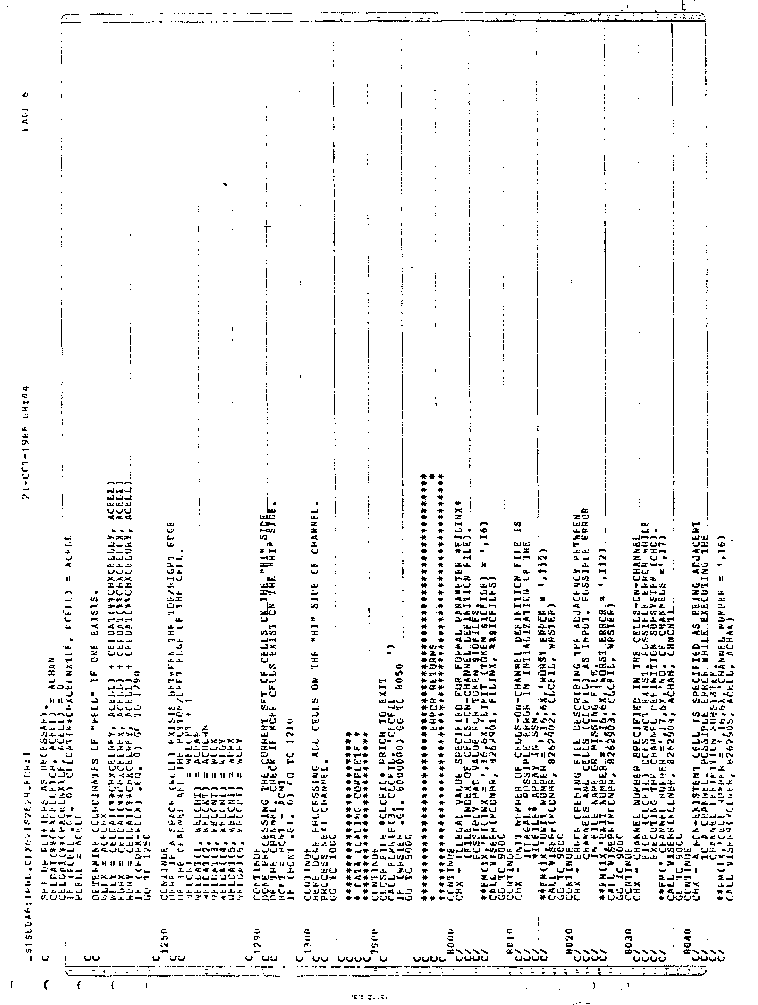

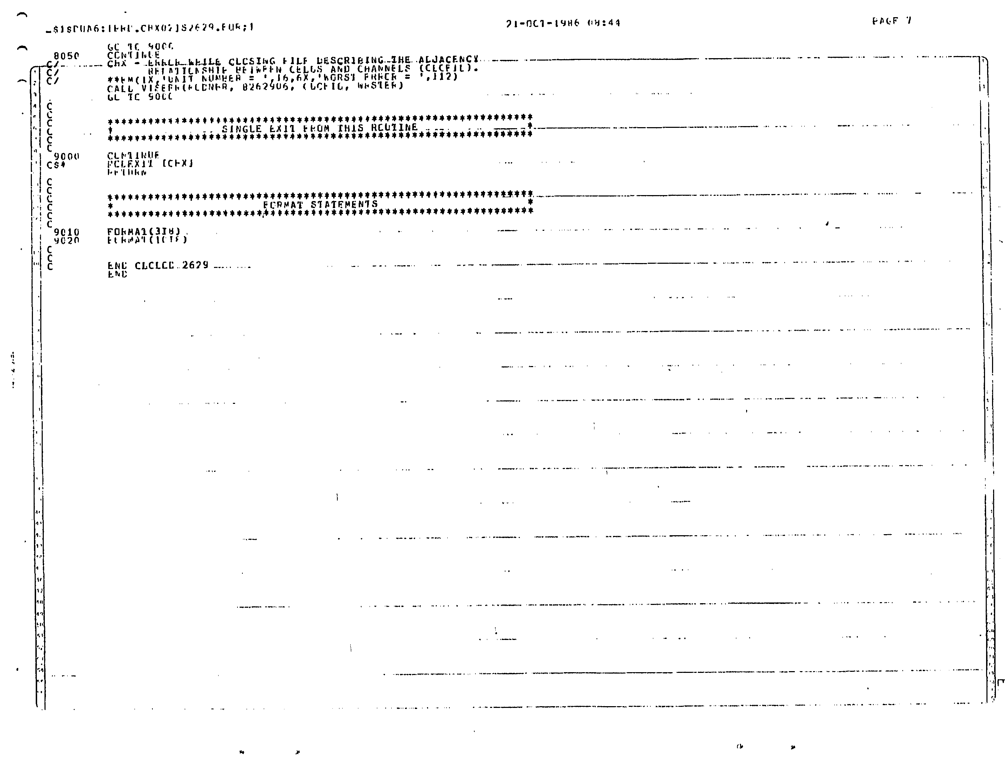

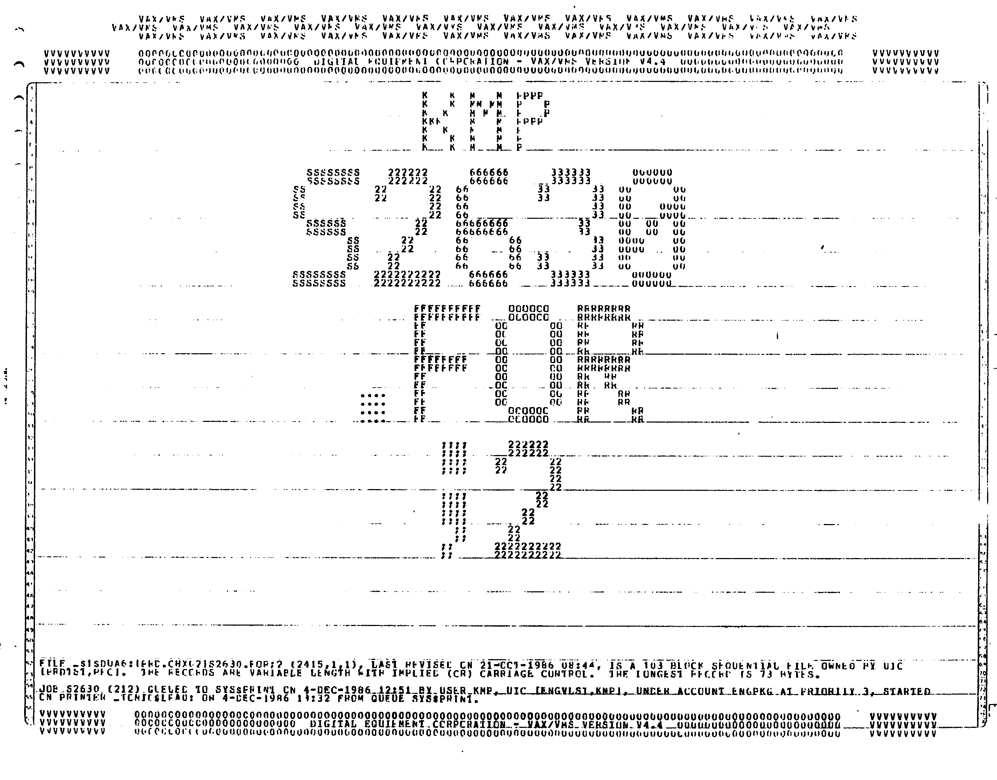

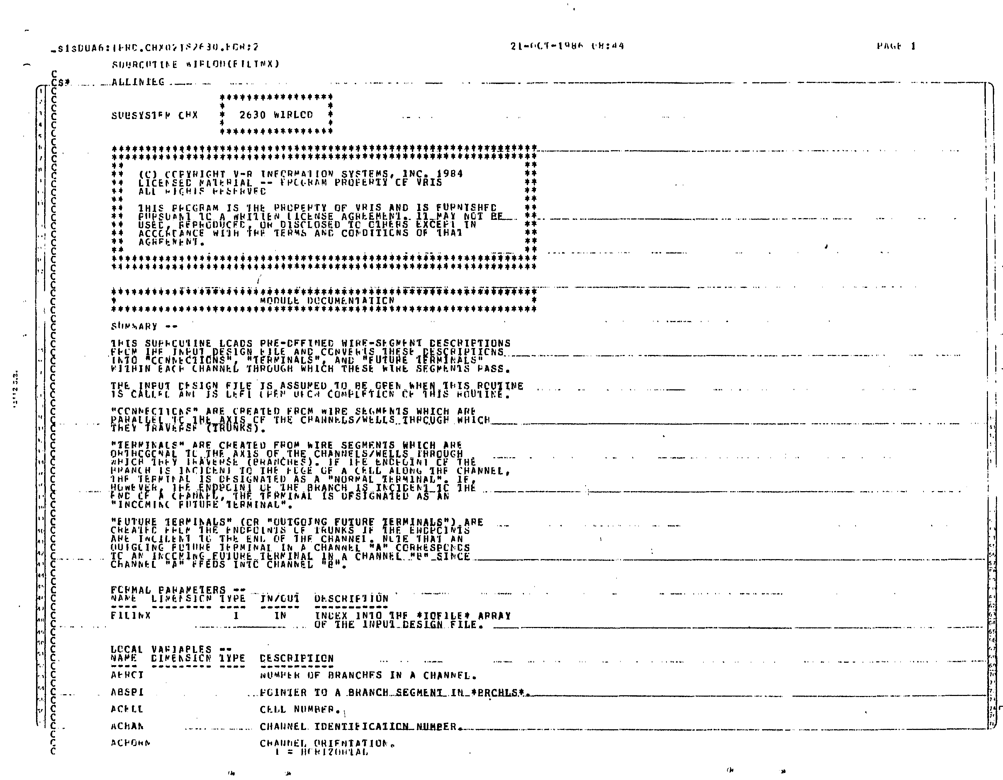

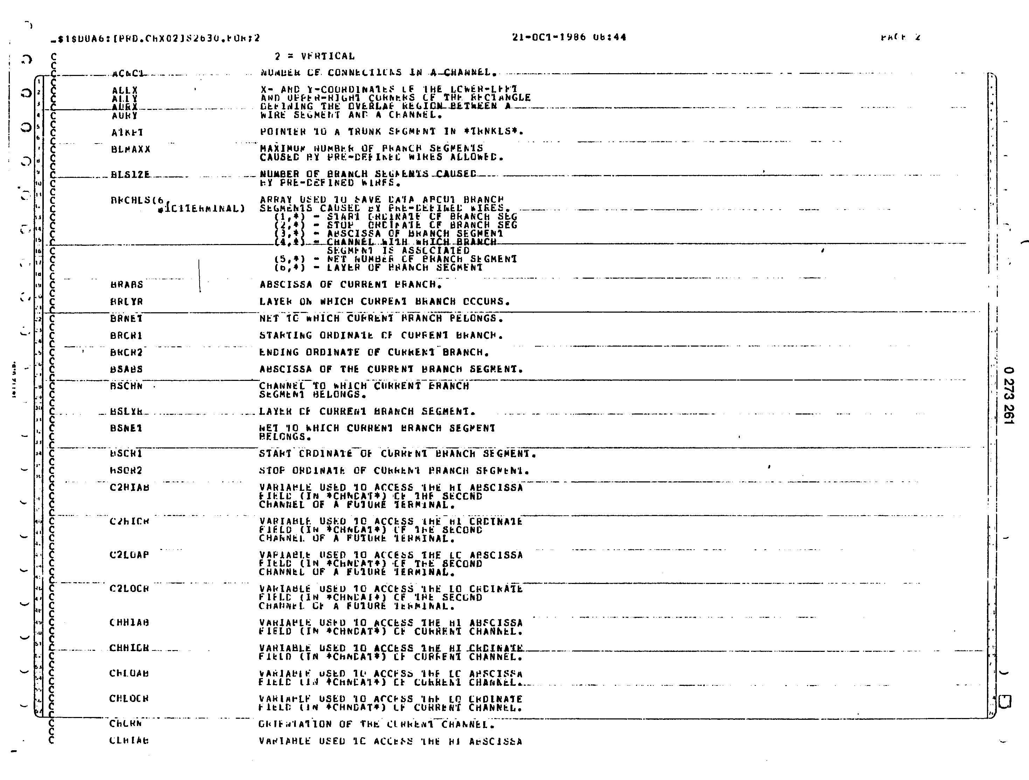

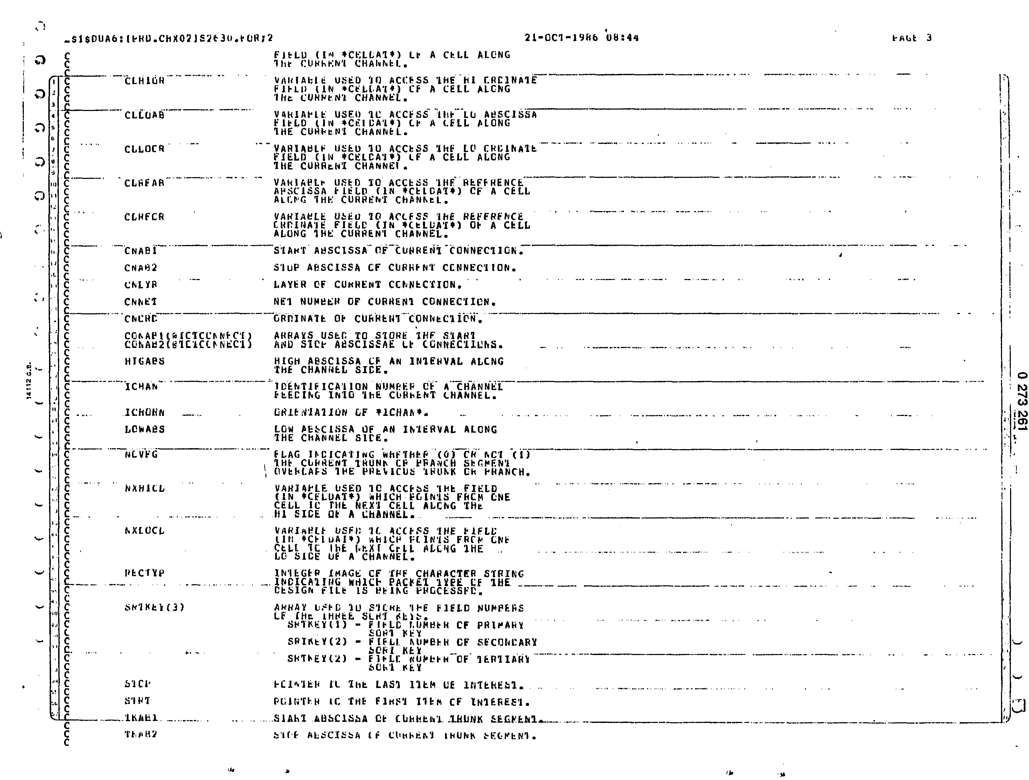

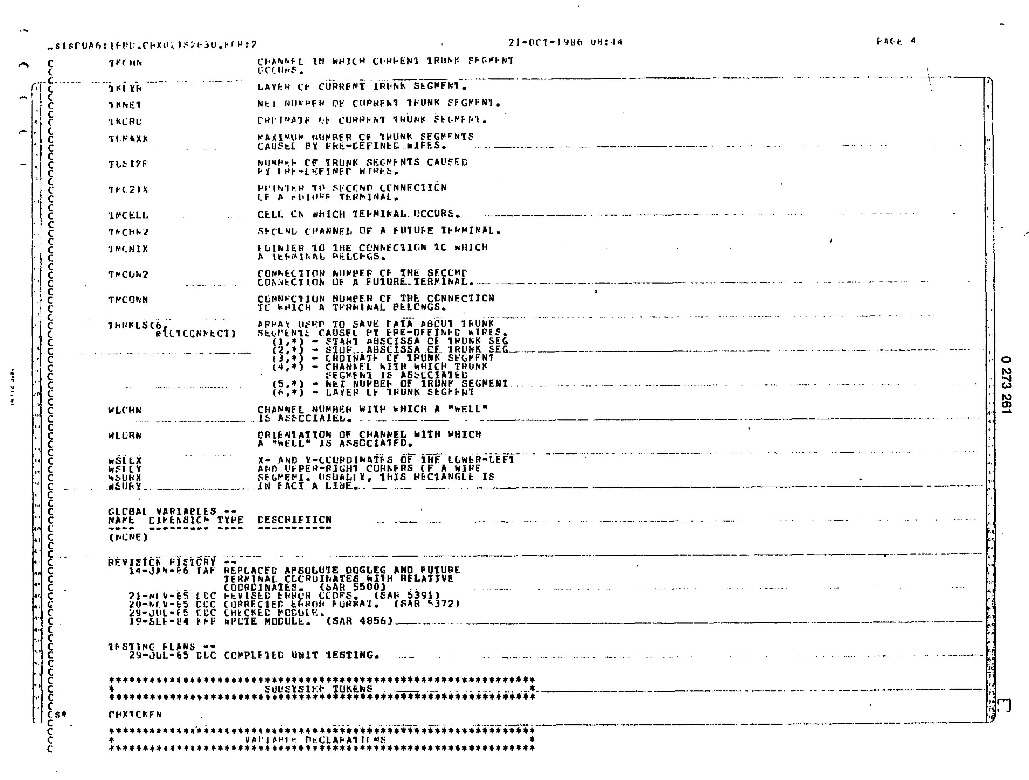

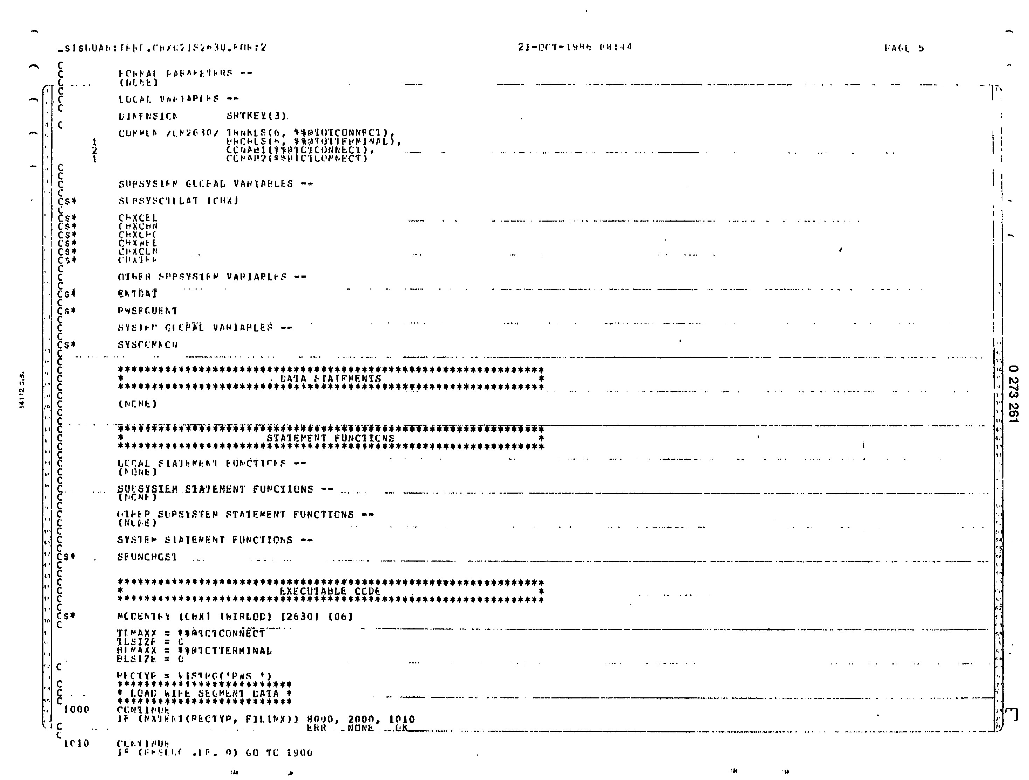

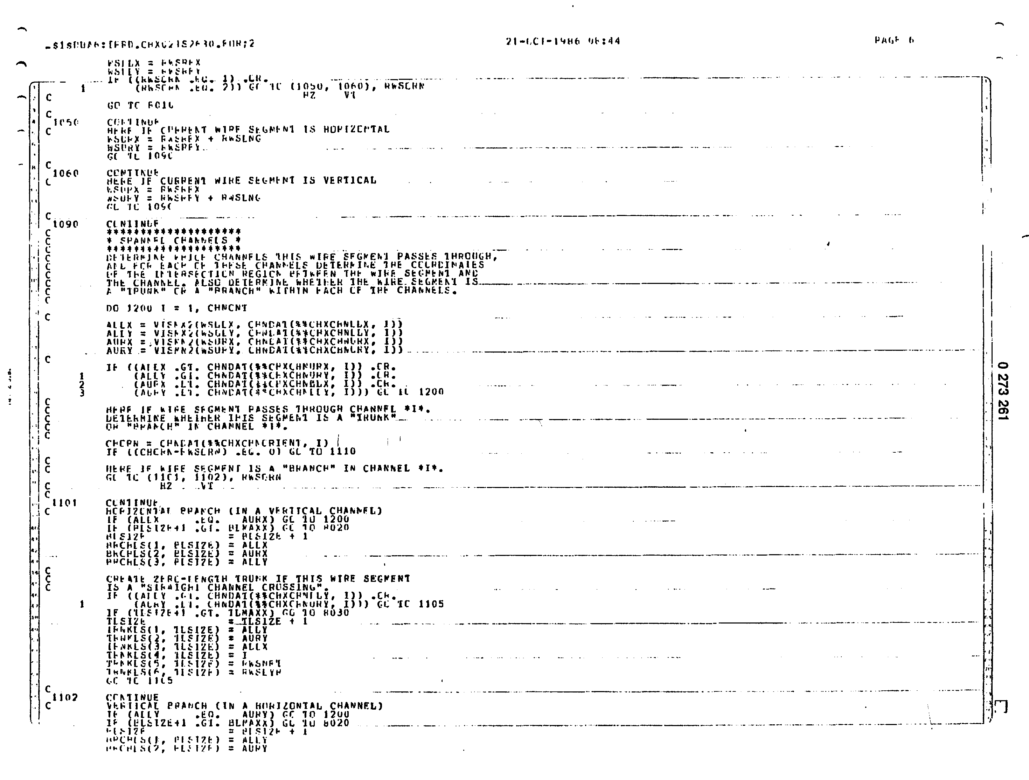

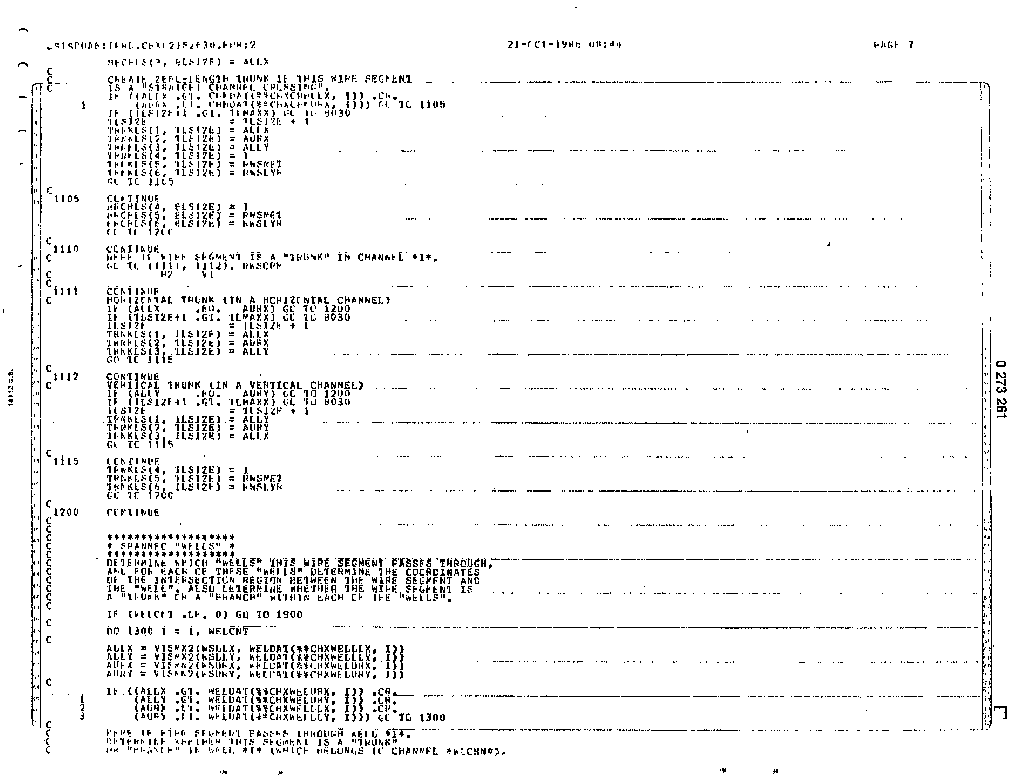

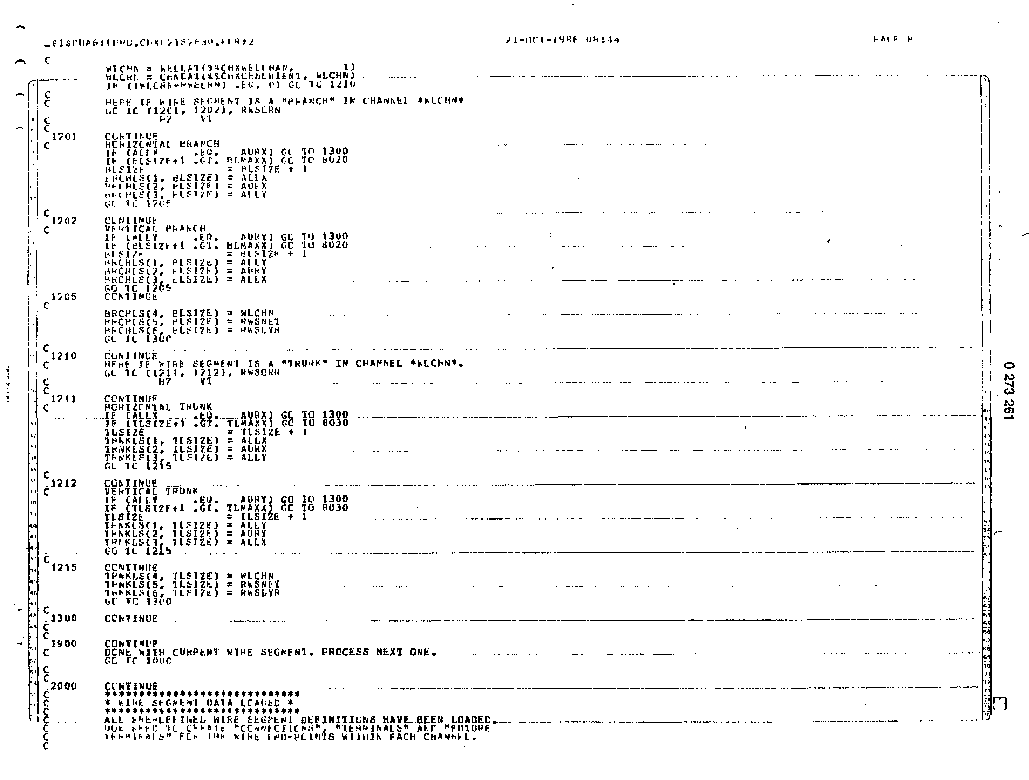

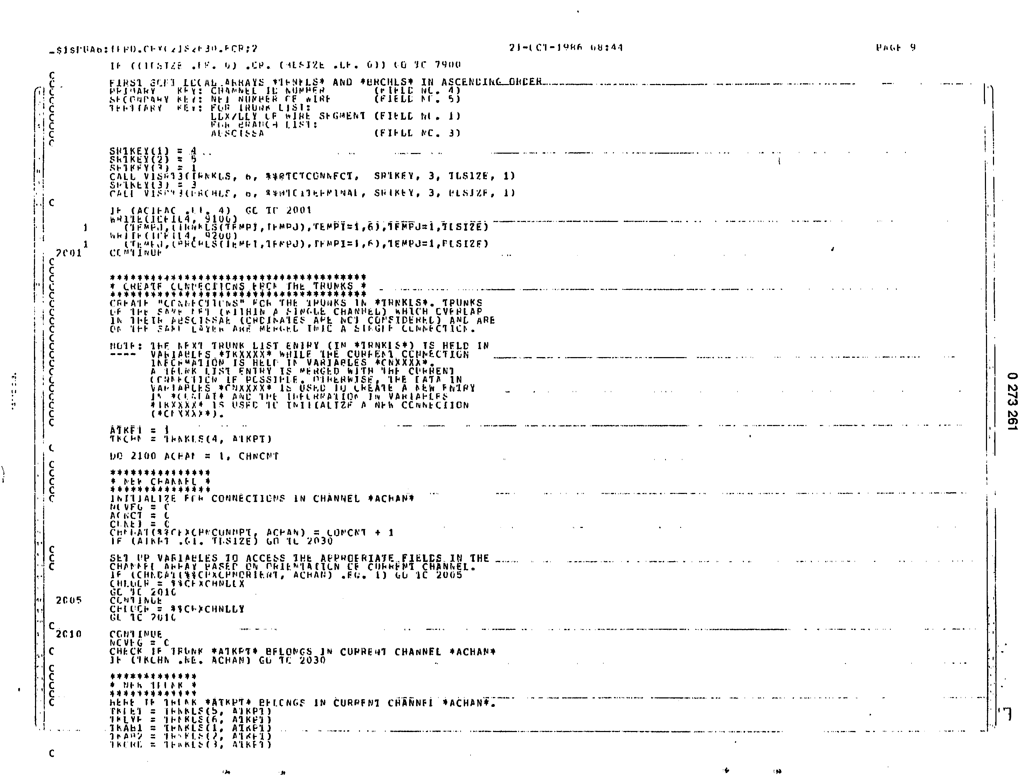

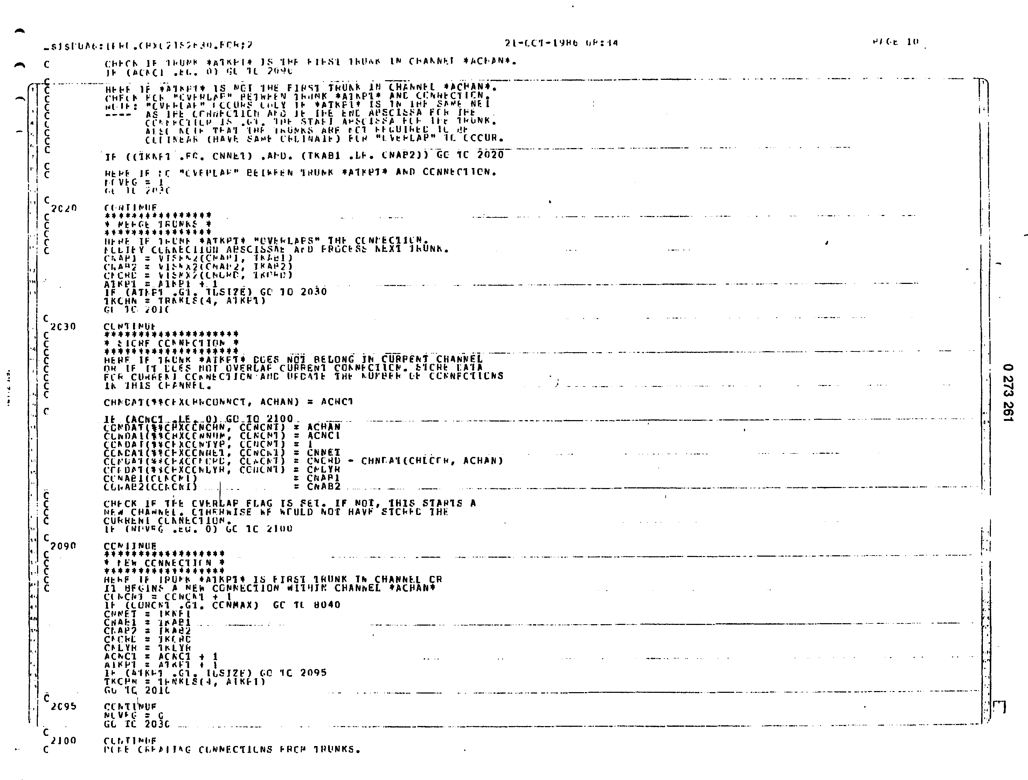

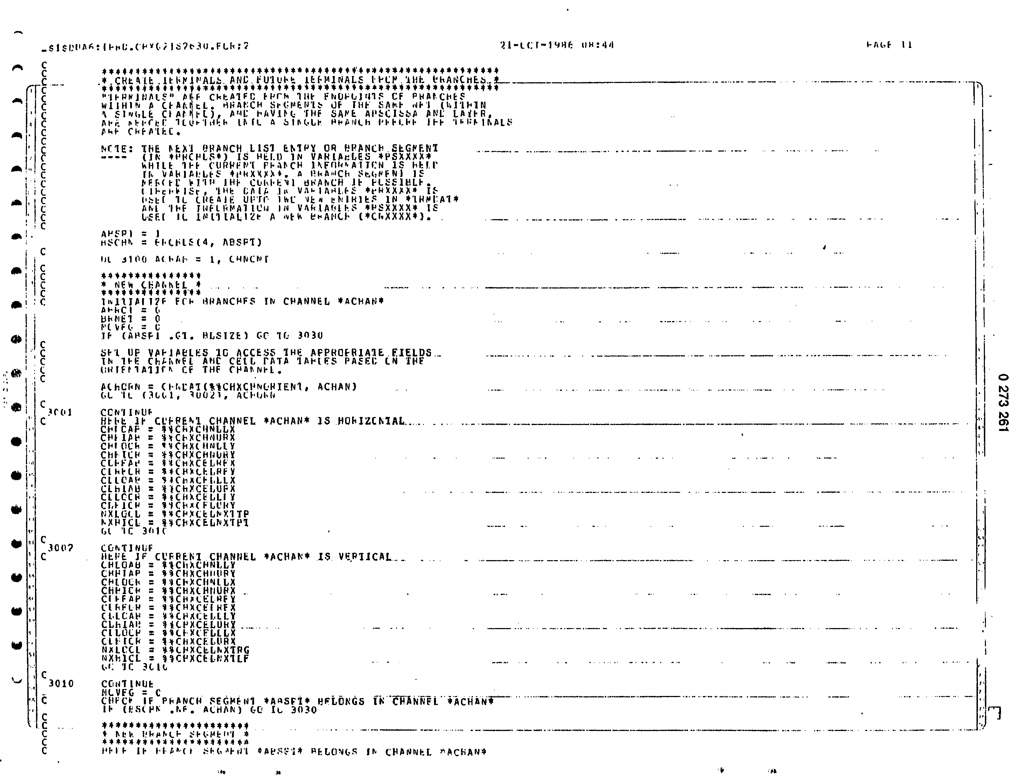

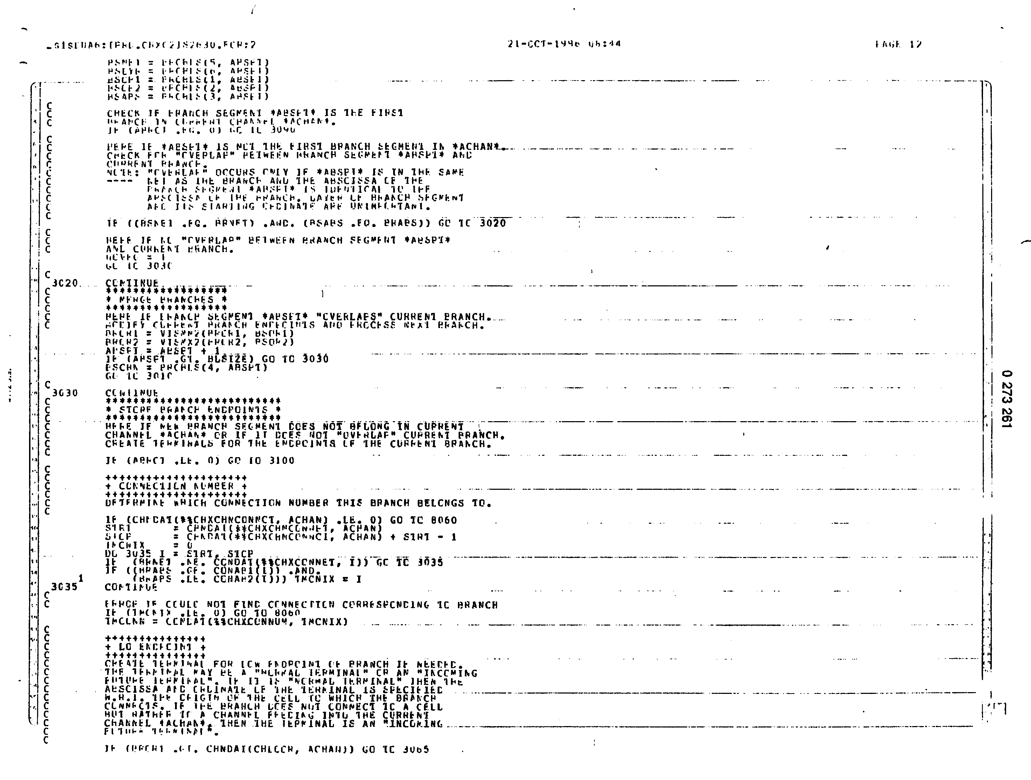

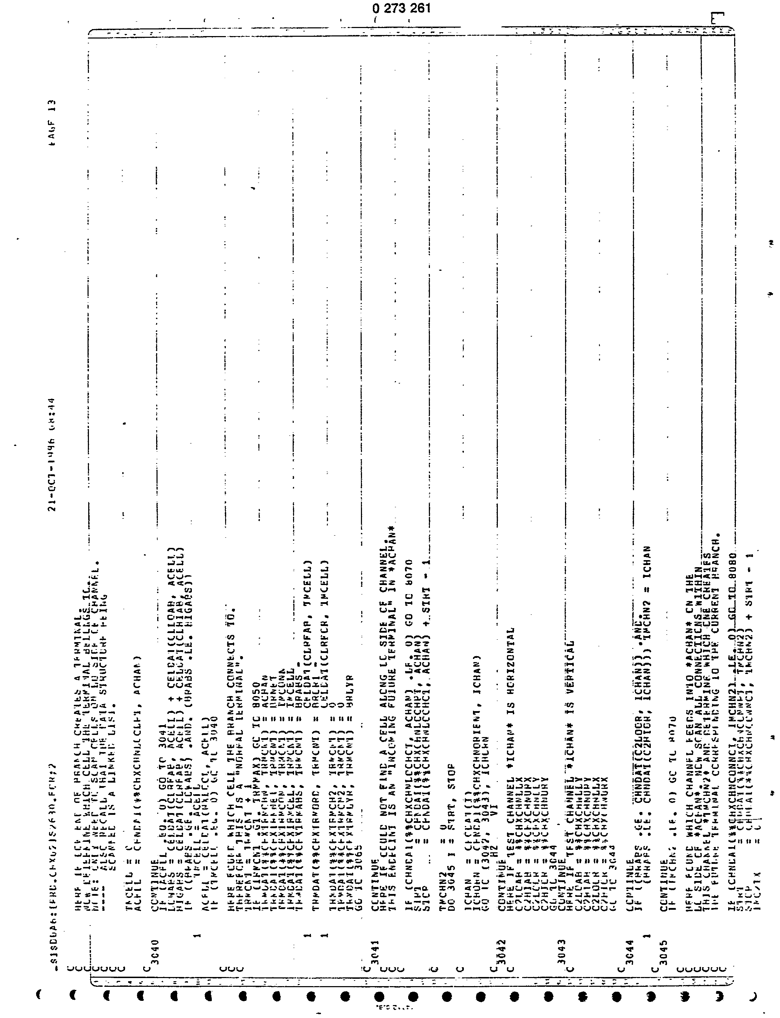

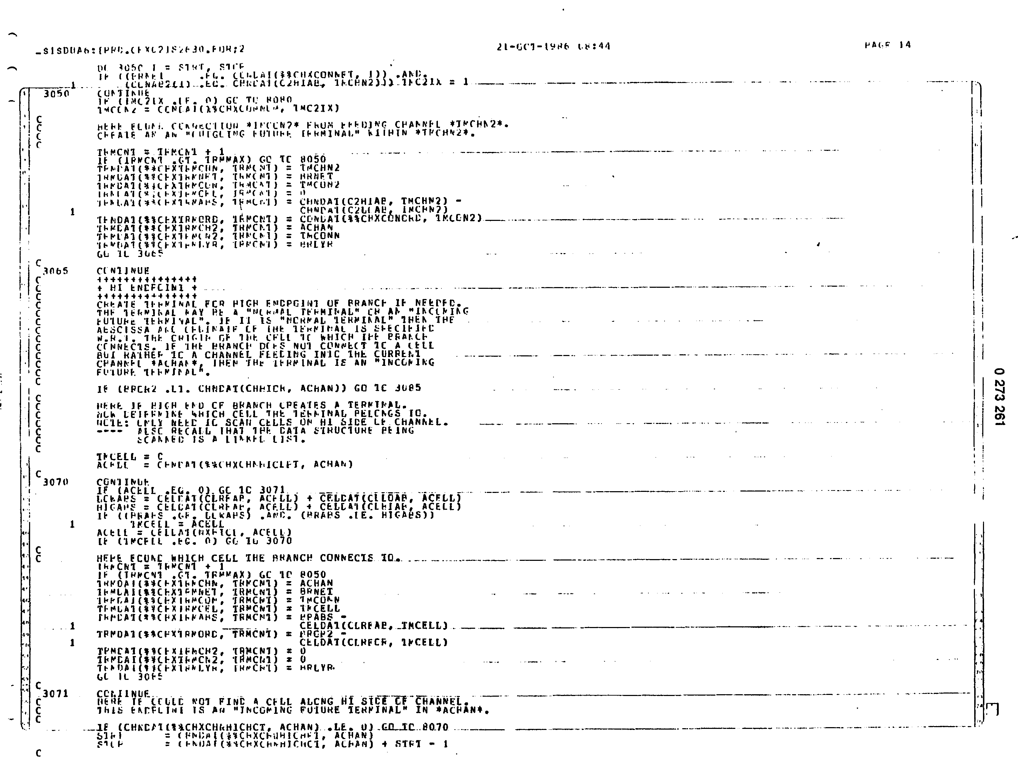

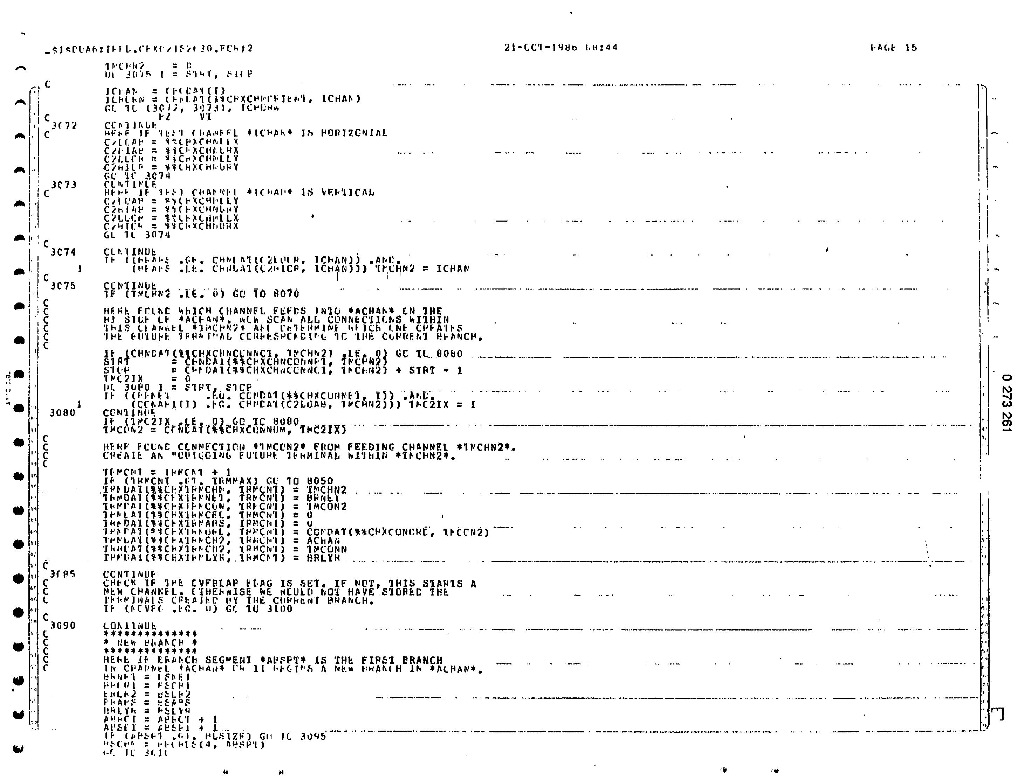

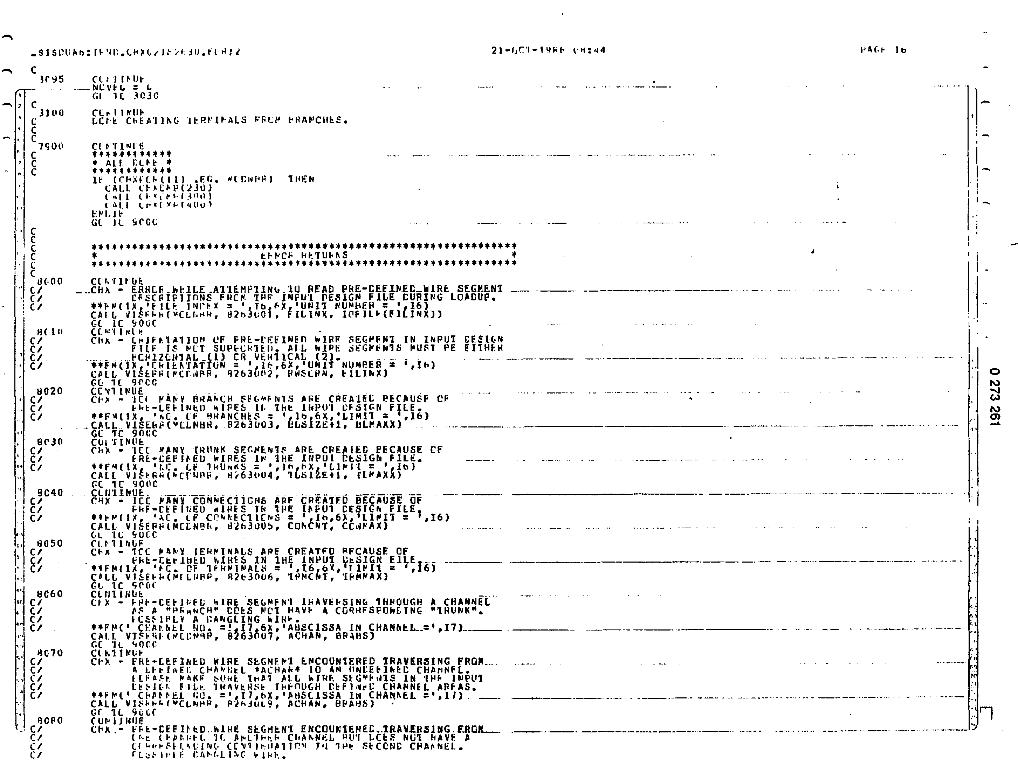

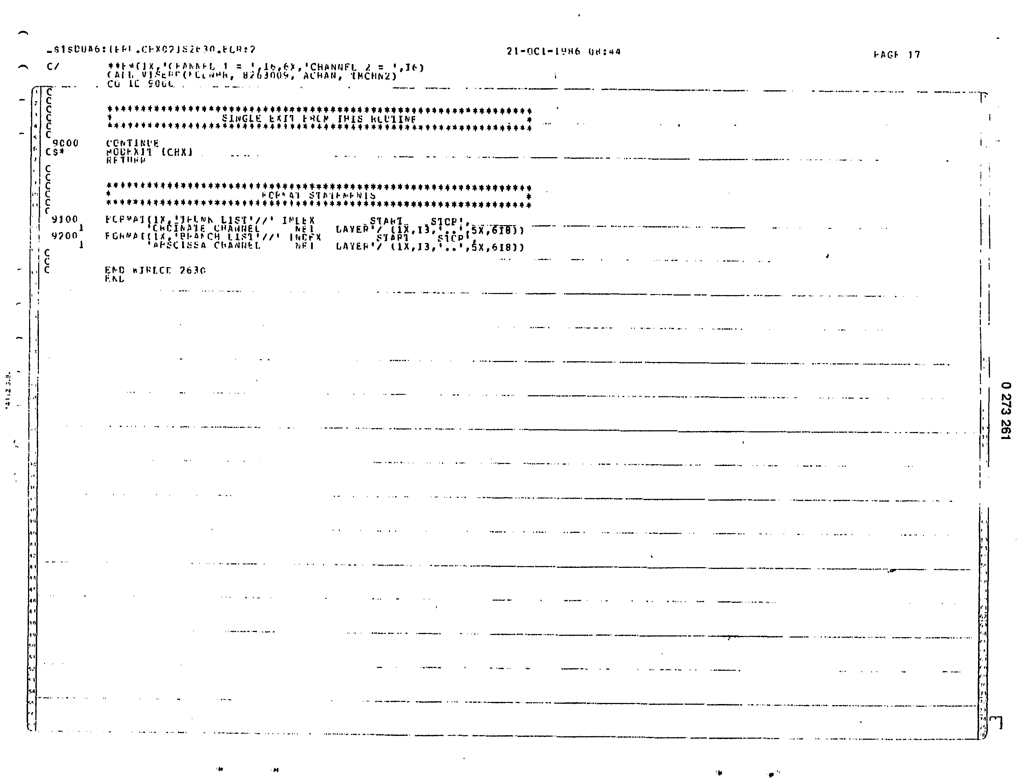

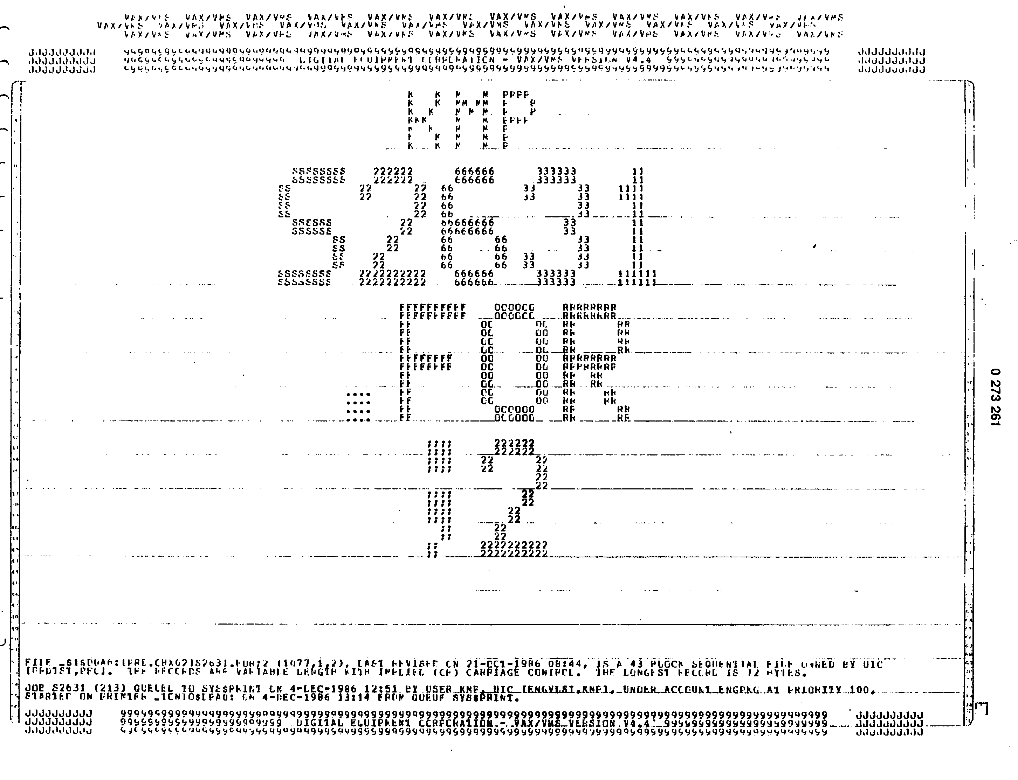

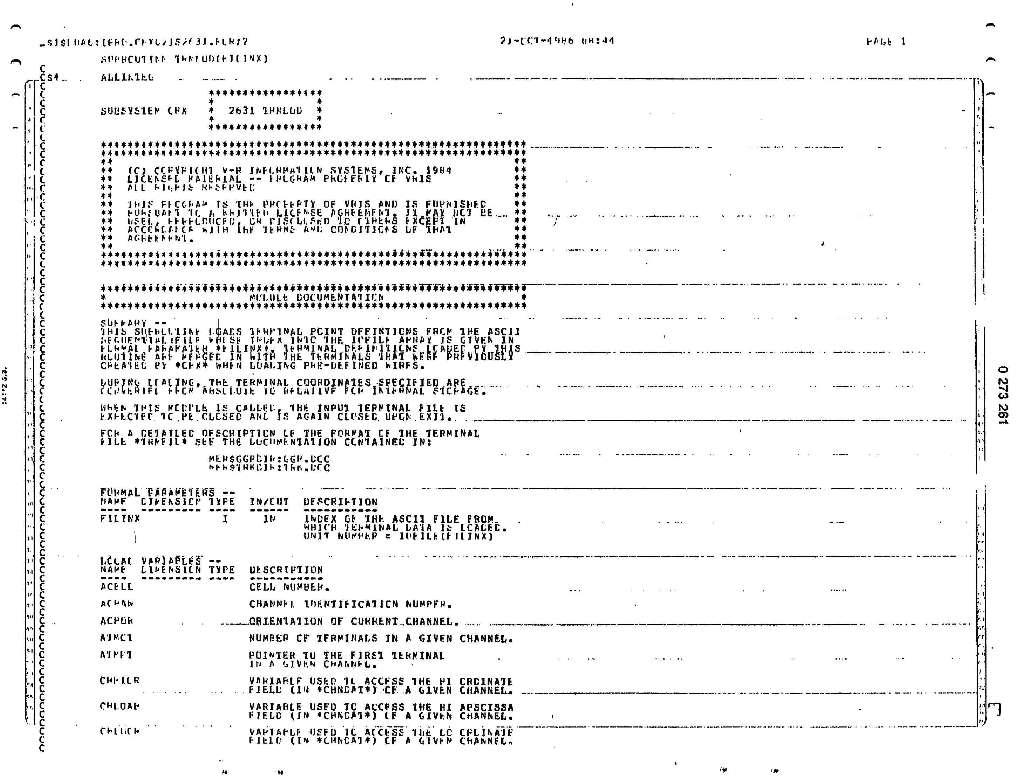

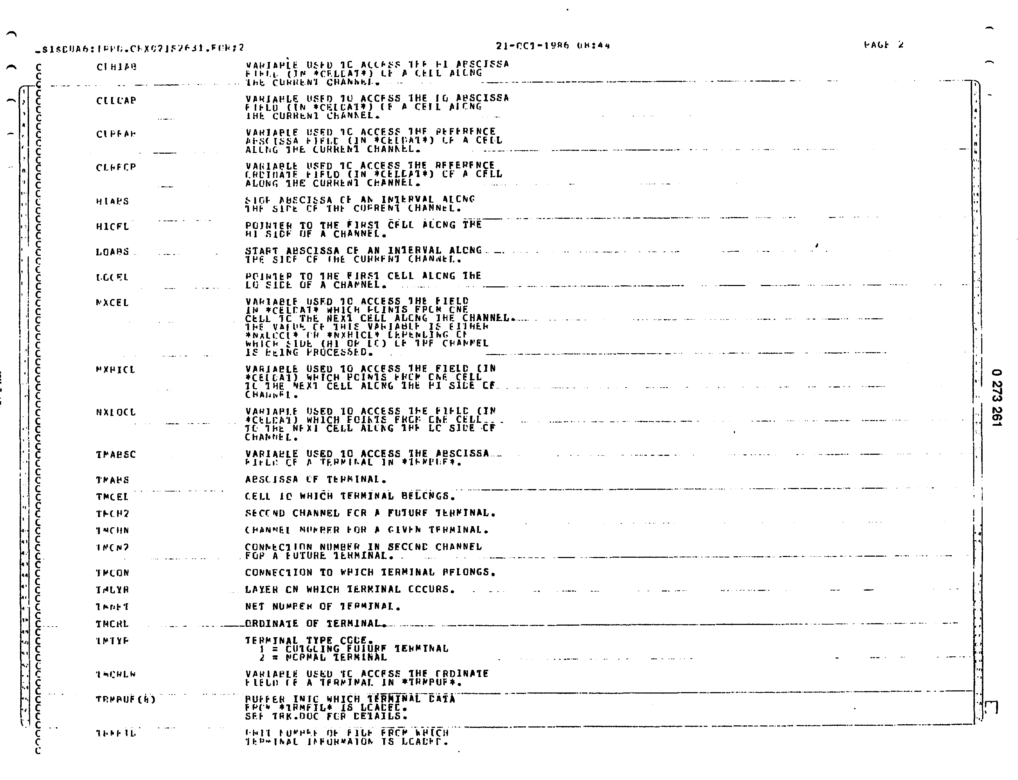

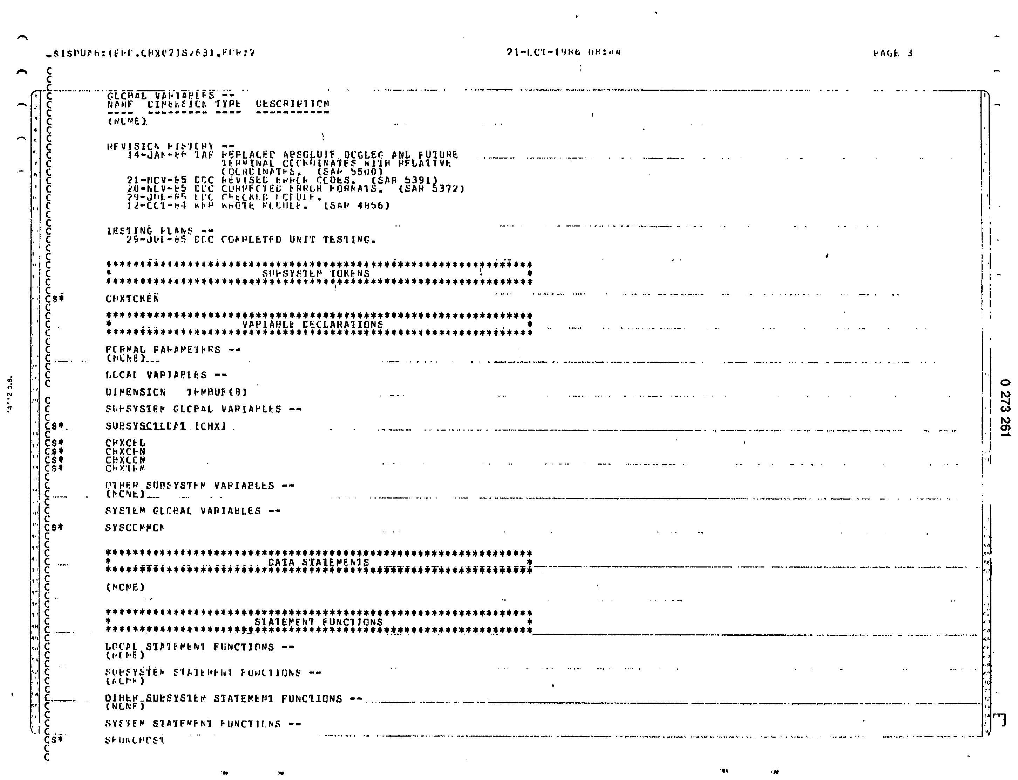

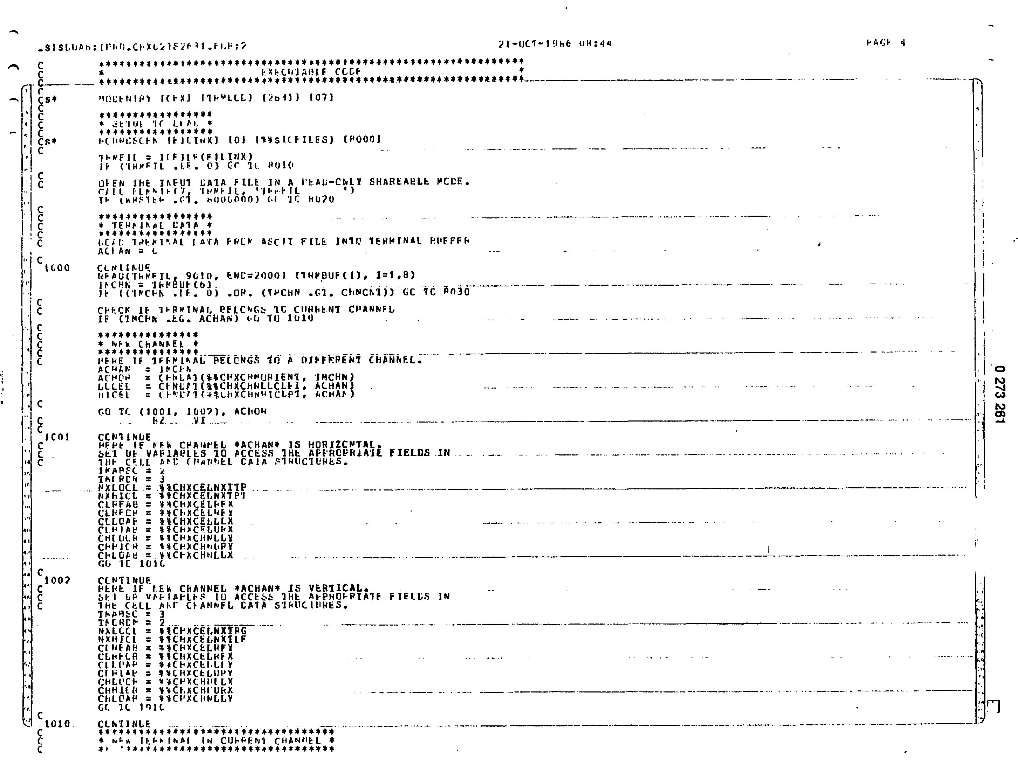

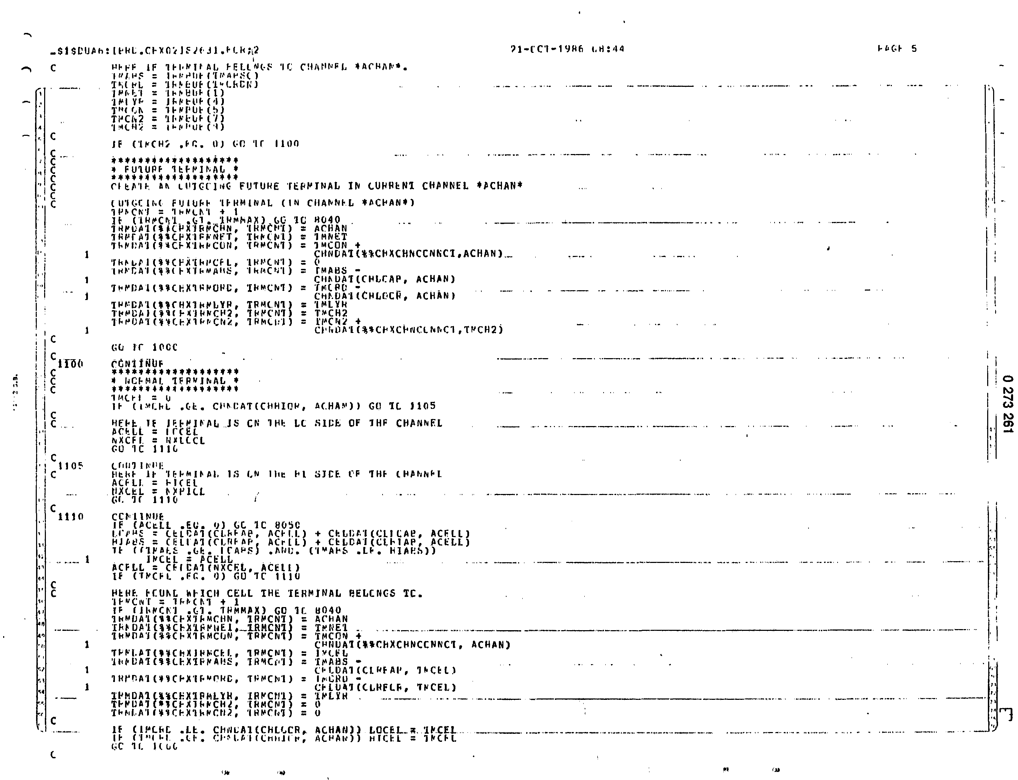

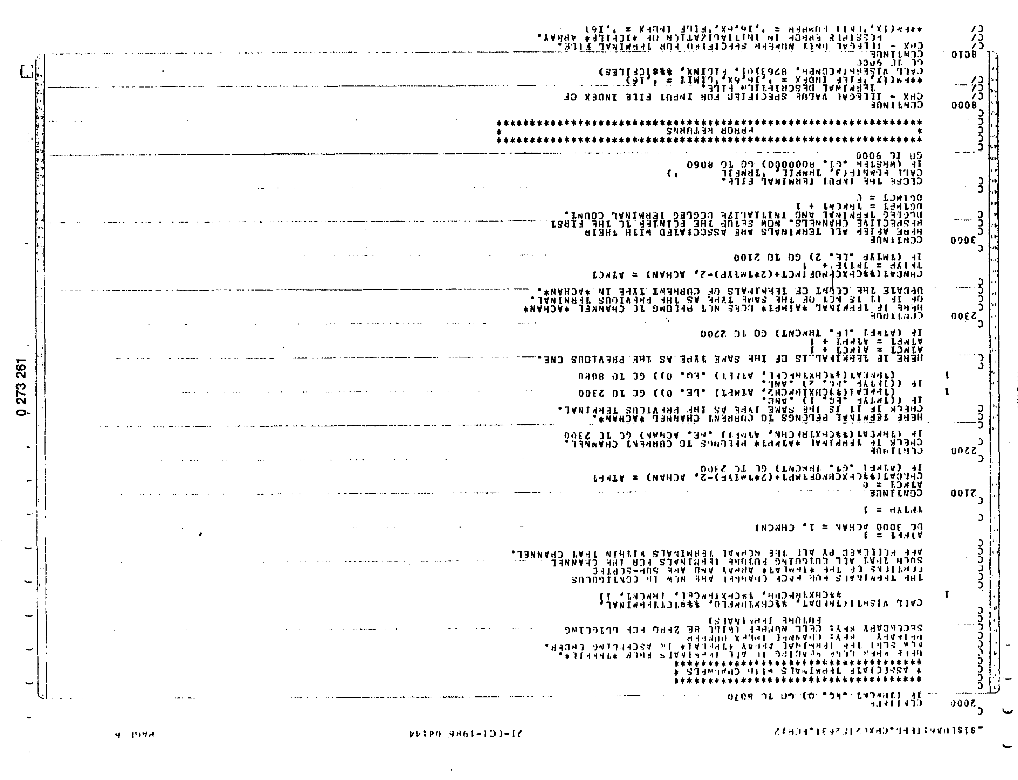

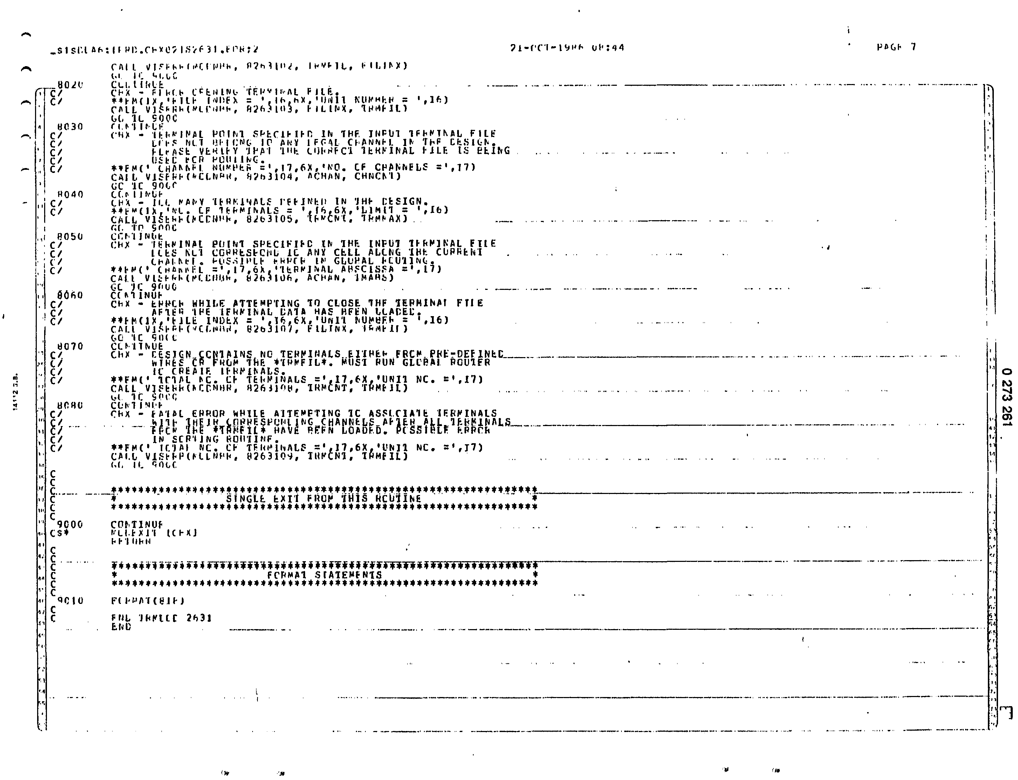

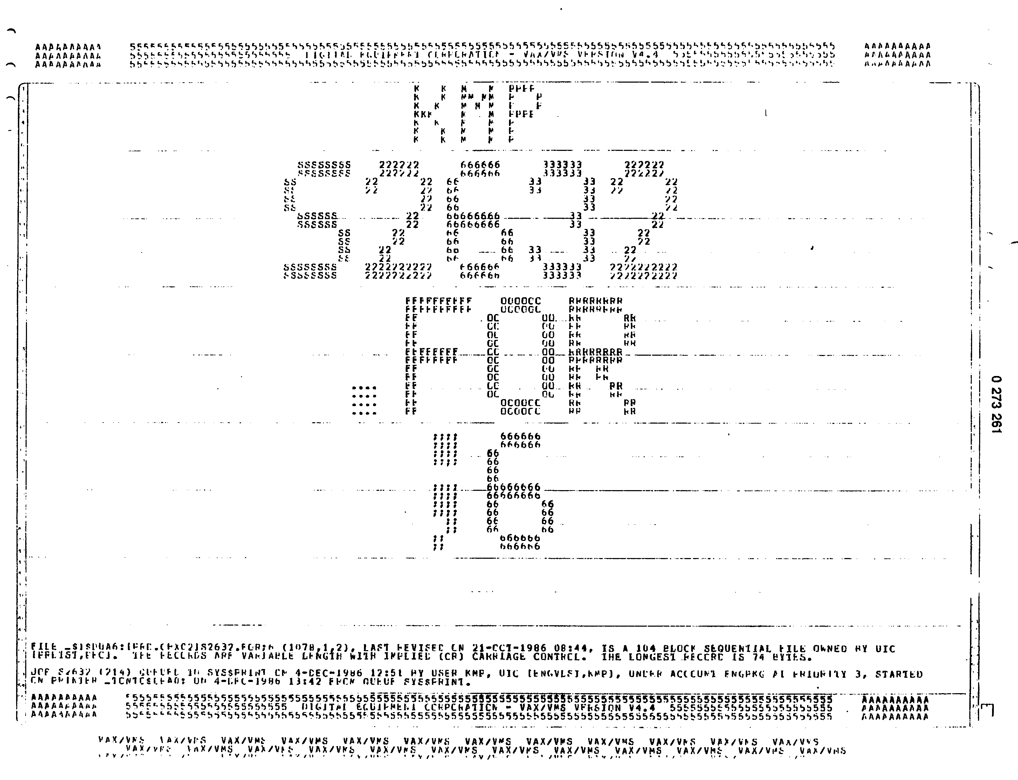

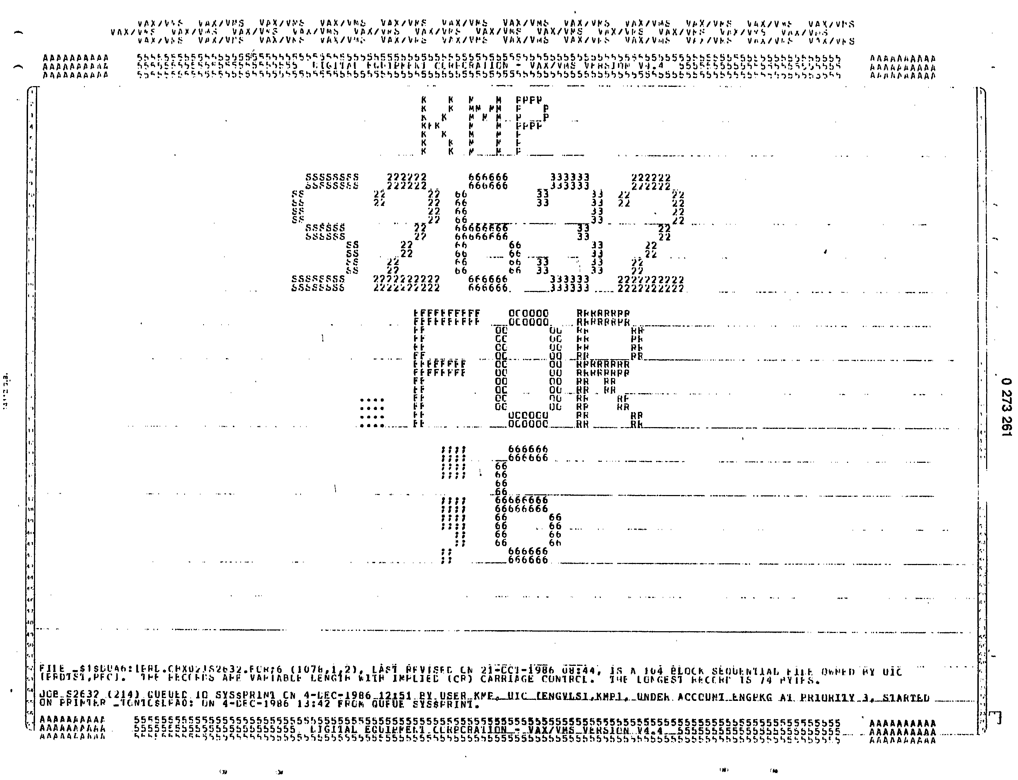

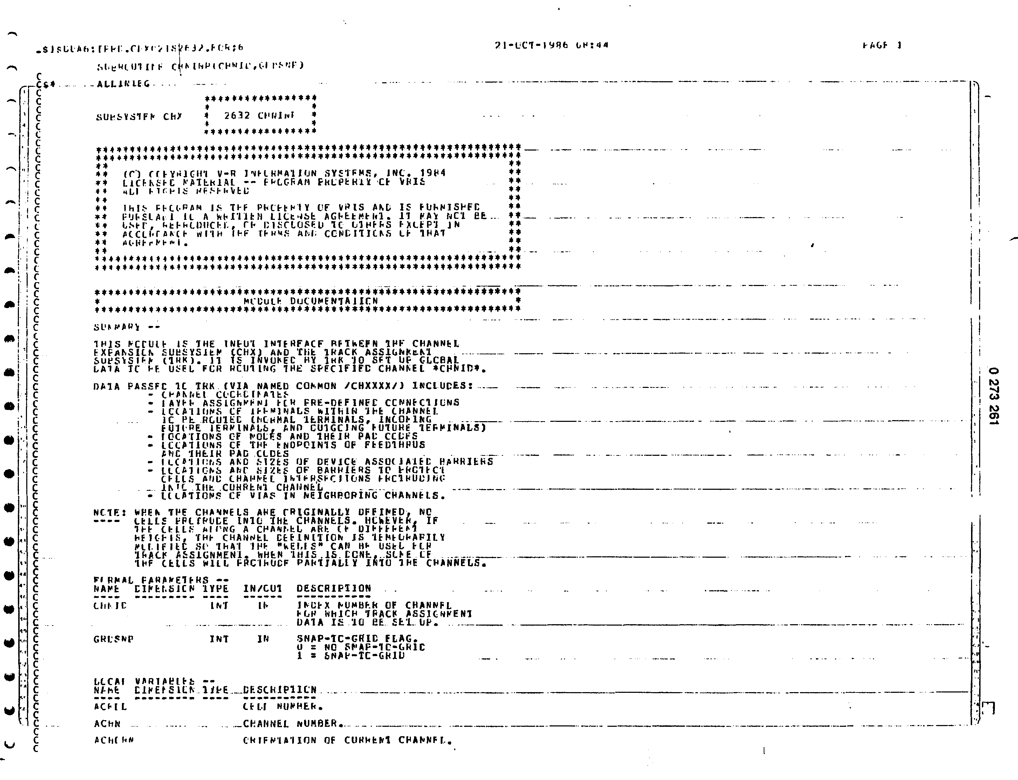

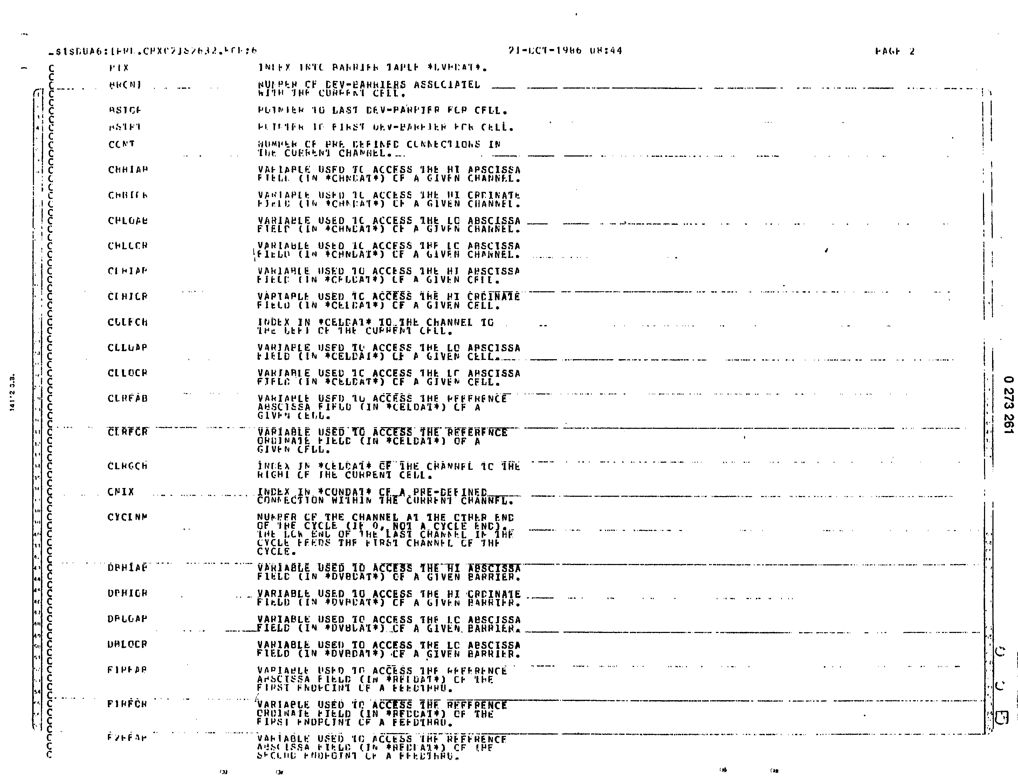

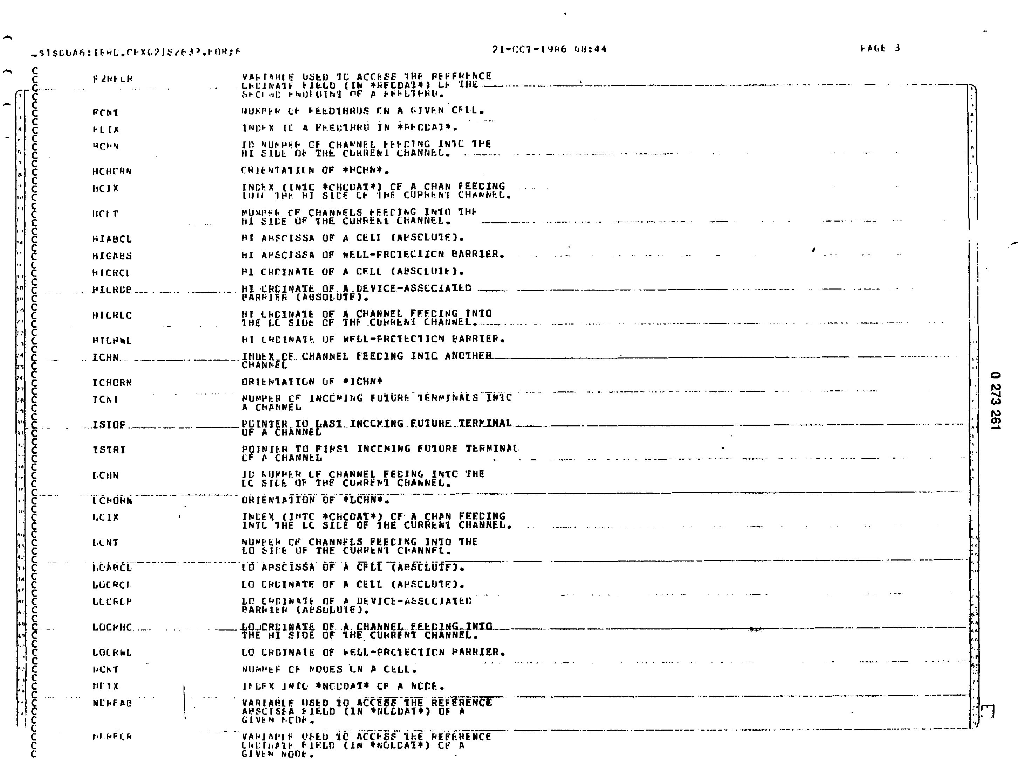

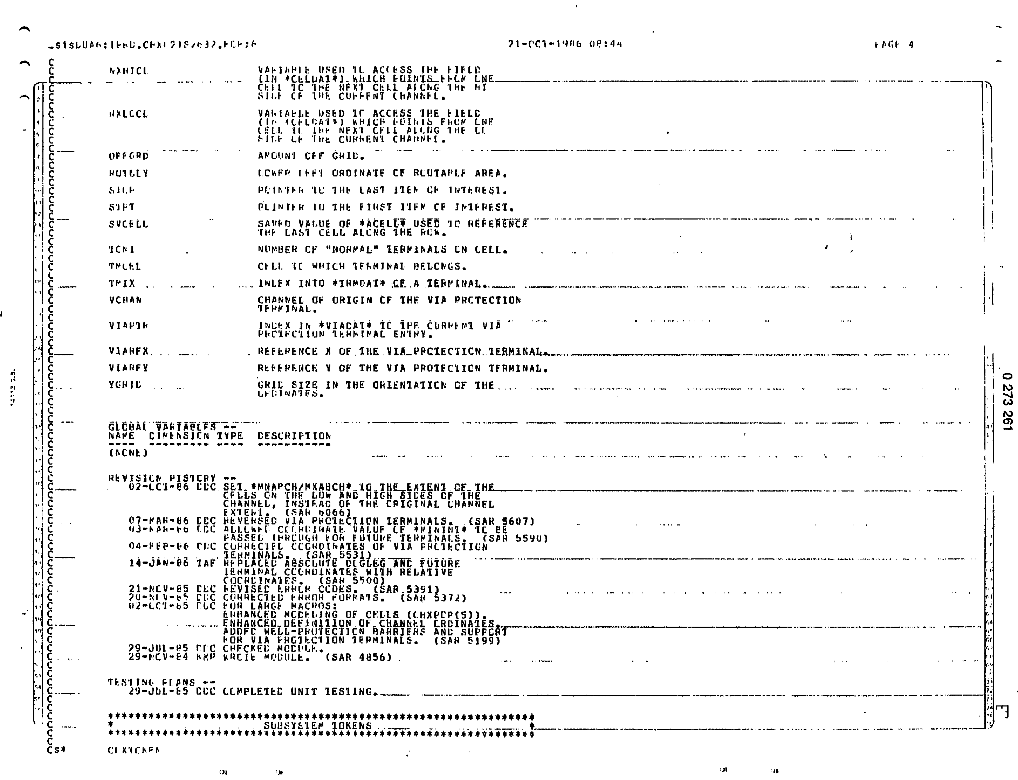

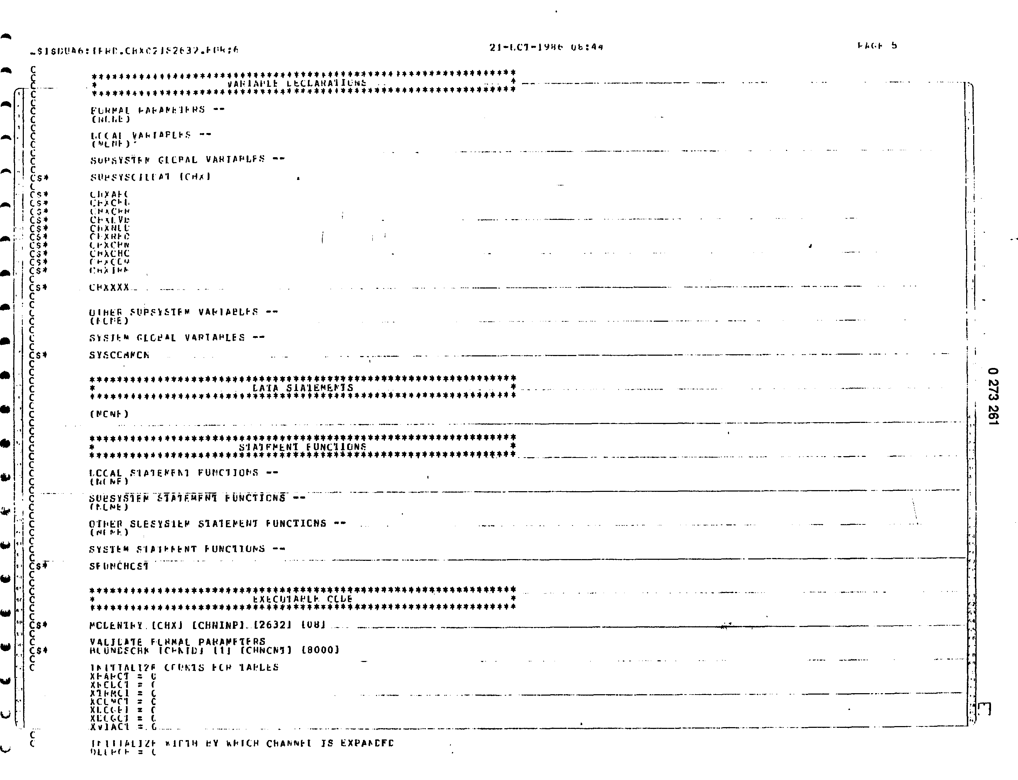

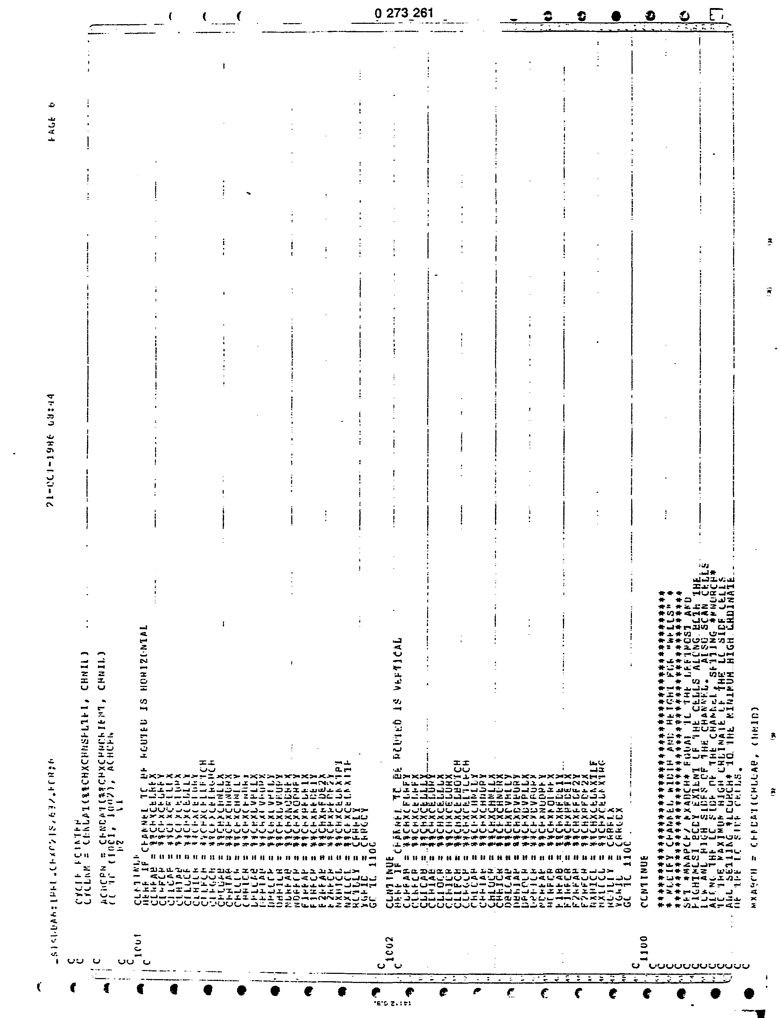

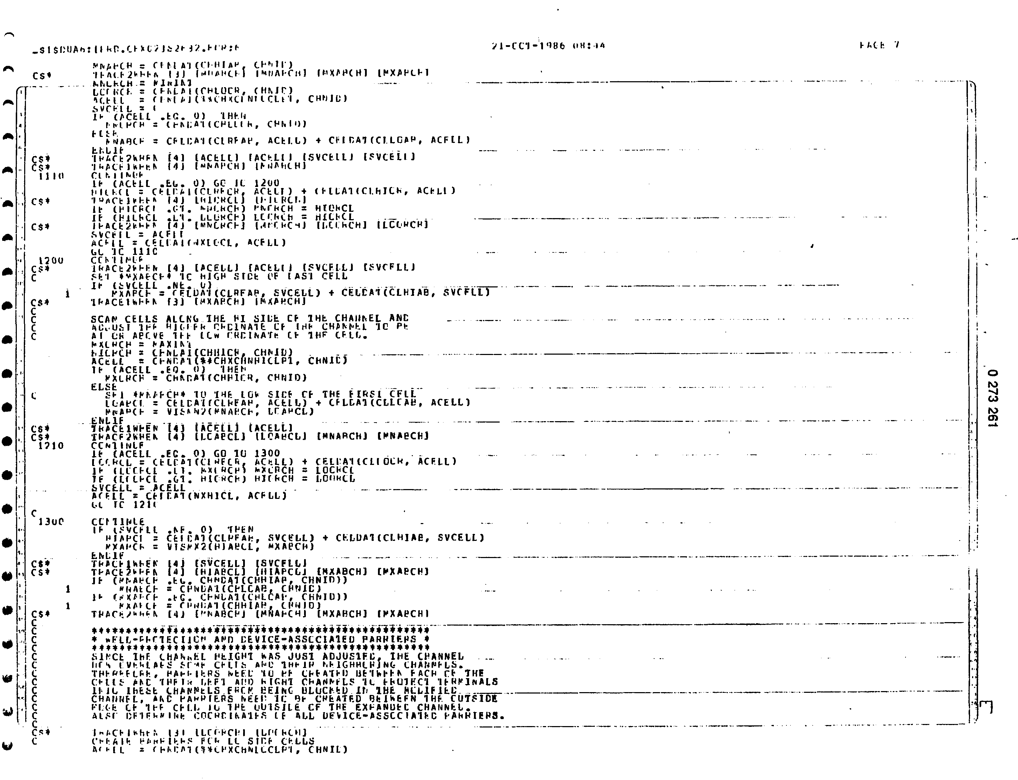

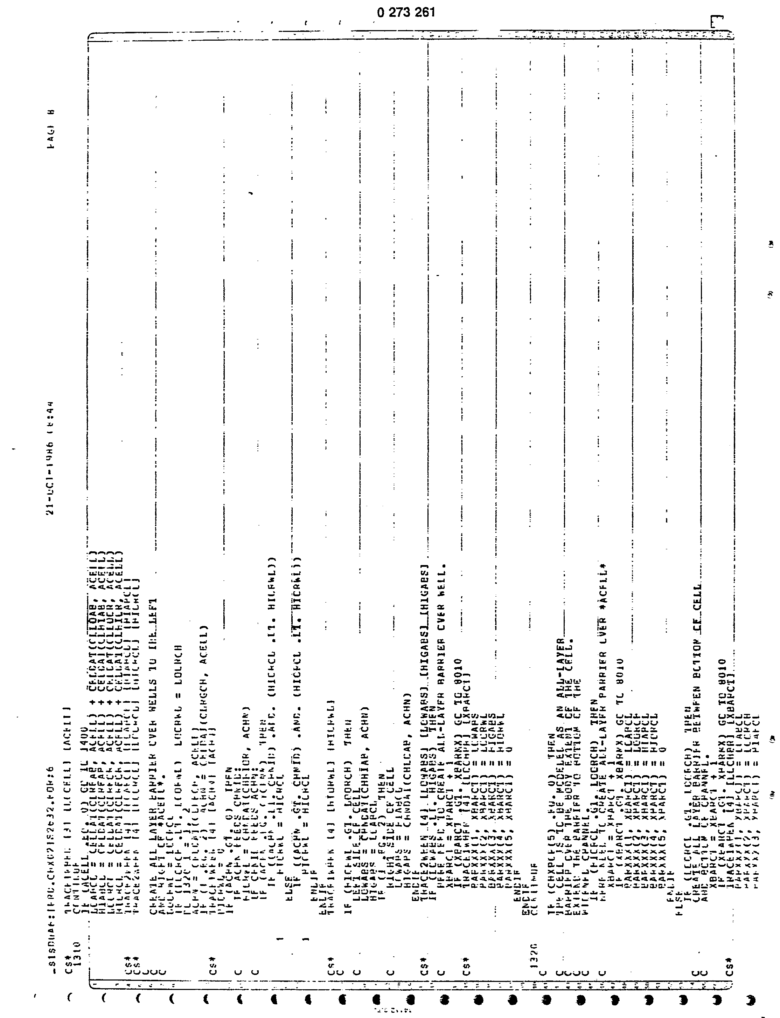

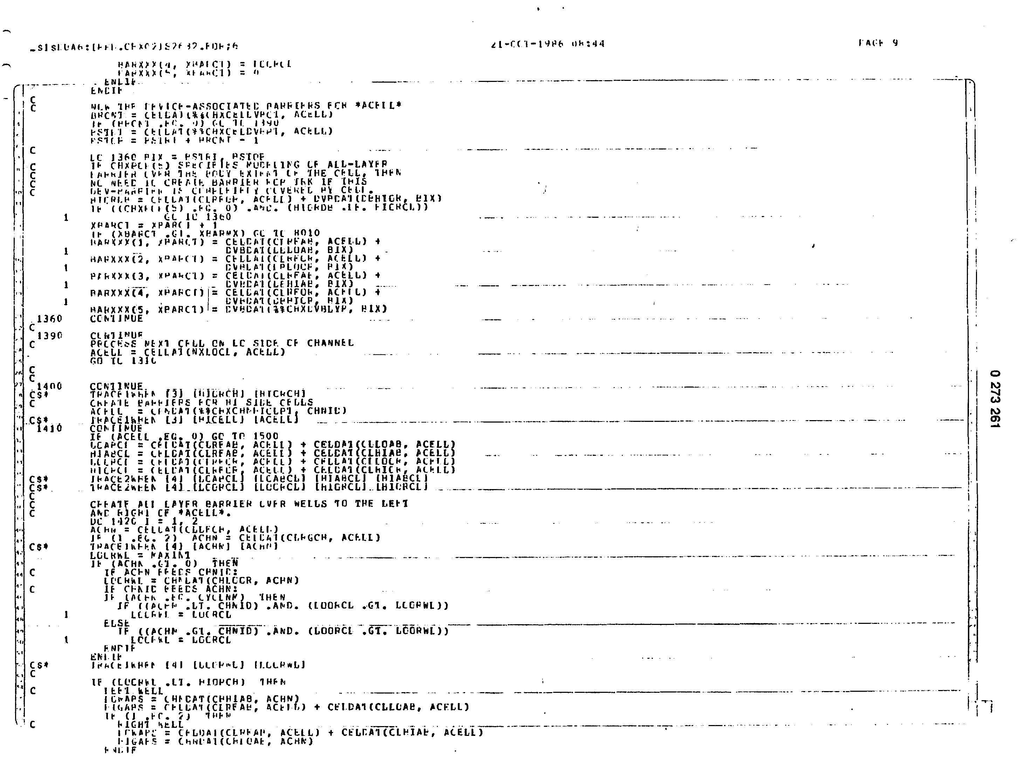

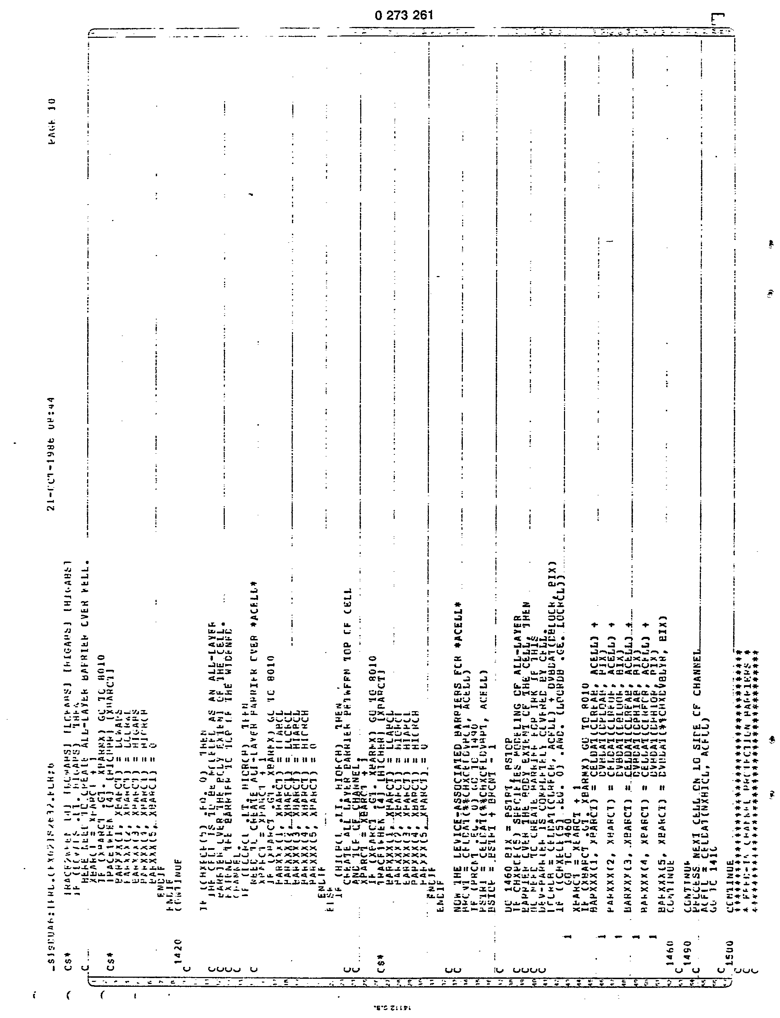

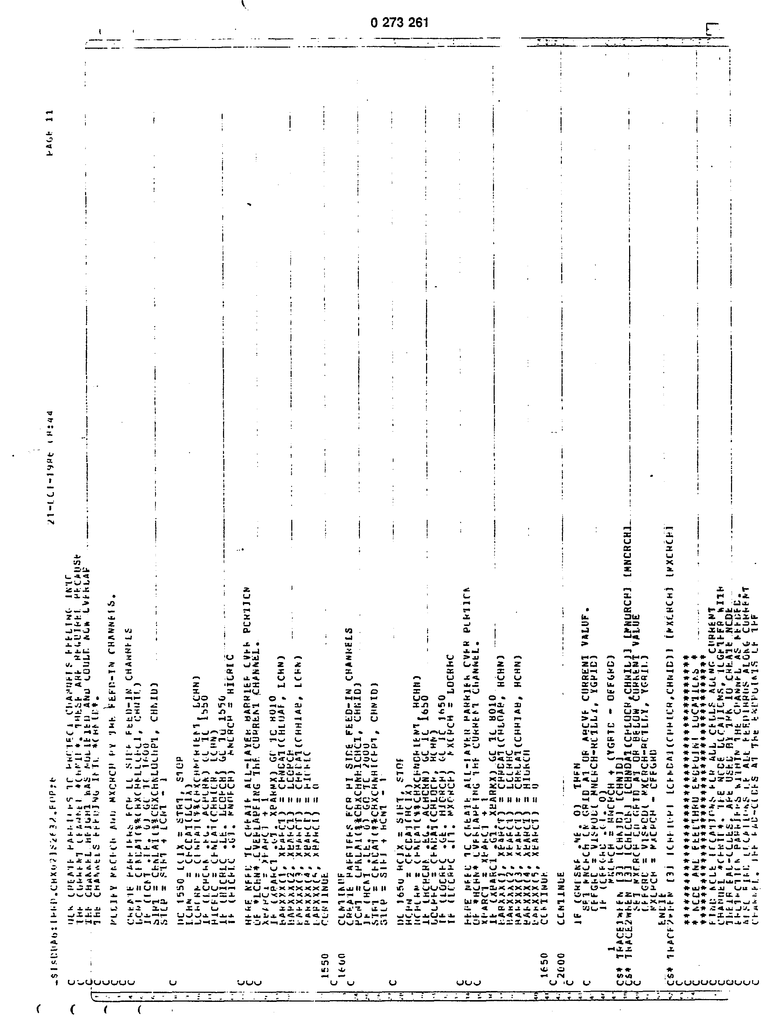

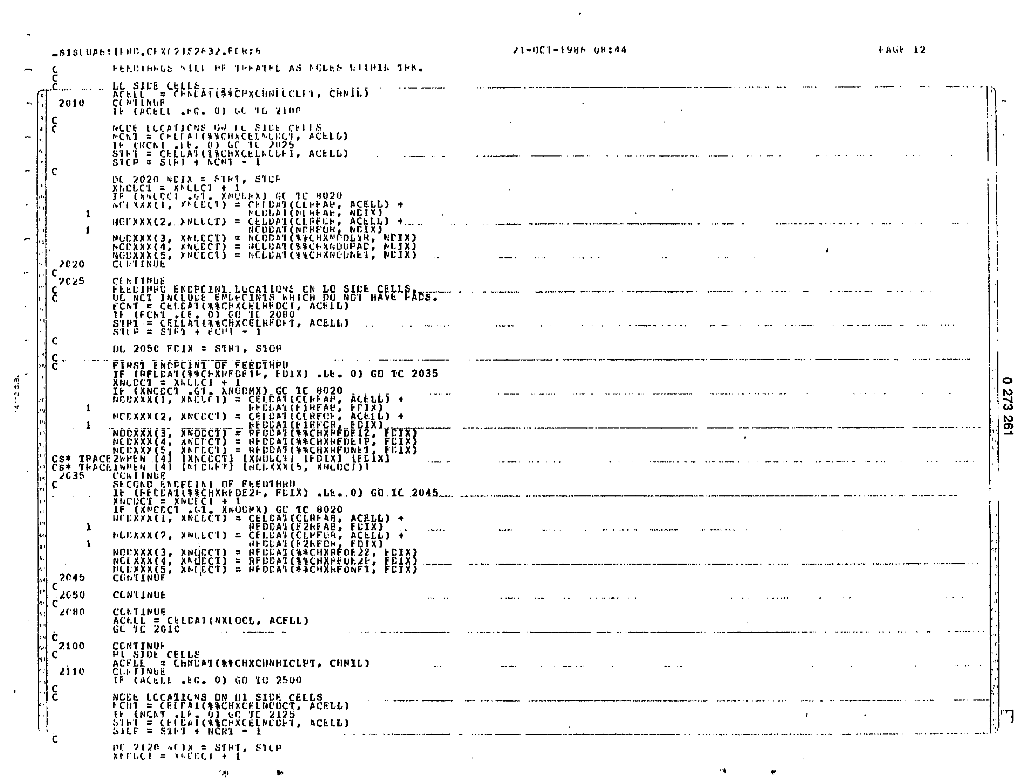

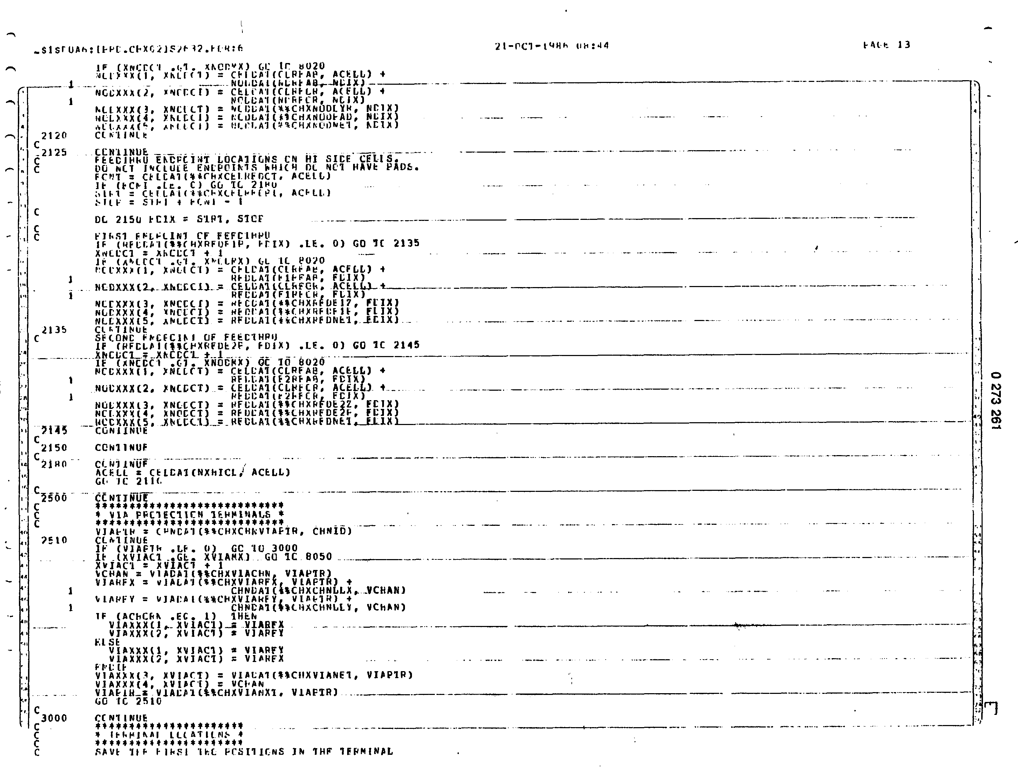

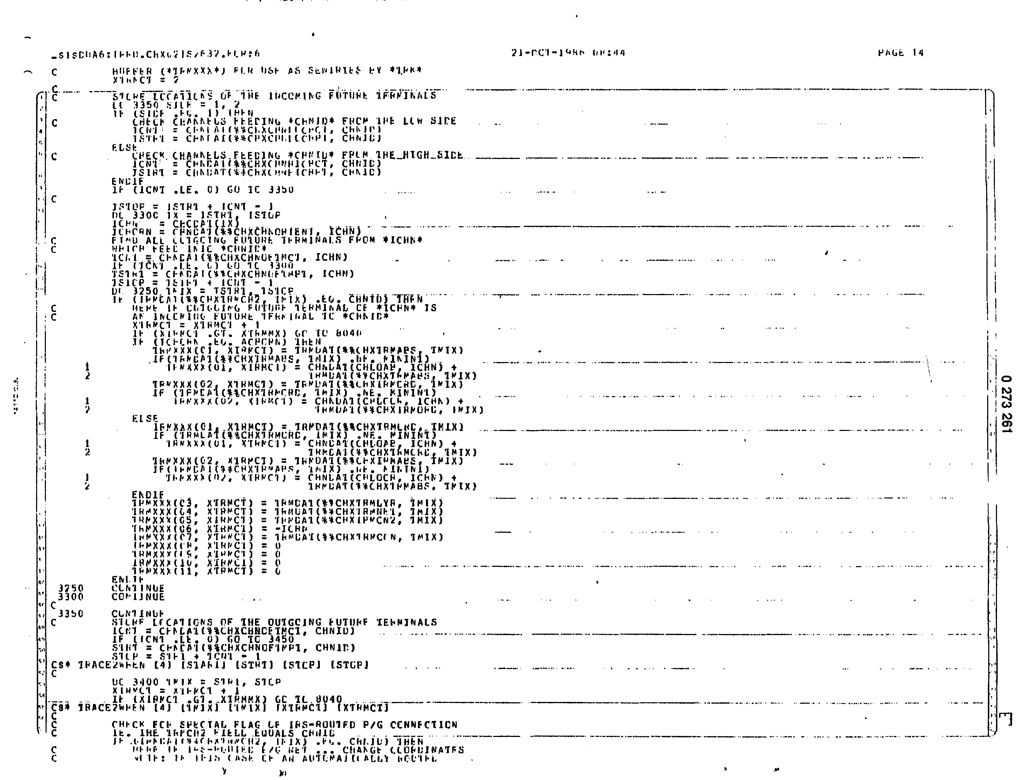

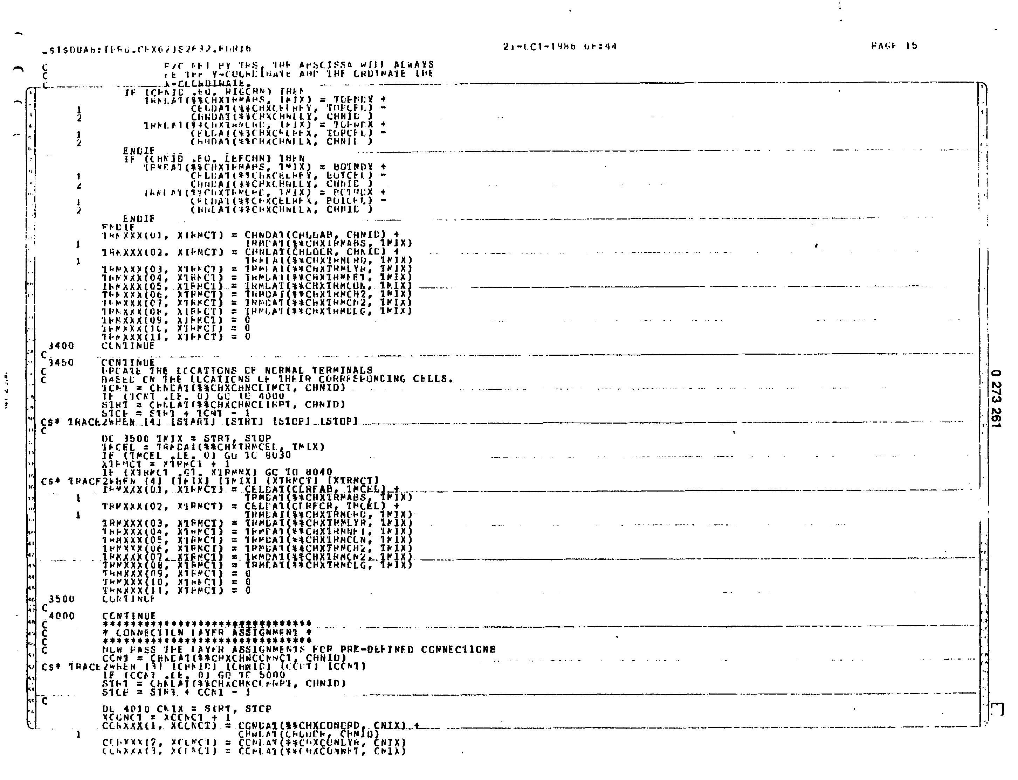

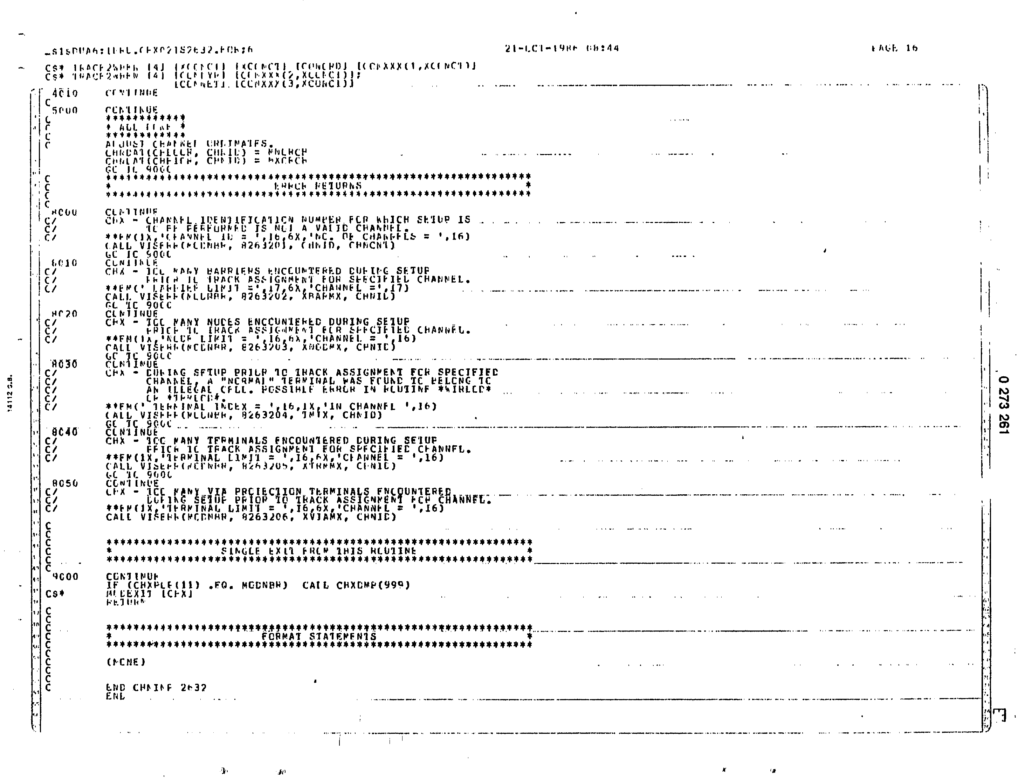

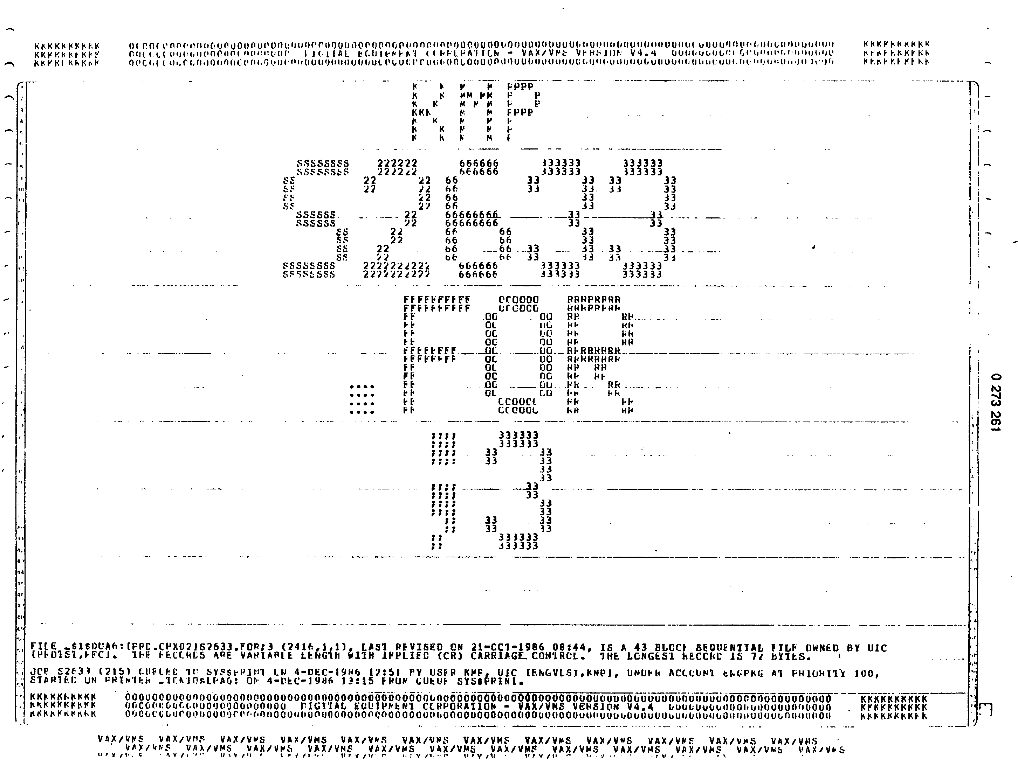

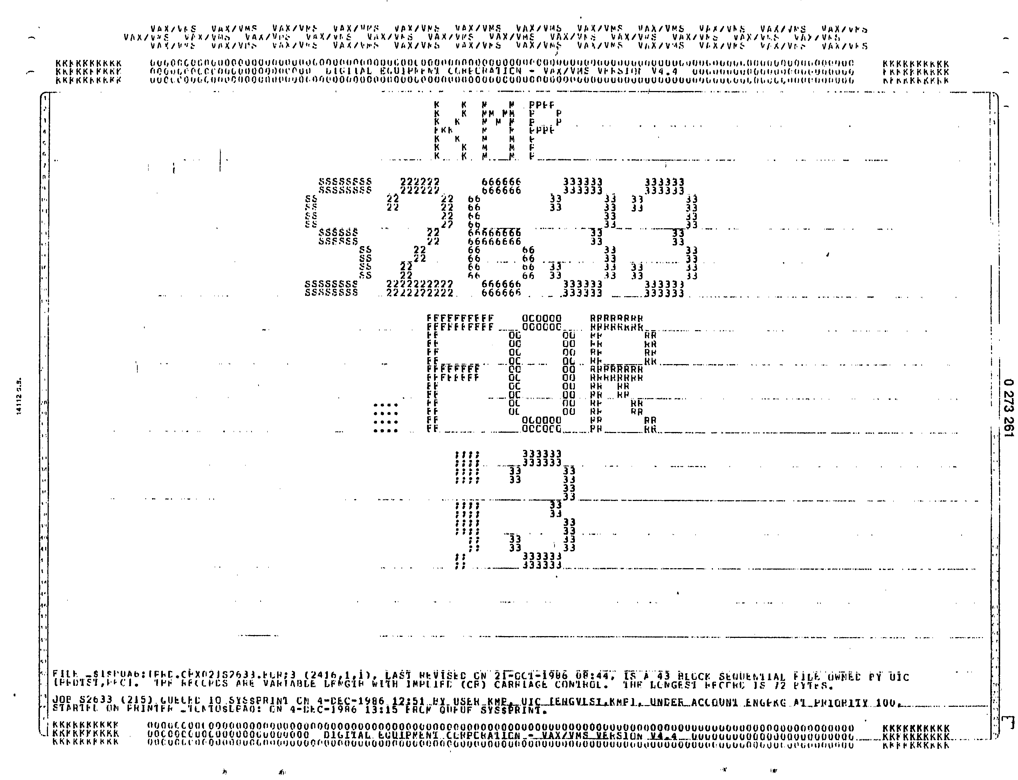

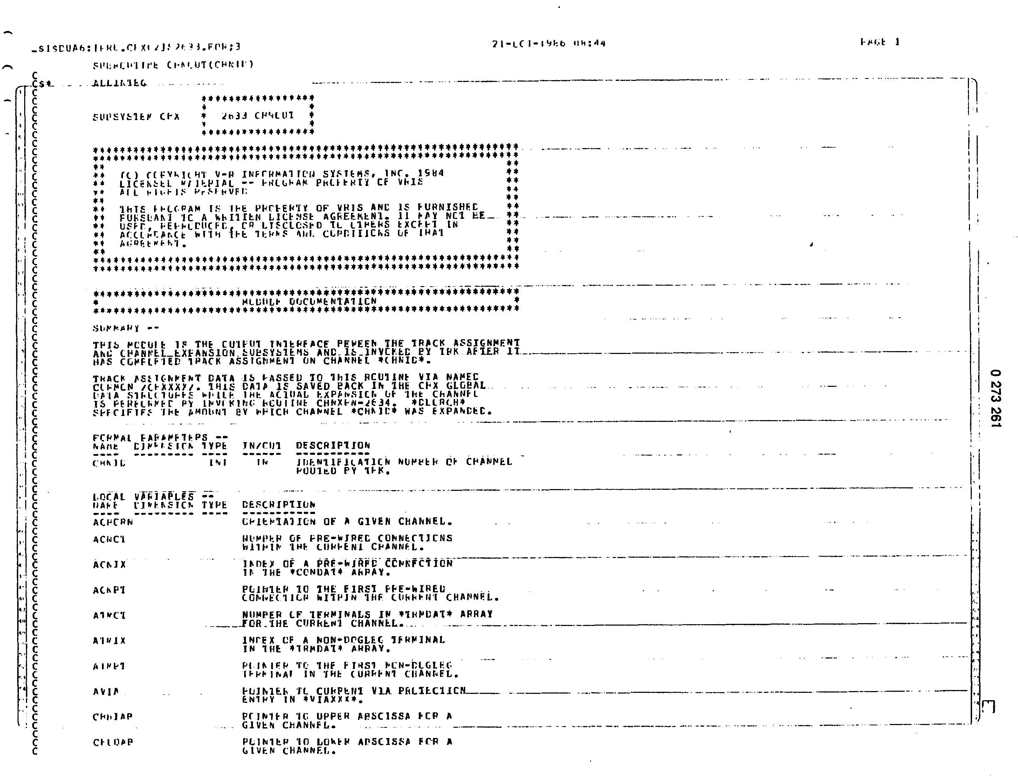

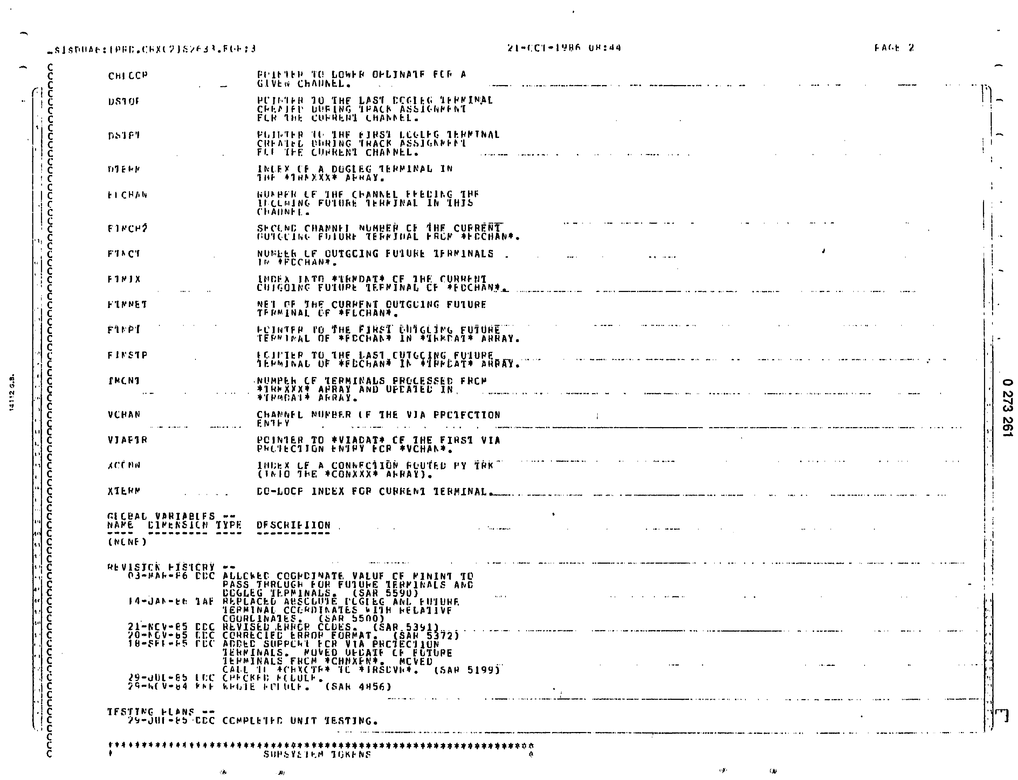

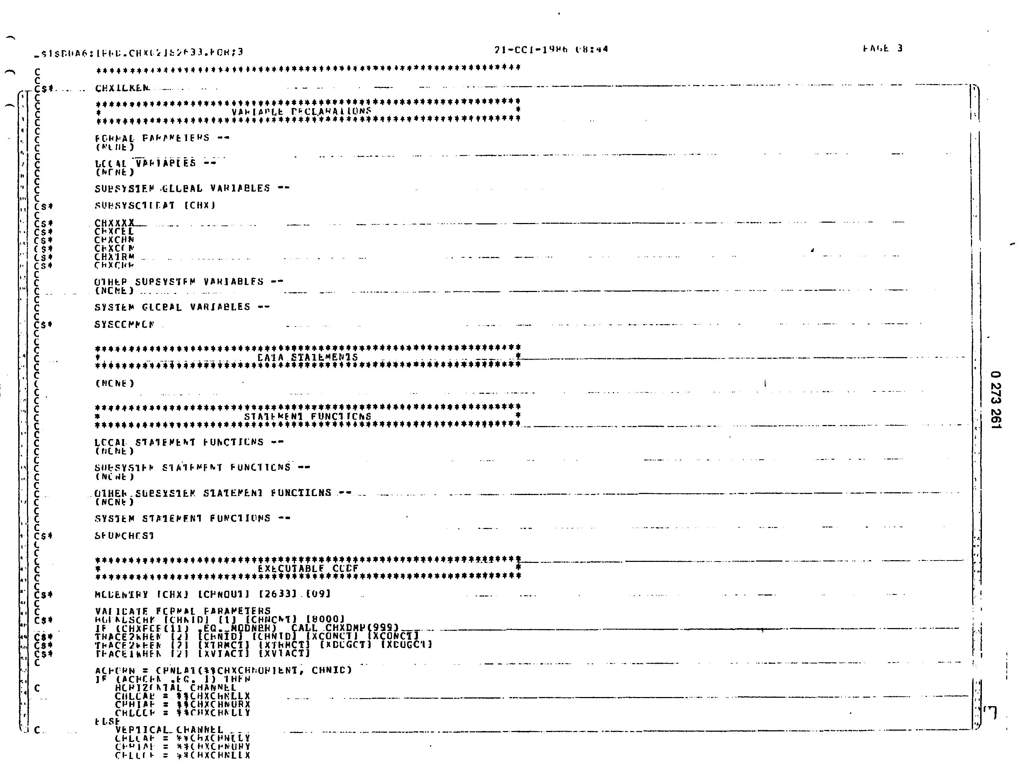

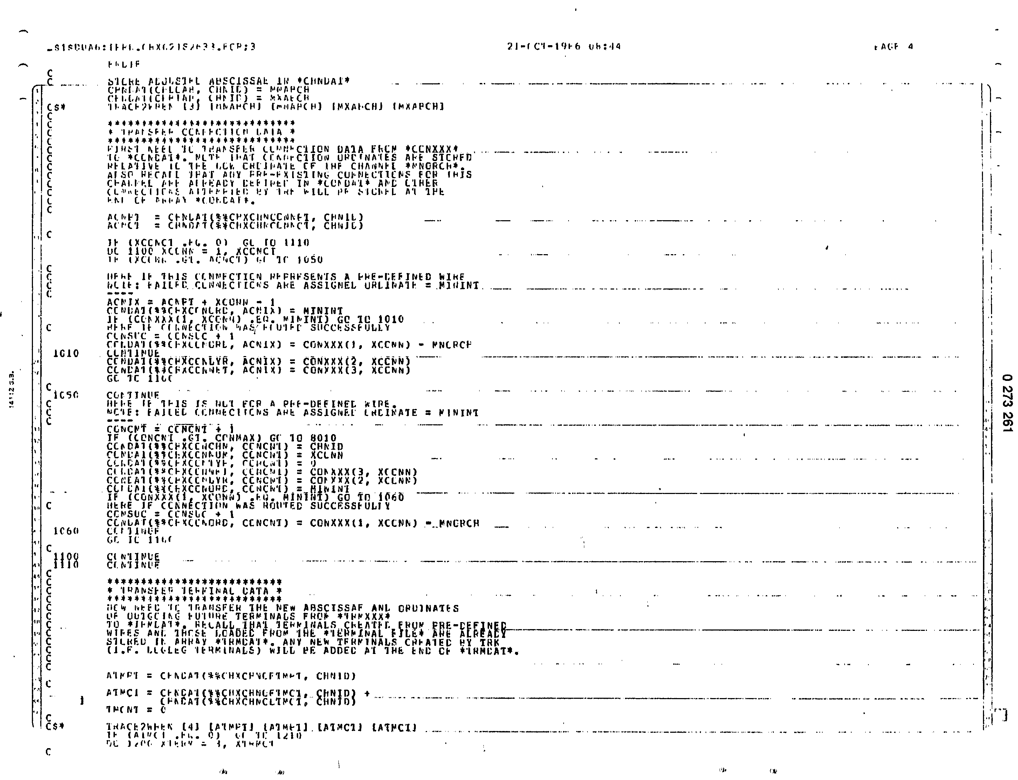

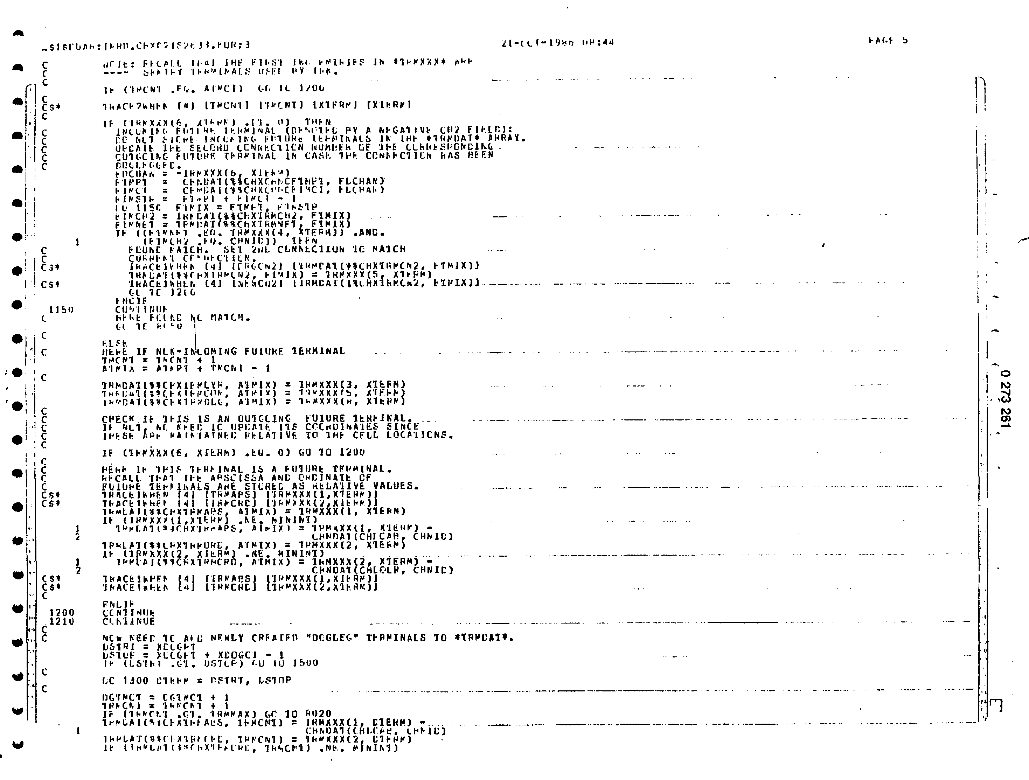

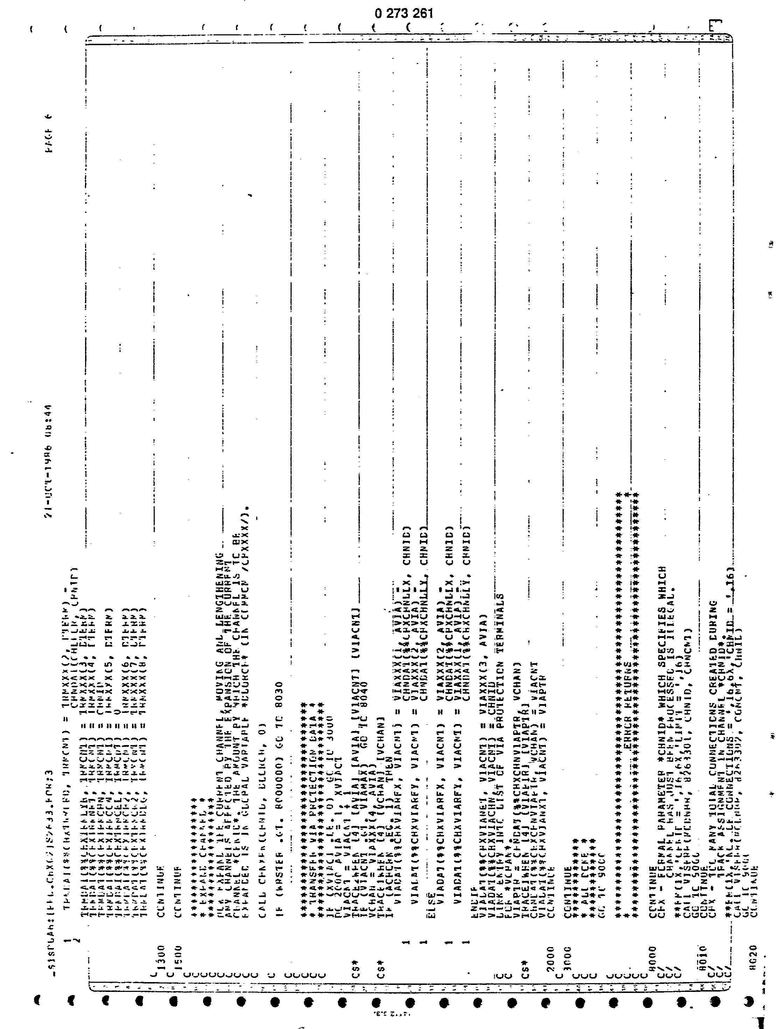

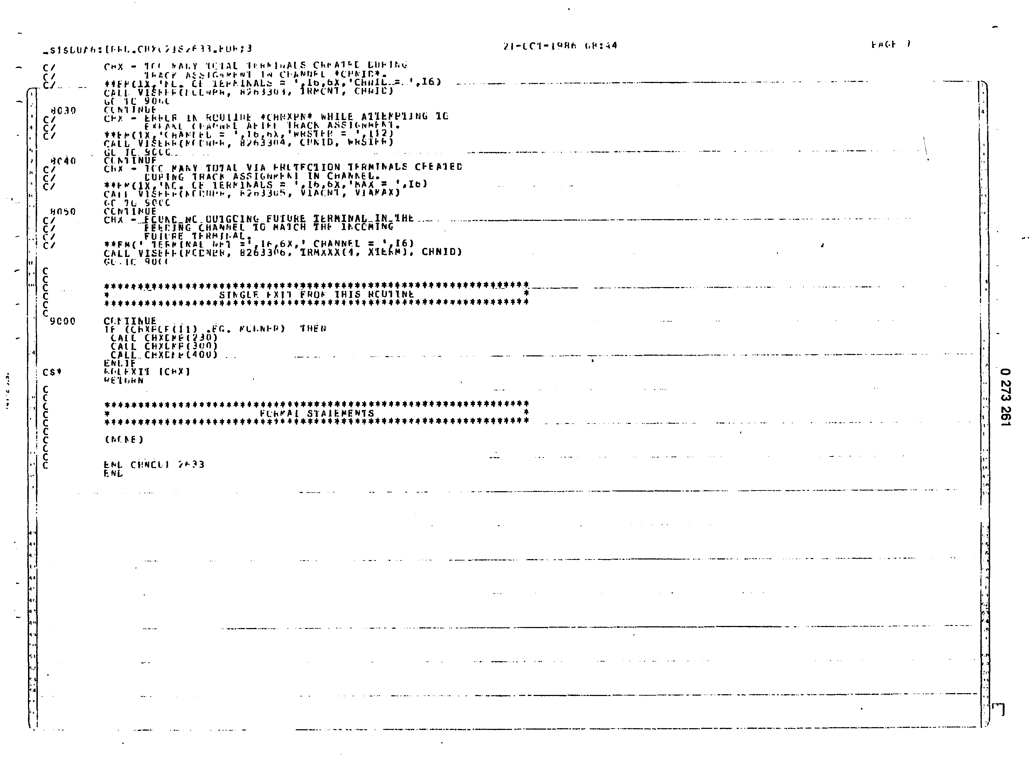

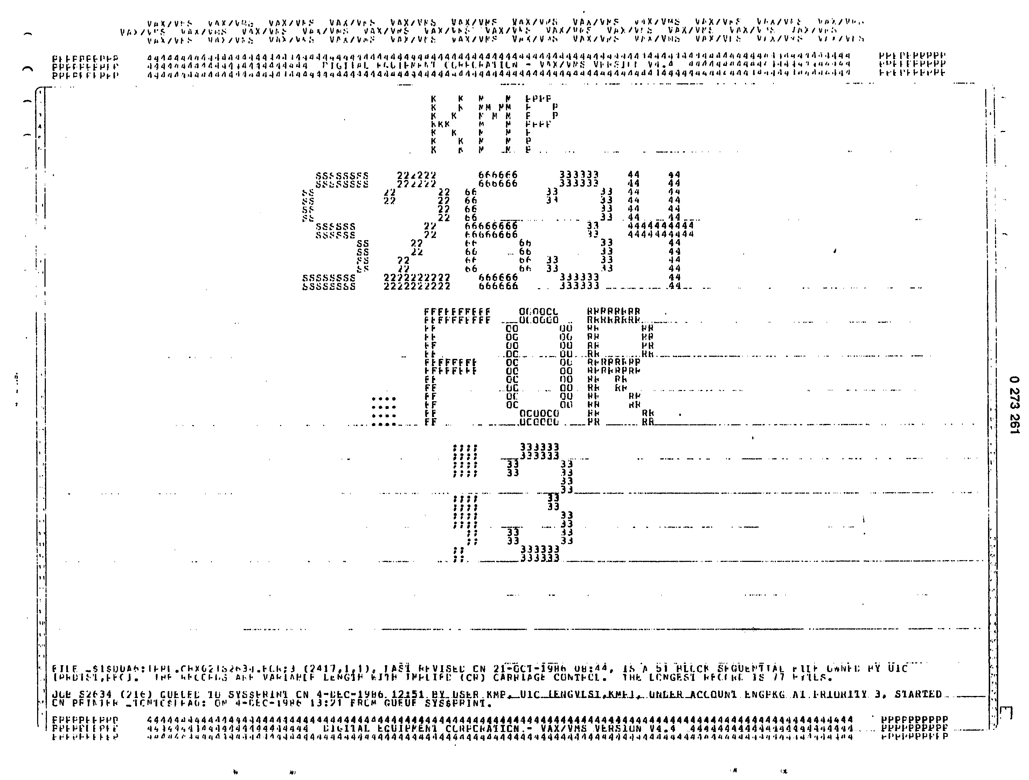

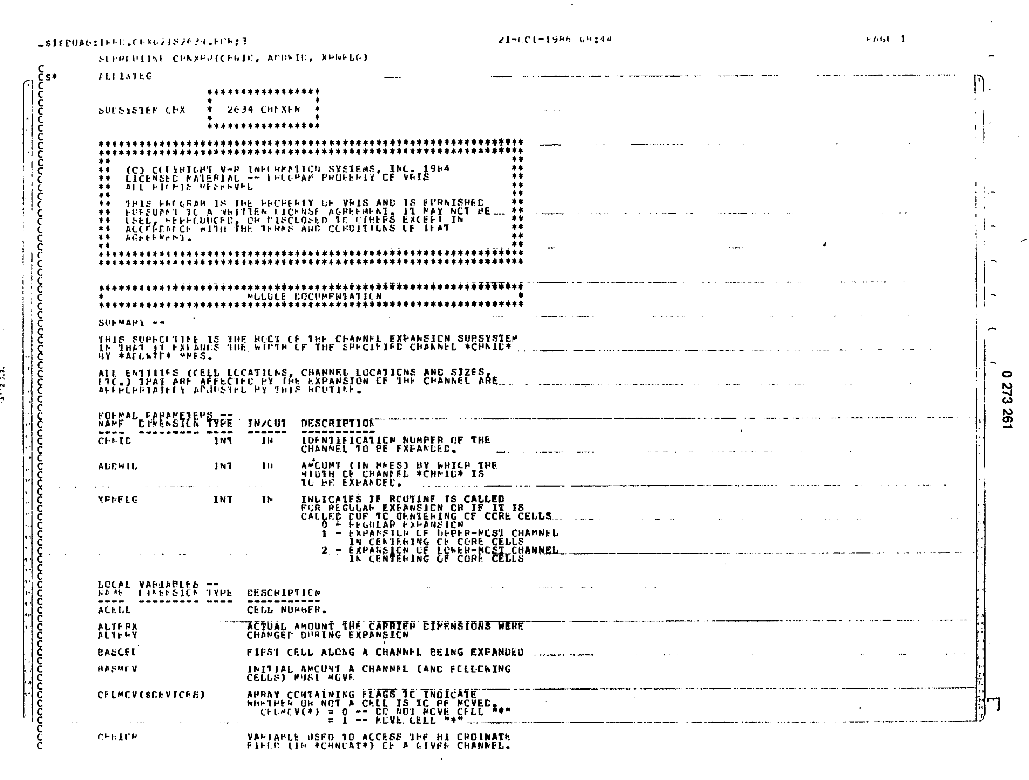

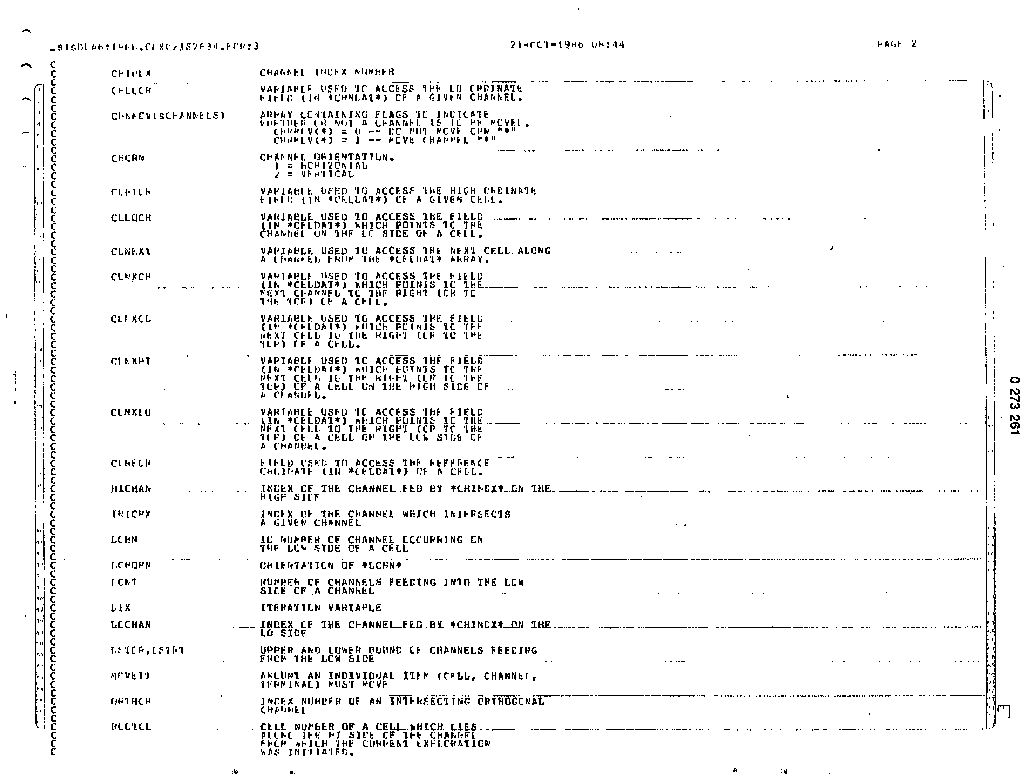

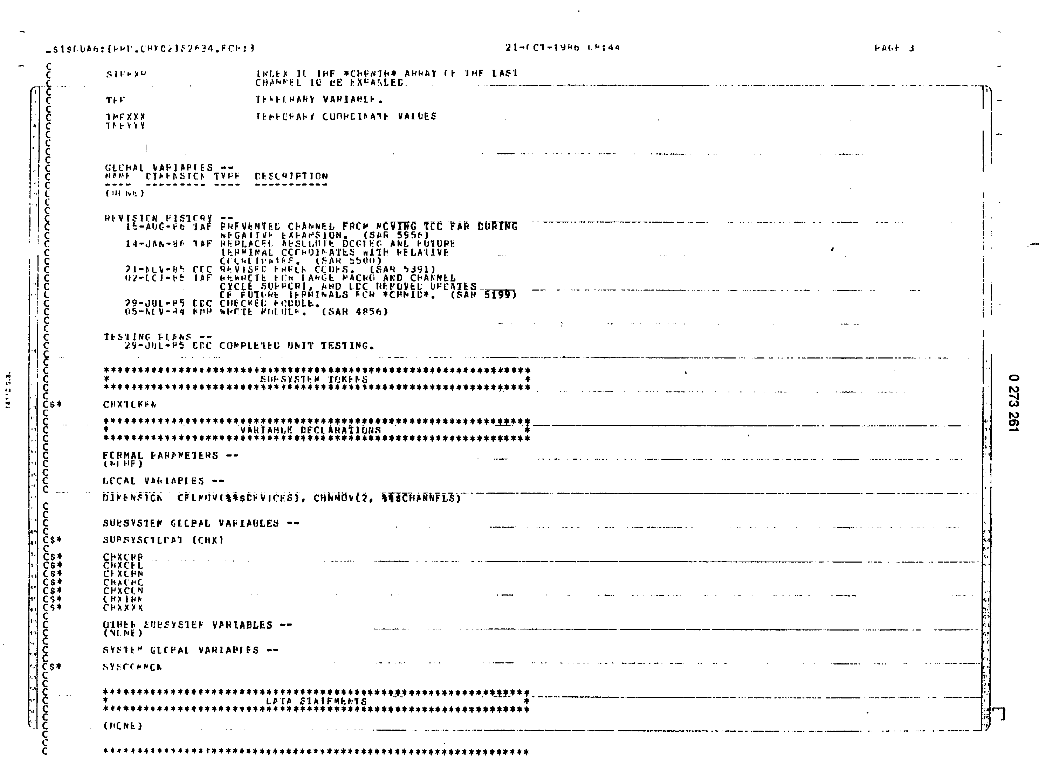

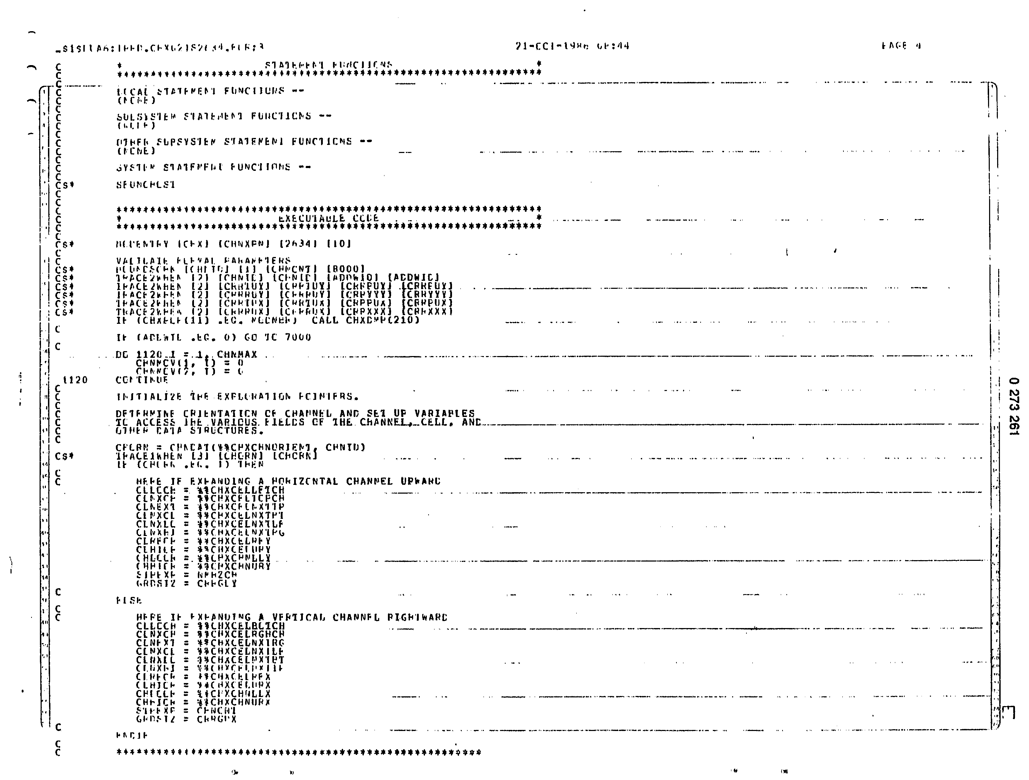

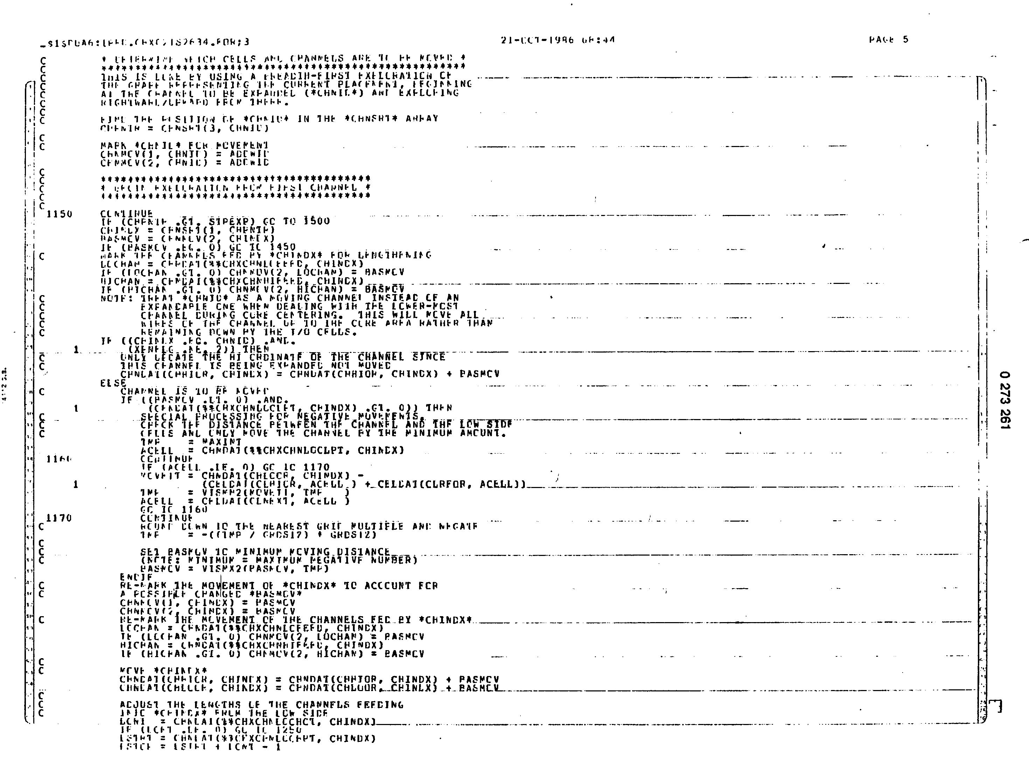

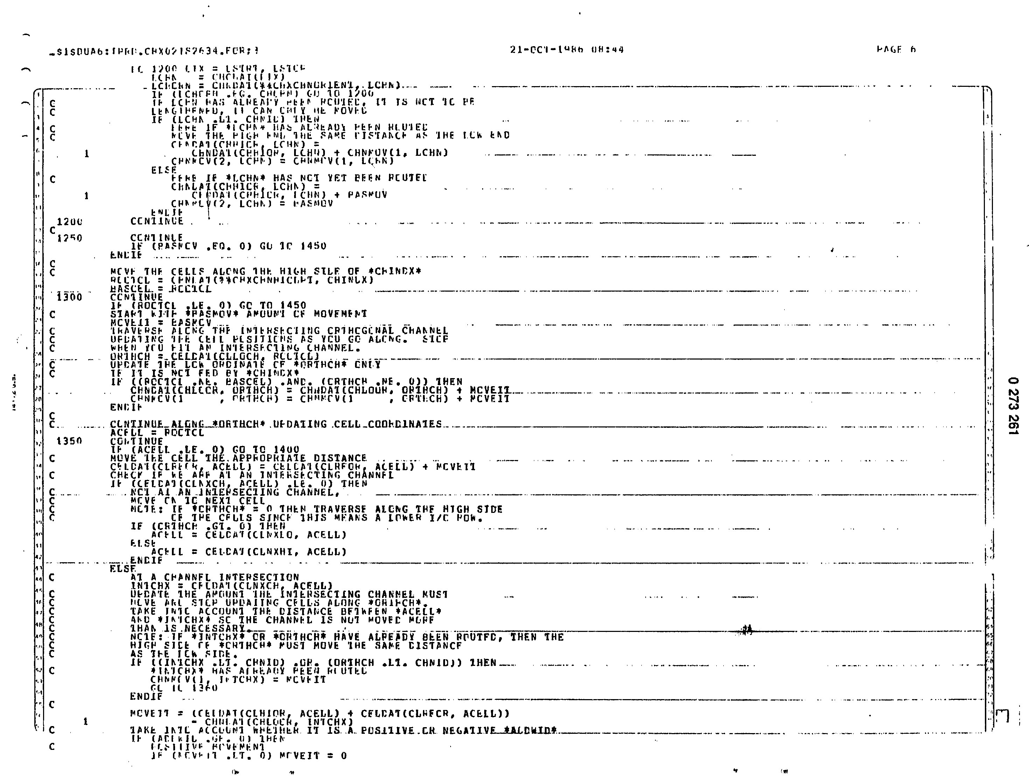

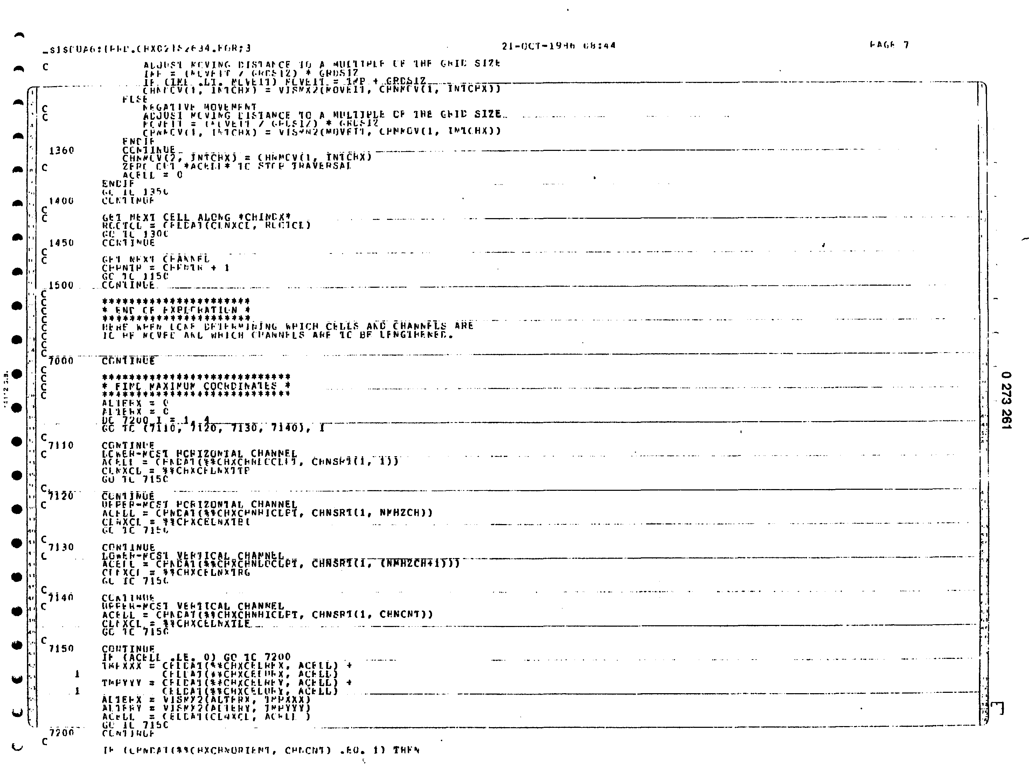

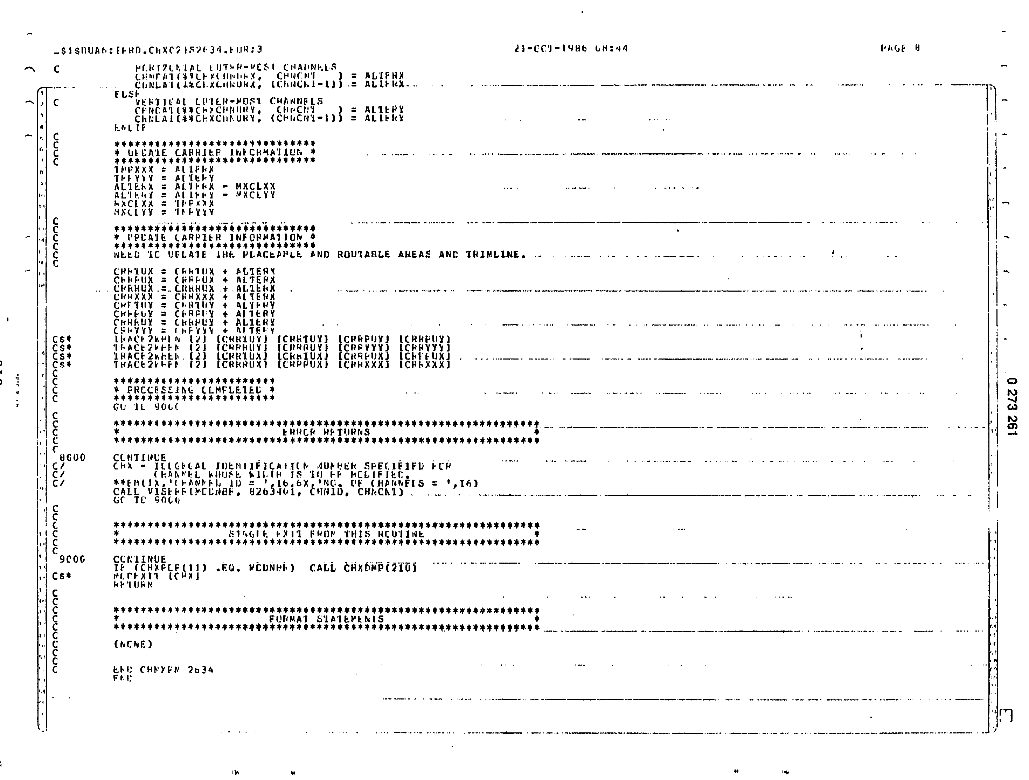

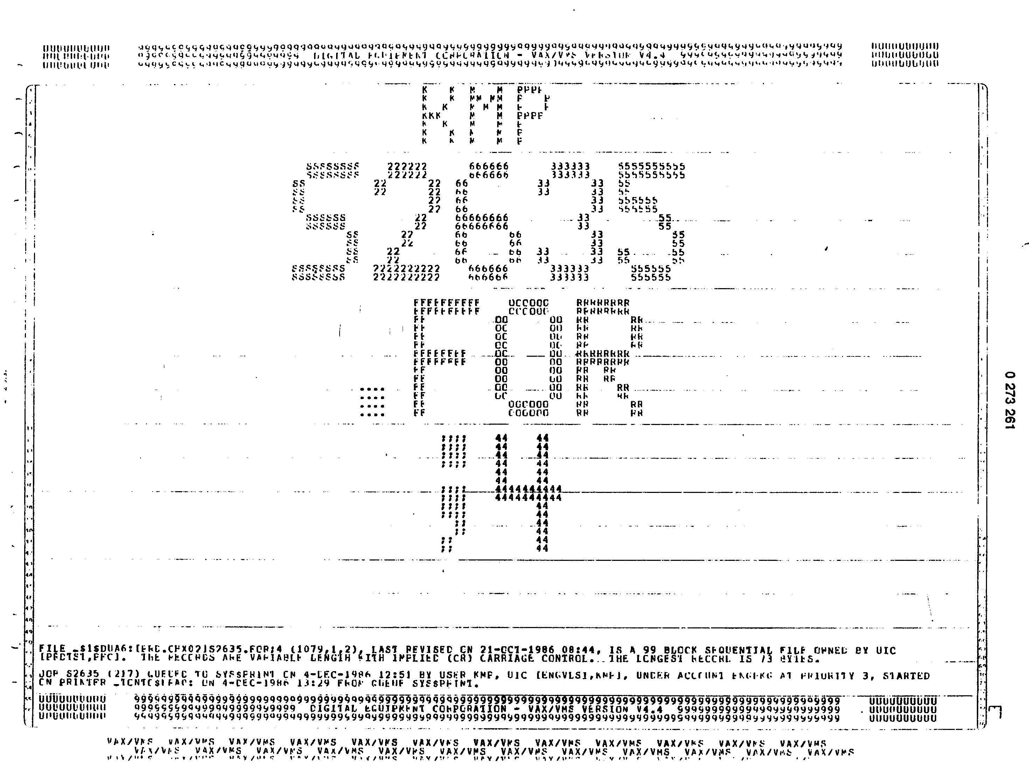

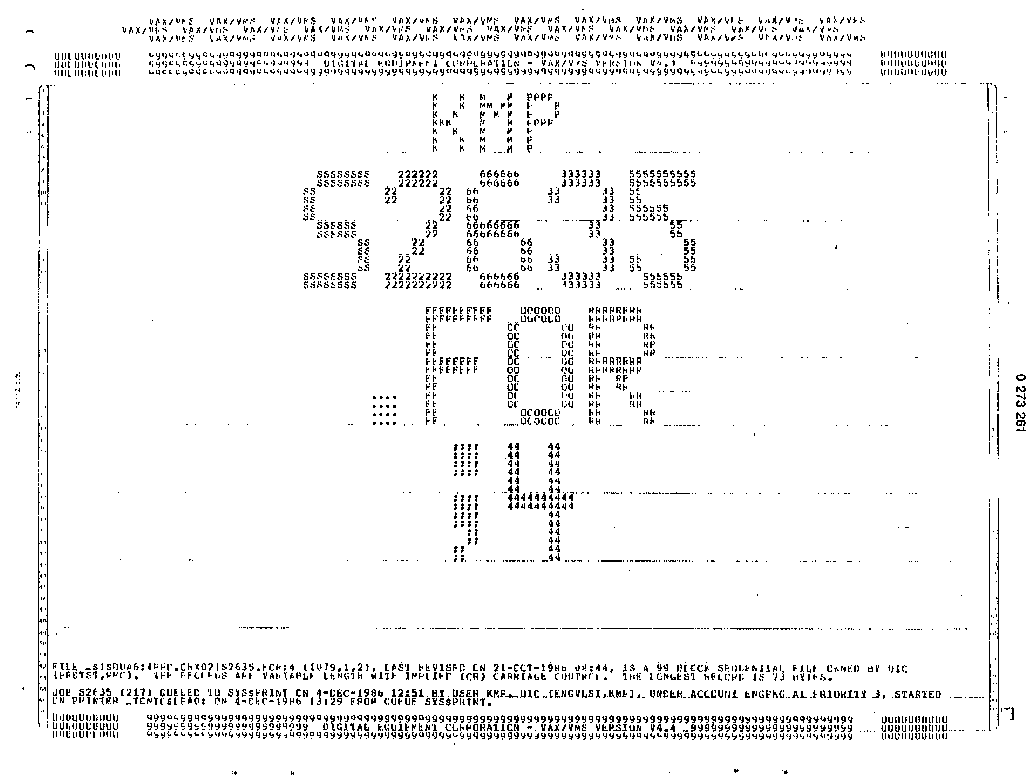

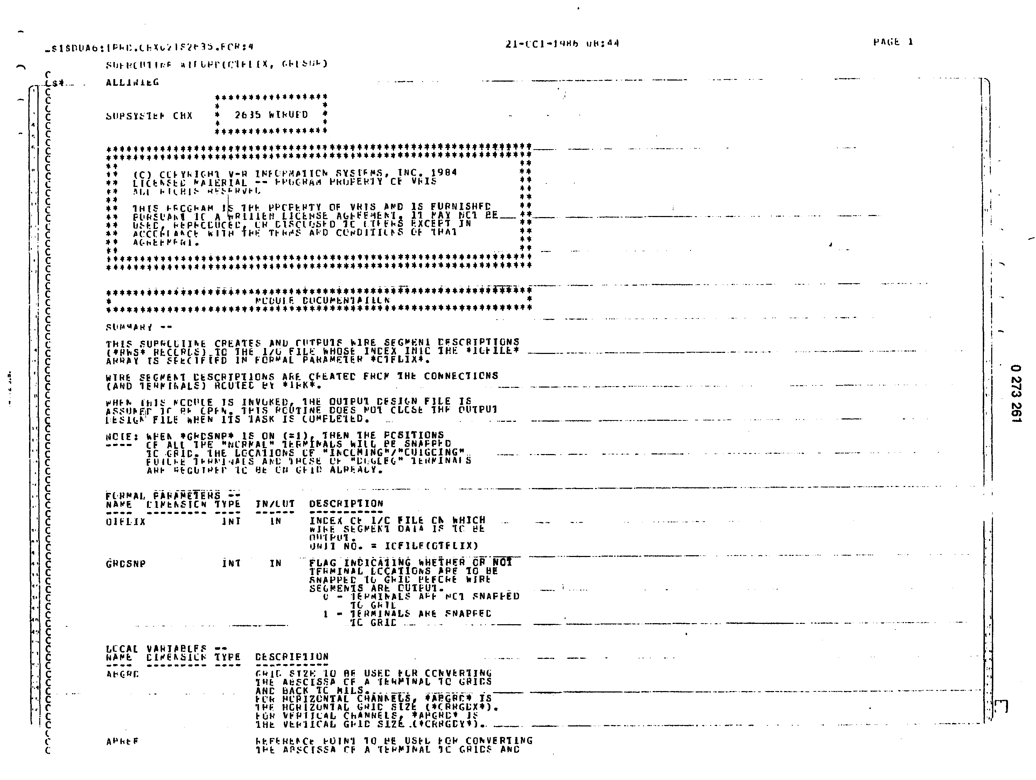

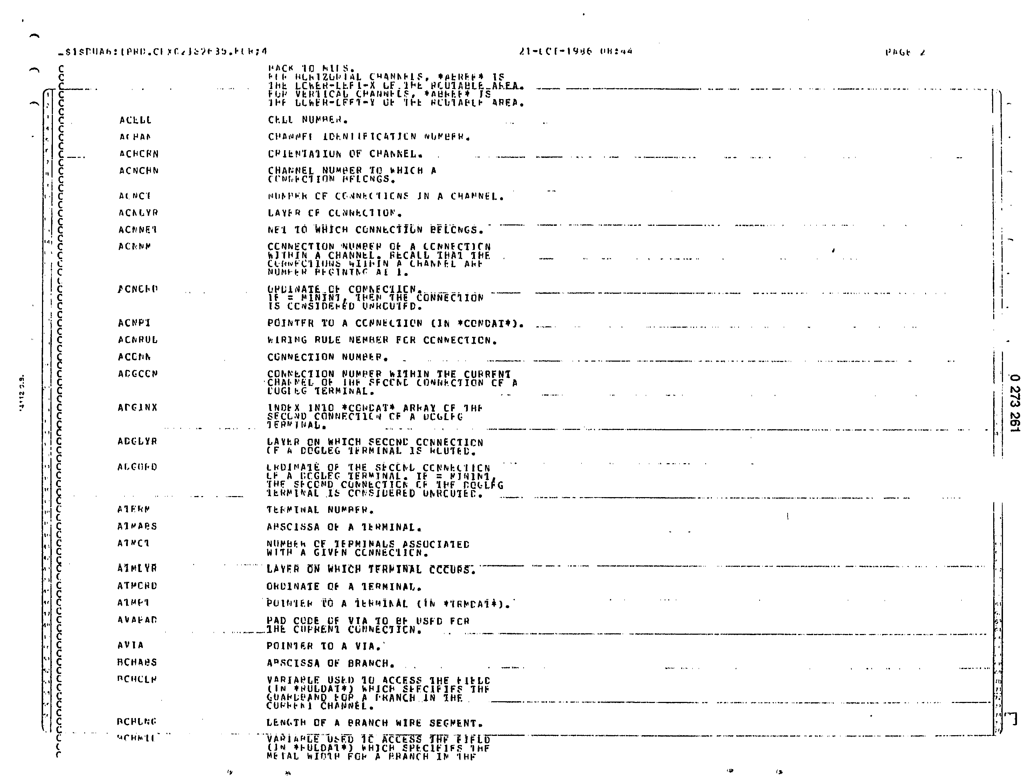

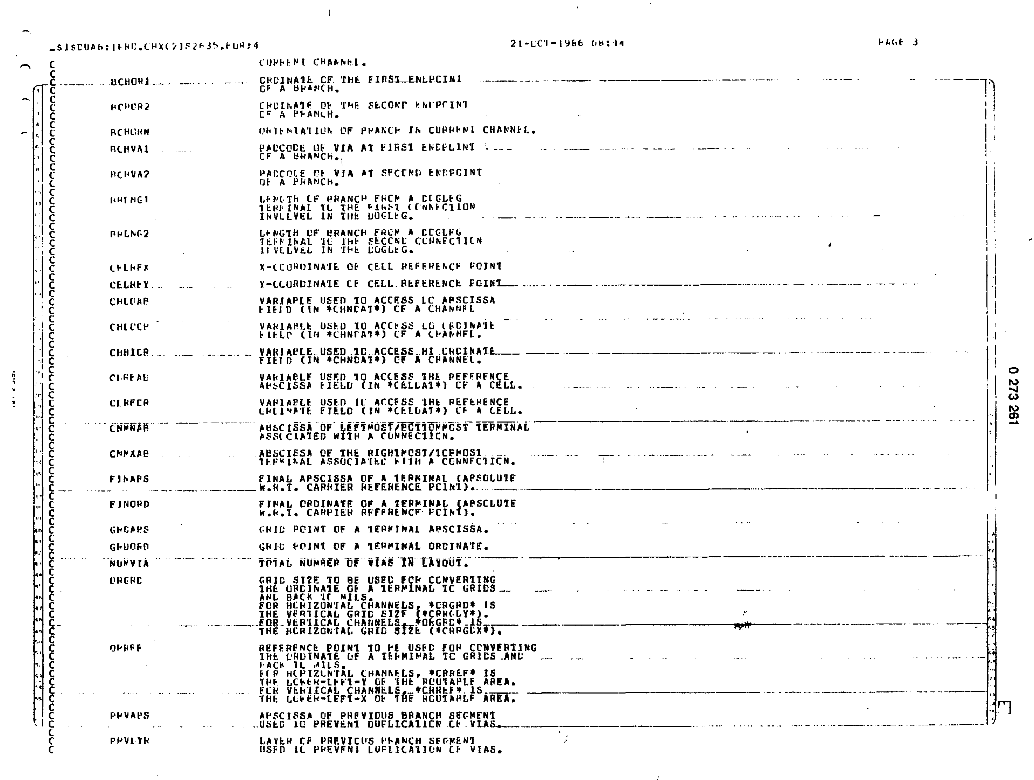

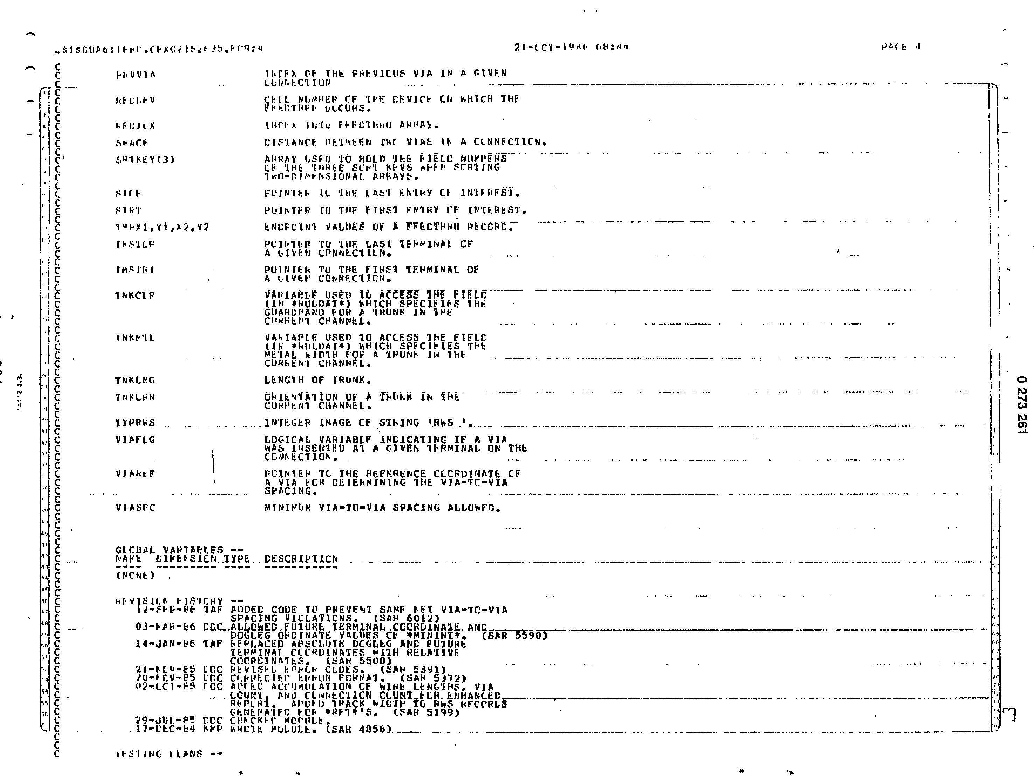

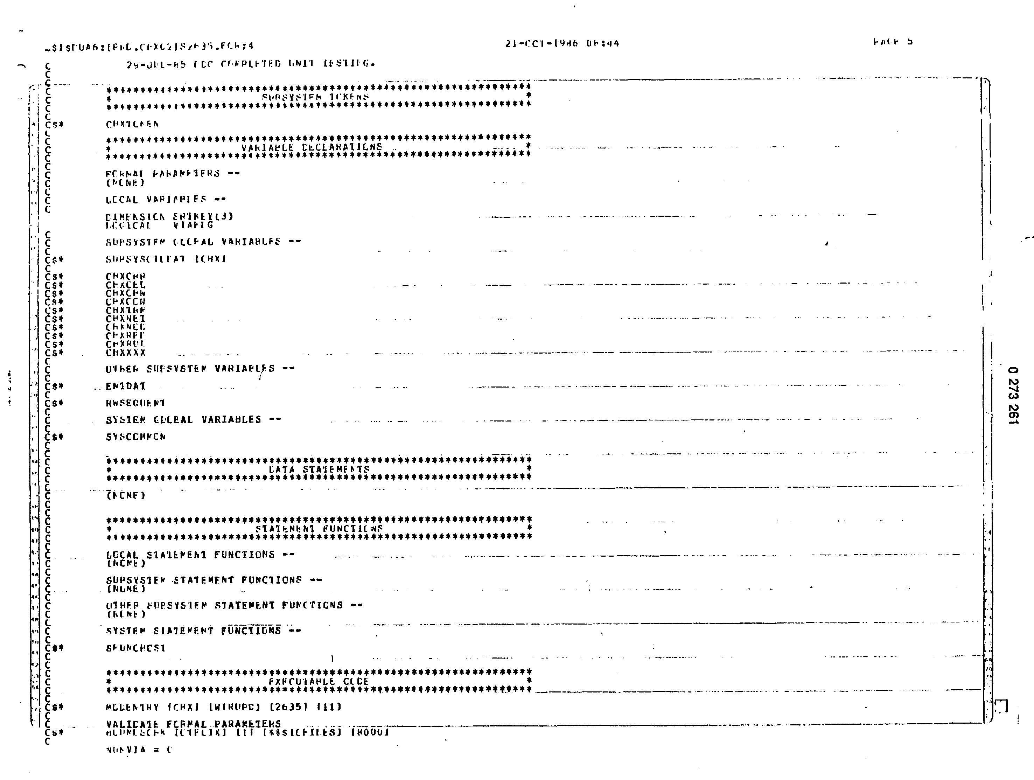

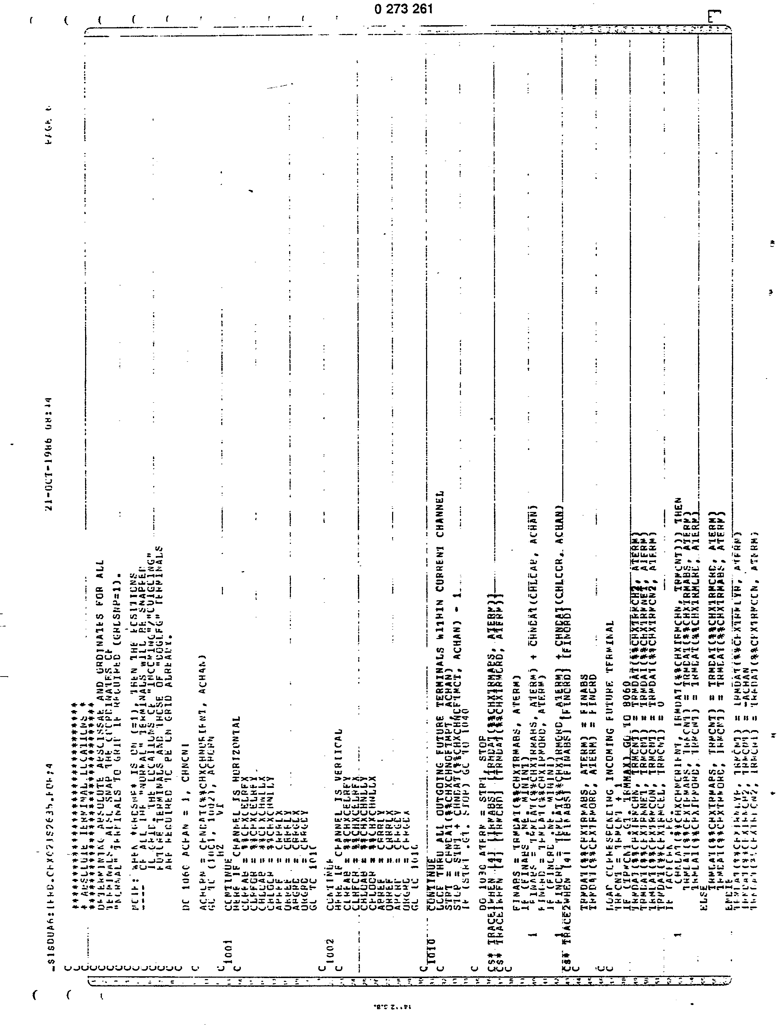

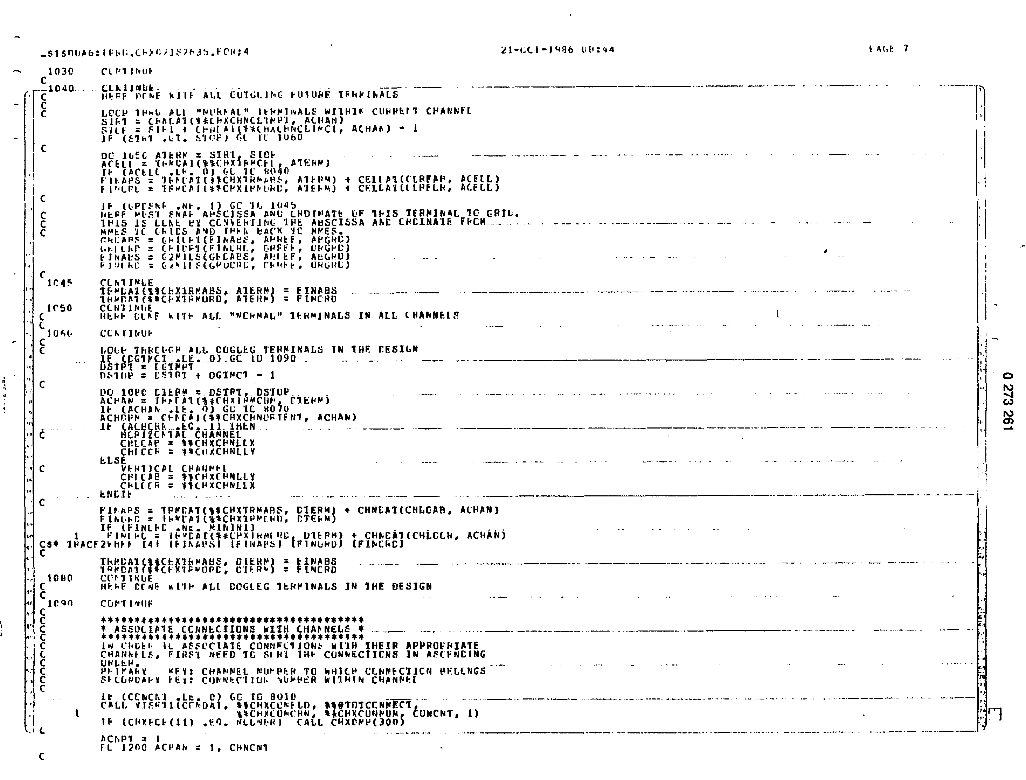

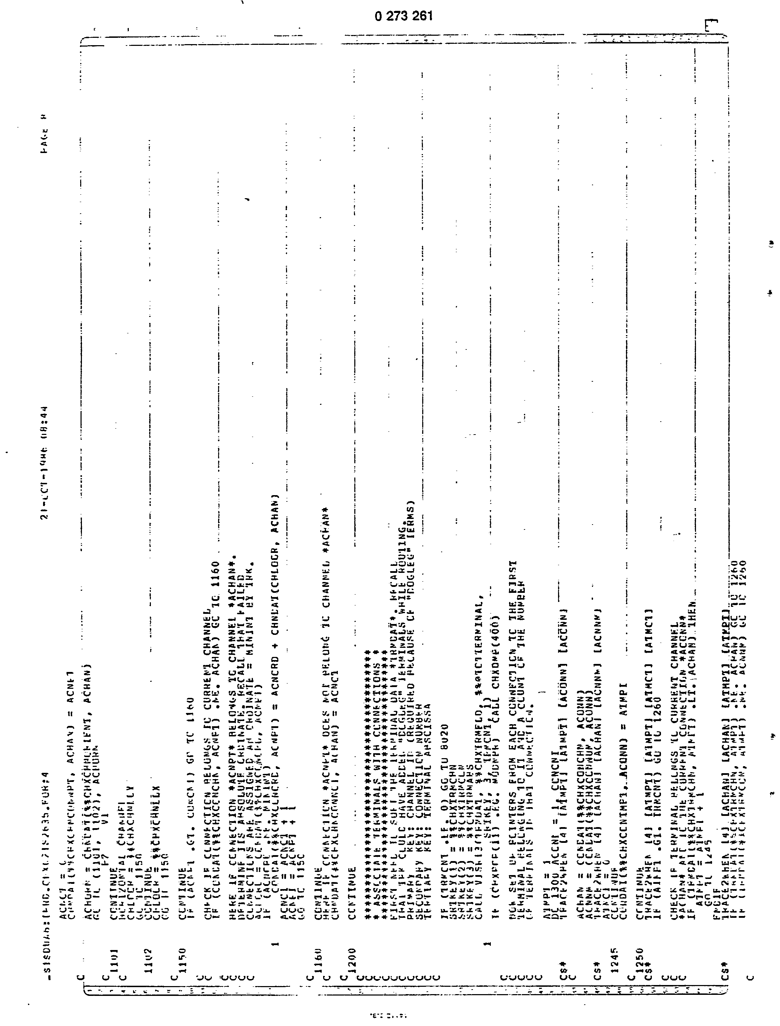

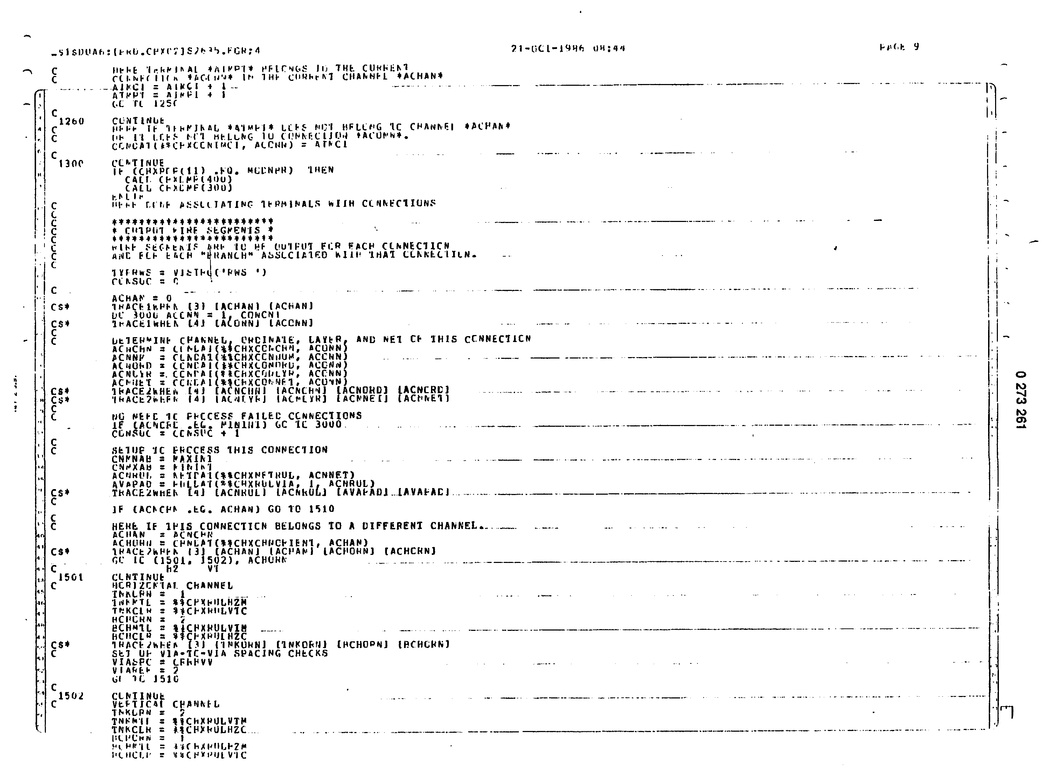

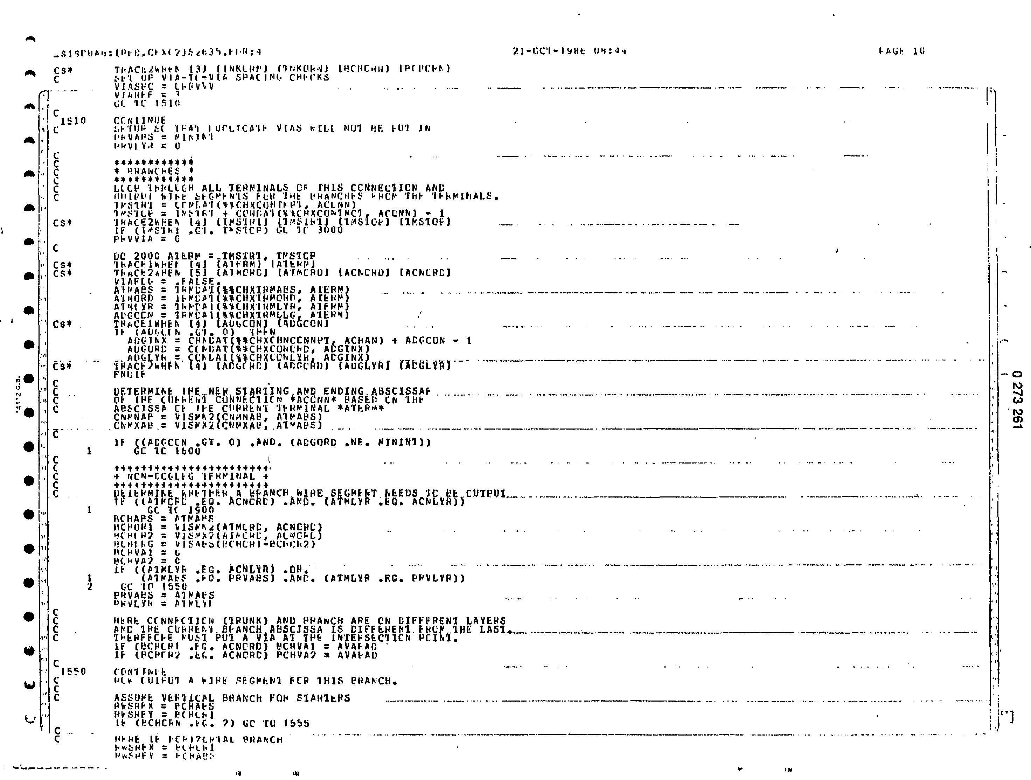

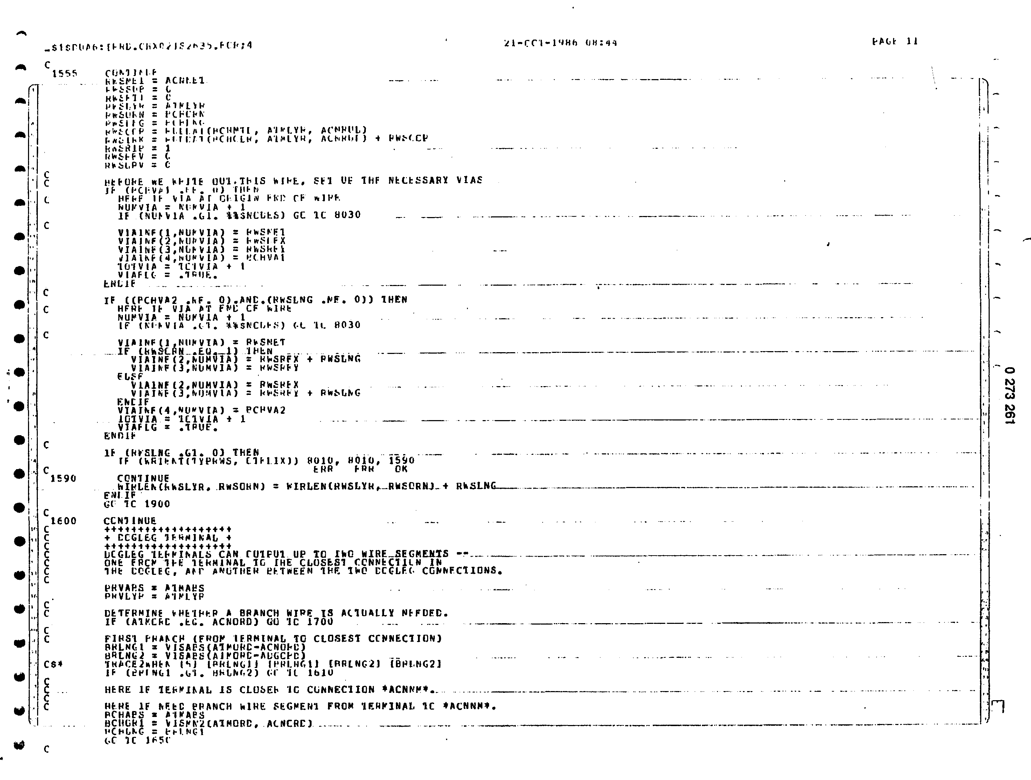

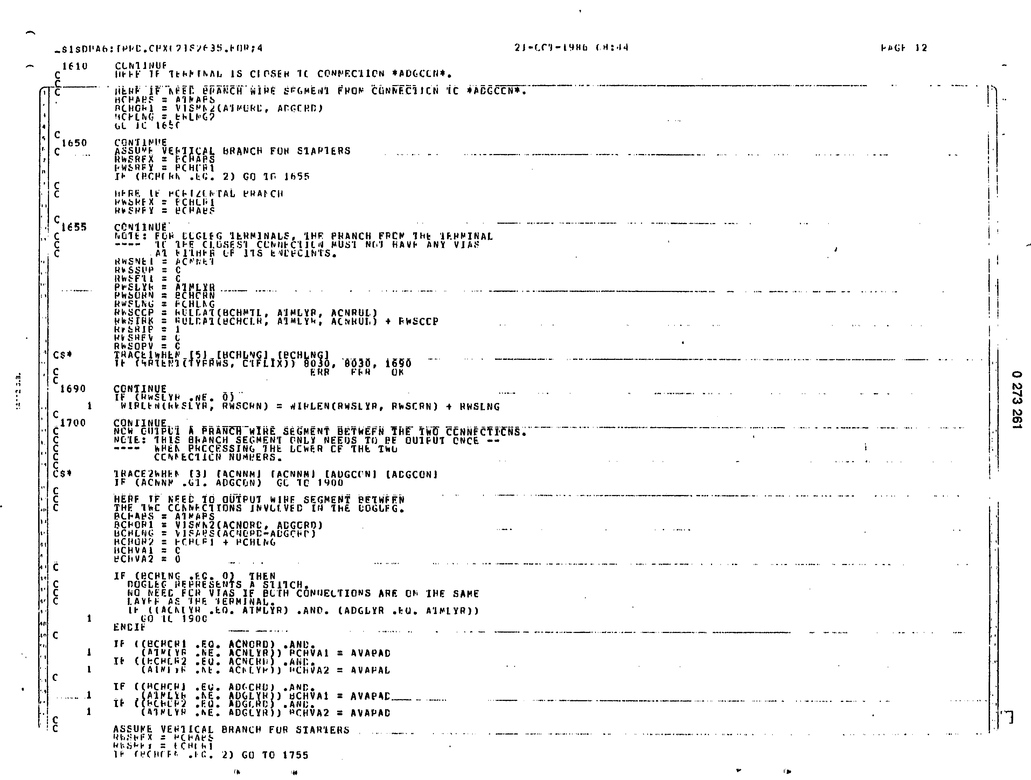

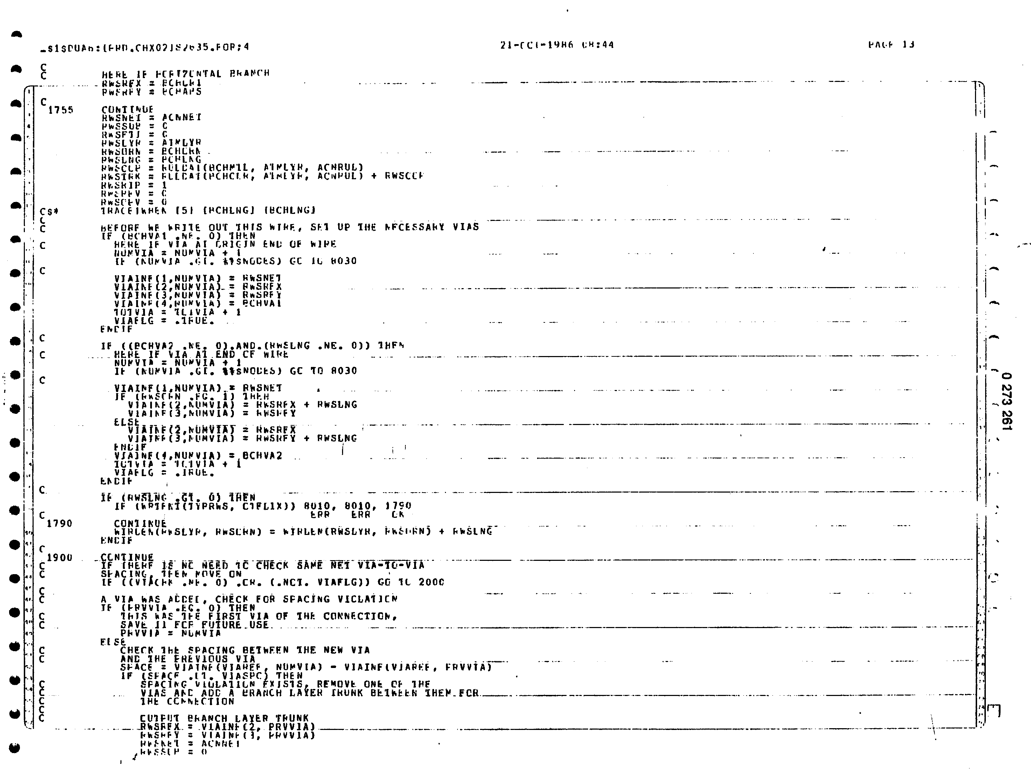

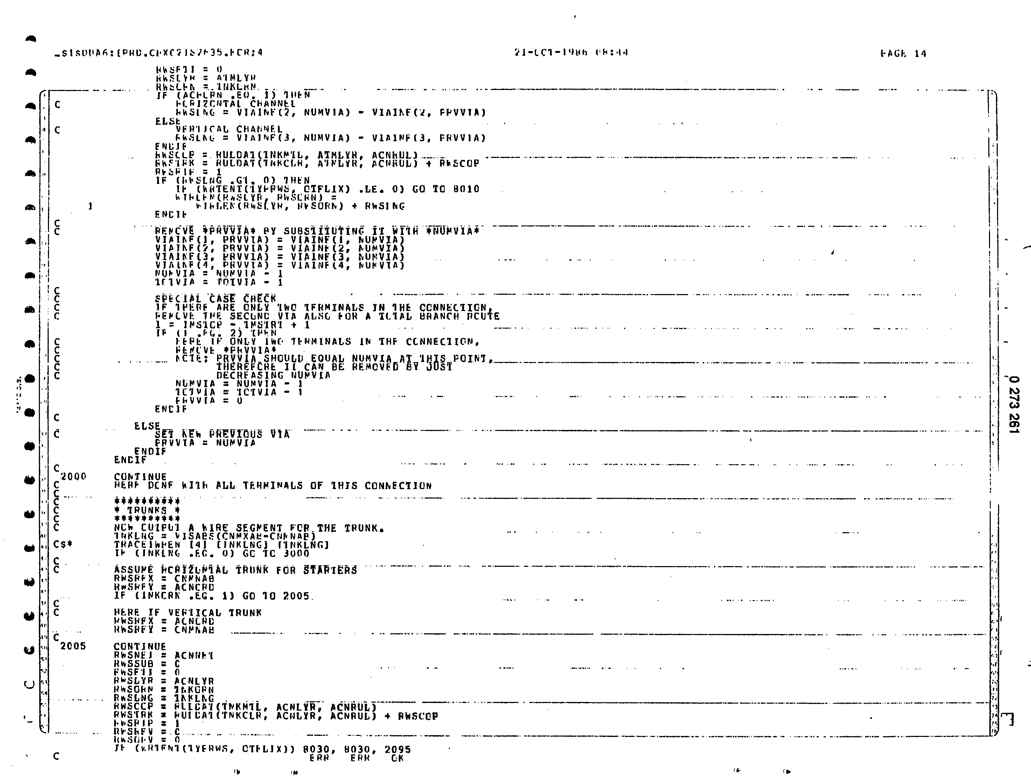

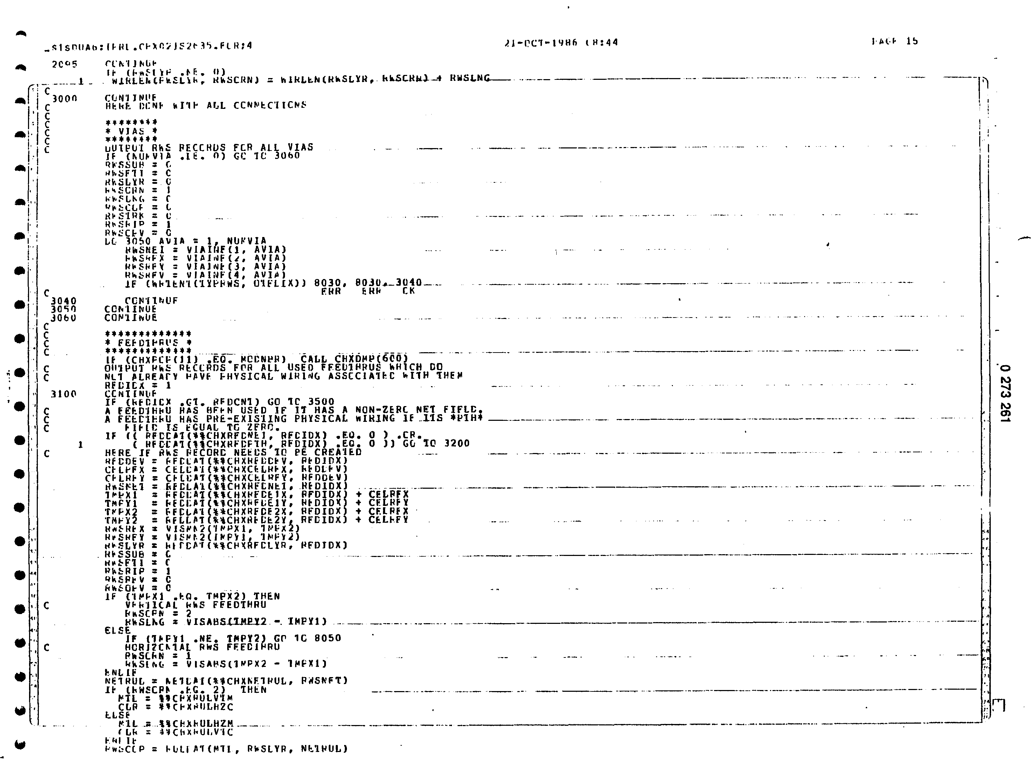

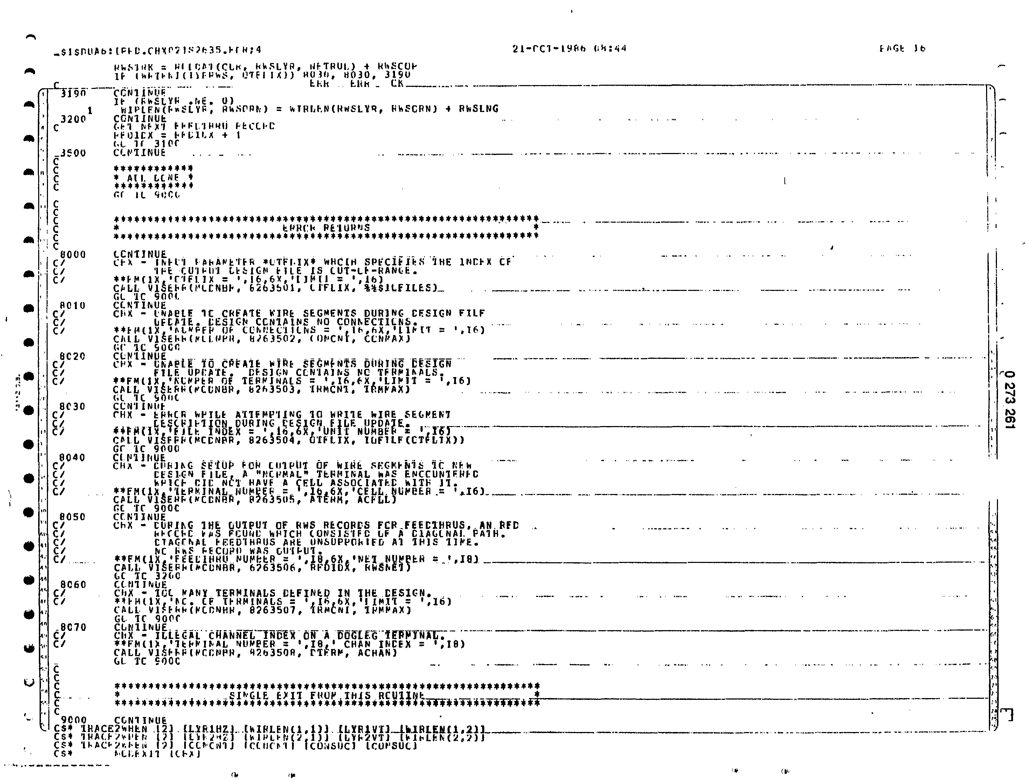

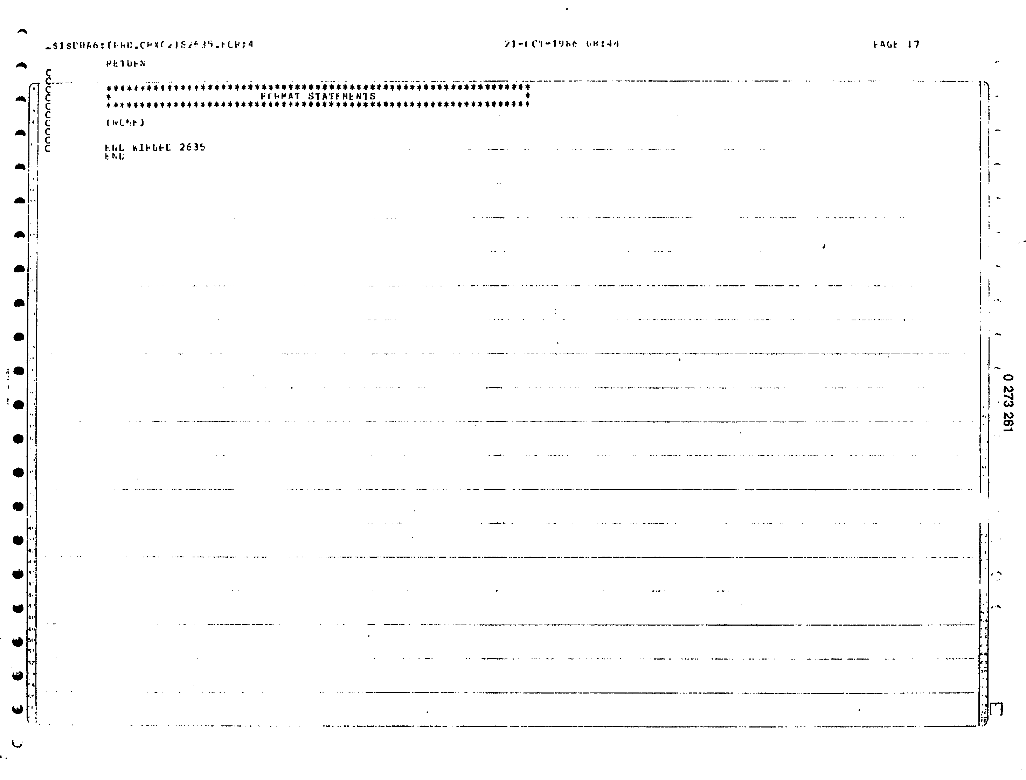

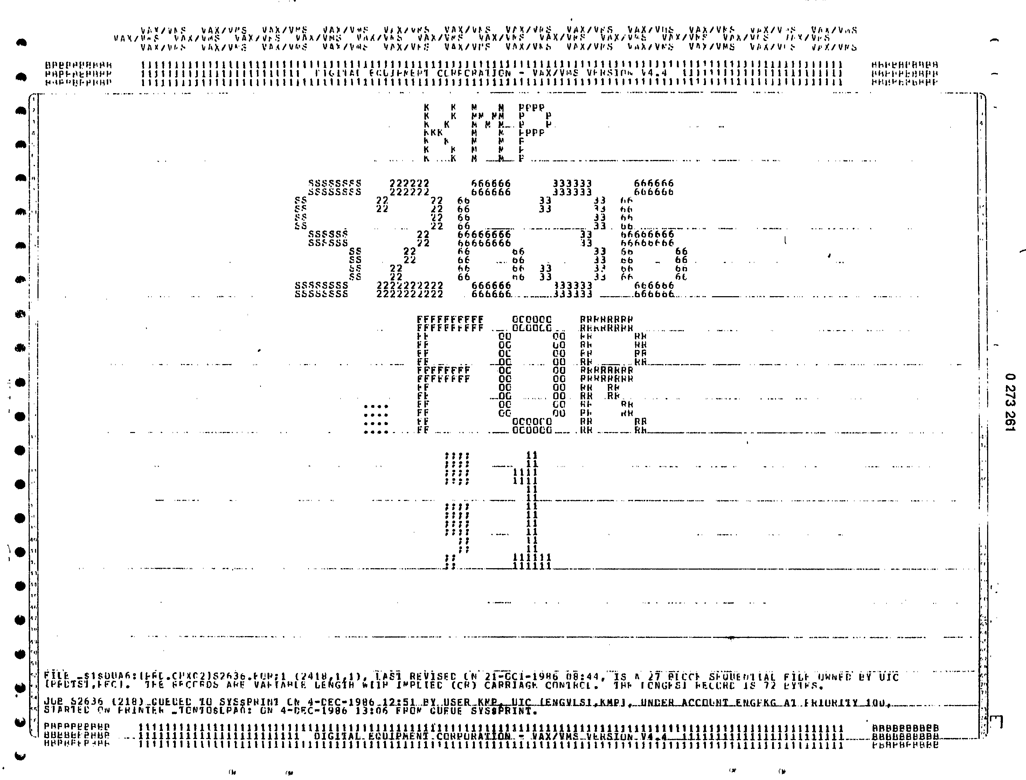

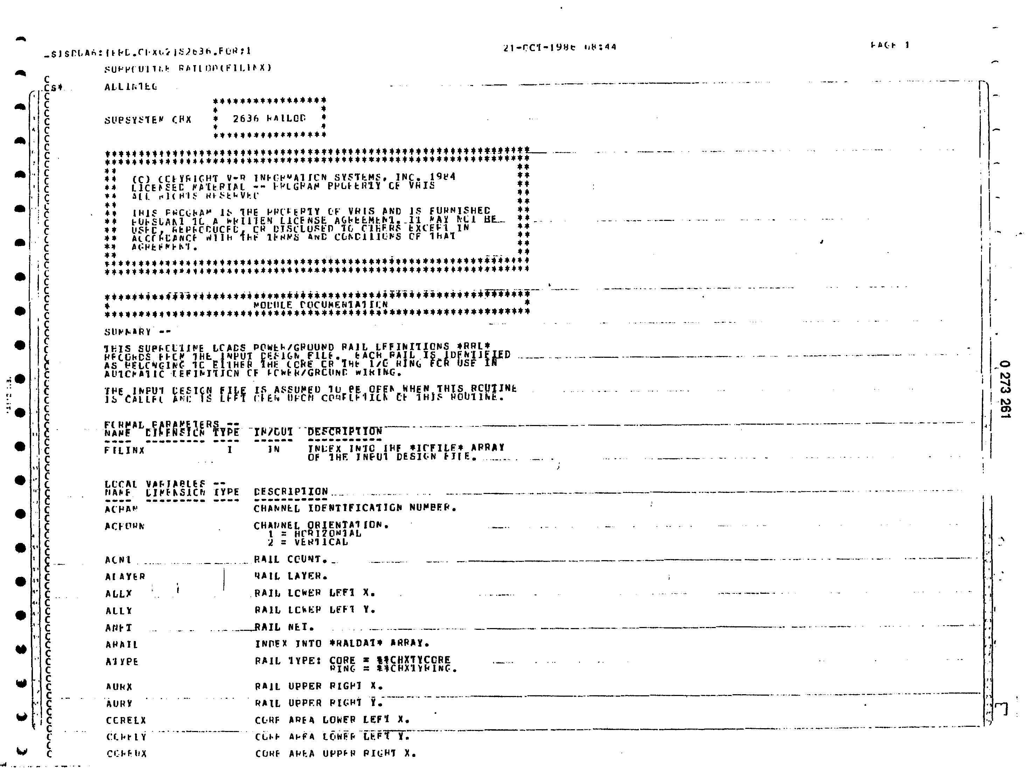

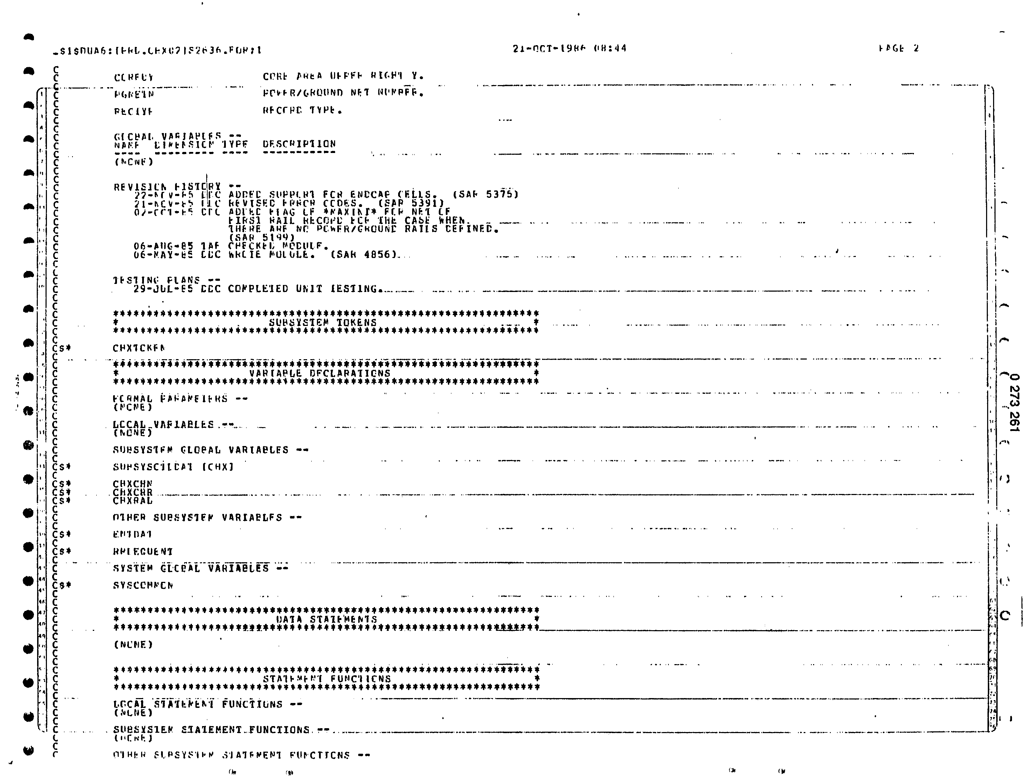

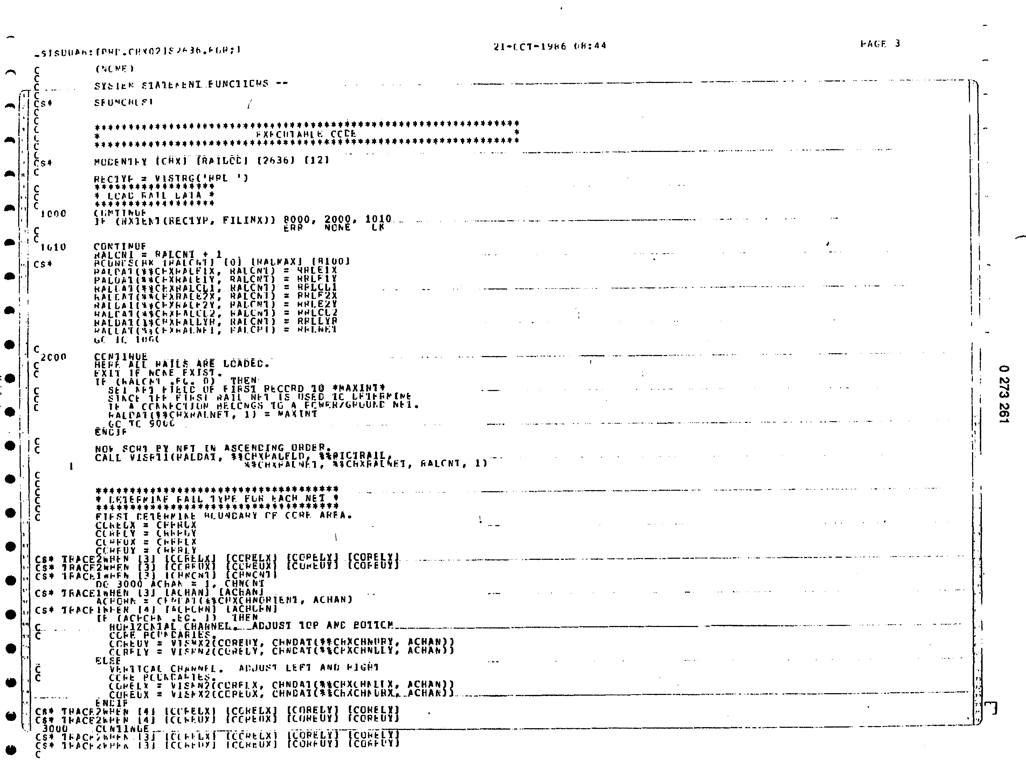

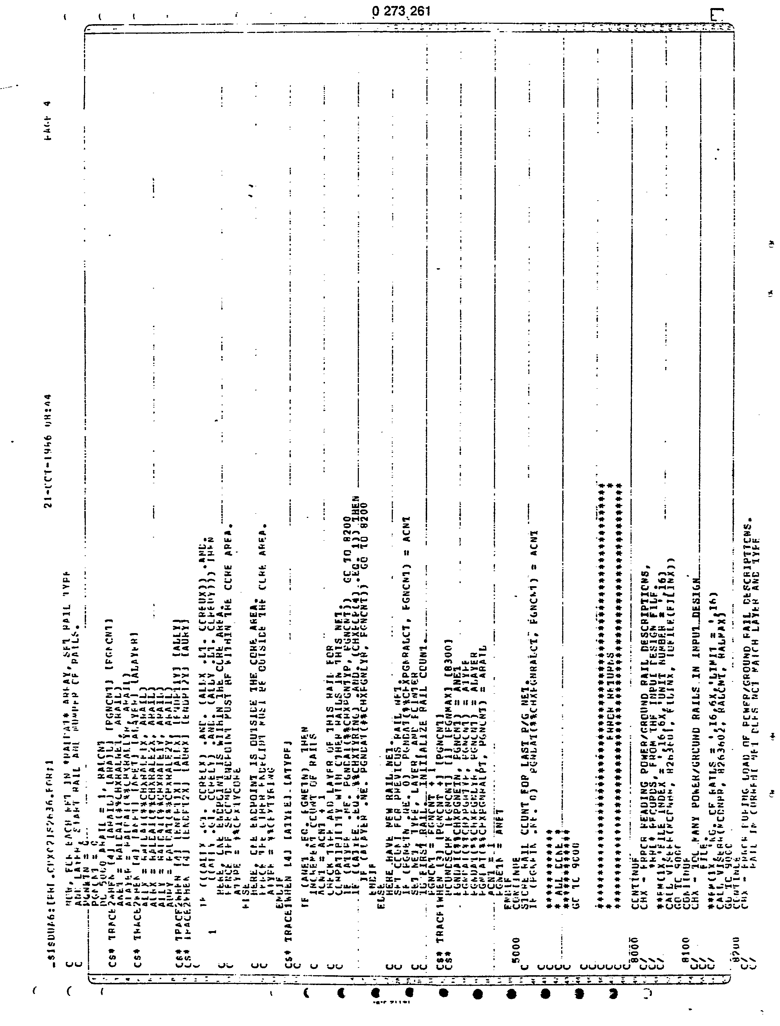

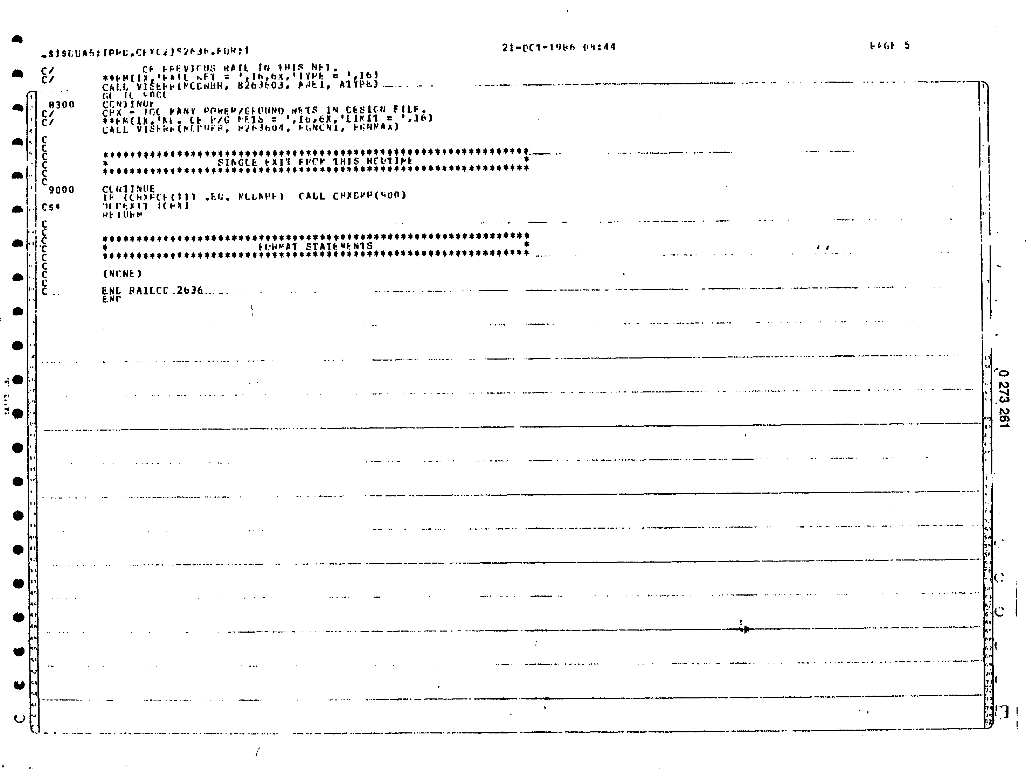

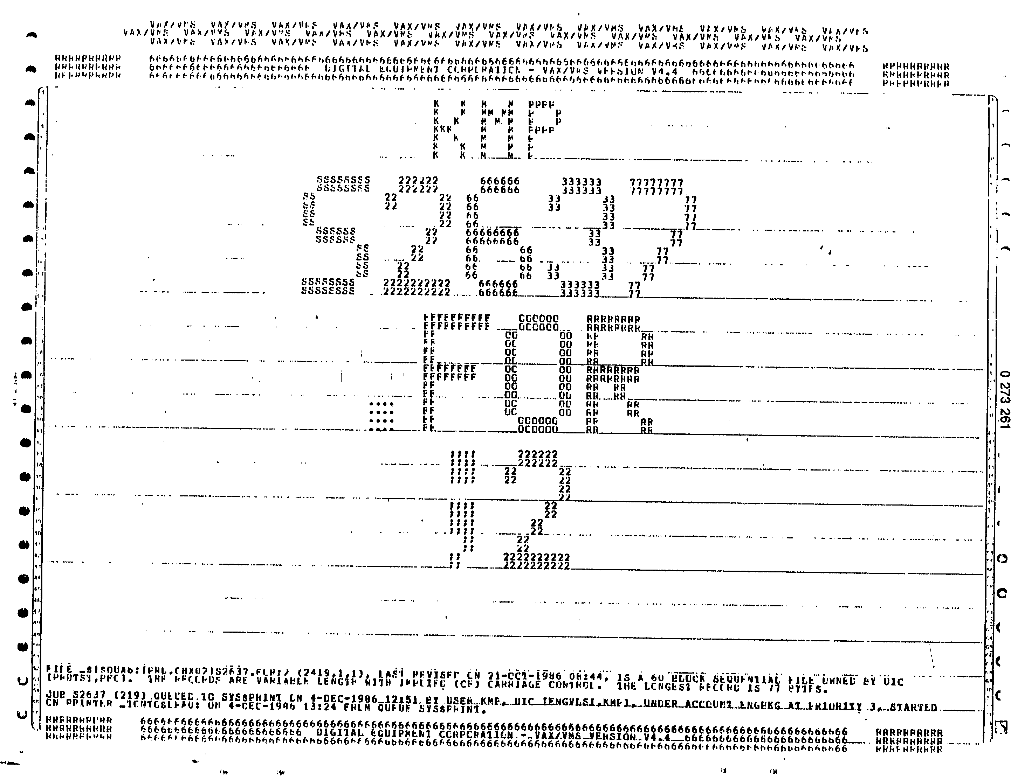

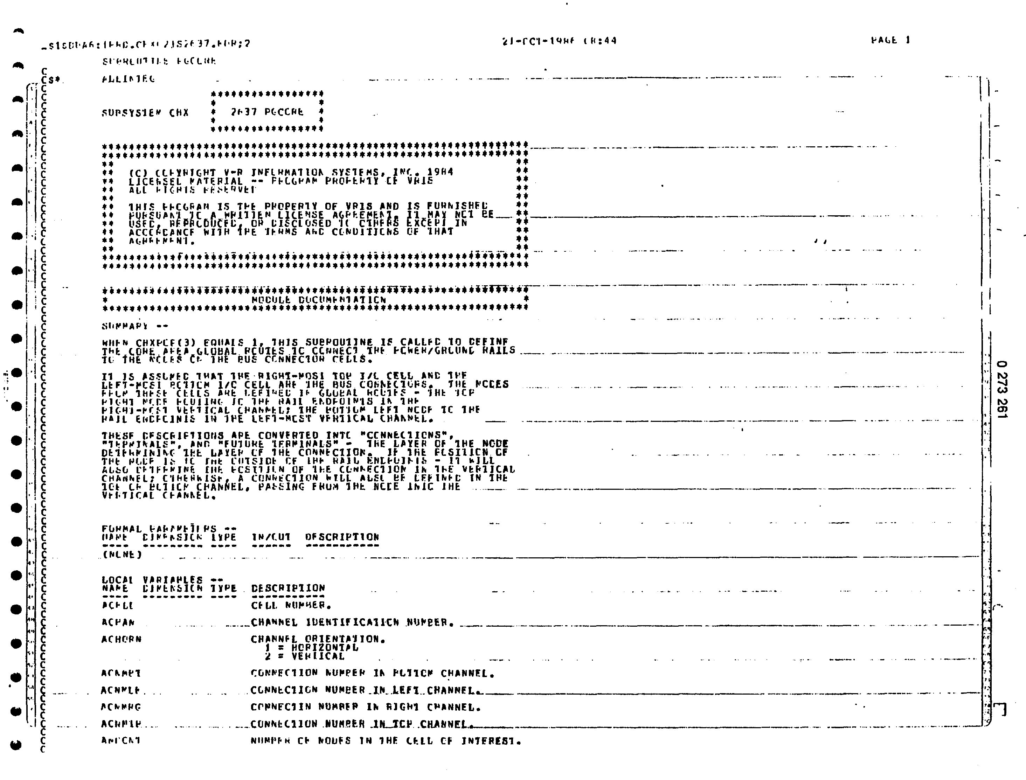

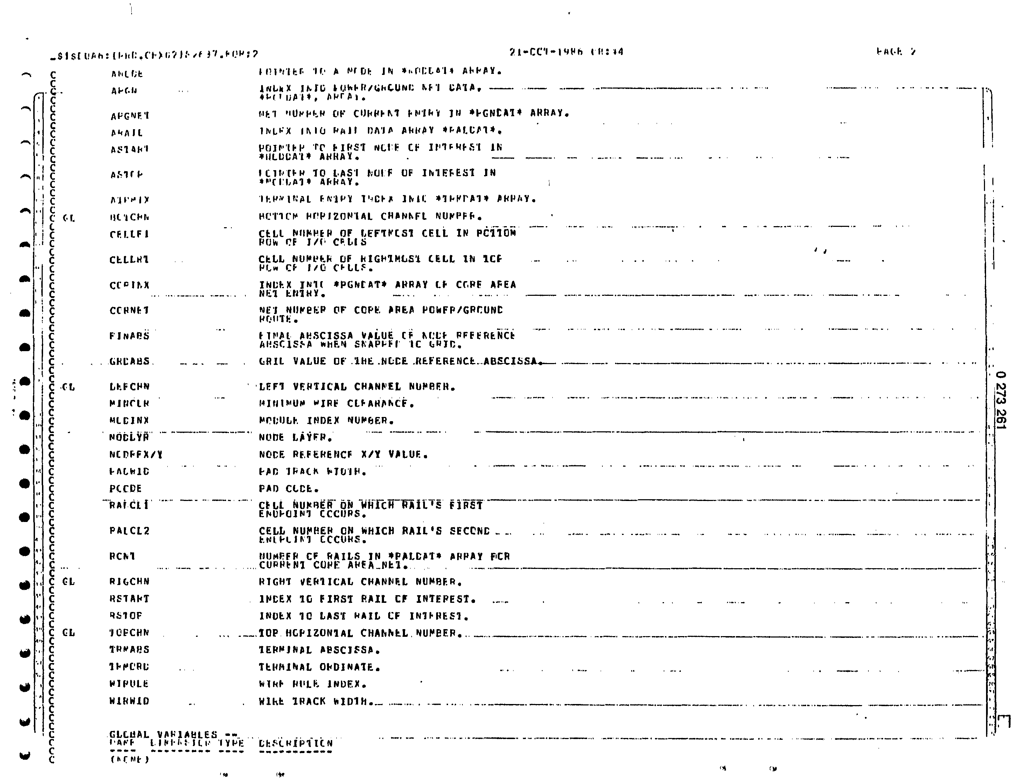

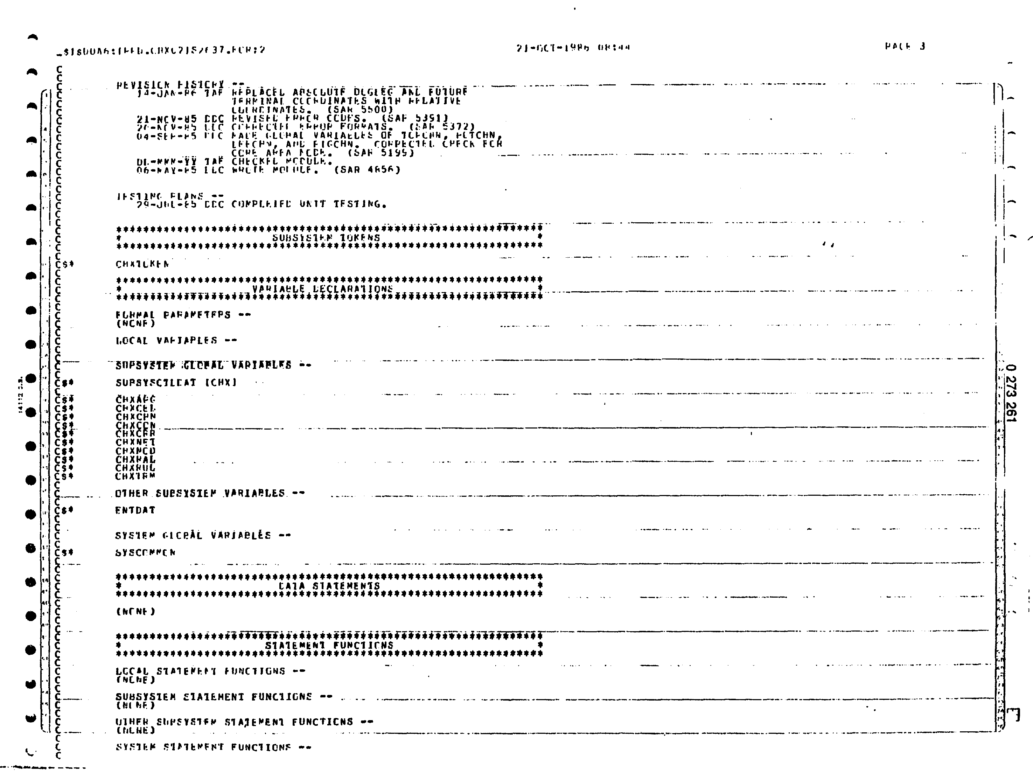

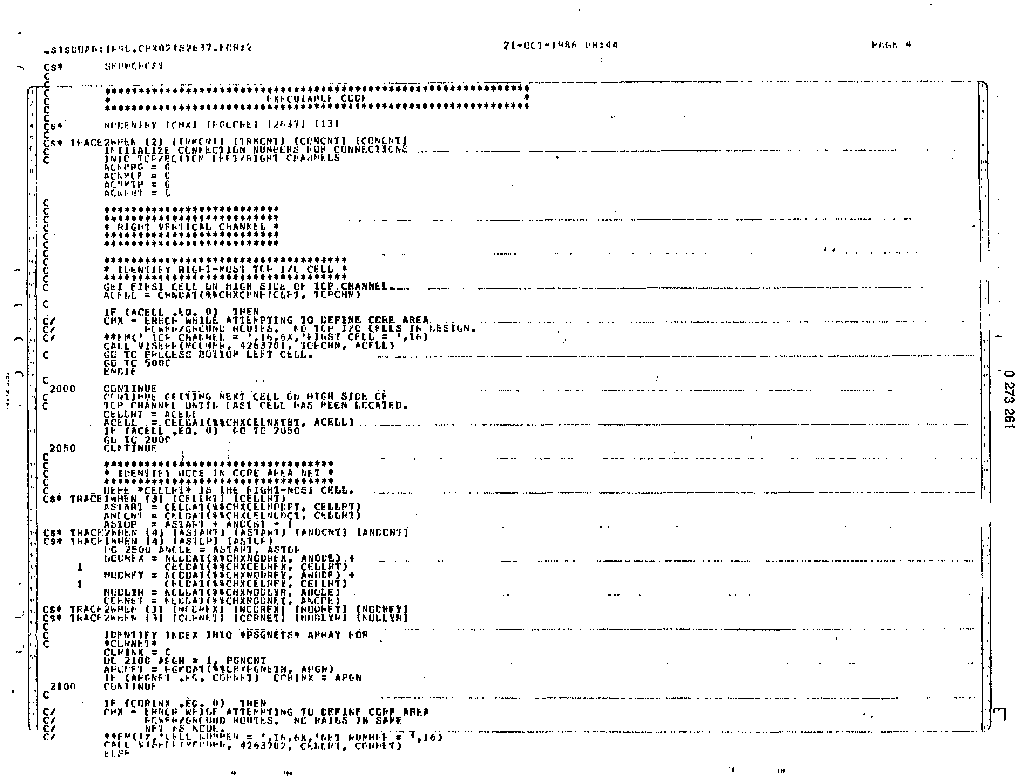

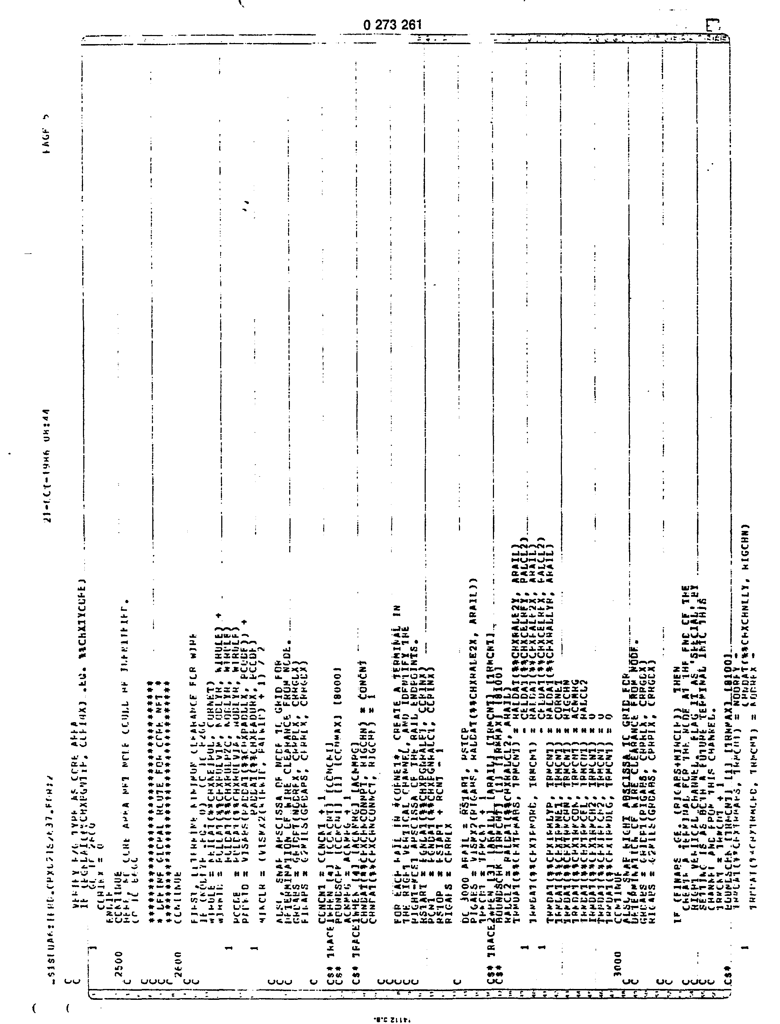

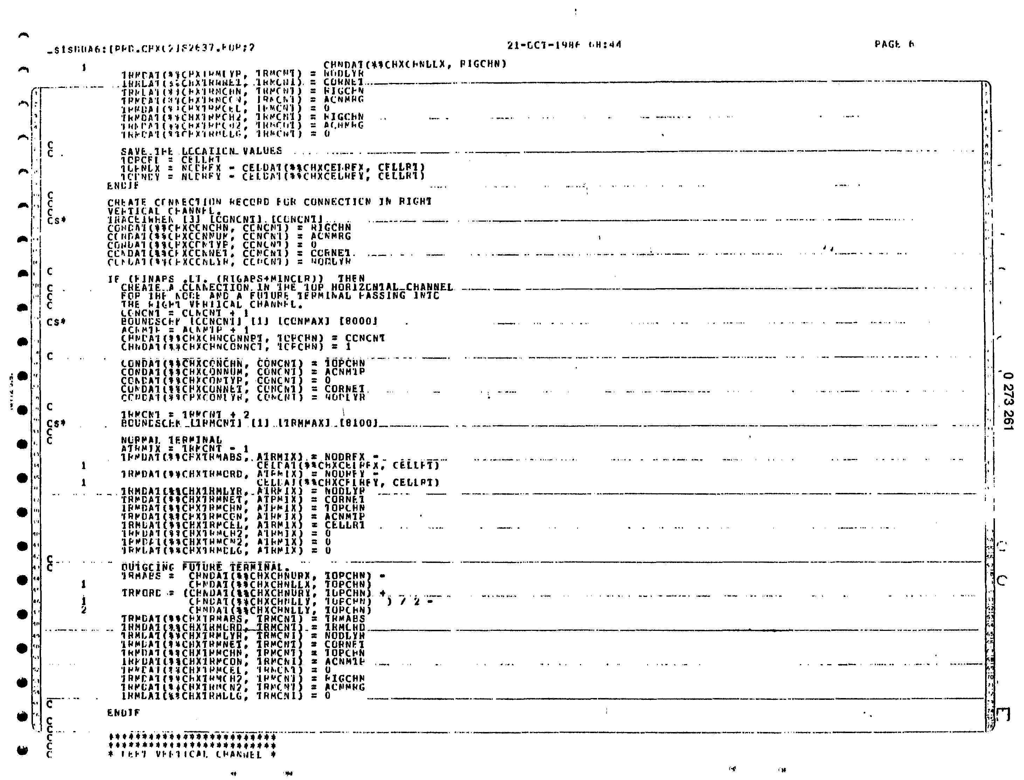

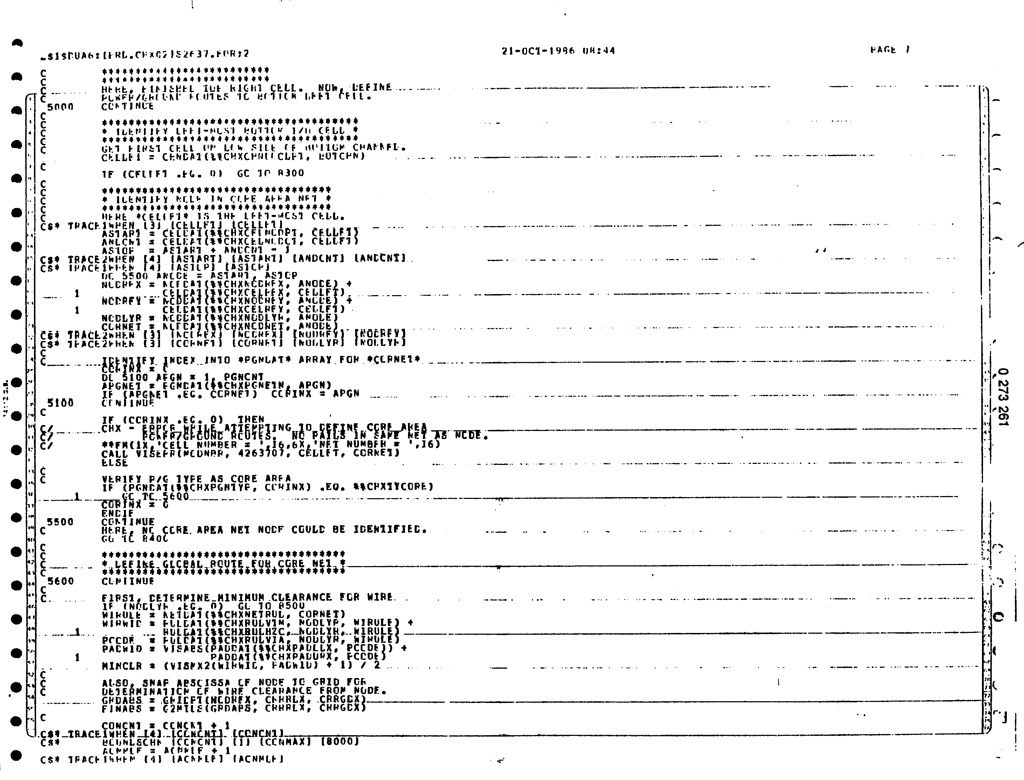

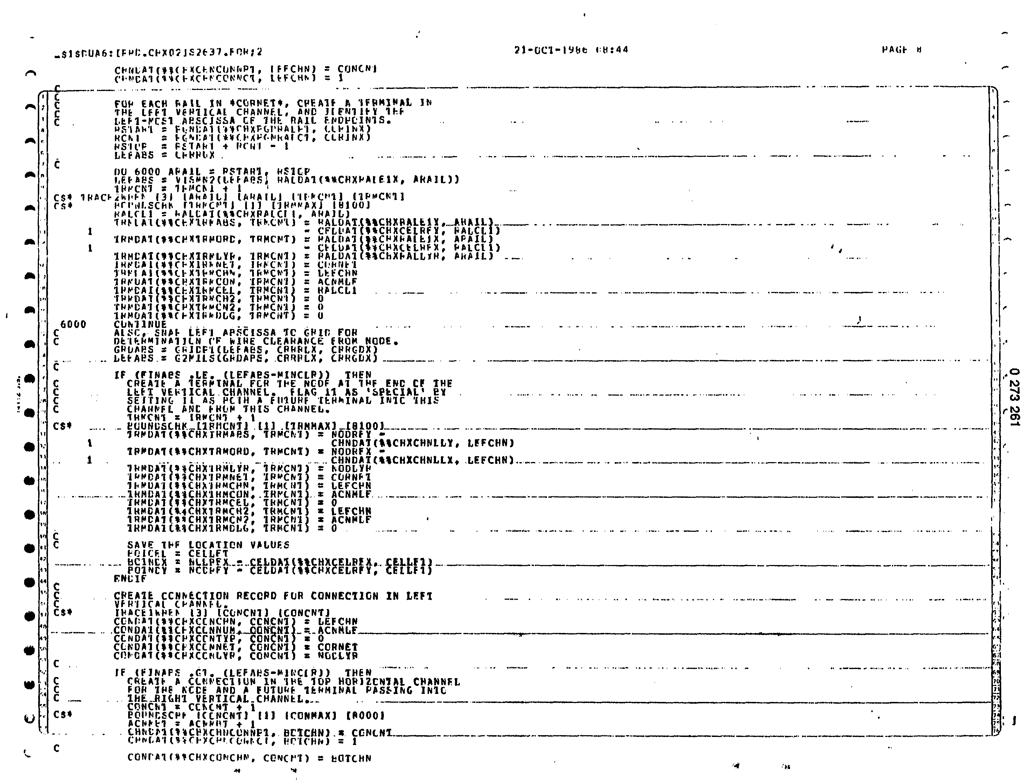

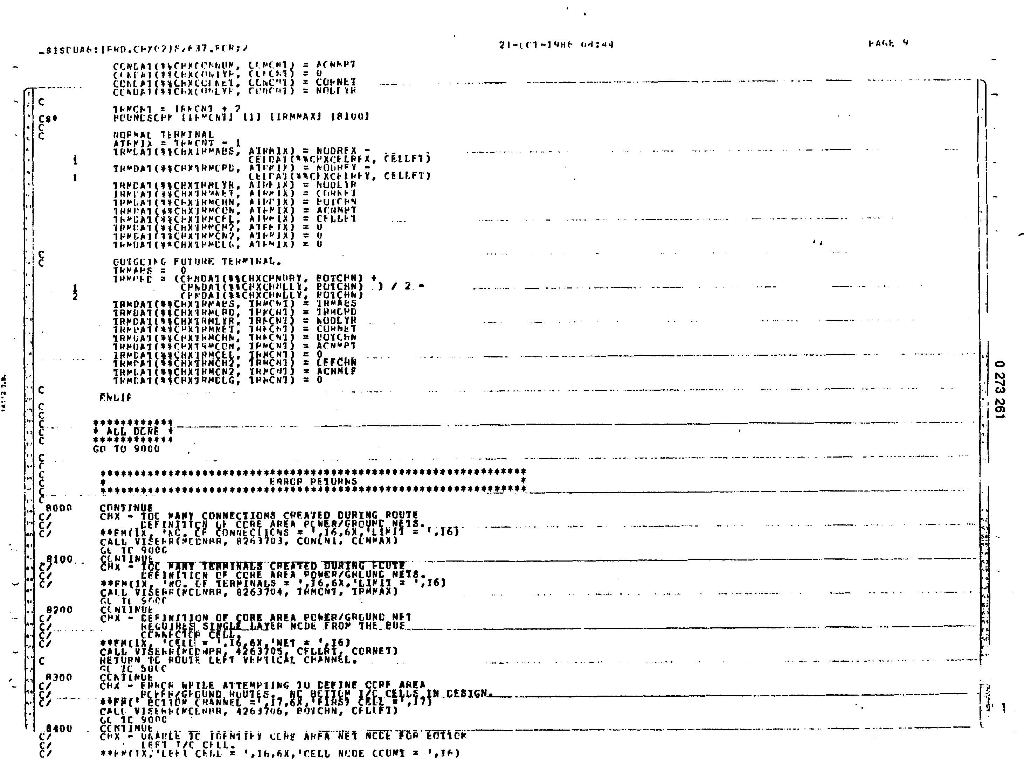

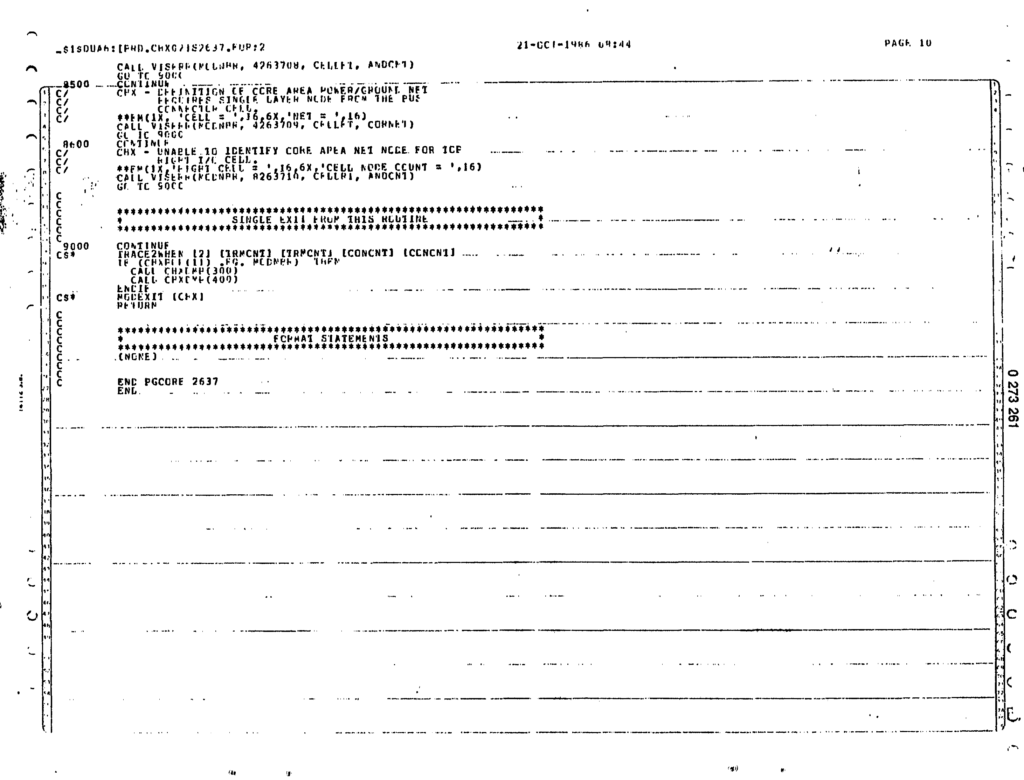

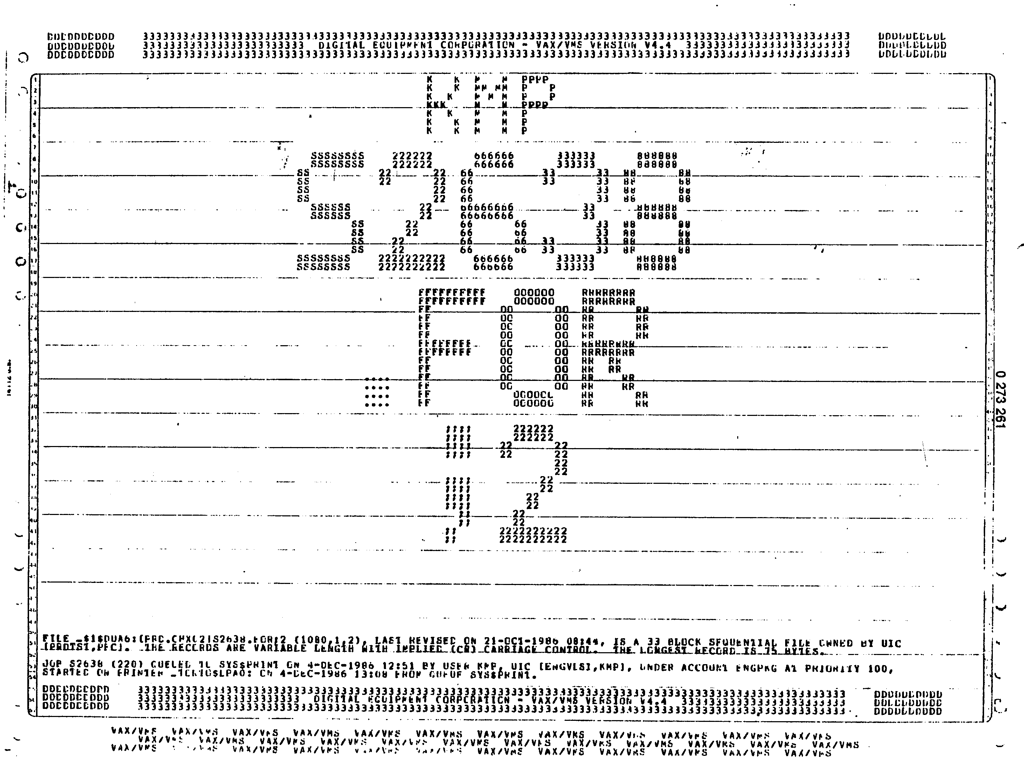

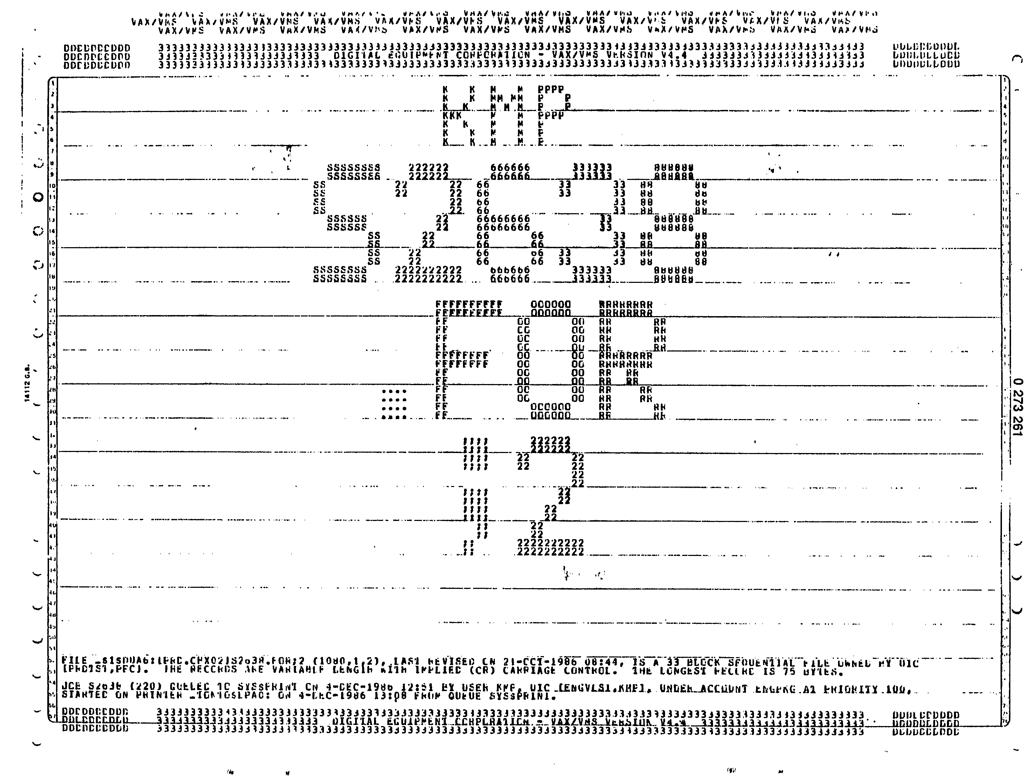

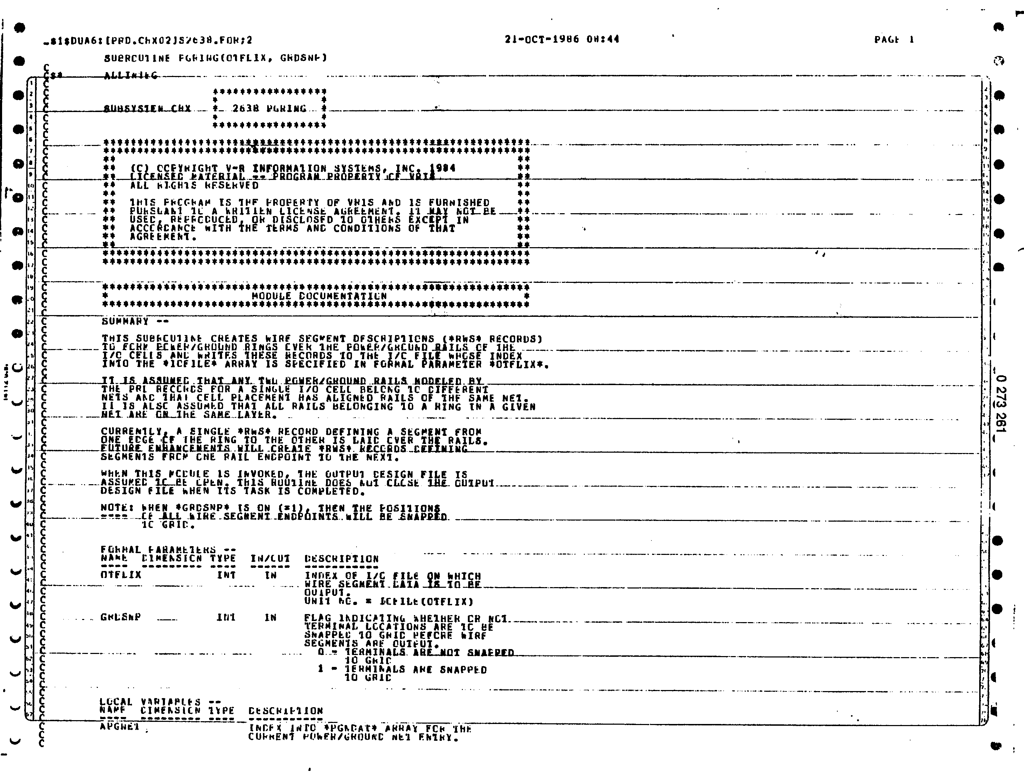

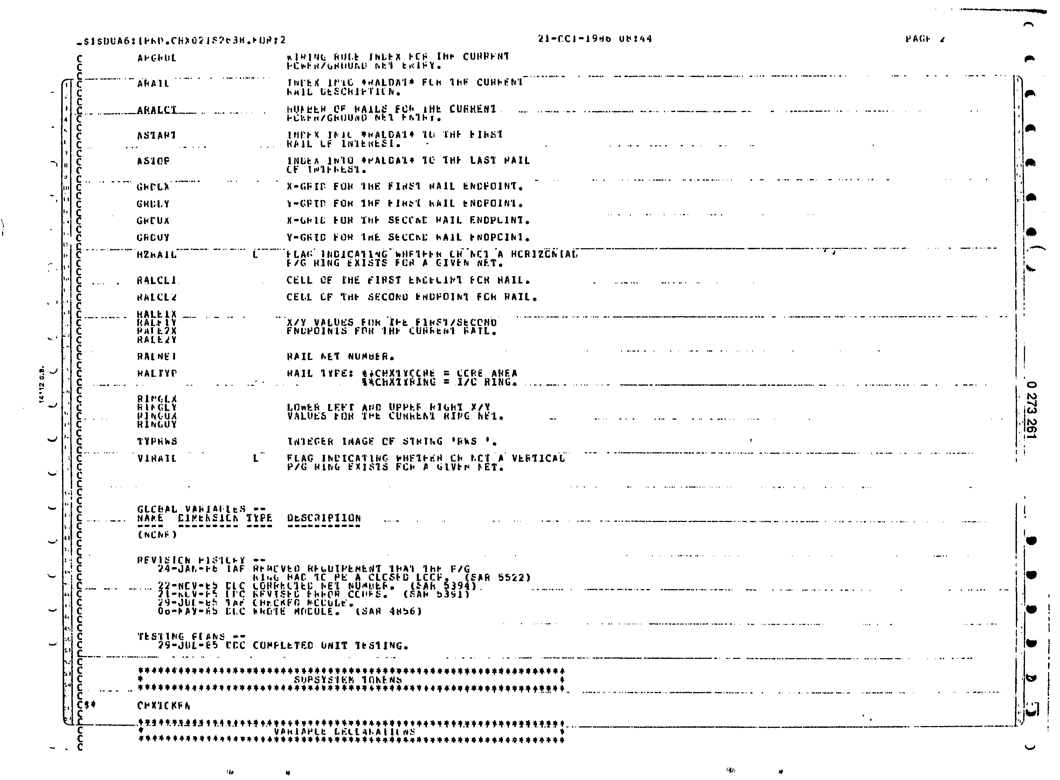

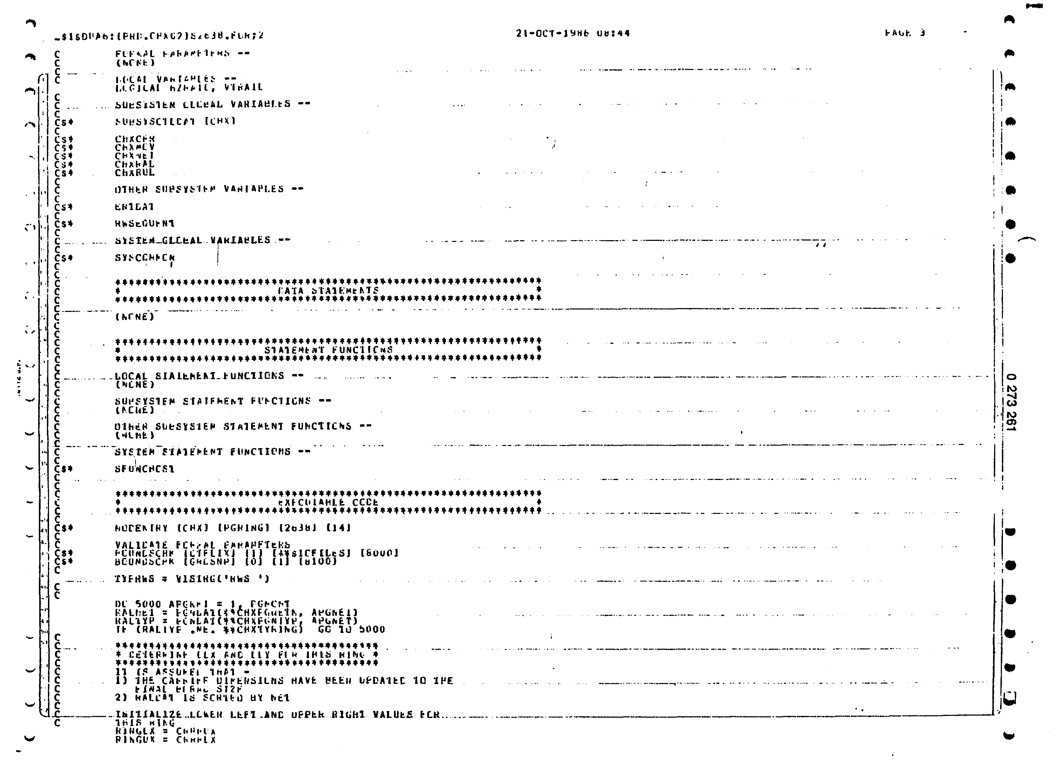

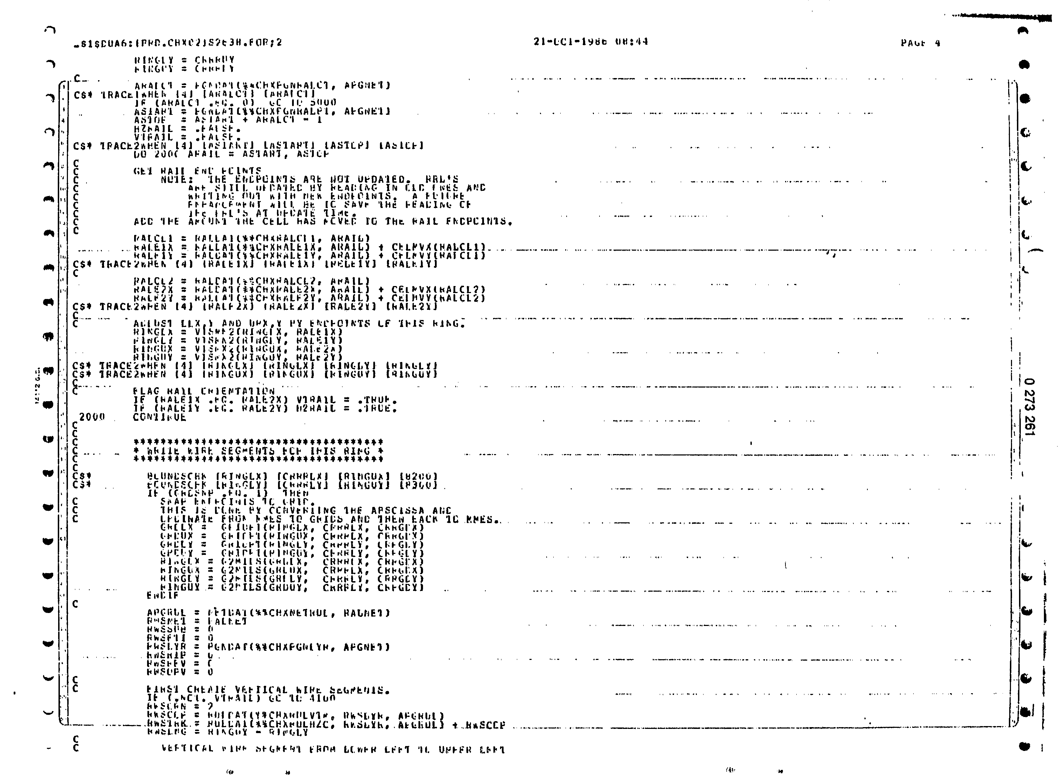

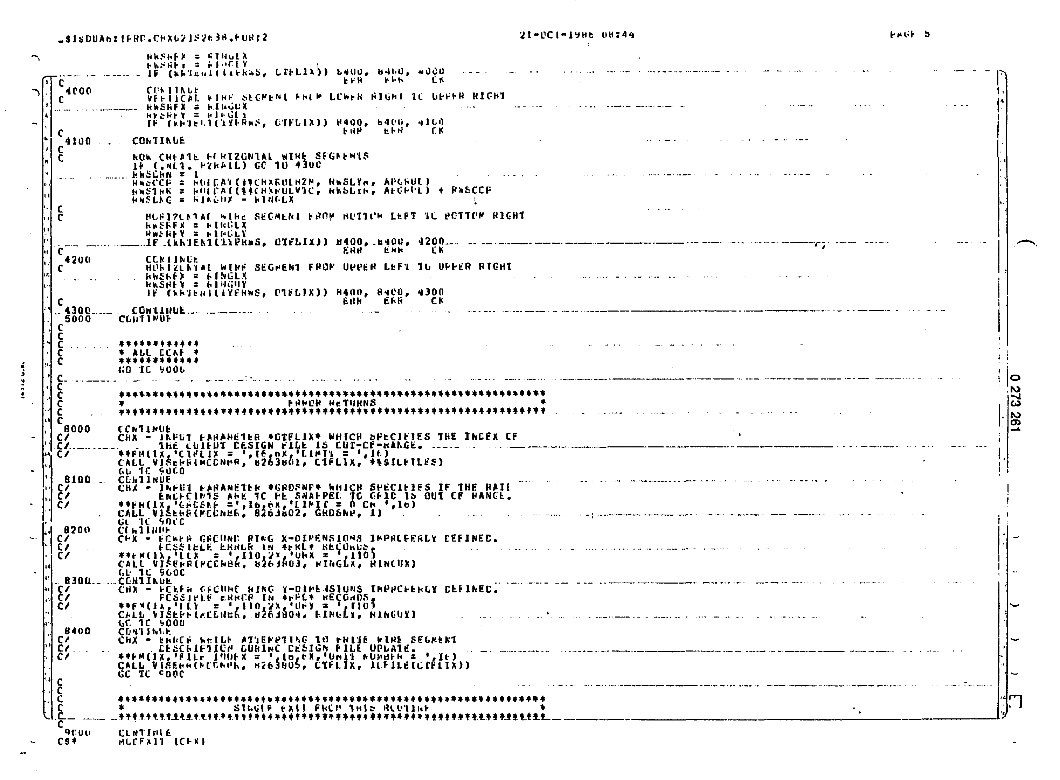

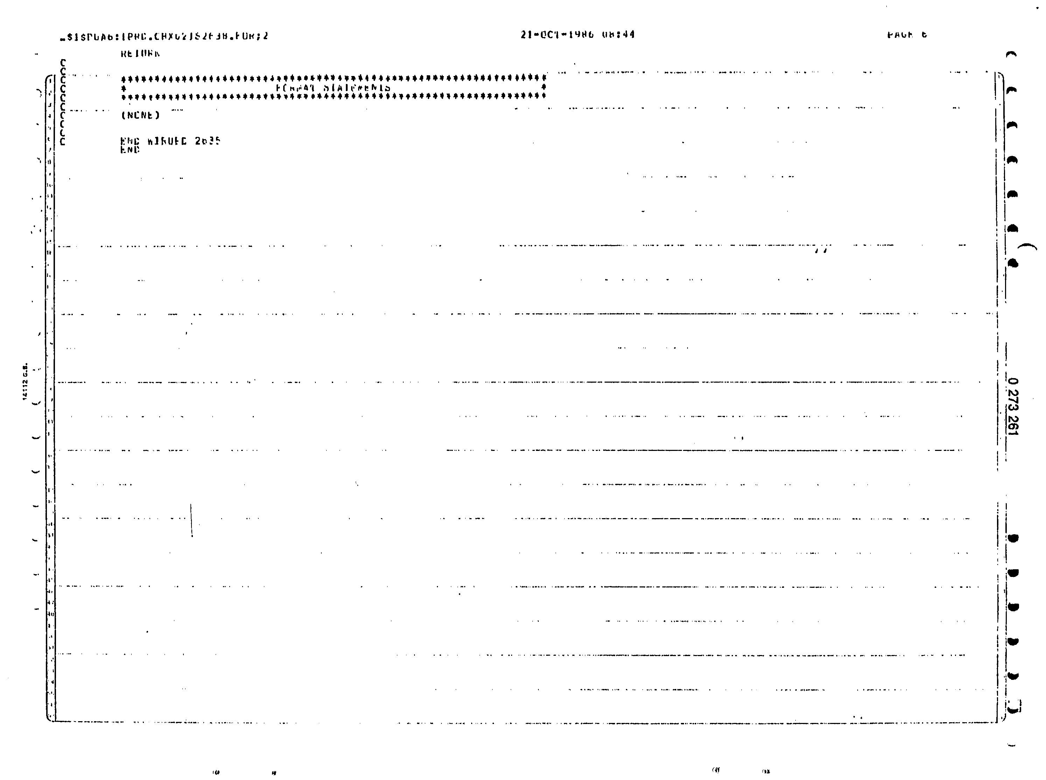

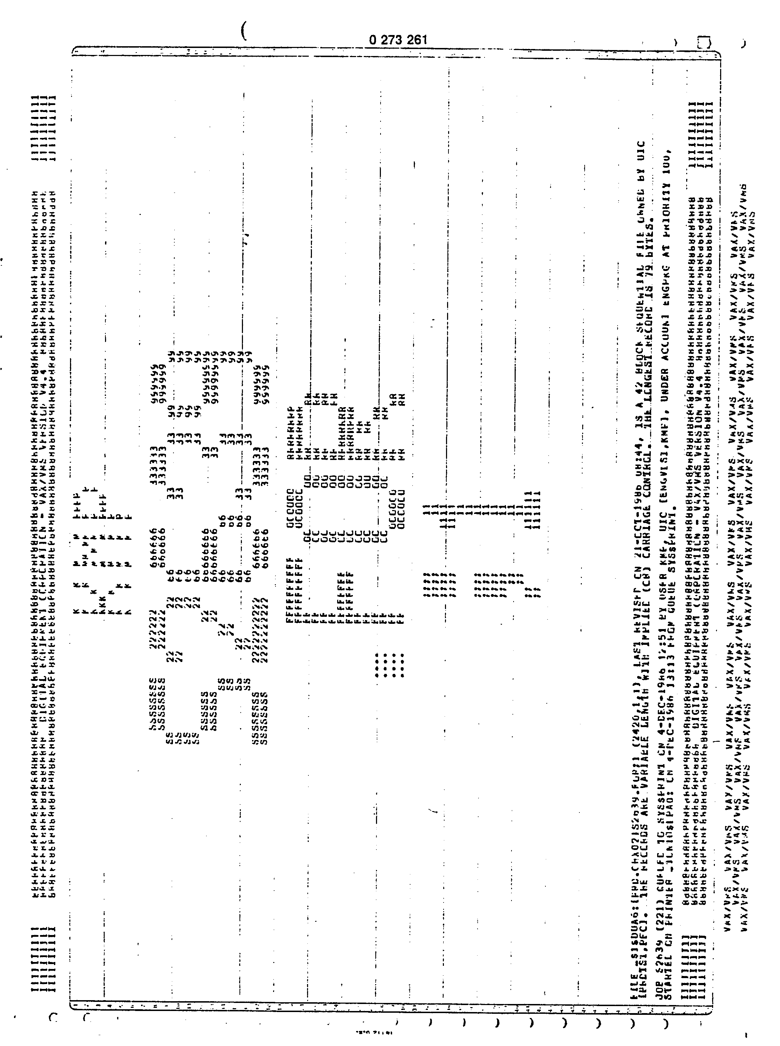

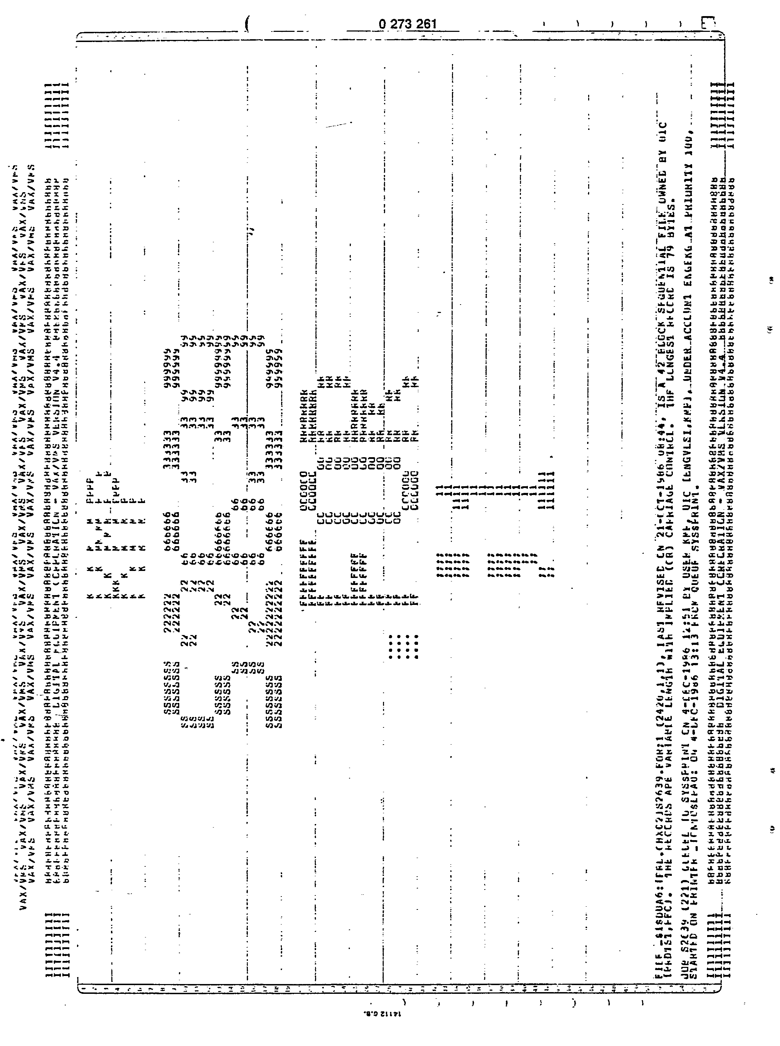

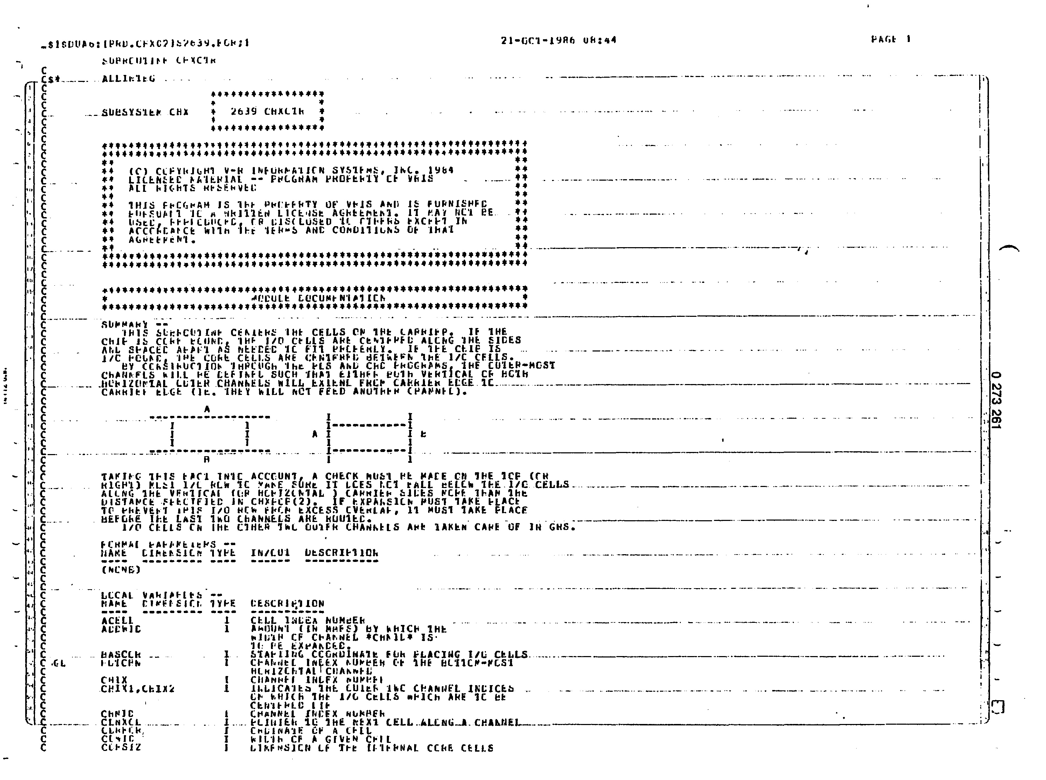

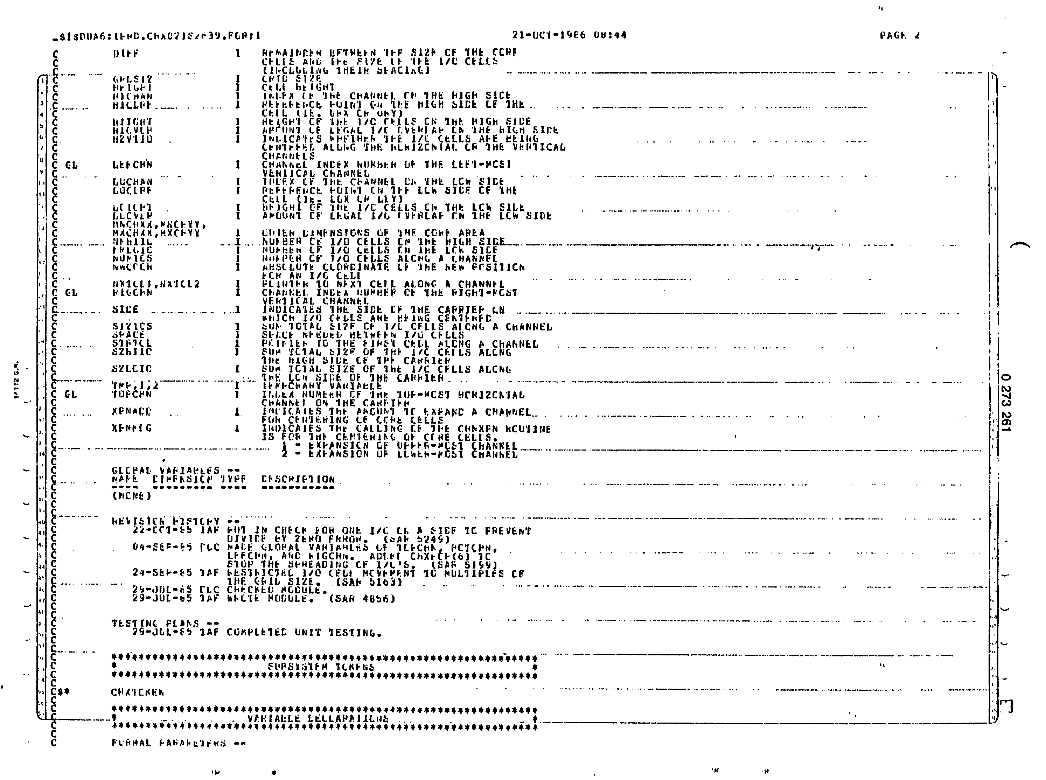

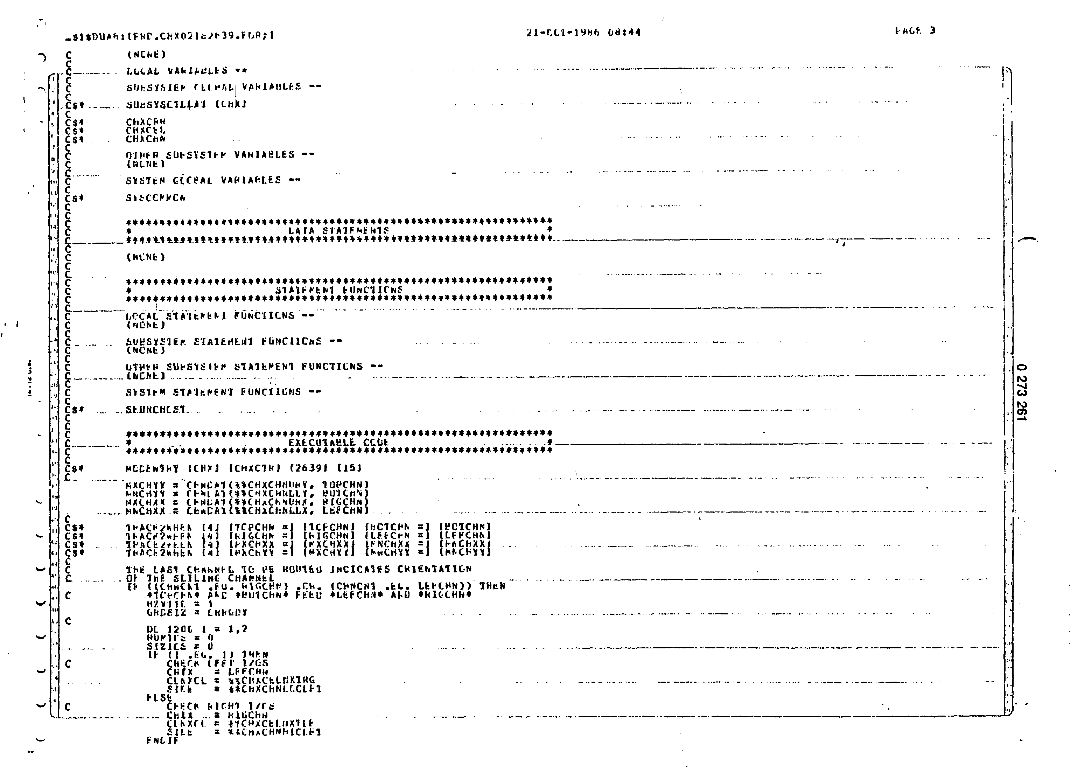

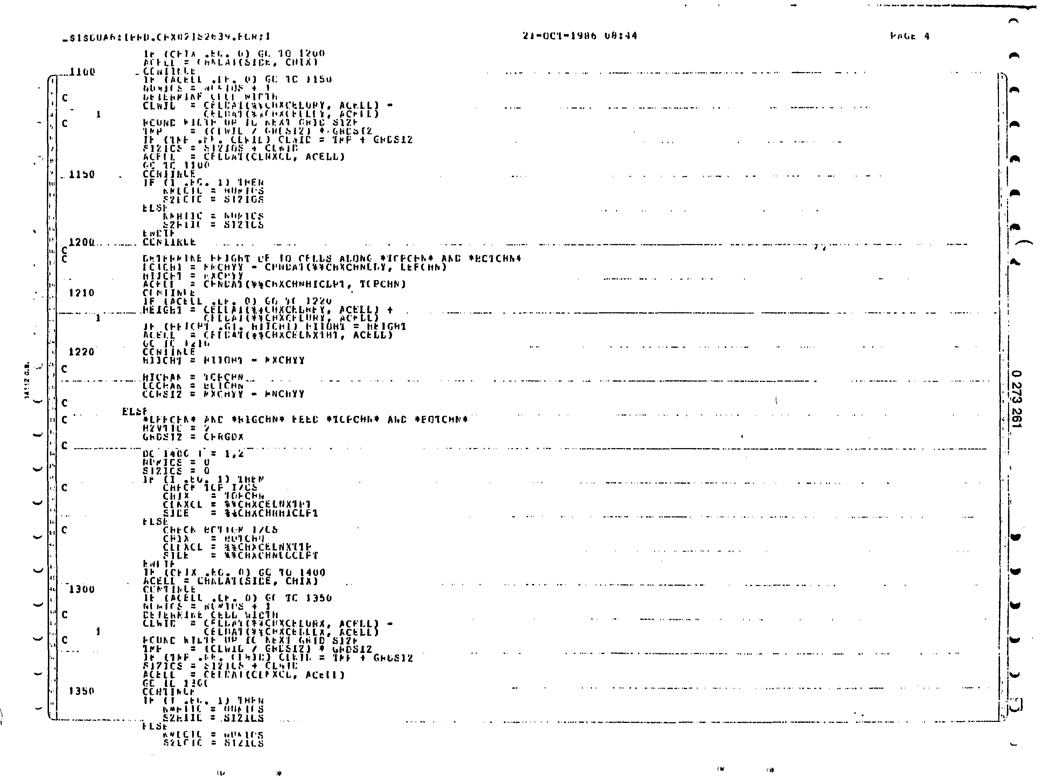

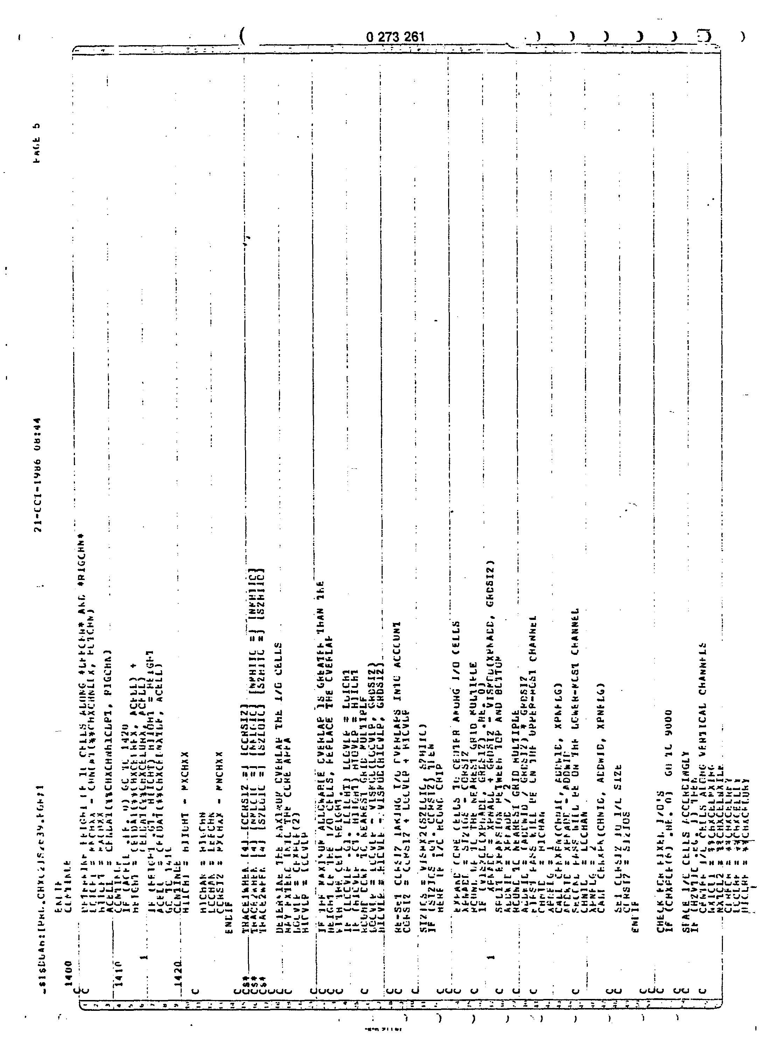

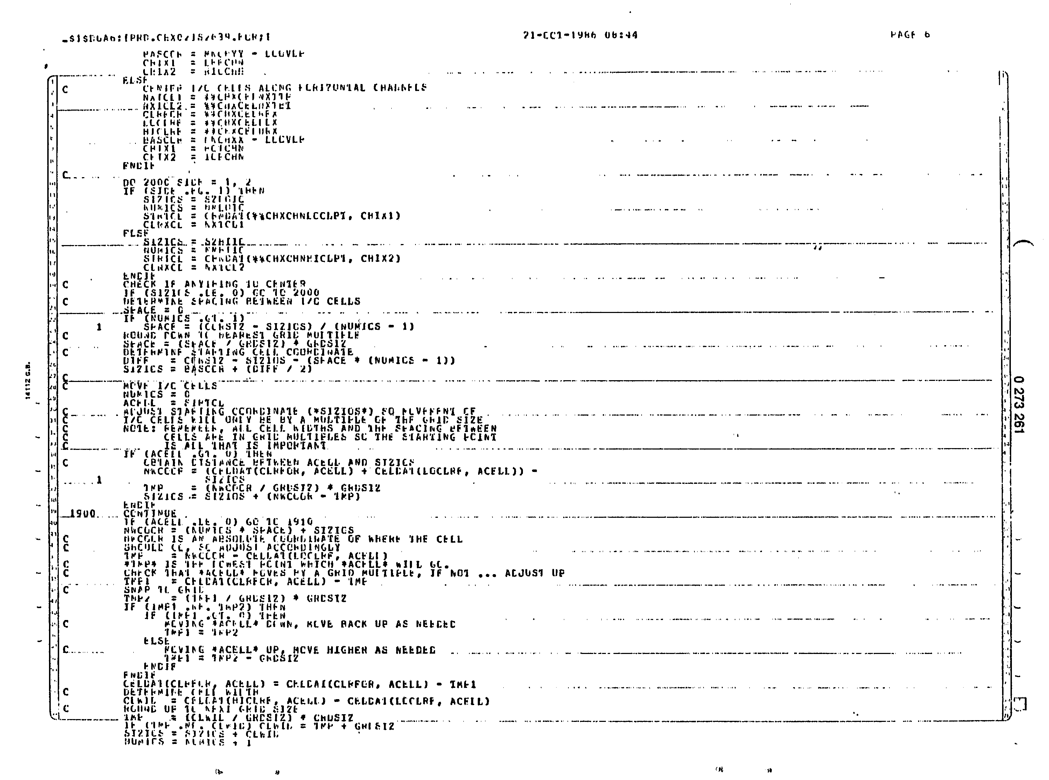

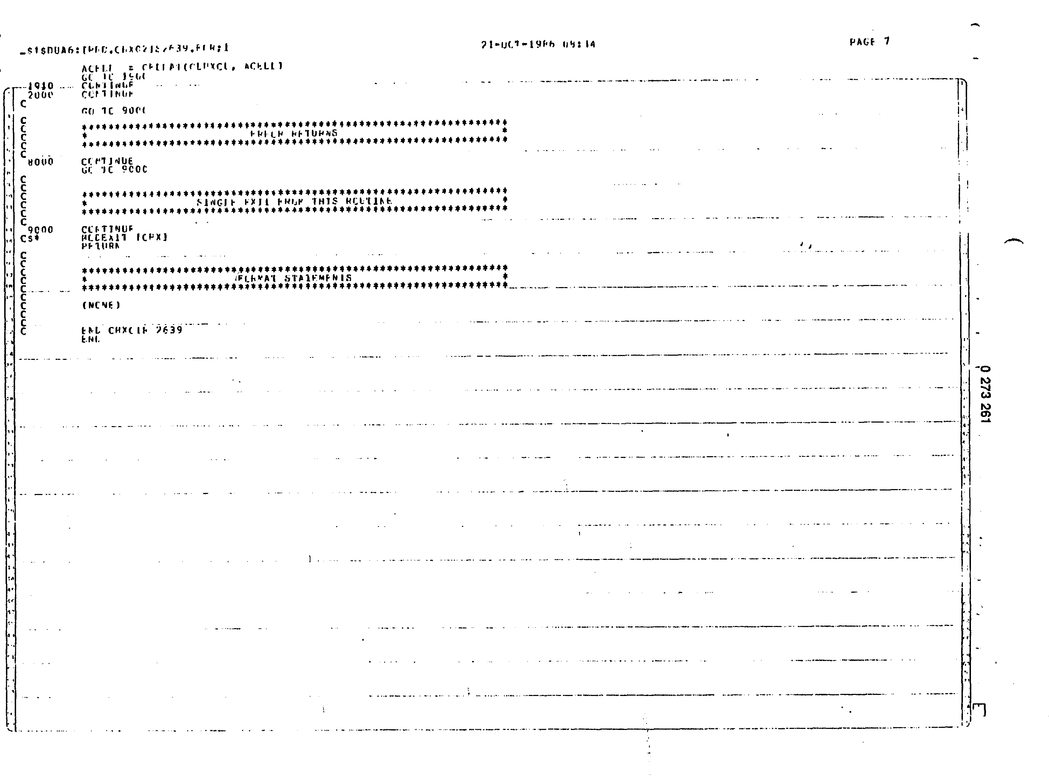

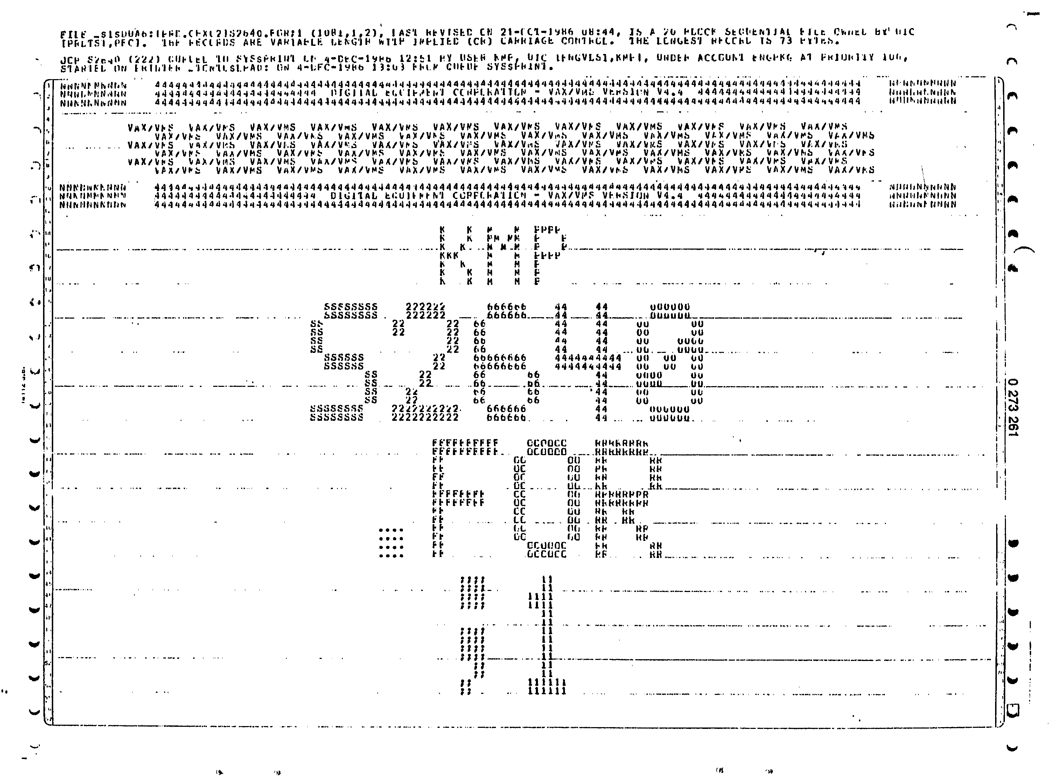

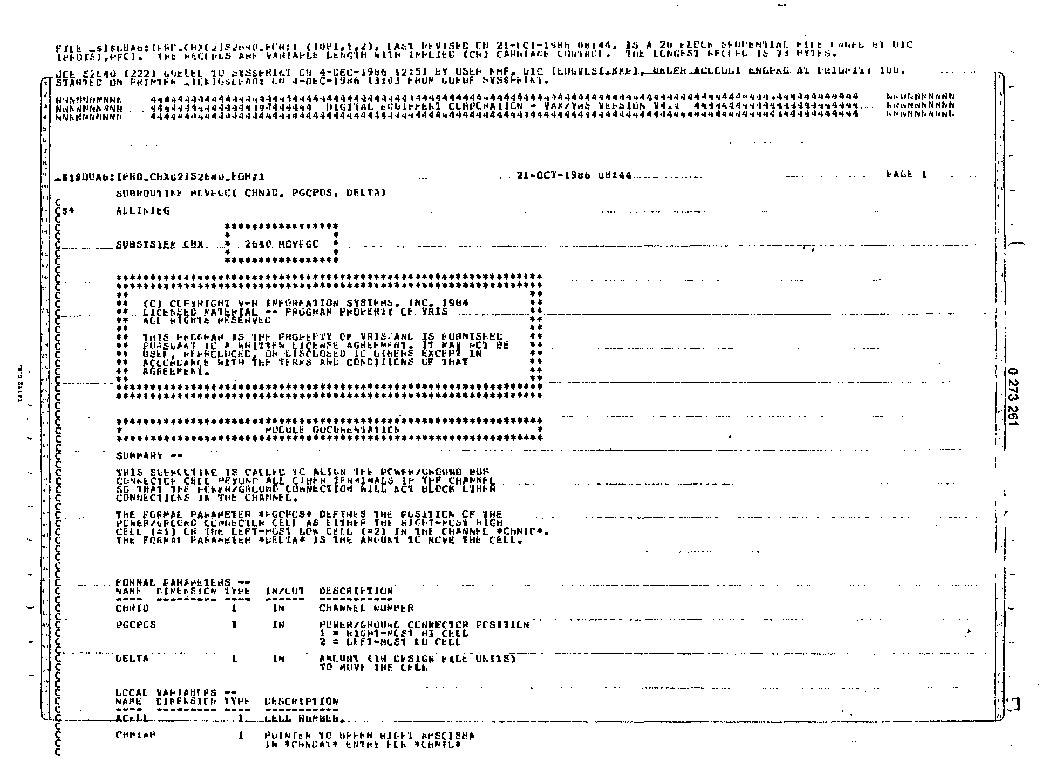

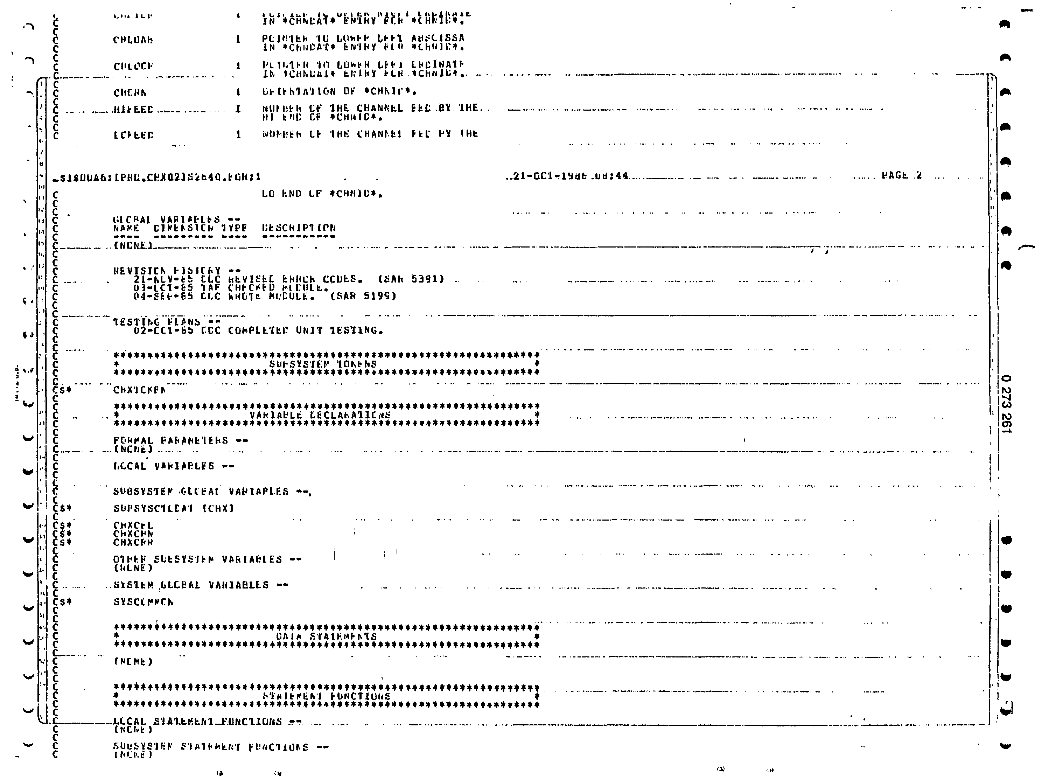

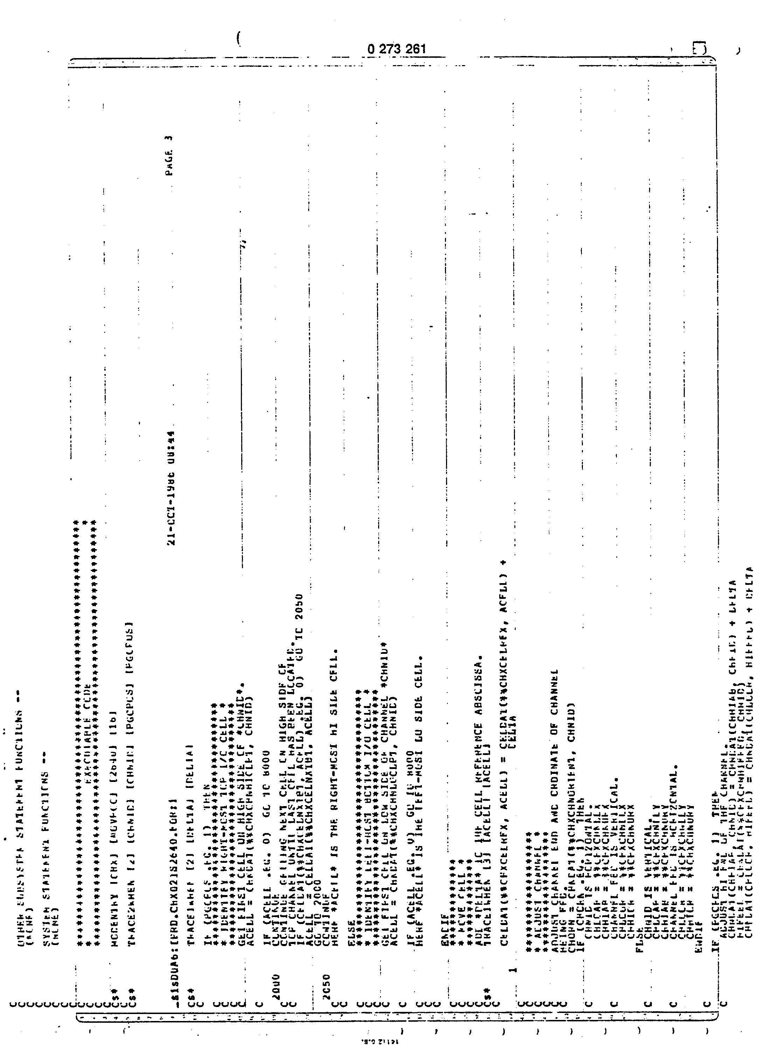

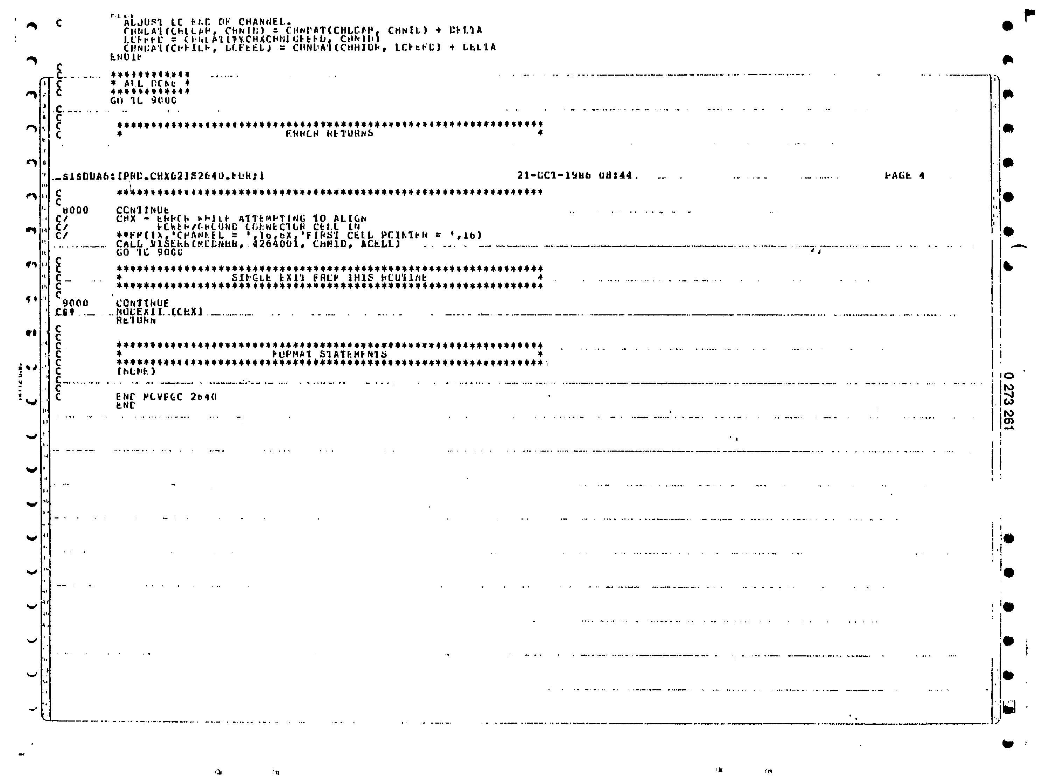

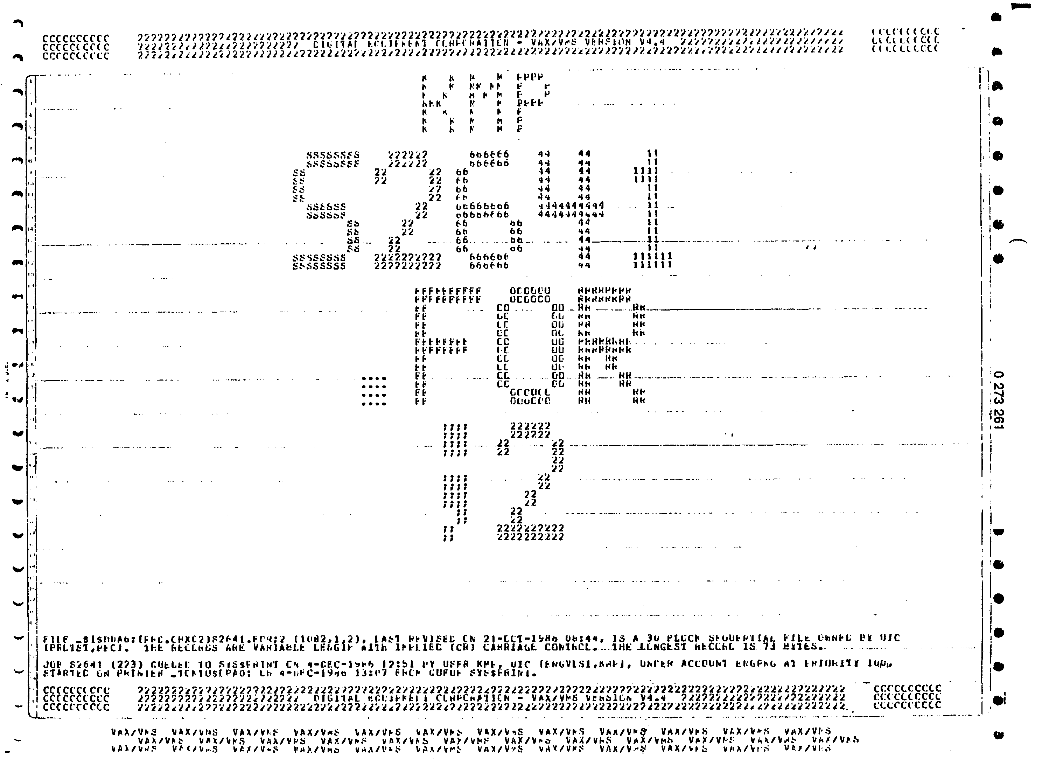

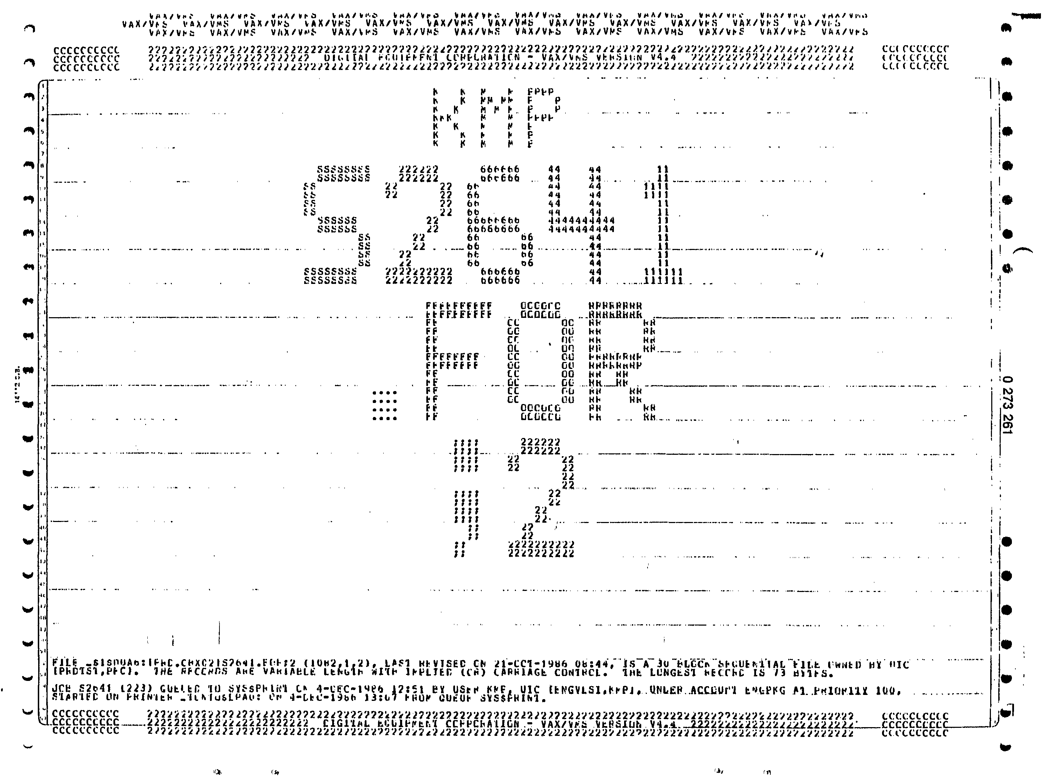

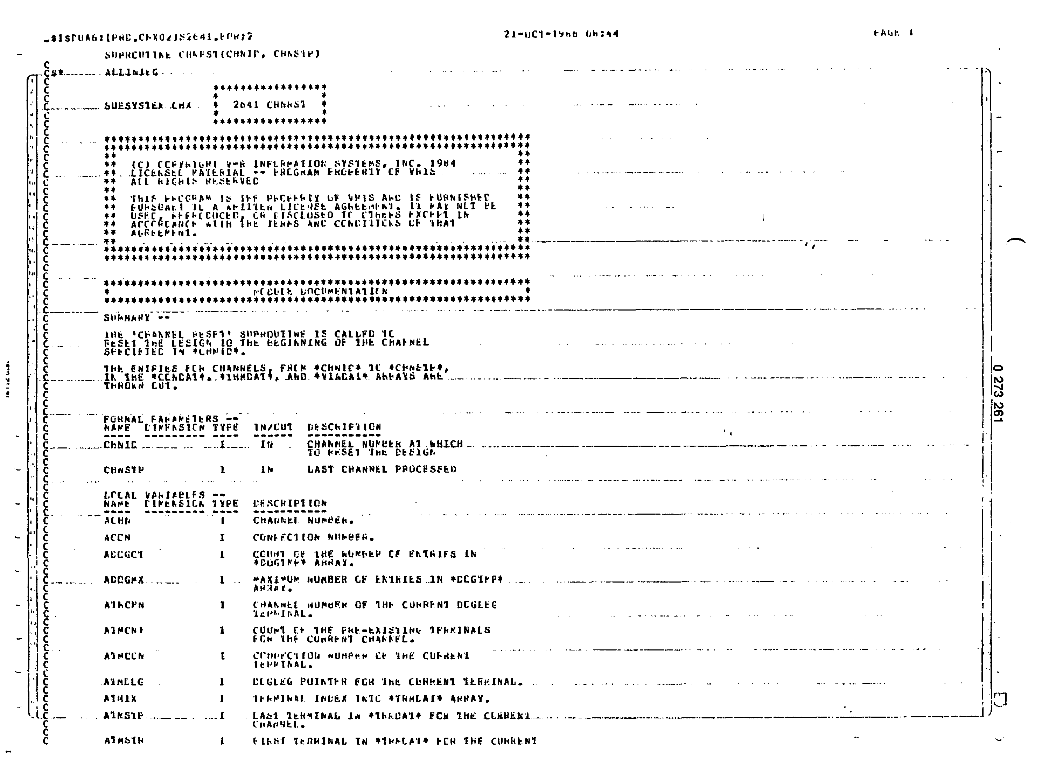

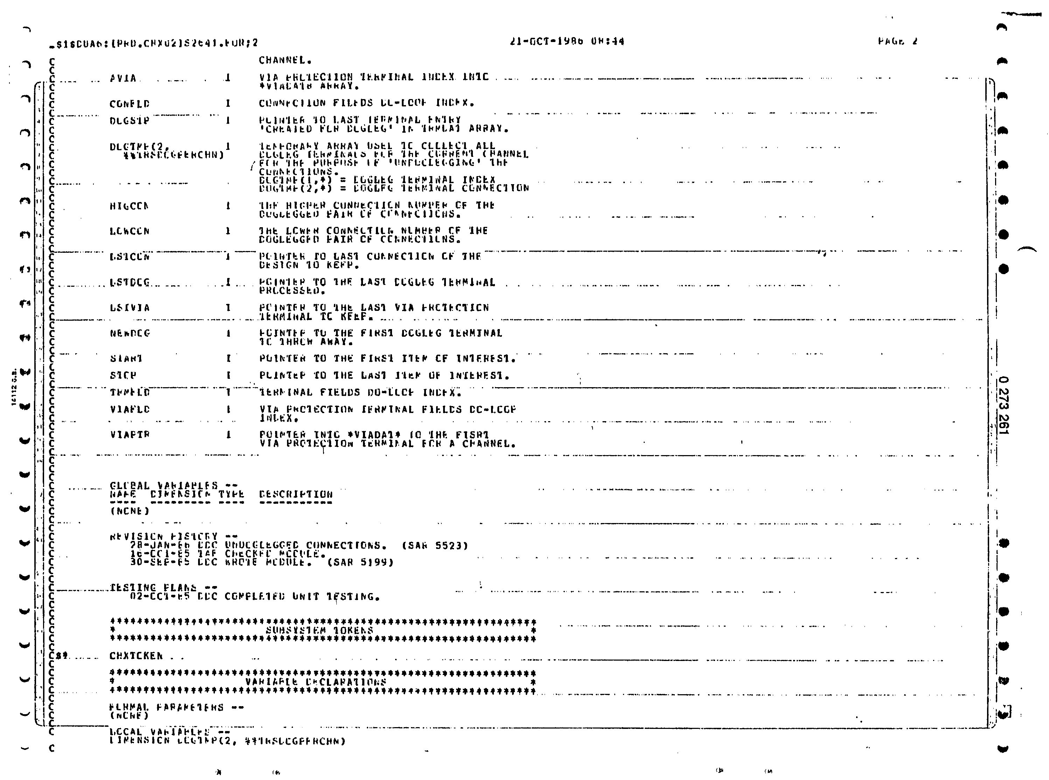

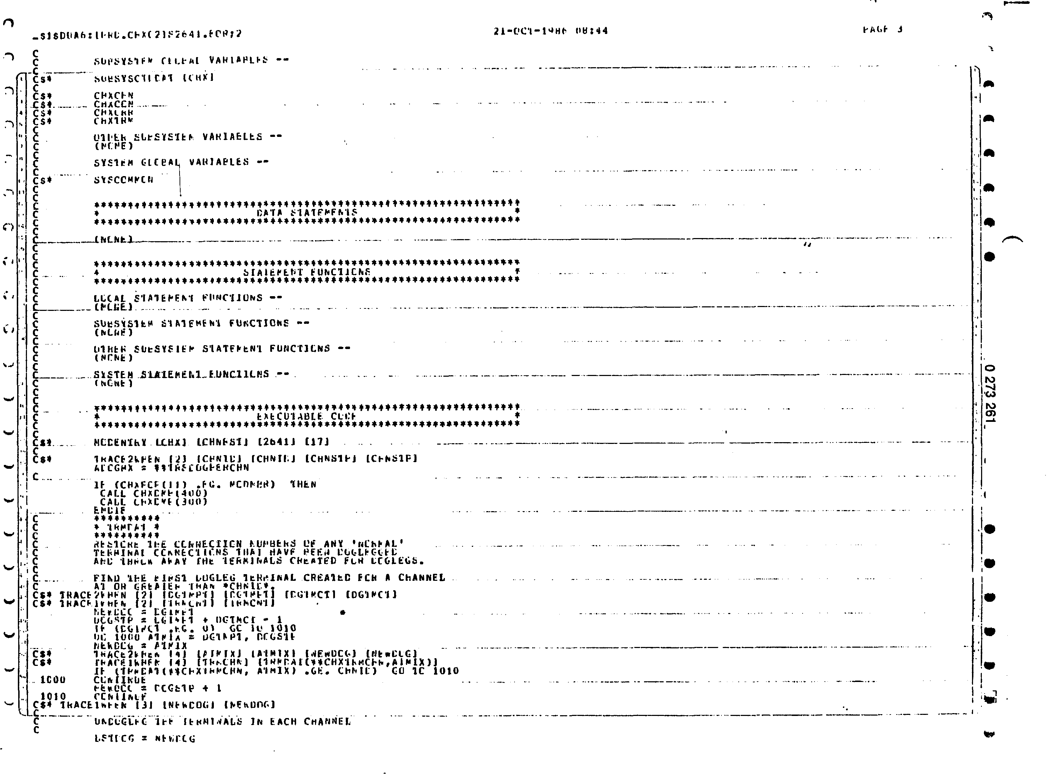

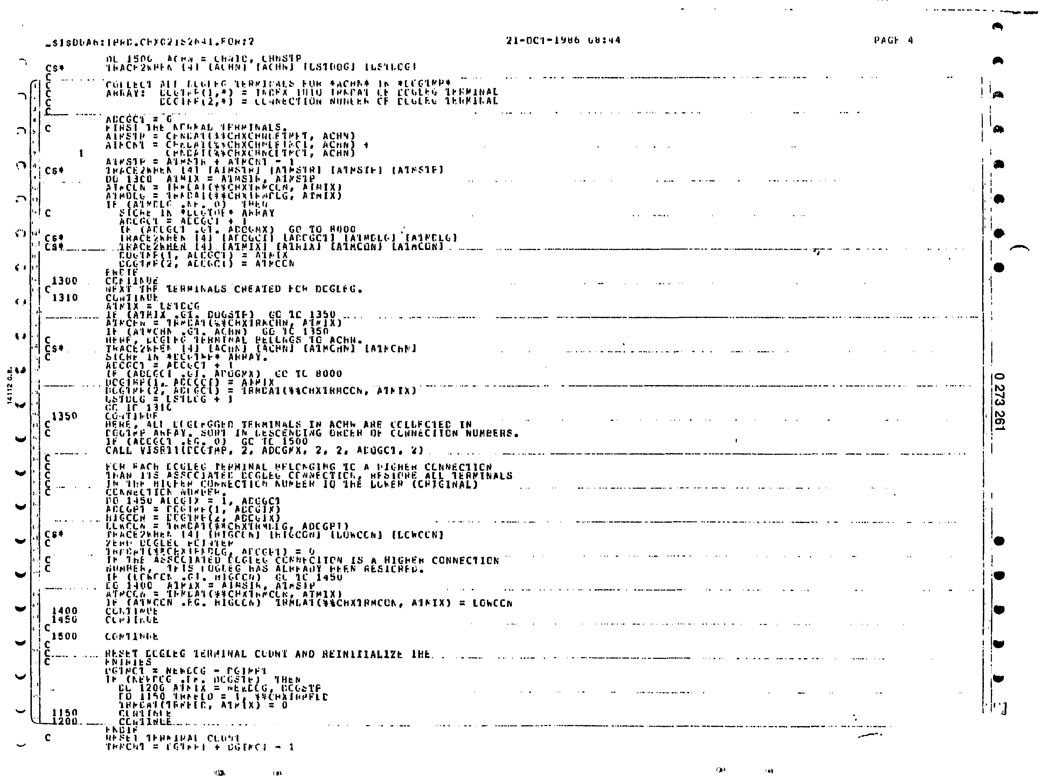

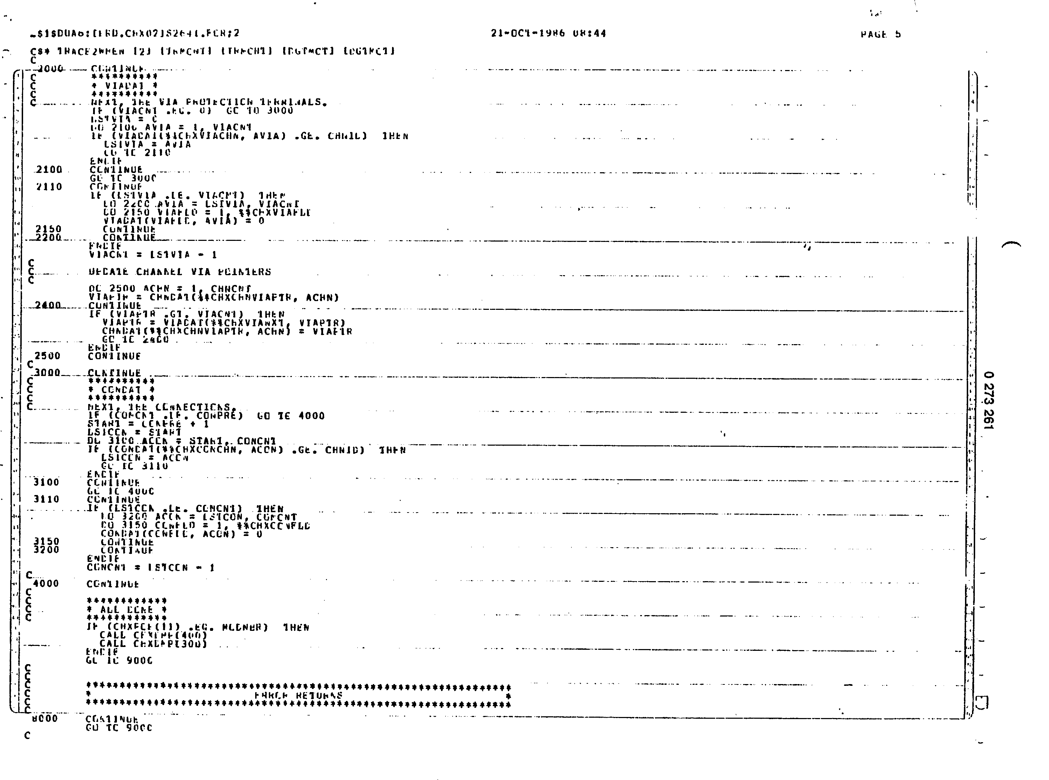

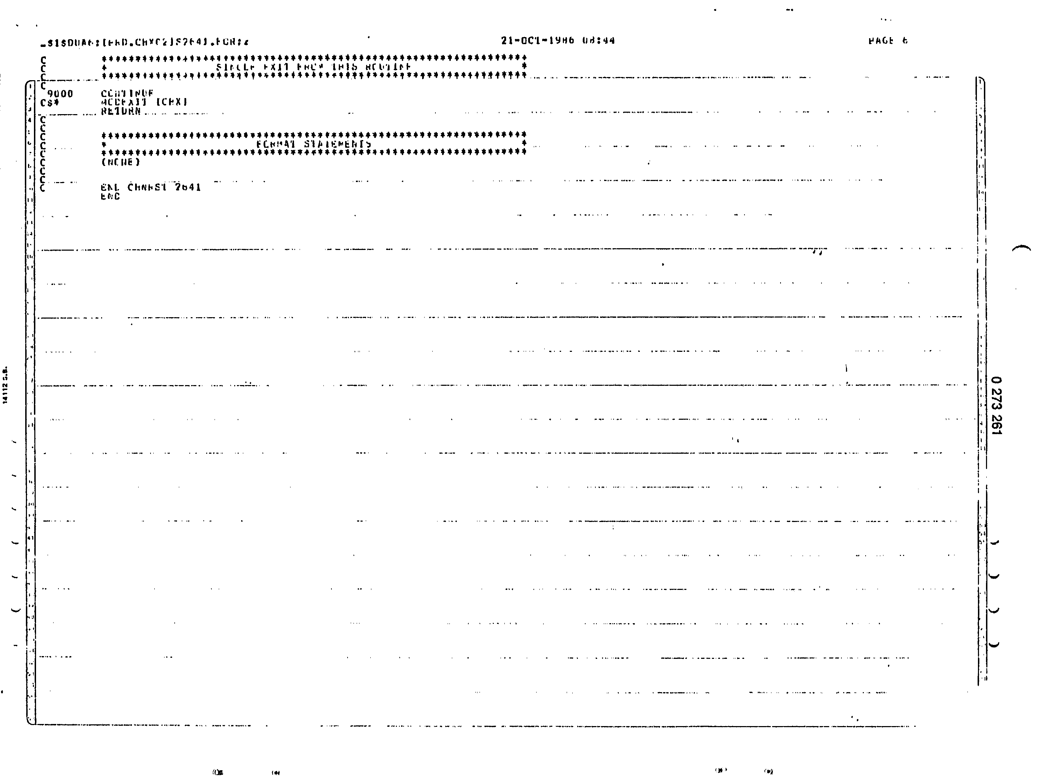

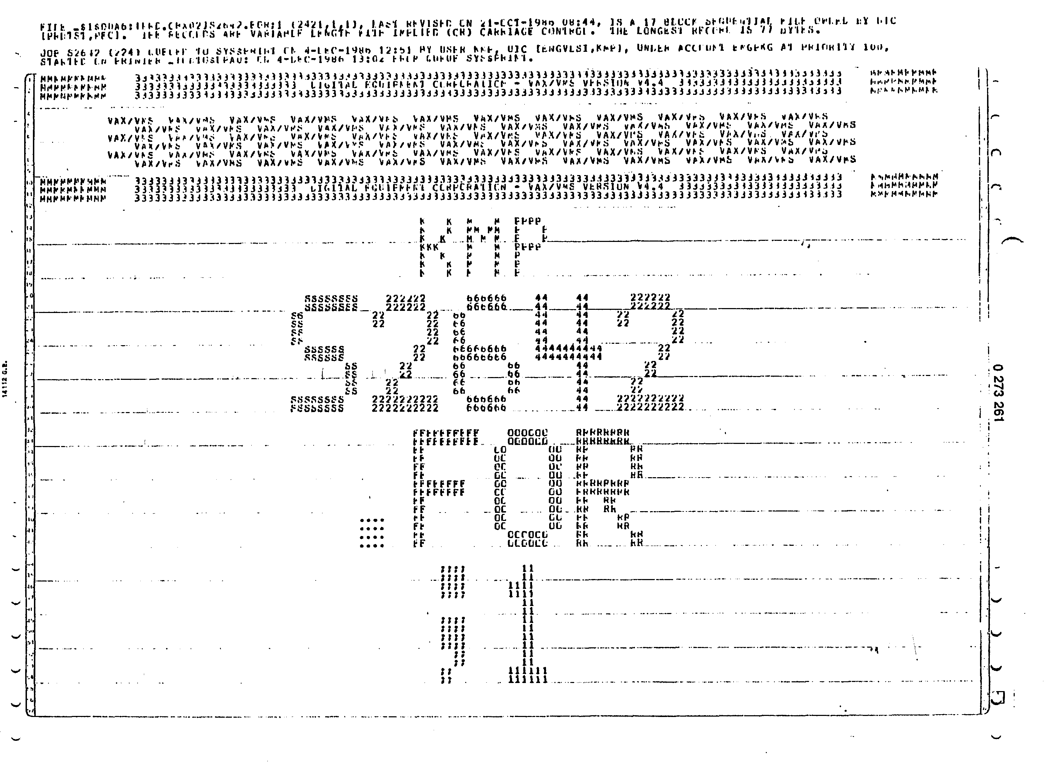

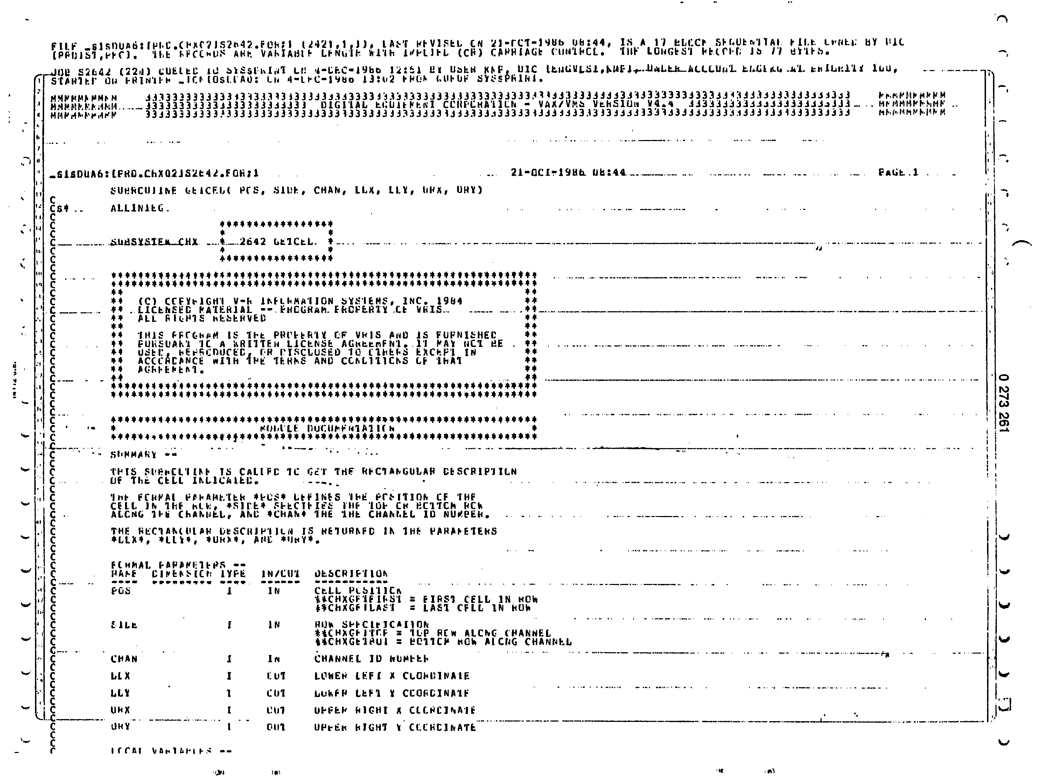

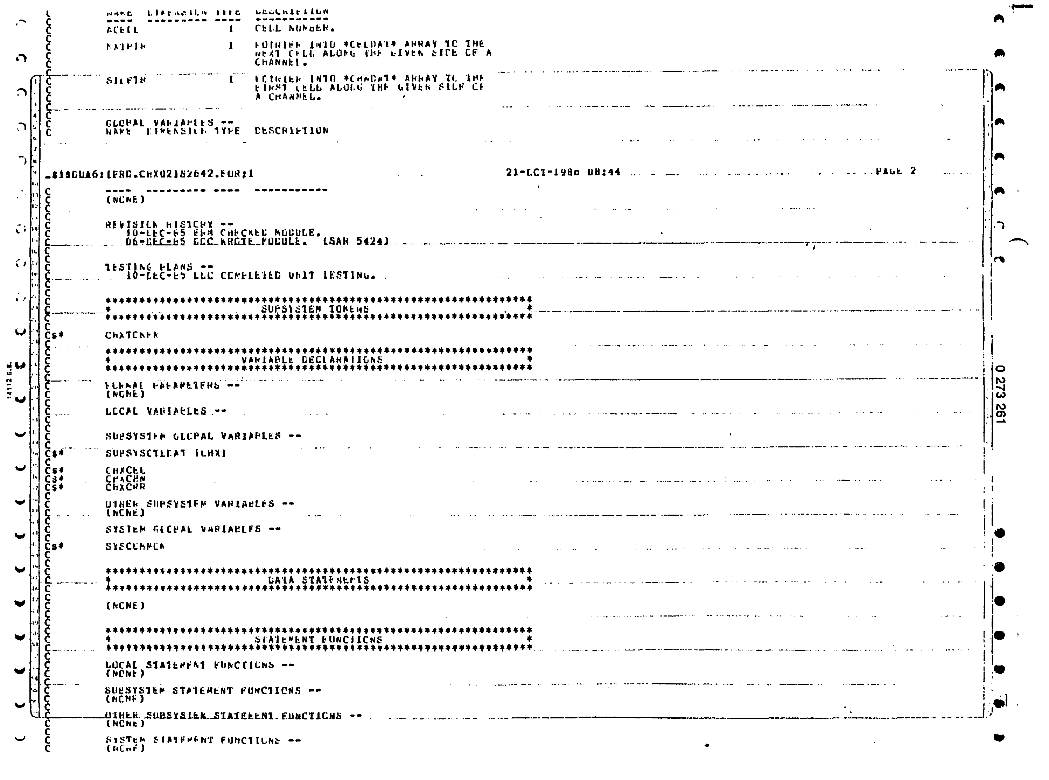

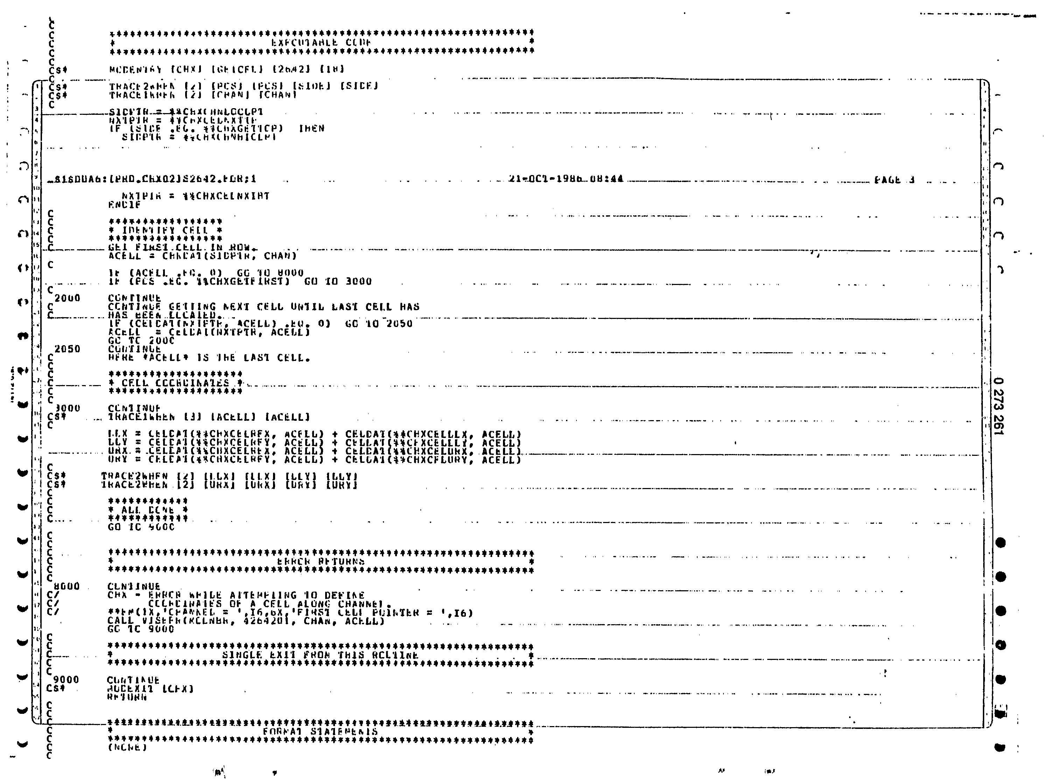

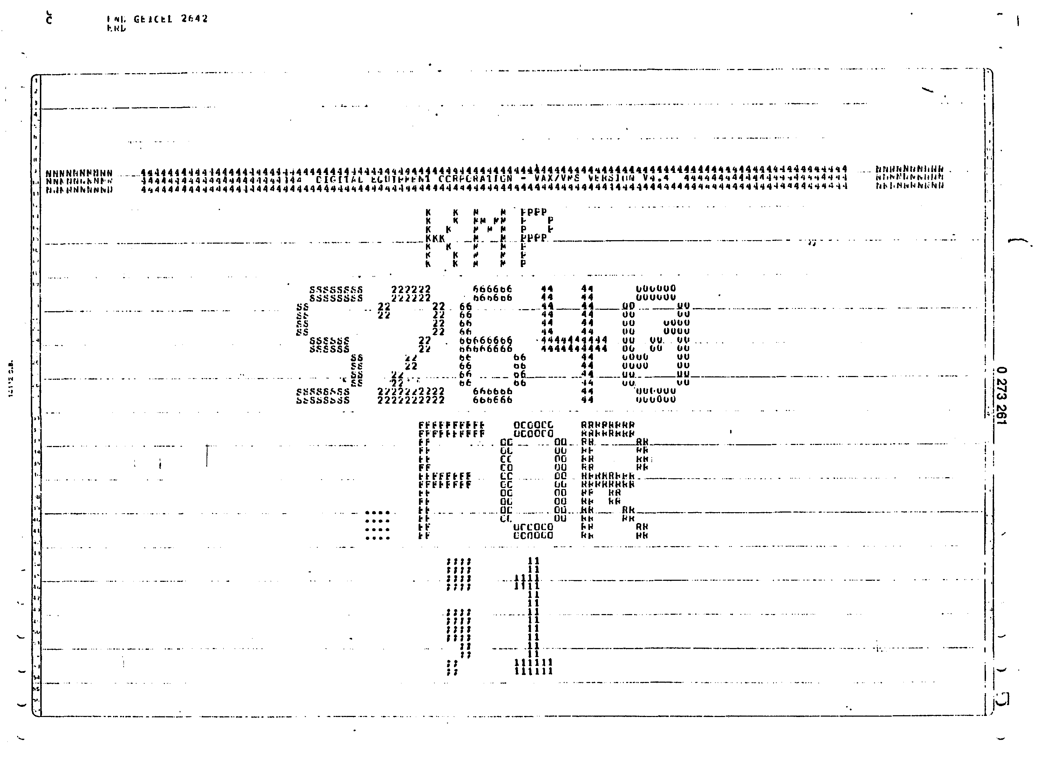

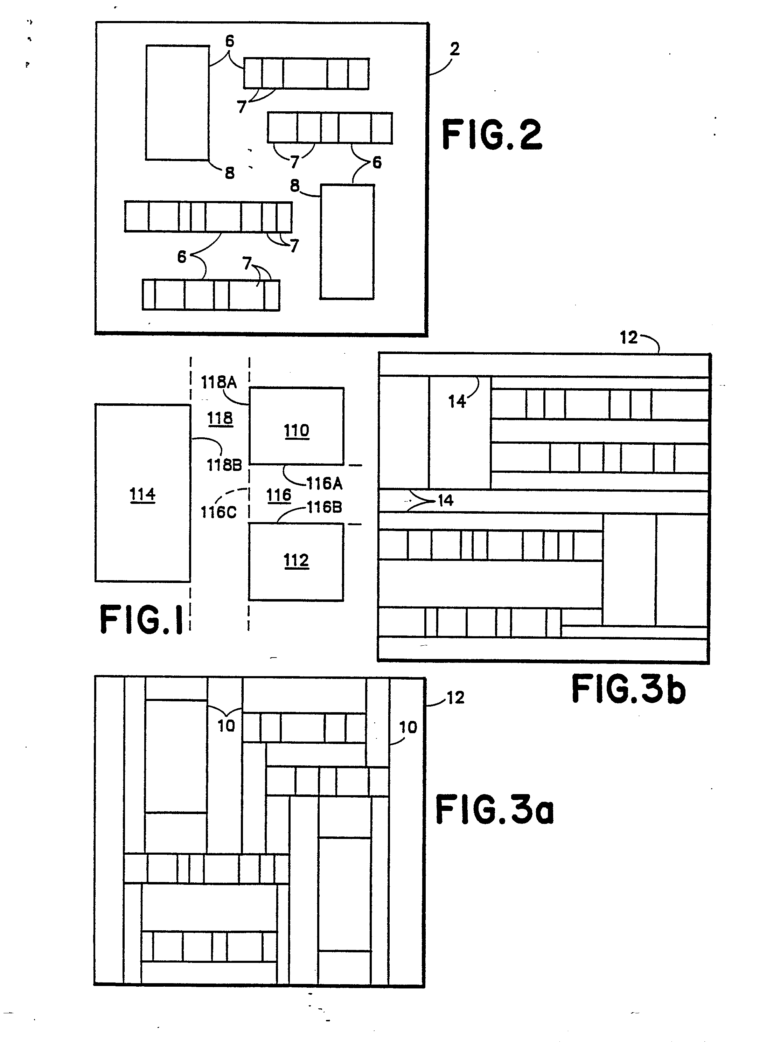

In a preferred embodiment of the present invention, detail routing of connections among blocks on a carrier is accomplished by determining an initial placement for first, second and third blocks, illustrated by way of example in FIG. 1 as blocks 110, 12 and 114, with respect to a frame of reference which is stationary relative to the carrier. The initial placement is such that the three blocks do not overlap and the first block 110 is separated from the second block 112 by a first channel 116 and the third block 114 is separated from the first block by a second channel 118. A first side 116A of the first channel 116 is between the first block 110 and a second side 116B of the first channel and a first side 118A of the second channel 118 is between the first block 110 and a second side 118B of the second channel. The first channel abuts at a first end 116C with the first side 118A of the second channel. Each channel has terminals (not shown in FIG. 1) at its periphery, and each terminal may be defined as either a real terminal or a virtual terminal. A real terminal is at a side of the channel and is a terminal of one of the blocks. The position of a real terminal in the longitudinal direction of the channel is defined before detail routing of the channel takes place. A virtual terminal is a terminal at the end of the channel and is used to define a connection between a track of that channel and a track of the channel that is abutted by the channel having the virtual terminal. The position of a virtual terminal in the longitudinal direction of its channel is defined, in that it is at one end of the channel, but its position in the width direction of the channel is not defined.

The paths followed by connections among terminals of the first channel 116 are then defined and the width of the first channel is adjusted to accommodate the connections by adjusting the position of the second block 112 in a direction perpendicular to the sides of the first channel and adjusting the positions of the real terminals on the second side 116B of the first channel in accordance with the change in position of the second block 112. The positions of the virtual terminals at the first end 116C of the first channel in the direction perpendicular to the sides of the first channel are defined, and these virtual terminals thereby become real terminals with respect to the second channel. The paths followed by connections among the terminals of the second channel are subsequently defined.

The present invention allows an integrated circuit based on standard cells and custom and semi-custom circuits to be detail routed very rapidly, since except in one instance the detail routing is performed a channel at a time in non-iterative fashion. The channels are able to expand (within the area available on the die surface) as channels are routed, without affecting channels that have previously been routed.

## Brief Description of the Drawings

For a better understanding of the invention, and to show how the same may be carried into affect, reference will now be made, by way of example, to the accompanying drawings in which:

FIG. 1 is a plan view of blocks on a carrier, for illustrating the foregoing summary of the invention,

FIG. 2 is a plan view illustrating in more detail than FIG. 1 an initial placement of rectangular blocks on a carrier,

FIGS. 3-8 illustrate steps in the definition of channels between the rectangular blocks of FIG. 2,

FIGS. 9 and 10 illustrate enlarged views of a portion of FIG. 8 at successive stages in detail routing, and

FIG. 11 illustrates a channel cycle.

## Detailed Description

FIG. 2 illustrates in plan view a representation of the core area 2 of an integrated circuit die. This representation is stored in the memory of a CAD system. About the periphery of the die are input/output (I/O) devices (not shown). The positions of the I/O devices relative to the core area 2 are fixed by virtue of the size of the die being fixed. In the core area are functional blocks 6. The blocks 6 comprise rows of standard cells 7 and macros (large custom or semi-custom circuits) 8. Each row of standard cells is illustrated as being composed of a linear array that extends in the horizontal direction with each cell being of the same height. However, the actual cells might not be of the same height, and the rectangular outlines about the rows of cells are not intended to represent the actual shape of the row of cells but only the smallest rectangular area that contains all the cells and has vertical and horizontal edges. The macros 8 are also indicated as being within rectangular outlines having vertical and horizontal edges.

The blocks 6 are laid out on the core area of the die using an initial placement program that ensures that no block is in abutting or overlapping relationship with another block. Each block 6 is separated from each other block by open routing space.

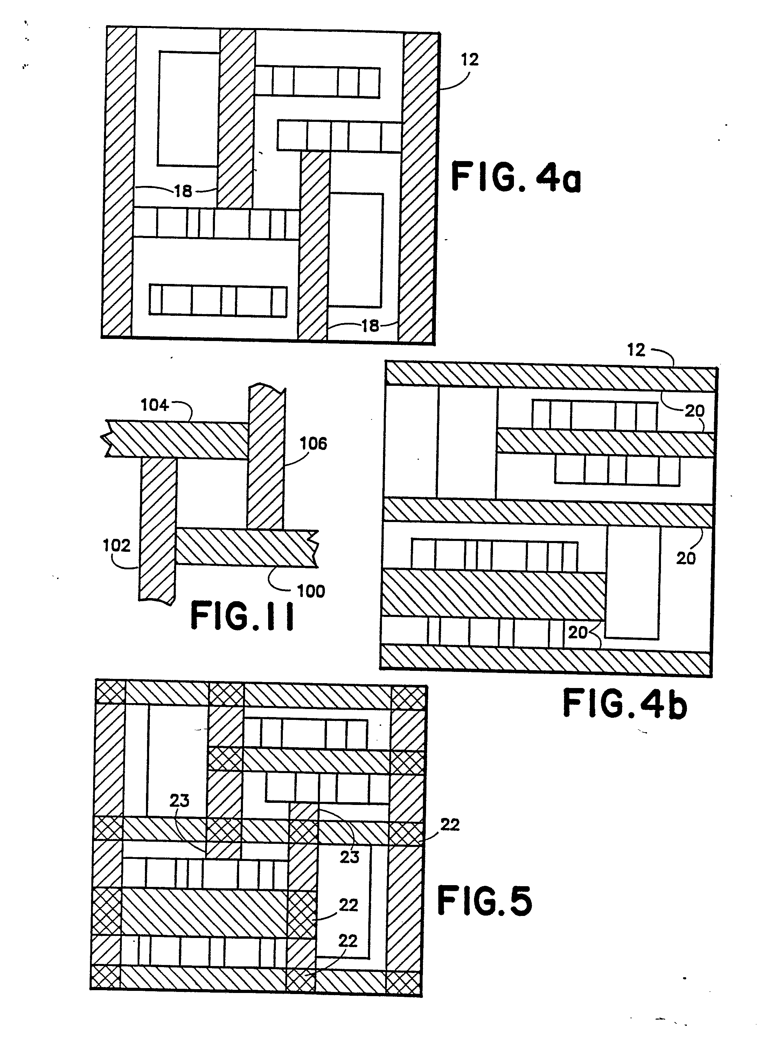

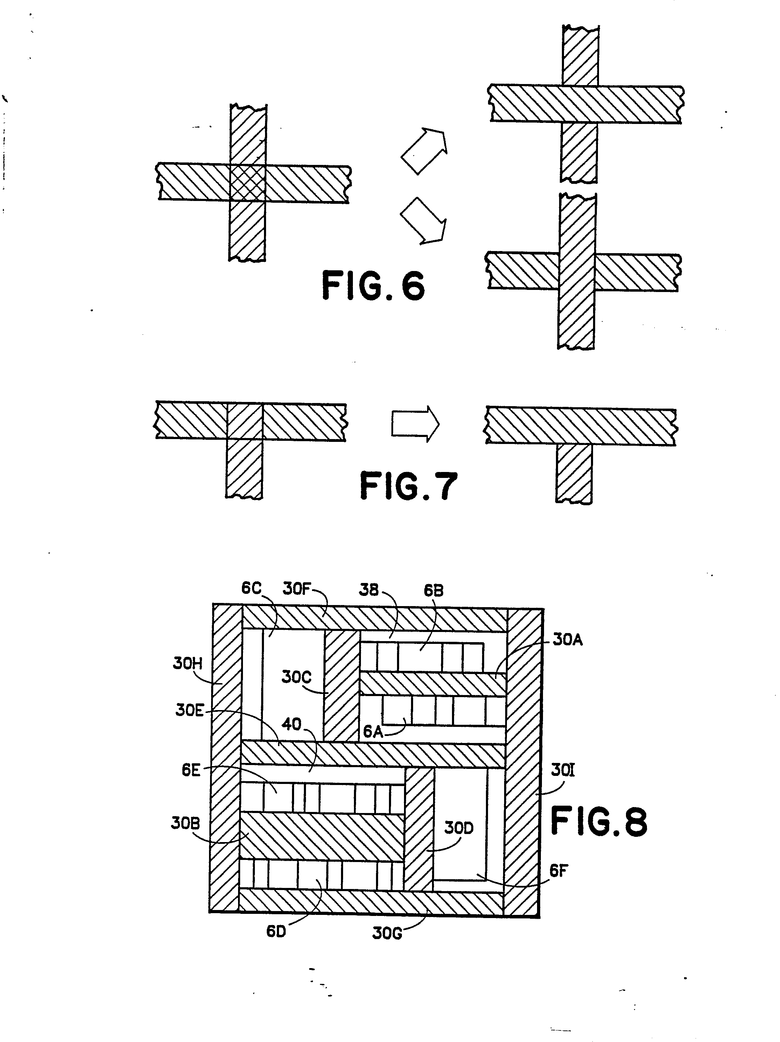

From the arrangement shown in FIG. 2, two graphs, shown in FIGS. 3a and 3b respectively, are created. In the graph shown in FIG. 3a, projection lines 10 have been placed along the vertical edges of each block. The projection lines extend until they reach either another block on the carrier or the periphery 12 of the core area of the die. FIG. 3b shows similar projection lines 14 along the horizontal edges of the blocks. Adjacent projection lines in each graph are examined to determine whether there is a block between those lines, and if there is no block the shorter line is merged into the longer line, as shown in FIGS. 4a and 4b. FIGS. 4a and 4b illustrate vertical columns 18 and horizontal rows 20 defined between adjacent blocks and between the blocks and the periphery 12 of the core area. The graphs shown in FIGS. 4a and 4b are overlayed (FIG. 5), and areas 22 that lie within the boundary of both a column 18 and a row 20 are identified. At each area 22 in which a column 18 and a row 20 are in overlapping relationship, either the column or the row is limited so as to eliminate the overlap. Where the row and column are in crossing relationship (FIG. 6), the shorter of the column and the row is divided into two segments. In the event that the column and row meet in a T, as shown in FIG. 7, the base of the T is shortened. If the end of a column (or row) is left dangling between a row (or column) and a horizontal (or vertical) edge of a block, as shown at 23 in FIG. 5, that end is eliminated. The result, shown in FIG. 8, is an arrangement of channels 30 that do not overlap. These channels define the areas of the two metal layers that will be used for wiring.

Each channel has a length and a width. The direction (horizontal or vertical) of the channel is the direction of its length. Each channel is rectangular and has four edges. The two shorter edges are referred to as the ends of the channel and the two longer edges are referred to as the sides of the channel. A first (vertical or horizontal) channel is referred to herein as feeding into a second (horizontal or vertical) channel if an end of the first channel abuts a side of the second channel, and similarly is referred to as being fed into by a third (horizontal or vertical) channel if a side of the first channel is abutted by an end of the third channel.

Having defined the channels 30, the channels are examined in order to determine the sequence in which they should be detail routed. The routing order is such that no channel is selected for detail routing until all channels that feed into the selected channel have already been detail routed. This principle can be applied to the channel arrangement shown in FIG. 8 by routing the channels in the order 30A-30I.

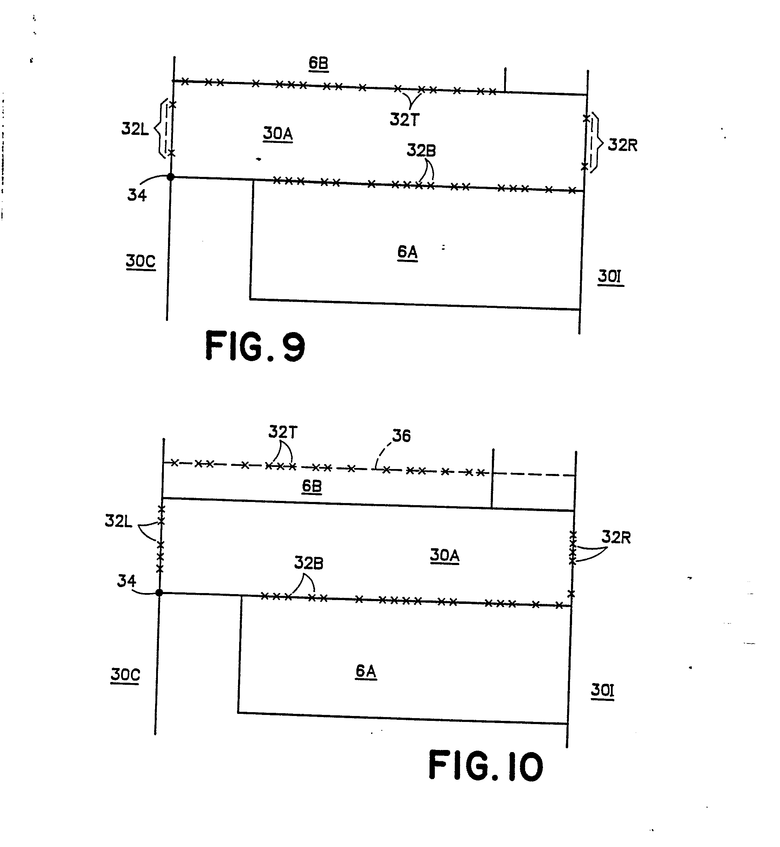

Detail routing of a horizontal channel is accomplished by considering the channel and the block that bounds the lower side of the channel as a unit. Similarly, detail routing of a vertical channel is accomplished by considering the channel and the block that is to the left of the channel as a unit. Each channel is considered as having an origin at its lower left corner and the positions of all terminals of that channel are defined by reference to the channel origin. For the purpose of the following description, it will be assumed that the horizontal channel 30A shown in FIG. 8 is to be routed. An enlarged view of the channel 30A is shown in FIG. 9. FIG. 9 is not intended to be a faithful reproduction of the appearance of the channel 30A, but is intended merely to illustrate sufficient detail to provide an explanation of the invention. It will be seen from FIG. 9 that the channel 30A has real terminals 32B and 32T along its bottom and top sides and virtual terminals 32L and 32R at its left and right ends. Each of these terminals is to be connected to at least one other terminal. The terminals 32B coincide with the terminals along the top side of the block 6A, and therefore the positions of these terminals relative to the channel origin 34 are fixed by virtue of the arrangement of the standard cells in the block 6A. Similarly, the terminals 32T coincide with the terminals along the bottom side of the block 6B, in its initial placement position, and therefore the positions of the terminals 32T relative to the channel origin are fixed in the horizontal direction but not in the vertical direction. The positions of the virtual terminals 32L and 32R also are fixed in the horizontal, but not vertical, direction.

In the detail routing phase, the connections among the terminals 32 of the channel 30A are assigned to tracks within the channel, for example using a conventional track assignment algorithm, and the positions of the terminals 32L, 32R and 32T relative to the origin of the channel in the vertical direction are defined. The final position of the top side of the channel 30A, represented by the dashed line 36 shown in FIG. 10 is determined by the width of the channel required in order to complete detail routing. The final width of the channel 30A may be greater or less than the width that was established in the initial placement phase, and the initial placement is adjusted by moving the block 6B perpendicular to the length of the channel 30A so that its bottom side coincides with the top side 36 of the channel 30A and the terminals along the bottom side of the block 6B then coincide with the terminals 32T along the top side of the channel 30A. If the channel 30A is expanded by an amount that is greater than the depth of the well 38 (FIG. 8) above the block 6B, the channel 30F is moved upwards, the channels 30D, 30H and 30 are length ened and a well space is created above the block 6C. However, since the channel 30A is the first channel to have been routed, moving the block 6B does not affect any detail routing that has previously been effected.

Well space that is created by moving a channel is not wasted, because it may be subsequently eliminated when another channel is detail routed, and if it is not eliminated it is available for detail routing of the channel that it abuts.

The horizontal channel 30B is routed in similar fashion to the channel 30A, being treated as a unit with the block 6D. Prior to detail routing, the positions of only the terminals along the bottom side of the channel are fixed relative to the origin of the channel. When detail routing of the channel 30B is completed, the positions of the terminals along the top side of the channel and the two ends of the channel are fixed. If the track assignment algorithm results in the width of the channel being expanded by an amount greater than the depth of the well 40 above the block 6E, the channel 30E is moved upwards, the channel 30D is lengthened, and well space is created above the block 6F. In order to accommodate upward movement of the channel 30E, the blocks 6A, 6B and 6C and the channels 30A, 30C, and 30F are moved upwards, always remaining in the same relative positions, and the channels 30H, and 30I are lengthened.

When the channel 30B has been routed, the channel 30C is routed. The positions of the terminals along the left side of the channel 30C have already been defined relative to the channel origin in both the horizontal and vertical directions, and the positions of the remaining terminals have been defined in the vertical direction, and only the width of this channel and the positions of the virtual terminals at the ends of the channel remain to be determined as a result of the detail routing. The channel 30C is treated as a unit with the block 6C, and the blocks 6D and 6E and the channel 30B are moved horizontally as a unit to accommodate any change in width of the channel 30C.

Detail routing of the channel 30D takes place in similar manner to that of the channel 30C. In detail routing of the channel 30D, the channel 30D is treated as a unit with the blocks 6D and 6E, the channel 30B and the well space 40 and the block 6F is moved to accommodate any change in the width of the channel 30D. It will therefore be appreciated that for the purpose of defining the unit composed of a selected channel and an adjacent block, the adjacent block might itself be composed of multiple blocks and one or more channels. The block that is adjacent a side of a selected channel is the rectangular area defined between that side and the closer side of a parallel adjacent channel of which the extent, i.e. the range of values of positions along the adjacent channel relative to a baseline which extends through the origin of the selected channel and perpendicular to the length direction of the selected channel, is at least as great as the extent of the selected channel.

After the channel 30D has been routed, detail routing of the channel 30E takes place. If the width of the channel 30E is adjusted, by moving the top side of the channel 30E up or down, the channels 30A, 30C and 30F and the blocks 6A, 6B and 6C are moved as a whole and therefore the relative positions of the terminals that have already been interconnected are not disturbed.

It will be understood from the foregoing that a channel is not detail routed until the positions of all the terminals along its sides have been fixed, and only the width of the channel remains to be adjusted. As each horizontal (or vertical) channel is detail routed, the initial placement file is updated to reflect the positions of the terminals at the ends of the channel and the change in position of the top (or right) side of the channel. The change in position of the top (or right) side of the block is propagated recursively to the top (or right) boundary of the core area of the chip. Therefore, it is not necessary to carry out the detail routing in an iterative fashion, and the time required to carry out the detail routing is reduced. Also, one hundred percent completion of detail routing is assured, because each channel is made sufficiently wide to accommodate all the tracks that are necessary. The completion of detail routing is not dependent upon use of any particular track assignment algorithm.

There is one situation in which iterative routing might be necessary even when all the intersections between channels are T-shaped, and this is typified by the so-called channel cycle illustrated in FIG. 11. In FIG. 11, each channel is fed into by another channel and therefore the channel sequence algorithm as described so far is unable to select one channel of the four that should be detail routed before the others. The channel cycle can be accommodated by the channel sequence algorithm by selecting one of the four channels, e.g. the channel 100, to be routed last. The selected channel might be, for example, the channel to which the smallest number of connections have been assigned in the global routing phase. An estimate is then made of the width of channel that will be required, based on the number of connections assigned to the selected channel in the global routing phase, and the expected positions of the terminals at the end of the selected channel are calculated. The channel 102, that the selected channel 100 feeds into, is then detail routed, followed by the channels 104 and 106. If the channel 106 is not wide enough to be detail routed, its width is increased by a selected amount and all the channels in the cycle are routed again. This is repeated until all the channels in the channel cycle have been detail routed.

It will be appreciated that the present invention is not restricted to the particular embodiment that has been described and illustrated, and that variations may be made therein without departing from the scope of the invention as defined in the appended claims and equivalents thereof. In particular, the invention is not restricted to a particular algorithm for establishing T-shaped intersections, and indeed the channels may be defined manually. The invention is not restricted to use with standard cells and, if the invention is applied to a circuit including standard cells, the rows of standard cells need not be all oriented parallel to each other.

Attached to this specification as an Appendix is a listing of the source code for implementing a preferred embodiment of the invention. The listing is written in Fortran and is in a form suitable for running on a Digital Equipment Corporation computer having the VMS (version 4.4) operating system. The Appendix also includes external documentation for the Channel Expansion (CHX) program, the Channel Definition (CHD) program and the Track Assignment (TRS) program. The CHX program is the portion of the system that is concerned with adjusting channel widths and using the adjusted channel widths to adjust the positions of the blocks. The CHD program and the TRS program are the preferred channel definition and track assignment programs for use with the CHX program. The external documentation for each of the three programs consists of three files:

xxx.DOC
-contains the overall documentation for the specific program, including overviews of the techniques, data structures, and external behavior of the program.

xxxPT5.DOC
- contains the functional summaries and calling sequences for each subroutine or function in the program.

xxxPT6.DOC
-contains the detailed description of the data structures used by the program.

## APPENDIX

APPENDIX is part of the description.

Contents


| Contents | Pages |
|---|---|
| CHD.DOC;1 | 1-10 |
| CHDPT5.DOC;1 | 11-14, 14(a) |
| CHDPT6.DOC;1 | 15-21 |
| TRS.DOC;5 | 22-45 |
| TRSPT5.DOC;1 | 45-51 |
| TRSPT6.DOC;3 | 52-60 |
| CHX.DOC;2 | 61-74 |
| CHXPT5.DOC;1 | 75-80 |
| CHXPT6.DOC;5 | 80(a)-(e), 81-98 |
| S2625.FOR;2 | 99-105 |
| S2626.FOR;2 | 106-116 |
| S2627.FOR;3 | 117-136 |
| S2628.FOR;1 | 137-147 |
| S2629.FOR;1 | 148-156 |
| S2630.FOR;2 | 157-174 |
| S2631.FOR;2 | 175-182 |
| S2632.FOR;6 | 183-200 |
| S2633.FOR;3 | 201-209 |
| S2634.FOR;3 | 210-218 |
| S2635.FOR;4 | 219-237 |
| S2636.FOR;1 | 238-243 |
| S2637.FOR;2 | 244-254 |
| S2638.FOR;2 | 255-262 |
| S2639.FOR;2 | 263-271 |
| S2640.FOR;1 | 272-276 |
| S2641.FOR;2 | 277-284 |
| S2642.FOR;1 | 285-289 |


Copyright © 1981, 1984, 1985 V-R Information Systems, Inc. All rights reserved.

## Claims

1. A method of routing connections among blocks on a surface of a carrier, each block having terminals which are to be connected to other terminals, said method comprising:

a) determining an initial placement for first, second and third blocks with respect to a frame of reference which is stationary relative to the carrier, the initial placement being such that the blocks do not overlap and the first block is separated from the second block by a first elongate channel and the third block is separated from the first block by a second elongate channel, each channel having first and second opposite sides and first and second opposite ends, the first channel having terminals on at least its second side and having virtual terminals at its first end, and the second channel having terminals on at least one of its sides, the terminals on the second side of the first channel coinciding with terminals of the second block and the terminals on said one side of the second channel coinciding with terminals of one of the first, second and third blocks, said initial placement being such that the first channel abuts at its first end with the first side of the second channel,

(b) (i) defining the paths followed by connections among terminals of the first channel, (ii) adjusting the width of the first channel to accommodate the connections by adjusting the position of the second block in a direction perpendicular to the second side of the first channel and adjusting the positions of the terminals on the second side of the first channel in accordance with the change in position of the second block, and (iii) defining the positions of the virtual terminals at said first end of the first channel, and

(c) subsequently defining the paths followed by connections among the terminals of the second channel.

2. A method according to claim 1, wherein the second channel has terminals on its first side coinciding with terminals of at least one of the first and second blocks and the method comprises adjusting the width of the second channel to accommodate the connections among the terminals of that channel by adjusting the positions of the first and second blocks and of the first channel in a direction perpendicular to the first side of the second channel and adjusting the positions of the terminals on the first side of the second channel in accordance with the change in position of the first and second blocks and of the first channel.

3. A method according to claim 1, further comprising adjusting the width of the second channel to accommodate the connections among the terminals of that channel by adjusting the position of the third block in a direction perpendicular to the second side of the second channel.

4. A method according to claim 1, wherein the second channel has terminals on its second side coinciding with terminals of the third block and the method comprises adjusting the width of the second channel to accommodate the connections among the terminals of that channel by adjusting the position of the third block in a direction perpendicular to the second side of the second channel and adjusting the positions of the terminals along the second side of the second channel in accordance with the change in position of the third block.

5. A method according to claim 1, wherein each block is rectangular in shape having two edges which are parallel to the sides of the first channel and two edges which are parallel to the ends of the first channel.

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
SSSSSSSSSS   7777777777777777777777777777777777777777777777777777777777777777777777777777777777777777777777777   SSSSSSSSSS
SSSSSSSSSS   7777777777777777777777  DIGITAL EQUIPMENT CORPORATION - VAX/VMS VERSION V4.4  7777777777777777777777   SSSSSSSSSS
SSSSSSSSSS   7777777777777777777777777777777777777777777777777777777777777777777777777777777777777777777777777   SSSSSSSSSS

KMP

CHD

DOC

;1

FILE _$1$DUA6:[PRC.CHD02]CHD.DOC;1 (2370,1,1), LAST REVISED ON 21-OCT-1986 08:44, IS A 62 BLOCK SEQUENTIAL FILE OWNED BY UIC
[PRDIST,PRC1.  THE RECORDS ARE VARIABLE LENGTH WITH IMPLIED (CR) CARRIAGE CONTROL.  THE LONGEST RECORD IS 81 BYTES.

JOB CHD (201) QUEUED TO SYS$PRINT ON 4-DEC-1986 12:50 BY USER KMP, UIC [ENGVLSI,KMP], UNDER ACCOUNT ENGPKG AT PRIORITY 3, STARTED
ON PRINTER _TCNICSLPA0: ON 4-DEC-1986 13:26 FROM QUEUE SYS$PRINT.

SSSSSSSSSS   7777777777777777777777777777777777777777777777777777777777777777777777777777777777777777777777777   SSSSSSSSSS
SSSSSSSSSS   7777777777777777777777  DIGITAL EQUIPMENT CORPORATION - VAX/VMS VERSION V4.4  7777777777777777777777   SSSSSSSSSS
SSSSSSSSSS   7777777777777777777777777777777777777777777777777777777777777777777777777777777777777777777777777   SSSSSSSSSS
```

```
**********************************
**********************************
**                              **
** CHD SUBSYSTEM DOCUMENTATION  **
**                              **
**********************************
**********************************

************************************************************
************************************************************
**                                                        **
**  (C) COPYRIGHT V-R INFORMATION SYSTEMS, INC. 1985      **
**  LICENSED MATERIAL -- PROGRAM PROPERTY OF VRIS         **
**  ALL RIGHTS RESERVED                                   **
**                                                        **
**  THIS PROGRAM IS THE PROPERTY OF VRIS AND IS FURNISHED **
**  PURSUANT TO A WRITTEN LICENSE AGREEMENT. IT MAY NOT BE**
**  USED, REPRODUCED, OR DISCLOSED TO OTHERS EXCEPT IN    **
**  ACCORDANCE WITH THE TERMS AND CONDITIONS OF THAT      **
**  AGREEMENT.                                            **
**                                                        **
************************************************************
************************************************************
```

RECENT REVISION HISTORY
-----------------------

01-OCT-85 TAF ALTERED DOCUMENTATION FOR CHANGED CYCLE HANDLING. (SAR 5200)
15-DEC-84 TAF WROTE DOCUMENTATION. (SAR 4857)

```
*******************************
* CHANNEL DEFINITION OVERVIEW *
*******************************
```

THE CHANNEL DEFINITION SUBSYSTEM IS INTENDED FOR USE WITH STANDARD CELL AND GENERAL CELL CARRIERS. IT INVOLVES THE DEFINITION OF A SET OF CHANNELS FOR A GIVEN PLACEMENT AND DETERMINES THE APPROPRIATE ROUTING SEQUENCE FOR THOSE CHANNELS TO INSURE LEGAL CHANNEL EXPANSION DURING THE TRACK ASSIGNMENT PHASE.

HOW_TO_USE_THIS_SYSTEM
----------------------

CHD RUNS AFTER A LEGAL PLACEMENT HAS BEEN OBTAINED AND BEFORE ANY SUBSYSTEMS WHICH NEED CHANNELS DEFINED ARE RUN (STR, TCC, GGR, ETC). MOST OFTEN, CHD WILL BE RUN DIRECTLY AFTER PLACEMENT OR JUST BEFORE GLOBAL ROUTING.

IF A NEW PLACEMENT IS OBTAINED TO IMPROVE ROUTING RESULTS, CHD MUST BE RE-RUN TO OBTAIN NEW CHANNEL DEFINITIONS.

NOTE THAT THE FOLLOWING COMMANDS ARE ONLY APPLICABLE FOR A VAX 780 HOST.

BCHCHD

BCHCHD IS USED TO SUBMIT A JOB ON A BATCH EXECUTION QUEUE TO EXECUTE THIS SUBSYSTEM. THIS COMMAND FILE WILL PROMPT THE USER FOR ALL NECESSARY INFORMATION. THIS COMMAND FILE ALLOWS THE USER TO HAVE MORE CONTROL OVER THE EXECUTION OF JOBS, SINCE CONTROL FILES AND START UP TIMES CAN BOTH BE SPECIFIED.

RUNCHD

RUNCHD IS A COMMAND FILE TO EXECUTE THIS SUBSYSTEM INTERACTIVELY. USER ORIENTED PROMPTS ARE USED FOR ALL REQUESTED INFORMATION.

NOTE THAT THE FOLLOWING LINK COMMAND FILE IS ONLY APPLICABLE FOR A VAX 11/780 HOST.

CHDLINK

CHDLINK INTERACTIVELY LINKS THE OBJECT CODE TO CREATE AN EXECUTABLE FILE. THE FOLLOWING OBJECT LIBRARIES ARE NEEDED TO RESOLVE ALL REFERENCES.

CHDLIB    CHANNEL DEFINITION SUBSYSTEM LIBRARY

```
        DFALIB    DESIGN FILE ACCESS UTILITY LIBRARY
        SSNLIB    SUPPORT SYSTEM NUCLEUS LIBRARY

   SUMMARY OF SOFTWARE EXTERNAL BEHAVIOR
   -------------------------------------

   --INPUTS--
     INITIALLY PLACED DESIGN FILE, AND A CONTROL FILE CONTAINING
     PROCESSING OPTION AND TRACE LEVEL SETTINGS.

   --OUTPUTS--
     UPDATED VERSION OF THE DESIGN FILE CONTAINING NEWLY CREATED
       CHANNEL DEFINITION INFORMATION (FCH RECORDS). ANY CHANNELS
       PREVIOUSLY DEFINED IN THE DESIGN FILE WILL BE REMOVED.
     A FILE CONTAINING CELLS ALONG CHANNEL INFORMATION FOR TRACK
       ASSIGNMENT.
     A REPORT FILE CONTAINING SUMMARY INFORMATION, TRACE MESSAGES,
       AND ANY RESULTING DIAGNOSTICS.

     THE REPORT SUMMARY INCLUDES:
        1. NUMBER OF NUMBER OF CHANNELS PRODUCED
           BROKEN DOWN BY NUMBER OF HORIZONTAL AND
           NUMBER OF VERTICAL CHANNELS
        2. (OPTIONALLY) A LIST OF THE DEFINITIONS OF ALL
           OF THE CHANNELS WHICH WERE CREATED DURING EXECUTION.
        2. (OPTIONALLY) EXECUTION TIMES FOR VARIOUS PORTIONS
           OF THE RUN

     ALWAYS CHECK THE REPORT FILE CAREFULLY FOR ANY DIAGNOSTIC
     MESSAGES. FOR JOBS SUBMITTED TO BATCH QUEUES, IT MIGHT BE
     NECESSARY TO REVIEW THE EXECUTION LOG FILES TO ISOLATE
     ANY PROBLEMS.

     THE FILE CONTAINING CELLS ALONG CHANNEL INFORMATION CONSISTS
     OF ALL THE CHANNELS FOLLOWED BY THEIR CELLS WHICH LIE ON
     THEIR LOW AND HIGH SIDES. IN THE FOLLOWING DIAGRAM, CELLS
     1, 2, AND 3 ARE CONSIDERED ON THE LOW SIDE OF THE CHANNEL,
     AND CELLS 4, 5, AND 6 ARE CONSIDERED ON THE HIGH SIDE.

            4   5   6                 I C I
          ---------------           1 I H I 4
             CHANNEL                  I A I
          ---------------           2 I N I 5
            1   2   3                 I N I
                                    3 I E I 6
                                      I L I
               (A)                     (B)

     DATA IS OUTPUT IN THE FOLLOWING FORMAT TO THIS FILE:
         (CHANNEL INDEX) (# OF CELLS ON LOW SIDE) (# OF CELLS ON HIGH SIDE)
         (LOW  SIDE CELL INDICES ...)
         (HIGH SIDE CELL INDICES ...)
         (CHANNEL INDEX) (# OF CELLS ON LOW SIDE) (# OF CELLS ON HIGH SIDE)
           .
           .
           .

     THE CELLS FOR EACH CHANNEL ARE OUTPUT IN SORTED ORDER BY
     COORDINATE VALUE FROM LOW TO HIGH, X-COORDINATE FOR CELLS
     ALONG HORIZONTAL CHANNELS; Y-COORDINATE FOR CELLS ALONG
     VERTICAL CHANNELS.

   --ASSUMPTIONS AND CONSTRAINTS--
     1.  DESIGNS CAN CONTAIN BOTH HORIZONTAL AND VERTICAL CHANNELS

     2.  NO CHANNEL CROSSINGS ("+"-INTERSECTIONS) ARE ALLOWED,
         ONLY T-INTERSECTIONS AND L-INTERSECTIONS.

     3.  NO CELLS OVERLAP ON CARRIER.

     4.  IF TWO CELLS ARE ABUTTING, NO CHANNEL WILL BE DEFINED
         BETWEEN THEM.

     5.  NO CHANNELS WILL BE DEFINED OUTSIDE OF A ROW OF I/O
         CELLS AND NONE WILL BE DEFINED BETWEEN INDIVIDUAL I/O
         CELLS OF A ROW.

     6.  CHANNEL EXPANSION DURING TRACK ASSIGNMENT IS ALWAYS
```

```
        DONE TO THE HIGH SIDE (IE. UPWARDS AND TO THE RIGHT).
     7.  THERE ARE NO UNPLACED CELLS ON THE CARRIER.
--PERFORMANCE GOALS--

OVERVIEW OF TECHNIQUES INVOLVED
-------------------------------
CHL CREATES THE CHANNELS BY MERGING PROJECTION LINES FROM
THE SIDES OF ALL NON-I/O CELLS ON THE CARRIER.  THIS TECHNIQUE
IS BASICALLY THE SAME AS THAT OF CHIBA, ET. AL. [1].  IT WAS
CHOSEN BECAUSE IT SEEMED THE MOST EFFICIENT WHILE PROVIDING
THE MOST FLEXIBILITY FOR A VARIETY OF CHIP STYLES AND CELL
SHAPES.

IN THE CASE OF VARYING SIZE CELLS ALONG A GIVEN ROW, THE
CHANNEL EDGES WILL BE DEFINED AT THOSE CELLS WHICH PROTRUDE THE
FURTHEST INTO THE CHANNEL.

     I  CELL  I  CELL  I  CELL  I  CELL  I  CELL  I
     +--------I        I--------I        I        I
              +--------+        I__      I--------+
==================================+--------+==============
                   CHANNEL DEFINITION
==========+--------+========+--------+==================
    +-------I        I       I        I
    I       I        I-------I        I-------+-------+
    I  CELL I  CELL  I  CELL I  CELL  I  CELL I  CELL I

THIS METHOD WILL CREATE "WELLS" BETWEEN THE CHANNEL EDGE AND
SOME OF THE CELL EDGES.  TRACK ASSIGNMENT (TRS) WILL TRY TO
USE AS MUCH OF THIS SPACE AS IT CAN.

ONCE THE CHANNELS ARE FORMED, THE ROUTING SEQUENCE FOR
THE CHANNELS IS DETERMINED BY USING THE FOLLOWING RULE:
A CHANNEL MAY ONLY BE SEQUENCED IF BOTH OF THE CHANNELS
IT FEEDS INTO HAVE BEEN PREVIOUSLY SEQUENCED.  WHEN THIS
CONDITION FAILS, A CYCLE EXISTS.  CYCLES ARE HANDLED IN
TRS BY ESTIMATING THE SIZE OF ONE OF THE CHANNELS OF THE
CYCLE.  THEN START THE ROUTING WITH THE CHANNEL WHICH IS FED
BY THIS ESTIMATED CHANNEL AND CONTINUE ON AROUND THE CYCLE
ROUTING EACH CHANNEL.  AFTER ROUTING THE LAST CHANNEL OF THE
CYCLE (THE ORIGINAL ONE THAT WAS ESTIMATED), COMPARE ITS
ACTUAL ROUTING SIZE WITH ITS ESTIMATED SIZE.  IF THE
ESTIMATED SIZE WAS TOO SMALL, YOU MUST INCREASE THE ESTIMATE
AND GO BACK TO THE FIRST CHANNEL OF THE CYCLE WHICH WAS
ROUTED AND START ALL OVER AGAIN.  ALL CHANNELS WHICH WERE ROUTED
BETWEEN THAT FIRST ROUTED CHANNEL OF THE CYCLE AND THE LAST
ROUTED (ESTIMATED) CHANNEL OF THE CYCLE MUST ALSO BE
RE-ROUTED WITH THE NEW ESTIMATION INFORMATION IN MIND.

AS A FINAL STEP, CHANNEL WIDTHS ARE ADJUSTED TO A MINIMUM WIDTH.
THIS IS CALCULATED AS ( 2 * ( THE MAXIMUM WIRE RULE WIDTH PLUS
ITS ASSOCIATED GUARD BAND )).  THIS IS DONE SO WIRES,
PARTICULARLY POWER AND GROUND, MAY BE INSERTED EASILY USING THE
GRAPHICAL WIRE EDITOR (GWE).  AT THIS TIME THE EDGES OF ALL
CHANNELS ARE ALSO PULLED IN TO THE NEAREST GRID.

**********************************
* CHANNEL DEFINITION ORGANIZATION *
**********************************

PROCESSING FLOW
---------------
COLDSTART CHANNEL DEFINITION
   READ IN PROCESSING OPTION AND TRACE LEVELS
   READ IN CELL INFORMATION FROM DESIGN FILE
FOR HORIZONTAL AND VERTICAL DIRECTION
   CREATE PROJECTION LINES FROM CELLS
   MERGE PROJECTION LINES TO FORM CHANNELS
ENDFOR (BOTH HORIZ AND VERT CHANS HAVE BEEN FORMED)
BREAK UP CHANNELS INTO T-INTERSECTIONS
SEQUENCE CHANNELS
ADJUST CHANNEL WIDTH
OUTPUT CELLS ON CHANNEL FILE
OUTPUT NEW DESIGN FILE

SOFTWARE STRUCTURE
------------------
                ********
```

```
                       I---*CHDCLD*
 ********              I   * 2601 *
 *CHDCVR*------I       I   ********
 * 2600 *      I
 ********      I       ********
               I---*CHDLLC*
               I   * 2603 *
               I   ********
               I
               I           ********
               I---I---*CHDLIN*
               I   I   * 2604 *
               I   I   ********
               I   I
               I   I   ********    ********
               I   I---*CHDMRG*---*CHDBLD*
               I       * 2605 *    * 2606 *
               I       ********    ********
               I
               I   ********
               I---*CHDBRK*------------------------I
               I   * 2607 *                         I---********
               I   ********                         I   *CHDRST*
               I                                    I   * 2611 *
               I   ********   ********   ********   I---********
               I---*CHDSOC*---*CHDSEQ*---*CHDCYC*---I
               I   * 2608 *   * 2609 *   * 2610 *
               I   ********   ********   ********
               I
               I   ********   ********
               I---*ADJCHN*---*CHDXPN*
               I   * 2615 *   * 2616 *
               I   ********   ********
               I
               I   ********
               I---*CHDUPD*
               I   * 2612 *
               I   ********
               I
               I   ********
               I---*CHDRPT*
                   * 2613 *
                   ********
```

UTILITIES--

```
********
*CHDCMP*
* 2602 *
********
```

DATA STRUCTURES
---------------

--CELLS--
THE INFORMATION STORED FOR EACH CELL DURING CHANNEL DEFINITION IS AS FOLLOWS:
- CELL INDEX NUMBER
- LOWER-LEFT X-COORDINATE OF CELL
- LOWER-LEFT Y-COORDINATE OF CELL
- UPPER-RIGHT X-COORDINATE OF CELL
- UPPER-RIGHT Y-COORDINATE OF CELL
- TYPE OF CELL (I/O OR REGULAR)
- DISTANCE CELL HAS MOVED DUE TO EXPANSION
- ADJACENT CHANNELS ON EACH SIDE
- ADJACENT CELLS ON EACH SIDE

--CHANNELS--
THE INFORMATION STORED FOR EACH CHANNEL DURING THE CHANNEL DEFINITION PROCESS IS:
- CHANNEL INDEX NUMBER
- CHANNEL ORIENTATION
- LOWER-LEFT X-COORDINATE OF CHANNEL
- LOWER-LEFT Y-COORDINATE OF CHANNEL
- UPPER-RIGHT X-COORDINATE OF CHANNEL
- UPPER-RIGHT Y-COORDINATE OF CHANNEL
- SEQUENCE NUMBER FOR CHANNEL TO BE ROUTED IN
- NUMBER OF CELLS ON THE LOW SIDE OF THE CHANNEL
- NUMBER OF CELLS ON THE HIGH SIDE OF THE CHANNEL

IN ADDITION, THERE ARE LINKS FROM A CHANNEL RECORD TO OTHER RECORDS:

```
C          CHANNEL INDEX NUMBER OF CONTINUING PORTION OF THE ORIGINAL
C             CHANNEL IF THE CHANNEL WAS BROKEN BECAUSE OF A CYCLE
C             (VALUE OF 0 IF IT IS NOT A PART OF A CYCLE)
C          CELL INDEX OF THE FIRST CELL ON THE LOW SIDE OF THE CHANNEL
C          CELL INDEX OF THE FIRST CELL ON THE HIGH SIDE OF THE CHANNEL
C          CHANNEL INDEX OF THE CHANNEL FED BY THIS CHANNEL ON THE
C             LOW END (SEE DIAGRAM BELOW
C          CHANNEL INDEX OF THE CHANNEL FED BY THIS CHANNEL ON THE
C             HIGH END
C
C      --PROJECTION LINES--
C      THE INFORMATION STORED FOR EACH PROJECTION LINE DURING
C      CHANNEL DEFINITION IS:
C          LOW END COORDINATE OF PROJECTION LINE (X-COORD FOR
C             HORIZONTAL LINE; Y-COORD FOR VERTICAL LINE)
C          HIGH END COORDINATE OF PROJECTION LINE (X-COORD FOR
C             HORIZONTAL LINE; Y-COORD FOR VERTICAL LINE)
C          COORDINATE OF PROJECTION LINE CUT (Y-COORD FOR
C             HORIZONTAL LINE; X-COORD FOR VERTICAL LINE)
C          CELL INDEX FROM WHICH PROJECTION LINE WAS OBTAINED
C          INDICATOR AS TO WHETHER THE PROJECTION LINE WAS TAKEN
C             FROM THE HIGH OR LOW SIDE OF THE CELL
C
C      --CELLS ON CHANNEL (CLONCH) INFORMATION--
C      THIS ARRAY CONTAINS DATA STATING WHICH CELLS LIE ON WHICH
C      SIDE OF ALL THE CHANNELS.  THE INFORMATION STORED TO
C      MAINTAIN THIS INFORMATION IS:
C          CELL INDEX NUMBER
C          CHANNEL INDEX NUMBER THAT THE CELL LIES ON
C          INDICATOR AS TO WHETHER THE CELL LIES ON THE LOW OR HIGH
C             SIDE OF THE CHANNEL
C          COORDINATE VALUE FOR THE CELL (X-COORD FOR HORIZONTAL
C             CHANNELS; Y-COORD FOR VERTICAL CHANNELS) USED FOR
C             SORTING PURPOSES
C
C      CONTROL AND TESTING PARAMETERS
C      ------------------------------
C      CHD USES SUBSYSTEM SPECIFIC PROCESSING OPTIONS (CHDPOF) AND
C      TRACE LEVELS (CHDTRC)
C
C      --PROCESSING OPTIONS--
C
C            RECOMMENDED
C      INDEX   SETTING   DESCRIPTION
C      -----   -------   -----------
C        1        0      UNIT TEST SELECTOR USED IN CONJUNCTION WITH
C                        CHDPOF(11) TO TURN ON THE INTERNAL TESTING
C                        ROUTINES.  FOR VR SERVICE PERSONNEL ONLY.
C                           0 = NORMAL OPERATION
C                           1 = SELECT UNIT TESTING MODE (VR USE ONLY)
C
C        2        0      ROW OR COLUMN STYLE CARRIER INDICATOR.
C                        THIS IN EFFECT INDICATES WHETHER YOU ARE GIVING
C                        PREFERENCE TO LONGER HORIZONTAL CHANNELS OR
C                        LONGER VERTICAL CHANNELS.
C                           0 = ROW    STYLE  (LONGER HORIZONTAL CHANNELS)
C                           1 = COLUMN STYLE  (LONGER VERTICAL   CHANNELS)
C
C        3        0      OPTION FOR CONTROLLING THE DETAIL OF THE
C                        CHANNEL DEFINITION SUMMARY REPORT FILE.
C                           0 = GENERATE A SIMPLE REPORT CONTAINING ONLY
C                               THE NUMBER OF CHANNELS DEFINED
C                           1 = GENERATE A REPORT CONTAINING THE NUMBER OF
C                               CHANNELS DEFINED PLUS A SUMMARY OF THE
C                               EXECUTION TIMES BROKEN DOWN INTO SPECIFIC
C                               CATAGORIES (IE. DESIGN FILE LOADING TIME,
C                               CHANNEL SEQUENCING TIME, ETC.)
C                           2 = GENERATE A REPORT REPORT CONTAINING THE
C                               FULL DEFINITIONS OF THE DEFINED CHANNELS
C                               PLUS A SUMMARY OF THE EXECUTION TIMES
C
C       11        0      MODULE NUMBER UNDER TEST
C
C      --TRACE LEVELS--
C         THE LAST TWO DIGITS OF THE MODULE NUMBER IS ALWAYS THE TRACE LEVEL
C         NUMBER (E.G. THE TRACE VARIABLE FOR MODULE 2612 IS CHDTRC(12))
C
C      --IOFILE ASSIGNMENTS--
C         IOFILE(4)  -  OUTPUT REPORT FILE
C         IOFILE(5)  -  OUTPUT DESIGN FILE
C         IOFILE(6)  -  INPUT  DESIGN FILE
```

```
C          IOFILE(12) -  OUTPUT CELLS ALONG CHANNEL FILE
C          IOFILE(17) -  INPUT  ERRLIB FILE
C          IOFILE(18) -  INPUT  CONTROL FILE
C
C       --TIMER ASSIGNMENTS--
C
C       THIS SUBSYSTEM USES TIMER ONE AS THE MASTER (FOR TOTAL
C       EXECUTION TIME) CLOCK AND TIMER TWO FOR INDIVIDUAL TIMING
C       OF MAJOR SUBSECTIONS.
C
C          TIMER
C          NUMBER      USE
C          ------      ---
C
C             1        TOTAL ELAPSED EXECUTION TIME
C
C             2        INDIVIDUAL MAJOR SUBSECTION EXECUTION TIME
C
C
C       --MACROS OTHER THAN NAMED COMMONS--
C         CHDCCC      [CELLIX] -  USED TO STORE CELL ALONG CHANNEL
C                     [CHANIX]    INFORMATION IN THE CLONCH ARRAY
C                     [HIORLO]       CELLIX - CELL INDEX NUMBER
C                     [COORD ]       CHANIX - CHANNEL INDEX NUMBER
C                                    HIORLO - INDICATES WHETHER THE CELL
C                                             LIES ON THE HIGH OR LOW
C                                             SIDE OF CELL
C                                    COORD  - COORDINATE OF CELL FOR SORTING
C                                             ALONG CHANNEL
C
C         CHDSTR      [CHANIX] -  USED TO INITIALIZE CHANNEL
C                     [ LLX  ]    INFORMATION IN THE CHANLS ARRAY
C                     [ LLY  ]       LLX    - LOWER LEFT  X-COORDINATE
C                     [ URX  ]       LLY    - LOWER LEFT  Y-COORDINATE
C                     [ URY  ]       URX    - UPPER RIGHT X-COORDINATE
C                     [ORIENT]       URY    - UPPER RIGHT Y-COORDINATE
C                                    ORIENT - CHANNEL ORIENTATION
C
C       ******************************
C       * CONVERSION AND INSTALLATION *
C       ******************************
C
C       DELIVERABLES
C       ------------
C       SOURCE CODE FOR MODULES LISTED IN APPENDIX 4
C       INPUT DESIGN FILE FOR TESTING (??????.DSF)
C       COPY OF THIS DOCUMENTATION (EXPANDED)
C
C       CONTROL FILES
C       MACRO LIBRARIES:  DFA.MAC, SSN.MAC, CHD.MAC
C       MODULES NEEDED FOR LINK:  DFALIB, SSNLIB, CHDLIB
C
C       INSTALLATION TESTS
C       ------------------
C       EXECUTE CHD ON TEST CASE PROVIDED (??????.DSF).  COMPARE RESULTS
C       (REPORT, OUTPUT DESIGN FILE, AND OUTPUT CELLS ON CHANNEL FILE).
C
C       SUGGESTED OVERLAY STRUCTURE
C       ---------------------------
C
C       TRANSPORTABILITY NOTES
C       ----------------------
C
C       REGRESSION TESTING
C       ------------------
C       TO ENSURE MEANINGFUL RESULTS, THE MODULES LISTED ON THE RIGHT
C       SHOULD BE TESTED BEFORE THE MODULE ON THE LEFT.
C          CHDCCC (2603):  CHDCLD, CHDDMF, CHDTST
C          CHDLIN (2604):  CHDLOD
C          CHDMRG (2605):  CHDLOD, CHDLIN
C          CHDPIL (2606):  CHDLOD, CHDLIN
C          CHDPRK (2607):  CHDLOD, CHDLIN, CHDMRG, CHDBLD
C          CHDSGC (2608):  CHDLOD, CHDLIN, CHDMRG, CHDBLD, CHDBRK
C          CHDSEG (2609):  CHDLOD, CHDLIN, CHDMRG, CHDBLD, CHDBRK
C
C       DESIGN FILE ACCESS NOTES
C       ------------------------
C       -- INPUT RECORD TYPES --
C       DESIGN FILE INPUT IS DONE IN MODULE 2603 CHDLOD
C          BRG     BOARD GEOMETRY INFORMATION
C          BEX     BODY EXTENT INFORMATION
```

```
C           PDV    DEVICE DATA
C           PLL    OBJECT DATA
C           PRR    ROTATION RECTANGLE INFORMATION
C           RRU    ROUTING INTERCONNECT WIRING RULE
C           WCR    WIRE CLEARANCE
C
C        -- OUTPUT RECORD TYPES --
C        DESIGN FILE OUTPUT IS DONE IN MODULE 2612 CHDUPD
C           PBG    BOARD GEOMETRY INFORMATION
C           PCH    ALL EXISTING PCH RECORDS ARE REMOVED BY CHD AND
C                  THE NEWLY DEFINED CHANNEL DEFINITIONS ARE INSERTED.
C           PDB    DEVICE ASSOCIATED BARRIER INFORMATION
C           PHG    HYPER-GRID INFORMATION
C           PLL    OBJECT DATA
C           PSN    NODE DATA
C           RFD    FEEDTHRU INFORMATION
C           RJP    EQUIPOTENTIAL PIN DATA
C
C        CAPACITY MODIFICATION ISSUES
C        ----------------------------
C        -- NUMBER OF CHANNELS --
C           CURRENT CAPACITY = SYSTEM-WIDE TOKEN $CHANNELS
C           AFFECTED ARRAYS:  CHANLS(14, $CHANNELS) IN / CHDCHN /
C
C        -- NUMBER OF CELLS --
C           CURRENT CAPACITY = SYSTEM-WIDE TOKEN $DEVICES
C           AFFECTED ARRAYS:  CELLS(16, $DEVICES) IN / CHDCEL /
C
C        -- NUMBER OF PROJECTION LINES --
C           CURRENT CAPACITY = CALCULATED TOKEN @DEVEDGES
C           EQUAL TO 2 * MAXIMUM NUMBER OF CELLS
C           AFFECTED ARRAYS:  LINES(5, @DEVEDGES) IN / CHDPLN /
C
C        -- NUMBER OF CELLS ON CHANNEL --
C           CURRENT CAPACITY = CALCULATED TOKEN @DEVSCNCHAN
C           EQUAL TO 4 * MAXIMUM NUMBER OF CELLS
C           AFFECTED ARRAYS: CLONCH(4, @DEVSCNCHAN) IN / CHDCCH /
C
C
C          TOKENS USED         MODULES
C          (EXCEPT NAMED       CONTAINING
C          COMMONS)            TOKEN
C          ------------------------------------------------------------
C          $DEVICES            2602,2603,2604,2616
C              MAXIMUM NUMBER OF CELLS
C          $CHANNELS           2606,2607,2608,2609,2610,2615,2616
C              MAXIMUM NUMBER OF CHANNELS
C          @DEVEDGES           2604,2605,2606
C              MAXIMUM NUMBER OF PROJECTION LINES
C          @DEVSCNCHAN         2603,2605,2606
C              MAXIMUM NUMBER OF CELLS ON CHANNELS
C          CHDDMPCEL           2601,2602,2603,2612,2614
C              VALUE FOR DUMPING CELL INFORMATION IN DUMP ROUTINE
C          CHDDMPCHN           2601,2602,2605,2606,2607,2608,2610,2612,2613,2614
C              VALUE FOR DUMPING CHANNEL INFORMATION IN DUMP ROUTINE
C          CHDDMPCLC           2601,2602,2605,2607,2608,2610,2612,2614
C              VALUE FOR DUMPING CELLS ON CHANNEL INFO IN DUMP ROUTINE
C          CHDDMPLIN           2601,2602,2604,2605,2614
C              VALUE FOR DUMPING PROJECTION LINE INFO IN DUMP ROUTINE
C          CHDDMPSTA           2601,2602,2603,2604,2605,2607,2614
C              VALUE FOR DUMPING THE STATUS OF VARIOUS VARIABLES IN
C              DUMP ROUTINE
C          CHDSGHIFD            2608,2609,2610
C              ACCESS TO HIGH FEED OF CHANNEL IN LOCAL SEQUENCING ARRAY
C          CHDSGINDX           2608,2609,2610
C              ACCESS TO CHANNEL INDEX IN LOCAL SEQUENCING ARRAY
C          CHDSGLOFD           2608,2609,2610
C              ACCESS TO LOW FEED OF CHANNEL IN LOCAL SEQUENCING ARRAY
C
C        FUTURE ENHANCEMENTS
C        -------------------
C
C        1. FIND A BETTER WAY TO SOLVE THE CYCLE PROBLEM.  AS CAN BE
C           SEEN, THE METHOD USED CAN BE A VERY CPU TIME CONSUMING
C           PROCESS ESPECIALLY IF (A) INITIAL CHANNEL ESTIMATION IS
C           POOR, OR (B) THERE ARE SEVERAL CYCLES WITHIN CYCLES
C           (NESTED CYCLES) WHICH MEAN SEVERAL CHANNELS LIE BETWEEN
C           THE FIRST AND LAST CHANNELS OF A CYCLE WHICH MEANS A
C           LOT OF RE-ROUTING MAY HAVE TO BE DONE.
C
C        **************
```

```
-$1$DUA6:[PED.CHE02]CHL.DOC;1                    21-OCT-1986 08:44                    PAGE 8

        * APPENDIX 1 *
        * REFERENCES *
        **************

   1. CHIBA, ICRU ET. AL. "SHARPS: A HIERACHIAL LAYOUT SYSTEM
      FOR VLSI" PROCEEDINGS 18TH DESIGN AUTOMATION CONFERENCE
      (1981) PP 820-827.

   2. HURNG, CHI-SONG AND LIE, MARGARET "AN AUTOMATIC/INTERACTIVE
      LAYOUT PLANNING SYSTEM FOR ARBITRARILY-SIZED RECTANGULAR
      BUILDING BLOCKS" PROCEEDINGS 18TH DESIGN AUTOMATION
      CONFERENCE (1981) PP 293-300.

   3. KAJITANI, YOJI "ORDER OF CHANNELS FOR SAFE ROUTING AND
      OPTIMAL COMPACTION OF ROUTING AREA" PROCEEDINGS IEEE
      INTERNATIONAL CONFERENCE ON COMPUTER DESIGN (1983)
      PP 62-65.

   4. KIMURA, SEIJI ET. AL. "AN AUTOMATIC ROUTING SCHEME FOR
      GENERAL CELL LSI" PROCEEDINGS IEEE INTERNATIONAL
      CONFERENCE ON COMPUTER DESIGN (1983) PP 285-292.

   5. INOUE, TAKAHIDE ET. AL. "AN AUTOMATIC ROUTING METHOD FOR
      INCREMENTIAL PROCESSING LSI CHIP DESIGN"

   6. VERHEYEN, P.TH. ET. AL. "'FLOORPLANNING' A NEW PLACEMENT
      AND ROUTING STRATEGY" PROCEEDINGS IEEE INTERNATIONAL
      CONFERENCE ON COMPUTER DESIGN (1984) PP 453-456.

        **********************
        * APPENDIX 2         *
        * GLOSSARY OF TERMS  *
        **********************
CHANNEL - A (USUALLY) LONG RECTANGULAR AREA WHICH HAS FIXED
          TERMINALS ON ITS UPPER AND LOWER SIDES (IN THE CASE
          OF A HORIZONTAL CHANNEL) WHICH ARE TO BE INTERCONNECTED
          WITHIN THE CHANNEL AREA

CYCLE   - SITUATION IN WHICH FOUR CHANNELS IMPOSE CONSTRAINTS
          UPON EACH OTHER MAKING THE TASK OF CHOOSING A ROUTING
          SEQUENCE FOR THOSE CHANNELS IMPOSSIBLE WITHOUT
          ALTERATION.  EXAMPLE:

              I   I                       CHANNEL 4 MUST BE ROUTED
              I   I--------------            BEFORE CHANNEL 3
              I 1 I       2               CHANNEL 3 MUST BE ROUTED
              I   I--------------            BEFORE CHANNEL 2
              I   I        I   I          CHANNEL 2 MUST BE ROUTED
          -----------------I   I             BEFORE CHANNEL 1
                   4       I 3 I          CHANNEL 1 MUST BE ROUTED
          -----------------I   I             BEFORE CHANNEL 4
                           I   I
                                       THERE IS A LOOP ... IF A CYCLE
                                         EXISTS.  NO CHANNEL CAN BE
                                         ROUTED FIRST.
NESTED
CYCLES  - CYCLES HAVING A CHANNEL IN COMMON.
          EXAMPLE:

              I   I                           I   I
              I   I---------------------------I   I
              I 1 I             2             I 6 I
              I   I---------------------------I   I
              I   I        I   I              I   I
          -----------------I   I---------------------
                   4       I 3 I          5
          -----------------I   I---------------------
                           I   I

          CHANNELS 1, 2, 3, AND 4 MAKE UP ONE CYCLE, WHILE
          CHANNELS 2, 3, 5, AND 6 MAKE UP ANOTHER CYCLE
          CHANNELS 2 AND 3 ARE COMMON WITH THE TWO OF THEM

        *****************
        * APPENDIX 3    *
        * ERROR RETURNS *
        *****************

****OUTPUT FROM PRLIST ROUTINE GOES HERE****
```

```
C          *********************
C          * APPENDIX 4        *
C          * MODULE SUMMARIES  *
C          *********************
C
CS*        MODULELIST
CS*        0030CSMCVE
CS*        0031CV112C
CS*        0034ENDIIN
CS*        0035VISEHH
CS*        0039CV1CZI
CS*        0043VISTRG
CS*        0045VISRI1
CS*        0046ERHFND
CS*        0052SYSCLD
CS*        0054MESGEN
CS*        0057DPPSYS
CS*        0067KFIHCH
CS*        0070FLMNTP
CS*        0077RC1RAN
CS*        0081ARHLNE
CS*        0082MTXDMF
CS*        0091STRCNV
CS*        0094VSTRGT
CS*        0104GE1CFI
CS*        0105NXTENT
CS*        0106WRTENT
CS*        0107CLSFCK
CS*        0108FLNXFK
CS*        0109DFAPUT
CS*        0110DSFCEN
CS*        0111DSFCLS
CS*        0114DSFFEW
CS*        0151GETFMT
CS*        0152NXTREC
CS*        1704CLRTIM
CS*        1705STRTIM
CS*        1708DAFILE
CS*        1715VREXIT
CS*        1716CPUTIM
CS*        1721VISRT3
CS*        1722RPT1CF
CS*        1799PPTPLT
CS*        2223MAKPCK
CS*        2600CHLDVH
CS*        2601CHDCLD
CS*        2602CHDDMF
CS*        2603CHDLCF
CS*        2604CHCLIN
CS*        2605CHDMHG
CS*        2606CHLBLD
CS*        2611CHCRST
CS*        2607CHDBRK
CS*        2608CHLSCC
CS*        2609CHDSEG
CS*        2610CHLCYC
CS*        2612CHDUPL
CS*        2613CHCRPT
CS*        2614CHDIST
CS*        2615ADJCHN
CS*        2616CHDXFN
C
C          *************************************
C          * APPENDIX 5                        *
C          * NAMED COMMON DETAILED DESCRIPTIONS *
C          *************************************
C
CSNC*  BORDIL
CSNC*  CTLDTA
CSNC$  DFACIL
CSNC*  DFCOMN
CSNC*  DFWORK
CSNC*  DSFDAT
CSNC*  ENTDAT
CSNC*  SUBSYSCTLDTA [CHD]
CSNC*  CHDCCH
CSNC*  CHDCEL
CSNC*  CHDCHN
CSNC*  CHDPLN
CSNC*  CHDSIA
CSNC*  CHDTIM
```

DIGITAL EQUIPMENT CORPORATION - VAX/VMS VERSION V4.4

KMP

CHDPT5

DOC:

;1

FILE _$1$DUA6:[FEC.CHDOZ]CHDPT5.DOC;1 (2377,1,1), LAST REVISED ON 21-OCT-1986 08:44, IS A 16 BLOCK SEQUENTIAL FILE OWNED BY UIC [PRDTST,FEC]. THE RECORDS ARE VARIABLE LENGTH WITH IMPLIED (CR) CARRIAGE CONTROL. THE LONGEST RECORD IS 76 BYTES.

JOB CHDPT5 (202) QUEUED TO SYS$PRINT ON 4-DEC-1986 12:50 BY USER KMP, UIC [ENGVISI,KMP], UNDER ACCOUNT ENGPRG AT PRIORITY 100, STARTED ON PRINTER _LCA0:[SEPAG: ON 4-DEC-1986 13:01 FROM QUEUE SYS$PRINT.

DIGITAL EQUIPMENT CORPORATION - VAX/VMS VERSION V4.4

VAX/VMS VAX/VMS VAX/VMS VAX/VMS VAX/VMS VAX/VMS VAX/VMS VAX/VMS VAX/VMS VAX/VMS VAX/VMS VAX/VMS

DIGITAL EQUIPMENT CORPORATION - VAX/VMS VERSION V4.4

KMP

CHDPT5

DOC

;1

```
FILE _$1$DUA6:[ERD.CHDC2]CHDPT5.DOC;1 (2377,1,1), LAST REVISED ON 21-OCT-1986 08:44, IS A 16 BLOCK SEQUENTIAL FILE OWNED BY UIC
[PROTST,PRC]. THE RECORDS ARE VARIABLE LENGTH WITH IMPLIED (CR) CARRIAGE CONTROL. THE LONGEST RECORD IS 76 BYTES.
JOB CHDPT5 (202) QUEUED TO SYS$PRINT ON 4-DEC-1986 12:50 BY USER KMP, UIC [ENGVLSI,KMP], UNDER ACCOUNT ENGPRG AT PRIORITY 100,
STARTED ON PRINTER _TCNTOSLPA0: ON 4-DEC-1986 13:01 FROM QUEUE SYS$PRINT.

LLLLLLLLLL    2222222222222222222222222222222222222222222222222222222222222222222222222222222222222222222222222222222    LLLLLLLLLL
LLLLLLLLLL    222222222222222222222222  DIGITAL EQUIPMENT CORPORATION - VAX/VMS VERSION V4.4  222222222222222222222222    LLLLLLLLLL
LLLLLLLLLL    2222222222222222222222222222222222222222222222222222222222222222222222222222222222222222222222222222222    LLLLLLLLLL

_$1$DUA6:[ERD.CHDC2]CHDPT5.DOC;1                                              21-OCT-1986 08:44                               PAGE 1

C ***********************************************************************
C ***********************************************************************
C *******                                                         *******
C *******                       CHDPT5.DOC                        *******
C *******              CHD SUBSYSTEM OF SUBROUTINE DCCPT5         *******
C *******                                                         *******
C *******                                                         *******
C ***********************************************************************
C
C ***********************************************************************
C **      (C) COPYRIGHT V-R INFORMATION SYSTEMS, INC.  1985             **
C **      LICENSED MATERIAL -- PROGRAM PROPERTY OF VRIS                 **
C **      ALL RIGHTS RESERVED                                           **
C **                                                                    **
C **      THIS PROGRAM IS THE PROPERTY OF VRIS AND IS FURNISHED         **
C **      PURSUANT TO A WRITTEN LICENSE AGREEMENT.  IT MAY NOT BE       **
C **      USED, REPRODUCED, OR DISCLOSED TO OTHERS EXCEPT IN            **
C **      ACCORDANCE WITH THE TERMS AND CONDITIONS OF THAT              **
C **      AGREEMENT.                                                    **
C ***********************************************************************
C
C
C    --  REVISION HISTORY --
C        15-DEC-84 TAF WROTE DOCUMENTATION.   (SAR 4857)
C
C$ 2600CHDDVR
C  CHDDVR 2600  PROGRAM CHDDVR         DRIVER PROGRAM FOR CHANNEL DEFINITION
C                                      SUBSYSTEM.
C
C$F
C$ 2601CHDCLD
C  CHDCLD 2601  CALL CHDCLD            COLDSTART FOR CHANNEL DEFINITION
C                                      SUBSYSTEM.
C
C$E
C$ 2602CHDDMP
C  CHDDMP 2602  CALL CHDDMP (OPTION,   DATA DUMPER FOR CHANNEL DEFINITION
C                           CHDMCD)    SUBSYSTEM.  *OPTION* SELECTS DATA
C                                      STRUCTURE TO BE DUMPED, *CHDMCD* IS
C                                      THE MODULE FROM WHERE THE DUMP IS
C                                      TAKING PLACE.
C
C$E
C$ 2603CHDLOD
C  CHDLOD 2603  CALL CHDLOD            INITIALIZE CHANNEL DEFINITION DATA
C                                      STRUCTURE BASED ON DESIGN FILE INPUT.
C                                      LOADS CARRIER INFORMATION AND
C                                      PLACED CELL INFORMATION.
C
C$E
C$ 2604CHDLIN
C  CHDLIN 2604  CALL CHDLIN (HZORVT)   DEFINE PROJECTION LINES FROM ALL
C                                      CELLS ON THE CARRIER.  *HZORVT* IS
C                                      USED TO INDICATE WHETHER HORIZONTAL
C                                      OR VERTICAL PROJECTION LINES SHOULD
C                                      BE MADE.
C
C$E
C$ 2605CHDMRG
C  CHDMRG 2605  CALL CHDMRG (HZORVT)   INITIATES THE PROCESS OF
C                                      MERGING ALL PROJECTION LINES TO FORM
C                                      CHANNELS.  *HZORVT* IS USED TO INDICATE
C                                      WHETHER HORIZONTAL OR VERTICAL
C                                      CHANNELS ARE BEING FORMED.
C
C$E
C$ 26...
```

```
C  CHDFLD 2606  CALL CHDFLD (LNARR1, ACTUALLY DOES THE PROCESS OF MERGING
C                        LNARR2,  THE PROJECTION LINES TO FORM CHANNELS.
C                        HZORVT)  PROJECTION LINES TO BE PROCESSED INPUT
C                                 IN *LNARR1* AND ALL THOSE WHICH CANNOT
C                                 BE PROCESSED IN THIS PASS ARE STORED ON
C                                 *LNARR2*.  *HZORVT* INDICATES WHETHER
C                                 HORIZONTAL OR VERTICAL CHANNELS ARE
C                                 BEING FORMED.
C
C$E
C$ 2607CHDBRK
C  CHDBRK 2607  CALL CHDBRK        BREAKS ALL THE CHANNELS INTO
C                                 T-INTERSECTIONS AND DETERMINES THE
C                                 FEEDING RELATIONSHIP BETWEEN CHANNELS.
C

_$1$DUA6:[PHD.CHDC2]CHDFT5.DOC;1                    21-OCT-1986 08:44                    PAGE 2

C$E
C$ 2608CHDSOC
C  CHDSOC 2608  CALL CHDSOC        INITIATES THE PROCESS OF DETERMINING
C                                 A ROUTING SEQUENCE FOR ALL THE CHANNELS.
C
C$E
C$ 2609CHDSEQ
C  CHDSEQ 2609  CALL CHDSEQ (CHARY1, DETERMINES THE ROUTING SEQUENCE FOR
C                        CHARY2,  ALL THE CHANNELS.  ALL CHANNELS WHICH
C                        NUTCON   REMAIN TO BE PROCESSED ARE INPUT IN
C                                 *CHARY1*.  ALL THOSE CHANNELS UNABLE
C                                 TO BE SEQUENCED ON THIS PASS ARE STORED
C                                 ON *CHARY2* TO BE SEQUENCED ON A
C                                 FOLLOWING PASS.  *NUTCON* INDICATES
C                                 THE NUMBER OF CHANNELS IN *ARRAY1* ON
C                                 INPUT, AND THE NUMBER OF CHANNELS IN
C                                 *ARRAY2* ON OUTPUT.
C$E
C$ 2610CHDCYC
C  CHDCYC 2610  CALL CHDCYC (CHARAY, BREAKS A CYCLE BY SPLITTING THE
C                        LFTUDU)  APPROPRIATE HORIZONTAL OR VERTICAL
C                                 CHANNEL IN THE RIGHT PLACE FORMING AN
C                                 EXTRA CHANNEL.  *CHARAY* CONTAINS ALL
C                                 OF THE YET TO BE SEQUENCED CHANNELS
C                                 OF WHICH FOUR OF THEM ARE THE CYCLE
C                                 TO BE BROKEN.  *LFTUDU* INDICATES THE
C                                 NUMBER OF CHANNELS LEFT TO SEQUENCE.
C$E
C$ 2611CHDRST
C  CHDRST 2611  CALL CHDRST (LOCHAN, AFTER THE SPLITTING OF A CHANNEL
C                        HICHAN)  EITHER BY THE BREAKING OF A CYCLE OR
C                                 DURING THE FORMATION OF T-INTERSECTIONS,
C                                 THIS ROUTINE RESETS THE POINTERS TO
C                                 THE CELLS ON CHANNEL (CLONCH) ARRAY SO
C                                 EACH OF THE TWO NEWLY FORMED CHANNELS
C                                 POINT TO THE RIGHT CELLS.  *LOCHAN*
C                                 AND *HICHAN* ARE THE TWO NEW CHANNELS
C                                 IN QUESTION WHICH CORRESPOND TO THE
C                                 LOW HALF AND THE HIGH HALF OF THE
C                                 ORIGINAL UNBROKEN CHANNEL.
C$E
C$ 2612CHDUPD
C  CHDUPD 2612  CALL CHDUPD        OUTPUT CELLS ALONG CHANNEL FILE AND
C                                 UPDATE DESIGN FILE TO REFLECT CHANNEL
C                                 DEFINITION COMPLETION.
C$E
C$ 2613CHDRPT
C  CHDRPT 2613  CALL CHDRPT        OUTPUTS THE REPORT FILE FOR THE
C                                 CHANNEL DEFINITION SUBSYSTEM.  THIS
C                                 CONTAINS A SUMMARY OF THE CHANNELS
C                                 CREATED AND OPTIONALLY A SUMMARY OF
C                                 EXECUTION TIME NEEDED ON SELECTED
C                                 SUB-SECTIONS OF THE CHANNEL DEFINITION
C                                 PROCESS.
C$E
C$ 2614CHDTST
C  CHDTST 2614  CALL CHDTST        UNIT TEST DRIVER FOR CHD SUBSYSTEM.
C                                 INVOKED WHENEVER CHDPOF(1) .NE. 0.
C                                 PERFORMS UNIT TEST OF MODULE POINTED
C                                 TO BY CHDPLF(11).
C$E
```

```
C$ 2615ADJCHN
C  ADJCHN 2615  CALL ADJCHN          ADJUSTS THE CHANNEL SIZES TO FALL WITHIN
C                                   A GIVEN RANGE AND MAKE SURE ALL CHANNEL
C                                   EDGES FALL ON GRID.
C
C$F
C$ 2616CHDXPN
C  CHDXPN 2616  CALL CHDXPN(CHNID,  EXPANDS THE WIDTH OF CHANNEL *CHNID* BY
C                        ADDWID)  *ADDWID* MMES.
C
C$F
```

```
MMMMMMMMMM   3333333333333333333333333333333333333333333333333333333333333333333333333333333333333333333333   MMMMMMMMMM
MMMMMMMMMM   333333333333333333334333  DIGITAL EQUIPMENT CORPORATION - VAX/VMS VERSION V4.4  3333333333333333333333   MMMMMMMMMM
MMMMMMMMMM   3333333333333333333333333333333333333333333333333333333333333333333333333333333333333333333333   MMMMMMMMMM
```

DIGITAL EQUIPMENT CORPORATION - VAX/VMS VERSION V4.4

KMP

CHDPT6

.DOC

;1

FILE _$1$DUA6:[PRE.CHD02]CHDPT6.DOC;1 (2378,1,1), LAST REVISED ON 21-OCT-1986 08:44, IS A 38 BLOCK SEQUENTIAL FILE OWNED BY UIC [PRDIS1,PFC]. THE RECORDS ARE VARIABLE LENGTH WITH IMPLIED (CR) CARRIAGE CONTROL. THE LONGEST RECORD IS 82 BYTES.

JOB CHDPT6 (203) QUEUED TO SYS$PRINT ON 4-DEC-1986 12:50 BY USER KMP, UIC [ENGVLS1,KMP], UNDER ACCOUNT ENGEKG AT PRIORITY 100, STARTED ON PRINTER _TCN1C$LPA0: ON 4-DEC-1986 13:09 FROM QUEUE SYS$PRINT.

DIGITAL EQUIPMENT CORPORATION - VAX/VMS VERSION V4.4

VAX/VMS VAX/VMS VAX/VMS VAX/VMS VAX/VMS VAX/VMS VAX/VMS VAX/VMS VAX/VMS VAX/VMS VAX/VMS VAX/VMS

DIGITAL EQUIPMENT CORPORATION - VAX/VMS VERSION V4.4

KMP

CHDPT6

DOC

;1

FILE _$1$DUA6:[PRC.CHC02]CHDPT6.DOC;1 (2378,1,1), LAST REVISED ON 21-OCT-1986 08:44, IS A 38 BLOCK SEQUENTIAL FILE OWNED BY UIC [PRCTST,PFC]. THE RECORDS ARE VARIABLE LENGTH WITH IMPLIED (CR) CARRIAGE CONTROL. THE LONGEST RECORD IS 82 BYTES.

JOB CHDPT6 (203) QUEUED TO SYS$PRINT ON 4-DEC-1986 12:50 BY USER KMP, UIC [ENGVLSI,KMP], UNDER ACCOUNT ENGPKG AT PRIORITY 100, STARTED ON PRINTER _TCN10$LPA0: ON 4-DEC-1986 13:09 FROM QUEUE SYS$PRINT.

DIGITAL EQUIPMENT CORPORATION - VAX/VMS VERSION V4.4

```
C ******************************************************************
C ******************************************************************
C *******                                                   *******
C *******                  CHDEF16.DOC                      *******
C *******        CPD SUBSYSTEM OF SUBROUTINE CDCPT6         *******
C *******                                                   *******
C *******                                                   *******
C ******************************************************************
C
C ******************************************************************
C **      (C) COPYRIGHT V-R INFORMATION SYSTEMS, INC.  1985      **
C **      LICENSED MATERIAL -- PROGRAM PROPERTY OF VRIS          **
C **      ALL RIGHTS RESERVED                                    **
C **                                                             **
C **      THIS PROGRAM IS THE PROPERTY OF VRIS AND IS FURNISHED  **
C **      PURSUANT TO A WRITTEN LICENSE AGREEMENT.  IT MAY NOT BE **
C **      USED, REPRODUCED, OR DISCLOSED TO OTHERS EXCEPT IN      **
C **      ACCORDANCE WITH THE TERMS AND CONDITIONS OF THAT        **
C **      AGREEMENT.                                             **
C ******************************************************************
C
C
C   --  REVISION HISTORY --
C       01-OCT-85 TAF ADDED DOCUMENTATION FOR NEW VARIABLES *MXCLXX*,
C                     *MXCLYY*, *CRRUPD*, AND *CHNSHT*.  (SAR 5200)
C       15-DEC-84 TAF WROTE DOCUMENTATION.  (SAR 4857)
C
C$ CHDCCH
C
C                   ****************
C                   * NAMED COMMON *
C                   *    CHDCCH    *
C                   ****************
C
C
C       CELL ALONG CHANNEL INFORMATION FOR THE CHANNEL DEFINITION
C       SUBSYSTEM
C
C CLONCH(*,*)           I     CELLS ALONG CHANNEL STORAGE ARRAY.
C (4,@DEVSONCHAN)             ENTRIES ARE
C                                CELL INDEX
C                                CHANNEL INDEX WHICH THE CELL LIES ON
C                                INDICATOR AS TO WHETHER THE CELL LIES
C                                   ON THE LOW OR HIGH SIDE OF THE CELL
C                                   0 - LIES ON HIGH SIDE OF CHANNEL
C                                   1 - LIES ON LOW SIDE OF CHANNEL
C                                COORDINATE VALUE FOR THE CELL TO BE USED
C                                   IN SORTING THE CELLS
C
C CLCCLX                I     CELL INDEX VALUE OF ENTRY IN CELLS ALONG CHANNEL
C                             ARRAY
C
C CLCCHX                I     CHANNEL INDEX ON WHICH THE CELL LIES ON FOR ENTRY
C                             IN CELLS ON CHANNEL ARRAY
C
C CLCSID                I     INDICATOR AS TO WHETHER THE CELL ENTRY IN THE
C                             CELLS ON CHANNEL ARRAY LIES ON THE HIGH OR LOW
C                             SIDE OF THE CHANNEL
C                                0 - HIGH SIDE OF CHANNEL
C                                1 - LOW  SIDE OF CHANNEL
C
C CLCSRT                I     COORDINATE VALUE OF CELL ENTRY IN CELLS ALONG
C                             CHANNEL ARRAY TO BE USED FOR SORTING.
C                                HORIZ CHAN - CELLS X-COORDINATE
C                                VERT  CHAN - CELLS Y-COORDINATE
C
C NMCLCC                I     NUMBER OF CELLS ENTERED IN CLONCH ARRAY
C
C$E CHDCCH
C$ CHDCEL
C
C                   ****************
C                   * NAMED COMMON *
C                   *    CHDCEL    *
C                   ****************
C
C       CELL INFORMATION FOR THE CHANNEL DEFINITION SUBSYSTEM
C
C CELLS(*,*)            I     CELL STORAGE ARRAY.  ENTRIES ARE
C (16,$DEVICES)                  CELL INDEX
C                                LOWER-LEFT  X-COORDINATE OF CELL
C                                LOWER-LEFT  Y-COORDINATE OF CELL
C                                UPPER-RIGHT X-COORDINATE OF CELL
C                                UPPER-RIGHT Y-COORDINATE OF CELL
C                                INDICATOR AS TO THE TYPE OF CELL
```

```
C                             0      - REGULAR CELL
C                             NON-0  - I/O CELL
C                          DISTANCE CELL HAS MOVED DUE TO EXPANSION
C                             IN BOTH THE X AND Y DIRECTIONS
C                          ADJACENT CHANNEL TO CELL ON EACH OF ITS
C                             FOUR SIDES (NORTH, EAST SOUTH, WEST)
C                          ADJACENT CELL TO THE CELL ON EACH OF ITS
C                             FOUR SIDES
C CELIDX            I    CELL INDEX NUMBER IN CELLS ARRAY
C
C CELLLX            I    LOWER-LEFT  X-COORDINATE OF CELL IN CELLS ARRAY
C
C CELLLY            I    LOWER-LEFT  Y-COORDINATE OF CELL IN CELLS ARRAY
C
C CELURX            I    UPPER-RIGHT X-COORDINATE OF CELL IN CELLS ARRAY
C
C CELURY            I    UPPER-RIGHT Y-COORDINATE OF CELL IN CELLS ARRAY
C
C CELTYP            I    INDICATOR AS TO THE TYPE OF CELL IN THE CELLS
C                        ARRAY
C                           0 - UNKNOWN OR REGULAR TYPE CELL
C                           1 - LEFT   SIDE I/O
C                           2 - RIGHT  SIDE I/O
C                           3 - BOTTOM SIDE I/O
C                           4 - TOP    SIDE I/O
C CELXMV            I    DISTANCE CELL HAS BEEN MOVED IN THE X-DIRECTION
C                        DUE TO EXPANSION
C
C CELYMV            I    DISTANCE CELL HAS BEEN MOVED IN THE Y-DIRECTION
C                        DUE TO EXPANSION
C
C CELNCH            I    INDEX OF THE CHANNEL WHICH LIES TO THE NORTH (TOP)
C                        OF THE GIVEN CELL.  (0 --> NO ADJACENT CHANNEL)
C
C CELECH            I    INDEX OF THE CHANNEL WHICH LIES TO THE EAST (RIGHT)
C                        OF THE GIVEN CELL.  (0 --> NO ADJACENT CHANNEL)
C
C CELSCH            I    INDEX OF THE CHANNEL WHICH LIES TO THE SOUTH (BOTTOM)
C                        OF THE GIVEN CELL.  (0 --> NO ADJACENT CHANNEL)
C
C CELWCH            I    INDEX OF THE CHANNEL WHICH LIES TO THE WEST (LEFT)
C                        OF THE GIVEN CELL.  (0 --> NO ADJACENT CHANNEL)
C
C CELNCL            I    INDEX OF THE CELL WHICH LIES TO THE RIGHT OF THE
C                        GIVEN CELL BY FOLLOWING THE CHANNEL TO THE NORTH
C                        (TOP) OF THE CELL.  IF THERE IS NO ADJACENT NORTH
C                        CHANNEL, OR NO CELL AT THAT POINT, THE VALUE WILL
C                        BE ZERO.
C
C CELECL            I    INDEX OF THE CELL WHICH LIES TO THE TOP OF THE
C                        GIVEN CELL BY FOLLOWING THE CHANNEL TO THE EAST
C                        (RIGHT) OF THE CELL.  IF THERE IS NO ADJACENT EAST
C                        CHANNEL, OR NO CELL AT THAT POINT, THE VALUE WILL
C                        BE ZERO.
C
C CELSCL            I    INDEX OF THE CELL WHICH LIES TO THE RIGHT OF THE
C                        GIVEN CELL BY FOLLOWING THE CHANNEL TO THE SOUTH
C                        (BOTTOM) OF THE CELL.  IF THERE IS NO ADJACENT
C                        SOUTH CHANNEL, OR NO CELL AT THAT POINT, THE VALUE
C                        WILL BE ZERO.
C
C CELWCL            I    INDEX OF THE CELL WHICH LIES TO THE TOP OF THE
C                        GIVEN CELL BY FOLLOWING THE CHANNEL TO THE WEST
C                        (LEFT) OF THE CELL.  IF THERE IS NO ADJACENT
C                        WEST CHANNEL, OR NO CELL AT THAT POINT, THE VALUE
C                        WILL BE ZERO.
C
C NMCELS            I    TOTAL NUMBER OF CELLS IN LAYOUT
C
C$E CHDCEL
C$ CHDCHN
C
C                  ****************
C                  * NAMED COMMON *
C                  *    CHDCHN    *
C                  ****************
C
C      - CHANNEL INFORMATION FOR THE CHANNEL DEFINITION SUBSYSTEM
C
C CHANLS(*,*)       I    CHANNEL STORAGE ARRAY.  ENTRIES ARE
C (14,$CHANNELS)            CHANNEL INDEX
```

```
C                                   CHANNEL ORIENTATION
C                                   LOWER-LEFT X-COORDINATE
C                                   LOWER-LEFT Y-COORDINATE
C                                   UPPER-RIGHT X-COORDINATE
C                                   UPPER-RIGHT Y-COORDINATE
C                                   ROUTING SEQUENCE NUMBER
C                                   CHANNEL INDEX OF CYCLE PARTNER
C                                   INDEX OF FIRST CELL ON LOW SIDE OF CHANNEL
C                                   NUMBER OF CELLS ON LOW SIDE OF CHANNEL
C                                   INDEX OF FIRST CELL ON HIGH SIDE OF CHANNEL
C                                   NUMBER OF CELLS ON HIGH SIDE OF CHANNEL
C                                   INDEX OF CHANNEL FED BY LOW END OF THIS CHANNEL
C                                   INDEX OF CHANNEL FED BY HIGH END OF THIS CHANNEL
C                               RESPECTIVELY
C
C CHNIDX                I       CHANNEL INDEX NUMBER
C
C CHNORN                I       CHANNEL ORIENTATION
C                                   1 - HORIZONTAL CHANNEL
C                                   2 - VERTICAL   CHANNEL
C
C CHNLLX                I       LOWER-LEFT X-COORDINATE OF THE CHANNEL
C
C CHNLLY                I       LOWER-LEFT Y-COORDINATE OF THE CHANNEL
C
C CHNURX                I       UPPER-RIGHT X-COORDINATE OF THE CHANNEL
C
C CHNURY                I       UPPER-RIGHT Y-COORDINATE OF THE CHANNEL
C
C CHNSEQ                I       ROUTING SEQUENCE NUMBER OF THE CHANNEL
C
C CHNCYC                I       CHANNEL INDEX NUMBER OF CHANNEL WHICH IS
C                               LINKED TO THE GIVEN CHANNEL BECAUSE OF A
C                               CYCLE.  IF THE CHANNEL IS NOT A PART OF A
C                               CYCLE, THIS VALUE WILL BE ZERO.
C
C CHNLCL                I       POINTER INTO THE CELLS ALONG CHANNEL ARRAY OF
C                               THE FIRST CELL ON THE LOW SIDE OF THIS CHANNEL
C
C CHNLCT                I       NUMBER OF CELLS ON THE LOW SIDE OF THIS CHANNEL
C
C CHNHCL                I       POINTER INTO THE CELLS ALONG CHANNEL ARRAY OF
C                               THE FIRST CELL ON THE HIGH SIDE OF THIS CHANNEL
C
C CHNHCT                I       NUMBER OF CELLS ON THE HIGH SIDE OF THIS CHANNEL
C
C CHNLFD                I       ID NUMBER OF THE CHANNEL FED BY THE "LO" END
C                               OF THIS CHANNEL.  NOTE: THE "LO" END OF A
C                               CHANNEL IS LOWER OR LEFT END.
C
C CHNHFD                I       ID NUMBER OF THE CHANNEL FED BY THE "HI" END
C                               OF THIS CHANNEL.  NOTE: THE "HI" END OF A
C                               CHANNEL IS THE UPPER OR RIGHT END.
C
C CHNSRT(4, $CHANNELS)  I       CONTAINS THE CHANNELS SORTED
C                               BY ORIENTATION AND X,Y COORDINATE
C                               TO BE USED DURING CHANNEL EXPANSION.
C                               HORIZONTAL CHANNELS ARE LISTED FIRST.
C                               CHANNELS ARE LISTED IN ORDER FROM
C                               THE LOW END TO THE HIGH END OF THE
C                               CARRIER.  FIELDS ARE AS FOLLOWS:
C                                 1 - CHANNEL INDEX NUMBER
C                                 2 - CHANNEL ORIENTATION
C                                       HZ - 1;  VT - 2
C                                       (PRIMARY SORT KEY)
C                                 3 - INITIALLY:
C                                       LLY COORDINATE FOR HZ CHAN
C                                       LLX COORDINATE FOR VT CHAN
C                                       (SECONDARY SORT KEY)
C                                     FINALLY:
C                                       POINTER TO THE POSITION OF
C                                       A GIVEN CHANEL INDEX INTO
C                                       THE *CHNSRT* ARRAY FOR EASY
C                                       ACCESS
C                                 4 - LLX COORDINATE FOR HZ CHAN
C                                     LLY COORDINATE FOR VT CHAN
C                                     (TERTIARY SORT KEY)
C NMCHAN                I       TOTAL NUMBER OF CHANNELS
C
C NMHZCH                I       NUMBER OF HORIZONTAL CHANNELS
C
```

```
_$1$DUA6:[FRD.CHDV2]CHLFT6.DOC;1                                  21-OCT-1986 08:44                                PAGE 4
C NMVICH                 I     NUMBER OF VERTICAL CHANNELS
C
C$E CHDCHN
C$ CHDPLN
C                     ****************
C                     * NAMED COMMON *
C                     *    CHDPLN    *
C                     ****************
C
C          PROJECTION LINE INFORMATION FOR CHANNEL DEFINITION.
C
C LINES(*,*)             I     ARRAY CONTAINING PROJECTION LINE INFORMATION.
C (5,@DEVEDGES)
C
C LINRF1                 I     LOW ENDPOINT COORDINATE OF PROJECTION LINE.
C                              (X-COORDINATE IF HORIZ LINE; Y-COORDINATE
C                              IF VERTICAL LINE)
C
C LINRF2                 I     HIGH ENDPOINT COORDINATE OF PROJECTION LINE.
C                              (X-COORDINATE IF HORIZ LINE; Y-COORDINATE
C                              IF VERTICAL LINE)
C
C LINCEL                 I     CELL INDEX NUMBER FROM WHICH PROJECTION LINE
C                              WAS TAKEN
C
C LINCUT                 I     COORDINATE VALUE OF CUT POSITION OF PROJECTION
C                              LINE.  (Y-COORDINATE IF HORIZ LINE; X-COORDINATE
C                              IF VERTICAL LINE)
C
C LINSIC                 I     INDICATES WHETHER THE PROJECTION LINE WAS TAKEN
C                              FROM THE HIGH OR LOW SIDE OF A CELL.
C                                 1 - FROM LOW SIDE OF CELL
C                                 2 - FROM HIGH SIDE OF CELL
C
C NMLINS                 I     CURRENT NUMBER OF PROJECTION LINES IN THE
C                              ARRAY *LINES*
C
C$E CHDPLN
C$ CHDSTA
C                     ****************
C                     * NAMED COMMON *
C                     *    CHDSTA    *
C                     ****************
C
C          VARIOUS STATUS VARIABLES FOR CHANNEL DEFINITION SUBSYSTEM
C
C CRRUPD                 I     INDICATES WHETHER EXPANSION TOOK PLACE
C                              AND OBJECT LOCATIONS ON THE CARRIER
C                              SHOULD BE UPDATED.
C                                 0 - NO EXPANSION OCCURRED
C                                 1 - EXPANSION OCCURRED
C
C GRIDXX                 I     GRID SIZE IN THE X-DIRECTION
C
C GRIDYY                 I     GRID SIZE IN THE Y-DIRECTION
C
C IOLLX                  I     LOWER-LEFT X-COORDINATE OF THE RECTANGLE
C                              CONTAINING ALL NON-I/O CELLS.  (IE THE
C                              MAXIMUM X-COORDINATE OF ALL I/O CELLS ON
C                              THE WEST SIDE OF THE CARRIER)
C
C IOLLY                  I     LOWER-LEFT Y-COORDINATE OF THE RECTANGLE
C                              CONTAINING ALL NON-I/O CELLS.  (IE THE
C                              MAXIMUM Y-COORDINATE OF ALL I/O CELLS ON
C                              THE SOUTH SIDE OF THE CARRIER)
C
C IOURX                  I     UPPER-RIGHT X-COORDINATE OF THE RECTANGLE
C                              CONTAINING ALL NON-I/O CELLS.  (IE THE
C                              MINIMUM X-COORDINATE OF ALL I/O CELLS ON
C                              THE EAST SIDE OF THE CARRIER)
C
C IOURY                  I     UPPER-RIGHT Y-COORDINATE OF THE RECTANGLE
C                              CONTAINING ALL NON-I/O CELLS.  (IE THE
C                              MINIMUM Y-COORDINATE OF ALL I/O CELLS ON
C                              THE NORTH SIDE OF THE CARRIER)
C
C MINCHN                 I     MINIMUM CHANNEL WIDTH NECESSARY.  THIS IS NEEDED
C                              SO WIRES MAY BE ADDED THROUGH THE GWE SUBSYSTEM.
C                              IT IS CALCULATED AS TWO TIMES THE MAXIMUM WIRE
C                              WIDTH PLUS ITS GUARDBAND.
C
C MXCLXX                 I     MAXIMUM X-COORDINATE VALUE OF
```

```
C                                 THE CELLS ON THE CARRIER.
C
C MXCLYY              I      MAXIMUM Y-COORDINATE VALUE OF
C                            THE CELLS ON THE CARRIER.
C
C NMCYCL              I      TOTAL NUMBER OF CYCLES OCCURRING IN THE
C                            LAYOUT
C
C RTGLLX              I      LOWER-LEFT X-COORDINATE OF THE ROUTABLE
C                            AREA ON THE CARRIER (TAKEN FROM THE PBG
C                            RECORD IN THE DESIGN FILE).
C
C RTGLLY              I      LOWER-LEFT Y-COORDINATE OF THE ROUTABLE
C                            AREA ON THE CARRIER (TAKEN FROM THE PBG
C                            RECORD IN THE DESIGN FILE).
C
C RTGURX              I      UPPER-RIGHT X-COORDINATE OF THE ROUTABLE
C                            AREA ON THE CARRIER (TAKEN FROM THE PBG
C                            RECORD IN THE DESIGN FILE).
C
C RTGURY              I      UPPER-RIGHT Y-COORDINATE OF THE ROUTABLE
C                            AREA ON THE CARRIER (TAKEN FROM THE PBG
C                            RECORD IN THE DESIGN FILE).
C
C SEQNUM              I      CURRENT NUMBER OF SEQUENCED CHANNELS
C
C XPNXXX              I      DISTANCE THE CARRIER WAS EXPANDED IN THE
C                            X-DIRECTION
C
C XPNYYY              I      DISTANCE THE CARRIER WAS EXPANDED IN THE
C                            Y-DIRECTION
C
C NORTCH              I      TOP-MOST HORIZONTAL CHANNEL ON THE CARRIER
C
C EASTCH              I      RIGHT-MOST VERTICAL CHANNEL ON THE CARRIER
C
C SOUTCH              I      BOTTOM-MOST HORIZONTAL CHANNEL ON THE CARRIER
C
C WESTCH              I      LEFT-MOST VERTICAL CHANNEL ON THE CARRIER
C
CSE CHDSTA
CS CHDTIM
C
C                 ****************
C                 * NAMED COMMON *
C                 *    CHDTIM    *
C                 ****************
C
C         INSTRUMENTATION TIME VARIABLES FOR THE CHANNEL
C         DEFINITION SUBSYSTEM
C
C BRAKTM              I      TIME TAKEN TO BREAK THE CHANNELS INTO
C                            T-INTERSECTIONS.
C
C BUILTM              I      TIME TAKEN TO CREATE THE PROJECTION LINES
C                            FROM THE CELL DATA.
C
C LOADTM              I      TIME TAKEN TO INPUT THE DESIGN FILE AND
C                            LOAD ALL CELL INFORMATION.
C
C MERGTM              I      TIME TAKEN TO MERGE THE PROJECTION LINES
C                            TOGETHER TO FORM THE CHANNELS.
C
C SEQCTM              I      TIME TAKEN TO SEQUENCE THE CHANNELS.
C
C TOTLTM              I      TOTAL TIME TAKEN TO RUN THE WHOLE CHANNEL
C                            DEFINITION PROCESS.
C
C UPDATM              I      TIME TAKEN TO OUTPUT THE CELLS ON CHANNEL
C                            FILE AND THE NEW DESIGN FILE.
C
C XPANTM              I      TIME TAKEN TO EXPAND THE CARRIER AS NEEDED
C
CSE CHDTIM
```

```
DIGITAL EQUIPMENT CORPORATION - VAX/VMS VERSION V4.4

FILE _$18DUA6:[PRC.TRS02]TRS.DOC;5 (7533,1,1), LAST REVISED ON 21-OCT-1986 09:02, IS A 156 BLOCK SEQUENTIAL FILE OWNED BY UIC
[PRDTS1,PRC].  THE RECORDS ARE VARIABLE LENGTH WITH FORTRAN (FTN) CARRIAGE CONTROL.  THE LONGEST RECORD IS 76 BYTES.

JOB TRS (198) QUEUED TO SYS$PRINT ON 4-DEC-1986 12:50 BY USER KMP, UIC [ENGVLSI,KMP], UNDER ACCOUNT ENGPKG AT PRIORITY 3, STARTED
ON PRINTER _TCM1CSLPA0: ON 4-DEC-1986 13:47 FROM QUEUE SYS$PRINT.

DIGITAL EQUIPMENT CORPORATION - VAX/VMS VERSION V4.4

VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
```

```
   VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
   VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS

CCCCCCCCCC   77777777777777777777777777777777777777777777777777777777777777777777777777777777777777777777777   CCCCCCCCCC
CCCCCCCCCC   777777777777777777777777  DIGITAL EQUIPMENT CORPORATION - VAX/VMS VERSION V4.4  777777777777777777777777   CCCCCCCCCC
CCCCCCCCCC   77777777777777777777777777777777777777777777777777777777777777777777777777777777777777777777777   CCCCCCCCCC

K     K   M       M   PPPP
K    K    MM     MM   P   P
K   K     M M   M M   P   P
KKK       M   M   M   PPPP
K   K     M       M   P
K    K    M       M   P
K     K   M       M   P

TTTTTTTTTT   RRRRRRRR      SSSSSSSS
TTTTTTTTTT   RRRRRRRR      SSSSSSSS
    TT       RR      RR  SS
    TT       RR      RR  SS
    TT       RR      RR  SS
    TT       RR      RR  SS
    TT       RRRRRRRR      SSSSSS
    TT       RRRRRRRR      SSSSSS
    TT       RR  RR              SS
    TT       RR  RR              SS
    TT       RR    RR            SS
    TT       RR    RR            SS
    TT       RR      RR  SSSSSSSS
    TT       RR      RR  SSSSSSSS

DDDDDDDD      OOOOOO      CCCCCCCC
DDDDDDDD      OOOOOO      CCCCCCCC
DD      DD  OO      OO  CC
DD      DD  OO      OO  CC
DD      DD  OO      OO  CC
DD      DD  OO      OO  CC
DD      DD  OO      OO  CC
DD      DD  OO      OO  CC
DD      DD  OO      OO  CC
DD      DD  OO      OO  CC
DD      DD  OO      OO  CC
DDDDDDDD      OOOOOO      CCCCCCCC
DDDDDDDD      OOOOOO      CCCCCCCC

....
....
....
....

        ;;;;   5555555555
        ;;;;   5555555555
        ;;;;   55
        ;;;;   55
               555555
               555555
        ;;;;         55
        ;;;;         55
        ;;;;           55
        ;;;;           55
          ;;   55      55
          ;;   55      55
        ;;       555555
        ;;       555555
```

FILE _$1$DUA6:[PPI.TRS02]TRS.DOC;5 (7533,1,1), LAST REVISED ON 21-OCT-1986 09:02, IS A 156 BLOCK SEQUENTIAL FILE OWNED BY UIC [PLOTST,PEC]. THE RECORDS ARE VARIABLE LENGTH WITH FORTRAN (FTN) CARRIAGE CONTROL. THE LONGEST RECORD IS 76 BYTES.

JOB TRS (190) QUEUED TO SYS$PRINT ON 4-DEC-1986 12:50 BY USER KMP, UIC [ENGVLSI,KMP], UNDER ACCOUNT ENGPKG AT PRIORITY 3, STARTED ON PRINTER _TCNTCSLPA0: ON 4-DEC-1986 13:47 FROM QUEUE SYS$PRINT.

```
CCCCCCCCCC   77777777777777777777777777777777777777777777777777777777777777777777777777777777777777777777777   CCCCCCCCCC
CCCCCCCCCC   777777777777777777777777  DIGITAL EQUIPMENT CORPORATION - VAX/VMS VERSION V4.4  777777777777777777777777   CCCCCCCCCC
CCCCCCCCCC   77777777777777777777777777777777777777777777777777777777777777777777777777777777777777777777777   CCCCCCCCCC
```

14112 S.B.

```
*************************************
*************************************
**                                 **
** TRS SUBSYSTEM DOCUMENTATION     **
**                                 **
*************************************
*************************************

*************************************************************
*************************************************************
**                                                         **
**  (C) COPYRIGHT V-R INFORMATION SYSTEMS, INC. 1981       **
**  LICENSED MATERIAL -- PROGRAM PROPERTY OF VRIS          **
**  ALL RIGHTS RESERVED                                    **
**                                                         **
**  THIS PROGRAM IS THE PROPERTY OF VRIS AND IS FURNISHED  **
**  PURSUANT TO A WRITTEN LICENSE AGREEMENT. IT MAY NOT BE **
**  USED, REPRODUCED, OR DISCLOSED TO OTHERS EXCEPT IN     **
**  ACCORDANCE WITH THE TERMS AND CONDITIONS OF THAT       **
**  AGREEMENT.                                             **
**                                                         **
*************************************************************
*************************************************************

RECENT REVISION HISTORY
-----------------------
12-SEP-86 TAF GENERALIZED EXPLANATION OF TRSPOP(8) TO
              SAME NET VIA-TO-VIA SPACING.  (SAR 6012)
04-MAR-86 DDC ADDED NEGATIVE CHANNEL NUMBER TO POPTIN(24).
              (SAR 5591)
24-FEB-86 DDC ADDED POPTIN(27) FOR SAVING TRACKS AT THE EDGE
              OF THE CHANNEL.  (SAR 5576)
04-FEB-85 DDC ADDED CHANNEL NUMBER TO POPTIN(11) OPTIONS.
              (SAR 5501)
13-NOV-85 DDC ADDED POPTIN 3 AND REVISED POPTIN(20).
              (SAR 5356).  MOVED CALL TO *TSPACE*. (SAR 5369)
23-SEP-85 DDC ADDED POPTIN'S 6, 9, 10, 24, 25 & 26.  ADDED
              TOKENS TRSCONNECT AND TRSCNSTRNT.
              (SARS 5197 AND 5241)
08-APR-85 DDC MODIFIED TRK.DOC TO CREATE TRS.DOC.  (SAR 4219)
30-NOV-84 DDC REMOVED TRKPOP(3), FROMTO GENERATION.  (SAR 4238)
              MOVED 'JOGGING DOGLEG' FROM 'FUTURE ENHANCEMENTS'
              TO 'CAPABILITIES'.  (SAR 4053)
09-OCT-84 DDC ADDED TRKPOP(8) FOR SAME NET VIA-TO-NODE
              SPACING REQUIREMENT.  (SAR 4045)
07-SEP-84 SHW CHANGED DOCUMENTATION ON DEFAULT PROCESSING
              OPTIONS FOR POPTIN(20)=2, POPTIN(21&22) = 0
              (SAR 4038)
06-SEP-84 DDC REMOVED GTCONN, STCONN, GTTERN, STTERN ROUTINES
              FROM TRK SUBSYSTEM. (SAR 3997)
              REVISED TRKPOP(2) DESCRIPTION. (SAR 3774)
14-AUG-84 DDC CHANGED IOFIL INDEXES 15 AND 16 TO 3 AND 7 (SAR 4008)
11-MAR-84 KKF ADDED NOTES TO THE ASSUMPTIONS AND CONSTRAINTS
              SECTION RELATING TO HOW NODES ON THE EDGES OF
              A CHANNEL ARE MODELLED. (SAR 3524).
21-NOV-83 DDC DELETED TRKPOP(8) - CONTROL OVER GRIDDED
              SPACING LIMITATIONS.  IN ASSUMPTIONS AND
              CONSTRAINTS, REVISED NO. 4, ADDED NO. 12.
              (SAR 3374)
 7-OCT-83 DCB INSERTED NEW COPYRIGHT LEGEND
              (SAR 3233)
22-SEP-83 DDC ADDED TO ASSUMPTIONS AND CONSTRAINTS NUMBER 3
              THAT VIA BARRIERS ARE IGNORED.  (SAR 2284)
              REVISED TRKPOP(5) TO BE THE MAXIMUM SIDE
              PREFERENCE.  (SAR 2837)
 4-AUG-83 JAW IMPLEMENTED DESIGN RULE ENHANCEMENTS:
              THE DIAGONAL VIA CLEARANCE FLAG OF THE DESIGN
              VIA HYPERGRID DESCRIPTION NOW PROVIDES THE
              FORMER FUNCTION OF TRACK ASSIGNMENT PROCESSING
              OPTION 7. (SAR 3068)
13-JAN-83 MJL CORRECTED PROCESSING OPTIONS 3 AND 7 TO REFLECT
              RECENT SYSTEM CHANGES (SAR 2584)
10-DEC-82 MJL REWORDED PROCESSING OPTION DESCRIPTIONS FOR
              GREATER CLARITY (SAR 2552)
18-OCT-82 MJL PUT IN VIA SPACING CONSTRAINT INFO (SAR 2326)
15-SEP-82 MAE ADDED CAPACITY MODIFICATION INFORMATION.
              (SAR 2193)
25-AUG-82 MAE ADDED TO DOCUMENTATION INFORMATION CONCERNING
              A NEW TRK MODULE THAT MERGES COLINEAR WIRE
              SEGMENTS WITHIN THE CHANNEL.
```

```
                    (SAR 2130)
04-AUG-82 WAD MODIFIED DOCUMENTATION TO REFLECT THE BREAKING
              UP OF THE TEST DRIVER *TRKTST* S702 MODULE INTO
              TWO NEW ADDITION MODULE TRKTS1 AND TRKTS2.
              (SAR 2087)
28-JUL-82 ERM ADDED EQUIVALENT WIRE RULE ASSUMPTIONS (SAR 1951)
04-JUN-82 LNB FOR TRAKMX UPGRADE. (SAR 1644)
07-MAY-82 MJL AFTER RELEASE 3.0 SAR WORK
28-JAN-82 WAD AFTER REVIEW 22-JAN-1982 BY RJS.
05-JAN-82 LNB ADDED SIGMAX AND MODMAX DOCMENT.
04-SEP-81 MJL+WAD REVISED
17-JUL-81 MJL+WAD REVISED
19-JUN-81 MJL+WAD REVISED
27-APR-81 MJL+WAD REVISED
WRITTEN 11-JAN-1981 BY MJL

*****************************
* TRACK ASSIGNMENT OVERVIEW *
*****************************

PROBLEM OVERVIEW
----------------
GIVEN THE LAYER RECTANGLES (CHANNELS) WITH TERMINALS
BELONGING TO VARIOUS NETS ALONG THEIR PERIPHERIES (WHICH MAY BE
FIXED OR FLOATING) THE TRACK ASSIGNMENT PROGRAM DEFINES WIRE
SEGMENTS AND VIAS WITHIN THE CHANNEL AREA TO INTERCONNECT THOSE
TERMINALS.

HOW TO USE THIS SYSTEM
----------------------

NOTE THAT THE FOLLOWING COMMANDS ARE ONLY APPLICABLE FOR
A VAX 780 ECS1.  TRACK ASSIGNMENT CAN ONLY BE EXECUTED
AFTER AN UPDATED DESIGN FILE, TERMINAL FILE, AND CELLS-ON-
CHANNEL FILE HAVE BEEN PRODUCED BY A GLOBAL ROUTER.

BCHTRS

BCHTRS IS USED TO SUBMIT A TRACK ASSIGNMENT JOB ON A
BATCH EXECUTION QUEUE.  THIS COMMAND FILE WILL PROMPT
THE USER FOR ALL NECESSARY INFORMATION.


ALWAYS CHECK THE REPORT FILE CAREFULLY FOR ANY
DIAGNOSTIC MESSAGES.  FOR JOBS SUBMITTED ON BATCH QUEUES,
IT MIGHT BE NECESSARY TO REVIEW THE EXECUTION LOG FILES
TO ISOLATE ANY PROBLEMS.

SUMMARY OF SOFTWARE EXTERNAL BEHAVIOR
-------------------------------------

--INPUTS
  AN UNROUTED DESIGN FILE WHICH MAY CONTAIN
  PREWIRED POWER AND GROUND CONNECTIONS, A FILE
  CONTAINING A LIST OF TERMINALS SORTED BY CHANNEL
  SEQUENCE NUMBER, A FILE CONTAINING A LIST OF CELLS-
  ON-CHANNEL FOR THE LOW AND HIGH SIDES OF EACH CHANNEL,
  AND A CONTROL FILE CONTAINING PROCESSING OPTION AND
  TRACE LEVEL SETTINGS.

--OUTPUTS--
  UPDATED VERSION OF DESIGN FILE WITH NEWLY CREATED RWS
  RECORDS, REFLECTING FINAL BOARD SIZE AND PLACEMENT OF
  CHANNELS AND CELLS AND ALL CELL-RELATED ENTITIES ON THE
  BOARD, AND A REPORT FILE CONTAINING SUMMARY INFORMATION,
  TRACE MESSAGES AND ANY RESULTING DIAGNOSTICS.

--ASSUMPTIONS AND CONSTRAINTS--

1. TERMINAL LOCATIONS CAN BE EITHER FIXED IN POSITION OR
   FLOATING AT CHANNEL INTERSECTIONS BEFORE TRACK ASSIGNMENT.
   ALSO, TERMINALS WHICH ARE FIXED IN POSITION MUST
   BE SPREAD AT LEAST VIA-TO-WIRE SEPARATION FROM EACH OTHER.

2. WITH THE EXCEPTION OF PRE-EXISTING POWER/GROUND CONNECTIONS,
```

WIRES IN A GIVEN CHANNEL HAVING THE SAME LAYER AND SAME ORIENTATION WILL HAVE THE SAME WIDTH (REGARDLESS OF NET).

3. VIAS MAY BE PLACED ANYWHERE IN CHANNEL SUBJECT TO CLEARANCE. (I.E. WHEN A GRIDDED MODEL IS USED, THE HYPERGRID ALLOWS VIAS ON EVERY GRID INTERSECTION IN THE ROUTABLE AREA.) ANY SPECIFIED VIA HYPERGRIDS OR VIA BARRIERS ARE IGNORED.

4. CLEARANCE PARAMETERS:
VIA-TO-VIA SEPARATION (HORIZONTAL AND VERTICAL) IS LOADED FROM THE HYPERGRID, HRG, RECORD FROM FIELDS 19 (HORIZONTAL) AND 20 (VERTICAL). HOWEVER, THE VIA-TO-VIA SEPARATION CAN NEVER BE LESS THAN THE VIA-TO-WIRE. THIS IMPLIES THAT IT IS ALWAYS AS GREAT AS THE PADSIDE LENGTH AND THE WIRE-TO-WIRE. NOTE THAT THE SEPARATION IS THE SAME FOR BOTH LAYERS.

VIA-TO-BARRIER SEPARATION (HORIZONTAL AND VERTICAL) IS LOADED FROM THE DIMENSIONS OF THE PAD CODE, PCD, THAT IS ASSOCIATED WITH THE WIRING RULE, RRU, SELECTED ACCORDING TO ASSUMPTION 11 (TRS WIRE RULE). THE ACTUAL SEPARATION IS THE LARGER ABSOLUTE VALUE BETWEEN THE LOWER LEFT AND UPPER RIGHT TRACK DISPLACEMENT FROM THE PAD CODE CENTER. X FIELDS ARE USED TO CALCULATE HORIZONTAL SEPARATION, WHILE Y FIELDS ARE USED TO CALCULATE VERTICAL SEPARATION. NOTE THAT THE SEPARATION IS ADJUSTED TO BE AT LEAST AS GREAT AS HALF THE WIRE-TO-WIRE SEPARATION ON THE GIVEN LAYER AND ORIENTATION.

VIA-TO-WIRE SEPARATION (LAYER AND ORIENTATION DEPENDENT) IS CALCULATED TO BE THE VIA-TO-BARRIER SEPARATION PLUS HALF THE WIRE-TO-WIRE SEPARATION.

WIRE-TO-WIRE SEPARATION (LAYER AND ORIENTATION DEPENDENT) IS LOADED FROM THE CONDUCTOR_WIDTH AND GUARDBAND FIELDS OF THE WIRE CLEARANCE RULE, WCR, RECORD FOR THE SELECTED WIRE RULE, RRU (SEE ASSUMPTION 11). THE CONDUCTOR WIDTH AND GUARDBAND FIELDS OF THE SELECTED RRU RECORD ARE USED AS DEFAULTS IF THERE ARE NO CORRESPONDING WCR RECORDS.

5. NO DIAGONAL WIRING IS DEFINED BY THIS ROUTER, NOR CAN PRE-EXISTING DIAGONALS BE HANDLED.

6. PROBLEMS MUST HAVE EXACTLY TWO LAYERS.

7. ONLY PRE-EXISTING POWER/GROUND WIRING IS ALLOWED, AND ONLY ONE PRE-EXISTING TRUNK PER CHANNEL IS ALLOWED.

8. PLACEMENT WILL NOT BE MODIFIED TO ELIMINATE CONSTRAINT LOOPS.

9. A GRIDDED ENVIRONMENT CAN OPTIONALLY BE USED (SEE PROCESSING OPTION SECTION -- OPTION 2) IN WHICH CASE ALL TERMINALS MUST BE ON GRID LINES. NOTE THAT OFF-GRID TERMINALS WILL BE SNAPPED TO GRID.

10. CHANNEL INTERSECTIONS ARE ALWAYS DEFINED AS NON-OVERLAPPING T-INTERSECTIONS.

T-INTERSECTIONS OCCUR WHEN A HORIZONTAL AND VERTICAL CHANNEL INTERSECT AND AT LEAST ONE OF THE TWO CHANNELS ENDS AT THAT INTERSECTION. AN EXAMPLE OF A T-INTERSECTION IS AS FOLLOWS:

```
          *  V  *
          *  T  *
          *     *
    -     *     ***********************
          *     *
    A     *     * H7 CHANNEL
          *     *
    -     *  C  ***********************
          *  H  *
          *  A  *
          *  N  *
          *  N  *
          *  E  *
          *  L  *
```

IN THE CASE PICTURED, THE HORIZONTAL CHANNEL MUST BE ROUTED BEFORE THE VERTICAL ONE BECAUSE IT "FEEDS" IT (TRUNK ENDPOINTS OF THE HORIZONTAL CHANNEL WILL FORM TERMINALS ON THE VERTICAL

ONE). THE CHANNEL DEFINITION SUBSYSTEM, CHD, WILL DEFINE THE SEQUENCE NUMBERS ON THE TWO CHANNELS INVOLVED TO REFLECT THIS ORDERING.

11. ONLY ONE WIRING RULE PER CHANNEL IS USED FOR ALL NETS ROUTED BY TRS IN THAT CHANNEL. THE PREDOMINANT WIRE RULE (DEFINED TO BY THE MOST NETS IN THE CHANNEL), IS THE ONE SELECTED FOR ALL NETS IN THE CHANNEL AS LONG AS THE WIRE RULE NAME IS NOT NOT2WIRED. A WARNING IS ISSUED IF MORE THAN ONE WIRE RULE IS REFERENCED BY THE CHANNEL.

12. ROUTING BARRIERS DEFINED BY THE DATA BASE TO BE WITHIN THE CHANNELS ARE ASSUMED TO INCLUDE ANY NECESSARY GUARDBAND (ONE HALF ON EITHER SIDE).

13. NODES ON THE EDGES OF ROUTING CHANNELS ARE MODELLED AS BARRIERS WHOSE DIMENSIONS ARE AT LEAST AS LARGE AS THOSE OF THE PAD ASSOCIATED WITH THE NODE. HOWEVER, THE PAD ASSOCIATED WITH THE NODE MAY SOMETIMES NOT BE LARGE ENOUGH TO COMPLETELY COVER THE WIRE ASSOCIATED WITH THE NODE AS ILLUSTRATED BELOW. IN SUCH INSTANCES, THE BARRIER IS ENLARGED BY THE WIDTH OF THE NON-PREFERRED DIRECTION WIRE IN ORDER TO AVOID SPACING VIOLATIONS AND SHORTS.

```
   WIRE ---+                +--- NODE PAD
           I                I    (ON CHAN. PERIPHERY)
           I                I
           I                V
           V            +---------+
   ---------------------I---------I--+
                        I         I  I
                        I         I  I
   ---------------------I---------I--+
                        +---------+
```

FOR A SINGLE-LAYER NODE, THIS ENLARGEMENT OF THE BARRIER DOES NOT POSE ANY PROBLEMS. HOWEVER, FOR AN ALL-LAYER NODE, THE BARRIER AROUND THE NODE MUST BE ENLARGED BY THE LARGEST NON-PREFERRED DIRECTION WIRE-WIDTH IN EACH DIMENSION (AND ON EACH LAYER). THIS CAN, UNDER EXTREME CIRCUMSTANCES, CAUSE THE LOSS OF ONE ROUTING TRACK ON THE TRUNK LAYER.

--PERFORMANCE GOALS--

(NOT ESTABLISHED.)

OVERVIEW OF TECHNIQUES INVOLVED
-------------------------------

PREVIOUSLY PUBLISHED TECHNIQUES DESCRIBED BY HASHIMOTO AND STEVENS [2], RIGHTLWER [3] AND DEUTSCH [5] ARE EMPLOYED. FURTHER INSIGHT INTO THESE TECHNIQUES CAN BE OBTAINED BY READING SAIC [4].

--CAPABILITIES--

1. CONSTRAINT GRAPH PROCESSING TO ELIMINATE VERTICAL CONSTRAINT LOOPS (AND LATER REDUCE CONSTRAINT CHAINS) BY SELECTING ABSCISSAS FOR DOGLEGS THAT WILL NOT CAUSE A NEW VERTICAL CONSTRAINT. THIS ROUTER DOES NOT RESTRICT DOGLEGS TO SAME NET TERMINAL POSITIONS AND, FURTHERMORE, WILL ALLOW JOGGING NON-PIN DOGLEGS WHEN A DOGLEG POSITION CANNOT BE FOUND INSIDE THE RANGE OF THE CONSTRAINT LOOP.

2. ALL COORDINATE AND SPACING PARAMETERS ARE STORED IN GRIDLESS UNITS, BUT A PROCESSING OPTION DOES EXIST TO FORCE WIRING ONTO GRID LINES ONLY.

3. IRREGULAR CHANNEL REGIONS ARE ALLOWED. THE CHANNEL EXPANSION SUBSYSTEM WILL EXPAND THE HEIGHT OF THE CHANNEL TO INCLUDE WELLS ALONG THE PERIPHERY. WIRES LOCAL TO CHANNEL DEPRESSIONS ARE ROUTED FIRST TO

FILL IN THE DEPRESSION.

4. VIA REMOVAL AND PATH SHORTENING PROCESSING DURING TRACK ASSIGNMENT TO FREE UP RESOURCES FOR FUTURE TRUNKS.

5. INTRACELLULAR VIA PROTECTION, INCLUDING VIAS INTRODUCED DURING THE ROUTING PHASE. (I.E. SPACING AROUND VIAS OUTSIDE THE CHANNEL BEING ROUTED IS PROVIDED.)

6. CLEARANCE RULES THAT ALLOW DIFFERENT VIA-TO-LINE AND LINE-TO-LINE CLEARANCES FOR EACH LAYER AND ORIENTATION.

7. POSTCHANNEL OVERFLOW PROCESSING [3] WHICH ALLOWS A NO-VIA, WRONG SIDE ROUTE MODE, AND FAILED CONNECTION'S FLOAT TERMINALS TO BE FIXED IN POSITION AND PASSED FORWARD TO NEIGHBORING UNROUTED CHANNELS.

8. CRITICAL BRANCH LENGTH MINIMIZATION [4] BASED ON CHARACTERISTIC NUMBER (NUMBER OF UPPER SIDE TERMINALS - NUMBER OF LOWER SIDE TERMINALS).

9. ITERATIONS OF TRACK PLACEMENT PROCEDURE WHICH MODIFY STARTING POSITION EACH TIME (TOP-BOTTOM, LEFT-RIGHT) AND RETAIN THE BEST PLACEMENT.

```
**********************************
* TRACK ASSIGNMENT ORGANIZATION *
**********************************
```

PROCESSING FLOW
---------------

THE FOLLOWING IS THE FUNDAMENTAL PROCESSING FLOW OF THE TRACK ASSIGNMENT SUBSYSTEM WITHIN THE CHANNEL ROUTER. TRACK ASSIGNMENT IS INVOKED AFTER CHANNEL DEFINITION AND GLOBAL ROUTING.

TRACK ASSIGNMENT USES THE CHANNEL EXPANSION SUBSYSTEM TO INPUT THE OLD DESIGN FILE, UPDATE ALL BOARD POSITIONS UPON COMPLETION OF TRACK ASSIGNMENT FOR A CHANNEL (EXPANDING OR COMPRESSING THE DESIGN), AND TO UPDATE THE NEW DESIGN FILE, ADDING RWS RECORDS FOR ALL CONNECTIONS ROUTED BY TRACK AND WRITING OUT THE NEW BOARD SIZE AND NEW POSITIONS OF ALL BOARD ENTITIES.

TRACK ASSIGNMENT HIGH LEVEL PSEUDO CODE:

```
BEGIN /*TRACK ASSIGNMENT*/
  INITIALIZE GLOBAL DATA
  INPUT DESIGN FILE
  FOR (EVERY CHANNEL /* IN A PREDEFINED ORDER */ ) DO
    INITIALIZE CHANNEL DATA INCLUDING TERMINAL POSITIONS AND
      CHANNEL DENSITY.
    BUILD CONSTRAINT GRAPH, ELIMINATING CONSTRAINT LOOPS
      AS SOON AS THEY ARE DISCOVERED.
**  EVALUATE CONSTRAINT GRAPH, REDUCE THE LENGTH OF ALL
      CHAINS THAT EXCEED A PREDEFINED THRESHOLD
    ASSIGN CONNECTION TRUNKS TO TRACKS WITHIN THE CHANNEL
      OBSERVING CONSTRAINTS.
    OUTPUT NEW TRACK ASSIGNMENT INFORMATION
  ENDFOR /* EVERY CHANNEL */
  UPDATE DESIGN FILE WITH NEW ROUTING INFORMATION
END /*TRACK ASSIGNMENT*/
```

SOFTWARE STRUCTURE

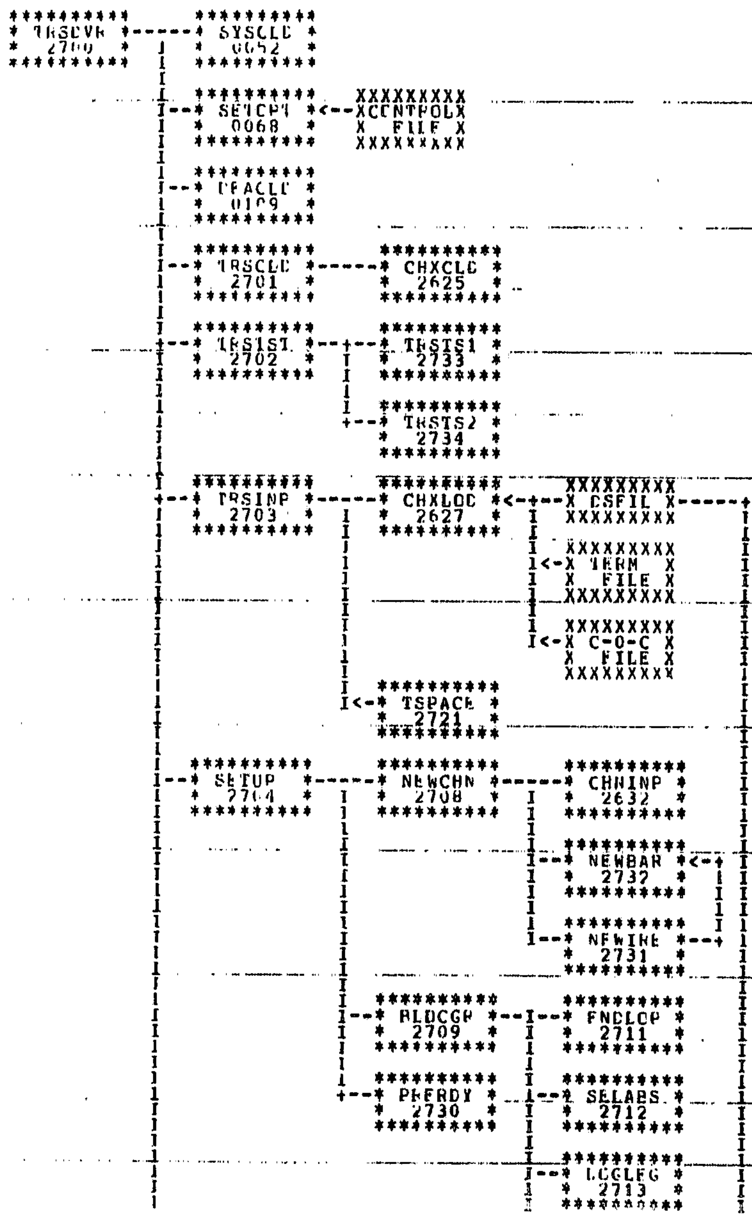

```
        I                                      I                 I
        I                                      I--* KLRNAT *     I
        I                                         *  2716  *     I
        I                                         **********     I
        I                                                        I
        I  **********      **********             **********     I
        I--* TRKASN *------* EAKTRK *------------* VSFCHK *      I
        I  *  2705  *      *  2710  *             *  2300  *     I
        I  **********      **********             **********     I
        I                                                        I
        I  **********      **********                            I
        I--* TRSCUT *------* CHNOUT *                            I
        I  *  2706  *      *  2633  *                            I
        I  **********      **********                            I
        I                                                        I
        I  **********      **********                            I
        I--* TRSUPD *------* CHXUPD *<---------------------------I
           *  2707  *      *  2628  *             XXXXXXXXXX
           **********      ************------->X NCSFIL X
                                                  XXXXXXXXXX
```

LOW LEVEL UTILITIES, ACCESSIBLE BY ALL MODULES...

```
**********  **********  **********  **********  **********
* FNDLPA *  * CHCSTR *  * INCSTR *  * DLCSTR *  * GTCSTR *
*  2714  *  *  2715  *  *  2717  *  *  2718  *  *  2719  *
**********  **********  **********  **********  **********

**********  **********  **********
* TRSCRF *  * TRSHFT *  * CHLIST *
*  2722  *  *  2723  *  *  2724  *
**********  **********  **********

**********  **********  **********  ::::::::::
* CCNSTR *  * CLCSTR *  * PCHRDT *  : CHXCMP :
*  2727  *  *  2728  *  *  2729  *  :  2626  :
**********  **********  **********  ::::::::::
```

DATA STRUCTURES
---------------

THE TRACK ASSIGNMENT SUBSYSTEM OF THE CHANNEL ROUTER HAS FOUR MAJOR DATA STRUCTURES INCLUDING: CHANNEL, TERMINAL, CONNECTION, AND TRACK DATA. THE CHANNEL DATA ARE USED TO MODEL THE AVAILABLE OPEN ROUTABLE RESOURCES OF THE PROBLEM. INCLUDED WITH THE CHANNEL DATA ARE FUTURE TERMINALS WHICH ARE USED TO PASS POSITIONAL INFORMATION WHEN FLOATING TERMINALS ARE FIXED IN PLACE. THE TRACK DATA IS USED TO LINK CONNECTIONS TO SPECIFIC ORDINATES WITHIN THE CHANNEL. TERMINAL AND CONNECTION DATA STRUCTURES ARE USED TO SPECIFY THE ACTUAL INTERCONNECTION STRUCTURE OF THE WIRING. TERMINALS ARE ASSOCIATED WITH INTERCONNECTION POINTS ON THE PERIMETER OF THE CHANNEL, WHILE CONNECTIONS MODEL THE LENGTH OF THE WIRE SEGMENT WITHIN TRACKS. ALSO ASSOCIATED WITH CONNECTION RECORDS ARE CONSTRAINT RECORDS, WHICH ARE USED TO PROHIBIT CONNECTIONS FROM OVERLAPPING DURING TRACK ASSIGNMENT.

```
                 CHANNEL DATA
*****   ***********************************
*   *-->*                                 *
* T *-->*..........*******************...*
* R *   *          *CONNECTION RECORD*   *
* A * . *..........*******************...*
* C * . *              I           I      *
* K *   *              V           V      *
*   *   *                                 *
* D *   *                                 *
* A * . *...*******************...........*
* T * . *   *CONNECTION RECORD*           *
* A *   *...*******************...........*
*   *-->*      I              I           *
*****   *******I**************I************
               I              I
               V              V
         **********      **********
     ..->*TERMINAL*->...->*TERMINAL*->..
     ..<-* RECORD *<-...<-* RECORD *<-..
         **********      **********
```

```
THE CHANNEL DATA STRUCTURE IS USED TO SPECIFY THE ACTUAL
DIMENSION OF THE ROUTABLE AREA.  ASSOCIATED WITH EACH
CHANNEL RECORD IS A LIST OF FUTURE TERMINAL RECORDS
WHICH ARE USED TO PASS POSITIONAL INFORMATION INTO THIS
CHANNEL FROM ADJACENT CHANNELS.

CHANNEL RECORDS AND FUTURE TERMINAL RECORDS ARE LINKED
TOGETHER AND ARE DIVIDED UP INTO THE FOLLOWING FIELDS:

CHANNEL RECORDS                  FUTURE TERMINALS

*******************              *******************
* CHANNEL NUMBER  *     +---->* ABSCISSA          *
*-----------------*     I        *-----------------*
* LOWER LEFT X    *     I        * ORDINATE        *
*-----------------*     I        *-----------------*
* LOWER LEFT Y    *     I        * CONNECTION NUM  *
*-----------------*     I        *-----------------*
* UPPER RIGHT X   *     I        * NEXT RECORD PTR *-->
*-----------------*     I        *-----------------*
* UPPER RIGHT Y   *     I        * NET NUMBER      *
*-----------------*     I        *******************
* ORIENTATION     *     I
*-----------------*     I
* SEQUENCE NUMBER *     I
*-----------------*     I
* FUTURE TERM PTR *-----+
*******************

CHANNEL DATA IS MAINTAINED IN THE CHX SUBSYSTEM SO
THAT CHX CAN UPDATE THE SIZE AND LOCATION OF THE CHANNELS.
THE FUTURE TERMINAL POINTER IS KEPT BY THE TRACK SUBSYSTEM
IN AN ASSOCIATED ARRAY.


THE FOLLOWING INFORMATION IS ASSOCIATED WITH A CHANNEL:

CHANNEL NUMBER --
     USED TO IDENTIFY THE CHANNEL.

CHANNEL REFERENCE POINTS --
     LOWER LEFT X
     LOWER LEFT Y
     UPPER RIGHT X
     UPPER RIGHT Y

CHANNEL ORIENTATION --
     USED TO DETERMINE THE TRACK AXIS.
     1 = HORIZONTAL
     2 = VERTICAL

SEQUENCE NUMBER --
     USED TO SPECIFY THE ORDER THAT CHANNELS SHOULD BE
     SEQUENCED FOR TRACK ASSIGNMENT.

FUTURE TERMINAL POINTER --
     POINTER TO A LINKED LIST OF FUTURE TERMINAL RECORDS.
     TERMINALS ARE PASSED TO FUTURE CHANNELS ONCE THEIR
     POSITION HAS BEEN FIXED DURING TRACK ASSIGNMENT.

TERMINAL RECORDS ARE USED TO SPECIFY THE POSITION OF
INTERCONNECTION NODES ALONG THE PERIMETER OF THE CHANNEL.
TERMINAL RECORDS ARE DOUBLY LINKED INTO AN ORDERED LIST
(ORDER BASED ON ABSCISSA VALUE).  SENTRIES ARE USED TO
SPECIFY BOTH ENDS OF THE ORDERED LIST.  TERMINALS ARE
DOUBLY LINKED SO THAT THEY CAN BE SCANNED IN EITHER
DIRECTION.  THE START TERMINAL ALWAYS PRECEDES THE STOP
TERMINAL OF A CONNECTION EVEN IF THEY HAVE THE SAME
ABSCISSA.
```

```
+---LEFT SENTRY POINTER                                          NIL
I                                                                  A
I                                                                  I
I  ************  ************       ************  ************   I
+->*  SENTRY  *-->* TERMINAL *--...-->* TERMINAL *-->*  SENTRY  *-+
+--*          *<--*  RECORD  *<-...--*  RECORD  *<--*          *<+
I  ************  ************       ************  ************   I
```

```
V                                              T
NIL                             RIGHT SENTRY -+
                                  POINTER
```

TERMINAL RECORDS ARE DIVIDED UP INTO THE FOLLOWING FIELDS:

TERMINAL RECORDS

```
********************
* ABSCISSA         *
*------------------*
* ORDINATE         *
*------------------*
* CONNECTION NUM   *
*------------------*
* LEFT LINKAGE PTR *
*------------------*
* RIGHT LINK PTR   *
*------------------*
* DOGLEG FLAG      *
*------------------*
* SECOND CONNECT   *
*------------------*
* SECOND CHANNEL   *
*------------------*
* DENSITY          *
*------------------*
* TERMINAL LAYER   *
*------------------*
* NET              *
********************
```

THE FOLLOWING INFORMATION IS ASSOCIATED WITH A TERMINAL:

ABSCISSA --
DISPLACEMENT FROM BOARD REFERENCE POINT.

ORDINATE --
DISPLACEMENT FROM BOARD REFERENCE POINT. THIS ALLOWS TERMINALS ON BARRIERS WITHIN THE PRIMARY CHANNEL BOUNDARY.

CONNECTION NUMBER --
POINTER TO THE CONNECTION NUMBER FOR THIS TERMINAL.

NEXT LEFT TERMINAL POINTER --
DOUBLE LINKED LIST POINTER STRUCTURE USED FOR BOTH CONSTRAINED LEFT AND RIGHT EDGE TRACK ASSIGNMENT.

NEXT RIGHT TERMINAL POINTER --
DOUBLE LINKED LIST POINTER STRUCTURE USED FOR BOTH CONSTRAINED LEFT AND RIGHT EDGE TRACK ASSIGNMENT. POINTER USED FOR LEFT-TO-RIGHT SCANS.

DOGLEG FLAG --
REPRESENTS A TRANSITION BETWEEN DIFFERENT CONNECTIONS AT THE SAME ABSCISSA (WHENEVER .GT. 0). EACH DOGLEG HAS TWO DOGLEG TERMINALS, ONE FOR EACH OF THE TWO CONNECTIONS. THE DOGLEG FLAG POINTS TO THE DOGLEG TERMINAL OF THE OTHER CONNECTION. THIS POINTER IS CONVERTED TO POINT TO THE OTHER DOGLEG CONNECTION FOR CFX TO USE DURING OUTPUT OF THE DOGLEG BRANCH.

SECOND CONNECTION NUMBER --
USED ONLY FOR TERMINALS THAT REPRESENT TRANSITIONS INTO ABUTTING OR INTERSECTING CHANNELS. THIS IS THE CONNECTION NUMBER FOR THIS TERMINAL IN THE ABUTTING OR INTERSECTING CHANNEL IDENTIFIED BY THE NEXT ITEM.

SECOND CHANNEL NUMBER --
THIS IS THE CHANNEL NUMBER IN WHICH THE SECOND CONNECTION NUMBER IS VALID.

DENSITY --
TRACK UTILIZATION DENSITY TO THE RIGHT OF THE TERMINAL.

TERMINAL LAYER --
LAYER ON WHICH THE TERMINAL OCCURS. ALL LAYER TERMINALS ARE SET TO BRANCH LAYER FOR OUTPUT OF THE BRANCH SEGMENT. TRUNK LAYER TERMINALS ARE DEFAULTED TO THE BRANCH LAYER

WITH A WARNING MESSAGE TO THE USER.

NET --
POINTER TO THE SIGNAL FOR THIS TERMINAL.

EVERY TRUNK TO BE PLACED IS MODELED AS A CONNECTION. THESE CONNECTIONS ARE PACKED INTO THE TRACKS ASSOCIATED WITH THE CHANNEL.

CONNECTION RECORDS ARE USED TO SPECIFY THE LENGTH AND ORDINATE OF A TRUNK. THE ACTUAL START AND STOP VALUES ARE LOCATED WITHIN TERMINAL RECORDS. PREDECESSOR, SUCCESSOR AND VIA SPACING CONSTRAINTS RECORDS ARE POINTED TO FROM THE CONNECTION. FIELDS ARE INCLUDED WITHIN THE CONNECTION RECORD SO THAT CONNECTIONS CAN BE DOUBLY LINKED INTO TRACKS.

CONNECTION RECORDS ARE LINKED TO TERMINAL, CONNECTION, AND CONSTRAINT RECORDS AND ARE DIVIDED UP INTO THE FOLLOWING FIELDS:

```
                         CONNECTION RECORDS

************    *********************   ************
* TERMINAL *<-+ * CONNECTION NUMBER * +->* TERMINAL *
*  RECORD  *  I *-------------------* I  *  RECORD  *
************  +-* START TERMINAL PTR* I  ************
                *-------------------* I
                * END TERMINAL PTR  *-+
                *-------------------*
                * ORDINATE          *
                *-------------------*
                * NET NUMBER        *
                *-------------------*
                * TYPE              *
                *-------------------*
           <----* LEFT LINKAGE PTR  *
                *-------------------*
                * RIGHT LINK POINTER*---->
                *-------------------*
                * LAYER             *
************    *-------------------*    CONSTRAINT RECORDS
*CONSTRAINT*<---* PREDECESSOR PTR   *
*  RECORD  *    *-------------------*    *********************
************    * SUCCESSOR POINTER *--->* CONNECTION NUMBER *
                *-------------------*    *-------------------*
************<---* VIA SPACING PTR   *    * NEXT CONSTRAINT   *-->
*CONSTRAINT*    *-------------------*    *********************
*  RECORD  *    * WIRING RULE       *
************    *********************
```

THE FOLLOWING INFORMATION IS ASSOCIATED WITH A CONNECTION:

CONNECTION NUMBER --
USED TO IDENTIFY THE CONNECTION. (IMPLICIT - ARRAY INDEX)

POINTER TO START TERMINAL --
POINTS TO THE TERMINAL RECORD THAT CORRESPONDS TO SMALLEST ABSCISSA VALUE FOR THE CONNECTION.

POINTER TO STOP TERMINAL --
POINTS TO THE TERMINAL RECORD THAT CORRESPONDS TO LARGEST ABSCISSA VALUE FOR THE CONNECTION.

ORDINATE --
THE ORDINATE VALUE ASSIGNED TO THE CONNECTION.
.EQ. 0 THIS CONNECTION UNASSIGNED
.GT. 0 THIS CONNECTION ASSIGNED TO A TRACK, OR PREWIRED
.LT. 0 THIS CONNECTION WAS NOT ASSIGNED TO A TRACK DUE TO SOME ERROR.
(- 1 = FAIL CODE 1, - 2 = FAIL CODE 2, ...)

NET NUMBER --
THE NET ASSIGNED TO THE CONNECTION.

CONNECTION TYPE --
1 = BARRIER
2 = WIRE
3 = CHANNEL INTERSECTION

```
NEXT LEFT CONNECTION RECORD ON THE SAME TRACK --
     USED TO LINK ALL CONNECTIONS IN THE SAME TRACK
     TOGETHER FOR A LEFT-TO-RIGHT SCAN.

NEXT RIGHT CONNECTION RECORD ON THE SAME TRACK --
     USED TO LINK ALL CONNECTIONS IN THAT SAME TRACK
     TOGETHER FOR A RIGHT-TO-LEFT SCAN.  THIS ITEM ALONG
     WITH THE PREVIOUS ITEM DOUBLE LINKS THE CONNECTION
     RECORDS IN THE TRACK, THUS ALLOWING BOTH A CONSTRAINED
     LEFT EDGE AND CONSTRAINED RIGHT EDGE TRACK ASSIGNMENT.

LAYER --
     PROPER LAYER THAT THE CONNECTION IS PLACED ON.

PREDECESSOR CONSTRAINT POINTER --
     POINTER TO THE FIRST PREDECESSOR CONSTRAINT RECORD
     FOR THIS CONNECTION.  PREDECESSOR CONNECTIONS MUST BE
     ASSIGNED TO ORDINATES ABOVE THIS CONNECTION SUCH THAT
     WIRING RULES ARE NOT VIOLATED.

SUCCESSOR CONSTRAINT POINTER --
     POINTER TO THE FIRST SUCCESSOR CONSTRAINT RECORD
     FOR THIS CONNECTION.  SUCCESSOR CONNECTIONS MUST BE
     ASSIGNED TO TRACKS BELOW THIS CONNECTION SO THAT
     WIRING RULES ARE NOT VIOLATED.

VIA SPACING CONSTRAINT POINTER --
     POINTER TO THE FIRST VIA SPACING CONSTRAINT RECORD FOR
     THIS CONNECTION.  CONNECTIONS WHICH ARE VIA SPACING
     CONSTRAINTS MUST BE PLACED AT LEAST VIA-VIA CLEARANCE
     AWAY FROM THIS CONNECTION (IF BOTH CONNECTIONS ARE
     PLACED ON THE TRUNK LAYER).

WIRING RULE --
     0 = NORMAL
     1 = CRITICAL
     2 = PREFERRED Y ON LEFT CHANNEL SIDE
     3 = PREFERRED Y ON RIGHT CHANNEL SIDE
     4 = HIGHLY PREFERRED Y ON LEFT CHANNEL SIDE
     5 = HIGHLY PREFERRED Y ON RIGHT CHANNEL SIDE
     6 = PRE WIRED

TRACK DATA

EACH ROUTING CHANNEL IS SUBDIVIDED UP INTO MANY ROUTING
LANES CALLED TRACKS.  EACH TRACK HAS ASSOCIATED WITH IT
AN ORDINATE AND POINTERS TO BOTH THE FIRST AND LAST
CONNECTION RECORD IN THE TRACK.  CONNECTION RECORDS
ARE DOUBLY LINKED WITHIN TRACKS USING THEIR LEFT AND
RIGHT LINKAGE POINTERS.

                   ----------------------------------------+
                  /                                        I
                 /                                   NIL   I
                /                                      A   I
  +-----+-----+-----+      ***********      ***********  I I
1 I     I     I     I--->* CONNECT *--...-->* CONNECT *--+ I
  IORDNTILAST IFIRSTI  +-* RECORD  *<-...--* RECORD  *<---+
  I     I     I     I  I ***********      ***********
  +-----+-----+-----+  V
2 I     I     I     I  NIL
  I     I     I     I
  I     I     I     I
  +-----+-----+-----+
  I     I     I     I

  .     .     .     .
  .     .     .     .

  I     I     I     I
  +-----+-----+-----+  NUMBER OF TRACKS

THE FOLLOWING INFORMATION IS ASSOCIATED WITH A TRACK:

POINTER TO THE FIRST CONNECTION --
     POINTER TO THE FIRST CONNECTION IN THE TRACK ON THE
     RIGHT SIDE OF THE CHANNEL.
```

```
POINTER TO THE LAST CONNECTION --
     POINTER TO THE LAST CONNECTION IN THE TRACK ON THE
     LEFT SIDE OF THE CHANNEL.

ORDINATE --
     ORDINATE OF THE TRACK WITH RESPECT TO THE BOARD
     ORIGIN.

CONTROL AND TESTING PARAMETERS
------------------------------

--PROCESSING OPTIONS--

PROCESSING OPTIONS ARE READ INTO GLOBAL DATA STRUCTURES
FOR THIS SUBSYSTEM FROM A CONTROL PARAMETER FILE.

 OPTION    STANDARD
 NUMBER     VALUES    DESCRIPTION
---------  ------    ----------------------------------------
TRSPOP(1)             UNIT TEST SELECTOR USED IN CONJUNCTION WITH
                      TRSPOP(11) TO TURN ON THE INTERNAL TESTING
                      ROUTINES.  FOR VR SERVICE PERSONNEL ONLY.
              0*        NORMAL OPERATION - NO TESTING
              1         SELECT UNIT TESTING MODE (VR SERVICE ONLY)

TRSPOP(2)             GRID SIZE USED IN TRACK ASSIGNMENT.
              0         GRIDS NOT USED - ALLOWS THE MOST DENSE
                        PACKING OF CHANNELS.  HOWEVER, NO
                        FOLLOW-ON SUBSYSTEMS THAT USE THE GRIDDED
                        MODEL (E.G., MZR, OPT, ETC)
                        CAN BE USED AFTER THIS OPTION IS SELECTED.
                        FOR THIS REASON, THIS OPTION WILL BE
                        SELDOM USED.
              1         USE PRIMARY GRID SIZE (AS DEFINED IN THE
                        PBG RECORD) FOR TRACK ASSIGNMENT.
              2*        USE SECONDARY GRID SIZE.

TRSPOP(3)             OPTION TO LIMIT THE LENGTH OF CONNECTIONS
                      TO BE ROUTED ON THE BRANCH LAYER.  THIS
                      OPTION IS REFERENCED WHEN BRANCH ROUTING IS
                      SPECIFIED IN TRSPOP(4).
              0         NO LIMIT.  ALL CONNECTIONS ARE CANDIDATES
                        FOR BRANCH ROUTES WHEN THE BRANCH ROUTE
                        OPTION IS ON.
              NN        LIMIT, IN DESIGN FILE UNITS, OF THE LENGTH
                        OF CONNECTIONS TO BE CONSIDERED FOR BRANCH
                        ROUTING WHEN THE BRANCH ROUTE OPTION IS ON.

TRSPOP(4)             OPTION TO ALLOW/PROHIBIT THE GENERATION OF
                      NON-PREFERRED DIRECTION WIRING ON THE BRANCH
                      LAYER.  NOTE THAT IN THE CHANNEL ROUTER
                      ENVIRONMENT, THE LAYER CONTAINING THE
                      ROUTING CHANNELS IS REFERRED TO AS THE TRUNK
                      LAYER, AND THE LAYER CONTAINING THE WIRING
                      THAT BRANCHES OUT TO THE CHANNELS IS
                      REFERRED TO AS THE BRANCH LAYER.  NOTE THAT
                      THE PREFERRED WIRING DIRECTION OF THE BRANCH
                      LAYER IS ALWAYS PERPENDICULAR TO THE
                      PREFERRED-DIRECTION OF THE TRUNK LAYER.  THE
                      DESIGNER MAY ALLOW TRACK ASSIGNMENT TO
                      GENERATE NON-PREFERRED DIRECTION WIRING ON
                      THE BRANCH LAYER, BUT NON-PREFERRED
                      DIRECTION WIRING MAY NEVER BE GENERATED ON
                      THE TRUNK LAYER.
              0         PROHIBIT THE GENERATION OF NON-PREFERRED
                        DIRECTION WIRING ON THE BRANCH LAYER.
                        THIS IS THE MOST CONSERVATIVE SETTING FOR
                        THIS OPTION WITH RESPECT TO ADHERENCE TO
                        PREFERRED DIRECTION.
              1         ALLOW THE GENERATION OF NON-PREFERRED
                        DIRECTION WIRING ON THE BRANCH LAYER ONLY
                        DURING THE TRACK ASSIGNMENT PROCESS.
              2         ALLOW THE GENERATION OF NON-PREFERRED
                        DIRECTION WIRING ON THE BRANCH LAYER ONLY
                        AT THE END OF THE TRACK ASSIGNMENT
                        PROCESS (TO REDUCE THE NUMBER OF VIAS BY
                        MOVING TRUNK LAYER ROUTES TO THE BRANCH
                        LAYER).
              3         ALLOW THE GENERATION OF NON-PREFERRED
                        DIRECTION WIRING ON THE BRANCH LAYER BOTH
```

```
                DURING THE TRACK ASSIGNMENT PROCESS AND
                AFTER TRACK ASSIGNMENT. THIS SETTING
                IMPLEMENTS THE MOST LIBERAL TRACK
                ASSIGNMENT STRATEGY ALLOWING SIGNIFICANT
                AMOUNTS OF NON-PREFERRED BRANCH LAYER
                WIRING, BUT ALSO PRODUCING THE LEAST
                POSSIBLE CHANNEL SIZE.

TRSPCF(5)       TRACK ASSIGNMENT SIDE PREFERENCE OPTION.
                THIS OPTION ALLOWS THE DESIGNER TO SPECIFY
                WHETHER TRACKS WILL BE ASSIGNED ONLY TO
                STRICTLY MINIMIZE THE NUMBER USED
                (I.E., DENSELY PACK THE CHANNELS), OR TO
                ATTEMPT TO KEEP MOST WIRE PATHS NEARER TO THE
                SIDE OF THE CHANNEL CONTAINING THE GREATER
                NUMBER OF WIRE CONNECTIONS (I.E., REDUCE
                TROMBONING).

          0     PACK CHANNELS AS DENSELY AS POSSIBLE WITH NO
                REGARD TO TRACK SIDE PREFERENCE.
       +N (1*)  GIVE PREFERENCE TO ASSIGNING TRACKS
                NEARER TO THE SIDE OF THE CHANNEL THAT
                HAS <N> MORE WIRE PATH CONNECTION
                POINTS (I.E., REDUCE TROMBONING).
                THE VALUE OF N IS THE MAXIMUM SIDE
                PREFERENCE SETTING TO BE ATTEMPTED,
                AS FOLLOWS:
                 START=1 BEST ROUTING (SHORTEST WIRE LENGTH)
                 NEXT =2
                   .         : (UNTIL=N OR COMPLETED
                   .         .  CONNECTIONS IN CHANNEL)
                   .         .
                 LAST =0 BEST ROUTING COMPLETION
                         (IF NOT ALREADY COMPLETE)

                FOR EXAMPLE, A NON-ZERO VALUE FOR THIS
                PROCESSING OPTION:

                FAVORS THIS              OVER THIS TYPE
                TYPE OF CONNECTION       OF CONNECTION

                   ---                 -------------
                   I                   I
                   I                   I
                   ---                 -------------

                WHENEVER POSSIBLE WHEN CONSTRUCTING WIRE
                PATHS ON VERTICAL CHANNELS. THE SMALLER
                THE VALUE OF "N", THE MORE CONNECTIONS
                THAT WILL BE ASSIGNED TRACKS NEAR ONE SIDE
                OF THE CHANNEL. A VALUE OF 1 BIASES THE
                TRACK ASSIGNMENT PROCESS SO THAT ANY PATH
                WITH JUST ONE MORE CONNECTION ON A GIVEN
                SIDE OF THE CHANNEL WILL TEND TO BE
                ASSIGNED A TRACK NEAR THAT SIDE. A VALUE
                OF 2 HAS THE SAME EFFECT FOR PATHS WITH
                TWO MORE CONNECTIONS ON A GIVEN SIDE, ETC.
                SETTING "N" TO A SMALL VALUE (BUT NOT
                ZERO) THUS TENDS TO REDUCE THE TROMBONING
                EFFECT. USING THIS OPTION IS THE
                PREFERRED STRATEGY FOR ROUTING PROBLEMS
                WITH PLENTIFUL TRACK RESOURCES (I.E., THAT
                ARE NOT HEAVILY SATURATED AT THE END OF
                THE ROUTING PHASE).
                (NOTE THAT A VALUE GREATER THAN ONE COULD
                SIGNIFICANTLY INCREASE THE TIME SPENT IN
                TRACK ASSIGNMENT.)

TRSPCF(6)       THIS PROCESSING OPTION DETERMINES THE
                NUMBER OF TRACKS ADDED TO THE SIZE OF
                THE LAST CHANNEL IN A CYCLE EACH TIME
                THE CYCLE FAILS BECAUSE THE LAST CHANNEL
                IS TOO SMALL. THE INITIAL CHANNEL SIZE
                IS SET TO ITS MAXIMUM DENSITY. THE SMALLER
                THE VALUE THE SMALLER THE CHANNEL; THE
                LARGER THE VALUE, THE FEWER ITERATIONS NECESSARY
                TO COMPLETE THE ROUTING OF ALL CHANNELS IN THE
                CYCLE. IF THE INITIAL GUESS IS TOO SMALL,
                THE CHANNELS WILL BE REROUTED BEGINNING
                WITH THE FIRST CHANNEL OF THE CYCLE, UNTIL
                THE LAST CHANNEL CAN BE RE-ROUTED IN THE
                SAME NUMBER OF TRACKS AS ITS LAST SETUP.
```

```
                          N       THE NUMBER OF TRACKS TO INCREASE
                                  THE WIDTH OF THE LAST CHANNEL IN THE
                                  CYCLE.

        TRSPOP(7)                THIS PROCESSING OPTION IS CURRENTLY UNUSED.
                                 FORMERLY, CONTROL FOR WHETHER VIAS ARE ALLOWED
                                 TO BE DIAGONALLY ADJACENT, WHICH IS NOW
                                 A FUNCTION OF THE DIAGONAL VIA CLEARANCE
                                 FLAG OF THE DESIGN FILE HYPERGRID RECORD
                                 (PHG)

        TRSPOP(8)                SAME NET VIA-TO-VIA SPACING CONTROL
                          0        DO NOT ALLOW VIA-TO-VIA SPACING VIOLATIONS
                                   FOR VIAS NEXT TO NODES IN THE SAME NET
                          1        ALLOW VIA-TO-VIA SPACING VIOLATIONS
                                   FOR VIAS NEXT TO NODES IN THE SAME NET

        TRSPOP(9)                DOGLEG AT EXISTING CONSTRAINT OPTION
                          0*       DOGLEGGING IS ALLOWED ONLY WHERE THERE
                                   IS NO PRE-EXISTING CONSTRAINT
                          1        ALLOW DOGLEGS AT PRE-EXISTING CONSTRAINTS.

        TRSPOP(10)               RETRY OPTION
                          0*       NORMAL OPERATION MODE.
                          N        MAXIMUM NUMBER OF RETRIES.
                                   UPON COMPLETION OF NORMAL TRACK
                                   ASSIGNMENT, FOR EACH RETRY ATTEMPT,
                                   THE NUMBER OF TRACKS FOR THE CURRENT
                                   CHANNEL IS DECREASED BY ONE IN AN
                                   ATTEMPT TO FORCE MORE BRANCH LAYER
                                   ROUTING.  THE RETRY ATTEMPTS ARE HALTED
                                   WHEN ALL CONNECTIONS CAN NO LONGER BE
                                   ROUTED.  AS FOR TRSPOP(5), THE CPU TIME
                                   CAN SIGNIFICANTLY INCREASE WITH THE USE
                                   OF THIS OPTION.

        TRSPOP(11)               UNIT TESTING SELECTOR AND DEBUG REPORT
                                 CONTROLLER.  THIS OPTION IS USED IN
                                 CONJUNCTION WITH TRSPOP(1) TO SPECIFY THE
                                 MODULE UNDER TEST (MUT).  FOR USE BY VR
                                 SERVICE PERSONNEL ONLY.
                          0*       NO TESTING - NORMAL OPERATING MODE
                       NNNN        SPECIFIES EITHER THE MODULE NUMBER
                                   OR THE CHANNEL TO BE TESTED

        PROCESSING OPTIONS 12-17 SET INTERNAL ALGORITHM PARAMETERS
        AFFECTING THE ORDER AND PATTERN OF TRACK ASSIGNMENT.  IF THE
        SETTINGS ARE LEFT AT THE RECOMMENDED VALUES, ROUTING WILL BE
        COMPLETED USING THE BEST OF EIGHT POSSIBLE COMBINATIONS OF
        ASSIGNMENT.  CHANGING THE SETTINGS REDUCES THE NUMBER OF
        METHODS TRIED, AND THUS STATISTICALLY REDUCES THE PROBABILITY
        OF GENERATING THE BEST ROUTING.  IT HAS BEEN FOUND THAT RUN
        TIMES FOR TRS ARE NOT SIGNIFICANTLY INCREASED BY USING THIS
        PROCEDURE.  THUS, VR STRONGLY RECOMMENDS THAT THE DESIGNER NOT
        CHANGE INDICATED (*) SETTINGS.

        TRSPOP(12)               INTERNAL ALGORITHM PARAMETER.  DO NOT ALTER
                                 THIS SETTING FROM THE RECOMMENDED VALUE.
                          0*       TOP SIDE START POINT FOR SIDE-TO-START
                                   ITERATIONS
                          1        BOTTOM SIDE START POINT

        TRSPOP(13)               INTERNAL ALGORITHM PARAMETER.  DO NOT ALTER
                                 THIS SETTING FROM THE RECOMMENDED VALUE.
                          0        TOP SIDE STOP POINT FOR ITERATIONS
                          1*       BOTTOM SIDE STOP POINT

        TRSPOP(14)               INTERNAL ALGORITHM PARAMETER.  DO NOT ALTER
                                 THIS SETTING FROM THE RECOMMENDED VALUE.
                                 TOP CHANNEL SIDE INITIAL SCAN DIRECTION.
                          0*       LOWER ABSCISSA VALUE TO HIGHER ABSCISSA
                                   VALUE
                          1        HIGHER ABSCISSA VALUE TO LOWER ABSCISSA
                                   VALUE

        TRSPOP(15)               INTERNAL ALGORITHM PARAMETER.  DO NOT ALTER
                                 THIS SETTING FROM THE RECOMMENDED VALUE. TOP
                                 CHANNEL SIDE FINAL SCAN DIRECTION.
                          0        LOWER ABSCISSA VALUE TO HIGHER ABSCISSA
                                   VALUE
```

```
                  1*     HIGHER ABSCISSA VALUE TO LOWER ABSCISSA
                         VALUE
TRSPOF(16)               INTERNAL ALGORITHM PARAMETER.  DO NOT ALTER
                         THIS SETTING FROM THE RECOMMENDED VALUE.
                         BOTTOM SIDE INITIAL SCAN DIRECTION.
                  0*       LOWER ABSCISSA VALUE TO HIGHER ABSCISSA
                           VALUE
                  1        HIGHER ABSCISSA VALUE TO LOWER ABSCISSA
                           VALUE
TRSPOF(17)               INTERNAL ALGORITHM PARAMETER.  DO NOT ALTER
                         THIS SETTING FROM THE RECOMMENDED VALUE.
                         BOTTOM SIDE OF CHANNEL FINAL SCAN DIRECTION.
                  0        LOWER ABSCISSA VALUE TO HIGHER ABSCISSA
                           VALUE
                  1*       HIGHER ABSCISSA VALUE TO LOWER ABSCISSA
                           VALUE
TRSPOF(20)               OPTION FOR CONTROLLING THE DETAIL OF THE
                         ROUTING SUMMARY REPORT.
                  0        NO REPORT PRINTED
                  1        GENERATE A SIMPLE REPORT CONTAINING
                           CARRIER DIMENSION DATA AND ROUTING
                           COMPLETION RATE DATA ON THE NUMBER
                           OF CONNECTIONS.
                  2*       GENERATE A MODERATELY DETAILED REPORT
                           CONTAINING ABOVE INFORMATION PLUS A
                           WIRE LENGTH AND VIA COUNT REPORT.
                  3        GENERATE A DETAILED REPORT SPECIFYING ALL
                           OF THE ABOVE INFORMATION PLUS DETAILED
                           INFORMATION ON FAILURES AND CONNECTION
                           LENGTH COMPLETION RATES.
TRSPOF(21)               OPTION FOR CONTROLLING THE DETAIL OF THE
                         EXECUTION TIME SUMMARY REPORT.
                  0*       NO REPORT PRINTED.
                  1        GENERATE A SIMPLE REPORT CONTAINING THE
                           TOTAL TRS EXECUTION TIME.
                  2        GENERATE A MODERATELY DETAILED REPORT
                           CONTAINING THE EXECUTION TIME BROKEN DOWN
                           INTO SPECIFIC CATEGORIES (E.G., FILE
                           LOADING TIME, CONNECTION GENERATION TIME,
                           ETC.)
TRSPOF(22)               OPTION FOR CONTROLLING THE DETAIL OF THE
                         DATA STRUCTURE UTILIZATION REPORT.
                  0*       NO REPORT PRINTED.
                  1        GENERATE A REPORT SPECIFYING THE % CHANNEL
                           AND OTHER DATA STRUCTURE USAGES.  NOTE THE
                           MAXIMUM USAGE LIMITS ARE ESTABLISHED BY
                           SYSTEM-WIDE TOKENS THAT CAN BE CHANGED TO
                           ACCOMODATE DIFFERENT SIZE DESIGN PROBLEMS.
                           CONTACT YOUR VR SOFTWARE SERVICE
                           REPRESENTATIVE IF ANY OF THE RESOURCE
                           USAGE VALUES REACH 100% .
TRSPOF(23)               UNUSED NODE STATUS FOR TRACK ASSIGNMENT.
                  1        TREAT UNUSED NODES AS BARRIERS
                  0        UNUSED NODES ARE NOT BARRIERS
TRSPOF(24)               TEST OPTION FOR PROCESSING A SINGLE CHANNEL
                  0*       NORMAL OPERATING MODE.  ALL CHANNELS ARE
                           ROUTED
                  N        TEST MODE.
                           FOR N GREATER THAN 0: ROUTE ONLY CHANNEL N.
                           FOR N LESS THAN 0: ROUTE CHANNELS 1 TO -N.
TRSPOF(25)               SELECTION OF TRUNK LAYER.
                  0        THE ORIENTATION OF THE CHANNEL IS
                           USED TO SELECT THE TRUNK LAYER ACCORDING
                           TO THE PREFERRED DIRECTION SPECIFIED ON
                           THE *RSD* RECORD.
                  N        SPECIFIES THE TRUNK LAYER FOR ALL
                           CHANNELS REGARDLESS OF CHANNEL ORIENTATION.
                           THIS OPTION IS USED WHEN SINGLE LAYER
                           POWER/GROUND ROUTES ARE USED.  SINGLE
                           LAYER ROUTING IMPLIES VIAS AT FUTURE
                           TERMINALS AND STITCHING ACROSS TRUNK LAYER
                           BRANCHES.
TRSPOF(26)               OPTION FOR SPECIAL HANDLING OF POWER/GROUND
```

```
                              CONNECTOR CELLS IN AUTOMATIC ROUTING OF
                              POWER/GROUND CONNECTIONS.
                         C#.    NO SPECIAL HANDLING OF POWER/GROUND BUS
                                CONNECTOR I/O CELLS.
                         1      POWER/GROUND BUS CONNECTOR CELLS ARE
                                POSITIONED AT THE RIGHT OF THE TOP ROW
                                AND AT THE LEFT OF THE BOTTOM ROW OF I/O
                                CELLS.  USE THIS OPTION FOR ALIGNMENT
                                OF THE P/G CONNECTOR CELLS AT THE END OF
                                THE CHANNELS SO THAT NO CONNECTIONS ARE
                                BLOCKED BY THE POWER/GROUND CONNECTION.

TRSPOP(27)                    OPTION FOR SAVING SPACE AT THE SIDES OF THE
                              CHANNELS BEFORE LAYING THE POWER/GROUND ROUTES
                              IN ORDER TO PREVENT THE BLOCKING OF TERMINALS
                              ACROSS THE CHANNEL FROM THE POWER/GROUND BRANCH.
                              THIS OPTION SHOULD BE SET TO ZERO UNLESS IT IS
                              DETERMINED THAT THE POWER/GROUND SCHEME LINKS
                              POWER/GROUND TERMINALS FROM BOTH SIDES OF A
                              GIVEN CHANNEL.  THEN THE VALUE SHOULD BE THE
                              MINIMUM NUMBER OF TRACKS NECESSARY TO ROUTE
                              THE BLOCKED CONNECTIONS.  THIS CAN BE
                              DETERMINED FROM THE WIDTH OF THE POWER/GROUND
                              BRANCH.
                         N      NUMBER OF TRACKS TO SAVE AT THE EDGE OF THE
                                CHANNEL.

--TRACE LEVELS--

TRACE LEVEL PARAMETERS ARE ASSIGNED TO SUBSYSTEM MODULES
TO ENHANCE TESTING AND DEBUG OPERATIONS.  THE TRACE LEVELS
ARE READ INTO GLOBAL DATA STRUCTURES FROM A CONTROL
PARAMETER FILE.  THE LAST TWO DIGITS IN THE TRACK ASSIGNMENT
MODULES ARE USED AS THE TRACE ARRAY INDEX_VALUES.

MODULE      MODULE      TRACE
 NAME       NUMBER      INDEX
------      ------      -----

TRSDVR       2700        NONE
TRSCLD       2701          1
TRSTS1       2702          2
TRSINP       2703          3
SETUP        2704          4
TRKASN       2705          5
TRSOUT       2706          6
TPSUEC       2707          7
NEWCHN       2708          8
BLLCGP       2709          9
PAKTRK       2710         10
ENCLOP       2711         11
SELAPS       2712         12
DOGLEG       2713         13
FNDLPN       2714         14
CHCSTR       2715         15
FLMNAT       2716         16
JNCSTR       2717         17
DLCSTR       2718         18
GTCSTR       2719         19
VSECHK       2720         20
TSPACE       2721         21
TRSLME       2722         22
TFSPET       2723         23
CHLIST       2724         24
CONSTN       2727         27
CLCSTR       2728         28
BCHROT       2729         29
PREFDY       2730         30
MRKTRF       2731         31
NEWBAR       2732         32
TRSTS1       2733         33
TRSTS2       2734         34

--IOFILE ASSIGNMENTS--

IOFILE
NUMBER      USE

   4        REPORT FILE
   5        REV DESIGN FILE
```

```
      6     INPUT DESIGN FILE
      8     INPUT CONTROL FILE
     10     INPUT CELLS-ON-CHANNEL FILE
     12     INPUT TERMINAL FILE
     17     ERROR MESSAGE TEXT LIBRARY

--TIMER ASSIGNMENTS--

TIMER
NUMBER    USE

     1    TOTAL ELAPSED EXECUTION TIME

     2    INDIVIDUAL MAJOR SUBSECTION EXECUTION TIME

--MACROS OTHER THAN NAMED COMMONS--

NOTE THAT TRACK ASSIGNMENT WAS WRITTEN UTILIZING
FLECS MACROS.

BOUNDSCHK  [VARBLE]  BOUNDS CHECK MACRO. DISABLED DURING
           [LOWEND]  PRODUCTION EXPANSION.
           [UP END]
           [ERRLBL]

STANDARD CELL TRACK ASSIGNMENT INTERFACE WITH CHX WAS
WRITTEN UTILIZING CHX TOKENS FOR FIELD IDENTIFICATION.

*******************************
* CONVERSION AND INSTALLATION *
*******************************

DELIVERABLES
------------

1. SOURCE CODE LISTED BELOW, PLUS THE SUPPORT SUBSYSTEM
   MODULE LIBRARY, DESIGN FILE ACCESS SUBSYSTEM MODULE
   LIBRARY, AND CHANNEL EXPANSION SUBSYSTEM MODULE LIBRARY.

MODULE      MODULE
 NAME       NUMBER
--------   --------

TRSDVR       2700
TRSCLD       2701
TRSIST       2702
TRSINP       2703
SETUP        2704
TRKASN       2705
TRSCUT       2706
TRSUPD       2707
NEWCHN       2708
BLDCGP       2709
PAKTRK       2710
FNDICP       2711
SELABS       2712
DOGLEG       2713
FNDLPN       2714
CHCSTR       2715
ELMNAT       2716
INCSTR       2717
DECSTR       2718
GTCSTR       2719
VSPCHF       2720
TSPACE       2721
TRSLMP       2722
TRSRPT       2723
CHLIST       2724
CONSTN       2727
CLCSTR       2728
HCHRCT       2729
PRERDY       2730
PEWIFE       2731
NEWFAR       2732
TRSTS1       2733
TRSTS2       2734

2. TEST DESIGN, TERMINAL, AND CELLS-ON-CHANNEL INPUT FILES
   FOR A SMALL TEST CASE. THE FOLLOWING FILE NAMES ARE IN VAX
```

FORMAT.

```
TEST.LSF
TEST.TRW
TEST.DOC
```

3. THIS DOCUMENTATION, TRS.DOC, AND TRSPT5.DOC AND TRSPT6.DOC.

4. MACRO LIBRARIES NECESSARY FOR SOURCE EXPANSION.

```
SSN.MAC
DFA.MAC
FLX.MAC
TRS.MAC
CHX.MAC
```

INSTALLATION TESTS
------------------

RUN TRS ON GRS INPUT FILES AND COMPARE WITH PREVIOUS RESULTS. THE SPECIFIC FEATURES TESTED BY THE SMALL TEST CASE ARE AS FOLLOWS:

BARRIER MODELING
ROUTING IN WELLS
PRE-EXISTING WIRE MODELING
CHANNEL EXPANSION
CHANNEL COMPRESSION
DOGLEG INSERTION
PASSING TERMINALS FORWARD
ZERO LENGTH CONNECTIONS
BRANCH LAYER ROUTING (BOTH DURING TRACK ASSIGNMENT AND AS
  A POST CHANNEL OVERFLOW PROCESS)
BRANCH LENGTH MINIMIZATION BY CHARACTERISTIC NUMBER

SUGGESTED OVERLAY STRUCTURE
---------------------------

NONE

TRANSPORTABILITY NOTES
----------------------

DATA STRUCTURES WILL BE SPECIFICALLY DESIGNED TO WORK WELL IN 32, 60 AND 64 BIT ENVIRONMENTS, WITHOUT SIGNIFICANT PERFORMANCE (SPEED/SPACE/COMPLETION RATE) IMPACT. THE INITIAL IMPLEMENTATION WILL BE DEVELOPED AND TESTED ON A 32-BIT WORDLENGTH HOST, USING V-RIS DESIGN FILES.

REGRESSION TESTING
------------------

UNIT TESTS EXIST FOR ALL MODULES IN THE TRS SUBSYSTEM AND THE INSTRUCTIONS FOR HOW TO EXECUTE THEM APPEAR IN THE TESTING PLANS SECTION OF EACH ONE.

REGRESSION TESTING CONSISTS OF UNIT TESTS ON THE AFFECTED MODULE(S) PLUS ALL MODULES ABOVE THE AFFECTED MODULES IN THE AFFECTED MODULES IN THE STRUCTURE DIAGRAM IN BOTTOM UP SEQUENCE. (SEE SOFTWARE DIAGRAM EARLIER IN THIS DOCUMENTATION OR A CROSS REFERENCE MAP OF THE LIBRARY) FOLLOWED BY INTEGRATION TESTS ON ALL THREE TEST CASES INCLUDED IN THE DELIVERABLES.

DESIGN FILE ACCESS NOTES
------------------------

TRSINP (2703) AND TRSUPD (2707) CALL CHX TO PERFORM DESIGN FILE INPUT AND UPDATE RESPECTIVELY. THE CALL TO CHXLOC (2627) FROM TRSINP ALSO CAUSES THE TERMINAL AND CELLS-ON-CHANNEL FILES TO BE INPUT.

CAPACITY MODIFICATION ISSUES
----------------------------

NOTE THAT TRKCONNECT HAS REPLACED $CONNECTIONS AND IS DEFINED LOCALLY AS 3 * $CONNECTIONS. ALSO, BE AWARE THAT $TRACKS REACHES CAPACITY EASILY WHEN VERY DEEP WELLS ARE BEING MODELED. IF THIS HAPPENS, ERROR CODE 8273205 WILL BE ISSUED.

TOKENS USED        MODULES

```
(EXCELL NAME)        CONTAINING
(COMMONS)            TOKEN
--------------------------------------------------------
SCHANNELS            S2701, S2706, S2724, S2734
SMODULES             S2701
SPADDLES             S2721
SECPTINS             S2701
STRACKS              S2701, S2706
SWIREPULES           S2708, S2721

@PTISPEEKCRD         S2722
```

THE FOLLOWING SUBSYSTEM SPECIFIC TOKENS ARE DEFINED IN SUBSYSTEM TOKEN MACRO TRSTOKEN.

```
TRKCONST             S2709, S2712, S2715, S2722, S2727,
                     S2734
TPKFUTURES           S2701
TRKSTACK             S2711
TRSCNSTRN1           S2701
TRSCONNECT           S2701, S2705
```

SEE CHX.LOC FOR OTHER CAPACITY TOKENS.

## FUTURE ENHANCEMENTS

1. PREFERRED Y CAPABILITIES WHICH RELY ON GLOBAL ROUTE TO PASS IN THE INFORMATION (WHICH IS PASSED FORWARD WITH FUTURE TERMINAL INFORMATION). PREFERRED Y STATES FROM GLOBAL ROUTE INCLUDE:
   A) NO PREFERENCE
   B) FIXED Y VALUE (TERMINAL ON END OF CHANNEL)
   C) PREFERRED Y VALUE

   MODULE 2730 (PRERDY) HAS BEEN DEFINED (BUT NOT IMPLEMENTED) FOR THIS PURPOSE.

   THE TRACK ASSIGNMENT SUBSYSTEM WILL ATTEMPT TO PLACE PREFERRED Y CONNECTIONS IN THEIR DESIRED TRACK BEFORE ANY OTHER CONNECTIONS ARE PLACED. FAILURES WILL BE LEFT FOR PLACEMENT DURING NORMAL TRACK ASSIGNMENT PROCEDURES. (WITH SIDE PREFERENCE IF THAT OPTION IS ENABLED.

2. DOGLEG INSERTION TO REDUCE CONSTRAINT CHAIN LENGTH.

3. DESIGNATION OF TYPE CRITICAL CONNECTIONS DURING INPUT OF TERMINAL LIST. CODE SUPPORTS A CRITICAL DESIGNATION IN THE WIRE RULE FIELD OF THE CONNECTION RECORD BY AVOIDING INSERTION OF DOGLEGS INTO THEM, BUT NO SUPPORT OF THIS FEATURE EXISTS IN THE INPUT SECTION.

```
**************
* APPENDIX 1 *
* REFERENCES *
**************
```


1. HITCHCOCK, R., "CELLULAR WIRING AND THE CELLULAR MODELING TECHNIQUE" PROCEEDINGS 6TH DESIGN AUTOMATION WORKSHOP (1969) PP 25-41.

2. HASHIMOTO AND STEVENS "WIRE ROUTING BY OPTIMIZING CHANNEL ASSIGNMENT WITHIN LARGE APERTURES" PROCEEDINGS 8TH DESIGN AUTOMATION WORKSHOP (1971) PP 155-169.

3. HIGHTOWER, D.W. AND BOYD, R. L. "A GENERALIZED CHANNEL ROUTER" PROCEEDINGS 17TH DESIGN AUTOMATION CONFERENCE (1980) PP 12-21.

4. SAIC, KOJI ET. AL. "A GRID FREE CHANNEL ROUTER" PROCEEDINGS 17TH DESIGN AUTOMATION CONFERENCE (1980) PP 22-31.

5. DEUTSCH, D.N. "A DOGLEG CHANNEL ROUTER" PROCEEDINGS 13TH DESIGN AUTOMATION CONFERENCE (1976) PP 425-432.

6. KELLY, M.E. "COMPARATIVE ROUTER PERFORMANCE" PH.D. DISSERTATION, UNIVERSITY OF CALIFORNIA AT LIVERMORE, SEPTEMBER, 1977.

7. KAYAMOTO, TATSUYA AND YOJI, KAJITAN, "THE MINIMUM WIDTH ROUTING OF A 2-ROW 2-LAYER POLYCELL-LAYOUT", PROCEEDINGS 16TH DESIGN AUTOMATION CONFERENCE, 1979, PP. 290-296.

```
**********************
* APPENDIX 2         *
* GLOSSARY OF TERMS  *
**********************
```

ABSCISSA - DISTANCE (NON-GRIDDED) FROM BOARD REFERENCE POINT ALONG THE LENGTH OF THE TRUNKS. (X DIRECTION FOR HZ CHANNEL, Y FOR VT)

BRANCH - A VT (HZ) COMPONENT OF ROUTING PATH IN A HZ (VT) CHANNEL

CHANNEL - A (USUALLY) LONG RECTANGULAR AREA WHICH HAS FIXED TERMINALS ON ITS UPPER AND LOWER SIDES (IN THE CASE OF A HORIZONTAL CHANNEL) WHICH ARE TO BE INTERCONNECTED WITHIN THE CHANNEL AREA.

CHARACTERISTIC NUMBER - NUMBER OF INTERCONNECTIONS TO THE UPPER SIDE OF CHANNEL MINUS NUMBER OF INTERCONNECTIONS TO THE BOTTOM SIDE OF CHANNEL. FOR EXAMPLE, IF NET IN A CHANNEL HAS 1 TERMINAL ON THE TOP AND 2 TERMINALS ON THE BOTTOM THAT NET HAS A CHARACTERISTIC NUMBER OF -1.

CONNECTION - THE SET OF TERMINALS THAT ARE TO BE CONNECTED USING ONE TRUNK.

CONSTRAINT - A REQUIREMENT THAT ONE TRUNK SECTION (TO BE PLACED ABOVE OR BELOW ANOTHER IN HZ CHANNEL) IMPOSED BY THE VERTICAL ALIGNMENT OF TWO OF THEIR TERMINALS.

CONSTRAINT CHAIN - A SEQUENCE OF CONSTRAINTS, FOR EXAMPLE; TRUNK A MUST BE ABOVE TRUNK B, TRUNK B MUST BE ABOVE TRUNK C,...

CONSTRAINT LOOP - (ALSO CALLED CYCLIC CONSTRAINT) A CONSTRAINT CHAIN IN WHICH AN INDIVIDUAL TRUNK SECTION APPEARS MORE THAN ONCE.

DOGLEG - THE BREAKING OF A TRUNK SECTION INTO TWO OR MORE TRUNK SECTIONS TO ALLEVIATE A CONSTRAINT CHAIN OR CONSTRAINT LOOP (5)

GLOBAL ROUTING - THE DISTRIBUTION OF WIRING TO ALLEVIATE LOCAL CONGESTION.

INTERCHANNEL CONNECTIONS (ICC) - POSSIBLE INTERCONNECTION PATHS THAT RUN THROUGH PREVIOUSLY PLACED ELEMENTS.

LOOSE ROUTING - IDENTIFYING POSSIBLE INTERCONNECTION PATHS THROUGH PREVIOUSLY PLACED ELEMENTS.

ORDINATE - DISTANCE FROM BOARD REFERENCE POINT (NON-GRIDDED) ALONG THE LENGTH OF BRANCHES.

PREFERRED Y - SOMETIMES A CONNECTION ENTERING A CHANNEL AT THE END MUST BE ASSIGNED A PREFERRED ORDINATE (EG. IN ORDER TO ALIGN WITH A FIXED POSITION PIN.). THAT ORDINATE IS CALLED A 'PREFERRED Y'.

TERMINALS - POINTS ALONG CHANNEL PERIPHERY (TOP AND BOTTOM FOR HZ CHANNELS) WHICH ARE TO BE INTERCONNECTED. EACH TERMINAL HAS A NET NUMBER ASSOCIATED WITH IT WHICH IS USED TO IDENTIFY THE OTHER TERMINALS TO WHICH IT MUST CONNECT.

TRACK - WHERE TRUNKS ARE PLACED WITHIN A CHANNEL. A TRACK RUNS ORTHOGONAL TO THE ABSCISSAS

TRUNK - HZ (VT) CONSTITUENT OF A ROUTING PATH IN AN HZ (VT) CHANNEL.

WELL - A DEPRESSION ALONG THE CHANNEL PERIPHERY THAT CAN BE USED FOR ROUTING.

```
*****************
* APPENDIX 3    *
* ERROR RETURNS *
*****************

EACH ERROR/WARNING NUMBER GENERATED BY V-RIS CODE HAS THREE
PARTS, WHEN REPRESENTED IN DECIMAL FORMAT. MOST ERRORS ALSO
PRODUCE A ONE LINE DIAGNOSTIC MESSAGE WHICH PROVIDES ADDITIONAL
INFORMATION RELATED TO THE ERROR.

ERROR NUMBER FORMAT IS SSMMMMXX, WHERE SS IS THE SEVERITY OF
THE CONDITION, MMMM IS THE NUMBER OF THE MODULE THAT DETECTED
THE CONDITION, AND XX IS AN ERROR CONDITION NUMBER WITHIN
MODULE MMMM.

TO DETERMINE THE CAUSE OF AN ERROR, EITHER USE THE LIST BELOW
OR FIND THE COMMENTS IN MODULE MMMM RELATED TO GENERATION OF
A PARTICULAR ERROR.

THE TEN MOST RECENTLY ENCOUNTERED ERROR CONDITIONS ARE STACKED
IN ERROR (COMMON CILDTA) AND THE WORST SO FAR SEEN (LARGEST
ERROR NUMBER) IS KEPT IN WRSTER.

****OUTPUT FROM ERLIST ROUTINE GOES HERE****

*******************
* APPENDIX 4      *
* MODULE SUMMARIES *
*******************

$*      MODULELIST
$*      0030CSMLVE
$*      0031CVTI2C
$*      0034ENDTIM
$*      0035VISERR
$*      0043VISTRG
$*      0045VISKI1
$*      0052SYSCLI
$*      0054RFSGEN
$*      0057LNESYS
$*      0067RETHDR
$*      0068SETCPT
$*      0070FLMNTE
$*      0081ARRDMP
$*      0082MIXCMP
$*      0091STRCNV
$*      0151GETFMT
$*      0152HXTREC
$*      2700THSLVR
$*      2701TRSCLD
$*      2702TRSTST
$*      2703TRSINP
$*      2704SETUP
$*      2705TRKASN
$*      2706TRSCMT
$*      2707TRSUPD
$*      2708NEWCHN
$*      2709PLDCGF
$*      2710FAKTRK
$*      2711FNDLCE
$*      2712SELAPS
$*      2713LCGLEC
$*      2714FNDCPN
$*      2715CHCSTR
$*      2716ELMNAL
$*      2717INCSTR
$*      2718DLCSTR
$*      2719GICSTR
$*      2720VSFCHK
$*      2721SPACE
$*      2722TRSDMF
$*      2723TRSREI
$*      2724CHLIST
$*      2727CONSTN
$*      2728CLCSTI
$*      2729PCHICT
$*      2730PRIRFY
$*      2731NRRTRF
$*      2732UFVLAF
```

```
$*      27339KS1S1
$*      27341KS1S2
        ****************************************
        * APPENDIX 5                           *
        * NAMED COMMON DETAILED DESCRIPTIONS   *
        ****************************************
SNC*    BOPLID
SNC*    CHXCHN
SNC*    CHXCRR
SNC*    CHXNET
SNC*    CHXNOL
SNC*    CHXFUL
SNC*    CHXXXX
SNC*    CTLDTA
SNC*    DFCCMN
SNC*    DFWCHK
SNC*    MASCON
SNC*    TPPCRC
SNC*    TKCHAN
SNC*    TKCAST
SNC*    TKCCMN
SNC*    TKTGST
SNC*    TKSTAT
SNC*    TKIFFM
SNC*    TKTRAK
```

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
HHHHHHHHHH   7777777777777777777777777  DIGITAL EQUIPMENT CORPORATION - VAX/VMS VERSION V4.4  777777777777777777777777   HHHHHHHHHH

KMP

TRSPT5

DOC

;1

FILE _$1$DUA6:[PRL.TRS(2]TRSPT5.DOC;1 (7539,1,1), LAST REVISED ON 21-OCT-1986 09:02, IS A 42 BLOCK SEQUENTIAL FILE OWNED BY UIC
[PRDTST,PRC].  THE RECORDS ARE VARIABLE LENGTH WITH IMPLIED (CR) CARRIAGE CONTROL.  THE LONGEST RECORD IS 77 BYTES.

JOB TRSPT5 (199) QUEUED TO SYS$PRINT ON 4-DEC-1986 12:50 BY USER KMP, UIC [ENGVLST,KMP], UNDER ACCOUNT ENGPKG AT PRIORITY 100,
STARTED ON PRINTER _ICN10$LPA0: ON 4-DEC-1986 13:12 FROM QUEUE SYS$PRINT.

HHHHHHHHHH   7777777777777777777777777  DIGITAL EQUIPMENT CORPORATION - VAX/VMS VERSION V4.4  777777777777777777777777   HHHHHHHHHH
```

```
C ****************************************************************
C ****************************************************************
C *******                                                  *******
C *******                  TRSFT5.DCC                      *******
C *******       TRS SUBSYSTEM OF SUBROUTINE DCCP15         *******
C *******                                                  *******
C *******                                                  *******
C ****************************************************************
C
C ****************************************************************
C **       (C) COPYRIGHT V-R INFORMATION SYSTEMS, INC. 1984     **
C **       LICENSED MATERIAL -- PROGRAM PROPERTY OF VRIS         **
C **       ALL RIGHTS RESERVED                                   **
C **                                                             **
C **       THIS PROGRAM IS THE PROPERTY OF VRIS AND IS FURNISHED **
C **       PURSUANT TO A WRITTEN LICENSE AGREEMENT. IT MAY NOT BE **
C **       USED, REPRODUCED, OR DISCLOSED TO OTHERS EXCEPT IN    **
C **       ACCORDANCE WITH THE TERMS AND CONDITIONS OF THAT      **
C **       AGREEMENT.                                            **
C ****************************************************************
C
C
C   --   REVISION HISTORY --
C          01-OCT-85 DDC ADDED CYCLE ROUTINE AND IMPLEMENTED
C                        ERRDY ROUTINE.  (SAR 5197)
C          03-APR-85 DDC MODIFIED FOR STC.  (SAR 4219)
C          06-NOV-84 DDC UPDATED SELAPS AND LOGLFG.  (SAR 4053)
C          11-SEP-84 DDC DELETED GTCONN, STCONN, GTTERM, STTERM
C                        (SAR 3997)
C          20-JULY-84 CJT CORRECTED COPYRIGHT LEGEND. (SAR 3901)
C          25-MAY-84 CJT CREATED THIS FILE AS PART OF DCCP15
C                        SEPARATION. (SAR 3778)
C$ 2700TRSLVR
C  TRSLVR 2700                   TRACK ASSIGNMENT MAIN DRIVER
C
C$E
C$ 2701TRSCLD
C  TRSCLD 2701   CALL TRSCLD      TRACK ASSIGNMENT COLD START, DATA
C                                 INITIALIZATION PROCEDURE.
C                                 INITIALIZES ALL GLOBAL DATA
C                                 FOR THE TRACK ASSIGNMENT SUBSYSTEM.
C                                 CALLS CHXCLD TO INITIALIZE DATA FOR
C                                 THE CHANNEL EXPANSION SUBSYSTEM.
C
C$E
C$ 2702TRSTST
C  TRSTST 2702   CALL TRSTST      TRACK ASSIGNMENT UNIT TEST DRIVER.
C                                 CALLED WHENEVER PCPTIN(1), TEST MODE,
C                                 IS ONE.  POPTIN(11), MODULE UNDER
C                                 TEST IS THEN USED TO REFERENCE THE
C                                 SPECIFIC TEST.
C
C$E
C$ 2703TRSINP
C  TRSINP 2703   CALL TRSINP      TRACK ASSIGNMENT DESIGN FILE INPUT
C                                 ROUTINE.  CALLS CHXLCL TO READ THE
C                                 INPUT DESIGN FILE AND INITIALIZES
C                                 GLOBAL VARIABLES.
C
C$F
C$ 2704SETUP
C  SETUP  2704 CALL SETUP         INITIALIZES ALL
C                                 TRACK ASSIGNMENT INTERNAL DATA
C                                 STRUCTURES FOR THE NEXT CHANNEL,
C                                 CALLING CHXINP FOR THE TERMINALS
C                                 AND ALL CHANNEL ASSOCIATED BARRIERS.
C                                 THIS SUBROUTINE HAS RESPONSIBILITY
C                                 TO ELIMINATE CONSTRAINT LOOPS AND
C                                 SORT CONNECTION RECORDS BASED ON
C                                 PRIORITIES AND ABSCISSA VALUES.
C
C$E
C$ 2705TRKASN
C  TRKASN 2705   CALL TRKASN      ASSIGNS CONNECTION TRUNKS TO
C                                 TRACKS WITHIN THE CHANNEL, USING
C                                 AS MANY TRACKS AS ARE NECESSARY TO
C                                 COMPLETE THE CONNECTIONS.
C
C$E
C$ 2706TRSCUT
C  TRSCUT 2706   CALL TRSCUT      PASSES TO CHNOUT OF CHX
C                                 ALL ROUTING THAT OCCURRED DURING
```

```
C                                   TRACK ASSIGNMENT.
C
C$E
C$ 2707TRSUPD
C   TRSUPD 2707  CALL TRSUPD            CALLED AFTER ALL CHANNELS HAVE BEEN
C                                      PROCESSED.  CHXUPD IS CALLED TO
C                                      WRITE A NEW DESIGN FILE, CREATING
C                                      THE RTS RECORDS REPRESENTING THE
C                                      CONNECTIONS ROUTED BY TRS AND
C                                      CONTAINING THE NEW CHANNEL AND BOARD
C                                      SIZES AND NEW POSITIONS OF ALL BOARD
C                                      ITEMS.
C$E
C$ 2708NEWCHN
C   NEWCHN 2708  CALL NEWCHN            CALLS CHNINP OF CHX FOR THE NEW
C                                      CHANNEL INFORMATION AND SETS UP
C                                      ALL TERMINAL AND CONNECTION
C                                      RECORDS, CALLING NEWBAR AND NEWIRE
C                                      SUBROUTINES TO MODEL BARRIERS AND
C                                      PREWIRED CONNECTIONS.
C$E
C$ 2709BLDCGR
C   BLDCGR 2709  CALL BLDCGR            BUILDS A VERTICAL CONSTRAINT GRAPH
C                                      BY SCANNING THE TERMINAL LIST FOR
C                                      CONSTRAINT CONDITIONS.
C$E
C$ 2710PAKTRK
C   PAKTRK 2710  CALL PAKTRK (          PACKS CONNECTIONS TRUNK SECTIONS
C                         TRKNUM,      INTO TRACK *TRKNUM*.  ONLY CONNECTIONS
C                         STRCON,      IN THE RANGE BETWEEN *STRCON* AND
C                         ENDCON,      *ENDCON* ARE CANDIDATES FOR TRACK
C                         SCANDR)      ASSIGNMENT.  *SCANDR* IS USED TO
C                                      SPECIFY WHETHER TRACKS ARE PACKED
C                                      LEFT-TO-RIGHT OR RIGHT-TO-LEFT.
C$E
C$ 2711FNDLOP
C   FNDLOP 2711  I = FNDLOP(            INTEGER FUNCTION DETERMINES IF THE
C                         ORGATE,      CONSTRAINT THAT ORIGINATOR CONNECTION
C                         TERMAT)      *ORGATE* MUST BE ABOVE THE
C                                      TERMINATOR CONNECTION *TERMAT* WILL
C                                      CAUSE A LOOP IN THE VERTICAL
C                                      CONSTRAINT GRAPH.  THE FUNCTION
C                                      RETURNS ZERO IF NO LOOP IS
C                                      CAUSED AND ONE OTHERWISE.
C$E
C$ 2712SELABS
C   SELABS 2712  CALL SELABS (          SELECTS THE BEST ABSCISSA POINT TO
C                         ORGATE,      DOGLEG EITHER CONNECTION *ORGATE* OR
C                         TERMAT,      *TERMAT*.  *TERMPT* IS THE TERMINAL
C                         TERMPT,      AT WHICH THE CONSTRAINT LOOP WAS
C                         CONNUM,      ENCOUNTERED.  ABSCISSAS ARE EVALUATED
C                         ABCISA,      WITHIN THE RANGE OF THE LOOP.  IF NONE
C                         RANGE)       IS FOUND IN RANGE, THEN THE SEARCH
C                                      CONTINUES BOTH LEFT AND RIGHT OF THE
C                                      RANGE UNTIL AN ABCISSA IS FOUND (OR THE
C                                      ENTIRE CHANNEL HAS BEEN SEARCHED).
C                                      *CONNUM* IS THE CONNECTION TO DOGLEG.
C                                      *ABCISA* IS THE ABCISSA AT WHICH TO DOGLEG.
C                                      *RANGE* IS THE FIRST TERMINAL TO THE LEFT
C                                      OF *TERMPT* AT WHICH *ORGATE* SUCCEEDS
C                                      *TERMAT*.
C$E
C$ 2713DOGLEG
C   DOGLEG 2713  CALL DOGLEG (          DOGLEGS THE TRUNK OF CONNECTION
C                         TERMPT,      *CONNBR* AT *ABCISA* AND UPDATES
C                         CONNBR,      ALL TERMINAL AND CONNECTION DATA.
C                         ABCISA,      *RANGE* AND *TERMPT* DEFINE THE
C                         RANGE)       LEFT-MOST AND RIGHT-MOST TERMINALS
C                                      IN THE RANGE OF THE CONSTRAINT LOOP.
C$E
C$ 2714FNDOPN
C   FNDOPN 2714  CALL FNDOPN (          DETERMINES THE *START* AND *STOP*
C                         START ,      ABSCISSA BOUNDS FOR THE OPENING
C                         STOP  ,      IN THE TRACK BETWEEN CONNECTIONS
C                         PRECON,      *PRECON* AND *NXTCON*.  *SCANDR*
```

```
C                         DYTCON,    SCAN DIRECTION IS USED TO SPECIFY
C                         SCANDR)    WHETHER A RIGHT-TO-LEFT OR LEFT-
C                                    TO-RIGHT SCAN.
C
CSE
CS 2715CHCSTR
C   CHCSTR 2715  CALL CHCSTR (         MODIFIES THE VERTICAL CONSTRAINT
C                         ABCISA,    GRAPH AT ABSCISSA *ABCISA*, DELETING
C                         NEWCCN,    ALL CONSTRAINT REFERENCES TO THE
C                         OLDCCN)    OLD CONNECTION *OLDCCN* AND INSERTING
C                                    THE VERTICAL CONSTRAINT TO THE NEW
C                                    CONNECTION *NEWCCN*.
C
CSE
CS 2716ELMNAT
C   ELMNAT 2716  CALL ELMNAT (         ELIMINATES ONE OF THE CONNECTIONS
C                         ORGATE,    *ORGATE* OR *TERMAT* FROM FUTURE
C                         TERMAT)    TRACK ASSIGNMENT.  A CONNECTION
C                                    MUST BE ELIMINATED SINCE A CONSTRAINT
C                                    LOOP COULD NOT BE BROKEN WITH A
C                                    DOGLEG OPERATION.
C
CSE
CS 2717INCSTR
C   INCSTR 2717  CALL INCSTR (         INSERT INTO THE VERTICAL CONSTRAINT
C                         ORGATE,    GRAPH THE CONSTRAINT THAT THE
C                         TERMAT)    ORIGINATOR CONNECTION *ORGATE*
C                                    MUST BE ABOVE THE TERMINATING
C                                    CONNECTION *TERMAT*.
C
CSE
CS 2718DLCSTR
C   DLCSTR 2718  CALL DLCSTR (         DELETES FROM THE VERTICAL CONSTRAINT
C                         ORGATE,    GRAPH THE CONSTRAINT THAT THE
C                         TERMAT)    ORIGINATOR CONNECTION *ORGATE*
C                                    MUST BE ABOVE THE TERMINATING
C                                    CONNECTION *TERMAT*.
C
CSE
CS 2719GTCSTR
C   GTCSTR 2719  I = GTCSTR(         GETS THE FIRST OR NEXT CONSTRAINT
C                         CONNUM,    FOR THE CONNECTION *CONNUM*.  RETURNS
C                         FRNXFG,    THE CONNECTION NUMBER OF THE CONSTRAINT
C                         PRSUFG)    AS THE FUNCTION VALUE.  *FRNXFG*
C                                    IS A CONTROL FLAG TO DETERMINE IF THE
C                                    FIRST OR NEXT CONSTRAINT IS DESIRED.
C                                    *PRSUFG* IS USED TO DETERMINE IF THE
C                                    PREDECESSOR OR SUCCESSOR LIST IS
C                                    WANTED.
C
CSE
CS 2720VSPCHK
C   VSPCHK 2720  I = VSPCHK(          CHECK TO SEE IF ANY VIA SPACING
C                         CONNIX,    CONSTRAINTS PRECLUDE THE PLACEMENT
C                         ORDNAT)    OF CONNECTION *CONNIX* AT ORDINATE
C                                    CONTAINED IN *ORDNAT*.  RETURNS ARE:
C                                  NEG = ERROR OCCURRED
C                                    1 = VIA SPACING VIOLATION WOULD EXIST
C                                        IF *CONNIX* WERE PLACED AT
C                                        *ORDNAT*
C                                    0 = NO VIA SPACING VIOLATION
C
CSE
CS 2721ISPACE
C   ISPACE 2721  CALL ISPACE(          THIS MODULE CALCULATES THE SPACING
C                         SPACNG,    TABLE *SPACNG* USED TO CALCULATE THE
C                         WIRULE)    CORRECT SPACING OF ROUTED CONNECTIONS
C                                    FROM OTHER CONNECTIONS OR BARRIERS.
C                                    *SPACNG* IS AN ARRAY DIMENSIONED
C                                    (4,2,2) THAT RETURNS SPACING DATA,
C                                    WHERE THE FIRST SUBSCRIPT
C                                    IS CLEARANCE RULE:
C                                      SPACNG(1,*,*) = VIA-TO-VIA
C                                      SPACNG(2,*,*) = VIA-TO-BARRIER
C                                      SPACNG(3,*,*) = VIA-TO-LINE
C                                      SPACNG(4,*,*) = LINE-TO-LINE
C                                    SECOND SUBSCRIPT IS LAYER, AND
C                                    THIRD SUBSCRIPT IS ORIENTATION.
C                                      SPACNG(*,*,1) = HORIZONTAL.
C                                      SPACNG(*,*,2) = VERTICAL
C                                    FOR EXAMPLE, THE VERTICAL
C                                    VIA-TO-BARRIER CLEARANCE SPACING
```

```
C                                         ON LAYER ONE WOULD BE ROUTED AT:
C                                           SPACNG(2,1,2)
C                                         *WIRULE* IS THE WIRING RULE
C                                         THAT IS TO BE USED TO CALCULATE
C                                         SPACING DATA.  CDX INTERNAL TABLES
C                                         ARE ACCESSED TO OBTAIN THE WIRING
C                                         RULE INFORMATION.
C
CSE
CS 2722TRSDMP
C   TRSDMP 2722  CALL TRSDMP (              NAMED COMMON DATA DUMPER.  IF *INXCPT*
C                         COMCPT,         .EQ. ZERO THEN IF
C                         INXCPT)         COMCPT = TRDEAL DUMP ALL COMMONS
C                                         COMCPT = TKDFCO DUMP /TKCNST/
C                                         COMCPT = TKDPSI DUMP /TKSTAT/
C                                         COMCPT = TKDFCN DUMP /TKCLNN/
C                                         COMCPT = TKDFTK DUMP /TKTRAK/
C                                         COMCPT = TKDPTM DUMP /TKTERM/
C                                         COMCPT = TKDPCH DUMP /TKCHAN/
C                                         COMCPT = TKDFIN DUMP /TKINST/
C                                         COMCPT = TKDFBD DUMP /TKPCBD/
C                                         IF *INXCPT* .NE. ZERO DUMP ONLY THE
C                                         APPROPRIATE ARRAY INDEX VALUE.
C
CSE
CS 2723TRSRPT
C   TRSRPT 2723  CALL TRSRPT                TRACK ASSIGNMENT SUBSYSTEM USER
C                                         ORIENTED REPORT GENERATOR.
C
CSE
CS 2724CHLIST
C   CHLIST 2724  CALL CHLIST (              RETURNS ALL CHANNELS OVERLAPPED BY
C                         LIST   ,        BY THE RECTANGLE *LX*, *LY*, *UX*,
C                         SIZE   ,        AND *UY* IN *LIST*.  *SIZE* IS THE
C                         LX     ,        NUMBER OF CHANNELS IN *LIST*.
C                         LY     ,        LIST(1,*) = CHANNEL INDEX NUM.
C                         UX     ,        LIST(2,*) = LLX OF OVERLAP
C                         UY     )        LIST(3,*) = LLY OF OVERLAP
C                                         LIST(4,*) = URX OF OVERLAP
C                                         LIST(5,*) = URY OF OVERLAP.
C
CSE
CS 2725CYCLE
C   CYCLE  2725  CALL CYCLE                 THIS SUBROUTINE IS CALLED BEFORE
C                                         PROCESSING THE FIRST CHANNEL IN A CYCLE
C                                         IN ORDER TO SET THE SIZE OF THE LAST
C                                         CHANNEL OF THE CYCLE AND TO SET THE
C                                         ORDINATES OF THE FUTURE TERMINALS FROM
C                                         THE LAST CHANNEL OF THE CYCLE INTO THE
C                                         FIRST CHANNEL OF THE CYCLE.
C
CSE
CS 2727CONSTN
C   CONSTN 2727  CALL CONSTN (              RETURNS THE SUCCESSOR, PREDECESSOR
C                         SUCSTR,         AND VIA SPACING CONSTRAINT CONNECTIONS
C                         SUCCNT,         FOR THE TERMINAL POINTED TO BY
C                         PRCSTR,         *TERMPT*.  *SUCSTR* IS A LIST OF
C                         PRECNT,         *SUCCNT* SUCCESSORS CONNECTIONS,
C                         VSPLST,         WHILE *PRCSTR* IS A LIST OF *PRECNT*
C                         VSPCNT,         PREDECESSORS AND *VSPLST* IS A LIST
C                         TERMPT)         OF *VSPCNT* VIA SPACING CONSTRAINTS.
C                                         NOTE, CONSTRAINTS DUE TO FAILED
C                                         CONNECTIONS AND/OR BARRIERS ARE NOT
C                                         RETURNED BY THIS ROUTINE.
C
CSE
CS 2728CLCSTR
C   CLCSTR 2728  CALL CLCSTR (              DETERMINES THE CLOSEST PREDECESSOR
C                         CONNUM,         OR SUCCESSOR CONSTRAINT FROM *CONNUM*
C                         RTLAYR,         CONNECTION, KNOWING THAT THE
C                         PRSUFG,         CONNECTION WILL BE ROUTED ON LAYER
C                         CONORD,         *RTLAYR*.  *PRSUFG* IS USED TO SPECIFY
C                         SPCORD,         IF SUCCESORS OR PREDECESSORS ARE
C                         UNASSN)         WANTED.  *CONORD* IS THE ORDINATE OF
C                                         THE CLOSEST CONSTRAINT WHILE *SPCORD*
C                                         IS THE ORDINATE PLUS SPACING REQUIRE-
C                                         MENTS.  *UNASSN* IS NON-ZERO IF A
C                                         CONSTRAINT HAS NOT BEEN ROUTED.
C
CSE
CS 2729RCHRCT
C   RCHROT 2729  CALL RCHROT (              ATTEMPTS TO ROUTE CONNECTION *CONNBR*
```

```
C                        CONNPR,     ON THE BRANCH LAYER. *TCPLLW* AND *BCTHIG*
C                        TRAFLR,     ARE THE LIMITS OF BRANCH ROUTING BY THE
C                        TCPLCW,     CONSTRAINTS, WHILE *TCPUNA* AND *BCTUNA*
C                        BOTHIG,     ARE THE NUMBER OF CONSTRAINTS UNASSIGNED
C                        TCPUNA,     AN CRDINATE.
C                        BOTUNA)
C
C
CSE
CS 2730PREPDY
C  PREPDY 2730  CALL PREPDY        CURRENTLY IMPLEMENTED FOR HIGHLY
C                                  PREFERRED Y TERMINALS. THIS SUBROUTINE
C                                  PLACES THE CONNECTIONS OF OUTGOING
C                                  FUTURE TERMINALS AT THE LOW END OF THE
C                                  CURRENT CHANNEL AT THE ORDINATE OF THE
C                                  TERMINAL. THE CURRENT CHANNEL IS THE
C                                  LAST CHANNEL OF A CYCLE AND HAS BEEN
C                                  PRE-ROUTED SO THAT THE FUTURE TERMINALS
C                                  COULD BE FED INTO THE FIRST CHANNEL OF
C                                  THE CYCLE.
CSE
CS 2731NEWIRE
C  NEWIRE 2731  CALL NEWIRE        INPUTS PRE-EXISTING POWER/GROUND
C                                  CONNECTIONS FOR CHANNEL
C                                  POINTED TO BY GLOBAL VARIABLE
C                                  *CHANIX* FROM TEMPORARY FILE.
C                                  SETS UP APPROPRIATE CONNECTION AND
C                                  TERMINAL RECORDS TO MODEL THE WIRES.
C                                  CALLS NEWBAR TO CREATE BARRIERS AROUND
C                                  THE WIDE WIRES AND VIAS.
CSE
CS 2732NEWBAR
C  NEWBAR 2732  CALL NEWBAR(       INPUTS NEW BARRIERS FOR CHANNEL
C                        TOPDIF,   POINTED TO BY GLOBAL VARIABLE
C                        MINMAX)   *CHANIX*. SETS UP APPROPRIATE
C                                  CONNECTION AND TERMINAL RECORDS
C                                  TO MODEL THE BARRIERS. *TOPDIF*
C                                  IS THE DIFFERENCE TO ADD TO THE
C                                  BARRIERS AT THE TOP OF THE CHANNEL
C                                  TO MOVE THEM TO THE TOP OF THE
C                                  EXPANDED CHANNEL. *MINMAX* IS A
C                                  FLAG USED TO INDICATE WHETHER
C                                  GLOBAL VARIABLES FOR MINIMUM TOP
C                                  BARRIER, *MNTPBR*, AND MAXIMUM
C                                  BOTTOM BARRIER, *MXBTBR*, ARE TO
C                                  BE ADJUSTED.
CSE
CS 2733TRSTS1
C  TRSTS1 2733  CALL TRSTS1        FIRST TRACK ASSIGNMENT UNIT TEST
C                                  DRIVER. CALLED BY *TRSTST* S2702
C                                  WHENEVER *PCPTIN(1)*, TEST MODE,
C                                  IS SET TO ONE, AND *PCPTIN(11)*,
C                                  MODULE UNDER TEST, IS IN THE
C                                  RANGE 2701 TO 2721. THE MODULE
C                                  SPECIFIED FOR UNIT TEST IS THE
C                                  VALUE OF *PCPTIN(11)*.
C
CSE                                                        2733TRSTS1
CS 2734TRSTS2
C  TRSTS2 2734  CALL TRSTS2        SECOND TRACK ASSIGNMENT UNIT TEST
C                                  DRIVER. CALLED BY *TRSTST* S2702
C                                  WHENEVER *PCPTIN(1)*, TEST MODE,
C                                  IS SET TO ONE, AND *PCPTIN(11)*,
C                                  MODULE UNDER TEST, IS IN THE
C                                  RANGE 2722 TO 2734. THE MODULE
C                                  SPECIFIED FOR UNIT TEST IS THE
C                                  VALUE OF *PCPTIN(11)*.
C
CSE                                                        2734TRSTS2
```

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
COCCOCCOCO  3333333333333333333333333333333333333333333333333333333333333333333333333333333333333  OOOOOOOOOO
COCCOCCOCO  33333333333333333333333  DIGITAL EQUIPMENT CORPORATION - VAX/VMS VERSION V4.4  3333333333333333333333  OOOOOOOOOO
COCCOCCOCO  3333333333333333333333333333333333333333333333333333333333333333333333333333333333333  OOOOOOOOOO

KMP

TRSPT6

DOC

;3

FILE _S1SDUA6:[FRL.TRS02]TRSPT6.DOC;3 (6226,1,2), LAST REVISED ON 21-OCT-1986 09:02, IS A 51 BLOCK SEQUENTIAL FILE OWNED BY UIC
[PRDTST,PRC]. THE RECORDS ARE VARIABLE LENGTH WITH IMPLIED (CR) CARRIAGE CONTROL. THE LONGEST RECORD IS 74 BYTES.

JOB TRSPT6 (2CO) QUEUED TO SYS$PRINT ON 4-DEC-1986 12:50 BY USER KMP, UIC [ENGVLSI,KMP], UNDER ACCOUNT ENGPKG AT PRIORITY 3,
STARTED ON PRINTER _TCN1USLPA0: ON 4-DEC-1986 13:20 FROM QUEUE SYS$PRINT.

COCCOCCOCO  3333333333333333333333333333333333333333333333333333333333333333333333333333333333333  OOOOOOOOOO
COCCOCCOCO  33333333333333333333333  DIGITAL EQUIPMENT CORPORATION - VAX/VMS VERSION V4.4  3333333333333333333333  OOOOOOOOOO
COCCOCCOCO  3333333333333333333333333333333333333333333333333333333333333333333333333333333333333  OOOOOOOOOO
```

```
_$1$DUA6:[PRD.TRSC2]TRSPTF.DOC;3                    21-OCT-1986 09:02                    PAGE 1
C *****************************************************************
C *****************************************************************
C *******                                                  *******
C *******                  TRSPTF.DOC                      *******
C *******       TRS SUBSYSTEM OF SUBROUTINE DOCPT6         *******
C *******                                                  *******
C *******                                                  *******
C *****************************************************************
C
C *****************************************************************
C **     (C) COPYRIGHT V-R INFORMATION SYSTEMS, INC.  1984       **
C **     LICENSED MATERIAL -- PROGRAM PROPERTY OF VRIS           **
C **     ALL RIGHTS RESERVED                                     **
C **                                                             **
C **     THIS PROGRAM IS THE PROPERTY OF VRIS AND IS FURNISHED   **
C **     PURSUANT TO A WRITTEN LICENSE AGREEMENT.  IT MAY NOT BE **
C **     USED, REPRODUCED, OR DISCLOSED TO OTHERS EXCEPT IN      **
C **     ACCORDANCE WITH THE TERMS AND CONDITIONS OF THAT        **
C **     AGREEMENT.                                              **
C *****************************************************************
C
C
C    --  REVISION HISTORY --
C          14-JAN-86 TAF REMOVED *CHNUMB* AND *CHSFOU* FROM *CHANEL*
C                        ARRAY.  (SAR 5500)
C          18-DEC-85 DDC ADDED *MININX*/*MAXINX* TO /TKSTAT/. (SAR 5463)
C          10-DEC-85 DDC ADDED *MN/MXARPG* TO /TKSTAT/.  (SAR 5424)
C          10-SEP-85 DDC MOVED FUTURE TERMINALS FOR VIA PROTECTION
C                        TO CHX SUBSYSTEM.  ADDED VARIABLES FOR
C                        SINGLE LAYER METAL AND CHANNEL CYCLE SUPPORT.
C                        (SAR 5197)
C          29-MAR-85 DDC MODIFIED TRKPT6.DOC TO CREATE TRSPT6.DOC
C                        FOR STANDARD CELL.  SOME DATA STRUCTURES
C                        ARE SHARED WITH CHX, INVOLVING A CHANGE
C                        OF POINTER VALUES IN TKCNST AND DELETION
C                        OF SOME COMMONS FOR LOCAL STORAGE USE.
C                        DELETED /TKPUFR/ SINCE CHX HANDLES ALL
C                        DESIGN FILE I/O AND TRS HAS NO NEED FOR
C                        TEMPORARY FILES.  (SAR 4219)
C          17-JUL-84 CJT CORRECTED COPYRIGHT LEGEND. (SAR 3902)
C          04-MAY-84 CJT CREATED THIS FILE AS PART OF DOCPT6
C                        SEPARATION. (SAR 3745)
C
C$ TKBCRD
C                *****************
C                * COMMON TKBCRD *
C                *****************
C
C      CONTAINS BOARD INFORMATION FOR THE TRACK ASSIGNMENT
C      SUBSYSTEM IN THE CHANNEL ROUTER.
C
C NAME   DIMENSION TYPE  DESCRIPTION
C
C GRIDSZ (2)         I    NUMBER OF UNITS BETWEEN ADJACENT GRID
C                         LINES IN X AND Y DIRECTIONS RESPECTIVELY.
C
C LAYER  (2)         I    LAYER NUMBER FOR HORIZONTAL AND VERTICAL
C                         DIRECTIONS RESPECTIVELY.
C
C ROTLLC (2)         I    X AND Y COORDINATE OF LOWER LEFT CORNER OF
C                         ROUTABLE AREA (IN UNITS).
C
C ROTURC (2)         I    X AND Y COORDINATE OF UPPER RIGHT CORNER OF
C                         ROUTABLE AREA (IN UNITS).
C
C SPACNG (4,2,2)     I    TABLE OF SPACING PARAMETERS.  SUBSCRIPTS ARE
C                         TYPE, LAYER, AND ORIENTATION RESPECTIVELY.
C
C VIAPCD             I    VIA PAD CODE NUMBER. (FOR DESIGN FILE POINTER
C                         TO *PCD* RECORD.)
C
C WIRWID (2,2)       I    WIDTH OF WIRE SEGMENTS (TO UPDATE THE DESIGN
C                         FILE).  SUBCRIPTS ARE LAYER AND ORIENTATION.
C
C TRKWID (2,2)       I    WIDTH OF WIRE SEGMENTS PLUS CLEARANCE
C                         (SUBSCRIPTS ARE LAYER AND ORIENTATION.)
C
C CLRVDG             I    VIA-TO-VIA DIAGONAL CLEARANCE FLAG
C
CS E
CS TKCHAN
C                *****************
```

```
C                   * COMMON TKCHAN *
C                   *****************
C
C        CONTAINS TRACK ASSIGNMENT CHANNEL DATA
C
C        REVISION HISTORY --
C          14-JAN-86 TAF REMOVED *CHNUMB* AND *CHSEQU*.  (SAR 5500)
C          18-SEP-85 DCC REMOVED *CHVIAF* ARRAY.  ADDED *CHCYCL*
C                        AND *CHESTM* FOR CYCLE SUPPORT.  (SAR 5197)
C          29-MAR-84 DCC FOR STC, EQUIVALENCED *CHANEL*
C                        ARRAY TO *CHNDAT* IN CHX.  DEFINED
C                        *CHVIAF* ARRAY.  (SAR 4219)
C
C NAME     DIMENSION TYPE  DESCRIPTION
C
C CHANEL  (*,*)        I   DESCRIPTION OF CHANNELS FOR THIS PROBLEM.
C   EQUIVALENCED           FIRST SUBSCRIPT DENOTES FIELD:
C   TO CHNDAT IN           CHORNT = 1  ORIENTATION OF CURRENT CHANNEL
C   /CHXCHN/                           (1=HZ,2=VT)
C  (*,SCHANNELS)           CHLLXX = 2  LOWER LEFT X COORDINATE (IN UNITS)
C                          CHLLYY = 3  LOWER LEFT Y COORDINATE (IN UNITS)
C                          CHURXX = 4  UPPER RIGHT X COORDINATE (IN UNITS)
C                          CHURYY = 5  UPPER RIGHT Y COORDINATE (IN UNITS)
C                          CHCYCL =21  POINTER TO THE OTHER CHANNEL AT THE
C                                      OTHER END OF THE CHANNEL CYCLE
C                          CHESTM =22  ESTIMATION VALUE FOR SIZE OF THE
C                                      LAST CHANNEL IN A CYCLE.  (NOT USED
C                                      FOR OTHER CHANNELS.)  EQUAL TO THE
C                                      NUMBER OF TRACKS ABOVE MAX DENSITY
C                                      OF THE CURRENT CHANNEL SIZE.  IF
C                                      VALUE IS ZERO, INDICATES FIRST
C                                      ATTEMPT AT ROUTING CYCLE.  IF
C                                      VALUE IS NEGATIVE, FLAGS THIS CYCLE
C                                      AS HAVING FAILED ALL REASONABLE
C                                      ATTEMPTS.
C
C
C$F
C$ TKCNST
C                   *****************
C                   * COMMON TKCNST *
C                   *****************
C
C        CONTAINS CONSTANTS FOR THE TRACK ASSIGNMENT SUBSYSTEM.
C
C        REVISION HISTORY --
C          14-JAN-86 TAF REMOVED *CHNUMB* AND *CHSEQU*.
C                        (SAR 5500)
C          01-OCT-85 DCC ADDED CHCYCL, FINETN, FICHAN.  DELETED
C                        FICONN, FTRIPT.  (SAR 5197)
C          29-MAR-85 DCC FOR STC: ADDED TMLAYR, INNETN, FTABSC,
C                        FIORDN, FICONN, FTRTPT.  DELETED CHFUTR.
C                        (SAR 4219)
C
C NAME     DIMENSION TYPE  DESCRIPTION
C
C BOTFLG               I   BOTTOM FLAG VALUE FOR SIDE PREFERENCE
C
C CHCYCL               I   ITEM NUMBER FOR CHANNEL CYCLE POINTER IN
C                          THE CHANNEL RECORDS.
C
C CHLLXX               I   ITEM NUMBER FOR LOW LEFT X IN THE CHANNEL
C                          RECORDS.
C
C CHLLYY               I   ITEM NUMBER FOR LOW LEFT Y IN THE CHANNEL
C                          RECORDS.
C
C CHORNT               I   ITEM NUMBER FOR CHANNEL ORIENTATION IN THE
C                          CHANNEL RECORDS.
C
C CHURXX               I   ITEM NUMBER FOR UPPER RIGHT X IN THE CHANNEL
C                          RECORDS.
C
C CHURYY               I   ITEM NUMBER FOR UPPER RIGHT Y IN THE CHANNEL
C                          RECORDS.
C
C CNLAYR               I   ITEM NUMBER FOR LAYER IN THE CONNECTION RECORD
C
C CNLEFT               I   ITEM NUMBER FOR LEFT CONNECTION POINTER IN
C                          CONNECTION RECORDS.
C
C CNNETN               I   ITEM NUMBER FOR NET NUMBER IN THE CONNECTION
```

```
C                          RECORDS.
C
C CNPRED          I        ITEM NUMBER FOR THE FIRST PREDECESSOR IN THE
C                          CONNECTION RECORDS.
C
C CNORDN          I        ITEM NUMBER FOR ORDINATE IN THE CONNECTION
C                          RECORDS.
C
C CNRIFT          I        ITEM NUMBER FOR RIGHT CONNECTION POINTER
C                          IN CONNECTION RECORDS.
C
C CNSTOP          I        ITEM NUMBER FOR STOP TERMINAL POINTER IN THE
C                          CONNECTION RECORDS.
C
C CNSTRT          I        ITEM NUMBER FOR START TERMINAL POINTER IN THE
C                          CONNECTION RECORDS.
C
C CNSUCC          I        ITEM NUMBER FOR THE FIRST SUCCESSOR
C                          IN THE CONNECTION RECORDS.
C
C CNTYPE          I        ITEM NUMBER FOR CONNECTION TYPE IN THE
C                          CONNECTION RECORDS.
C
C CNVSPC          I        ITEM NUMBER FOR POINTER TO THE FIRST VIA
C                          SPACING CONSTRAINT IN THE CONNECTION RECORD
C
C CNWIRU          I        ITEM NUMBER FOR WIRING RULE TYPE IN CONNECTION
C                          RECORDS.
C
C FIRSTC          I        FIRST CONNECTION VALUE FOR ACCESS TO MODULE
C                          GTCSTR 2719.
C
C FTABSC          I        ITEM NUMBER FOR FUTURE TERMINAL ABSCISSA IN
C                          THE FUTURE TERMINAL RECORDS.
C
C FTCHAN          I        ITEM NUMBER FOR THE FUTURE CHANNEL
C                          OF THE FUTURE TERMINAL IN THE FUTURE
C                          TERMINAL RECORDS.
C
C FTNETN          I        ITEM NUMBER FOR NET NUMBER OF THE
C                          FUTURE TERMINAL IN THE FUTURE TERMINAL
C                          RECORDS.
C
C FTORDN          I        ITEM NUMBER FOR FUTURE TERMINAL ORDINATE IN
C                          THE FUTURE TERMINAL RECORDS.
C
C LINLIN          I        SUBSCRIPT FOR LINE-TO-LINE CLEARANCE IN
C                          SPACING TABLE.
C
C NEXTCO          I        NEXT CONNECTION VALUE FOR ACCESS TO MODULE
C                          GTCSTR 2719.
C
C NIL             I        CONSTANT TO MARK END OF LIST.
C PRESCR          I        PREDECESSOR VALUE FOR ACCESS TO MODULE
C                          GTCSTR 2719.
C
C SUCSCR          I        SUCCESSOR VALUE FOR ACCESS TO MODULE GTCSTR
C                          2719.
C
C TKDPAL          I        CONTROL CONSTANT USED TO DUMP ALL TRACK
C                          ASSIGNMENT LABLED COMMON BLOCKS.
C
C TKDPBD          I        CONTROL CONSTANT USED TO ACCESS LABLED
C                          COMMON /TKBORD/ FOR DATA DUMPING.
C
C TKDPBF          I        CONTROL CONSTANT USED TO ACCESS LABLED
C                          COMMON /TKBUFR/ FOR DATA DUMPING.
C
C TKDPCH          I        CONTROL CONSTANT USED TO ACCESS LABLED
C                          COMMON /TKCHAN/ FOR DATA DUMPING.
C
C TKDPCN          I        CONTROL CONSTANT USED TO ACCESS LABLED
C                          COMMON /TKCONN/ FOR DATA DUMPING.
C
C TKDPCO          I        CONTROL CONSTANT USED TO ACCESS LABLED
C                          COMMON /TKCNST/ FOR DATA DUMPING.
C
C TKDPIN          I        CONTROL CONSTANT USED TO ACCESS LABLED
C                          COMMON /TKINST/ FOR DATA DUMPING.
C
C TKDPST          I        CONTROL CONSTANT USED TO ACCESS LABLED
```

```
C                       COMMON /TKSTAT/ FOR DATA DUMPING.
C
C   TKLPTK      I       CONTROL CONSTANT USED TO ACCESS LABLED
C                       COMMON /TKTRAK/ FOR DATA DUMPING.
C
C   TKDPTM      I       CONTROL CONSTANT USED TO ACCESS LABLED
C                       COMMON /TKTERM/ FOR DATA DUMPING.
C
C   TMABSC      I       ITEM NUMBER FOR ABSCISSA IN TERMINAL RECORDS.
C   TMCHN2      I       ITEM NUMBER FOR SECOND CHANNEL NUMBER IN
C                       TERMINAL RECORDS.
C
C   TMCCNN      I       ITEM NUMBER FOR CONNECTION NUMBER IN TERMINAL
C                       RECORDS.
C
C   TMCCN2      I       ITEM NUMBER FOR SECOND CONNECTION NUMBER IN
C                       TERMINAL RECORDS.
C
C   TMDENS      I       ITEM NUMBER FOR CHANNEL DENSITY TO THE RIGHT
C                       OF THE TERMINAL.
C
C   TMDGLG      I       ITEM NUMBER FOR DOGLEG FLAG IN TERMINAL RECORDS.
C   TMLAYR      I       ITEM NUMBER FOR LAYER IN TERMINAL RECORDS.
C   TMLEFT      I       ITEM NUMBER FOR LEFT POINTER LINK IN
C                       TERMINAL RECORDS.
C
C   TMNETN      I       ITEM NUMBER FOR NET NUMBER IN TERMINAL RECORDS.
C   TMCRDN      I       ITEM NUMBER FOR CRDINATE IN TERMINAL RECORDS.
C   TMRIPT      I       ITEM NUMBER FOR RIGHT POINTER LINK IN
C                       TERMINAL RECORDS.
C
C   TOPFLG      I       TOP FLAG VALUE FOR SIDE PREFERENCE.
C   TRKFIR      I       SUBSCRIPT FOR FIRST CONNECTION POINTER
C                       IN TRACK MATRIX.
C
C   TRKLST      I       SUBSCRIPT FOR LAST CONNECTION POINTER IN
C                       TRACK MATRIX.
C
C   TRKCRD      I       SUBSCRIPT FOR TRACK CRDINATE IN TRACK MATRIX.
C   TYBARR      I       CONSTANT VALUE OF CONNECTION TYPE - BARRIER
C   TYWIRE      I       CONSTANT VALUE OF CONNECTION TYPE - WIRE
C   TYCHIN      I       CONSTANT VALUE OF CONNECTION TYPE - CHANNEL
C                       INTERSECTION
C
C   VIABAR      I       SUBSCRIPT FOR VIA-TO-BARRIER CLEARANCE IN
C                       SPACING TABLE.
C
C   VIALIN      I       SUBSCRIPT FOR VIA-TO-LINE CLEARANCE IN
C                       SPACING TABLE.
C
C   VIAVIA      I       SUBSCRIPT FOR VIA-TO-VIA CLEARANCE IN
C                       SPACING TABLE.
C
C   VSCSTR      I       VIA SPACING CONSTRAINT VALUE FOR ACCESS
C                       TO MODULE 2719 G1CSTR
C
C   WRCRIT      I       CONSTANT FOR CRITICAL WIRING RULE.
C   WRHPYL      I       CONSTANT FOR HIGHLY PREFERRED Y CONNECTION
C                       ON LEFT SIDE OF CHANNEL.
C
C   WRHPYR      I       CONSTANT FOR HIGHLY PREFERRED Y CONNECTION
C                       ON RIGHT SIDE OF CHANNEL.
C
C   WRNORM      I       CONSTANT FOR NORMAL WIRING RULE.
C   WRPREW      I       WIRING RULE FOR PREDEFINED WIRING.
C   WRPRYL      I       CONSTANT FOR PREFERRED Y CONNECTION ON THE
C                       LEFT SIDE OF THE CHANNEL.
C
C   WRPRYR      I       CONSTANT FOR PREFERRED Y CONNECTION ON
C                       RIGHT SIDE OF THE CHANNEL.
C
```

```
C
C$F
C$ TKCLNN
C                     *****************
C                     * COMMON TKCLNN *
C                     *****************
C
C        CONTAINS TRACK ASSIGNMENT CONNECTION DATA.
C
C NAME   DIMENSION TYPE  DESCRIPTION
C
C CONPRI (2,CONNMX) I    INDIRECT LOCK-UP TABLE FOR CONNECTIONS
C                        NUMBERS SORTED BY PRIORITIES.
C
C CONNMX            I    MAXIMUM CAPACITY OF CONECT ARRAY (BELOW).
C                        INITIALIZED IN TRSCLD.
C
C CNSTRN (CSTRMX)   I    PACKED DATA FOR THE VERTICAL CONSTRAINT BUFFERS.
C                        FIRST N FIELD IS CONNECTION NUMBER
C                        AND SECOND N FIELD IS NEXT CONSTRAINT POINTER.
C
C CONECT (12,CONNMX)I    CONNECTION RECORD CORRESPONDING TO A SINGLE
C                        TRUNK SECTION TO BE PLACED (OR PREVIOUSLY
C                        PLACED).
C
C CONINX (2,3)      I    START AND STOP CONNECTION INDICES FOR THREE
C                        PRIORITY LEVELS.
C                        CONINX(1,1) = START CONNECTION INDEX, TOP
C                                      OF CHANNEL PREFERENCE
C                        CONINX(2,1) = STOP CONNECTION INDEX, TOP
C                                      OF CHANNEL PREFERENCE
C                        CONINX(2,2) = START CONNECTION INDEX, WITH NO
C                                      SIDE PREFERENCE
C                        CONINX(1,3) = START CONNECTION INDEX, WITH
C                                      BOTTOM OF CHANNEL PREFERENCE
C                        CONINX(2,3) = STOP CONNECTION INDEX, WITH
C                                      BOTTOM OF CHANNEL PREFERENCE
C
C CSTPFR            I    CONSTRAINT RECORD FREE LIST POINTER.
C
C CSTRMX            I    MAXIMUM CAPACITY OF *CNSTRN* ARRAY.
C                        INITIALIZED IN MODULE TRSCLD.
C
C$E
C$ TKINST
C                     *****************
C                     * COMMON TKINST *
C                     *****************
C
C        CONTAINS INSTRUMENTATION FOR THE TRACK ASSIGNMENT SUBSYSTEM
C
C        REVISION HISTORY --
C           06-NOV-84  CDC ADDED ONEPIN (SAR 3631).
C                          DELETED TOTVIA (SAR3775).
C
C NAME   DIMENSION TYPE  DESCRIPTION
C
C BCHWTR            I    TOTAL BRANCH ORIENTATION ROUTED WIRE LENGTH
C
C BTRUNK            I    TOTAL TRUNK LENGTH ROUTED ON BRANCH LAYER.
C
C FAILGH            I    TOTAL CONNECTION LENGTH OF FAILED CONNECTIONS.
C
C FAILCT (10)       I    NUMBER OF FAILURES OF EACH TYPE
C                        FAILCT(1) = UNABLE TO DOGLEG
C                        FAILCT(2) = PREDECESSOR BELOW CONNECTION
C                        FAILCT(3) = SUCCESSOR ABOVE CONNECTION
C                        FAILCT(4) = INSUFFICIENT TRACKAGE IN CHANNEL
C                        FAILCT(5) = TERMINALS TOO CLOSE ON CHANNEL
C                                    PERIMETER
C
C HWCONN            I    HIGH WATER MARK FOR CONNECTION RECORD USAGE
C
C HWCSTR            I    HIGH WATER MARK FOR CONSTRAINT RECORD USAGE.
C
C HWFUTR            I    HIGH WATER MARK FOR FUTURE TERMINAL RECORD USAGE
C
C HWTERM            I    HIGH WATER MARK FOR TERMINAL RECORD USAGE.
C
C HWTRAK            I    HIGH WATER MARK FOR TRACK RECORD USAGE.
C
C INPUTM            I    TIME FOR INPUT PHASE (USFIL INPUT)
```

```
_$1$DUA6:[PRC.TRS02]TRSPTB.DOC;3                    21-OCT-1986 09:02                    PAGE 6
C
C INVCKR (50)        I    NUMBER OF INVOCATIONS OF EACH MODULE IN
C                         SUBSYSTEM
C
C INTHNX             I    MAXIMUM CONSTRAINT CHAIN LENGTH FOUND
C LOOPCT             I    NUMBER OF CONSTRAINT LOOPS FOUND
C CNFPIN             I    NUMBER OF ONE-TERMINAL CONNECTIONS
C OUTPTM             I    TIME FOR OUTPUT TO TEMPORARY FILES
C RTDCCN             I    TOTAL ROUTED CONNECTION LENGTH.
C SETETM             I    TOTAL TIME SO FAR ON SET UP
C TOTCCN             I    TOTAL CONNECTION LENGTH (ROUTED AND FAILED)
C TOTLTM             I    TOTAL RUN TIME SO FAR
C TRAKTM             I    TOTAL TIME SPENT IN TRACK ASSIGNMENT
C TRKWIR             I    TOTAL ROUTED WIRE LENGTH WITH TRUNK ORIENTATION.
C UPDATM             I    TIME TO UPDATE DESIGN FILE
CSE
CS TKSTAT
C                 *****************
C                 * COMMON TKSTAT *
C                 *****************
C
C      CONTAINS TRACK ASSIGNMENT STATUS DATA.
C
C      REVISION HISTORY --
C        18-DEC-85 DDC ADDED *MININX*/*MAXINX* FOR EXTENSION OF
C                      CHANNEL TO COVER WIDE WIRES.  (SAR 5463)
C        10-DEC-85 DDC ADDED *MN/MXAHPG* FOR TRUNCATION OF CHANNEL
C                      AT CHANNEL OUTPUT.  (SAR 5424)
C        01-OCT-85 DDC ADDED TRNKLY, BRCHLY, LSTCHN.  (SAR 5197)
C        02-APR-85 DDC FOR STC: ADDED WIRULE, MINTCF, MAXBOT,
C                      MNTPPR, MXBTPR, UNASND, AND FALASN. (SAR 4219)
C
C NAME   DIMENSION TYPE  DESCRIPTION
C
C BARRIT             I   USED TO MARK IF A BARRIER IS HIT DURING A
C                        SCAN OF A TRACK.
C                        NIL = NO BARRIER HIT
C                        1   = BARRIER HIT IN LAST TRACK
C
C BOTSCN             I   BOTTOM SIDE OF CHANNEL SCAN DIRECTION FOR
C                        TRACK ASSIGNMENT.
C                        0 = LEFT-TO-RIGHT SCAN
C                        1 = RIGHT-TO-LEFT SCAN
C
C BOTTRK             I   CURRENT TRACK INDEX VALUE FOR THE BOTTOM
C                        SIDE OF THE CHANNEL.
C
C BRCHLY             I   LAYER OF BRANCHES IN CURRENT CHANNEL.
C
C BRCHOR             I   ORIENTATION OF BRANCHES IN CURRENT CHANNEL.
C
C CHAFER             I   INDICATES WHEN A FATAL ERROR IS DISCOVERED
C                        DURING TRACK ASSIGNMENT.  CAN CONTINUE
C                        TRACK ASSIGNMENT BUT ON NEXT CHANNEL.
C                        0 = NO ERROR DISCOVERED
C                        1 = FATAL CHANNEL ERROR
C
C CHANIX             I   CHANNEL INDEX VALUE
C
C CONNIX             I   CONNECTION INDEX VALUE
C
C CSTRIX             I   CONSTRAINT BUFFER INDEX VALUE.
C
C FALASN             I   COUNT OF CONNECTIONS WHICH HAVE FAILED
C                        ASSIGNMENT DURING TRACK ASSIGNMENT FOR
C                        THE CURRENT CHANNEL.
C
C LSTCHN             I   LAST CHANNEL ROUTED BY *TRKASN* 2705.
C
C LSTCCN             I   VALUE OF THE LAST CONNECTION NUMBER USED
C                        IN THE CALL TO *GTCSTR* 2719.
```

```
C
C LSTPSF      I     VALUE OF THE LAST PREDECESSOR/SUCCESSOR
C                   FLAG.
C
C MAXABS      I     LARGEST ABSCISSA IN CURRENT CHANNEL
C
C MAXBCT      I     TRACK NUMBER OF THE HIGHEST BOTTOM TRACK
C                   BEYOND WHICH THE CHANNEL CANNOT BE SQUEEZED.
C
C MAXDEN      I     LARGEST CHANNEL DENSITY IN TRACKS.
C
C MAXINX      I     INDEX INTO THE TERMINAL ARRAY OF THE RIGHTMOST
C                   POWER/GROUND TERMINAL IN THE CHANNEL.
C
C MAXORD      I     LARGEST ORDINATE IN CURRENT CHANNEL.
C
C MINABS      I     SMALLEST ABSCISSA IN CURRENT CHANNEL.
C
C MININX      I     INDEX INTO THE TERMINAL ARRAY TO THE LEFTMOST
C                   POWER/GROUND TERMINAL IN THE CHANNEL.
C
C MINORD      I     SMALLEST ORDINATE IN CURRENT CHANNEL.
C
C MINTOP      I     TRACK NUMBER OF THE LOWEST TOP TRACK ABOVE
C                   WHICH THE CHANNEL CANNOT BE SQUEEZED.
C
C MNABPG      I     LEFTMOST ABSCISSA OF A POWER/GROUND TERMINAL
C                   IN THE CURRENT CHANNEL.
C
C MNTBRR      I     LOWEST ORDINATE OF BARRIERS FROM THE TOP OF
C                   THE CURRENT CHANNEL.
C
C MXABPG      I     RIGHTMOST ABSCISSA OF A POWER/GROUND TERMINAL
C                   IN THE CURRENT CHANNEL.
C
C MXBTBR      I     HIGHEST ORDINATE OF BARRIERS FROM THE BOTTOM
C                   OF THE CURRENT CHANNEL (EXCEPT FOR THOSE
C                   WHICH CROSS THE CHANNEL).
C
C NMCHAN      I     NUMBER OF CHANNELS IN CURRENT PROBLEM
C
C NMCCON      I     NUMBER OF CONNECTION RECORDS CURRENTLY BEING
C                   USED.
C
C NMCSTR      I     NUMBER OF CONSTRAINT BUFFERS IN CURRENT
C                   PROBLEM.
C
C NMFUTR      I     NUMBER OF FUTURE TERMINALS.
C
C NMTERM      I     NUMBER OF TERMINALS.
C
C NMTRAK      I     NUMBER OF TRACKS IN CURRENT CHANNEL
C
C NXTPRF      I     NEXT PREDECESSOR CONSTRAINT RECORD.
C
C NXTSUC      I     NEXT SUCCESSOR CONSTRAINT RECORD.
C
C NXTVSP      I     NEXT VIA SPACING CONSTRAINT RECORD
C
C SCNDIR      I     CURRENT TRACK PACKING SCAN DIRECTION.
C
C TRMFLG      I     SIDE OF CHANNEL WHERE TRUNKS ARE NEXT TO BE
C                   PLACED.
C                    0 =  TOP
C                    1 =  BOTTOM
C
C TERMIX      I     TERMINAL RECORD INDEX NUMBER.
C
C TOPSCN      I     TOP SIDE OF CHANNEL TRACK PACKING SCAN
C                   DIRECTION.
C                   0 = LEFT-TO-RIGHT SCAN
C                   1 = RIGHT-TO-LEFT SCAN
C
C TOPTRK      I     CURRENT TRACK INDEX FOR THE TOP SIDE OF THE
C                   CHANNEL.
C
C TRAKIX      I     TRACK INDEX VALUE
C
C TRNKLY      I     LAYER OF TRUNKS IN CURRENT CHANNEL.
C
C TRNKOR      I     ORIENTATION OF TRUNKS IN CURRENT CHANNEL.
C
```

```
C UNASND            I    COUNT OF CONNECTIONS WHICH HAVE YET TO BE
C                        ASSIGNED FOR THE CURRENT CHANNEL.
C
C WIRULE            I    INDEX OF THE CURRENT WIRE RULE.
C
CS$
CS TKTERM
C                    *****************
C                    * COMMON TKTERM *
C                    *****************
C
C        CONTAINS TRACK ASSIGNMENT TERMINAL DATA
C
C        REVISION HISTORY --
C           18-SEP-85 DLC REMOVED *EUTERM* ARRAY.  (SAR 5197)
C           02-APR-85 DLC FOR STC: EQUIVALENCED THE TERMINAL
C                         ARRAY *TERMAL* TO *TRMXXX* AND TERMMX
C                         TO XTRMMX IN /CMXXXX/.  (SAR 4219)
C
C NAME   DIMENSION TYPE  DESCRIPTION
C
C TERMAL (*,*)       I    TERMINAL DATA ARRAY.
C (11,$TERMINALS)
C
C TRMLST (2)         I    POINTER TO FIRST AND LAST TERMINAL RECORD
C                         IN THE TERMINAL LIST.
C
C TERMMX             I    MAXIMUM NUMBER OF TERMINAL RECORDS.
C
CS$
CS TKTRAK
C                    *****************
C                    * COMMON TKTRAK *
C                    *****************
C
C        CONTAINS TRACK ASSIGNMENT TRACK DATA
C
C NAME   DIMENSION TYPE  DESCRIPTION
C
C TRACK  (*,*)       I    TRACK DATA MATRIX, WHERE SUBSCRIPT:
C (3,$TRACKS)             1. POINTER TO FIRST CONNECTION RECORD IN EACH
C                            TRACK (ZERO IS NONE).
C                         2. POINTER TO LAST CONNECTION RECORD IN EACH
C                            TRACK (ZERO IS NONE).
C                         3. ORDINATE OF TRACK.
C
C TRAKMX             I    MAXIMUM NUMBER OF TRACKS ALLOWABLE (DIMENSION
C                         OF TRACK ARRAY
CS$
CS TRKASN2705CM  (IRS MACRO, COMMON CM2705)
CS* CM2705
CSE
                                    TRKASN2705CM
```

```
TTTTTTTTTT   DIGITAL EQUIPMENT CORPORATION - VAX/VMS VERSION V4.4   TTTTTTTTTT

FILE _S1$DUA6:[PRD.CHX02]CHX.DOC;2 (1069,1,2), LAST REVISED ON 21-OCT-1986 08:44, IS A 81 BLOCK SEQUENTIAL FILE OWNED BY UIC
[PRD1S1,PFC]. THE RECORDS ARE VARIABLE LENGTH WITH IMPLIED (CR) CARRIAGE CONTROL. THE LONGEST RECORD IS 74 BYTES.

JOB CHX (204) QUEUED TO SYS$PRINT ON 4-DEC-1986 12:50 BY USER KMP, UIC [ENGVLSI,KMP], UNDER ACCOUNT ENGPKG AT PRIORITY 3, STARTED
ON PRINTER _JONTCSIFAO: ON 4-DEC-1986 13:27 FROM QUEUE SYS$PRINT.

TTTTTTTTTT   DIGITAL EQUIPMENT CORPORATION - VAX/VMS VERSION V4.4   TTTTTTTTTT

VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
```

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
DIGITAL EQUIPMENT CORPORATION - VAX/VMS VERSION V4.4

FILE _$1$DUA6:[PPC.CHXC2]CHX.DOC;2 (1069,1,2), LAST REVISED ON 21-OCT-1986 08:44, IS A 81 BLOCK SEQUENTIAL FILE OWNED BY UIC
[PROTEI,PFC]. THE RECORDS ARE VARIABLE LENGTH WITH IMPLIED (CR) CARRIAGE CONTROL. THE LONGEST RECORD IS 74 BYTES.

JOB CHX (204) QUEUED TO SYS$PRINT ON 4-DEC-1986 12:50 BY USER KMP, UIC [ENGVLSI,KMP], UNDER ACCOUNT ENGEKG AT PRIORITY 3, STARTED
ON PRINTER _TONIC$LPA0: ON 4-DEC-1986 13:27 FROM QUEUE SYS$PRINT.

DIGITAL EQUIPMENT CORPORATION - VAX/VMS VERSION V4.4
```

```
**********************************
**********************************
**                              **
** CHX SUBSYSTEM DOCUMENTATION  **
**                              **
**********************************
**********************************

**************************************************************
**************************************************************
**                                                          **
**   (C) COPYRIGHT V-R INFORMATION SYSTEMS, INC. 1985       **
**   LICENSED MATERIAL -- PROGRAM PROPERTY OF VRIS          **
**   ALL RIGHTS RESERVED                                    **
**                                                          **
**   THIS PROGRAM IS THE PROPERTY OF VRIS AND IS FURNISHED  **
**   PURSUANT TO A WRITTEN LICENSE AGREEMENT. IT MAY NOT BE **
**   USED, REPRODUCED, OR DISCLOSED TO OTHERS EXCEPT IN     **
**   ACCORDANCE WITH THE TERMS AND CONDITIONS OF THAT       **
**   AGREEMENT.                                             **
**                                                          **
**************************************************************
**************************************************************
```

RECENT REVISION HISTORY
-----------------------

```
26-FEB-86 DDC ADDED TOKEN TO DOC.  (SAR 5523)
10-DEC-85 DDC ADDED GETCEL ROUTINE. (SAR 5424)
21-NOV-85 DDC ADDED EXPLANATION OF CHXPOP(5) OPTIONS.  (SAR 5355)
06-NOV-85 DDC CORRECTED CHXPOP(5) OPTIONS.  (SAR 5325)
02-OCT-85 DDC ADDED MOVPGC AND CHNRST ROUTINES.  MOVED
              CALL TO CHXCTR. ADDED CHXPOP(6). (SAR 5199)
18-JAN-85 KMF WROTE DOCUMENTATION FOR THE CHANNEL
              EXPANSION SUBSYSTEM (CHX).
```

```
***********************
* SUBSYSTEM OVERVIEW *
***********************
```

THE CHANNEL EXPANSION SUBSYSTEM (CHX) IS A UTILITY WHICH IS INVOKED BY ANOTHER ("MASTER") SUBSYSTEM TO EXPAND THE WIDTHS OF CHANNELS.

THE UTILITY CONSISTS OF A NUMBER OF MODULES WHICH MAY BE BROADLY DIVIDED INTO THREE CATEGORIES:

- FILE I/O MODULES
- "MASTER" SUBSYSTEM INTERFACE MODULES
- EXPANSION MODULE

THE FILE INPUT ROUTINES LOAD THE CHX INTERNAL DATA STRUCTURES FROM THE INPUT DESIGN FILE AND OTHER ANSILLARY FILES, SETTING THE STAGE FOR EXPANDING THE CHANNELS WHEN CALLED UPON TO DO SO BY THE "MASTER" SUBSYSTEM.

THE "MASTER" SUBSYSTEM INPUT INTERFACE MODULE, EXTRACTS DATA FROM THE GLOBAL DATA STRUCTURES FROM *CHX* AND PASSES IT TO THE "MASTER" SUBSYSTEM FOR PROCESSING. WHEN THIS PROCESSING IS COMPLETED, THE "MASTER" SUBSYSTEM OUTPUT INTERFACE MODULE IS INVOKED TO TRANSFER THE PROCESSED DATA BACK INTO THE *CHX* DATA STRUCTURES.

AT THIS STAGE, THE CHANNEL WIDTH IS EXPANDED BY AN AMOUNT SPECIFIED BY THE "MASTER" SUBSYSTEM, ADJUSTING THE POSITIONS AND SIZES OF ALL NECESSARY ENTITIES.

WHEN ALL CHANNEL EXPANSION IS COMPLETED, THE FILE OUTPUT ROUTINE CREATES AN UPDATED DESIGN FILE REFLECTING THE POSITIONS OF THE CELLS AND CHANNELS AFTER EXPANSION.

PROBLEM OVERVIEW
----------------

GIVEN A SET OF CELLS, A SET OF CHANNELS, AND A SET OF PRE-WIRED INTERCONNECTIONS, THE TASK OF THE CHANNEL EXPANSION SUBSYSTEM IS TO EXPAND CHANNELS AS SPECIFIED BY THE "MASTER" SUBSYSTEM WHILE MAINTAINING CONNECTIVITY OF PREVIOUSLY ROUTED INTERCONNECTIONS.

HOW TO USE THIS SYSTEM
----------------------

THE CHANNEL EXPANSION SUBSYSTEM (CHX) IS USED DURING THE INTERCONNECTION ROUTING PHASE OF THE LAYOUT PROCESS, WHICH IS INVOKED AFTER ALL PLACEMENT TASKS HAVE BEEN COMPLETED.

THE FOLLOWING DATA IS REQUIRED FOR *CHX* TO FUNCTION.

- AN INPUT DESIGN FILE CONTAINING CHANNEL DESCRIPTIONS (RCH RECORDS) WHICH SPECIFY THE POSITIONS OF THE CHANNELS AND THE "FEEDING" RELATIONSHIPS AMONG THEM. THE CHANNEL DESCRIPTIONS ARE GENERATED BY THE CHANNEL DEFINITION SUBSYSTEM (CHD) WHICH MUST HAVE PREVIOUSLY BEEN INVOKED.
- AN INPUT FILE DESCRIBING WHICH CELLS ARE ADJACENT TO THE MAJOR AXIS OF EACH CHANNEL. THIS DATA IS ALSO PRODUCED DURING CHANNEL DEFINITION (CHD).

SUMMARY OF SOFTWARE EXTERNAL BEHAVIOR
-------------------------------------

THE CHANNEL EXPANSION SUBSYSTEM (CHX) IS A "SERVICE DELIVERY" (OR "SLAVE") SUBSYSTEM. THEREFORE, THE "MASTER" SUBSYSTEM (ANY SUBSYSTEM WHICH LINKS IN *CHX*) HAS THE RESPONSIBILITY OF INITIALIZING THE FOLLOWING GLOBAL DATA:

- SYSCOMMON VARIABLES
- PROCESSING OPTIONS AND TRACE VARIABLE SETTINGS
- DESIGN FILE ACCESS VARIABLES

THE ABOVE SHOULD BE ACCOMPLISHED BY INSERTING THE FOLLOWING FORTRAN STATEMENTS INTO THE MAIN PROGRAM OF THE "MASTER" SUBSYSTEM.

```
            CALL SYSCLD
      CS*   SUBSYSSETOPT ["MASTER SUBSYSTEM"] ["CLOCK"]
      CS*   SUBSYSSETOPT [CHX] ["CLOCK"]
            CALL DEACLD
```

--INPUTS--
AN UNROUTED DESIGN FILE WHICH MAY CONTAIN PREWIRED CONNECTIONS, A FILE CONTAINING A LIST OF TERMINALS SORTED BY CHANNEL SEQUENCE NUMBER, A FILE CONTAINING A LIST OF CELLS-ON-CHANNEL FOR THE LOW AND HIGH SIDES OF EACH CHANNEL, AND A CONTROL FILE CONTAINING PROCESSING OPTION AND TRACE LEVEL SETTINGS.

--OUTPUTS--
UPDATED VERSION OF DESIGN FILE WITH NEWLY CREATED RWS RECORDS, REFLECTING FINAL BOARD SIZE AND PLACEMENT OF CHANNELS AND CELLS AND ALL CELL-RELATED ENTITIES ON THE BOARD, AND A REPORT FILE CONTAINING SUMMARY INFORMATION, TRACE MESSAGES AND ANY RESULTING DIAGNOSTICS.

--ASSUMPTIONS AND CONSTRAINTS--

1. THE ORIGIN OF THE CARRIER IS ASSUMED TO BE AT (0,0).
2. THE INPUT DESIGN FILE WILL CONTAIN ABSOLUTE COORDINATES (W.R.T. CARRIER ORIGIN) FOR DESCRIBING THE FOLLOWING:
   - CHANNELS
   - CELLS
   - NODES
   - DEVICE-ASSOCIATED BARRIERS
   - WIRE SEGMENTS

```
3. THE CHANNEL SEQUENCE ORDER IS DEFINED IN SUCH A WAY
   THAT THE EXPANSION (OR CONTRACTION) OF A CHANNEL WILL
   NOT INVALIDATE THE CONNECTIONS ROUTED IN AN EARLIER
   CHANNEL.

--PERFORMANCE GOALS--
(NOT ESTABLISHED.)

OVERVIEW OF TECHNIQUES INVOLVED
-------------------------------

***************************
* SUBSYSTEM ORGANIZATION *
***************************

PROCESSING FLOW
---------------

THE FOLLOWING IS THE FUNDAMENTAL PROCESSING FLOW OF THE
CHANNEL EXPANSION SUBSYSTEM WITHIN THE MASTER DRIVER.

CHANNEL EXPANSION HIGH LEVEL PSEUDO CODE:

BEGIN

  INITIALIZE GLOBAL DATA

  INPUT DESIGN FILE

  FOR (EVERY CHANNEL /* IN A PREDEFINED ORDER */ ) DO

    INITIALIZE CHANNEL DATA INCLUDING TERMINAL POSITIONS.

    (HERE, THE MASTER SUBSYSTEM PROCESSES THE CHANNEL.
     AND IF THE CHANNEL IS THE LAST IN A CYCLE WHICH
     HAD FAILURES, THE DESIGN IS RESET TO THE BEGINNING
     OF THE FIRST CHANNEL IN THE CYCLE.)

    OUTPUT NEW CHANNEL INFORMATION, EXPANDING CHANNEL
      IF NECESSARY.

  ENDFOR /* EVERY CHANNEL */

  UPDATE DESIGN FILE WITH NEW ROUTING AND SIZE
    INFORMATION.

END


SOFTWARE STRUCTURE
------------------

**********        **********
* MASTER *-------* SYSCLD *
* SUBSYS *   I   *  0052  *
**********   I   **********
             I
             I   **********   XXXXXXXXX
             I--* GETCPT *<--XCONTROLX
             I   *  0104  *   X  FILE X
             I   **********   XXXXXXXXX
             I
             I   **********
             I--* DEACLD *
             I   *  0109  *
             I   **********
             .
             .
             I   **********
             I--* CHXCLD *
             I   *  2625  *
             I   **********
             I
             .
             I   **********
```

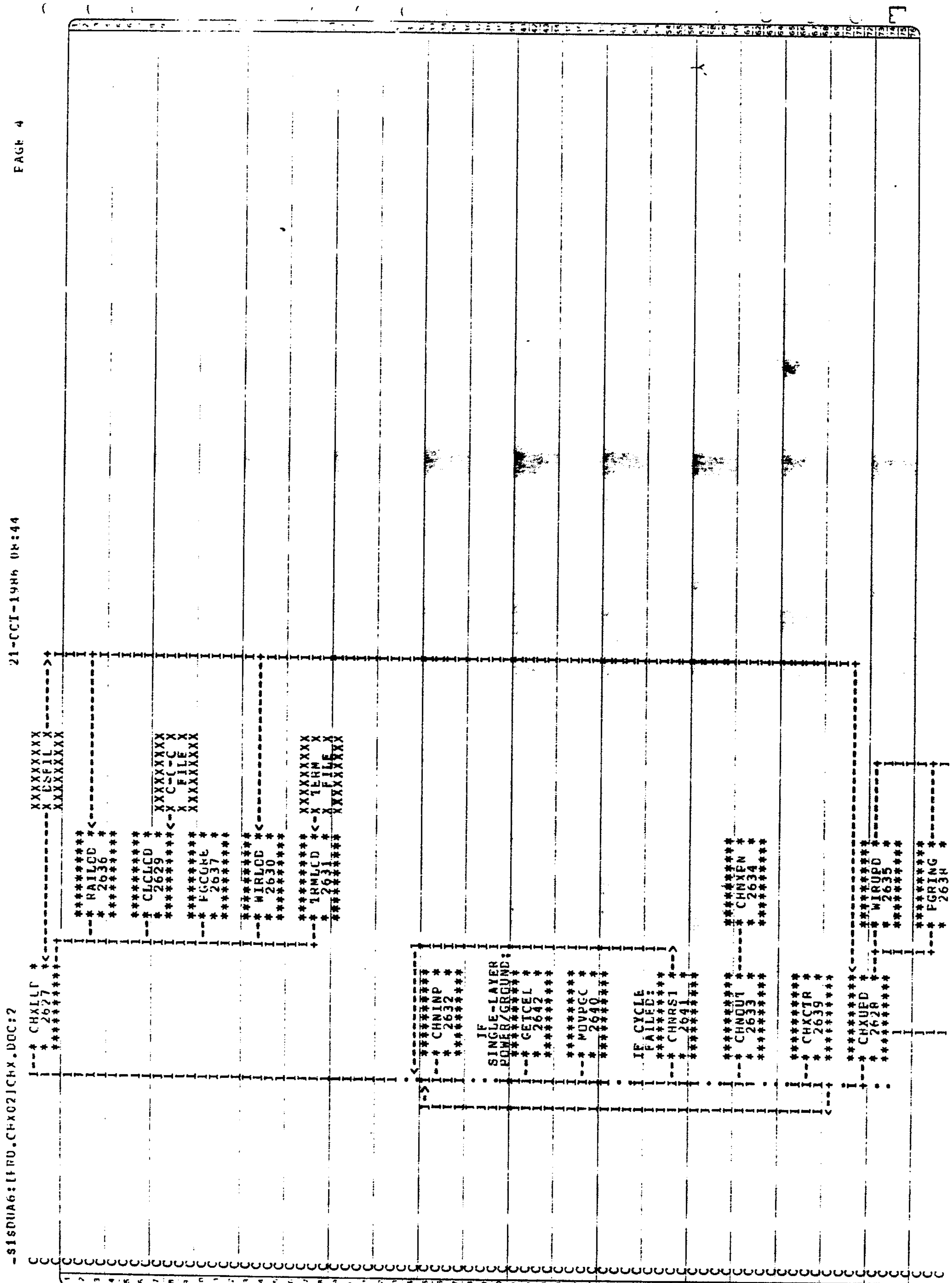
$1$DUA6:[FRD.CHX02]CHX.DOC:2
21-OCT-1986 08:44
PAGE 4
CHXLLD 2627
CSFIL
RAILCD 2636
CLCLCD 2629
C-C-C FILE
FGCORE 2637
WIRLCD 2630
TRMLCD 2631
TERM FILE
CHNINP 2632
IF SINGLE-LAYER POWER/GROUND:
GETCEL 2642
MOVPGC 2640
IF CYCLE FAILED:
CHNRS1 2641
CHNOUT 2633
CHNXPN 2634
CHXCTR 2639
CHXUPD 2628
WIRUPD 2635
FGRING 2638

```
                I        **********      I
                I                        I
                I                        V
                I                    XXXXXXXXXX
                +------------------->X NDSFIL X
                                     XXXXXXXXXX
```

DATA STRUCTURES
---------------

BEFORE DESCRIBING THE DATA STRUCTURES USED IN THE CHANNEL EXPANSION SUBSYSTEM, IT IS APPROPRIATE TO INTRODUCE SOME OF THE TERMINOLOGY WHICH IS USED IN THIS SUBSYSTEM.

CHANNEL - A CHANNEL IS A RECTANGULAR REGION ON THE CARRIER IN WHICH TRACK ASSIGNMENT IS PERFORMED. EACH CHANNEL HAS A MAJOR AXIS OF ORIENTATION WHICH IS EITHER HORIZONTAL OR VERTICAL.

CHANNEL SIDES - THE TWO SIDES OF THE RECTANGULAR CHANNEL WHICH ARE PARALLEL TO THE MAJOR AXIS OF THE CHANNEL ARE CALLED THE SIDES OF THE CHANNEL.

```
                     +------ CHANNEL SIDE (HI)
                     I
                     V
        +--------------------------------+
        I                                I
        I                                I
        +--------------------------------+
                     A
                     I
                     +------ CHANNEL SIDE (LO)
```

CHANNEL ENDS - THE TWO SIDES OF THE RECTANGULAR CHANNEL WHICH ARE ORTHOGONAL TO THE MAJOR AXIS OF THE CHANNEL ARE CALLED THE CHANNEL ENDS.

```
      +------ CHANNEL END (LO)
      I
      I  +--------------------------------+
      +->I                                I
         I                                I<-+
         +--------------------------------+  I
                                             I
                       CHANNEL END (HI) -----+
```

CHANNEL EXPANSION - THE PROCESS BY WHICH THE WIDTH OF A CHANNEL IS INCREASED (OR DECREASED) WHILE MAINTAINING THE CONNECTIVITY OF INTERCONNECTIONS ALREADY ROUTED.

CELL - A CELL IS A RECTANGULAR OBJECT WHICH IS PLACED ON THE CARRIER. EACH CELL HAS FOUR SIDES, DESIGNATED THE "BOTTOM", "TOP", "LEFT", AND "RIGHT".

CELLS ARE PLACED SUCH THAT EACH SIDE OF A GIVEN CELL IS ADJACENT TO EITHER A CHANNEL OR ANOTHER CELL.

CELL-CHANNEL ADJACENCY - CELL-TO-CHANNEL ADJACENCY DEFINES THE TOPOLOGICAL RELATIONSHIP BETWEEN A CELL AND ITS ADJACENT CHANNELS.

CHANNEL-CELL ADJACENCY - CHANNEL-TO-CELL ADJACENCY DEFINES THE TOPOLOGICAL RELATIONSHIP BETWEEN A CHANNEL AND ALL CELLS WHICH ARE ADJACENT TO THE "SIDES" OF THE CHANNEL.

```
CHANNEL-CHANNEL ADJACENCY -
                  CHANNEL-TO-CHANNEL ADJACENCY DEFINES THE
                  TOPOLOGICAL RELATIONSHIP AMONG THE
                  VARIOUS CHANNELS. THE ENDS OF A GIVEN
                  CHANNEL WILL "FEED-INTO" OTHER CHANNELS,
                  WHILE THE SIDES OF A GIVEN CHANNEL
                  WILL BE "FED-BY" THE ENDS OF THER CHANNELS.

CELL-CELL ADJACENCY -
                  THE CELL-TO-CELL ADJACENCY DEFINES THE
                  TOPOLOGICAL RELATIONSHIP AMONG ALL CELLS
                  WHICH ARE ADJACENT TO A SINGLE SIDE OF
                  A CHANNEL.

THE ABOVE RELATIONSHIPS DESCRIBE THE TOPOLOGY OF THE ENTIRE
PLACEMENT AND THUS DEFINE THE CHANNELS AND CELLS WHICH ARE
AFFECTED WHEN A PARTICULAR CHANNEL IS EXPANDED.

CONNECTION -      A CONNECTION REPRESENTS A PORTION OF
                  AN INTERCONNECTION WHICH IS REALIZED
                  BY TRACK ASSIGNMENT WITHIN A PARTICULAR
                  CHANNEL. EACH CONNECTION (WITHIN A CHANNEL)
                  RESULTS IN ONE OR MORE "TRUNKS" WITHIN
                  THE CHANNEL.

TERMINAL -        A TERMINAL REPRESENTS A POINT ON THE
                  PERIPHERY OF A CHANNEL WHICH MUST BE
                  CONNECTED TO A CORRESPONDING CONNECTION
                  BY MEANS OF A "BRANCH" WITHIN A CHANNEL.

NORMAL TERMINAL - A TERMINAL WHICH OCCURS ON THE SIDES
                  OF A CHANNEL AND REPRESENTS A NODE (OR
                  STUB ENDPOINT) OF A CELL IS CALLED A
                  NORMAL TERMINAL.

OUTGOING FUTURE TERMINAL -
                  A TERMINAL WHICH OCCURS ON THE ENDS OF THE
                  CHANNEL AND REPRESENTS A TRANSITION OF THE
                  CONNECTION FROM ONE CHANNEL TO ANOTHER
                  IS CALLED AN OUTGOING FUTURE TERMINAL.
                  EACH OUTGOING FUTURE TERMINAL MUST HAVE
                  A CORRESPONDING "INCOMING FUTURE TERMINAL"
                  IN THE SECOND CHANNEL.

INCOMING FUTURE TERMINAL -
                  A TERMINAL WHICH OCCURS ON THE SIDES OF A
                  CHANNEL AND CORRESPONDS TO AN OUTGOING
                  FUTURE TERMINAL IN ANOTHER CHANNEL IS
                  CALLED AN INCOMING FUTURE TERMINAL.

DOGLEG TERMINAL - A TERMINAL WHICH IS ADDED BY TRACK ASSIGNMENT
                  WHEN A CONNECTION IS ROUTED USING MORE THAN
                  ONE TRUNK.

WELL -            WHEN THE EDGE OF A CELL IS NOT COINCIDENT
                  WITH THE EDGE OF A CHANNEL, A WELL (OR
                  DEPRESSION) IS SAID TO EXIST ALONG THE
                  SIDE OF THE CHANNEL.

                  FOR A HORIZONTAL (VERTICAL) CHANNEL, A
                  "WELL" EXISTS BETWEEN A CELL ALONG THE
                  CHANNEL AND THE CHANNEL IF THE TOP/BOTTOM
                  (LEFT/RIGHT) EDGE OF THE CELL DOES NOT
                  COINCIDE WITH THE BOTTOM/TOP (RIGHT/LEFT)
                  EDGE OF THE CHANNEL BEACUSE OF UNEVEN
                  HEIGHT CELLS.

                  A "WELL" CAN ALSO EXIST FOR A VERTICAL
                  (HORIZONTAL) CHANNEL IF THE LENGTHS OF THE
                  CELL ROWS (COLUMNS) ARE NOT IDENTICAL.

                              KEY: W = WELL
```

```
                                         +++++++++     ---
                                         +       +
                   +++++++++     +++++++++       ++++++
                   +       +     +       +       +    +
                   + CELL  +++++++++ CELL + CELL + CELL+      "HI" SIDE
                   +       + CELL  +     +       +    +       CELLS
                   +       +++++++++     +       +    +
                   +++++++++       +++++++++     ++++++
                   :   W       W    :  W    +       + W  :
          ..........:...........:.........+++++++++.....:........

                        HORIZONTAL CHANNEL

          ..................................................

THE MAJOR DATA STRUCTURES IN *CHX* CONSIST OF THE FOLLOWING:

                   +--> POINTER TO FIRST CELL ADJACENT
                   I     TO THE "HI" SIDE OF THE CHANNEL
                   I
                   I         +---> POINTER TO FIRST CHANNEL
                   I         I      FEEDING INTO "HI" SIDE
                   I         I
                   I         I         +---> POINTER TO FIRST
                   I         I         I      TERMINAL OF CHANNEL
                   I         I         I      (INCOMING, OUTGOING,
                   I         I         I       AND NORMAL)
                   +-------------------------+
  CHANNEL FED<---  :      CHANNEL DATA       :---> CHANNEL FED
  BY LO END        :                         :     BY HI END
                   +-------------------------+
                   I         I         I
                   I         I         +---> POINTER TO FIRST
                   I         I                CONNECTION IN
                   I         I                CHANNEL
                   I         I
                   I         +---> POINTER TO FIRST CHANNEL
                   I                FEEDING INTO "LO" SIDE
                   I
                   +--> POINTER TO THE FIRST CELL ADJACENT
                         TO THE "LO" SIDE OF A CHANNEL


                 POINTER TO CHANNEL ADJACENT
                 TO TOP SIDE OF CELL
                   A
                   I
                   I         POINTER TO NEXT CELL ALONG
                   I         "LO" SIDE OF TOP CHANNEL
                   I           A
                   I           I
                   I           I
                +-------------------------+
POINTER TO CHAN <---:      CELL DATA          :---> POINTER TO CHAN
ADJACENT TO LEFT    :                         :     ADJACENT TO RGT
  SIDE OF CELL      :                         :     SIDE OF CELL
                    :                         :
POINTER TO NEXT <---:                         :---> POINTER TO NEXT
CELL ALONG "HI"     :                         :     CELL ALONG "LO"
SIDE OF LEFT        :                         :     SIDE OF THE RGT
CHANNEL             +-------------------------+     CHANNEL
                   I           I
                   I           I
                   I           V
                   I         POINTER TO NEXT CELL ALONG
                             "HI" SIDE OF BOTTOM CHANNEL
```

```
_$1$DUA6:[PRD.CHXC?]CHX.DOC;2                 21-OCT-1986 08:44                        PAGE 8

                          V
                  POINTER TO CHANNEL ADJACENT
                  TO EDTION SIDE OF CELL


+------------------------+
+    CONNECTION DATA     +---> POINTER TO FIRST TERMINAL FOR
+------------------------+     THIS CONNECTION (WITH COUNT).
+    CONNECTION DATA     +     THE POINTER IS ONLY VALID
+------------------------+     IMMEDIATELY PRIOR TO DSFIL UPDATE
+    CONNECTION DATA     +
+------------------------+
+    CONNECTION DATA     +
+------------------------+
+    CONNECTION DATA     +        NOTE: CONNECTIONS ARE SORTED
+------------------------+        ----  BY CHANNEL NUMBER AND
+    CONNECTION DATA     +              CONNECTION NUMBER WITHIN
+------------------------+              THE CHANNEL
+    CONNECTION DATA     +
+------------------------+
+    CONNECTION DATA     +
+------------------------+
+    CONNECTION DATA     +
+------------------------+
+           .            +
+           .            +
+           .            +
+------------------------+
+    CONNECTION DATA     +
+------------------------+
+    CONNECTION DATA     +
+------------------------+


+-----------------------+
+    TERMINAL DATA      +       NOTE: INITIALLY, TERMINALS
+-----------------------+       ----  ARE ASSOCIATED WITH
+    TERMINAL DATA      +             CHANNELS. HOWEVER,
+-----------------------+             IMMEDIATELY PRIOR TO
+    TERMINAL DATA      +             DSFIL UPDATE, THEY ARE
+-----------------------+             ASSOCIATED WITH THE
+    TERMINAL DATA      +             CONNECTIONS WHICH IN
+-----------------------+             TURN ARE ASSOCIATED WITH
+    TERMINAL DATA      +             THE CHANNELS.
+-----------------------+
+    TERMINAL DATA      +             TERMINALS ARE SORTED BY
+-----------------------+             CHANNEL AND THEN TYPE.
+           .           +             (TYPE=INCOMING FUTURE,
+           .           +                   OUTGOING FUTURE,
+           .           +                   AND NORMAL)
+-----------------------+             DOGLEG TERMINALS ARE ADDED
+    TERMINAL DATA      +             AT THE END OF THE LIST.
+-----------------------+             THEN, PRIOR TO DSFIL
+    TERMINAL DATA      +             UPDATE, TERMINALS ARE
+-----------------------+             SORTED BY CHANNEL NUMBER
                                      AND CONNECTION NUMBER.


CONTROL AND TESTING PARAMETERS
------------------------------

--PROCESSING OPTIONS--

CHANNEL EXPANSION SUBSYSTEM PROCESSING OPTIONS ARE ADDED
TO THE MASTER SUBSYSTEM CONTROL FILE.

OPTION     STANDARD
NUMBER      VALUES    DESCRIPTION
---------  --------   ------------------------------------------
CHXPOF(2)             OPTION TO ALLOW THE TOP AND BOTTOM
                      ROW OF I/O CELLS TO SLIDE WITHIN THE
                      ORTHOGONAL ROWS OF I/O CELLS, OR
                      VICE VERSA.
             0*         DO NOT ALLOW CORNER OVERLAPPING.
             +N         SPECIFIES THE AMOUNT OF ALLOWED
```

```
C                               OVERLAP.
C
C       CHXPOP(3)               OPTION FOR AUTOMATIC GENERATION OF
C                               CORE AREA POWER/GROUND ROUTING.
C                       0         DO NOT GENERATE AUTOMATICALLY.
C                                 (I.E. THE CORE AREA POWER/GROUND
C                                 ROUTING HAS BEEN GENERATED EITHER
C                                 WITH THE GRAPHICS WIRE EDITOR OR
C                                 BY THE GLOBAL ROUTER.)
C                       1         GENERATE GLOBAL POWER/GROUND
C                                 ROUTES AUTOMATICALLY.  (NOTE -
C                                 THIS WILL WORK ONLY FOR STANDARD
C                                 DESIGNS.  SEE SUMMARY IN MODULE
C                                 S2637.)
C
C       CHXPOP(4)               OPTION FOR AUTOMATIC GENERATION OF
C                               POWER/GROUND RINGS OVER THE I/O CELLS.
C                       0         DO NOT GENERATE I/O RINGS.
C                                 (I.E. ANY ROUTES OUTSIDE THE CHANNEL
C                                 AREA WILL BE GENERATED AFTER THIS STEP.)
C                       1         GENERATE I/O RINGS.  (SEE SUMMARY IN
C                                 MODULE S2638.)
C
C       CHXPOP(5)               CONTROLS THE MODELING OF DEVICE BARRIERS.
C                       0         MODEL DEVICES WITH ALL-LAYER BARRIER
C                                 EQUAL TO THE BODY EXTENT OF THE DEVICE.
C                                 USE THIS OPTION ONLY IF ALL TERMINALS
C                                 ARE ON THE EDGE OF THE DEVICES, NOT
C                                 EMBEDDED INSIDE THE BODY EXTENT OF THE
C                                 DEVICE.  THIS OPTION CAN REDUCE CPU TIME.
C                       1*        MODEL ALL DEVICE-ASSOCIATED BARRIERS.
C                                 THIS OPTION MUST BE USED IF TERMINALS
C                                 APPEAR INSIDE THE BODY EXTENT OF A DEVICE
C                                 (OR IF OFF-GRID NODES ARE SNAPPED INSIDE
C                                 THE BODY EXTENT).
C
C       CHXPOP(6)               OPTION FOR SPREADING I/O CELLS EVENLY
C                               ALONG THE SIDES.
C                       0*        SPREAD I/OS.
C                       1         DO NOT SPREAD I/O'S
C
C       CHXPOP(11)              DEBUG REPORT CONTROLLER USED TO
C                               SPECIFY THE MODULE UNDER TEST.
C                               FOR USE BY VR SERVICE PERSONNEL
C                               ONLY.
C                       0*        NORMAL MODE OF OPERATION.
C                    NNNN         SPECIFIES MODULE NUMBER UNDER
C                                 TEST.
C
C
C       --TRACE LEVELS--
C
C       TRACE LEVEL PARAMETERS ARE ASSIGNED TO SUBSYSTEM MODULES
C       TO ENHANCE TESTING AND DEBUG OPERATIONS.  THE TRACE LEVELS
C       ARE READ INTO GLOBAL DATA STRUCTURES FROM A CONTROL
C       PARAMETER FILE.
C
C       MODULE     MODULE     TRACE
C        NAME      NUMBER     INDEX
C       ------     ------     -----
C
C       CHXCLD      2625        1
C       CHXDMP      2626        2
C       CHXLCD      2627        3
C       CHXUPD      2628        4
C       CLCLCD      2629        5
C       WIRLCD      2630        6
C       TPPLCD      2631        7
C       CHNINP      2632        8
C       CHNOU1      2633        9
C       CHNXPN      2634       10
C       WIRUPD      2635       11
C       RAILCD      2636       12
C       PGCORE      2637       13
C       PGRING      2638       14
C       CHXCTR      2639       15
C       MOVPGC      2640       16
C       CHNRS1      2641       17
C       GRIDFL      2642       18
C
C
```

```
--LOFILE ASSIGNMENTS--

LOFILE
NUMBER     USE

     4     RECORD FILE
NEWFIL     FORMAL PARAMETER TO CHXUPD, S2628.
DSFLIX     FORMAL PARAMETER TO CHXLOD, S2627.
             (DSFLIX MUST BE SAME VALUE AS CLLFIL,
             FORMAL PARAMETER TO CHXUPD, S2628).
     8     INPUT CONTROL FILE
    10     INPUT CELLS-ON-CHANNEL FILE
    12     INPUT TERMINAL FILE
    17     ERROR MESSAGE TEXT LIBRARY

--TIMER ASSIGNMENTS--

NONE

--MACROS OTHER THAN NAMED COMMONS--

NONE

********************************
* CONVERSION AND INSTALLATION *
********************************

DELIVERABLES
------------

1. SOURCE CODE LISTED BELOW, PLUS THE SUPPORT SUBSYSTEM
   MODULE LIBRARY, DESIGN FILE ACCESS SUBSYSTEM MODULE
   LIBRARY.

MODULE     MODULE
 NAME      NUMBER
--------   --------

CHXCLD      2625
CHXLMP      2626
CHXLOD      2627
CHXUPD      2628
CLCLCD      2629
WIRLCD      2630
TRMLCD      2631
CHNINP      2632
CHNOUT      2633
CHNXEN      2634
WIRUPD      2635
RAILCD      2636
PGCORE      2637
PGRING      2638
CHXCIR      2639
MLVECC      2640
CHKRST      2641
GETCHL      2642

3. THIS DOCUMENTATION, CHX.DOC, WITH CHXPT5.DOC
   AND CHXE16.DOC.

4. MACRO LIBRARIES NECESSARY FOR SOURCE EXPANSION.

   SSN.MAC
   DFA.MAC
   CHX.MAC

INSTALLATION TESTS
------------------
TEST WITH MASTER SUBSYSTEM (TRS) INSTALLATION TEST.

SUGGESTED OVERLAY STRUCTURE
---------------------------
NONE

TRANSFERABILITY NOTES
---------------------
```

```
C       REGRESSION TESTING
C       ------------------
C       TEST IN CONJUNCTION WITH THE MASTER DRIVER SUBSYSTEM.
C       CHXDMP (2626) CAN BE USED IN CONJUNCTION WITH CHXPEP(11)
C       TO DUMP ANY OF THE NAMED COMMON DATA STRUCTURES TO THE
C       REPORT FILE FOR INSPECTION.
C
C       DESIGN FILE ACCESS NOTES
C       ------------------------
C       CHXLOD (2627) AND CHXUPD (2628) PERFORM DESIGN FILE INPUT
C       AND UPDATE RESPECTIVELY.
C
C       THE INPUT DESIGN FILE, CELLS-ON-CHANNEL FILE, AND TERMINAL
C       FILE MUST BE CLOSED BEFORE THE CALL TO CHXLOD. AFTER ALL
C       REQUIRED DATA HAS BEEN LOADED, THESE FILES ARE CLOSED
C       BEFORE EXIT FROM CHXLOD.
C
C       THE INPUT DESIGN FILE AND OUTPUT DESIGN FILE MUST BE CLOSED
C       BEFORE THE CALL TO CHXUPD. AFTER THE NEW DESIGN FILE
C       HAS BEEN CREATED, THESE FILES ARE CLOSED BY CHXUPD.
C
C       CAPACITY MODIFICATION ISSUES
C       ----------------------------
C       ALL TOKENS REFERENCED FOR ARRAY CAPACITIES CAN BE FOUND IN
C         NAMED COMMONS OF CHX.MAC
C         LOCAL COMMONS  CM2627 OF CHXLOD (2627)
C                        CM2630 OF WIRLOD (2630)
C         LOCALLY DIMENSIONED ARRAYS IN CHNXPN (2634)
C                                       CHNRS1 (2641)
C       THE VARIABLES SET TO INDICATE MAXIMUM ARRAY FILL ARE
C       SET IN CHXCLD (2625) OR IN THE MODULE WHERE THE ARRAY
C       IS DIMENSIONED.
C
C       FUTURE ENHANCEMENTS
C       -------------------
C
C       **************
C       * APPENDIX 1 *
C       * REFERENCES *
C       **************
C
C       *********************
C       * APPENDIX 2        *
C       * GLOSSARY OF TERMS *
C       *********************
C       THE FOLLOWING TERMS ARE DEFINED AS AN INTRODUCTION
C       TO 'DATA STRUCTURES'. REFER TO THAT SECTION FOR
C       THE DEFINITIONS.
C
C       CELL
C       CELL-CELL ADJACENCY
C       CELL-CHANNEL ADJACENCY
C       CHANNEL
C       CHANNEL-CELL ADJACENCY
C       CHANNEL-CHANNEL ADJACENCY
C       CHANNEL ENDS
C       CHANNEL EXPANSION
C       CHANNEL SIDES
C       CONNECTION
C       DOGLEG TERMINAL
C       INCOMING FUTURE TERMINAL
C       NORMAL TERMINAL
C       OUTGOING FUTURE TERMINAL
C       TERMINAL
C       WELL
C
C       *****************
C       * APPENDIX 3    *
C       * ERROR RETURNS *
C       *****************
C
C       EACH ERROR/WARNING NUMBER GENERATED BY V-RIS CODE HAS THREE
C       PARTS, WHEN REPRESENTED IN DECIMAL FORMAT. MOST ERRORS ALSO
```

```
C         PRODUCE A ONE LINE DIAGNOSTIC MESSAGE WHICH PROVIDES ADDITIONAL
C         INFORMATION RELATED TO THE ERROR.
C
C         ERROR NUMBER FORMAT IS SSMMMMXX, WHERE SS IS THE SEVERITY OF
C         THE CONDITION, MMMM IS THE NUMBER OF THE MODULE THAT DETECTED
C         THE CONDITION, AND XX IS AN ERROR CONDITION NUMBER WITHIN
C         MODULE MMMM.
C
C         TO DETERMINE THE CAUSE OF AN ERROR, EITHER USE THE LIST BELOW
C         OR FIND THE COMMENTS IN MODULE MMMM RELATED TO GENERATION OF
C         A PARTICULAR ERROR.
C
C         THE TEN MOST RECENTLY ENCOUNTERED ERROR CONDITIONS ARE STACKED
C         IN ERROR (COMMON CTLDTA) AND THE WORST SO FAR SEEN (LARGEST
C         ERROR NUMBER) IS KEPT IN ERSTER.
C
C
C         ****OUTPUT FROM ERLIST ROUTINE GOES HERE****
C
C         ********************
C         * APPENDIX 4       *
C         * MODULE SUMMARIES *
C         ********************
C
CS*       MODULELIST
CS*       2625CHXCLD
CS*       2626CHXDRE
CS*       2627CHXICD
CS*       2628CHXUPD
CS*       2629CLCLCL
CS*       2630WTRLCD
CS*       2631IRMLCD
CS*       2632CHNINE
CS*       2633CHNCUT
CS*       2634CHNXEN
CS*       2635WTRUPD
CS*       2636RAILCD
CS*       2637EGCCRE
CS*       2638EGRINC
CS*       2639CHXCTH
CS*       2640WLVPGC
CS*       2641CHNRST
CS*       2642GEICEL
C
C
C
C         ****************************************
C         * APPENDIX 5                           *
C         * NAMED COMMON DETAILED DESCRIPTIONS   *
C         ****************************************
C
CSNC*     CTLDTA
CSNC*     MASCON
CSNC*     CHXCEL
CSNC*     CHXCHN
CSNC*     CHXCHC
CSNC*     CHXCCN
CSNC*     CHXCHR
CSNC*     CHXDVB
CSNC*     CHXMCV
CSNC*     CHXNET
CSNC*     CHXNCD
CSNC*     CHXRAL
CSNC*     CHXRED
CSNC*     CHXRUL
CSNC*     CHXTRM
CSNC*     CHXWEL
CSNC*     CHXXXX
```

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS

FFFFFFFFFF   5555555555555555555555555555555555555555555555555555555555555555555555555555555555555   FFFFFFFFFF
FFFFFFFFFF   5555555555555555555555  DIGITAL EQUIPMENT CORPORATION - VAX/VMS VERSION V4.4  5555555555555555555555   FFFFFFFFFF
FFFFFFFFFF   5555555555555555555555555555555555555555555555555555555555555555555555555555555555555   FFFFFFFFFF

KMP

CHXPT5

DOC

;1

FILE _$1$DUA6:[FRL.CHX02]CHXPT5.DOC;1 (1071,1,2), LAST REVISED ON 21-OCT-1986 08:44, IS A 40 BLOCK SEQUENTIAL FILE OWNED BY UIC
[PPD1S1,PFC]. THE RECORDS ARE VARIABLE LENGTH WITH IMPLIED (CR) CARRIAGE CONTROL. THE LONGEST RECORD IS 74 BYTES.

JOB CHXPT5 (205) QUEUED TO SYS$PRINT ON 4-DEC-1986 12:50 BY USER KMP, UIC [ENGVLSI,KMP], UNDER ACCOUNT ENGPKG AT PRIORITY 100,
STARTED ON PRINTER _TCNTOSLPA0: ON 4-DEC-1986 13:10 FROM QUEUE SYS$PRINT.

FFFFFFFFFF   5555555555555555555555555555555555555555555555555555555555555555555555555555555555555   FFFFFFFFFF
FFFFFFFFFF   5555555555555555555555  DIGITAL EQUIPMENT CORPORATION - VAX/VMS VERSION V4.4  5555555555555555555555   FFFFFFFFFF
FFFFFFFFFF   5555555555555555555555555555555555555555555555555555555555555555555555555555555555555   FFFFFFFFFF
```

```
C ****************************************************************
C ****************************************************************
C *******                                                  *******
C *******                    CHXPT5.DOC                    *******
C *******          CHX SUBSYSTEM OF SUBROUTINE DOCPT5      *******
C *******                                                  *******
C *******                                                  *******
C ****************************************************************
C
C ****************************************************************
C **       (C) COPYRIGHT V-R INFORMATION SYSTEMS, INC.  1985    **
C **       LICENSED MATERIAL -- PROGRAM PROPERTY OF VRIS        **
C **       ALL RIGHTS RESERVED                                  **
C **                                                            **
C **       THIS PROGRAM IS THE PROPERTY OF VRIS AND IS FURNISHED**
C **       PURSUANT TO A WRITTEN LICENSE AGREEMENT.  IT MAY NOT BE**
C **       USED, REPRODUCED, OR DISCLOSED TO OTHERS EXCEPT IN   **
C **       ACCORDANCE WITH THE TERMS AND CONDITIONS OF THAT     **
C **       AGREEMENT.                                           **
C ****************************************************************
C
C
C       REVISION HISTORY --
C       10-DEC-85 DDC ADDED *GETCELL* SUBROUTINE.  (SAR 5424)
C       02-OCT-85 DDC ADDED *MOVFGC* AND *CHNRSI* SUBROUTINES. (SAR 5199)
C       03-JAN-85 KMP CREATED DOCUMENTATION CONTAINING MODULE
C                     SUMMARIES FOR THE CHANNEL EXPANSION SUBSYSTEM.
C
C
C$ 2625CHXCLD
C  CHXCLD 2625  CALL CHXCLD
C
C                 THIS MODULE INITIALIZES ALL GLOBAL DATA
C                 FOR THE CHANNEL EXPANSION SUBSYSTEM (CHX).
C
C$E
C$ 2626CHXDMP
C  CHXDMP 2626  CALL CHXDMP(OPT)
C
C                 THIS ROUTINE DUMPS OUT THE CHANNEL EXPANSION
C                 SUBSYSTEM DATA STRUCTURES. THE DATA STRUCTURES
C                 TO BE DUMPED ARE SPECIFIED VIA PARAMETER *OPT*.
C
C                 VALUES FOR INPUT PARAMETER *OPT* ARE AS FOLLOWS:
C
C                      000 - DUMP ALL DATA STRUCTURES
C                      100 - COMPLETE CELL DATA
C                      110 -     CELL LOCATION DATA
C                      120 -     CELL-TO-CHANNEL ADJACENCY AND
C                                CELL-TO-CELL ADJACENCY DATA
C                      130 -     CELL POINTER AND COUNT DATA
C                                FOR NODES, FEEDTHRUS, AND
C                                DEV-BARRIERS
C                      200 - COMPLETE CHANNEL DATA
C                      210 -     CHANNEL LOCATION DATA
C                      220 -     CHANNEL-TO-CHANNEL ADJACENCY DATA
C                                AND CHANNEL-TO-CELL ADJACENCY DATA
C                      230 -     CHANNEL POINTER AND COUNT DATA
C                                FOR TERMINALS AND CONNECTIONS
C                      300 - COMPLETE CONNECTION DATA
C                      400 - COMPLETE TERMINAL DATA
C                      500 - COMPLETE NODE AND PADCODE DATA
C                      600 - COMPLETE FEEDTHRU DATA
C                      700 - COMPLETE DEV-ASSOCIATED BARRIER DATA
C                      800 - COMPLETE NET AND WIRING RULE DATA
C                      900 - COMPLETE CARRIER DATA
C                      910 -     BOARD DATA
C                      920 -     RAIL DATA
C                      999 - CHANNEL-EXPANSION/TRACK-ASSIGNMENT
C                            INTERFACE DATA
C
C$F
C$ 2627CHXLOD
C  CHXLOD 2627  CALL CHXLOD(DSFLIX)
C
C                 THIS SUBROUTINE LOADS INFORMATION FROM THE
C                 INPUT DESIGN FILE AND CREATES THE WORKING
C                 DATA STRUCTURES FOR THE CHANNEL EXPANSION
C                 SUBSYSTEM (CHX).
C
C                 THE INPUT DESIGN FILE, WHOSE INDEX INTO THE
```

```
C                         *ICFILE* ARRAY IS SPECIFIED BY THE INPUT
C                         PARAMETER *DSELIX*, MUST BE CLOSED BEFORE
C                         THIS MODULE IS CALLED.
C
C                         AFTER ALL REQUIRED DATA HAS BEEN LOADED FROM
C                         THE INPUT DESIGN FILE, THIS FILE IS CLOSED.
C
CSE
CS 2628CHXUPD
C  CHXUPD 2628   CALL CHXUPD(OLDFIL, NEWFIL, GRDSNP, ICLOCK)
C
C                         THIS SUBROUTINE CREATES AN UPDATED DESIGN
C                         FILE FOR THE CHANNEL EXPANSION SUBSYSTEM (CHX).
C                         RECORDS TYPES UPDATED ARE:
C
C                              PEG - CARRIER GEOMETRY
C                              PCH - CHANNELS
C                              PEB - DEVICE-ASSOCIATED BARRIERS
C                              PLL - LEGAL LOCATIONS (SLOTS)
C                              PSN - NODES
C                              RFD - DEVICE-ASSOCIATED FEEDTHRUS
C                              RFT - FROMTOS -- THESE ARE DELETED
C                                               IF THEY EXIST
C                              RJP - JUMPERS
C                              RRL - POWER AND GROUND RAILS
C                              RWS - WIRE SEGMENTS -- OLD WIRES ARE
C                                                     DELETED AND
C                                                     REPLACED WITH
C                                                     NEW WIRES
C
C                         THE OLD AND NEW DESIGN FILES, WHOSE INDICES INTO
C                         THE *ICFILE* ARRAY ARE SPECIFIED BY PARAMETERS
C                         *OLDFIL* AND *NEWFIL*, MUST BOTH BE CLOSED WHEN
C                         THIS ROUTINE IS CALLED. AFTER THE NEW DESIGN FILE
C                         HAS BEEN CREATED, THIS ROUTINE CLOSES BOTH THE
C                         OLD AND NEW DESIGN FILES. PARAMETER *GRDSNP* IS
C                         A FLAG TO INDICATE WHETHER OR NOT TERMINALS ARE
C                         TO BE SNAPPED TO GRID BEFORE WIRE SEGMENTS ARE
C                         CREATED BY ROUTINE WIRUPD-2635. *ICLOCK* IS THE
C                         INDEX OF THE TIMER USED TO TRACK THE TOTAL RUN-TIME
C                         OF THE CALLING (OR "MASTER") SUBSYSTEM.
C
CSE
CS 2629CLCLOD
C  CLCLOD 2629   CALL CLCLOD(FILINX)
C
C                         THIS SUBROUTINE LOADS DATA DEFINING WHICH CELLS
C                         ARE ADJACENT TO EACH CHANNEL ON THE "LO" AND "HI"
C                         SIDES (AND THEREBY WHICH CHANNELS ARE ADJACENT TO
C                         EACH CELL ON THE BOTTOM, TOP LEFT, AND RIGHT SIDES)
C                         FROM THE CELLS-ON-CHANNEL DEFINITION FILE CREATED
C                         BY THE CHANNEL DEFINITION SUBSYSTEM (CHD).
C
C                         IT ALSO DEFINES THE "WELLS" THAT ARE CREATED ALONG
C                         THE CHANNEL SIDES BECAUSE OF UNEVEN CELL HEIGHTS.
C
C                         THE INPUT FILE, WHOSE INDEX INTO THE ICFILE ARRAY
C                         IS SPECIFIED VIA FORMAL PARAMETER *FILINX* IS
C                         ASSUMED TO BE CLOSED WHEN THIS MODULE IS INVOKED.
C                         WHEN LOADING IS COMPLETED, THE FILE IS CLOSED BY
C                         THIS MODULE.
C
CSE
CS 2630WIRLOD
C  WIRLOD 2630   CALL WIRLOD(FILINX)
C
C                         THIS SUBROUTINE LOADS PRE-DEFINED WIRE-SEGMENT
C                         DESCRIPTIONS FROM THE INPUT DESIGN FILE AND
C                         CONVERTS THESE DESCRIPTIONS INTO "CONNECTIONS",
C                         "TERMINALS", AND "FUTURE TERMINALS" WITHIN
C                         EACH CHANNEL THROUGH WHICH THESE WIRE SEGMENTS
C                         TRAVERSE.
C
C                         THE INPUT DESIGN FILE, WHOSE INDEX INTO THE
C                         *ICFILE* ARRAY IS SPECIFIED BY FORMAL PARAMETER
C                         *FILINX*, IS ASSUMED TO BE OPEN WHEN THIS ROUTINE
C                         IS CALLED AND IS LEFT OPEN UPON COMPLETION OF THIS
C                         ROUTINE.
C
C                         "CONNECTIONS" ARE CREATED FROM WIRE SEGMENTS WHICH
C                         ARE PARALLEL TO THE AXIS OF THE CHANNELS/WELLS
C                         THROUGH WHICH THEY TRAVERSE (TRUNKS).
```

```
C
C                  "TERMINALS" ARE CREATED FROM WIRE SEGMENTS WHICH
C                  ARE ORTHOGONAL TO THE AXIS OF THE CHANNELS/WELLS
C                  THROUGH WHICH THEY TRAVERSE (BRANCHES). IF THE
C                  ENDPOINT OF THE BRANCH IS INCIDENT TO THE EDGE
C                  OF A CELL ALONG THE CHANNEL, THE TERMINAL IS
C                  DESIGNATED AS A "NORMAL TERMINAL". IF, HOWEVER,
C                  THE ENDPOINT OF THE BRANCH IS INCIDENT TO THE
C                  END OF A CHANNEL, THE TERMINAL IS DESIGNATED
C                  AS AN "INCOMING FUTURE TERMINAL".
C
C                  "FUTURE TERMINALS" (OR "OUTGOING FUTURE TERMINALS")
C                  ARE CREATED FROM THE ENDPOINTS OF TRUNKS IF THE
C                  ENDPOINTS ARE INCIDENT TO THE END OF THE CHANNEL.
C                  NOTE THAT AN OUTGOING FUTURE TERMINAL IN A CHANNEL
C                  "A" CORRESPONDS TO AN INCOMING FUTURE TERMINAL IN
C                  ANOTHER CHANNEL "B" PROVIDED THE BOTH CHANNELS
C                  ABUT ONE ANOTHER AND CHANNEL "A" FEEDS INTO "B".
C
C$E
C$ 2631TRMLOD
C  TRMLOD 2631   CALL TRMLOD(FILINX)
C
C                  THIS SUBROUTINE LOADS TERMINAL POINT DEFINITIONS
C                  FROM THE ASCII SEQUENTIAL FILE WHOSE INDEX INTO
C                  THE IOFILE ARRAY IS GIVEN IN FORMAL PARAMATER
C                  *FILINX*. TERMINAL DEFINITIONS LOADED BY THIS
C                  ROUTINE ARE MERGED IN WITH THE TERMINALS THAT
C                  WERE PREVIOUSLY CREATED BY *CHX* WHEN LOADING
C                  PRE-DEFINED WIRES.
C
C                  DURING LOADING, THE TERMINAL COORDINATES SPECIFIED
C                  ARE CONVERTED FROM ABSOLUTE TO RELATIVE FOR
C                  INTERNAL STORAGE.
C
C                  WHEN THIS MODULE IS CALLED, THE INPUT TERMINAL
C                  FILE IS EXPECTED TO BE CLOSED AND IS AGAIN
C                  CLOSED UPON EXIT FROM THIS ROUTINE.
C
C$F
C$ 2632CHNINP
C  CHNINP 2632   CALL CHNINP(CHNID, GRDSNP)
C
C                  THIS MODULE IS THE INPUT INTERFACE BETWEEN
C                  THE CHANNEL EXPANSION SUBSYSTEM (CHX) AND THE
C                  TRACK ASSIGNMENT SUBSYSTEM (TRK). IT IS
C                  INVOKED BY TRK TO SET UP GLOBAL DATA TO BE
C                  USED FOR ROUTING THE SPECIFIED CHANNEL *CHNID*.
C                  IF *GRDSNP* EQUALS 1, CHANNELS ARE TO BE
C                  DEFINED ON GRID.
C
C                  DATA PASSED TO TRK (VIA NAMED COMMON /CHXTRK/)
C                  INCLUDES:
C                    - LOCATIONS OF TERMINALS WITHIN THE CHANNEL
C                      TO BE ROUTED (NORMAL TERMINALS, INCOMING
C                      FUTURE TERMINALS, AND OUTGOING FUTURE
C                      TERMINALS)
C                    - LOCATIONS OF NODES AND THEIR PAD CODES
C                    - LOCATIONS OF THE ENDPOINTS OF FEEDTHRUS
C                      AND THEIR PAD CODES
C                    - LOCATIONS AND SIZES OF DEVICE BARRIERS
C                    - LOCATIONS AND SIZES OF BARRIERS TO PROTECT
C                      CELLS AND CHANNEL INTERSECTIONS PROTRUDING
C                      INTO THE CURRENT CHANNEL.
C
C$E
C$ 2633CHNOUT
C  CHNOUT 2633   CALL CHNOUT(CHNID)
C
C                  THIS MODULE IS THE OUTPUT INTERFACE BEWEEN
C                  THE TRACK ASSIGNMENT AND CHANNEL EXPANSION
C                  SUBSYSTEMS AND IS INVOKED BY TRK AFTER IT
C                  HAS COMPLETED TRACK ASSIGNMENT ON CHANNEL
C                  *CHNID*.
C
C                  TRACK ASSIGNMENT DATA IS PASSED TO THIS ROUTINE
C                  VIA NAMED COMMON /CHXXXX/. THIS DATA IS SAVED
C                  BACK IN THE CHX GLOBAL DATA STRUCTURES WHILE
C                  THE ACTUAL EXPANSION OF THE CHANNEL IS
C                  PERFORMED BY INVOKING ROUTINE CHNXPN-2634.
C                  *CLORCH* IN /CHXXXX/ SPECIFIES THE AMOUNT
C                  BY WHICH CHANNEL *CHNID* WAS EXPANDED.
```

```
C
CSF
C$ 2634CHNXPN
C  CHNXPN 2634  CALL CHNXPN(CHNIC, ADDWID)
C
C                 THIS SUBROUTINE IS THE ROOT OF THE CHANNEL
C                 EXPANSION SUBSYSTEM IN THAT IT EXPANDS THE
C                 WIDTH OF THE SPECIFIED CHANNEL *CHNIC*
C                 BY *ADDWID* MMES.
C
C                 ALL ENTITIES (CELL LOCATIONS, CHANNEL LOCATIONS
C                 AND SIZES, ETC.) THAT ARE AFFECTED BY THE
C                 EXPANSION OF THE CHANNNEL ARE APPPOPRIATELY
C                 ADJUSTED BY THIS ROUTINE.
C
CSF
C$ 2635WIRUPD
C  WIRUPD 2635  CALL WIRUPD(CTFLIX)
C
C                 THIS SUBROUTINE CREATES AND OUTPUTS WIRE
C                 SEGMENT DESCRIPTIONS (*RWS* RECORDS) TO THE
C                 I/O FILE WHOSE INDEX INTO THE *IOFILE* ARRAY
C                 IS SPECIFIED IN FORMAL PARAMETER *CTFLIX*.
C
C                 WIRE SEGMENT DESCRIPTIONS ARE CREATED FROM
C                 THE CONNECTIONS (AND TERMINALS) ROUTED BY *TRK*.
C
C                 WHEN THIS MODULE IS INVOKED, THE OUTPUT DESIGN
C                 FILE IS ASSUMED TO BE OPEN. THIS ROUTINE DOES
C                 NOT CLOSE THE OUTPUT DESIGN FILE WHEN ITS TASK
C                 IS COMPLETED.
C
CSE
C$ 2636RAILOD
C  RAILOD 2636  CALL RAILOD(FILINX)
C
C                 THIS SUBROUTINE LOADS POWER/GROUND RAIL
C                 DEFINITIONS *RPL* RECORDS FROM THE INPUT
C                 DESIGN FILE WHOSE INDEX INTO THE *IOFILE*
C                 ARRAY IS SPECIFIED IN FORMAL PARAMETER
C                 *FILINX*.  EACH RAIL IS IDENTIFIED AS
C                 BELONGING TO EITHER THE CORE AREA OR TO THE
C                 I/O RING FOR USE IN AUTOMATIC DEFINITION
C                 OF POWER/GROUND WIRING.
C
C                 THE INPUT DESIGN FILE IS ASSUMED TO BE
C                 OPEN WHEN THIS ROUTINE IS CALLED AND IS
C                 LEFT OPEN UPON COMPLETION OF THIS ROUTINE.
C
CSE
C$ 2637PGCORE
C  PGCORE 2637  CALL PGCORE
C
C                 WHEN CHXPCP(3) EQUALS 1, THIS SUBROUTINE
C                 IS CALLED TO DEFINE THE CORE AREA GLOBAL
C                 ROUTES WHICH WILL CONNECT THE POWER/GROUND
C                 RAILS TO THE NODES ON THE BUS CONNECTOR CELLS.
C
C                 IT IS ASSUMED THAT THE RIGHT-MOST TOP I/O
C                 CELL AND THE LEFT-MOST BOTTOM I/O CELL ARE
C                 THE BUS CONNECTOR CELLS.  THE NODES FROM
C                 THESE CELLS ARE DEFINED IN GLOBAL ROUTES -
C                 THE TOP RIGHT NODE ROUTING TO THE RAIL
C                 ENDPOINTS IN THE RIGHT-MOST VERTICAL
C                 CHANNEL, THE BOTTOM LEFT NODE TO THE RAIL
C                 ENDPOINTS IN THE LEFT-MOST VERTICAL CHANNEL.
C
C                 THESE DESCRIPTIONS ARE CONVERTED INTO
C                 "CONNECTIONS", "TERMINALS", AND "FUTURE
C                 TERMINALS" - THE LAYER OF THE NODE
C                 DETERMINING THE LAYER OF THE CONNECTION.
C                 IF THE POSITION OF THE NODE IS TO THE OUTSIDE
C                 OF THE RAIL ENDPOINTS - IT WILL ALSO DETERMINE
C                 THE POSITION OF THE CONNECTION IN THE VERTICAL
C                 CHANNEL; OTHERWISE, A CONNECTION WILL ALSO BE
C                 DEFINED IN THE TOP OR BOTTOM CHANNEL, PASSING
C                 FROM THE NODE INTO THE VERTICAL CHANNEL.
C
CSE
C$ 2638PGRING
C  PGRING 2638  CALL PGRING(CTFLIX, GRDSNP)
C
```

```
C                     WHEN CHXPCF(4) = 1, THIS SUBROUTINE IS CALLED
C                     TO CREATE WIRE SEGMENT DESCRIPTIONS (*RWS*
C                     RECORDS) TO FORM POWER/GROUND RINGS OVER THE
C                     POWER/GROUND RAILS OF THE I/O CELLS AND
C                     WRITES THESE RECORDS TO THE I/O FILE WHOSE
C                     INDEX INTO THE *IOFILE* ARRAY IS SPECIFIED IN
C                     FORMAL PARAMETER *OTFLIX*.
C
C                     IT IS ASSUMED THAT ANY TWO POWER/GROUND RAILS
C                     MODELED BY THE *PRL* RECORDS FOR A SINGLE I/O
C                     CELL BELONG TO DIFFERENT NETS AND THAT CELL
C                     PLACEMENT HAS ALIGNED RAILS OF THE SAME NET.
C                     IT IS ALSO ASSUMED THAT ALL RAILS BELONGING
C                     TO A RING IN A GIVEN NET ARE ON THE SAME LAYER.
C
C                     CURRENTLY, A SINGLE *RWS* RECORD DEFINING A
C                     SEGMENT FROM ONE EDGE OF THE RING TO THE OTHER
C                     IS LAID OVER THE RAILS.  FUTURE ENHANCEMENTS
C                     WILL CREATE *RWS* RECORDS DEFINING SEGMENTS
C                     FROM ONE RAIL ENDPOINT TO THE NEXT.
C
C                     WHEN THIS MODULE IS INVOKED, THE OUTPUT DESIGN
C                     FILE IS ASSUMED TO BE OPEN. THIS ROUTINE DOES
C                     NOT CLOSE THE OUTPUT DESIGN FILE WHEN ITS TASK
C                     IS COMPLETED.
C
C                     NOTE: WHEN *GRDSNP* IS ON (=1), THEN THE
C                     ----     POSITIONS OF ALL WIRE SEGMENT ENDPOINTS
C                              WILL BE SNAPPED TO GRID.
C
C$E
C$ 2639CHXCTR
C   CHXCTR 2639  CALL CHXCTR
C
C                     THIS SUBROUTINE CENTERS THE CELLS ON THE CARRIER.
C                     IF THE CHIP IS CORE BOUND, THE I/O CELLS ARE
C                     CENTERED ALONG THE SIDES AND SPACED APART AS
C                     NEEDED TO FIT PROPERLY.  IF THE CHIP IS I/O BOUND,
C                     THE CORE CELLS ARE CENTERED BETWEEN THE I/O CELLS.
C
C$E
C$ 2640MOVPGC
C   MOVPGC 2640  CALL MOVPGC(CHNID, PGCPOS, DELTA)
C
C                     THIS SUBROUTINE IS CALLED TO ALIGN THE POWER/GROUND
C                     BUS CONNECTOR CELL BEYOND ALL OTHER TERMINALS IN
C                     THE CHANNEL SO THAT THE POWER/GROUND CONNECTION
C                     WILL NOT BLOCK OTHER CONNECTIONS IN THE CHANNEL.
C
C                     THE FORMAL PARAMETER *PGCPOS* DEFINES THE POSITION
C                     OF THE POWER/GROUND CONNECTOR CELL AS EITHER THE
C                     RIGHT-MOST HIGH CELL (=1) OR THE LEFT-MOST LOW CELL
C                     (=2) IN THE CHANNEL *CHNID*.  THE FORMAL PARAMETER
C                     *DELTA* IS THE AMOUNT TO MOVE THE CELL.
C
C$E
C$ 2641CHNRST
C   CHNRST 2641  CALL CHNRST(CHNID)
C
C                     THE 'CHANNEL RESET' SUBROUTINE IS CALLED TO
C                     RESET THE DESIGN TO THE BEGINNING OF THE CHANNEL
C                     SPECIFIED IN *CHNID*.
C
C                     THE ENTRIES FOR CHANNELS, FROM *CHNID* ON, IN
C                     THE *CONDAT*, *TRMDAT*, AND *VIADAT* ARRAYS ARE
C                     THROWN OUT.
C
C$E
C$ 2642GETCEL
C   GETCEL 2642  CALL GETCEL(POS, SIDE, CHAN, LLX, LLY, URX, URY)
C
C                     THE 'GET CELL' SUBROUTINE IS CALLED TO GET
C                     THE RECTANGULAR DESCRIPTION OF THE CELL
C                     INDICATED.  *POS* DEFINES THE POSITION OF THE
C                     CELL IN THE ROW, *SIDE* SPECIFIES THE TOP OR
C                     BOTTOM ROW OF CELLS ALONG THE CHANNEL *CHAN*.
C                     THE RECTANGULAR DESCRIPTION IS RETURNED IN THE
C                     PARAMETERS *LLX*, *LLY*, *URX*, *URY*.
C
C$E
```

DIGITAL EQUIPMENT CORPORATION - VAX/VMS VERSION V4.4

KMP

CHXPT6

DOC

;5

FILE _$1$DUA6:[KMC.CHX02]CHXPT6.DOC;5 (1072,1,2), LAST REVISED ON 21-OCT-1986 08:44, IS A 172 BLOCK SEQUENTIAL FILE OWNED BY UIC [KMCTST,KMC]. THE RECORDS ARE VARIABLE LENGTH WITH IMPLIED (CR) CARRIAGE CONTROL. THE LONGEST RECORD IS 78 BYTES.

JOB CHXPT6 (206) QUEUED TO SYS$PRINT ON 4-DEC-1986 12:50 BY USER KMP, UIC [ENGVIS1,KMP], UNDER ACCOUNT ENGPKG AT PRIORITY 3, STARTED ON PRINTER _TCPTCSLPA0: ON 4-DEC-1986 13:50 FROM QUEUE SYS$PRINT.

DIGITAL EQUIPMENT CORPORATION - VAX/VMS VERSION V4.4

VAX/VMS VAX/VMS VAX/VMS VAX/VMS VAX/VMS VAX/VMS VAX/VMS VAX/VMS VAX/VMS VAX/VMS VAX/VMS VAX/VMS

VAX/VMS VAX/VMS VAX/VMS VAX/VMS VAX/VMS VAX/VMS VAX/VMS VAX/VMS VAX/VMS VAX/VMS VAX/VMS VAX/VMS

DIGITAL EQUIPMENT CORPORATION - VAX/VMS VERSION V4.4

KMP

CHXP16

DOC

;5

FILE _SISLUA0:[PRE.CPX(2)]CHXP16.DOC;5 (1072,1,2), LAST REVISED ON 21-OCT-1986 08:44, IS A 172 BLOCK SEQUENTIAL FILE OWNED BY UIC [PRDTST,PEC]. THE RECORDS ARE VARIABLE LENGTH WITH IMPLIED (CR) CARRIAGE CONTROL. THE LONGEST RECORD IS 78 BYTES.

JOB CHXP16 (206) QUEUED TO SYS$PRINT ON 4-DEC-1986 12:50 BY USER KMP, UIC [ENGVLSI,KMP], UNDER ACCOUNT ENGPRG AT PRIORITY 3, STARTED ON PRINTER _ICNTOSLPA0: ON 4-DEC-1986 13:50 FROM QUEUE SYS$PRINT.

DIGITAL EQUIPMENT CORPORATION - VAX/VMS VERSION V4.4

```
_$1$DUA6:[PRD.CHX02]CHXP16.DCC;5                    21-OCT-1986 08:44                 PAGE 1
C ***************************************************************
C ***************************************************************
C *******                                                 *******
C *******                  CHXP16.DCC                     *******
C *******         CHX SUBSYSTEM OF SUBROUTINE DCLPT6      *******
C *******                                                 *******
C *******                                                 *******
C ***************************************************************
C
C ***************************************************************
C **       (C) COPYRIGHT V-R INFORMATION SYSTEMS, INC.  1985  **
C **       LICENSED MATERIAL -- PROGRAM PROPERTY OF VRIS       **
C **       ALL RIGHTS RESERVED                                 **
C **                                                           **
C **       THIS PROGRAM IS THE PROPERTY OF VRIS AND IS FURNISHED **
C **       PURSUANT TO A WRITTEN LICENSE AGREEMENT.  IT MAY NOT BE **
C **       USED, REPRODUCED, OR DISCLOSED TO OTHERS EXCEPT IN  **
C **       ACCORDANCE WITH THE TERMS AND CONDITIONS OF THAT    **
C **       AGREEMENT.                                          **
C ***************************************************************
C
C
C        REVISION HISTORY --
C        12-SEP-86 TAF ADDED GLOBAL VARIABLE TO INDICATE WHETHER
C                      OR NOT SAME NET VIA-TO-VIA SPACING
C                      VIOLATIONS SHOULD BE ALLOWED.  (SAR 6012)
C        24-MAR-86 LDC ADDED *CPRNRM* TO /CHXCRR/.  ALSO ADDED
C                      *TOTVIA*, *WTHLEN*, *TOPCHN*, *BOTCHN*,
C                      *LEFCHN*, AND *RIGCHN* TO /CHXCRR/.
C                      (SAR 5626)
C        14-JAN-86 TAF REMOVED UNUSED FIELDS FROM VARIOUS ARRAYS.
C                      ADDED INFO FOR NEW COMMON /CHXAPG/.
C                      (SAR 5500)
C        02-OCT-85 TAF ADDED *CHNSPT* ARRAY AND DOC ADDED
C                      VIA PROTECTION DATA AND SUPPORT FOR
C                      CYCLES.  (SAR 5199)
C        04-JAN-85 KMP CREATED DOCUMENTATION OF NAMED COMMONS
C                      FOR THE CHANNEL EXPANSION SUBSYSTEM.
C
C-----------------------------------------------------------------
C
CS CHXAPG
C
C
C                    *****************
C                    * COMMON CHXAPG *
C                    *****************
C
C        NODE LOCATION DATA FOR THE AUTOMATIC POWER/GROUND ROUTING
C
C
C        BOTCEL                 INDEX OF THE I/O CELL CONTAINING
C                               THE P/G NODE WHICH FEEDS INTO
C                               THE CORE AREA FROM THE LOWER-LEFT
C                               CORNER.
C
C        BOTNDX                 RELATIVE X-COORDINATE OF THE P/G
C                               NODE WHICH LIES ON *BOTCEL*.
C
C        BOTNDY                 RELATIVE Y-COORDINATE OF THE P/G
C                               NODE WHICH LIES ON *BOTCEL*.
C
C        TOPCEL                 INDEX OF THE I/O CELL CONTAINING
C                               THE P/G NODE WHICH FEEDS INTO
C                               THE CORE AREA FROM THE UPPER-RIGHT
C                               CORNER.
C
C        TOPNDX                 RELATIVE X-COORDINATE OF THE P/G
C                               NODE WHICH LIES ON *TOPCEL*.
C
C        TOPNDY                 RELATIVE Y-COORDINATE OF THE P/G
C                               NODE WHICH LIES ON *TOPCEL*.
C
C
CSE
C
C-----------------------------------------------------------------
C
CS CHXCEL
C
C
C                    *****************
```

```
                  * COMMON CHXCEL *
                  *****************

CELL DATA FOR THE CHANNEL EXPANSION SUBSYSTEM (CHX)

CELCNT                         NUMBER OF CELLS IN THE DESIGN.

CELMAX                         MAXIMUM NUMBER OF CELLS ALLOWED
                               IN THE DESIGN. THIS VARIABLE IS
                               SET TO TOKEN SERVICES.

CELDAT(CHXCFLELD,              TWO-DIMENSIONAL ARRAY CONTAINING
       SERVICES)               DATA FOR EACH CELL IN THE DESIGN,
                               CHXCELFLD = 22.

                               THE ARRAY IS ACCESSED AS:

                                 CELDAT("FIELDNAME", "CELLNBR").

                               WHERE "FIELDNAME" IS ONE OF THE
                               TOKENS DESCRIBED BELOW, AND
                               "CELLNBR" IS THE CELL NUMBER
                               (AS ENCOUNTERED IN THE DESIGN FILE).

      CHXCELCLDX     = 01      ABSOLUTE X-COORDINATE (IN MMES.)
                               OF THE CELL REFERENCE POINT WHEN
                               THE DESIGN FILE IS INITIALLY LOADED.

      CHXCELCLDY     = 02      ABSOLUTE Y-COORDINATE (IN MMES.)
                               OF THE CELL REFERENCE POINT WHEN
                               THE DESIGN FILE IS INITIALLY LOADED.

      CHXCELREX      = 03      ABSOLUTE X-COORDINATE (IN MMES.)
                               OF THE CURRENT LOCATION OF THE
                               CELL REFERENCE POINT.

      CHXCELREY      = 04      ABSOLUTE Y-COORDINATE (IN MMES.)
                               OF THE CURRENT LOCATION OF THE
                               CELL REFERENCE POINT.

      CHXCELLLX      = 05      X-COORDINATE (IN MMES.) OF THE
                               LOWER-LEFT CORNER OF THE CELL
                               BODY EXTENT RECTANGLE RELATIVE
                               TO THE REFERENCE POINT OF THE CELL.

      CHXCELLLY      = 06      Y-COORDINATE (IN MMES.) OF THE
                               LOWER-LEFT CORNER OF THE CELL
                               BODY EXTENT RECTANGLE RELATIVE
                               TO THE REFERENCE POINT OF THE CELL.

      CHXCELURX      = 07      X-COORDINATE (IN MMES.) OF THE
                               UPPER-RIGHT CORNER OF THE CELL
                               BODY EXTENT RECTANGLE RELATIVE
                               TO THE REFERENCE POINT OF THE CELL.

      CHXCELURY      = 08      Y-COORDINATE (IN MMES.) OF THE
                               UPPER-RIGHT CORNER OF THE CELL
                               BODY EXTENT RECTANGLE RELATIVE
                               TO THE REFERENCE POINT OF THE CELL.

      CHXCELNXTLF    = 09      POINTER TO THE NEXT CELL WHICH LIES
                               AT A HIGHER Y-COORDINATE ALONG THE
                               CHANNEL WHICH IS ADJACENT TO THE
                               LEFT EDGE OF THE CELL. IF NO
                               CHANNEL EXISTS TO THE LEFT OF A
                               GIVEN CELL (VALUE OF THE CHXCELLFTCH
                               FIELD FOR THE CELL=0), THEN THE VALUE
                               IN THIS FIELD WILL BE ZERO. HOWEVER,
                               THE VALUE IN THIS FIELD BEING 0 DOES
                               NOT IMPLY THAT NO CHANNEL IS ADJACENT
                               TO THE LEFT SIDE OF THIS CELL.

      CHXCELNXTRG    = 10      POINTER TO THE NEXT CELL WHICH LIES
                               AT A HIGHER Y-COORDINATE ALONG THE
                               CHANNEL WHICH IS ADJACENT TO THE
                               RIGHT EDGE OF THE CELL. IF NO
                               CHANNEL EXISTS TO THE RIGHT OF A
                               GIVEN CELL (VALUE OF THE CHXCELRGHCH
                               FIELD FOR THE CELL=0), THEN THE VALUE
                               IN THIS FIELD WILL BE ZERO. HOWEVER,
```

```
                                   THE VALUE IN THIS FIELD BEING 0 DOES
                                   NOT IMPLY THAT NC CHANNEL IS ADJACENT
                                   TC THE RIGHT SIDE CF THIS CELL.

        CHXCELNXTBT     = 11       POINTER TO THE NEXT CELL WHICH LIES
                                   AT A HIGHER X-COORDINATE ALONG THE
                                   CHANNEL WHICH IS ADJACENT TC THE
                                   BOTTOM EDGE CF THE CELL. IF NC
                                   CHANNEL EXISTS TC THE BOTTCM CF A
                                   GIVEN CELL (VALUE CF THE CHXCELBOTCH
                                   FIELD FOR THE CELL=0), THEN THE VALUE
                                   IN THIS FIELD WILL BE ZERC. HOWEVER,
                                   THE VALUE IN THIS FIELD BEING 0 DOES
                                   NOT IMPLY THAT NC CHANNEL IS ADJACENT
                                   TC THE BOTTCM SIDE CF THIS CELL.

        CHXCELNXTTP     = 12       POINTER TO THE NEXT CELL WHICH LIES
                                   AT A HIGHER X-COORDINATE ALONG THE
                                   CHANNEL WHICH IS ADJACENT TC THE
                                   TOP EDGE OF THE CELL. IF NC
                                   CHANNEL EXISTS TC THE TCP CF A
                                   GIVEN CELL (VALUE CF THE CHXCELTOPCH
                                   FIELD FOR THE CELL=0), THEN THE VALUE
                                   IN THIS FIELD WILL BE ZERC. HOWEVER,
                                   THIS FIELD BEING 0 DOES NOT IMPLY
                                   THAT NC CHANNEL IS ADJACENT TC
                                   THE TOP SIDE OF THIS CELL.

        CHXCELLFTCH     = 13       POINTER TO THE CHANNEL WHICH
                                   IS IMMEDIATELY ADJACENT TC THE
                                   LEFT SIDE CF THE CELL.
                                   THE VALUE IN THIS FIELD MAY BE
                                   ZERO IF NO CHANNEL IS IMMEDIATELY
                                   ADJACENT ALONG THE LEFT SIDE CF
                                   THE CELL.

        CHXCELRGHCH     = 14       POINTER TO THE CHANNEL WHICH
                                   IS IMMEDIATELY ADJACENT TO THE
                                   RIGHT SIDE CF THE CELL.
                                   THE VALUE IN THIS FIELD MAY BE
                                   ZERO IF NO CHANNEL IS IMMEDIATELY
                                   ADJACENT ALONG THE RIGHT SIDE OF
                                   THE CELL.

        CHXCELBOTCH     = 15       POINTER TO THE CHANNEL WHICH
                                   IS IMMEDIATELY ADJACENT TO THE
                                   BOTTOM SIDE CF THE CELL.
                                   THE VALUE IN THIS FIELD MAY BE
                                   ZERO IF NO CHANNEL IS IMMEDIATELY
                                   ADJACENT ALONG THE BOTTOM SIDE CF
                                   THE CELL.

        CHXCELTOPCH     = 16       POINTER TO THE CHANNEL WHICH
                                   IS IMMEDIATELY ADJACENT TO THE
                                   TOP SIDE OF THE CELL.
                                   THE VALUE IN THIS FIELD MAY BE
                                   ZERO IF NO CHANNEL IS IMMEDIATELY
                                   ADJACENT ALONG THE TOP SIDE OF
                                   THE CELL.

        CHXCELNODPT     = 17       POINTER TO THE FIRST NODE
                                   (IN ARRAY *NODDAT*) ON A CELL.

        CHXCELNODCT     = 18       NUMBER OF NODES CN A CELL.

        CHXCELDVBPT     = 19       POINTER TO THE FIRST DEVICE
                                   ASSOCIATED BARRIER (IN ARRAY
                                   *DVBDAT*) FOR A CELL.

        CHXCELDVBCT     = 20       NUMBER OF DEVICE ASSOCIATED
                                   BARRIERS FCR A CELL.

        CHXCELFEDPT     = 21       POINTER TO THE FIRST DEVICE
                                   ASSOCIATED FEEDTHRU (IN ARRAY
                                   *FEDDAT*) FCR A CELL.

        CHXCELFEDCT     = 22       NUMBER OF DEVICE-ASSOCIATED
                                   FEEDTHRUS FOR A CELL.

    MXCLXX                         MAXIMUM X-COORDINATE VALUE CF
                                   THE CELLS ON THE CARRIER.
```

```
C       MXCTYY                      MAXIMUM Y-COORDINATE VALUE OF
C                                   THE CELLS IN THE CARRIER.
C
CSE
C
C--------------------------------------------------------------------
C
CS CHXCHC
C
C               *****************
C               * COMMON CHXCHC *
C               *****************
C
C       "CHANNELS-ON-CHANNEL" DATA FOR THE CHANNEL EXPANSION
C       SUBSYSTEM (CHX)
C
C       CHCCNT                      TOTAL NUMBER OF CHANNELS FEEDING
C                                   OTHER CHANNELS.
C
C       CHCMAX                      MAXIMUM NUMBER OF CHANNELS FEEDING
C                                   OTHER CHANELS. THIS VALUE IS SET
C                                   TO TOKEN @CHNSONCHAN.
C
C       CHCDAT(@CHNSONCHAN)         ARRAY CONTAINING IDENTIFICATION
C                                   NUMBERS OF CHANNELS FEEDING INTO
C                                   OTHER CHANNELS.
C
C                                   THIS ARRAY IS ORGANIZED SUCH THAT
C                                   THE CHANNELS FEEDING INTO THE "LO"
C                                   SIDE OF CHANNEL *I* ARE GROUPED
C                                   TOGETHER, FOLLOWED BY THOSE FEEDING
C                                   INTO THE "HI" SIDE OF CHANNEL *I*,
C                                   FOLLOWED BY THOSE FEEDING INTO
C                                   THE "LO" SIDE OF CHANNEL *I+1*,
C                                   ETC., I=1,CHNCNT
C
C                                   THIS ARRAY IS ACCESSED USING THE
C                                   "CHXCHNLOCHPT, CHXCHNLOCHCT" AND
C                                   "CHXCHNHICHPT, CHXCHNHICHCT"
C                                   FIELDS OF THE *CHNDAT* ARRAY.
C
C                                   NOTE: GENERALLY, THE FIRST
C                                   ----  CHANNEL CAN NEVER BE FED
C                                         BY ANY OTHER CHANNEL.
C
CSE
C
C--------------------------------------------------------------------
C
CS CHXCHN
C
C
C               *****************
C               * COMMON CHXCHN *
C               *****************
C
C       CHANNEL DATA FOR THE CHANNEL EXPANSION SUBSYSTEM (CHX)
C
C       CHNCNT                      NUMBER OF CHANNELS IN THE DESIGN.
C
C       CHNMAX                      MAXIMUM NUMBER OF CHANNELS ALLOWED
C                                   IN THE DESIGN. THIS VARIABLE IS
C                                   SET TO TOKEN $CHANNELS.
C
C       CHNDAT(CHXCHNFLD,           TWO-DIMENSIONAL ARRAY CONTAINING
C              $CHANNELS)           DATA FOR EACH CHANNEL IN THE DESIGN,
C                                   CHXCHNFLD = 22.
C
C                                   THE ARRAY IS ACCESSED AS:
C
C                                     CHNDAT("FIELDNAME", "CHNNBR"),
C
C                                   WHERE "FIELDNAME IS ONE OF THE
C                                   TOKENS DESCRIBED BELOW, AND
C                                   "CHNNBR" IS THE CHANNEL ID NUMBER
C                                   (AS ENCOUNTERED IN THE DESIGN FILE).
```

```
CHXCHNORIENT    = 01   ORIENTATION OF THE CHANNEL.
                       VALUES ARE:
                         1 -- HORIZONTAL CHANNEL
                         2 -- VERTICAL   CHANNEL

CHXCHNLLX       = 02   ABSOLUTE X-COORDINATE (IN MMES.)
                       OF THE LOWER-LEFT CORNER OF THE
                       CHANNEL.

CHXCHNLLY       = 03   ABSOLUTE Y-COORDINATE (IN MMES.)
                       OF THE LOWER-LEFT CORNER OF THE
                       CHANNEL.

CHXCHNURX       = 04   ABSOLUTE X-COORDINATE (IN MMES.)
                       OF THE UPPER-RIGHT CORNER OF THE
                       CHANNEL.

CHXCHNURY       = 05   ABSOLUTE Y-COORDINATE (IN MMES.)
                       OF THE UPPER-RIGHT CORNER OF THE
                       CHANNEL.

CHXCHNSPLTPT    = 06   ID NUMBER OF THE SECOND CHANNEL
                       (IF ANY) CREATED WHEN A SINGLE
                       CHANNEL IS SPLIT INTO TWO
                       ABUTTING COLINEAR CHANNELS.

CHXCHNLOFEED    = 07   ID NUMBER OF THE CHANNEL FED BY
                       THE "LO" END OF THIS CHANNEL.
                       NOTE: THE "LO" END OF A CHANNEL
                       ----  IS LOWER OR LEFT END.

CHXCHNHIFEED    = 08   ID NUMBER OF THE CHANNEL FED BY
                       THE "HI" END OF THIS CHANNEL.
                       NOTE: THE "HI" END OF THE CHANNEL
                       ----  IS THE UPPER OR RIGHT END.

CHXCHNLOCLPT    = 09   POINTER TO THE FIRST CELL ALONG
                       THE "LO" SIDE OF A CHANNEL. FOR
                       A HORIZONTAL (VERTICAL) CHANNEL,
                       THE FIRST "LO" CELL IS THE
                       LEFTMOST (BOTTOMMOST) CELL
                       ADJACENT TO THE LOWER (LEFT)
                       SIDE OF THE CHANNEL.

CHXCHNHICLPT    = 10   POINTER TO THE FIRST CELL ALONG
                       THE "HI" SIDE OF A CHANNEL. FOR
                       A HORIZONTAL (VERTICAL) CHANNEL,
                       THE FIRST "HI" CELL IS THE
                       LEFTMOST (BOTTOMMOST) CELL
                       ADJACENT TO THE UPPER (RIGHT)
                       SIDE OF THE CHANNEL.

CHXCHNLOCHPT    = 11   POINTER (INTO ARRAY *CHCDAT*) TO
                       THE FIRST (LEFTMOST OR BOTTOMMOST)
                       CHANNEL FEEDING INTO THE "LO" SIDE
                       OF A CHANNEL. FOR A HORIZONTAL
                       (VERTICAL) CHANNEL, THE "LO" SIDE
                       IS THE BOTTOM (LEFT) EDGE OF THE
                       CHANNEL.

CHXCHNLOCHCT    = 12   NUMBER OF CHANNELS FEEDING INTO
                       THIS CHANNEL ON ITS "LO" SIDE.

CHXCHNHICHPT    = 13   POINTER (INTO ARRAY *CHCDAT*) TO
                       THE FIRST (LEFTMOST OR BOTTOMMOST)
                       CHANNEL FEEDING INTO THE "HI" SIDE
                       OF A CHANNEL. FOR A HORIZONTAL
                       (VERTICAL) CHANNEL, THE "HI" SIDE
                       IS THE UPPER (RIGHT) EDGE OF THE
                       CHANNEL.

CHXCHNHICHCT    = 14   NUMBER OF CHANNELS FEEDING INTO
                       THIS CHANNEL ON ITS "HI" SIDE.

CHXCHNOFTMPT    = 15   POINTER TO THE FIRST OUTGOING
                       FUTURE TERMINAL (IN ARRAY *TRMDAT*)
                       FOR THIS CHANNEL. AN OUTGOING
                       FUTURE TERMINAL IS ONE WHICH IS
                       CAUSED BY A WIRE CROSSING FROM
                       THIS CHANNEL TO A CHANNEL FED
                       BY THIS CHANNEL. OUTGOING FUTURE
```

```
C                                      TERMINALS CAN ONLY OCCUR AT THE
C                                      ENDS OF A CHANNEL.
C
C               CHXCHNCFTMCT   = 16    NUMBER OF OUTGOING FUTURE
C                                      TERMINALS IN (OR EMANATING FROM)
C                                      A CHANNEL.
C
C               CHXCHNCTTMPT   = 17    POINTER TO THE FIRST "NORMAL"
C                                      TERMINAL (IN ARRAY *TRMDAT*)
C                                      FOR THIS CHANNEL. A "NORMAL"
C                                      TERMINAL IS A CELL-ASSOCIATED
C                                      TERMINAL AND LIES ALONG THE
C                                      SIDES OF A CHANNEL.
C
C               CHXCHNCLTMCT   = 18    NUMBER OF "NORMAL" (OR CELL-
C                                      ASSOCIATED) TERMINALS IN
C                                      A CHANNEL.
C
C               CHXCHNCONNPT   = 19    POINTER TO THE FIRST CONNECTION
C                                      OR "TRUNK" (IN ARRAY *CONDAT*)
C                                      FOR A CHANNEL.
C
C               CHXCHNCONNCT   = 20    NUMBER OF CONNECTIONS IN A
C                                      CHANNEL.
C
C               CHXCHNVIAPTR   = 21    POINTER TO THE FIRST VIA
C                                      PROTECTION ENTRY FOR A CHANNEL
C                                      IN THE LINKED LIST IN ARRAY
C                                      *VIADAT*.
C
C               CHXCHNESTMIN   = 22    FIELD USED BY TRS TO HOLD THE
C                                      VALUE USED IN ESTIMATING THE
C                                      SIZE OF THE CHANNEL. USED FOR
C                                      CHANNELS WHICH ARE THE LAST IN
C                                      A CYCLE.
C
C       NMHZCH                         NUMBER OF HORIZONTAL CHANNELS
C                                      ON THE CARRIER.
C
C       CHNSRT(4, $CHANNELS)           CONTAINS THE CHANNELS SORTED
C                                      BY ORIENTATION AND X,Y COORDINATE
C                                      TO BE USED DURING CHANNEL EXPANSION.
C                                      HORIZONTAL CHANNELS ARE LISTED FIRST.
C                                      CHANNELS ARE LISTED IN ORDER FROM
C                                      THE LOW END TO THE HIGH END OF THE
C                                      CARRIER.  FIELDS ARE AS FOLLOWS:
C                                        1 - CHANNEL INDEX NUMBER
C                                        2 - CHANNEL ORIENTATION
C                                              HZ = 1;  VT = 2
C                                              (PRIMARY SORT KEY)
C                                        3 - INITIALLY:
C                                              LLY COORDINATE FOR HZ CHAN
C                                              LLX COORDINATE FOR VT CHAN
C                                              (SECONDARY SORT KEY)
C                                            FINALLY:
C                                              POINTER TO THE POSITION OF
C                                              A GIVEN CHANEL INDEX INTO
C                                              THE *CHNSRT* ARRAY FOR EASY
C                                              ACCESS
C                                        4 - LLX COORDINATE FOR HZ CHAN
C                                            LLY COORDINATE FOR VT CHAN
C                                            (TERTIARY SORT KEY)
C
CSE
C------------------------------------------------------------------
C
C$ CHXCON
C
C                         *****************
C                         * COMMON CHXCON *
C                         *****************
C
C       "CONNECTION" (TRUNK) DATA FOR THE CHANNEL
C       EXPANSION SUBSYSTEM (CHX).
C
C       CONSUC                         NUMBER OF SUCCESSFULLY ROUTED
C                                      CONNECTIONS. USED WHEN CREATING
C                                      THE HISTORY (*HHT*) RECORD.
C
```

14112 G.B.

```
C       CONPRE                       NUMBER OF PRERCUTED CONNECTIONS
C                                    IN THE DESIGN.
C
C       CONCNT                       NUMBER OF CONNECTIONS IN THE DESIGN.
C                                    THIS NUMBER INCLUDES CONNECTIONS
C                                    CREATED BECAUSE OF PRE-DEFINED WIRES
C                                    AND THOSE CREATED BY TRACK ASSIGNMENT.
C
C       CONMAX                       MAXIMUM NUMBER OF CONNECTIONS ALLOWED
C                                    IN THE DESIGN. THIS VARIABLE IS SET
C                                    TO THE TOKEN @TOTCONNECT.
C
C       CONDAT(CHXCONFLD,            TWO-DIMENSIONAL ARRAY CONTAINING
C              @TOTCONNECT)          DATA FOR EACH CONNECTION IN THE
C                                    DESIGN.
C                                    CHXCONFLD = 8.
C
C                                    INITIALLY, ONLY CONNECTIONS
C                                    CREATED BECAUSE OF PRE-DEFINED
C                                    WIRES ARE LOADED INTO THIS ARRAY.
C                                    AS TRACK ASSIGNMENT PROCEEDS,
C                                    NEWLY CREATED CONNECTIONS ARE ADDED
C                                    AT THE END OF *CONDAT*. THEY ARE
C                                    AGAIN SORTED BY CHANNEL NUMBER AT
C                                    THE END.
C
C                                    SINCE THE CONNECTIONS ARE SORTED
C                                    BY CHANNEL NUMBER, THEY ARE ACCESSIBLE
C                                    ONLY INDIRECTLY THROUGH THE CHANNEL.
C                                    THE ARRAY IS ACCESSED AS:
C
C                                      CONDAT("FIELDNAME", "CONINDEX")
C
C                                    WHERE "FIELDNAME" IS ONE OF THE
C                                    TOKENS DESCRIBED BELOW, AND
C                                    "CONINDEX" IS CALCULATED USING
C                                    THE POINTER TO THE FIRST CONNECTION
C                                    WITHIN A CHANNEL ( THE "CHXCHNCONPT"
C                                    FIELD IN ARRAY *CHNDAT*) AND THE
C                                    CONNECTION NUMBER WITHIN THE CHANNEL.
C
C            CHXCONCHN      = 01     ID. NUMBER OF CHANNEL TO WHICH
C                                    CONNECTION BELONGS. USED AS THE
C                                    PRIMARY SORT KEY WHEN ASSOCIATING
C                                    CONNECTIONS WITH CHANNELS.
C
C            CHXCONNUM      = 02     INDEX NUMBER OF THE CONNECTION
C                                    WITHIN THE CHANNEL. USED AS THE
C                                    SECONDARY SORT KEY WHEN ASSOCIATING
C                                    CONNECTIONS WITH CHANNELS.
C
C                                    FOR EACH CHANNEL, THE CONNECTION
C                                    NUMBERS BEGIN AT ONE (1), WITH
C                                    THE CONNECTIONS DUE TO PRE-
C                                    EXISTING WIRES PRECEEDING THOSE
C                                    DEFINED IN THE TERMINAL FILE.
C                                    NOTE: THE CONNECTION NUMBERS OF
C                                    ----  CONNECTIONS DEFINED IN THE
C                                          TERMINAL FILE IS INCREMENTED
C                                          BY THE NUMBER OF PRE-EXISTING
C                                          CONNECTIONS IN THE CHANNEL.
C
C            CHXCONTYP      = 03     CONNECTION TYPE CODE. VALUES ARE:
C                                      1 -- CONNECTION CREATED BECAUSE
C                                           OF A PRE-DEFINED WIRE.
C                                      0 -- ANY OTHER CONNECTION.
C
C            CHXCONNET      = 04     NET NUMBER OF CONNECTION.
C
C            CHXCONLYR      = 05     LAYER ON WHICH CONNECTION OCCURS.
C
C            CHXCONORD      = 06     ORDINATE (IN MMES.) OF CONNECTION.
C                                    THE ORDINATE IS RELATIVE TO THE
C                                    ORDINATE OF THE CHANNEL IN WHICH
C                                    THE CONNECTION OCCURS.
C                                    VALUES IN THIS FIELD MAY BE NEGAIVE
C                                    IF A CONNECTION IS ROUTED WITHIN
C                                    A "WELL" ALONG THE "LO" SIDE
C                                    OF THE CHANNEL.
```

```
C
C          CHXCONTRPT     = 07    POINTER TO THE FIRST TERMINAL
C                                 (IN ARRAY *IRMDAT*) FOR THIS
C                                 CONNECTION.
C                                 NOTE: THIS FIELD ONLY USED
C                                 ----  WHEN WRITING WIRE SEGS
C                                       TO THE OUTPUT DESIGN FILE.
C
C          CHXCONTNCT     = 08    NUMBER OF TERMINALS ASSOCIATED
C                                 WITH THIS CONNECTION.
C                                 NOTE: THIS FIELD ONLY USED
C                                 ----  WHEN WRITING WIRE SEGS
C                                       TO THE OUTPUT DESIGN FILE.
C
C
CSE
C
C-----------------------------------------------------------------
C
C$ CHXCRR
C
C
C                     *****************
C                     * COMMON CHXCRR *
C                     *****************
C
C      CARRIER DATA FOR THE CHANNEL EXPANSION SUBSYSTEM (CHX)
C
C      CRRSGL                    NUMBER OF SIGNAL LAYERS.
C
C      CRRPWL                    NUMBER OF PWR/GND LAYERS.
C
C      CRRLY1                    WIRING CODE FOR LAYER 1.
C                                SEE MERLYN DATABASE REFERENCE
C                                MANUAL (*RSE* RECORD) FOR A
C                                DETAILED DESCRIPTION OF THESE
C                                CODES. BY DEFAULT,
C                                   CRRLY1 = 5  (HORIZONTAL)
C      CRRLY2                    WIRING CODE FOR LAYER 2.
C                                SEE MERLYN DATABASE REFERENCE
C                                MANUAL (*RSE* RECORD) FOR A
C                                DETAILED DESCRIPTION OF THESE
C                                CODES. BY DEFAULT,
C                                   CRRLY2 = 6  (VERTICAL)
C
C      CRRGDX                    X-DIRECTION GRID SIZE (MMES.)
C
C      CRRGDY                    Y-DIRECTION GRID SIZE (MMES.)
C
C      CRRHVV                    MINIMUM HORIZONTAL VIA-VIA CLEARANCE.
C
C      CRRVVV                    MINIMUM VERTICAL VIA-VIA CLEARANCE.
C
C      CRRDVV                    FLAG INDICATING WHETHER OR NOT
C                                DIAGONALLY ADJACENT VIAS ARE
C                                ALLOWED. READ FROM *PHG* RECORD.
C                                  0 -- DISALLOWED
C                                  1 -- ALLOWED
C
C      CRRTLX                    ABSOLUTE X- AND Y-COORDINATES
C      CRRTLY                    (IN MMES.) OF THE LOWER-LEFT
C      CRRTUX                    AND UPPER-RIGHT CORNERS OF THE
C      CRRTUY                    CARRIER TRIMLINE RECTANGLE.
C
C      CRRPLX                    ABSOLUTE X- AND Y-COORDINATES
C      CRRPLY                    (IN MMES.) OF THE LOWER-LEFT
C      CRRPUX                    AND UPPER-RIGHT CORNERS OF THE
C      CRRPUY                    PLACEABLE AREA.
C
C      CRRRLX                    ABSOLUTE X- AND Y-COORDINATES
C      CRRRLY                    (IN MMES.) OF THE LOWER-LEFT
C      CRRRUX                    AND UPPER-RIGHT CORNERS OF THE
C      CRRRUY                    ROUTABLE AREA.
C
C      CRRXXX                    AMOUNT OF CHANGE (IN MMES.)
C      CRRYYY                    IN THE X- AND Y-DIRECTION
C                                OF THE CARRIER FROM THE
C                                ORIGINAL UPPER-LEFT/RIGHT
C                                CORNERS.
C
```

```
C       CHRUNU                          UNUSED NET NUMBER
C
C       CHRNRM                          NET NUMBER OF FIRST NET WITH A
C                                       NORMAL WIRING RULE.
C
C       TOTVIA                          TOTAL NUMBER OF VIAS IN THE
C                                       OUTPUT DESIGN FILE.
C
C       WIRLEN(2, 2)                    WIRE LENGTH BY LAYER AND
C                                       ORIENTATION, RESPECTIVELY, IN
C                                       THE OUTPUT DESIGN FILE.
C
C       TOPCHN                          CHANNEL NUMBER OF THE TOPMOST
C                                       HORIZONTAL CHANNEL.
C
C       BOTCHN                          CHANNEL NUMBER OF THE BOTTOM
C                                       HORIZONTAL CHANNEL.
C
C       LEFCHN                          CHANNEL NUMBER OF THE LEFTMOST
C                                       VERTICAL CHANNEL.
C
C       RIGCHN                          CHANNEL NUMBER OF THE RIGHTMOST
C                                       VERTICAL CHANNEL.
C
C
CSE
C
C--------------------------------------------------------------------------------
C
CS CHXDVB
C
C
C                       *****************
C                       * COMMON CHXDVB *
C                       *****************
C
C       DEVICE-ASSOCIATED BARRIER DATA FOR THE CHANNEL
C       EXPANSION SUBSYSTEM (CHX)
C
C       DVBCNT                          NUMBER OF DEVICE-ASSOCIATED BARRIERS
C                                       IN THE DESIGN.
C
C       DVBMAX                          MAXIMUM NUMBER OF DEVICE-ASSOCIATED
C                                       BARRIERS ALLOWED IN THE DESIGN.
C                                       THIS VARIABLE IS SET TO TOKEN $DFVBARS.
C
C       DVBDAT(CHXDVBFLD,               TWO-DIMENSIONAL ARRAY CONTAINING
C              $DFVBARS)                DATA FOR EACH DEVICE-ASSOCIATED
C                                       BARRIER IN THE DESIGN.
C                                       CHXDVBFLD = 5.
C
C                                       SINCE THESE BARRIERS ARE SORTED
C                                       BY CELL NUMBER, THEY ARE ACCESSIBLE
C                                       ONLY INDIRECTLY THROUGH THE CELL.
C                                       THE ARRAY IS ACCESSED AS:
C
C                                         DVBDAT("FIELDNAME", "BARINDEX")
C
C                                       WHERE "FIELDNAME" IS ONE OF THE
C                                       TOKENS DESCRIBED BELOW, AND
C                                       "BARINDEX" IS CALCULATED USING
C                                       THE POINTER TO THE FIRST BARRIER
C                                       FOR A CELL (THE "CHXCELDVBPT"
C                                       FIELD IN ARRAY *CELDAT*) AND THE
C                                       BARRIER NUMBER WITHIN THE CELL.
C
C             CHXDVBLLX     = 01        X-COORDINATE (IN MMES.) OF BARRIER
C                                       LOWER-LEFT CORNER RELATIVE TO THE
C                                       X-COORDINATE OF THE CELL ORIGIN.
C
C             CHXDVBLLY     = 02        Y-COORDINATE (IN MMES.) OF BARRIER
C                                       LOWER-LEFT CORNER RELATIVE TO THE
C                                       Y-COORDINATE OF THE CELL ORIGIN.
C
C             CHXDVBURX     = 03        X-COORDINATE (IN MMES.) OF BARRIER
C                                       UPPER RIGHT CORNER RELATIVE TO THE
C                                       X-COORDINATE OF THE CELL ORIGIN.
C
C             CHXDVBURY     = 04        Y-COORDINATE (IN MMES.) OF BARRIER
C                                       UPPER-RIGHT CORNER RELATIVE TO THE
```

```
C                                    Y-COORDINATE CF THE CELL CRIGIN.
C
C              CHXLVBLYR       = 05  BARRIER LAYER.
C
C
C$E
C
C-------------------------------------------------------------------
C
C$ CHXMOV
C
C
C                       *****************
C                       * COMMON CHXMOV *
C                       *****************
C
C        DATA USED BY THE CHANNEL EXPANSION SUBSYSTEM (CHX)
C        TO SPEED-UP THE DESIGN FILE UPDATE PROCESS.
C
C
C        CELMVX($DEVICES)           ARRAY DEFINING THE AMOUNT (IN
C                                   MMES.) BY WHICH A CELL HAS MOVED
C                                   IN THE X-DIRECTION DURING CHANNEL
C                                   EXPANSION.
C
C        CELMVY($DEVICES)           ARRAY DEFINING THE AMOUNT (IN
C                                   MMES.) BY WHICH A CELL HAS MOVED
C                                   IN THE Y-DIRECTION DURING CHANNEL
C                                   EXPANSION.
C
C
C$E
C
C-------------------------------------------------------------------
C
C$ CHXNET
C
C
C                       *****************
C                       * COMMON CHXNET *
C                       *****************
C
C        NET DATA FOR THE CHANNEL EXPANSION SUBSYSTEM (CHX)
C
C
C        NETCNT                     NUMBER OF NETS IN THE DESIGN.
C
C        NETMAX                     MAXIMUM NUMBER OF NETS ALLOWED
C                                   IN THE DESIGN. THIS VARIABLE IS
C                                   SET TO TOKEN $NETS.
C
C        NETDAT(CHXNETFLD,          TWO-DIMENSIONAL ARRAY CONTAINING
C               $NETS)              DATA FOR EACH NET IN TH DESIGN.
C                                   CHXNETFLD = 2.
C
C                                   THIS ARRAY IS ACCESSED AS:
C
C                                     NETDAT("FIELDNAME", "NETNBR")
C
C                                   WHERE "FIELDNAME" IS ONE OF THE
C                                   TOKENS DESCRIBED BELOW, AND
C                                   "NETNBR" IS THE NET NUMBER (AS
C                                   ENCOUNTERED IN THE DESIGN FILE).
C
C
C              CHXNETRUL     = 01   POINTER TO THE WIRING RULE
C                                   (IN ARRAY *RULDAT*) FOR A NET.
C
C              CHXNETPRI     = 02   PRIORITY CODE FOR A NET.
C                                   SEE *PSG* RECORD DESCRIPTION
C                                   FOR DETAILS OF CODES.
C
C
C$E
C
C-------------------------------------------------------------------
C
C$ CHXMOD
C
C
C
C                       *****************
C                       * COMMON CHXMOD *
```

```
C                 *****************
C ---- NODE AND PAD-CODE DATA FOR THE CHANNEL EXPANSION SUBSYSTEM (CHX)
C
C       NODCNT                    NUMBER OF NODES IN THE DESIGN.
C
C       NODMAX                    MAXIMUM NUMBER OF NODES ALLOWED
C                                 IN THE DESIGN. THIS VARIABLE IS
C                                 SET TO TOKEN SNODES.
C
C       NODDAT(CHXNODFLD,         TWO-DIMENSIONAL ARRAY CONTAINING
C              SNODES)            DATA FOR EACH NODE IN THE DESIGN.
C                                 CHXNODFLD = 5.
C
C                                 SINCE THESE NODES ARE SORTED
C                                 BY CELL NUMBER, THEY ARE ACCESSIBLE
C                                 ONLY INDIRECTLY THROUGH THE CELL.
C                                 THE ARRAY IS ACCESSED AS:
C
C                                   NODDAT("FIELDNAME", "PININDEX")
C
C                                 WHERE "FIELDNAME" IS ONE OF THE
C                                 TOKENS DESCRIBED BELOW, AND
C                                 "PININDEX" IS CALCULATED USING
C                                 THE POINTER TO THE FIRST NODE
C                                 FOR A CELL (THE "CHXCELNODPT"
C                                 FIELD IN ARRAY *CELDAT*) AND THE
C                                 PIN NUMBER WITHIN THE CELL.
C
C              VIAINF(4,*)        THIS ARRAY IS USED TO HOLD THE
C                                 VIA DATA THAT NEEDS TO BE WRITTEN
C                                 TO THE NEW DESIGN FILE. NOTE THAT
C                                 THIS ARRAY IS EQUIVALENCED TO
C                                 ARRAY *NODDAT* TO SAVE SPACE.
C                                 VIAINF(1,*) = NET
C                                 VIAINF(2,*) = X COORDINATE
C                                 VIAINF(3,*) = Y COORDINATE
C                                 VIAINF(4,*) = PAD CODE
C
C              CHXNODREX    = 01  X-COORDINATE (IN MMES.) OF THE
C                                 NODE REFERENCE POINT RELATIVE
C                                 TO THE X-COORDINATE OF THE CELL
C                                 ORIGIN.
C
C              CHXNODREY    = 02  Y-COORDINATE (IN MMES.) OF THE
C                                 NODE REFERENCE POINT RELATIVE
C                                 TO THE Y-COORDINATE OF THE CELL
C                                 ORIGIN.
C
C              CHXNODLYR    = 03  LAYER ON WHICH NODE OCCURS.
C
C              CHXNODPAD    = 04  PADCODE NUMBER OF THE PAD
C                                 ASSOCIATED WITH THE NODE.
C                                 THIS IS A DIRECT INDEX INTO
C                                 THE PADCODE TABLE *PADDAT*.
C
C              CHXNODNET    = 05  NET NUMBER OF THE NET ASSOCIATED
C                                 WITH THE NODE.
C
C       PADCNT                    NUMBER OF PAD DESCRIPTIONS
C                                 IN THE DESIGN.
C
C       PADMAX                    MAXIMUM NUMBER OF PAD DESCRIPTIONS
C                                 ALLOWED IN THE DESIGN. THIS
C                                 VARIABLE IS SET TO TOKEN SPADCODES.
C
C       PADDAT(CHXPADFLD,         TWO-DIMENSIONAL ARRAY CONTAINING
C              SPADCODES)         DATA FOR EACH PADCODE IN THE DESIGN.
C                                 CHXPADFLD = 4.
C
C                                 THIS ARRAY IS ORGANIZED SUCH THAT
C                                 DESCRIPTION OF PADCODE *I* IS
C                                 STORED IN THE *I-TH* ENTRY AND IS
C                                 THEREFORE ACCESSED AS:
C
C                                   PADDAT("FIELDNAME", "PADNBR")
C
C                                 WHERE "FIELDNAME" IS ONE OF THE
C                                 TOKENS DESCRIBED BELOW, AND
C                                 "PADNBR" IS THE PADCODE NUMBER.
```

```
C
C
C        CHXPADLLX      = 01      X-COORDINATE OF THE LOWER-LEFT
C                                 CORNER OF THE PAD TRACK (METAL
C                                 PLUS GUARD) RELATIVE TO THE
C                                 ORIGIN OF THE PAD.
C
C        CHXPADLLY      = 02      Y-COORDINATE OF THE LOWER-LEFT
C                                 CORNER OF THE PAD TRACK (METAL
C                                 PLUS GUARD) RELATIVE TO THE
C                                 ORIGIN OF THE PAD.
C
C        CHXPADURX      = 03      X-COORDINATE OF THE UPPER-RIGHT
C                                 CORNER OF THE PAD TRACK (METAL
C                                 PLUS GUARD) RELATIVE TO THE
C                                 ORIGIN OF THE PAD.
C
C        CHXPADURY      = 04      Y-COORDINATE OF THE UPPER-RIGHT
C                                 CORNER OF THE PAD TRACK (METAL
C                                 PLUS GUARD) RELATIVE TO THE
C                                 ORIGIN OF THE PAD.
C
C
C
CSE
C
C----------------------------------------------------------------
C
C$ CHXRAL
C
C                 *****************
C                 * COMMON CHXRAL *
C                 *****************
C
C    POWER/GROUND RAIL DATA FOR THE CHANNEL EXPANSION
C    SUBSYSTEM (CHX).
C
C    RALCNT                       NUMBER OF POWER/GROUND RAILS
C                                 IN THE DESIGN.
C
C    RALMAX                       MAXIMUM NUMBER OF POWER/GROUND
C                                 RAILS ALLOWED IN THE DESIGN.
C                                 THIS VARIABLE IS SET TO TH
C                                 TOKEN @TCTRAIL.
C
C    RALDAT(CHXRALFLD,            TWO-DIMENSIONAL ARRAY CONTAINING
C           @TCTRAIL)             DATA FOR EACH POWER/GROUND RAIL
C                                 IN THE DESIGN.  *RALDAT* IS SORTED
C                                 BY NET IN ASCENDING ORDER.
C                                 CHXRALFLD = 8.
C
C                                 THE RAILS MAY BE ACCESSED INDIRECTLY
C                                 THROUGH THE POWER/GROUND NET DATA IN
C                                 *PGNDAT* ARRAY.  *RALDAT* ARRAY IS
C                                 ACCESSED AS:
C
C                                   RALDAT("FIELDNAME","RAILINDEX")
C
C                                 WHERE "FIELDNAME" IS ONE OF THE
C                                 TOKENS DESCRIBED BELOW, AND
C                                 "RAILINDEX" IS CALCULATED USING
C                                 THE POINTER TO THE FIRST RAIL FOR
C                                 A POWER/GROUND NET (THE "CHXPGNRALPT"
C                                 FIELD IN ARRAY *PGNDAT*) AND THE
C                                 RAIL NUMBER WITHIN THE NET.
C
C        CHXRALE1X      = 01      ABSOLUTE X-LOCATION OF FIRST ENDPOINT
C                                 OF THIS RAIL.
C
C        CHXRALE1Y      = 02      ABSOLUTE Y-LOCATION OF FIRST ENDPOINT
C                                 OF THIS RAIL.
C
C        CHXRALCL1      = 03      CELL NUMBER ON WHICH FIRST ENDPOINT
C                                 OF RAIL OCCURS.
C
C        CHXRALE2X      = 04      ABSOLUTE X-LOCATION OF SECOND
C                                 ENDPOINT OF THIS RAIL.
C
C        CHXRALE2Y      = 05      ABSOLUTE Y-LOCATION OF SECOND
```

```
C                                             ENDPOINT CF THIS RAIL.
C               CHXRALCL2      = 06           CELL NUMBER CN WHICH SECOND
C                                             ENDPOINT OF RAIL OCCURS.
C               CHXRALLYR      = 07           RAIL LAYER.  (MUST NOT BE 0.)
C               CHXRALNET      = 08           RAIL NET NUMBER.
C
C
C        PGNCNT                               NUMBER OF POWER/GROUND NETS
C                                             IN THE DESIGN.
C        PGNMAX                               MAXIMUM NUMBER OF POWER/GROUND
C                                             NETS ALLOWED IN THE DESIGN.
C                                             THIS VARIABLE IS SET TO TE
C                                             TOKEN CHXPGNMAX.
C
C        PGNDAT(CHXPGNFLD,                    TWO-DIMENSIONAL ARRAY CONTAINING
C               CHXPGNMAX)                    DATA FOR EACH POWER/GROUND NET IN
C                                             THE DESIGN.
C                                             CHXPGNFLD = 05.
C
C                                             THIS ARRAY IS ACCESSED AS:
C
C                                               PGNDAT("FIELDNAME","PGNINDEX")
C
C                                             WHERE "FIELDNAME" IS A TOKEN
C                                             DEFINED BELOW, AND "PGNINDEX"
C                                             POINTS TO THE ENTRY FOR THE
C                                             DESIRED POWER/GROUND NET.
C
C               CHXPGNETN      = 01           POWER/GROUND NET NUMBER.
C               CHXPGNTYP      = 02           FLAG INDICATING WHETHER
C                                             THIS POWER/GROUND NET IS A
C                                             CORE AREA OR AN I/O RING NET.
C                                               CHXTYCORE -- CORE AREA NET
C                                               CHXTYRING -- I/O RING NET
C               CHXPGNLYR      = 03           LAYER OF THIS POWER/GROUND NET.
C               CHXPGNRALPT    = 04           POINTER TO THE FIRST RAIL IN
C                                             *RALDAT* FOR THIS POWER/GROUND
C                                             NET.
C               CHXPGNRALCT    = 05           NUMBER OF RAILS IN *RALDAT* FOR
C                                             THIS POWER/GROUND NET.
C
C
CSF
C
C--------------------------------------------------------------------
C
CS CHXRFD
C
C                     *****************
C                     * COMMON CHXRFD *
C                     *****************
C
C        FEEDTHRU DATA FOR THE CHANNEL EXPANSION SUBSYSTEM (CHX)
C
C        RFDCNT                               NUMBER OF DEVICE-ASSOCIATED
C                                             FEEDTHRUS IN THE DESIGN.
C        RFDMAX                               MAXIMUM NUMBER OF DEVICE-
C                                             ASSOCIATED FEEDTHRUS ALLOWED
C                                             IN THE DESIGN. THIS VARIABLE
C                                             IS SET TO TOKEN @TCIFEEDTHRU.
C
C        RFDDAT(CHXRFDFLD,                    TWO-DIMENSIONAL ARRAY CONTAINING
C               @TCIFEEDTHRU)                 DATA FOR EACH DEVICE-ASSOCIATED
C                                             FEEDTHRU IN THE DESIGN.
C                                             CHXRFDFLD = 12.
C
C                                             SINCE THESE FEEDTHRUS ARE SORTED
C                                             BY CELL NUMBER, THEY ARE ACCESSIBLE
```

```
_$1$DUA6:[PRD.CHX(2)]CHXFT6.DOC;5                21-OCT-1986 08:44                PAGE 14
C                         ONLY INDIRECTLY THROUGH THE CELL.
C                         THE ARRAY IS ACCESSED AS:
C
C                           RFDDAT("FIELDNAME", "RFDINDEX")
C
C                         WHERE "FIELDNAME" IS ONE OF THE
C                         TOKENS DESCRIBED BELOW, AND
C                         "RFDINDEX" IS CALCULATED USING
C                         THE POINTER TO THE FIRST FEEDTHRU
C                         FOR A CELL (THE "CHXCFIRFDFT"
C                         FIELD IN ARRAY *CELDAT*) AND THE
C                         FEEDTHRU NUMBER WITHIN THE CELL.
C
C          CHXRFDCEV     = 01     CELL NUMBER TO WHICH FEEDTHRU
C                                 BELONGS.
C
C          CHXRFDNET     = 02     NET NUMBER OF NET TO WHICH
C                                 THE FEEDTHRU IS ASSIGNED.
C                                 A VALUE OF ZERO (0) IN THIS
C                                 FIELD INDICATES AN UNASSIGNED
C                                 DEVICE-ASSOCIATED FEEDTHRU.
C
C          CHXRFDE1X     = 03     X-COORDINATE (IN MMES.) OF THE
C                                 FIRST ENDPOINT OF THE FEEDTHRU
C                                 RELATIVE TO THE X-COORDINATE OF
C                                 THE ORIGIN OF THE CELL TO WHICH
C                                 THIS FEEDTHRU BELONGS.
C
C          CHXRFDE1Y     = 04     Y-COORDINATE (IN MMES.) OF THE
C                                 FIRST ENDPOINT OF THE FEEDTHRU
C                                 RELATIVE TO THE Y-COORDINATE OF
C                                 THE ORIGIN OF THE CELL TO WHICH
C                                 THIS FEEDTHRU BELONGS.
C
C          CHXRFDE1Z     = 05     LAYER ON WHICH THE FIRST ENDPOINT
C                                 OF THE FEEDTHRU OCCURS.
C
C          CHXRFDE1P     = 06     PADCODE OF THE PAD ASSOCIATED
C                                 WITH THE FIRST ENDPOINT OF THE
C                                 FEEDTHRU. ZERO INDICATES NO PAD
C                                 IS DEFINED AT THE FIRST ENDPOINT.
C
C          CHXRFDE2X     = 07     X-COORDINATE (IN MMES.) OF THE
C                                 SECOND ENDPOINT OF THE FEEDTHRU
C                                 RELATIVE TO THE X-COORDINATE OF
C                                 THE ORIGIN OF THE CELL TO WHICH
C                                 THIS FEEDTHRU BELONGS.
C
C          CHXRFDE2Y     = 08     Y-COORDINATE (IN MMES.) OF THE
C                                 SECOND ENDPOINT OF THE FEEDTHRU
C                                 RELATIVE TO THE Y-COORDINATE OF
C                                 THE ORIGIN OF THE CELL TO WHICH
C                                 THIS FEEDTHRU BELONGS.
C
C          CHXRFDE2Z     = 09     LAYER ON WHICH THE SECOND
C                                 ENDPOINT OF THE FEEDTHRU OCCURS.
C
C          CHXRFDE2P     = 10     PADCODE OF THE PAD ASSOCIATED
C                                 WITH THE SECOND ENDPOINT OF
C                                 THE FEEDTHRU. ZERO INDICATES NO PAD
C                                 IS DEFINED AT THE SECOND ENDPOINT.
C
C          CHXRFDLYR     = 11     LAYER ON WHICH THE FEEDTHRU
C                                 ITSELF OCCURS. THIS LAYER MAY
C                                 BE DIFFERENT FROM THE LAYER ON
C                                 WHICH THE ENDPOINTS OCCUR.
C
C          CHXRFDPTH     = 12     FLAG INDICATING WHETHER OR NOT
C                                 SPECIAL POST-PROCESSORS ARE TO
C                                 GENERATE ACTUAL PATHS FOR THIS
C                                 FEEDTHRU.
C                                   0 -- NO PATH TO BE GENERATED
C                                   1 -- PATH IS TO BE GENERATED
C                                          IF THE FEEDTHRU IS USED
C
CSE
C
C-------------------------------------------------------------
C
```

```
CS CHXRUL
C
C                  *****************
C                  * COMMON CHXRUL *
C                  *****************
C
C       WIRING RULE DATA FOR THE CHANNEL EXPANSION SUBSYSTEM (CHX)
C
C       RULCNT                         NUMBER OF WIRING RULES IN
C                                      THE DESIGN.
C
C       RULMAX                         MAXIMUM NUMBER OF WIRING RULES
C                                      ALLOWED IN THE DESIGN. THIS
C                                      VARIABLE IS SET TO TOKEN $WIRERULES.
C
C       RULDAT(CHXRULFLD,              THREE-DIMENSIONAL ARRAY CONTAINING
C              $LAYERS,                DATA FOR EACH WIRING RULE IN THE
C              $WIRERULES)             DESIGN. DATA IS SEPARATED BY LAYER.
C                                      THE DATA IS INITIALLY LOADED FROM
C                                      THE *RRU* RECORDS AND, IF *WCR*
C                                      RECORDS ARE PRESENT, IT IS THEN
C                                      MODIFIED ACCORDINGLY.
C                                      CHXRULFLD = 5.
C
C                                      THE ARRAY IS ACCESSED DIRECTLY AS:
C
C                                        RULDAT("FIELDNAME", "LAYER",
C                                               "RULNBR")
C
C                                      WHERE "FIELDNAME" IS ONE OF THE
C                                      TOKENS DESCRIBED BELOW, "LAYER"
C                                      IS THE LAYER NUMBER, AND "RULNBR"
C                                      IS THE WIRING RULE NUMBER.
C
C                                      NOTE: THIS ARRAY IS USUALLY ACCESSED
C                                      ----  AFTER DETERMINING THE RULE
C                                            NUMBER OF INTEREST FROM THE
C                                            "CHXNETRUL" FIELD OF ARRAY
C                                            *NETDAT*.
C
C              CHXRULHZM     = 01      METAL WIDTH OF HORIZONTAL WIRES.
C
C              CHXRULHZC     = 02      CLEARANCE IN THE HORIZONTAL DIRECTION
C                                      (BETWEEN VERTICAL WIRES OR ENDPOINTS
C                                      OF DIFFERENT HORIZONTAL WIRES).
C
C              CHXRULVTM     = 03      METAL WIDTH OF VERTICAL WIRES.
C
C              CHXRULVTC     = 04      CLEARANCE IN THE VERTICAL DIRECTION
C                                      (BETWEEN HORIZONTAL WIRES OR ENDPOINTS
C                                      OF DIFFERENT VERTICAL WIRES).
C
C              CHXRULVIA     = 05      PADCODE OF VIA USED WHEN CONNECTING
C                                      WIRE SEGMENTS ON DIFFERENT LAYERS.
C
CSE
C
C-----------------------------------------------------------------------
C
CS CHXTRM
C
C
C                  *****************
C                  * COMMON CHXTRM *
C                  *****************
C
C       "TERMINAL" AND "FUTURE TERMINAL" DATA FOR THE CHANNEL
C       EXPANSION SUBSYSTEM (CHX)
C
C       DGTMET                         POINTER TO THE FIRST "DOGLEG"
C                                      TERMINAL (IN ARRAY *TRMDAT*)
C                                      CREATED BY TRS. ALL "DOGLEG"
C                                      TERMINALS CREATED BY TRS ARE
C                                      STORED AT THE END OF *TRMDAT*.
C
C       DGTMCT                         TOTAL NUMBER OF "DOGLEG"
C                                      TERMINALS CREATED BY TRS.
C
```

```
FUTRFR                       POINTER TO THE NEXT FREE ENTRY
                             IN THE ARRAY *VIADAT*.

TRMCNT                       NUMBER OF TERMINALS IN THE DESIGN.
                             THIS INCLUDES TERMINALS CREATED
                             FROM PRE-EXISTING WIRES, TERMINALS
                             LOADED FROM THE TERMINAL FILE, AND
                             "DOGLEG" TERMINALS ADDED BY TRS.

TRMMAX                       MAXIMUM NUMBER OF TERMINALS ALLOWED
                             IN THE DESIGN. THIS VARIABLE IS SET
                             TO TOKEN @TOTTERMINAL.

TRMDAT(CHXTRMFLD,            TWO-DIMENSIONAL ARRAY CONTAINING
       @TOTTERMINAL)         DATA FOR EACH TERMINAL IN THE DESIGN.
                             CHXTRMFLD = 10.

                             INITIALLY, ONLY TERMINALS CREATED
                             BECAUSE OF PRE-EXISTING WIRES AND
                             THOSE LOADED FROM THE TERMINAL FILE
                             ARE STORED IN THIS ARRAY. "DOGLEG"
                             TERMINALS CREATED BY TRS ARE ADDED
                             AT THE END OF THESE TERMINALS.

                             THIS ARRAY IS ORGANIZED SUCH THAT
                             ALL TERMINALS (EXCEPT, OF COURSE,
                             THE "DOGLEG" TERMINALS) FOR CHANNEL
                             *I* ARE GROUPED TOGETHER, FOLLOWED
                             BY THOSE FOR CHANNEL *I+1*, ETC.,
                             I=1,CHNCNT.
                             WITHIN EACH GROUP, THE TERMINALS
                             ARE SUB-SORTED BY TYPE ("INCOMING
                             FUTURE" TERMINALS, FOLLOWED BY
                             "OUTGOING FUTURE" TERMINALS,
                             FOLLOWED BY "NORMAL" OR "CELL-
                             ASSOCIATED" TERMINALS).

                             FOR "NON-DOGLEG" TERMINALS,
                             THE ARRAY IS ACCESSED AS:

                               TRMDAT("FIELDNAME", "TYPINDEX")

                             WHERE "FIELDNAME" IS ONE OF THE
                             TOKENS DESCRIBED BELOW, AND
                             "TYPINDEX" IS THE INDEX OF A
                             SPECIFIC TYPE OF TERMINAL WITHIN
                             A CHANNEL. "TYPINDEX" IS CALCULATED
                             USING THE "CHXCHNIFTMPT, CHXIFTMCT" [?]
                             OR THE "CHXCHNOFTMPT, CHXCHNOFTMCT",
                             OR THE "CHXCHNCLTMPT, CHXCHNCLTMCT"
                             FIELDS OF THE *CHNDAT* ARRAY.

                             FOR "DOGLEG" TERMINALS, THE ARRAY
                             IS ACCESSED USING VARIABLES *DGTMPT*
                             AND *DGTMCT* TO INDEX INTO THE ARRAY.

     CHXTRMABS      = 01     ABSCISSA OF THE TERMINAL (IN MMES.).
                             FOR A TERMINAL BELONGING TO A
                             HORIZONTAL (VERTICAL) CHANNEL, THIS
                             REPRESENTS THE X- (Y-) COORDINATE.

                             THE VALUE IN THIS FIELD IS RELATIVE
                             TO THE CHANNEL ORIGIN IF THE TERMINAL
                             IS AN "OUTGOING FUTURE TERMINAL", OR
                             A "DOGLEG TERMINAL". IF, HOWEVER, THE
                             TERMINAL IS A "NORMAL TERMINAL", THE
                             VALUE IN THIS FIELD IS RELATIVE
                             TO THE ABSCISSA OF THE CELL REFERENCE
                             POINT.

     CHXTRMORD      = 02     ORDINATE OF THE TERMINAL (IN MMES.).
                             FOR A TERMINAL BELONGING TO A
                             HORIZONTAL (VERTICAL) CHANNEL, THIS
                             REPRESENTS THE Y- (X-) COORDINATE.

                             THE VALUE IN THIS FIELD IS RELATIVE
                             TO THE CHANNEL ORIGIN IF THE TERMINAL
                             IS AN "OUTGOING FUTURE TERMINAL", OR
                             A "DOGLEG TERMINAL". IF, HOWEVER, THE
                             TERMINAL IS A "NORMAL TERMINAL", THE
```

```
                                     VALUE IN THIS FIELD IS RELATIVE
                                     TO THE ORDINATE OF THE CELL REFERENCE
                                     POINT.
          CHXTRMLYR       = 03       LAYER ON WHICH THE TERMINAL OCCURS.
          CHXTRMNET       = 04       NET NUMBER OF THE NET ASSOCIATED
                                     WITH THE TERMINAL.
          CHXTRMCHN       = 05       CHANNEL WITH WHICH THE TERMINAL
                                     IS ASSOCIATED.
          CHXTRMCON       = 06       CONNECTION NUMBER TO WHICH TERMINAL
                                     BELONGS. FOR EACH CHANNEL, THE
                                     CONNECTION NUMBERS BEGIN AT ONE (1),
                                     WITH THE CONNECTIONS DUE TO PRE-
                                     EXISTING WIRES PRECEDING THOSE
                                     DEFINED IN THE TERMINAL FILE.
                                     NOTE: THE CONNECTION NUMBERS OF
                                     ----  CONNECTIONS DEFINED IN THE
                                           TERMINAL FILE IS INCREMENTED
                                           BY THE NUMBER OF PRE-EXISTING
                                           CONNECTIONS IN THE CHANNEL.
          CHXTRMCEL       = 07       CELL ON WHICH THE TERMINAL OCCURS.
                                     IF THE VALUE IN THIS FIELD IS NON-ZERO,
                                     THE TERMINAL IS NOT A FUTURE TERMINAL.
                                     (EITHER "INCOMING" OR "OUTGOING").
          CHXTRMCH2       = 08       ID NUMBER OF OTHER CHANNEL TO WHICH
                                     THIS TERMINAL INTERFACES.
                                     IF THE VALUE IN THIS FIELD IS
                                     ZERO (0), THEN THE TERMINAL IS
                                     A "NORMAL" TERMINAL WHICH DOES NOT
                                     INTERFACE WITH ANOTHER CHANNEL.
                                     IF THE VALUE IS .GT. 0, THE TERMINAL
                                     IS AN "OUTGOING FUTURE TERMINAL"
                                     AND IF .LT. 0, THE TERMINAL IS
                                     AN "INCOMING FUTURE TERMINAL".
          CHXTRMCN2       = 09       CONNECTION NUMBER OF OTHER
                                     CONNECTION IN THE OTHER CHANNEL
                                     ("CHXTRMCH2") WITH WHICH THIS
                                     TERMINAL INTERFACES. THE VALUE
                                     IN THIS FIELD MUST BE ZERO (0),
                                     WHENEVER THE VALUE IN THE "CHXTRMCH2"
                                     FIELD IS ZERO AND MUST BE .GT. 0
                                     WHENEVER THE VALUE IN THE "CHXTRMCH2"
                                     FIELD IS NON-ZERO.
          CHXTRMDLG       = 10       CONNECTION NUMBER OF THE SECOND
                                     CONNECTION (WITHIN THE CURRENT
                                     CHANNEL) CREATED BY A DOGLEG.
     VIACNT                          NUMBER OF VIA PROTECTION ENTRIES
                                     IN THE DESIGN.
     VIAMAX                          MAXIMUM NUMBER OF VIA PROTECTION
                                     ENTRIES ALLOWED IN THE DESIGN.
                                     THIS VARIABLE IS SET TO THE TOKEN
                                     CHXTOTVIAP.
     VIADAT(CHXVIAFLD,               TWO DIMENSIONAL ARRAY CONTAINING
            CHXTOTVIAP)              LINKED LISTS OF VIA PROTECTION
                                     TERMINALS FOR EACH CHANNEL IN THE
                                     DESIGN.  CHXVIAFLD = 05.
                                     ENTRIES ARE STORED IN THIS ARRAY
                                     AT CHANNEL OUTPUT (SUBROUTINE
                                     CHNOUT) WHEN VIAS IN ONE CHANNEL
                                     ARE WITHIN VIA-TO-VIA SPACING
                                     DISTANCE OF A FUTURE CHANNEL.
                                     ENTRIES IN THE LINKED LIST FOR
                                     A CHANNEL ARE FETCHED FROM THIS
                                     ARRAY AT CHANNEL INPUT (SUBROUTINE
                                     CHNINP).  THE ENTRIES FOR A GIVEN
                                     CHANNEL ARE ACCESSED INDIRECTLY
                                     BY THE CHANNEL POINTER *CHXVIAPTR*.
                                     (NOTE:  ENTRIES ARE NOT RELEASED
                                     SINCE CHANNELS MAY BE REROUTED
                                     FOR CYCLICAL CHANNEL SEQUENCING.)
```

```
C                                       THE ARRAY IS ACCESSED AS:
C
C                                         VIADAT("FIELDNAME", "VIAPINDEX")
C
C                                       WHERE "FIELDNAME" IS ONE OF THE
C                                       TOKENS DESCRIBED BELOW, AND
C                                       "VIAPINDEX" IS THE POINTER TO THE
C                                       ENTRY OF INTEREST.
C
C               CHXVIAREX       = 01    X-COORDINATE (IN MMES.) OF THE VIA
C                                       PROTECTION TERMINAL WITH RESPECT TO
C                                       THE LOWER LEFT CORNER OF THE CHANNEL
C                                       OF ORIGIN.
C
C               CHXVIAREY       = 02    Y-COORDINATE (IN MMES.) OF THE VIA
C                                       PROTECTION TERMINAL WITH RESPECT TO
C                                       THE LOWER LEFT CORNER OF THE CHANNEL
C                                       OF ORIGIN.
C
C               CHXVIANET       = 03    NET NUMBER OF THE VIA FROM WHICH
C                                       THE VIA PROTECTION TERMINAL IS MODELED.
C
C               CHXVIACHN       = 04    CHANNEL OF ORIGIN OF THE VIA.
C
C               CHXVIANXT       = 05    POINTER TO THE NEXT VIA PROTECTION
C                                       ENTRY FOR A CHANNEL.
C
CSE
C
C--------------------------------------------------------------------
C
C$ CHXWEL
C
C                  *****************
C                  * COMMON CHXWEL *
C                  *****************
C
C     "WELLS-ALONG-CHANNEL" DATA FOR THE CHANNEL EXPANSION
C     SUBSYSTEM (CHX). A "WELL" IS THE SPACE BETWEEN THE
C     THE EDGE OF A CELL AND THE SIDE OF A CHANNEL. "WELLS"
C     OCCUR WHEN THE EDGE OF A CELL IS NOT COINCIDENT TO THE
C     SIDE OF THE CHANNEL IMMEDIATELY ADJACENT TO THE CELL.
C
C     WELCNT                            NUMBER OF "WELLS" IN THE DESIGN.
C
C     WELMAX                            MAXIMUM NUMBER OF "WELLS" ALLOWED
C                                       IN THE DESIGN. THIS VARIABLE IS
C                                       SET TO TOKEN @DEVSCNCHAN.
C
C     WELDAT(CHXWELFLD,                 TWO-DIMENSIONAL ARRAY CONTAINING
C            @WELSCNCHAN)               DATA FOR EACH "WELL" OCCURING IN
C                                       THE DESIGN.
C                                       CHXCHNWELFLD = 6.
C
C                                       SINCE A "WELL" REPRESENTS AN
C                                       AVAILABLE ROUTING RESOURCE, IT IS
C                                       SORTED BY CHANNEL AND ACCESSED AS:
C
C                                         WELDAT("FIELDNAME", "WELINDEX")
C
C                                       WHERE "FIELDNAME" IS ONE OF THE
C                                       TOKENS DESCRIBED BELOW, AND
C                                       "WELINDEX" IS CALCULATED BASED
C                                       ON THE POINTER TO THE FIRST "WELL"
C                                       ASSOCIATED WITH A CHANNEL.
C
C               CHXWELCHAN      = 01    ID NUMBER OF CHANNEL WITH WHICH
C                                       THE WELL IS ASSOCIATED.
C
C               CHXWELSIDE      = 02    FLAG INDICATING WHICH SIDE OF THE
C                                       CHANNEL THE WELL IS ASSOCIATED WITH.
C                                         0 -- WELL IS ASSOCIATED WITH
C                                              THE "LO" SIDE OF THE CHANNEL
C                                         1 -- WELL IS ASSOCIATED WITH
C                                              THE "HI" SIDE OF THE CHANNEL
```

```
C                                     RECALL THAT FOR A HORIZONTAL
C                                     (VERTICAL) CHANNEL, THE "LO"
C                                     SIDE IS THE BOTTOM (LEFT) WHEREAS
C                                     THE "HI" SIDE IS THE TOP (BOTTOM).
C
C             CHXWELLLX      = 03     ABSOLUTE X-COORDINATE (IN MMES.) OF
C                                     THE LOWER-LEFT CORNER OF THE WELL.
C
C             CHXWELLLY      = 04     ABSOLUTE Y-COORDINATE (IN MMES.) OF
C                                     THE LOWER-LEFT CORNER OF THE WELL.
C
C             CHXWELURX      = 05     ABSOLUTE X-COORDINATE (IN MMES.) OF
C                                     THE UPPER-RIGHT CORNER OF THE WELL.
C
C             CHXWELURY      = 06     ABSOLUTE Y-COORDINATE (IN MMES.) OF
C                                     THE UPPER-RIGHT CORNER OF THE WELL.
C
C
CSE
C
C-----------------------------------------------------------------------
C
CS CHXXXX
C
C                        *****************
C                        * COMMON CHXXXX *
C                        *****************
C
C         INTERFACE DATA BETWEEN THE CHANNEL EXPANSION (CHX)
C         AND TRACK ASSIGNMENT (TRS) SUBSYSTEMS
C
C         MNABCH                      LOWER ABSCISSA OF THE CHANNEL.
C                                     FOR A HORIZONTAL (VERTICAL)
C                                     CHANNEL, THIS IS THE X- (Y-)
C                                     COORDINATE OF THE LOWER-LEFT
C                                     CORNER OF THE CHANNEL.
C                                     VALUE IS IN ABSOLUTE MMES.
C
C         MXABCH                      HIGHER ABSCISSA OF THE CHANNEL.
C                                     FOR A HORIZONTAL (VERTICAL)
C                                     CHANNEL, THIS IS THE X- (Y-)
C                                     COORDINATE OF THE UPPER-RIGHT
C                                     CORNER OF THE CHANNEL.
C                                     VALUE IS IN ABSOLUTE MMES.
C
C         MNORCH                      LOWER ORDINATE OF THE CHANNEL
C                                     BEFORE THE CHANNEL IS MODIFIED
C                                     TO USE THE "WELLS" AS CHANNEL
C                                     RESOURCES.
C                                     FOR A HORIZONTAL (VERTICAL)
C                                     CHANNEL, THIS IS THE Y- (X-)
C                                     COORDINATE OF THE LOWER-LEFT
C                                     CORNER OF THE "UN-MODIFIED" CHANNEL.
C                                     VALUE IS IN ABSOLUTE MMES.
C
C         MXORCH                      HIGHER ORDINATE OF THE CHANNEL
C                                     BEFORE THE CHANNEL IS MODIFIED
C                                     TO USE THE "WELLS" AS CHANNEL
C                                     RESOURCES.
C                                     FOR A HORIZONTAL (VERTICAL)
C                                     CHANNEL, THIS IS THE Y- (X-)
C                                     COORDINATE OF THE UPPER-RIGHT
C                                     CORNER OF THE "UN-MODIFIED" CHANNEL.
C                                     VALUE IS IN ABSOLUTE MMES.
C
C         LOORCH                      LOWER ORDINATE OF THE CHANNEL
C                                     AFTER THE CHANNEL IS MODIFIED
C                                     TO USE THE "WELLS" AS CHANNEL
C                                     RESOURCES.
C                                     FOR A HORIZONTAL (VERTICAL)
C                                     CHANNEL, THIS IS THE Y- (X-)
C                                     COORDINATE OF THE LOWER-LEFT
C                                     CORNER OF THE "MODIFIED" CHANNEL.
C                                     VALUE IS IN ABSOLUTE MMES.
C
C         HIORCH                      UPPER ORDINATE OF THE CHANNEL
C                                     AFTER THE CHANNEL IS MODIFIED
C                                     TO USE THE "WELLS" AS CHANNEL
```

```
C                                RESOURCES.
C                                FOR A HORIZONTAL (VERTICAL)
C                                CHANNEL, THIS IS THE Y- (X-)
C                                COORDINATE OF THE UPPER-RIGHT
C                                CORNER OF THE *MODIFIED* CHANNEL.
C                                VALUE IS IN ABSOLUTE MMES.
C       DLOPCH                   AMOUNT (IN MMES.) BY WHICH THE
C                                CHANNEL IS EXPANDED BY TRS.
C                                CHANNELS ARE ALWAYS EXPANDED
C                                RIGHTWARD (FOR VERTICAL CHANNELS)
C                                AND UPWARD (FOR VERTICAL CHANNELS).
C                                THUS, *DLOPCH* REPRESENTS THE AMOUNT
C                                BY WHICH THE UPPER ORDINATE OF THE
C                                CHANNEL IS INCREMENTED.
C       XDOGPT                   POINTER TO THE FIRST DOGLEG
C                                TERMINAL (IN ARRAY *TRMXXX*)
C                                ADDED BY TRS FOR THE CURRENT CHANNEL.
C       XDOGCT                   NUMBER OF DOGLEG TERMINALS ADDED
C                                BY TRS FOR THE CURRENT CHANNEL.
C       XBARCT                   NUMBER OF BARRIERS PASSED
C                                TO TRS IN ARRAY *BARXXX*.
C       XBARMX                   MAXIMUM NUMBER OF BARRIERS
C                                ALLOWED PER CHANNEL. THIS
C                                IS THE LIMIT OF ARRAY *BARXXX*
C                                AND IS SET TO TOKEN @BARSPERCHN.
C       VIACHK                   EQUAL TO TRSPOP(8) INDICATING
C                                WHETHER OR NOT TO ENFORCE SAME
C                                NET VIA-TO-VIA SPACING.
C                                  0 -- ENFORCE SAME NET VIA-TO-VIA
C                                       SPACING
C                                  1 -- ALLOW SAME NET VIAS CLOSER
C                                       THAN VIA-TO-VIA SPACING
C       BARXXX(05,               TWO-DIMENSIONAL ARRAY CONTAINING
C              @BARSPERCHN)      BARRIER DATA FOR A CHANNEL.
C                                  (01,*) -- ABSOLUTE LLX OF BARRIER
C                                  (02,*) -- ABSOLUTE LLY OF BARRIER
C                                  (03,*) -- ABSOLUTE URX OF BARRIER
C                                  (04,*) -- ABSOLUTE URY OF BARRIER
C                                  (05,*) -- BARRIER LAYER
C       XNODCT                   NUMBER OF NODES PASSED
C                                TO TRS IN ARRAY *NODXXX*.
C       XNODMX                   MAXIMUM NUMBER OF NODES
C                                ALLOWED PER CHANNEL. THIS
C                                IS THE LIMIT OF ARRAY *NODXXX*
C                                AND IS SET TO TOKEN @NODSPERCHN.
C       NODXXX(05,               TWO-DIMENSIONAL ARRAY CONTAINING
C              @NODSPERCHN)      NODE DATA FOR A CHANNEL.
C                                  (01,*) -- ABSOLUTE X-LOCATION OF
C                                            NODE REFERENCE POINT
C                                  (02,*) -- ABSOLUTE Y-LOCATION OF
C                                            NODE REFERENCE POINT
C                                  (03,*) -- NODE LAYER
C                                  (04,*) -- PADCODE OF NODE
C                                  (05,*) -- NET TO WHICH NODE BELONGS
C       XTRMCT                   NUMBER OF TERMINALS PASSED
C                                TO TRS IN ARRAY *TRMXXX*.
C                                THIS NUMBER DOES NOT INCLUDE
C                                THE *DOGLEG* TERMINALS CREATED
C                                BY TRS AND ADDED AT THE END OF
C                                THE *TRMXXX* ARRAY.
C       XTRMMX                   MAXIMUM NUMBER OF TERMINALS
C                                ALLOWED PER CHANNEL. THIS
C                                IS THE LIMIT OF ARRAY *TRMXXX*
C                                AND IS SET TO TOKEN @TERMINALS.
C       TRMXXX(11,               TWO-DIMENSIONAL ARRAY CONTAINING
C              @TERMINALS)       TERMINAL DATA FOR A CHANNEL.
C                                  (01,*) -- ABSOLUTE TERMINAL ABSCISSA
```

```
C                        (02,*) -- ABSOLUTE TERMINAL ORDINATE
C                        (03,*) -- TERMINAL LAYER
C                        (04,*) -- NET TO WHICH TERMINAL
C                                  BELONGS
C                        (05,*) -- CONNECTION NUMBER TO
C                                  TERMINAL BELONGS
C                        (06,*) -- SECOND CHANNEL POINTER
C                                  FOR FUTURE TERMINAL.
C                                   = 0 -- NOT A FUTURE
C                                          TERMINAL
C                                   < 0 -- INCOMING FUTURE
C                                          TERMINAL
C                                   > 0 -- OUTGOING FUTURE
C                                          TERMINAL
C                        (07,*) -- SECOND CONNECTION NUMBER
C                                  (IN SECOND CHANNEL).
C                                  ONLY VALID IF SECOND
C                                  CHANNEL IS NOT =0.
C                        (08,*) -- DOGLEG CONNECTION NUMBER.
C                                  IF NOT =0, THE CONNECTION
C                                  TO WHICH THIS TERMINAL
C                                  BELONGS HAS BEEN DOGLEGGED.
C                        (09,*) -- RESERVED FOR *TRS*
C                        (10,*) -- RESERVED FOR *TRS*
C                        (11,*) -- RESERVED FOR *TRS*
C
C        XCONCT          NUMBER OF CONNECTIONS ATTEMPTED
C                        BY TRS. INCLUDES CONNECTIONS
C                        CAUSED BY PRE-EXISTING WIRES,
C                        CONNECTIONS FROM THE TERMINAL
C                        FILE, AND "DOGLEG" CONNECTIONS
C                        ADDED BY TRS.
C
C        XCONMX          MAXIMUM NUMBER OF CONNECTIONS
C                        WHICH CAN BE ATTEMPTED BY TRS
C                        PER CHANNEL. THIS IS THE LIMIT
C                        OF ARRAY *CONXXX* AND IS SET
C                        TO TOKEN $CONNECTIONS.
C
C        CONXXX(03,      TWO-DIMENSIONAL ARRAY CONTAINING
C          $CONNECTIONS) CONNECTION DATA FOR A CHANNEL.
C                         (01,*) -- ABSOLUTE CONNECTION
C                                   ORDINATE
C                         (02,*) -- CONNECTION LAYER
C                         (03,*) -- CONNECTION NET
C
C        XVIACT          NUMBER OF VIA PROTECTION TERMINALS
C                        PASSED TO TRS IN ARRAY *VIAXXX*.
C
C        XVIAMX          MAXIMUM NUMBER OF VIA PROTECTION
C                        TERMINALS WHICH CAN BE PASSED
C                        FOR A SINGLE CHANNEL.
C
C        VIAXXX(04,      TWO-DIMENSIONAL ARRAY CONTAINING
C          CHXVIAPPRCHN) VIA PROTECTION DATA FOR A CHANNEL.
C                        CHXVIAPPRCHN = 200.
C
C                        FOR CHANNEL INPUT, *VIAXXX*
C                        CONTAINS THE VIA PROTECTION
C                        TERMINALS INTO THIS CHANNEL.  FOR
C                        CHANNEL OUTPUT, *VIAXXX* CONTAINS
C                        VIA PROTECTION TERMINALS ORIGINATING
C                        FROM THIS CHANNEL.
C                         (01,*) -- ABSOLUTE TERMINAL ABSCISSA
C                         (02,*) -- ABSOLUTE TERMINAL ORDINATE
C                         (03,*) -- TERMINAL NET
C                         (04,*) -- CHANNEL OF FUTURE TERMINAL
C                                   (FOR OUTPUT ONLY)
C
C
C$E
C
C-----------------------------------------------------------------------
```

```
AAAAAAAAAA    0000000000000000000000000000000000000000000000000000000000000000000000000000000000000000000000000000    AAAAAAAAAA
AAAAAAAAAA    000000000000000000000000   DIGITAL EQUIPMENT CORPORATION - VAX/VMS VERSION V4.4   000000000000000000000000    AAAAAAAAAA
AAAAAAAAAA    0000000000000000000000000000000000000000000000000000000000000000000000000000000000000000000000000000    AAAAAAAAAA

K     K  M     M  PPPP
K    K   MM   MM  P   P
K   K    M M M M  P   P
KKK      M  M  M  PPPP
K  K     M     M  P
K   K    M     M  P
K    K   M     M  P

   SSSSSSSS    222222        666666      222222      5555555555
   SSSSSSSS    222222        666666      222222      5555555555
 SS          22      22    66          22      22    55
 SS          22      22    66          22      22    55
 SS                  22    66                  22    555555
 SS                  22    66                  22    555555
   SSSSSS          22      66666666          22            55
   SSSSSS          22      66666666          22            55
         SS      22        66      66      22                55
         SS      22        66      66      22                55
         SS    22          66      66    22          55      55
         SS    22          66      66    22          55      55
 SSSSSSSS    2222222222      666666    2222222222      555555
 SSSSSSSS    2222222222      666666    2222222222      555555

         FFFFFFFFFF      000000      RRRRRRRR
         FFFFFFFFFF      000000      RRRRRRRR
         FF            00      00    RR      RR
         FF            00      00    RR      RR
         FF            00      00    RR      RR
         FF            00      00    RR      RR
         FFFFFFFF      00      00    RRRRRRRR
         FFFFFFFF      00      00    RRRRRRRR
         FF            00      00    RR  RR
         FF            00      00    RR  RR
 ....    FF            00      00    RR    RR
 ....    FF            00      00    RR    RR
 ....    FF              000000      RR      RR
 ....    FF              000000      RR      RR

 ;;;;      222222
 ;;;;      222222
 ;;;;    22      22
 ;;;;    22      22
                 22
                 22
 ;;;;          22
 ;;;;          22
 ;;;;        22
 ;;;;        22
   ;;      22
   ;;      22
 ;;      2222222222
 ;;      2222222222
```

FILE _$1$DUA6:[PRC.CHX02]S2625.FOR;2 (2413,1,1), LAST REVISED ON 21-OCT-1986 08:44, IS A 23 BLOCK SEQUENTIAL FILE OWNED BY UIC [PRDTSI,PFC]. THE RECORDS ARE VARIABLE LENGTH WITH IMPLIED (CR) CARRIAGE CONTROL. THE LONGEST RECORD IS 72 BYTES.

JOB S2625 (207) QUEUED TO SYS$PRINT ON 4-DEC-1986 12:51 BY USER KMP, UIC [ENGVLSI,KMP], UNDER ACCOUNT ENGPKG AT PRIORITY 100, STARTED ON PRINTER _TON1C$LPA0: ON 4-DEC-1986 13:05 FROM QUEUE SYS$PRINT.

```
AAAAAAAAAA    0000000000000000000000000000000000000000000000000000000000000000000000000000000000000000000000000000    AAAAAAAAAA
AAAAAAAAAA    000000000000000000000000   DIGITAL EQUIPMENT CORPORATION - VAX/VMS VERSION V4.4   000000000000000000000000    AAAAAAAAAA
AAAAAAAAAA    0000000000000000000000000000000000000000000000000000000000000000000000000000000000000000000000000000    AAAAAAAAAA

VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
    VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
```

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
AAAAAAAAAA   0000000000000000000000000000000000000000000000000000000000000000000000000000000000000000   AAAAAAAAAA
AAAAAAAAAA   000000000000000000000000  DIGITAL EQUIPMENT CORPORATION - VAX/VMS VERSION V4.4  0000000000000000000000   AAAAAAAAAA
AAAAAAAAAA   0000000000000000000000000000000000000000000000000000000000000000000000000000000000000000   AAAAAAAAAA

FILE _$1$DUA6:[PRL.CHX02]S2625.FOR;2 (2413,1,1), LAST REVISED ON 21-OCT-1986 08:44, IS A 23 BLOCK SEQUENTIAL FILE OWNED BY UIC
[PRDTST,PRC].  THE RECORDS ARE VARIABLE LENGTH WITH IMPLIED (CR) CARRIAGE CONTROL.  THE LONGEST RECORD IS 72 BYTES.

JOB S2625 (207) QUEUED TO SYS$PRINT ON 4-DEC-1986 12:51 BY USER KMP, UIC [ENGVLSI,KMP], UNDER ACCOUNT ENGPKG AT PRIORITY 100,
STARTED ON PRINTER _TCNTO$LPA0: ON 4-DEC-1986 13:05 FROM QUEUE SYS$PRINT.

AAAAAAAAAA   0000000000000000000000000000000000000000000000000000000000000000000000000000000000000000   AAAAAAAAAA
AAAAAAAAAA   000000000000000000000000  DIGITAL EQUIPMENT CORPORATION - VAX/VMS VERSION V4.4  0000000000000000000000   AAAAAAAAAA
AAAAAAAAAA   0000000000000000000000000000000000000000000000000000000000000000000000000000000000000000   AAAAAAAAAA
```

```
_$1$DUA6:[PRD.CHXC7]S2625.FOR;2                    21-OCT-1986 08:44                    PAGE 1
        SUBROUTINE CHXCLD
C
CS*     ALLINTEG
C
C                  *****************
C                  *               *
C       SUBSYSTEM CHX  *  2625 CHXCLD  *
C                  *               *
C                  *****************
C
C       ************************************************************
C       ************************************************************
C       **                                                        **
C       **  (C) COPYRIGHT V-R INFORMATION SYSTEMS, INC. 1984      **
C       **  LICENSED MATERIAL -- PROGRAM PROPERTY OF VRIS         **
C       **  ALL RIGHTS RESERVED                                   **
C       **                                                        **
C       **  THIS PROGRAM IS THE PROPERTY OF VRIS AND IS FURNISHED **
C       **  PURSUANT TO A WRITTEN LICENSE AGREEMENT. IT MAY NOT BE **
C       **  USED, REPRODUCED, OR DISCLOSED TO OTHERS EXCEPT IN    **
C       **  ACCORDANCE WITH THE TERMS AND CONDITIONS OF THAT      **
C       **  AGREEMENT.                                            **
C       **                                                        **
C       ************************************************************
C       ************************************************************
C
C       ************************************************************
C       *                  MODULE DOCUMENTATION                    *
C       ************************************************************
C       SUMMARY --
C       THIS MODULE INITIALIZES ALL GLOBAL DATA FOR THE CHANNEL
C       EXPANSION SUBSYSTEM (CHX).
C
C       FORMAL PARAMETERS --
C       NAME  DIMENSION TYPE  DESCRIPTION
C       ----  --------- ----  -----------
C       (NONE)
C
C       LOCAL VARIABLES --
C       NAME  DIMENSION TYPE  DESCRIPTION
C       ----  --------- ----  -----------
C       (NONE)
C
C       GLOBAL VARIABLES --
C       NAME  DIMENSION TYPE  DESCRIPTION
C       ----  --------- ----  -----------
C
C       SEE NAMED COMMON DOCUMENTATION IN FILE CHXPT6.DOC
C       FOR A FULL LIST OF GLOBAL VARIABLES USED BY THE
C       CHANNEL EXPANSION SUBSYSTEM (CHX)
C
C       REVISION HISTORY --
C          24-MAR-86 DDC ADDED *CRRNRM* TO /CHXCRR/.   (SAR 5626)
C          18-SEP-85 DDC ADDED SUPPORT OF VIA PROTECTION
C                        TERMINALS AND TAF ADDED *CHNSFT*
C                        ARRAY.  (SAR 5199)
C          29-JUL-85 DDC CHECKED MODULE.
C          05-SEP-84 KMP WROTE MODULE. (SAR 4856)
C
C       TESTING PLANS --
C          29-JUL-85 DDC COMPLETED UNIT TESTING.
C
C       ************************************************************
C       *                   SUBSYSTEM TOKENS                       *
C       ************************************************************
CS*     CHXTOKEN
C
C       ************************************************************
C       *                 VARIABLE DECLARATIONS                    *
C       ************************************************************
C
C       FORMAL PARAMETERS --
C       (NONE)
```

```
C
C          LOCAL VARIABLES --
C          (NONE)
C
C          SUBSYSTEM GLOBAL VARIABLES --
C
CS*        SUBSYSCOLDAT [CHX]
C
CS*        CHXCEL
CS*        CHXCHC
CS*        CHXCHN
CS*        CHXCCN
CS*        CHXCHR
CS*        CHXDVB
CS*        CHXNEI
CS*        CHXNCP
CS*        CHXHAL
CS*        CHXRFD
CS*        CHXRUL
CS*        CHXTRM
CS*        CHXWEL
CS*        CHXXXX
C
C          OTHER SUBSYSTEM VARIABLES --
C          (NONE)
C
C          SYSTEM GLOBAL VARIABLES --
C
CS*        SYSCOMMON
C
C
C          ***********************************************************
C          *                    DATA STATEMENTS                      *
C          ***********************************************************
C
C          (NONE)
C
C
C          ***********************************************************
C          *                  STATEMENT FUNCTIONS                    *
C          ***********************************************************
C
C          LOCAL STATEMENT FUNCTIONS --
C          (NONE)
C
C          SUBSYSTEM STATEMENT FUNCTIONS --
C          (NONE)
C
C          OTHER SUBSYSTEM STATEMENT FUNCTIONS --
C          (NONE)
C
C          SYSTEM STATEMENT FUNCTIONS --
C
CS*        SFUNCHCS1
C
C
C          ***********************************************************
C          *                    EXECUTABLE CODE                      *
C          ***********************************************************
C
CS*        MODENTRY [CHX] [CHXCLD] [2625] [01]
C
C          ****************************************
C          * INITIALIZE MISCELENOUS GLOBAL VARIABLES *
C          ****************************************
           CRRXXX = 0
           CRRYYY = 0
           CRRUNU = 0
           CRRNRM = 0
           TCTVIA = 0
           DO 1010 I = 1,2
           DO 1000 J = 1,2
           WIRLEN(I,J) = 0
 1000      CONTINUE
 1010      CONTINUE
C
C          ************************
C          * INITIALIZE CELL DATA *
C          ************************
           CELCNT = 0
           MXCLXX = 0
           MXCLYY = 0
```

```
      CELMAX = $$SERVICES
C
      DO 1100 I = 1, CELMAX
      DO 1090 J = 1, %%CHXCELFID
      CELDAT(J, I) = 0
1090  CONTINUE
1100  CONTINUE
C
C     ****************************
C     * INITIALIZE CHANNEL DATA *
C     ****************************
      CHNCNT = 0
      NMBZCH = 0
      CHNMAX = $$SCHANNELS
C
      DO 1200 I = 1, CHNMAX
      DO 1190 J = 1, %%CHXCHNFLD
      CHNDAT(J, I) = 0
1190  CONTINUE
1200  CONTINUE
C
      DO 1300 I = 1, CHNMAX
      DO 1290 J = 1, 4
      CHNSRT(J, I) = 0
1290  CONTINUE
1300  CONTINUE
C
C     ****************************************
C     * INITIALIZE CHANNELS-ON-CHANNELS DATA *
C     ****************************************
      CHCCNT = 0
      CHCMAX = $$@CHNSONCHAN
C
      DO 1400 I = 1, CHCMAX
      CHCDAT(I) = 0
1400  CONTINUE
C
C     *************************
C     * INITIALIZE NODE DATA *
C     *************************
      NODCNT = 0
      NODMAX = $$SNODES
C
      DO 1500 I = 1, NODMAX
      DO 1490 J = 1, %%CHXNODFLD
      NODDAT(J, I) = 0
1490  CONTINUE
1500  CONTINUE
C
C
C     *****************************
C     * INITIALIZE PAD-CODE DATA *
C     *****************************
      PADCNT = 0
      PADMAX = $$SPADCODES
C
      DO 1600 I = 1, PADMAX
      DO 1590 J = 1, %%CHXPADFLD
      PADDAT(J, I) = 0
1590  CONTINUE
1600  CONTINUE
C
C     **********************************************
C     * INITIALIZE DEVICE-ASSOCIATED BARRIER DATA *
C     **********************************************
      DVBCNT = 0
      DVBMAX = $$SLEVBARS
C
      DO 1700 I = 1, DVBMAX
      DO 1690 J = 1, %%CHXDVBFLD
      DVBDAT(J, I) = 0
1690  CONTINUE
1700  CONTINUE
C
C
C     **************************
C     * INITIALIZE "WELL" DATA *
C     **************************
      WELCNT = 0
      WELMAX = $$WELLSONCHAN
C
      DO 1800 I = 1, WELMAX
```

```
      DO 1790 J = 1, %%CHXWELFID
      WELDAT(J, I) = 0
1790  CONTINUE
1800  CONTINUE
C
C
C     ********************************************
C     * INITIALIZE PRE-DEFINED CONNECTION DATA *
C     ********************************************
      CONCNT = 0
      CONMAX = %%@TC1CONNECT
C
      DO 1900 I = 1, CONMAX
      DO 1890 J = 1, %%CHXCONFLD
      CONDAT(J, I) = 0
1890  CONTINUE
1900  CONTINUE
C
      CONSUC = 0
      CONPRE = 0
C
C
C     ******************************************************
C     * INITIALIZE TERMINAL DATA FOR PRE-DEFINED CONNECTIONS *
C     ******************************************************
      TRMCNT = 0
      TRMMAX = %%@TCITERMINAL
C
      DO 2000 I = 1, TRMMAX
      DO 1990 J = 1, %%CHXTRMFLD
      TRMDAT(J, I) = 0
1990  CONTINUE
2000  CONTINUE
C
      DGIMET = 0
      DGIMCI = 0
C
      VIACNT = 0
      VIAMAX = %%CHXTOTVIAP
C
      DO 2050 I = 1, VIAMAX
      DO 2040 J = 1, %%CHXVIAFLD
      VIADAT(J, I) = 0
2040  CONTINUE
2050  CONTINUE
C
C
C     ****************************
C     * INITIALIZE FEEDTHRU DATA *
C     ****************************
      FEDCNT = 0
      FEDMAX = %%@TC1FEEDTHRU
C
      DO 2100 I = 1, FEDMAX
      DO 2090 J = 1, %%CHXFEDFLD
      FEDDAT(J, I) = 0
2090  CONTINUE
2100  CONTINUE
C
C
C     ***********************
C     * INITIALIZE NET DATA *
C     ***********************
      NETCNT = 0
      NETMAX = %%SNETS
C
      DO 2200 I = 1, NETMAX
      DO 2190 J = 1, %%CHXNETFLD
      NETDAT(J, I) = 0
2190  CONTINUE
2200  CONTINUE
C
C
C     ********************************
C     * INITIALIZE WIRING RULE DATA *
C     ********************************
      RULCNT = 0
      RULMAX = %%SWIRERULES
C
      DO 2300 I = 1, RULMAX
      DO 2290 J = 1, %%SLAYERS
      DO 2280 K = 1, %%CHXRULFLD
      RULDAT(K, J, I) = 0
```

```
 2280     CONTINUE
 2290     CONTINUE
 2300     CONTINUE
C
C         **************************
C         * POWER/GROUND RAIL DATA *
C         **************************
C         INITIALIZE POWER/GROUND RAIL DATA.
          RALCNT = 0
          RALMAX = $$EICTRAIL
C
          DO 2400 I = 1, RALMAX
          DO 2390 J = 1, $$CHXRALFLD
          RALDAT(J, I) = 0
 2390     CONTINUE
 2400     CONTINUE
C
C         INITIALIZE DATA FOR POWER/GROUND NETS
          PGPCNT = 0
          PGNMAX = $$CHXPGNMAX
C
          DO 2500 I = 1, PGNMAX
          DO 2490 J = 1, $$CHXPGNFLD
          PGNDAT(J, I) = 0
 2490     CONTINUE
 2500     CONTINUE
C
C         **********************
C         * TRK INTERFACE DATA *
C         **********************
C         INITIALIZE THE LIMITS FOR DATA IN COMMON /CHXXXX/
          XPARMX = $$RPARSPERCHN
          XRECMX = $$RECDSPERCHN
          XTRMMX = $$THSTERMINAL
          XCONMX = $$CONNECTIONS
          XVIAMX = $$CHXVIAPERCHN
C
C         INITIALIZATION OF GLOBAL DATA IS COMPLETE
          GO TO 9000
C
C         ***********************************************************
C         *                     ERROR RETURNS                       *
C         ***********************************************************
C
C         (NONE)
C
C
C         ***********************************************************
C         *              SINGLE EXIT FROM THIS ROUTINE              *
C         ***********************************************************
C
 9000     CONTINUE
C$*       MODEXIT (CHX)
          RETURN
C
C
C         ***********************************************************
C         *                   FORMAT STATEMENTS                     *
C         ***********************************************************
C
C         (NONE)
C
C
C         END CHXCLD 2625
          END
```

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
0000000000  5555555555555555555555  DIGITAL EQUIPMENT CORPORATION - VAX/VMS VERSION V4.4  5555555555555555555555  0000000000

KMP

S2626

FOR;2

FILE _$1$DUA6:[FED.CPX02]S2626.FOR;2 (1074,1,2), LAST REVISED ON 21-OCT-1986 08:44, IS A 59 BLOCK SEQUENTIAL FILE OWNED BY UIC
[PRDTST,FFC]. THE RECORDS ARE VARIABLE LENGTH WITH IMPLIED (CR) CARRIAGE CONTROL. THE LONGEST RECORD IS 72 BYTES.
JOB S2626 (208) QUEUED TO SYS$PRINT ON 4-DEC-1986 12:51 BY USER KMP, UIC [ENGVLSI,KMP], UNDER ACCOUNT ENGPKG AT PRIORITY 3, STARTED
ON PRINTER _TCN1CS$TPA0: ON 4-DEC-1986 13:23 FROM QUEUE SYS$PRINT.
0000000000  5555555555555555555555  DIGITAL EQUIPMENT CORPORATION - VAX/VMS VERSION V4.4  5555555555555555555555  0000000000
```

```
      SUBROUTINE CHXDMP(OPT)
C
CS*   ALLINTEG
C
C                      *****************
C                      *               *
C     SUBSYSTEM CHX    *  2626 CHXDMP  *
C                      *               *
C                      *****************
C
C     ************************************************************
C     ************************************************************
C     **                                                        **
C     **  (C) COPYRIGHT V-R INFORMATION SYSTEMS, INC. 1984      **
C     **  LICENSED MATERIAL -- PROGRAM PROPERTY OF VRIS         **
C     **  ALL RIGHTS RESERVED                                   **
C     **                                                        **
C     **  THIS PROGRAM IS THE PROPERTY OF VRIS AND IS FURNISHED **
C     **  PURSUANT TO A WRITTEN LICENSE AGREEMENT. IT MAY NOT BE **
C     **  USED, REPRODUCED, OR DISCLOSED TO OTHERS EXCEPT IN    **
C     **  ACCORDANCE WITH THE TERMS AND CONDITIONS OF THAT      **
C     **  AGREEMENT.                                            **
C     **                                                        **
C     ************************************************************
C     ************************************************************
C
C     ************************************************************
C     *                  MODULE DOCUMENTATION                    *
C     ************************************************************
C
C     SUMMARY --
C
C     THIS ROUTINE DUMPS OUT THE CHANNEL EXPANSION SUBSYSTEM
C     DATA STRUCTURES. THE DATA STRUCTURES TO BE DUMPED ARE
C     SPECIFIED VIA FORMAL PARAMETER *OPT*.
C
C     VALUES FOR PARAMETER *OPT* ARE AS FOLLOWS:
C
C             000 - DUMP ALL DATA STRUCTURES
C
C             100 - COMPLETE CELL DATA
C             110 -    CELL LOCATION DATA
C             120 -    CELL-TO-CHANNEL ADJACENCY AND
C                      CELL-TO-CELL ADJACENCY DATA
C             130 -    CELL POINTER AND COUNT DATA
C                      FOR NODES, FEEDTHRUS, AND BARRIERS
C
C             200 - COMPLETE CHANNEL DATA
C             210 -    CHANNEL LOCATION DATA
C             220 -    CHANNEL-TO-CHANNEL ADJACENCY DATA
C                      AND CHANNEL-TO-CELL ADJACENCY DATA
C             230 -    CHANNEL POINTER AND COUNT DATA
C                      FOR TERMINALS AND CONNECTIONS
C
C             300 - COMPLETE CONNECTION DATA
C
C             400 - COMPLETE TERMINAL DATA
C
C             500 - COMPLETE NODE AND PADCODE DATA
C
C             600 - COMPLETE FEEDTHRU DATA
C
C             700 - COMPLETE DEV-ASSOCIATED BARRIER DATA
C
C             800 - COMPLETE NET AND WIRING RULE DATA
C
C             900 - COMPLETE CARRIER DATA
C             910 -    BOARD DATA
C             920 -    RAIL DATA
C
C             999 - CHANNEL-EXPANSION/TRACK-ASSIGNMENT
C                   INTERFACE DATA
C
C     FORMAL PARAMETERS --
C     NAME  DIMENSION TYPE  IN/OUT  DESCRIPTION
C     ----  --------- ----  ------  -----------
C     OPT             INT   IN      OPTION SPECIFYING WHICH DATA
C                                   STRUCTURES ARE TO BE DUMPED.
C
```

```
C         LOCAL VARIABLES --
C         NAME  DIMENSION TYPE   DESCRIPTION
C         ----  --------- ----   -----------
C         DMPNAM    40     CHR   CHARACTER STRING CONTAINING THE
C                                NAME OF THE DUMP/REPORT.
C
C         DSTOP                  POINTER TO LAST DOGLEG TERMINAL.
C
C         HCHCT                  NUMBER OF CHANNELS FEEDING INTO
C                                HI SIDE OF A GIVEN CHANNEL.
C
C         HCHPT                  POINTER TO THE FIRST CHANNEL FEEDING
C                                INTO THE HI SIDE OF A GIVEN CHANNEL.
C
C         HCLPT                  POINTER TO THE FIRST CELL ALONG
C                                THE HI SIDE OF A GIVEN CHANNEL.
C
C         HFLCH                  ID NUMBER OF CHANNEL FED BY THE
C                                HI END OF A GIVEN CHANNEL.
C
C         IORN                   CHANNEL ORIENTATION.
C
C         ISPL                   FLAG INDICATING WHETHER OR NOT
C                                A CHANNEL HAS BEEN "SPLIT".
C
C         LCHCT                  NUMBER OF CHANNELS FEEDING INTO
C                                LO SIDE OF A GIVEN CHANNEL.
C
C         LCHPT                  POINTER TO THE FIRST CHANNEL FEEDING
C                                INTO THE LO SIDE OF A GIVEN CHANNEL.
C
C         LCLPT                  POINTER TO THE FIRST CELL ALONG
C                                THE LO SIDE OF A GIVEN CHANNEL.
C
C         LFLCH                  ID NUMBER OF CHANNEL FED BY THE
C                                LO END OF A GIVEN CHANNEL.
C
C         RPT                    UNIT NUMBER OF FILE TO WHICH
C                                DATA IS DUMPED. RPT = IOFILE(4).
C
C         STOP                   INDEX OF LAST ENTRY OF INTEREST.
C
C         STRT                   INDEX OF FIRST ENTRY OF INTEREST.
C
C         GLOBAL VARIABLES --
C         NAME  DIMENSION TYPE  DESCRIPTION
C         ----  --------- ----  -----------
C         (NONE)
C
C         REVISION HISTORY --
C            14-JAN-86 TAF REMOVED VARIOUS UNUSED ARRAY FIELDS.
C                          (SAR 5500)
C            18-SEP-85 DDC ADDED SUPPORT OF VIA PROTECTION
C                          TERMINALS, CYCLES, AND POWER/GROUND
C                          NET DATA DUMP.  (SAR 5199)
C            29-JUL-85 DDC CHECKED MODULE.
C            05-OCT-84 KMP WROTE MODULE.  (SAR 4856)
C
C         TESTING PLANS --
C            29-JUL-85 DDC COMPLETED UNIT TESTING.
C
C         ***************************************************************
C         *                      SUBSYSTEM TOKENS                       *
C         ***************************************************************
C
C$*       CHKTCKEN
C
C         ***************************************************************
C         *                   VARIABLE DECLARATIONS                     *
C         ***************************************************************
C
C         FORMAL PARAMETERS --
C         (NONE)
C
C         LOCAL VARIABLES --
C
          CHARACTER*40  DMPNAM
C
```

```
C
C        SUBSYSTEM GLOBAL VARIABLES --
C
CS*      SUBSYSCOMMON [CHX]
C
CS*      CHXCEL
CS*      CHXCHN
CS*      CHXCHC
CS*      CHXCDN
CS*      CHXCHR
CS*      CHXDVB
CS*      CHXNET
CS*      CHXROL
CS*      CHXNCD
CS*      CHXHED
CS*      CHXITM
CS*      CHXREL
CS*      CHXPAL
CS*      CHXXXX
C
C
C        OTHER SUBSYSTEM VARIABLES --
C        (NONE)
C
C        SYSTEM GLOBAL VARIABLES --
C
CS*      SYSCOMMON
C
C
C        ***************************************************************
C        *                     DATA STATEMENTS                         *
C        ***************************************************************
C
C        (NONE)
C
C
C        ***************************************************************
C        *                   STATEMENT FUNCTIONS                       *
C        ***************************************************************
C
C        LOCAL STATEMENT FUNCTIONS --
C        (NONE)
C
C        SUBSYSTEM STATEMENT FUNCTIONS --
C        (NONE)
C
C        OTHER SUBSYSTEM STATEMENT FUNCTIONS --
C        (NONE)
C
C        SYSTEM STATEMENT FUNCTIONS --
C
CS*      SFUNCHCS1
C
C
C        ***************************************************************
C        *                     EXECUTABLE CODE                         *
C        ***************************************************************
C
CS*      MODENTRY [CHX] [CHXDMP] [2626] [02]
C
         RPT = ICFILE(4)
C
         IF ((OPT .NE.   0) .AND.
     1       (OPT .NE. 100) .AND. (OPT .NE. 110)) GO TO 1200
C        **********************
C        * CELL LOCATION DATA *
C        **********************
         DMPNAM = 'CELL LOCATION DATA'
         WRITE(RPT,9001)  DMPNAM(1:40)
         IF (CELCNT .EQ. 0) GO TO 1190
         WRITE(RPT,9100)
         DO 1150 I = 1, CELCNT
         WRITE(RPT,9101)  I, (CELDAT(J,I), J=1,8)
 1150    CONTINUE
 1190    CONTINUE
         WRITE(RPT,9010) CELCNT
         WRITE(RPT,9002)
C
 1200    CONTINUE
         IF ((OPT .NE.   0) .AND.
     1       (OPT .NE. 100) .AND. (OPT .NE. 120)) GO TO 1300
C        ****************************************
```

```
C          * CELL-CHANNEL AND CELL-CELL ADJACENCY *
C          ******************************************
           DMPNAM = 'CELL-CHANNEL AND CELL-CELL ADJACENCY    '
           WRITE(RPT,9001) DMPNAM(1:40)
           IF (CELCNT .LE. 0) GO TO 1290
           WRITE(RPT,9110)
           DO 1250 I = 1, CELCNT
           WRITE(RPT,9111)  I, (CELDAT(J,I), J=9,16)
 1250      CONTINUE
 1290      CONTINUE
           WRITE(RPT,9010) CELCNT
           WRITE(RPT,9002)
C
 1300      CONTINUE
           IF ((OPT .NE.   0) .AND.
     1         (OPT .NE. 100) .AND. (OPT .NE. 130)) GO TO 2100
C          ***************************
C          * CELL POINTERS AND COUNTS *
C          ***************************
           DMPNAM = 'CELL POINTERS AND COUNTS              '
           WRITE(RPT,9001) DMPNAM(1:40)
           IF (CELCNT .LE. 0) GO TO 1390
           WRITE(RPT,9120)
           DO 1350 I = 1, CELCNT
           WRITE(RPT,9121)  I, (CELDAT(J,I), J=17,22)
 1350      CONTINUE
 1390      CONTINUE
           WRITE(RPT,9010) CELCNT
           WRITE(RPT,9002)
C
 2100      CONTINUE
           IF ((OPT .NE.   0) .AND.
     1         (OPT .NE. 200) .AND. (OPT .NE. 210)) GO TO 2200
C          *************************
C          * CHANNEL LOCATION DATA *
C          *************************
           DMPNAM = 'CHANNEL LOCATION DATA                 '
           WRITE(RPT,9001) DMPNAM(1:40)
           IF (CHNCNT .LE. 0) GO TO 2190
           WRITE(RPT,9130)
           DO 2150 I = 1, CHNCNT
           WRITE(RPT,9131)  I, (CHNDAT(J,I), J=1,6)
 2150      CONTINUE
 2190      CONTINUE
           WRITE(RPT,9011) CHNCNT
           WRITE(RPT,9002)
C
 2200      CONTINUE
           IF ((OPT .NE.   0) .AND.
     1         (OPT .NE. 200) .AND. (OPT .NE. 220)) GO TO 2300
C          ***********************************
C          * CHANNEL-CHANNEL ADJACENCY DATA *
C          ***********************************
           DMPNAM = 'CHANNEL-CHANNEL ADJACENCY DATA        '
           WRITE(RPT,9001) DMPNAM(1:40)
           IF (CHNCNT .LE. 0) GO TO 2290
           WRITE(RPT,9140)
           DO 2250 I = 1, CHNCNT
           ICRN  = CHNDAT(%%CHXCHNORIENT, I)
           ISPL  = CHNDAT(%%CHXCHNSPLTPT, I)
           LCLPT = CHNDAT(%%CHXCHNLOCLPT, I)
           HCLPT = CHNDAT(%%CHXCHNHICLPT, I)
           LFDCH = CHNDAT(%%CHXCHNLOFEED, I)
           HFDCH = CHNDAT(%%CHXCHNHIFEED, I)
           LCHPT = CHNDAT(%%CHXCHNLOCHPT, I)
           LCHCT = CHNDAT(%%CHXCHNLOCHCT, I)
           HCHPT = CHNDAT(%%CHXCHNHICHPT, I)
           HCHCT = CHNDAT(%%CHXCHNHICHCT, I)
           WRITE(RPT,9141)  I, ICRN, ISPL, LCLPT, HCLPT,
     1                     LFDCH, HFDCH,
     2                     LCHPT, LCHCT, HCHPT, HCHCT
           WRITE(RPT,9142)
           IF (LCHCT .LE. 0) GO TO 2215
           STRT = LCHPT
           STOP = LCHPT + LCHCT - 1
           WRITE(RPT,9144)  (CHCDAT(J), J=STRT,STOP)
 2215      CONTINUE
           WRITE(RPT,9143)
           IF (HCHCT .LE. 0) GO TO 2225
           STRT = HCHPT
           STOP = HCHPT + HCHCT - 1
           WRITE(RPT, 9144) (CHCDAT(J), J=STRT,STOP)
```

```
 2225     CONTINUE
 2250     CONTINUE
 2290     CONTINUE
          WRITE(RPT,9011) CHNCNT
          WRITE(RPT,9002)
C
 2300     CONTINUE
          IF ((OPT .NE.   0) .AND.
     1        (OPT .NE. 200) .AND. (OPT .NE. 230)) GO TO 3100
C         ********************************
C         * CHANNEL POINTERS AND COUNTS *
C         ********************************
          DMPNAM = 'CHANNEL POINTERS AND COUNTS                '
          WRITE(RPT,9001) DMPNAM(1:40)
          IF (CHNCNT .LE. 0) GO TO 2390
          WRITE(RPT,9150)
          DO 2350 I = 1, CHNCNT
          WRITE(RPT,9151)  I, (CHNDAT(J,I), J=15,22)
 2350     CONTINUE
 2390     CONTINUE
          WRITE(RPT,9011) CHNCNT
          WRITE(RPT,9002)
C
 3100     CONTINUE
          IF ((OPT .NE. 0) .AND. (OPT .NE. 300)) GO TO 3200
C         ********************
C         * CONNECTION DATA *
C         ********************
          DMPNAM = 'CONNECTION DATA                            '
          WRITE(RPT,9001) DMPNAM(1:40)
          IF (CONCNT .LE. 0) GO TO 3190
          WRITE(RPT,9160)
          DO 3150 I = 1, CONCNT
          WRITE(RPT,9161)  I, (CONDAT(J,I), J=1,8)
 3150     CONTINUE
 3190     CONTINUE
          WRITE(RPT,9012) CONCNT
          WRITE(RPT,9002)
C
 3200     CONTINUE
          IF ((OPT .NE.0) .AND. (OPT .NE. 400)) GO TO 4100
C         ******************
C         * TERMINAL DATA *
C         ******************
          DMPNAM = 'TERMINAL DATA                              '
          WRITE(RPT,9001) DMPNAM(1:40)
          IF (TRMCNT .LE. 0) GO TO 3290
          WRITE(RPT,9170)
          DO 3250 I = 1, TRMCNT
          WRITE(RPT,9171)  I, (TRMDAT(J,I), J=1,10)
 3250     CONTINUE
 3290     CONTINUE
          WRITE(RPT,9013) TRMCNT
          WRITE(RPT,9014) DGTMPT, DGTMCT
          IF (VIACNT .LE. 0) GO TO 3390
          WRITE(RPT,9172)
          WRITE(RPT,9173) (I, (VIADAT(J,I), J=1,5), I=1, VIACNT)
 3390     CONTINUE
          WRITE(RPT,9007) VIACNT
          WRITE(RPT,9002)
C
 4100     CONTINUE
          IF ((OPT .NE.0) .AND. (OPT .NE. 500)) GO TO 4200
C         **********************
C         * NODE AND FAC DATA *
C         **********************
          DMPNAM = 'NODE DATA                                  '
          WRITE(RPT,9001) DMPNAM(1:40)
          IF (NODCNT .LE. 0) GO TO 4160
          WRITE(RPT,9180)
          DO 4150 I = 1, NODCNT
          WRITE(RPT,9181)  I, (NODDAT(J,I), J=1,5)
 4150     CONTINUE
C
 4160     CONTINUE
          WRITE(RPT,9015) NODCNT
          WRITE(RPT,9002)

          DMPNAM = 'FAC DATA                                   '
          WRITE(RPT,9001) DMPNAM(1:40)
          IF (FACCNT .LE. 0) GO TO 4190
          WRITE(RPT,9190)
```

```
      DO 4170 I = 1, PADCNT
      WRITE(RPT,9191)  I, (PADDAT(J,I), J=1,4)
4170  CONTINUE
4190  CONTINUE
      WRITE(RPT,9016) PADCNT
      WRITE(RPT,9002)
C
4200  CONTINUE
      IF ((OPT .NE. 0) .AND. (OPT .NE. 600)) GO TO 4300
C     ****************
C     * FEEDTHRU DATA *
C     ****************
      DMPNAM = 'FEEDTHRU DATA
      WRITE(RPT,9001) DMPNAM(1:40)
      IF (FEDCNT .LE. 0) GO TO 4290
      WRITE(RPT,9200)
      DO 4250 I = 1, FEDCNT
      WRITE(RPT,9201)  I, (FEDDAT(J,I), J=1,12)
4250  CONTINUE
4290  CONTINUE
      WRITE(RPT,9017) FEDCNT
      WRITE(RPT,9002)
C
4300  CONTINUE
      IF ((OPT .NE. 0) .AND. (OPT .NE. 700)) GO TO 5000
C     ********************************
C     * DEVICE ASSOCIATED BARRIER DATA *
C     ********************************
      DMPNAM = 'DEVICE ASSOCIATED BARRIER DATA
      WRITE(RPT,9001) DMPNAM(1:40)
      IF (DVBCNT .LE. 0) GO TO 4390
      WRITE(RPT,9210)
      DO 4350 I = 1, DVBCNT
      WRITE(RPT,9211)  I, (DVBDAT(J,I), J=1,5)
4350  CONTINUE
4390  CONTINUE
      WRITE(RPT,9018) DVBCNT
      WRITE(RPT,9002)
C
5000  CONTINUE
      IF ((OPT .NE. 0) .AND. (OPT .NE. 800)) GO TO 6000
C     *************************
C     * NET AND WIRING RULE DATA *
C     *************************
      DMPNAM = 'NET DATA
      WRITE(RPT, 9001) DMPNAM(1:40)
      IF (NETCNT .LE. 0) GO TO 5090
      WRITE(RPT,9220)
      DO 5050 I = 1, NETCNT
      WRITE(RPT,9221) I, (NETDAT(J,I), J=1,2)
5050  CONTINUE
5090  CONTINUE
      WRITE(RPT,9019) NETCNT
      WRITE(RPT,9002)
C
      DMPNAM = 'WIRING RULE DATA
      WRITE(RPT, 9001) DMPNAM(1:40)
      IF (RULCNT .LE. 0) GO TO 5190
      WRITE(RPT,9230)
      DO 5150 I = 1, RULCNT
      DO 5140 J = 1, CRRSGL
      IF (J .EQ. 1) WRITE(RPT,9231) I, J, (RULDAT(K,J,I), K=1,5)
      IF (J .NE. 1) WRITE(RPT,9232)    J, (RULDAT(K,J,I), K=1,5)
5140  CONTINUE
      WRITE(RPT,9003)
5150  CONTINUE
5190  CONTINUE
      WRITE(RPT,9020) RULCNT
      WRITE(RPT,9002)
C
C
6000  CONTINUE
      IF ((OPT .NE. 0) .AND. (OPT .NE. 900)
     1    .AND. (OPT .NE. 910)) GO TO 6100
C     ***************
C     * CARRIER DATA *
C     ***************
      DMPNAM = 'CARRIER DATA
      WRITE(RPT,9001) DMPNAM(1:40)
      WRITE(RPT,9300) CRRSGL, CRRPWL, CRRLY1, CRRLY2,
     1               CRRGDX, CRRGDY,
```

```
     2                      CRPRVV, CREVVV, CRRDVV,
     3                      CRRILX, CRRILY, CRRTUX, CRRTUY,
     4                      CRREDX, CRREDY, CRRPUX, CRRPUY,
     5                      CRPELX, CRPELY, CRRRUX, CRRRUY,
     6                      CRPXXX, CRRYYY
C
C
 6100   CONTINUE
        IF ((OPT .LE. 0) .AND. (OPT .NE. 900)
     1     .AND. (OPT .NE. 920)) GO TO 7910
C       *************
C       * RAIL DATA *
C       *************
        DMENAM = 'RAIL DATA
        WRITE(RPT, 9001) DMPNAM(1:40)
        IF (RALCNT .LE. 0) GO TO 6190
        WRITE(RPT,9260)
        DO 6150 I = 1, RALCNT
        WRITE(RPT,9261) I, (RALDAT(J,I), J=1,8)
 6150   CONTINUE
 6190   CONTINUE
        WRITE(RPT,9009) RALCNT
        WRITE(RPT,9003)
C
C       POWER/GROUND NET DATA
C
        IF (PGNCNT .LE. 0) GO TO 6290
        WRITE(RPT,9290)
        DO 6250 I = 1, PGNCNT
        WRITE(RPT,9291) I, (PGNDAT(J,I), J=1,5)
 6250   CONTINUE
 6290   CONTINUE
        WRITE(RPT,9006) PGNCNT
        WRITE(RPT,9002)
C
C
 7910   CONTINUE
        IF ((OPT .NE. 0) .AND. (OPT .NE. 999)) GO TO 7999
C       **************************
C       * CHX-TRK INTERFACE DATA *
C       **************************
        DMENAM = 'CHX-TRK INTERFACE DATA
        WRITE(RPT,9001) DMENAM(1:40)
        WRITE(RPT,9003)
C
C       CURRENT CHANNEL
C       ---------------
        DMENAM = 'CURRENT CHANNEL
        WRITE(RPT,9004) DMENAM(1:40)
        WRITE(RPT,9310) MNARCH, MXARCH, MNORCH, MXORCH
        WRITE(RPT,9320) LCORCH, HIORCH, DLORCH
        WRITE(RPT,9005)
C
C       BARRIERS IN CURRENT CHANNEL
C       ---------------------------
        DMENAM = 'BARRIERS IN CURRENT CHANNEL
        WRITE(RPT,9004) DMENAM(1:40)
        IF (XBARCT .LE. 0) GO TO 7920
        DO 7915 I = 1, XBARCT
        WRITE(RPT,9241) I, (BARXXX(J,I), J=1,5)
 7915   CONTINUE
 7920   CONTINUE
        WRITE(RPT,9021) XBARCT, XBARMX
        WRITE(RPT,9005)
C
C       NODES IN CURRENT CHANNEL
C       ------------------------
        DMENAM = 'NODES IN CURRENT CHANNEL
        WRITE(RPT,9004) DMPNAM(1:40)
        IF (XNODCT .LE. 0) GO TO 7930
        DO 7925 I = 1, XNODCT
        WRITE(RPT,9251) I, (NODXXX(J,I), J=1,5)
 7925   CONTINUE
 7930   CONTINUE
        WRITE(RPT,9022) XNODCT, XNODMX
        WRITE(RPT,9005)
C
C       TERMINALS IN CURRENT CHANNEL
C       ----------------------------
        DMENAM = 'TERMINALS IN CURRENT CHANNEL
        WRITE(RPT,9004) DMENAM(1:40)
        IF (XTRMCT .LE. 0) GO TO 7940
```

```
              DO 7935 I = 1, XTRMCT
              WRITE(RPT,9261) I, (TRMXXX(J,I), J=1,11)
 7935         CONTINUE
 7940         CONTINUE
              WRITE(RPT,9023) XDCGPT, XDGGCT
              IF (XDGGCT .LE. 0) GO TO 7943
              DSTOP = XDCGPT + XDGGCT - 1
              DO 7942 I = XDCGPT, DSTOP
              WRITE(RPT,9261) I, (TRMXXX(J,I), J=1,11)
 7942         CONTINUE
 7943         CONTINUE
              WRITE(RPT,9024) XTRMCT, XTRMMX
              WRITE(RPT,9005)
C
C             CONNECTIONS IN CURRENT CHANNEL
C             ------------------------------
              DMPNAM = 'CONNECTIONS IN CURRENT CHANNEL
              WRITE(RPT,9004) DMPNAM(1:40)
              IF (XCONCT .LE. 0) GO TO 7950
              DO 7945 I = 1, XCONCT
              WRITE(RPT,9271) I, (CONXXX(J,I), J=1,3)
 7945         CONTINUE
 7950         CONTINUE
              WRITE(RPT,9025) XCONCT, XCONMX
              WRITE(RPT,9005)
C
C             VIA PROTECTION TERMINALS IN CURRENT CHANNEL
C             -------------------------------------------
              DMPNAM = 'VIA PROTECTION TERMINALS
              WRITE(RPT,9004) DMPNAM(1:40)
              IF (XVIACT .LE. 0) GO TO 7960
              WRITE(RPT,9272) (I, (VIAXXX(J,I), J=1,4), I=1,XVIACT)
 7960         CONTINUE
              WRITE(RPT,9026) XVIACT, XVIAMX
              WRITE(RPT,9005)
C
              WRITE(RPT,9003)
              WRITE(RPT,9002)
C
C
 7999         CONTINUE
              GO TO 9000
C
C
C             ****************************************************************
C             *                        ERROR RETURNS                         *
C             ****************************************************************
C
C             (NONE)
C
C             ****************************************************************
C             *                 SINGLE EXIT FROM THIS ROUTINE                *
C             ****************************************************************
C
 9000         CONTINUE
CS*           MLEEXIT (CPX)
              RETURN
C
C
C             ****************************************************************
C             *                      FORMAT STATEMENTS                       *
C             ****************************************************************
C
C
 9001         FORMAT(1X,'**********************************************',/,
     1               1X,'* ',                A40,                  ' *',/,
     2               1X,'**********************************************',//)
 9002         FORMAT(/,1X,80('*'),/)
 9003         FORMAT(/)
C
 9004         FORMAT(1X,'                                              ',/,
     1               1X,'  ',                A40,                  '  ',/,
     2               1X,'----------------------------------------------',//)
 9005         FORMAT(/,1X,80('-'),/)
C
 9007         FORMAT(/,1X,'NUMBER OF VIA PROTECTION TERMINALS      = ',I6,/)
 9008         FORMAT(/,1X,'NUMBER OF POWER/GROUND NETS             = ',I6,/)
 9009         FORMAT(/,1X,'NUMBER OF RAILS                         = ',I6,/)
 9010         FORMAT(/,1X,'NUMBER OF CELLS                         = ',I6,/)
 9011         FORMAT(/,1X,'NUMBER OF CHANNELS                      = ',I6,/)
 9012         FORMAT(/,1X,'NUMBER OF CONNECTIONS                   = ',I6,/)
 9013         FORMAT(/,1X,'NUMBER OF TERMINALS                     = ',I6,/)
```

```
9014      FORMAT(/,1X,'LOGIFG TERMINAL POINTER                    = ',I6,
     1           /,1X,'LOGIFG TERMINAL CONT                       = ',I6,/)
9015      FORMAT(/,1X,'NUMBER OF NODES                            = ',I6,/)
9016      FORMAT(/,1X,'NUMBER OF PADS                             = ',I6,/)
9017      FORMAT(/,1X,'NUMBER OF FEEDTHRUS                        = ',I6,/)
9018      FORMAT(/,1X,'NUMBER OF DEVICE ASSOCIATED BARRIERS       = ',I6,/)
9019      FORMAT(/,1X,'NUMBER OF NETS                             = ',I6,/)
9020      FORMAT(/,1X,'NUMBER OF WIRING RULES                     = ',I6,/)
9021      FORMAT(/,1X,'NUMBER OF BARRIERS IN CHANNEL              = ',I6,
     1           /,1X,'MAXIMUM NUMBER ALLOWED                     = ',I6,/)
9022      FORMAT(/,1X,'NUMBER OF NODES IN CHANNEL                 = ',I6,
     1           /,1X,'MAXIMUM NUMBER ALLOWED                     = ',I6,/)
9023      FORMAT(/,1X,'FIRST LOGIFG TERMINAL IN CHANNEL IS        = ',I6,
     1           /,1X,'NUMBER OF LOGIFG TERMINALS IN CHANNEL      = ',I6,/)
9024      FORMAT(/,1X,'NUMBER OF TERMINALS IN CHANNEL             = ',I6,
     1           /,1X,'MAXIMUM NUMBER ALLOWED                     = ',I6,/)
9025      FORMAT(/,1X,'NUMBER OF CONNECTIONS IN CHANNEL           = ',I6,
     1           /,1X,'MAXIMUM NUMBER ALLOWED                     = ',I6,/)
9026      FORMAT(/,1X,'NUMBER OF VIA PROTECTION TERMINALS         = ',I6,
     1           /,1X,'MAXIMUM NUMBER ALLOWED                     = ',I6,/)
C
9100      FORMAT(/,1X,' INDEX',5X,
     1     '   CELOLDX    CELOLDY      CELRFX      CELRFY ',
     2     '   CELLLX     CELLLY       CELURX      CELURY ',/)
9101      FORMAT(1X,I6,'...    ',8(I9,1X))
C
9110      FORMAT(/,1X,' INDEX',5X,
     1     ' CELNXTLF   CELNXTRG    CELNXTBT    CELNXTTP ',
     2     ' CELLFTCH   CELRGHCH    CELBOTCH    CELTOPCH ',/)
9111      FORMAT(1X,I6,'...    ',8(I9,1X))
C
9120      FORMAT(/,1X,' INDEX',5X,
     1     ' CELNODPT   CELNODCT    CELDVBPT    CELDVBCT ',
     2     ' CELPFDPT   CELPFDCT ',/)
9121      FORMAT(1X,I6,'...    ',6(I9,1X))
C
9130      FORMAT(/,1X,' INDEX',5X,
     1     '   CHNORN     CHNLLX      CHNLLY      CHNURX ',
     2     '   CHNURY CHNSFLTPT ',/)
9131      FORMAT(1X,I6,'...    ',6(I9,1X))
C
9140      FORMAT(/,1X,' INDEX',5X,
     1     '   CHNCRN CHNSFLTPT CHNLOCLPT CHNHICLPT ',
     2     'CHNLOFEED CHNHIFEED ',
     3     'CHNLOCHPT CHNLOCHCT CHNHICHPT CHNHICHCT ',/)
9141      FORMAT(1X,I6,'...    ',10(I9,1X))
9142      FORMAT(1X)
9143      FORMAT(1X)
9144      FORMAT(12X,10(I9,1X))
C
9150      FORMAT(/,1X,' INDEX',5X,
     1     'CHNOFTMPT CHNOFTMCT CHNCLTMPT CHNCLTMCT ',
     2     'CHNCONNPT CHNCONNCT CHNVIAPTR CHNESTPIN',/)
9151      FORMAT(1X,I6,'...    ',8(I9,1X))
C
9160      FORMAT(/,1X,' INDEX',5X,
     1     '   CONCHN     CONNUM      CONTYP      CONNET ',
     2     '   CONLYR     CONORD     CONTMPT     CONTMCT ',/)
9161      FORMAT(1X,I6,'...    ',8(I9,1X))
C
9170      FORMAT(/,1X,' INDEX',5X,
     1     '   TRMARS     TRMORD      TRMLYR      TRMNET ',
     2     '   TRMCHN     TRMCON      TRMCEL      TRMCH2 ',
     3     '   TRMCN2     TRMCLG ',/)
9171      FORMAT(1X,I6,'...    ',10(I9,1X))
9172      FORMAT(/1X,' INDEX',5X,
     1     '   VIAREX     VIAREY      VIANET      VIACHN ',
     2     '   VIANXT ',/)
9173      FORMAT((1X,I6,'...    ',5(I9,1X)/))
C
9180      FORMAT(/,1X,' INDEX',5X,
     1     '   NODREX     NODREY      NODLYR      NODPAC ',
     2     '   NODNET ',/)
9181      FORMAT(1X,I6,'...    ',5(I9,1X))
C
9190      FORMAT(/,1X,' INDEX',5X,
     1     '   PADLLX     PADLLY      PADURX      PADURY ',/)
9191      FORMAT(1X,I6,'...    ',4(I9,1X))
C
9200      FORMAT(/,1X,' INDEX',5X,
     1     'FEDDEV   FEDNET ',
     2     'FEDFIX   FEDFIY   FEDFIZ   FEDFIF ',
```

```
      3                   'RFDE2X  RFDE2Y  RFDE2Z  RFDE2F ',
      4                   'RFDLYP  RFEPTH ',/)
 9201   FORMAT(1X,I6,'...  ',12(I6,1X))
C
 9210   FORMAT(/,1X,' INDEX',5X,
      1           '   DVALLX    DVALLY    DVPURX    DVPURY ',
      2           '   DVBLYR ',/)
 9211   FORMAT(1X,I6,'...  ',5(I9,1X))
C
 9220   FORMAT(/,1X,' INDEX',5X,
      1           '   NETRUL    NETPRI ',/)
 9221   FORMAT(1X,I6,'...  ',2(I9,1X))
C
 9230   FORMAT(/,1X,' INDEX',5X,' LAYER',5X,
      1           '   RULHZF    RULHZC    RULVIM    RULVIC ',
      2           '   RULVIA ',/)
 9231   FORMAT(/,1X,I6,'...  ',I6,5X,5(I9,1X))
 9232   FORMAT(/,1X,6X,'     ',I6,5X,5(I9,1X))
C
 9241   FORMAT(1X,I6,'...  ',5(I6,1X))
C
 9251   FORMAT(1X,I6,'...  ',5(I6,1X))
C
 9261   FORMAT(1X,I6,'...  ',11(I6,1X))
C
 9271   FORMAT(1X,I6,'...  ',3(I6,1X))
 9272   FORMAT((1X,I6,'...  ',4(I6,1X)/))
C
 9280   FORMAT(/,1X,' INDEX',5X,
      1           'RRLE1X  RRLE1Y ',
      2           'RRLCL1  RRLE2X  RRLE2Y  RRLCL2 ',
      3           'RRLLYR  RRLNET ',/)
 9281   FORMAT(1X,I6,'...  ',8(I6,1X))
C
 9290   FORMAT(/,1X,' INDEX',5X,
      1           'PGNETN  PGNTYP  PGNLYR  RAILFT ',
      2           'RAILCT ',/)
 9291   FORMAT(1X,I6,'...  ',6(I6,1X))
C
 9300   FORMAT(/,1X,'NUMBER OF SIGNAL  LAYERS             = ',I8,
      1      /,1X,'NUMBER OF PWR/GND LAYERS             = ',I8,/,
      2      /,1X,'LAYER 1 WIRING CODE                  = ',I8,
      3      /,1X,'LAYER 2 WIRING CODE                  = ',I8,/,
      4      /,1X,'GRID SIZE  X-DIRECTION               = ',I8,
      5      /,1X,'           Y-DIRECTION               = ',I8,/,
      6      /,1X,'HORIZONTAL VIA-VIA CLEARANCE         = ',I8,
      7      /,1X,'VERTICAL   VIA-VIA CLEARANCE         = ',I8,
      8      /,1X,'DIAGONAL VIA ADJACENCY FLAG          = ',I6,/,
      9      /,1X,'CARRIER TRIMLINE COORDINATES         = ',4(I8,2X),
      1      /,1X,'PLACEABLE AREA    COORDINATES        = ',4(I8,2X),
      2      /,1X,'ROUTABLE  AREA    COORDINATES        = ',4(I8,2X),
      3      /,1X,'X-DIRECTION EXPANSION                = ',I8,
      4      /,1X,'Y-DIRECTION EXPANSION                = ',I8,/)
C
 9310   FORMAT(/,1X,'MINIMUM ABSCISSA OF CHANNEL          = ',I10,
      1      /,1X,'MAXIMUM ABSCISSA OF CHANNEL          = ',I10,/,
      2      /,1X,'MINIMUM ORDINATE OF CHANNEL          = ',I10,
      3      /,1X,'MAXIMUM ORDINATE OF CHANNEL          = ',I10,/)
C
 9320   FORMAT(/,1X,'MODIFIED LOWER ORDINATE OF CHANNEL = ',I10,
      1      /,1X,'MODIFIED UPPER ORDINATE OF CHANNEL = ',I10,/,
      2      /,1X,'CHANNEL EXPANSION WIDTH            = ',I10,/)
C
C
C
        END CHXFMF 2626
        END
```

```
BBBBBBBBBB    6666666666666666666666666666666666666666666666666666666666666666666666666666666666666666    BBBBBBBBBB
BBBBBBBBBB    6666666666666666666666666  DIGITAL EQUIPMENT CORPORATION - VAX/VMS VERSION V4.4  6666666666666666666666666    BBBBBBBBBB
BBBBBBBBBB    6666666666666666666666666666666666666666666666666666666666666666666666666666666666666666    BBBBBBBBBB
```

KMF

S2627

.FOR;3

```
FILE _$1$DUA6:[PEC.CHX02]S2627.FOR;3 (2414,1,1), LAST REVISED ON 21-OCT-1986 08:44, IS A 111 BLOCK SEQUENTIAL FILE OWNED BY UIC
[PRDTST,PEC].  THE RECORDS ARE VARIABLE LENGTH WITH IMPLIED (CR) CARRIAGE CONTROL.  THE LONGEST RECORD IS 73 BYTES.

JOB S2627 (209) QUEUED TO SYS$PRINT ON 4-DEC-1986 12:51 BY USER KMF, UIC [ENGVLSI,KMF], UNDER ACCOUNT ENGPKG AT PRIORITY 3, STARTED
ON PRINTER _TCNTC$LPA0: ON 4-DEC-1986 13:44 FROM QUEUE SYS$PRINT.

BBBBBBBBBB    6666666666666666666666666666666666666666666666666666666666666666666666666666666666666666    BBBBBBBBBB
BBBBBBBBBB    6666666666666666666666666  DIGITAL EQUIPMENT CORPORATION - VAX/VMS VERSION V4.4  6666666666666666666666666    BBBBBBBBBB
BBBBBBBBBB    6666666666666666666666666666666666666666666666666666666666666666666666666666666666666666    BBBBBBBBBB

VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
   VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
```

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
DIGITAL EQUIPMENT CORPORATION - VAX/VMS VERSION V4.4

KMP

S2627

FOR

;3

FILE _S1SDUA6:[PRC.CHX02]S2627.FOR;3 (2414,1,1), LAST REVISED ON 21-OCT-1986 08:44, IS A 1IT BLOCK SEQUENTIAL FILE OWNED BY UIC
[PROJST,PRC]. THE RECORDS ARE VARIABLE LENGTH WITH IMPLIED (CR) CARRIAGE CONTROL. THE LONGEST RECORD IS 73 BYTES.

JOB S2627 (209) QUEUED TO SYS$PRINT ON 4-DEC-1986 12:51 BY USER KMP, UIC [ENGVLSI,KMP], UNDER ACCOUNT ENGPKG AT PRIORITY 3, STARTED
ON PRINTER _TCNTCS$LEAD: ON 4-DEC-1986 13:44 FROM QUEUE SYS$PRINT.

DIGITAL EQUIPMENT CORPORATION - VAX/VMS VERSION V4.4
```

```
_$1$DUA6:[PPD.CHX02]S2627.FOR;3                    21-OCT-1986 08:44                    PAGE 1
      SUBROUTINE CHXLCD(DSFLIX)
C
CS*   ALLINTEG
C
C
C     SUBSYSTEM CHX    *****************
C                      *               *
C                      *  2627 CHXLCD  *
C                      *               *
C                      *****************
C
C     ***************************************************************
C     ***************************************************************
C     **                                                            **
C     **  (C) COPYRIGHT V-R INFORMATION SYSTEMS, INC. 1984          **
C     **  LICENSED MATERIAL -- PROGRAM PROPERTY OF VRIS             **
C     **  ALL RIGHTS RESERVED                                       **
C     **                                                            **
C     **  THIS PROGRAM IS THE PROPERTY OF VRIS AND IS FURNISHED     **
C     **  PURSUANT TO A WRITTEN LICENSE AGREEMENT. IT MAY NOT BE    **
C     **  USED, REPRODUCED, OR DISCLOSED TO OTHERS EXCEPT IN        **
C     **  ACCORDANCE WITH THE TERMS AND CONDITIONS OF THAT          **
C     **  AGREEMENT.                                                **
C     **                                                            **
C     ***************************************************************
C     ***************************************************************
C
C
C     ***************************************************************
C     *                  MODULE DOCUMENTATION                       *
C     ***************************************************************
C
C     SUMMARY --
C
C     THIS SUBROUTINE LOADS INFORMATION FROM THE INPUT DESIGN
C     FILE AND CREATES THE WORKING DATA STRUCTURES FOR THE
C     CHANNEL EXPANSION SUBSYSTEM (CHX).
C
C     THE INPUT DESIGN FILE, WHOSE INDEX INTO THE *IOFILE*
C     ARRAY IS SPECIFIED BY THE INPUT PARAMETER *DSFLIX*,
C     MUST BE CLOSED BEFORE THIS MODULE IS CALLED.
C
C     AFTER ALL REQUIRED DATA HAS BEEN LOADED FROM THE INPUT
C     DESIGN FILE, THIS FILE IS CLOSED.
C
C
C     FORMAL PARAMETERS --
C     NAME   DIMENSION TYPE  DESCRIPTION
C     ----   --------- ----  -----------
C     DSFLIX           I     INDEX OF THE INPUT DESIGN FILE.
C                            UNIT NUMBER OF THE INPUT DESIGN
C                            FILE IS = IOFILE(DSFLIX).
C
C
C     LOCAL VARIABLES --
C     NAME   DIMENSION TYPE  DESCRIPTION
C     ----   --------- ----  -----------
C     ACELL                  CELL INDEX.
C
C     ACHAN                  CHANNEL INDEX.
C
C     ACHC1                  NUMBER OF CHANNELS FEEDING
C                            A INTO A GIVEN CHANNEL.
C
C     ACHP1                  INDEX TO A CHANNEL IN *CHTEMP*.
C
C     ADBC1                  NUMBER OF DEVICE-ASSOCIATED
C                            BARRIERS FOR A GIVEN CELL.
C
C     ADBP1                  INDEX TO A DEVICE-BARRIER IN *DBTEMP*.
C
C     AFDC1                  NUMBER OF FEEDTHRUS FOR A GIVEN CELL.
C
C     AFDP1                  INDEX TO A FEEDTHRU IN *FDDAT*.
C
C     ANDC1                  NUMBER OF NODES FOR A GIVEN CELL.
C
C     ANDP1                  INDEX TO A NODE IN *NDTEMP*.
C
C     ARULE                  INDEX TO A WIRING RULE.
C
C     ASIDE                  FLAG INDICATING WHICH SIDE OF A
C                            CHANNEL IS BEING PROCESSED.
```

```
C                                   0 = LO SIDE OF CHANNEL
C                                   1 = HI SIDE OF CHANNEL
C
C       BOTORD                    LOWEST ORDINATE OF HORIZONTAL CHANNELS.
C
C       BXLLX($PKGTYPES) I*2      X- AND Y-COORDINATES OF THE LOWER-LEFT
C       BXLLY($PKGTYPES) I*2      AND UPPER-RIGHT COORDINATES OF THE
C       BXURX($PKGTYPES) I*2      BODY EXTENTS OF EACH PACKAGE TYPE.
C       BXURY($PKGTYPES) I*2
C
C       CHTEMP(3,$CHANNELS)       TEMPORARY STORAGE FOR CHANNEL DATA.
C                                 INDEXED BY CHANNEL NUMBER.
C                                   (1,*) - CHANNEL FED BY LO END OF
C                                           CHANNEL "*".
C                                   (2,*) - FLAG INDICATING WHETHER
C                                           LO (0) OR HI (1) SIDE
C                                           OF CHANNEL CHTEMP(1,*)
C                                           IS FED BY CHANNEL "*".
C                                   (3,*) - ID NUMBER OF CHANNEL "*".
C
C       CLCFLX                    INDEX (INTO THE *ICFILE* ARRAY)
C                                 OF THE FILE DESCRIBING WHICH
C                                 CELLS LIE ADJACENT TO WHICH CHANNEL.
C                                 CLCFLX = IO, UNIT NUMBER = ICFILE(IO).
C
C       CLNXCL                    INDEX OF THE NEXT CELL ALONG A CHANNEL
C                                 IN A GIVEN DIRECTION.
C
C       CLPKTP($DEVICES) I*2      POINTER TO THE PACKAGE TYPE FOR
C                                 EACH CELL. USED TO DETERMINE THE
C                                 BODY EXTENT AND ROTATION RECTANGLE
C                                 FOR EACH CELL.
C
C       CNTPBX                    NUMBER OF BODY EXTENT DESCRIPTIONS.
C
C       CNTPLL                    NUMBER OF SLOT DESCRIPTIONS.
C
C       CNTPPK                    NUMBER OF PACKAGE DESCRIPTIONS.
C
C       CURCEL                    NUMBER OF THE CELL CURRENTLY
C                                 BEING PROCESSED.
C
C       CURPKG                    PACKAGE CODE OF THE CELL CURRENTLY
C                                 BEING PROCESSED.
C
C       DPTEMP(6,                 TEMPORARY STORAGE FOR DEVICE-
C              $DEVBARS)          ASSOCIATED BARRIER DATA.
C                                 INDEXED BY DEV-BARRIER NUMBER.
C                                   (1,*) - CELL TO WHICH BARRIER BELONGS
C                                   (2,*) - BAR LLX RELATIVE TO CELL ORIGIN
C                                   (3,*) -  "  LLY    "      "   "     "
C                                   (4,*) -  "  URX    "      "   "     "
C                                   (5,*) -  "  URY    "      "   "     "
C                                   (6,*) - LAYER ON WHICH BARRIER OCCURS
C
C       INMODE                    MODE IN WHICH THE INPUT DESIGN
C                                 FILE IS OPENED.
C                                 INMODE = 1 -- READ-ONLY-SHAREABLE
C
C       LEFABS                    LEFTMOST ABSCISSA OF RAIL ENDPOINTS IN
C                                 LEFT VERTICAL CHANNEL.
C
C       LSTNOD                    INDEX OF THE LAST NODE IN A NET.
C
C       LYR                       DO-LOOP INDEX FOR A GIVEN LAYER.
C
C       MAXPBX                    MAXIMUM NUMBER OF BODY EXTENT
C                                 DECRIPTIONS ALLOWED.
C
C       MAXPLL                    MAXIMUM NUMBER OF SLOT
C                                 DESCRIPTIONS ALLOWED.
C
C       MAXPPK                    MAXIMUM NUMBER OF PACKAGE
C                                 DESCRIPTIONS ALLOWED.
C
C       NDTEMP(6,                 TEMPORARY STORAGE FOR NODE DATA.
C              $NODES)            INDEXED BY NODE NUMBER.
C                                   (1,*) - CELL ON WHICH NODE OCCURS
C                                   (2,*) - NODE-X RELATIVE TO CELL ORIGIN
C                                   (3,*) - NODE-Y    "      "   "     "
C                                   (4,*) - LAYER ON WHICH NODE APPEARS
C                                   (5,*) - NODE PAD-CODE
```

```
C                      (6,*) - NET NUMBER OF NET TO WHICH
C                              NODE BELONGS
C
C       NODNET               NET TO WHICH NODE BELONGS.
C
C       NTNDCT               NUMBER OF NODES IN NET.
C
C       NTTEMP(2,SNETS)      TEMPORARY STORAGE FOR NET DATA.
C                            INDEXED BY NET NUMBER.
C                              (1,*) - POINTER TO FIRST NODE IN NET
C                              (2,*) - NUMBER OF NODES IN NET
C
C       RECTYP               INTEGER IMAGE OF FOUR-CHARACTER
C                            STRING INDICATING WHICH RECORD
C                            TYPE IS TO BE PROCESSED.
C
C       RIGAPS               RIGHTMOST ABSCISSA OF RAIL ENDPOINTS IN
C                            RIGHT VERTICAL CHANNEL.
C
C       RRCLX($PKGTYPES) I*2 X- AND Y-DIMENSIONS OF THE ROTATION
C       RRCLY($PKGTYPES) I*2 RECTANGLES FOR EACH PACKAGE TYPE.
C
C       RUL                  WIRING RULE NUMBER.
C
C       RUTEMP(4,            TEMPORARY STORAGE FOR WIRING RULE
C            *$WIRERULES)    *RRU* NAME (1-3) AND *RRUCCD* (4).
C
C       SRTKEY (3)           ARRAY USED TO HOLD SORTING PRIORITY KEYS
C
C       TMPLLX               TEMPORARY STORAGE OF THE LOWER-LEFT
C       TMPLLY               AND UPPER-RIGHT COORDINATES.
C       TMPURX
C       TMPURY
C
C       TMPXXX               TEMPORARY STORAGE FOR THE MAXIMUM CELL
C       TMPYYY               COORDINATE ON THE CARRIER
C
C       TOPORD               HIGHEST ORDINATE OF HORIZONTAL CHANNELS.
C
C       TRMFLX               TERMINAL FILE INDEX.
C
C       WCRCNT               NUMBER OF WIRE CLEARANCE RULES.
C
C
C       GLOBAL VARIABLES --
C       NAME  DIMENSION TYPE  DESCRIPTION
C       ----  --------- ----  -----------
C       (NONE)
C
C       REVISION HISTORY --
C          24-MAR-86 CCC SET *CRPNRM* TO THE FIRST NORMAL NET.
C                        (SAR 5626)
C          14-JAN-86 TAF REMOVED VARIOUS UNUSED ARRAY FIELDS.
C                        (SAR 5500)
C          21-NOV-85 CCC REVISED ERROR CODES.  (SAR 5391)
C          20-NOV-85 CCC CORRECTED ERROR FORMATS.  (SAR 5372)
C          02-OCT-85 CCC ADDED SUPPORT FOR GLOBAL POWER/GROUND
C                        ROUTES.
C                    TAF ADDED *CHNSRT* ARRAY FOR ENHANCED
C                        CHANNEL EXPANSION.  (SAR 5199)
C          29-JUL-85 CCC CHECKED MODULE.
C          05-SEP-84 KMP WROTE MODULE.  (SAR 4856)
C
C       TESTING PLANS --
C          29-JUL-85 CCC COMPLETED UNIT TESTING.
C
C       ***************************************************************
C       *                       SUBSYSTEM TOKENS                      *
C       ***************************************************************
C
CS*     CHXTOKEN
C
C       ***************************************************************
C       *                    VARIABLE DECLARATIONS                    *
C       ***************************************************************
C
C       FORMAL PARAMETERS --
C       (NONE)
C
```

```
C         LOCAL VARIABLES --
          DIMENSION SHIFFY(3)
          COMMON /CM2627/ EXLLX($$SPKGTYPES), EXLLY($$SPKGTYPES),
     1                    EXURX($$SPKGTYPES), EXURY($$SPKGTYPES),
     2                    RRDLX($$SPKGTYPES), RRDLY($$SPKGTYPES),
     3                    CLPKTP($$SDEVICES),
     4                    DRTEMP(6,$$SDEVPARS),
     5                    CHTEMP(3,$$SCHRSONCHAN),
     6                    RUTEMP(4,$$SWITRRUTES),
     7                    NTTEMP(2,$$SNETS),
     8                    NDTEMP(6,$$SNODES)
C
C
C         SUBSYSTEM GLOBAL VARIABLES --
C
CS*       SUBSYSGLBDAT (CHX)
C
CS*       CHXCRR
CS*       CHXCHN
CS*       CHXCHC
CS*       CHXCEL
CS*       CHXDVP
CS*       CHXRAL
CS*       CHXRFD
CS*       CHXNET
CS*       CHXNDT
CS*       CHXRUL
C
C         OTHER SUBSYSTEM VARIABLES --
C
CS*       ENTDAT
C
CS*       PHGEQUENT
CS*       PBXEQUENT
CS*       PCLEQUENT
CS*       PCPEQUENT
CS*       PCHPQUENT
CS*       PDVEQUENT
CS*       PFCEQUENT
CS*       PHGEQUENT
CS*       PICEQUENT
CS*       PLIEQUENT
CS*       PPKEQUENT
CS*       PSGEQUENT
CS*       PSNEQUENT
CS*       PIDEQUENT
CS*       RFDEQUENT
CS*       RSLEQUENT
CS*       PRUEQUENT
CS*       WCREQUENT
C
C         SYSTEM GLOBAL VARIABLES --
C
CS*       SYSCOMMON
C
C
C         ************************************************************
C         *                    DATA STATEMENTS                       *
C         ************************************************************
C
C         (NONE)
C
C         ************************************************************
C         *                  STATEMENT FUNCTIONS                     *
C         ************************************************************
C
C         LOCAL STATEMENT FUNCTIONS --
C         (NONE)
C
C         SUBSYSTEM STATEMENT FUNCTIONS --
C         (NONE)
C
C         OTHER SUBSYSTEM STATEMENT FUNCTIONS --
C         (NONE)
C
C         SYSTEM STATEMENT FUNCTIONS --
C
CS*       SFUNCHCSI
C
C
C         ************************************************************
```

```
C         *                     EXECUTABLE CODE                           *
C         *****************************************************************
C
C$*       HOLENTRY [CFX] [CFXLCCI [2627] [03]
C
C         VALIDATE FORMAL PARAMETERS
C$*       HCUNDSCHK [DSFLIX] [1] [%%SICFILES] [6000]
C
C         **************************
C         * SETUP FOR DATA LOADING *
C         **************************
C         OPEN INPUT DESIGN FILE IN READ-ONLY SHARABLE MODE
          INFLCF = 1
          IF (DSFLFN(INMODE, DSFLIX)) 8010, 8010, 1000
C                                      ERR   ERR   OK
C
 1000     CONTINUE
C         ****************
C         * CARRIER DATA *
C         ****************
C         LOAD CARRIER GEOMETRY, NUMBER OF SIGNAL AND POWER/GROUND
C         LAYERS AND GRID SIZE FROM THE *FBG* RECORD.
          RECTYP = VISTRG('FBG ')
          IF (RXTENT(RECTYP, DSFLIX)) 8020, 8040, 1110
C                                      ERR   NONE  OK
 1110     CONTINUE
          CRRILX = FBGBLX
          CRRILY = FBGBLY
          CRRIUX = FBGBUX
          CRRIUY = FBGBUY
C
          CRRPLX = FBGPLX
          CRRPLY = FBGPLY
          CRRPUX = FBGPUX
          CRRPUY = FBGPUY
C
          CRRRLX = FBGRLX
          CRRRLY = FBGRLY
          CRRRUX = FBGRUX
          CRRRUY = FBGRUY
C
          CRRSGL = FBGSGL
          CRRPWL = FBGPWL
          CRRGDX = FBGPGX
          CRRGDY = FBGPGY
C
C         NOW LOAD THE VIA-VIA CLEARANCES FROM THE *FHG* RECORD.
          CRRLVV = 0
          RECTYP = VISTRG('FHG ')
          IF (RXTENT(RECTYP, DSFLIX)) 8020, 1125, 1120
C                                      ERR   NONE  OK
 1120     CONTINUE
          CRRHVV = FHGHRZ
          CRRVVV = FHGVRT
          CRRDVV = FHGDVV
C
 1125     CONTINUE
C         NOW LOAD THE PREFERRED DIRECTIONS FOR EACH LAYER.
C         FIRST INITIALIZE LAYER-1 PREFERRED DIRECTION TO
C         HORIZONTAL (5) AND LAYER-2 PREFERRED DIRECTION TO VERTICAL (6).
          CRRLY1 = 5
          CRRLY2 = 6
          RECTYP = VISTRG('RSD ')
          IF (RXTENT(RECTYP, DSFLIX)) 8020, 1190, 1130
C                                      ERR   NONE  OK
 1130     CONTINUE
          CRRLY1 = RSDLC1
          CRRLY2 = RSDLC2
C
C
 1190     CONTINUE
C         ****************
C         * CHANNEL DATA *
C         ****************
C         LOAD CHANNEL IDENTIFICATION, POSITION, AND OTHER DATA.
C         CHANNEL POSITION COORDINATES ARE MAINTAINED IN ABSOLUTE
C         COORDINATES (WRT CARRIER ORIGIN BEING AT (0,0) )
          RECTYP = VISTRG('FCH ')
 1200     CONTINUE
          IF (RXTENT(RECTYP, DSFLIX)) 8020, 1220, 1205
C                                      ERR   NONE  OK
 1205     CONTINUE
```

```
      CHNCNT = CHNCNT + 1
      IF ((PCHCID .LE. 0) .OR. (PCHCID .GT. CHNMAX)) GO TO 8050
      CHNDAT(%%CHXCHNORIENT, PCHCID) = PCHORN
      CHNDAT(%%CHXCHNLLX   , PCHCID) = PCHLLX
      CHNDAT(%%CHXCHNLLY   , PCHCID) = PCHLLY
      CHNDAT(%%CHXCHNURX   , PCHCID) = PCHURX
      CHNDAT(%%CHXCHNURY   , PCHCID) = PCHURY
      CHNDAT(%%CHXCHNLOFEED, PCHCID) = PCHLCH
      CHNDAT(%%CHXCHNHIFEED, PCHCID) = PCHHCH
      CHNDAT(%%CHXCHNSPLIT , PCHCID) = PCHSPT
C
C     ALSO LOAD LOCAL ARRAY *CHTEMP* WITH DATA TO DETERMINE,
C     FOR ANY GIVEN CHANNEL, WHICH OTHER CHANNELS FEED INTO
C     IT ON THE LOW AND HIGH SIDES.
C
C     FIRST PROCESS THE LEFT (OR LOWER) END OF THE CHANNEL.
C     IF THE CURRENT CHANNEL IS HORIZONTAL (VERTICAL), ITS
C     LEFT (LOWER) END FEEDS INTO CHANNEL *PCHLCH*.
C     THEREFORE THE RIGHT (UPPER) SIDE OF CHANNEL *PCHLCH*
C     IS FED BY THE CURRENT CHANNEL.
      IF (PCHLCH .LE. 0)  GO TO 1210
      CHCCNT = CHCCNT + 1
      IF (CHCCNT .GT. CHCMAX) GO TO 8060
      CHTEMP(1, CHCCNT) = PCHLCH
      CHTEMP(2, CHCCNT) = 1
      CHTEMP(3, CHCCNT) = PCHCID
C
C     NEXT PROCESS THE RIGHT (OR UPPER) END OF THE CHANNEL.
C     IF THE CURRENT CHANNEL IS HORIZONTAL (VERTICAL), ITS
C     RIGHT (UPPER) END FEEDS INTO CHANNEL *PCHHCH*.
C     THEREFORE THE LEFT (LOWER) SIDE OF CHANNEL *PCHHCH*
C     IS FED BY THE CURRENT CHANNEL.
 1210 CONTINUE
      IF (PCHHCH .LE. 0)  GO TO 1215
      CHCCNT = CHCCNT + 1
      IF (CHCCNT .GT. CHCMAX) GO TO 8060
      CHTEMP(1, CHCCNT) = PCHHCH
      CHTEMP(2, CHCCNT) = 0
      CHTEMP(3, CHCCNT) = PCHCID
C
 1215 CONTINUE
      GO TO 1200
C
 1220 CONTINUE
      IF (CHNCNT .LE. 0) GO TO 8070
C
C     NOW SORT ARRAY *CHTEMP* IN ASCENDING ORDER.
C     PRIMARY   KEY: CHANNEL NUMBER OF CHANNEL BEING FED
C     SECONDARY KEY: SIDE (LOW=0 OR HIGH=1) INTO WHICH
C                    THE CHANNEL IS FED.
C
      CALL VISPT1(CHTEMP, 3, %%@CHNSONCHAN, 1, 2, CHCCNT, 1)
C
C     NOW SET UP POINTERS FROM EACH CHANNEL TO THE FIRST
C     CHANNEL FEEDING INTO IT FROM THE HIGH AND LOW SIDES
C     AND A COUNT OF THE NUMBER OF CHANNELS FEEDING INTO
C     IT FROM THE HIGH AND LOW SIDES.
C     NOTE: THE FIRST CHANNEL (CHANNEL SEQUENCE NUMBER = 1)
C     ----  WILL NOT HAVE ANY CHANNELS FEEDING INTO IT.
C
      ACHPT = 1
      ASIDE = 0
      DO 1240 ACHAN = 1, CHNCNT
C
 1225 CONTINUE
      ACHCT = 0
      CHNDAT(%%CHXCHNLOCHPT+(2*ASIDE), ACHAN) = ACHPT
C
 1230 CONTINUE
      IF (ACHPT .GT. CHCCNT) GO TO 1235
C
C     CHECK IF THIS CHANNEL FEEDS INTO THE CURRENT CHANNEL
      IF (CHTEMP(1, ACHPT) .NE. ACHAN) GO TO 1235
C
C     HERE IF CHANNEL *ACHPT* FEEDS INTO *ACHAN*.
C     CHECK IF IT FEEDS IN FROM CURRENT SIDE *ASIDE*.
      IF (CHTEMP(2, ACHPT) .NE. ASIDE) GO TO 1235
C
C     HERE IF CHANNEL *ACHPT* FEEDS INTO *ACHAN* FROM *ASIDE*.
C     TRANSFER CHANNEL DATA FROM TEMPORARY ARRAY *CHTEMP* TO
C     THE GLOBAL ARRAY *CHCDAT* IN COMMON /CHXCHC/
C
```

```
      CHCDAT(ACHFT) = CFIEMF(3, ACHFT)
C
      ACHCT = ACHCT + 1
      ACHFT = ACHFT + 1
      GO TO 1230
C
1235  CONTINUE
C     HERE IF CHANNEL *ACHFT* FEEDS INTO CHANNEL *ACHAN* BUT
C     FROM ANOTHER SIDE OR IF CHANNEL *ACHFT* DOES NOT FEED
C     INTO CHANNEL *ACHAN*. UPDATE THE CHANNEL FEED-IN COUNT
C     FOR CURRENT SIDE OF CHANNEL *ACHAN* AND THEN COMPLEMENT
C     *ASIDE* AND CONTINUE.
      CHNDAT(**CFXCHNLOCHCT + (2*ASIDE), ACHAN) = ACHCT
      ASIDE = 1 - ASIDE
      IF (ASIDE .EQ. 1) GO TO 1225
C
1240  CONTINUE
C
      DO 1245 ACHAN = 1, CHNCNT
         CHNSRT(1, ACHAN) = ACHAN
         CHNSRT(2, ACHAN) = CHNDAT($$CHXCHNORIENT, ACHAN)
         IF (CHNDAT($$CHXCHNORIENT, ACHAN) .EQ. 1) THEN
C           HORIZONTAL CHANNEL
            NWHZCH = NWHZCH + 1
            CHNSRT(3, ACHAN) = CHNDAT($$CHXCHNLLY, ACHAN)
            CHNSRT(4, ACHAN) = CHNDAT($$CHXCHNLLX, ACHAN)
         ELSE
C           VERTICAL CHANNEL
            CHNSRT(3, ACHAN) = CHNDAT($$CHXCHNLLX, ACHAN)
            CHNSRT(4, ACHAN) = CHNDAT($$CHXCHNLLY, ACHAN)
         ENDIF
1245  CONTINUE
      SRTKEY(1) = 2
      SRTKEY(2) = 3
      SRTKEY(3) = 4
      CALL VISRT3(CHNSRT, 4, **$CHANNELS, SRTKEY, 3, CHNCNT, 1)
C
C     AFTER SORTING, ALTER *CHNSRT* ARRAY FOR EASIER ACCESS TO DATA
C     BY POINTING TO RANKING OF *ACHAN* IN *CHNSRT*
      DO 1250 ACHAN = 1, CHNCNT
         CHNSRT(3, CHNSRT(1, ACHAN)) = ACHAN
1250  CONTINUE
C
C
C     *******************************************
C     * IDENTIFY TOP/BOTTOM LEFT/RIGHT CHANNELS *
C     *******************************************
C     INITIALIZE VALUES
      TOPCHN = 0
      BOTCHN = 0
      LEFCHN = 0
      RIGCHN = 0
      TOPORD = CPRRLY
      BOTORD = CPRRUY
      LEFABS = CPRRUX
      RIGABS = CPRRLX
CS* TRACE2WHEN [4] [TOPORD] [TOPORD] [BOTORD] [BOTORD]
CS* TRACE2WHEN [4] [LEFABS] [LEFABS] [RIGABS] [RIGABS]
C
C     DETERMINE CHANNEL NUMBERS
      DO 1275 ACHAN = 1, CHNCNT
      ACHORN = CHNDAT($$CHXCHNORIENT, ACHAN)
CS* TRACE2WHEN [4] [ACHAN] [ACHAN] [ACHORN] [ACHORN]
      IF (ACHORN .EQ. 1) THEN
C        HORIZONTAL CHANNEL.  ADJUST TOP/BOTTOM
C        ORDINATE VALUES.
CS* TRACE1WHEN [4] [ORIEN =] ['HORIZ']
         IF (CHNDAT($$CHXCHNURY, ACHAN) .GE. TOPORD)  THEN
            TOPORD = CHNDAT($$CHXCHNURY, ACHAN)
            TOPCHN = ACHAN
CS* TRACE2WHEN [4] [TOPORD] [TOPORD] [TOPCHN] [TOPCHN]
         ENDIF
         IF (CHNDAT($$CHXCHNLLY, ACHAN) .LE. BOTORD)  THEN
            BOTORD = CHNDAT($$CHXCHNLLY, ACHAN)
            BOTCHN = ACHAN
CS* TRACE2WHEN [4] [BOTORD] [BOTORD] [BOTCHN] [BOTCHN]
         ENDIF
      ELSE
C        VERTICAL CHANNEL.  ADJUST LEFT/RIGHT
C        ABSCISSA VALUES.
CS* TRACE1WHEN [4] [ORIEN =] ['VERT']
         IF (CHNDAT($$CHXCHNLLX, ACHAN) .LE. LEFABS)  THEN
```

```
            LEFABS = CHNDAT($$CHXCHNLLX, ACHAN)
            LEFCHN = ACHAN
CS* TRACE2WHEN [4] [LEFABS] [LEFABS] [LEFCHN] [LEFCHN]
          ENDIF
          IF (CHNDAT($$CHXCHNURX, ACHAN) .GE. RIGABS)  THEN
            RIGABS = CHNDAT($$CHXCHNURX, ACHAN)
            RIGCHN = ACHAN
CS* TRACE2WHEN [4] [RIGABS] [RIGABS] [RIGCHN] [RIGCHN]
          ENDIF
        ENDIF
 1275   CONTINUE
CS* TRACE2WHEN [3] [TOPCHN] [TOPCHN] [BOTCHN] [BOTCHN]
CS* TRACE2WHEN [3] [LEFCHN] [LEFCHN] [RIGCHN] [RIGCHN]
C
C       *************
C       * RAIL DATA *
C       *************
C       LOAD RAIL DATA FOR AUTOMATIC POWER/GROUND
C       ROUTING OF EITHER THE CORE OR I/O RINGS.
        CALL RAILCD(DSFLIX)
C
C       *************
C       * CELL DATA *
C       *************
C       LOAD THE BODY EXTENT DESCRIPTIONS FOR EACH PACKAGE TYPE.
        RECTYP = VISTRG('PBX ')
        CNTPBX = 0
        MAXPBX = $$SPKGTYPES
 1300   CONTINUE
        IF (NXTENT(RECTYP, DSFLIX)) 8020, 1350, 1310
                                    ERR   NONE   OK
C
 1310   CONTINUE
        CNTPBX = CNTPBX + 1
        IF (CNTPBX .GT. MAXPBX) GO TO 8080
        BXLLX(CNTPBX) = PBXLLX
        BXLLY(CNTPBX) = PBXLLY
        BXURX(CNTPBX) = PBXURX
        BXURY(CNTPBX) = PBXURY
        GO TO 1300
C
 1350   CONTINUE
        IF (CNTPBX .LE. 0) GO TO 8090
C
C       LOAD THE ROTATION RECTANGLE DIMENSIONS FOR EACH PACKAGE TYPE
        RECTYP = VISTRG('PRK ')
        CNTPRK = 0
        MAXPRK = $$SPKGTYPES
 1400   CONTINUE
        IF (NXTENT(RECTYP, DSFLIX)) 8020, 1450, 1410
                                    ERR   NONE   OK
C
 1410   CONTINUE
        CNTPRK = CNTPRK + 1
        RRLLX(CNTPRK) = PRKROX
        RRLLY(CNTPRK) = PRKROY
        GO TO 1400
C
 1450   CONTINUE
        IF (CNTPRK .LE.      0) GO TO 8100
        IF (CNTPRK .NE. CNTPBX) GO TO 8110
C
C       LOAD THE PACKAGE TYPE FOR EACH CELL
        RECTYP = VISTRG('PDV ')
 1500   CONTINUE
        IF (NXTENT(RECTYP, DSFLIX)) 8020, 1550, 1510
                                    ERR   NONE   OK
C
 1510   CONTINUE
        CELCNT = CELCNT + 1
        IF  (CELCNT .GT. CELMAX)  GO TO 8120
        IF ((PDVPRK .LE.      0) .OR.
     1      (PDVPRK .GT. CNTPRK)) GO TO 8130
        CLPKTP(CELCNT) = PDVPRK
        GO TO 1500
C
 1550   CONTINUE
        IF (CELCNT .LE. 0) GO TO 8140
C
C       LOAD CURRENT LOCATION AND ORIENTATION OF EACH CELL.
        RECTYP = VISTRG('PLL ')
        CNTLLL = 0
        MAXLLL = $$SLEGALLOCS
 1600   CONTINUE
        IF (NXTENT(RECTYP, DSFLIX)) 8020, 1650, 1610
```

```
C                                   ERR    NONE    OK
 1610     CONTINUE
          CNTELL = CNTELL + 1
C
C         ALL CELLS MUST BE PLACED BY THIS TIME. A CELL IS CONSIDERED
C         UNPLACED IF ITS REFERENCE POINT IS LOCATED AT (-9999,-9999)
          IF ((CELLREX .EQ. -9999) .OR.
     1        (CELLREY .EQ. -9999)) GO TO 8150
C
C         HERE CELL IS PLACED.
C         DETERMINE CURRENT OCCUPANT OF THIS LEGAL LOCATION,
C         ITS CURRENT LOCATION AND ORIENTATION.
          CURCEL = FILLOC
          IF ((CURCEL .LE. 0) .OR. (CURCEL .GT. CELCNT)) GO TO 8160
C
C         DETERMINE THE COORDINATES OF THE BODY EXTENT RECTANGLE
C         OF THE OCCUPANT CELL BASED ON ITS CURRENT ORIENTATION.
C         NOTE: THESE COORDINATES ARE DETERMINED AS IF THE
C         ----   CELL REFERENCE POINT WERE LOCATED AT (0,0)
C
          CURPKG = CLPKTP(CURCEL)
C
          CALL RCTRAN(0, 0, BXLLX(CURPKG), BXLLY(CURPKG), PLLORN, PLLMIR,
     1                RRDLX(CURPKG), RRDLY(CURPKG), IMPLLX, IMPLLY)
C
          CALL RCTRAN(0, 0, BXURX(CURPKG), BXURY(CURPKG), PLLORN, PLLMIR,
     1                RRDLX(CURPKG), RRDLY(CURPKG), IMPURX, IMPURY)
C
          CELDAT(**CHXCELOLDX, CURCEL) = PLLREX
          CELDAT(**CHXCELOLDY, CURCEL) = PLLREY
C
          CELDAT(**CHXCELREX,  CURCEL) = PLLREX
          CELDAT(**CHXCELREY,  CURCEL) = PLLREY
          CELDAT(**CHXCELLLX,  CURCEL) = VISMN2(IMPLLX, IMPURX)
          CELDAT(**CHXCELLLY,  CURCEL) = VISMN2(IMPLLY, IMPURY)
          CELDAT(**CHXCELURX,  CURCEL) = VISMX2(IMPLLX, IMPURX)
          CELDAT(**CHXCELURY,  CURCEL) = VISMX2(IMPLLY, IMPURY)
          GO TO 1600
C
 1650     CONTINUE
          IF (CNTELL .NE. CELCNT) GO TO 8170
C
C         ****************
C         * BARRIER DATA *
C         ****************
C         LOAD THE DEVICE-ASSOCIATED BARRIER LOCATIONS SO
C         THAT THE DATA STORED INTERNALLY WITHIN *CHX* IS
C         RELATIVE TO THE CELL ON WHICH THIS BARRIER OCCURS.
C         NOTE: SINCE THE DEVICE-ASSOCIATED BARRIER LOCATIONS
C         ----    SPECIFIED IN THE DESIGN FILE ALREADY ACCOUNT
C                 FOR ORIENTATION CHANGES TO THE ACTUAL CELL
C                 (BY VIRTUE OF THE FACT THAT *PRT* HAS BEEN RUN),
C                 THE RELATIVE POSITION OF THE BARRIER MAY BE
C                 DETERMINED WITHOUT INVOKING SSN ROUTINE *RCTRAN*.
C
          RECTYP = VISIRG('PDB ')
 1900     CONTINUE
          IF (NXTENT(RECTYP, DSFLIX)) 8020, 1950, 1910
                                      ERR    NONE   OK
C
 1910     CONTINUE
          DVBCNT = DVBCNT + 1
          IF (DVBCNT .GT. DVBMAX) GO TO 8220
          DBTEMP(1, DVBCNT) = PDBPDV
          DBTEMP(2, DVBCNT) = PDBLLX - CELDAT(**CHXCELOLDX, PDBPDV)
          DBTEMP(3, DVBCNT) = PDBLLY - CELDAT(**CHXCELOLDY, PDBPDV)
          DBTEMP(4, DVBCNT) = PDBURX - CELDAT(**CHXCELOLDX, PDBPDV)
          DBTEMP(5, DVBCNT) = PDBURY - CELDAT(**CHXCELOLDY, PDBPDV)
          DBTEMP(6, DVBCNT) = PDBLYR
          GO TO 1900
C
 1950     CONTINUE
          IF (DVBCNT .LE. 0) GO TO 1951
C
C         NOW SORT THE DEVICE-ASSOCIATED BARRIERS IN ASCENDING ORDER.
C         PRIMARY   KEY: CELL/DEVICE NUMBER TO WHICH BARRIER BELONGS
C         SECONDARY KEY: NONE
C
          CALL VISRT1(DBTEMP, 6, **SDEVPARS, 1, 1, DVBCNT, 1)
C
 1951     CONTINUE
C         NOW SET UP POINTERS FROM EACH CELL TO THE FIRST
C         DEVICE-ASSOCIATED BARRIER FOR THAT CELL AND A COUNT OF
```

```
C         THE NUMBER OF DEVICE-ASSOCIATED BARRIERS ON EACH CELL.
C
          ADBPT = 1
          DO 1995 ACELL = 1, CELCNT
C
          ADBCT = 0
          CELDAT(%%CHXCELDVBPT, ACELL) = ADBPT
C
 1955     CONTINUE
          IF (ADBPT .GT. DVBCNT) GO TO 1960
C
C         CHECK IF DEVICE-ASSOCIATED BARRIER BELONGS TO CURRENT CELL
          IF (DBTEMP(1, ADBPT) .NE. ACELL) GO TO 1960
C
C         HERE IF BARRIER *ADBPT* BELONGS TO CELL *ACELL*.
C         TRANSFER BARRIER DATA FROM TEMPORARY ARRAY *DBTEMP*
C         TO THE GLOBAL ARRAY *DVBDAT* IN COMMON /CHXDVB/
C
          DVBDAT(%%CHXLVBLLX, ADBPT) = DBTEMP(2, ADBPT)
          DVBDAT(%%CHXLVBLLY, ADBPT) = DBTEMP(3, ADBPT)
          DVBDAT(%%CHXLVBURX, ADBPT) = DBTEMP(4, ADBPT)
          DVBDAT(%%CHXLVBURY, ADBPT) = DBTEMP(5, ADBPT)
          DVBDAT(%%CHXLVBLYR, ADBPT) = DBTEMP(6, ADBPT)
C
          ADBCT = ADBCT + 1
          ADBPT = ADBPT + 1
          GO TO 1955
C
 1960     CONTINUE
C         HERE IF BARRIER *ADBPT* DOES NOT BELONG TO CELL *ACELL*.
C         UPDATE THE BARRIER COUNT FOR CELL *ACELL*.
          CELDAT(%%CHXCELDVBCT, ACELL) = ADBCT
C
 1995     CONTINUE
C
C         *****************
C         * FEEDTHRU DATA *
C         *****************
C         LOAD FEEDTHRU ENDPOINT LOCATIONS AND PADCODES SUCH
C         THAT THE DATA STORED INTERNALLY WITHIN *CHX* IS
C         RELATIVE TO THE CELL ON WHICH THIS FEEDTHRU OCCURS.
C         NOTE: SINCE THE FEEDTHRU (PFD) ENDPOINT LOCATIONS
C         ----      SPECIFIED IN THE DESIGN FILE ALREADY ACCOUNT
C                   FOR ORIENTATION CHANGES TO THE ACTUAL CELL,
C                   THE RELATIVE POSITION OF THE BARRIER MAY BE
C                   DETERMINED WITHOUT INVOKING SSN ROUTINE *RLTRAN*.
C
          RFCTYP = VISTRG('RFD ')
 2000     CONTINUE
          IF (NXTENT(RFCTYP, DSELIX)) 8020, 2050, 2010
C                                      ERR   NONE  OK
 2010     CONTINUE
          RFDCNT = RFDCNT + 1
          IF   (RFDCNT .GT. RFDMAX)   GO TO 8230
          IF ((RFDDEV .LE.      0) .OR.
     1        (RFDDEV .GT. CELCNT)) GO TO 8240
C
          RFDDAT(%%CHXRFDDEV, RFDCNT) = RFDDEV
          RFDDAT(%%CHXRFDNET, RFDCNT) = RFDNET
C$* TRACE1WHEN [4] [RFDDEV] [RFDDAT(%%CHXRFDDEV, RFDCNT)]
C$* TRACE1WHEN [4] [RFDNET] [RFDDAT(%%CHXRFDNET, RFDCNT)]
          RFDDAT(%%CHXRFDE1X, RFDCNT) = RFDE1X -
     1                                  CELDAT(%%CHXCELRFX, RFDDEV)
          RFDDAT(%%CHXRFDE1Y, RFDCNT) = RFDE1Y -
     1                                  CELDAT(%%CHXCELRFY, RFDDEV)
          RFDDAT(%%CHXRFDE1Z, RFDCNT) = RFDE1Z
          RFDDAT(%%CHXRFDE1P, RFDCNT) = RFDE1P
          RFDDAT(%%CHXRFDE2X, RFDCNT) = RFDE2X -
     1                                  CELDAT(%%CHXCELRFX, RFDDEV)
          RFDDAT(%%CHXRFDE2Y, RFDCNT) = RFDE2Y -
     1                                  CELDAT(%%CHXCELRFY, RFDDEV)
          RFDDAT(%%CHXRFDE2Z, RFDCNT) = RFDE2Z
          RFDDAT(%%CHXRFDE2P, RFDCNT) = RFDE2P
          RFDDAT(%%CHXRFDLYR, RFDCNT) = RFDLYR
          RFDDAT(%%CHXRFDPTH, RFDCNT) = RFDPTH
          GO TO 2000
C
 2050     CONTINUE
          IF (RFDCNT .LE. 0) GO TO 2051
C
C         NOW SORT THE FEEDTHRUS IN ASCENDING ORDER.
C         PRIMARY   KEY: CELL/DEVICE NUMBER TO WHICH FEEDTHRU BELONGS
```

```
C        SECONDARY KEY: NONE
C
         CALL VISR11(RFEDAT, $$CHXRFEDFLD, $$WICTFEEDTHRU,
     1               $$CHXRFEDKEY, $$CHXRFEDEV, RFEDCNT, 1)
C
 2051    CONTINUE
C        NOW SET UP POINTERS FROM EACH CELL TO THE FIRST FEEDTHRU
C        FOR THAT CELL AND A COUNT OF THE NUMBER OF FEEDTHRUS ON
C        EACH CELL.
C
         AFDPT = 1
         DO 2095 ACELL = 1, CELCNT
C
         AFDCT = 0
         CELDAT($$CHXCELRFEDPT, ACELL) = AFDPT
C
 2055    CONTINUE
         IF (AFDPT .GT. RFEDCNT) GO TO 2060
C
C        CHECK IF FEEDTHRU BELONGS TO CURRENT CELL
         IF (RFEDAT($$CHXRFEDDEV, AFDPT) .NE. ACELL) GO TO 2060
C
C        HERE IF FEEDTHRU *AFDPT* BELONGS TO CELL *ACELL*.
         AFDCT = AFDCT + 1
         AFDPT = AFDPT + 1
         GO TO 2055
C
 2060    CONTINUE
C        HERE IF FEEDTHRU *AFDPT* DOES NOT BELONG TO CELL *ACELL*.
C        UPDATE THE FEEDTHRU COUNT FOR CELL *ACELL*.
         CELDAT($$CHXCELRFEDCT, ACELL) = AFDCT
C
 2095    CONTINUE
C
C
C        ********************
C        * WIRING RULE DATA *
C        ********************
C        THE WIRING RULE DATA IS ESSENTIALLY DEFINED IN THE *RRU*
C        RECORDS (WHICH ARE POINTED TO BY THE *RSG* RECORDS).
C        HOWEVER, THE DATA ON ONE OR MORE OF THE *RRU* MAY BE AUGMENTED
C        BY WIRE CLEARANCE RULES SPECIFIED ON *WCR* RECORDS.
C
         RECTYP = VISTRG('RRU ')
 3000    CONTINUE
         IF (NXTENT(RECTYP, DSFLIX)) 8020, 3050, 3010
C                                    ERR   NONE  OK
C
 3010    CONTINUE
         RULCNT = RULCNT + 1
         IF (RULCNT .GT. RULMAX) GO TO 8250
C
C        WIRING RULE DATA ON *RRU* IS VALID FOR ALL LAYERS
         DO 3020 LYR = 1, $$LAYERS
         RULDAT($$CHXRULHZW, LYR, RULCNT) = RRUWID
         RULDAT($$CHXRULHZC, LYR, RULCNT) = RRUGHD
         RULDAT($$CHXRULVTW, LYR, RULCNT) = RRUWID
         RULDAT($$CHXRULVTC, LYR, RULCNT) = RRUGHD
         RULDAT($$CHXRULVIA, LYR, RULCNT) = RRUALV
 3020    CONTINUE
C
C        SAVE WIRING RULE NAME FOR LINK-UP WITH *WCR* RECORDS
         RULEMP(1, RULCNT) = RRUNM1
         RULEMP(2, RULCNT) = RRUNM2
         RULEMP(3, RULCNT) = RRUNM3
C        SAVE *RRUCOD* FOR CHOOSING NORMAL WIRING RULE.
         RULEMP(4, RULCNT) = RRUCOD
         GO TO 3000
C
 3050    CONTINUE
         IF (RULCNT .LE. 0) GO TO 8260
C
C        NOW LOAD ANY WIRE CLEARANCE SPECIFICATIONS IF THEY EXIST
         WCRCNT = 0
         RECTYP = VISTRG('WCR ')
 3100    CONTINUE
         IF (NXTENT(RECTYP, DSFLIX)) 8020, 3150, 3110
C                                    ERR   NONE  OK
 3110    CONTINUE
         WCRCNT = WCRCNT + 1
C        FOUND WIRE CLEARANCE SPECIFICATION. UPDATE THE
C        WIRING RULE DATA FOR THE APPROPRIATE RULE.
         ARULE = 0
```

```
      DO 3120 RUL = 1, RULCNT
      IF ((WCRNM1 .EQ. RUTEMP(1, RUL)) .AND.
     1    (WCRNM2 .EQ. RUTEMP(2, RUL)) .AND.
     2    (WCRNM3 .EQ. RUTEMP(3, RUL))) ARULE = RUL
      IF (ARULE .NE. 0) GO TO 3130
 3120 CONTINUE
C     HERE IF COULD NOT FIND A MATCHING *RRU* FOR THIS *WCR*.
      GO TO 8270
C
 3130 CONTINUE
C     HERE FOUND WHICH *RRU* THIS *WCR* BELONGS TO.
C     UPDATE THE CLEARANCE SPECIFICATION FOR APPROPRIATE LAYER.
      IF ((WCRLYR .LE. 0) .OR.
     1    (WCRLYR .GT. $$LAYERS)) GO TO 8280
      RULDAT($$CHXRULHZW, WCRLYR, ARULE) = WCRHZW
      RULDAT($$CHXRULHZC, WCRLYR, ARULE) = WCRHZC
      RULDAT($$CHXRULVTW, WCRLYR, ARULE) = WCRVTW
      RULDAT($$CHXRULVTC, WCRLYR, ARULE) = WCRVTC
      GO TO 3100
C
 3150 CONTINUE
C
C
C     *****************
C     * PAD CODE DATA *
C     *****************
C     LOAD PAD-CODE SIZE DATA.
      RECTYP = VISTRG('PCD ')
 4000 CONTINUE
      IF (NXTENT(RECTYP, DSFLIX)) 8020, 4050, 4010
C                                 ERR   NONE  OK
 4010 CONTINUE
      PADCNT = PADCNT + 1
      IF (PADCNT .GT. PADMAX) GO TO 8180
      PADDAT($$CHXPADLLX, PADCNT) = PCDTLX
      PADDAT($$CHXPADLLY, PADCNT) = PCDTLY
      PADDAT($$CHXPADURX, PADCNT) = PCDTUX
      PADDAT($$CHXPADURY, PADCNT) = PCDTUY
      GO TO 4000
C
 4050 CONTINUE
      IF (PADCNT .LE. 0) GO TO 8190
C
C
C     ************
C     * NET DATA *
C     ************
C     LOAD THE NET DATA
      RECTYP = VISTRG('PSG ')
 4100 CONTINUE
      IF (NXTENT(RECTYP, DSFLIX)) 8020, 4150, 4110
C                                 ERR   NONE  OK
 4110 CONTINUE
      NETCNT = NETCNT + 1
      IF (NETCNT .GT. NETMAX) GO TO 8290
      IF ((PSGWRP .LE.      0) .OR.
     1    (PSGWRP .GT. RULCNT)) GO TO 8300
      NETDAT($$CHXNETRUL, NETCNT) = PSGWRP
      NETDAT($$CHXNETPRI, NETCNT) = PSGPRI
C
C     ALSO SAVE THE POINTER TO THE FIRST NODE OF THIS NET.
C     THIS WILL BE USED TO DETERMINE WHICH NET A NODE BELONGS TO.
      NTTEMP(1, NETCNT) = PSGFPN
      NTTEMP(2, NETCNT) = PSGNCT
C
C     IDENTIFY THE UNUSED NET.
      IF ((PSGNM1 .EQ. VISTRG('UNUS')) .AND.
     1    (PSGNM2 .EQ. VISTRG('ED  ')) .AND.
     2    (PSGNM3 .EQ. VISTRG('    '))) CRRUNU = NETCNT
C
C     IDENTIFY NORMAL WIRING RULE
      IF (CRRNRM .EQ. 0) THEN
        IF (RUTEMP(4, PSGWRP) .NE. 3)  CRRNRM = NETCNT
      ENDIF
      GO TO 4100
C
 4150 CONTINUE
      IF (NETCNT .LE. 0) GO TO 8310
      IF (CRRNRM .LE. 0) GO TO 8330
C
C     *************     --------------------------
C     * NODE DATA *     NODES MUST BE IN NET ORDER
```

```
C               *************    --------------------------
C               NODE LOCATIONS ARE STORED INTERNALLY WITHIN *CHX*
C               RELATIVE TO THE CELLS ON WHICH THE NODES OCCUR.
C               NOTE: SINCE THE NODE LOCATIONS SPECIFIED IN THE
C               ----    DESIGN FILE ALREADY ACCOUNT FOR ORIENTATION
C                       CHANGES TO THE ACTUAL CELL, THE RELATIVE
C                       POSITION OF THE NODE MAY BE DETERMINED
C                       WITHOUT INVOKING SSN ROUTINE *RCTRAN*.
C
                RECTYP = VISTRG('PSN ')
                NODNET = 0
  4199          CONTINUE
                NODNET = NODNET + 1
                IF (NODNET .GT. NETCNT) GO TO 8320
                NTNDCT = NTTEMP(2, NODNET)
                IF (NTNDCT .EQ. 0) GO TO 4199
                LSTNOD = NTTEMP(1, NODNET) + NTNDCT - 1
C
  4200          CONTINUE
                IF (NXTENT(RECTYP, DSFLIX)) 8020, 4250, 4210
                                            ERR   NONE   OK
C
  4210          CONTINUE
                NODCNT = NODCNT + 1
                IF (NODCNT .GT. NODMAX) GO TO 8200
C
C               DETERMINE WHICH NET THIS NODE BELONGS TO
                IF (NODCNT .LE. LSTNOD) GO TO 4220
  4219          CONTINUE
                NODNET = NODNET + 1
                IF (NODNET .GT. NETCNT) GO TO 8320
                NTNDCT = NTTEMP(2, NODNET)
                IF (NTNDCT .EQ. 0) GO TO 4219
                LSTNOD = NTTEMP(1, NODNET) + NTNDCT - 1
C
  4220          CONTINUE
                NDTEMP(1, NODCNT) = PSNMOD
                NDTEMP(2, NODCNT) = PSNRFX - CELDAT($$CHXCELOLDX, PSNMOD)
                NDTEMP(3, NODCNT) = PSNRFY - CELDAT($$CHXCELOLDY, PSNMOD)
                NDTEMP(4, NODCNT) = PSNLYR
CS* TRACE2WHEN [4] [PSNLYR] [PSNLYR] [NODNET] [NODNET]
                NDTEMP(5, NODCNT) = PSNPAD
                NDTEMP(6, NODCNT) = NODNET
                GO TO 4200
C
  4250          CONTINUE
                IF (NODCNT .LE. 0) GO TO 8210
C
C               NOW SORT THE NODES IN ASCENDING ORDER.
C               PRIMARY    KEY: CELL/DEVICE NUMBER ON WHICH NODE OCCURS
C               SECONDARY KEY: NONE
C
                CALL VISRTI(NDTEMP, 6, $$NODES, 1, 1, NODCNT, 1)
C
C               NOW SET UP POINTERS FROM EACH CELL TO THE FIRST NODE FOR
C               THAT CELL AND A COUNT OF THE  NUMBER OF NODES ON EACH CELL.
C
                ANDPT = 1
                DO 4295 ACELL = 1, CELCNT
C
                ANDCT = 0
                CELDAT($$CHXCELNODPT, ACELL) = ANDPT
C
  4255          CONTINUE
                IF (ANDPT .GT. NODCNT) GO TO 4260
C
C               CHECK IF CURRENT NODE BELONGS TO CURRENT CELL
                IF (NDTEMP(1, ANDPT) .NE. ACELL) GO TO 4260
C
C               HERE IF NODE *ANDPT* BELONGS TO CELL *ACELL*.
C               TRANSFER NODE DATA FROM TEMPORARY ARRAY *NDTEMP* TO
C               THE GLOBAL ARRAY *NODDAT* IN COMMON /CHXNOD/
C
                NODDAT($$CHXNODREX, ANDPT) = NDTEMP(2, ANDPT)
                NODDAT($$CHXNODREY, ANDPT) = NDTEMP(3, ANDPT)
                NODDAT($$CHXNODLYR, ANDPT) = NDTEMP(4, ANDPT)
                NODDAT($$CHXNODPAD, ANDPT) = NDTEMP(5, ANDPT)
                NODDAT($$CHXNODNET, ANDPT) = NDTEMP(6, ANDPT)
C
                ANDCT = ANDCT + 1
                ANDPT = ANDPT + 1
                GO TO 4255
C
```

```
 4260   CONTINUE
C       HERE IF NODE *ANDET* DOES NOT BELONG TO CELL *ACELL*.
C       UPDATE THE NODE COUNT FOR CELL *ACELL*
        CELDAT(%%CPXCELNODCT, ACELL) = ANDCT
C
 4295   CONTINUE
C
C
C       *************************
C       * CELLS-IN-CHANNELS DATA *
C       *************************
C       LOAD DATA DEFINING WHICH CELLS ARE ADJACENT TO WHICH
C       CHANNELS (AND THEREBY WHICH CHANNELS ARE ADJACENT TO
C       WHICH CELLS) FROM THE CELLS-ON-CHANNEL DEFINITION
C       FILE CREATED BY THE CHANNEL DEFINITION SUBSYSTEM (CHD).
C       ALSO DEFINE THE "WELLS" THAT ARE CREATED ALONG THE
C       CHANNEL SIDES BECAUSE OF UNEVEN CELL HEIGHTS/WIDTHS.
C
        CLCFLX = 10
        CALL CLCLOD(CL(FLX)
        IF (WRSTER .GT. 8000000) GO TO 8910
C
C
C       ***********************************
C       * POWER AND GROUND NET WIRING DATA *
C       ***********************************
C       DEFINE THE POWER/GROUND CORE AREA ROUTES AUTOMATICALLY
C       IF REQUESTED BY CPXPOE(3).
C
        IF (CPXPOE(3) .EQ. 1)  THEN
          CALL PGCORE
        ELSE
C
C       OTHERWISE, THEY CAN BE DEFINED BY PREWIRED CONNECTIONS.
C       LOAD PRE-DEFINED WIRE SEGMENTS (FOR THE POWER AND GROUND
C       NETS) FROM THE INPUT DESIGN FILE AND CONVERT THE WIRE
C       SEGMENTS INTO "CONNECTIONS", "TERMINALS", AND "FUTURE
C       TERMINALS". THIS PROCESS ESSENTIALLY CONVERTS A SPECIFIED
C       WIRING PATH INTO A GLOBAL ROUTE.
C
          CALL WIRLOD(DSFLIX)
        ENDIF
        IF (WRSTER .GT. 8000000) GO TO 8920
C
C
C       **********************
C       * TERMINAL POINT DATA *
C       **********************
C       LOAD TERMINAL POINT DATA FOR THE TRACK ASSIGNMENT SUBSYSTEM
C       FROM THE FILE CREATED BY THE GENERALIZED GLOBAL ROUTER (GGR).
C
        TRMFLX = 12
        CALL TRMLOD(TRMFLX)
        IF (WRSTER .GT. 8000000) GO TO 8930
C
C       ***********************************************
C       * FIND MAXIMUM CELL COORDINATES ON THE CARRIER *
C       ***********************************************
        DO 4550 I = 1, 4
        GO TO (4500, 4510, 4520, 4530), I
C
 4500   CONTINUE
C       LOWER-MOST HORIZONTAL CHANNEL
        ACELL  = CHNDAT(%%CHXCHNLOCLPT, CHNSRT(1, 1))
        CLMXCL = %%CHXCELMXTTF
        GO TO 4540
C
 4510   CONTINUE
C       UPPER-MOST HORIZONTAL CHANNEL
        ACELL  = CHNDAT(%%CHXCHNHICLPT, CHNSRT(1, NMHZCH))
        CLMXCL = %%CPXCELMXTPT
        GO TO 4540
C
 4520   CONTINUE
C       LOWER-MOST VERTICAL CHANNEL
        ACELL  = CHNDAT(%%CHXCHNLOCLPT, CHNSRT(1, (NMHZCH+1)))
        CLMXCL = %%CHXCELMXTRG
        GO TO 4540
C
 4530   CONTINUE
C       UPPER-MOST VERTICAL CHANNEL
        ACELL  = CHNDAT(%%CHXCHNHICLPT, CHNSRT(1, CHNCNT))
```

```
      CDNXCT = %%CHXCFLDXTLF
      GO TO 4540
C
 4540 CONTINUE
      IF (ACELL .LE. 0) GO TO 4550
      TMPXXX = CFLDAT(%%CHXCFLDFX, ACELL) +
     1         CFLDAT(%%CHXCELFFX, ACELL)
      TMPYYY = CFLDAT(%%CHXCFLDFY, ACELL) +
     1         CFLDAT(%%CHXCELFFY, ACELL)
      MXCLXX = VISMX2(MXCLXX, TMPXXX)
      MXCLYY = VISMX2(MXCLYY, TMPYYY)
      ACELL  = CFLDAT(CDNXCT, ACELL)
      GO TO 4540
 4550 CONTINUE
C
C
C
C     ***************************
C     * DATA LOADING COMPLETED *
C     ***************************
C     ALL DATA REQUIRED TO ADJUST CHANNEL HEIGHTS HAS BEEN LOADED
C     INTO THE CPX DATA STRUCTURES. CLOSE THE INPUT DESIGN FILE.
      IF (DSFCLS(DSFLIX)) 8030, 8030, 7990
C                         ERR   ERR   OK
 7990 CONTINUE
C
C     SAVE THE NUMBER OF PREDEFINED CONNECTIONS.
      CONPRE = CONCNT
C
      GO TO 9000
C
C     ***************************************************************
C     *                         ERROR RETURNS                       *
C     ***************************************************************
C
 8000 CONTINUE
C/    CHX - ILLEGAL VALUE SPECIFIED FOR INPUT DESIGN FILE INDEX
C/          DURING LOADUP. POSSIBLE ERROR IN CALLING SEQUENCE.
C/    **FM(1X,'FILE INDEX = ',I6,6X,'CALLING MODULE = ',I6)
      CALL VISERR(MODNBR, 8262701, DSFLIX, M99999)
      GO TO 9000
 8010 CONTINUE
C/    CHX - ERROR OPENING INPUT DESIGN FILE DURING LOADUP.
C/    **FM(1X,'FILE INDEX = ',I6,6X,'UNIT NUMBER = ',I6)
      CALL VISERR(MODNBR, 8262702, DSFLIX, IOFILE(DSFLIX))
      GO TO 9000
 8020 CONTINUE
C/    CHX - ERROR WHILE ATTEMPTING TO READ NEXT RECORD OF
C/          SPECIFIED RECORD TYPE FROM THE INPUT DESIGN
C/          DURING LOADUP.
C/    **FM(1X,'RECORD TYPE = ',A4,6X,'UNIT NUMBER = ', I6)
      CALL VISERR(MODNBR, 8262703, RECTYP, IOFILE(DSFLIX))
      GO TO 9000
 8030 CONTINUE
C/    CHX - ERROR CLOSING INPUT DESIGN FILE AFTER LOADUP.
C/    **FM(1X,'FILE INDEX = ',I6,6X,'UNIT NUMBER = ',I6)
      CALL VISERR(MODNBR, 8262704, DSFLIX, IOFILE(DSFLIX))
      GO TO 9000
 8040 CONTINUE
C/    CHX - CARRIER GEOMETRY SPECIFICATION (PBG) NOT FOUND
C/          IN THE INPUT DESIGN FILE DURING LOADUP. POSSIBLY
C/          ATTEMPTING TO READ ALPHA-NUMERIC DATA FROM A
C/          BINARY FILE OR BINARY DATA FROM AN ALPHA-
C/          NUMERIC FILE.
C/    **FM(1X,'FILE INDEX = ',I6,6X,'UNIT NUMBER = ',I6)
      CALL VISERR(MODNBR, 8262705, DSFLIX, IOFILE(DSFLIX))
      GO TO 9000
 8050 CONTINUE
C/    CHX - ILLEGAL CHANNEL ID NUMBER ENCOUNTERED DURING
C/          LOADUP. POSSIBLE ERROR DURING EXECUTION OF
C/          THE CHANNEL DEFINITION SUBSYSTEM (CHD) OR
C/          MISMATCH OF CHANNEL LIMIT TOKEN BETWEEN
C/          THE CHANNEL DEFINITION SUBSYSTEM AND THE
C/          CHANNEL EXPANSION SUBSYSTEM (CHX).
C/    **FM(1X,'CHANNEL COUNT = ',I6,6X,'ID NUMBER = ',I6)
      CALL VISERR(MODNBR, 8262706, CHNCNT, PCHCID)
      GO TO 9000
 8060 CONTINUE
C/    CHX - TOTAL NUMBER OF CHANNELS FEEDING INTO OTHER
C/          CHANNELS IS TOO LARGE. POSSIBLY CAUSED BY AN
C/          ERROR IN THE CHANNEL DEFINITION SUBSYSTEM (CHD).
C/    **FM(1X,'FEED-IN COUNT = ',I6,6X,'LIMIT = ',I6)
      CALL VISERR(MODNBR, 8262707, CHCCNT, CHCMAX)
```

```
      GO TO 9000
 8070 CONTINUE
C/    CHX - NO CHANNEL DEFINITIONS (PCH RECORDS) FOUND IN
C/          THE INPUT DESIGN FILE DURING LOADUP. POSSIBLY
C/          CAUSED BY NEGLECTING TO EXECUTE THE CHANNEL
C/          DEFINITION SUBSYSTEM (CHD) PRIOR TO ROUTING.
C/    **FM(1X,'CHANNEL COUNT = ',I6,6X,'LIMIT = ',I6)
      CALL VISERR(MCDNBR, 8262708, CHNCNT, CHNMAX)
      GO TO 9000
 8080 CONTINUE
C/    CHX - TOO MANY BODY EXTENT DESCRIPTIONS ENCOUNTERED
C/          IN THE INPUT DESIGN FILE DURING LOADUP. POSSIBLE
C/          ERROR IN THE DATABASE.
C/    **FM(1X,'BODY EXTENT COUNT = ',I6,6X,'LIMIT = ',I6)
      CALL VISERR(MCDNBR, 8262709, CNTPBX, MAXPBX)
      GO TO 9000
 8090 CONTINUE
C/    CHX - NO BODY EXTENT DESCRIPTIONS (PBX RECORDS) FOUND
C/          IN THE INPUT DESIGN FILE DURING LOADUP. POSSIBLE
C/          ERROR IN THE DATABASE OR WHILE EXECUTING THE
C/          PRE-PROCESSOR (PRP).
C/    **FM(1X,'BODY EXTENT COUNT = ',I6,6X,'LIMIT = ',I6)
      CALL VISERR(MCDNBR, 8262710, CNTPBX, MAXPBX)
      GO TO 9000
 8100 CONTINUE
C/    CHX - NO PACKAGE TYPE DESCRIPTIONS (PPK RECORDS) FOUND
C/          IN THE INPUT DESIGN FILE DURING LOADUP. POSSIBLE
C/          ERROR IN THE DATABASE OR WHILE EXECUTING THE
C/          PRE-PROCESSOR (PRP).
C/    **FM(1X,'PACKAGE TYPE COUNT = ',I6,6X,'LIMIT = ',I6)
      CALL VISERR(MCDNBR, 8262711, CNTPPK, MAXPPK)
      GO TO 9000
 8110 CONTINUE
C/    CHX - NUMBER OF BODY EXTENT DESCRIPTIONS (PBX) IN THE INPUT
C/          DESIGN FILE DOES NOT MATCH THE NUMBER OF PACKAGE TYPE
C/          DESCRIPTIONS. POSSIBLE ERROR IN THE DATABASE OR WHILE
C/          EXECUTING THE PRE-PROCESSOR (PRP).
C/    **FM(' BODY EXTENT COUNT =',I7,6X,'PKG-TYPE COUNT =',I7)
      CALL VISERR(MCDNBR, 8262712, CNTPBX, CNTPPK)
      GO TO 9000
 8120 CONTINUE
C/    CHX - TOO MANY CELL DESCRIPTIONS (PDV RECORDS) ENCOUNTERED
C/          IN THE INPUT DESIGN FILE DURING LOADUP. POSSIBLE ERROR
C/          WHILE EXECUTING THE PRE-PROCESSOR (PRP).
C/    **FM(1X,'CELL COUNT = ',I6,6X,'LIMIT = ',I6)
      CALL VISERR(MCDNBR, 8262713, CELCNT, CELMAX)
      GO TO 9000
 8130 CONTINUE
C/    CHX - A CELL (PDV) IN THE INPUT DESIGN FILE REFERS TO A
C/          NON-EXISTENT PACKAGE TYPE CODE. POSSIBLE ERROR
C/          IN THE DATABASE.
C/    **FM(' CELL NUMBER = ',I6,6X,'PACKAGE TYPE CODE = ',I6)
      CALL VISERR(MCDNBR, 8262714, CELCNT, PDVPPK)
      GO TO 9000
 8140 CONTINUE
C/    CHX - NO CELL DESCRIPTIONS (PDV RECORDS) FOUND IN THE
C/          INPUT DESIGN FILE DURING LOADUP.
C/    **FM(1X,'CELL COUNT = ',I6,6X,'LIMIT = ',I6)
      CALL VISERR(MCDNBR, 8262715, CELCNT, CELMAX)
      GO TO 9000
 8150 CONTINUE
C/    CHX - UNPLACED CELL ENCOUNTERED IN THE INPUT DESIGN FILE
C/          DURING LOADUP (AS INDICATED BY THE CELL LOCATION
C/          ON PLL RECORD). POSSIBLE ERROR IN PLACEMENT.
C/    **FM(1X,'CELL NUMBER = ',I6,6X,'LOCATION = ',I6)
      CALL VISERR(MCDNBR, 8262716, CELCNT, PLLPPX)
      GO TO 9000
 8160 CONTINUE
C/    CHX - LEGAL LOCATION (PLL) IS UNOCCUPIED OR IS OCCUPIED
C/          BY A NON-EXISTENT CELL. POSSIBLE ERROR IN PLACEMENT.
C/    **FM(' LOCATION NUMBER =',I7,6X,'OCCUPANT NUMBER =',I7)
      CALL VISERR(MCDNBR, 8262717, CNTPLL, CURCEL)
      GO TO 9000
 8170 CONTINUE
C/    CHX - NUMBER OF CELLS (PDV RECORDS) FOUND IN THE INPUT
C/          DESIGN FILE DURING LOADUP DOES NOT MATCH THE NUMBER
C/          OF LEGAL LOCATIONS (PLL RECORDS). POSSIBLE ERROR
C/          IN PLACEMENT.
C/    **FM(1X,'CELL COUNT = ',I6,6X,'LOCATION COUNT = ',I6)
      CALL VISERR(MCDNBR, 8262718, CELCNT, CNTPLL)
      GO TO 9000
 8180 CONTINUE
```

```
C/        CHX - TOO MANY PAD TYPE DESCRIPTIONS (PCD RECORDS)
C/              ENCOUNTERED IN THE INPUT DESIGN FILE DURING
C/              LOADUP. POSSIBLE ERROR IN THE DATABASE.
C/        **FM(1X,'PAD TYPE COUNT = ',I6,6X,'LIMIT = ',I6)
          CALL VISERR(MCDNBR, 8262719, PADCNT, PADMAX)
          GO TO 9000
  8190    CONTINUE
C/        CHX - NO PAD TYPE DESCRIPTIONS (PCD RECORDS) FOUND IN
C/              THE INPUT DESIGN FILE DURING LOADUP.
C/        **FM(1X,'PAD TYPE COUNT = ',I6,6X,'LIMIT = ',I6)
          CALL VISERR(MCDNBR, 8262720, PADCNT, PADMAX)
          GO TO 9000
  8200    CONTINUE
C/        CHX - TOO MANY NODES (PSN RECORDS) ENCOUNTERED IN THE
C/              INPUT DESIGN FILE DURING LOADUP. POSSIBLE ERROR
C/              DURING PLACEMENT.
C/        **FM(1X,'NODE COUNT = ',I6,6X,'LIMIT = ',I6)
          CALL VISERR(MCDNBR, 8262721, NODCNT, NODMAX)
          GO TO 9000
  8210    CONTINUE
C/        CHX - NO NODE DESCRIPTIONS (PSN RECORDS) FOUND IN THE
C/              INPUT DESIGN FILE DURING LOADUP.
C/        **FM(1X,'NODE COUNT = ',I6,6X,'LIMIT = ',I6)
          CALL VISERR(MCDNBR, 8262722, NODCNT, NODMAX)
          GO TO 9000
  8220    CONTINUE
C/        CHX - TOO MANY DEVICE-ASSOCIATED BARRIERS (PDB RECORDS)
C/              ENCOUNTERED IN THE INPUT DESIGN FILE DURING LOADUP.
C/              POSSIBLE ERROR WHILE EXECUTING EITHER THE PRE-PROCESSOR
C/              (PPE) OR DURING PRE-ROUTE (PRT).
C/        **FM(1X,'DEV-BARRIER COUNT = ',I6,6X,'LIMIT = ',I6)
          CALL VISERR(MCDNBR, 8262723, DVBCNT, DVBMAX)
          GO TO 9000
  8230    CONTINUE
C/        CHX - TOO MANY FEEDTHRUS (PFD RECORDS) ENCOUNTERED IN THE
C/              INPUT DESIGN FILE DURING LOADUP.
C/        **FM(1X,'FEEDTHRU COUNT = ',I6,6X,'LIMIT = ',I6)
          CALL VISERR(MCDNBR, 8262724, PFDCNT, PFDMAX)
          GO TO 9000
  8240    CONTINUE
C/        CHX - FEEDTHRU DEFINITION (PFD RECORD) IN INPUT DESIGN
C/              FILE DOES NOT CORRESPOND TO AN EXISTING CELL.
C/              POSSIBLE ERROR IN FEEDTHRU CREATION.
C/        **FM(' PFD NO. =',I7,6X,'CELL NO. =',I7)
          CALL VISERR(MCDNBR, 8262725, PFDCNT, PFDDEV)
          GO TO 9000
  8250    CONTINUE
C/        CHX - TOO MANY WIRING RULES (RRU RECORDS) ENCOUNTERED
C/              IN THE INPUT DESIGN FILE DURING LOADUP.
C/              POSSIBLE ERROR IN DATABASE.
C/        **FM(1X,'RULE COUNT = ',I6,6X,'LIMIT = ',I6)
          CALL VISERR(MCDNBR, 8262726, RULCNT, RULMAX)
          GO TO 9000
  8260    CONTINUE
C/        CHX - NO WIRING RULES (RRU RECORDS) ENCOUNTERED
C/              IN THE INPUT DESIGN FILE DURING LOADUP.
C/              POSSIBLE ERROR IN DATABASE.
C/        **FM(1X,'RULE COUNT = ',I6,6X,'LIMIT = ',I6)
          CALL VISERR(MCDNBR, 8262727, RULCNT, RULMAX)
          GO TO 9000
  8270    CONTINUE
C/        CHX - WIRE CLEARANCE RULE (WCR) IN INPUT DESIGN FILE
C/              DOES NOT CORRESPOND TO ANY WIRING RULE (RRU).
C/              POSSIBLE ERROR IN DATABASE.
C/        **FM(1X,'WCR NUMBER = ',I6,6X,'RULE COUNT = ',I6)
          CALL VISERR(MCDNBR, 8262728, WCRCNT, RULCNT)
          GO TO 9000
  8280    CONTINUE
C/        CHX - WIRE CLEARANCE RULE (WCR) IN INPUT DESIGN FILE
C/              IS SPECIFIED FOR AN INVALID LAYER. IGNORED.
C/        **FM(1X,'WCR NUMBER = ',I6,6X,'LAYER LIMIT = ',I6)
          CALL VISERR(MCDNBR, 4262729, WCRCNT, **SLAYERS)
          GO TO 3100
  8290    CONTINUE
C/        CHX - TOO MANY NET DESCRIPTIONS ENCOUNTERED
C/              IN THE INPUT DESIGN FILE DURING LOADUP.
C/        **FM(1X,'NET COUNT = ',I6,6X,'LIMIT = ',I6)
          CALL VISERR(MCDNBR, 8262730, NETCNT, NETMAX)
          GO TO 9000
  8300    CONTINUE
C/        CHX - ILLEGAL WIRING RULE SPECIFIED FOR NET.
C/        **FM(1X,'NET NUMBER = ',I6,6X,'RULE COUNT = ',I6)
```

```
              CALL VISERR(MCDNBR, 8262731, NETCNT, RULCNT)
              GO TO 9000
 8310         CONTINUE
C/            CHX - NO NET DESCRIPTIONS ENCOUNTERED IN
C/                  THE INPUT DESIGN FILE DURING LOADUP.
C/            **FM(1X,'NET COUNT = ',I6,6X,'LIMIT = ',I6)
              CALL VISERR(MCDNBR, 8262732, NETCNT, NETMAX)
              GO TO 9000
 8320         CONTINUE
C/            CHX - NODE BELONGS TO AN ILLEGAL NET.
C/            **FM(1X,'NODE NUMBER = ',I6,6X,'NET COUNT = ',I6)
              CALL VISERR(MCDNBR, 8262733, NODCNT, NETCNT)
              GO TO 9000
 8330         CONTINUE
C/            CHX - NO NORMAL WIRING RULE ENCOUNTERED IN
C/                  THE INPUT DESIGN FILE SIGNAL NET LIST.
C/            **FM(1X,'NET COUNT = ',I6,6X,'RULE COUNT = ',I6)
              CALL VISERR(MCDNBR, 8262734, NETCNT, RULCNT)
              GO TO 9000
C
C
 8910         CONTINUE
C/            CHX - ERROR IN SUBSIDIARY ROUTINE *CLCLOD* WHICH LOADS
C/                  THE ADJACENCY RELATIONSHIPS BETWEEN CHANNELS AND
C/                  CELLS.
              CALL VISERR(MCDNBR, 8262797, WRSTER, WRSTER)
              GO TO 9000
 8920         CONTINUE
C/            CHX - ERROR IN SUBSIDIARY ROUTINE *WIRLOD* WHICH LOADS
C/                  DESCRIPTIONS OF PRE-DEFINED WIRE SEGMENTS.
              CALL VISERR(MCDNBR, 8262798, WRSTER, WRSTER)
              GO TO 9000
 8930         CONTINUE
C/            CHX - ERROR IN SUBSIDIARY ROUTINE *TRMLOD* WHICH LOADS
C/                  DESCRIPTIONS OF TERMINAL POINTS TO BE CONNECTED
C/                  BY TRACK ASSIGNMENT.
              CALL VISERR(MCDNBR, 8262799, WRSTER, WRSTER)
              GO TO 9000
C
C
C             ************************************************************
C             *              SINGLE EXIT FROM THIS ROUTINE               *
C             ************************************************************
C
 9000         CONTINUE
CS*           MCDEXIT (CHX)
              RETURN
C
C
C             ************************************************************
C             *                   FORMAT STATEMENTS                      *
C             ************************************************************
C
C             (NONE)
C
C
C             END CHXICC 2627
              END
```

DIGITAL EQUIPMENT CORPORATION - VAX/VMS VERSION V4.4

KMP

S2628

.FOR

;1

FILE _SISDUA6:[KMT.CLXCZ]S2628.FOR;1 (1075,1,2), LAST REVISED ON 21-OCT-1986 06:44, IS A 46 BLOCK SEQUENTIAL FILE [illegible] BY UIC [ENGVIST,KMP]. THE RECORDS ARE VARIABLE LENGTH WITH IMPLIED (CR) CARRIAGE CONTROL. THE LONGEST RECORD IS 73 [illegible].

JOB S2628 (216) QUEUED TO SYS$PRINT ON 4-DEC-1986 12:51 BY USER KMP, UIC [ENGVIST,KMP], UNDER ACCOUNT [illegible] AT [illegible] 100, STARTED ON PRINTER _[illegible]: ON 4-DEC-1986 13:17 FROM QUEUE SYS$PRINT.

DIGITAL EQUIPMENT CORPORATION - VAX/VMS VERSION V4.4

VAX/VMS VAX/VMS VAX/VMS VAX/VMS VAX/VMS VAX/VMS VAX/VMS VAX/VMS VAX/VMS VAX/VMS VAX/VMS VAX/VMS

LLLLLLLLLL 1111111111111111111111111 DIGITAL EQUIPMENT CORPORATION - VAX/VMS VERSION V4.4 1111111111111111111111111 LLLLLLLLLL

KMP

S2628

FOR

;1

FILE _SISDUA6:[ERL.CHXC21S2628.FOR;1 (1075,1,2), LAST REVISED ON 21-OCT-1986 06:44, IS A 48 BLOCK SEQUENTIAL FILE OWNED BY UIC [PROTST,PECI]. THE RECORDS ARE VARIABLE LENGTH WITH IMPLIED (CR) CARRIAGE CONTROL. THE LONGEST RECORD IS 73 BYTES.

JOB S2628 (210) QUEUED TO SYS$PRINT ON 4-DEC-1986 12:51 BY USER KMF, UIC [ENGVLSI,KMF], UNDER ACCOUNT ENGPKG AT PRIORITY 100, STARTED ON PRINTER _TCATOS[PAO: ON 4-DEC-1986 13:17 FROM QUEUE SYS$PRINT.

LLLLLLLLLL 1111111111111111111111111 DIGITAL EQUIPMENT CORPORATION - VAX/VMS VERSION V4.4 1111111111111111111111111 LLLLLLLLLL

```
_$1$DUA6:[ERT.CHX(2]S2628.FOR;1                    21-OCT-1986 08:44                    PAGE 1
        SUBROUTINE CHXUPD(OLDFIL, NEWFIL, GRDSNP, ICLOCK)
C
CS*...  ALLIMTEG
C
C                         ****************
C                         *              *
C       SUBSYSTEM CHX     *  2628 CHXUPD *
C                         *              *
C                         ****************
C
C       ***************************************************************
C       ***************************************************************
C       **                                                           **
C       **  (C) COPYRIGHT V-R INFORMATION SYSTEMS, INC. 1984         **
C       **  LICENSED MATERIAL -- PROGRAM PROPERTY OF VRIS            **
C       **  ALL RIGHTS RESERVED                                      **
C       **                                                           **
C       **  THIS PROGRAM IS THE PROPERTY OF VRIS AND IS FURNISHED    **
C       **  PURSUANT TO A WRITTEN LICENSE AGREEMENT. IT MAY NOT BE   **
C       **  USED, REPRODUCED, OR DISCLOSED TO OTHERS EXCEPT IN       **
C       **  ACCORDANCE WITH THE TERMS AND CONDITIONS OF THAT         **
C       **  AGREEMENT.                                               **
C       **                                                           **
C       ***************************************************************
C       ***************************************************************
C
C       ***************************************************************
C       *                   MODULE DOCUMENTATION                      *
C       ***************************************************************
C
C       SUMMARY --
C       THIS SUBROUTINE CREATES AN UPDATED DESIGN FILE FOR THE CHANNEL
C       EXPANSION SUBSYSTEM (CHX). RECORDS TYPES UPDATED ARE:
C
C               BPG - CARRIER GEOMETRY
C               BCH - CHANNELS
C               BDB - DEVICE-ASSOCIATED BARRIERS
C               BPG - HYPERGRID PATTERN DEFINITIONS
C               BHT - TRACK ASSIGNMENT HISTORY (CREATED NEW)
C               BLL - LEGAL LOCATIONS (SLOTS)
C               BSN - NODES
C               BFD - DEVICE-ASSOCIATED FEEDTHRUS
C               BFT - FRONTOS -- THESE ARE DELETED IF THEY EXIST
C               BJP - JUMPERS
C               BRL - POWER AND GROUND RAILS
C               BWS - WIRE SEGMENTS -- OLD WIRES ARE DELETED
C                     AND REPLACED WITH NEW WIRES
C
C       THE OLD AND NEW DESIGN FILES, WHOSE INDICES INTO THE *ICFILE*
C       ARRAY ARE SPECIFIED BY PARAMETERS *OLDFIL* AND *NEWFIL*, MUST
C       BOTH BE CLOSED WHEN THIS ROUTINE IS CALLED. AFTER THE NEW
C       DESIGN FILE HAS BEEN CREATED, THIS ROUTINE CLOSES BOTH THE
C       OLD AND NEW DESIGN FILES.
C
C       FORMAL PARAMETERS --
C       NAME   DIMENSION TYPE  IN/OUT  DESCRIPTION
C       ----   --------- ----  ------  -----------
C       OLDFIL           INT     IN    INDEX OF THE OLD DESIGN FILE
C                                      INTO THE *ICFILE* ARRAY.
C                                      UNIT NUMBER = IOFILE(OLDFIL)
C
C       NEWFIL           INT     IN    INDEX OF THE NEW DESIGN FILE
C                                      INTO THE *ICFILE* ARRAY.
C                                      UNIT NUMBER = IOFILE(NEWFIL)
C
C       GRDSNP           INT     IN    FLAG INDICATING WHETHER OR NOT
C                                      TERMINAL LOCATIONS ARE TO BE
C                                      SNAPPED TO GRID BEFORE WIRE
C                                      SEGMENTS ARE OUTPUT BY ROUTINE
C                                      WIROUT-2635.
C                                        0 - TERMINALS ARE NOT SNAPPED
C                                            TO GRID
C                                        1 - TERMINALS ARE SNAPPED
C                                            TO GRID
C
C       ICLOCK           INT     IN    INDEX OF CLOCK USED FOR OBTAINING
C                                      RUNTIME FOR THE CALLING SUBSYSTEM.
C
```

```
C       LOCAL VARIABLES --
C       NAME  DIMENSION TYPE  DESCRIPTION
C       ----  --------- ----  -----------
C
C       LAPTIM                ELAPSED TIME FOR CLOCK *ICLOCK*.
C                             THIS IS THE TOTAL EXECUTION TIME FOR
C                             THE CALLING SUBSYSTEM AS REPORTED TO
C                             THE *PHI* RECORD.
C
C       NEWTYP                MODE IN WHICH NEW DESIGN FILE IS TO BE
C                             OPENED. NEWTYP = 2 -- WRITE ONLY.
C
C       NXTPKT                NEXT DESIGN FILE PACKET TO BE PROCESSED.
C
C       OLDTYP                MODE IN WHICH OLD DESIGN FILE IS TO
C                             BE OPENED. OLDTYP = 1 -- READ ONLY.
C
C       TYPPBG                INTEGER IMAGE OF CHARACTER STRING "PBG ".
C
C       TYPPCH                INTEGER IMAGE OF CHARACTER STRING "PCH ".
C
C       TYPPDB                INTEGER IMAGE OF CHARACTER STRING "PDB ".
C
C       TYPPHG                INTEGER IMAGE OF CHARACTER STRING "PHG ".
C
C       TYPPHT                INTEGER IMAGE OF CHARACTER STRING "PHT ".
C
C       TYPPLL                INTEGER IMAGE OF CHARACTER STRING "PLL ".
C
C       TYPPSN                INTEGER IMAGE OF CHARACTER STRING "PSN ".
C
C       TYPRFD                INTEGER IMAGE OF CHARACTER STRING "RFD ".
C
C       TYPRFT                INTEGER IMAGE OF CHARACTER STRING "RFT ".
C
C       TYPRJP                INTEGER IMAGE OF CHARACTER STRING "RJP ".
C
C       TYPRRL                INTEGER IMAGE OF CHARACTER STRING "RRL ".
C
C       TYPRWS                INTEGER IMAGE OF CHARACTER STRING "RWS ".
C
C       RELNUM          CHR   8-CHARACTER RELEASE NUMBER.
C
C       GLOBAL VARIABLES --
C       NAME  DIMENSION TYPE  DESCRIPTION
C       ----  --------- ----  -----------
C       (NONE)
C
C
C       REVISION HISTORY --
C          21-NOV-85 DDC REVISED ERROR CODES.  (SAR 5391)
C          02-OCT-85 DDC FIXED DIVIDE BY ZERO AT *PHI* UPDATE
C                        WHEN THERE ARE NO CONNECTIONS.  (SAR 5199)
C          29-JUL-85 DDC CHECKED MODULE.
C          28-NOV-84 KMF WRITE MODULE.  (SAR 4856)
C
C
C       TESTING PLANS --
C          29-JUL-85 DDC COMPLETED UNIT TESTING.
C
C       ****************************************************************
C       *                      SUBSYSTEM TOKENS                        *
C       ****************************************************************
C$*     CPXTOKEN
C       ****************************************************************
C       *                    VARIABLE DECLARATIONS                     *
C       ****************************************************************
C       FORMAL PARAMETERS --
C       (NONE)
C       LOCAL VARIABLES --
C       CHARACTER*8  RELNUM
C
C       SUBSYSTEM GLOBAL VARIABLES --
C
```

```
CS*      SUBSYSCILCAT [CHX]
C
CS*      CHAMCV
CS*      CHXCEL
CS*      CHXCCN
CS*      CHXCHN
CS*      CHXCHR
CS*      CHXDVE
CS*      CHANCD
CS*      CHARED
C
C        OTHER SUBSYSTEM VARIABLES --
C
CS*      SUBSYSCILCAT [SSN]
C
CS*      ENTDAT
C
CS*      PEGEQUENT
CS*      PCFEQUENT
CS*      PCBEQUENT
CS*      PHGEQUENT
CS*      PHTEQUENT
CS*      PLLEQUENT
CS*      PSNEQUENT
CS*      REDEQUENT
CS*      RFTEQUENT
CS*      RJFEQUENT
CS*      RRLEQUENT
CS*      RWSEQUENT
C
C        SYSTEM GLOBAL VARIABLES --
CS*      SYSCOMMON
C
C
C        ************************************************************
C        *                    DATA STATEMENTS                       *
C        ************************************************************
C
C        (NONE)
C
C
C        ************************************************************
C        *                  STATEMENT FUNCTIONS                     *
C        ************************************************************
C
C        LOCAL STATEMENT FUNCTIONS --
C        (NONE)
C
C        SUBSYSTEM STATEMENT FUNCTIONS --
C        (NONE)
C
C        OTHER SUBSYSTEM STATEMENT FUNCTIONS --
C        (NONE)
C
C        SYSTEM STATEMENT FUNCTIONS --
C
CS*      SFUNCHCST
C
C
C        ************************************************************
C        *                    EXECUTABLE CODE                       *
C        ************************************************************
C
CS*      MODENTRY [CHX] [CHXUPC] [2628] [04]
C
C        VALIDATE FORMAL PARAMETERS
CS*      MOUNDSCHK [CLCFIL] [1] [*$ICFILES] [8000]
CS*      MOUNDSCHK [NEWFIL] [1] [*$ICFILES] [8010]
C
         TYPEBG = VISTRG('PBG ')
         TYPECH = VISTRG('ECH ')
         TYPEEB = VISTRG('PEB ')
         TYPEHG = VISTRG('PHG ')
         TYPEHT = VISTRG('PHT ')
         TYPELL = VISTRG('PLL ')
         TYPESN = VISTRG('PSN ')
         TYPEEL = VISTRG('REL ')
         TYPEFT = VISTRG('RFT ')
         TYPEJF = VISTRG('RJF ')
         TYPERL = VISTRG('RRL ')
         TYPEWS = VISTRG('RWS ')
```

```
C         DETERMINE HOW MUCH EACH CELL HAS MOVED IN THE X- AND
C         Y-DIRECTIONS AND SAVE THESE VALUES IN LOCAL ARRAYS
          DO  800 I = 1, CELCNT
          CELMVX(I) = CELDAT(9*CHXCELREX, I) - CELDAT(9*CHXCELOLDX, I)
          CELMVY(I) = CELDAT(9*CHXCELREY, I) - CELDAT(9*CHXCELOLDY, I)
  800     CONTINUE
C
C         *********************************
C         * OPEN OLD AND NEW DESIGN FILES *
C         *********************************
          OLDTYP = 1
          NEWTYP = 2
          IF (DSRCPN(OLDTYP, OLDFIL)) 8020, 8020, 900
                                       ERR   ERR    OK
C
  900     CONTINUE
          IF (DSRCPN(NEWTYP, NEWFIL)) 8030, 8030, 1000
                                       ERR   ERR    OK
C
C
 1000     CONTINUE
C         **************************
C         * DESIGN FILE FLUSH LOOP *
C         **************************
C         FLUSH PACKETS FROM OLD DESIGN FILE TO NEW ONE,
C         MODIFYING ONLY THE NECESSARY ONES.
          IF (FLNXPK(NXTPKT, OLDFIL, NEWFIL)) 8040, 7000, 1100
                                               ERR   END    OK
C
 1100     CONTINUE
          IF (NXTPKT .EQ. TYPPBG) GO TO 1200
          IF (NXTPKT .EQ. TYPPCH) GO TO 1300
          IF (NXTPKT .EQ. TYPPRP) GO TO 1400
          IF (NXTPKT .EQ. TYPPLL) GO TO 1500
          IF (NXTPKT .EQ. TYPPSN) GO TO 1600
          IF (NXTPKT .EQ. TYPPRC) GO TO 1700
          IF (NXTPKT .EQ. TYPPFI) GO TO 1800
          IF (NXTPKT .EQ. TYPPJE) GO TO 1900
          IF (NXTPKT .EQ. TYPPRL) GO TO 2000
          IF (NXTPKT .EQ. TYPPWS) GO TO 2100
          IF (NXTPKT .EQ. TYPPHT) GO TO 2200
          IF (NXTPKT .EQ. TYPPHG) GO TO 2300
          GO TO 1000
C
 1200     CONTINUE
C         ****************
C         * CARRIER DATA *
C         ****************
          IF (RXTENT(TYPPBG, OLDFIL)) 8070, 1290, 1210
                                       ERR   NONE   OK
C
 1210     CONTINUE
          PBGBLX = CRRBLX
          PBGBLY = CRRBLY
          PBGBUX = CRRBUX
          PBGBUY = CRRBUY
          PBGPLX = CRRPLX
          PBGPLY = CRRPLY
          PBGPUX = CRRPUX
          PBGPUY = CRRPUY
          PBGRLX = CRRRLX
          PBGRLY = CRRRLY
          PBGRUX = CRRRUX
          PBGRUY = CRRRUY
          IF (WRTENT(TYPPBG, NEWFIL)) 8050, 8050, 1290
                                       ERR   ERR    OK
C
 1290     CONTINUE
          GO TO 1000
C
 1300     CONTINUE
C         ****************
C         * CHANNEL DATA *
C         ****************
C         UPDATE THE LLX,Y AND URX,Y OF ALL CHANNELS
 1310     CONTINUE
          IF (RXTENT(TYPPCH, OLDFIL)) 8070, 1350, 1320
                                       ERR   NONE   OK
C
 1320     CONTINUE
          PCHLLX = CHNDAT(9*CHXCHNLLX, PCHCID)
          PCHLLY = CHNDAT(9*CHXCHNLLY, PCHCID)
          PCHURX = CHNDAT(9*CHXCHNURX, PCHCID)
          PCHURY = CHNDAT(9*CHXCHNURY, PCHCID)
          IF (WRTENT(TYPPCH, NEWFIL)) 8050, 8050, 1330
                                       ERR   ERR    OK
C
 1330     CONTINUE
          GO TO 1310
```

```
C
 1350   CONTINUE
C       HERE WHEN ALL CHANNELS HAVE BEEN UPDATED
        GO TO 1000
C
 1400   CONTINUE
C       ******************************
C       * DEVICE ASSOCIATED BARRIERS *
C       ******************************
C       UPDATE THE LLX,Y AND URX,Y OF DEVICE-ASSOCIATED BARRIERS
C       BASED ON THE AMOUNT THEIR CORRESPONDING CELLS HAVE MOVED.
 1410   CONTINUE
        IF (NXTENT(TYPEDB, OLDFIL)) 8070, 1450, 1420
                                    ERR   NONE  OK
C
 1420   CONTINUE
        IF (FDBPLV .LE. 0) GO TO 1425
        FDBLLX = FDBLLX + CELMVX(FDBPLV)
        FDBLLY = FDBLLY + CELMVY(FDBPLV)
        FDBURX = FDBURX + CELMVX(FDBPLV)
        FDBURY = FDBURY + CELMVY(FDBPLV)
 1425   CONTINUE
        IF (WRTENT(TYPEDB, NEWFIL)) 8050, 8050, 1430
                                    ERR   ERR   OK
C
 1430   CONTINUE
        GO TO 1410
C
 1450   CONTINUE
C       HERE WHEN ALL DEVICE-ASSOCIATED BARRIERS HAVE BEEN UPDATED
        GO TO 1000
C
 1500   CONTINUE
C       ******************
C       * LEGAL LOCATIONS *
C       ******************
C       UPDATE THE X,Y OF ALL LEGAL LOCATIONS BASED ON
C       THE CURRENT LOCATION OF THEIR OCCUPANT DEVICE.
 1510   CONTINUE
        IF (NXTENT(TYPELL, OLDFIL)) 8070, 1550, 1520
                                    ERR   NONE  OK
C
 1520   CONTINUE
        IF (FLLLCC .LE. 0) GO TO 1525
        FLLREFX = CELLAI($$CHXCELREFX, FLLLCC)
        FLLREFY = CELLAI($$CHXCELREFY, FLLLCC)
 1525   CONTINUE
        IF (WRTENT(TYPELL, NEWFIL)) 8050, 8050, 1530
                                    ERR   ERR   OK
C
 1530   CONTINUE
        GO TO 1510
C
 1550   CONTINUE
C       HERE WHEN ALL LEGAL LOCATIONS HAVE BEEN UPDATED
        GO TO 1000
C
 1600   CONTINUE
C       *********
C       * NODES *
C       *********
C       UPDATE THE X,Y LOACTIONS OF ALL NODES BASED ON THE
C       AMOUNT BY WHICH THEIR CORRESPONDING DEVICES HAVE MOVED
 1610   CONTINUE
        IF (NXTENT(TYPPSN, OLDFIL)) 8070, 1650, 1620
                                    ERR   NONE  OK
C
 1620   CONTINUE
        IF (FSNMCD .LE. 0) GO TO 1625
        FSNREX = FSNREX + CELMVX(FSNMCD)
        FSNREY = FSNREY + CELMVY(FSNMCD)
 1625   CONTINUE
        IF (WRTENT(TYPPSN, NEWFIL)) 8050, 8050, 1630
                                    ERR   ERR   OK
C
 1630   CONTINUE
        GO TO 1610
C
 1650   CONTINUE
C       HERE WHEN ALL NODE LOCATIONS HAVE BEEN UPDATED
        GO TO 1000
C
 1700   CONTINUE
C       ********************************
C       * DEVICE-ASSOCIATED FEEDTHRUS *
C       ********************************
C       UPDATE THE X,Y LOCATIONS OF THE TWO ENDPOINTS OF EACH
C       FEEDTHRU BASED ON THE AMOUNT BY WHICH THEIR CORRESPONDING
```

```
C          DEVICES HAVE MOVED.
      1710 CONTINUE
           IF (NXTENT(TYPFRD, OLDFIL)) 8070, 1750, 1720
                                      ERR   NONE   OK
C
      1720 CONTINUE
           IF (RFCDEV .LE. 0) GO TO 1725
           RFCD1X = RFCD1X + CELMVX(RFCDEV)
           RFCD1Y = RFCD1Y + CELMVY(RFCDEV)
           RFCD2X = RFCD2X + CELMVX(RFCDEV)
           RFCD2Y = RFCD2Y + CELMVY(RFCDEV)
      1725 CONTINUE
           IF (WRTENT(TYPFRD, NEWFIL)) 8050, 8050, 1730
                                      ERR   ERR    OK
C
      1730 CONTINUE
           GO TO 1710
C
      1750 CONTINUE
C          HERE WHEN DONE UPDATING LOCATIONS OF ALL FEEDTHRUS
           GO TO 1000
C
      1800 CONTINUE
C          ***********
C          * FRONTCS *
C          ***********
C          THE ORIGINAL SET OF FRONTCS IN THE DESIGN FILE
C          IS MEANINGLESS AND MUST THEREFORE BE DESTROYED.
           IF (CLSECK(TYPFR1, NEWFIL)) 8060, 8060, 1850
                                      ERR   ERR    OK
C
      1850 CONTINUE
           GO TO 1000
C
      1900 CONTINUE
C          ***********
C          * JUMPERS *
C          ***********
C          UPDATE THE X,Y LOCATIONS OF THE JUMPER ENDPOINTS BASED ON
C          THE AMOUNT BY WHICH THEIR CORRESPONDING DEVICES HAVE MOVED
      1910 CONTINUE
           IF (NXTENT(TYPRJP, OLDFIL)) 8070, 1950, 1920
                                      ERR   NONE   OK
C
      1920 CONTINUE
           IF (RJPDEV .LE. 0) GO TO 1925
           RJPFRX = RJPFRX + CELMVX(RJPDEV)
           RJPFRY = RJPFRY + CELMVY(RJPDEV)
           RJPTCX = RJPTCX + CELMVX(RJPDEV)
           RJPTCY = RJPTCY + CELMVY(RJPDEV)
      1925 CONTINUE
           IF (WRTENT(TYPRJP, NEWFIL)) 8050, 8050, 1930
                                      ERR   ERR    OK
C
      1930 CONTINUE
           GO TO 1910
C
      1950 CONTINUE
C          HERE WHEN DONE UPDATING ALL JUMPERS
           GO TO 1000
C
      2000 CONTINUE
C          **********************
C          * POWER-GROUND RAILS *
C          **********************
C          UPDATE THE X,Y LOCATIONS OF THE TWO ENDPOINTS OF
C          ALL POWER AND GROUND RAILS BASED ON THE AMOUNT BY
C          WHICH THEIR CORRESPONDING DEVICES HAVE MOVED.
      2010 CONTINUE
           IF (NXTENT(TYPRRL, OLDFIL)) 8070, 2050, 2020
                                      ERR   NONE   OK
C
      2020 CONTINUE
           IF (RRLCL1 .LE. 0) GO TO 2022
           RRLE1X = RRLE1X + CELMVX(RRLCL1)
           RRLE1Y = RRLE1Y + CELMVY(RRLCL1)
      2022 CONTINUE
           IF (RRLCL2 .LE. 0) GO TO 2025
           RRLE2X = RRLE2X + CELMVX(RRLCL2)
           RRLE2Y = RRLE2Y + CELMVY(RRLCL2)
      2025 CONTINUE
           IF (WRTENT(TYPRRL, NEWFIL)) 8050, 8050, 2030
                                      ERR   ERR    OK
C
      2030 CONTINUE
           GO TO 2010
C
      2050 CONTINUE
C          HERE WHEN DONE UPDATING RAIL LOCATIONS
```

```
      GO TO 1000
C
 2100 CONTINUE
C     *****************
C     * WIRE SEGMENTS *
C     *****************
C     CREATE NEW WIRE SEGMENTS IN THE OUTPUT DESIGN FILE
C     BASED ON THE LOCATIONS OF TERMINALS AND CONNECTIONS.
C
      CALL WIRGEP(NEWFIL, GRDSNF)
C
C     CREATE WIRE SEGMENTS FOR POWER/GROUND I/O RINGS.
      IF (CHAFCF(4) .EQ. 1)  CALL PGRING(NEWFIL, GRDSNF)
C
C     SINCE NEW WIRE SEGMENTS WERE OUTPUT, NEED TO
C     DESTROY ALL WIRE SEGMENTS IN INPUT DESIGN FILE.
      IF (CLSPCK(TYPRWS, NEWFIL)) 8060, 8060, 2150
                                  ERR   ERR   OK
C
 2150 CONTINUE
      GO TO 1000
C
C
 2200 CONTINUE
C     **********************
C     * PROCESSING HISTORY *
C     **********************
C     CREATE PROCESSING HISTORY RECORD FOR THE *IRK* SUBSYSTEM
      CALL     ENDTIM(TCLOCK)
      LAPTIM = ETTIME(ICLOCK)
      CALL     STRTIM(ICLOCK)
C
      PHISUB = VISTRG('IRK ')
      PHISIA = 0
      PHIWST = WRSTEP
      PHILG1 = C
      PHILG2 = LAPTIM
      PHISH1 = C
      IF (CONCNT .GT. 0) PHISH1 = (CONSUC*10000)/CONCNT
      PHISH2 = 0
      PHISH3 = C
      PHISH4 = C
      PHISH5 = C
      PHISH6 = SSNPCF(6)
      PHISH7 = C
      RELNUM = $$$RELEASE
      PHIRV1 = VISTRG(RELNUM(1:4))
      PHIRV2 = VISTRG(RELNUM(5:8))
      IF (WRTENT(TYPPHI, NEWFIL)) 8050, 8050, 2290
                                  ERR   ERR   OK
C
 2290 CONTINUE
      GO TO 1000
C
 2300 CONTINUE
C     **********************
C     * HYPERGRID PATTERNS *
C     **********************
C     EXTEND THE REPEAT COUNT OF ALL HYPERGRIDS FOUND TO
C     COVER THE ADDITIONAL EXPANDED DISTANCE AS A RESULT
C     OF THE CHANNEL EXPANSION.
 2310 CONTINUE
      IF (NXTENT(TYPPHG, OLDFIL)) 8070, 2340, 2320
                                  ERR   NONE  OK
C
 2320 CONTINUE
      PHGJRX = PHGJRX + (CHRXXX / PHGMJX)
      PHGJRY = PHGJRY + (CHRYYY / PHGMJY)
      IF (WRTENT(TYPPHG, NEWFIL)) 8050, 8050, 2330
                                  ERR   ERR   OK
C
 2330 CONTINUE
      GO TO 2310
C
 2340 CONTINUE
C     HERE WHEN DONE UPDATING ALL HYPERGRIDS
      GO TO 1000
C
 7000 CONTINUE
C     **********************************
C     * CLOSE OLD AND NEW DESIGN FILES *
C     **********************************
      IF (DSFCLS(OLDFIL)) 8080, 8080, 7010
                          ERR   NO-OP  OK
C
 7010 CONTINUE
      IF (DSFCLS(NEWFIL)) 8090, 8090, 7020
```

```
C                         ERR    NC-CP   OK
 7020     CONTINUE
C         HERE WHEN DONE UPDATING THE DESIGN FILE.
          GO TO 9000
C
C         ************************************************************
C         *                       ERROR RETURNS                      *
C         ************************************************************
C
 8000     CONTINUE
C/        CHX - ILLEGAL INDEX SPECIFIED FOR OLD DESIGN FILE.
C/        **FM(1X,'OLD FILE INDEX = ',I6,6X,'LIMIT = ',I6)
          CALL VISERR(MCDNBR, 8262801, OLDFIL, **SIDFILES)
          GO TO 9000
 8010     CONTINUE
C/        CHX - ILLEGAL INDEX SPECIFIED FOR NEW DESIGN FILE.
C/        **FM(1X,'NEW FILE INDEX = ',I6,6X,'LIMIT = ',I6)
          CALL VISERR(MCDNBR, 8262802, NEWFIL, **SIDFILES)
          GO TO 9000
 8020     CONTINUE
C/        CHX - ERROR OPENING OLD DESIGN FILE DURING UPDATE.
C/        **FM(1X,'OLD FILE INDEX = ',I6,6X,'UNIT NO. = ',I6)
          CALL VISERR(MCDNBR, 8262803, OLDFIL, IOFILE(OLDFIL))
          GO TO 9000
 8030     CONTINUE
C/        CHX - ERROR OPENING NEW DESIGN FILE FOR UPDATE.
C/        **FM(1X,'NEW FILE INDEX = ',I6,6X,'UNIT NO. = ',I6)
          CALL VISERR(MCDNBR, 8262804, NEWFIL, IOFILE(NEWFIL))
          GO TO 9000
 8040     CONTINUE
C/        CHX - ERROR WHILE FLUSHING PACKET FROM OLD DESIGN
C/              FILE TO NEW DESIGN FILE DURING UPDATE.
C/        **FM(1X,'LAST PACKET =    ',A4,6X,'WRSTER = ',I12)
          CALL VISERR(MCDNBR, 8262805, NXTPKT, WRSTER)
          GO TO 9000
 8050     CONTINUE
C/        CHX - ERROR WRITING ENTRY TO NEW DESIGN FILE
C/              DURING UPDATE.
C/        **FM(1X,'CURRENT PACKET =    ',A4,6X,'WRSTER = ',I12)
          CALL VISERR(MCDNBR, 8262806, NXTPKT, WRSTER)
          GO TO 9000
 8060     CONTINUE
C/        CHX - ERROR CLOSING PACKET IN NEW DESIGN FILE AFTER
C/              ALL DATA FOR THAT PACKET HAS BEEN UPDATED.
C/        **FM(1X,'CURRENT PACKET =    ',A4,6X,'WRSTER = ',I12)
          CALL VISERR(MCDNBR, 8262807, NXTPKT, WRSTER)
          GO TO 9000
 8070     CONTINUE
C/        CHX - ERROR READING NEXT ENTRY FROM OLD DESIGN
C/              FILE DURING UPDATE.
C/        **FM(1X,'CURRENT PACKET =    ',A4,6X,'WRSTER = ',I12)
          CALL VISERR(MCDNBR, 8262808, NXTPKT, WRSTER)
          GO TO 9000
 8080     CONTINUE
C/        CHX - ERROR CLOSING OLD DESIGN FILE AFTER UPDATE.
C/        **FM(1X,'OLD FILE INDEX = ',I6,6X,'UNIT NO. = ',I6)
          CALL VISERR(MCDNBR, 8262809, OLDFIL, IOFILE(OLDFIL))
          GO TO 9000
 8090     CONTINUE
C/        CHX - ERROR CLOSING NEW DESIGN FILE AFTER UPDATE.
C/        **FM(1X,'NEW FILE INDEX = ',I6,6X,'UNIT NO. = ',I6)
          CALL VISERR(MCDNBR, 8262810, NEWFIL, IOFILE(NEWFIL))
          GO TO 9000
C
C
C         ************************************************************
C         *               SINGLE EXIT FROM THIS ROUTINE              *
C         ************************************************************
C
 9000     CONTINUE
CS*       MCLEXIT (CHX)
          RETURN
C
C
C         ************************************************************
C         *                     FORMAT STATEMENTS                    *
C         ************************************************************
C
C         (NONE)
C
C
C         END (HYBLE 2626
```

PAGE 9

21-OCT-1986 08:44

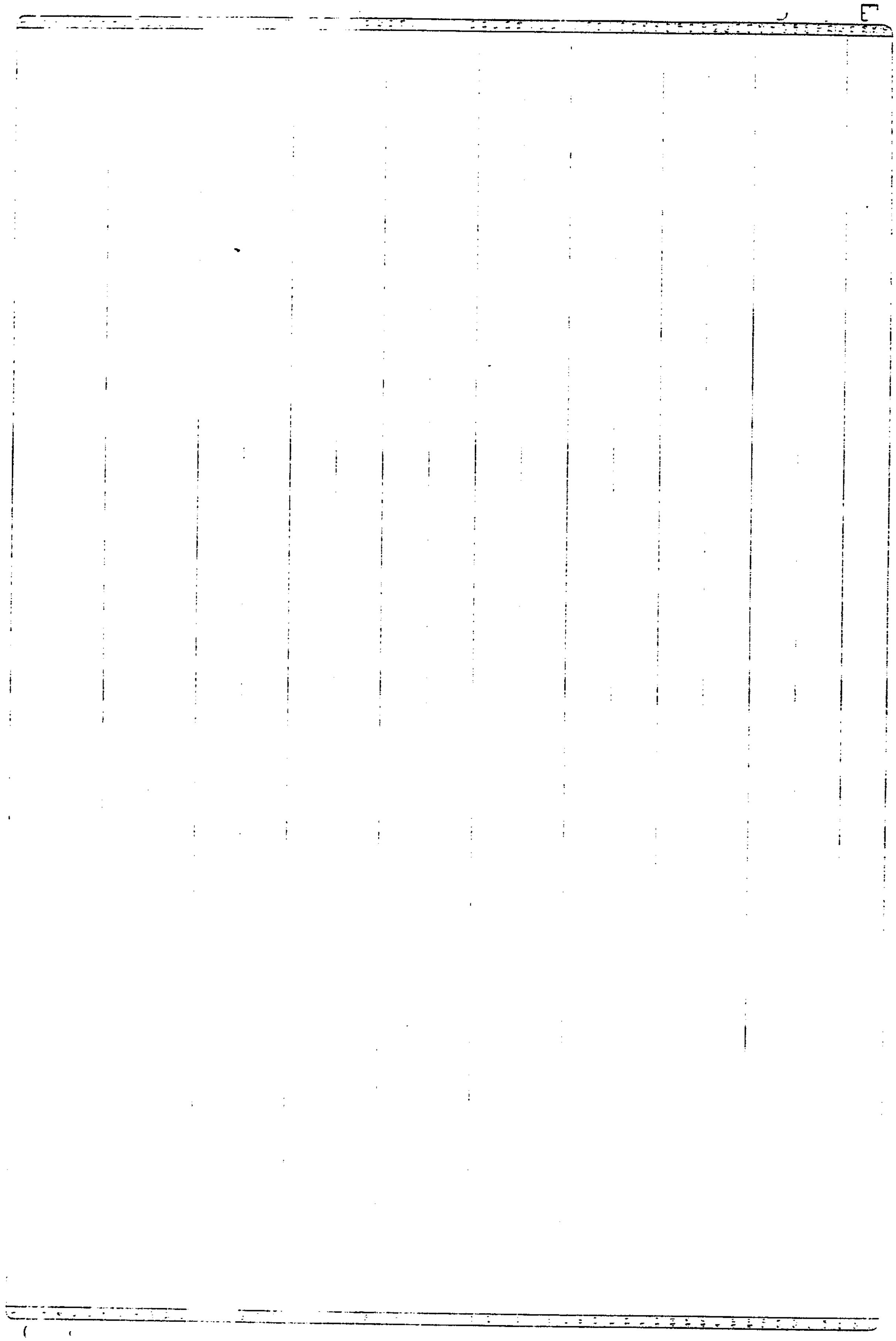

DIGITAL EQUIPMENT CORPORATION - VAX/VMS VERSION V4.4

KMP S2629.FOR;1

FILE _$1$DUA6:[PRC.CHX02]S2629.FOR;1 (1076,1,2), LAST REVISED ON 21-OCT-1986 08:44, IS A 40 BLOCK SEQUENTIAL FILE OWNED BY UIC [PRDTST,FFC]. THE RECORDS ARE VARIABLE LENGTH WITH IMPLIED (CR) CARRIAGE CONTROL. THE LONGEST RECORD IS 72 BYTES.

JOB S2629 (211) QUEUED TO SYS$PRINT ON 4-DEC-1986 12:51 BY USER KMP, UIC [ENGVLST,KMP], UNDER ACCOUNT ENGERG AT PRIORITY 100, STARTED ON PRINTER _TENTOS$LPAO: ON 4-DEC-1986 13:11 FROM QUEUE SYS$PRINT.

DIGITAL EQUIPMENT CORPORATION - VAX/VMS VERSION V4.4

VAX/VMS VAX/VMS VAX/VMS VAX/VMS VAX/VMS VAX/VMS VAX/VMS VAX/VMS VAX/VMS VAX/VMS VAX/VMS VAX/VMS

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS

GGGGGGGGGG   666666666666666666666666666666666666666666666666666666666666666666666666666666666666666666666666   GGGGGGGGGG
GGGGGGGGGG   6666666666666666666666666  DIGITAL EQUIPMENT CORPORATION - VAX/VMS VERSION V4.4  666666666666666666666666   GGGGGGGGGG
GGGGGGGGGG   666666666666666666666666666666666666666666666666666666666666666666666666666666666666666666666666   GGGGGGGGGG

K   K  M   M  PPPP
K  K   MM MM  P   P
K K    M M M  P   P
KKK    M   M  PPPP
K K    M   M  P
K  K   M   M  P
K   K  M   M  P

  SSSSSSSS    222222      666666     222222      999999
  SSSSSSSS    222222      666666     222222      999999
SS          22      22  66         22      22  99      99
SS                  22  66                 22  99      99
SS                  22  66                 22  99      99
SS                  22  66                 22  99      99
  SSSSSS          22    66666666         22      99999999
  SSSSSS          22    66666666         22      99999999
        SS      22      66      66     22              99
        SS      22      66      66     22              99
        SS    22        66      66   22                99
        SS    22        66      66   22                99
SSSSSSSS    2222222222    666666     2222222222  999999
SSSSSSSS    2222222222    666666     2222222222  999999

          FFFFFFFFFF    OOOOOO    RRRRRRRR
          FFFFFFFFFF    OOOOOO    RRRRRRRR
          FF          OO      OO  RR      RR
          FF          OO      OO  RR      RR
          FF          OO      OO  RR      RR
          FF          OO      OO  RR      RR
          FFFFFFFF    OO      OO  RRRRRRRR
          FFFFFFFF    OO      OO  RRRRRRRR
          FF          OO      OO  RR  RR
          FF          OO      OO  RR  RR
::::      FF          OO      OO  RR    RR
::::      FF          OO      OO  RR    RR
::::      FF            OOOOOO    RR      RR
::::      FF            OOOOOO    RR      RR

            ;;;;        11
            ;;;;        11
            ;;;;      1111
            ;;;;      1111
                        11
                        11
            ;;;;        11
            ;;;;        11
            ;;;;        11
            ;;;;        11
              ;;        11
              ;;        11
            ;;        111111
            ;;        111111

FILE _$1$DUA6:[FRC.CHX02]S2629.FOR;1 (1976,1,2), LAST REVISED ON 21-OCT-1986 08:44, IS A 40 BLOCK SEQUENTIAL FILE OWNED BY UIC
[PERTSI,PFC]. THE RECORDS ARE VARIABLE LENGTH WITH IMPLIED (CR) CARRIAGE CONTROL. THE LONGEST RECORD IS 72 BYTES.

JOB S2629 (211) QUEUED TO SYS$PRINT ON 4-DEC-1986 12:51 BY USER KMP, UIC [ENGVLSI,KMP], UNDER ACCOUNT ENGPKG AT PRIORITY 100,
STARTED ON PRINTER _TCNTOSLPA0: ON 4-DEC-1986 13:11 FROM QUEUE SYS$PRINT.

GGGGGGGGGG   666666666666666666666666666666666666666666666666666666666666666666666666666666666666666666666666   GGGGGGGGGG
GGGGGGGGGG   6666666666666666666666666  DIGITAL EQUIPMENT CORPORATION - VAX/VMS VERSION V4.4  666666666666666666666666   GGGGGGGGGG
GGGGGGGGGG   666666666666666666666666666666666666666666666666666666666666666666666666666666666666666666666666   GGGGGGGGGG
```

```
      SUBROUTINE CLCLOD(FILINX)
CS*   ALLINIEG
C
C                        ****************
C                        *              *
C     SUBSYSTEM CHX      *  2629 CLCLCD  *
C                        *              *
C                        ****************
C
C     ************************************************************
C     ************************************************************
C     **                                                        **
C     **  (C) COPYRIGHT V-R INFORMATION SYSTEMS, INC. 1984      **
C     **  LICENSED MATERIAL -- PROGRAM PROPERTY OF VRIS         **
C     **  ALL RIGHTS RESERVED                                   **
C     **                                                        **
C     **  THIS PROGRAM IS THE PROPERTY OF VRIS AND IS FURNISHED **
C     **  PURSUANT TO A WRITTEN LICENSE AGREEMENT. IT MAY NOT BE**
C     **  USED, REPRODUCED, OR DISCLOSED TO OTHERS EXCEPT IN    **
C     **  ACCORDANCE WITH THE TERMS AND CONDITIONS OF THAT      **
C     **  AGREEMENT.                                            **
C     **                                                        **
C     ************************************************************
C     ************************************************************
C
C     ************************************************************
C     *                  MODULE DOCUMENTATION                    *
C     ************************************************************
C
C     SUMMARY --
C
C     THIS SUBROUTINE LOADS DATA DEFINING WHICH CELLS ARE ADJACENT
C     TO EACH CHANNEL ON THE "LO" AND "HI" SIDES (AND THEREBY
C     WHICH CHANNELS ARE ADJACENT TO EACH CELL ON THE BOTTOM, TOP
C     LEFT, AND RIGHT SIDES) FROM THE CELLS-ON-CHANNEL DEFINITION
C     FILE CREATED BY THE CHANNEL DEFINITION SUBSYSTEM (CHD).
C
C     IT ALSO DEFINES THE "WELLS" THAT ARE CREATED ALONG THE
C     CHANNEL SIDES BECAUSE OF UNEVEN CELL HEIGHTS.
C
C     THE INPUT FILE, WHOSE INDEX INTO THE IOFILE ARRAY IS
C     SPECIFIED VIA FORMAL PARAMETER *FILINX* IS ASSUMED TO
C     BE CLOSED WHEN THIS MODULE IS INVOKED. WHEN LOADING IS
C     COMPLETED, THE FILE IS CLOSED BY THIS MODULE.
C
C     THE INPUT FILE IS AN ALPHA-NUMERIC SEQUENTIAL FILE
C     CONTAINING DATA IN THE FOLLOWING FORM:
C
C     REC-1: <CHANID> <LOWCNT> <HIGCNT>
C     REC-2: <CELLID> <CELLID> ... <CELLID>  (LO SIDE CELL LIST)
C       .        .        .          .
C     REC-I: <CELLID> <CELLID> ... <CELLID>  (HI SIDE CELL LIST)
C       .        .        .          .
C     REC-J: <CHANID> <LOWCNT> <HIGCNT>
C     REC-K: <CELLID> <CELLID> ... <CELLID>  (LO SIDE CELL LIST)
C       .        .        .          .
C     REC-L: <CELLID> <CELLID> ... <CELLID>  (HI SIDE CELL LIST)
C       .        .        .          .
C
C     NOTES:
C     -----
C
C     FOR A HORIZONTAL (VERTICAL) CHANNEL, THE "LO" SIDE
C     CELLS ARE THOSE WHICH ARE BELOW (TO THE LEFT OF) THE
C     CHANNEL, WHILE THE "HI" SIDE CELLS ARE THOSE WHICH
C     ARE ABOVE (TO THE RIGHT OF) THAT CHANNEL.
C
C     FOR A HORIZONTAL (VERTICAL) CHANNEL, A "WELL" EXISTS
C     BETWEEN A CELL ALONG THE CHANNEL AND THE CHANNEL IF
C     THE TOP/BOTTOM (LEFT/RIGHT) EDGE OF THE CELL DOES
C     NOT COINCIDE WITH THE BOTTOM/TOP (RIGHT/LEFT) EDGE
C     OF THE CHANNEL BECAUSE OF UNEVEN HEIGHT CELLS.
C
C     A "WELL" CAN ALSO EXIST FOR A VERTICAL (HORIZONTAL)
C     CHANNEL IF THE LENGTHS OF THE CELL ROWS (COLUMNS)
```

```
C       ARE NOT IDENTICAL.
C
C
C                                          KEY: W = WELL
C                                          ---
C                                   +++++++++
C                                   +       +
C       +++++++++         +++++++++ +       +++++++
C       +       +         +       + +       +     +
C       +       ++++++++++        + +       +     +      "HI" SIDE
C       + CELL  +  CELL   + CELL  + + CELL  + CELL+        CELLS
C       +       ++++++++++        + +       +     +
C       +       +         +       + +       +     +
C       +++++++++    W    +++++++++ +       +++++++
C       :   W   :         :   W   + +       + W   :
C       ....:.......:.........:.......+++++++++.....:........
C
C                HORIZONTAL CHANNEL
C
C       ..................................................
C
C
C       FORMAL PARAMETERS --
C       NAME   DIMENSION TYPE   IN/OUT  DESCRIPTION
C       ----   --------- ----   ------  -----------
C       FILINX             I      IN    INDEX OF FILE FROM WHICH
C                                       CELLS-ON-CHANNEL DESCRIPTIONS
C                                       ARE TO BE LOADED.
C                                       UNIT NUMBER = IOCFILE(FILINX)
C
C       LOCAL VARIABLES --
C       NAME   DIMENSION TYPE  DESCRIPTION
C       ----   --------- ----  -----------
C       ACELL                  CELL NUMBER.
C
C       ACHAN                  CHANNEL NUMBER.
C
C       ACHLLX                 X- AND Y-COORDINATES OF THE LOWER-LEFT
C       ACHLLY                 AND UPPER-RIGHT CORNERS OF A CHANNEL.
C       ACHURX
C       ACHURY
C
C       ACHORN                 CHANNEL ORIENTATION.
C
C       ACNT                   COUNTER OF THE NUMBER OF CELLS
C                              TO BE PROCESSED.
C
C       CLCFIL                 UNIT NUMBER OF FILE FROM WHICH
C                              CELL-TO-CHANNEL ADJACENCY DATA
C                              IS LOADED.
C
C       HCNT                   NUMBER OF CELLS ALONG HI SIDE
C                              OF A GIVEN CHANNEL.
C
C       LCNT                   NUMBER OF CELLS ALONG LO SIDE
C                              OF A GIVEN CHANNEL.
C
C       PCELL                  PREVIOUS CELL NUMBER.
C
C       TEMP(10)               BUFFER USED TO LOAD DATA IN FROM
C                              THE CELL-TO-CHANNEL ADJACENCY FILE.
C
C       WLLX                   X- AND Y-COORDINATES OF THE
C       WLLY                   LOWER-LEFT AND UPPER-RIGHT
C       WURX                   CORNERS OF A WELL CREATED
C       WURY                   WHEN CELL EDGE IS NOT FLUSH
C                              WITH CHANNEL EDGE.
C
C       GLOBAL VARIABLES --
C       NAME   DIMENSION TYPE  DESCRIPTION
C       ----   --------- ----  -----------
C       (NONE)
C
C       REVISION HISTORY --
C          21-NOV-85 DLC REVISED ERROR CODES.  (SAP 5391)
C          20-NOV-85 DLC CORRECTED ERROR FORMAT.  (SAP 5372)
```

```
C          29-JUL-85 DDC CHECKED MODULE.
C          19-SEP-84 PKP WROTE MODULE.  (SAR 4656)
C
C
C        TESTING PLANS --
C           29-JUL-85 DDC COMPLETED UNIT TESTING.
C
C
C        ****************************************************************
C        *                     SUBSYSTEM TOKENS                         *
C        ****************************************************************
CS*      CHXTOKEN
C
C        ****************************************************************
C        *                  VARIABLE DECLARATIONS                       *
C        ****************************************************************
C
C        FORMAL PARAMETERS --
C        (NONE)
C
C        LOCAL VARIABLES --
         DIMENSION TEMP(10)
C
C        SUBSYSTEM GLOBAL VARIABLES --
C
CS*      SUBSYSGLOBAL [CHX]
C
CS*      CHXCFL
CS*      CHXCHN
CS*      CHXWEL
C
C        OTHER SUBSYSTEM VARIABLES --
C        (NONE)
C
C        SYSTEM GLOBAL VARIABLES --
CS*      SYSCOMMON
C
C        ****************************************************************
C        *                     DATA STATEMENTS                          *
C        ****************************************************************
C
C        (NONE)
C
C        ****************************************************************
C        *                   STATEMENT FUNCTIONS                        *
C        ****************************************************************
C
C        LOCAL STATEMENT FUNCTIONS --
C        (NONE)
C
C        SUBSYSTEM STATEMENT FUNCTIONS --
C        (NONE)
C
C        OTHER SUBSYSTEM STATEMENT FUNCTIONS --
C        (NONE)
C
C        SYSTEM STATEMENT FUNCTIONS --
C
CS*      SFUNCHCS1
C
C        ****************************************************************
C        *                     EXECUTABLE CODE                          *
C        ****************************************************************
C
CS*      MODENTRY [CHX] [CLCLOD] [2629] [05]
C
C
C        *****************
C        * SETUP TO LOAD *
C        *****************
CS*      BOUNDSCHK [FILINX] [0] [$$SICFILES] [8000]
C
         CLCFIL = ICFILE(FILINX)
         IF (FILINX .LE. 0) GO TO 8010
C
C        OPEN THE ALPHA-NUMERIC SEQUENTIAL CELLS-IN-CHANNEL
C        DEFINITION FILE FOR INPUT IN READ-ONLY SHARABLE MODE.
         CALL FIMNTF(7, CLCFIL, 'CLCFIL      ')
```

```
      IF (WRSTER .GT. 8000000) GO TO 8020
C
 1000 CONTINUE
C     ***********************************************************
C     * LOAD CHANNEL NUMBER AND CELL COUNTS FOR HI AND LO SIDES *
C     ***********************************************************
      READ(CLCFIL, 9010, END=7900) ACHAN, LCNT, HCNT
      IF ((ACHAN .LE. 0) .OR. (ACHAN .GT. CHNCNT)) GO TO 8030
C
C     DETERMINE LOCATION, AND ORIENTATION OF CHANNEL
      ACHLLX = CHNDAT($$CHXCHNLLX,     ACHAN)
      ACHLLY = CHNDAT($$CHXCHNLLY,     ACHAN)
      ACHURX = CHNDAT($$CHXCHNURX,     ACHAN)
      ACHURY = CHNDAT($$CHXCHNURY,     ACHAN)
      ACHORN = CHNDAT($$CHXCHNORIENT,  ACHAN)
C
C     **********************
C     * LOAD LO SIDE CELLS *
C     **********************
C     LOAD IN THE INDICES OF THE CELLS ON THE LO SIDE OF CHANNEL.
C     NOTE: UPTO TEN (10) CELL INDICES MAY BE SPECIFIED ON A
C     ----  CARD-IMAGE RECORD OF *CLCFIL*.
C
      IF (LCNT .LE. 0) GO TO 1200
      PCELL = 0
C
 1110 CONTINUE
      ACNT = VISMN2(LCNT, 10)
C
      READ(CLCFIL, 9020, END=7900) (TEMP(I), I=1,ACNT)
C
C     FOR EACH "LO" SIDE CELL JUST LOADED, SET UP A POINTER TO THE
C     CHANNEL AND LINK IT IN WITH THE PREVIOUS CELL ALONG THE
C     CHANNEL (IF ANY). IF THIS IS THE FIRST CELL ON THE CHANNEL,
C     THEN SET UP THE "FIRST CELL ON LO SIDE POINTER" FOR CHANNEL.
C
C     ALSO CHECK IF A "WELL" (OPEN AREA BETWEEN THE CELL AND
C     THE CHANNEL) EXISTS, AND IF SO, DETERMINE THE COORDINATES
C     OF THE LOWER-LEFT AND UPPER-RIGHT CORNERS OF THE "WELL".
C
      DO 1190 I = 1, ACNT
C
      ACELL = TEMP(I)
      IF ((ACELL .LE. 0) .OR. (ACELL .GT. CELCNT)) GO TO 8040
C
C     CHECK IF FIRST CELL ON LO SIDE OF CHANNEL.
      IF (PCELL .EQ. 0) CHNDAT($$CHXCHNLOCLPT, ACHAN) = ACELL
C
      GO TO (1120, 1130), ACHORN
C               HZ    VT
C
 1120 CONTINUE
C     **************
C     * HZ CHANNEL *
C     **************
C     SET UP POINTERS AS NECESSARY.
      CELDAT($$CHXCELTOPCH, ACELL) = ACHAN
      CELDAT($$CHXCELNXTTP, ACELL) = 0
      IF (PCELL .GT. 0) CELDAT($$CHXCELNXTTP, PCELL) = ACELL
      PCELL = ACELL
C
C     DETERMINE COORDINATES OF "WELL" IF ONE EXISTS.
      WLLX = CELDAT($$CHXCELRFX, ACELL) + CELDAT($$CHXCELLLX, ACELL)
      WLLY = CELDAT($$CHXCELRFY, ACELL) + CELDAT($$CHXCELURY, ACELL)
      WURX = CELDAT($$CHXCELRFX, ACELL) + CELDAT($$CHXCELURX, ACELL)
      WURY = ACHLLY
      IF ((WURY-WLLY) .EQ. 0) GO TO 1190
      GO TO 1150
C
 1130 CONTINUE
C     **************
C     * VT CHANNEL *
C     **************
C     SET UP POINTERS AS NECESSARY.
      CELDAT($$CHXCELRGHCH, ACELL) = ACHAN
      CELDAT($$CHXCELNXTRG, ACELL) = 0
      IF (PCELL .GT. 0) CELDAT($$CHXCELNXTRG, PCELL) = ACELL
      PCELL = ACELL
C
C     DETERMINE COORDINATES OF "WELL" IF ONE EXISTS.
      WLLX = CELDAT($$CHXCELRFX, ACELL) + CELDAT($$CHXCELURX, ACELL)
      WLLY = CELDAT($$CHXCELRFY, ACELL) + CELDAT($$CHXCELLLY, ACELL)
```

```
      WURX = ACELLX
      WURY = CELDAT(%%CHXCELPFY, ACELL) + CELDAT(%%CHXCELURY, ACELL)
      IF ((WURX-WLLX) .EQ. 0) GO TO 1190
      GO TO 1150
C
1150  CONTINUE
C     HERE IF A SPACE (WELL) EXISTS BETWEEN THE TOP/RIGHT EDGE
C     OF THE CELL AND THE BOTTOM/LEFT EDGE OF THE CHANNEL.
      WELCNT            = WELCNT + 1
      WELDAT(1, WELCNT) = ACHAN
      WELDAT(2, WELCNT) = ACHORN
      WELDAT(3, WELCNT) = WLLX
      WELDAT(4, WELCNT) = WLLY
      WELDAT(5, WELCNT) = WURX
      WELDAT(6, WELCNT) = WURY
C
1190  CONTINUE
C     DONE PROCESSING THE CURRENT SET OF CELLS ON THE "LO" SIDE
C     OF THE CHANNEL. CHECK IF MORE CELLS EXIST ON THE "LO" SIDE.
      LCNT = LCNT - ACNT
      IF (LCNT .GT. 0) GO TO 1110
C
1200  CONTINUE
C     HERE DONE PROCESSING ALL CELLS ON THE "LO" SIDE OF CHANNEL.
C
C     **********************
C     * LOAD HI SIDE CELLS *
C     **********************
C     LOAD IN THE INDICES OF THE CELLS ON THE "HI" SIDE OF CHANNEL.
C     NOTE: UPTO TEN (10) CELL INDICES MAY BE SPECIFIED ON A
C     ----  CARD-IMAGE RECORD OF *CICFIL*.
C
      IF (HCNT .LE. 0) GO TO 1300
      PCELL = 0
C
1210  CONTINUE
      ACNT = VISMN2(HCNT, 10)
C
      READ(CLCFIL, 9020, END=7900) (TEMP(I), I=1,ACNT)
C
C     FOR EACH "HI" SIDE CELL JUST LOADED, SET UP A POINTER TO THE
C     CHANNEL AND LINK IT IN WITH THE PREVIOUS CELL ALONG THE
C     CHANNEL (IF ANY). IF THIS IS THE FIRST CELL ON THE CHANNEL,
C     THEN SET UP THE "FIRST CELL ON HI SIDE POINTER" FOR CHANNEL.
C
C     ALSO CHECK IF A "WELL" (OPEN AREA BETWEEN THE CELL AND
C     THE CHANNEL) EXISTS, AND IF SO, DETERMINE THE COORDINATES
C     OF THE LOWER-LEFT AND UPPER-RIGHT CORNERS OF THE "WELL".
C
      DO 1290 I = 1, ACNT
C
      ACELL = TEMP(I)
      IF ((ACELL .LE. 0) .OR. (ACELL .GT. CELCNT)) GO TO 8040
C
C     CHECK IF FIRST CELL ON "HI" SIDE OF CHANNEL.
      IF (PCELL .EQ. 0) CHNDAT(%%CHXCHNHICFPT, ACHAN) = ACELL
C
      GO TO (1220, 1230), ACHORN
C            HZ    VT
C
1220  CONTINUE
C     **************
C     * HZ CHANNEL *
C     **************
C     SET UP POINTERS AS NECESSARY.
      CELDAT(%%CHXCELBOTCH, ACELL) = ACHAN
      CELDAT(%%CHXCELNXTBT, ACELL) = 0
      IF (PCELL .GT. 0) CELDAT(%%CHXCELNXTBT, PCELL) = ACELL
      PCELL = ACELL
C
C     DETERMINE COORDINATES OF "WELL" IF ONE EXISTS.
      WLLX = CELDAT(%%CHXCELREFX, ACELL) + CELDAT(%%CHXCELLLX, ACELL)
      WLLY = ACHORY
      WURX = CELDAT(%%CHXCELREFX, ACELL) + CELDAT(%%CHXCELURX, ACELL)
      WURY = CELDAT(%%CHXCELREFY, ACELL) + CELDAT(%%CHXCELLLY, ACELL)
      IF ((WURY-WLLY) .EQ. 0) GO TO 1290
      GO TO 1250
C
1230  CONTINUE
C     **************
C     * VT CHANNEL *
C     **************
```

```
C         SET UP POINTERS AS NECESSARY.
          CELDAT(%%CHXCELLPTCH, ACELL) = ACHAN
          CELDAT(%%CHXCELNXTLF, ACELL) = 0
          IF (PCELL .GT. 0) CELDAT(%%CHXCELNXTLF, PCELL) = ACELL
          PCELL = ACELL
C
C         DETERMINE COORDINATES OF "WELL" IF ONE EXISTS.
          WLLX = ACELLX
          WLLY = CELDAT(%%CHXCELURY, ACELL) + CELDAT(%%CHXCELLLY, ACELL)
          WURX = CELDAT(%%CHXCELURX, ACELL) + CELDAT(%%CHXCELLLX, ACELL)
          WURY = CELDAT(%%CHXCELURY, ACELL) + CELDAT(%%CHXCELURY, ACELL)
          IF ((WURX-WLLX) .EQ. 0) GO TO 1290
          GO TO 1250
C
 1250     CONTINUE
C         HERE IF A SPACE (WELL) EXISTS BETWEEN THE TOP/RIGHT EDGE
C         OF THE CHANNEL AND THE BOTTOM/LEFT EDGE OF THE CELL.
          WELCNT              = WELCNT + 1
          WELDAT(1, WELCNT) = ACHAN
          WELDAT(2, WELCNT) = ACHCHN
          WELDAT(3, WELCNT) = WLLX
          WELDAT(4, WELCNT) = WLLY
          WELDAT(5, WELCNT) = WURX
          WELDAT(6, WELCNT) = WURY
C
 1290     CONTINUE
C         DONE PROCESSING THE CURRENT SET OF CELLS ON THE "HI" SIDE
C         OF THE CHANNEL. CHECK IF MORE CELLS EXIST ON THE "HI" SIDE.
          HCNT = HCNT - ACNT
          IF (HCNT .GT. 0) GO TO 1210
C
 1300     CONTINUE
C         HERE DONE PROCESSING ALL CELLS ON THE "HI" SIDE OF CHANNEL.
C         PROCESS NEXT CHANNEL.
          GO TO 1000
C
C         *************************
C         * DATA LOADING COMPLETE *
C         *************************
 7900     CONTINUE
C         CLOSE FILE *CLCFIL* PRIOR TO EXIT
          CALL FLMNIF(3, CLCFIL, 'CLCFIL        ')
          IF (WRSTER .GT. 6000000) GO TO 8050
          GO TO 9000
C
C         ***************************************************************
C         *                        ERROR RETURNS                        *
C         ***************************************************************
 8000     CONTINUE
C/        CHX - ILLEGAL VALUE SPECIFIED FOR FORMAL PARAMETER *FILINX*
C/              (FILE INDEX OF CELLS-ON-CHANNEL DEFINITION FILE).
C/              POSSIBLY BAD VALUE FOR TOKEN $ICFILES.
C/        **FM(1X,'FILINX = ',I6,6X,'LIMIT (TOKEN $ICFILE) = ',I6)
          CALL VISERR(MCDNBR, 8262901, FILINX, %%$ICFILES)
          GO TO 9000
 8010     CONTINUE
C/        CHX - UNIT NUMBER OF CELLS-ON-CHANNEL DEFINITION FILE IS
C/              ILLEGAL. POSSIBLE ERROR IN INITIALIZATION OF THE
C/              *ILEFILE* ARRAY IN SSN.
C/        **FM(1X,'UNIT NUMBER = ',I6,6X,'WORST ERROR = ',I12)
          CALL VISERR(MCDNBR, 8262902, CLCFIL, WRSTER)
          GO TO 9000
 8020     CONTINUE
C/        CHX - ERROR OPENING FILE DESCRIBING THE ADJACENCY BETWEEN
C/              CHANNELS AND CELLS (CLCFIL) AS INPUT. POSSIBLE ERROR
C/              IN FILE NAME OR MISSING FILE.
C/        **FM(1X,'UNIT NUMBER = ',I6,6X,'WORST ERROR = ',I12)
          CALL VISERR(MCDNBR, 8262903, CLCFIL, WRSTER)
          GO TO 9000
 8030     CONTINUE
C/        CHX - CHANNEL NUMBER SPECIFIED IN THE CELLS-ON-CHANNEL
C/              FILE (CLCFIL) DOES NOT EXIST. POSSIBLE ERROR WHILE
C/              EXECUTING THE CHANNEL DEFINITION SUBSYSTEM (CHC).
C/        **FM(' CHANNEL NUMBER =',I7,6X,'NO. OF CHANNELS =',I7)
          CALL VISERR(MCDNBR, 8262904, ACHAN, CHNCNT)
          GO TO 9000
 8040     CONTINUE
C/        CHX - A NON-EXISTENT CELL IS SPECIFIED AS BEING ADJACENT
C/              TO A CHANNEL. POSSIBLE ERROR WHILE EXECUTING THE
C/              CHANNEL DEFINITION SUBSYSTEM.
C/        **FM(1X,'CELL NUMBER = ',I6,6X,'CHANNEL NUMBER = ',I6)
          CALL VISERR(MCDNBR, 8262905, ACELL, ACHAN)
```

```
            GO TO 9000
 8050       CONTINUE
C/          CHX - ERROR WHILE CLOSING FILE DESCRIBING THE ADJACENCY
C/                RELATIONSHIP BETWEEN CELLS AND CHANNELS (CLCFIL).
C/          **FM(1X,'UNIT NUMBER = ',I6,6X,'WORST ERROR = ',I12)
            CALL VISERR(FLDNER, 8262906, (LCFIL, WRSTER)
            GO TO 9000
C
C
C           ****************************************************************
C           *                 SINGLE EXIT FROM THIS ROUTINE                *
C           ****************************************************************
C
 9000       CONTINUE
CS*         PCLEXIT [CHX]
            RETURN
C
C
C           ****************************************************************
C           *                      FORMAT STATEMENTS                       *
C           ****************************************************************
C
 9010       FORMAT(3I8)
 9020       FORMAT(10I5)
C
C
C           END CLCLCD 2629
            END
```

```
     VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
     VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS

VVVVVVVVVV   0000000000000000000000000000000000000000000000000000000000000000000000000000000000000000000   VVVVVVVVVV
VVVVVVVVVV   0000000000000000000000000 DIGITAL EQUIPMENT CORPORATION - VAX/VMS VERSION V4.4 000000000000000   VVVVVVVVVV
VVVVVVVVVV   0000000000000000000000000000000000000000000000000000000000000000000000000000000000000000000   VVVVVVVVVV

                         K   K  M   M  PPPP
                         K  K   MM MM  P   P
                         K K    M M M  P   P
                         KKK    M   M  PPPP
                         K  K   M   M  P
                         K   K  M   M  P
                         K    K M   M  P

             SSSSSSSS    222222      666666      333333     000000
             SSSSSSSS    222222      666666      333333     000000
           SS          22      22  66          33      33  00      00
           SS          22      22  66          33      33  00      00
           SS                  22  66                  33  00    0000
           SS                  22  66                  33  00    0000
             SSSSSS          22    66666666          33    00  00  00
             SSSSSS          22    66666666          33    00  00  00
                   SS      22      66      66          33  0000    00
                   SS      22      66      66          33  0000    00
                   SS    22        66      66  33      33  00      00
                   SS    22        66      66  33      33  00      00
           SSSSSSSS      2222222222  666666      333333      000000
           SSSSSSSS      2222222222  666666      333333      000000

                         FFFFFFFFFF    000000    RRRRRRRR
                         FFFFFFFFFF    000000    RRRRRRRR
                         FF          00      00  RR      RR
                         FF          00      00  RR      RR
                         FF          00      00  RR      RR
                         FF          00      00  RR      RR
                         FFFFFFFF    00      00  RRRRRRRR
                         FFFFFFFF    00      00  RRRRRRRR
                         FF          00      00  RR  RR
                         FF          00      00  RR  RR
                 ::::    FF          00      00  RR    RR
                 ::::    FF          00      00  RR    RR
                 ::::    FF            000000    RR      RR
                 ::::    FF            000000    RR      RR

                           ;;;;    222222
                           ;;;;    222222
                           ;;;;  22      22
                           ;;;;  22      22
                                         22
                                         22
                           ;;;;        22
                           ;;;;        22
                           ;;;;      22
                           ;;;;      22
                             ;;    22
                             ;;    22
                           ;;    2222222222
                           ;;    2222222222
```

FILE _$1$DUA6:[ERC.CHX021S2630.FOR;2 (2415,1,1), LAST REVISED ON 21-OCT-1986 08:44, IS A 103 BLOCK SEQUENTIAL FILE OWNED BY UIC [ERD1S1,PFC]. THE RECORDS ARE VARIABLE LENGTH WITH IMPLIED (CR) CARRIAGE CONTROL. THE LONGEST RECORD IS 73 BYTES.

JOB S2630 (212) QUEUED TO SYS$PRINT ON 4-DEC-1986 12:51 BY USER KMP, UIC [ENGVLS1,KMP], UNDER ACCOUNT ENGPKG AT PRIORITY 3, STARTED ON PRINTER _TCHIC$LPA0: ON 4-DEC-1986 13:32 FROM QUEUE SYS$PRINT.

```
VVVVVVVVVV   0000000000000000000000000000000000000000000000000000000000000000000000000000000000000000000   VVVVVVVVVV
VVVVVVVVVV   0000000000000000000000000 DIGITAL EQUIPMENT CORPORATION - VAX/VMS VERSION V4.4 000000000000000   VVVVVVVVVV
VVVVVVVVVV   0000000000000000000000000000000000000000000000000000000000000000000000000000000000000000000   VVVVVVVVVV
```

```
      SUBROUTINE WIRLOD(FILINX)
C
CS*   ALLINTEG
C
C                      *****************
C                      *               *
C     SUBSYSTEM CHX    *  2630 WIRLOD  *
C                      *               *
C                      *****************
C
C     ******************************************************************
C     ******************************************************************
C     **                                                              **
C     **  (C) COPYRIGHT V-R INFORMATION SYSTEMS, INC. 1984            **
C     **  LICENSED MATERIAL -- PROGRAM PROPERTY OF VRIS               **
C     **  ALL RIGHTS RESERVED                                         **
C     **                                                              **
C     **  THIS PROGRAM IS THE PROPERTY OF VRIS AND IS FURNISHED       **
C     **  PURSUANT TO A WRITTEN LICENSE AGREEMENT. IT MAY NOT BE      **
C     **  USED, REPRODUCED, OR DISCLOSED TO OTHERS EXCEPT IN          **
C     **  ACCORDANCE WITH THE TERMS AND CONDITIONS OF THAT            **
C     **  AGREEMENT.                                                  **
C     **                                                              **
C     ******************************************************************
C     ******************************************************************
C
C     ******************************************************************
C     *                   MODULE DOCUMENTATION                         *
C     ******************************************************************
C
C     SUMMARY --
C
C     THIS SUBROUTINE LOADS PRE-DEFINED WIRE-SEGMENT DESCRIPTIONS
C     FROM THE INPUT DESIGN FILE AND CONVERTS THESE DESCRIPTIONS
C     INTO "CONNECTIONS", "TERMINALS", AND "FUTURE TERMINALS"
C     WITHIN EACH CHANNEL THROUGH WHICH THESE WIRE SEGMENTS PASS.
C
C     THE INPUT DESIGN FILE IS ASSUMED TO BE OPEN WHEN THIS ROUTINE
C     IS CALLED AND IS LEFT OPEN UPON COMPLETION OF THIS ROUTINE.
C
C     "CONNECTIONS" ARE CREATED FROM WIRE SEGMENTS WHICH ARE
C     PARALLEL TO THE AXIS OF THE CHANNELS/WELLS THROUGH WHICH
C     THEY TRAVERSE (TRUNKS).
C
C     "TERMINALS" ARE CREATED FROM WIRE SEGMENTS WHICH ARE
C     ORTHOGONAL TO THE AXIS OF THE CHANNELS/WELLS THROUGH
C     WHICH THEY TRAVERSE (BRANCHES). IF THE ENDPOINT OF THE
C     BRANCH IS INCIDENT TO THE EDGE OF A CELL ALONG THE CHANNEL,
C     THE TERMINAL IS DESIGNATED AS A "NORMAL TERMINAL". IF,
C     HOWEVER, THE ENDPOINT OF THE BRANCH IS INCIDENT TO THE
C     END OF A CHANNEL, THE TERMINAL IS DESIGNATED AS AN
C     "INCOMING FUTURE TERMINAL".
C
C     "FUTURE TERMINALS" (OR "OUTGOING FUTURE TERMINALS") ARE
C     CREATED FROM THE ENDPOINTS OF TRUNKS IF THE ENDPOINTS
C     ARE INCIDENT TO THE END OF THE CHANNEL. NOTE THAT AN
C     OUTGOING FUTURE TERMINAL IN A CHANNEL "A" CORRESPONDS
C     TO AN INCOMING FUTURE TERMINAL IN A CHANNEL "B" SINCE
C     CHANNEL "A" FEEDS INTO CHANNEL "B".
C
C     FORMAL PARAMETERS --
C     NAME   DIMENSION TYPE  IN/OUT  DESCRIPTION
C     ----   --------- ----  ------  -----------
C     FILINX           I      IN     INDEX INTO THE *IOFILE* ARRAY
C                                    OF THE INPUT DESIGN FILE.
C
C     LOCAL VARIABLES --
C     NAME   DIMENSION TYPE  DESCRIPTION
C     ----   --------- ----  -----------
C     ABRCT                  NUMBER OF BRANCHES IN A CHANNEL.
C
C     ABSPI                  POINTER TO A BRANCH SEGMENT IN *BRCHLS*.
C
C     ACELL                  CELL NUMBER.
C
C     ACHAN                  CHANNEL IDENTIFICATION NUMBER.
C
C     ACHORN                 CHANNEL ORIENTATION.
C                              1 = HORIZONTAL
```

```
C                        2 = VERTICAL
C      ACNCL             NUMBER OF CONNECTIONS IN A CHANNEL.
C
C      ALLX              X- AND Y-COORDINATES OF THE LOWER-LEFT
C      ALLY              AND UPPER-RIGHT CORNERS OF THE RECTANGLE
C      AURX              DEFINING THE OVERLAP REGION BETWEEN A
C      AURY              WIRE SEGMENT AND A CHANNEL.
C
C      ATRPT             POINTER TO A TRUNK SEGMENT IN *TRNKLS*.
C
C      BLMAXX            MAXIMUM NUMBER OF BRANCH SEGMENTS
C                        CAUSED BY PRE-DEFINED WIRES ALLOWED.
C
C      BLSIZE            NUMBER OF BRANCH SEGMENTS CAUSED
C                        BY PRE-DEFINED WIRES.
C
C      BRCHLS(6,         ARRAY USED TO SAVE DATA ABOUT BRANCH
C       *ICITERMINAL)    SEGMENTS CAUSED BY PRE-DEFINED WIRES.
C                          (1,*) - START ORDINATE OF BRANCH SEG
C                          (2,*) - STOP  ORDINATE OF BRANCH SEG
C                          (3,*) - ABSCISSA OF BRANCH SEGMENT
C                          (4,*) - CHANNEL WITH WHICH BRANCH
C                                  SEGMENT IS ASSOCIATED
C                          (5,*) - NET NUMBER OF BRANCH SEGMENT
C                          (6,*) - LAYER OF BRANCH SEGMENT
C
C      BRABS             ABSCISSA OF CURRENT BRANCH.
C
C      BRLYR             LAYER ON WHICH CURRENT BRANCH OCCURS.
C
C      BRNET             NET TO WHICH CURRENT BRANCH BELONGS.
C
C      BRCH1             STARTING ORDINATE OF CURRENT BRANCH.
C
C      BRCH2             ENDING ORDINATE OF CURRENT BRANCH.
C
C      BSABS             ABSCISSA OF THE CURRENT BRANCH SEGMENT.
C
C      BSCHN             CHANNEL TO WHICH CURRENT BRANCH
C                        SEGMENT BELONGS.
C
C      BSLYR             LAYER OF CURRENT BRANCH SEGMENT.
C
C      BSNET             NET TO WHICH CURRENT BRANCH SEGMENT
C                        BELONGS.
C
C      BSOR1             START ORDINATE OF CURRENT BRANCH SEGMENT.
C
C      BSOR2             STOP ORDINATE OF CURRENT BRANCH SEGMENT.
C
C      C2HIAB            VARIABLE USED TO ACCESS THE HI ABSCISSA
C                        FIELD (IN *CHNDAT*) OF THE SECOND
C                        CHANNEL OF A FUTURE TERMINAL.
C
C      C2HIOR            VARIABLE USED TO ACCESS THE HI ORDINATE
C                        FIELD (IN *CHNDAT*) OF THE SECOND
C                        CHANNEL OF A FUTURE TERMINAL.
C
C      C2LOAB            VARIABLE USED TO ACCESS THE LO ABSCISSA
C                        FIELD (IN *CHNDAT*) OF THE SECOND
C                        CHANNEL OF A FUTURE TERMINAL.
C
C      C2LOOR            VARIABLE USED TO ACCESS THE LO ORDINATE
C                        FIELD (IN *CHNDAT*) OF THE SECOND
C                        CHANNEL OF A FUTURE TERMINAL.
C
C      CHHIAB            VARIABLE USED TO ACCESS THE HI ABSCISSA
C                        FIELD (IN *CHNDAT*) OF CURRENT CHANNEL.
C
C      CHHIOR            VARIABLE USED TO ACCESS THE HI ORDINATE
C                        FIELD (IN *CHNDAT*) OF CURRENT CHANNEL.
C
C      CHLOAB            VARIABLE USED TO ACCESS THE LO ABSCISSA
C                        FIELD (IN *CHNDAT*) OF CURRENT CHANNEL.
C
C      CHLOOR            VARIABLE USED TO ACCESS THE LO ORDINATE
C                        FIELD (IN *CHNDAT*) OF CURRENT CHANNEL.
C
C      CHORN             ORIENTATION OF THE CURRENT CHANNEL.
C
C      CLHIAB            VARIABLE USED TO ACCESS THE HI ABSCISSA
```

```
C                               FIELD (IN *CELDAT*) OF A CELL ALONG
C                               THE CURRENT CHANNEL.
C
C        CLHIOR                 VARIABLE USED TO ACCESS THE HI ORDINATE
C                               FIELD (IN *CELDAT*) OF A CELL ALONG
C                               THE CURRENT CHANNEL.
C
C        CLLOAB                 VARIABLE USED TO ACCESS THE LO ABSCISSA
C                               FIELD (IN *CELDAT*) OF A CELL ALONG
C                               THE CURRENT CHANNEL.
C
C        CLLOOR                 VARIABLE USED TO ACCESS THE LO ORDINATE
C                               FIELD (IN *CELDAT*) OF A CELL ALONG
C                               THE CURRENT CHANNEL.
C
C        CLRFAB                 VARIABLE USED TO ACCESS THE REFERENCE
C                               ABSCISSA FIELD (IN *CELDAT*) OF A CELL
C                               ALONG THE CURRENT CHANNEL.
C
C        CLRFOR                 VARIABLE USED TO ACCESS THE REFERENCE
C                               ORDINATE FIELD (IN *CELDAT*) OF A CELL
C                               ALONG THE CURRENT CHANNEL.
C
C        CNAB1                  START ABSCISSA OF CURRENT CONNECTION.
C
C        CNAB2                  STOP ABSCISSA OF CURRENT CONNECTION.
C
C        CNLYR                  LAYER OF CURRENT CONNECTION.
C
C        CNNET                  NET NUMBER OF CURRENT CONNECTION.
C
C        CNORD                  ORDINATE OF CURRENT CONNECTION.
C
C        CONAB1(&ICTCONNECT)    ARRAYS USED TO STORE THE START
C        CONAB2(&ICTCONNECT)    AND STOP ABSCISSAE OF CONNECTIONS.
C
C        HIGABS                 HIGH ABSCISSA OF AN INTERVAL ALONG
C                               THE CHANNEL SIDE.
C
C        ICHAN                  IDENTIFICATION NUMBER OF A CHANNEL
C                               FEEDING INTO THE CURRENT CHANNEL.
C
C        ICHORN                 ORIENTATION OF *ICHAN*.
C
C        LOWABS                 LOW ABSCISSA OF AN INTERVAL ALONG
C                               THE CHANNEL SIDE.
C
C        NOVFG                  FLAG INDICATING WHETHER (0) OR NOT (1)
C                               THE CURRENT TRUNK OR BRANCH SEGMENT
C                               OVERLAPS THE PREVIOUS TRUNK OR BRANCH.
C
C        NXHICL                 VARIABLE USED TO ACCESS THE FIELD
C                               (IN *CELDAT*) WHICH POINTS FROM ONE
C                               CELL TO THE NEXT CELL ALONG THE
C                               HI SIDE OF A CHANNEL.
C
C        NXLOCL                 VARIABLE USED TO ACCESS THE FIELD
C                               (IN *CELDAT*) WHICH POINTS FROM ONE
C                               CELL TO THE NEXT CELL ALONG THE
C                               LO SIDE OF A CHANNEL.
C
C        RECTYP                 INTEGER IMAGE OF THE CHARACTER STRING
C                               INDICATING WHICH PACKET TYPE OF THE
C                               DESIGN FILE IS BEING PROCESSED.
C
C        SRTKEY(3)              ARRAY USED TO STORE THE FIELD NUMBERS
C                               OF THE THREE SORT KEYS.
C                                 SRTKEY(1) - FIELD NUMBER OF PRIMARY
C                                             SORT KEY
C                                 SRTKEY(2) - FIELD NUMBER OF SECONDARY
C                                             SORT KEY
C                                 SRTKEY(2) - FIELD NUMBER OF TERTIARY
C                                             SORT KEY
C
C        STOP                   POINTER TO THE LAST ITEM OF INTEREST.
C
C        STRT                   POINTER TO THE FIRST ITEM OF INTEREST.
C
C        TRAB1                  START ABSCISSA OF CURRENT TRUNK SEGMENT.
C
C        TRAB2                  STOP ABSCISSA OF CURRENT TRUNK SEGMENT.
C
```

```
C        TRCHN                 CHANNEL IN WHICH CURRENT TRUNK SEGMENT
C                              OCCURS.
C
C        TRLYR                 LAYER OF CURRENT TRUNK SEGMENT.
C
C        TRNET                 NET NUMBER OF CURRENT TRUNK SEGMENT.
C
C        TRORD                 ORDINATE OF CURRENT TRUNK SEGMENT.
C
C        TRMAXX                MAXIMUM NUMBER OF TRUNK SEGMENTS
C                              CAUSED BY PRE-DEFINED WIRES.
C
C        TRSIZE                NUMBER OF TRUNK SEGMENTS CAUSED
C                              BY PRE-DEFINED WIRES.
C
C        TRC2IX                POINTER TO SECOND CONNECTION
C                              OF A FUTURE TERMINAL.
C
C        TMCELL                CELL ON WHICH TERMINAL OCCURS.
C
C        TMCHN2                SECOND CHANNEL OF A FUTURE TERMINAL.
C
C        TMCNIX                POINTER TO THE CONNECTION TO WHICH
C                              A TERMINAL BELONGS.
C
C        TMCON2                CONNECTION NUMBER OF THE SECOND
C                              CONNECTION OF A FUTURE TERMINAL.
C
C        TMCONN                CONNECTION NUMBER OF THE CONNECTION
C                              TO WHICH A TERMINAL BELONGS.
C
C        TRNKLS(6,             ARRAY USED TO SAVE DATA ABOUT TRUNK
C              R(CTCONNECT)    SEGMENTS CAUSED BY PRE-DEFINED WIRES.
C                                (1,*) - START ABSCISSA OF TRUNK SEG
C                                (2,*) - STOP  ABSCISSA OF TRUNK SEG
C                                (3,*) - ORDINATE OF TRUNK SEGMENT
C                                (4,*) - CHANNEL WITH WHICH TRUNK
C                                        SEGMENT IS ASSOCIATED
C                                (5,*) - NET NUMBER OF TRUNK SEGMENT
C                                (6,*) - LAYER OF TRUNK SEGMENT
C
C        WLCHN                 CHANNEL NUMBER WITH WHICH A "WELL"
C                              IS ASSOCIATED.
C
C        WLORN                 ORIENTATION OF CHANNEL WITH WHICH
C                              A "WELL" IS ASSOCIATED.
C
C        WSLLX                 X- AND Y-COORDINATES OF THE LOWER-LEFT
C        WSLLY                 AND UPPER-RIGHT CORNERS OF A WIRE
C        WSURX                 SEGMENT. USUALLY, THIS RECTANGLE IS
C        WSURY                 IN FACT A LINE.
C
C        GLOBAL VARIABLES --
C        NAME  DIMENSION TYPE  DESCRIPTION
C        ----  --------- ----  -----------
C        (NONE)
C
C        REVISION HISTORY --
C            14-JAN-86 TAF REPLACED ABSOLUTE DOGLEG AND FUTURE
C                          TERMINAL COORDINATES WITH RELATIVE
C                          COORDINATES.  (SAR 5500)
C            21-NOV-85 DDC REVISED ERROR CODES.  (SAR 5391)
C            20-NOV-85 DDC CORRECTED ERROR FORMAT.  (SAR 5372)
C            29-JUL-85 DDC CHECKED MODULE.
C            19-SEP-84 RRP WROTE MODULE.  (SAR 4856)
C
C        TESTING PLANS --
C            29-JUL-85 DDC COMPLETED UNIT TESTING.
C
C        ***************************************************************
C        *                     SUBSYSTEM TOKENS                        *
C        ***************************************************************
CS*      CHXTOKEN
C
C        ***************************************************************
C        *                   VARIABLE DECLARATIONS                     *
C        ***************************************************************
C
```

```
C
C        FORMAL PARAMETERS --
C        (NONE)
C
C        LOCAL VARIABLES --
C
         DIMENSION      SRTKEY(3)
C
         COMMON /CM2630/ TRNKLS(6, $$@TCTCONNECT),
     1                   PRCHLS(6, $$@TCTTERMINAL),
     2                   CCNAB1($$@TCTCONNECT),
     1                   CCNAB2($$@TCTCONNECT)
C
C
C        SUBSYSTEM GLOBAL VARIABLES --
C
CS*      SUBSYSCTLLAT [CHX]
C
CS*      CHXCEL
CS*      CHXCHN
CS*      CHXCHC
CS*      CHXWEL
CS*      CHXCLN
CS*      CHXTER
C
C        OTHER SUBSYSTEM VARIABLES --
C
CS*      ENTDAT
C
CS*      PWSEQUENT
C
C        SYSTEM GLOBAL VARIABLES --
C
CS*      SYSCOMMON
C
C
C        ****************************************************************
C        *                     DATA STATEMENTS                          *
C        ****************************************************************
C
C        (NONE)
C
C
C        ****************************************************************
C        *                   STATEMENT FUNCTIONS                        *
C        ****************************************************************
C
C        LOCAL STATEMENT FUNCTIONS --
C        (NONE)
C
C        SUBSYSTEM STATEMENT FUNCTIONS --
C        (NONE)
C
C        OTHER SUBSYSTEM STATEMENT FUNCTIONS --
C        (NONE)
C
C        SYSTEM STATEMENT FUNCTIONS --
C
CS*      SFUNCHCS1
C
C
C        ****************************************************************
C        *                     EXECUTABLE CODE                          *
C        ****************************************************************
C
CS*      MODENTRY [CHX] [WIRLOD] [2630] [06]
C
         TIMAXX = $$@TCTCONNECT
         TLSIZE = 0
         HIMAXX = $$@TCTTERMINAL
         BLSIZE = 0
C
         RECTYP = VISTRC('PWS ')
C        **************************
C        * LOAD WIRE SEGMENT DATA *
C        **************************
 1000    CONTINUE
         IF (NXTENT(RECTYP, FILINX)) 8000, 2000, 1010
C                                   ERR   NONE   OK
C
 1010    CONTINUE
         IF (RESLEC .IF. 0) GO TO 1900
```

```
      WSLLX = RWSREX
      WSLLY = RWSREY
      IF ((RWSCRN .EQ. 1) .OR.
     1    (RWSCRN .EQ. 2)) GO TO (1050, 1060), RWSCRN
C                                   HZ    VT
      GO TO 8010
C
 1050 CONTINUE
C     HERE IF CURRENT WIRE SEGMENT IS HORIZONTAL
      WSURX = RASREX + RWSLNG
      WSURY = RWSREY
      GO TO 1090
C
 1060 CONTINUE
C     HERE IF CURRENT WIRE SEGMENT IS VERTICAL
      WSURX = RWSREX
      WSURY = RWSREY + RWSLNG
      GO TO 1090
C
 1090 CONTINUE
C     *********************
C     * SPANNED CHANNELS *
C     *********************
C     DETERMINE WHICH CHANNELS THIS WIRE SEGMENT PASSES THROUGH,
C     AND FOR EACH OF THESE CHANNELS DETERMINE THE COORDINATES
C     OF THE INTERSECTION REGION BETWEEN THE WIRE SEGMENT AND
C     THE CHANNEL. ALSO DETERMINE WHETHER THE WIRE SEGMENT IS
C     A "TRUNK" OR A "BRANCH" WITHIN EACH OF THE CHANNELS.
C
      DO 1200 I = 1, CHNCNT
C
      ALLX = VISMX2(WSLLX, CHNDAT(%%CHXCHNLLX, I))
      ALLY = VISMX2(WSLLY, CHNDAT(%%CHXCHNLLY, I))
      AURX = VISMN2(WSURX, CHNDAT(%%CHXCHNURX, I))
      AURY = VISMN2(WSURY, CHNDAT(%%CHXCHNURY, I))
C
      IF ((ALLX .GT. CHNDAT(%%CHXCHNURX, I)) .OR.
     1    (ALLY .GT. CHNDAT(%%CHXCHNURY, I)) .OR.
     2    (AURX .LT. CHNDAT(%%CHXCHNLLX, I)) .OR.
     3    (AURY .LT. CHNDAT(%%CHXCHNLLY, I))) GO TO 1200
C
C     HERE IF WIRE SEGMENT PASSES THROUGH CHANNEL *I*.
C     DETERMINE WHETHER THIS SEGMENT IS A "TRUNK"
C     OR "BRANCH" IN CHANNEL *I*.
C
      CHORN = CHNDAT(%%CHXCHNORIENT, I)
      IF ((CHORN-RWSCRN) .EQ. 0) GO TO 1110
C
C     HERE IF WIRE SEGMENT IS A "BRANCH" IN CHANNEL *I*.
      GO TO (1101, 1102), RWSCRN
C               HZ    VT
C
 1101 CONTINUE
C     HORIZONTAL BRANCH (IN A VERTICAL CHANNEL)
      IF (ALLX      .EQ.   AURX) GO TO 1200
      IF (BLSIZE+1 .GT. BLMAXX) GO TO 8020
      BLSIZE             = BLSIZE + 1
      BRCHLS(1, BLSIZE) = ALLX
      BRCHLS(2, BLSIZE) = AURX
      BRCHLS(3, BLSIZE) = ALLY
C
C     CREATE ZERO-LENGTH TRUNK IF THIS WIRE SEGMENT
C     IS A "STRAIGHT CHANNEL CROSSING".
      IF ((ALLY .GT. CHNDAT(%%CHXCHNLLY, I)) .OR.
     1    (AURY .LT. CHNDAT(%%CHXCHNURY, I))) GO TO 1105
      IF (TLSIZE+1 .GT. TLMAXX) GO TO 8030
      TLSIZE             = TLSIZE + 1
      TRNKLS(1, TLSIZE) = ALLY
      TRNKLS(2, TLSIZE) = AURY
      TRNKLS(3, TLSIZE) = ALLX
      TRNKLS(4, TLSIZE) = I
      TRNKLS(5, TLSIZE) = RWSNET
      TRNKLS(6, TLSIZE) = RWSLYR
      GO TO 1105
C
 1102 CONTINUE
C     VERTICAL BRANCH (IN A HORIZONTAL CHANNEL)
      IF (ALLY      .EQ.   AURY) GO TO 1200
      IF (BLSIZE+1 .GT. BLMAXX) GO TO 8020
      BLSIZE             = BLSIZE + 1
      BRCHLS(1, BLSIZE) = ALLY
      BRCHLS(2, BLSIZE) = AURY
```

```
            RRCHLS(3, BLSIZE) = ALLX
C
C           CREATE ZERO-LENGTH TRUNK IF THIS WIRE SEGMENT
C           IS A "STRAIGHT CHANNEL CROSSING".
            IF ((ALLX .GT. CHNDAT(**CHXCHNLLX, I)) .OR.
     1          (AURX .LT. CHNDAT(**CHXCHNURX, I))) GO TO 1105
            IF (ILSIZE+1 .GT. ILMAXX) GO TO 8030
            ILSIZE          = ILSIZE + 1
            TRNKLS(1, ILSIZE) = ALLX
            TRNKLS(2, ILSIZE) = AURX
            TRNKLS(3, ILSIZE) = ALLY
            TRNKLS(4, ILSIZE) = I
            TRNKLS(5, ILSIZE) = RWSNET
            TRNKLS(6, ILSIZE) = RWSLYR
            GO TO 1105
C
 1105       CONTINUE
            BRCHLS(4, BLSIZE) = I
            BRCHLS(5, BLSIZE) = RWSNET
            BRCHLS(6, BLSIZE) = RWSLYR
            GO TO 1200
C
 1110       CONTINUE
C           HERE IF WIRE SEGMENT IS A "TRUNK" IN CHANNEL *I*.
            GO TO (1111, 1112), RWSCPN
C                  HZ    VT
C
 1111       CONTINUE
C           HORIZONTAL TRUNK (IN A HORIZONTAL CHANNEL)
            IF (ALLX     .EQ.   AURX) GO TO 1200
            IF (ILSIZE+1 .GT. ILMAXX) GO TO 8030
            ILSIZE          = ILSIZE + 1
            TRNKLS(1, ILSIZE) = ALLX
            TRNKLS(2, ILSIZE) = AURX
            TRNKLS(3, ILSIZE) = ALLY
            GO TO 1115
C
 1112       CONTINUE
C           VERTICAL TRUNK (IN A VERTICAL CHANNEL)
            IF (ALLY     .EQ.   AURY) GO TO 1200
            IF (ILSIZE+1 .GT. ILMAXX) GO TO 8030
            ILSIZE          = ILSIZE + 1
            TRNKLS(1, ILSIZE) = ALLY
            TRNKLS(2, ILSIZE) = AURY
            TRNKLS(3, ILSIZE) = ALLX
            GO TO 1115
C
 1115       CONTINUE
            TRNKLS(4, ILSIZE) = I
            TRNKLS(5, ILSIZE) = RWSNET
            TRNKLS(6, ILSIZE) = RWSLYR
            GO TO 1200
C
 1200       CONTINUE
C
C           *******************
C           * SPANNED "WELLS" *
C           *******************
C           DETERMINE WHICH "WELLS" THIS WIRE SEGMENT PASSES THROUGH,
C           AND FOR EACH OF THESE "WELLS" DETERMINE THE COORDINATES
C           OF THE INTERSECTION REGION BETWEEN THE WIRE SEGMENT AND
C           THE "WELL". ALSO DETERMINE WHETHER THE WIRE SEGMENT IS
C           A "TRUNK" OR A "BRANCH" WITHIN EACH OF THE "WELLS".
C
            IF (WELCNT .LE. 0) GO TO 1900
C
            DO 1300 I = 1, WELCNT
C
            ALLX = VISMX2(WSLLX, WELDAT(**CHXWELLLX, I))
            ALLY = VISMX2(WSLLY, WELDAT(**CHXWELLLY, I))
            AURX = VISMN2(WSURX, WELDAT(**CHXWELURX, I))
            AURY = VISMN2(WSURY, WELDAT(**CHXWELURY, I))
C
            IF ((ALLX .GT. WELDAT(**CHXWELURX, I)) .OR.
     1          (ALLY .GT. WELDAT(**CHXWELURY, I)) .OR.
     2          (AURX .LT. WELDAT(**CHXWELLLX, I)) .OR.
     3          (AURY .LT. WELDAT(**CHXWELLLY, I))) GO TO 1300
C
C           HERE IF WIRE SEGMENT PASSES THROUGH WELL *I*.
C           DETERMINE WHETHER THIS SEGMENT IS A "TRUNK"
C           OR "BRANCH" IN WELL *I* (WHICH BELONGS TO CHANNEL *WLCHN*).
```

```
C
      WLCHN = WELDAT($$CHXWELCHAN,      1)
      WLCRN = CHNDAT($$CHXCHNORIEN1, WLCHN)
      IF ((WLCRN-RWSCRN) .EQ. 0) GC TO 1210
C
C     HERE IF WIRE SEGMENT IS A "BRANCH" IN CHANNEL *WLCHN*
      GC TC (1201, 1202), RWSCRN
C            H2     V1
C
 1201 CONTINUE
C     HORIZONTAL BRANCH
      IF (ALLX      .EQ.    AURX) GC TO 1300
      IF (BLSIZE+1 .GT. BLMAXX) GC TC 8020
      BLSIZE              = BLSIZE + 1
      BRCHLS(1, BLSIZE) = ALLX
      BRCHLS(2, BLSIZE) = AURX
      BRCHLS(3, BLSIZE) = ALLY
      GC TC 1205
C
 1202 CONTINUE
C     VERTICAL BRANCH
      IF (ALLY      .EQ.    AURY) GC TO 1300
      IF (BLSIZE+1 .GT. BLMAXX) GC TO 8020
      BLSIZE              = BLSIZE + 1
      BRCHLS(1, BLSIZE) = ALLY
      BRCHLS(2, BLSIZE) = AURY
      BRCHLS(3, BLSIZE) = ALLX
      GO TC 1205
 1205 CONTINUE
C
      BRCHLS(4, BLSIZE) = WLCHN
      BRCHLS(5, BLSIZE) = RWSNET
      BRCHLS(6, BLSIZE) = RWSLYR
      GC TC 1300
C
 1210 CONTINUE
C     HERE IF WIRE SEGMENT IS A "TRUNK" IN CHANNEL *WLCHN*.
      GC TC (1211, 1212), RWSORN
C            H2     V1
C
 1211 CONTINUE
C     HORIZONTAL TRUNK
      IF (ALLX      .EQ.    AURX) GC TO 1300
      IF (TLSIZE+1 .GT. TLMAXX) GC TO 8030
      TLSIZE              = TLSIZE + 1
      TRNKLS(1, TLSIZE) = ALLX
      TRNKLS(2, TLSIZE) = AURX
      TRNKLS(3, TLSIZE) = ALLY
      GC TC 1215
C
 1212 CONTINUE
C     VERTICAL TRUNK
      IF (ALLY      .EQ.    AURY) GO TO 1300
      IF (TLSIZE+1 .GT. TLMAXX) GC TO 8030
      TLSIZE              = TLSIZE + 1
      TRNKLS(1, TLSIZE) = ALLY
      TRNKLS(2, TLSIZE) = AURY
      TRNKLS(3, TLSIZE) = ALLX
      GO TC 1215
C
 1215 CONTINUE
      TRNKLS(4, TLSIZE) = WLCHN
      TRNKLS(5, TLSIZE) = RWSNET
      TRNKLS(6, TLSIZE) = RWSLYR
      GC TC 1300
C
 1300 CONTINUE
C
C
 1900 CONTINUE
C     DONE WITH CURRENT WIRE SEGMENT. PROCESS NEXT ONE.
      GC TC 1000
C
C
 2000 CONTINUE
C     ******************************
C     * WIRE SEGMENT DATA LOADED *
C     ******************************
C     ALL PRE-DEFINED WIRE SEGMENT DEFINITIONS HAVE BEEN LOADED.
C     NOW NEED TO CREATE "CONNECTIONS", "TERMINALS" AND "FUTURE
C     TERMINALS" FOR THE WIRE END-POINTS WITHIN EACH CHANNEL.
C
```

```
      IF ((TLSIZE .LE. 0) .OR. (BLSIZE .LE. 0)) GO TO 7900
C
C     FIRST SORT LOCAL ARRAYS *TRNKLS* AND *BRCHLS* IN ASCENDING ORDER
C     PRIMARY   KEY: CHANNEL ID NUMBER          (FIELD NO. 4)
C     SECONDARY KEY: NET NUMBER OF WIRE         (FIELD NO. 5)
C     TERTIARY  KEY: FOR TRUNK LIST:
C                    LDX/LDY OF WIRE SEGMENT (FIELD NO. 1)
C                    FOR BRANCH LIST:
C                    ABSCISSA                   (FIELD NO. 3)
C
      SRTKEY(1) = 4
      SRTKEY(2) = 5
      SRTKEY(3) = 1
      CALL VISRT3(TRNKLS, 6, %%RTCTCONNECT,  SRTKEY, 3, TLSIZE, 1)
      SRTKEY(3) = 3
      CALL VISRT3(BRCHLS, 6, %%RTCTTERMINAL, SRTKEY, 3, BLSIZE, 1)
C
      IF (ACTFAC .LT. 4)  GO TO 2001
      WRITE(ICFIL4, 9100)
     1   (TEMPI,(TRNKLS(TEMPI,TEMPJ),TEMPI=1,6),TEMPJ=1,TLSIZE)
      WRITE(ICFIL4, 9200)
     1   (TEMPJ,(BRCHLS(TEMPI,TEMPJ),TEMPI=1,6),TEMPJ=1,BLSIZE)
 2001 CONTINUE
C
C     ****************************************
C     * CREATE CONNECTIONS FROM THE TRUNKS *
C     ****************************************
C     CREATE "CONNECTIONS" FOR THE TRUNKS IN *TRNKLS*. TRUNKS
C     OF THE SAME NET (WITHIN A SINGLE CHANNEL) WHICH OVERLAP
C     IN THEIR ABSCISSAE (ORDINATES ARE NOT CONSIDERED) AND ARE
C     ON THE SAME LAYER ARE MERGED INTO A SINGLE CONNECTION.
C
C     NOTE: THE NEXT TRUNK LIST ENTRY (IN *TRNKLS*) IS HELD IN
C     ----  VARIABLES *TKXXXX* WHILE THE CURRENT CONNECTION
C           INFORMATION IS HELD IN VARIABLES *CNXXXX*.
C           A TRUNK LIST ENTRY IS MERGED WITH THE CURRENT
C           CONNECTION IF POSSIBLE. OTHERWISE, THE DATA IN
C           VARIABLES *CNXXXX* IS USED TO CREATE A NEW ENTRY
C           IN *CONDAT* AND THE INFORMATION IN VARIABLES
C           *TKXXXX* IS USED TO INITIALIZE A NEW CONNECTION
C           (*CNXXXX*).
C
      ATKPT = 1
      TKCHN = TRNKLS(4, ATKPT)
C
      DO 2100 ACHAN = 1, CHNCNT
C
C     ***************
C     * NEW CHANNEL *
C     ***************
C     INITIALIZE FOR CONNECTIONS IN CHANNEL *ACHAN*
      NCVFG = 0
      ACNCT = 0
      CLNET = 0
      CHNDAT(%%CHXCHNCUNNPT, ACHAN) = CONCNT + 1
      IF (ATKPT .GT. TLSIZE) GO TO 2030
C
C     SET UP VARIABLES TO ACCESS THE APPROPRIATE FIELDS IN THE
C     CHANNEL ARRAY BASED ON ORIENTATION OF CURRENT CHANNEL.
      IF (CHNDAT(%%CHXCHNORIENT, ACHAN) .EQ. 1) GO TO 2005
      CHLOCH = %%CHXCHNLLX
      GO TO 2010
 2005 CONTINUE
      CHLOCH = %%CHXCHNLLY
      GO TO 2010
C
 2010 CONTINUE
      NCVFG = 0
C     CHECK IF TRUNK *ATKPT* BELONGS IN CURRENT CHANNEL *ACHAN*
      IF (TKCHN .NE. ACHAN) GO TO 2030
C
C     *************
C     * NEW TRUNK *
C     *************
C     HERE IF TRUNK *ATKPT* BELONGS IN CURRENT CHANNEL *ACHAN*.
      TKNET = TRNKLS(5, ATKPT)
      TKLYR = TRNKLS(6, ATKPT)
      TKAB1 = TRNKLS(1, ATKPT)
      TKAB2 = TRNKLS(2, ATKPT)
      TKORD = TRNKLS(3, ATKPT)
C
```

```
C         CHECK IF TRUNK *ATKPT* IS THE FIRST TRUNK IN CHANNEL *ACHAN*.
          IF (ACNCT .EQ. 0) GO TO 2090
C
C         HERE IF *ATKPT* IS NOT THE FIRST TRUNK IN CHANNEL *ACHAN*.
C         CHECK FOR "OVERLAP" BETWEEN TRUNK *ATKPT* AND CONNECTION.
C         NOTE: "OVERLAP" OCCURS ONLY IF *ATKPT* IS IN THE SAME NET
C         ----   AS THE CONNECTION AND IF THE END ABSCISSA FOR THE
C                CONNECTION IS .GT. THE START ABSCISSA FOR THE TRUNK.
C                ALSO NOTE THAT THE TRUNKS ARE NOT REQUIRED TO BE
C                COLINEAR (HAVE SAME ORDINATE) FOR "OVERLAP" TO OCCUR.
C
          IF ((TKNET .EQ. CNNET) .AND. (TKAB1 .LE. CNAB2)) GO TO 2020
C
C         HERE IF NO "OVERLAP" BETWEEN TRUNK *ATKPT* AND CONNECTION.
          NOVFG = 1
          GO TO 2030
C
 2020     CONTINUE
C         ****************
C         * MERGE TRUNKS *
C         ****************
C         HERE IF TRUNK *ATKPT* "OVERLAPS" THE CONNECTION.
C         MODIFY CONNECTION ABSCISSAE AND PROCESS NEXT TRUNK.
          CNAB1 = VISMN2(CNAB1, TKAB1)
          CNAB2 = VISMX2(CNAB2, TKAB2)
          CNCRD = VISMX2(CNCRD, TKCRD)
          ATKPT = ATKPT + 1
          IF (ATKPT .GT. TLSIZE) GO TO 2030
          TKCHN = TRKNLS(4, ATKPT)
          GO TO 2010
C
 2030     CONTINUE
C         ********************
C         * STORE CONNECTION *
C         ********************
C         HERE IF TRUNK *ATKPT* DOES NOT BELONG IN CURRENT CHANNEL
C         OR IF IT DOES NOT OVERLAP CURRENT CONNECTION. STORE DATA
C         FOR CURRENT CONNECTION AND UPDATE THE NUMBER OF CONNECTIONS
C         IN THIS CHANNEL.
C
          CHNDAT($$CHXCHNCONNCT, ACHAN) = ACNCT
C
          IF (ACNCT .LE. 0) GO TO 2100
          CONDAT($$CHXCONCHN, CONCNT) = ACHAN
          CONDAT($$CHXCONNUM, CONCNT) = ACNCT
          CONDAT($$CHXCONTYP, CONCNT) = 1
          CONDAT($$CHXCONNET, CONCNT) = CNNET
          CONDAT($$CHXCONORD, CONCNT) = CNCRD - CHNDAT(CHLCCR, ACHAN)
          CONDAT($$CHXCONLYR, CONCNT) = CNLYR
          CONAB1(CONCNT)              = CNAB1
          CONAB2(CONCNT)              = CNAB2
C
C         CHECK IF THE OVERLAP FLAG IS SET. IF NOT, THIS STARTS A
C         NEW CHANNEL. OTHERWISE WE WOULD NOT HAVE STORED THE
C         CURRENT CONNECTION.
          IF (NOVFG .EQ. 0) GO TO 2100
C
 2090     CONTINUE
C         ******************
C         * NEW CONNECTION *
C         ******************
C         HERE IF TRUNK *ATKPT* IS FIRST TRUNK IN CHANNEL OR
C         IT BEGINS A NEW CONNECTION WITHIN CHANNEL *ACHAN*
          CONCNT = CONCNT + 1
          IF (CONCNT .GT. CONMAX)  GO TO 8040
          CNNET = TKNET
          CNAB1 = TKAB1
          CNAB2 = TKAB2
          CNCRD = TKCRD
          CNLYR = TKLYR
          ACNCT = ACNCT + 1
          ATKPT = ATKPT + 1
          IF (ATKPT .GT. TLSIZE) GO TO 2095
          TKCHN = TRKNLS(4, ATKPT)
          GO TO 2010
C
 2095     CONTINUE
          NOVFG = 0
          GO TO 2030
C
 2100     CONTINUE
C         DONE CREATING CONNECTIONS FROM TRUNKS.
```

```
C
C        ************************************************************
C        * CREATE TERMINALS AND FUTURE TERMINALS FROM THE BRANCHES. *
C        ************************************************************
C        "TERMINALS" ARE CREATED FROM THE ENDPOINTS OF BRANCHES
C        WITHIN A CHANNEL. BRANCH SEGMENTS OF THE SAME NET (WITHIN
C        A SINGLE CHANNEL), AND HAVING THE SAME ABSCISSA AND LAYER,
C        ARE MERGED TOGETHER INTO A SINGLE BRANCH BEFORE THE TERMINALS
C        ARE CREATED.
C
C        NOTE: THE NEXT BRANCH LIST ENTRY OR BRANCH SEGMENT
C        ----   (IN *BRCHLS*) IS HELD IN VARIABLES *BSXXXX*
C               WHILE THE CURRENT BRANCH INFORMATION IS HELD
C               IN VARIABLES *BRXXXX*. A BRANCH SEGMENT IS
C               MERGED WITH THE CURRENT BRANCH IF POSSIBLE.
C               OTHERWISE, THE DATA IN VARIABLES *BRXXXX* IS
C               USED TO CREATE UPTO TWO NEW ENTRIES IN *TRMDAT*
C               AND THE INFORMATION IN VARIABLES *BSXXXX* IS
C               USED TO INITIALIZE A NEW BRANCH (*CNXXXX*).
C
         ABSPT = 1
         BSCHN = BRCHLS(4, ABSPT)
C
         DO 3100 ACHAN = 1, CHNCNT
C
C        ***************
C        * NEW CHANNEL *
C        ***************
C        INITIALIZE FOR BRANCHES IN CHANNEL *ACHAN*
         ABRCT = 0
         BRNET = 0
         MCVEG = 0
         IF (ABSPT .GT. BLSIZE) GO TO 3030
C
C        SET UP VARIABLES TO ACCESS THE APPROPRIATE FIELDS
C        IN THE CHANNEL AND CELL DATA TABLES BASED ON THE
C        ORIENTATION OF THE CHANNEL.
C
         ACHORN = CHNDAT(%%CHXCHNORIENT, ACHAN)
         GO TO (3001, 3002), ACHORN
C
 3001    CONTINUE
C        HERE IF CURRENT CHANNEL *ACHAN* IS HORIZONTAL
         CHLCAB = %%CHXCHNLLX
         CHHIAB = %%CHXCHNURX
         CHLOCR = %%CHXCHNLLY
         CHHICR = %%CHXCHNURY
         CLREAB = %%CHXCELREX
         CLRECR = %%CHXCELREY
         CLLOAB = %%CHXCELLLX
         CLHIAB = %%CHXCELURX
         CLLOCR = %%CHXCELLLY
         CLHICR = %%CHXCELURY
         NXLOCL = %%CHXCELNXTTP
         NXHICL = %%CHXCELNXTBT
         GO TO 3010
C
 3002    CONTINUE
C        HERE IF CURRENT CHANNEL *ACHAN* IS VERTICAL
         CHLOAB = %%CHXCHNLLY
         CHHIAB = %%CHXCHNURY
         CHLOCR = %%CHXCHNLLX
         CHHICR = %%CHXCHNURX
         CLREAB = %%CHXCELREY
         CLRECR = %%CHXCELREX
         CLLOAB = %%CHXCELLLY
         CLHIAB = %%CHXCELURY
         CLLOCR = %%CHXCELLLX
         CLHICR = %%CHXCELURX
         NXLOCL = %%CHXCELNXTRG
         NXHICL = %%CHXCELNXTLF
         GO TO 3010
C
 3010    CONTINUE
         MCVEG = 0
C        CHECK IF BRANCH SEGMENT *ABSPT* BELONGS IN CHANNEL *ACHAN*
         IF (BSCHN .NE. ACHAN) GO TO 3030
C
C        **********************
C        * NEW BRANCH SEGMENT *
C        **********************
C        HERE IF BRANCH SEGMENT *ABSPT* BELONGS IN CHANNEL *ACHAN*
```

```
           BSNET = BRCHLS(5, ABSPT)
           BSLYR = BRCHLS(6, ABSPT)
           BSCR1 = BRCHLS(1, ABSPT)
           BSCR2 = BRCHLS(2, ABSPT)
           BSABS = BRCHLS(3, ABSPT)
C
C          CHECK IF BRANCH SEGMENT *ABSPT* IS THE FIRST
C          BRANCH IN CURRENT CHANNEL *ACHAN*.
           IF (ABRCT .EQ. 0) GO TO 3090
C
C          HERE IF *ABSPT* IS NOT THE FIRST BRANCH SEGMENT IN *ACHAN*.
C          CHECK FOR "OVERLAP" BETWEEN BRANCH SEGMENT *ABSPT* AND
C          CURRENT BRANCH.
C          NOTE: "OVERLAP" OCCURS ONLY IF *ABSPT* IS IN THE SAME
C          ----  NET AS THE BRANCH AND THE ABSCISSA OF THE
C                BRANCH SEGMENT *ABSPT* IS IDENTICAL TO THE
C                ABSCISSA OF THE BRANCH. LAYER OF BRANCH SEGMENT
C                AND ITS STARTING ORDINATE ARE UNIMPORTANT.
C
           IF ((BSNET .EQ. BRNET) .AND. (BSABS .EQ. BRABS)) GO TO 3020
C
C          HERE IF NO "OVERLAP" BETWEEN BRANCH SEGMENT *ABSPT*
C          AND CURRENT BRANCH.
           NOVRC = 1
           GO TO 3030
C
 3020      CONTINUE
C          ******************
C          * MERGE BRANCHES *
C          ******************
C          HERE IF BRANCH SEGMENT *ABSPT* "OVERLAPS" CURRENT BRANCH.
C          MODIFY CURRENT BRANCH ENDPOINTS AND PROCESS NEXT BRANCH.
           BRCR1 = VISMN2(BRCR1, BSCR1)
           BRCR2 = VISMX2(BRCR2, BSCR2)
           ABSPT = ABSPT + 1
           IF (ABSPT .GT. BLSIZE) GO TO 3030
           BSCHN = BRCHLS(4, ABSPT)
           GO TO 3010
C
 3030      CONTINUE
C          ***************************
C          * STORE BRANCH ENDPOINTS *
C          ***************************
C          HERE IF NEW BRANCH SEGMENT DOES NOT BELONG IN CURRENT
C          CHANNEL *ACHAN* OR IF IT DOES NOT "OVERLAP" CURRENT BRANCH.
C          CREATE TERMINALS FOR THE ENDPOINTS OF THE CURRENT BRANCH.
C
           IF (ABRCT .LE. 0) GO TO 3100
C
C          ++++++++++++++++++++++
C          + CONNECTION NUMBER +
C          ++++++++++++++++++++++
C          DETERMINE WHICH CONNECTION NUMBER THIS BRANCH BELONGS TO.
C
           IF (CHNDAT(%%CHXCHNCONNCT, ACHAN) .LE. 0) GO TO 8060
           STRT      = CHNDAT(%%CHXCHNCONNET, ACHAN)
           STOP      = CHNDAT(%%CHXCHNCONNCT, ACHAN) + STRT - 1
           TMCNIX    = 0
           DO 3035 I = STRT, STOP
           IF  (BRNET .NE. CONDAT(%%CHXCONNET, I)) GO TO 3035
           IF ((BRABS .GE. CONAB1(I)) .AND.
     1        (BRABS .LE. CONAB2(I))) TMCNIX = I
 3035      CONTINUE
C
C          ERROR IF COULD NOT FIND CONNECTION CORRESPONDING TO BRANCH
           IF (TMCNIX .LE. 0) GO TO 8060
           TMCONN = CONDAT(%%CHXCONNUM, TMCNIX)
C
C          +++++++++++++++
C          + LO ENDPOINT +
C          +++++++++++++++
C          CREATE TERMINAL FOR LOW ENDPOINT OF BRANCH IF NEEDED.
C          THE TERMINAL MAY BE A "NORMAL TERMINAL" OR AN "INCOMING
C          FUTURE TERMINAL". IF IT IS "NORMAL TERMINAL" THEN THE
C          ABSCISSA AND ORDINATE OF THE TERMINAL IS SPECIFIED
C          W.R.T. THE ORIGIN OF THE CELL TO WHICH THE BRANCH
C          CONNECTS. IF THE BRANCH DOES NOT CONNECT TO A CELL
C          BUT RATHER TO A CHANNEL FEEDING INTO THE CURRENT
C          CHANNEL *ACHAN*, THEN THE TERMINAL IS AN "INCOMING
C          FUTURE TERMINAL".
C
           IF (BRCR1 .GT. CHNDAT(CHLOCR, ACHAN)) GO TO 3065
```

```
C
C        HERE IF LCP END OF BRANCH CREATES A TERMINAL.
C        NOW DETERMINE WHICH CELL THE TERMINAL BELONGS TO.
C        NOTE: ONLY NEED TO SCAN CELLS ON LO SIDE OF CHANNEL.
C        ----  ALSO RECALL THAT THE DATA STRUCTURE BEING
C              SCANNED IS A LINKED LIST.
C
         TMCELL = 0
         ACELL  = CHNDAT($$CHXCHNLOCLPT, ACHAN)
C
 3040    CONTINUE
         IF (ACELL .EQ. 0) GO TO 3041
         LOWABS = CELDAT(CLRFAB, ACELL) + CELDAT(CLLOAB, ACELL)
         HIGABS = CELDAT(CLRFAB, ACELL) + CELDAT(CLHIAB, ACELL)
         IF ((BRABS .GE. LOWABS) .AND. (BRABS .LE. HIGABS))
     1      TMCELL = ACELL
         ACELL = CELDAT(NXLOCL, ACELL)
         IF (TMCELL .EQ. 0) GO TO 3040
C
C        HERE FOUND WHICH CELL THE BRANCH CONNECTS TO.
C        THEREFORE THIS IS A "NORMAL TERMINAL".
         TRMCNT = TRMCNT + 1
         IF (TRMCNT .GT. TRMMAX) GO TO 8050
         TRMDAT($$CHXTRMCHN, TRMCNT) = ACHAN
         TRMDAT($$CHXTRMNET, TRMCNT) = BRNET
         TRMDAT($$CHXTRMCON, TRMCNT) = TMCONN
         TRMDAT($$CHXTRMCEL, TRMCNT) = TMCELL
         TRMDAT($$CHXTRMABS, TRMCNT) = BRABS -
     1                                 CELDAT(CLRFAB, TMCELL)
         TRMDAT($$CHXTRMORD, TRMCNT) = BRCRD -
     1                                 CELDAT(CLRFCR, TMCELL)
         TRMDAT($$CHXTRMCH2, TRMCNT) = 0
         TRMDAT($$CHXTRMCN2, TRMCNT) = 0
         TRMDAT($$CHXTRMLYR, TRMCNT) = BRLYR
         GO TO 3065
C
 3041    CONTINUE
C        HERE IF COULD NOT FIND A CELL ALONG LO SIDE OF CHANNEL.
C        THIS ENDPOINT IS AN "INCOMING FUTURE TERMINAL" IN *ACHAN*
C
         IF (CHNDAT($$CHXCHNLOCHCT, ACHAN) .LE. 0) GO TO 8070
         STRT     = CHNDAT($$CHXCHNLOCHPT, ACHAN)
         STOP     = CHNDAT($$CHXCHNLOCHCT, ACHAN) + STRT - 1
C
         TMCHN2    = 0
         DO 3045 I = STRT, STOP
C
         ICHAN  = CHCDAT(I)
         ICHORN = CHNDAT($$CHXCHNORIENT, ICHAN)
         GO TO (3042, 3043), ICHORN
C                HZ    VT
 3042    CONTINUE
C        HERE IF TEST CHANNEL *ICHAN* IS HORIZONTAL
         C2LOAB = $$CHXCHNLLX
         C2HIAB = $$CHXCHNURX
         C2LOCR = $$CHXCHNLLY
         C2HICR = $$CHXCHNURY
         GO TO 3044
 3043    CONTINUE
C        HERE IF TEST CHANNEL *ICHAN* IS VERTICAL
         C2LOAB = $$CHXCHNLLY
         C2HIAB = $$CHXCHNURY
         C2LOCR = $$CHXCHNLLX
         C2HICR = $$CHXCHNURX
         GO TO 3044
C
 3044    CONTINUE
         IF ((BRABS .GE. CHNDAT(C2LOCR, ICHAN)) .AND.
     1       (BRABS .LE. CHNDAT(C2HICR, ICHAN))) TMCHN2 = ICHAN
C
 3045    CONTINUE
         IF (TMCHN2 .LE. 0) GO TO 8070
C
C        HERE FOUND WHICH CHANNEL FEEDS INTO *ACHAN* ON THE
C        LO SIDE OF *ACHAN*. NOW SCAN ALL CONNECTIONS WITHIN
C        THIS CHANNEL *TMCHN2* AND DETERMINE WHICH ONE CREATES
C        THE FUTURE TERMINAL CORRESPONDING TO THE CURRENT BRANCH.
C
         IF (CHNDAT($$CHXCHNCONNCT, TMCHN2) .LE. 0) GO TO 8080
         STRT     = CHNDAT($$CHXCHNCONNPT, TMCHN2)
         STOP     = CHNDAT($$CHXCHNCONNCT, TMCHN2) + STRT - 1
         TMC2TX    = 0
```

```
              DO 3050 I = STRT, STOP
              IF ((BRNET      .EQ. CELDAT($$CHXCONNET, I)) .AND.
     1          (CONAB2(I)  .EQ. CHNDAT(C2HIAB, TMCHN2))) IMC2IX = 1
3050          CONTINUE
              IF (IMC2IX .LE. 0) GO TO 8080
              IMCON2 = CONDAT($$CHXCONNUM, IMC2IX)
C
C             HERE FOUND CONNECTION *IMCON2* FROM FEEDING CHANNEL *TMCHN2*.
C             CREATE AN AN "OUTGOING FUTURE TERMINAL" WITHIN *TMCHN2*.
C
              TRMCNT = TRMCNT + 1
              IF (TRMCNT .GT. TRMMAX) GO TO 8050
              TRMDAT($$CHXTRMCHN, TRMCNT) = TMCHN2
              TRMDAT($$CHXTRMNET, TRMCNT) = BRNET
              TRMDAT($$CHXTRMCON, TRMCNT) = TMCON2
              TRMDAT($$CHXTRMCEL, TRMCNT) = 0
              TRMDAT($$CHXTRMABS, TRMCNT) = CHNDAT(C2HIAB, TMCHN2) -
     1                                      CHNDAT(C2LOAB, TMCHN2)
              TRMDAT($$CHXTRMORD, TRMCNT) = CONDAT($$CHXCONORD, IMCON2)
              TRMDAT($$CHXTRMCH2, TRMCNT) = ACHAN
              TRMDAT($$CHXTRMCN2, TRMCNT) = TMCONN
              TRMDAT($$CHXTRMLYR, TRMCNT) = BRLYR
              GO TO 3065
C
3065          CONTINUE
C             +++++++++++++++
C             + HI ENDPOINT +
C             +++++++++++++++
C             CREATE TERMINAL FOR HIGH ENDPOINT OF BRANCH IF NEEDED.
C             THE TERMINAL MAY BE A "NORMAL TERMINAL" OR AN "INCOMING
C             FUTURE TERMINAL". IF IT IS "NORMAL TERMINAL" THEN THE
C             ABSCISSA AND ORDINATE OF THE TERMINAL IS SPECIFIED
C             W.R.T. THE ORIGIN OF THE CELL TO WHICH THE BRANCH
C             CONNECTS. IF THE BRANCH DOES NOT CONNECT TO A CELL
C             BUT RATHER TO A CHANNEL FEEDING INTO THE CURRENT
C             CHANNEL *ACHAN*, THEN THE TERMINAL IS AN "INCOMING
C             FUTURE TERMINAL".
C
              IF (BRCR2 .LT. CHNDAT(CHHICR, ACHAN)) GO TO 3085
C
C             HERE IF HIGH END OF BRANCH CREATES A TERMINAL.
C             NOW DETERMINE WHICH CELL THE TERMINAL BELONGS TO.
C             NOTE: ONLY NEED TO SCAN CELLS ON HI SIDE OF CHANNEL.
C             ----   ALSO RECALL THAT THE DATA STRUCTURE BEING
C                    SCANNED IS A LINKED LIST.
C
              TMCELL = 0
              ACELL  = CHNDAT($$CHXCHNHICLFT, ACHAN)
C
3070          CONTINUE
              IF (ACELL .EQ. 0) GO TO 3071
              LOWABS = CELDAT(CLREAB, ACELL) + CELDAT(CLLOAB, ACELL)
              HIGABS = CELDAT(CLREAB, ACELL) + CELDAT(CLHIAB, ACELL)
              IF ((BRABS .GE. LOWABS) .AND. (BRABS .LE. HIGABS))
     1          TMCELL = ACELL
              ACELL = CELDAT(NXFTCL, ACELL)
              IF (TMCELL .EQ. 0) GO TO 3070
C
C             HERE FOUND WHICH CELL THE BRANCH CONNECTS TO.
              TRMCNT = TRMCNT + 1
              IF (TRMCNT .GT. TRMMAX) GO TO 8050
              TRMDAT($$CHXTRMCHN, TRMCNT) = ACHAN
              TRMDAT($$CHXTRMNET, TRMCNT) = BRNET
              TRMDAT($$CHXTRMCON, TRMCNT) = TMCONN
              TRMDAT($$CHXTRMCEL, TRMCNT) = TMCELL
              TRMDAT($$CHXTRMABS, TRMCNT) = BRABS -
     1                                      CELDAT(CLREAB, TMCELL)
              TRMDAT($$CHXTRMORD, TRMCNT) = BROR2 -
     1                                      CELDAT(CLREOR, TMCELL)
              TRMDAT($$CHXTRMCH2, TRMCNT) = 0
              TRMDAT($$CHXTRMCN2, TRMCNT) = 0
              TRMDAT($$CHXTRMLYR, TRMCNT) = BRLYR
              GO TO 3085
C
3071          CONTINUE
C             HERE IF COULD NOT FIND A CELL ALONG HI SIDE OF CHANNEL.
C             THIS ENDPOINT IS AN "INCOMING FUTURE TERMINAL" IN *ACHAN*.
C
              IF (CHNDAT($$CHXCHNHICHCT, ACHAN) .LE. 0) GO TO 8070
              STRT      = CHNDAT($$CHXCHNHICHPT, ACHAN)
              STOP      = CHNDAT($$CHXCHNHICHCT, ACHAN) + STRT - 1
C
```

```
              IMCHN2     = 0
              DO 3075 I = STRT, STOP
C
              ICHAN  = CHCDAT(I)
              ICHORN = CHNDAT(%%CHXCHNORIENT, ICHAN)
              GO TO (3072, 3073), ICHORN
                       HZ    VT
C
      3072    CONTINUE
C             HERE IF TEST CHANNEL *ICHAN* IS HORIZONTAL
              C2LOAP = %%CHXCHNLLX
              C2HIAP = %%CHXCHNURX
              C2LOCP = %%CHXCHNLLY
              C2HICP = %%CHXCHNURY
              GO TO 3074
      3073    CONTINUE
C             HERE IF TEST CHANNEL *ICHAN* IS VERTICAL
              C2LOAP = %%CHXCHNLLY
              C2HIAP = %%CHXCHNURY
              C2LOCP = %%CHXCHNLLX
              C2HICP = %%CHXCHNURX
              GO TO 3074
C
      3074    CONTINUE
              IF ((HEAPS .GE. CHNDAT(C2LOCP, ICHAN)) .AND.
     1            (HEAPS .LE. CHNDAT(C2HICP, ICHAN))) IMCHN2 = ICHAN
C
      3075    CONTINUE
              IF (IMCHN2 .LE. 0) GO TO 8070
C
C             HERE FOUND WHICH CHANNEL FEEDS INTO *ACHAN* ON THE
C             HI SIDE OF *ACHAN*. NOW SCAN ALL CONNECTIONS WITHIN
C             THIS CHANNEL *IMCHN2* AND DETERMINE WHICH ONE CREATES
C             THE FUTURE TERMINAL CORRESPONDING TO THE CURRENT BRANCH.
C
              IF (CHNDAT(%%CHXCHNCONNCT, IMCHN2) .LE. 0) GO TO 8080
              STRT      = CHNDAT(%%CHXCHNCONNPT, IMCHN2)
              STOP      = CHNDAT(%%CHXCHNCONNCT, IMCHN2) + STRT - 1
              IMC2IX    = 0
              DO 3080 I = STRT, STOP
              IF ((BRNET      .EQ. CONDAT(%%CHXCONNET, I)) .AND.
     1            (CONAP1(I) .EQ. CHNDAT(C2LOAP, IMCHN2))) IMC2IX = I
      3080    CONTINUE
              IF (IMC2IX .LE. 0) GO TO 8080
              IMCON2 = CONDAT(%%CHXCONNUM, IMC2IX)
C
C             HERE FOUND CONNECTION *IMCON2* FROM FEEDING CHANNEL *IMCHN2*.
C             CREATE AN "OUTGOING FUTURE TERMINAL WITHIN *IMCHN2*.
C
              TRMCNT = TRMCNT + 1
              IF (TRMCNT .GT. TRMMAX) GO TO 8050
              TRMDAT(%%CHXTRMCHN, TRMCNT) = IMCHN2
              TRMDAT(%%CHXTRMNET, TRMCNT) = BRNET
              TRMDAT(%%CHXTRMCON, TRMCNT) = IMCON2
              TRMDAT(%%CHXTRMCEL, TRMCNT) = 0
              TRMDAT(%%CHXTRMARS, TRMCNT) = 0
              TRMDAT(%%CHXTRMORL, TRMCNT) = CONDAT(%%CHXCONCRD, IMCON2)
              TRMDAT(%%CHXTRMCH2, TRMCNT) = ACHAN
              TRMDAT(%%CHXTRMCO2, TRMCNT) = IMCONN
              TRMDAT(%%CHXTRMLYR, TRMCNT) = BRLYR
C
      3085    CONTINUE
C             CHECK IF THE OVERLAP FLAG IS SET. IF NOT, THIS STARTS A
C             NEW CHANNEL. OTHERWISE WE WOULD NOT HAVE STORED THE
C             TERMINALS CREATED BY THE CURRENT BRANCH.
              IF (FOVFG .EQ. 0) GO TO 3100
C
      3090    CONTINUE
C             **************
C             * NEW BRANCH *
C             **************
C             HERE IF BRANCH SEGMENT *ABSPT* IS THE FIRST BRANCH
C             IN CHANNEL *ACHAN* OR IT BEGINS A NEW BRANCH IN *ACHAN*.
              BRNET = BSNET
              BRCR1 = BSCR1
              BRCR2 = BSCR2
              BRAPS = BSAPS
              BRLYR = BSLYR
              ABRCT = ABRCT + 1
              ABSET = ABSET + 1
              IF (ABSPT .GT. BLSIZE) GO TO 3095
              BSCHN = BRCHLS(4, ABSPT)
              GO TO 3010
```

```
C
 3095     CONTINUE
          NOVEC = 0
          GO TO 3030
C
 3100     CONTINUE
C         DONE CREATING TERMINALS FROM BRANCHES.
C
C
 7900     CONTINUE
C         ************
C         * ALL DONE *
C         ************
          IF (CHXFCF(11) .EQ. MCDNBR)  THEN
            CALL CHXCMP(230)
            CALL CHXCMP(300)
            CALL CHXCMP(400)
          ENDIF
          GO TO 9000
C
C
C         ****************************************************************
C         *                       ERROR RETURNS                          *
C         ****************************************************************
C
 8000     CONTINUE
C/        CHX - ERROR WHILE ATTEMPTING TO READ PRE-DEFINED WIRE SEGMENT
C/              DESCRIPTIONS FROM THE INPUT DESIGN FILE DURING LOADUP.
C/        **FM(1X,'FILE INDEX = ',I6,6X,'UNIT NUMBER = ',I6)
          CALL VISERR(MCDNBR, 8263001, FILINX, IOFILE(FILINX))
          GO TO 9000
 8010     CONTINUE
C/        CHX - ORIENTATION OF PRE-DEFINED WIRE SEGMENT IN INPUT DESIGN
C/              FILE IS NOT SUPPORTED. ALL WIRE SEGMENTS MUST BE EITHER
C/              HORIZONTAL (1) OR VERTICAL (2).
C/        **FM(1X,'ORIENTATION = ',I6,6X,'UNIT NUMBER = ',I6)
          CALL VISERR(MCDNBR, 8263002, RNSCRN, FILINX)
          GO TO 9000
 8020     CONTINUE
C/        CHX - TOO MANY BRANCH SEGMENTS ARE CREATED BECAUSE OF
C/              PRE-DEFINED WIRES IN THE INPUT DESIGN FILE.
C/        **FM(1X, 'NO. OF BRANCHES = ',I6,6X,'LIMIT = ',I6)
          CALL VISERR(MCDNBR, 8263003, BLSIZE+1, BLMAXX)
          GO TO 9000
 8030     CONTINUE
C/        CHX - TOO MANY TRUNK SEGMENTS ARE CREATED BECAUSE OF
C/              PRE-DEFINED WIRES IN THE INPUT DESIGN FILE.
C/        **FM(1X, 'NO. OF TRUNKS = ',I6,6X,'LIMIT = ',I6)
          CALL VISERR(MCDNBR, 8263004, TLSIZE+1, TLMAXX)
          GO TO 9000
 8040     CONTINUE
C/        CHX - TOO MANY CONNECTIONS ARE CREATED BECAUSE OF
C/              PRE-DEFINED WIRES IN THE INPUT DESIGN FILE.
C/        **FM(1X, 'NO. OF CONNECTIONS = ',I6,6X,'LIMIT = ',I6)
          CALL VISERR(MCDNBR, 8263005, CONCNT, CONMAX)
          GO TO 9000
 8050     CONTINUE
C/        CHX - TOO MANY TERMINALS ARE CREATED BECAUSE OF
C/              PRE-DEFINED WIRES IN THE INPUT DESIGN FILE.
C/        **FM(1X, 'NO. OF TERMINALS = ',I6,6X,'LIMIT = ',I6)
          CALL VISERR(MCDNBR, 8263006, TRMCNT, TRMMAX)
          GO TO 9000
 8060     CONTINUE
C/        CHX - PRE-DEFINED WIRE SEGMENT TRAVERSING THROUGH A CHANNEL
C/              AS A "BRANCH" DOES NOT HAVE A CORRESPONDING "TRUNK".
C/              POSSIBLY A DANGLING WIRE.
C/        **FM(' CHANNEL NO. =',I7,6X,'ABSCISSA IN CHANNEL =',I7)
          CALL VISERR(MCDNBR, 8263007, ACHAN, BRABS)
          GO TO 9000
 8070     CONTINUE
C/        CHX - PRE-DEFINED WIRE SEGMENT ENCOUNTERED TRAVERSING FROM
C/              A DEFINED CHANNEL *ACHAN* TO AN UNDEFINED CHANNEL.
C/              PLEASE MAKE SURE THAT ALL WIRE SEGMENTS IN THE INPUT
C/              DESIGN FILE TRAVERSE THROUGH DEFINED CHANNEL AREAS.
C/        **FM(' CHANNEL NO. =',I7,6X,'ABSCISSA IN CHANNEL =',I7)
          CALL VISERR(MCDNBR, 8263009, ACHAN, BRABS)
          GO TO 9000
 8080     CONTINUE
C/        CHX - PRE-DEFINED WIRE SEGMENT ENCOUNTERED TRAVERSING FROM
C/              ONE CHANNEL TO ANOTHER CHANNEL BUT DOES NOT HAVE A
C/              CORRESPONDING CONTINUATION TO THE SECOND CHANNEL.
C/              POSSIBLE DANGLING WIRE.
```

```
C/      **FMT(1X,'CHANNEL 1 = ',I6,6X,'CHANNEL 2 = ',I6)
        CALL VISERR(FLCNMR, 8263009, ACHAN, TMCHN2)
        GO TO 9000
C
C
C       ***********************************************************
C       *                 SINGLE EXIT FROM THIS ROUTINE           *
C       ***********************************************************
C
 9000   CONTINUE
CS*     MODEXIT (CHX)
        RETURN
C
C
C       ***********************************************************
C       *                   FORMAT STATEMENTS                     *
C       ***********************************************************
C
 9100   FORMAT(1X,'TRUNK LIST'//' INDEX          START     STOP',
     1  'ORDINATE CHANNEL    NET   LAYER'/ (1X,I3,'..',5X,6I8))
 9200   FORMAT(1X,'BRANCH LIST'//' INDEX          START     STOP',
     1  'ABSCISSA CHANNEL    NET   LAYER'/ (1X,I3,'..',5X,6I8))
C
C
C       END WIRECD 2630
        END
```

VAX/VMS VAX/VMS VAX/VMS VAX/VMS VAX/VMS VAX/VMS VAX/VMS VAX/VMS VAX/VMS VAX/VMS VAX/VMS VAX/VMS
VAX/VMS VAX/VMS VAX/VMS VAX/VMS VAX/VMS VAX/VMS VAX/VMS VAX/VMS VAX/VMS VAX/VMS VAX/VMS VAX/VMS
VAX/VMS VAX/VMS VAX/VMS VAX/VMS VAX/VMS VAX/VMS VAX/VMS VAX/VMS VAX/VMS VAX/VMS VAX/VMS VAX/VMS

JJJJJJJJJ 9999999999999999999999999999999999999999999999999999999999999999999999999999999999999999 JJJJJJJJJ
JJJJJJJJJ 999999999999999999999999 DIGITAL EQUIPMENT CORPORATION - VAX/VMS VERSION V4.4 999999999999999999999999 JJJJJJJJJ
JJJJJJJJJ 9999999999999999999999999999999999999999999999999999999999999999999999999999999999999999 JJJJJJJJJ

```
K    K  M     M  PPPP
K   K   MM   MM  P   P
K  K    M M M M  P   P
KKK     M  M  M  PPPP
K  K    M     M  P
K   K   M     M  P
K    K  M     M  P

  SSSSSSSS     222222       666666      333333      11
  SSSSSSSS     222222       666666      333333      11
SS          22      22    66          33      33  1111
SS          22      22    66          33      33  1111
SS                  22    66                  33    11
SS                  22    66                  33    11
  SSSSSS          22      66666666          33      11
  SSSSSS          22      66666666          33      11
        SS      22        66      66          33    11
        SS      22        66      66          33    11
        SS    22          66      66  33      33    11
        SS    22          66      66  33      33    11
SSSSSSSS      2222222222    666666      333333    111111
SSSSSSSS      2222222222    666666      333333    111111

FFFFFFFFFF    OOOOOO    RRRRRRRR
FFFFFFFFFF    OOOOOO    RRRRRRRR
FF          OO      OO  RR      RR
FF          OO      OO  RR      RR
FF          OO      OO  RR      RR
FF          OO      OO  RR      RR
FFFFFFFF    OO      OO  RRRRRRRR
FFFFFFFF    OO      OO  RRRRRRRR
FF          OO      OO  RR  RR
FF          OO      OO  RR  RR
FF          OO      OO  RR    RR
FF          OO      OO  RR    RR
FF            OOOOOO    RR      RR
FF            OOOOOO    RR      RR

      ;;;;    222222
      ;;;;    222222
      ;;;;  22      22
      ;;;;  22      22
                    22
                    22
      ;;;;        22
      ;;;;        22
      ;;;;      22
      ;;;;      22
        ;;    22
        ;;    22
      ;;    2222222222
      ;;    2222222222
```

FILE _$1$DUA6:[PRL.CHX021S2631.FOR;2 (1077,1,2), LAST REVISED ON 21-OCT-1986 08:44, IS A 43 BLOCK SEQUENTIAL FILE OWNED BY UIC [PRD1ST,PRC]. THE RECORDS ARE VARIABLE LENGTH WITH IMPLIED (CR) CARRIAGE CONTROL. THE LONGEST RECORD IS 72 BYTES.

JOB S2631 (213) QUEUED TO SYS$PRINT ON 4-DEC-1986 12:51 BY USER KMP, UIC [ENGVLSI,KMP], UNDER ACCOUNT ENGPKG AT PRIORITY 100, STARTED ON PRINTER _TCN10$LPA0: ON 4-DEC-1986 13:14 FROM QUEUE SYS$PRINT.

JJJJJJJJJ 9999999999999999999999999999999999999999999999999999999999999999999999999999999999999999 JJJJJJJJJ
JJJJJJJJJ 999999999999999999999999 DIGITAL EQUIPMENT CORPORATION - VAX/VMS VERSION V4.4 999999999999999999999999 JJJJJJJJJ
JJJJJJJJJ 9999999999999999999999999999999999999999999999999999999999999999999999999999999999999999 JJJJJJJJJ

```
_SISIDAG:[ERD.CHX021S7631.FLR;2                    21-OCT-1986 08:44                    PAGE 1
        SUBROUTINE TRRLOD(FILINX)
C
CS*     ALLDATEG
C                        ****************
C                        *              *
C       SUBSYSTEM CHX    *  2631 TRRLOD *
C                        *              *
C                        ****************
C
C       ***************************************************************
C       ***************************************************************
C       **                                                           **
C       **   (C) COPYRIGHT V-R INFORMATION SYSTEMS, INC. 1984        **
C       **   LICENSED MATERIAL -- PROGRAM PROPERTY OF VRIS           **
C       **   ALL RIGHTS RESERVED                                     **
C       **                                                           **
C       **   THIS PROGRAM IS THE PROPERTY OF VRIS AND IS FURNISHED   **
C       **   PURSUANT TO A WRITTEN LICENSE AGREEMENT. IT MAY NOT BE  **
C       **   USED, REPRODUCED, OR DISCLOSED TO OTHERS EXCEPT IN      **
C       **   ACCORDANCE WITH THE TERMS AND CONDITIONS OF THAT        **
C       **   AGREEMENT.                                              **
C       **                                                           **
C       ***************************************************************
C       ***************************************************************
C
C       ***************************************************************
C       *                   MODULE DOCUMENTATION                      *
C       ***************************************************************
C
C       SUMMARY --
C       THIS SUBROUTINE LOADS TERMINAL POINT DEFINITIONS FROM THE ASCII
C       SEQUENTIAL FILE WHOSE INDEX INTO THE IOFILE ARRAY IS GIVEN IN
C       FORMAL PARAMATER *FILINX*. TERMINAL DEFINITIONS LOADED BY THIS
C       ROUTINE ARE MERGED IN WITH THE TERMINALS THAT WERE PREVIOUSLY
C       CREATED BY *CHX* WHEN LOADING PRE-DEFINED WIRES.
C
C       DURING LOADING, THE TERMINAL COORDINATES SPECIFIED ARE
C       CONVERTED FROM ABSOLUTE TO RELATIVE FOR INTERNAL STORAGE.
C
C       WHEN THIS MODULE IS CALLED, THE INPUT TERMINAL FILE IS
C       EXPECTED TO BE CLOSED AND IS AGAIN CLOSED UPON EXIT.
C
C       FOR A DETAILED DESCRIPTION OF THE FORMAT OF THE TERMINAL
C       FILE *TRRFIL* SEE THE DOCUMENTATION CONTAINED IN:
C
C                    MERSGGRDIR:GGR.DOC
C                    MERSTRKDIR:TRK.DOC
C
C       FORMAL PARAMETERS --
C       NAME  DIMENSION TYPE   IN/OUT  DESCRIPTION
C       ----  --------- ----   ------  -----------
C       FILINX            I      IN    INDEX OF THE ASCII FILE FROM
C                                      WHICH TERMINAL DATA IS LOADED.
C                                      UNIT NUMBER = IOFILE(FILINX)
C
C       LOCAL VARIABLES --
C       NAME  DIMENSION TYPE   DESCRIPTION
C       ----  --------- ----   -----------
C       ACELL                  CELL NUMBER.
C
C       ACHAN                  CHANNEL IDENTIFICATION NUMBER.
C
C       ACHOR                  ORIENTATION OF CURRENT CHANNEL.
C
C       ATMCT                  NUMBER OF TERMINALS IN A GIVEN CHANNEL.
C
C       ATMPT                  POINTER TO THE FIRST TERMINAL
C                              IN A GIVEN CHANNEL.
C
C       CHHIOR                 VARIABLE USED TO ACCESS THE HI ORDINATE
C                              FIELD (IN *CHNDAT*) OF A GIVEN CHANNEL.
C
C       CHLOAB                 VARIABLE USED TO ACCESS THE HI ABSCISSA
C                              FIELD (IN *CHNDAT*) OF A GIVEN CHANNEL.
C
C       CHLOOR                 VARIABLE USED TO ACCESS THE LO ORDINATE
C                              FIELD (IN *CHNDAT*) OF A GIVEN CHANNEL.
C
```

```
C       CLHIAB          VARIABLE USED TO ACCESS THE HI ABSCISSA
C                       FIELD (IN *CELDAT*) OF A CELL ALONG
C                       THE CURRENT CHANNEL.
C       CLLOAB          VARIABLE USED TO ACCESS THE LO ABSCISSA
C                       FIELD (IN *CELDAT*) OF A CELL ALONG
C                       THE CURRENT CHANNEL.
C       CLRFAB          VARIABLE USED TO ACCESS THE REFERENCE
C                       ABSCISSA FIELD (IN *CELDAT*) OF A CELL
C                       ALONG THE CURRENT CHANNEL.
C       CLRFOR          VARIABLE USED TO ACCESS THE REFERENCE
C                       ORDINATE FIELD (IN *CELDAT*) OF A CELL
C                       ALONG THE CURRENT CHANNEL.
C       HIABS           SIDE ABSCISSA OF AN INTERVAL ALONG
C                       THE SIDE OF THE CURRENT CHANNEL.
C       HICEL           POINTER TO THE FIRST CELL ALONG THE
C                       HI SIDE OF A CHANNEL.
C       LOABS           START ABSCISSA OF AN INTERVAL ALONG
C                       THE SIDE OF THE CURRENT CHANNEL.
C       LOCEL           POINTER TO THE FIRST CELL ALONG THE
C                       LO SIDE OF A CHANNEL.
C       NXCEL           VARIABLE USED TO ACCESS THE FIELD
C                       IN *CELDAT* WHICH POINTS FROM ONE
C                       CELL TO THE NEXT CELL ALONG THE CHANNEL.
C                       THE VALUE OF THIS VARIABLE IS EITHER
C                       *NXLOCL* OR *NXHICL* DEPENDING ON
C                       WHICH SIDE (HI OR LO) OF THE CHANNEL
C                       IS BEING PROCESSED.
C       NXHICL          VARIABLE USED TO ACCESS THE FIELD (IN
C                       *CELDAT) WHICH POINTS FROM ONE CELL
C                       TO THE NEXT CELL ALONG THE HI SIDE OF
C                       CHANNEL.
C       NXLOCL          VARIABLE USED TO ACCESS THE FIELD (IN
C                       *CELDAT) WHICH POINTS FROM ONE CELL
C                       TO THE NEXT CELL ALONG THE LO SIDE OF
C                       CHANNEL.
C       TMABSC          VARIABLE USED TO ACCESS THE ABSCISSA
C                       FIELD OF A TERMINAL IN *TMBUF*.
C       TMABS           ABSCISSA OF TERMINAL.
C       TMCEL           CELL TO WHICH TERMINAL BELONGS.
C       TMCH2           SECOND CHANNEL FOR A FUTURE TERMINAL.
C       TMCHN           CHANNEL NUMBER FOR A GIVEN TERMINAL.
C       TMCN2           CONNECTION NUMBER IN SECOND CHANNEL
C                       FOR A FUTURE TERMINAL.
C       TMCON           CONNECTION TO WHICH TERMINAL BELONGS.
C       TMLYR           LAYER ON WHICH TERMINAL OCCURS.
C       TMNET           NET NUMBER OF TERMINAL.
C       TMORD           ORDINATE OF TERMINAL.
C       TMTYP           TERMINAL TYPE CODE.
C                         1 = DUMMY FUTURE TERMINAL
C                         2 = NORMAL TERMINAL
C       TMORDW          VARIABLE USED TO ACCESS THE ORDINATE
C                       FIELD OF A TERMINAL IN *TMBUF*.
C       TMBUF(8)        BUFFER INTO WHICH TERMINAL DATA
C                       FROM *TMFIL* IS LOADED.
C                       SEE TRK.DOC FOR DETAILS.
C       TMFIL           UNIT NUMBER OF FILE FROM WHICH
C                       TERMINAL INFORMATION IS LOADED.
C
```

```
$1$DUA6:[EPP.CHX02]S2631.FOR;2                    21-OCT-1986 08:44                    PAGE 3
C
C
C          GLOBAL VARIABLES --
C          NAME  DIMENSION TYPE  DESCRIPTION
C          ----  --------- ----  -----------
C          (NONE)
C
C          REVISION HISTORY --
C              14-JAN-86 IAF REPLACED ABSOLUTE DOGLEG AND FUTURE
C                            TERMINAL COORDINATES WITH RELATIVE
C                            COORDINATES.  (SAR 5500)
C              21-NOV-85 DDC REVISED ERROR CODES.  (SAR 5391)
C              20-NOV-85 DDC CORRECTED ERROR FORMATS.  (SAR 5372)
C              29-JUL-85 DDC CHECKED MODULE.
C              12-OCT-84 KPP WROTE MODULE.  (SAR 4856)
C
C          TESTING PLANS --
C              29-JUL-85 DDC COMPLETED UNIT TESTING.
C
C          ************************************************************
C          *                    SUBSYSTEM TOKENS                      *
C          ************************************************************
C
CS*        CHXTOKEN
C
C          ************************************************************
C          *                 VARIABLE DECLARATIONS                    *
C          ************************************************************
C
C          FORMAL PARAMETERS --
C          (NONE)
C
C          LOCAL VARIABLES --
C
           DIMENSION   TEMBUF(8)
C
C          SUBSYSTEM GLOBAL VARIABLES --
C
CS*        SUBSYSGLOBAL [CHX]
C
CS*        CHXCEL
CS*        CHXCEN
CS*        CHXCON
CS*        CHXTEM
C
C          OTHER SUBSYSTEM VARIABLES --
C          (NONE)
C
C          SYSTEM GLOBAL VARIABLES --
C
CS*        SYSCOMMON
C
C          ************************************************************
C          *                    DATA STATEMENTS                       *
C          ************************************************************
C
C          (NONE)
C
C          ************************************************************
C          *                  STATEMENT FUNCTIONS                     *
C          ************************************************************
C
C          LOCAL STATEMENT FUNCTIONS --
C          (NONE)
C
C          SUBSYSTEM STATEMENT FUNCTIONS --
C          (NONE)
C
C          OTHER SUBSYSTEM STATEMENT FUNCTIONS --
C          (NONE)
C
C          SYSTEM STATEMENT FUNCTIONS --
C
CS*        SFUNCHCS1
C
C
```

```
C         ***************************************************************
C         *                      EXECUTABLE CODE                        *
C         ***************************************************************
C
CS*       MODENTRY [CFX] [TRMLCD] [2631] [07]
C
C         ****************
C         * SETUP TO LEAD *
C         ****************
CS*       RCURSCEN [FILINX] [0] [$$SICFILES] [8000]
C
          TRMFIL = ICFILE(FILINX)
          IF (TRMFIL .LE. 0) GO TO 8010
C
C         OPEN THE INPUT DATA FILE IN A READ-ONLY SHAREABLE MODE.
          CALL FLENTF(7, TRMFIL, 'TRMFIL       ')
          IF (WRSTEP .GT. 8000000) GO TO 8020
C
C         ****************
C         * TERMINAL DATA *
C         ****************
C         LOAD TERMINAL DATA FROM ASCII FILE INTO TERMINAL BUFFER
          ACHAN = 0
C
 1000     CONTINUE
          READ(TRMFIL, 9010, END=2000) (TRMBUF(I), I=1,8)
          IMCHN = TRMBUF(6)
          IF ((IMCHN .LE. 0) .OR. (IMCHN .GT. CHNCNT)) GO TO 8030
C
C         CHECK IF TERMINAL BELONGS TO CURRENT CHANNEL
          IF (IMCHN .EQ. ACHAN) GO TO 1010
C
C         **************
C         * NEW CHANNEL *
C         **************
C         HERE IF TERMINAL BELONGS TO A DIFFERENT CHANNEL.
          ACHAN  = IMCHN
          ACHOR  = CHNLA1($$CHXCHNORIENT, IMCHN)
          LOCEL  = CHNLP1($$CHXCHNLOCLPT, ACHAN)
          HICEL  = CHNLP1($$CHXCHNHICLPT, ACHAN)
C
          GO TO (1001, 1002), ACHOR
C                HZ    VT
C
 1001     CONTINUE
C         HERE IF NEW CHANNEL *ACHAN* IS HORIZONTAL.
C         SET UP VARIABLES TO ACCESS THE APPROPRIATE FIELDS IN
C         THE CELL AND CHANNEL DATA STRUCTURES.
          IMARSC = 2
          IMCRDN = 3
          NXLOCL = $$CHXCELNXTTP
          NXHICL = $$CHXCELNXTPT
          CLRFAB = $$CHXCELRFX
          CLRFCR = $$CHXCELRFY
          CLLOAP = $$CHXCELLLX
          CLHIAP = $$CHXCELURX
          CHLOCR = $$CHXCHNLLY
          CHHICR = $$CHXCHNURY
          CHLOAB = $$CHXCHNLLX
          GO TO 1010
C
 1002     CONTINUE
C         HERE IF NEW CHANNEL *ACHAN* IS VERTICAL.
C         SET UP VARIABLES TO ACCESS THE APPROPRIATE FIELDS IN
C         THE CELL AND CHANNEL DATA STRUCTURES.
          IMARSC = 3
          IMCRDN = 2
          NXLOCL = $$CHXCELNXTRG
          NXHICL = $$CHXCELNXTLF
          CLRFAB = $$CHXCELRFY
          CLRFCR = $$CHXCELRFX
          CLLOAP = $$CHXCELLLY
          CLHIAP = $$CHXCELURY
          CHLOCR = $$CHXCHNLLX
          CHHICR = $$CHXCHNURX
          CHLOAB = $$CHXCHNLLY
          GO TO 1010
C
 1010     CONTINUE
C         **********************************
C         * NEW TERMINAL IN CURRENT CHANNEL *
C         **********************************
```

```
C        HERE IF TERMINAL BELONGS TO CHANNEL *ACHAN*.
         IMABS = IRRBUF(IMABSC)
         IMCEL = IRRBUF(IMCECN)
         IMNET = IRRBUF(1)
         IMLYR = IRRBUF(4)
         IMCON = IRRBUF(5)
         IMCH2 = IRRBUF(7)
         IMCH2 = IRRBUF(9)
C
         IF (IMCH2 .EQ. 0) GO TO 1100
C
C        ******************
C        * FUTURE TERMINAL *
C        ******************
C        CREATE AN OUTGOING FUTURE TERMINAL IN CURRENT CHANNEL *ACHAN*
C
C        OUTGOING FUTURE TERMINAL (IN CHANNEL *ACHAN*)
         TRMCNT = TRMCNT + 1
         IF (TRMCNT .GT. TRMMAX) GO TO 8040
         TRMDAT(%%CHXTRMCHN, TRMCNT) = ACHAN
         TRMDAT(%%CHXTRMNET, TRMCNT) = IMNET
         TRMDAT(%%CHXTRMCON, TRMCNT) = IMCON +
     1                      CHNDAT(%%CHXCHNCCNNCT,ACHAN)
         TRMDAT(%%CHXTRMCEL, TRMCNT) = 0
         TRMDAT(%%CHXTRMABS, TRMCNT) = IMABS -
     1                      CHNDAT(CHLCAP, ACHAN)
         TRMDAT(%%CHXTRMORD, TRMCNT) = IMORD -
     1                      CHNDAT(CHLOCR, ACHAN)
         TRMDAT(%%CHXTRMLYR, TRMCNT) = IMLYR
         TRMDAT(%%CHXTRMCH2, TRMCNT) = IMCH2
         TRMDAT(%%CHXTRMCN2, TRMCNT) = IMCN2 +
     1                      CHNDAT(%%CHXCHNCCNNCT,TMCH2)
C
         GO TO 1000
C
  1100   CONTINUE
C        ******************
C        * NORMAL TERMINAL *
C        ******************
         IMCEL = 0
         IF (IMCRD .GE. CHNDAT(CHHIOR, ACHAN)) GO TO 1105
C
C        HERE IF TERMINAL IS ON THE LO SIDE OF THE CHANNEL
         ACELL = LOCEL
         NXCEL = NXLOCL
         GO TO 1110
C
  1105   CONTINUE
C        HERE IF TERMINAL IS ON THE HI SIDE OF THE CHANNEL
         ACELL = HICEL
         NXCEL = NXHICL
         GO TO 1110
C
  1110   CONTINUE
         IF (ACELL .EQ. 0) GO TO 8050
         LOABS = CELDAT(CLREAB, ACELL) + CELDAT(CLLCAB, ACELL)
         HIABS = CELDAT(CLREAB, ACELL) + CELDAT(CLHIAB, ACELL)
         IF ((IMABS .GE. LOABS) .AND. (IMABS .LE. HIABS))
     1       IMCEL = ACELL
         ACELL = CELDAT(NXCEL, ACELL)
         IF (IMCEL .EQ. 0) GO TO 1110
C
C        HERE FOUND WHICH CELL THE TERMINAL BELONGS TO.
         TRMCNT = TRMCNT + 1
         IF (TRMCNT .GT. TRMMAX) GO TO 8040
         TRMDAT(%%CHXTRMCHN, TRMCNT) = ACHAN
         TRMDAT(%%CHXTRMNET, TRMCNT) = IMNET
         TRMDAT(%%CHXTRMCON, TRMCNT) = IMCON +
     1                      CHNDAT(%%CHXCHNCCNNCT, ACHAN)
         TRMDAT(%%CHXTRMCEL, TRMCNT) = IMCEL
         TRMDAT(%%CHXTRMABS, TRMCNT) = IMABS -
     1                      CELDAT(CLREAB, IMCEL)
         TRMDAT(%%CHXTRMORD, TRMCNT) = IMORD -
     1                      CELDAT(CLRECR, IMCEL)
         TRMDAT(%%CHXTRMLYR, TRMCNT) = IMLYR
         TRMDAT(%%CHXTRMCH2, TRMCNT) = 0
         TRMDAT(%%CHXTRMCN2, TRMCNT) = 0
C
         IF (IMCRD .LE. CHNDAT(CHLOCR, ACHAN)) LOCEL = IMCEL
         IF (IMCRD .GE. CHNDAT(CHHIOR, ACHAN)) HICEL = IMCEL
         GO TO 1000
C
```

```
C
 2000   CONTINUE
        IF (TRMCNT .EQ. 0) GO TO 8070
C
C       *************************************
C       * ASSOCIATE TERMINALS WITH CHANNELS *
C       *************************************
C       HERE WHEN DONE READING IN ALL TERMINALS FROM *TRMFIL*.
C       NOW SORT THE TERMINAL ARRAY *TRMDAT* IN ASCENDING ORDER.
C       PRIMARY    KEY: CHANNEL INDEX NUMBER
C       SECONDARY KEY: CELL NUMBER (WILL BE ZERO FOR OUTGOING
C                      FUTURE TERMINALS)
C
        CALL VISRT1(TRMDAT, $$CHXTRMFLD, $$OTCTTERMINAL,
     1              $$CHXTRMCHN, $$CHXTRMCEL, TRMCNT, 1)
C
C       THE TERMINALS FOR EACH CHANNEL ARE NOW IN CONTIGUOUS
C       PORTIONS OF THE *TRMDAT* ARRAY AND ARE SUB-SORTED
C       SUCH THAT ALL OUTGOING FUTURE TERMINALS FOR THE CHANNEL
C       ARE FOLLOWED BY ALL THE NORMAL TERMINALS WITHIN THAT CHANNEL.
C
        ATMPT = 1
        DO 3000 ACHAN = 1, CHNCNT
C
        TMTYP = 1
C
 2100   CONTINUE
        ATMCT = 0
        CHNDAT($$CHXCHNOFTMPT+(2*TMTYP)-2, ACHAN) = ATMPT
        IF (ATMPT .GT. TRMCNT) GO TO 2300
C
 2200   CONTINUE
C       CHECK IF TERMINAL *ATMPT* BELONGS TO CURRENT CHANNEL.
        IF (TRMDAT($$CHXTRMCHN, ATMPT) .NE. ACHAN) GO TO 2300
C
C       HERE TERMINAL BELONGS TO CURRENT CHANNEL *ACHAN*.
C       CHECK IF IT IS THE SAME TYPE AS THE PREVIOUS TERMINAL.
        IF ((TMTYP .EQ. 1) .AND.
     1      (TRMDAT($$CHXTRMCH2, ATMPT) .LE. 0)) GO TO 2300
        IF ((TMTYP .EQ. 2) .AND.
     1      (TRMDAT($$CHXTRMCEL, ATMPT) .EQ. 0)) GO TO 8080
C
C       HERE IF TERMINAL IS OF THE SAME TYPE AS THE PREVIOUS ONE.
        ATMCT = ATMCT + 1
        ATMPT = ATMPT + 1
        IF (ATMPT .LE. TRMCNT) GO TO 2200
C
 2300   CONTINUE
C       HERE IF TERMINAL *ATMPT* DOES NOT BELONG TO CHANNEL *ACHAN*
C       OR IF IT IS NOT OF THE SAME TYPE AS THE PREVIOUS TERMINAL.
C       UPDATE THE COUNT OF TERMINALS OF CURRENT TYPE IN *ACHAN*.
C
        CHNDAT($$CHXCHNOFTMCT+(2*TMTYP)-2, ACHAN) = ATMCT
        TMTYP = TMTYP + 1
        IF (TMTYP .LE. 2) GO TO 2100
C
 3000   CONTINUE
C       HERE AFTER ALL TERMINALS ARE ASSOCIATED WITH THEIR
C       RESPECTIVE CHANNELS. NOW SETUP THE POINTER TO THE FIRST
C       DOGLEG TERMINAL AND INITIALIZE DOGLEG TERMINAL COUNT.
        DGTMPT = TRMCNT + 1
        DGTMCT = 0
C
C       CLOSE THE INPUT TERMINAL FILE.
        CALL FCNTIF(3, TRMFIL, 'TRMFIL       ')
        IF (WRSTER .GT. R000000) GO TO 8060
        GO TO 9000
C
C       ***********************************************************
C       *                     ERROR RETURNS                       *
C       ***********************************************************
C
 8000   CONTINUE
C/      CHX - ILLEGAL VALUE SPECIFIED FOR INPUT FILE INDEX OF
C/            TERMINAL DESCRIPTION FILE.
C/      ***F(1X,'FILE INDEX = ',I6,6X,'LIMIT = ',I6)
        CALL VISERR(MCDNBR, 8263101, FILINX, $$$ICFILES)
        GO TO 9000
 8010   CONTINUE
C/      CHX - ILLEGAL UNIT NUMBER SPECIFIED FOR TERMINAL FILE.
C/            POSSIBLE ERROR IN INITIALIZATION OF *ICFILE* ARRAY.
C/      ***F(1X,'UNIT NUMBER = ',I6,6X,'FILE INDEX = ',I6)
```

```
      CALL VISERR(MCDNHR, 8263102, TRMFIL, FILINX)
      GO TO 9000
 8020 CONTINUE
C/    CHX - ERROR OPENING TERMINAL FILE.
C/    **FM(1X,'FILE INDEX = ',I6,6X,'UNIT NUMBER = ',I6)
      CALL VISERR(MCDNHR, 8263103, FILINX, TRMFIL)
      GO TO 9000
 8030 CONTINUE
C/    CHX - TERMINAL POINT SPECIFIED IN THE INPUT TERMINAL FILE
C/          DOES NOT BELONG TO ANY LEGAL CHANNEL IN THE DESIGN.
C/          PLEASE VERIFY THAT THE CORRECT TERMINAL FILE IS BEING
C/          USED FOR ROUTING.
C/    **FM(' CHANNEL NUMBER =',I7,6X,'NO. OF CHANNELS =',I7)
      CALL VISERR(MCDNHR, 8263104, ACHAN, CHNCNT)
      GO TO 9000
 8040 CONTINUE
C/    CHX - TOO MANY TERMINALS DEFINED IN THE DESIGN.
C/    **FM(1X,'NO. OF TERMINALS = ',I6,6X,'LIMIT = ',I6)
      CALL VISERR(MCDNHR, 8263105, TRMCNT, TRMMAX)
      GO TO 9000
 8050 CONTINUE
C/    CHX - TERMINAL POINT SPECIFIED IN THE INPUT TERMINAL FILE
C/          DOES NOT CORRESPOND TO ANY CELL ALONG THE CURRENT
C/          CHANNEL. POSSIBLE ERROR IN GLOBAL ROUTING.
C/    **FM(' CHANNEL =',I7,6X,'TERMINAL ABSCISSA =',I7)
      CALL VISERR(MCDNHR, 8263106, ACHAN, IMABS)
      GO TO 9000
 8060 CONTINUE
C/    CHX - ERROR WHILE ATTEMPTING TO CLOSE THE TERMINAL FILE
C/          AFTER THE TERMINAL DATA HAS BEEN LOADED.
C/    **FM(1X,'FILE INDEX = ',I6,6X,'UNIT NUMBER = ',I6)
      CALL VISERR(MCDNHR, 8263107, FILINX, TRMFIL)
      GO TO 9000
 8070 CONTINUE
C/    CHX - DESIGN CONTAINS NO TERMINALS EITHER FROM PRE-DEFINED
C/          WIRES OR FROM THE *TRMFIL*. MUST RUN GLOBAL ROUTER
C/          TO CREATE TERMINALS.
C/    **FM(' TOTAL NO. OF TERMINALS =',I7,6X,'UNIT NO. =',I7)
      CALL VISERR(MCDNHR, 8263108, TRMCNT, TRMFIL)
      GO TO 9000
 8080 CONTINUE
C/    CHX - FATAL ERROR WHILE ATTEMPTING TO ASSOCIATE TERMINALS
C/          WITH THEIR CORRESPONDING CHANNELS AFTER ALL TERMINALS
C/          FROM THE *TRMFIL* HAVE BEEN LOADED. POSSIBLE ERROR
C/          IN SORTING ROUTINE.
C/    **FM(' TOTAL NO. OF TERMINALS =',I7,6X,'UNIT NO. =',I7)
      CALL VISERR(MCDNHR, 8263109, TRMCNT, TRMFIL)
      GO TO 9000
C
C
C     ****************************************************************
C     *                  SINGLE EXIT FROM THIS ROUTINE               *
C     ****************************************************************
C
 9000 CONTINUE
CS*   MCLEXIT (CHX)
      RETURN
C
C
C     ****************************************************************
C     *                       FORMAT STATEMENTS                      *
C     ****************************************************************
C
 9010 FORMAT(8I8)
C
C     END TRMLOD 2631
      END
```

AAAAAAAAAA 5555555555555555555555555555555555555555555555555555555555555555555555555555 AAAAAAAAAA
AAAAAAAAAA 5555555555555555555555555 DIGITAL EQUIPMENT CORPORATION - VAX/VMS VERSION V4.4 5555555555555555555555555 AAAAAAAAAA
AAAAAAAAAA 5555555555555555555555555555555555555555555555555555555555555555555555555555 AAAAAAAAAA

KMP

S2632

.FOR

;6

FILE _$1$DUA6:[PRC.(PXC2]S2632.FOR;6 (1078,1,2), LAST REVISED ON 21-OCT-1986 08:44, IS A 104 BLOCK SEQUENTIAL FILE OWNED BY UIC [PRLIST,PRC]. THE RECORDS ARE VARIABLE LENGTH WITH IMPLIED (CR) CARRIAGE CONTROL. THE LONGEST RECORD IS 74 BYTES.

JOB S2632 (214) QUEUED TO SYS$PRINT ON 4-DEC-1986 12:51 BY USER KMP, UIC [ENGVLSI,KMP], UNDER ACCOUNT ENGPKG AT PRIORITY 3, STARTED ON PRINTER _ICNTC$LPA0: ON 4-DEC-1986 13:42 FROM QUEUE SYS$PRINT.

AAAAAAAAAA 5555555555555555555555555555555555555555555555555555555555555555555555555555 AAAAAAAAAA
AAAAAAAAAA 5555555555555555555555555 DIGITAL EQUIPMENT CORPORATION - VAX/VMS VERSION V4.4 5555555555555555555555555 AAAAAAAAAA
AAAAAAAAAA 5555555555555555555555555555555555555555555555555555555555555555555555555555 AAAAAAAAAA

VAX/VMS VAX/VMS VAX/VMS VAX/VMS VAX/VMS VAX/VMS VAX/VMS VAX/VMS VAX/VMS VAX/VMS VAX/VMS VAX/VMS
VAX/VMS VAX/VMS VAX/VMS VAX/VMS VAX/VMS VAX/VMS VAX/VMS VAX/VMS VAX/VMS VAX/VMS VAX/VMS VAX/VMS

VAX/VMS VAX/VMS VAX/VMS VAX/VMS VAX/VMS VAX/VMS VAX/VMS VAX/VMS VAX/VMS VAX/VMS VAX/VMS VAX/VMS

AAAAAAAAAA 5555555555555555555555555 DIGITAL EQUIPMENT CORPORATION - VAX/VMS VERSION V4.4 5555555555555555555555555 AAAAAAAAAA

KMP

S2632

.FOR

;6

FILE _$1$DUA6:[ERL.CHX02]S2632.FOR;6 (1076,1,2), LAST REVISED ON 21-OCT-1986 08:44, IS A 104 BLOCK SEQUENTIAL FILE OWNED BY UIC [ERDTST,PFC]. THE RECORDS ARE VARIABLE LENGTH WITH IMPLIED (CR) CARRIAGE CONTROL. THE LONGEST RECORD IS 74 BYTES.

JOB S2632 (214) QUEUED TO SYS$PRINT ON 4-DEC-1986 12:51 BY USER KMP, UIC [ENGVLSI,KMP], UNDER ACCOUNT ENGRKG AT PRIORITY 3, STARTED ON PRINTER _TCN1C$LPA0: ON 4-DEC-1986 13:42 FROM QUEUE SYS$PRINT.

AAAAAAAAAA 5555555555555555555555555 DIGITAL EQUIPMENT CORPORATION - VAX/VMS VERSION V4.4 5555555555555555555555555 AAAAAAAAAA

```
      SUBROUTINE CHNINP(CHNID,GRDSNP)
C
C$*   ALLINIEG
C
C                        ****************
C                        *              *
C     SUBSYSTEM CHX      *  2632 CHNINP *
C                        *              *
C                        ****************
C
C     ***********************************************************
C     ***********************************************************
C     **                                                       **
C     **  (C) COPYRIGHT V-R INFORMATION SYSTEMS, INC. 1984     **
C     **  LICENSED MATERIAL -- PROGRAM PROPERTY OF VRIS        **
C     **  ALL RIGHTS RESERVED                                  **
C     **                                                       **
C     **  THIS PROGRAM IS THE PROPERTY OF VRIS AND IS FURNISHED **
C     **  PURSUANT TO A WRITTEN LICENSE AGREEMENT. IT MAY NOT BE **
C     **  USED, REPRODUCED, OR DISCLOSED TO OTHERS EXCEPT IN   **
C     **  ACCORDANCE WITH THE TERMS AND CONDITIONS OF THAT     **
C     **  AGREEMENT.                                           **
C     **                                                       **
C     ***********************************************************
C     ***********************************************************
C
C     ***********************************************************
C     *                  MODULE DOCUMENTATION                   *
C     ***********************************************************
C
C     SUMMARY --
C
C     THIS MODULE IS THE INPUT INTERFACE BETWEEN THE CHANNEL
C     EXPANSION SUBSYSTEM (CHX) AND THE TRACK ASSIGNMENT
C     SUBSYSTEM (TRK). IT IS INVOKED BY TRK TO SET UP GLOBAL
C     DATA TO BE USED FOR ROUTING THE SPECIFIED CHANNEL *CHNID*.
C
C     DATA PASSED TO TRK (VIA NAMED COMMON /CHXXXX/) INCLUDES:
C             - CHANNEL COORDINATES
C             - LAYER ASSIGNMENT FOR PRE-DEFINED CONNECTIONS
C             - LOCATIONS OF TERMINALS WITHIN THE CHANNEL
C               TO BE ROUTED (NORMAL TERMINALS, INCOMING
C               FUTURE TERMINALS, AND OUTGOING FUTURE TERMINALS)
C             - LOCATIONS OF NODES AND THEIR PAD CODES
C             - LOCATIONS OF THE ENDPOINTS OF FEEDTHRUS
C               AND THEIR PAD CODES
C             - LOCATIONS AND SIZES OF DEVICE ASSOCIATED BARRIERS
C             - LOCATIONS AND SIZES OF BARRIERS TO PROTECT
C               CELLS AND CHANNEL INTERSECTIONS PROTRUDING
C               INTO THE CURRENT CHANNEL
C             - LOCATIONS OF VIAS IN NEIGHBORING CHANNELS.
C
C     NOTE: WHEN THE CHANNELS ARE ORIGINALLY DEFINED, NO
C     ----  CELLS PROTRUDE INTO THE CHANNELS. HOWEVER, IF
C           THE CELLS ALONG A CHANNEL ARE OF DIFFERENT
C           HEIGHTS, THE CHANNEL DEFINITION IS TEMPORARILY
C           MODIFIED SO THAT THE "WELLS" CAN BE USED FOR
C           TRACK ASSIGNMENT. WHEN THIS IS DONE, SOME OF
C           THE CELLS WILL PROTRUDE PARTIALLY INTO THE CHANNELS.
C
C     FORMAL PARAMETERS --
C     NAME   DIMENSION TYPE   IN/OUT   DESCRIPTION
C     ----   --------- ----   ------   -----------
C     CHNID            INT     IN      INDEX NUMBER OF CHANNEL
C                                      FOR WHICH TRACK ASSIGNMENT
C                                      DATA IS TO BE SET UP.
C
C     GRDSNP           INT     IN      SNAP-TO-GRID FLAG.
C                                      0 = NO SNAP-TO-GRID
C                                      1 = SNAP-TO-GRID
C
C     LOCAL VARIABLES --
C     NAME   DIMENSION TYPE   DESCRIPTION
C     ----   --------- ----   -----------
C     ACELL                   CELL NUMBER.
C
C     ACHN                    CHANNEL NUMBER.
C
C     ACHORN                  ORIENTATION OF CURRENT CHANNEL.
```

```
C       FIX            INDEX INTO BARRIER TABLE *LVBDAT*.
C
C       BRCNT          NUMBER OF DEV-BARRIERS ASSOCIATED
C                      WITH THE CURRENT CELL.
C
C       BSTOP          POINTER TO LAST DEV-BARRIER FOR CELL.
C
C       BSTRT          POINTER TO FIRST DEV-BARRIER FOR CELL.
C
C       CCNT           NUMBER OF PRE DEFINED CONNECTIONS IN
C                      THE CURRENT CHANNEL.
C
C       CHHIAB         VARIABLE USED TO ACCESS THE HI ABSCISSA
C                      FIELD (IN *CHNDAT*) OF A GIVEN CHANNEL.
C
C       CHHIOR         VARIABLE USED TO ACCESS THE HI ORDINATE
C                      FIELD (IN *CHNDAT*) OF A GIVEN CHANNEL.
C
C       CHLOAB         VARIABLE USED TO ACCESS THE LO ABSCISSA
C                      FIELD (IN *CHNDAT*) OF A GIVEN CHANNEL.
C
C       CHLOOR         VARIABLE USED TO ACCESS THE LO ABSCISSA
C                      FIELD (IN *CHNDAT*) OF A GIVEN CHANNEL.
C
C       CLHIAB         VARIABLE USED TO ACCESS THE HI ABSCISSA
C                      FIELD (IN *CELDAT*) OF A GIVEN CELL.
C
C       CLHIOR         VARIABLE USED TO ACCESS THE HI ORDINATE
C                      FIELD (IN *CELDAT*) OF A GIVEN CELL.
C
C       CLLFCH         INDEX IN *CELDAT* TO THE CHANNEL TO
C                      THE LEFT OF THE CURRENT CELL.
C
C       CLLOAB         VARIABLE USED TO ACCESS THE LO ABSCISSA
C                      FIELD (IN *CELDAT*) OF A GIVEN CELL.
C
C       CLLOOR         VARIABLE USED TO ACCESS THE LO ABSCISSA
C                      FIELD (IN *CELDAT*) OF A GIVEN CELL.
C
C       CLRFAB         VARIABLE USED TO ACCESS THE REFERENCE
C                      ABSCISSA FIELD (IN *CELDAT*) OF A
C                      GIVEN CELL.
C
C       CLRFOR         VARIABLE USED TO ACCESS THE REFERENCE
C                      ORDINATE FIELD (IN *CELDAT*) OF A
C                      GIVEN CELL.
C
C       CLRGCH         INDEX IN *CELDAT* OF THE CHANNEL TO THE
C                      RIGHT OF THE CURRENT CELL.
C
C       CNIX           INDEX IN *CONDAT* OF A PRE-DEFINED
C                      CONNECTION WITHIN THE CURRENT CHANNEL.
C
C       CYCLNM         NUMBER OF THE CHANNEL AT THE OTHER END
C                      OF THE CYCLE (IF 0, NOT A CYCLE END).
C                      THE LOW END OF THE LAST CHANNEL IN THE
C                      CYCLE FEEDS THE FIRST CHANNEL OF THE
C                      CYCLE.
C
C       DBHIAB         VARIABLE USED TO ACCESS THE HI ABSCISSA
C                      FIELD (IN *DVBDAT*) OF A GIVEN BARRIER.
C
C       DBHIOR         VARIABLE USED TO ACCESS THE HI ORDINATE
C                      FIELD (IN *DVBDAT*) OF A GIVEN BARRIER.
C
C       DBLOAB         VARIABLE USED TO ACCESS THE LO ABSCISSA
C                      FIELD (IN *DVBDAT*) OF A GIVEN BARRIER.
C
C       DBLOOR         VARIABLE USED TO ACCESS THE LO ABSCISSA
C                      FIELD (IN *DVBDAT*) OF A GIVEN BARRIER.
C
C       F1RFAB         VARIABLE USED TO ACCESS THE REFERENCE
C                      ABSCISSA FIELD (IN *RFDDAT*) OF THE
C                      FIRST ENDPOINT OF A FEEDTHRU.
C
C       F1RFOR         VARIABLE USED TO ACCESS THE REFERENCE
C                      ORDINATE FIELD (IN *RFDDAT*) OF THE
C                      FIRST ENDPOINT OF A FEEDTHRU.
C
C       F2RFAB         VARIABLE USED TO ACCESS THE REFERENCE
C                      ABSCISSA FIELD (IN *RFDDAT*) OF THE
C                      SECOND ENDPOINT OF A FEEDTHRU.
C
```

```
C
C       F2REFR          VARIABLE USED TO ACCESS THE REFERENCE
C                       ORDINATE FIELD (IN *FFDDAT*) OF THE
C                       SECOND ENDPOINT OF A FEEDTHRU.
C
C       FCNT            NUMBER OF FEEDTHRUS ON A GIVEN CELL.
C
C       FDIX            INDEX TO A FEEDTHRU IN *FFDDAT*.
C
C       HCHN            ID NUMBER OF CHANNEL FEEDING INTO THE
C                       HI SIDE OF THE CURRENT CHANNEL.
C
C       HCHORN          ORIENTATION OF *HCHN*.
C
C       HCIX            INDEX (INTO *CHCDAT*) OF A CHAN FEEDING
C                       INTO THE HI SIDE OF THE CURRENT CHANNEL.
C
C       HCNT            NUMBER OF CHANNELS FEEDING INTO THE
C                       HI SIDE OF THE CURRENT CHANNEL.
C
C       HIABCL          HI ABSCISSA OF A CELL (ABSOLUTE).
C
C       HIGABS          HI ABSCISSA OF WELL-PROTECTION BARRIER.
C
C       HICRCL          HI ORDINATE OF A CELL (ABSOLUTE).
C
C       HICRBP          HI ORDINATE OF A DEVICE-ASSOCIATED
C                       BARRIER (ABSOLUTE).
C
C       HICRLC          HI ORDINATE OF A CHANNEL FEEDING INTO
C                       THE LO SIDE OF THE CURRENT CHANNEL.
C
C       HICRWL          HI ORDINATE OF WELL-PROTECTION BARRIER.
C
C       ICHN            INDEX OF CHANNEL FEEDING INTO ANOTHER
C                       CHANNEL
C
C       ICHORN          ORIENTATION OF *ICHN*
C
C       ICNT            NUMBER OF INCOMING FUTURE TERMINALS INTO
C                       A CHANNEL
C
C       ISTOP           POINTER TO LAST INCOMING FUTURE TERMINAL
C                       OF A CHANNEL
C
C       ISTRT           POINTER TO FIRST INCOMING FUTURE TERMINAL
C                       OF A CHANNEL
C
C       LCHN            ID NUMBER OF CHANNEL FEDING INTO THE
C                       LO SIDE OF THE CURRENT CHANNEL.
C
C       LCHORN          ORIENTATION OF *LCHN*.
C
C       LCIX            INDEX (INTO *CHCDAT*) OF A CHAN FEEDING
C                       INTO THE LO SIDE OF THE CURRENT CHANNEL.
C
C       LCNT            NUMBER OF CHANNELS FEEDING INTO THE
C                       LO SIDE OF THE CURRENT CHANNEL.
C
C       LOABCL          LO ABSCISSA OF A CELL (ABSOLUTE).
C
C       LOCRCL          LO ORDINATE OF A CELL (ABSOLUTE).
C
C       LOCRBP          LO ORDINATE OF A DEVICE-ASSOCIATED
C                       BARRIER (ABSOLUTE).
C
C       LOCRHC          LO ORDINATE OF A CHANNEL FEEDING INTO
C                       THE HI SIDE OF THE CURRENT CHANNEL.
C
C       LOCRWL          LO ORDINATE OF WELL-PROTECTION BARRIER.
C
C       NCNT            NUMBER OF NODES ON A CELL.
C
C       NDIX            INDEX INTO *NODDAT* OF A NODE.
C
C       NDRFAB          VARIABLE USED TO ACCESS THE REFERENCE
C                       ABSCISSA FIELD (IN *NODDAT*) OF A
C                       GIVEN NODE.
C
C       NDRFCR          VARIABLE USED TO ACCESS THE REFERENCE
C                       ORDINATE FIELD (IN *NODDAT*) OF A
C                       GIVEN NODE.
C
```

```
C
C       NXHICL              VARIABLE USED TO ACCESS THE FIELD
C                           (IN *CELDAT*) WHICH POINTS FROM ONE
C                           CELL TO THE NEXT CELL ALONG THE HI
C                           SIDE OF THE CURRENT CHANNEL.
C
C       NXLOCL              VARIABLE USED TO ACCESS THE FIELD
C                           (IN *CELDAT*) WHICH POINTS FROM ONE
C                           CELL TO THE NEXT CELL ALONG THE LO
C                           SIDE OF THE CURRENT CHANNEL.
C
C       OFFGRD              AMOUNT OFF GRID.
C
C       ROUTLY              LOWER LEFT ORDINATE OF ROUTABLE AREA.
C
C       STLP                POINTER TO THE LAST ITEM OF INTEREST.
C
C       STPT                POINTER TO THE FIRST ITEM OF INTEREST.
C
C       SVCELL              SAVED VALUE OF *ACELL* USED TO REFERENCE
C                           THE LAST CELL ALONG THE ROW.
C
C       TCNT                NUMBER OF "NORMAL" TERMINALS ON CELL.
C
C       TMCEL               CELL TO WHICH TERMINAL BELONGS.
C
C       TMIX                INDEX INTO *TRMDAT* OF A TERMINAL.
C
C       VCHAN               CHANNEL OF ORIGIN OF THE VIA PROTECTION
C                           TERMINAL.
C
C       VIAPTR              INDEX IN *VIADAT* TO THE CURRENT VIA
C                           PROTECTION TERMINAL ENTRY.
C
C       VIAREX              REFERENCE X OF THE VIA PROTECTION TERMINAL.
C
C       VIAREY              REFERENCE Y OF THE VIA PROTECTION TERMINAL.
C
C       YGRID               GRID SIZE IN THE ORIENTATION OF THE
C                           ORDINATES.
C
C
C       GLOBAL VARIABLES --
C       NAME  DIMENSION TYPE  DESCRIPTION
C       ----  --------- ----  -----------
C       (NONE)
C
C
C       REVISION HISTORY --
C            02-OCT-86 DDC SET *MNABCH/MXABCH* TO THE EXTENT OF THE
C                          CELLS ON THE LOW AND HIGH SIDES OF THE
C                          CHANNEL, INSTEAD OF THE ORIGINAL CHANNEL
C                          EXTENT.  (SAR 6066)
C            07-MAR-86 DDC REVERSED VIA PROTECTION TERMINALS.  (SAR 5607)
C            03-MAR-86 DDC ALLOWED COORDINATE VALUE OF *MININT* TO BE
C                          PASSED THROUGH FOR FUTURE TERMINALS.  (SAR 5590)
C            04-FEB-86 DDC CORRECTED COORDINATES OF VIA PROTECTION
C                          TERMINALS.  (SAR 5531)
C            14-JAN-86 TAF REPLACED ABSOLUTE DOGLEG AND FUTURE
C                          TERMINAL COORDINATES WITH RELATIVE
C                          COORDINATES.  (SAR 5500)
C            21-NOV-85 DDC REVISED ERROR CODES.  (SAR 5391)
C            20-NOV-85 DDC CORRECTED ERROR FORMATS.  (SAR 5372)
C            02-OCT-85 DDC FOR LARGE MACROS:
C                          ENHANCED MODELING OF CELLS (CHXPCP(5)).
C                          ENHANCED DEFINITION OF CHANNEL ORDINATES.
C                          ADDED WELL-PROTECTION BARRIERS AND SUPPORT
C                          FOR VIA PROTECTION TERMINALS.  (SAR 5199)
C            29-JUL-85 DDC CHECKED MODULE.
C            29-NOV-84 KRP WROTE MODULE.  (SAR 4856)
C
C       TESTING PLANS --
C            29-JUL-85 DDC COMPLETED UNIT TESTING.
C
C       ***********************************************************
C       *                   SUBSYSTEM TOKENS                      *
C       ***********************************************************
C
CS*     CLXTOKEN
```

```
C
C     ************************************************************
C     *                   VARIABLE DECLARATIONS                  *
C     ************************************************************
C
C     FORMAL PARAMETERS --
C     (NONE)
C
C     LOCAL VARIABLES --
C     (NONE)
C
C     SUBSYSTEM GLOBAL VARIABLES --
C
CS*   SUBSYSGLOBAL [CHX]
C
CS*   CHXABC
CS*   CHXCBL
CS*   CHXCBH
CS*   CHXLVB
CS*   CHXNLU
CS*   CHXRBC
CS*   CHXCBN
CS*   CHXCHC
CS*   CHXCCW
CS*   CHXIBM
C
CS*   CHXXXX
C
C
C     OTHER SUBSYSTEM VARIABLES --
C     (NONE)
C
C     SYSTEM GLOBAL VARIABLES --
C
CS*   SYSCOMMCN
C
C     ************************************************************
C     *                     DATA STATEMENTS                      *
C     ************************************************************
C
C     (NONE)
C
C     ************************************************************
C     *                   STATEMENT FUNCTIONS                    *
C     ************************************************************
C
C     LOCAL STATEMENT FUNCTIONS --
C     (NONE)
C
C     SUBSYSTEM STATEMENT FUNCTIONS --
C     (NONE)
C
C     OTHER SUBSYSTEM STATEMENT FUNCTIONS --
C     (NONE)
C
C     SYSTEM STATEMENT FUNCTIONS --
C
CS*   SFUNCHCST
C
C     ************************************************************
C     *                    EXECUTABLE CODE                       *
C     ************************************************************
C
CS*   MOLENTRY [CHX] [CHNINP] [2632] [08]
C
C     VALIDATE FORMAL PARAMETERS
CS*   BOUNDSCHK [CHNID] [1] [CHNCNT] [8000]
C
C     INITIALIZE COUNTS FOR TABLES
      XBABCT = 0
      XBCLCT = 0
      XIBMCT = 0
      XCUNCT = 0
      XLCCCT = 0
      XLCGCT = 0
      XVIACT = 0
C
C     INITIALIZE WIDTH BY WHICH CHANNEL IS EXPANDED
      DLEPCF = 0
```

```
C
C       CYCLE POINTER
        CYCLNM = CHNDAT(%%CHXCHNSPLTPT, CHNIL)
C
        ACHCPN = CHNDAT(%%CHXCHNORIENT, CHNIL)
        GO TO (1001, 1002), ACHCPN
C                H2     V1
C
 1001   CONTINUE
C       HERE IF CHANNEL TO BE ROUTED IS HORIZONTAL
        CLRFAB = %%CHXCELREFX
        CLRFCR = %%CHXCELREFY
        CLLCAB = %%CHXCELLLX
        CLHIAB = %%CHXCELURX
        CLLOCR = %%CHXCELLLY
        CLHICR = %%CHXCELURY
        CLLFCH = %%CHXCELLFTCH
        CLRGCH = %%CHXCELRGHCH
        CHLOAB = %%CHXCHNLLX
        CHHIAB = %%CHXCHNURX
        CHLOCR = %%CHXCHNLLY
        CHHICR = %%CHXCHNURY
        DBLOAB = %%CHXDVBLLX
        DBHIAB = %%CHXDVBURX
        DBLOCR = %%CHXDVBLLY
        DBHICR = %%CHXDVBURY
        NDRFAB = %%CHXNODREFX
        NDRFCR = %%CHXNODREFY
        F1RFAB = %%CHXRFDE1X
        F1RFCR = %%CHXRFDE1Y
        F2RFAB = %%CHXRFDE2X
        F2RFCR = %%CHXRFDE2Y
        NXHICL = %%CHXCELNXTRT
        NXLOCL = %%CHXCELNXTTP
        ROTDLY = CRRFLY
        YGRID  = CHRGDY
        GO TO 1100
C
 1002   CONTINUE
C       HERE IF CHANNEL TO BE ROUTED IS VERTICAL
        CLRFAB = %%CHXCELREFY
        CLRFCR = %%CHXCELREFX
        CLLCAB = %%CHXCELLLY
        CLHIAB = %%CHXCELURY
        CLLOCR = %%CHXCELLLX
        CLHICR = %%CHXCELURX
        CLLFCH = %%CHXCELBOTCH
        CLRGCH = %%CHXCELTOPCH
        CHLOAB = %%CHXCHNLLY
        CHHIAB = %%CHXCHNURY
        CHLOCR = %%CHXCHNLLX
        CHHICR = %%CHXCHNURX
        DBLOAB = %%CHXDVBLLY
        DBHIAB = %%CHXDVBURY
        DBLOCR = %%CHXDVBLLX
        DBHICR = %%CHXDVBURX
        NDRFAB = %%CHXNODREFY
        NDRFCR = %%CHXNODREFX
        F1RFAB = %%CHXRFDE1Y
        F1RFCR = %%CHXRFDE1X
        F2RFAB = %%CHXRFDE2Y
        F2RFCR = %%CHXRFDE2X
        NXHICL = %%CHXCELNXTLF
        NXLOCL = %%CHXCELNXTRG
        ROTDLY = CRRFLX
        YGRID  = CHRGDX
        GO TO 1100
C
 1100   CONTINUE
C
C       ********************************************
C       * MODIFY CHANNEL WIDTH AND HEIGHT FOR "WELLS" *
C       ********************************************
C       SET *MNABCH/ MXABCH* EQUAL TO THE LEFTMOST AND
C       RIGHTMOST BODY EXTENT OF THE CELLS ALONG BOTH THE
C       LOW AND HIGH SIDES OF THE CHANNEL.  ALSO SCAN CELLS
C       ALONG THE LO SIDE OF THE CHANNEL, SETTING *MNURCH*
C       TO THE MAXIMUM HIGH ORDINATE OF THE LO SIDE CELLS
C       AND SETTING *LOURCH* TO THE MINIMUM HIGH ORDINATE
C       OF THE LO SIDE CELLS.
C
        MXABCH = CHNDAT(CHLOAB, CHNID)
```

```
              MNABCH = CHNDAT(CHHIAB, CHNID)
CS*           TRACE2WHEN [3] [MNABCH] [MNABCH] [MXABCH] [MXABCH]
              MNLCCH = MININT
              LOLOCH = CHNDAT(CHLOCR, CHNID)
              ACELL  = CHNDAT(%%CHXCHNLLCLP1, CHNID)
              SVCELL = 0
              IF (ACELL .EQ. 0) THEN
                MNABCH = CHNDAT(CHLLCR, CHNID)
              ELSE
                MNABCH = CELDAT(CLREAB, ACELL) + CELDAT(CLLOAB, ACELL)
              ENDIF
CS*           TRACE2WHEN [4] [ACELL] [ACELL] [SVCELL] [SVCELL]
CS*           TRACE1WHEN [4] [MNABCH] [MNABCH]
 1110         CONTINUE
              IF (ACELL .EQ. 0) GO TO 1200
              HICRCL = CELDAT(CLRECR, ACELL) + CELDAT(CLHICR, ACELL)
CS*           TRACE1WHEN [4] [HICRCL] [HICRCL]
              IF (HICRCL .GT. MNCRCH) MNCRCH = HICRCL
              IF (HICRCL .LT. LLCRCH) LLCRCH = HICRCL
CS*           TRACE2WHEN [4] [MNCRCH] [MNCRCH] [LLCRCH] [LLCRCH]
              SVCELL = ACELL
              ACELL = CELDAT(NXLOCL, ACELL)
              GO TO 1110
 1200         CONTINUE
CS*           TRACE2WHEN [4] [ACELL] [ACELL] [SVCELL] [SVCELL]
C             SET *MXABCH* TO HIGH SIDE OF LAST CELL
              IF (SVCELL .NE. 0)
     1          MXABCH = CELDAT(CLREAB, SVCELL) + CELDAT(CLHIAB, SVCELL)
CS*           TRACE1WHEN [3] [MXABCH] [MXABCH]
C
C             SCAN CELLS ALONG THE HI SIDE OF THE CHANNEL AND
C             ADJUST THE HIGHER ORDINATE OF THE CHANNEL TO BE
C             AT OR ABOVE THE LOW ORDINATE OF THE CELL.
              MXLRCH = MAXINT
              HICRCH = CHNDAT(CHHICR, CHNID)
              ACELL  = CHNDAT(%%CHXCHNHICLP1, CHNID)
              IF (ACELL .EQ. 0) THEN
                MXLRCH = CHNDAT(CHHICR, CHNID)
              ELSE
C               SET *MNABCH* TO THE LOW SIDE OF THE FIRST CELL
                LOABCL = CELDAT(CLREAB, ACELL) + CELDAT(CLLOAB, ACELL)
                MNABCH = VISMN2(MNABCH, LOABCL)
              ENDIF
CS*           TRACE1WHEN [4] [ACELL] [ACELL]
CS*           TRACE2WHEN [4] [LOABCL] [LOABCL] [MNABCH] [MNABCH]
 1210         CONTINUE
              IF (ACELL .EQ. 0) GO TO 1300
              LOCRCL = CELDAT(CLRECR, ACELL) + CELDAT(CLLOCR, ACELL)
              IF (LOCRCL .LT. MXLRCH) MXLRCH = LOCRCL
              IF (LOCRCL .GT. HICRCH) HICRCH = LOCRCL
              SVCELL = ACELL
              ACELL = CELDAT(NXHICL, ACELL)
              GO TO 1210
C
 1300         CONTINUE
              IF (SVCELL .NE. 0) THEN
                HIABCL = CELDAT(CLREAB, SVCELL) + CELDAT(CLHIAB, SVCELL)
                MXABCH = VISMX2(HIABCL, MXABCH)
              ENDIF
CS*           TRACE1WHEN [4] [SVCELL] [SVCELL]
CS*           TRACE2WHEN [4] [HIABCL] [HIABCL] [MXABCH] [MXABCH]
              IF (MNABCH .EQ. CHNDAT(CHHIAB, CHNID))
     1          MNABCH = CHNDAT(CHLCAB, CHNID)
              IF (MXABCH .EQ. CHNDAT(CHLCAB, CHNID))
     1          MXABCH = CHNDAT(CHHIAB, CHNID)
CS*           TRACE2WHEN [4] [MNABCH] [MNABCH] [MXABCH] [MXABCH]
C
C             ************************************************
C             * WELL-PROTECTION AND DEVICE-ASSOCIATED BARRIERS *
C             ************************************************
C             SINCE THE CHANNEL HEIGHT WAS JUST ADJUSTED, THE CHANNEL
C             NOW OVERLAPS SOME CELLS AND THEIR NEIGHBORING CHANNELS.
C             THEREFORE, BARRIERS NEED TO BE CREATED BETWEEN EACH OF THE
C             CELLS AND THEIR LEFT AND RIGHT CHANNELS TO PROTECT TERMINALS
C             INTO THESE CHANNELS FROM BEING BLOCKED IN THE MODIFIED
C             CHANNEL, AND BARRIERS NEED TO BE CREATED BETWEEN THE OUTSIDE
C             EDGE OF THE CELL TO THE OUTSIDE OF THE EXPANDED CHANNEL.
C             ALSO DETERMINE COORDINATES OF ALL DEVICE-ASSOCIATED BARRIERS.
C
CS*           TRACE1WHEN [3] [LOCRCH] [LOCRCH]
C             CREATE BARRIERS FOR LO SIDE CELLS
              ACELL  = CHNDAT(%%CHXCHNLCCLP1, CHNID)
```



0 273 261

```
CS*       TRACE1PPER [3] [LOCELL] [ACELL]
 1310     CONTINUE
          IF (ACELL .EQ. 0) GC TO 1400
          LOABCL = CELDAT(CLREAB, ACELL) + CELDAT(CLLOAB, ACELL)
          HIABCL = CELDAT(CLREAB, ACELL) + CELDAT(CLHIAB, ACELL)
          LOCRCL = CELDAT(CLRECR, ACELL) + CELDAT(CLLOCR, ACELL)
          HICRCL = CELDAT(CLRECR, ACELL) + CELDAT(CLHICR, ACELL)
CS*       TRACE2PPER [4] [LOABCL] [LOABCL] [HIABCL] [HIABCL]
CS*       TRACE2PPER [4] [LOCRCL] [LOCRCL] [HICRCL] [HICRCL]
C
C         CREATE ALL LAYER BARRIER OVER WELLS TO THE LEFT
C         AND RIGHT OF *ACELL*.
          LOCRWL = LOCRCL
          IF (LOCRCH .LT. LOCRWL)  LOCRWL = LOCRCH
          DO 1320 I = 1, 2
          ACHN = CELDAT(CLLECH, ACELL)
          IF (I .EQ. 2)  ACHN = CELDAT(CLRGCH, ACELL)
CS*       TRACE1PPER [4] [ACHN] [ACHN]
          HICRWL = 0
          IF (ACHN .GT. 0)  THEN
C           IF ACHN FEEDS CHNID:
            HICRWL = CHNDAT(CHHICR, ACHN)
C           IF CHNID FEEDS ACHN:
            IF (ACHN .EQ. CHCINN)  THEN
              IF ((ACHN .LT. CHNID) .AND. (HICRCL .LT. HICRWL))
     1          HICRWL = HICRCL
            ELSE
              IF ((ACHN .GT. CHNID) .AND. (HICRCL .LT. HICRWL))
     1          HICRWL = HICRCL
            ENDIF
          ENDIF
CS*       TRACE1PPER [4] [HICRWL] [HICRWL]
C
          IF (HICRWL .GT. LOCRCH)  THEN
C           LEFT SIDE OF CELL
            LOWABS = CHNDAT(CHHIAB, ACHN)
            HIGABS = LOABCL
            IF (I .EQ. 2)  THEN
C             RIGHT SIDE OF CELL
              LOWABS = HIABCL
              HIGABS = CHNDAT(CHLOAB, ACHN)
            ENDIF
CS*         TRACE2PPER [4] [LOWABS] [LOWABS] [HIGABS] [HIGABS]
            IF (LOWABS .LT. HIGABS)  THEN
C             HERE NEED TO CREATE ALL-LAYER BARRIER OVER WELL.
              XBARCT = XBARCT + 1
              IF (XBARCT .GT. XBARMX) GO TO 8010
CS*           TRACE1PPER [4] [LOCRPR] [XBARCT]
              BARXXX(1, XBARCT) = LOWABS
              BARXXX(2, XBARCT) = LOCRWL
              BARXXX(3, XBARCT) = HIGABS
              BARXXX(4, XBARCT) = HICRWL
              BARXXX(5, XBARCT) = 0
            ENDIF
          ENDIF
 1320     CONTINUE
C
          IF (CHXPOF(5) .EQ. 0)  THEN
C           THE CELL IS TO BE MODELED AS AN ALL-LAYER
C           BARRIER OVER THE BODY EXTENT OF THE CELL.
C           EXTEND THE BARRIER TO BOTTOM OF THE
C           WIDENED CHANNEL.
            IF  (HICRCL .GT. LOCRCH)  THEN
C             HERE NEED TO CREATE ALL-LAYER BARRIER OVER *ACELL*
              XBARCT = XBARCT + 1
              IF (XBARCT .GT. XBARMX) GO TO 8010
              BARXXX(1, XBARCT) = LOABCL
              BARXXX(2, XBARCT) = LOCRCH
              BARXXX(3, XBARCT) = HIABCL
              BARXXX(4, XBARCT) = HICRCL
              BARXXX(5, XBARCT) = 0
            ENDIF
          ELSE
            IF (LOCRCL .GT. LOCRCH)  THEN
C             CREATE ALL LAYER BARRIER BETWEEN BOTTOM OF CELL
C             AND BOTTOM OF CHANNEL.
              XBARCT = XBARCT + 1
              IF (XBARCT .GT. XBARMX) GO TO 8010
CS*           TRACE1PPER [4] [LOCRCH] [XBARCT]
              BARXXX(1, XBARCT) = LOABCL
              BARXXX(2, XBARCT) = LOCRCH
              BARXXX(3, XBARCT) = HIABCL
```

```
                HARXXX(4, XPARCT) = LOCRCL
                HARXXX(5, XPARCT) = 0
            ENDIF
          ENDIF
C
C         NOW THE DEVICE-ASSOCIATED BARRIERS FOR *ACELL*
          BRCNT = CELDAT(%%CHXCELLVPC1, ACELL)
          IF (BRCNT .EQ. 0) GO TO 1390
          BSTRT = CELDAT(%%CHXCELDVPPT, ACELL)
          BSTOP = BSTRT + BRCNT - 1
C
          DO 1360 BIX = BSTRT, BSTOP
C         IF CHXPCF(5) SPECIFIES MODELING OF ALL-LAYER
C         BARRIER OVER THE BODY EXTENT OF THE CELL, THEN
C         NO NEED TO CREATE BARRIER FOR TRK IF THIS
C         DEV-BARRIER IS COMPLETELY COVERED BY CELL.
          HICRDB = CELDAT(CLRFOR, ACELL) + DVBDAT(DBHIOR, BIX)
          IF ((CHXPCF(5) .EQ. 0) .AND. (HICRDB .LE. HICRCL))
     1          GO TO 1360
          XPARCT = XPARCT + 1
          IF (XPARCT .GT. XBARMX) GO TO 8010
          BARXXX(1, XPARCT) = CELDAT(CLRFAB, ACELL) +
     1                        DVBDAT(DBLOAB, BIX)
          BARXXX(2, XPARCT) = CELDAT(CLRFOR, ACELL) +
     1                        DVBDAT(DBLOOR, BIX)
          BARXXX(3, XPARCT) = CELDAT(CLRFAB, ACELL) +
     1                        DVBDAT(DBHIAB, BIX)
          BARXXX(4, XPARCT) = CELDAT(CLRFOR, ACELL) +
     1                        DVBDAT(DBHIOR, BIX)
          BARXXX(5, XPARCT) = DVBDAT(%%CHXDVBLYP, BIX)
 1360     CONTINUE
C
 1390     CONTINUE
C         PROCESS NEXT CELL ON LO SIDE OF CHANNEL
          ACELL = CELDAT(NXLOCL, ACELL)
          GO TO 1310
C
C
 1400     CONTINUE
CS*       TRACE1WHEN [3] [HICRCH] [HICRCH]
C         CREATE BARRIERS FOR HI SIDE CELLS
          ACELL  = CHNDAT(%%CHXCHNFICLPT, CHNID)
CS*       TRACE1WHEN [3] [HICELL] [ACELL]
 1410     CONTINUE
          IF (ACELL .EQ. 0) GO TO 1500
          LOABCL = CELDAT(CLRFAB, ACELL) + CELDAT(CLLOAB, ACELL)
          HIABCL = CELDAT(CLRFAB, ACELL) + CELDAT(CLHIAB, ACELL)
          LOORCL = CELDAT(CLRFOR, ACELL) + CELDAT(CLLOOR, ACELL)
          HIORCL = CELDAT(CLRFOR, ACELL) + CELDAT(CLHIOR, ACELL)
CS*       TRACE2WHEN [4] [LOABCL] [LOABCL] [HIABCL] [HIABCL]
CS*       TRACE2WHEN [4] [LOORCL] [LOORCL] [HIORCL] [HIORCL]
C
C         CREATE ALL LAYER BARRIER OVER WELLS TO THE LEFT
C         AND RIGHT OF *ACELL*.
          DO 1420 I = 1, 2
          ACHN = CELDAT(CLLFCH, ACELL)
          IF (I .EQ. 2)  ACHN = CELDAT(CLRGCH, ACELL)
CS*       TRACE1WHEN [4] [ACHN] [ACHN]
          LOORWL = MAXINT
          IF (ACHN .GT. 0)  THEN
C           IF ACHN FEEDS CHNID:
            LOORWL = CHNDAT(CHLOOR, ACHN)
C           IF CHNID FEEDS ACHN:
            IF (ACHN .EQ. CYCLNM)  THEN
              IF ((ACHN .LT. CHNID) .AND. (LOORCL .GT. LOORWL))
     1          LOORWL = LOORCL
            ELSE
              IF ((ACHN .GT. CHNID) .AND. (LOORCL .GT. LOORWL))
     1          LOORWL = LOORCL
            ENDIF
          ENDIF
CS*       TRACE1WHEN [4] [LOORWL] [LOORWL]
C
          IF (LOORWL .LT. HIORCH)  THEN
C           LEFT WELL
            LOWAPS = CHNDAT(CHHIAB, ACHN)
            HIGAPS = CELDAT(CLRFAB, ACELL) + CELDAT(CLLOAB, ACELL)
            IF (I .EQ. 2)  THEN
C             RIGHT WELL
              LOWAPS = CELDAT(CLRFAB, ACELL) + CELDAT(CLHIAB, ACELL)
              HIGAPS = CHNDAT(CHLOAB, ACHN)
            ENDIF
```

```
CS*           TRACE2WHEN [4] [LOWABS] [LOHABS] [HIGABS] [HIGABS]
              IF (LOWABS .LT. HIGABS) THEN
C               HERE NEED TO CREATE ALL-LAYER BARRIER OVER WELL.
                XBARCT = XBARCT + 1
                IF (XBARCT .GT. XBARMX) GO TO 8010
CS*             TRACE1WHEN [4] [HICHBR] [XBARCT]
                BARXXX(1, XBARCT) = LOWABS
                BARXXX(2, XBARCT) = LOCRAL
                BARXXX(3, XBARCT) = HIGABS
                BARXXX(4, XBARCT) = HICRCH
                BARXXX(5, XBARCT) = 0
              ENDIF
            ENDIF
  1420      CONTINUE
C
            IF (CHXECE(5) .EQ. 0) THEN
C             THE CELL IS TO BE MODELED AS AN ALL-LAYER
C             BARRIER OVER THE BODY EXTENT OF THE CELL.
C             EXTEND THE BARRIER TO TOP OF THE WIDENED
C             CHANNEL.
              IF (LOCRCL .LT. HICRCH) THEN
C               NEED TO CREATE ALL-LAYER BARRIER OVER *ACELL*
                XBARCT = XBARCT + 1
                IF (XBARCT .GT. XBARMX) GO TO 8010
                BARXXX(1, XBARCT) = LLABCL
                BARXXX(2, XBARCT) = LOCRCL
                BARXXX(3, XBARCT) = HIABCL
                BARXXX(4, XBARCT) = HICRCH
                BARXXX(5, XBARCT) = 0
              ENDIF
            ELSE
              IF (HICRCL .LT. HICRCH) THEN
C               CREATE ALL LAYER BARRIER BETWEEN TOP OF CELL
C               AND TOP OF CHANNEL.
                XBARCT = XBARCT + 1
                IF (XBARCT .GT. XBARMX) GO TO 8010
CS*             TRACE1WHEN [4] [HICHBR] [XBARCT]
                BARXXX(1, XBARCT) = LLABCL
                BARXXX(2, XBARCT) = HICRCL
                BARXXX(3, XBARCT) = HIABCL
                BARXXX(4, XBARCT) = HICRCH
                BARXXX(5, XBARCT) = 0
              ENDIF
            ENDIF
C
C           NOW THE DEVICE-ASSOCIATED BARRIERS FOR *ACELL*
            BRCNT = CELDAT(%%CHXCELDVBCT, ACELL)
            IF (BRCNT .EQ. 0) GO TO 1490
            BSTRT = CELDAT(%%CHXCELDVBPT, ACELL)
            BSTOP = BSTRT + BRCNT - 1
C
            DO 1460 BIX = BSTRT, BSTOP
C             IF CHXECE(5) SPECIFIES MODELING OF ALL-LAYER
C             BARRIER OVER THE BODY EXTENT OF THE CELL, THEN
C             NO NEED TO CREATE BARRIER FOR IRK IF THIS
C             DEV-BARRIER IS COMPLETELY COVERED BY CELL.
              LOCRDB = CELDAT(CLRFCR, ACELL) + DVBDAT(DBLOCR, BIX)
              IF ((CHXECE(5) .EQ. 0) .AND. (LOCRDB .GE. LOCRCL))
     1          GO TO 1460
              XBARCT = XBARCT + 1
              IF (XBARCT .GT. XBARMX) GO TO 8010
              BARXXX(1, XBARCT) = CELDAT(CLRFAB, ACELL) +
     1                            DVBDAT(DBLOAB, BIX)
              BARXXX(2, XBARCT) = CELDAT(CLRFCR, ACELL) +
     1                            DVBDAT(DBLOCR, BIX)
              BARXXX(3, XBARCT) = CELDAT(CLRFAB, ACELL) +
     1                            DVBDAT(DBHIAB, BIX)
              BARXXX(4, XBARCT) = CELDAT(CLRFCR, ACELL) +
     1                            DVBDAT(DBHICR, BIX)
              BARXXX(5, XBARCT) = DVBDAT(%%CHXDVBLYR, BIX)
  1460      CONTINUE
C
  1490      CONTINUE
C           PROCESS NEXT CELL ON LO SIDE OF CHANNEL
            ACELL = CELDAT(NXHICL, ACELL)
            GO TO 1410
C
  1500      CONTINUE
C           ****************************************
C           * FEED-IN CHANNEL PROTECTION BARRIERS *
C           ****************************************
```

```
C         NOW CREATE BARRIERS TO PROTECT CHANNELS FEEDING INTO
C         THE CURRENT CHANNEL *CHNID*. THESE ARE REQUIRED BECAUSE
C         THE CHANNEL HEIGHT WAS MODIFIED AND COULD NOW OVERLAP
C         THE CHANNELS FEEDING INTO *CHNID*.
C
C         MODIFY MNCRCH AND MXCRCH BY THE FEED-IN CHANNELS.
C
C         CREATE BARRIERS FOR LO SIDE FEED-IN CHANNELS
          LCNT = CHNDAT(%%CHXCHNLOCHCI, CHNID)
          IF (LCNT .LE. 0) GO TO 1600
          STRT = CHNDAT(%%CHXCHNLOCHPT, CHNID)
          STOP = STRT + LCNT - 1
C
          DO 1550 LCIX = STRT, STOP
          LCHN   = CHCDAT(LCIX)
          LCHORN = CHNDAT(%%CHXCHNORIENT, LCHN)
          IF (LCHORN .EQ. ACHORN) GO TO 1550
          HICRLC = CHNDAT(CHHICR, LCHN)
          IF (HICRLC .LE. LOCRCH) GO TO 1550
          IF (HICRLC .GT. MNCRCH)  MNCRCH = HICRLC
C
C         HERE NEED TO CREATE ALL-LAYER BARRIER OVER PORTION
C         OF *LCHN* OVERLAPPING THE CURRENT CHANNEL.
          XBARCT = XBARCT + 1
          IF (XBARCT .GT. XBARMX) GO TO 8010
          BARXXX(1, XBARCT) = CHNDAT(CHLOAB, LCHN)
          BARXXX(2, XBARCT) = LOCRCH
          BARXXX(3, XBARCT) = CHNDAT(CHHIAB, LCHN)
          BARXXX(4, XBARCT) = HICRLC
          BARXXX(5, XBARCT) = 0
 1550     CONTINUE
C
 1600     CONTINUE
C         CREATE BARRIERS FOR HI SIDE FEED-IN CHANNELS
          HCNT = CHNDAT(%%CHXCHNHICHCI, CHNID)
          IF (HCNT .LE. 0) GO TO 2000
          STRT = CHNDAT(%%CHXCHNHICHPT, CHNID)
          STOP = STRT + HCNT - 1
C
          DO 1650 HCIX = STRT, STOP
          HCHN   = CHCDAT(HCIX)
          HCHORN = CHNDAT(%%CHXCHNORIENT, HCHN)
          IF (HCHORN .EQ. ACHORN) GO TO 1650
          LOCRHC = CHNDAT(CHLOCR, HCHN)
          IF (LOCRHC .GE. HICRCH) GO TO 1650
          IF (LOCRHC .LT. MXCRCH)  MXCRCH = LOCRHC
C
C         HERE NEED TO CREATE ALL-LAYER BARRIER OVER PORTION
C         OF *HCHN* OVERLAPPING THE CURRENT CHANNEL.
          XBARCT = XBARCT + 1
          IF (XBARCT .GT. XBARMX) GO TO 8010
          BARXXX(1, XBARCT) = CHNDAT(CHLOAB, HCHN)
          BARXXX(2, XBARCT) = LOCRHC
          BARXXX(3, XBARCT) = CHNDAT(CHHIAB, HCHN)
          BARXXX(4, XBARCT) = HICRCH
          BARXXX(5, XBARCT) = 0
 1650     CONTINUE
C
 2000     CONTINUE
C
          IF (CRISNF .NE. 0)  THEN
C           SET MNCRCH ON GRID AT OR ABOVE CURRENT VALUE.
            OFFGRD = VISMOD( MNCRCH-RCTLLY, YGRID)
            IF (OFFGRD .GT. 0)
     1        MNCRCH = MNCRCH + (YGRID - OFFGRD)
CS* TRACE1WHEN [3] [CHNID] [CHNID]
CS* TRACE2WHEN [3] [CHLOCR] [CHNDAT(CHLOCR,CHNID)] [MNCRCH] [MNCRCH]
C           SET MXCRCH ON GRID AT OR BELOW CURRENT VALUE
            OFFGRD = VISMOD( MXCRCH-RCTLLY, YGRID)
            MXCRCH = MXCRCH - OFFGRD
          ENDIF
CS* TRACE2WHEN [3] [CHHICR] [CHNDAT(CHHICR,CHNID)] [MXCRCH] [MXCRCH]
C
C         ****************************************
C         * NODE AND FEEDTHRU ENDPOINT LOCATIONS *
C         ****************************************
C         FIND NODE LOCATIONS FOR ALL CELLS ALONG CURRENT
C         CHANNEL *CHNID*. THE NODE LOCATIONS, TOGETHER WITH
C         THEIR PAD-CODES, ARE USED BY THE TO CREATE NODE
C         PROTECTION BARRIERS WITHIN THE CHANNEL AS NEEDED.
C         ALSO FIND LOCATIONS OF ALL FEEDTHRUS ALONG CURRENT
C         CHANNEL. THE PAD-CODES AT THE ENDPOINTS OF THE
```

```
C       FEEDTHRUS WILL BE TREATED AS NODES WITHIN TRK.
C
C       LO SIDE CELLS
        ACELL = CHNDAT(%%CHXCHNLOCLPT, CHNIL)
 2010   CONTINUE
        IF (ACELL .EQ. 0) GO TO 2100
C
C       NODE LOCATIONS ON LO SIDE CELLS
        NCNT = CELDAT(%%CHXCELNODCT, ACELL)
        IF (NCNT .LE. 0) GO TO 2025
        STRT = CELDAT(%%CHXCELNODPT, ACELL)
        STOP = STRT + NCNT - 1
C
        DO 2020 NDIX = STRT, STOP
        XNODCT = XNODCT + 1
        IF (XNODCT .GT. XNODMX) GO TO 8020
        NODXXX(1, XNODCT) = CELDAT(CLRFAB, ACELL) +
     1                      NODDAT(NDRFAB, NDIX)
        NODXXX(2, XNODCT) = CELDAT(CLRFOR, ACELL) +
     1                      NODDAT(NDRFOR, NDIX)
        NODXXX(3, XNODCT) = NODDAT(%%CHXNODLYR, NDIX)
        NODXXX(4, XNODCT) = NODDAT(%%CHXNODPAD, NDIX)
        NODXXX(5, XNODCT) = NODDAT(%%CHXNODNET, NDIX)
 2020   CONTINUE
C
 2025   CONTINUE
C       FEEDTHRU ENDPOINT LOCATIONS ON LO SIDE CELLS.
C       DO NOT INCLUDE ENDPOINTS WHICH DO NOT HAVE PADS.
        FCNT = CELDAT(%%CHXCELRFDCT, ACELL)
        IF (FCNT .LE. 0) GO TO 2080
        STRT = CELDAT(%%CHXCELRFDPT, ACELL)
        STOP = STRT + FCNT - 1
C
        DO 2050 FDIX = STRT, STOP
C
C       FIRST ENDPOINT OF FEEDTHRU
        IF (RFDDAT(%%CHXRFDE1P, FDIX) .LE. 0) GO TO 2035
        XNODCT = XNODCT + 1
        IF (XNODCT .GT. XNODMX) GO TO 8020
        NODXXX(1, XNODCT) = CELDAT(CLRFAB, ACELL) +
     1                      RFDDAT(F1RFAB, FDIX)
        NODXXX(2, XNODCT) = CELDAT(CLRFOR, ACELL) +
     1                      RFDDAT(F1RFOR, FDIX)
        NODXXX(3, XNODCT) = RFDDAT(%%CHXRFDE12, FDIX)
        NODXXX(4, XNODCT) = RFDDAT(%%CHXRFDE1P, FDIX)
        NODXXX(5, XNODCT) = RFDDAT(%%CHXRFDNET, FDIX)
CS* TRACE2WHEN [4] [XNODCT] [XNODCT] [FDIX] [FDIX]
CS* TRACE1WHEN [4] [NODNET] [NODXXX(5, XNODCT)]
 2035   CONTINUE
C       SECOND ENDPOINT OF FEEDTHRU
        IF (RFDDAT(%%CHXRFDE2P, FDIX) .LE. 0) GO TO 2045
        XNODCT = XNODCT + 1
        IF (XNODCT .GT. XNODMX) GO TO 8020
        NODXXX(1, XNODCT) = CELDAT(CLRFAB, ACELL) +
     1                      RFDDAT(F2RFAB, FDIX)
        NODXXX(2, XNODCT) = CELDAT(CLRFOR, ACELL) +
     1                      RFDDAT(F2RFOR, FDIX)
        NODXXX(3, XNODCT) = RFDDAT(%%CHXRFDE22, FDIX)
        NODXXX(4, XNODCT) = RFDDAT(%%CHXRFDE2P, FDIX)
        NODXXX(5, XNODCT) = RFDDAT(%%CHXRFDNET, FDIX)
 2045   CONTINUE
C
 2050   CONTINUE
C
 2080   CONTINUE
        ACELL = CELDAT(NXLOCL, ACELL)
        GO TO 2010
C
 2100   CONTINUE
C       HI SIDE CELLS
        ACELL = CHNDAT(%%CHXCHNHICLPT, CHNIL)
 2110   CONTINUE
        IF (ACELL .EQ. 0) GO TO 2500
C
C       NODE LOCATIONS ON HI SIDE CELLS
        NCNT = CELDAT(%%CHXCELNODCT, ACELL)
        IF (NCNT .LE. 0) GO TO 2125
        STRT = CELDAT(%%CHXCELNODPT, ACELL)
        STOP = STRT + NCNT - 1
C
        DO 2120 NDIX = STRT, STOP
        XNODCT = XNODCT + 1
```

```
      IF (XNODCT .GT. XNODMX) GO TO 8020
      NODXXX(1, XNODCT) = CELDAT(CLRFAB, ACELL) +
     1                    NODDAT(NDRFAB, NDIX)
      NODXXX(2, XNODCT) = CELDAT(CLRFCR, ACELL) +
     1                    NODDAT(NDRFCR, NDIX)
      NODXXX(3, XNODCT) = NODDAT(%%CHXNODLYR, NDIX)
      NODXXX(4, XNODCT) = NODDAT(%%CHXNODPAD, NDIX)
      NODXXX(5, XNODCT) = NODDAT(%%CHXNODNET, NDIX)
 2120 CONTINUE
C
 2125 CONTINUE
C     FEEDTHRU ENDPOINT LOCATIONS ON HI SIDE CELLS.
C     DO NOT INCLUDE ENDPOINTS WHICH DO NOT HAVE PADS.
      FCNT = CELDAT(%%CHXCELREDCT, ACELL)
      IF (FCNT .LE. 0) GO TO 2180
      STRT = CELDAT(%%CHXCELREDPT, ACELL)
      STOP = STRT + FCNT - 1
C
      DO 2150 FDIX = STRT, STOP
C
C     FIRST ENDPOINT OF FEEDTHRU
      IF (REDDAT(%%CHXRFDF1P, FDIX) .LE. 0) GO TO 2135
      XNODCT = XNODCT + 1
      IF (XNODCT .GT. XNODMX) GO TO 8020
      NODXXX(1, XNODCT) = CELDAT(CLRFAB, ACELL) +
     1                    REDDAT(F1RFAB, FDIX)
      NODXXX(2, XNODCT) = CELDAT(CLRFCR, ACELL) +
     1                    REDDAT(F1RFCR, FDIX)
      NODXXX(3, XNODCT) = REDDAT(%%CHXRFDE1Z, FDIX)
      NODXXX(4, XNODCT) = REDDAT(%%CHXRFDE1P, FDIX)
      NODXXX(5, XNODCT) = REDDAT(%%CHXRFDNET, FDIX)
 2135 CONTINUE
C     SECOND ENDPOINT OF FEEDTHRU
      IF (REDDAT(%%CHXRFDE2P, FDIX) .LE. 0) GO TO 2145
      XNODCT = XNODCT + 1
      IF (XNODCT .GT. XNODMX) GO TO 8020
      NODXXX(1, XNODCT) = CELDAT(CLRFAB, ACELL) +
     1                    REDDAT(F2RFAB, FDIX)
      NODXXX(2, XNODCT) = CELDAT(CLRFCR, ACELL) +
     1                    REDDAT(F2RFCR, FDIX)
      NODXXX(3, XNODCT) = REDDAT(%%CHXRFDE2Z, FDIX)
      NODXXX(4, XNODCT) = REDDAT(%%CHXRFDE2P, FDIX)
      NODXXX(5, XNODCT) = REDDAT(%%CHXRFDNET, FDIX)
 2145 CONTINUE
C
 2150 CONTINUE
C
 2180 CONTINUE
      ACELL = CELDAT(NXHICL, ACELL)
      GO TO 2110
C
 2500 CONTINUE
C     ****************************
C     * VIA PROTECTION TERMINALS *
C     ****************************
      VIAPTR = CHNDAT(%%CHXCHNVIAPTR, CHNID)
 2510 CONTINUE
      IF (VIAPTR .LE. 0) GO TO 3000
      IF (XVIACT .GE. XVIAMX) GO TO 8050
      XVIACT = XVIACT + 1
      VCHAN = VIADAT(%%CHXVIACHN, VIAPTR)
      VIARFX = VIADAT(%%CHXVIARFX, VIAPTR) +
     1         CHNDAT(%%CHXCHNLLX, VCHAN)
      VIARFY = VIADAT(%%CHXVIARFY, VIAPTR) +
     1         CHNDAT(%%CHXCHNLLY, VCHAN)
      IF (ACHORN .EQ. 1) THEN
        VIAXXX(1, XVIACT) = VIARFX
        VIAXXX(2, XVIACT) = VIARFY
      ELSE
        VIAXXX(1, XVIACT) = VIARFY
        VIAXXX(2, XVIACT) = VIARFX
      ENDIF
      VIAXXX(3, XVIACT) = VIADAT(%%CHXVIANET, VIAPTR)
      VIAXXX(4, XVIACT) = VCHAN
      VIAPTR = VIADAT(%%CHXVIANXT, VIAPTR)
      GO TO 2510
C
 3000 CONTINUE
C     **********************
C     * TERMINAL LOCATIONS *
C     **********************
C     SAVE THE FIRST TWO POSITIONS IN THE TERMINAL
```

```
C        BUFFER (*TRMXXX*) FOR USE AS SENTRIES BY *TRK*
         XTRMCT = 2
C
C        STORE LOCATIONS OF THE INCOMING FUTURE TERMINALS
         DO 3350 SIDE = 1, 2
         IF (SIDE .EQ. 1) THEN
C           CHECK CHANNELS FEEDING *CHNID* FROM THE LOW SIDE
            ICNT = CHNDAT(%%CHXCHNHICHCT, CHNID)
            ISTRT = CHNDAT(%%CHXCHNHICHPT, CHNID)
         ELSE
C           CHECK CHANNELS FEEDING *CHNID* FROM THE HIGH SIDE
            ICNT = CHNDAT(%%CHXCHNHICHCT, CHNID)
            ISTRT = CHNDAT(%%CHXCHNHICHPT, CHNID)
         ENDIF
         IF (ICNT .LE. 0) GO TO 3350
C
         ISTOP = ISTRT + ICNT - 1
         DO 3300 IX = ISTRT, ISTOP
         ICHN   = CHCDAT(IX)
         ICHORN = CHNDAT(%%CHXCHNORIENT, ICHN)
C        FIND ALL OUTGOING FUTURE TERMINALS FROM *ICHN*
C        WHICH FEED INTO *CHNID*
         ICNT = CHNDAT(%%CHXCHNOFTMCT, ICHN)
         IF (ICNT .LE. 0) GO TO 3300
         ISTRT = CHNDAT(%%CHXCHNOFTMPT, ICHN)
         ISTOP = ISTRT + ICNT - 1
         DO 3250 TMIX = ISTRT, ISTOP
         IF (TRMDAT(%%CHXTRMCH2, TMIX) .EQ. CHNID) THEN
C           HERE IF OUTGOING FUTURE TERMINAL OF *ICHN* IS
C           AN INCOMING FUTURE TERMINAL TO *CHNID*
            XTRMCT = XTRMCT + 1
            IF (XTRMCT .GT. XTRMMX) GO TO 8040
            IF (ICHORN .EQ. ACHORN) THEN
               TRMXXX(01, XTRMCT) = TRMDAT(%%CHXTRMABS, TMIX)
               IF(TRMDAT(%%CHXTRMABS, TMIX) .NE. MININT)
     1            TRMXXX(01, XTRMCT) = CHNDAT(CHLOAB, ICHN) +
     2                                 TRMDAT(%%CHXTRMABS, TMIX)
               TRMXXX(02, XTRMCT) = TRMDAT(%%CHXTRMORD, TMIX)
               IF (TRMDAT(%%CHXTRMORD, TMIX) .NE. MININT)
     1            TRMXXX(02, XTRMCT) = CHNDAT(CHLOCH, ICHN) +
     2                                 TRMDAT(%%CHXTRMORD, TMIX)
            ELSE
               TRMXXX(01, XTRMCT) = TRMDAT(%%CHXTRMORD, TMIX)
               IF (TRMDAT(%%CHXTRMORD, TMIX) .NE. MININT)
     1            TRMXXX(01, XTRMCT) = CHNDAT(CHLOAB, ICHN) +
     2                                 TRMDAT(%%CHXTRMORD, TMIX)
               TRMXXX(02, XTRMCT) = TRMDAT(%%CHXTRMABS, TMIX)
               IF(TRMDAT(%%CHXTRMABS, TMIX) .NE. MININT)
     1            TRMXXX(02, XTRMCT) = CHNDAT(CHLOCH, ICHN) +
     2                                 TRMDAT(%%CHXTRMABS, TMIX)
            ENDIF
            TRMXXX(03, XTRMCT) = TRMDAT(%%CHXTRMLYR, TMIX)
            TRMXXX(04, XTRMCT) = TRMDAT(%%CHXTRMNE1, TMIX)
            TRMXXX(05, XTRMCT) = TRMDAT(%%CHXTRMCN2, TMIX)
            TRMXXX(06, XTRMCT) = -ICHN
            TRMXXX(07, XTRMCT) = TRMDAT(%%CHXTRMCON, TMIX)
            TRMXXX(08, XTRMCT) = 0
            TRMXXX(09, XTRMCT) = 0
            TRMXXX(10, XTRMCT) = 0
            TRMXXX(11, XTRMCT) = 0
         ENDIF
 3250    CONTINUE
 3300    CONTINUE
C
 3350    CONTINUE
C        STORE LOCATIONS OF THE OUTGOING FUTURE TERMINALS
         ICNT = CHNDAT(%%CHXCHNOFTMCT, CHNID)
         IF (ICNT .LE. 0) GO TO 3450
         STRT = CHNDAT(%%CHXCHNOFTMPT, CHNID)
         STOP = STRT + ICNT - 1
CS*  TRACE2WHEN [4] [START] [STRT] [STOP] [STOP]
C
         DO 3400 TMIX = STRT, STOP
         XTRMCT = XTRMCT + 1
         IF (XTRMCT .GT. XTRMMX) GO TO 8040
CS*  TRACE2WHEN [4] [TMIX] [TMIX] [XTRMCT] [XTRMCT]
C
C        CHECK FOR SPECIAL FLAG OF IRS-ROUTED P/G CONNECTION
C        IE. THE TRMCH2 FIELD EQUALS CHNID
         IF (TRMDAT(%%CHXTRMCH2, TMIX) .EQ. CHNID) THEN
C           HERE IF IRS-ROUTED P/G NET ... CHANGE COORDINATES
C           NOTE: IN THIS CASE OF AN AUTOMATICALLY ROUTED
```

```
C                 B/C SET BY TRS, THE ABSCISSA WILL ALWAYS
C                 BE THE Y-COORDINATE AND THE ORDINATE THE
C                 X-COORDINATE.
            IF (CHNID .EQ. RIGCHN) THEN
               TRMDAT($$CHXTRMABS, TMIX) = TOPMDY +
     1                   CELDAT($$CHXCELREY, TOPCEL) -
     2                   CHNDAT($$CHXCHNLLY, CHNID )
               TRMDAT($$CHXTRMORD, TMIX) = TOPMDX +
     1                   CELDAT($$CHXCELREX, TOPCEL) -
     2                   CHNDAT($$CHXCHNLLX, CHNID )
            ENDIF
            IF (CHNID .EQ. LEFCHN) THEN
               TRMDAT($$CHXTRMABS, TMIX) = BOTMDY +
     1                   CELDAT($$CHXCELREY, BOTCEL) -
     2                   CHNDAT($$CHXCHNLLY, CHNID )
               TRMDAT($$CHXTRMORD, TMIX) = BOTMDX +
     1                   CELDAT($$CHXCELREX, BOTCEL) -
     2                   CHNDAT($$CHXCHNLLX, CHNID )
            ENDIF
         ENDIF
         TRMXXX(01, XTRMCT) = CHNDAT(CHLOAB, CHNID) +
     1                        TRMDAT($$CHXTRMABS, TMIX)
         TRMXXX(02, XTRMCT) = CHNDAT(CHLOCR, CHNID) +
     1                        TRMDAT($$CHXTRMORD, TMIX)
         TRMXXX(03, XTRMCT) = TRMDAT($$CHXTRMLYR, TMIX)
         TRMXXX(04, XTRMCT) = TRMDAT($$CHXTRMNET, TMIX)
         TRMXXX(05, XTRMCT) = TRMDAT($$CHXTRMCON, TMIX)
         TRMXXX(06, XTRMCT) = TRMDAT($$CHXTRMCH2, TMIX)
         TRMXXX(07, XTRMCT) = TRMDAT($$CHXTRMCN2, TMIX)
         TRMXXX(08, XTRMCT) = TRMDAT($$CHXTRMDLG, TMIX)
         TRMXXX(09, XTRMCT) = 0
         TRMXXX(10, XTRMCT) = 0
         TRMXXX(11, XTRMCT) = 0
 3400    CONTINUE
C
 3450    CONTINUE
C        UPDATE THE LOCATIONS OF NORMAL TERMINALS
C        BASED ON THE LOCATIONS OF THEIR CORRESPONDING CELLS.
         TCNT = CHNDAT($$CHXCHNCLINCT, CHNID)
         IF (TCNT .LE. 0) GO TO 4000
         STRT = CHNDAT($$CHXCHNCLINPT, CHNID)
         STOP = STRT + TCNT - 1
CS* TRACE2WHEN [4] [START] [STRT] [STOP] [STOP]
C
         DO 3500 TMIX = STRT, STOP
         TMCEL = TRMDAT($$CHXTRMCEL, TMIX)
         IF (TMCEL .LE. 0) GO TO 8030
         XTRMCT = XTRMCT + 1
         IF (XTRMCT .GT. XTRMMX) GO TO 8040
CS* TRACE2WHEN [4] [TMIX] [TMIX] [XTRMCT] [XTRMCT]
         TRMXXX(01, XTRMCT) = CELDAT(CLREAB, TMCEL) +
     1                        TRMDAT($$CHXTRMABS, TMIX)
         TRMXXX(02, XTRMCT) = CELDAT(CLRECR, TMCEL) +
     1                        TRMDAT($$CHXTRMORD, TMIX)
         TRMXXX(03, XTRMCT) = TRMDAT($$CHXTRMLYR, TMIX)
         TRMXXX(04, XTRMCT) = TRMDAT($$CHXTRMNET, TMIX)
         TRMXXX(05, XTRMCT) = TRMDAT($$CHXTRMCON, TMIX)
         TRMXXX(06, XTRMCT) = TRMDAT($$CHXTRMCH2, TMIX)
         TRMXXX(07, XTRMCT) = TRMDAT($$CHXTRMCN2, TMIX)
         TRMXXX(08, XTRMCT) = TRMDAT($$CHXTRMDLG, TMIX)
         TRMXXX(09, XTRMCT) = 0
         TRMXXX(10, XTRMCT) = 0
         TRMXXX(11, XTRMCT) = 0
 3500    CONTINUE
C
 4000    CONTINUE
C        ********************************
C        * CONNECTION LAYER ASSIGNMENT *
C        ********************************
C        NOW PASS THE LAYER ASSIGNMENTS FOR PRE-DEFINED CONNECTIONS
         CCNT = CHNDAT($$CHXCHNCONCT, CHNID)
CS* TRACE2WHEN [3] [CHNID] [CHNID] [CCNT] [CCNT]
         IF (CCNT .LE. 0) GO TO 5000
         STRT = CHNDAT($$CHXCHNCONPT, CHNID)
         STOP = STRT + CCNT - 1
C
         DO 4010 CNIX = STRT, STOP
         XCONCT = XCONCT + 1
         CONXXX(1, XCONCT) = CONDAT($$CHXCONORD, CNIX) +
     1                       CHNDAT(CHLOCR, CHNID)
         CONXXX(2, XCONCT) = CONDAT($$CHXCONLYR, CNIX)
         CONXXX(3, XCONCT) = CONDAT($$CHXCONNET, CNIX)
```

```
CS*  TRACF2NPFR  [4]  [XCOCI] [XCONCT] [CONCRD] [CONXXX(1,XCONCT)]
CS*  TRACF2NPFR  [4]  [CLNTYP] [CONXXX(2,XCONCI)];
                      [CONNET] [CONXXY(3,XCONCI)]
 4010     CONTINUE
C
 5000     CONTINUE
C         ************
C         * ALL CLEAR *
C         ************
C         ADJUST CHANNEL COORDINATES.
          CHNCAT(CHFLOR, CHNID) = MNLRCH
          CHNCAT(CHFIGH, CHNID) = MXRCH
          GC TO 9000
C         ****************************************************************
C         *                        ERROR RETURNS                         *
C         ****************************************************************
C
 8000     CONTINUE
C/        CHX - CHANNEL IDENTIFICATION NUMBER FOR WHICH SETUP IS
C/              TO BE PERFORMED IS NOT A VALID CHANNEL.
C/        **FM(1X,'CHANNEL ID = ',I6,6X,'NO. OF CHANNELS = ',I6)
          CALL VISERR(MCDNBR, 8263201, CHNID, CHNCNT)
          GC TO 9000
 8010     CONTINUE
C/        CHX - TOO MANY BARRIERS ENCOUNTERED DURING SETUP
C/              PRIOR TO TRACK ASSIGNMENT FOR SPECIFIED CHANNEL.
C/        **FM(' BARRIER LIMIT =',I7,6X,'CHANNEL =',I7)
          CALL VISERR(MCDNBR, 8263202, XBARMX, CHNID)
          GC TO 9000
 8020     CONTINUE
C/        CHX - TOO MANY NODES ENCOUNTERED DURING SETUP
C/              PRIOR TO TRACK ASSIGNMENT FOR SPECIFIED CHANNEL.
C/        **FM(1X,'NODE LIMIT = ',I6,6X,'CHANNEL = ',I6)
          CALL VISERR(MCDNBR, 8263203, XNODMX, CHNID)
          GC TO 9000
 8030     CONTINUE
C/        CHX - DURING SETUP PRIOR TO TRACK ASSIGNMENT FOR SPECIFIED
C/              CHANNEL, A "NORMAL" TERMINAL WAS FOUND TO BELONG TO
C/              AN ILLEGAL CELL. POSSIBLE ERROR IN ROUTINE *WIRLOD*
C/              OR *TRMLOD*.
C/        **FM(' TERMINAL INDEX = ',I6,1X,'IN CHANNEL ',I6)
          CALL VISERR(MCDNBR, 8263204, TMIX, CHNID)
          GC TO 9000
 8040     CONTINUE
C/        CHX - TOO MANY TERMINALS ENCOUNTERED DURING SETUP
C/              PRIOR TO TRACK ASSIGNMENT FOR SPECIFIED CHANNEL.
C/        **FM(1X,'TERMINAL LIMIT = ',I6,6X,'CHANNEL = ',I6)
          CALL VISERR(MCDNBR, 8263205, XTRMMX, CHNID)
          GC TO 9000
 8050     CONTINUE
C/        CHX - TOO MANY VIA PROJECTION TERMINALS ENCOUNTERED
C/              DURING SETUP PRIOR TO TRACK ASSIGNMENT FOR CHANNEL.
C/        **FM(1X,'TERMINAL LIMIT = ',I6,6X,'CHANNEL = ',I6)
          CALL VISERR(MCDNBR, 8263206, XVIAMX, CHNID)
C
C
C
C         ****************************************************************
C         *                 SINGLE EXIT FROM THIS ROUTINE                *
C         ****************************************************************
C
 9000     CONTINUE
          IF (CHXPLE(11) .EQ. MCDNBR)  CALL CHXDMP(999)
CS*       MLEXIT [CFX]
          RETURN
C
C
C         ****************************************************************
C         *                      FORMAT STATEMENTS                       *
C         ****************************************************************
C
C         (NONE)
C
C
C         END CHNINF 2632
          END
```

DIGITAL EQUIPMENT CORPORATION - VAX/VMS VERSION V4.4

KMP

S2633

FOR

;3

```
FILE _$1$DUA6:[PPD.CHX02]S2633.FOR;3 (2416,1,1), LAST REVISED ON 21-OCT-1986 08:44, IS A 43 BLOCK SEQUENTIAL FILE OWNED BY UIC
[PPDIST,PPC]. THE RECORDS ARE VARIABLE LENGTH WITH IMPLIED (CR) CARRIAGE CONTROL. THE LONGEST RECORD IS 72 BYTES.

JOB S2633 (215) QUEUED TO SYS$PRINT ON 4-DEC-1986 12:51 BY USER KMP, UIC [ENGVLST,KMP], UNDER ACCOUNT ENGPKG AT PRIORITY 100,
STARTED ON PRINTER _TCN10$LPA0: ON 4-DEC-1986 13:15 FROM QUEUE SYS$PRINT.
```

DIGITAL EQUIPMENT CORPORATION - VAX/VMS VERSION V4.4

VAX/VMS VAX/VMS VAX/VMS VAX/VMS VAX/VMS VAX/VMS VAX/VMS VAX/VMS VAX/VMS VAX/VMS VAX/VMS VAX/VMS

```
   VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
   VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS

KKKKKKKKKK   0000000000000000000000000000000000000000000000000000000000000000000000000000000000000000   KKKKKKKKKK
KKKKKKKKKK   00000000000000000000000  DIGITAL EQUIPMENT CORPORATION - VAX/VMS VERSION V4.4  000000000000000000000   KKKKKKKKKK
KKKKKKKKKK   0000000000000000000000000000000000000000000000000000000000000000000000000000000000000000   KKKKKKKKKK

                 K    K   M    M  PPPP
                 K   K    MM  MM  P   P
                 K  K     M MM M  P   P
                 KKK      M    M  PPPP
                 K  K     M    M  P
                 K   K    M    M  P
                 K    K   M    M  P

      SSSSSSSS    222222      666666      333333      333333
      SSSSSSSS    222222      666666      333333      333333
    SS          22      22  66          33      33  33      33
    SS          22      22  66          33      33  33      33
    SS                  22  66                  33          33
    SS                  22  66                  33          33
      SSSSSS          22    66666666        3333        3333
      SSSSSS          22    66666666        3333        3333
            SS      22      66      66          33          33
            SS      22      66      66          33          33
            SS    22        66      66  33      33  33      33
            SS    22        66      66  33      33  33      33
    SSSSSSSS    2222222222    666666      333333      333333
    SSSSSSSS    2222222222    666666      333333      333333

                 FFFFFFFFFF    OOOOOO    RRRRRRRR
                 FFFFFFFFFF    OOOOOO    RRRRRRRR
                 FF          OO      OO  RR      RR
                 FF          OO      OO  RR      RR
                 FF          OO      OO  RR      RR
                 FF          OO      OO  RR      RR
                 FFFFFFFF    OO      OO  RRRRRRRR
                 FFFFFFFF    OO      OO  RRRRRRRR
                 FF          OO      OO  RR  RR
                 FF          OO      OO  RR  RR
         ::::    FF          OO      OO  RR    RR
         ::::    FF          OO      OO  RR    RR
         ::::    FF            OOOOOO    RR      RR
         ::::    FF            OOOOOO    RR      RR

                   ::::    333333
                   ::::    333333
                   ::::  33      33
                   ::::  33      33
                                 33
                                 33
                   ::::        33
                   ::::        33
                   ::::          33
                   ::::          33
                     ::  33      33
                     ::  33      33
                   ::      333333
                   ::      333333
```

FILE _$1$DUA6:[PRE.CPX021S2633.FOR;3 (2416,1,1), LAST REVISED ON 21-OCT-1986 08:44, IS A 43 BLOCK SEQUENTIAL FILE OWNED BY UIC [PRDIST,PPCI]. THE RECORDS ARE VARIABLE LENGTH WITH IMPLIED (CR) CARRIAGE CONTROL. THE LONGEST RECORD IS 72 BYTES.

JOB S2633 (215) QUEUED TO SYS$PRINT ON 4-DEC-1986 12:51 BY USER KMP, UIC [ENGVLST,KMP], UNDER ACCOUNT ENGRG AT PRIORITY 100, STARTED ON PRINTER _TCN10$LPA0: ON 4-DEC-1986 13:15 FROM QUEUE SYS$PRINT.

```
KKKKKKKKKK   0000000000000000000000000000000000000000000000000000000000000000000000000000000000000000   KKKKKKKKKK
KKKKKKKKKK   00000000000000000000000  DIGITAL EQUIPMENT CORPORATION - VAX/VMS VERSION V4.4  000000000000000000000   KKKKKKKKKK
KKKKKKKKKK   0000000000000000000000000000000000000000000000000000000000000000000000000000000000000000   KKKKKKKKKK
```

14112 S.S.

```
      SUBROUTINE CHNOUT(CHNID)
C
CS*   ALLINTEG
C
C                     ****************
C                     *              *
C     SUBSYSTEM CFX   *  2633 CHNOUT *
C                     *              *
C                     ****************
C
C     ***************************************************************
C     ***************************************************************
C     **                                                           **
C     **  (C) COPYRIGHT V-R INFORMATION SYSTEMS, INC. 1984         **
C     **  LICENSED MATERIAL -- PROGRAM PROPERTY OF VRIS            **
C     **  ALL RIGHTS RESERVED                                      **
C     **                                                           **
C     **  THIS PROGRAM IS THE PROPERTY OF VRIS AND IS FURNISHED    **
C     **  PURSUANT TO A WRITTEN LICENSE AGREEMENT. IT MAY NOT BE   **
C     **  USED, REPRODUCED, OR DISCLOSED TO OTHERS EXCEPT IN       **
C     **  ACCORDANCE WITH THE TERMS AND CONDITIONS OF THAT         **
C     **  AGREEMENT.                                               **
C     **                                                           **
C     ***************************************************************
C     ***************************************************************
C
C
C     ***************************************************************
C     *                 MODULE DOCUMENTATION                        *
C     ***************************************************************
C
C     SUMMARY --
C
C     THIS MODULE IS THE OUTPUT INTERFACE BETWEEN THE TRACK ASSIGNMENT
C     AND CHANNEL EXPANSION SUBSYSTEMS AND IS INVOKED BY TRK AFTER IT
C     HAS COMPLETED TRACK ASSIGNMENT ON CHANNEL *CHNID*.
C
C     TRACK ASSIGNMENT DATA IS PASSED TO THIS ROUTINE VIA NAMED
C     COMMON /CFXXXX/. THIS DATA IS SAVED BACK IN THE CFX GLOBAL
C     DATA STRUCTURES WHILE THE ACTUAL EXPANSION OF THE CHANNEL
C     IS PERFORMED BY INVOKING ROUTINE CHNXPN-2634.  *DLORCH*
C     SPECIFIES THE AMOUNT BY WHICH CHANNEL *CHNID* WAS EXPANDED.
C
C     FORMAL PARAMETERS --
C     NAME  DIMENSION TYPE   IN/OUT   DESCRIPTION
C     ----  --------- ----   ------   -----------
C     CHNID            INT     IN     IDENTIFICATION NUMBER OF CHANNEL
C                                     ROUTED BY TRK.
C
C     LOCAL VARIABLES --
C     NAME  DIMENSION TYPE   DESCRIPTION
C     ----  --------- ----   -----------
C     ACHORN                 ORIENTATION OF A GIVEN CHANNEL.
C
C     ACNCT                  NUMBER OF PRE-WIRED CONNECTIONS
C                            WITHIN THE CURRENT CHANNEL.
C
C     ACNIX                  INDEX OF A PRE-WIRED CONNECTION
C                            IN THE *CONDAT* ARRAY.
C
C     ACNPT                  POINTER TO THE FIRST PRE-WIRED
C                            CONNECTION WITHIN THE CURRENT CHANNEL.
C
C     ATMCT                  NUMBER OF TERMINALS IN *TRMDAT* ARRAY
C                            FOR THE CURRENT CHANNEL.
C
C     ATMIX                  INDEX OF A NON-DOGLEG TERMINAL
C                            IN THE *TRMDAT* ARRAY.
C
C     ATMPT                  POINTER TO THE FIRST NON-DOGLEG
C                            TERMINAL IN THE CURRENT CHANNEL.
C
C     AVIA                   POINTER TO CURRENT VIA PROJECTION
C                            ENTRY IN *VIAXXX*.
C
C     CHNIAP                 POINTER TO UPPER ABSCISSA FOR A
C                            GIVEN CHANNEL.
C
C     CHLOAP                 POINTER TO LOWER ABSCISSA FOR A
C                            GIVEN CHANNEL.
```

```
C
C       CHLCCP              POINTER TO LOWER ORDINATE FOR A
C                           GIVEN CHANNEL.
C
C       DSTOP               POINTER TO THE LAST DOGLEG TERMINAL
C                           CREATED DURING TRACK ASSIGNMENT
C                           FOR THE CURRENT CHANNEL.
C
C       DSTPT               POINTER TO THE FIRST DOGLEG TERMINAL
C                           CREATED DURING TRACK ASSIGNMENT
C                           FOR THE CURRENT CHANNEL.
C
C       DTERM               INDEX OF A DOGLEG TERMINAL IN
C                           THE *TRMXXX* ARRAY.
C
C       FDCHAN              NUMBER OF THE CHANNEL FEEDING THE
C                           INCOMING FUTURE TERMINAL IN THIS
C                           CHANNEL.
C
C       FINCH2              SECOND CHANNEL NUMBER OF THE CURRENT
C                           OUTGOING FUTURE TERMINAL FROM *FDCHAN*.
C
C       FTACT               NUMBER OF OUTGOING FUTURE TERMINALS
C                           IN *FDCHAN*.
C
C       FTMIX               INDEX INTO *TRMDAT* OF THE CURRENT
C                           OUTGOING FUTURE TERMINAL OF *FDCHAN*.
C
C       FTMNET              NET OF THE CURRENT OUTGOING FUTURE
C                           TERMINAL OF *FDCHAN*.
C
C       FTMPT               POINTER TO THE FIRST OUTGOING FUTURE
C                           TERMINAL OF *FDCHAN* IN *TRMDAT* ARRAY.
C
C       FTMSTP              POINTER TO THE LAST OUTGOING FUTURE
C                           TERMINAL OF *FDCHAN* IN *TRMDAT* ARRAY.
C
C       TMCNT               NUMBER OF TERMINALS PROCESSED FROM
C                           *TRMXXX* ARRAY AND UPDATED IN
C                           *TRMDAT* ARRAY.
C
C       VCHAN               CHANNEL NUMBER OF THE VIA PROTECTION
C                           ENTRY
C
C       VIAPTR              POINTER TO *VIADAT* OF THE FIRST VIA
C                           PROTECTION ENTRY FOR *VCHAN*.
C
C       XCONN               INDEX OF A CONNECTION ROUTED BY TRK
C                           (INTO THE *CONXXX* ARRAY).
C
C       XTERM               DO-LOOP INDEX FOR CURRENT TERMINAL.
C
C       GLOBAL VARIABLES --
C       NAME  DIMENSION TYPE  DESCRIPTION
C       ----  --------- ----  -----------
C       (NONE)
C
C
C       REVISION HISTORY --
C          03-MAR-86 DDC ALLOWED COORDINATE VALUE OF MININT TO
C                        PASS THROUGH FOR FUTURE TERMINALS AND
C                        DOGLEG TERMINALS.  (SAR 5590)
C          14-JAN-86 TAF REPLACED ABSOLUTE DOGLEG AND FUTURE
C                        TERMINAL COORDINATES WITH RELATIVE
C                        COORDINATES.  (SAR 5500)
C          21-NOV-85 DDC REVISED ERROR CODES.  (SAR 5391)
C          20-NOV-85 DDC CORRECTED ERROR FORMAT.  (SAR 5372)
C          18-SEP-85 DDC ADDED SUPPORT FOR VIA PROTECTION
C                        TERMINALS.  MOVED UPDATE OF FUTURE
C                        TERMINALS FROM *CHNXEN*.  MOVED
C                        CALL TO *CHXCTR* TO *TRSDVR*.  (SAR 5199)
C          29-JUL-85 DDC CHECKED MODULE.
C          29-NOV-84 MMF WROTE MODULE.  (SAR 4856)
C
C       TESTING PLANS --
C          29-JUL-85 DDC COMPLETED UNIT TESTING.
C
C       ***************************************************************
C       *                     SUBSYSTEM TOKENS                        *
```

```
_S1SDUA6:[FED.CHX02]S2633.FOR;3                    21-OCT-1986 08:44                    PAGE 3
C        ************************************************************
C
CS*      CHXLCKEN
C
C        ************************************************************
C        *                    VARIABLE DECLARATIONS                 *
C        ************************************************************
C
C        FORMAL PARAMETERS --
C        (NONE)
C
C        LOCAL VARIABLES --
C        (NONE)
C
C        SUBSYSTEM GLOBAL VARIABLES --
C
CS*      SUBSYSCOMMAT [CHX]
C
CS*      CHXXXX
CS*      CHXCEL
CS*      CHXCHN
CS*      CHXCON
CS*      CHXTRM
CS*      CHXCHR
C
C        OTHER SUBSYSTEM VARIABLES --
C        (NONE)
C
C        SYSTEM GLOBAL VARIABLES --
C
CS*      SYSCOMMON
C
C
C        ************************************************************
C        *                      DATA STATEMENTS                     *
C        ************************************************************
C
C        (NONE)
C
C
C        ************************************************************
C        *                    STATEMENT FUNCTIONS                   *
C        ************************************************************
C
C        LOCAL STATEMENT FUNCTIONS --
C        (NONE)
C
C        SUBSYSTEM STATEMENT FUNCTIONS --
C        (NONE)
C
C        OTHER SUBSYSTEM STATEMENT FUNCTIONS --
C        (NONE)
C
C        SYSTEM STATEMENT FUNCTIONS --
C
CS*      SFUNCHCST
C
C
C        ************************************************************
C        *                      EXECUTABLE CODE                     *
C        ************************************************************
C
CS*      MODENTRY [CHX] [CHNOUT] [2633] [09]
C
C        VALIDATE FORMAL PARAMETERS
CS*      HOLALSCHK [CHNID] [1] [CHNCNT] [8000]
         IF (CHXFCE(11) .EQ. MODNBR)  CALL CHXDMP(999)
CS*      TRACE2WHEN [2] [CHNID] [CHNID] [XCONCT] [XCONCT]
CS*      TRACE2WHEN [2] [XTRMCT] [XTRMCT] [XDUGCT] [XDUGCT]
CS*      TRACE1WHEN [2] [XVIACT] [XVIACT]
C
         ACHORN = CHNLAT($$CHXCHNORIENT, CHNID)
         IF (ACHORN .EQ. 1) THEN
C           HORIZONTAL CHANNEL
            CHLCAF = $$CHXCHNLLX
            CHHIAF = $$CHXCHNURX
            CHLCCF = $$CHXCHNLLY
         ELSE
C           VERTICAL CHANNEL
            CHLCAF = $$CHXCHNLLY
            CHHIAF = $$CHXCHNURY
            CHLCCF = $$CHXCHNLLX
```

```
      ENDIF
C
C     STORE ADJUSTED ABSCISSAE IN *CHNDAT*
      CHNDAT(CHLLAB, CHNID) = MNARCH
      CHNDAT(CHRTAB, CHNID) = MXARCH
CS*   TRACE2WHEN [3] [MNARCH] [MNARCH] [MXARCH] [MXARCH]
C
C     ****************************
C     * TRANSFER CONNECTION DATA *
C     ****************************
C     FIRST NEED TO TRANSFER CONNECTION DATA FROM *CONXXX*
C     TO *CONDAT*. NOTE THAT CONNECTION ORDINATES ARE STORED
C     RELATIVE TO THE LOW ORDINATE OF THE CHANNEL *MNORCH*.
C     ALSO RECALL THAT ANY PRE-EXISTING CONNECTIONS FOR THIS
C     CHANNEL ARE ALREADY DEFINED IN *CONDAT* AND OTHER
C     CONNECTIONS ATTEMPTED BY TRK WILL BE STORED AT THE
C     END OF ARRAY *CONDAT*.
C
      ACNPT  = CHNDAT(%%CHXCHNCONNPT, CHNID)
      ACNCT  = CHNDAT(%%CHXCHNCONNCT, CHNID)
C
      IF (XCCNCT .EQ. 0)  GO TO 1110
      DO 1100 XCONN = 1, XCCNCT
      IF (XCONN .GT. ACNCT) GO TO 1050
C
C     HERE IF THIS CONNECTION REPRESENTS A PRE-DEFINED WIRE
C     NOTE: FAILED CONNECTIONS ARE ASSIGNED ORDINATE = MININT
C     ----
      ACNIX = ACNPT + XCONN - 1
      CONDAT(%%CHXCONORD, ACNIX) = MININT
      IF (CONXXX(1, XCONN) .EQ. MININT) GO TO 1010
C     HERE IF CONNECTION WAS ROUTED SUCCESSFULLY
      CONSUC = CONSUC + 1
      CONDAT(%%CHXCONORD, ACNIX) = CONXXX(1, XCONN) - MNORCH
 1010 CONTINUE
      CONDAT(%%CHXCONLYR, ACNIX) = CONXXX(2, XCONN)
      CONDAT(%%CHXCONNET, ACNIX) = CONXXX(3, XCONN)
      GO TO 1100
C
 1050 CONTINUE
C     HERE IF THIS IS NOT FOR A PRE-DEFINED WIRE.
C     NOTE: FAILED CONNECTIONS ARE ASSIGNED ORDINATE = MININT
C     ----
      CONCNT = CONCNT + 1
      IF (CONCNT .GT. CONMAX) GO TO 8010
      CONDAT(%%CHXCONCHN, CONCNT) = CHNID
      CONDAT(%%CHXCONNUM, CONCNT) = XCONN
      CONDAT(%%CHXCONTYP, CONCNT) = 0
      CONDAT(%%CHXCONNET, CONCNT) = CONXXX(3, XCONN)
      CONDAT(%%CHXCONLYR, CONCNT) = CONXXX(2, XCONN)
      CONDAT(%%CHXCONORD, CONCNT) = MININT
      IF (CONXXX(1, XCONN) .EQ. MININT) GO TO 1060
C     HERE IF CONNECTION WAS ROUTED SUCCESSFULLY
      CONSUC = CONSUC + 1
      CONDAT(%%CHXCONORD, CONCNT) = CONXXX(1, XCONN) - MNORCH
 1060 CONTINUE
      GO TO 1100
C
 1100 CONTINUE
 1110 CONTINUE
C
C     **************************
C     * TRANSFER TERMINAL DATA *
C     **************************
C     NOW NEED TO TRANSFER THE NEW ABSCISSAE AND ORDINATES
C     OF OUTGOING FUTURE TERMINALS FROM *TRMXXX*
C     TO *TRMDAT*. RECALL THAT TERMINALS CREATED FROM PRE-DEFINED
C     WIRES AND THOSE LOADED FROM THE *TERMINAL FILE* ARE ALREADY
C     STORED IN ARRAY *TRMDAT*. ANY NEW TERMINALS CREATED BY TRK
C     (I.E. DOGLEG TERMINALS) WILL BE ADDED AT THE END OF *TRMDAT*.
C
      ATMPT = CHNDAT(%%CHXCHNOFTMPT, CHNID)
C
      ATMCT = CHNDAT(%%CHXCHNOFTMCT, CHNID) +
     1        CHNDAT(%%CHXCHNOLTMCT, CHNID)
      TMCNT = 0
C
CS*   TRACE2WHEN [4] [ATMPT] [ATMPT] [ATMCT] [ATMCT]
      IF (ATMCT .EQ. 0)  GO TO 1210
      DO 1200 XTERM = 1, ATMCT
C
```

```
C         NOTE: RECALL THAT THE FIRST TWO ENTRIES IN *TRMXXX* ARE
C         ----  SENTRY TERMINALS USED BY TRK.
C
          IF (TRMCNT .EQ. ATMCT)  GO TO 1700
C
CS*       TRACE2WHEN [4] [TMCNT] [TMCNT] [XTERM] [XTERM]
C
          IF (TRMXXX(6, XTERM) .LT. 0)  THEN
C           INCOMING FUTURE TERMINAL (DENOTED BY A NEGATIVE CH2 FIELD):
C           DO NOT STORE INCOMING FUTURE TERMINALS IN THE *TRMDAT* ARRAY.
C           UPDATE THE SECOND CONNECTION NUMBER OF THE CORRESPONDING
C           OUTGOING FUTURE TERMINAL IN CASE THE CONNECTION HAS BEEN
C           DOGLEGGED.
            FDCHAN = -TRMXXX(6, XTERM)
            FTMPT  =  CHNDAT($$CHXCHNCFTMPT, FDCHAN)
            FTMCT  =  CHNDAT($$CHXCHNCFTMCT, FDCHAN)
            FTMSTP =  FTMPT + FTMCT - 1
            DO 1150  FTMIX = FTMPT, FTMSTP
            FTMCH2 = TRMDAT($$CHXTRMCH2, FTMIX)
            FTMNET = TRMDAT($$CHXTRMNET, FTMIX)
            IF ((FTMNET .EQ. TRMXXX(4, XTERM)) .AND.
     1          (FTMCH2 .EQ. CHNID))  THEN
C             FOUND MATCH.  SET 2ND CONNECTION TO MATCH
C             CURRENT CONNECTION.
CS*           TRACE1WHEN [4] [OLDCN2] [TRMDAT($$CHXTRMCN2, FTMIX)]
              TRMDAT($$CHXTRMCN2, FTMIX) = TRMXXX(5, XTERM)
CS*           TRACE1WHEN [4] [NEWCN2] [TRMDAT($$CHXTRMCN2, FTMIX)]
              GO TO 1200
            ENDIF
 1150       CONTINUE
C           HERE FOUND NO MATCH.
            GO TO 8050
C
          ELSE
C           HERE IF NON-INCOMING FUTURE TERMINAL
            TMCNT = TMCNT + 1
            ATMIX = ATMPT + TMCNT - 1
C
            TRMDAT($$CHXTRMLYR, ATMIX) = TRMXXX(3, XTERM)
            TRMDAT($$CHXTRMCON, ATMIX) = TRMXXX(5, XTERM)
            TRMDAT($$CHXTRMDLG, ATMIX) = TRMXXX(8, XTERM)
C
C           CHECK IF THIS IS AN OUTGOING  FUTURE TERMINAL.
C           IF NOT, NO NEED TO UPDATE ITS COORDINATES SINCE
C           THESE ARE MAINTAINED RELATIVE TO THE CELL LOCATIONS.
C
            IF (TRMXXX(6, XTERM) .EQ. 0) GO TO 1200
C
C           HERE IF THIS TERMINAL IS A FUTURE TERMINAL.
C           RECALL THAT THE ABSCISSA AND ORDINATE OF
C           FUTURE TERMINALS ARE STORED AS RELATIVE VALUES.
CS*         TRACE1WHEN [4] [TRMABS] [TRMXXX(1,XTERM)]
CS*         TRACE1WHEN [4] [TRMORD] [TRMXXX(2,XTERM)]
            TRMDAT($$CHXTRMABS, ATMIX) = TRMXXX(1, XTERM)
            IF (TRMXXX(1,XTERM) .NE. MININT)
     1        TRMDAT($$CHXTRMABS, ATMIX) = TRMXXX(1, XTERM) -
     2                                     CHNDAT(CHLCAB, CHNID)
            TRMDAT($$CHXTRMORD, ATMIX) = TRMXXX(2, XTERM)
            IF (TRMXXX(2, XTERM) .NE. MININT)
     1        TRMDAT($$CHXTRMORD, ATMIX) = TRMXXX(2, XTERM) -
     2                                     CHNDAT(CHLOCR, CHNID)
CS*         TRACE1WHEN [4] [TRMABS] [TRMXXX(1,XTERM)]
CS*         TRACE1WHEN [4] [TRMORD] [TRMXXX(2,XTERM)]
C
          ENDIF
 1200     CONTINUE
 1210     CONTINUE
C
C         NOW NEED TO ADD NEWLY CREATED "DOGLEG" TERMINALS TO *TRMDAT*.
          DSTRT = XDOGPT
          DSTOP = XDOGPT + XDOGCT - 1
          IF (DSTRT .GT. DSTOP) GO TO 1500
C
          DO 1300 DTERM = DSTRT, DSTOP
C
            DGTMCT = DGTMCT + 1
            TRMCNT = TRMCNT + 1
            IF (TRMCNT .GT. TRMMAX) GO TO 8020
            TRMDAT($$CHXTRMABS, TRMCNT) = TRMXXX(1, DTERM) -
     1                                    CHNDAT(CHLCAB, CHNID)
            TRMDAT($$CHXTRMORD, TRMCNT) = TRMXXX(2, DTERM)
            IF (TRMDAT($$CHXTRMORD, TRMCNT) .NE. MININT)
```

```
      1      TRMDAT($$CHXTRMERD, TRMCNT) = TRMXXX(2, DTERM) -
      2                                    CHNDAT(CHLLER, CHNID)
             TRMDAT($$CHXTRMLYR, TRMCNT) = TRMXXX(3, DTERM)
             TRMDAT($$CHXTRMNET, TRMCNT) = TRMXXX(4, DTERM)
             TRMDAT($$CHXTRMCHN, TRMCNT) = CHNID
             TRMDAT($$CHXTRMCON, TRMCNT) = TRMXXX(5, DTERM)
             TRMDAT($$CHXTRMCEL, TRMCNT) = 0
             TRMDAT($$CHXTRMCH2, TRMCNT) = TRMXXX(6, DTERM)
             TRMDAT($$CHXTRMCR2, TRMCNT) = TRMXXX(7, DTERM)
             TRMDAT($$CHXTRMDLG, TRMCNT) = TRMXXX(8, DTERM)
C
 1300        CONTINUE
C
 1500        CONTINUE
C
C            ******************
C            * EXPAND CHANNEL *
C            ******************
C            NOW EXPAND THE CURRENT CHANNEL, MOVING AND LENGTHENING
C            ANY CHANNELS AFFECTED BY THE EXPANSION OF THE CURRENT
C            CHANNEL *CHNID*. THE AMOUNT BY WHICH THE CHANNEL IS TO BE
C            EXPANDED IS IN GLOBAL VARIABLE *DLORCH* (IN COMMON /CPXXXX/).
C
             CALL CHNXPN(CHNID, DLORCH, 0)
C
             IF (WRSTER .GT. 8000000) GO TO 8030
C
C            ********************************
C            * TRANSFER VIA PROTECTION DATA *
C            ********************************
             IF (XVIACT .LE. 0)  GO TO 3000
             DO 2000 AVIA = 1, XVIACT
             VIACNT = VIACNT + 1
CS*          TRACE:WHEN (4) [AVIA] [AVIA] [VIACNT] [VIACNT]
             IF (VIACNT .GT. VIAMAX)  GO TO 8040
             VCHAN = VIAXXX(4, AVIA)
CS*          TRACE:WHEN (4) [VCHAN] [VCHAN]
             IF (ACHCHN .EQ. 1)  THEN
               VIADAT($$CHXVIARFX, VIACNT) = VIAXXX(1, AVIA) -
      1                                      CHNDAT($$CHXCHNLLX, CHNID)
               VIADAT($$CHXVIARFY, VIACNT) = VIAXXX(2, AVIA) -
      1                                      CHNDAT($$CHXCHNLLY, CHNID)
             ELSE
               VIADAT($$CHXVIARFX, VIACNT) = VIAXXX(2, AVIA) -
      1                                      CHNDAT($$CHXCHNLLX, CHNID)
               VIADAT($$CHXVIARFY, VIACNT) = VIAXXX(1, AVIA) -
      1                                      CHNDAT($$CHXCHNLLY, CHNID)
             ENDIF
             VIADAT($$CHXVIANET, VIACNT) = VIAXXX(3, AVIA)
             VIADAT($$CHXVIACHN, VIACNT) = CHNID
C            LINK ENTRY INTO LIST OF VIA PROTECTION TERMINALS
C            FOR *VCHAN*.
             VIAPTR = CHNDAT($$CHXCHNVIAPTR, VCHAN)
CS*          TRACE:WHEN (4) [VIAPTR] [VIAPTR]
             CHNDAT($$CHXCHNVIAPTR, VCHAN) = VIACNT
             VIADAT($$CHXVIANXT, VIACNT) = VIAPTR
 2000        CONTINUE
C
 3000        CONTINUE
C            ************
C            * ALL DONE *
C            ************
             GO TO 9000
C
C            ***********************************************************
C            *                        ERROR RETURNS                    *
C            ***********************************************************
C
 8000        CONTINUE
C/           CPX - FORMAL PARAMETER *CHNID* WHICH SPECIFIES WHICH
C/                 CHANNEL HAS JUST BEEN PROCESSED IS ILLEGAL.
C/           **FM(1X,'CHNID = ',I6,6X,'LIMIT = ',I6)
             CALL VISERR(RCDNHR, 8263301, CHNID, CHNCNT)
             GO TO 9000
 8010        CONTINUE
C/           CPX - TOO MANY TOTAL CONNECTIONS CREATED DURING
C/                 TRACK ASSIGNMENT IN CHANNEL *CHNID*.
C/           **FM(1X,'NO. OF CONNECTIONS = ',I6,6X,'CHNID = ',I6)
             CALL VISERR(RCDNHR, 8263302, CONCNT, CHNID)
             GO TO 9000
 8020        CONTINUE
```

```
C/          CHX - TOO MANY TOTAL TERMINALS CREATED DURING
C/                TRACK ASSIGNMENT IN CHANNEL *CHNID*.
C/          **FM(1X,'NO. OF TERMINALS = ',I6,6X,'CHNID = ',I6)
            CALL VISERR(FCDNPR, 8263303, TRMCNT, CHNID)
            GO TO 9000
 8030       CONTINUE
C/          CHX - ERROR IN ROUTINE *CHRXPN* WHILE ATTEMPTING TO
C/                EXPAND CHANNEL AFTER TRACK ASSIGNMENT.
C/          **FM(1X,'CHANNEL = ',I6,6X,'WRSTER = ',I12)
            CALL VISERR(FCDNPR, 8263304, CHNID, WRSTER)
            GO TO 9000
 8040       CONTINUE
C/          CHX - TOO MANY TOTAL VIA PROTECTION TERMINALS CREATED
C/                DURING TRACK ASSIGNMENT IN CHANNEL.
C/          **FM(1X,'NO. OF TERMINALS = ',I6,6X,'MAX = ',I6)
            CALL VISERR(FCDNPR, 8263305, VIACNT, VIAMAX)
            GO TO 9000
 8050       CONTINUE
C/          CHX - FOUND NO OUTGOING FUTURE TERMINAL IN THE
C/                FEEDING CHANNEL TO MATCH THE INCOMING
C/                FUTURE TERMINAL.
C/          **FM(' TERMINAL NET =',I6,6X,' CHANNEL = ',I6)
            CALL VISERR(FCDNPR, 8263306, TRMXXX(4, XTERM), CHNID)
            GO TO 9000
C
C
C           ***********************************************************
C           *                 SINGLE EXIT FROM THIS ROUTINE            *
C           ***********************************************************
C
 9000       CONTINUE
            IF (CHXPOF(11) .EQ. RUNNER)  THEN
             CALL CHXDMP(230)
             CALL CHXDMP(300)
             CALL CHXDMP(400)
            ENDIF
CS*         ROLEXIT [CHX]
            RETURN
C
C
C           ***********************************************************
C           *                     FORMAT STATEMENTS                    *
C           ***********************************************************
C
C           (NONE)
C
C
C           END CHNCLT 2633
            END
```

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS

PPPPPPPPPP    4444444444444444444444  DIGITAL EQUIPMENT CORPORATION - VAX/VMS VERSION V4.4  4444444444444444444444    PPPPPPPPPP

KMP

S2634

FOR

;3

FILE _$1$DUA6:[PRI.CHX0215]2634.FOR;3 (2417,1,1), LAST REVISED ON 21-OCT-1986 08:44, IS A 51 BLOCK SEQUENTIAL FILE OWNED BY UIC
[PRDIST,FFC].  THE RECORDS ARE VARIABLE LENGTH WITH IMPLIED (CR) CARRIAGE CONTROL.  THE LONGEST RECORD IS 77 BYTES.

JOB S2634 (216) QUEUED TO SYS$PRINT ON 4-DEC-1986 12:51 BY USER KMP, UIC [ENGVLSI,KMP], UNDER ACCOUNT ENGRG AT PRIORITY 3, STARTED
ON PRINTER _TCMICSIFAO: ON 4-DEC-1986 13:21 FROM QUEUE SYS$PRINT.

PPPPPPPPPP    4444444444444444444444  DIGITAL EQUIPMENT CORPORATION - VAX/VMS VERSION V4.4  4444444444444444444444    PPPPPPPPPP
```

```
_$1$DUA6:[FFD.CHXG2]S2634.FOR;3                    21-OCT-1986 08:44                    PAGE 1
C       SUBROUTINE CHNXPN(CHNID, ADDWID, XPNFLG)
C
C$*     ALLINTEG
C
C                           ****************
C                           *              *
C       SUBSYSTEM CHX       *  2634 CHNXPN *
C                           *              *
C                           ****************
C
C       ***************************************************************
C       ***************************************************************
C       **                                                           **
C       **  (C) COPYRIGHT V-R INFORMATION SYSTEMS, INC. 1984          **
C       **  LICENSED MATERIAL -- PROGRAM PROPERTY OF VRIS             **
C       **  ALL RIGHTS RESERVED                                       **
C       **                                                           **
C       **  THIS PROGRAM IS THE PROPERTY OF VRIS AND IS FURNISHED     **
C       **  PURSUANT TO A WRITTEN LICENSE AGREEMENT. IT MAY NOT BE    **
C       **  USED, REPRODUCED, OR DISCLOSED TO OTHERS EXCEPT IN        **
C       **  ACCORDANCE WITH THE TERMS AND CONDITIONS OF THAT          **
C       **  AGREEMENT.                                                **
C       **                                                           **
C       ***************************************************************
C       ***************************************************************
C
C       ***************************************************************
C       *                    MODULE DOCUMENTATION                     *
C       ***************************************************************
C
C       SUMMARY --
C
C       THIS SUBROUTINE IS THE ROOT OF THE CHANNEL EXPANSION SUBSYSTEM
C       IN THAT IT EXPANDS THE WIDTH OF THE SPECIFIED CHANNEL *CHNID*
C       BY *ADDWID* MRES.
C
C       ALL ENTITIES (CELL LOCATIONS, CHANNEL LOCATIONS AND SIZES,
C       ETC.) THAT ARE AFFECTED BY THE EXPANSION OF THE CHANNEL ARE
C       APPROPRIATELY ADJUSTED BY THIS ROUTINE.
C
C       FORMAL PARAMETERS --
C       NAME   DIMENSION TYPE  IN/OUT  DESCRIPTION
C       ----   --------- ----  ------  -----------
C       CHNID            INT    IN     IDENTIFICATION NUMBER OF THE
C                                      CHANNEL TO BE EXPANDED.
C
C       ADDWID           INT    IN     AMOUNT (IN MRES) BY WHICH THE
C                                      WIDTH OF CHANNEL *CHNID* IS
C                                      TO BE EXPANDED.
C
C       XPNFLG           INT    IN     INDICATES IF ROUTINE IS CALLED
C                                      FOR REGULAR EXPANSION OR IF IT IS
C                                      CALLED DUE TO CENTERING OF CORE CELLS
C                                        0 - REGULAR EXPANSION
C                                        1 - EXPANSION OF UPPER-MOST CHANNEL
C                                            IN CENTERING OF CORE CELLS
C                                        2 - EXPANSION OF LOWER-MOST CHANNEL
C                                            IN CENTERING OF CORE CELLS
C
C       LOCAL VARIABLES --
C       NAME   DIMENSION TYPE  DESCRIPTION
C       ----   --------- ----  -----------
C       ACELL                  CELL NUMBER.
C
C       ALTERX                 ACTUAL AMOUNT THE CARRIER DIMENSIONS WERE
C       ALTERY                 CHANGED DURING EXPANSION
C
C       BASCEL                 FIRST CELL ALONG A CHANNEL BEING EXPANDED
C
C       BASMOV                 INITIAL AMOUNT A CHANNEL (AND FOLLOWING
C                              CELLS) MUST MOVE
C
C       CELMOV(SDEVICES)       ARRAY CONTAINING FLAGS TO INDICATE
C                              WHETHER OR NOT A CELL IS TO BE MOVED.
C                                CELMOV(*) = 0 -- DO NOT MOVE CELL "*"
C                                          = 1 -- MOVE CELL "*"
C
C       CHHICR                 VARIABLE USED TO ACCESS THE HI CORDINATE
C                              FIELD (IN *CHNDAT*) OF A GIVEN CHANNEL.
```

```
C
C       CHINDX          CHANNEL INDEX NUMBER
C
C       CHLLOR          VARIABLE USED TO ACCESS THE LO CORDINATE
C                       FIELD (IN *CHNLDAT*) OF A GIVEN CHANNEL.
C
C       CHNMOV(SCHANNELS)  ARRAY CONTAINING FLAGS TO INDICATE
C                       WHETHER OR NOT A CHANNEL IS TO BE MOVED.
C                         CHNMOV(*) = 0 -- DO NOT MOVE CHN "*"
C                         CHNMOV(*) = 1 -- MOVE CHANNEL "*"
C
C       CHORN           CHANNEL ORIENTATION.
C                         1 = HORIZONTAL
C                         2 = VERTICAL
C
C       CLHICR          VARIABLE USED TO ACCESS THE HIGH CORDINATE
C                       FIELD (IN *CELLDAT*) OF A GIVEN CELL.
C
C       CLLOCH          VARIABLE USED TO ACCESS THE FIELD
C                       (IN *CELDAT*) WHICH POINTS TO THE
C                       CHANNEL ON THE LO SIDE OF A CELL.
C
C       CLNEXT          VARIABLE USED TO ACCESS THE NEXT CELL ALONG
C                       A CHANNEL FROM THE *CELDAT* ARRAY.
C
C       CLNXCH          VARIABLE USED TO ACCESS THE FIELD
C                       (IN *CELDAT*) WHICH POINTS TO THE
C                       NEXT CHANNEL TO THE RIGHT (OR TO
C                       THE TOP) OF A CELL.
C
C       CLNXCL          VARIABLE USED TO ACCESS THE FIELD
C                       (IN *CELDAT*) WHICH POINTS TO THE
C                       NEXT CELL TO THE RIGHT (OR TO THE
C                       TOP) OF A CELL.
C
C       CLNXHI          VARIABLE USED TO ACCESS THE FIELD
C                       (IN *CELDAT*) WHICH POINTS TO THE
C                       NEXT CELL TO THE RIGHT (OR TO THE
C                       TOP) OF A CELL ON THE HIGH SIDE OF
C                       A CHANNEL.
C
C       CLNXLO          VARIABLE USED TO ACCESS THE FIELD
C                       (IN *CELDAT*) WHICH POINTS TO THE
C                       NEXT CELL TO THE RIGHT (OR TO THE
C                       TOP) OF A CELL ON THE LOW SIDE OF
C                       A CHANNEL.
C
C       CLRFCR          FIELD USED TO ACCESS THE REFERENCE
C                       CORDINATE (IN *CELDAT*) OF A CELL.
C
C       HICHAN          INDEX OF THE CHANNEL FED BY *CHINDX* ON THE
C                       HIGH SIDE
C
C       INTCHX          INDEX OF THE CHANNEL WHICH INTERSECTS
C                       A GIVEN CHANNEL
C
C       LCHN            ID NUMBER OF CHANNEL OCCURRING ON
C                       THE LOW SIDE OF A CELL
C
C       LCHORN          ORIENTATION OF *LCHN*
C
C       LCNT            NUMBER OF CHANNELS FEEDING INTO THE LOW
C                       SIDE OF A CHANNEL
C
C       LIX             ITERATION VARIABLE
C
C       LOCHAN          INDEX OF THE CHANNEL FED BY *CHINDX* ON THE
C                       LO SIDE
C
C       LSTOP,LSTRT     UPPER AND LOWER BOUND OF CHANNELS FEEDING
C                       FROM THE LOW SIDE
C
C       MOVEIT          AMOUNT AN INDIVIDUAL ITEM (CELL, CHANNEL,
C                       TERMINAL) MUST MOVE
C
C       ORTHCH          INDEX NUMBER OF AN INTERSECTING ORTHOGONAL
C                       CHANNEL
C
C       RLCTCL          CELL NUMBER OF A CELL WHICH LIES
C                       ALONG THE HI SIDE OF THE CHANNEL
C                       FROM WHICH THE CURRENT EXPLORATION
C                       WAS INITIATED.
C
```

```
C
C       STPEXP              INDEX TO THE *CHENTR* ARRAY OF THE LAST
C                           CHANNEL TO BE EXPANDED.
C
C       TMP                 TEMPORARY VARIABLE.
C
C       TMPXXX              TEMPORARY COORDINATE VALUES
C       TMPYYY
C
C
C       GLOBAL VARIABLES --
C       NAME  DIMENSION TYPE  DESCRIPTION
C       ----  --------- ----  -----------
C       (NONE)
C
C       REVISION HISTORY --
C          15-AUG-86 JAF PREVENTED CHANNEL FROM MOVING TOO FAR DURING
C                        NEGATIVE EXPANSION.  (SAR 5956)
C          14-JAN-86 JAF REPLACED ABSOLUTE ORIGIN AND FUTURE
C                        TERMINAL COORDINATES WITH RELATIVE
C                        COORDINATES.  (SAR 5500)
C          21-NOV-85 DCC REVISED ERROR CODES.  (SAR 5391)
C          02-OCT-85 JAF REWROTE FOR LARGE MACRO AND CHANNEL
C                        CYCLE SUPPORT, AND DCC REMOVED UPDATES
C                        OF FUTURE TERMINALS FOR *CHNID*.  (SAR 5199)
C          29-JUL-85 DCC CHECKED MODULE.
C          05-NOV-84 KMP WROTE MODULE.  (SAR 4856)
C
C       TESTING PLANS --
C          29-JUL-85 DCC COMPLETED UNIT TESTING.
C
C       ***************************************************************
C       *                     SUBSYSTEM TOKENS                        *
C       ***************************************************************
CS*     CHXTOKEN
C
C       ***************************************************************
C       *                   VARIABLE DECLARATIONS                     *
C       ***************************************************************
C
C       FORMAL PARAMETERS --
C       (NONE)
C
C       LOCAL VARIABLES --
C
        DIMENSION  CELMOV($$$DEVICES), CHNMOV(2, $$$CHANNELS)
C
C       SUBSYSTEM GLOBAL VARIABLES --
C
CS*     SUBSYSGLOBAL [CHX]
C
CS*     CHXCHR
CS*     CHXCEL
CS*     CHXCHN
CS*     CHXCHC
CS*     CHXCLN
CS*     CHXTRM
CS*     CHXXYX
C
C       OTHER SUBSYSTEM VARIABLES --
C       (NONE)
C
C       SYSTEM GLOBAL VARIABLES --
C
CS*     SYSCOMMON
C
C       ***************************************************************
C       *                      DATA STATEMENTS                        *
C       ***************************************************************
C
C       (NONE)
C
C
C       ***************************************************************
```

```
C       *                 STATEMENT FUNCTIONS                      *
C       ************************************************************
C
C       LOCAL STATEMENT FUNCTIONS --
C       (NONE)
C
C       SUBSYSTEM STATEMENT FUNCTIONS --
C       (NONE)
C
C       OTHER SUBSYSTEM STATEMENT FUNCTIONS --
C       (NONE)
C
C       SYSTEM STATEMENT FUNCTIONS --
C
CS*     SFUNCHLS1
C
C
C       ************************************************************
C       *                   EXECUTABLE CODE                        *
C       ************************************************************
C
CS*     RCENTRY [CHX] [CHNXPN] [2634] [10]
C
C       VALIDATE FORMAL PARAMETERS
CS*     RCUNSCHN [CHNID] [1] [CHNCNT] [8000]
CS*     TRACE2WHEN [2] [CHNID] [CHNID] [ADDWID] [ADDWID]
CS*     TRACE2WHEN [2] [CHR1UX] [CHR1UX] [CHRRUX] [CHRRUX]
CS*     TRACE2WHEN [2] [CHRRUY] [CHRRUY] [CHRYYY] [CHRYYY]
CS*     TRACE2WHEN [2] [CHR1UX] [CHR1UX] [CHRPUX] [CHRPUX]
CS*     TRACE2WHEN [2] [CHRRUX] [CHRRUX] [CHRXXX] [CHRXXX]
        IF (CHXELF(11) .EQ. NCDNER)  CALL CHXDMP(210)
C
        IF (ADDWID .EQ. 0) GO TO 7000
C
        DO 1120 I = 1, CHNMAX
           CHNMCV(1, I) = 0
           CHNMCV(2, I) = 0
 1120   CONTINUE
C
C       INITIALIZE THE EXPLORATION POINTERS.
C
C       DETERMINE ORIENTATION OF CHANNEL AND SET UP VARIABLES
C       TO ACCESS THE VARIOUS FIELDS OF THE CHANNEL, CELL, AND
C       OTHER DATA STRUCTURES.
C
        CHORN = CHNDAT(%%CHXCHNORIENT, CHNID)
CS*     TRACE1WHEN [3] [CHORN] [CHORN]
        IF (CHORN .EQ. 1) THEN
C
C          HERE IF EXPANDING A HORIZONTAL CHANNEL UPWARD
           CLLCCH = %%CHXCELLEFTCH
           CLNXCH = %%CHXCELTOPCH
           CLNEXT = %%CHXCELNXTTP
           CLNXCL = %%CHXCELNXTPT
           CLNXLL = %%CHXCELNXTLF
           CLNXHI = %%CHXCELNXTPG
           CLHECH = %%CHXCELREY
           CLHICH = %%CHXCELUPY
           CHLCCH = %%CHXCHNLLY
           CHHICH = %%CHXCHNURY
           STPEXP = NPH2CH
           GRDSIZ = CHRGLY
C
        ELSE
C
C          HERE IF EXPANDING A VERTICAL CHANNEL RIGHTWARD
           CLLCCH = %%CHXCELBOTCH
           CLNXCH = %%CHXCELRGHCH
           CLNEXT = %%CHXCELNXTRG
           CLNXCL = %%CHXCELNXTLF
           CLNXLL = %%CHXCELNXTBT
           CLNXHI = %%CHXCELNXTTF
           CLHECH = %%CHXCELREX
           CLHICH = %%CHXCELURX
           CHLCCH = %%CHXCHNLLX
           CHHICH = %%CHXCHNURX
           STPEXP = CHNCNT
           GRDSIZ = CHRGPX
C
        ENDIF
C
C       ************************************************************
```

```
C       * DETERMINE WHICH CELLS AND CHANNELS ARE TO BE MOVED *
C       ******************************************************
C       THIS IS DONE BY USING A BREADTH-FIRST EXPLORATION OF
C       THE GRAPH REPRESENTING THE CURRENT PLACEMENT, BEGINNING
C       AT THE CHANNEL TO BE EXPANDED (*CHNID*) AND EXPLORING
C       RIGHTWARD/UPWARD FROM THERE.
C
C       FIND THE POSITION OF *CHNID* IN THE *CHNSRT* ARRAY
        CHSNTR = CHNSRT(3, CHNID)
C
C       MARK *CHNID* FOR MOVEMENT
        CHNMCV(1, CHNID) = ADDWID
        CHNMCV(2, CHNID) = ADDWID
C
C       ****************************************
C       * BEGIN EXPLORATION FROM FIRST CHANNEL *
C       ****************************************
C
 1150   CONTINUE
        IF (CHSNTR .GT. SIPEXP) GO TO 1500
        CHINDX = CHNSRT(1, CHSNTR)
        BASMCV = CHNMCV(2, CHINDX)
        IF (BASMCV .EQ. 0) GO TO 1450
C       MARK THE CHANNELS FED BY *CHINDX* FOR LENGTHENING
        LOCHAN = CHNDAT(%%CHXCHNLOFEED, CHINDX)
        IF (LOCHAN .GT. 0) CHNMOV(2, LOCHAN) = BASMCV
        HICHAN = CHNDAT(%%CHXCHNHIFEED, CHINDX)
        IF (HICHAN .GT. 0) CHNMCV(2, HICHAN) = BASMCV
C       NOTE: TREAT *CHNID* AS A MOVING CHANNEL INSTEAD OF AN
C             EXPANDABLE ONE WHEN DEALING WITH THE LOWER-MOST
C             CHANNEL DURING CORE CENTERING.  THIS WILL MOVE ALL
C             WIRES OF THE CHANNEL UP TO THE CORE AREA RATHER THAN
C             REMAINING DOWN BY THE I/O CELLS.
        IF ((CHINDX .EQ. CHNID) .AND.
     1      (XENFLG .NE. 2)) THEN
C          ONLY UPDATE THE HI COORDINATE OF THE CHANNEL SINCE
C          THIS CHANNEL IS BEING EXPANDED NOT MOVED
           CHNDAT(CHHIOR, CHINDX) = CHNDAT(CHHIOR, CHINDX) + BASMCV
        ELSE
C          CHANNEL IS TO BE MOVED
           IF ((BASMCV .LT. 0) .AND.
     1         (CHNDAT(%%CHXCHNLOCLPT, CHINDX) .GT. 0)) THEN
C             SPECIAL PROCESSING FOR NEGATIVE MOVEMENTS.
C             CHECK THE DISTANCE BETWEEN THE CHANNEL AND THE LOW SIDE
C             CELLS AND ONLY MOVE THE CHANNEL BY THE MINIMUM AMOUNT.
              TMP     = MAXINT
              ACELL   = CHNDAT(%%CHXCHNLOCLPT, CHINDX)
 1160         CONTINUE
              IF (ACELL .LE. 0) GO TO 1170
              MOVFIT = CHNDAT(CHLOOR, CHINDX) -
     1                 (CELDAT(CLRHIOR, ACELL ) + CELDAT(CLRFOR, ACELL))
              TMP     = VISMN2(MOVFIT, TMP    )
              ACELL   = CELDAT(CLNEXT, ACELL )
              GO TO 1160
 1170         CONTINUE
C             ROUND DOWN TO THE NEAREST GRID MULTIPLE AND NEGATE
              TMP     = -((TMP / GRDSIZ) * GRDSIZ)
C
C             SET BASMCV TO MINIMUM MOVING DISTANCE
C             (NOTE: MINIMUM = MAXIMUM NEGATIVE NUMBER)
              BASMCV = VISMX2(BASMCV, TMP)
           ENDIF
C          RE-MARK THE MOVEMENT OF *CHINDX* TO ACCOUNT FOR
C          A POSSIBLE CHANGED *BASMCV*
           CHNMCV(1, CHINDX) = BASMCV
           CHNMCV(2, CHINDX) = BASMCV
C          RE-MARK THE MOVEMENT OF THE CHANNELS FED BY *CHINDX*
           LOCHAN = CHNDAT(%%CHXCHNLOFEED, CHINDX)
           IF (LOCHAN .GT. 0) CHNMCV(2, LOCHAN) = BASMCV
           HICHAN = CHNDAT(%%CHXCHNHIFEED, CHINDX)
           IF (HICHAN .GT. 0) CHNMCV(2, HICHAN) = BASMCV
C
C          MOVE *CHINDX*
           CHNDAT(CHHIOR, CHINDX) = CHNDAT(CHHIOR, CHINDX) + BASMCV
           CHNDAT(CHLOOR, CHINDX) = CHNDAT(CHLOOR, CHINDX) + BASMCV
C
C          ADJUST THE LENGTHS OF THE CHANNELS FEEDING
C          INTO *CHINDX* FROM THE LOW SIDE
           LCNT   = CHNDAT(%%CHXCHNLOCHCT, CHINDX)
           IF (LCNT .LE. 0) GO TO 1250
           LSTRT = CHNDAT(%%CHXCHNLOCHPT, CHINDX)
           LSTOP = LSTRT + LCNT - 1
```

```
      DO 1200 LIX = LSTRT, LSTOP
         LCHN  = CHCDAT(LIX)
         LCHCHN = CHNDAT(**CHXCHNORIENT, LCHN)
         IF (LCHCHN .EQ. CHCHN) GO TO 1200
C        IF LCHN HAS ALREADY BEEN ROUTED, IT IS NOT TO BE
C        LENGTHENED, IT CAN ONLY BE MOVED
         IF (LCHN .LT. CHNID) THEN
C           HERE IF *LCHN* HAS ALREADY BEEN ROUTED
C           MOVE THE HIGH END THE SAME DISTANCE AS THE LOW END
            CHNDAT(CHHIGH, LCHN) =
     1         CHNDAT(CHHIOR, LCHN) + CHNMOV(1, LCHN)
            CHNMOV(2, LCHN) = CHNMOV(1, LCHN)
         ELSE
C           HERE IF *LCHN* HAS NOT YET BEEN ROUTED
            CHNDAT(CHHIGH, LCHN) =
     1         CHNDAT(CHHIGH, LCHN) + BASMOV
            CHNMOV(2, LCHN) = BASMOV
         ENDIF
 1200    CONTINUE
C
 1250    CONTINUE
         IF (BASMOV .EQ. 0) GO TO 1450
      ENDIF
C
C     MOVE THE CELLS ALONG THE HIGH SIDE OF *CHINDX*
      ROCTCL = CHNDAT(**CHXCHNHICLPT, CHINDX)
      BASCEL = ROCTCL
 1300 CONTINUE
      IF (ROCTCL .LE. 0) GO TO 1450
C     START WITH *BASMOV* AMOUNT OF MOVEMENT
      MCVEIT = BASMOV
C     TRAVERSE ALONG THE INTERSECTING ORTHOGONAL CHANNEL
C     UPDATING THE CELL POSITIONS AS YOU GO ALONG.  STOP
C     WHEN YOU HIT AN INTERSECTING CHANNEL.
      ORTHCH = CELDAT(CLLOCH, ROCTCL)
C     UPDATE THE LOW ORDINATE OF *ORTHCH* ONLY
C     IF IT IS NOT FED BY *CHINDX*
      IF ((ROCTCL .NE. BASCEL) .AND. (ORTHCH .NE. 0)) THEN
         CHNDAT(CHLOOR, ORTHCH) = CHNDAT(CHLOOR, ORTHCH) + MCVEIT
         CHNMOV(1      , ORTHCH) = CHNMOV(1      , ORTHCH) + MCVEIT
      ENDIF
C
C     CONTINUE ALONG *ORTHCH* UPDATING CELL COORDINATES
      ACELL = ROCTCL
 1350 CONTINUE
      IF (ACELL .LE. 0) GO TO 1400
C     MOVE THE CELL THE APPROPRIATE DISTANCE
      CELDAT(CLRFOR, ACELL) = CELDAT(CLRFOR, ACELL) + MCVEIT
C     CHECK IF WE ARE AT AN INTERSECTING CHANNEL
      IF (CELDAT(CLNXCH, ACELL) .LE. 0) THEN
C        NOT AT AN INTERSECTING CHANNEL,
C        MOVE ON TO NEXT CELL
C        NOTE: IF *ORTHCH* = 0 THEN TRAVERSE ALONG THE HIGH SIDE
C              OF THE CELLS SINCE THIS MEANS A LOWER I/O ROW.
         IF (ORTHCH .GT. 0) THEN
            ACELL = CELDAT(CLNXLO, ACELL)
         ELSE
            ACELL = CELDAT(CLNXHI, ACELL)
         ENDIF
      ELSE
C        AT A CHANNEL INTERSECTION
         INTCHX = CELDAT(CLNXCH, ACELL)
C        UPDATE THE AMOUNT THE INTERSECTING CHANNEL MUST
C        MOVE AND STOP UPDATING CELLS ALONG *ORTHCH*.
C        TAKE INTO ACCOUNT THE DISTANCE BETWEEN *ACELL*
C        AND *INTCHX* SO THE CHANNEL IS NOT MOVED MORE
C        THAN IS NECESSARY.
C        NOTE: IF *INTCHX* OR *ORTHCH* HAVE ALREADY BEEN ROUTED, THEN THE
C        HIGH SIDE OF *ORTHCH* MUST MOVE THE SAME DISTANCE
C        AS THE LOW SIDE.
         IF ((INTCHX .LT. CHNID) .OR. (ORTHCH .LT. CHNID)) THEN
C           *INTCHX* HAS ALREADY BEEN ROUTED
            CHNMOV(1, INTCHX) = MCVEIT
            GO TO 1360
         ENDIF
C
         MCVEIT = (CELDAT(CLHIOR, ACELL) + CELDAT(CLRFOR, ACELL))
     1            - CHNDAT(CHLOOR, INTCHX)
C        TAKE INTO ACCOUNT WHETHER IT IS A POSITIVE OR NEGATIVE *ALDWID*
         IF (ALDWID .GE. 0) THEN
C           POSITIVE MOVEMENT
            IF (MCVEIT .LT. 0) MCVEIT = 0
```

```
C          ADJUST MOVING DISTANCE TO A MULTIPLE OF THE GRID SIZE
              IMP = (MOVEIT / GRDSIZ) * GRDSIZ
              IF (IMP .LT. MOVEIT) MOVEIT = IMP + GRDSIZ
              CHNMCV(1, INTCHX) = VISMX2(MOVEIT, CHNMCV(1, INTCHX))
           ELSE
C             NEGATIVE MOVEMENT
C             ADJUST MOVING DISTANCE TO A MULTIPLE OF THE GRID SIZE
              MOVEIT = (MOVEIT / GRDSIZ) * GRDSIZ
              CHNMCV(1, INTCHX) = VISMN2(MOVEIT, CHNMCV(1, INTCHX))
           ENDIF
 1360      CONTINUE
           CHNMCV(2, INTCHX) = CHNMCV(1, INTCHX)
C          ZERO CNT *ACELL* TO STOP TRAVERSAL
           ACELL = 0
        ENDIF
        GO TO 1350
 1400   CONTINUE
C
C       GET NEXT CELL ALONG *CHINDX*
        RCCTCL = CELDAT(CLNXCL, RCCTCL)
        GO TO 1300
 1450   CONTINUE
C
C       GET NEXT CHANNEL
        CHPNTR = CHPNTR + 1
        GO TO 1150
 1500   CONTINUE
C
C       **********************
C       * END OF EXPLORATION *
C       **********************
C       HERE WHEN DONE DETERMINING WHICH CELLS AND CHANNELS ARE
C       TO BE MOVED AND WHICH CHANNELS ARE TO BE LENGTHENED.
C
 7000   CONTINUE
C
C       ****************************
C       * FIND MAXIMUM COORDINATES *
C       ****************************
        ALTERX = 0
        ALTERY = 0
        DO 7200 I = 1, 4
        GO TO (7110, 7120, 7130, 7140), I
C
 7110   CONTINUE
C       LOWER-MOST HORIZONTAL CHANNEL
        ACELL = CHNDAT(%%CHXCHNLOCLPT, CHNSRT(1, 1))
        CLNXCL = %%CHXCELNXTTP
        GO TO 7150
C
 7120   CONTINUE
C       UPPER-MOST HORIZONTAL CHANNEL
        ACELL = CHNDAT(%%CHXCHNHICLPT, CHNSRT(1, NMHZCH))
        CLNXCL = %%CHXCELNXTBT
        GO TO 7150
C
 7130   CONTINUE
C       LOWER-MOST VERTICAL CHANNEL
        ACELL = CHNDAT(%%CHXCHNLOCLPT, CHNSRT(1, (NMHZCH+1)))
        CLNXCL = %%CHXCELNXTRG
        GO TO 7150
C
 7140   CONTINUE
C       UPPER-MOST VERTICAL CHANNEL
        ACELL = CHNDAT(%%CHXCHNHICLPT, CHNSRT(1, CHNCNT))
        CLNXCL = %%CHXCELNXTLE
        GO TO 7150
C
 7150   CONTINUE
        IF (ACELL .LE. 0) GO TO 7200
        TMPXXX = CELDAT(%%CHXCELHRX, ACELL) +
     1           CELDAT(%%CHXCELURX, ACELL)
        TMPYYY = CELDAT(%%CHXCELHRY, ACELL) +
     1           CELDAT(%%CHXCELURY, ACELL)
        ALTERX = VISMX2(ALTERX, TMPXXX)
        ALTERY = VISMX2(ALTERY, TMPYYY)
        ACELL  = CELDAT(CLNXCL, ACELL )
        GO TO 7150
 7200   CONTINUE
C
        IF (CHNDAT(%%CHXCHNORIENT, CHNCNT) .EQ. 1) THEN
```

```
C          HORIZONTAL OUTER-MOST CHANNELS
              CHNDAT(%%CHXCHNURX,  CHNCNT    ) = ALTERX
              CHNLAT(%%CHXCHNURX, (CHNCNT-1)) = ALTERX
           ELSE
C          VERTICAL OUTER-MOST CHANNELS
              CHNDAT(%%CHXCHNURY,  CHNCNT    ) = ALTERY
              CHNLAT(%%CHXCHNURY, (CHNCNT-1)) = ALTERY
           ENDIF
C
C          ******************************
C          * UPDATE CARRIER INFORMATION *
C          ******************************
           TMPXXX = ALTERX
           TMPYYY = ALTERY
           ALTERX = ALTERX - MXCLXX
           ALTERY = ALTERY - MXCLYY
           MXCLXX = TMPXXX
           MXCLYY = TMPYYY
C
C          ******************************
C          * UPDATE CARRIER INFORMATION *
C          ******************************
C          NEED TO UPDATE THE PLACEABLE AND ROUTABLE AREAS AND TRIMLINE.
C
           CRRTUX = CRRTUX + ALTERX
           CRRPUX = CRRPUX + ALTERX
           CRRRUX = CRRRUX + ALTERX
           CRRXXX = CRRXXX + ALTERX
           CRRTUY = CRRTUY + ALTERY
           CRRPUY = CRRPUY + ALTERY
           CRRRUY = CRRRUY + ALTERY
           CRRYYY = CRRYYY + ALTERY
CS*        TRACE2WHEN [2] [CRRTUY] [CRRTUY] [CRRPUY] [CRRRUY]
CS*        TRACE2WHEN [2] [CRRRUY] [CRRRUY] [CRRYYY] [CRRYYY]
CS*        TRACE2WHEN [2] [CRRTUX] [CRRTUX] [CRRPUX] [CRRRUX]
CS*        TRACE2WHEN [2] [CRRRUX] [CRRPUX] [CRRXXX] [CRRXXX]
C
C          ************************
C          * PROCESSING COMPLETED *
C          ************************
           GO TO 9000
C
C          ***********************************************************
C          *                      ERROR RETURNS                      *
C          ***********************************************************
C
 8000      CONTINUE
C/         CHX - ILLEGAL IDENTIFICATION NUMBER SPECIFIED FOR
C/               CHANNEL WHOSE WIDTH IS TO BE MODIFIED.
C/         **EM(1X,'CHANNEL ID = ',I6,6X,'NO. OF CHANNELS = ',I6)
           CALL VISERR(MCDNBR, 8263401, CHNID, CHNCNT)
           GO TO 9000
C
C
C          ***********************************************************
C          *               SINGLE EXIT FROM THIS ROUTINE             *
C          ***********************************************************
C
 9000      CONTINUE
           IF (CHXFLG(11) .EQ. MCDNBR)  CALL CHXDMP(210)
CS*        MCREXIT [CHX]
           RETURN
C
C
C          ***********************************************************
C          *                   FORMAT STATEMENTS                     *
C          ***********************************************************
C
C          (NONE)
C
C
C          END CHXYEN 2634
           END
```

DIGITAL EQUIPMENT CORPORATION - VAX/VMS VERSION V4.4

KMP

S2635

FOR

;4

FILE _$1$DUA6:[ERC.CHX02]S2635.FOR;4 (1079,1,2), LAST REVISED ON 21-OCT-1986 08:44, IS A 99 BLOCK SEQUENTIAL FILE OWNED BY UIC [PFCTS1,PFC]. THE RECORDS ARE VARIABLE LENGTH WITH IMPLIED (CR) CARRIAGE CONTROL. THE LONGEST RECORD IS 73 BYTES.

JOB S2635 (217) QUEUED TO SYS$PRINT ON 4-DEC-1986 12:51 BY USER KMP, UIC [ENGVLS1,KMP], UNDER ACCOUNT ENGPKG AT PRIORITY 3, STARTED ON PRINTER _TCNTCS1FAC: ON 4-DEC-1986 13:29 FROM QUEUE SYS$PRINT.

DIGITAL EQUIPMENT CORPORATION - VAX/VMS VERSION V4.4

VAX/VMS VAX/VMS VAX/VMS VAX/VMS VAX/VMS VAX/VMS VAX/VMS VAX/VMS VAX/VMS VAX/VMS VAX/VMS VAX/VMS

```
VAX/VMS VAX/VMS VAX/VMS VAX/VMS VAX/VMS VAX/VMS VAX/VMS VAX/VMS VAX/VMS VAX/VMS VAX/VMS VAX/VMS
VAX/VMS VAX/VMS VAX/VMS VAX/VMS VAX/VMS VAX/VMS VAX/VMS VAX/VMS VAX/VMS VAX/VMS VAX/VMS VAX/VMS
VAX/VMS VAX/VMS VAX/VMS VAX/VMS VAX/VMS VAX/VMS VAX/VMS VAX/VMS VAX/VMS VAX/VMS VAX/VMS VAX/VMS

DIGITAL EQUIPMENT CORPORATION - VAX/VMS VERSION V4.4

KMP

S2635

.FOR

;4

FILE _$1$DUA6:[PRD.CHX02]S2635.FOR;4 (1079,1,2), LAST REVISED ON 21-OCT-1986 08:44, IS A 99 BLOCK SEQUENTIAL FILE OWNED BY UIC
[PRDTST,PRD].  THE RECORDS ARE VARIABLE LENGTH WITH IMPLIED (CR) CARRIAGE CONTROL.  THE LONGEST RECORD IS 73 BYTES.

JOB S2635 (217) QUEUED TO SYS$PRINT ON 4-DEC-1986 12:51 BY USER KME, UIC [ENGVLSI,KME], UNDER ACCOUNT ENGPRG AT PRIORITY 3, STARTED
ON PRINTER _TCNTCS$LPA0: ON 4-DEC-1986 13:29 FROM QUEUE SYS$PRINT.

DIGITAL EQUIPMENT CORPORATION - VAX/VMS VERSION V4.4
```

```
      SUBROUTINE WIFUPP(CTFLIX, GRDSNP)
C
CS*   ALLINIEG
C
C                        ****************
C                        *              *
C     SUBSYSTEM CHX      *  2635 WIRUED *
C                        *              *
C                        ****************
C
C     ************************************************************
C     ************************************************************
C     **                                                        **
C     **  (C) COPYRIGHT V-R INFORMATION SYSTEMS, INC. 1984      **
C     **  LICENSED MATERIAL -- PROGRAM PROPERTY OF VRIS         **
C     **  ALL RIGHTS RESERVED                                   **
C     **                                                        **
C     **  THIS PROGRAM IS THE PROPERTY OF VRIS AND IS FURNISHED **
C     **  PURSUANT TO A WRITTEN LICENSE AGREEMENT. IT MAY NOT BE **
C     **  USED, REPRODUCED, OR DISCLOSED TO OTHERS EXCEPT IN    **
C     **  ACCORDANCE WITH THE TERMS AND CONDITIONS OF THAT      **
C     **  AGREEMENT.                                            **
C     **                                                        **
C     ************************************************************
C     ************************************************************
C
C
C     ************************************************************
C     *                  MODULE DOCUMENTATION                    *
C     ************************************************************
C
C     SUMMARY --
C
C     THIS SUBROUTINE CREATES AND OUTPUTS WIRE SEGMENT DESCRIPTIONS
C     (*RWS* RECORDS) TO THE I/O FILE WHOSE INDEX INTO THE *ICFILE*
C     ARRAY IS SPECIFIED IN FORMAL PARAMETER *CTFLIX*.
C
C     WIRE SEGMENT DESCRIPTIONS ARE CREATED FROM THE CONNECTIONS
C     (AND TERMINALS) ROUTED BY *IRK*.
C
C     WHEN THIS MODULE IS INVOKED, THE OUTPUT DESIGN FILE IS
C     ASSUMED TO BE OPEN. THIS ROUTINE DOES NOT CLOSE THE OUTPUT
C     DESIGN FILE WHEN ITS TASK IS COMPLETED.
C
C     NOTE: WHEN *GRDSNP* IS ON (=1), THEN THE POSITIONS
C     ----   OF ALL THE "NORMAL" TERMINALS WILL BE SNAPPED
C            TO GRID. THE LOCATIONS OF "INCOMING"/"OUTGOING"
C            BUILDER TERMINALS AND THOSE OF "DOGLEG" TERMINALS
C            ARE REQUIRED TO BE ON GRID ALREADY.
C
C
C     FORMAL PARAMETERS --
C     NAME  DIMENSION TYPE  IN/OUT  DESCRIPTION
C     ----  --------- ----  ------  -----------
C     OTFLIX           INT    IN    INDEX OF I/O FILE ON WHICH
C                                   WIRE SEGMENT DATA IS TO BE
C                                   OUTPUT.
C                                   UNIT NO. = ICFILE(OTFLIX)
C
C     GRDSNP           INT    IN    FLAG INDICATING WHETHER OR NOT
C                                   TERMINAL LOCATIONS ARE TO BE
C                                   SNAPPED TO GRID BEFORE WIRE
C                                   SEGMENTS ARE OUTPUT.
C                                     0 - TERMINALS ARE NOT SNAPPED
C                                         TO GRID
C                                     1 - TERMINALS ARE SNAPPED
C                                         TO GRID
C
C
C     LOCAL VARIABLES --
C     NAME  DIMENSION TYPE  DESCRIPTION
C     ----  --------- ----  -----------
C     ABGRD                 GRID SIZE TO BE USED FOR CONVERTING
C                           THE ABSCISSA OF A TERMINAL TO GRIDS
C                           AND BACK TO MILS.
C                           FOR HORIZONTAL CHANNELS, *ABGRD* IS
C                           THE HORIZONTAL GRID SIZE (*CRRGDX*).
C                           FOR VERTICAL CHANNELS, *ABGRD* IS
C                           THE VERTICAL GRID SIZE (*CRRGDY*).
C
C     ABREF                 REFERENCE POINT TO BE USED FOR CONVERTING
C                           THE ABSCISSA OF A TERMINAL TO GRIDS AND
```

```
C                          BACK TO MILS.
C                          FOR HORIZONTAL CHANNELS, *AERRF* IS
C                          THE LOWER-LEFT-X OF THE ROUTABLE AREA.
C                          FOR VERTICAL CHANNELS, *ABRRF* IS
C                          THE LOWER-LEFT-Y OF THE ROUTABLE AREA.
C
C       ACELL              CELL NUMBER.
C
C       ACHAN              CHANNEL IDENTIFICATION NUMBER.
C
C       ACHORN             ORIENTATION OF CHANNEL.
C
C       ACNCHN             CHANNEL NUMBER TO WHICH A
C                          CONNECTION BELONGS.
C
C       ACNCT              NUMBER OF CONNECTIONS IN A CHANNEL.
C
C       ACNLYR             LAYER OF CONNECTION.
C
C       ACNNET             NET TO WHICH CONNECTION BELONGS.
C
C       ACNNM              CONNECTION NUMBER OF A CONNECTION
C                          WITHIN A CHANNEL. RECALL THAT THE
C                          CONNECTIONS WITHIN A CHANNEL ARE
C                          NUMBER BEGINING AT 1.
C
C       ACNORD             ORDINATE OF CONNECTION.
C                          IF = MININT, THEN THE CONNECTION
C                          IS CONSIDERED UNROUTED.
C
C       ACNPT              POINTER TO A CONNECTION (IN *CONDAT*).
C
C       ACNRUL             WIRING RULE NUMBER FOR CONNECTION.
C
C       ACONN              CONNECTION NUMBER.
C
C       ADGCCN             CONNECTION NUMBER WITHIN THE CURRENT
C                          CHANNEL OF THE SECOND CONNECTION OF A
C                          DOGLEG TERMINAL.
C
C       ADGINX             INDEX INTO *CONDAT* ARRAY OF THE
C                          SECOND CONNECTION OF A DOGLEG
C                          TERMINAL.
C
C       ADGLYR             LAYER ON WHICH SECOND CONNECTION
C                          OF A DOGLEG TERMINAL IS ROUTED.
C
C       ADGORD             ORDINATE OF THE SECOND CONNECTION
C                          OF A DOGLEG TERMINAL. IF = MININT,
C                          THE SECOND CONNECTION OF THE DOGLEG
C                          TERMINAL IS CONSIDERED UNROUTED.
C
C       ATERM              TERMINAL NUMBER.
C
C       ATMABS             ABSCISSA OF A TERMINAL.
C
C       ATMCT              NUMBER OF TERMINALS ASSOCIATED
C                          WITH A GIVEN CONNECTION.
C
C       ATMLYR             LAYER ON WHICH TERMINAL OCCURS.
C
C       ATMORD             ORDINATE OF A TERMINAL.
C
C       ATMPT              POINTER TO A TERMINAL (IN *TRMDAT*).
C
C       AVAPAD             PAD CODE OF VIA TO BE USED FOR
C                          THE CURRENT CONNECTION.
C
C       AVIA               POINTER TO A VIA.
C
C       BCHABS             ABSCISSA OF BRANCH.
C
C       BCHCLR             VARIABLE USED TO ACCESS THE FIELD
C                          (IN *RULDAT*) WHICH SPECIFIES THE
C                          GUARDBAND FOR A BRANCH IN THE
C                          CURRENT CHANNEL.
C
C       BCHLNG             LENGTH OF A BRANCH WIRE SEGMENT.
C
C       BCHMTL             VARIABLE USED TO ACCESS THE FIELD
C                          (IN *RULDAT*) WHICH SPECIFIES THE
C                          METAL WIDTH FOR A BRANCH IN THE
```

```
C                          CURRENT CHANNEL.
C
C     BCHOR1               ORDINATE OF THE FIRST ENDPOINT
C                          OF A BRANCH.
C
C     BCHOR2               ORDINATE OF THE SECOND ENDPOINT
C                          OF A BRANCH.
C
C     BCHORN               ORIENTATION OF BRANCH IN CURRENT CHANNEL.
C
C     BCHVA1               PADCODE OF VIA AT FIRST ENDPOINT
C                          OF A BRANCH.
C
C     BCHVA2               PADCODE OF VIA AT SECOND ENDPOINT
C                          OF A BRANCH.
C
C     BRLNG1               LENGTH OF BRANCH FROM A DOGLEG
C                          TERMINAL TO THE FIRST CONNECTION
C                          INVOLVED IN THE DOGLEG.
C
C     BRLNG2               LENGTH OF BRANCH FROM A DOGLEG
C                          TERMINAL TO THE SECOND CONNECTION
C                          INVOLVED IN THE DOGLEG.
C
C     CELREX               X-COORDINATE OF CELL REFERENCE POINT
C
C     CELREY               Y-COORDINATE OF CELL REFERENCE POINT
C
C     CHLOAB               VARIABLE USED TO ACCESS LO ABSCISSA
C                          FIELD (IN *CHNDAT*) OF A CHANNEL
C
C     CHLOOR               VARIABLE USED TO ACCESS LO ORDINATE
C                          FIELD (IN *CHNDAT*) OF A CHANNEL.
C
C     CHHIOR               VARIABLE USED TO ACCESS HI ORDINATE
C                          FIELD (IN *CHNDAT*) OF A CHANNEL.
C
C     CLREAB               VARIABLE USED TO ACCESS THE REFERENCE
C                          ABSCISSA FIELD (IN *CELLAT*) OF A CELL.
C
C     CLREOR               VARIABLE USED TO ACCESS THE REFERENCE
C                          ORDINATE FIELD (IN *CELDAT*) OF A CELL.
C
C     CNMNAB               ABSCISSA OF LEFTMOST/BOTTOMMOST TERMINAL
C                          ASSOCIATED WITH A CONNECTION.
C
C     CNMXAB               ABSCISSA OF THE RIGHTMOST/TOPMOST
C                          TERMINAL ASSOCIATED WITH A CONNECTION.
C
C     FINABS               FINAL ABSCISSA OF A TERMINAL (ABSOLUTE
C                          W.R.T. CARRIER REFERENCE POINT).
C
C     FINORD               FINAL ORDINATE OF A TERMINAL (ABSOLUTE
C                          W.R.T. CARRIER REFERENCE POINT).
C
C     GRDABS               GRID POINT OF A TERMINAL ABSCISSA.
C
C     GRDORD               GRID POINT OF A TERMINAL ORDINATE.
C
C     NUMVIA               TOTAL NUMBER OF VIAS IN LAYOUT.
C
C     ORGRD                GRID SIZE TO BE USED FOR CONVERTING
C                          THE ORDINATE OF A TERMINAL TO GRIDS
C                          AND BACK TO MILS.
C                          FOR HORIZONTAL CHANNELS, *ORGRD* IS
C                          THE VERTICAL GRID SIZE (*CRRGDY*).
C                          FOR VERTICAL CHANNELS, *ORGRD* IS
C                          THE HORIZONTAL GRID SIZE (*CRRGDX*).
C
C     ORREF                REFERENCE POINT TO BE USED FOR CONVERTING
C                          THE ORDINATE OF A TERMINAL TO GRIDS AND
C                          BACK TO MILS.
C                          FOR HORIZONTAL CHANNELS, *ORREF* IS
C                          THE LOWER-LEFT-Y OF THE ROUTABLE AREA.
C                          FOR VERTICAL CHANNELS, *ORREF* IS
C                          THE LOWER-LEFT-X OF THE ROUTABLE AREA.
C
C     PRVABS               ABSCISSA OF PREVIOUS BRANCH SEGMENT
C                          USED TO PREVENT DUPLICATION OF VIAS.
C
C     PRVLYR               LAYER OF PREVIOUS BRANCH SEGMENT
C                          USED TO PREVENT DUPLICATION OF VIAS.
C
```

```
PRVVIA              INDEX OF THE PREVIOUS VIA IN A GIVEN
                    CONNECTION

RFCLEV              CELL NUMBER OF THE DEVICE ON WHICH THE
                    FEEDTHRU OCCURS.

FFDIDX              INDEX INTO FEEDTHRU ARRAY.

SPACE               DISTANCE BETWEEN TWO VIAS IN A CONNECTION.

SRTKEY(3)           ARRAY USED TO HOLD THE FIELD NUMBERS
                    OF THE THREE SORT KEYS WHEN SORTING
                    TWO-DIMENSIONAL ARRAYS.

STOP                POINTER TO THE LAST ENTRY OF INTEREST.

STRT                POINTER TO THE FIRST ENTRY OF INTEREST.

TMPX1,Y1,X2,Y2      ENDPOINT VALUES OF A FEEDTHRU RECORD.

TMSTOP              POINTER TO THE LAST TERMINAL OF
                    A GIVEN CONNECTION.

TMSTRT              POINTER TO THE FIRST TERMINAL OF
                    A GIVEN CONNECTION.

TNKCLR              VARIABLE USED TO ACCESS THE FIELD
                    (IN *HOLDAT*) WHICH SPECIFIES THE
                    GUARDBAND FOR A TRUNK IN THE
                    CURRENT CHANNEL.

TNKMTL              VARIABLE USED TO ACCESS THE FIELD
                    (IN *HOLDAT*) WHICH SPECIFIES THE
                    METAL WIDTH FOR A TRUNK IN THE
                    CURRENT CHANNEL.

TNKLNG              LENGTH OF TRUNK.

TNKORN              ORIENTATION OF A TRUNK IN THE
                    CURRENT CHANNEL.

TYPRWS              INTEGER IMAGE OF STRING 'RWS '.

VIAFLG              LOGICAL VARIABLE INDICATING IF A VIA
                    WAS INSERTED AT A GIVEN TERMINAL ON THE
                    CONNECTION.

VIAREF              POINTER TO THE REFERENCE COORDINATE OF
                    A VIA FOR DETERMINING THE VIA-TO-VIA
                    SPACING.

VIASPC              MINIMUM VIA-TO-VIA SPACING ALLOWED.


GLOBAL VARIABLES --
NAME  DIMENSION TYPE  DESCRIPTION
----  --------- ----  -----------
(NONE)

REVISION HISTORY --
   12-SEP-86 TAF ADDED CODE TO PREVENT SAME NET VIA-TO-VIA
                 SPACING VIOLATIONS.  (SAR 6012)
   03-MAR-86 DDC ALLOWED FUTURE TERMINAL COORDINATE AND
                 DOGLEG ORDINATE VALUES OF *MININT*.  (SAR 5590)
   14-JAN-86 TAF REPLACED ABSOLUTE DOGLEG AND FUTURE
                 TERMINAL COORDINATES WITH RELATIVE
                 COORDINATES.  (SAR 5500)
   21-NOV-85 DDC REVISED ERROR CODES.  (SAR 5391)
   20-NOV-85 DDC CORRECTED ERROR FORMAT.  (SAR 5372)
   02-OCT-85 DDC ADDED ACCUMULATION OF WIRE LENGTHS, VIA
                 COUNT, AND CONNECTION COUNT FOR ENHANCED
                 REPORT.  ADDED TRACK WIDTH TO RWS RECORDS
                 GENERATED FOR *RFT*'S.  (SAR 5199)
   29-JUL-85 DDC CHECKED MODULE.
   17-DEC-84 KMP WROTE MODULE. (SAR 4856)

TESTING PLANS --
```

```
C          29-JUL-85 FDC COMPLETED UNIT TESTING.
C
C
C
C         ************************************************************
C         *                    SUBSYSTEM TOKENS                      *
C         ************************************************************
C
CS*       CHXTOKEN
C
C         ************************************************************
C         *                  VARIABLE DECLARATIONS                   *
C         ************************************************************
C
C         FORMAL PARAMETERS --
C         (NONE)
C
C         LOCAL VARIABLES --
C
          DIMENSION SRTKEY(3)
          LOGICAL   VIAFIG
C
C         SUBSYSTEM GLOBAL VARIABLES --
C
CS*       SUBSYSGLOBAT (CHX)
C
CS*       CHXCHR
CS*       CHXCEL
CS*       CHXCHN
CS*       CHXCCN
CS*       CHXTRM
CS*       CHXNET
CS*       CHXNCC
CS*       CHXREF
CS*       CHXRUL
CS*       CHXXXX
C
C         OTHER SUBSYSTEM VARIABLES --
C
CS*       ENTDAT
C
CS*       RWSEQUENT
C
C         SYSTEM GLOBAL VARIABLES --
C
CS*       SYSCOMMON
C
C
C         ************************************************************
C         *                     DATA STATEMENTS                      *
C         ************************************************************
C
C         (NONE)
C
C
C         ************************************************************
C         *                  STATEMENT FUNCTIONS                     *
C         ************************************************************
C
C         LOCAL STATEMENT FUNCTIONS --
C         (NONE)
C
C         SUBSYSTEM STATEMENT FUNCTIONS --
C         (NONE)
C
C         OTHER SUBSYSTEM STATEMENT FUNCTIONS --
C         (NONE)
C
C         SYSTEM STATEMENT FUNCTIONS --
C
CS*       SFUNCHCS1
C
C
C         ************************************************************
C         *                    EXECUTABLE CODE                       *
C         ************************************************************
C
CS*       MODENTRY (CHX) (WIRUPD) (2635) (11)
C
C         VALIDATE FORMAL PARAMETERS
CS*       MONESCRN (CTFLIX) (1) (**SICFILES) (8000)
C
          NUMVIA = 0
```

```
C
C       *******************************
C       * ABSOLUTE TERMINAL LOCATIONS *
C       *******************************
C       DETERMINING ABSOLUTE ABSCISSAE AND ORDINATES FOR ALL
C       TERMINALS. ALSO SNAP THE COORDINATES OF
C       "NORMAL" TERMINALS TO GRID IF REQUIRED (GRDSNP=1).
C
C       NOTE: WHEN *GRDSNP* IS ON (=1), THEN THE POSITIONS
C       ----    OF ALL THE "NORMAL" TERMINALS WILL BE SNAPPED
C               TO GRID. THE LOCATIONS OF "INCOMING"/"OUTGOING"
C               FUTURE TERMINALS AND THOSE OF "DOGLEG" TERMINALS
C               ARE REQUIRED TO BE ON GRID ALREADY.
C
        DO 1060 ACHAN = 1, CHNCNT
C
        ACHORN = CHNDAT(%%CHXCHNORIENT, ACHAN)
        GO TO (1001, 1002), ACHORN
C             HZ     VT
 1001   CONTINUE
C       HERE IF CHANNEL IS HORIZONTAL
        CLRFAB = %%CHXCELRFX
        CLRFOR = %%CHXCELRFY
        CHLOAB = %%CHXCHNLLX
        CHLOOR = %%CHXCHNLLY
        ABREF  = CHRRLX
        ORREF  = CHRRLY
        ABGRD  = CHRGLX
        ORGRD  = CHRGLY
        GO TO 1010
C
 1002   CONTINUE
C       HERE IF CHANNEL IS VERTICAL
        CLRFAB = %%CHXCELRFY
        CLRFOR = %%CHXCELRFX
        CHLOAB = %%CHXCHNLLY
        CHLOOR = %%CHXCHNLLX
        ABREF  = CHRRLY
        ORREF  = CHRRLX
        ABGRD  = CHRGLY
        ORGRD  = CHRGLX
        GO TO 1010
C
 1010   CONTINUE
C       LOOP THRU ALL OUTGOING FUTURE TERMINALS WITHIN CURRENT CHANNEL
        STRT = CHNDAT(%%CHXCHNOFTMPT, ACHAN)
        STOP = STRT + CHNDAT(%%CHXCHNOFTMCT, ACHAN) - 1
        IF (STRT .GT. STOP) GO TO 1040
C
        DO 1030 ATERM = STRT, STOP
CS* TRACE1WHEN [4] [TRMABS] [TRMDAT(%%CHXTRMABS, ATERM)]
CS* TRACE1WHEN [4] [TRMORD] [TRMDAT(%%CHXTRMORD, ATERM)]
C
        FINABS = TRMDAT(%%CHXTRMABS, ATERM)
        IF (FINABS .NE. MININT)
     1    FINABS = TRMDAT(%%CHXTRMABS, ATERM) + CHNDAT(CHLOAB, ACHAN)
        FINORD = TRMDAT(%%CHXTRMORD, ATERM)
        IF (FINORD .NE. MININT)
     1    FINORD = TRMDAT(%%CHXTRMORD, ATERM) + CHNDAT(CHLOOR, ACHAN)
CS* TRACE2WHEN [4] [FINABS] [FINABS] [FINORD] [FINORD]
C
        TRMDAT(%%CHXTRMABS, ATERM) = FINABS
        TRMDAT(%%CHXTRMORD, ATERM) = FINORD
C
C       LOAD CORRESPONDING INCOMING FUTURE TERMINAL
        TRMCNT = TRMCNT + 1
        IF (TRMCNT .GT. TRMMAX) GO TO 8060
        TRMDAT(%%CHXTRMCHN, TRMCNT) = TRMDAT(%%CHXTRMCH2, ATERM)
        TRMDAT(%%CHXTRMNET, TRMCNT) = TRMDAT(%%CHXTRMNET, ATERM)
        TRMDAT(%%CHXTRMCON, TRMCNT) = TRMDAT(%%CHXTRMCN2, ATERM)
        TRMDAT(%%CHXTRMCEL, TRMCNT) = 0
        IF (ACHORN .EQ.
     1      CHNDAT(%%CHXCHNORIENT, TRMDAT(%%CHXTRMCHN, TRMCNT))) THEN
          TRMDAT(%%CHXTRMABS, TRMCNT) = TRMDAT(%%CHXTRMABS, ATERM)
          TRMDAT(%%CHXTRMORD, TRMCNT) = TRMDAT(%%CHXTRMORD, ATERM)
        ELSE
          TRMDAT(%%CHXTRMABS, TRMCNT) = TRMDAT(%%CHXTRMORD, ATERM)
          TRMDAT(%%CHXTRMORD, TRMCNT) = TRMDAT(%%CHXTRMABS, ATERM)
        ENDIF
        TRMDAT(%%CHXTRMLYR, TRMCNT) = TRMDAT(%%CHXTRMLYR, ATERM)
        TRMDAT(%%CHXTRMCH2, TRMCNT) = -ACHAN
        TRMDAT(%%CHXTRMCN2, TRMCNT) = TRMDAT(%%CHXTRMCON, ATERM)
```

```
 1030     CONTINUE
C
 1040     CONTINUE
C         HERE DONE WITH ALL OUTGOING FUTURE TERMINALS
C
C         LOOP THRU ALL "NORMAL" TERMINALS WITHIN CURRENT CHANNEL
          STRT = CHNDAT($$CHXCHNCLINPT, ACHAN)
          STOP = STRT + CHNDAT($$CHXCHNCLINCT, ACHAN) - 1
          IF (STRT .GT. STOP) GO TO 1060
C
          DO 1050 ATERM = STRT, STOP
          ACELL = TRMDAT($$CHXTRMCEL, ATERM)
          IF (ACELL .LE. 0) GO TO 8040
          FINABS = TRMDAT($$CHXTRMABS, ATERM) + CELDAT(CLRFAB, ACELL)
          FINORD = TRMDAT($$CHXTRMORD, ATERM) + CELDAT(CLRFOR, ACELL)
C
          IF (GPDSNF .NE. 1) GO TO 1045
C         HERE MUST SNAP ABSCISSA AND ORDINATE OF THIS TERMINAL TO GRID.
C         THIS IS DONE BY CONVERTING THE ABSCISSA AND ORDINATE FROM
C         MMES TO GRIDS AND THEN BACK TO MMES.
          GRDABS = GRIDPT(FINABS, ABREF, ABGRD)
          GRDORD = GRIDPT(FINORD, ORREF, ORGRD)
          FINABS = G2MILS(GRDABS, ABREF, ABGRD)
          FINORD = G2MILS(GRDORD, ORREF, ORGRD)
C
 1045     CONTINUE
          TRMDAT($$CHXTRMABS, ATERM) = FINABS
          TRMDAT($$CHXTRMORD, ATERM) = FINORD
 1050     CONTINUE
C         HERE DONE WITH ALL "NORMAL" TERMINALS IN ALL CHANNELS
C
 1060     CONTINUE
C
C         LOOP THROUGH ALL DOGLEG TERMINALS IN THE DESIGN
          IF (DGTRCT .LE. 0) GO TO 1090
          DSTRT = DGTRPT
          DSTOP = DSTRT + DGTRCT - 1
C
          DO 1080 DTERM = DSTRT, DSTOP
          ACHAN = TRMDAT($$CHXTRMCHN, DTERM)
          IF (ACHAN .LE. 0) GO TO 8070
          ACHORN = CHNDAT($$CHXCHNORIENT, ACHAN)
          IF (ACHORN .EQ. 1) THEN
C            HORIZONTAL CHANNEL
             CHLCAB = $$CHXCHNLLX
             CHLCOR = $$CHXCHNLLY
          ELSE
C            VERTICAL CHANNEL
             CHLCAB = $$CHXCHNLLY
             CHLCOR = $$CHXCHNLLX
          ENDIF
C
          FINABS = TRMDAT($$CHXTRMABS, DTERM) + CHNDAT(CHLCAB, ACHAN)
          FINORD = TRMDAT($$CHXTRMORD, DTERM)
          IF (FINORD .NE. MININT)
     1    FINORD = TRMDAT($$CHXTRMORD, DTERM) + CHNDAT(CHLCOR, ACHAN)
CS* TRACF2WHEN [4] [FINABS] [FINABS] [FINORD] [FINORD]
C
          TRMDAT($$CHXTRMABS, DTERM) = FINABS
          TRMDAT($$CHXTRMORD, DTERM) = FINORD
 1080     CONTINUE
C         HERE DONE WITH ALL DOGLEG TERMINALS IN THE DESIGN
C
 1090     CONTINUE
C
C         ****************************************
C         * ASSOCIATE CONNECTIONS WITH CHANNELS *
C         ****************************************
C         IN ORDER TO ASSOCIATE CONNECTIONS WITH THEIR APPROPRIATE
C         CHANNELS, FIRST NEED TO SORT THE CONNECTIONS IN ASCENDING
C         ORDER.
C         PRIMARY   KEY: CHANNEL NUMBER TO WHICH CONNECTION BELONGS
C         SECONDARY KEY: CONNECTION NUMBER WITHIN CHANNEL
C
          IF (CONCNT .LE. 0) GO TO 8010
          CALL VISRT1(CONDAT, $$CHXCONFLD, $$@TOTCONNECT,
     1                $$CHXCONCHN, $$CHXCONNUM, CONCNT, 1)
          IF (CHXECH(11) .EQ. NUMBER) CALL CHXDMP(300)
C
          ACNPT = 1
          DO 1200 ACHAN = 1, CHNCNT
C
```

```
              ACNCT = 0
              CHNDAT(%%CHXCHNCONNPT, ACHAN) = ACNPT
C
              ACHORN = CHNDAT(%%CHXCHNORIENT, ACHAN)
              GO TO (1101, 1102), ACHORN
                       H?     V1
C
 1101         CONTINUE
C             HORIZONTAL CHANNEL
              CHLOCR = %%CHXCHNLCY
              GO TO 1150
 1102         CONTINUE
              CHLOCR = %%CHXCHNLCX
              GO TO 1150
C
 1150         CONTINUE
              IF (ACNPT .GT. CONCNT) GO TO 1160
C
C             CHECK IF CONNECTION BELONGS TO CURRENT CHANNEL
              IF (CONDAT(%%CHXCONCHN, ACNPT) .NE. ACHAN) GO TO 1160
C
C             HERE IF CONNECTION *ACNPT* BELONGS TO CHANNEL *ACHAN*.
C             DETERMINE ITS ABSOLUTE ORDINATE. RECALL THAT FAILED
C             CONNECTIONS ARE ASSIGNED AN ORDINATE = MININT BY TRK.
              ACNCRD = CONDAT(%%CHXCONCRD, ACNPT)
              IF (ACNCRD .NE. MININT)
     1           CONDAT(%%CHXCONCRD, ACNPT) = ACNCRD + CHNDAT(CHLOCR, ACHAN)
              ACNCT = ACNCT + 1
              ACNPT = ACNPT + 1
              GO TO 1150
C
 1160         CONTINUE
C             HERE IF CONNECTION *ACNPT* DOES NOT BELONG TO CHANNEL *ACHAN*
              CHNDAT(%%CHXCHNCONNCT, ACHAN) = ACNCT
C
 1200         CONTINUE
C
C             *****************************************
C             * ASSOCIATE TERMINALS WITH CONNECTIONS *
C             *****************************************
C             FIRST NEED TO SORT THE TERMINAL DATA *TRMDAT*. RECALL
C             THAT WE COULD HAVE ADDED "DOGLEG" TERMINALS WHILE ROUTING.
C             PRIMARY   KEY: CHANNEL ID (REQUIRED BECAUSE OF "DOGLEG" TERMS)
C             SECONDARY KEY: CONNECTION NUMBER
C             TERTIARY  KEY: TERMINAL ABSCISSA
C
              IF (TRMCNT .LE. 0) GO TO 8020
              SRTKEY(1) = %%CHXTRMCHN
              SRTKEY(2) = %%CHXTRMCON
              SRTKEY(3) = %%CHXTRMABS
              CALL VJSRT3(TRMDAT, %%CHXTRMFLD, %%@TCTTERMINAL,
     1                    SRTKEY, 3, TRMCNT, 1)
              IF (CHXPER(11) .EQ. MODNPR)  CALL CHXDMP(400)
C
C             NOW SET UP POINTERS FROM EACH CONNECTION TO THE FIRST
C             TERMINAL BELONGING TO IT AND A COUNT OF THE NUMBER
C             OF TERMINALS IN THAT CONNECTION.
C
              ATMPT = 1
              DO 1300 ACONN = 1, CONCNT
CS*           TRACE2WHEN [4] [ATMPT] [ATMPT] [ACONN] [ACONN]
C
              ACHAN = CONDAT(%%CHXCONCHN, ACONN)
              ACNNM = CONDAT(%%CHXCONNUM, ACONN)
CS*           TRACE2WHEN [4] [ACHAN] [ACHAN] [ACNNM] [ACNNM]
              ATMCT = 0
 1245         CONTINUE
              CONDAT(%%CHXCONTMPT, ACONN) = ATMPT
C
 1250         CONTINUE
CS*           TRACE2WHEN [4] [ATMPT] [ATMPT] [ATMCT] [ATMCT]
              IF (ATMPT .GT. TRMCNT) GO TO 1260
C
C             CHECK IF TERMINAL BELONGS TO CURRENT CHANNEL
C             *ACHAN* AND TO THE CURRENT CONNECTION *ACONN*
              IF (TRMDAT(%%CHXTRMCHN, ATMPT) .LT. ACHAN) THEN
                 ATMPT = ATMPT + 1
                 GO TO 1245
              ENDIF
CS*           TRACE2WHEN [4] [ACHAN] [ACHAN] [ATMPT] [ATMPT]
              IF (TRMDAT(%%CHXTRMCHN, ATMPT) .NE. ACHAN) GO TO 1260
              IF (TRMDAT(%%CHXTRMCON, ATMPT) .NE. ACNNM) GO TO 1260
C
```

```
C         HERE TERMINAL *ATMPT* BELONGS TO THE CURRENT
C         CONNECTION *ACONN* IN THE CURRENT CHANNEL *ACHAN*
          ATMCT = ATMCT + 1
          ATMPT = ATMPT + 1
          GO TO 1250
C
 1260     CONTINUE
C         HERE IF TERMINAL *ATMPT* DOES NOT BELONG TO CHANNEL *ACHAN*
C         OR IT DOES NOT BELONG TO CONNECTION *ACONN*.
          CONDAT($$CPXCONTMCT, ACONN) = ATMCT
C
 1300     CONTINUE
          IF (CHXPCF(11) .EQ. MODNPR)  THEN
            CALL CPXLMP(400)
            CALL CPXLMP(300)
          ENDIF
C         HERE DONE ASSOCIATING TERMINALS WITH CONNECTIONS
C
C         ************************
C         * OUTPUT WIRE SEGMENTS *
C         ************************
C         WIRE SEGMENTS ARE TO BE OUTPUT FOR EACH CONNECTION
C         AND FOR EACH "BRANCH" ASSOCIATED WITH THAT CONNECTION.
C
          TYPRWS = VISTHQ('RWS ')
          CONSUC = 0
C
          ACHAN = 0
CS*       TRACE1WHEN [3] [ACHAN] (ACHAN)
          DO 3000 ACONN = 1, CONCNT
CS*       TRACE1WHEN [4] [ACONN] [ACONN]
C
C         DETERMINE CHANNEL, ORDINATE, LAYER, AND NET OF THIS CONNECTION
          ACNCHN = CONDAT($$CHXCONCHN, ACONN)
          ACNNP  = CONDAT($$CHXCONNUM, ACONN)
          ACNORD = CONDAT($$CHXCONORD, ACONN)
          ACNLYR = CONDAT($$CHXCODLYR, ACONN)
          ACNNET = CONDAT($$CHXCONNET, ACONN)
CS*       TRACE2WHEN [4] [ACNCHN] [ACNCHN] [ACNORD] [ACNORD]
CS*       TRACE2WHEN [4] [ACNLYR] [ACNLYR] [ACNNET] [ACNNET]
C
C         NO NEED TO PROCESS FAILED CONNECTIONS
          IF (ACNCHE .EQ. MININT) GO TO 3000
          CONSUC = CONSUC + 1
C
C         SETUP TO PROCESS THIS CONNECTION
          CNMNAB = MAXINT
          CNMXAB = MININT
          ACNRUL = NETDAT($$CHXNETRUL, ACNNET)
          AVAPAD = RULDAT($$CHXRULVIA, 1, ACNRUL)
CS*       TRACE2WHEN [4] [ACNRUL] [ACNRUL] [AVAPAD] [AVAPAD]
C
          IF (ACNCHN .EQ. ACHAN) GO TO 1510
C
C         HERE IF THIS CONNECTION BELONGS TO A DIFFERENT CHANNEL.
          ACHAN  = ACNCHN
          ACHORN = CHNDAT($$CHXCHNORIENT, ACHAN)
CS*       TRACE2WHEN [3] [ACHAN] [ACHAN] [ACHORN] [ACHORN]
          GO TO (1501, 1502), ACHORN
C                H2    VT
 1501     CONTINUE
C         HORIZONTAL CHANNEL
          TNKORN =  1
          TNKMTL = $$CPXRULHZM
          TNKCLR = $$CPXRULVTC
          BCHORN =  2
          BCHMTL = $$CHXRULVTM
          BCHCLR = $$CHXRULHZC
CS*       TRACE2WHEN [3] [TNKORN] [TNKORN] [BCHORN] [BCHORN]
C         SET UP VIA-TO-VIA SPACING CHECKS
          VIASPC = CRRHVV
          VIAREF = 2
          GO TO 1510
C
 1502     CONTINUE
C         VERTICAL CHANNEL
          TNKORN =  2
          TNKMTL = $$CHXRULVTM
          TNKCLR = $$CHXRULHZC
          BCHORN =  1
          BCHMTL = $$CHXRULHZM
          BCHCLR = $$CHXRULVTC
```

```
CS*         TRACE2WHEN [3] [INKORN] [INKORN] [BCHCRN] [BCHCRN]
C           SET UP VIA-TO-VIA SPACING CHECKS
            VIASEC = CHRVVV
            VIAREF = 3
            GO TO 1510
C
 1510       CONTINUE
C           SETUP SO THAT DUPLICATE VIAS WILL NOT BE PUT IN
            PRVABS = MININT
            PRVLYR = 0
C
C           ************
C           * BRANCHES *
C           ************
C           LOOP THROUGH ALL TERMINALS OF THIS CONNECTION AND
C           OUTPUT WIRE SEGMENTS FOR THE BRANCHES FROM THE TERMINALS.
            TMSTRT = CONDAT(%%CHXCONTMPT, ACCNN)
            TMSTOP = TMSTRT + CONDAT(%%CHXCONTMCT, ACCNN) - 1
CS*         TRACE2WHEN [4] [TMSTRT] [TMSTRT] [TMSTOP] [TMSTOP]
            IF (TMSTRT .GT. TMSTOP) GO TO 3000
            PRVVIA = 0
C
            DO 2000 ATERM = TMSTRT, TMSTOP
CS*         TRACE1WHEN [4] [ATERM] [ATERM]
CS*         TRACE2WHEN [5] [ATMORD] [ATMORD] [ACNCRD] [ACNCRD]
            VIAFLG = .FALSE.
            ATMABS = TRMDAT(%%CHXTRMABS, ATERM)
            ATMORD = TRMDAT(%%CHXTRMORD, ATERM)
            ATMLYR = TRMDAT(%%CHXTRMLYR, ATERM)
            ADGCON = TRMDAT(%%CHXTRMDLG, ATERM)
CS*         TRACE1WHEN [4] [ADGCON] [ADGCON]
            IF (ADGCON .GT. 0) THEN
              ADGINX = CHNDAT(%%CHXCHNCONNPT, ACHAN) + ADGCON - 1
              ADGORD = CONDAT(%%CHXCONORD, ADGINX)
              ADGLYR = CONDAT(%%CHXCONLYR, ADGINX)
CS*         TRACE2WHEN [4] [ADGORD] [ADGORD] [ADGLYR] [ADGLYR]
            ENDIF
C
C           DETERMINE THE NEW STARTING AND ENDING ABSCISSAE
C           OF THE CURRENT CONNECTION *ACCNN* BASED ON THE
C           ABSCISSA OF THE CURRENT TERMINAL *ATERM*
            CNMNAB = VISMN2(CNMNAB, ATMABS)
            CNMXAB = VISMX2(CNMXAB, ATMABS)
C
            IF ((ADGCON .GT. 0) .AND. (ADGORD .NE. MININT))
     1        GO TO 1600
C
C           +++++++++++++++++++++++
C           + NON-DOGLEG TERMINAL +
C           +++++++++++++++++++++++
C           DETERMINE WHETHER A BRANCH WIRE SEGMENT NEEDS TO BE OUTPUT
            IF ((ATMORD .EQ. ACNCRD) .AND. (ATMLYR .EQ. ACNLYR))
     1        GO TO 1500
            BCHABS = ATMABS
            BCHOR1 = VISMN2(ATMORD, ACNCRD)
            BCHOR2 = VISMX2(ATMORD, ACNCRD)
            BCHLNG = VISABS(BCHOR1-BCHOR2)
            BCHVA1 = 0
            BCHVA2 = 0
            IF ((ATMLYR .EQ. ACNLYR) .OR.
     1          (ATMABS .EQ. PRVABS) .AND. (ATMLYR .EQ. PRVLYR))
     2        GO TO 1550
            PRVABS = ATMABS
            PRVLYR = ATMLYR
C
C           HERE CONNECTION (TRUNK) AND BRANCH ARE ON DIFFERENT LAYERS
C           AND THE CURRENT BRANCH ABSCISSA IS DIFFERENT FROM THE LAST.
C           THEREFORE MUST PUT A VIA AT THE INTERSECTION POINT.
            IF (BCHOR1 .EQ. ACNCRD) BCHVA1 = AVAFAD
            IF (BCHOR2 .EQ. ACNCRD) BCHVA2 = AVAFAD
C
 1550       CONTINUE
C           NOW OUTPUT A WIRE SEGMENT FOR THIS BRANCH.
C
C           ASSUME VERTICAL BRANCH FOR STARTERS
            RWSREX = BCHABS
            RWSREY = BCHOR1
            IF (BCHCRN .EQ. 2) GO TO 1555
C
C           HERE IF HORIZONTAL BRANCH
            RWSREX = BCHOR1
            RWSREY = BCHABS
```

```
C
 1555     CONTINUE
          RWSNET = ACNNET
          RWSSUP = 0
          RWSFTI = 0
          RWSLYR = ATMLYR
          RWSORN = BCHORN
          RWSLNG = BCHLNG
          RWSCCP = FCLLAT(BCHMTL, ATMLYR, ACNRUL)
          RWSTRK = FTTLAT(BCHCLR, ATMLYR, ACNRUL) + RWSCCP
          RWSRIP = 1
          RWSFEV = 0
          RWSLPV = 0
C
C         BEFORE WE WRITE OUT THIS WIRE, SET UP THE NECESSARY VIAS
          IF (BCHVA1 .NE. 0) THEN
C           HERE IF VIA AT ORIGIN END OF WIRE
            NUMVIA = NUMVIA + 1
            IF (NUMVIA .GT. %%SNODES) GO TO 8030
C
            VIAINF(1,NUMVIA) = RWSNET
            VIAINF(2,NUMVIA) = RWSLFX
            VIAINF(3,NUMVIA) = RWSLFY
            VIAINF(4,NUMVIA) = BCHVA1
            TOTVIA = TOTVIA + 1
            VIAFLG = .TRUE.
          ENDIF
C
          IF ((BCHVA2 .NE. 0).AND.(RWSLNG .NE. 0)) THEN
C           HERE IF VIA AT END OF WIRE
            NUMVIA = NUMVIA + 1
            IF (NUMVIA .GT. %%SNODES) GO TO 8030
C
            VIAINF(1,NUMVIA) = RWSNET
            IF (RWSORN .EQ. 1) THEN
              VIAINF(2,NUMVIA) = RWSREX + RWSLNG
              VIAINF(3,NUMVIA) = RWSREY
            ELSE
              VIAINF(2,NUMVIA) = RWSREX
              VIAINF(3,NUMVIA) = RWSREY + RWSLNG
            ENDIF
            VIAINF(4,NUMVIA) = BCHVA2
            TOTVIA = TOTVIA + 1
            VIAFLG = .TRUE.
          ENDIF
C
          IF (RWSLNG .GT. 0) THEN
            IF (WRIRAT(TYPRWS, CTFLIX)) 8010, 8010, 1590
                                        ERR   ERR   OK
C
 1590       CONTINUE
            WIRLEN(RWSLYR, RWSORN) = WIRLEN(RWSLYR, RWSORN) + RWSLNG
          ENDIF
          GO TO 1900
C
 1600     CONTINUE
C         +++++++++++++++++++
C         + DOGLEG TERMINAL +
C         +++++++++++++++++++
C         DOGLEG TERMINALS CAN OUTPUT UP TO TWO WIRE SEGMENTS --
C         ONE FROM THE TERMINAL TO THE CLOSEST CONNECTION IN
C         THE DOGLEG, AND ANOTHER BETWEEN THE TWO DOGLEG CONNECTIONS.
C
          BRVABS = ATMABS
          BRVLYR = ATMLYR
C
C         DETERMINE WHETHER A BRANCH WIRE IS ACTUALLY NEEDED.
          IF (ATMORD .EQ. ACNORD) GO TO 1700
C
C         FIRST BRANCH (FROM TERMINAL TO CLOSEST CONNECTION)
          BRLNG1 = VISABS(ATMORD-ACNORD)
          BRLNG2 = VISABS(ATMORD-ADGORD)
CS*       TRACE2WHER (5) [BRLNG1] [BRLNG1] [BRLNG2] [BRLNG2]
          IF (BRLNG1 .GT. BRLNG2) GO TO 1610
C
C         HERE IF TERMINAL IS CLOSER TO CONNECTION *ACNNN*.
C
C         HERE IF NEED BRANCH WIRE SEGMENT FROM TERMINAL TO *ACNNN*.
          BCHABS = ATMABS
          BCHOR1 = VISMN2(ATMORD, ACNORD)
          BCHLNG = BRLNG1
          GO TO 1650
C
```

```
 1610     CONTINUE
C         HERE IF TERMINAL IS CLOSER TO CONNECTION *ADGCON*.
C
C         HERE IF NEED BRANCH WIRE SEGMENT FROM CONNECTION TO *ADGCON*.
          BCHABS = ATMABS
          BCHOR1 = VISMN2(ATMORD, ADGCRD)
          BCHLNG = BHLNG2
          GO TO 1650
C
 1650     CONTINUE
C         ASSUME VERTICAL BRANCH FOR STARTERS
          RWSREX = BCHABS
          RWSREY = BCHOR1
          IF (BCHORN .EQ. 2) GO TO 1655
C
C         HERE IF HORIZONTAL BRANCH
          RWSREX = BCHOR1
          RWSREY = BCHABS
C
 1655     CONTINUE
C         NOTE: FOR DOGLEG TERMINALS, THE BRANCH FROM THE TERMINAL
C         ----   TO THE CLOSEST CONNECTION MUST NOT HAVE ANY VIAS
C                AT EITHER OF ITS ENDPOINTS.
          RWSNET = ACNNET
          RWSSUP = 0
          RWSFIL = 0
          RWSLYR = ATMLYR
          RWSORN = BCHORN
          RWSLNG = BCHLNG
          RWSCCP = RULDAT(BCHMTL, ATMLYR, ACNRUL)
          RWSTRK = RULDAT(BCHCLR, ATMLYR, ACNRUL) + RWSCCP
          RWSRIP = 1
          RWSREV = 0
          RWSOPV = 0
CS*       TRACE1WHEN [5] [BCHLNG] [BCHLNG]
          IF (WRTENT(TYPRWS, CTFLIX)) 8030, 8030, 1690
C                                     ERR   ERR   OK
C
 1690     CONTINUE
          IF (RWSLYR .NE. 0)
     1     WIRLEN(RWSLYR, RWSORN) = WIRLEN(RWSLYR, RWSORN) + RWSLNG
C
 1700     CONTINUE
C         NOW OUTPUT A BRANCH WIRE SEGMENT BETWEEN THE TWO CONNECTIONS.
C         NOTE: THIS BRANCH SEGMENT ONLY NEEDS TO BE OUTPUT ONCE --
C         ----   WHEN PROCESSING THE LOWER OF THE TWO
C                CONNECTION NUMBERS.
C
CS*       TRACE2WHEN [3] [ACNNM] [ACNNM] [ADGCON] [ADGCON]
          IF (ACNNM .GT. ADGCON)  GO TO 1900
C
C         HERE IF NEED TO OUTPUT WIRE SEGMENT BETWEEN
C         THE TWO CONNECTIONS INVOLVED IN THE DOGLEG.
          BCHABS = ATMABS
          BCHOR1 = VISMN2(ACNORD, ADGCRD)
          BCHLNG = VISABS(ACNORD-ADGCRD)
          BCHOR2 = BCHOR1 + BCHLNG
          BCHVA1 = 0
          BCHVA2 = 0
C
          IF (BCHLNG .EQ. 0)  THEN
C           DOGLEG REPRESENTS A STITCH.
C           NO NEED FOR VIAS IF BOTH CONNECTIONS ARE ON THE SAME
C           LAYER AS THE TERMINAL.
            IF ((ACNLYR .EQ. ATMLYR) .AND. (ADGLYR .EQ. ATMLYR))
     1        GO TO 1900
          ENDIF
C
          IF ((BCHOR1 .EQ. ACNORD) .AND.
     1        (ATMLYR .NE. ACNLYR)) BCHVA1 = AVAPAD
          IF ((BCHOR2 .EQ. ACNORD) .AND.
     1        (ATMLYR .NE. ACNLYR)) BCHVA2 = AVAPAD
C
          IF ((BCHOR1 .EQ. ADGCRD) .AND.
     1        (ATMLYR .NE. ADGLYR)) BCHVA1 = AVAPAD
          IF ((BCHOR2 .EQ. ADGCRD) .AND.
     1        (ATMLYR .NE. ADGLYR)) BCHVA2 = AVAPAD
C
C         ASSUME VERTICAL BRANCH FOR STARTERS
          RWSREX = BCHABS
          RWSREY = BCHOR1
          IF (BCHORN .EQ. 2) GO TO 1755
```

```
C
C       HERE IF HORIZONTAL BRANCH
        RWSREX = BCHLR1
        RWSREY = BCHAPS
C
 1755   CONTINUE
        RWSNET = ACNNET
        RWSSUB = 0
        RWSFTJ = 0
        RWSLYR = ATMLYR
        RWSORN = BCHCRN
        RWSLNG = BCHLNG
        RWSCLP = RULDAT(BCHMIL, ATMLYR, ACNRUL)
        RWSTRK = RULDAT(BCHCLR, ATMLYR, ACNRUL) + RWSCLP
        RWSKIP = 1
        RWSPEV = 0
        RWSCEV = 0
CS*     TRACE[WHEN [5] [BCHLNG] [BCHLNG]
C
C       BEFORE WE WRITE OUT THIS WIRE, SET UP THE NECESSARY VIAS
        IF (BCHVA1 .NE. 0) THEN
C         HERE IF VIA AT ORIGIN END OF WIRE
          NUMVIA = NUMVIA + 1
          IF (NUMVIA .GT. $$SNODES) GO TO 8030
C
          VIAINF(1,NUMVIA) = RWSNET
          VIAINF(2,NUMVIA) = RWSREX
          VIAINF(3,NUMVIA) = RWSREY
          VIAINF(4,NUMVIA) = BCHVA1
          TOTVIA = TOTVIA + 1
          VIAFLG = .TRUE.
        ENDIF
C
        IF ((BCHVA2 .NE. 0).AND.(RWSLNG .NE. 0)) THEN
C         HERE IF VIA AT END OF WIRE
          NUMVIA = NUMVIA + 1
          IF (NUMVIA .GT. $$SNODES) GO TO 8030
C
          VIAINF(1,NUMVIA) = RWSNET
          IF (RWSCRN .EQ. 1) THEN
            VIAINF(2,NUMVIA) = RWSREX + RWSLNG
            VIAINF(3,NUMVIA) = RWSREY
          ELSE
            VIAINF(2,NUMVIA) = RWSREX
            VIAINF(3,NUMVIA) = RWSREY + RWSLNG
          ENDIF
          VIAINF(4,NUMVIA) = BCHVA2
          TOTVIA = TOTVIA + 1
          VIAFLG = .TRUE.
        ENDIF
C
        IF (RWSLNG .GT. 0) THEN
          IF (WRITEKI(TYPRWS, C1FLIX)) 8010, 8010, 1790
C                                      ERR   ERR   OK
 1790     CONTINUE
          WIRLEN(RWSLYR, RWSCRN) = WIRLEN(RWSLYR, RWSCRN) + RWSLNG
        ENDIF
C
 1900   CONTINUE
C       IF THERE IS NO NEED TO CHECK SAME NET VIA-TO-VIA
C       SPACING, THEN MOVE ON
        IF ((VIACHK .NE. 0) .OR. (.NOT. VIAFLG)) GO TO 2000
C
C       A VIA WAS ADDED, CHECK FOR SPACING VIOLATION
        IF (PRVVIA .EQ. 0) THEN
C          THIS WAS THE FIRST VIA OF THE CONNECTION,
C          SAVE IT FOR FUTURE USE
           PRVVIA = NUMVIA
        ELSE
C          CHECK THE SPACING BETWEEN THE NEW VIA
C          AND THE PREVIOUS VIA
           SPACE = VIAINF(VIAREF, NUMVIA) - VIAINF(VIAREF, PRVVIA)
           IF (SPACE .LT. VIASPC) THEN
C             SPACING VIOLATION EXISTS, REMOVE ONE OF THE
C             VIAS AND ADD A BRANCH LAYER TRUNK BETWEEN THEM FOR
C             THE CONNECTION
C
C             OUTPUT BRANCH LAYER TRUNK
              RWSREX = VIAINF(2, PRVVIA)
              RWSREY = VIAINF(3, PRVVIA)
              RWSNET = ACNNET
              RWSSUP = 0
```

```
              RWSFII = 0
              RWSLYR = ATMLYR
              RWSCRN = INKCRN
              IF (ACHCRN .EQ. 1) THEN
C                HORIZONTAL CHANNEL
                 RWSLNG = VIAINF(2, NUMVIA) - VIAINF(2, PRVVIA)
              ELSE
C                VERTICAL CHANNEL
                 RWSLNG = VIAINF(3, NUMVIA) - VIAINF(3, PRVVIA)
              ENDIF
              RWSCLP = RULDAT(INKMIL, ATMLYR, ACNRUL)
              RWSTRK = RULDAT(INKCLR, ATMLYR, ACNRUL) + RWSCOP
              RWSHIF = 1
              IF (RWSLNG .GT. 0) THEN
                 IF (WRTENT(TYPRWS, CTFLIX) .LE. 0) GO TO 8010
                 WTHLEN(RWSLYR, RWSCRN) =
     1              WTHLEN(RWSLYR, RWSORN) + RWSLNG
              ENDIF
C
C             REMOVE *PRVVIA* BY SUBSTITUTING IT WITH *NUMVIA*
              VIAINF(1, PRVVIA) = VIAINF(1, NUMVIA)
              VIAINF(2, PRVVIA) = VIAINF(2, NUMVIA)
              VIAINF(3, PRVVIA) = VIAINF(3, NUMVIA)
              VIAINF(4, PRVVIA) = VIAINF(4, NUMVIA)
              NUMVIA = NUMVIA - 1
              TOTVIA = TOTVIA - 1
C
C             SPECIAL CASE CHECK
C             IF THERE ARE ONLY TWO TERMINALS IN THE CONNECTION,
C             REMOVE THE SECOND VIA ALSO FOR A TOTAL BRANCH ROUTE
              I = IMSTOP - IMSTRT + 1
              IF (I .EQ. 2) THEN
C                HERE IF ONLY TWO TERMINALS IN THE CONNECTION,
C                REMOVE *PRVVIA*
C                NOTE: PRVVIA SHOULD EQUAL NUMVIA AT THIS POINT,
C                      THEREFORE IT CAN BE REMOVED BY JUST
C                      DECREASING NUMVIA
                 NUMVIA = NUMVIA - 1
                 TOTVIA = TOTVIA - 1
                 PRVVIA = 0
              ENDIF
C
           ELSE
C             SET NEW PREVIOUS VIA
              PRVVIA = NUMVIA
           ENDIF
        ENDIF
C
 2000   CONTINUE
C       HERE DONE WITH ALL TERMINALS OF THIS CONNECTION
C
C       **********
C       * TRUNKS *
C       **********
C       NOW OUTPUT A WIRE SEGMENT FOR THE TRUNK.
        INKLNG = VISABS(CNMXAB-CNMNAB)
CS*     TRACE(WHEN [4] [INKLNG] [INKLNG]
        IF (INKLNG .EQ. 0) GO TO 3000
C
C       ASSUME HORIZONTAL TRUNK FOR STARTERS
        RWSHFX = CNMNAB
        RWSHFY = ACNCRD
        IF (INKCRN .EQ. 1) GO TO 2005
C
C       HERE IF VERTICAL TRUNK
        RWSHFX = ACNCRD
        RWSHFY = CNMNAB
C
 2005   CONTINUE
        RWSNET = ACNNET
        RWSSUB = 0
        RWSFII = 0
        RWSLYR = ACNLYR
        RWSORN = INKORN
        RWSLNG = INKLNG
        RWSCOP = RULDAT(INKMIL, ACNLYR, ACNRUL)
        RWSTRK = RULDAT(INKCLR, ACNLYR, ACNRUL) + RWSCOP
        RWSHIP = 1
        RWSHFV = 0
        RWSOFV = 0
        IF (WRTENT(TYPRWS, CTFLIX)) 8030, 8030, 2095
                                     ERR   ERR   OK
C
```

```
 2095     CONTINUE
          IF (RWSLYR .NE. 0)
     1     WIRLEN(RWSLYR, RWSCRN) = WIRLEN(RWSLYR, RWSCRN) + RWSLNG
C
 3000     CONTINUE
C         HERE DONE WITH ALL CONNECTIONS
C
C         ********
C         * VIAS *
C         ********
C         OUTPUT RWS RECORDS FOR ALL VIAS
          IF (NUMVIA .LE. 0) GO TO 3060
          RWSSUB = 0
          RWSFTI = 0
          RWSLYR = 0
          RWSCRN = 1
          RWSLNG = 0
          RWSCLF = 0
          RWSTRK = 0
          RWSRIP = 1
          RWSCEV = 0
          DO 3050 AVIA = 1, NUMVIA
             RWSNET = VIAINF(1, AVIA)
             RWSREX = VIAINF(2, AVIA)
             RWSREY = VIAINF(3, AVIA)
             RWSREV = VIAINF(4, AVIA)
             IF (WRTENT(TYPRWS, OTFLIX)) 8030, 8030, 3040
                                         ERR   ERR   OK
C
 3040        CONTINUE
 3050     CONTINUE
 3060     CONTINUE
C
C         *************
C         * FEEDTHRUS *
C         *************
          IF (CHXPCF(11) .EQ. MODNBR)  CALL CHXDMP(600)
C         OUTPUT RWS RECORDS FOR ALL USED FEEDTHRUS WHICH DO
C         NOT ALREADY HAVE PHYSICAL WIRING ASSOCIATED WITH THEM
          RFDIDX = 1
 3100     CONTINUE
          IF (RFDIDX .GT. RFDCNT) GO TO 3500
C         A FEEDTHRU HAS BEEN USED IF IT HAS A NON-ZERO NET FIELD.
C         A FEEDTHRU HAS PRE-EXISTING PHYSICAL WIRING IF ITS *PTH*
C            FIELD IS EQUAL TO ZERO.
          IF (( RFDDAT(%%CHXRFDNET, RFDIDX) .EQ. 0 ) .OR.
     1        ( RFDDAT(%%CHXRFDPTH, RFDIDX) .EQ. 0 )) GO TO 3200
C         HERE IF RWS RECORD NEEDS TO BE CREATED
          RFDDEV = RFDDAT(%%CHXRFDDEV, RFDIDX)
          CELRFX = CELDAT(%%CHXCELRFX, RFDDEV)
          CELRFY = CELDAT(%%CHXCELRFY, RFDDEV)
          RWSNET = RFDDAT(%%CHXRFDNET, RFDIDX)
          TMPX1  = RFDDAT(%%CHXRFDE1X, RFDIDX) + CELRFX
          TMPY1  = RFDDAT(%%CHXRFDE1Y, RFDIDX) + CELRFY
          TMPX2  = RFDDAT(%%CHXRFDE2X, RFDIDX) + CELRFX
          TMPY2  = RFDDAT(%%CHXRFDE2Y, RFDIDX) + CELRFY
          RWSREX = VISMN2(TMPX1, TMPX2)
          RWSREY = VISMN2(TMPY1, TMPY2)
          RWSLYR = RFDDAT(%%CHXRFDLYR, RFDIDX)
          RWSSUB = 0
          RWSFTI = 0
          RWSRIP = 1
          RWSREV = 0
          RWSOEV = 0
          IF (TMPX1 .EQ. TMPX2) THEN
C            VERTICAL RWS FEEDTHRU
             RWSCRN = 2
             RWSLNG = VISABS(TMPY2 - TMPY1)
          ELSE
             IF (TMPY1 .NE. TMPY2) GO TO 8050
C            HORIZONTAL RWS FEEDTHRU
             RWSCRN = 1
             RWSLNG = VISABS(TMPX2 - TMPX1)
          ENDIF
          NETRUL = NETDAT(%%CHXNETRUL, RWSNET)
          IF (RWSCRN .EQ. 2)  THEN
            MTL = %%CHXRULVTM
            CLR = %%CHXRULHZC
          ELSE
            MTL = %%CHXRULHZM
            CLR = %%CHXRULVTC
          ENDIF
          RWSCLP = RULDAT(MTL, RWSLYR, NETRUL)
```

```
              RWSTRK = RELCAT(CLR, RWSLYR, NETRUL) + RWSCOP
              IF (WRTERI(1)FRWS, OTFLIX)) 8030, 8030, 3190
C                                       ERR    ERR    OK
 3190         CONTINUE
              IF (RWSLYR .NE. 0)
     1         WIPLEN(RWSLYR, RWSORN) = WIRLEN(RWSLYR, RWSCRN) + RWSLNG
 3200         CONTINUE
C             GET NEXT FEEDTHRU RECORD
              FFDIDX = FFDIDX + 1
              GO TO 3100
 3500         CONTINUE
C
C             ************
C             * ALL DONE *
C             ************
              GO TO 9000
C
C
C             ***********************************************************
C             *                      ERROR RETURNS                      *
C             ***********************************************************
C
 8000         CONTINUE
C/            CHX - INPUT PARAMETER *OTFLIX* WHICH SPECIFIES THE INDEX OF
C/                  THE OUTPUT DESIGN FILE IS OUT-OF-RANGE.
C/            **FM(1X,'OTFLIX = ',I6,6X,'LIMIT = ',I6)
              CALL VISERR(MCDNBR, 6263501, OTFLIX, %%$ILFILES)
              GO TO 9000
 8010         CONTINUE
C/            CHX - UNABLE TO CREATE WIRE SEGMENTS DURING DESIGN FILE
C/                  UPDATE. DESIGN CONTAINS NO CONNECTIONS.
C/            **FM(1X,'NUMBER OF CONNECTIONS = ',I6,6X,'LIMIT = ',I6)
              CALL VISERR(MCDNBR, 8263502, CONCNT, CCNMAX)
              GO TO 9000
 8020         CONTINUE
C/            CHX - UNABLE TO CREATE WIRE SEGMENTS DURING DESIGN
C/                  FILE UPDATE.  DESIGN CONTAINS NO TERMINALS.
C/            **FM(1X,'NUMBER OF TERMINALS = ',I6,6X,'LIMIT = ',I6)
              CALL VISERR(MCDNBR, 8263503, TRMCNT, TRMMAX)
              GO TO 9000
 8030         CONTINUE
C/            CHX - ERROR WHILE ATTEMPTING TO WRITE WIRE SEGMENT
C/                  DESCRIPTION DURING DESIGN FILE UPDATE.
C/            **FM(1X,'FILE INDEX = ',I6,6X,'UNIT NUMBER = ',I6)
              CALL VISERR(MCDNBR, 8263504, OTFLIX, IOFILF(OTFLIX))
              GO TO 9000
 8040         CONTINUE
C/            CHX - DURING SETUP FOR OUTPUT OF WIRE SEGMENTS TO NEW
C/                  DESIGN FILE, A "NORMAL" TERMINAL WAS ENCOUNTERED
C/                  WHICH DID NOT HAVE A CELL ASSOCIATED WITH IT.
C/            **FM(1X,'TERMINAL NUMBER = ',I6,6X,'CELL NUMBER = ',I6)
              CALL VISERR(MCDNBR, 8263505, ATERM, ACELL)
              GO TO 9000
 8050         CONTINUE
C/            CHX - DURING THE OUTPUT OF RWS RECORDS FOR FEEDTHRUS, AN RFD
C/                  RECORD WAS FOUND WHICH CONSISTED OF A DIAGONAL PATH.
C/                  DIAGONAL FEEDTHRUS ARE UNSUPPORTED AT THIS TIME.
C/                  NO RWS RECORD WAS OUTPUT.
C/            **FM(1X,'FEEDTHRU NUMBER = ',I8,6X,'NET NUMBER = ',I8)
              CALL VISERR(MCDNBR, 6263506, RFDIDX, RWSNET)
              GO TO 3200
 8060         CONTINUE
C/            CHX - TOO MANY TERMINALS DEFINED IN THE DESIGN.
C/            **FM(1X,'NO. OF TERMINALS = ',I6,6X,'LIMIT = ',I6)
              CALL VISERR(MCDNBR, 8263507, TRMCNT, TRMMAX)
              GO TO 9000
 8070         CONTINUE
C/            CHX - ILLEGAL CHANNEL INDEX ON A DOGLEG TERMINAL.
C/            **FM(1X,'TERMINAL NUMBER = ',I8,' CHAN INDEX = ',I8)
              CALL VISERR(MCDNBR, 8263508, DTERM, ACHAN)
              GO TO 9000
C
C
C             ***********************************************************
C             *              SINGLE EXIT FROM THIS ROUTINE              *
C             ***********************************************************
C
 9000         CONTINUE
CS*   TRACE2WHEN [2] [LYR1HZ] [WIRLEN(1,1)] [LYR1VT] [WIRLEN(1,2)]
CS*   TRACE2WHEN [2] [LYR2HZ] [WIRLEN(2,1)] [LYR2VT] [WIRLEN(2,2)]
CS*   TRACE2WHEN [2] [CONCNT] [CONCNT] [CONSUC] [CONSUC]
CS*   MCDEXIT [CHX]
```

```
      RETURN

      ****************************************************************
      *                      FORMAT STATEMENTS                       *
      ****************************************************************

      (NONE)

      END WIRDEE 2635
      END
```

```
DIGITAL EQUIPMENT CORPORATION - VAX/VMS VERSION V4.4

KMP

S2636

FOR

;1

FILE _$1$DUA6:[FEL.CPXC2]S2636.FOR;1 (2418,1,1), LAST REVISED ON 21-OCT-1986 08:44, IS A 27 BLOCK SEQUENTIAL FILE OWNED BY UIC
[PFDTST,FEC].  THE RECORDS ARE VARIABLE LENGTH WITH IMPLIED (CR) CARRIAGE CONTROL.  THE LONGEST RECORD IS 72 BYTES.

JOB S2636 (218) QUEUED TO SYS$PRINT ON 4-DEC-1986 12:51 BY USER KMP, UIC [ENGVLSI,KMP], UNDER ACCOUNT ENGFKG AT PRIORITY 100,
STARTED ON PRINTER _TCN106LPA0: ON 4-DEC-1986 13:06 FROM QUEUE SYS$PRINT.

DIGITAL EQUIPMENT CORPORATION - VAX/VMS VERSION V4.4
```

```
      SUBROUTINE RAILOD(FILINX)
C
CS*   ALLINTEG
C
C                         ****************
C                         *              *
C     SUBSYSTEM CHX       *  2636 RAILOD *
C                         *              *
C                         ****************
C
C     ****************************************************************
C     ****************************************************************
C     **                                                            **
C     **  (C) COPYRIGHT V-R INFORMATION SYSTEMS, INC. 1984          **
C     **  LICENSED MATERIAL -- PROGRAM PROPERTY OF VRIS             **
C     **  ALL RIGHTS RESERVED                                       **
C     **                                                            **
C     **  THIS PROGRAM IS THE PROPERTY OF VRIS AND IS FURNISHED     **
C     **  PURSUANT TO A WRITTEN LICENSE AGREEMENT. IT MAY NOT BE    **
C     **  USED, REPRODUCED, OR DISCLOSED TO OTHERS EXCEPT IN        **
C     **  ACCORDANCE WITH THE TERMS AND CONDITIONS OF THAT          **
C     **  AGREEMENT.                                                **
C     **                                                            **
C     ****************************************************************
C     ****************************************************************
C
C     ****************************************************************
C     *                   MODULE DOCUMENTATION                       *
C     ****************************************************************
C
C     SUMMARY --
C
C     THIS SUBROUTINE LOADS POWER/GROUND RAIL DEFINITIONS *RRL*
C     RECORDS FROM THE INPUT DESIGN FILE.  EACH RAIL IS IDENTIFIED
C     AS BELONGING TO EITHER THE CORE OR THE I/O RING FOR USE IN
C     AUTOMATIC DEFINITION OF POWER/GROUND WIRING.
C
C     THE INPUT DESIGN FILE IS ASSUMED TO BE OPEN WHEN THIS ROUTINE
C     IS CALLED AND IS LEFT OPEN UPON COMPLETION OF THIS ROUTINE.
C
C     FORMAL PARAMETERS --
C     NAME  DIMENSION TYPE  IN/OUT  DESCRIPTION
C     ----  --------- ----  ------  -----------
C     FILINX            I     IN    INDEX INTO THE *IOFILE* ARRAY
C                                   OF THE INPUT DESIGN FILE.
C
C     LOCAL VARIABLES --
C     NAME  DIMENSION TYPE  DESCRIPTION
C     ----  --------- ----  -----------
C     ACHAN                 CHANNEL IDENTIFICATION NUMBER.
C
C     ACHORN                CHANNEL ORIENTATION.
C                             1 = HORIZONTAL
C                             2 = VERTICAL
C
C     ACNT                  RAIL COUNT.
C
C     ALAYER                RAIL LAYER.
C
C     ALLX                  RAIL LOWER LEFT X.
C
C     ALLY                  RAIL LOWER LEFT Y.
C
C     ANET                  RAIL NET.
C
C     ARAIL                 INDEX INTO *RALDAT* ARRAY.
C
C     ATYPE                 RAIL TYPE: CORE = $$CHXTYCORE
C                                      RING = $$CHXTYRING.
C
C     AURX                  RAIL UPPER RIGHT X.
C
C     AURY                  RAIL UPPER RIGHT Y.
C
C     CORELX                CORE AREA LOWER LEFT X.
C
C     CORELY                CORE AREA LOWER LEFT Y.
C
C     CORERX                CORE AREA UPPER RIGHT X.
```

```
C       CORFUY              CORE AREA UPPER RIGHT Y.
C       PGNEIN              POWER/GROUND NET NUMBER.
C       RECTYP              RECORD TYPE.
C
C       GLOBAL VARIABLES --
C       NAME  DIMENSION TYPE  DESCRIPTION
C       ----  --------- ----  -----------
C       (NONE)
C
C       REVISION HISTORY --
C          22-NOV-85 DDC ADDED SUPPORT FOR ENDCAP CELLS.  (SAR 5375)
C          21-NOV-85 DDC REVISED ERROR CODES.  (SAR 5391)
C          02-OCT-85 DDC ADDED FLAG OF *MAXINT* FOR NET OF
C                        FIRST RAIL RECORD FOR THE CASE WHEN
C                        THERE ARE NO POWER/GROUND RAILS DEFINED.
C                        (SAR 5199)
C          06-AUG-85 TAF CHECKED MODULE.
C          06-MAY-85 DDC WROTE MODULE.  (SAR 4856)
C
C       TESTING PLANS --
C          29-JUL-85 DDC COMPLETED UNIT TESTING.
C
C       ***************************************************************
C       *                    SUBSYSTEM TOKENS                         *
C       ***************************************************************
C
CS*     CHXTOKEN
C
C       ***************************************************************
C       *                 VARIABLE DECLARATIONS                       *
C       ***************************************************************
C
C       FORMAL PARAMETERS --
C       (NONE)
C
C       LOCAL VARIABLES --
C       (NONE)
C
C       SUBSYSTEM GLOBAL VARIABLES --
C
CS*     SUBSYSGLDAT [CHX]
C
CS*     CHXCHN
CS*     CHXCRR
CS*     CHXRAL
C
C       OTHER SUBSYSTEM VARIABLES --
C
CS*     ENTDAT
C
CS*     RPFEQUENT
C
C       SYSTEM GLOBAL VARIABLES --
C
CS*     SYSCOMMON
C
C       ***************************************************************
C       *                    DATA STATEMENTS                          *
C       ***************************************************************
C
C       (NONE)
C
C       ***************************************************************
C       *                  STATEMENT FUNCTIONS                        *
C       ***************************************************************
C
C       LOCAL STATEMENT FUNCTIONS --
C       (NONE)
C
C       SUBSYSTEM STATEMENT FUNCTIONS --
C       (NONE)
C
C       OTHER SUBSYSTEM STATEMENT FUNCTIONS --
```

```
C          (NONE)
C
C          SYSTEM STATEMENT FUNCTIONS --
C
CS*        SFUNCHLS!
C
C
C          *****************************************************************
C          *                        EXECUTABLE CODE                        *
C          *****************************************************************
C
CS*        MODENTRY [CHX] [RAILCD] [2636] [12]
C
           RECTYP = VISTRG('RPL ')
C          ******************
C          * LOAD RAIL DATA *
C          ******************
 1000      CONTINUE
           IF (NXTENT(RECTYP, FILINX)) 8000, 2000, 1010
C                                      ERR   NONE   OK
C
 1010      CONTINUE
           RALCNT = RALCNT + 1
CS*        BOUNDSCHK [RALCNT] [0] [RALMAX] [8100]
           RALDAT(%%CHXRALE1X, RALCNT) = RRLE1X
           RALDAT(%%CHXRALE1Y, RALCNT) = RRLE1Y
           RALDAT(%%CHXRALCL1, RALCNT) = RRLCL1
           RALDAT(%%CHXRALE2X, RALCNT) = RRLE2X
           RALDAT(%%CHXRALE2Y, RALCNT) = RRLE2Y
           RALDAT(%%CHXRALCL2, RALCNT) = RRLCL2
           RALDAT(%%CHXRALLYR, RALCNT) = RRLLYR
           RALDAT(%%CHXRALNET, RALCNT) = RRLNET
           GO TO 1000
C
 2000      CONTINUE
C          HERE ALL RAILS ARE LOADED.
C          EXIT IF NONE EXIST.
           IF (RALCNT .EQ. 0)  THEN
C             SET NET FIELD OF FIRST RECORD TO *MAXINT*
C             SINCE THE FIRST RAIL NET IS USED TO DETERMINE
C             IF A CONNECTION BELONGS TO A POWER/GROUND NET.
              RALDAT(%%CHXRALNET, 1) = MAXINT
              GO TO 9000
           ENDIF
C
C          NOW SORT BY NET IN ASCENDING ORDER.
           CALL VISRT1(RALDAT, %%CHXRALFLD, %%RICTRAIL,
     1                 %%CHXRALNET, %%CHXRALNET, RALCNT, 1)
C
C
C          ************************************
C          * DETERMINE RAIL TYPE FOR EACH NET *
C          ************************************
C          FIRST DETERMINE BOUNDARY OF CORE AREA.
           CORELX = CHPRUX
           CORELY = CHPRUY
           COREUX = CHPRLX
           COREUY = CHPRLY
CS* TRACE2WHEN [3] [CORELX] [CORELX] [CORELY] [CORELY]
CS* TRACE2WHEN [3] [COREUX] [COREUX] [COREUY] [COREUY]
CS* TRACE1WHEN [3] [CHNCNT] [CHNCNT]
           DO 3000 ACHAN = 1, CHNCNT
CS* TRACE1WHEN [3] [ACHAN] [ACHAN]
              ACHORN = CHNDAT(%%CHXCHNORIENT, ACHAN)
CS* TRACE1WHEN [4] [ACHORN] [ACHORN]
              IF (ACHORN .EQ. 1)  THEN
C                HORIZONTAL CHANNEL.  ADJUST TOP AND BOTTOM
C                CORE BOUNDARIES.
                 COREUY = VISMX2(COREUY, CHNDAT(%%CHXCHNURY, ACHAN))
                 CORELY = VISMN2(CORELY, CHNDAT(%%CHXCHNLLY, ACHAN))
              ELSE
C                VERTICAL CHANNEL.  ADJUST LEFT AND RIGHT
C                CORE BOUNDARIES.
                 CORELX = VISMN2(CORELX, CHNDAT(%%CHXCHNLLX, ACHAN))
                 COREUX = VISMX2(COREUX, CHNDAT(%%CHXCHNURX, ACHAN))
              ENDIF
CS* TRACE2WHEN [4] [CORELX] [CORELX] [CORELY] [CORELY]
CS* TRACE2WHEN [4] [COREUX] [COREUX] [COREUY] [COREUY]
 3000      CONTINUE
CS* TRACE2WHEN [3] [CORELX] [CORELX] [CORELY] [CORELY]
CS* TRACE2WHEN [3] [COREUY] [COREUX] [COREUY] [COREUY]
C
```

```
C         NOW, FOR EACH NET IN *RAILDAT* ARRAY, SET RAIL TYPE
C         AND LAYER, START RAIL AND NUMBER OF RAILS.
          PGNETN = 0
          PGNCNT = 0
          DO 5000 ARAIL = 1, RALCNT
CS* TRACE2WHEN [4] [ARAIL] [ARAIL] [PGNCNT] [PGNCNT]
          ANET = RALDAT(%%CHXRALNET, ARAIL)
          ALAYER = RALDAT(%%CHXRALLYR, ARAIL)
CS* TRACE2WHEN [4] [ANET] [ANET] [ALAYER] [ALAYER]
          ALLX = RAILDAT(%%CHXRALE1X, ARAIL)
          AURX = RALDAT(%%CHXRALE2X, ARAIL)
          ALLY = RALDAT(%%CHXRALE1Y, ARAIL)
          AURY = RALDAT(%%CHXRALE2Y, ARAIL)
CS* TRACE2WHEN [4] [ENDPT1X] [ALLX] [ENDPT1Y] [ALLY]
CS* TRACE2WHEN [4] [ENDPT2X] [AURX] [ENDPT2Y] [AURY]
C
          IF (((ALLX .GT. CORELX) .AND. (ALLX .LT. COREUX)) .AND.
     1        ((ALLY .GT. CORELY) .AND. (ALLY .LT. COREUY))) THEN
C           HERE, ONE ENDPOINT IS WITHIN THE CORE AREA.
C           HENCE THE SECOND ENDPOINT MUST BE WITHIN THE CORE AREA.
            ATYPE = %%CPXTYCORE
          ELSE
C           HERE, ONE ENDPOINT IS OUTSIDE THE CORE AREA.
C           HENCE THE OTHER ENDPOINT MUST BE OUTSIDE THE CORE AREA.
            ATYPE = %%CPXTYRING
          ENDIF
CS* TRACE1WHEN [4] [ATYPE] [ATYPE]
C
          IF (ANET .EQ. PGNETN) THEN
C           INCREMENT COUNT OF RAILS
            ACNT = ACNT + 1
C           CHECK TYPE AND LAYER OF THIS RAIL FOR
C           COMPATIBILITY WITH OTHER RAILS IN THIS NET.
            IF (ATYPE .NE. PGNDAT(%%CHXPGNTYP, PGNCNT)) GO TO 8200
            IF ((ATYPE .EQ. %%CHXTYRING) .AND. (CHXECP(4) .EQ. 1)) THEN
              IF (ALAYER .NE. PGNDAT(%%CHXPGNLYR, PGNCNT)) GO TO 8200
            ENDIF
          ELSE
C           HERE HAVE NEW RAIL NET.
C           SET COUNT FOR PREVIOUS RAIL NET.
            IF (PGNETN .NE. 0) PGNDAT(%%CHXPGNRALCT, PGNCNT) = ACNT
C           SET NET, TYPE, LAYER, AND POINTER
C           TO FIRST RAIL. INITIALIZE RAIL COUNT.
            PGNCNT = PGNCNT + 1
CS* TRACE1WHEN [3] [PGNCNT +] [PGNCNT]
CS*         BOUNDSCHK [PGNCNT] [1] [PGNMAX] [8300]
            PGNDAT(%%CHXPGNETN, PGNCNT) = ANET
            PGNDAT(%%CHXPGNTYP, PGNCNT) = ATYPE
            PGNDAT(%%CHXPGNLYR, PGNCNT) = ALAYER
            PGNDAT(%%CHXPGNRALPT, PGNCNT) = ARAIL
            ACNT = 1
            PGNETN = ANET
          ENDIF
 5000     CONTINUE
C         STORE RAIL COUNT FOR LAST P/G NET.
          IF (PGNETN .NE. 0) PGNDAT(%%CHXPGNRALCT, PGNCNT) = ACNT
C
C         ************
C         * ALL DONE *
C         ************
          GO TO 9000
C
C
C         ***********************************************************
C         *                     ERROR RETURNS                       *
C         ***********************************************************
C
 8000     CONTINUE
C/        CHX - ERROR READING POWER/GROUND RAIL DESCRIPTIONS,
C/              *RAL* RECORDS, FROM THE INPUT DESIGN FILE.
C/        **FM(1X,'FILE INDEX = ',I6,6X,'UNIT NUMBER = ',I6)
          CALL VISERR(MCDNAM, H263601, FILINX, IOFILE(FILINX))
          GO TO 9000
 8100     CONTINUE
C/        CHX - TOO MANY POWER/GROUND RAILS IN INPUT DESIGN
C/              FILE.
C/        **FM(1X,'NO. OF RAILS = ',I6,6X,'LIMIT = ',I6)
          CALL VISERR(MCDNAM, H263602, RALCNT, RALMAX)
          GO TO 9000
 8200     CONTINUE
C/        CHX - ERROR DURING LOAD OF POWER/GROUND RAIL DESCRIPTIONS.
C/              RAIL IN CURRENT NET DOES NOT MATCH LAYER AND TYPE
```

```
C/              OF PREVIOUS RAIL IN THIS NET.
C/      **FM(1X,'RAIL NET = ',I6,6X,'TYPE = ',I6)
        CALL VISERR(MCDNBR, 8263603, ANET, ATYPE)
        GO TO 9000
 8300   CONTINUE
        CHX - TOO MANY POWER/GROUND NETS IN DESIGN FILE.
C/      **FM(1X,'NO. OF P/G NETS = ',I6,6X,'LIMIT = ',I6)
C/      CALL VISERR(MCDNBR, 8263604, PGNCNT, PGNMAX)
C
C
C       ****************************************************************
C       *                SINGLE EXIT FROM THIS ROUTINE                 *
C       ****************************************************************
C
 9000   CONTINUE
        IF (CHXPER(11) .EQ. MCDNPE)  CALL CHXERR(900)
CS*     MCEXIT (CHX)
        RETURN
C
C
C       ****************************************************************
C       *                     FORMAT STATEMENTS                        *
C       ****************************************************************
C
C       (NONE)
C
        END RAILCD 2636
        END
```

0 273 261

```
VAX/VMS VAX/VMS VAX/VMS VAX/VMS VAX/VMS VAX/VMS VAX/VMS VAX/VMS VAX/VMS VAX/VMS VAX/VMS VAX/VMS
DIGITAL EQUIPMENT CORPORATION - VAX/VMS VERSION V4.4

KMP

S2637

FOR

;2

FILE _$1$DUA6:[PHL.CHX02]S2637.FOR;2 (2419,1,1), LAST REVISED ON 21-OCT-1986 08:44, IS A 60 BLOCK SEQUENTIAL FILE OWNED BY UIC
[PHOTS1,PFC]. THE RECORDS ARE VARIABLE LENGTH WITH IMPLIED (CR) CARRIAGE CONTROL. THE LONGEST RECORD IS 77 BYTES.

JOB S2637 (219) QUEUED TO SYS$PRINT ON 4-DEC-1986 12:51 BY USER KMP, UIC [ENGVLSI,KMP], UNDER ACCOUNT ENGBKG AT PRIORITY 3, STARTED
ON PRINTER _ICNTCSLPA0: ON 4-DEC-1986 13:24 FROM QUEUE SYS$PRINT.

DIGITAL EQUIPMENT CORPORATION - VAX/VMS VERSION V4.4
```

```
C     SUBROUTINE PGCORE
CS*   ALLINTEG
C
C                      ******************
C     SUBSYSTEM CHX    *                *
C                      *   2637 PGCORE  *
C                      *                *
C                      ******************
C
C     ******************************************************************
C     ******************************************************************
C     **                                                              **
C     **   (C) COPYRIGHT V-R INFORMATION SYSTEMS, INC. 1984           **
C     **   LICENSED MATERIAL -- PROGRAM PROPERTY OF VRIS              **
C     **   ALL RIGHTS RESERVED                                        **
C     **                                                              **
C     **   THIS PROGRAM IS THE PROPERTY OF VRIS AND IS FURNISHED      **
C     **   PURSUANT TO A WRITTEN LICENSE AGREEMENT. IT MAY NOT BE     **
C     **   USED, REPRODUCED, OR DISCLOSED TO OTHERS EXCEPT IN         **
C     **   ACCORDANCE WITH THE TERMS AND CONDITIONS OF THAT           **
C     **   AGREEMENT.                                                 **
C     **                                                              **
C     ******************************************************************
C     ******************************************************************
C
C     ******************************************************************
C     *                    MODULE DOCUMENTATION                        *
C     ******************************************************************
C
C     SUMMARY --
C
C     WHEN CHXPCE(3) EQUALS 1, THIS SUBROUTINE IS CALLED TO DEFINE
C     THE CORE AREA GLOBAL ROUTES TO CONNECT THE POWER/GROUND RAILS
C     TO THE NODES OF THE BUS CONNECTOR CELLS.
C
C     IT IS ASSUMED THAT THE RIGHT-MOST TOP I/O CELL AND THE
C     LEFT-MOST BOTTOM I/O CELL ARE THE BUS CONNECTORS.  THE NODES
C     FROM THESE CELLS ARE DEFINED IF GLOBAL ROUTES - THE TOP
C     RIGHT NODE ROUTING TO THE RAIL ENDPOINTS IN THE
C     RIGHT-MOST VERTICAL CHANNEL; THE BOTTOM LEFT NODE TO THE
C     RAIL ENDPOINTS IN THE LEFT-MOST VERTICAL CHANNEL.
C
C     THESE DESCRIPTIONS ARE CONVERTED INTO "CONNECTIONS",
C     "TERMINALS", AND "FUTURE TERMINALS" -  THE LAYER OF THE NODE
C     DETERMINING THE LAYER OF THE CONNECTION.  IF THE POSITION OF
C     THE NODE IS TO THE OUTSIDE OF THE RAIL ENDPOINTS - IT WILL
C     ALSO DETERMINE THE POSITION OF THE CONNECTION IN THE VERTICAL
C     CHANNEL; OTHERWISE, A CONNECTION WILL ALSO BE DEFINED IN THE
C     TOP OR BOTTOM CHANNEL, PASSING FROM THE NODE INTO THE
C     VERTICAL CHANNEL.
C
C
C     FORMAL PARAMETERS --
C     NAME  DIMENSION TYPE   IN/OUT   DESCRIPTION
C     ----  --------- ----   ------   -----------
C     (NONE)
C
C     LOCAL VARIABLES --
C     NAME  DIMENSION TYPE  DESCRIPTION
C     ----  --------- ----  -----------
C     ACELL                 CELL NUMBER.
C
C     ACHAN                 CHANNEL IDENTIFICATION NUMBER.
C
C     ACHORN                CHANNEL ORIENTATION.
C                             1 = HORIZONTAL
C                             2 = VERTICAL
C     ACNMBT                CONNECTION NUMBER IN BOTTOM CHANNEL.
C
C     ACNMLF                CONNECTION NUMBER IN LEFT CHANNEL.
C
C     ACNMRG                CONNECTIN NUMBER IN RIGHT CHANNEL.
C
C     ACNMTP                CONNECTION NUMBER IN TOP CHANNEL.
C
C     ANDCNT                NUMBER OF NODES IN THE CELL OF INTEREST.
```

```
C        ANCDE          POINTER TO A NODE IN *NCDDAT* ARRAY.
C        APGN           INDEX INTO POWER/GROUND NET DATA,
C                       *PGNDAT*, ARRAY.
C        APGNET         NET NUMBER OF CURRENT ENTRY IN *PGNDAT* ARRAY.
C        ARAIL          INDEX INTO RAIL DATA ARRAY *RALDAT*.
C        ASTART         POINTER TO FIRST NODE OF INTEREST IN
C                       *NODDAT* ARRAY.
C        ASTOP          POINTER TO LAST NODE OF INTEREST IN
C                       *NODDAT* ARRAY.
C        ATRMIX         TERMINAL ENTRY INDEX INTO *TRMDAT* ARRAY.
C  GL    BOTCHN         BOTTOM HORIZONTAL CHANNEL NUMBER.
C        CELLFT         CELL NUMBER OF LEFTMOST CELL IN BOTTOM
C                       ROW OF I/O CELLS
C        CELLRT         CELL NUMBER OF RIGHTMOST CELL IN TOP
C                       ROW OF I/O CELLS.
C        CORINX         INDEX INTO *PGNDAT* ARRAY OF CORE AREA
C                       NET ENTRY.
C        CORNET         NET NUMBER OF CORE AREA POWER/GROUND
C                       ROUTE.
C        FINABS         FINAL ABSCISSA VALUE OF NODE REFERENCE
C                       ABSCISSA WHEN SNAPPED TO GRID.
C        GRDABS         GRID VALUE OF THE NODE REFERENCE ABSCISSA.
C  GL    LEFCHN         LEFT VERTICAL CHANNEL NUMBER.
C        MINCLR         MINIMUM WIRE CLEARANCE.
C        MODINX         MODULE INDEX NUMBER.
C        NODLYR         NODE LAYER.
C        NODREFX/Y      NODE REFERENCE X/Y VALUE.
C        PADWID         PAD TRACK WIDTH.
C        PCODE          PAD CODE.
C        RALCL1         CELL NUMBER ON WHICH RAIL'S FIRST
C                       ENDPOINT OCCURS.
C        RALCL2         CELL NUMBER ON WHICH RAIL'S SECOND
C                       ENDPOINT OCCURS.
C        RCNT           NUMBER OF RAILS IN *RALDAT* ARRAY FOR
C                       CURRENT CORE AREA NET.
C  GL    RIGCHN         RIGHT VERTICAL CHANNEL NUMBER.
C        RSTART         INDEX TO FIRST RAIL OF INTEREST.
C        RSTOP          INDEX TO LAST RAIL OF INTEREST.
C  GL    TOPCHN         TOP HORIZONTAL CHANNEL NUMBER.
C        TRMABS         TERMINAL ABSCISSA.
C        TRMORD         TERMINAL ORDINATE.
C        WIRULE         WIRE RULE INDEX.
C        WIRWID         WIRE TRACK WIDTH.
C
C        GLOBAL VARIABLES --
C        NAME   DIMENSION TYPE   DESCRIPTION
C        ----   --------- ----   -----------
C        (NONE)
```

```
C
C     REVISION HISTORY --
C        14-JAN-86 TAF REPLACED ABSOLUTE DEGLEG AND FUTURE
C                      TERMINAL COORDINATES WITH RELATIVE
C                      COORDINATES.  (SAR 5500)
C        21-NOV-85 DDC REVISED ERROR CODES.  (SAR 5351)
C        20-NOV-85 DDC CORRECTED ERROR FORMATS.  (SAR 5372)
C        04-SEP-85 DDC MADE GLOBAL VARIABLES OF TCFCHN, PCTCHN,
C                      LEFCHN, AND FIGCHN.  CORRECTED CHECK FOR
C                      CORE AREA NODE.  (SAR 5195)
C        DD-MMM-YY TAF CHECKED MODULE.
C        06-MAY-85 DDC WROTE MODULE.  (SAR 4656)
C
C     TESTING PLANS --
C        29-JUL-85 DDC COMPLETED UNIT TESTING.
C
C     ****************************************************************
C     *                     SUBSYSTEM TOKENS                         *
C     ****************************************************************
C
CS*   CHXTOKEN
C
C     ****************************************************************
C     *                   VARIABLE DECLARATIONS                      *
C     ****************************************************************
C
C     FORMAL PARAMETERS --
C     (NONE)
C
C     LOCAL VARIABLES --
C
C     SUBSYSTEM GLOBAL VARIABLES --
C
CS*   SUBSYSCOMMON [CHX]
C
CS*   CHXARG
CS*   CHXCEL
CS*   CHXCHN
CS*   CHXCON
CS*   CHXCRR
CS*   CHXNET
CS*   CHXNOD
CS*   CHXPAL
CS*   CHXRUL
CS*   CHXTRM
C
C     OTHER SUBSYSTEM VARIABLES --
C
CS*   ENTDAT
C
C     SYSTEM GLOBAL VARIABLES --
C
CS*   SYSCOMMON
C
C     ****************************************************************
C     *                      DATA STATEMENTS                         *
C     ****************************************************************
C
C     (NONE)
C
C     ****************************************************************
C     *                    STATEMENT FUNCTIONS                       *
C     ****************************************************************
C
C     LOCAL STATEMENT FUNCTIONS --
C     (NONE)
C
C     SUBSYSTEM STATEMENT FUNCTIONS --
C     (NONE)
C
C     OTHER SUBSYSTEM STATEMENT FUNCTIONS --
C     (NONE)
C
C     SYSTEM STATEMENT FUNCTIONS --
```

```
CS*       SEHHCHEES
C
C
C         ***************************************************************
C         *                      EXECUTABLE CODE                        *
C         ***************************************************************
C
CS*       NODENTRY [CHX] [PGLCRE] [2637] [13]
C
CS* TRACE2WHEN [2] [TRMCNT] [TRMCNT] [CONCNT] [CONCNT]
C         INITIALIZE CONNECTION NUMBERS FOR CONNECTIONS
C         INTO TOP/BOTTOM LEFT/RIGHT CHANNELS
          ACNBRG = 0
          ACNMLF = 0
          ACNMTP = 0
          ACNMRT = 0
C
C         ***************************
C         ***************************
C         * RIGHT VERTICAL CHANNEL *
C         ***************************
C         ***************************
C
C         *************************************
C         * IDENTIFY RIGHT-MOST TOP I/O CELL *
C         *************************************
C         GET FIRST CELL ON HIGH SIDE OF TOP CHANNEL.
          ACELL = CHNDAT(%%CHXCPNFICLPT, TOPCHN)
C
          IF (ACELL .EQ. 0)  THEN
C/        CHX - ERROR WHILE ATTEMPTING TO DEFINE CORE AREA
C/              POWER/GROUND ROUTES.  NO TOP I/O CELLS IN DESIGN.
C/        **FM(' TOP CHANNEL = ',I6,6X,'FIRST CELL = ',I6)
          CALL VISERR(MCLNBR, 4263701, TOPCHN, ACELL)
C         GO TO PROCESS BOTTOM LEFT CELL.
          GO TO 5000
          ENDIF
C
 2000     CONTINUE
C         CONTINUE GETTING NEXT CELL ON HIGH SIDE OF
C         TOP CHANNEL UNTIL LAST CELL HAS BEEN LOCATED.
          CELLRT = ACELL
          ACELL  = CELDAT(%%CHXCELNXTBT, ACELL)
          IF (ACELL .EQ. 0)  GO TO 2050
          GO TO 2000
 2050     CONTINUE
C
C         **********************************
C         * IDENTIFY NODE IN CORE AREA NET *
C         **********************************
C         HERE *CELLRT* IS THE RIGHT-MOST CELL.
CS* TRACE1WHEN [3] [CELLRT] [CELLRT]
          ASTART = CELDAT(%%CHXCELNDOFT, CELLRT)
          ANDCNT = CELDAT(%%CHXCELNDNCT, CELLRT)
          ASTOP  = ASTART + ANDCNT - 1
CS* TRACE2WHEN [4] [ASTART] [ASTART] [ANDCNT] [ANDCNT]
CS* TRACE1WHEN [4] [ASTOP] [ASTOP]
          DO 2500 ANODE = ASTART, ASTOP
          NODREX = NODDAT(%%CHXNODREX, ANODE) +
     1             CELDAT(%%CHXCELREX, CELLRT)
          NODREY = NODDAT(%%CHXNODREY, ANODE) +
     1             CELDAT(%%CHXCELREY, CELLRT)
          NODLYR = NODDAT(%%CHXNODLYR, ANODE)
          CORNET = NODDAT(%%CHXNODNET, ANODE)
CS* TRACE2WHEN [3] [NODREX] [NODREX] [NODREY] [NODREY]
CS* TRACE2WHEN [3] [CORNET] [CORNET] [NODLYR] [NODLYR]
C
C         IDENTIFY INDEX INTO *PSGNETS* ARRAY FOR
C         *CORNET*
          CORINX = 0
          DO 2100 APGN = 1, PGNCNT
          APGNET = PGNDAT(%%CHXPGNETN, APGN)
          IF (APGNET .EQ. CORNET)  CORINX = APGN
 2100     CONTINUE
C
          IF (CORINX .EQ. 0)  THEN
C/        CHX - ERROR WHILE ATTEMPTING TO DEFINE CORE AREA
C/              POWER/GROUND ROUTES.  NO RAILS IN SAME
C/              NET AS NODE.
C/        **FM(17,'CELL NUMBER = ',I6,6X,'NET NUMBER = ',I6)
          CALL VISERR(MCLNBR, 4263702, CELLRT, CORNET)
          ELSE
```

```
C
C        VERIFY P/G TYPE AS CORE AREA
         IF (EGNDAT(%%CHXEGNTYP, CCPINX) .EQ. %%CHXTYCORE)
     1      GO TO 2600
         CORINX = 0
         ENDIF
 2500    CONTINUE
C        HERE, NO CORE AREA NET NODE COULD BE IDENTIFIED.
         GO TO 6800
C
C        ***********************************
C        * DEFINE GLOBAL ROUTE FOR CORE NET *
C        ***********************************
 2600    CONTINUE
C
C        FIRST, DETERMINE MINIMUM CLEARANCE FOR WIRE
         IF (NODTYP .EQ. 0)  GO TO 8200
         WIRULE = NETDAT(%%CHXNETRUL, CORNET)
         WIRWID = RULDAT(%%CHXRULVIW, NODLYR, WIRULE) +
     1            RULDAT(%%CHXRULP2C, NODLYR, WIRULE)
         PCODE  = RULDAT(%%CHXRULVIA, NODLYR, WIRULE)
         PADWID = VISABS(PADDAT(%%CHXPADLLX, PCODE)) +
     1                  PADDAT(%%CHXPADURX, PCODE)
         MINCLR = (VISMX2(WIRWID, PADWID) + 1) / 2
C
C        ALSO, SNAP ABSCISSA OF NODE TO GRID FOR
C        DETERMINATION OF WIRE CLEARANCE FROM NODE.
         GRDABS = GRIDPT(NODREX, CRRPLX, CRRGLX)
         FINABS = G2MILS(GRDABS, CRRPLX, CRRGDX)
C
         CONCNT = CONCNT + 1
CS* TRACE1WHEN [4] [CONCNT] [CONCNT]
CS*      BOUNDSCHK [CONCNT] [1] [CONMAX] [8000]
         ACNMRG = ACNMRG + 1
CS* TRACE1WHEN [4] [ACNMRG] [ACNMRG]
         CHNDAT(%%CHXCHNCONNPT, RIGCHN) = CONCNT
         CHNDAT(%%CHXCHNCONNCT, RIGCHN) = 1
C
C
C        FOR EACH RAIL IN *CORNET*, CREATE A TERMINAL IN
C        THE RIGHT VERTICAL CHANNEL, AND IDENTIFY THE
C        RIGHT-MOST ABSCISSA OF THE RAIL ENDPOINTS.
         RSTART = EGNDAT(%%CHXEGNRALC1, CCPINX)
         RCNT   = EGNDAT(%%CHXEGNRALC1, CCPINX)
         RSTOP  = RSTART + RCNT - 1
         RIGABS = CRRPLX
C
         DO 3000 ARAIL = RSTART, RSTOP
         RIGABS = VISMX2(RIGABS, RALDAT(%%CHXRALE2X, ARAIL))
         TRMCNT = TRMCNT + 1
CS* TRACE2WHEN [3] [ARAIL] [ARAIL] [TRMCNT] [TRMCNT]
CS*      BOUNDSCHK [TRMCNT] [1] [TRMMAX] [8100]
         RALCL2 = RALDAT(%%CHXRALCL2, ARAIL)
         TRMDAT(%%CHXTRMABS, TRMCNT) = RALDAT(%%CHXRALE2Y, ARAIL)
     1                               - CELDAT(%%CHXCELREY, RALCL2)
         TRMDAT(%%CHXTRMORD, TRMCNT) = RALDAT(%%CHXRALE2X, ARAIL)
     1                               - CELDAT(%%CHXCELREX, RALCL2)
         TRMDAT(%%CHXTRMLYR, TRMCNT) = RALDAT(%%CHXRALLYR, ARAIL)
         TRMDAT(%%CHXTRMNET, TRMCNT) = CORNET
         TRMDAT(%%CHXTRMCHN, TRMCNT) = RIGCHN
         TRMDAT(%%CHXTRMCON, TRMCNT) = ACNMRG
         TRMDAT(%%CHXTRMCEL, TRMCNT) = RALCL2
         TRMDAT(%%CHXTRMCH2, TRMCNT) = 0
         TRMDAT(%%CHXTRMTC2, TRMCNT) = 0
         TRMDAT(%%CHXTRMFLG, TRMCNT) = 0
 3000    CONTINUE
C        ALSO, SNAP RIGHT ABSCISSA TO GRID FOR
C        DETERMINATION OF WIRE CLEARANCE FROM NODE.
         GRDABS = GRIDPT(RIGABS, CRRPLX, CRRGDX)
         RIGABS = G2MILS(GRDABS, CRRPLX, CRRGDX)
C
C
         IF (FINABS .GE. (RIGABS+MINCLR))  THEN
C          CREATE A TERMINAL FOR THE NODE AT THE END OF THE
C          RIGHT VERTICAL CHANNEL.  FLAG IT AS 'SPECIAL' BY
C          SETTING IS AS BOTH A FUTURE TERMINAL INTO THIS
C          CHANNEL AND FROM THIS CHANNEL.
           TRMCNT = TRMCNT + 1
CS*        BOUNDSCHK [TRMCNT] [1] [TRMMAX] [8100]
           TRMDAT(%%CHXTRMABS, TRMCNT) = NODREY -
     1                    CHNDAT(%%CHXCHNLLY, RIGCHN)
           TRMDAT(%%CHXTRMORD, TRMCNT) = NODREX -
```

```
      1                                  CHNDAT(%%CHXCHNLLX, RIGCHN)
            TRMDAT(%%CHXTRMLYR, TRMCNT) = NODLYR
            TRMDAT(%%CHXTRMNET, TRMCNT) = CORNET
            TRMDAT(%%CHXTRMCHN, TRMCNT) = RIGCHN
            TRMDAT(%%CHXTRMCON, TRMCNT) = ACNMRG
            TRMDAT(%%CHXTRMCEL, TRMCNT) = 0
            TRMDAT(%%CHXTRMCH2, TRMCNT) = RIGCHN
            TRMDAT(%%CHXTRMCN2, TRMCNT) = ACNMRG
            TRMDAT(%%CHXTRMLLG, TRMCNT) = 0
C
C           SAVE THE LOCATION VALUES
            TOPCEL = CELLRT
            TOPNLX = NODRFX - CELDAT(%%CHXCELRFX, CELLRT)
            TOPNLY = NODRFY - CELDAT(%%CHXCELRFY, CELLRT)
          ENDIF
C
C         CREATE CONNECTION RECORD FOR CONNECTION IN RIGHT
C         VERTICAL CHANNEL.
CS*       TRACEWHEN [3] [CONCNT] [CONCNT]
          CONDAT(%%CHXCONCHN, CONCNT) = RIGCHN
          CONDAT(%%CHXCONNUM, CONCNT) = ACNMRG
          CONDAT(%%CHXCONTYP, CONCNT) = 0
          CONDAT(%%CHXCONNET, CONCNT) = CORNET
          CONDAT(%%CHXCONLYR, CONCNT) = NODLYR
C
          IF (FINAPS .LT. (RIGAPS+MINCLR)) THEN
C           CREATE A CONNECTION IN THE TOP HORIZONTAL CHANNEL
C           FOR THE NODE AND A FUTURE TERMINAL PASSING INTO
C           THE RIGHT VERTICAL CHANNEL.
            CONCNT = CONCNT + 1
CS*         BOUNDSCHK [CONCNT] [1] [CONMAX] [8000]
            ACNMTP = ACNMTP + 1
            CHNDAT(%%CHXCHNCONNPT, TOPCHN) = CONCNT
            CHNDAT(%%CHXCHNCONNCT, TOPCHN) = 1
C
            CONDAT(%%CHXCONCHN, CONCNT) = TOPCHN
            CONDAT(%%CHXCONNUM, CONCNT) = ACNMTP
            CONDAT(%%CHXCONTYP, CONCNT) = 0
            CONDAT(%%CHXCONNET, CONCNT) = CORNET
            CONDAT(%%CHXCONLYR, CONCNT) = NODLYR
C
            TRMCNT = TRMCNT + 2
CS*         BOUNDSCHK [TRMCNT] [1] [TRMMAX] [8100]
C
C           NORMAL TERMINAL
            ATRMIX = TRMCNT - 1
            TRMDAT(%%CHXTRMABS, ATRMIX) = NODRFX -
      1                         CELDAT(%%CHXCELRFX, CELLFT)
            TRMDAT(%%CHXTRMORD, ATRMIX) = NODRFY -
      1                         CELDAT(%%CHXCELRFY, CELLRT)
            TRMDAT(%%CHXTRMLYR, ATRMIX) = NODLYR
            TRMDAT(%%CHXTRMNET, ATRMIX) = CORNET
            TRMDAT(%%CHXTRMCHN, ATRMIX) = TOPCHN
            TRMDAT(%%CHXTRMCON, ATRMIX) = ACNMTP
            TRMDAT(%%CHXTRMCEL, ATRMIX) = CELLRT
            TRMDAT(%%CHXTRMCH2, ATRMIX) = 0
            TRMDAT(%%CHXTRMCN2, ATRMIX) = 0
            TRMDAT(%%CHXTRMLLG, ATRMIX) = 0
C
C           OUTGOING FUTURE TERMINAL.
            TRMABS =    CHNDAT(%%CHXCHNURX, TOPCHN) -
      1                 CHNDAT(%%CHXCHNLLX, TOPCHN)
            TRMORD =   (CHNDAT(%%CHXCHNURY, TOPCHN) +
      1                 CHNDAT(%%CHXCHNLLY, TOPCHN)  ) / 2 -
      2                 CHNDAT(%%CHXCHNLLY, TOPCHN)
            TRMDAT(%%CHXTRMABS, TRMCNT) = TRMABS
            TRMDAT(%%CHXTRMORD, TRMCNT) = TRMORD
            TRMDAT(%%CHXTRMLYR, TRMCNT) = NODLYR
            TRMDAT(%%CHXTRMNET, TRMCNT) = CORNET
            TRMDAT(%%CHXTRMCHN, TRMCNT) = TOPCHN
            TRMDAT(%%CHXTRMCON, TRMCNT) = ACNMTP
            TRMDAT(%%CHXTRMCEL, TRMCNT) = 0
            TRMDAT(%%CHXTRMCH2, TRMCNT) = RIGCHN
            TRMDAT(%%CHXTRMCN2, TRMCNT) = ACNMRG
            TRMDAT(%%CHXTRMLLG, TRMCNT) = 0
C
          ENDIF
C
C
C         **************************
C         **************************
C         * LEFT VERTICAL CHANNEL *
```

```
C         ****************************
C         ****************************
C         HERE, FINISHED THE RIGHT CELL.  NOW, DEFINE
C         POWER/GROUND ROUTES TO BOTTOM LEFT CELL.
 5000     CONTINUE
C
C         ****************************************
C         * IDENTIFY LEFT-MOST BOTTOM I/O CELL *
C         ****************************************
C         GET FIRST CELL ON LOW SIDE OF BOTTOM CHANNEL.
          CELLFT = CHNDAT($$CHXCHNLCLFT, BOTCHN)
C
          IF (CELLFT .EQ. 0)  GO TO 8300
C
C         ***********************************
C         * IDENTIFY NODE IN CORE AREA NET *
C         ***********************************
C         HERE *CELLFT* IS THE LEFT-MOST CELL.
C$* TRACE1WHEN [3] [CELLFT] [CELLFT]
          ASTART = CELDAT($$CHXCELNODPT, CELLFT)
          ANDCNT = CELDAT($$CHXCELNODCT, CELLFT)
          ASTOP  = ASTART + ANDCNT - 1
C$* TRACE2WHEN [4] [ASTART] [ASTART] [ANDCNT] [ANDCNT]
C$* TRACE1WHEN [4] [ASTOP] [ASTOP]
          DO 5500 ANODE = ASTART, ASTOP
          NODREX = NODDAT($$CHXNODREX, ANODE) +
     1             CELDAT($$CHXCELREX, CELLFT)
          NODREY = NODDAT($$CHXNODREY, ANODE) +
     1             CELDAT($$CHXCELREY, CELLFT)
          NODLYR = NODDAT($$CHXNODLYR, ANODE)
          CORNET = NODDAT($$CHXNODNET, ANODE)
C$* TRACE2WHEN [3] [NODREX] [NODREX] [NODREY] [NODREY]
C$* TRACE2WHEN [3] [CORNET] [CORNET] [NODLYR] [NODLYR]
C
C         IDENTIFY INDEX INTO *PGNDAT* ARRAY FOR *CORNET*
          CORINX = 0
          DO 5100 APGN = 1, PGNCNT
          APGNET = PGNDAT($$CHXPGNETN, APGN)
          IF (APGNET .EQ. CORNET)  CORINX = APGN
 5100     CONTINUE
C
          IF (CORINX .EQ. 0)  THEN
C/        CHX - ERROR WHILE ATTEMPTING TO DEFINE CORE AREA
C/              POWER/GROUND ROUTES.  NO RAILS IN SAME NET AS NODE.
C/        **FM(1X,'CELL NUMBER = ',I6,6X,'NET NUMBER = ',I6)
          CALL VISERR(MODNBR, 4263707, CELLFT, CORNET)
          ELSE
C
C         VERIFY P/G TYPE AS CORE AREA
          IF (PGNDAT($$CHXPGNTYP, CORINX) .EQ. $$CHXTYCORE)
     1       GO TO 5600
          CORINX = 0
          ENDIF
 5500     CONTINUE
C         HERE, NO CORE AREA NET NODE COULD BE IDENTIFIED.
          GO TO 8400
C
C         ***********************************
C         * DEFINE GLOBAL ROUTE FOR CORE NET *
C         ***********************************
 5600     CONTINUE
C
C         FIRST, DETERMINE MINIMUM CLEARANCE FOR WIRE.
          IF (NODLYR .EQ. 0)  GO TO 8500
          WIRULE = NETDAT($$CHXNETRUL, CORNET)
          WIRWID = RULDAT($$CHXRULVTM, NODLYR, WIRULE) +
     1             RULDAT($$CHXRULHZC, NODLYR, WIRULE)
          PCODE  = RULDAT($$CHXRULVIA, NODLYR, WIRULE)
          PADWID = VISABS(PADDAT($$CHXPADLLX, PCODE)) +
     1                    PADDAT($$CHXPADURX, PCODE)
          MINCLR = (VISMX2(WIRWID, PADWID) + 1) / 2
C
C         ALSO, SNAP ABSCISSA OF NODE TO GRID FOR
C         DETERMINATION OF WIRE CLEARANCE FROM NODE.
          GRDABS = GRIDPT(NODREX, CHRRLX, CRRGDX)
          FINABS = G2MILS(GRDABS, CHRRLX, CHRGDX)
C
          CONCNT = CONCNT + 1
C$* TRACE1WHEN [4] [CONCNT] [CONCNT]
C$*       BOUNDSCHK [CONCNT] [1] [CONMAX] [8000]
          ACNMLF = ACNMLF + 1
C$* TRACE1WHEN [4] [ACNMLF] [ACNMLF]
```

```
      CHNDAT($$CHXCHNCONNPT, LEFCHN) = CONCNT
      CHNDAT($$CHXCHNCONNCT, LEFCHN) = 1
C
C     FOR EACH RAIL IN *CORNET*, CREATE A TERMINAL IN
C     THE LEFT VERTICAL CHANNEL, AND IDENTIFY THE
C     LEFT-MOST ABSCISSA OF THE RAIL ENDPOINTS.
      RSTART = FGNDAT($$CHXFGNRALFT, CLRINX)
      RCNT   = FGNDAT($$CHXFGNRALCT, CLRINX)
      RSTOP  = RSTART + RCNT - 1
      LEFABS = CHRRGX
C
      DO 6000 ARAIL = RSTART, RSTOP
      LEFABS = VISMN2(LEFABS, RALDAT($$CHXRALE1X, ARAIL))
      TRMCNT = TRMCNT + 1
CS$ TRACEWHEN [3] [ARAIL] [ARAIL] [TRMCNT] [TRMCNT]
CS$   BOUNDSCHK [TRMCNT] [1] [TRMMAX] [8100]
      RALCL1 = RALDAT($$CHXRALCL1, ARAIL)
      TRMDAT($$CHXTRMABS, TRMCNT) = RALDAT($$CHXRALE1Y, ARAIL)
     1                           - CELDAT($$CHXCELRFY, RALCL1)
      TRMDAT($$CHXTRMORD, TRMCNT) = RALDAT($$CHXRALE1X, ARAIL)
     1                           - CELDAT($$CHXCELRFX, RALCL1)
      TRMDAT($$CHXTRMLYR, TRMCNT) = RALDAT($$CHXRALLYR, ARAIL)
      TRMDAT($$CHXTRMNET, TRMCNT) = CORNET
      TRMDAT($$CHXTRMCHN, TRMCNT) = LEFCHN
      TRMDAT($$CHXTRMCON, TRMCNT) = ACNMLF
      TRMDAT($$CHXTRMCEL, TRMCNT) = RALCL1
      TRMDAT($$CHXTRMCH2, TRMCNT) = 0
      TRMDAT($$CHXTRMCN2, TRMCNT) = 0
      TRMDAT($$CHXTRMDLG, TRMCNT) = 0
 6000 CONTINUE
C     ALSO, SNAP LEFT ABSCISSA TO GRID FOR
C     DETERMINATION OF WIRE CLEARANCE FROM NODE.
      GRDABS = GRIDF1(LEFABS, CRRRLX, CRRGDX)
      LEFABS = G2MILS(GRDABS, CRRRLX, CRRGDX)
C
      IF (FINABS .LE. (LEFABS-MINCLR))  THEN
C       CREATE A TERMINAL FOR THE NODE AT THE END OF THE
C       LEFT VERTICAL CHANNEL.  FLAG IT AS 'SPECIAL' BY
C       SETTING IT AS BOTH A FUTURE TERMINAL INTO THIS
C       CHANNEL AND FROM THIS CHANNEL.
        TRMCNT = TRMCNT + 1
CS$     BOUNDSCHK [TRMCNT] [1] [TRMMAX] [8100]
        TRMDAT($$CHXTRMABS, TRMCNT) = NODRFY -
     1                  CHNDAT($$CHXCHNLLY, LEFCHN)
        TRMDAT($$CHXTRMORD, TRMCNT) = NODRFX -
     1                  CHNDAT($$CHXCHNLLX, LEFCHN)
        TRMDAT($$CHXTRMLYR, TRMCNT) = NODLYR
        TRMDAT($$CHXTRMNET, TRMCNT) = CORNET
        TRMDAT($$CHXTRMCHN, TRMCNT) = LEFCHN
        TRMDAT($$CHXTRMCON, TRMCNT) = ACNMLF
        TRMDAT($$CHXTRMCEL, TRMCNT) = 0
        TRMDAT($$CHXTRMCH2, TRMCNT) = LEFCHN
        TRMDAT($$CHXTRMCN2, TRMCNT) = ACNMLF
        TRMDAT($$CHXTRMDLG, TRMCNT) = 0
C
C       SAVE THE LOCATION VALUES
        FOICEL = CELLFT
        BOINDX = NLLPFX - CELDAT($$CHXCELRFX, CELLFT)
        POINDY = NCDRFY - CELDAT($$CHXCELRFY, CELLFT)
      ENDIF
C
C     CREATE CONNECTION RECORD FOR CONNECTION IN LEFT
C     VERTICAL CHANNEL.
CS$   TRACEWHEN [3] [CONCNT] [CONCNT]
      CONDAT($$CHXCONCHN, CONCNT) = LEFCHN
      CONDAT($$CHXCONNUM, CONCNT) = ACNMLF
      CONDAT($$CHXCONTYP, CONCNT) = 0
      CONDAT($$CHXCONNET, CONCNT) = CORNET
      CONDAT($$CHXCONLYR, CONCNT) = NODLYR
C
      IF (FINABS .GT. (LEFABS-MINCLR))  THEN
C       CREATE A CONNECTION IN THE TOP HORIZONTAL CHANNEL
C       FOR THE NODE AND A FUTURE TERMINAL PASSING INTO
C       THE RIGHT VERTICAL CHANNEL.
        CONCNT = CONCNT + 1
CS$     BOUNDSCHK [CONCNT] [1] [CONMAX] [8000]
        ACNMHT = ACNMHT + 1
        CHNDAT($$CHXCHNCONNPT, BOTCHN) = CONCNT
        CHNDAT($$CHXCHNCONNCT, BOTCHN) = 1
C
        CONDAT($$CHXCONCHN, CONCNT) = BOTCHN
```

```
              CONDAT($$CHXCONNUM, CONCNT) = ACNNPT
              CONDAT($$CHXCONTYP, CONCNT) = 0
              CONDAT($$CHXCONNET, CONCNT) = CORNET
              CONDAT($$CHXCONLYR, CONCNT) = NODLYR
C
              TRMCNT = TRMCNT + 2
C$*           BOUNDSCHK (TRMCNT) (1) (TRMMAX) (8100)
C
C             NORMAL TERMINAL
              ATRMIX = TRMCNT - 1
              TRMDAT($$CHXTRMABS, ATRMIX) = NODREX -
     1                        CELDAT($$CHXCELREX, CELLFT)
              TRMDAT($$CHXTRMORD, ATRMIX) = NODREY -
     1                        CELDAT($$CHXCELREY, CELLFT)
              TRMDAT($$CHXTRMLYR, ATRMIX) = NODLYR
              TRMDAT($$CHXTRMNET, ATRMIX) = CORNET
              TRMDAT($$CHXTRMCHN, ATRMIX) = BOTCHN
              TRMDAT($$CHXTRMCON, ATRMIX) = ACNNPT
              TRMDAT($$CHXTRMCEL, ATRMIX) = CELLFT
              TRMDAT($$CHXTRMCH2, ATRMIX) = 0
              TRMDAT($$CHXTRMCN2, ATRMIX) = 0
              TRMDAT($$CHXTRMDLG, ATRMIX) = 0
C
C             OUTGOING FUTURE TERMINAL.
              TRMABS =  0
              TRMORD = (CHNDAT($$CHXCHNURY, BOTCHN) +
     1                 CHNDAT($$CHXCHNLLY, BOTCHN)
     2                 CHNDAT($$CHXCHNLLY, BOTCHN)  ) / 2 -
              TRMDAT($$CHXTRMABS, TRMCNT) = TRMABS
              TRMDAT($$CHXTRMORD, TRMCNT) = TRMORD
              TRMDAT($$CHXTRMLYR, TRMCNT) = NODLYR
              TRMDAT($$CHXTRMNET, TRMCNT) = CORNET
              TRMDAT($$CHXTRMCHN, TRMCNT) = BOTCHN
              TRMDAT($$CHXTRMCON, TRMCNT) = ACNNPT
              TRMDAT($$CHXTRMCEL, TRMCNT) = 0
              TRMDAT($$CHXTRMCH2, TRMCNT) = LEFCHN
              TRMDAT($$CHXTRMCN2, TRMCNT) = ACNMLF
              TRMDAT($$CHXTRMDLG, TRMCNT) = 0
C
          ENDIF
C
C
C       ************
C       * ALL DONE *
C       ************
        GO TO 9000
C
C
C        ************************************************************
C        *                        ERROR RETURNS                     *
C        ************************************************************
C
 8000    CONTINUE
C/       CHX - TOO MANY CONNECTIONS CREATED DURING ROUTE
C/             DEFINITION OF CORE AREA POWER/GROUND NETS.
C/       **FM(1X, 'NO. OF CONNECTIONS = ',I6,6X,'LIMIT = ',I6)
         CALL VISERR(MCDNBR, 8263703, CONCNT, CONMAX)
         GO TO 9000
 8100    CONTINUE
C/       CHX - TOO MANY TERMINALS CREATED DURING ROUTE
C/             DEFINITION OF CORE AREA POWER/GROUND NETS.
C/       **FM(1X, 'NO. OF TERMINALS = ',I6,6X,'LIMIT = ',I6)
         CALL VISERR(MCDNBR, 8263704, TRMCNT, TRMMAX)
         GO TO 9000
 8200    CONTINUE
C/       CHX - DEFINITION OF CORE AREA POWER/GROUND NET
C/             REQUIRES SINGLE LAYER NODE FROM THE BUS
C/             CONNECTOR CELL.
C/       **FM(1X, 'CELL = ',I6,6X,'NET = ',I6)
         CALL VISERR(MCDNBR, 4263705, CELLRT, CORNET)
C        RETURN TO ROUTE LEFT VERTICAL CHANNEL.
         GO TO 5000
 8300    CONTINUE
C/       CHX - ERROR WHILE ATTEMPTING TO DEFINE CORE AREA
C/             POWER/GROUND ROUTES.  NO BOTTOM I/C CELLS IN DESIGN.
C/       **FM(' BOTTOM CHANNEL = ',I7,6X,'FIRST CELL = ',I7)
         CALL VISERR(MCDNBR, 4263706, BOTCHN, CELLFT)
         GO TO 9000
 8400    CONTINUE
C/       CHX - UNABLE TO IDENTIFY CORE AREA NET NODE FOR BOTTOM
C/             LEFT I/C CELL.
C/       **FM(1X,'LEFT CELL = ',I6,6X,'CELL NODE COUNT = ',I6)
```

```
      CALL VISERR(MCDNPH, 4263708, CELLFT, ANDCNT)
      GO TO 9000
 8500 CONTINUE
C/    CHX - DEFINITION OF CORE AREA POWER/GROUND NET
C/          REQUIRES SINGLE LAYER NODE FROM THE BUS
C/          CONNECTOR CELL.
C/    **FM(1X, 'CELL = ',I6,6X,'NET = ',I6)
      CALL VISERR(MCDNPH, 4263709, CELLFT, CORNET)
      GO TO 9000
 8600 CONTINUE
C/    CHX - UNABLE TO IDENTIFY CORE AREA NET NODE FOR TOP
C/          RIGHT I/O CELL.
C/    **FM(1X,'RIGHT CELL = ',I6,6X,'CELL NODE COUNT = ',I6)
      CALL VISERR(MCDNPH, 8263710, CELLRI, ANDCNT)
      GO TO 9000
C
C
C     *************************************************************
C     *                 SINGLE EXIT FROM THIS ROUTINE              *
C     *************************************************************
C
 9000 CONTINUE
CS*   TRACE2WHEN [2] [IRMCNT] [IRMCNT] [CONCNT] [CONCNT]
      IF (CHXFCI(11) .EQ. MCDNPH) THEN
        CALL CHXEMP(300)
        CALL CHXEVE(400)
      ENDIF
CS*   MODEXIT [CHX]
      RETURN
C
C
C     *************************************************************
C     *                     FORMAT STATEMENTS                      *
C     *************************************************************
C     (NONE)
C
C
C     END PGCORE 2637
      END
```

```
DDDDDDDDDD    3333333333333333333333333333333333333333333333333333333333333333333333333333333333333333    DDDDDDDDDD
DDDDDDDDDD    333333333333333333333333  DIGITAL EQUIPMENT CORPORATION - VAX/VMS VERSION V4.4  333333333333333333333333    DDDDDDDDDD
DDDDDDDDDD    3333333333333333333333333333333333333333333333333333333333333333333333333333333333333333    DDDDDDDDDD
```

```
FILE _$1$DUA6:[PRC.CHXL2]S2638.FOR;2 (1080,1,2), LAST REVISED ON 21-OCT-1986 08:44, IS A 33 BLOCK SEQUENTIAL FILE OWNED BY UIC
[PRDTST,PFC].  THE RECORDS ARE VARIABLE LENGTH WITH IMPLIED (CR) CARRIAGE CONTROL.  THE LONGEST RECORD IS 75 BYTES.

JOB S2638 (220) QUEUED TO SYS$PRINT ON 4-DEC-1986 12:51 BY USER KMP, UIC [ENGVLSI,KMP], UNDER ACCOUNT ENGPKG AT PRIORITY 100,
STARTED ON PRINTER _TCNIOSLPA0: ON 4-DEC-1986 13:08 FROM QUEUE SYS$PRINT.

DDDDDDDDDD    3333333333333333333333333333333333333333333333333333333333333333333333333333333333333333    DDDDDDDDDD
DDDDDDDDDD    333333333333333333333333  DIGITAL EQUIPMENT CORPORATION - VAX/VMS VERSION V4.4  333333333333333333333333    DDDDDDDDDD
DDDDDDDDDD    3333333333333333333333333333333333333333333333333333333333333333333333333333333333333333    DDDDDDDDDD

VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
    VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
```

DDDDDDDDDD 333333333333333333333333333333333 DIGITAL EQUIPMENT CORPORATION - VAX/VMS VERSION V4.4 333333333333333333333333 DDDDDDDDDD

KMP

S2638

FOR

;2

FILE _81SDUA6:[PRC.CPX02]S2638.FOR;2 (1080,1,2), LAST REVISED ON 21-OCT-1986 08:44, IS A 33 BLOCK SEQUENTIAL FILE OWNED BY UIC [PRD1S1,PFC]. THE RECORDS ARE VARIABLE LENGTH WITH IMPLIED (CR) CARRIAGE CONTROL. THE LONGEST RECORD IS 75 BYTES.

JOB S2638 (220) QUEUED TO SYS$PRINT ON 4-DEC-1986 12:51 BY USER KMP, UIC [ENGVLS1,KMP], UNDER ACCOUNT ENGPKG AT PRIORITY 100, STARTED ON PRINTER _TCM1$LPA0: ON 4-DEC-1986 13:08 FROM QUEUE SYS$PRINT.

DDDDDDDDDD 333333333333333333333333333333333 DIGITAL EQUIPMENT CORPORATION - VAX/VMS VERSION V4.4 333333333333333333333333 DDDDDDDDDD

0 273 261

```
      SUBROUTINE PGRING(OTFLIX, GRDSNP)
C$*   ALLINING
C
C                     *****************
C                     *               *
C     SUBSYSTEM CHX   *  2638 PGRING  *
C                     *               *
C                     *****************
C
C     ****************************************************************
C     ****************************************************************
C     **                                                            **
C     **  (C) COPYRIGHT V-R INFORMATION SYSTEMS, INC. 1984          **
C     **  LICENSED MATERIAL -- PROGRAM PROPERTY OF VRIS             **
C     **  ALL RIGHTS RESERVED                                       **
C     **                                                            **
C     **  THIS PROGRAM IS THE PROPERTY OF VRIS AND IS FURNISHED     **
C     **  PURSUANT TO A WRITTEN LICENSE AGREEMENT. IT MAY NOT BE    **
C     **  USED, REPRODUCED, OR DISCLOSED TO OTHERS EXCEPT IN        **
C     **  ACCORDANCE WITH THE TERMS AND CONDITIONS OF THAT          **
C     **  AGREEMENT.                                                **
C     **                                                            **
C     ****************************************************************
C     ****************************************************************
C
C
C     ****************************************************************
C     *                      MODULE DOCUMENTATION                    *
C     ****************************************************************
C
C     SUMMARY --
C
C     THIS SUBROUTINE CREATES WIRE SEGMENT DESCRIPTIONS (*RWS* RECORDS)
C     TO FORM POWER/GROUND RINGS OVER THE POWER/GROUND RAILS OF THE
C     I/O CELLS AND WRITES THESE RECORDS TO THE I/O FILE WHOSE INDEX
C     INTO THE *IOFILE* ARRAY IS SPECIFIED IN FORMAL PARAMETER *OTFLIX*.
C
C     IT IS ASSUMED THAT ANY TWO POWER/GROUND RAILS MODELED BY
C     THE PRI RECORDS FOR A SINGLE I/O CELL BELONG TO DIFFERENT
C     NETS AND THAT CELL PLACEMENT HAS ALIGNED RAILS OF THE SAME NET.
C     IT IS ALSO ASSUMED THAT ALL RAILS BELONGING TO A RING IN A GIVEN
C     NET ARE ON THE SAME LAYER.
C
C     CURRENTLY, A SINGLE *RWS* RECORD DEFINING A SEGMENT FROM
C     ONE EDGE OF THE RING TO THE OTHER IS LAID OVER THE RAILS.
C     FUTURE ENHANCEMENTS WILL CREATE *RWS* RECORDS DEFINING
C     SEGMENTS FROM ONE RAIL ENDPOINT TO THE NEXT.
C
C     WHEN THIS MODULE IS INVOKED, THE OUTPUT DESIGN FILE IS
C     ASSUMED TO BE OPEN. THIS ROUTINE DOES NOT CLOSE THE OUTPUT
C     DESIGN FILE WHEN ITS TASK IS COMPLETED.
C
C     NOTE: WHEN *GRDSNP* IS ON (=1), THEN THE POSITIONS
C     ====  OF ALL WIRE SEGMENT ENDPOINTS WILL BE SNAPPED
C           TO GRID.
C
C
C     FORMAL PARAMETERS --
C     NAME   DIMENSION TYPE  IN/OUT  DESCRIPTION
C     ----   --------- ----  ------  -----------
C     OTFLIX           INT     IN    INDEX OF I/O FILE ON WHICH
C                                    WIRE SEGMENT DATA IS TO BE
C                                    OUTPUT.
C                                    UNIT NO. = IOFILE(OTFLIX)
C
C     GRDSNP           INT     IN    FLAG INDICATING WHETHER OR NOT
C                                    TERMINAL LOCATIONS ARE TO BE
C                                    SNAPPED TO GRID BEFORE WIRE
C                                    SEGMENTS ARE OUTPUT.
C                                      0 - TERMINALS ARE NOT SNAPPED
C                                          TO GRID
C                                      1 - TERMINALS ARE SNAPPED
C                                          TO GRID
C
C
C     LOCAL VARIABLES --
C     NAME   DIMENSION TYPE  DESCRIPTION
C     ----   --------- ----  -----------
C     APGNET                 INDEX INTO *PGNDAT* ARRAY FOR THE
C                            CURRENT POWER/GROUND NET ENTRY.
```

```
-$1$DUA6:[PRD.CHX021S2638.FOR;2          21-OCT-1986 08:44                    PAGE 2
C        APGRUL               WIRING RULE INDEX FOR THE CURRENT
C                             POWER/GROUND NET ENTRY.
C
C        ARAIL                INDEX INTO *RALDAT* FOR THE CURRENT
C                             RAIL DESCRIPTION.
C
C        ARALCT               NUMBER OF RAILS FOR THE CURRENT
C                             POWER/GROUND NET ENTRY.
C
C        ASTART               INDEX INTO *RALDAT* TO THE FIRST
C                             RAIL OF INTEREST.
C
C        ASTOP                INDEX INTO *RALDAT* TO THE LAST RAIL
C                             OF INTEREST.
C
C        GRDLX                X-GRID FOR THE FIRST RAIL ENDPOINT.
C
C        GRDLY                Y-GRID FOR THE FIRST RAIL ENDPOINT.
C
C        GRDUX                X-GRID FOR THE SECOND RAIL ENDPOINT.
C
C        GRDUY                Y-GRID FOR THE SECOND RAIL ENDPOINT.
C
C        HZRAIL          L    FLAG INDICATING WHETHER OR NOT A HORIZONTAL
C                             P/G RING EXISTS FOR A GIVEN NET.
C
C        RALCL1               CELL OF THE FIRST ENDPOINT FOR RAIL.
C
C        RALCL2               CELL OF THE SECOND ENDPOINT FOR RAIL.
C
C        RALE1X
C        RALE1Y               X/Y VALUES FOR THE FIRST/SECOND
C        RALE2X               ENDPOINTS FOR THE CURRENT RAIL.
C        RALE2Y
C
C        RALNET               RAIL NET NUMBER.
C
C        RALTYP               RAIL TYPE: $$CHXTYCORE = CORE AREA
C                                        $$CHXTYRING = I/O RING.
C
C        RINGLX
C        RINGLY               LOWER LEFT AND UPPER RIGHT X/Y
C        RINGUX               VALUES FOR THE CURRENT RING NET.
C        RINGUY
C
C        TYPRWS               INTEGER IMAGE OF STRING 'RWS '.
C
C        VTRAIL          L    FLAG INDICATING WHETHER OR NOT A VERTICAL
C                             P/G RING EXISTS FOR A GIVEN NET.
C
C
C
C        GLOBAL VARIABLES --
C        NAME  DIMENSION TYPE  DESCRIPTION
C        ----  --------- ----  -----------
C        (NONE)
C
C
C        REVISION HISTORY --
C           24-JAN-86 IAF REMOVED REQUIREMENT THAT THE P/G
C                         RING HAD TO BE A CLOSED LOOP.  (SAR 5522)
C           22-NOV-85 DLC CORRECTED NET NUMBER.  (SAR 5394)
C           21-NOV-85 DLC REVISED ERROR CODES.  (SAR 5391)
C           29-JUL-85 TAF CHECKED MODULE.
C           06-MAY-85 DLC WROTE MODULE.  (SAR 4856)
C
C
C        TESTING PLANS --
C           29-JUL-85 DCC COMPLETED UNIT TESTING.
C
C
C        ************************************************************
C        *                     SUBSYSTEM TOKENS                     *
C        ************************************************************
C
C$*      CHXTCKRN
C
C        ************************************************************
C        *                  VARIABLE DECLARATIONS                   *
C        ************************************************************
C
```

```
_$1$DUA6:[PRD.CHXC2]S2638.FOR;2                    21-OCT-1986 08:44                    PAGE 3
C          FORMAL PARAMETERS --
C          (NONE)
C
C          LOCAL VARIABLES --
C          LOGICAL HZRAIL, VTRAIL
C
C          SUBSYSTEM GLOBAL VARIABLES --
C
CS*        SUBSYSGLOBAL [CHX]
C
CS*        CHXCHR
CS*        CHXMCV
CS*        CHXNET
CS*        CHXRAL
CS*        CHXRUL
C
C          OTHER SUBSYSTEM VARIABLES --
C
CS*        ENTDAT
C
CS*        RWSEGUENT
C
C          SYSTEM GLOBAL VARIABLES --
C
CS*        SYSCCHKCN
C
C
C          **************************************************************
C          *                       DATA STATEMENTS                      *
C          **************************************************************
C
C          (NONE)
C
C
C          **************************************************************
C          *                    STATEMENT FUNCTIONS                     *
C          **************************************************************
C
C          LOCAL STATEMENT FUNCTIONS --
C          (NONE)
C
C          SUBSYSTEM STATEMENT FUNCTIONS --
C          (NONE)
C
C          OTHER SUBSYSTEM STATEMENT FUNCTIONS --
C          (NONE)
C
C          SYSTEM STATEMENT FUNCTIONS --
C
CS*        SFUNCHCS1
C
C
C          **************************************************************
C          *                      EXECUTABLE CODE                       *
C          **************************************************************
C
CS*        NODENTRY [CHX] [PGRING] [2638] [14]
C
C          VALIDATE FORMAL PARAMETERS
CS*        BOUNDSCHK [CTFLIX] [1] [**SICFILES] [8000]
CS*        BOUNDSCHK [GRLSNP] [0] [1] [8100]
C
           TYPRWS = VISTRG('RWS ')
C
C
           DO 5000 APGNET = 1, PGNCNT
           RALNET = PGNLAT(**CHXPGNETN, APGNET)
           RALTYP = PGNLAT(**CHXPGNTYP, APGNET)
           IF (RALTYP .NE. **CHXTYRING)  GO TO 5000
C
C          **************************************
C          * DETERMINE LLX AND LLY FOR THIS RING *
C          **************************************
C          IT IS ASSUMED THAT -
C          1) THE CARRIER DIMENSIONS HAVE BEEN UPDATED TO THE
C             FINAL FORMAL SIZE
C          2) RALDAT IS SORTED BY NET
C
C          INITIALIZE LOWER LEFT AND UPPER RIGHT VALUES FOR
C          THIS RING
           RINGLX = CHRRLX
           RINGUX = CHRRLX
```

```
        RINGLY = CRRRUY
        RINGUY = CRRRLY
C
        ARALCT = PGNDAT(%%CHXPGNRALCT, APGNET)
C$* TRACE(WHEN (4) [ARALCT] [ARALCT]
        IF (ARALCT .EQ. 0)  GO TO 5000
        ASTART = PGNDAT(%%CHXPGNRALPT, APGNET)
        ASTOP  = ASTART + ARALCT - 1
        HZRAIL = .FALSE.
        VTRAIL = .FALSE.
C$* TRACE2WHEN (4) [ASTART] [ASTART] [ASTOP] [ASTOP]
        DO 2000 ARAIL = ASTART, ASTOP
C
C       GET RAIL END POINTS
C           NOTE:  THE ENDPOINTS ARE NOT UPDATED.  RRL'S
C               ARE STILL UPDATED BY READING IN OLD ONES AND
C               WRITING OUT WITH NEW ENDPOINTS.  A FUTURE
C               ENHANCEMENT WILL BE TO SAVE THE READING OF
C               THE RRL'S AT UPDATE TIME.
C       ADD THE AMOUNT THE CELL HAS MOVED TO THE RAIL ENDPOINTS.
C
        RALCL1 = RALLAT(%%CHXRALCL1, ARAIL)
        RALE1X = RALLAT(%%CHXRALE1X, ARAIL) + CELMVX(RALCL1)
        RALE1Y = RALLAT(%%CHXRALE1Y, ARAIL) + CELMVY(RALCL1)
C$* TRACE2WHEN (4) [RALE1X] [RALE1X] [RALE1Y] [RALE1Y]
C
        RALCL2 = RALLAT(%%CHXRALCL2, ARAIL)
        RALE2X = RALLAT(%%CHXRALE2X, ARAIL) + CELMVX(RALCL2)
        RALE2Y = RALLAT(%%CHXRALE2Y, ARAIL) + CELMVY(RALCL2)
C$* TRACE2WHEN (4) [RALE2X] [RALE2X] [RALE2Y] [RALE2Y]
C
C       ADJUST LLX,Y AND URX,Y BY ENDPOINTS OF THIS RING.
        RINGLX = VISMX2(RINGLX, RALE1X)
        RINGLY = VISMX2(RINGLY, RALE1Y)
        RINGUX = VISMX2(RINGUX, RALE2X)
        RINGUY = VISMX2(RINGUY, RALE2Y)
C$* TRACE2WHEN (4) [RINGLX] [RINGLX] [RINGLY] [RINGLY]
C$* TRACE2WHEN (4) [RINGUX] [RINGUX] [RINGUY] [RINGUY]
C
C       FLAG RAIL ORIENTATION
        IF (RALE1X .EQ. RALE2X) VTRAIL = .TRUE.
        IF (RALE1Y .EQ. RALE2Y) HZRAIL = .TRUE.
 2000   CONTINUE
C
C
C       *************************************
C       * WRITE WIRE SEGMENTS FOR THIS RING *
C       *************************************
C
C$*       BOUNDSCHK [RINGLX] [CRRRLX] [RINGUX] [8200]
C$*       BOUNDSCHK [RINGLY] [CRRRLY] [RINGUY] [8300]
          IF (CRGSNP .EQ. 1)  THEN
C           SNAP ENDPOINTS TO GRID.
C           THIS IS DONE BY CONVERTING THE ABSCISSA AND
C           ORDINATE FROM MMES TO GRIDS AND THEN BACK TO MMES.
            GRDLX =  GTIDFI(RINGLX, CRRRLX, CRRGDX)
            GRDUX =  GTIDFI(RINGUX, CRRRLX, CRRGDX)
            GRDLY =  GTIDFI(RINGLY, CRRRLY, CRRGDY)
            GRDUY =  GTIDFI(RINGUY, CRRRLY, CRRGDY)
            RINGLX = G2MILS(GRDLX,  CRRRLX, CRRGDX)
            RINGUX = G2MILS(GRDUX,  CRRRLX, CRRGDX)
            RINGLY = G2MILS(GRDLY,  CRRRLY, CRRGDY)
            RINGUY = G2MILS(GRDUY,  CRRRLY, CRRGDY)
          ENDIF
C
          APGRUL = NETDAT(%%CHXNETRUL, RAGNET)
          RWSNET = RAGNET
          RWSSUB = 0
          RWSFLT = 0
          RWSLYR = PGNDAT(%%CHXPGNLYR, APGNET)
          RWSRIP = 0
          RWSPRV = 0
          RWSOPV = 0
C
C         FIRST CREATE VERTICAL WIRE SEGMENTS.
          IF (.NOT. VTRAIL) GO TO 4100
          RWSORN = 2
          RWSCDP = RULDAT(%%CHXRULVTW, RWSLYR, APGRUL)
          RWSTRK = RULDAT(%%CHXRULHZC, RWSLYR, APGRUL) + RWSCDP
          RWSLNG = RINGUY - RINGLY
C
C           VERTICAL WIRE SEGMENT FROM LOWER LEFT TO UPPER LEFT
```

```
      RWSREX = RINGLX
      RWSREY = RINGLY
      IF (WRTENT(1YERWS, CTFLIX)) 8400, 8400, 4000
                                  ERR   ERR    OK
C
 4000 CONTINUE
C     VERTICAL WIRE SEGMENT FROM LOWER RIGHT TO UPPER RIGHT
      RWSREX = RINGUX
      RWSREY = RINGLY
      IF (WRTENT(1YERWS, CTFLIX)) 8400, 8400, 4100
                                  ERR   ERR    OK
C
 4100 CONTINUE
C
C     NOW CREATE HORIZONTAL WIRE SEGMENTS
      IF (.NOT. HZRAIL) GO TO 4300
      RWSLRN = 1
      RWSCCP = RDICAT(%%CHXRULHZM, RWSLYR, APGRUL)
      RWSTRK = RDICAT(%%CHXRULVTC, RWSLYR, APGRUL) + RWSCCP
      RWSLNG = RINGUX - RINGLX
C
C       HORIZONTAL WIRE SEGMENT FROM BOTTOM LEFT TO BOTTOM RIGHT
      RWSREX = RINGLX
      RWSREY = RINGLY
      IF (WRTENT(1XPRWS, CTFLIX)) 8400, 8400, 4200
                                  ERR   ERR    OK
C
 4200 CONTINUE
C     HORIZONTAL WIRE SEGMENT FROM UPPER LEFT TO UPPER RIGHT
      RWSREX = RINGLX
      RWSREY = RINGUY
      IF (WRTENT(1YERWS, CTFLIX)) 8400, 8400, 4300
                                  ERR   ERR    OK
C
 4300 CONTINUE
 5000 CONTINUE
C
C
C     ************
C     * ALL DONE *
C     ************
      GO TO 9000
C
C
C     ***********************************************************
C     *                    ERROR RETURNS                        *
C     ***********************************************************
C
 8000 CONTINUE
C/    CHX - INPUT PARAMETER *CTFLIX* WHICH SPECIFIES THE INDEX OF
C/          THE OUTPUT DESIGN FILE IS OUT-OF-RANGE.
C/    **FM(1X,'CTFLIX = ',I6,6X,'LIMIT = ',I6)
      CALL VISERR(MCDNBR, 8263801, CTFLIX, %%SILFILES)
      GO TO 9000
 8100 CONTINUE
C/    CHX - INPUT PARAMETER *GRDSNP* WHICH SPECIFIES IF THE RAIL
C/          ENDPOINTS ARE TO BE SNAPPED TO GRID IS OUT OF RANGE.
C/    **FM(1X,'GRDSNP =',I6,6X,'LIMIT = 0 OR ',I6)
      CALL VISERR(MCDNBR, 8263802, GRDSNP, 1)
      GO TO 9000
 8200 CONTINUE
C/    CHX - POWER GROUND RING X-DIMENSIONS IMPROPERLY DEFINED.
C/          POSSIBLE ERROR IN *PRL* RECORDS.
C/    **FM(1X,'LLX  = ',I10,2X,'URX = ',I10)
      CALL VISERR(MCDNBR, 8263803, RINGLX, RINGUX)
      GO TO 9000
 8300 CONTINUE
C/    CHX - POWER GROUND RING Y-DIMENSIONS IMPROPERLY DEFINED.
C/          POSSIBLE ERROR IN *PRL* RECORDS.
C/    **FM(1X,'LLY  = ',I10,2X,'URY = ',I10)
      CALL VISERR(MCDNBR, 8263804, RINGLY, RINGUY)
      GO TO 9000
 8400 CONTINUE
C/    CHX - ERROR WHILE ATTEMPTING TO WRITE WIRE SEGMENT
C/          DESCRIPTION DURING DESIGN FILE UPDATE.
C/    **FM(1X,'FILE INDEX = ',I6,6X,'UNIT NUMBER = ',I6)
      CALL VISERR(MCDNBR, 8263805, CTFLIX, ICFILE(CTFLIX))
      GO TO 9000
C
C
C     ***********************************************************
C     *               SINGLE EXIT FROM THIS ROUTINE             *
C     ***********************************************************
C
 9000 CONTINUE
CS*   MCFXIT (CHX)
```

```
      RETURN
C
C
C     ***************************************************************
C     *                    FORMAT STATEMENTS                         *
C     ***************************************************************
C
C     (NONE)
C
C     END WIRUEC 2635
      END
```

DIGITAL EQUIPMENT CORPORATION - VAX/VMS VERSION V4.4

KMP

S2639

FOR

1

FILE _$1$DUA6:[PRD.CHX02]S2639.FOR;1 (2420,1,1), LAST REVISED ON 21-OCT-1986 08:44, IS A 42 BLOCK SEQUENTIAL FILE OWNED BY UIC [PRCISI,PFC]. THE RECORDS ARE VARIABLE LENGTH WITH IMPLIED (CR) CARRIAGE CONTROL. THE LONGEST RECORD IS 79 BYTES.

JOB S2639 (221) QUEUED TO SYS$PRINT ON 4-DEC-1986 12:51 BY USER KMF, UIC [ENGVISI,KMF], UNDER ACCOUNT ENGPRG AT PRIORITY 100, STARTED ON PRINTER _JLN10$LPA0: ON 4-DEC-1986 13:13 FROM QUEUE SYS$PRINT.

DIGITAL EQUIPMENT CORPORATION - VAX/VMS VERSION V4.4

VAX/VMS VAX/VMS VAX/VMS VAX/VMS VAX/VMS VAX/VMS VAX/VMS VAX/VMS VAX/VMS VAX/VMS VAX/VMS VAX/VMS
VAX/VMS VAX/VMS VAX/VMS VAX/VMS VAX/VMS VAX/VMS VAX/VMS VAX/VMS VAX/VMS VAX/VMS VAX/VMS VAX/VMS
VAX/VMS VAX/VMS VAX/VMS VAX/VMS VAX/VMS VAX/VMS VAX/VMS VAX/VMS VAX/VMS VAX/VMS VAX/VMS VAX/VMS

VAX/VMS VAX/VMS VAX/VMS VAX/VMS VAX/VMS VAX/VMS VAX/VMS VAX/VMS VAX/VMS VAX/VMS VAX/VMS VAX/VMS

DIGITAL EQUIPMENT CORPORATION - VAX/VMS VERSION V4.4

KMP

S2639

FOR ;1

FILE _$1$DUA6:[FRL.CHXC2]S2639.FOR;1 (2420,1,1), LAST REVISED ON 21-OCT-1986 08:44, IS A 42 BLOCK SEQUENTIAL FILE OWNED BY UIC [PHDIST,FFC]. THE RECORDS ARE VARIABLE LENGTH WITH IMPLIED (CR) CARRIAGE CONTROL. THE LONGEST RECORD IS 79 BYTES.

JOB S2639 (221) QUEUED TO SYS$PRINT ON 4-DEC-1986 12:51 BY USER KMP, UIC [ENGVLSI,KMP], UNDER ACCOUNT ENGENG AT PRIORITY 100, STARTED ON PRINTER _ICNYCSLPA0: ON 4-DEC-1986 13:13 FROM QUEUE SYS$PRINT.

DIGITAL EQUIPMENT CORPORATION - VAX/VMS VERSION V4.4

```
_$1$DUA6:[PRD.CFXC2]S2639.FOR;1                    21-OCT-1986 08:44                    PAGE 1
        SUBROUTINE CFXCTR
C
C$*     ALLINTEG
C
C                   ****************
C                   *              *
C       SUBSYSTEM CHX   *  2639 CHXCTR  *
C                   *              *
C                   ****************
C
C       ****************************************************
C       ****************************************************
C       **                                                **
C       **  (C) COPYRIGHT V-R INFORMATION SYSTEMS, INC. 1984  **
C       **  LICENSED MATERIAL -- PROGRAM PROPERTY OF VRIS     **
C       **  ALL RIGHTS RESERVED                               **
C       **                                                **
C       **  THIS PROGRAM IS THE PROPERTY OF VRIS AND IS FURNISHED  **
C       **  PURSUANT TO A WRITTEN LICENSE AGREEMENT. IT MAY NOT BE **
C       **  USED, REPRODUCED, OR DISCLOSED TO OTHERS EXCEPT IN     **
C       **  ACCORDANCE WITH THE TERMS AND CONDITIONS OF THAT       **
C       **  AGREEMENT.                                     **
C       **                                                **
C       ****************************************************
C       ****************************************************
C
C       ****************************************************
C       *              MODULE DOCUMENTATION                *
C       ****************************************************
C
C       SUMMARY --
C          THIS SUBROUTINE CENTERS THE CELLS ON THE CARRIER.  IF THE
C       CHIP IS CORE BOUND, THE I/O CELLS ARE CENTERED ALONG THE SIDES
C       AND SPACED APART AS NEEDED TO FIT PROPERLY.  IF THE CHIP IS
C       I/O BOUND, THE CORE CELLS ARE CENTERED BETWEEN THE I/O CELLS.
C          BY CONSTRUCTION THROUGH THE PLS AND CHC PROGRAMS, THE OUTER-MOST
C       CHANNELS WILL BE DEFINED SUCH THAT EITHER BOTH VERTICAL OR BOTH
C       HORIZONTAL OUTER CHANNELS WILL EXTEND FROM CARRIER EDGE TO
C       CARRIER EDGE (IE. THEY WILL NOT FEED ANOTHER CHANNEL).
C
C                    A
C              ------------------             I              I
C              I                I             I--------------I
C              I                I           A I              I B
C              I                I             I              I
C              ------------------             I--------------I
C                    B                        I              I
C
C       TAKING THIS FACT INTO ACCOUNT, A CHECK MUST BE MADE ON THE TOP (OR
C       RIGHT) MOST I/O ROW TO MAKE SURE IT DOES NOT FALL BELOW THE I/O CELLS
C       ALONG THE VERTICAL (OR HORIZONTAL ) CARRIER SIDES MORE THAN THE
C       DISTANCE SPECIFIED IN CHXPCP(2).  IF EXPANSION MUST TAKE PLACE
C       TO PREVENT THIS I/O ROW FROM EXCESS OVERLAP, IT MUST TAKE PLACE
C       BEFORE THE LAST TWO CHANNELS ARE ROUTED.
C          I/O CELLS ON THE OTHER TWO OUTER CHANNELS ARE TAKEN CARE OF IN GRS.
C
C       FORMAL PARAMETERS --
C       NAME  DIMENSION TYPE  IN/OUT  DESCRIPTION
C       ----  --------- ----  ------  -----------
C       (NONE)
C
C       LOCAL VARIABLES --
C       NAME  DIMENSION TYPE  DESCRIPTION
C       ----  --------- ----  -----------
C       ACELL               I     CELL INDEX NUMBER
C       ADDWID              I     AMOUNT (IN MAPS) BY WHICH THE
C                                 WIDTH OF CHANNEL *CHNID* IS
C                                 TO BE EXPANDED.
C       BASCOR              I     STARTING COORDINATE FOR PLACING I/O CELLS
C  GL   BOTCHN              I     CHANNEL INDEX NUMBER OF THE BOTTOM-MOST
C                                 HORIZONTAL CHANNEL
C       CHIX                I     CHANNEL INDEX NUMBER
C       CHIX1,CHIX2         I     INDICATES THE OUTER TWO CHANNEL INDICES
C                                 ON WHICH THE I/O CELLS WHICH ARE TO BE
C                                 CENTERED LIE
C       CHNID               I     CHANNEL INDEX NUMBER
C       CLNXCL              I     POINTER TO THE NEXT CELL ALONG A CHANNEL
C       CLRPCR,             I     COORDINATE OF A CELL
C       CLWID               I     WIDTH OF A GIVEN CELL
C       COPSIZ              I     DIMENSION OF THE INTERNAL CORE CELLS
```

```
C         DIFF                  I    REMAINDER BETWEEN THE SIZE OF THE CORE
C                                    CELLS AND THE SIZE OF THE I/O CELLS
C                                    (INCLUDING THEIR SPACING)
C         GRLSIZ                I    GRID SIZE
C         HEIGHT                I    CELL HEIGHT
C         HICHAN                I    INDEX OF THE CHANNEL ON THE HIGH SIDE
C         HICLRF                I    REFERENCE POINT ON THE HIGH SIDE OF THE
C                                    CELL (IE. URX OR URY)
C         HIIGHT                I    HEIGHT OF THE I/O CELLS ON THE HIGH SIDE
C         HIOVLP                I    AMOUNT OF LEGAL I/O OVERLAP ON THE HIGH SIDE
C         HZVTIO                I    INDICATES WHETHER THE I/O CELLS ARE BEING
C                                    CENTERED ALONG THE HORIZONTAL OR THE VERTICAL
C                                    CHANNELS
C GL      LEFCHN                I    CHANNEL INDEX NUMBER OF THE LEFT-MOST
C                                    VERTICAL CHANNEL
C         LOCHAN                I    INDEX OF THE CHANNEL ON THE LOW SIDE
C         LOCLRF                I    REFERENCE POINT ON THE LOW SIDE OF THE
C                                    CELL (IE. LLX OR LLY)
C         LOIGHT                I    HEIGHT OF THE I/O CELLS ON THE LOW SIDE
C         LOOVLP                I    AMOUNT OF LEGAL I/O OVERLAP ON THE LOW SIDE
C         MNCHXX,MNCHYY,
C         MXCHXX,MXCHYY         I    OUTER DIMENSIONS OF THE CORE AREA
C         NEHIIO                I    NUMBER OF I/O CELLS ON THE HIGH SIDE
C         NELOIO                I    NUMBER OF I/O CELLS ON THE LOW SIDE
C         NUMICS                I    NUMBER OF I/O CELLS ALONG A CHANNEL
C         NWCOOR                I    ABSOLUTE COORDINATE OF THE NEW POSITION
C                                    FOR AN I/O CELL
C         NXTCL1,NXTCL2         I    POINTER TO NEXT CELL ALONG A CHANNEL
C GL      RIGCHN                I    CHANNEL INDEX NUMBER OF THE RIGHT-MOST
C                                    VERTICAL CHANNEL
C         SIDE                  I    INDICATES THE SIDE OF THE CARRIER ON
C                                    WHICH I/O CELLS ARE BEING CENTERED
C         SIZICS                I    SUM TOTAL SIZE OF I/O CELLS ALONG A CHANNEL
C         SPACE                 I    SPACE NEEDED BETWEEN I/O CELLS
C         STRTCL                I    POINTER TO THE FIRST CELL ALONG A CHANNEL
C         SZHIIO                I    SUM TOTAL SIZE OF THE I/O CELLS ALONG
C                                    THE HIGH SIDE OF THE CARRIER
C         SZLOIO                I    SUM TOTAL SIZE OF THE I/O CELLS ALONG
C                                    THE LOW SIDE OF THE CARRIER
C         TMP,1,2               I    TEMPORARY VARIABLE
C GL      TOPCHN                I    INDEX NUMBER OF THE TOP-MOST HORIZONTAL
C                                    CHANNEL ON THE CARRIER
C         XPNAMT                I    INDICATES THE AMOUNT TO EXPAND A CHANNEL
C                                    FOR CENTERING OF CORE CELLS
C         XPNFIG                I    INDICATES THE CALLING OF THE CHNXPN ROUTINE
C                                    IS FOR THE CENTERING OF CORE CELLS.
C                                      1 - EXPANSION OF UPPER-MOST CHANNEL
C                                      2 - EXPANSION OF LOWER-MOST CHANNEL
C
C         GLOBAL VARIABLES --
C         NAME  DIMENSION TYPE  DESCRIPTION
C         ----  --------- ----  -----------
C         (NONE)
C
C         REVISION HISTORY --
C             22-OCT-85 TAF PUT IN CHECK FOR ONE I/O ON A SIDE TO PREVENT
C                           DIVIDE BY ZERO ERROR.  (SAR 5249)
C             04-SEP-85 DLC MADE GLOBAL VARIABLES OF TOPCHN, BOTCHN,
C                           LEFCHN, AND RIGCHN.  ADDED CHXPCP(6) TO
C                           STOP THE SPREADING OF I/O'S.  (SAR 5199)
C             24-SEP-85 TAF RESTRICTED I/O CELL MOVEMENT TO MULTIPLES OF
C                           THE GRID SIZE.  (SAR 5163)
C             29-JUL-85 DLC CHECKED MODULE.
C             29-JUL-85 TAF WROTE MODULE.  (SAR 4856)
C
C         TESTING PLANS --
C             29-JUL-85 TAF COMPLETED UNIT TESTING.
C
C         ****************************************************************
C         *                      SUBSYSTEM TOKENS                        *
C         ****************************************************************
C$*       CHATOKEN
C         ****************************************************************
C         *                    VARIABLE DECLARATIONS                     *
C         ****************************************************************
C
C         FORMAL PARAMETERS --
```

```
-SISDUA6:[FRC.CHX02]&2639.FLR;1                        21-OCT-1986 08:44                    PAGE 3
C          (NONE)
C
C          LOCAL VARIABLES --
C
C          SUBSYSTEM GLOBAL VARIABLES --
C
CS*        SUBSYSGLOBAL (CHX)
C
CS*        CHXCRH
CS*        CHXCEL
CS*        CHXCHN
C
C          OTHER SUBSYSTEM VARIABLES --
C          (NONE)
C
C          SYSTEM GLOBAL VARIABLES --
C
CS*        SYSCOMMON
C
C
C          ***********************************************************
C          *                   DATA STATEMENTS                      *
C          ***********************************************************
C
C          (NONE)
C
C
C          ***********************************************************
C          *                 STATEMENT FUNCTIONS                    *
C          ***********************************************************
C
C          LOCAL STATEMENT FUNCTIONS --
C          (NONE)
C
C          SUBSYSTEM STATEMENT FUNCTIONS --
C          (NONE)
C
C          OTHER SUBSYSTEM STATEMENT FUNCTIONS --
C          (NONE)
C
C          SYSTEM STATEMENT FUNCTIONS --
C
CS*        SBUNCHCST
C
C
C          ***********************************************************
C          *                   EXECUTABLE CODE                      *
C          ***********************************************************
C
CS*        MODENTRY (CHX) (CHXCTR) (2639) (15)
C
           MXCHYY = CONCAT(%%CHXCHNURY, TOPCHN)
           MNCHYY = CONCAT(%%CHXCHNLLY, BOTCHN)
           MXCHXX = CONCAT(%%CHXCHNURX, RIGCHN)
           MNCHXX = CONCAT(%%CHXCHNLLX, LEFCHN)
C
CS*        TRACE2WHEN (4) (TOPCHN =) (TOPCHN) (BOTCHN =) (BOTCHN)
CS*        TRACE2WHEN (4) (RIGCHN =) (RIGCHN) (LEFCHN =) (LEFCHN)
CS*        TRACE2WHEN (4) (MXCHXX =) (MXCHXX) (MNCHXX =) (MNCHXX)
CS*        TRACE2WHEN (4) (MXCHYY =) (MXCHYY) (MNCHYY =) (MNCHYY)
C
C          THE LAST CHANNEL TO BE ROUTED INDICATES ORIENTATION
C          OF THE SLIDING CHANNEL
           IF ((CHNCNT .EQ. RIGCHN) .OR. (CHNCNT .EQ. LEFCHN)) THEN
C          *TOPCHN* AND *BOTCHN* FEED *LEFCHN* AND *RIGCHN*
             HZVTIC = 1
             GRDSIZ = CHRGDY
C
             DO 1200 I = 1,2
             NUMTCS = 0
             SIZTCS = 0
             IF (I .EQ. 1) THEN
C               CHECK LEFT I/OS
                CHTX   = LEFCHN
                CLAXCL = %%CHXCELMXIRG
                SIDE   = %%CHXCHNLOCLFT
             ELSE
C               CHECK RIGHT I/OS
                CHTX   = RIGCHN
                CLAXCL = %%CHXCELMXTLF
                SIDE   = %%CHXCHNRICLFT
             ENDIF
```

```
         IF (CHIX .EQ. 0) GO TO 1200
         ACELL = CHNLAT(SIDE, CHIX)
 1100    CONTINUE
         IF (ACELL .LE. 0) GO TO 1150
         NUMIOS = NUMIOS + 1
C        DETERMINE CELL WIDTH
         CLWID  = CELDAT(%%CHXCELURY, ACELL) -
     1            CELDAT(%%CHXCELLLY, ACELL)
C        ROUND WIDTH UP TO NEXT GRID SIZE
         TMP    = (CLWID / GRDSIZ) * GRDSIZ
         IF (TMP .NE. CLWID) CLWID = TMP + GRDSIZ
         SIZIOS = SIZIOS + CLWID
         ACELL  = CELDAT(CLNXCL, ACELL)
         GO TO 1100
 1150    CONTINUE
         IF (I .EQ. 1) THEN
            NWLEIO = NUMIOS
            SZLEIO = SIZIOS
         ELSE
            NWRIIO = NUMIOS
            SZRIIO = SIZIOS
         ENDIF
 1200    CONTINUE
C
C        DETERMINE HEIGHT OF IO CELLS ALONG *TOPCHN* AND *BOTCHN*
         TOIOHT = MXCHYY - CHNDAT(%%CHXCHNLLY, LEFCHN)
         HIIOHT = MXCHYY
         ACELL  = CHNDAT(%%CHXCHNHICLPT, TOPCHN)
 1210    CONTINUE
         IF (ACELL .LE. 0) GO TO 1220
         HEIGHT = CELDAT(%%CHXCELURY, ACELL) +
     1            CELDAT(%%CHXCELURY, ACELL)
         IF (HEIGHT .GT. HIIOHT) HIIOHT = HEIGHT
         ACELL  = CELDAT(%%CHXCELNXTHT, ACELL)
         GO TO 1210
 1220    CONTINUE
         HIIOHT = HIIOHT - MXCHYY
C
         HICHAN = TOPCHN
         LOCHAN = BOTCHN
         CHNSIZ = MXCHYY - MNCHYY
C
      ELSE
C        *LEFCHN* AND *RIGCHN* FEED *TOPCHN* AND *BOTCHN*
         HZVTIO = 2
         GRDSIZ = CHRGDX
C
         DO 1400 I = 1,2
         NUMIOS = 0
         SIZIOS = 0
         IF (I .EQ. 1) THEN
C           CHECK TOP I/OS
            CHIX   = TOPCHN
            CLNXCL = %%CHXCELNXTHT
            SIDE   = %%CHXCHNHICLPT
         ELSE
C           CHECK BOTTOM I/OS
            CHIX   = BOTCHN
            CLNXCL = %%CHXCELNXTLO
            SIDE   = %%CHXCHNLOCLPT
         ENDIF
         IF (CHIX .EQ. 0) GO TO 1400
         ACELL = CHNLAT(SIDE, CHIX)
 1300    CONTINUE
         IF (ACELL .LE. 0) GO TO 1350
         NUMIOS = NUMIOS + 1
C        DETERMINE CELL WIDTH
         CLWID  = CELDAT(%%CHXCELURX, ACELL) -
     1            CELDAT(%%CHXCELLLX, ACELL)
C        ROUND WIDTH UP TO NEXT GRID SIZE
         TMP    = (CLWID / GRDSIZ) * GRDSIZ
         IF (TMP .NE. CLWID) CLWID = TMP + GRDSIZ
         SIZIOS = SIZIOS + CLWID
         ACELL  = CELDAT(CLNXCL, ACELL)
         GO TO 1300
 1350    CONTINUE
         IF (I .EQ. 1) THEN
            NWHIIO = NUMIOS
            SZHIIO = SIZIOS
         ELSE
            NWLOIO = NUMIOS
            SZLOIO = SIZIOS
```

```
      ENDIF
 1400 CONTINUE
C
C     DETERMINE HEIGHT OF IO CELLS ALONG *LEFCHN* AND *RIGCHN*
      LOIGHT = MNCHXX - CHNDAT(%%CHXCHNLOX, LETCHN)
      HIIGHT = MXCHXX
      ACELL  = CHNDAT(%%CHXCHNHICLP1, RIGCHN)
 1410 CONTINUE
      IF (ACELL .LE. 0) GO TO 1420
      HEIGHT = CELDAT(%%CHXCELREX, ACELL) +
     1         CELDAT(%%CHXCELURX, ACELL)
      IF (HEIGHT .GT. HIIGHT) HIIGHT = HEIGHT
      ACELL  = CELDAT(%%CHXCELNXTLF, ACELL)
      GO TO 1410
 1420 CONTINUE
      HIIGHT = HIIGHT - MXCHXX
C
      HICHAN = HIGCHN
      LOCHAN = LEFCHN
      CORSIZ = MXCHAX - MNCHXX
      ENDIF
C
C$*   TRACE1WHEN [4] [CORSIZ =] [CORSIZ]
C$*   TRACE2WHEN [4] [NMLOIC =] [NMLOIC] [NMHIIC =] [NMHIIC]
C$*   TRACE2WHEN [4] [SZLOIC =] [SZLOIC] [SZHIIC =] [SZHIIC]
C
C     DETERMINE THE MAXIMUM OVERLAP THE I/O CELLS
C     MAY EXTEND INTO THE CORE AREA
      LOOVLP = CHXPLF(2)
      HIOVLP = LOOVLP
C
C     IF THE MAXIMUM ALLOWABLE OVERLAP IS GREATER THAN THE
C     HEIGHT OF THE I/O CELLS, REPLACE THE OVERLAP
C     WITH THE CELL HEIGHT.
      IF (LOOVLP .GT. LOIGHT) LOOVLP = LOIGHT
      IF (HIOVLP .GT. HIIGHT) HIOVLP = HIIGHT
C     ROUND DOWN TO NEAREST GRID MULTIPLE
      LOOVLP = LOOVLP - VISMOD(LOOVLP, GRDSIZ)
      HIOVLP = HIOVLP - VISMOD(HIOVLP, GRDSIZ)
C
C     RE-SET CORSIZ TAKING I/O OVERLAPS INTO ACCOUNT
      CORSIZ = CORSIZ + LOOVLP + HIOVLP
C
      SIZIOS = VISMX2(SZLOIC, SZHIIC)
      IF (SIZIOS .GT. CORSIZ) THEN
C        HERE IF I/O BOUND CHIP
C
C        EXPAND CORE CELLS TO CENTER AMONG I/O CELLS
         XPNADD = SIZIOS - CORSIZ
C        ROUND UP TO THE NEAREST GRID MULTIPLE
         IF (VISMOD(XPNADD, GRDSIZ) .NE. 0)
     1      XPNADD = XPNADD + GRDSIZ - VISMOD(XPNADD, GRDSIZ)
C        SPLIT EXPANSION BETWEEN TOP AND BOTTOM
         ADDWID = XPNADD / 2
C        ROUND TO NEAREST GRID MULTIPLE
         ADDWID = (ADDWID / GRDSIZ) * GRDSIZ
C        FIRST PASS WILL BE ON THE UPPER-MOST CHANNEL
         CHNID  = HICHAN
         XPNFLG = 1
         CALL CHNXPN(CHNID, ADDWID, XPNFLG)
         ADDWID = XPNADD - ADDWID
C        SECOND PASS WILL BE ON THE LOWER-MOST CHANNEL
         CHNID  = LOCHAN
         XPNFLG = 2
         CALL CHNXPN(CHNID, ADDWID, XPNFLG)
C
C        SET CORSIZ TO I/O SIZE
         CORSIZ = SIZIOS
      ENDIF
C
C
C     CHECK FOR FIXED I/O'S
      IF (CHXPLF(6) .NE. 0)  GO TO 9000
C
C     SPACE I/O CELLS ACCORDINGLY
      IF (HZVTIC .EQ. 1) THEN
C        CENTER I/O CELLS ALONG VERTICAL CHANNELS
         NXICL1 = %%CHXCELNXTRG
         NXICL2 = %%CHXCELNXTLF
         CIRFCR = %%CHXCELRFY
         LOCLRF = %%CHXCELLLY
         HICLRF = %%CHXCELURY
```

```
            BASCOR = MAXYY - LOLVLP
            CHIX1  = LFFCHN
            CHIX2  = RICCHN
         ELSE
C           CENTER I/O CELLS ALONG HORIZONTAL CHANNELS
            NXICL1 = %%CHXCELNXTTP
            NXICL2 = %%CHXCELNXTBT
            CLRFCR = %%CHXCELRFX
            LOCLRF = %%CHXCELLLX
            HICLRF = %%CHXCELURX
            BASCOR = LNCHXX - LOLVLP
            CHIX1  = TOTCHN
            CHIX2  = ICTCHN
         ENDIF
C
         DO 2000 SIDE = 1, 2
         IF (SIDE .EQ. 1) THEN
            SIZICS = SZTOIC
            NUMICS = NMTOIC
            STRICL = CHNDAT(%%CHXCHNLOCLPT, CHIX1)
            CLRXCL = NXICL1
         ELSE
            SIZICS = SZBTIC
            NUMICS = NMBTIC
            STRICL = CHNDAT(%%CHXCHNHICLPT, CHIX2)
            CLRXCL = NXICL2
         ENDIF
C        CHECK IF ANYTHING TO CENTER
         IF (SIZICS .LE. 0) GO TO 2000
C        DETERMINE SPACING BETWEEN I/O CELLS
         SPACE = 0
         IF (NUMICS .GT. 1)
     1      SPACE = (CORSIZ - SIZICS) / (NUMICS - 1)
C        ROUND DOWN TO NEAREST GRID MULTIPLE
         SPACE = (SPACE / GRDSIZ) * GRDSIZ
C        DETERMINE STARTING CELL COORDINATE
         DIFF   = CORSIZ - SIZIOS - (SPACE * (NUMICS - 1))
         SIZICS = BASCOR + (DIFF / 2)
C
C        MOVE I/O CELLS
         NUMICS = 0
         ACELL  = STRICL
C        ADJUST STARTING COORDINATE (*SIZIOS*) SO MOVEMENT OF
C        I/O CELLS WILL ONLY BE BY A MULTIPLE OF THE GRID SIZE
C        NOTE: REMEMBER, ALL CELL WIDTHS AND THE SPACING BETWEEN
C              CELLS ARE IN GRID MULTIPLES SO THE STARTING POINT
C              IS ALL THAT IS IMPORTANT
         IF (ACELL .GT. 0) THEN
C           OBTAIN DISTANCE BETWEEN ACELL AND SIZICS
            NWCOOR = (CELDAT(CLRFCR, ACELL) + CELDAT(LOCLRF, ACELL)) -
     1               SIZICS
            TMP    = (NWCOOR / GRDSIZ) * GRDSIZ
            SIZICS = SIZIOS + (NWCOOR - TMP)
         ENDIF
 1900    CONTINUE
         IF (ACELL .LE. 0) GO TO 1910
         NWCOOR = (NUMICS * SPACE) + SIZICS
C        NWCOOR IS AN ABSOLUTE COORDINATE OF WHERE THE CELL
C        SHOULD GO, SO ADJUST ACCORDINGLY
         TMP    = NWCOOR - CELDAT(LOCLRF, ACELL)
C        *TMP* IS THE LOWEST POINT WHICH *ACELL* WILL GO.
C        CHECK THAT *ACELL* MOVES BY A GRID MULTIPLE, IF NOT ... ADJUST UP
         TMP1   = CELDAT(CLRFCR, ACELL) - TMP
C        SNAP TO GRID
         TMP2   = (TMP1 / GRDSIZ) * GRDSIZ
         IF (TMP1 .NE. TMP2) THEN
            IF (TMP1 .GT. 0) THEN
C              MOVING *ACELL* DOWN, MOVE BACK UP AS NEEDED
               TMP1 = TMP2
            ELSE
C              MOVING *ACELL* UP, MOVE HIGHER AS NEEDED
               TMP1 = TMP2 - GRDSIZ
            ENDIF
         ENDIF
         CELDAT(CLRFCR, ACELL) = CELDAT(CLRFCR, ACELL) - TMP1
C        DETERMINE CELL WIDTH
         CLWID  = CELDAT(HICLRF, ACELL) - CELDAT(LOCLRF, ACELL)
C        ROUND UP TO NEXT GRID SIZE
         TMP    = (CLWID / GRDSIZ) * GRDSIZ
         IF (TMP .NE. CLWID) CLWID = TMP + GRDSIZ
         SIZICS = SIZICS + CLWID
         NUMICS = NUMICS + 1
```

```
              ACELT  = CELLAT(CLPXCL, ACELT)
              GO TO 1900
 1910         CONTINUE
 2000         CONTINUE
C
              GO TO 9000
C
C
C             ****************************************************************
C             *                        ERROR RETURNS                         *
C             ****************************************************************
C
 8000         CONTINUE
              GO TO 9000
C
C
C
C             ****************************************************************
C             *                 SINGLE EXIT FROM THIS ROUTINE                *
C             ****************************************************************
C
 9000         CONTINUE
CS*           RCDEXIT (CPX)
              RETURN
C
C
C
C             ****************************************************************
C             *                      FORMAT STATEMENTS                       *
C             ****************************************************************
C
C             (NONE)
C
C
C             END CHXC1R 2639
              END
```

```
FILE _S1SDUA6:[KMF.CFX(2]S2640.FOR;1 (1081,1,2), LAST REVISED ON 21-OCT-1986 08:44, IS A 20 BLOCK SEQUENTIAL FILE OWNED BY UIC
[PRLTS1,PFC].  THE RECORDS ARE VARIABLE LENGTH WITH IMPLIED (CR) CARRIAGE CONTROL.  THE LONGEST RECORD IS 73 BYTES.

JOB S2640 (222) QUEUED TO SYS$PRINT ON 4-DEC-1986 12:51 BY USER KMF, UIC [ENGVLSI,KMF], UNDER ACCOUNT ENGPKG AT PRIORITY 100,
STARTED ON PRINTER _ICN1LSLPA0: ON 4-DEC-1986 13:03 FROM QUEUE SYS$PRINT.

NNNNNNNNNN    4444444444444444444444444444444444444444444444444444444444444444444444444444444444444444444444    NNNNNNNNNN
NNNNNNNNNN    44444444444444444444444  DIGITAL EQUIPMENT CORPORATION - VAX/VMS VERSION V4.4  4444444444444444444444    NNNNNNNNNN
NNNNNNNNNN    4444444444444444444444444444444444444444444444444444444444444444444444444444444444444444444444    NNNNNNNNNN

          VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
              VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
          VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
              VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
          VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
              VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS

NNNNNNNNNN    4444444444444444444444444444444444444444444444444444444444444444444444444444444444444444444444    NNNNNNNNNN
NNNNNNNNNN    44444444444444444444444  DIGITAL EQUIPMENT CORPORATION - VAX/VMS VERSION V4.4  4444444444444444444444    NNNNNNNNNN
NNNNNNNNNN    4444444444444444444444444444444444444444444444444444444444444444444444444444444444444444444444    NNNNNNNNNN

                                   K   K  M   M  FFFF
                                   K  K   MM MM  F
                                   K K    M M M  F
                                   KKK    M   M  FFFF
                                   K K    M   M  F
                                   K  K   M   M  F
                                   K   K  M   M  F

                    SSSSSSSS    222222      666666    44      44      000000
                    SSSSSSSS    222222      666666    44      44      000000
                  SS          22      22  66          44      44    00      00
                  SS          22      22  66          44      44    00      00
                  SS                  22  66          44      44    00    0000
                  SS                  22  66          44      44    00    0000
                    SSSSSS          22    66666666    4444444444    00  00  00
                    SSSSSS          22    66666666    4444444444    00  00  00
                          SS      22      66      66          44    0000    00
                          SS      22      66      66          44    0000    00
                          SS    22        66      66          44    00      00
                          SS    22        66      66          44    00      00
                  SSSSSSSS    2222222222    666666            44      000000
                  SSSSSSSS    2222222222    666666            44      000000

                                FFFFFFFFFF    OOOOOO    RRRRRRRR
                                FFFFFFFFFF    OOOOOO    RRRRRRRR
                                FF          OO      OO  RR      RR
                                FF          OO      OO  RR      RR
                                FF          OO      OO  RR      RR
                                FF          OO      OO  RR      RR
                                FFFFFFFF    OO      OO  RRRRRRRR
                                FFFFFFFF    OO      OO  RRRRRRRR
                                FF          OO      OO  RR  RR
                                FF          OO      OO  RR  RR
                          ....  FF          OO      OO  RR    RR
                          ....  FF          OO      OO  RR    RR
                          ....  FF            OOOOOO    RR      RR
                          ....  FF            OOOOOO    RR      RR

                                      ;;;;      11
                                      ;;;;      11
                                      ;;;;    1111
                                      ;;;;    1111
                                                11
                                                11
                                      ;;;;      11
                                      ;;;;      11
                                      ;;;;      11
                                      ;;;;      11
                                        ;;      11
                                        ;;      11
                                      ;;      111111
                                      ;;      111111
```

```
FILE _$1$DUA6:[PRD.CHX02]S2640.FOR;1 (10P1,1,2), LAST REVISED ON 21-OCT-1986 08:44, IS A 20 BLOCK SEQUENTIAL FILE OWNED BY UIC
[PRDIST,PRC]. THE RECORDS ARE VARIABLE LENGTH WITH IMPLIED (CR) CARRIAGE CONTROL. THE LONGEST RECORD IS 73 BYTES.

JOB S2640 (222) QUEUED TO SYS$PRINT ON 4-DEC-1986 12:51 BY USER RME, UIC [ENGVISI,RME], UNDER ACCOUNT ENGENG AT PRIORITY 100,
STARTED ON PRINTER _TCR10SLPA0: ON 4-DEC-1986 13:03 FROM QUEUE SYS$PRINT.

NNNNNNNNNN   4444444444444444444444444444444444444444444444444444444444444444444444444444444444444444444   NNNNNNNNNN
NNNNNNNNNN   444444444444444444444444  DIGITAL EQUIPMENT CORPORATION - VAX/VMS VERSION V4.4  44444444444444444444444   NNNNNNNNNN
NNNNNNNNNN   4444444444444444444444444444444444444444444444444444444444444444444444444444444444444444444   NNNNNNNNNN


_$1$DUA6:[PRD.CHX02]S2640.FOR;1                     21-OCT-1986 08:44                    PAGE 1
      SUBROUTINE MOVEGC( CHNID, PGCPOS, DELTA)
C$*   ALLINJEG
C
C                          ****************
C                          *              *
C     SUBSYSTEM CHX        *  2640 MOVEGC *
C                          *              *
C                          ****************
C
C     ***************************************************************
C     ***************************************************************
C     **                                                           **
C     **  (C) COPYRIGHT V-R INFORMATION SYSTEMS, INC. 1984         **
C     **  LICENSED MATERIAL -- PROGRAM PROPERTY OF VRIS            **
C     **  ALL RIGHTS RESERVED                                      **
C     **                                                           **
C     **  THIS PROGRAM IS THE PROPERTY OF VRIS/ANL IS FURNISHED    **
C     **  PURSUANT TO A WRITTEN LICENSE AGREEMENT. IT MAY NOT BE   **
C     **  USED, REPRODUCED, OR DISCLOSED TO OTHERS EXCEPT IN       **
C     **  ACCORDANCE WITH THE TERMS AND CONDITIONS OF THAT         **
C     **  AGREEMENT.                                               **
C     **                                                           **
C     ***************************************************************
C     ***************************************************************
C
C     ***************************************************************
C     *                   MODULE DOCUMENTATION                      *
C     ***************************************************************
C
C     SUMMARY --
C
C     THIS SUBROUTINE IS CALLED TO ALIGN THE POWER/GROUND BUS
C     CONNECTOR CELL BEYOND ALL OTHER TERMINALS IN THE CHANNEL
C     SO THAT THE POWER/GROUND CONNECTION WILL NOT BLOCK OTHER
C     CONNECTIONS IN THE CHANNEL.
C
C     THE FORMAL PARAMETER *PGCPOS* DEFINES THE POSITION OF THE
C     POWER/GROUND CONNECTOR CELL AS EITHER THE RIGHT-MOST HIGH
C     CELL (=1) OR THE LEFT-MOST LOW CELL (=2) IN THE CHANNEL *CHNID*.
C     THE FORMAL PARAMETER *DELTA* IS THE AMOUNT TO MOVE THE CELL.
C
C
C     FORMAL PARAMETERS --
C     NAME  DIMENSION TYPE   IN/OUT   DESCRIPTION
C     ----  --------- ----   ------   -----------
C     CHNID             I      IN     CHANNEL NUMBER
C
C     PGCPOS            I      IN     POWER/GROUND CONNECTOR POSITION
C                                     1 = RIGHT-MOST HI CELL
C                                     2 = LEFT-MOST LO CELL
C
C     DELTA             I      IN     AMOUNT (IN DESIGN FILE UNITS)
C                                     TO MOVE THE CELL
C
C     LOCAL VARIABLES --
C     NAME  DIMENSION TYPE  DESCRIPTION
C     ----  --------- ----  -----------
C     ACELL             I   CELL NUMBER.
C
C     CHRIAR            I   POINTER TO UPPER RIGHT ABSCISSA
C                           IN *CHNDAT* ENTRY FOR *CHNID*
C
```

```
C       CHLLEP          I    POINTER TO UPPER RIGHT ORDINATE
C                            IN *CHNDAT* ENTRY FOR *CHNID*.
C
C       CHLOAB          1    POINTER TO LOWER LEFT ABSCISSA
C                            IN *CHNDAT* ENTRY FOR *CHNID*.
C
C       CHLOOP          1    POINTER TO LOWER LEFT ORDINATE
C                            IN *CHNDAT* ENTRY FOR *CHNID*.
C
C       CHORN           I    ORIENTATION OF *CHNID*.
C
C       HIFEED          I    NUMBER OF THE CHANNEL FEED BY THE
C                            HI END OF *CHNID*.
C
C       LOFEED          1    NUMBER OF THE CHANNEL FED BY THE
```

_SISDUA6:[PRD.CHX02]S2640.FOR;1 21-OCT-1986 08:44 PAGE 2

```
C                            LO END OF *CHNID*.
C
C
C       GLOBAL VARIABLES --
C       NAME  DIMENSION TYPE  DESCRIPTION
C       ----  --------- ----  -----------
C       (NONE)
C
C
C       REVISION HISTORY --
C          21-NOV-85 DLC REVISED ERROR CODES.  (SAR 5391)
C          03-OCT-85 TAF CHECKED MODULE.
C          04-SEP-85 DLC WROTE MODULE.  (SAR 5199)
C
C       TESTING PLANS --
C          02-OCT-85 DDC COMPLETED UNIT TESTING.
C
C       *************************************************************
C       *                       SUBSYSTEM TOKENS                    *
C       *************************************************************
CS*     CHXTOKEN
C
C       *************************************************************
C       *                   VARIABLE DECLARATIONS                   *
C       *************************************************************
C
C       FORMAL PARAMETERS --
C       (NONE)
C
C       LOCAL VARIABLES --
C
C       SUBSYSTEM GLOBAL VARIABLES --
C
CS*     SUBSYSGLOBAL [CHX]
C
CS*     CHXCEL
CS*     CHXCHN
CS*     CHXCHR
C
C       OTHER SUBSYSTEM VARIABLES --
C       (NONE)
C
C       SYSTEM GLOBAL VARIABLES --
C
CS*     SYSCOMMON
C
C       *************************************************************
C       *                      DATA STATEMENTS                      *
C       *************************************************************
C
C       (NONE)
C
C       *************************************************************
C       *                    STATEMENT FUNCTIONS                    *
C       *************************************************************
C
C       LOCAL STATEMENT FUNCTIONS --
C       (NONE)
C
C       SUBSYSTEM STATEMENT FUNCTIONS --
C       (NONE)
```

```
C
C        OTHER SUBSYSTEM STATEMENT FUNCTIONS --
C        (NONE)
C
C        SYSTEM STATEMENT FUNCTIONS --
C        (NONE)
C
C
C        ****************************************************************
C        *                       EXECUTABLE CODE                        *
C        ****************************************************************
C
CS*      MODENTRY (CHX) (MOVE(C) (2640) (16)
C
CS*      TRACE2WHEN (2) (CHNID) (CHNID) (PGCPOS) (PGCPOS)

_$1$DUA6:[PRD.CHX02]S2640.FOR;1                21-OCT-1986 08:44                PAGE 3

CS*      TRACE1WHEN (2) (DELTA) (DELTA)
C
         IF (PGCPOS .EQ. 1) THEN
C        **************************************
C        * IDENTIFY RIGHT-MOST TOP I/O CELL *
C        **************************************
C        GET FIRST CELL ON HIGH SIDE OF *CHNID*.
         ACELL = CHNDAT(%%CHXCHNHICLPT, CHNID)
C
         IF (ACELL .EQ. 0) GO TO 8000
 2000    CONTINUE
C        CONTINUE GETTING NEXT CELL ON HIGH SIDE OF
C        TOP CHANNEL UNTIL LAST CELL HAS BEEN LOCATED.
         IF (CELDAT(%%CHXCELNXTPT, ACELL) .EQ. 0) GO TO 2050
         ACELL = CELDAT(%%CHXCELNXTPT, ACELL)
         GO TO 2000
 2050    CONTINUE
C        HERE *ACELL* IS THE RIGHT-MOST HI SIDE CELL.
C
         ELSE
C        **************************************
C        * IDENTIFY LEFT-MOST BOTTOM I/O CELL *
C        **************************************
C        GET FIRST CELL ON LOW SIDE OF CHANNEL *CHNID*
         ACELL = CHNDAT(%%CHXCHNLOCLPT, CHNID)
C
         IF (ACELL .EQ. 0) GO TO 8000
C        HERE *ACELL* IS THE LEFT-MOST LO SIDE CELL.
C
C
         ENDIF
C        *************
C        * MOVE CELL *
C        *************
C        ADD *DELTA* TO THE CELL REFERENCE ABSCISSA.
CS*      TRACE1WHEN (3) (ACELL) (ACELL)
C
         CELDAT(%%CHXCELREFX, ACELL) = CELDAT(%%CHXCELREFX, ACELL) +
     1                                 DELTA
C
C        ******************
C        * ADJUST CHANNEL *
C        ******************
C        ADJUST CHANNEL END AND COORDINATE OF CHANNEL
C        BEING FED.
         CHORN = CHNDAT(%%CHXCHNORIENT, CHNID)
         IF (CHORN .EQ. 1) THEN
C           CHNID IS HORIZONTAL.
            CHLOAB = %%CHXCHNLLX
            CHHIAB = %%CHXCHNURX
C           CHANNEL FED IS VERTICAL.
            CHLOOR = %%CHXCHNLLX
            CHHIOR = %%CHXCHNURX
         ELSE
C           CHNID IS VERTICAL.
            CHLOAB = %%CHXCHNLLY
            CHHIAB = %%CHXCHNURY
C           CHANNEL FED IS HORIZONTAL.
            CHLOOR = %%CHXCHNLLY
            CHHIOR = %%CHXCHNURY
         ENDIF
C
         IF (PGCPOS .EQ. 1) THEN
C           ADJUST HI END OF THE CHANNEL.
            CHNDAT(CHHIAB, CHNID) = CHNDAT(CHHIAB, CHNID) + DELTA
            HIFEED = CHNDAT(%%CHXCHNHIFEED, CHNID)
            CHNDAT(CHLOOR, HIFEED) = CHNDAT(CHLOOR, HIFEED) + DELTA
```

```
C         ADJUST TO END OF CHANNEL.
            CHNDAT(CHLCAP, CHNID) = CHNDAT(CHLCAP, CHNID) + DELTA
            LCFEED = CHNDAT(?%CHXCHNIDFEED, CHNID)
            CHNDAT(CHFILP, LCFEED) = CHNDAT(CHHIOP, LCFEED) + DELTA
          ENDIF
C
C         ************
C         * ALL DONE *
C         ************
          GO TO 9000
C
C
C         ************************************************************
C         *                       ERROR RETURNS                      *

_SISDUA6:[PHD.CHX02]S2640.FOR;1                21-OCT-1986 08:44.                  PAGE 4

C         ************************************************************
C
 8000     CONTINUE
C/        CHX - ERROR WHILE ATTEMPTING TO ALIGN
C/                 POWER/GROUND CONNECTOR CELL IN
C/        **FM(1X,'CHANNEL = ',I6,6X,'FIRST CELL POINTER = ',I6)
          CALL VISERR(MODNBR, 4264001, CHNID, ACELL)
          GO TO 9000
C
C         ************************************************************
C         *               SINGLE EXIT FROM THIS ROUTINE              *
C         ************************************************************
C
 9000     CONTINUE
CS*       MODEXIT [CHX]
          RETURN
C
C
C         ************************************************************
C         *                    FORMAT STATEMENTS                     *
C         ************************************************************
C         (NONE)
C
C         END MOVEOC 2640
          END
```

CCCCCCCCCC 2222222222 DIGITAL EQUIPMENT CORPORATION - VAX/VMS VERSION V4.4 2222222222 CCCCCCCCCC

KMP

S2641

FOR;2

FILE _$1$DUA6:[FRC.CHXC2]S2641.FOR;2 (1082,1,2), LAST REVISED ON 21-OCT-1986 08:44, IS A 30 BLOCK SEQUENTIAL FILE OWNED BY UIC [PRLIST,PRC]. THE RECORDS ARE VARIABLE LENGTH WITH IMPLIED (CR) CARRIAGE CONTROL. THE LONGEST RECORD IS 73 BYTES.

JOB S2641 (223) QUEUED TO SYS$PRINT ON 4-DEC-1986 12:51 BY USER KMP, UIC [ENGVLSI,KMP], UNDER ACCOUNT ENGPAG AT PRIORITY 100, STARTED ON PRINTER _TCA1US:LPA0: ON 4-DEC-1986 13:07 FROM QUEUE SYS$PRINT.

CCCCCCCCCC 2222222222 DIGITAL EQUIPMENT CORPORATION - VAX/VMS VERSION V4.4 2222222222 CCCCCCCCCC

VAX/VMS VAX/VMS VAX/VMS VAX/VMS VAX/VMS VAX/VMS VAX/VMS VAX/VMS VAX/VMS VAX/VMS VAX/VMS VAX/VMS

```
VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
CCCCCCCCCC   2222222222222222222222222222222222222222222222222222222222222222222222222222222222222222222   CCCCCCCCCC
CCCCCCCCCC   22222222222222222222222  DIGITAL EQUIPMENT CORPORATION - VAX/VMS VERSION V4.4  2222222222222222222222222   CCCCCCCCCC
CCCCCCCCCC   2222222222222222222222222222222222222222222222222222222222222222222222222222222222222222222   CCCCCCCCCC

KMP
S2641
FOR
;2

FILE _$1$DUA6:[PHC.CHXC2]S2641.FOR;2 (1082,1,2), LAST REVISED ON 21-CCT-1986 08:44, IS A 30 BLOCK SEQUENTIAL FILE OWNED BY UIC
[PHOTST,PFC].  THE RECORDS ARE VARIABLE LENGTH WITH IMPLIED (CR) CARRIAGE CONTROL.  THE LONGEST RECORD IS 73 BYTES.

JOB S2641 (223) QUEUED TO SYS$PRINT ON 4-UEC-1986 12:51 BY USER KMP, UIC [ENGVLSI,KMP], UNDER ACCOUNT ENGPKG AT PRIORITY 100,
STARTED ON PRINTER _TCNTOSLPA0: ON 4-DEC-1986 13:07 FROM QUEUE SYS$PRINT.
```

CCCCCCCCCC   2222222222222222222222222222222222222222222222222222222222222222222222222222222222222222222   CCCCCCCCCC
CCCCCCCCCC   22222222222222222222222  CIGITAL ECUIPMENT CCRPCRATICN - VAX/VMS VERSION V4.4  2222222222222222222222222   CCCCCCCCCC
CCCCCCCCCC   2222222222222222222222222222222222222222222222222222222222222222222222222222222222222222222   CCCCCCCCCC

```
      SUBROUTINE CHRST(CHNID, CHNSTP)
C
CS*   ALLINLEG
C
C                          *****************
C                          *               *
C     SUBSYSTEM CHX        *   2641 CHRST  *
C                          *               *
C                          *****************
C
C     ************************************************************
C     ************************************************************
C     **                                                        **
C     **  (C) COPYRIGHT V-R INFORMATION SYSTEMS, INC. 1984      **
C     **  LICENSED MATERIAL -- PROGRAM PROPERTY OF VRIS         **
C     **  ALL RIGHTS RESERVED                                   **
C     **                                                        **
C     **  THIS PROGRAM IS THE PROPERTY OF VRIS AND IS FURNISHED **
C     **  PURSUANT TO A WRITTEN LICENSE AGREEMENT. IT MAY NOT BE **
C     **  USED, REPRODUCED, OR DISCLOSED TO OTHERS EXCEPT IN    **
C     **  ACCORDANCE WITH THE TERMS AND CONDITIONS OF THAT      **
C     **  AGREEMENT.                                            **
C     **                                                        **
C     ************************************************************
C     ************************************************************
C
C     ************************************************************
C     *                  MODULE DOCUMENTATION                    *
C     ************************************************************
C
C     SUMMARY --
C
C     THE 'CHANNEL RESET' SUBROUTINE IS CALLED TO
C     RESET THE DESIGN TO THE BEGINNING OF THE CHANNEL
C     SPECIFIED IN *CHNID*.
C
C     THE ENTRIES FOR CHANNELS, FROM *CHNID* TO *CHNSTP*,
C     IN THE *CONDAT*, *TRMDAT*, AND *VIADAT* ARRAYS ARE
C     THROWN OUT.
C
C
C     FORMAL PARAMETERS --
C     NAME   DIMENSION TYPE   IN/OUT   DESCRIPTION
C     ----   --------- ----   ------   -----------
C     CHNID              I      IN     CHANNEL NUMBER AT WHICH
C                                      TO RESET THE DESIGN
C
C     CHNSTP             I      IN     LAST CHANNEL PROCESSED
C
C
C     LOCAL VARIABLES --
C     NAME   DIMENSION TYPE   DESCRIPTION
C     ----   --------- ----   -----------
C     ACHN               I    CHANNEL NUMBER.
C
C     ACCN               I    CONNECTION NUMBER.
C
C     ADCGCT             I    COUNT OF THE NUMBER OF ENTRIES IN
C                             *DCGTYP* ARRAY.
C
C     ADCGMX             I    MAXIMUM NUMBER OF ENTRIES IN *DCGTYP*
C                             ARRAY.
C
C     ATMCHN             I    CHANNEL NUMBER OF THE CURRENT DOGLEG
C                             TERMINAL.
C
C     ATMCNT             I    COUNT OF THE PRE-EXISTING TERMINALS
C                             FOR THE CURRENT CHANNEL.
C
C     ATMCCN             I    CONNECTION NUMBER OF THE CURRENT
C                             TERMINAL.
C
C     ATMDLG             I    DOGLEG POINTER FOR THE CURRENT TERMINAL.
C
C     ATMIX              I    TERMINAL INDEX INTO *TRMDAT* ARRAY.
C
C     ATMSTP             I    LAST TERMINAL IN *TRMDAT* FOR THE CURRENT
C                             CHANNEL.
C
C     ATMSTR             I    FIRST TERMINAL IN *TRMDAT* FOR THE CURRENT
```

```
C                                       CHANNEL.
C       AVIA            I               VIA PROTECTION TERMINAL INDEX INTO
C                                       *VIADATA ARRAY.
C
C       CONFLD          I               CONNECTION FIELDS DO-LOOP INDEX.
C
C       DOGSTP          I               POINTER TO LAST TERMINAL ENTRY
C                                       'CREATED FOR DOGLEG' IN TRMLAT ARRAY.
C
C       DOGTMP(2,       I               TEMPORARY ARRAY USED TO COLLECT ALL
C         **INSDOGPERCHN)               DOGLEG TERMINALS FOR THE CURRENT CHANNEL
C                                       FOR THE PURPOSE OF 'UNDOGLEGGING' THE
C                                       CONNECTIONS.
C                                       DOGTMP(1,*) = DOGLEG TERMINAL INDEX
C                                       DOGTMP(2,*) = DOGLEG TERMINAL CONNECTION
C
C       HIGCON          I               THE HIGHER CONNECTION NUMBER OF THE
C                                       DOGLEGGED PAIR OF CONNECTIONS.
C
C       LOWCON          I               THE LOWER CONNECTION NUMBER OF THE
C                                       DOGLEGGED PAIR OF CONNECTIONS.
C
C       LSTCON          I               POINTER TO LAST CONNECTION OF THE
C                                       DESIGN TO KEEP.
C
C       LSTDOG          I               POINTER TO THE LAST DOGLEG TERMINAL
C                                       PROCESSED.
C
C       LSTVIA          I               POINTER TO THE LAST VIA PROTECTION
C                                       TERMINAL TO KEEP.
C
C       NEWDOG          I               POINTER TO THE FIRST DOGLEG TERMINAL
C                                       TO THROW AWAY.
C
C       START           I               POINTER TO THE FIRST ITEM OF INTEREST.
C
C       STOP            I               POINTER TO THE LAST ITEM OF INTEREST.
C
C       TRMFLD          I               TERMINAL FIELDS DO-LOOP INDEX.
C
C       VIAFLD          I               VIA PROTECTION TERMINAL FIELDS DO-LOOP
C                                       INDEX.
C
C       VIAPTR          I               POINTER INTO *VIADAT* TO THE FIRST
C                                       VIA PROTECTION TERMINAL FOR A CHANNEL.
C
C
C       GLOBAL VARIABLES --
C       NAME  DIMENSION TYPE  DESCRIPTION
C       ----  --------- ----  -----------
C       (NONE)
C
C       REVISION HISTORY --
C         28-JAN-86 DDC UNDOGLEGGED CONNECTIONS.  (SAR 5523)
C         16-OCT-85 TAF CHECKED MODULE.
C         30-SEP-85 DDC WROTE MODULE.  (SAR 5199)
C
C       TESTING PLANS --
C         02-OCT-85 DDC COMPLETED UNIT TESTING.
C
C       ************************************************************
C       *                   SUBSYSTEM TOKENS                       *
C       ************************************************************
C$$     CHXTOKEN
C
C       ************************************************************
C       *                VARIABLE DECLARATIONS                     *
C       ************************************************************
C
C       FORMAL PARAMETERS --
C       (NONE)
C
C       LOCAL VARIABLES --
C       DIMENSION DOGTMP(2, **INSDOGPERCHN)
```

```
C
C          SUBSYSTEM GLOBAL VARIABLES --
C
CS*        SUBSYSCOMMON [CHX]
C
CS*        CHXCEN
CS*        CHXCCN
CS*        CHXCHR
CS*        CHXTRM
C
C          OTHER SUBSYSTEM VARIABLES --
C          (NONE)
C
C          SYSTEM GLOBAL VARIABLES --
C
CS*        SYSCOMMON
C
C
C          ***************************************************************
C          *                       DATA STATEMENTS                       *
C          ***************************************************************
C
C          (NONE)
C
C
C          ***************************************************************
C          *                     STATEMENT FUNCTIONS                     *
C          ***************************************************************
C
C          LOCAL STATEMENT FUNCTIONS --
C          (NONE)
C
C          SUBSYSTEM STATEMENT FUNCTIONS --
C          (NONE)
C
C          OTHER SUBSYSTEM STATEMENT FUNCTIONS --
C          (NONE)
C
C          SYSTEM STATEMENT FUNCTIONS --
C          (NONE)
C
C
C          ***************************************************************
C          *                       EXECUTABLE CODE                       *
C          ***************************************************************
C
CS*        MODENTRY [CHX] [CHNEST] [2641] [17]
C
CS*        TRACE2WHEN [2] [CHNID] [CHNID] [CHNSTP] [CHNSTP]
           ADCGHX = **TRSDOGPERCHN
C
           IF (CHXFCF(11) .EQ. MODNBR)  THEN
            CALL CHXCNF(400)
            CALL CHXDVF(300)
           ENDIF
C          **********
C          * TRMDAT *
C          **********
C          RESTORE THE CONNECTION NUMBERS OF ANY 'NORMAL'
C          TERMINAL CONNECTIONS THAT HAVE BEEN DOGLEGGED
C          AND THROW AWAY THE TERMINALS CREATED FOR DOGLEGS.
C
C          FIND THE FIRST DOGLEG TERMINAL CREATED FOR A CHANNEL
C          AT OR GREATER THAN *CHNID*.
CS* TRACE2WHEN [2] [DGTMPT] [DGTMPT] [DGTMCT] [DGTMCT]
CS* TRACE1WHEN [2] [TRMCNT] [TRMCNT]
           NEWDOG = DGTMPT
           DOGSTP = DGTMPT + DGTMCT - 1
           IF (DGTMCT .EQ. 0)  GO TO 1010
           DO 1000 ATMIX = DGTMPT, DOGSTP
           NEWDOG = ATMIX
CS*        TRACE2WHEN [4] [ATMIX] [ATMIX] [NEWDOG] [NEWDOG]
CS*        TRACE1WHEN [4] [TRMCHN] [TRMDAT(**CHXTRMCHN,ATMIX)]
           IF (TRMDAT(**CHXTRMCHN, ATMIX) .GE. CHNID)  GO TO 1010
 1000      CONTINUE
           NEWDOG = DOGSTP + 1
 1010      CONTINUE
CS* TRACE1WHEN [3] [NEWDOG] [NEWDOG]
C
C          UNDOGLEG THE TERMINALS IN EACH CHANNEL
C
           LSTDOG = NEWDOG
```

```
          DO 1500  ACHN = CHNID, CHNSTP
CS*       TRACE2WHEN [4] [ACHN] [ACHN] [LSTDOG] [LSTDOG]
C
C         COLLECT ALL DOGLEG TERMINALS FOR *ACHN* IN *DOGTMP*
C         ARRAY:  DOGTMP(1,*) = INDEX INTO TRMDAT OF DOGLEG TERMINAL
C                 DOGTMP(2,*) = CONNECTION NUMBER OF DOGLEG TERMINAL
C
          ADOGCT = 0
C         FIRST THE NORMAL TERMINALS.
          ATMSTP = CHNDAT(%%CHXCHNFTPNT, ACHN)
          ATMCNT = CHNDAT(%%CHXCHNFTMCT, ACHN) +
     1             CHNDAT(%%CHXCHNCTMCT, ACHN)
          ATMSTP = ATMSTP + ATMCNT - 1
CS*       TRACE2WHEN [4] [ATMSTR] [ATMSTR] [ATMSTP] [ATMSTP]
          DO 1300  ATMIX = ATMSTR, ATMSTP
          ATMCON = TRMDAT(%%CHXTRMCON, ATMIX)
          ATMDLG = TRMDAT(%%CHXTRMDLG, ATMIX)
          IF (ATMDLG .NE. 0)  THEN
C           STORE IN *DOGTMP* ARRAY
            ADOGCT = ADOGCT + 1
            IF (ADOGCT .GT. ADOGMX)  GO TO 8000
CS*         TRACE2WHEN [4] [ADOGCT] [ADOGCT] [ATMDLG] [ATMDLG]
CS*         TRACE2WHEN [4] [ATMIX] [ATMIX] [ATMCON] [ATMCON]
            DOGTMP(1, ADOGCT) = ATMIX
            DOGTMP(2, ADOGCT) = ATMCON
          ENDIF
 1300     CONTINUE
C         NEXT THE TERMINALS CREATED FOR DOGLEG.
 1310     CONTINUE
          ATMIX = LSTDOG
          IF (ATMIX .GT. DOGSTP)  GO TO 1350
          ATMCHN = TRMDAT(%%CHXTRMCHN, ATMIX)
          IF (ATMCHN .GT. ACHN)  GO TO 1350
C         HERE, DOGLEG TERMINAL BELONGS TO ACHN.
CS*       TRACE2WHEN [4] [ACHN] [ACHN] [ATMCHN] [ATMCHN]
C         STORE IN *DOGTMP* ARRAY.
          ADOGCT = ADOGCT + 1
          IF (ADOGCT .GT. ADOGMX)  GO TO 8000
          DOGTMP(1, ADOGCT) = ATMIX
          DOGTMP(2, ADOGCT) = TRMDAT(%%CHXTRMCON, ATMIX)
          LSTDOG = LSTDOG + 1
          GO TO 1310
 1350     CONTINUE
C         HERE, ALL DOGLEGGED TERMINALS IN ACHN ARE COLLECTED IN
C         DOGTMP ARRAY. SORT IN DESCENDING ORDER OF CONNECTION NUMBERS.
          IF (ADOGCT .EQ. 0)  GO TO 1500
          CALL VISR11(DOGTMP, 2, ADOGMX, 2, 2, ADOGCT, 2)
C
C         FOR EACH DOGLEG TERMINAL BELONGING TO A HIGHER CONNECTION
C         THAN ITS ASSOCIATED DOGLEG CONNECTION, RESTORE ALL TERMINALS
C         IN THE HIGHER CONNECTION NUMBER TO THE LOWER (ORIGINAL)
C         CONNECTION NUMBER.
          DO 1450 ADOGIX = 1, ADOGCT
          ADOGPT = DOGTMP(1, ADOGIX)
          HIGCON = DOGTMP(2, ADOGIX)
          LOWCON = TRMDAT(%%CHXTRMDLG, ADOGPT)
CS*       TRACE2WHEN [4] [HIGCON] [HIGCON] [LOWCON] [LOWCON]
C         ZERO DOGLEG POINTER
          TRMDAT(%%CHXTRMDLG, ADOGPT) = 0
C         IF THE ASSOCIATED DOGLEG CONNECTION IS A HIGHER CONNECTION
C         NUMBER, THIS DOGLEG HAS ALREADY BEEN RESTORED.
          IF (LOWCON .GT. HIGCON)  GO TO 1450
          DO 1400  ATMIX = ATMSTR, ATMSTP
          ATMCON = TRMDAT(%%CHXTRMCON, ATMIX)
          IF (ATMCON .EQ. HIGCON)  TRMDAT(%%CHXTRMCON, ATMIX) = LOWCON
 1400     CONTINUE
 1450     CONTINUE
C
 1500     CONTINUE
C
C         RESET DOGLEG TERMINAL COUNT AND REINITIALIZE THE
C         ENTRIES
          DGTNCT = NEWDOG - DGTMPT
          IF (NEWDOG .LE. DOGSTP)  THEN
            DO 1200 ATMIX = NEWDOG, DOGSTP
            DO 1150 TRMFLD = 1, %%CHXTRMFLD
            TRMDAT(TRMFLD, ATMIX) = 0
 1150       CONTINUE
 1200       CONTINUE
          ENDIF
C         RESET TERMINAL COUNT
          TRMCNT = DGTMPT + DGTNCT - 1
```

```
CS* TRACE2WHEN [2] [TRMCNT] [TRMCNT] [DGTMCT] [DGTMCT]
C
 2000   CONTINUE
C       **********
C       * VIADAT *
C       **********
C       NEXT, THE VIA PROTECTION TERMINALS.
        IF (VIACNT .EQ. 0)  GO TO 3000
        LSTVIA = 0
        DO 2100 AVIA = 1, VIACNT
        IF (VIADAT(%%CHXVIACHN, AVIA) .GE. CHNID)  THEN
          LSTVIA = AVIA
          GO TO 2110
        ENDIF
 2100   CONTINUE
        GO TO 3000
 2110   CONTINUE
        IF (LSTVIA .LE. VIACNT)  THEN
          DO 2200 AVIA = LSTVIA, VIACNT
          DO 2150 VIAFLD = 1, %%CHXVIAFLD
          VIADAT(VIAFLD, AVIA) = 0
 2150     CONTINUE
 2200     CONTINUE
        ENDIF
        VIACNT = LSTVIA - 1
C
C       UPDATE CHANNEL VIA POINTERS
C
        DO 2500 ACHN = 1, CHNCNT
        VIAPTR = CHNDAT(%%CHXCHNVIAPTR, ACHN)
 2400   CONTINUE
        IF (VIAPTR .GT. VIACNT)  THEN
          VIAPTR = VIADAT(%%CHXVIANXT, VIAPTR)
          CHNDAT(%%CHXCHNVIAPTR, ACHN) = VIAPTR
          GO TO 2400
        ENDIF
 2500   CONTINUE
C
 3000   CONTINUE
C       **********
C       * CONDAT *
C       **********
C       NEXT, THE CONNECTIONS.
        IF (CONCNT .LE. CONPRE)  GO TO 4000
        START = CONPRE + 1
        LSTCON = START
        DO 3100 ACON = START, CONCNT
        IF (CONDAT(%%CHXCONCHN, ACON) .GE. CHNID)  THEN
          LSTCON = ACON
          GO TO 3110
        ENDIF
 3100   CONTINUE
        GO TO 4000
 3110   CONTINUE
        IF (LSTCON .LE. CONCNT)  THEN
          DO 3200 ACON = LSTCON, CONCNT
          DO 3150 CONFLD = 1, %%CHXCONFLD
          CONDAT(CONFLD, ACON) = 0
 3150     CONTINUE
 3200     CONTINUE
        ENDIF
        CONCNT = LSTCON - 1
C
 4000   CONTINUE
C
C       ************
C       * ALL DONE *
C       ************
        IF (CHXFCE(11) .EQ. MCDNBR)  THEN
          CALL CFNTMP(400)
          CALL CHXDMP(300)
        ENDIF
        GO TO 9000
C
C
C       ******************************************************
C       *                    ERROR RETURNS                    *
C       ******************************************************
C
 8000   CONTINUE
        GO TO 9000
C
```

```
C          ****************************************************************
C          *                    SINGLE EXIT FROM THIS ROUTINE                *
C          ****************************************************************
C
 9000      CONTINUE
CS*        MCDEXIT [CHX]
           RETURN
C
C
C          ****************************************************************
C          *                       FORMAT STATEMENTS                         *
C          ****************************************************************
C          (NONE)
C
C
C          END CHNRST 2641
           END
```

FILE _$1$DUA6:[FEC.CRA02]S2642.FOR;1 (2421,1,1), LAST REVISED ON 21-OCT-1986 08:44, IS A 17 BLOCK SEQUENTIAL FILE OWNED BY UIC [PRINTST,FEC]. THE RECORDS ARE VARIABLE LENGTH WITH IMPLIED (CR) CARRIAGE CONTROL. THE LONGEST RECORD IS 77 BYTES.

JOB S2642 (224) QUEUED TO SYS$PRINT ON 4-DEC-1986 12:51 BY USER KMP, UIC [ENGVLSI,KMP], UNDER ACCOUNT ENGENG AT PRIORITY 100, STARTED ON PRINTER _LCTGSIPAO: ON 4-DEC-1986 13:02 FROM QUEUE SYS$PRINT.

```
MMMMMMMMMM   3333333333333333333333333333333333333333333333333333333333333333333333333333333333333333333333333   MMMMMMMMMM
MMMMMMMMMM   33333333333333333333333  DIGITAL EQUIPMENT CORPORATION - VAX/VMS VERSION V4.4  33333333333333333333333   MMMMMMMMMM
MMMMMMMMMM   3333333333333333333333333333333333333333333333333333333333333333333333333333333333333333333333333   MMMMMMMMMM

   VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
      VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
   VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
      VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
   VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS
      VAX/VMS  VAX/VMS  VAX/VMS  VAX/VMS  VAX/VMS  VAX/VMS  VAX/VMS  VAX/VMS  VAX/VMS  VAX/VMS  VAX/VMS  VAX/VMS

MMMMMMMMMM   3333333333333333333333333333333333333333333333333333333333333333333333333333333333333333333333333   MMMMMMMMMM
MMMMMMMMMM   33333333333333333333333  DIGITAL EQUIPMENT CORPORATION - VAX/VMS VERSION V4.4  33333333333333333333333   MMMMMMMMMM
MMMMMMMMMM   3333333333333333333333333333333333333333333333333333333333333333333333333333333333333333333333333   MMMMMMMMMM

KMP

S2642

FOR

:11
```

```
FILE _$1$DUA6:[PRO.CHX02]S2642.FOR;1 (2421,1,1), LAST REVISED ON 21-OCT-1986 08:44, IS A 17 BLOCK SEQUENTIAL FILE OWNED BY UIC
[PROJST,PRO]. THE RECORDS ARE VARIABLE LENGTH WITH IMPLIED (CR) CARRIAGE CONTROL. THE LONGEST RECORD IS 77 BYTES.

JOB S2642 (224) QUEUED TO SYS$PRINT ON 4-DEC-1986 12:51 BY USER KAF, UIC [ENGVLSI,KAF], UNDER ACCOUNT ENGENG AT PRIORITY 100,
STARTED ON PRINTER _TCA0:(OSLPA0: ON 4-DEC-1986 13:02 FROM QUEUE SYS$PRINT.

MMMMMMMMM    3333333333333333333333333333333333333333333333333333333333333333333333333333333333333333333333333    MMMMMMMMMM
MMMMMMMMM    333333333333333333333333  DIGITAL EQUIPMENT CORPORATION - VAX/VMS VERSION V4.4  33333333333333333333333    MMMMMMMMMM
MMMMMMMMM    3333333333333333333333333333333333333333333333333333333333333333333333333333333333333333333333333    MMMMMMMMMM

_$1$DUA6:[PRO.CHX02]S2642.FOR;1                                    21-OCT-1986 08:44                               PAGE 1

      SUBROUTINE GETCEL( POS, SIDE, CHAN, LLX, LLY, URX, URY)
C
CS#   ALLINIEG.
C
C                           *****************
C                           *               *
C     SUBSYSTEM CHX         *  2642 GETCEL  *
C                           *               *
C                           *****************
C
C     ***********************************************************
C     ***********************************************************
C     **                                                       **
C     **  (C) COPYRIGHT V-R INFORMATION SYSTEMS, INC. 1984     **
C     **  LICENSED MATERIAL -- PROGRAM PROPERTY OF VRIS        **
C     **  ALL RIGHTS RESERVED                                  **
C     **                                                       **
C     **  THIS PROGRAM IS THE PROPERTY OF VRIS AND IS FURNISHED **
C     **  PURSUANT TO A WRITTEN LICENSE AGREEMENT. IT MAY NOT BE **
C     **  USED, REPRODUCED, OR DISCLOSED TO OTHERS EXCEPT IN   **
C     **  ACCORDANCE WITH THE TERMS AND CONDITIONS OF THAT     **
C     **  AGREEMENT.                                           **
C     **                                                       **
C     ***********************************************************
C     ***********************************************************
C
C     ***********************************************************
C     *                 MODULE DOCUMENTATION                    *
C     ***********************************************************
C
C     SUMMARY --
C
C     THIS SUBROUTINE IS CALLED TO GET THE RECTANGULAR DESCRIPTION
C     OF THE CELL INDICATED.
C
C     THE FORMAL PARAMETER *POS* DEFINES THE POSITION OF THE
C     CELL IN THE ROW, *SIDE* SPECIFIES THE TOP OR BOTTOM ROW
C     ALONG THE CHANNEL, AND *CHAN* THE THE CHANNEL ID NUMBER.
C
C     THE RECTANGULAR DESCRIPTION IS RETURNED IN THE PARAMETERS
C     *LLX*, *LLY*, *URX*, AND *URY*.
C
C     FORMAL PARAMETERS --
C     NAME  DIMENSION TYPE   IN/OUT   DESCRIPTION
C     ----  --------- ----   ------   -----------
C     POS             I      IN       CELL POSITION
C                                     $$CHXGFIFIRST = FIRST CELL IN ROW
C                                     $$CHXGFILAST  = LAST CELL IN ROW
C
C     SIDE            I      IN       ROW SPECIFICATION
C                                     $$CHXGFITOP = TOP ROW ALONG CHANNEL
C                                     $$CHXGFIBOT = BOTTOM ROW ALONG CHANNEL
C
C     CHAN            I      IN       CHANNEL ID NUMBER
C
C     LLX             I      OUT      LOWER LEFT X COORDINATE
C
C     LLY             I      OUT      LOWER LEFT Y COORDINATE
C
C     URX             I      OUT      UPPER RIGHT X COORDINATE
C
C     URY             I      OUT      UPPER RIGHT Y COORDINATE
C
C
C     LOCAL VARIABLES --
```

```
C        NAME  DIMENSION TYPE  DESCRIPTION
C        ----  --------- ----  -----------
C        ACELL              I  CELL NUMBER.
C
C        NXTPTR             I  POINTER INTO *CELDAT* ARRAY TO THE
C                              NEXT CELL ALONG THE GIVEN SIDE OF A
C                              CHANNEL.
C
C        SIDPTR             I  POINTER INTO *CHNDAT* ARRAY TO THE
C                              FIRST CELL ALONG THE GIVEN SIDE OF
C                              A CHANNEL.
C
C        GLOBAL VARIABLES --
C        NAME  DIMENSION TYPE  DESCRIPTION

_$1$DUA6:[PRD.CHX02]S2642.FOR;1                      21-OCT-1986 08:44                                      PAGE 2

C        ----  --------- ----  -----------
C        (NONE)
C
C
C        REVISION HISTORY --
C           10-DEC-85 RRM CHECKED MODULE.
C           06-DEC-85 DDC WROTE MODULE.   (SAR 5424)
C
C        TESTING PLANS --
C           10-DEC-85 DDC COMPLETED UNIT TESTING.
C
C        ****************************************************************
C        *                    SUBSYSTEM TOKENS                          *
C        ****************************************************************
CS*      CHXTOKEN
C        ****************************************************************
C        *                 VARIABLE DECLARATIONS                        *
C        ****************************************************************
C        FORMAL PARAMETERS --
C        (NONE)
C
C        LOCAL VARIABLES --
C
C        SUBSYSTEM GLOBAL VARIABLES --
CS*      SUBSYSCTLBAT [CHX]
CS*      CHXCEL
CS*      CHXCHN
CS*      CHXCHR
C        OTHER SUBSYSTEM VARIABLES --
C        (NONE)
C        SYSTEM GLOBAL VARIABLES --
CS*      SYSCOMMON
C
C        ****************************************************************
C        *                    DATA STATEMENTS                           *
C        ****************************************************************
C        (NONE)
C
C        ****************************************************************
C        *                  STATEMENT FUNCTIONS                         *
C        ****************************************************************
C        LOCAL STATEMENT FUNCTIONS --
C        (NONE)
C        SUBSYSTEM STATEMENT FUNCTIONS --
C        (NONE)
C        OTHER SUBSYSTEM STATEMENT FUNCTIONS --
C        (NONE)
C        SYSTEM STATEMENT FUNCTIONS --
C        (NONE)
```

```
C
C
C         ************************************************************
C         *                       EXECUTABLE CODE                    *
C         ************************************************************
C
CS*       MCDENTRY [CHX] [GETCEL] [2642] [18]
C
CS*       TRACE2WHEN [2] [PCS] [PCS] [SIDE] [SIDE]
CS*       TRACE1WHEN [2] [CHAN] [CHAN]
C
          SIDPTR = %%CHXCHNLOCLPT
          NXTPTR = %%CHXCELNXTLF
          IF (SIDE .EQ. %%CHXGETTCP)  THEN
            SIDPTR = %%CHXCHNHICLPT

_$1$DUA6:[PRD.CHX02]S2642.FOR;1                    21-OCT-1986 08:44                    PAGE 3

            NXTPTR = %%CHXCELNXTRT
          ENDIF
C
C         *****************
C         * IDENTIFY CELL *
C         *****************
C         GET FIRST CELL IN ROW.
          ACELL = CHNDAT(SIDPTR, CHAN)
C
          IF (ACELL .EQ. 0)  GO TO 8000
          IF (PCS .EQ. %%CHXGETFIRST)  GO TO 3000
C
 2000     CONTINUE
C         CONTINUE GETTING NEXT CELL UNTIL LAST CELL HAS
C         HAS BEEN LOCATED.
          IF (CELDAT(NXTPTR, ACELL) .EQ. 0)  GO TO 2050
          ACELL  = CELDAT(NXTPTR, ACELL)
          GO TO 2000
 2050     CONTINUE
C         HERE *ACELL* IS THE LAST CELL.
C
C         ********************
C         * CELL COORDINATES *
C         ********************
C
 3000     CONTINUE
CS*       TRACE1WHEN [3] [ACELL] [ACELL]
C
          LLX = CELDAT(%%CHXCELREFX, ACELL) + CELDAT(%%CHXCELLLX, ACELL)
          LLY = CELDAT(%%CHXCELREFY, ACELL) + CELDAT(%%CHXCELLLY, ACELL)
          URX = CELDAT(%%CHXCELREFX, ACELL) + CELDAT(%%CHXCELURX, ACELL)
          URY = CELDAT(%%CHXCELREFY, ACELL) + CELDAT(%%CHXCELURY, ACELL)
C
CS*      TRACE2WHEN [2] [LLX] [LLX] [LLY] [LLY]
CS*      TRACE2WHEN [2] [URX] [URX] [URY] [URY]
C
C         ************
C         * ALL DONE *
C         ************
C
          GO TO 9000
C
C
C         ************************************************************
C         *                        ERROR RETURNS                     *
C         ************************************************************
C
 8000     CONTINUE
C/        CHX - ERROR WHILE ATTEMPTING TO DEFINE
C/              COORDINATES OF A CELL ALONG CHANNEL.
C/        **FM(1X,'CHANNEL = ',I6,6X,'FIRST CELL POINTER = ',I6)
          CALL VISERR(RCLNBR, 4264201, CHAN, ACELL)
          GO TO 9000
C
C         ************************************************************
C         *               SINGLE EXIT FROM THIS ROUTINE              *
C         ************************************************************
C
 9000     CONTINUE
CS*       MODEXIT [CFX]
          RETURN
C
C
C         ************************************************************
C         *                     FORMAT STATEMENTS                    *
C         ************************************************************
C         (NONE)
C
```

ENC GEICEL 2642
ERD

NNNNNNNNN 4444444444444444444444444444444444444444444444444444444444444444444444444444444444444444 NNNNNNNNN
NNNNNNNNN 4444444444444444444444444 DIGITAL EQUIPMENT CORPORATION - VAX/VMS VERSION V4.4 4444444444444444444444444 NNNNNNNNN
NNNNNNNNN 4444444444444444444444444444444444444444444444444444444444444444444444444444444444444444 NNNNNNNNN

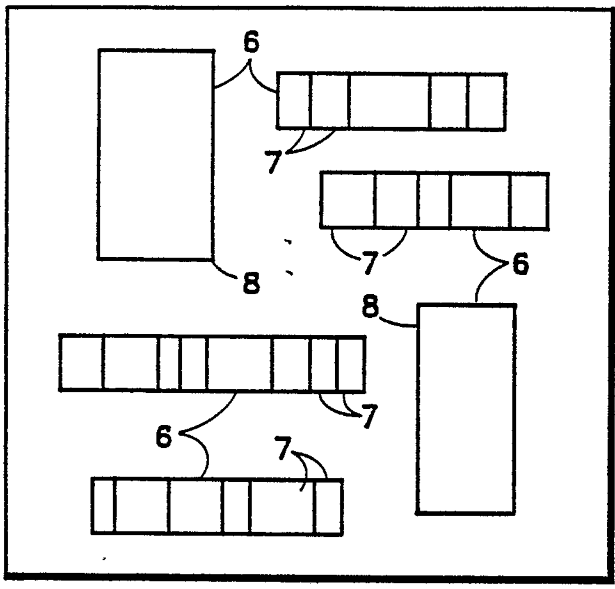


FIG.2

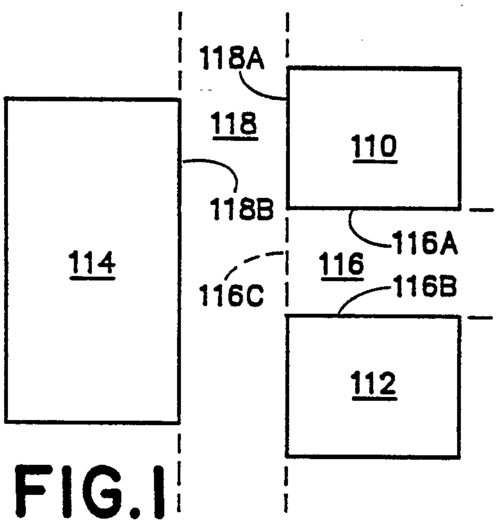


FIG.1

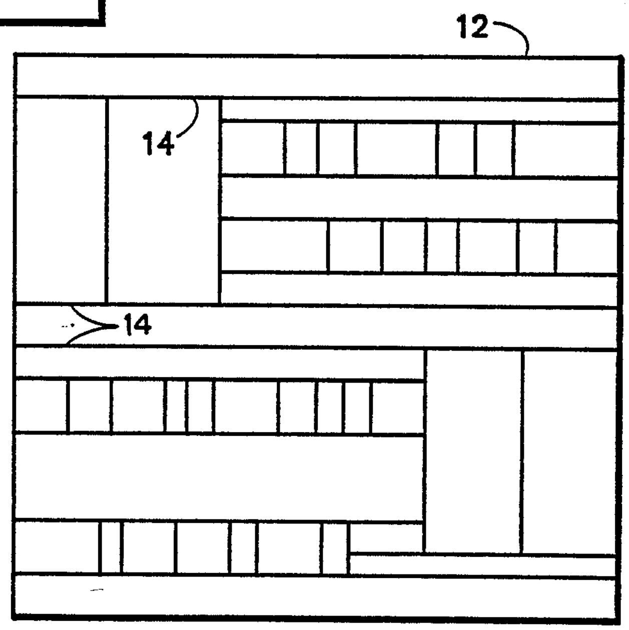


FIG.3b

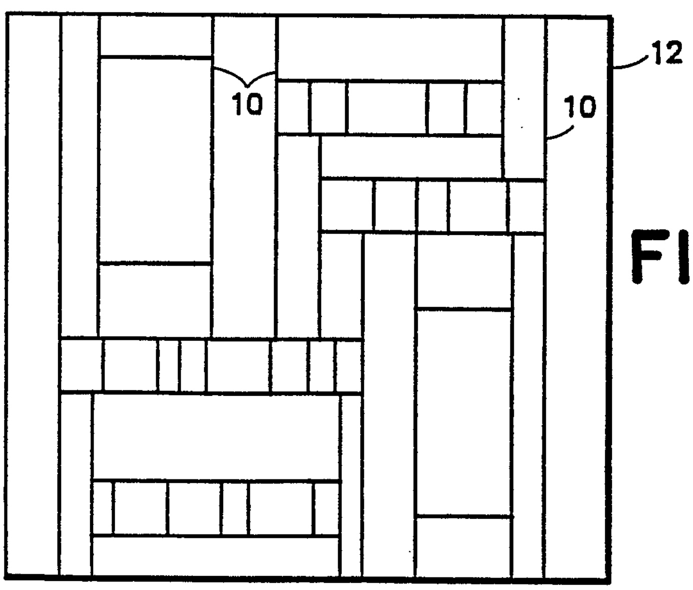


FIG.3a

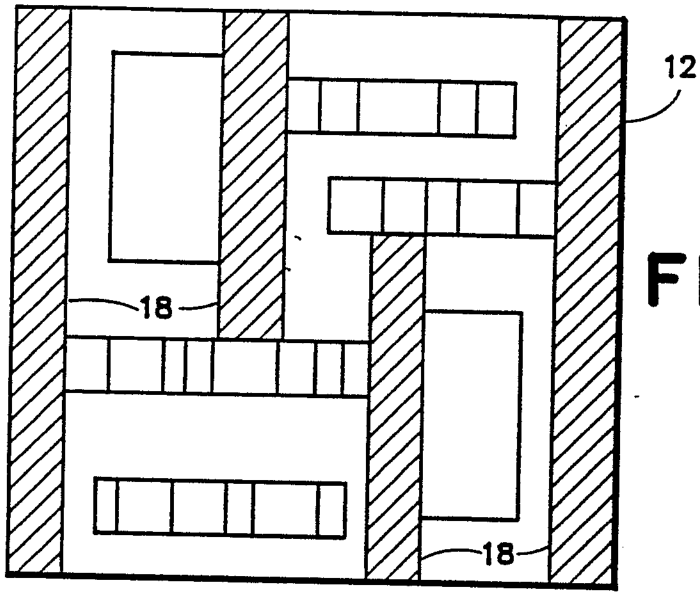


FIG. 4a

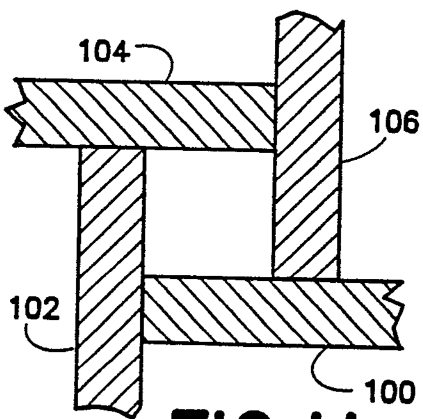


FIG. 11

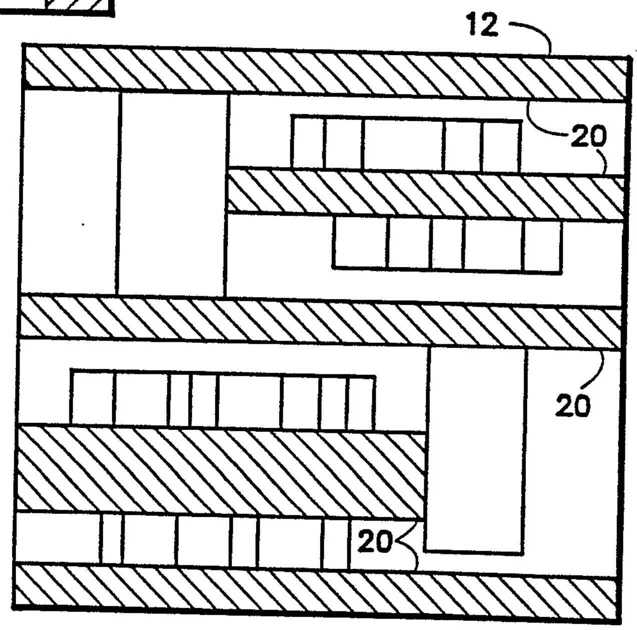


FIG. 4b

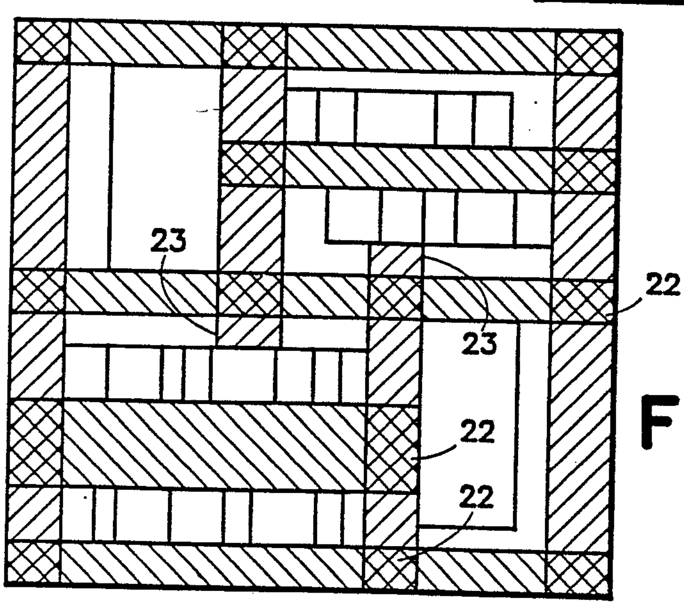


FIG. 5

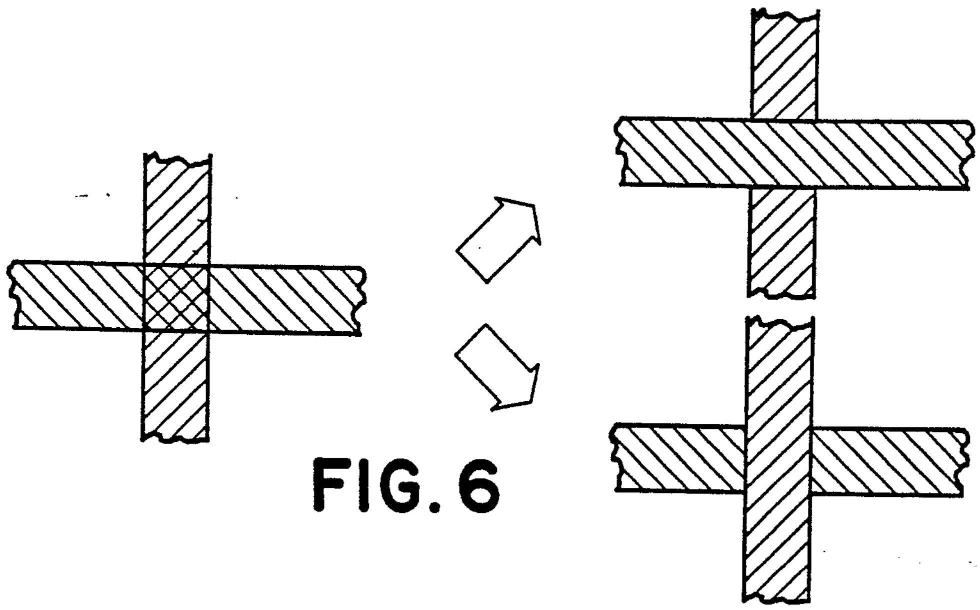

FIG. 6

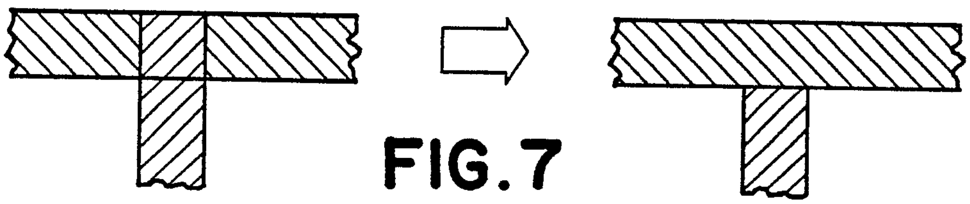

FIG. 7

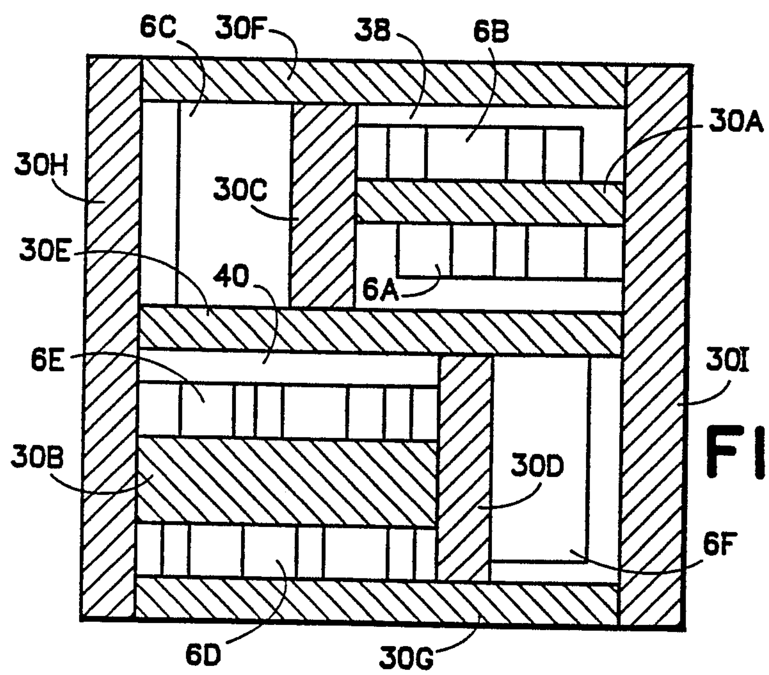


FIG. 8

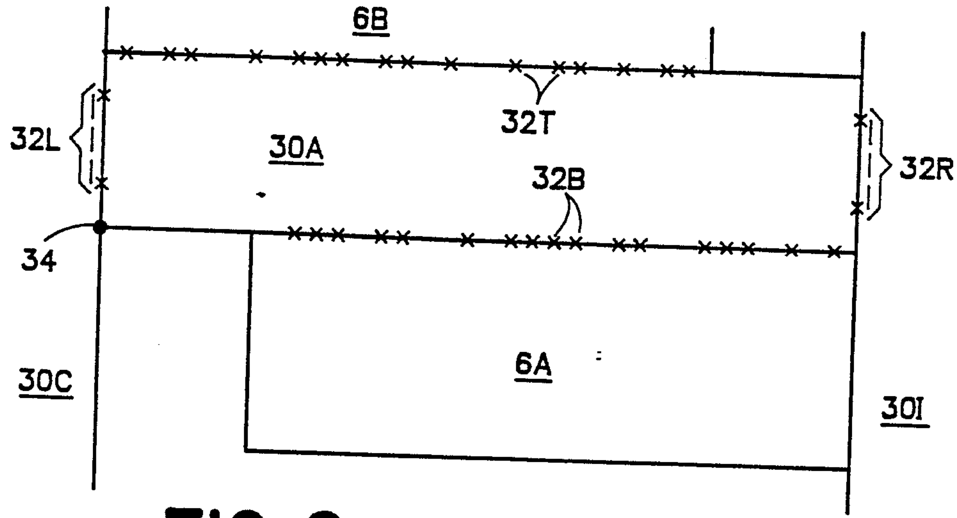
6B
32T
32L
30A
32B
32R
34
6A
30C
30I

FIG. 9

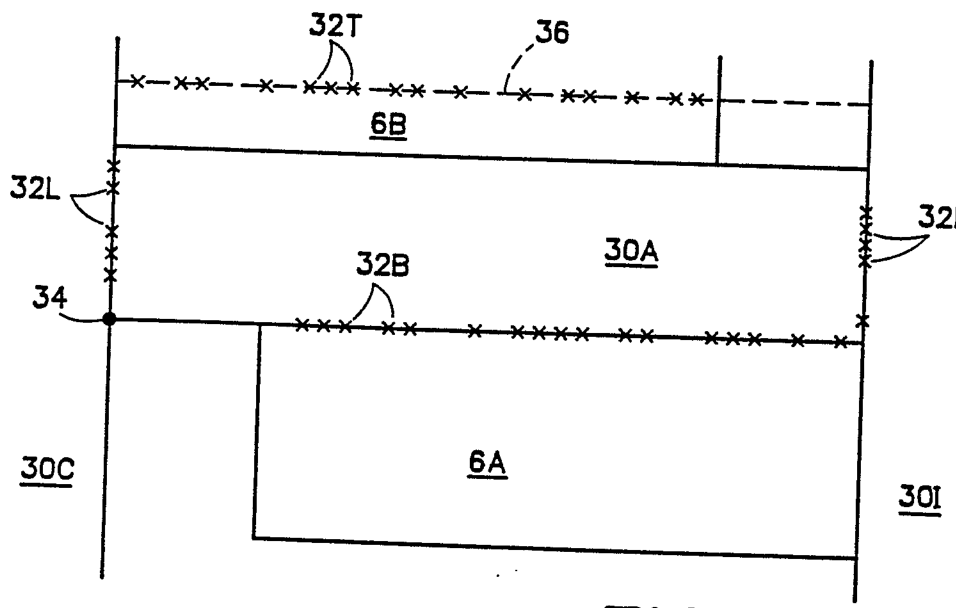
32T
36
6B
32L
30A
32R
32B
34
6A
30C
30I

FIG. 10